# EUROPEAN PATENT APPLICATION

(11) **EP 1 712 662 A1**
(43) Date of publication of application: **18.10.2006**
(21) Application number: 04700505.3
(22) Date of filing: 07.01.2004
(51) Int. Cl.: C30B 29/38, C04B 35/58, C04B 35/00, H01L 33/00

(54) **SUBSTRATE FOR THIN-FILM FORMATION, THIN-FILM SUBSTRATE AND LIGHT EMITTING ELEMENT**

(30) Priority: 30.06.2003 JP 2003186175; 18.08.2003 JP 2003294259; 26.11.2003 JP 2003396236
(71) Applicant: Miyahara, Kenichiro, Tsukuba-City Ibaraki 305-0047 (JP)
(72) Inventor: Miyahara, Kenichiro, Tsukuba-City Ibaraki 305-0047 (JP)
(74) Representative: Dunleavy, Kevin James
(86) International application number: PCT/JP2004/000051
(87) International publication number: WO 2005/003414

(57) **Abstract**

A substrate for forming a single-crystal thin film composed mainly of gallium nitride, indium nitride or aluminum nitride, the substrate comprising a sintered compact composed mainly of a ceramic material; and a thin-film substrate furnished with the single-crystal thin film. The use of the sintered compact composed mainly of a ceramic material, especially sintered compact with optical permeability, as the substrate enables formation thereon of a highly crystalline single-crystal thin film composed mainly of at least one selected from gallium nitride, indium nitride and aluminum nitride. Thus, there is provided a thin-film substrate furnished with a highly crystalline single-crystal thin film. Further, the use of the sintered compact composed mainly of a ceramic material enables providing of a light-emitting device excelling in luminous efficiency.

## Description

### BACKGROUND OF THE INVENTION

### 1. Field of the Invention

This invention relates to a substrate for forming a thin film comprising gallium nitride, indium nitride and aluminum nitride as a main component, a thin-film substrate in which the thin film is formed, and a light-emitting device produced using the substrate.

### 2. Description of the Related Art

In recent years, various semiconductor devices, such as a light-emitting diode (LED) or a laser diode (LD), came to be used for the light source of a display, a luminaire, an optical communication, and a storage apparatus, etc.

In such semiconductor devices, a device which emits light of a green and blue color - a blue color - a purple and blue color - ultraviolet rays has been developed growing epitaxially mainly the III-V group nitride thin film comprising as a main component at least one selected from gallium nitride, indium nitride and aluminum nitride and constituted with at least three or more layers of the III-V group nitride single-crystal thin film layers which were semiconductorized into P and N-type by doping and the luminescence layer, such as quantum well structure, onto the substrate, such as sapphire.

As for the above light-emitting device constituted with a laminate which comprises a thin film comprising at least one selected from gallium nitride, indium nitride and aluminum nitride as a main component and contains N-type semiconductor layer, a luminescence layer, and P-type semiconductor layer at least (hereafter, unless it refuses especially it is only called a "light-emitting device".), it is used for the light sources of a signal, a backlight for liquid crystals, and a general lighting replaced with the incandescent lamp or fluorescent lamp, and the laser light source of high capacity optical disc devices, etc.

In some cases, using the light from a light-emitting device as it is, or it changes into white light by an interaction using a phosphor, and is used.

Usually, the light-emitting device has two-terminal device (diode) construction constituted with the P-type semiconductor, N-type semiconductor, and luminescence layer of each above nitride or each nitride mixed crystal, and is driven applying direct current power.

The output of a light-emitting device increases using such a light-emitting device as a light source of high-output laser, or using as a light source of general lighting, etc.

When it is going to use a light-emitting device for such an intended use, as for the substrate for forming an epitaxial film-based thin film comprising as a main component at least one selected from gallium nitride, indium nitride and aluminum nitride and constituting a light-emitting device, problems are arising.

That is, even if the conventional sapphire substrate is a single crystal, the crystal structure and the thermal expansion coefficient, etc. differ from gallium nitride, indium nitride and aluminum nitride which constitute a light-emitting device, therefore, the thin film comprising as a main component at least one selected from gallium nitride, indium nitride and aluminum nitride and formed on the sapphire substrate cannot become into good crystallinity easily, it has been able to form as a single-crystal thin film with high crystallinity by research in recent years at last.

However, since it is easy to generate a crystal dislocation and a strain in the thin film by the crystal lattice mismatching or difference of thermal expansion coefficient between the sapphire substrate and the thin film, even if it is a single-crystal thin film with high crystallinity, manufacture yield of the light-emitting device manufactured using such a thin film tends to be lowered, and achievement of the improvement in luminous efficiency of a light-emitting device or improvement in characteristics, such as high-output-izing and long-life of a laser oscillation, is also difficult.

Since a sapphire substrate is a single crystal, manufacture cost is also highly, and there is a problem in which it can be hard to use for an extensive use the single-crystal thin film comprising as a main component at least one selected from gallium nitride, indium nitride and aluminum nitride and formed on it.

Various optical waveguides for conducting light from a light-emitting device of this invention, or from a conventional laser or light-emitting diode at desired intensity, distance and a position have been proposed hitherto.

Usually, it is obtained forming a high refractive index portion in crystal substrates, such as LiNbO₃ and silicon, or in glass substrates, such as silica glass.

In conventional optical waveguides, there are problems that they have low permeability to short-wavelength light such as blue or ultraviolet rays, that it is hard to form electrical circuits simultaneously on the substrate in which an optical waveguide is formed because the electric insulation of a substrate is small, and that it is hard to mount simultaneously a high-output light-emitting device on the substrate in which an optical waveguide is formed because the thermal conductivity of a substrate is low, etc.

As mentioned above, when using a conventional sapphire substrate, the thin film comprising as a main component at least one selected from gallium nitride, indium nitride and aluminum nitride and formed on it has become to be able to be formed as a single-crystal thin film with comparatively high crystallinity in recent years.

However, when using a sapphire substrate, the luminous efficiency of the light-emitting device constituted mainly with such a thin film is low and is usually about 2-8 %, so 92-98 % of the electric power applied to the device is consumed other than the radiant power output to the outside of a device, and the light emitting characteristics in which the III-V group nitride semiconductor originally has have not been shown sufficiently.

As the cause, it is easy to produce a crystal dislocation and a distortion in the thin film by the crystal lattice mismatching, or the difference of thermal expansion coefficient between the sapphire substrate and the thin film, even if the thin film constituting a light-emitting device can be formed on a sapphire substrate as a single-crystal thin film with high crystallinity, furthermore, it seems that many of light emitted from the light-emitting device are reflected in the interface of the sapphire substrate and the above thin film, or in the surface of a sapphire substrate, and are easily shut up by being returned into the inside of a light-emitting device because the refractive index of a sapphire substrate is still smaller than a thin film ofgallium nitride, indium nitride and aluminum nitride, a sapphire substrate is a transparent and homogeneous bulk single crystal.

Therefore, about the substrate material for manufacturing a light-emitting device by forming the thin film comprising as a main component at least one selected from gallium nitride, indium nitride and aluminum nitride and including an epitaxial film, there have been proposals of the single crystal substrate materials comprising silicon carbide, silicon, etc. as a main component instead of the conventional sapphire.

It is considered as the example using the silicon carbide single crystal as a substrate, for example, methods, such as JP,10-27947A or JP,11-40884A, are proposed.

Methods, such as JP,10-214959A, are proposed as the silicon substrate.

However, even if these substrates are used, a good single-crystal thin film is hard to be formed on these substrates for the reasons of the difference of a crystal structure and a lattice constant between the substrates and the single-crystal thin film comprising as a main component at least one selected from gallium nitride, indium nitride and aluminum nitride.

In JP,9-172199A, the method which uses the glass substrates, such as a quartz glass, and the substrates produced by the sintering process, such as a polycrystalline silicon, is proposed instead of the single crystal substrates to solve the problems in which conventional single crystal substrates have.

However, although this method must form the film material comprising an oxide of II group elements, such as zinc oxide and mercury oxide, before forming gallium nitride system compound semiconductor layer on a substrate, that effect is not necessarily clarified.

When the substrate having the oxide of such II group elements is used, the crystallinity of the thin film constituting the gallium nitride system compound semiconductor formed there is not necessarily clear, and there is no clearness about the characteristics, such as luminous efficiency of the produced semiconductor device, and having not resulted in problem solving after all.

As mentioned above, although the substrate which can form a excellent single-crystal thin film that comprises as a main component at least one selected from gallium nitride, indium nitride and aluminum nitride is being requested for instead of the conventional single crystal substrates, such as a sapphire and silicon carbide, such substrate has not realized yet.

The thin-film substrate having the above excellent single-crystal thin film comprising as a main component at least one selected from gallium nitride, indium nitride and aluminum nitride, however, has not be provided yet.

Thus, the luminous efficiency of the light-emitting device which is made using a conventional sapphire substrate is low, so it is hard to say that the original luminescence characteristics of III-V group nitride semiconductor can be shown sufficiently, though that having at least equivalent luminous efficiency to the light-emitting device produced using a sapphire substrate is requested, the luminous efficiency of the light-emitting device produced using substrates proposed to improve the fault of a sapphire substrate instead of a sapphire substrate has not improved, and there was a problem in which the original luminescence characteristics of III-V group nitride semiconductor have not realized yet sufficiently.

On the other hand, and, the method indicated in the Japanese Patent 3119965 as an optical waveguide for leading a light with short wavelength, such as blue light and ultraviolet rays from a light-emitting device, in desired intensity, distance, and a location, is proposed.

In this proposal, although the method of forming the optical waveguide by an aluminum nitride thin film in the single crystal substrate comprising silicon, sapphire, etc. is indicated, the buffer layer comprising aluminum oxynitride, sialon, etc. needs to be provided to obtain the transmission nature of a light with short wavelength, such as blue light and ultraviolet rays.

As the reason of such a device, because there is a mismatching of crystal lattice, or a difference of thermal expansion coefficient between the silicon and sapphire of the substrate material and the aluminum nitride, it is probably surmised that it will be because formation of an aluminum nitride thin film with high crystallinity is difficult, and transmission loss of a waveguide becomes large as a result.

Other than the mismatching of crystal lattice, and the difference of thermal expansion coefficient, when the silicon substrate is used, it seems a big cause that it does not function as a waveguide too, since a total reflection of light does not occur in the aluminum nitride thin film because the refractive index of an aluminum nitride thin film formed directly is small if it is compared with the silicon.

Since the electric insulation nature is small and the dielectric constant is high when silicon is used for a substrate, it can be hard to form an electrical circuit on a substrate directly, and there is a problem in which it can be hard to mount a light-emitting device on the substrate unitedly.

When using the sapphire for a substrate, in case a high-output light-emitting device is mounted, a problem of the nature of radiating heat arises since the thermal conductivity is small.

Therefore, there were problems, such that the satisfactory optical waveguide which transmits a light with short wavelength, such as blue light and ultraviolet rays, from a light-emitting device provided with an electric circuit for driving a device and can mount a high power light-emitting device has not been realized.

### SUMMARY OF THE INVENTION

This invention is made to solve the problems described above.

This inventor has examined various ceramic-based sintered compacts as a substrate for forming a single-crystal thin film comprising as a main component at least one selected from gallium nitride, indium nitride and aluminum nitride, focusing on an aluminum nitride-based sintered compact, and found that the single-crystal thin film excellent in crystallinity comprising as a main component at least one selected from gallium nitride, indium nitride and aluminum nitride can be formed directly in the state which adhered firmly with neither a crack nor exfoliation if the substrate comprising the ceramic-based sintered compact is used, and having proposed in the JP application for patent 2002-362783, the application for patent 2003-186175, and the JP application for patent 2003-294259, etc.

It was found that it can be formed directly in the state where there is neither a crack nor exfoliation and it adhered integrally to the ceramic-based sintered compact on which a single-crystal thin film comprising as a main component gallium nitride, indium nitride and aluminum nitride can be form directly, even if it is the thin film comprising as a main component at least one selected from gallium nitride, indium nitride and aluminum nitride and being not necessarily the epitaxially grown single-crystal thin film, such as an amorphous thin film, a polycrystalline thin film, and an orientated polycrystalline thin film, etc.

Using as a substrate the ceramic-based sintered compact which formed beforehand the thin film of such a various crystallization state, if growing the single-crystal thin film comprising as a main component at least one selected from gallium nitride, indium nitride and aluminum nitride onto the substrate, it can be formed in the state where there is neither a crack nor exfoliation and it adhered firmly, and it was found that the single-crystal thin film obtained excelled in crystallinity compared with the single-crystal thin film formed directly on the ceramic-based sintered compact, such as aluminum nitride-based sintered compact, etc.

It was found that a single-crystal thin film more excellent in crystallinity comprising as a main component at least one selected from gallium nitride, indium nitride and aluminum nitride can be formed on the ceramic-based sintered compact having optical permeability.

A thin film comprising as a main component at least one selected from gallium nitride, indium nitride and aluminum nitride and being not necessarily the epitaxially grown single-crystal thin film, such as an amorphous thin film, a polycrystalline thin film, and an orientated polycrystalline thin film, etc. can be formed on the ceramic-based sintered compact with optical permeability.

If the ceramic-based sintered compact with optical permeability having beforehand the thin film of such a various crystallization state is used, it was found that a single-crystal thin film still more excellent in crystallinity comprising as a main component at least one selected from gallium nitride, indium nitride and aluminum nitride can be formed.

Thus, it was found that a single-crystal thin film excellent in crystallinity comprising as a main component at least one selected from gallium nitride, indium nitride and aluminum nitride can be formed on the ceramic-based sintered compact with or without optical permeability.

If the ceramic-based sintered compact, and the ceramic-based sintered compact with optical permeability are used, it was found that it can obtain a thin-film substrate having the above single-crystal thin film excellent in crystallinity comprising as a main component at least one selected from gallium nitride, indium nitride and aluminum nitride.

Using the ceramic-based sintered compact, and ceramic-based sintered compact with optical permeability which do not form the above thin film, or using the thin-film substrate in which the single-crystal thin film comprising as a main component at least one selected from gallium nitride, indium nitride and aluminum nitride was formed on the above ceramic-based sintered compact, and ceramic-based sintered compact with optical permeability, a light-emitting device having equivalent luminous efficiency at least or is a maximum of not less than 4-5 times can be produced compared with the light-emitting device produced using a sapphire substrate.

Using the above thin-film substrate, it became clear that an optical waveguide in which the transmission loss is small and which can transmit ultraviolet light in low loss can be manufactured.

It was found that a thin film comprising as a main component at least one selected from gallium nitride, indium nitride and aluminum nitride and having various crystallization states, such as a single-crystal thin film, an amorphous thin film, a polycrystal thin film, and an orientated polycrystal thin film, etc. can be formed on the ceramic-based sintered compact having large surface roughness.

Using the ceramic-based sintered compact having such large surface roughness, a light-emitting device having higher luminous efficiency than light-emitting devices produced using conventional sapphire substrates can be produced.

It was found that the thin-film substrate having the synergistic effect which a single crystal and a ceramic-based sintered compact cannot make by itself, respectively, can be realized, if a single-crystal thin film comprising as a main component at least one selected from gallium nitride, indium nitride and aluminum nitride, and a ceramic-based sintered compact are unified firmly.

Thus, it was found that those having a high crystallinity which is equivalent to the lump-like or bulk-like single crystal, such as conventional sapphire and silicon carbide, or is near to it can be produced, even if it is a single-crystal thin film integrally adhered to a ceramic-based sintered compact.

It was found that a substrate having a characteristic in which realization is difficult in the material which exists and is used as a single crystal separately in itself, such as the shape of a lump and the shape of bulk, etc., such as conventional sapphire and silicon carbide, can realize when producing electronic devices, such as a light-emitting device, or electronic components, such as a circuit substrate, by unifying firmly a ceramic-based sintered compact and a single-crystal thin film which is excellent in crystallinity and comprises at least one selected from gallium nitride, indium nitride and aluminum nitride as a main component, and by producing a synergistic effect which a single crystal and a ceramic-based sintered compact cannot make by itself respectively.

In addition, this inventor found that the thin film comprising as a main component at least one selected from gallium nitride, indium nitride and aluminum nitride can be formed on the sintered compact which comprises as a main component a ceramic material having a hexagonal or trigonal crystal structure, such as silicon carbide, silicon nitride, gallium nitride, beryllium oxide, zinc oxide and aluminum oxide, etc., and that the single-crystal thin film which is excellent in crystallinity and comprises as a main component at least one selected from gallium nitride, indium nitride and aluminum nitride can be formed using the sintered compact of a specific surface state or surface roughness, even if it does not have the intermediate oxide film material of II group elements, such as mercury oxide, etc.

It has been found that a single-crystal thin film with excellent crystallinity can be formed on a sintered compact which comprises as a main component a ceramic material having a hexagonal or trigonal crystal structure and is provided beforehand with a thin film comprising as a main component at least one selected from gallium nitride, indium nitride and aluminum nitride.

Among the above sintered compacts comprising as a main component a ceramic material having a hexagonal or trigonal crystal structure, it found that those comprising beryllium oxide, zinc oxide, aluminum oxide, and gallium nitride as a main component and having specific composition are excellent for forming a single-crystal thin film. Since those excellent in optical permeability can be obtained, it found that it is desirable as a substrate for producing a light-emitting device.

It has been found that a light-emitting device excellent in luminous efficiency can be produced by using a zinc oxide-based sintered compact containing aluminum or a gallium nitride-based sintered compact, since they have electrical conductivity and optical permeability.

This invention includes the substrate for a thin film comprising the above sintered compact which comprises as a main component a ceramic material having a hexagonal or trigonal crystal structure, such as silicon carbide, silicon nitride, gallium nitride, beryllium oxide, zinc oxide and aluminum oxide, etc.

And this invention also includes the thin-film substrate in which a thin film comprising as a main component at least one selected from gallium nitride, indium nitride and aluminum nitride is formed on the substrate comprising a sintered compact which comprises as a main component a ceramic material having a hexagonal or trigonal crystal structure.

This invention includes the light-emitting device produced using the sintered compact which comprises as a main component a ceramic material having a hexagonal or trigonal crystal structure, such as silicon carbide, silicon nitride, gallium nitride, beryllium oxide, zinc oxide and aluminum oxide, etc., or the light-emitting device produced using a sintered compact which is provided beforehand with the thin film comprising at least one selected from gallium nitride, indium nitride and aluminum nitride as a main component and comprises as a main component a ceramic material having a hexagonal or trigonal crystal structure, such as silicon carbide, silicon nitride, gallium nitride, beryllium oxide, zinc oxide, etc. and aluminum oxide, etc.

The light-emitting device in which the luminous efficiency is equivalent or more at least or is a maximum of not less than 3-4 times can be manufactured compared with the light-emitting device produced using a sapphire substrate.

In addition, this inventor found that a single-crystal thin film more excellent in crystallinity can be formed on the various sintered compact which is provided beforehand with the thin film comprising at least one selected from gallium nitride, indium nitride and aluminum nitride as a main component and comprises as a main component a ceramic material, such as zirconium oxide, magnesium oxide, magnesium aluminate, titanium oxide, barium titanate, lead titanate zirconate, rare-earth oxides, such as yttrium oxide, thorium oxide, various ferrites, mullite, forsterite, steatite and glass, for example.

A single-crystal thin film excellent in crystallinity can be formed on the above various sintered compact which is provided with beforehand the thin film comprising at least one selected from gallium nitride, indium nitride and aluminum nitride as a main component and comprises as a main component a ceramic material, such as zirconium oxide, magnesium oxide, magnesium aluminate, titanium oxide, barium titanate, lead titanate zirconate, and rare-earth element oxides such as yttrium oxide, thorium oxide, various ferrites, mullite, forsterite, steatite and glass

In these various ceramic-based sintered compacts, it was found that that has optical permeability is also producible comparatively easily.

The inventor has found that the luminous efficiency of the light-emitting device produced using not only an aluminum nitride-based sintered compact and a sintered compact which comprises as a main component a ceramic material having a hexagonal or trigonal crystal structure, such as silicon carbide, silicon nitride, gallium nitride, beryllium oxide, zinc oxide and aluminum oxide, etc., but also a ceramic-based sintered compact, such as zirconium oxide, magnesium oxide, magnesium aluminate, titanium oxide, barium titanate, lead titanate zirconate, rare-earth oxides, such as yttrium oxide, thorium oxide, various ferrites, mullite, forsterite, steatite and glass is equal to that of light-emitting devices produced on sapphire substrates, or is more than not less than 3-4 times at maximum.

In addition, this inventor found that the luminous efficiency tends to be improved compared with the light-emitting device produced using those with small surface roughness in the light-emitting device produced using a ceramic-based sintered compact having a surface state being comparatively much unevenness, if saying in other words, a ceramic-based sintered compact having large surface roughness, even if the main component comprises the same ceramic material.

As mentioned above, this invention includes a substrate for a thin film for forming a single-crystal thin film comprising as a main component at least one selected from gallium nitride, indium nitride and aluminum nitride, characterized by comprising a ceramic-based sintered compact.

This invention includes a thin-film substrate characterized in that a single-crystal thin film comprising as a main component at least one selected from gallium nitride, indium nitride and aluminum nitride is formed on the ceramic-based sintered compact.

As mentioned above, this invention includes a substrate for a thin film for forming a single-crystal thin film comprising as a main component at least one selected from gallium nitride, indium nitride and aluminum nitride, characterized by comprising a ceramic-based sintered compact with optical permeability.

This invention includes a thin-film substrate characterized in that a single-crystal thin film comprising as a main component at least one selected from gallium nitride, indium nitride and aluminum nitride is formed on the ceramic-based sintered compact with optical permeability.

As mentioned above, this invention includes a light-emitting device produced using not only a sintered compact which comprises as a main component a ceramic material having a hexagonal or trigonal crystal structure, such as aluminum nitride, silicon carbide, silicon nitride, gallium nitride, beryllium oxide, zinc oxide and aluminum oxide, etc., but also a ceramic-based sintered compact, such as zirconium oxide, magnesium oxide, magnesium aluminate, titanium oxide, barium titanate, lead titanate zirconate, rare-earth oxides, such as yttrium oxide, thorium oxide, various ferrites, mullite, forsterite, steatite and glass, for example.

Thus, this invention also includes a light-emitting device produced using not only a sintered compact which comprises as a main component a ceramic material having a hexagonal or trigonal crystal structure, such as aluminum nitride, silicon carbide, silicon nitride, gallium nitride, beryllium oxide, zinc oxide and aluminum oxide, etc., but also a ceramic-based sintered compact, such as zirconium oxide, magnesium oxide, magnesium aluminate, titanium oxide, barium titanate, lead titanate zirconate, rare-earth oxides, such as yttrium oxide, thorium oxide, various ferrites, mullite, forsterite, steatite and glass, for example.

As mentioned above, this invention also includes a light-emitting device produced using not only a sintered compact which comprises as a main component a ceramic material having a hexagonal or trigonal crystal structure, such as aluminum nitride, silicon carbide, silicon nitride, gallium nitride, beryllium oxide, zinc oxide and aluminum oxide, etc., but also a sintered compact having optical permeability and comprising as a main component a ceramic material, such as zirconium oxide, magnesium oxide, magnesium aluminate, titanium oxide, barium titanate, lead titanate zirconate, rare-earth oxides, such as yttrium oxide, thorium oxide, various ferrites, mullite, forsterite, steatite and glass, for example.

As mentioned above, this invention also includes a light-emitting device produced using not only a sintered compact which comprises as a main component a ceramic material having a hexagonal or trigonal crystal structure, such as aluminum nitride, silicon carbide, silicon nitride, gallium nitride, beryllium oxide, zinc oxide and aluminum oxide, etc., but also a sintered compact which has a thin film comprising at least one selected from gallium nitride, indium nitride and aluminum nitride as a main component and comprises as a main component a ceramic material, such as zirconium oxide, magnesium oxide, magnesium aluminate, titanium oxide, barium titanate, lead titanate zirconate, rare-earth oxides, such as yttrium oxide, thorium oxide, various ferrites, mullite, forsterite, steatite and glass, for example.

As mentioned above, this invention also includes a light-emitting device produced using not only a sintered compact which comprises as a main component a ceramic material having a hexagonal or trigonal crystal structure, such as aluminum nitride, silicon carbide, silicon nitride, gallium nitride, beryllium oxide, zinc oxide and aluminum oxide, etc., but also a sintered compact which has a single-crystal thin film comprising at least one selected from gallium nitride, indium nitride and aluminum nitride as a main component and comprises as a main component a ceramic material, such as zirconium oxide, magnesium oxide, magnesium aluminate, titanium oxide, barium titanate, lead titanate zirconate, rare-earth oxides, such as yttrium oxide, thorium oxide, various ferrites, mullite, forsterite, steatite and glass, for example.

As mentioned above, this invention also includes a light-emitting device produced using not only a sintered compact which comprises as a main component a ceramic material having a hexagonal or trigonal crystal structure, such as aluminum nitride, silicon carbide, silicon nitride, gallium nitride, beryllium oxide, zinc oxide and aluminum oxide, etc., but also a sintered compact having large surface roughness and comprising as a main component a ceramic material, such as zirconium oxide, magnesium oxide, magnesium aluminate, titanium oxide, barium titanate, lead titanate zirconate, rare-earth oxides, such as yttrium oxide, thorium oxide, various ferrites, mullite, forsterite, steatite and glass, for example.

As mentioned above, this invention has been made by finding out that a single-crystal thin film comprising at least one selected from gallium nitride, indium nitride and aluminum nitride as a main component can be formed even if it is a ceramic-based sintered compact being heterogeneous compared with a single crystal or an orientated polycrystal having a specific crystal direction, and a thin-film substrate in which the single-crystal thin film was formed can manufacture comparatively easily as a result.

In addition, a single-crystal thin film comprising at least one selected from gallium nitride, indium nitride and aluminum nitride as a main component can be formed even if a ceramic-based sintered compact forming beforehand a thin film comprising as a main component at least one selected from gallium nitride, indium nitride and aluminum nitride is used, and a thin-film substrate in which the single-crystal thin film was formed can manufacture comparatively easily as a result.

It was found that those in which the luminous efficiency is equivalent or more at least or is a maximum of not less than 4-5 times compared with the light-emitting device produced using bulk-like single crystal substrates, such as conventional sapphire, can manufacture even if it is a light-emitting device produced using a ceramic-based sintered compact being heterogeneous compared with a single crystal or an orientated polycrystal having a specific crystal direction.

This inventor found that those in which the luminous efficiency is equivalent or more at least or is a maximum of not less than 4-5 times compared with the light-emitting device produced using a sapphire substrate, can manufacture even if it is a light-emitting device produced using a ceramic-based sintered compact forming beforehand a thin film comprising as a main component at least one selected from gallium nitride, indium nitride and aluminum nitride.

That is,

This invention is a substrate for a thin film for forming a single-crystal thin film comprising as a main component at least one selected from gallium nitride, indium nitride and aluminum nitride, and the substrate comprises a ceramic-based sintered compact.

This invention is a substrate for a thin film for forming a thin film comprising as a main component at least one selected from gallium nitride, indium nitride and aluminum nitride, and the substrate comprises a ceramic-based sintered compact having optical permeability.

This invention is the substrate for a thin film, wherein the ceramic-based sintered compact used for the above substrate for a thin film is an aluminum nitride-based sintered compact.

This invention is the substrate for a thin film, wherein the ceramic-based sintered compact used for the above substrate for a thin film is a sintered compact comprising as a main component a ceramic material having at least one of the crystal structure selected from a hexagonal system or a trigonal system.

This invention is the substrate for a thin film, wherein the ceramic-based sintered compact used for the above substrate for a thin film is a sintered compact comprising as a main component at least one selected from zinc oxide, beryllium oxide, aluminum oxide, silicon carbide, silicon nitride, and gallium nitride.

This invention is the substrate for a thin film, wherein the ceramic-based sintered compact used for the above substrate for a thin film is a sintered compact comprising as a main component at least one selected from zirconium oxide, magnesium oxide, magnesium aluminate, titanium oxide, barium titanate, lead titanate zirconate, a rare earth oxide, thorium oxide, various ferrites, mullite, forsterite, steatite and glass.

This invention is a manufacture method of the substrate for forming a thin film comprising as a main component at least one selected from gallium nitride, indium nitride and aluminum nitride, and the substrate comprises an aluminum nitride-based sintered compact manufactured using as a raw material at least respectively one of either selected from the reduction of aluminum oxide and the direct nitriding of metal aluminum, or that of the mixture made by reduction of aluminum oxide and by direct nitriding of metal aluminum.

This invention is a manufacture method for producing the substrate for forming a thin film comprising as a main component at least one selected from gallium nitride, indium nitride and aluminum nitride, and the substrate comprises an aluminum nitride-based sintered compact obtained by firing the powder compact or the aluminum nitride-based sintered compact for not less than 10 minutes at the temperature not less than 1500°C in non-oxidizing atmosphere.

This invention is an aluminum nitride-based sintered compact having optical permeability, wherein at least one selected from a rare earth element and an alkaline-earth metal is a total of not more than 0.5 % by weight on an element basis, oxygen is not more than 0.9 % by weight on an element basis, AlN is not less than 95 % as a crystal phase, the average size of aluminum nitride particles is not less than 5 µm.

This invention is a zinc oxide-based sintered compact containing an aluminum component at least and having optical permeability.

This invention is a gallium nitride-based sintered compact having optical permeability.

This invention is a gallium nitride-based sintered compact having electrical conductivity.

This invention is a gallium nitride-based sintered compact having optical permeability and electrical conductivity.

This invention is a gallium nitride-based sintered compact containing at least one selected from an alkaline-earth metal and a rare earth element.

This invention is a gallium nitride-based sintered compact containing at least one selected from zinc, cadmium, beryllium, magnesium, carbon, silicon, germanium, selenium and tellurium.

This invention is a gallium nitride-based sintered compact containing at least one selected from aluminum, indium, and oxygen.

This invention is a gallium nitride-based sintered compact containing at least one selected from a transition metal.

This invention is a powder comprising gallium nitride as a main component and being the oxygen content not more than 10 % by weight.

This invention is a powder comprising gallium nitride as a main component and being the average particle diameter not more than 10 µm.

This invention is a manufacture method of the powder comprising gallium nitride as a main component and being made by carrying out the nitriding reaction of metal gallium and a nitrogen-containing compound.

This invention is a manufacture method of the powder comprising gallium nitride as a main component and being made by carrying out the nitriding reaction of gallium oxide using a reducing agent and a nitrogen-containing compound.

This invention is a manufacture method of the powder comprising gallium nitride as a main component and being made by carrying out the nitriding reaction of a gas-like gallium compound and a nitrogen-containing compound.

This invention is a thin-film substrate in which a single-crystal thin film comprising as a main component at least one selected from gallium nitride, indium nitride and aluminum nitride is formed on the ceramic-based sintered compact.

This invention is a thin-film substrate in which a thin film comprising as a main component at least one selected from gallium nitride, indium nitride and aluminum nitride is formed on the ceramic-based sintered compact having optical permeability.

This invention is the thin-film substrate, wherein the ceramic-based sintered compact used for the above thin-film substrate is an aluminum nitride-based sintered compact.

This invention is the thin-film substrate, wherein the ceramic-based sintered compact used for the above thin-film substrate is a sintered compact comprising as a main component a ceramic material having at least one of the crystal structure selected from a hexagonal system or a trigonal system.

This invention is the thin-film substrate, wherein the ceramic-based sintered compact used for the above thin-film substrate is a sintered compact comprising as a main component at least one selected from zinc oxide, beryllium oxide, aluminum oxide, silicon carbide, silicon nitride, and gallium nitride.

This invention is the thin-film substrate, wherein the ceramic-based sintered compact used for the above thin-film substrate is a sintered compact comprising as a main component at least one selected from zirconium oxide, magnesium oxide, magnesium aluminate, titanium oxide, barium titanate, lead titanate zirconate, a rare earth oxide, thorium oxide, various ferrites, mullite, forsterite, steatite and glass.

This invention is a thin-film substrate in which an optical waveguide is formed on the aluminum nitride-based sintered compact by the thin film comprising as a main component at least one selected from gallium nitride, indium nitride and aluminum nitride.

This invention is a manufacture method of the thin-film substrate in which a single-crystal thin film comprising as a main component at least one selected from gallium nitride, indium nitride and aluminum nitride is formed on the ceramic-based sintered compact, and the thin film is formed using an organic compound containing at least one selected from gallium, indium, and aluminum as a main raw material and using at least one selected from ammonia, nitrogen, and hydrogen as the reactive gas.

This invention is a manufacture method of the thin-film substrate in which a single-crystal thin film comprising as a main component at least one selected from gallium nitride, indium nitride and aluminum nitride is formed on the ceramic-based sintered compact, and the thin film is formed using a halogenated compound containing at least one selected from gallium, indium, and aluminum as the main raw material and using at least one selected from ammonia, nitrogen, and hydrogen as the reactive gas.

This invention is a manufacture method of the thin-film substrate in which a thin film comprising as a main component at least one selected from gallium nitride, indium nitride and aluminum nitride is formed on the ceramic-based sintered compact having optical permeability, and the thin film is formed using an organic compound containing at least one selected from gallium, indium; and aluminum as the main raw material and using at least one selected from ammonia, nitrogen, and hydrogen as the reactive gas.

This invention is a manufacture method of the thin-film substrate in which a thin film comprising as a main component at least one selected from gallium nitride, indium nitride and aluminum nitride is formed on the ceramic-based sintered compact having optical permeability, and the thin film is formed using a halogenated compound containing at least one selected from gallium, indium, and aluminum as the main raw material and using at least one selected from ammonia, nitrogen, and hydrogen as the reactive gas.

This invention is an optical waveguide comprising as a main component at least one selected from gallium nitride, indium nitride and aluminum nitride and contains at least one selected from niobium and tantalum.

This invention is a light-emitting device constituted with the laminate which comprises a thin film comprising at least one selected from gallium nitride, indium nitride and aluminum nitride as a main component and contains at least N-type semiconductor layer, luminescence layer, and P-type semiconductor layer, and the laminate of N-type semiconductor layer, luminescence layer, and P-type semiconductor layer is formed on the ceramic-based sintered compact.

This invention is a light-emitting device constituted with the laminate which comprises a thin film comprising at least one selected from gallium nitride, indium nitride and aluminum nitride as a main component and contains at least N-type semiconductor layer, luminescence layer, and P-type semiconductor layer, and the laminate of N-type semiconductor layer, luminescence layer, and P-type semiconductor layer is formed on the ceramic-based sintered compact having optical permeability.

This invention is a light-emitting device constituted with the laminate which comprises a thin film comprising at least one selected from gallium nitride, indium nitride and aluminum nitride as a main component and contains at least N-type semiconductor layer, luminescence layer, and P-type semiconductor layer, and the laminate of N-type semiconductor layer, luminescence layer, and P-type semiconductor layer is formed on the ceramic-based sintered compact having large surface roughness.

This invention is a light-emitting device constituted with the laminate which comprises a thin film comprising at least one selected from gallium nitride, indium nitride and aluminum nitride as a main component and contains at least N-type semiconductor layer, luminescence layer, and P-type semiconductor layer, and the laminate of N-type semiconductor layer, luminescence layer, and P-type semiconductor layer is formed on the ceramic-based sintered compact forming the thin film comprising at least one selected from gallium nitride, indium nitride and aluminum nitride as a main component.

This invention is a light-emitting device constituted with the laminate which comprises a thin film comprising at least one selected from gallium nitride, indium nitride and aluminum nitride as a main component and contains at least N-type semiconductor layer, luminescence layer, and P-type semiconductor layer, and the laminate of N-type semiconductor layer, luminescence layer, and P-type semiconductor layer is formed on the ceramic-based sintered compact forming the single-crystal thin film comprising at least one selected from gallium nitride, indium nitride and aluminum nitride as a main component.

This invention is the light-emitting device, wherein the ceramic-based sintered compact used for the above light-emitting device is an aluminum nitride-based sintered compact.

This invention is the light-emitting device, wherein the ceramic-based sintered compact used for the above light-emitting device is a sintered compact comprising as a main component a material having at least one of the crystal structure selected from a hexagonal system or a trigonal system.

This invention is the light-emitting device, wherein the sintered compact being used for the above light-emitting device and comprising as a main component a material having at least one of the crystal structure selected from a hexagonal system or a trigonal system is a sintered compact comprising as a main component at least one selected from zinc oxide, beryllium oxide, aluminum oxide, silicon carbide, silicon nitride, and gallium nitride.

This invention is the light-emitting device, wherein the ceramic-based sintered compact used for the above light-emitting device is a sintered compact comprising as a main component at least one selected from zirconium oxide, magnesium oxide, magnesium aluminate, titanium oxide, barium titanate, lead titanate zirconate, a rare earth oxide, thorium oxide, various ferrites, mullite, forsterite, steatite and glass.

Concerning this invention, details were explained in Item 1-1727 described below.

### BRIEF DESCRIPTION OF THE DRAWINGS

Fig. 1 is a drawing showing the substrate for a thin film of this invention and the crystal orientation of the single-crystal thin film formed on that substrate.
Fig. 2 is a drawing showing the X-ray diffraction by the single-crystal thin film formed on the substrate for a thin film according to this invention.
Fig. 3 is a perspective view showing one example of the substrate for a thin film with conduction vias according to this invention.
Fig. 4 is the drawing showing the substrate for a thin film of this invention and the crystal orientation of the single-crystal thin film formed on the substrate.
Fig. 5 is a perspective view showing one example of the substrate for a thin film and the thin-film substrate according to this invention.
Fig. 6 is a perspective view showing one example of the thin-film substrate according to this invention.
Fig. 7 is a perspective view showing one example of the substrate for a thin film and the thin-film substrate having conduction vias according to this invention.
Fig. 8 is a perspective view showing one example of the thin-film substrate with conduction vias according to this invention.
Fig. 9 is a diagram showing the optical transmissivity of the aluminum nitride-based sintered compact according to this invention.
Fig. 10 is a perspective view showing one example of the substrate for a thin film according to this invention, wherein the thin film-conductive material was formed.
Fig. 11 is a perspective view showing one example of the substrate for a thin film according to this invention, wherein the thin film-conductive material was formed.
Fig. 12 is a perspective view showing one example of the substrate for a thin film with conduction vias according to this invention, wherein the thin film-conductive material was formed.
Fig. 13 is a perspective view showing one example of the substrate for a thin film according to this invention, wherein the thin film-conductive material of pattern form was formed.
Fig. 14 is a perspective view showing one example of the thin-film substrate according to this invention, wherein the thin film comprising as a main component at least one selected from gallium nitride, indium nitride and aluminum nitride is formed on the thin film-conductive material of pattern form was formed..
Fig. 15 is a perspective view showing one example of the thin-film substrate according to this invention, wherein the thin film-conductive material and the thin film comprising as a main component at least one selected from gallium nitride, indium nitride and aluminum nitride were formed respectively in the different surface.
Fig. 16 is a perspective view showing one example of the thin-film substrate according to this invention, wherein the thin film comprising as a main component at least one selected from gallium nitride, indium nitride and aluminum nitride was formed on the thin film-conductive material and the thin film-conductive material was formed further on the different surface.
Fig. 17 is a perspective view showing one example of the thin-film substrate according to this invention, wherein the thin film-conductive material was formed on the thin film comprising as a main component at least one selected from gallium nitride, indium nitride and aluminum nitride.
Fig. 18 is a perspective view showing one example of the thin-film substrate according to this invention, wherein the thin film comprising as a main component at least one selected from gallium nitride, indium nitride and aluminum nitride was formed on the aluminum nitride-based sintered compact forming beforehand a thin film-conductive material, and the thin film-conductive material was formed further on it.
Fig. 19 is a perspective view showing one example of the thin-film substrate according to this invention, wherein the thin film comprising as a main component at least one selected from gallium nitride, indium nitride and aluminum nitride was formed on the aluminum nitride-based sintered compact having conduction vias and forming beforehand a thin film-conductive material, and the thin film-conductive material was formed further on the surface of a thin film.
Fig. 20 is a perspective view showing one example of the thin-film substrate according to this invention, wherein the thin film comprising as a main component at least one selected from gallium nitride, indium nitride and aluminum nitride was formed further on the aluminum nitride-based sintered compact providing beforehand the thin film-conductive material, and the thin film-conductive material was formed further on the surface of a thin film.
Fig. 21 is a perspective view showing one example of the thin-film substrate according to this invention, wherein the two-dimension optical waveguide is being formed on the aluminum nitride-based sintered compact by the thin film comprising as a main component at least one selected from gallium nitride, indium nitride and aluminum nitride.
Fig. 22 is a perspective view showing one example of the thin-film substrate according to this invention, wherein the cladding layer was formed on the two-dimension optical waveguide.
Fig. 23 is a perspective view showing one example of the thin-film substrate according to this invention, wherein the two-dimension optical waveguide was formed.
Fig. 24 is a perspective view showing one example of the thin-film substrate according to this invention, wherein the three dimension optical waveguide was formed.
Fig. 25 is a perspective view showing one example of the thin-film substrate according to this invention, wherein the three dimension optical waveguide was formed.
Fig. 26 is a perspective view showing one example of the thin-film substrate according to this invention, wherein a ridge type of three dimension optical waveguide was formed.
Fig. 27 is a perspective view showing one example of the thin-film substrate according to this invention, wherein the three dimension optical waveguide was formed inside a two-dimension optical waveguide by the formation of a dielectric material in the two-dimension optical waveguide.
Fig. 28 is a perspective view showing one example of the thin-film substrate according to this invention, wherein the three dimension optical waveguide was formed in the inside of a two-dimension optical waveguide by carrying out the direct formation of a metal material into the two-dimension optical waveguide.
Fig. 29 is a perspective view showing one example of the thin-film substrate according to this invention, wherein the three dimension optical waveguide was formed by forming an electrode in the two-dimension optical waveguide via a buffer layer and applying potential between these electrodes.
Fig. 30 is a perspective view showing one example of the thin-film substrate according to this invention, wherein an embedded type of three dimension optical waveguide is formed in the thin film comprising as a main component at least one selected from gallium nitride, indium nitride and aluminum nitride.
Fig. 31 is a perspective view showing one example of the thin-film substrate according to this invention, wherein an embedded type of three dimension optical waveguide is formed and the electrodes are formed furthermore.
Fig. 32 is a perspective view showing one example of the thin-film substrate according to this invention, wherein an embedded type of three dimension optical waveguide is formed and the electrodes are formed furthermore.
Fig. 33 is a perspective view showing one example of the thin-film substrate according to this invention, wherein an embedded type of three dimension optical waveguide is formed and the electrodes are formed furthermore.
Fig. 34 is a perspective view showing one example of the thin-film substrate according to this invention, wherein the three dimension optical waveguide is formed and the electrical circuit is formed furthermore.
Fig. 35 is a perspective view showing one example of the thin-film substrate according to this invention, wherein an embedded type of three dimension optical waveguide is formed and the electrical circuit is formed furthermore.
Fig. 36 is a perspective view showing one example of the substrate for a thin film according to this invention.
Fig. 37 is a perspective view showing one example of the thin-film substrate according to this invention, wherein the thin film comprising as a main component at least one selected from gallium nitride, indium nitride and aluminum nitride was formed on the thin film-conductive material.
Fig. 38 is a perspective view showing one example of the thin-film substrate with conduction vias according to this invention, wherein the thin film comprising as a main component at least one selected from gallium nitride, indium nitride and aluminum nitride was formed on the thin film-conductive material.
Fig. 39 is a sectional drawing showing one example of the constitution of a light-emitting device.
Fig. 40 is a sectional drawing showing one example of a light-emitting device which used a conventional substrate.
Fig. 41 is a sectional drawing showing one example of a light-emitting device which used a conventional substrate.
Fig. 42 is a sectional view showing one example of the light-emitting device of this invention.
Fig. 43 is a sectional view showing one example of the light-emitting device of this invention.
Fig. 44 is a sectional view showing one example of the light-emitting device of this invention.
Fig. 45 is a perspective view showing one example of the light-emitting device of this invention.
Fig. 46 is a perspective view showing one example of the light-emitting device of this invention.
Fig. 47 is a sectional view showing one example of the light-emitting device of this invention.
Fig. 48 is a sectional view showing one example of the light-emitting device of this invention.
Fig. 49 is a sectional view showing one example of the light-emitting device of this invention.
Fig. 50 is a sectional view showing one example of the light-emitting device of this invention.
Fig. 51 is a sectional view showing one example of the light-emitting device of this invention.
Fig. 52 is a sectional view showing one example of the light-emitting device of this invention.
Fig. 53 is a sectional view showing one example of the light-emitting device of this invention.
Fig. 54 is a sectional view showing one example of the light-emitting device of this invention.
Fig. 55 is a sectional view showing one example of the light-emitting device of this invention.
Fig. 56 is a sectional view showing one example of the light-emitting device of this invention.
Fig. 57 is a sectional view showing one example of the light-emitting device of this invention.
Fig. 58 is a sectional view showing one example of the light-emitting device of this invention.
Fig. 59 is a sectional drawing showing one example of luminescence of the light-emitting device of this invention.
Fig. 60 is a perspective view showing one example of luminescence of the light-emitting device of this invention.
Fig. 61 is a perspective view showing one example of the light-emitting device of this invention.
Fig. 62 is a figure showing one example of an X-ray diffraction pattern of an amorphous AlN thin film.
Fig. 63 is a figure showing one example of an X-ray diffraction pattern of a polycrystalline AlN thin film.
Fig. 64 is a figure showing one example of an X-ray diffraction pattern of an orientated-polycrystalline AlN thin film formed in such a direction that its C axis is perpendicular to the substrate surface.
Fig. 65 is a figure showing one example of an X-ray diffraction pattern of a single-crystalline AlN thin film a formed in such a direction that its C axis is perpendicular to the substrate surface.
Fig. 66 is a pattern showing one example of the rocking curve of X-ray diffraction line from the lattice plane (002), measured by the ω scanning of the single-crystal AlN thin film formed in such a direction that its C axis is perpendicular to the substrate surface.
Fig. 67 is a figure showing one example of an X-ray diffraction pattern of a single-crystal GaN thin film formed in such a direction that its C axis is perpendicular to the substrate surface.
Fig. 68 is a figure showing one example of an X-ray diffraction pattern of a single-crystal InN thin film formed in such a direction that its C axis is perpendicular to the substrate surface.
Fig. 69 is an elevational view showing one example of the thin film-conductive material of this invention.
Fig. 70 is an elevational view showing one example of the thin film-conductive material of this invention.
Fig. 71 is a mimetic diagram showing one example of the surface state of the ceramic-based sintered compact with comparatively irregular and large roughness.
Fig. 72 is a perspective view showing one example of the surface state of the ceramic-based sintered compact with regular and large roughness.

Fig. 73 is a perspective view showing one example of the surface state of the ceramic-based sintered compact with regular and large roughness.

### DETAILED DESCRIPTION OF THE PREFERRED EMBODIMENTS

The meaning and the purpose of this invention are to offer the substrate having outstanding function, the electronic devices, such as a light-emitting device which used this substrate, or the electronic components, such as a circuit substrate, which are hard to realize by the material which exists as a single crystal and is used independently in itself, such as the shape of a lump and the shape of bulk, such as conventional sapphire and silicon carbide, by unifying firmly a single-crystal thin film which is excellent in crystallinity and comprising at least one selected from gallium nitride, indium nitride and aluminum nitride as a main component and a ceramic-based sintered compact, and by producing a synergistic effect which a single crystal and a ceramic-based sintered compact cannot make by itself respectively. And, it is the offering of a ceramic-based sintered compact which brings about such an effect.

This invention relates to the thin-film substrate using the ceramic-based sintered compact, and the electronic devices using the substrate, if it sees widely. More specifically,
(1) A substrate for forming a single-crystal thin film comprising gallium nitride, indium nitride and aluminum nitride as a main component,
(2) A material of the above substrate for single-crystal thin film formation,
(3) A thin-film substrate in which a single-crystal thin film comprising gallium nitride, indium nitride and aluminum nitride as a main component was formed,
(4) An optical waveguide constituted by the single-crystal thin film comprising gallium nitride, indium nitride and aluminum nitride as a main component,
(5) A light-emitting device constituted by the single-crystal thin film comprising gallium nitride, indium nitride and aluminum nitride as a main component, the feature is in the point using various ceramic-based sintered compacts as a substrate, such as an aluminum nitride-based sintered compact.
(6) A substrate for forming a thin film comprising gallium nitride, indium nitride and aluminum nitride as a main component,
(7) A material of the above substrate for a thin film,
(8) A thin-film substrate in which a thin film comprising gallium nitride, indium nitride and aluminum nitride as a main component was formed,
(9) An optical waveguide constituted by the thin film comprising gallium nitride, indium nitride and aluminum nitride as a main component,
(10) A light-emitting device constituted by the thin film comprising gallium nitride, indium nitride and aluminum nitride as a main component, the feature is in the point using a ceramic-based sintered compact with optical permeability as a substrate, such as an aluminum nitride-based sintered compact.

That is, these inventions are based on the findings that the thin film excellent in crystallinity comprising gallium nitride, indium nitride, and aluminum nitride as a main component can be formed on the various ceramic-based sintered compacts, such as an aluminum nitride-based sintered compact, and it has been based on the phenomenon newly found in process of examination which forms the single-crystal thin film excellent in crystallinity comprising gallium nitride, indium nitride, and aluminum nitride as a main component into the various ceramic-based sintered compacts, such as an aluminum nitride-based sintered compact.

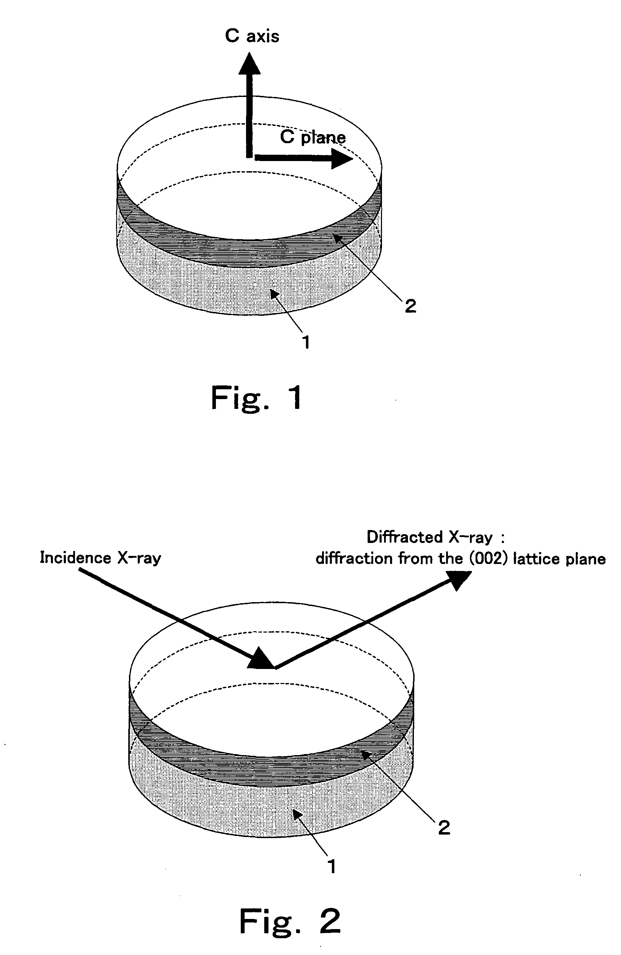

The reference numerals in Figs. 1-73 are as follows:
1 Substrate comprising the aluminum nitride-based sintered compact,
2 Single crystal thin film comprising as a main component at least one selected from gallium nitride, indium nitride and aluminum nitride,
3 Conduction via,
4 Sintered compact substrate comprising aluminum nitride as a main component, sintered compact substrate comprising as a main component a ceramic material having the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., or other ceramic-based sintered compact substrates,
5 Thin film comprising as a main component at least one selected from gallium nitride, indium nitride and aluminum nitride,
6 Thin-film substrate,
7 Thin-film substrate having conduction vias,
8 Thin film comprising as a main component at least one selected from gallium nitride, indium nitride and aluminum nitride,
9 Substrate with conduction vias comprising an aluminum nitride-based sintered compact, various sintered compact which comprises as a main component a ceramic material having the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., and other various sintered compact comprising a ceramic material as a main component in addition to these
10: Substrate comprising an aluminum nitride-based sintered compact having conduction vias
11 : Thin conductive film
12: Thin conductive film in a circuit pattern form
13: Substrate comprising aluminum nitride-based sintered compact,
14: Substrate comprising aluminum nitride-based sintered compact,
15: Thin-film substrate with a thin film-conductive material,
16: Thin with conduction vias and a thin film-conductive material,
17 : Thin-film substrate with conduction vias and a thin film-conductive material,
18: Thin-film substrate with a thin film-conductive material,
19: Thin-film substrate with a thin film-conductive material,
20: Thin with conduction vias and a thin film-conductive material,
21: Thin-film substrate with a thin film-conductive material,
24: Space formed in a thin film-conductive material,
30: Substrate for light-emitting device,
31: Buffer layer,
32: Light-emitting device,
32-1: Thin film,
32-2: Thin film comprising as a main component at least one selected from gallium nitride, indium nitride and aluminum nitride,
33: Conventional substrate for light-emitting device
34: Thin film layer comprising as a main component at least one selected from gallium nitride, indium nitride and aluminum nitride and having N- or P-type semiconductor characteristics
34-1: Thin film layer comprising as a main component at least one selected from gallium nitride, indium nitride and aluminum nitride and having N- or P-type semiconductor characteristics
34-1-1: Thin film layer comprising as a main component at least one selected from gallium nitride, indium nitride and aluminum nitride and having N- or P-type semiconductor characteristics
34-1-2: Thin film layer comprising as a main component at least one selected from gallium nitride, indium nitride and aluminum nitride and having N- or P-type semiconductor characteristics
34-2: Thin film layer comprising as a main component at least one selected from gallium nitride, indium nitride and aluminum nitride and having N- or P-type semiconductor characteristics
34-2-1: Thin film layer comprising as a main component at least one selected from gallium nitride, indium nitride and aluminum nitride and having N- or P-type semiconductor characteristics
34-2-2: Thin film layer comprising as a main component at least one selected from gallium nitride, indium nitride and aluminum nitride and having N- or P-type semiconductor characteristics
35: Thin film layer comprising as a main component at least one selected from gallium nitride, indium nitride and aluminum nitride and having N- or P-type semiconductor characteristics
35-1: Thin film layer comprising as a main component at least one selected from gallium nitride, indium nitride and aluminum nitride and having N- or P-type semiconductor characteristics
35-1-1: Thin film layer comprising as a main component at least one selected from gallium nitride, indium nitride and aluminum nitride and having N- or P-type semiconductor characteristics
35-1-2: Thin film layer comprising as a main component at least one selected from gallium nitride, indium nitride and aluminum nitride and having N- or P-type semiconductor characteristics
35-2: Thin film layer comprising as a main component at least one selected from gallium nitride, indium nitride and aluminum nitride and having N- or P-type semiconductor characteristics
35-2-1: Thin film layer comprising as a main component at least one selected from gallium nitride, indium nitride and aluminum nitride and having N- or P-type semiconductor characteristics
35-2-2: Thin film layer comprising as a main component at least one selected from gallium nitride, indium nitride and aluminum nitride and having N- or P-type semiconductor characteristics
36: Luminescence layer
37: Light-emitting device using a conventional substrate
38: Electrode
38-1: Terminal for electric power supplies
39: Light-emitting device according to this invention
40: Dielectric material
50: Two dimensional optical waveguide
60: Three dimension optical waveguide
61: Ridge type of three dimension optical waveguide
62: Three dimension optical waveguide
63: Three dimension optical waveguide
64: Three dimension optical waveguide
65: Embedded type of three dimension optical waveguide
65': Optical introductory part of the optical waveguide
66: Introductory light to an optical waveguide
66': Emission light from the optical waveguide
70: Cladding layer
71: Cladding layer
80: Thin film comprising as a main component at least one selected from gallium nitride, indium nitride and aluminum nitride
90: Electrode
91: Electrode
100: Metal material
110: Buffer layer
120: Electrode
130: Substrate comprising a ceramic-based sintered compact having electrical conductivity
140: Light emitted from the luminescence layer
141: Light penetrating the substrate and emitted outside from a light-emitting device
142: Light emitted to the outside of a light-emitting device from the thin film layer
143: Light emitted to the outside of a light-emitting device from the luminescence layer 150: Interface of the substrate and the thin film layer
160: Interface of the substrate and the outside space
170: Slot
171: Slot

The substrate for a thin film may be formed by a ceramic-based sintered compact with or without optical permeability.
(1) A ceramic-based sintered compact with optical permeability is provided with a thin film comprising as a main component at least one selected from gallium nitride, indium nitride and aluminum nitride.
(2) A ceramic-based sintered compact without optical permeability is provided with a thin film comprising as a main component at least one selected from gallium nitride, indium nitride and aluminum nitride. Specifically,
(3) The ceramic-based sintered compact is an aluminum nitride-based sintered compact substrate.
(4) The sintered compact comprises as a main component a ceramic material having a hexagonal or trigonal crystal structure.
(5) The aluminum nitride-based sintered compact substrate is provided with a thin film comprising as a main component at least one selected from gallium nitride, indium nitride and aluminum nitride.
(6) The substrate comprising a sintered compact comprising as a main component a ceramic material having a hexagonal or trigonal crystal structure is provided with a thin film comprising as a main component at least one selected from gallium nitride, indium nitride and aluminum nitride.
(7) The sintered compact substrate comprises as a main component at least one of various ceramics, such as zirconium oxide, magnesium oxide, magnesium aluminate, titanium oxide, barium titanate, lead titanate zirconate, and rare-earth element oxides such as yttrium oxide, thorium oxide, various ferrites, mullite, forsterite, steatite and glass.
(8) The sintered compact comprises as a main component at least one of various ceramics, such as zirconium oxide, magnesium oxide, magnesium aluminate, titanium oxide, barium titanate, lead titanate zirconate, and rare-earth element oxides such as yttrium oxide, thorium oxide, ferrite, mullite, forsterite, steatite and glass, on which a thin film comprising as a main component at least one selected from gallium nitride, indium nitride and aluminum nitride is formed.

A ceramic-based sintered compact substrate with or without optical permeability is provided with a single-crystal thin film comprising as a main component at least one selected from gallium nitride, indium nitride and aluminum nitride.

The ceramic-based sintered compact substrate is provided with a thin film comprising as a main component at least one selected from gallium nitride, indium nitride and aluminum nitride, which may be in a single-crystalline, amorphous, polycrystalline or orientated polycrystalline.

The single-crystal thin film comprising as a main component at least one selected from gallium nitride, indium nitride and aluminum nitride is formed on the ceramic-based sintered compact with or without optical permeability.

Specifically,
(1) The aluminum nitride-based sintered compact is provided with a single-crystal thin film comprising as a main component at least one selected from gallium nitride, indium nitride and aluminum nitride.
(2) The sintered compact which comprises as a main component a ceramic material having a hexagonal or trigonal crystal structure is provided with a single-crystal thin film comprising as a main component at least one selected from gallium nitride, indium nitride and aluminum nitride.
(3) The sintered compact comprising as a main component at least one of various ceramics, such as zirconium oxide, magnesium oxide, magnesium aluminate, titanium oxide, barium titanate, lead titanate zirconate, and rare-earth element oxides such as yttrium oxide, thorium oxide, various ferrites, mullite, forsterite, steatite and glassa is provided with a single-crystal thin film comprising as a main component at least one selected from gallium nitride, indium nitride and aluminum nitride.
(4) The aluminum nitride-based sintered compact with optical permeability is provided with a thin film comprising as a main component at least one selected from gallium nitride, indium nitride and aluminum nitride.
(5) The sintered compact having optical permeability and comprising as a main component a ceramic material having a hexagonal or trigonal crystal structure is provided with a thin film comprising as a main component at least one selected from gallium nitride, indium nitride and aluminum nitride.
(6) The thin-film substrate having a thin film comprising as a main component at least one selected from gallium nitride, indium nitride and aluminum nitride, which is formed on a sintered compact having optical permeability and comprising as a main component zirconium oxide, magnesium oxide, magnesium aluminate, titanium oxide, barium titanate, lead titanate zirconate, and rare-earth element oxides such as yttrium oxide, thorium oxide, various ferrites, mullite, forsterite, steatite and glass.

A thin film comprising as a main component at least one selected from gallium nitride, indium nitride and aluminum nitride, which is single-crystalline, amorphous, polycrystalline or orientated-polycrystalline, is formed on either one of the aluminum nitride-based sintered compact, the sintered compact which comprises as a main component a ceramic material having a hexagonal or trigonal crystal structure, and the ceramic-based sintered compact, such as zirconium oxide, magnesium oxide, magnesium aluminate, titanium oxide, barium titanate, lead titanate zirconate, and rare-earth element oxides such as yttrium oxide, thorium oxide, various ferrites, mullite, forsterite, steatite and glass.

The above thin film can use not only the single layer but also the thin film comprising two or more layers, such that at least one of crystallization states selected from a single crystal, an amorphous state, a polycrystal, and an orientated polycrystal is formed beforehand on the ceramic-based sintered compact and that a single-crystal thin film is formed furthermore on it.

It usually tends to improve the crystallinity of the single-crystal thin film formed after the thin film having at least one of crystallization states selected from a single crystal, an amorphous state, a polycrystal, and an orientated polycrystal was formed beforehand compared with that formed directly on the ceramic-based sintered compact, it is preferable.

The above thin-film substrate can be used as a substrate for a thin film for forming the thin film comprising as a main component at least one selected from gallium nitride, indium nitride and aluminum nitride.

In addition, about the glass used as the above ceramic-based sintered compact, it has the structure in which crystal substances, such as cordierite, anorthite (anorthite), corundum (Al₂O₃), mullite (3Al₂O₃·2SiO₂), wollastonite (CaO-SiO₂), and magnesium silicate (MgO-SiO₂), exist in the glass matrix, for example, such as borosilicate glass (usually, it comprises SiO₂ and B₂O₃ as a main component, and contains components, such as Al₂O₃, CaO, BaO, and PbO, etc., in addition to this).

Glass ceramics is usually produced by the method which fires and sinters the powder compact which is made by the uniaxial press method or the sheet forming method, adding suitably alumina powder, silica powder, magnesia powder, calcium carbonate powder, barium carbonate powder, boron oxide powder, lead oxide, etc. into glass powder, adding furthermore components, such as TiO₂, ZrO₂, SnO₂, ZnO, and Li₂O, if it requires, and mixing them.

If what added suitably components, such as above TiO₂, ZrO₂, SnO₂, ZnO, and Li₂O, at the time of manufacture is fired, crystallization will be promoted in many cases.

In addition, glass can be produced with the method which deposits a crystal in the molded glass, etc., heat-treating the molded glass which was fused and formed.

"Ceramic material" means that the material constituting a sintered compact is what comprises an inorganic material as a main component, in the ceramic-based sintered compact or the ceramic-based sintered compact with optical permeability which are used as the substrate for a thin film and the thin-film substrate according to this invention.

Usually, the inorganic material comprises the composite or compound of at least one selected from metal elements and semimetal elements and at least one selected from nonmetallic elements, or the composite or compound of at least one selected from metal elements and at least one selected from semimetal elements, or the composite or compound of at least two selected from semimetal elements.

As the above nonmetallic element, usually, nitrogen, phosphorus, oxygen, sulfur, halogen element (fluorine, chlorine, bromine, iodine, astatine), etc. are used suitably.

As semimetal elements, usually, boron, carbon, silicon, germanium, arsenic, antimony, bismuth, selenium, tellurium, polonium, etc. are used suitably.

The above ceramic materials usually comprise as a main component an inorganic compound, and such ceramic materials may be a crystallization state, or an amorphous state, such as glass, etc., or a state in which a crystalline material and an amorphous material are intermingled.

The above ceramic material usually comprises as a main component a compound or a composite, such as nitrides, carbides, oxides, borides and silicides.

If these compounds or composites are shown specifically, for example, there are aluminum nitride, a compound having at least one of the crystal structure selected from a hexagonal system or a trigonal system (for example, silicon carbide, silicon nitride, gallium nitride, zinc oxide, beryllium oxide, aluminum oxide, etc.), zirconium oxide, magnesium oxide, magnesium aluminate, titanium oxide, barium titanate, lead titanate zirconate, rare-earth oxides, such as yttrium oxide, thorium oxide, various ferrites, mullite, forsterite, steatite and glass

As the above ceramic materials, the things containing non-metal, such as a halogen element or a chalcogen element, etc., for example, in addition to a metal, an alloy, an intermetallic compound, an organic substance, an organic compound, and an organic resin are included other than the inorganic material which is the main components.

The above ceramic-based sintered compact preferably has optical permeability, since a single-crystal thin film formed thereon and comprising as a main component at least one selected from gallium nitride, indium nitride and aluminum nitride easily has improved crystallinity.

According to this invention, the above substrate for a thin film and thin-film substrate can be used as a substrate for producing a light-emitting device by forming the epitaxially grown thin film comprising as a main component at least one selected from gallium nitride, indium nitride and aluminum nitride onto them.

The epitaxially grown thin film can be used as a substrate for field emission material.

The thin-film substrate can be used for an optical waveguide, the piezo-electric film of surface acoustic wave devices, etc., and the insulation film or dielectric film of electrical wiring boards, etc., by processing suitably the thin film formed on it from the first, without forming furthermore a thin film or a single-crystal thin film.

The sintered compact substrate for forming a single-crystal thin film comprising as a main component at least one selected from gallium nitride, indium nitride and aluminum nitride is neither a bulk-like single crystal nor an orientated polycrystalline substance.

A bulk-like single crystal cannot exist as a single crystal only in a state where it is formed in other material, such as a substrate, it means those which can exist as a single crystal in the self state.

Therefore, it is not related to the size, if it can exist as a single crystal in the self state, it is a bulk-like single crystal even if it is a thin film shape and is a small grain shape, and even if coexisting with other materials, such as being temporarily formed on a substrate.

An orientated polycrystal is a polycrystal in which the crystal of constitution material has a specific crystal-axis direction and has a random direction to the other crystal-axis direction, and differs from a bulk-like single crystal.

For example, it differs from the usual polycrystal in which the crystal of constitution material, such as a sintered compact, has the random direction.

On the sintered compact substrate comprising as a main component at least one selected from gallium nitride, indium nitride and aluminum nitride, aluminum nitride crystal grains are oriented randomly in the thin film.

On the substrate comprising a sintered compact which comprises as a main component a ceramic material having a hexagonal or trigonal crystal structure, or on the sintered compact comprising as a main component at least one of various ceramics, such as zirconium oxide, magnesium oxide, magnesium aluminate, titanium oxide, barium titanate, lead titanate zirconate, and rare-earth element oxides such as yttrium oxide, thorium oxide, various ferrites, mullite, forsterite, steatite and glass in addition to aluminum nitride, fine crystal grains are oriented randomly in the thin film.

When single-wavelength characteristic X-rays are irradiated to the substrate of this invention, only diffraction lines from a specific crystal plane appear in the case of a bulk-like single crystal and an orientated polycrystal, but all diffraction lines except for those which cannot appear as a basis appear by an extinction rule in the case of the substrate of this invention. In this sense, the substrate of the present invention is clearly distinguishable from those of bulk-like single crystals.

The aluminum nitride-based sintered compact, the sintered compact which comprises as a main component a ceramic material having a hexagonal or trigonal crystal structure, or the sintered compact comprising as a main component at least one of various ceramics, such as zirconium oxide, magnesium oxide, magnesium aluminate, titanium oxide, barium titanate, lead titanate zirconate, and rare-earth element oxides such as yttrium oxide, thorium oxide, various ferrites, mullite, forsterite, steatite and glass are polycrystalline. Such sintered compact is produced by high-temperature firing of a green body comprising ceramic powders, a sintering aid, an organic binder, a solvent, etc.

The single-crystal thin film is formed integrally on the ceramic-based sintered compact substrate. It extends two-dimensionally and integrally with the substrate, unlike the three-dimensional bulk-like single crystal.

Conventionally, when the single crystals having comparative large size and can be expressed with the three-dimensional size, such as the shape of a lump and the shape of bulk, are grown up on a substrate by the sublimating method, etc. for example, those which is comparatively excellent in crystallinity can be produced easily in many cases, without seldom being influenced with the composition and material quality of a substrate or the internal structure and surface state of a substrate, etc.

The lump-like or bulk-like single crystal formed can be separated from a substrate. On the other hand, the two-dimensional, single-crystal thin film of this invention may be adhered integrally to the ceramic-based sintered compact substrate. However, when such single-crystal thin film adhered to the ceramic-based sintered compact is as thin as 300 µm or less, usually about 100-200 µm, it is easily influenced by the composition and material, heterogeneous internal structure and surface state of the polycrystalline, ceramic-based sintered compact, resulting in as low crystallinity as amorphous, polycrystalline or an orientated-polycrystalline. It is thus difficult to form a single-crystal thin film.

For the reasons of the difference of the internal structure of a film-like single crystal and the internal structures of the ceramic-based sintered compact, a crack and a defect arise in the single-crystal thin film formed, and it was easy to produce exfoliation, etc. in the interface of the single-crystal thin film and ceramic-based sintered compact.

Though it seems that methods, such as the above sublimating method for example, are suitable as a method of obtaining an independently large-sized single crystal, such as the shape of a lump and the shape of bulk, it is easy to produce distortion since the crystal growth is performed at high temperature, and the single-crystal thin film and substrate have the fault of being easy to produce faults, such as crack and exfoliation when growing a single-crystal thin film into a substrate.

It was thus difficult to produce the single-crystal thin film integral with the substrate.

In such a situation, according to this invention, to the ceramic-based sintered compact, directly, the single-crystal thin film comprising as a main component at least one selected from gallium nitride, indium nitride and aluminum nitride adheres and is unified firmly, it became possible to be able to form in a state where there is nothing, such as the above crack, defect, or exfoliation.

According to this invention, even a single-crystal thin film is adhered integrally to the ceramic-based sintered compact.

Using the ceramic-based sintered compact and formed beforehand the thin film comprising as a main component at least one selected from gallium nitride, indium nitride and aluminum nitride and having various crystal states, such as the single crystal, the amorphous, the polycrystal, and the orientated polycrystal, etc. for example, the single-crystal thin film comprising as a main component at least one selected from gallium nitride, indium nitride and aluminum nitride and being excellent in crystallinity is unified firmly on it, and it became clear that it can be formed in a state where there is nothing, such as the above crack, defect, or exfoliation.

Even if such single-crystal thin film formed has comparatively thick thickness and is thicker, for example than 100-200 µm, those excellent in crystallinity can be formed.

As the reason the crystalline improvement in such a single-crystal thin film is seen, it becomes hard to be influenced with the composition, quality of the material, internal structure, or surface state, etc. of the ceramic-based sintered compact and is a polycrystalline substance by forming beforehand the thin film of the various above crystal states, therefore it probably seems that the single-crystal thin film which is more excellent in crystallinity becomes easy to grow.

This invention provides the substrate for a thin film which used such a ceramic-based sintered compact.

This invention also provides the thin-film substrate in which a ceramic-based sintered compact, and a single-crystal thin film with higher crystallinity comprising as a main component at least one selected from gallium nitride, indium nitride and aluminum nitride are unified firmly.

The single-crystal thin film comprising as a main component at least one selected from gallium nitride, indium nitride and aluminum nitride and being more excellent in crystallinity can be formed on the various sintered compacts having optical permeability and comprise as a main component a ceramic material, such as aluminum nitride, etc., in many cases, and even if a thin film has comparatively thick thickness and is thicker, for example than 100-200 µm, comparatively high crystallinity can be obtained in many cases.

The sintered compact based on ceramics such as aluminum nitride with optical permeability has higher purity and more homogeneous internal structure than those without optical permeability.

The single-crystal thin film comprising as a main component at least one selected from gallium nitride, indium nitride and aluminum nitride, which is adhered integrally to the polycrystalline sintered compact, is easily influenced by the composition, material, internal structure and surface state of the sintered compact, unlike the lump-like or bulk-like single crystal.

A high-crystallinity, field-like, single-crystal thin film comprising as a main component at least one selected from gallium nitride, indium nitride and aluminum nitride can be formed integrally with the ceramic-based sintered compact with optical permeability.

The high-crystallinity, single-crystal thin film comprising as a main component at least one selected from gallium nitride, indium nitride and aluminum nitride, which is single-crystalline, amorphous, polycrystalline or orientated-polycrystalline, is suitably formed on a ceramic-based sintered compact with optical permeability.

The thin-film substrate of the present invention comprises a ceramic-based sintered compact with optical permeability, and a high-crystallinity, single-crystal thin film comprising as a main component at least one selected from gallium nitride, indium nitride and aluminum nitride, which is formed integrally on the ceramic-based sintered compact.

The three-dimensional single crystals having comparative large size, such as a lump or a bulk, after sublimating the material itself by heating the raw material containing the single-crystal material itself (for example, in the case of the bulk-like single crystal comprising silicon carbide as a main component, it is silicon carbide powder, and when producing the bulk-like single crystal comprising aluminum nitride as a main component, it is aluminum nitride powder.) in the comparatively high temperature or near the melting point and decomposition temperature of a material (for example, in the case of the bulk-like single crystal comprising silicon carbide as a main component, it is about 2000-2600°C, In the case of the bulk-like single crystal comprising aluminum nitride as a main component, it is about 1700-2200°C.) which are probably near the equilibrium state, controlling the pressure of atmosphere, gas composition, etc. like the sublimating method, for example, it is usually produced by the method of making it deposit as a single crystal in many cases. The large single crystal excellent in crystallinity independently can be produced comparatively easily in many cases without seldom being influenced by the material quality of a substrate or the internal structure or surface state of a substrate, etc.

This is probably considered that a single crystal with high crystallinity grows without seldom being influenced by a substrate, since it is carried out in the state near equilibrium and the sublimation substance itself tends to become a seed crystal when growing the above lump-like or bulk-like single crystal onto a substrate by the sublimating method.

Since the alumina of a raw material is fused and a single crystal is grown when producing sapphire, for example by the Czochralski method, etc., the single crystal is produced in the state near equilibrium.

According to this invention, if the single-crystal thin film having the shape of two-dimensional spread is formed in the state which adhered to the a ceramic-based sintered compact substrate and is integrally adhered to it, it is usually produced by the MOCVD (Metal Organic Chemical Vapor Deposition) method, the MOVPE (Metal Organic Vapor Phase Epitaxy) method or the Halide VPE (Halogen Transport Vapor Phase Epitaxy) method, etc. to make the crystallinity ofa single-crystal thin film easier to raise.

In such a method, the substrate temperature is usually about 1500°C at maximum, there is a substrate temperature range which is easily single-crystallized by the forming method or the single crystal composition. As raw materials for a single-crystal thin film, metal-containing compounds, for example, gallium-containing compounds such as trimethyl gallium for gallium nitride, indium-containing compounds such as trimethyl indium for indium nitride, or aluminum-containing compounds such as trimethyl aluminum for aluminum nitride, are mostly used for a target, there is a low crystallinity case where it becomes an amorphous, a polycrystal thin film, or an orientated polycrystal thin film, for example, according to conditions, because such a compound passes through process in which a single-crystal thin film is obtained by being once decomposed and being made into the target composition by a nitriding reaction after that, and formation of a single-crystal thin film is easily performed in a non-equilibrium state.

Though the sputtering method, the ion plating method, or the vapor-depositing method, etc. can be used as a method of performing thin film formation using the thin film composition itself which does not pass through process, such as decomposition and a reaction, as a raw material for thin film formation, usually, the thin film cannot become a single crystal easily since thin film formation is performed under a non-equilibrium state, such that it is performed under the low substrate temperature of about not more than 600-700°C, it is easy to become an amorphous thin film, a polycrystal thin film, or an orientated polycrystal thin film which are low in crystallinity.

The single-crystal thin film formed on a substrate tends to have lower crystallinity than the lump-like or bulk-like single crystal having three-dimensional size, resulting in such defects as cracking and exfoliation.

This invention presents the method which can provide those having comparatively high crystallinity equally close to the lump-like or bulk-like single crystal and having few defects, such as a crack and exfoliation between substrates even if it is the single-crystal thin film in which the crystallinity tends to become small and having the tendency which produces a defect, etc.

According to this invention, even if it is not only those as thick as less than 300 µm, usually about 200 µm, but also those as thick as about 0.1nm, it can form now suitably as the single-crystal thin film comprising as a main component at least one selected from gallium nitride, indium nitride and aluminum nitride, for example.

As mentioned above, the single-crystal thin film comprising as a main component at least one selected from gallium nitride, indium nitride and aluminum nitride can be formed directly on the ceramic-based sintered compact.

When it is going to form a single-crystal thin film having higher crystallinity on the ceramic-based sintered compact, it is preferred to use methods, for example, such as the method using the ceramic-based sintered compact forming the thin film comprising as a main component at least one selected from gallium nitride, indium nitride and aluminum nitride, or the method using the ceramic-based sintered compact having optical permeability, or the method using the ceramic-based sintered compact having optical permeability and forming the thin film comprising as a main component at least one selected from gallium nitride, indium nitride and aluminum nitride.

Specifically, in the method using the ceramic-based sintered compact forming the thin film comprising as a main component at least one selected from gallium nitride, indium nitride and aluminum nitride, those being an amorphous, polycrystalline, orientated polycrystalline or single-crystalline state can be used suitably as the thin film comprising as a main component at least one selected from gallium nitride, indium nitride and aluminum nitride.

Among the thin films having these crystallization states, the thin films being at least partially a single crystal are preferred.

In the thin film with two or more layers, each layer may be amorphous, polycrystalline, orientated polycrystalline or single-crystalline.

In the thin film with two or more layers, a thin film layer formed directly on the ceramic-based sintered compact may be amorphous, polycrystalline, orientated polycrystalline or single-crystalline.

In the thin film with two or more layers, a thin film layer formed directly on the ceramic-based sintered compact is suitably amorphous, polycrystalline or orientated polycrystalline.

In the thin film with two or more layers, a thin film layer formed directly on the ceramic-based sintered compact is suitably orientated-polycrystalline.

In the two-layer thin film, at least one layer may be single-crystalline, and the top layer is preferably single-crystalline.

When the top thin film layer is single crystalline, a high-crystallinity thin film comprising as a main component at least one selected from gallium nitride, indium nitride and aluminum nitride can be formed thereon.

The thin film comprising as a main component at least one selected from gallium nitride, indium nitride and aluminum nitride, which has at least a single-crystal thin film layer as thick as 300 µm or less, usually 200 µm or less, particularly 100 µm or less, is preferably formed on the ceramic-based sintered compact.

As thick a thin film as 0.1 nm or more is preferably formed on the ceramic-based sintered compact, to prevent defects due to pinholes and crystal disorders, etc. in the thin film.

When a thin film comprises a thin film layer of two or more layers, if the total thickness of the thin film layers is not less than 0.1 nm even if the thickness of each thin film layer is respectively thinner than 0.1 nm, it is hard to avoid the above defects. More desirable thickness is not less than 0.5 nm, and the thickness of not less than 0.3 µm is more preferred. The ceramic-based sintered compact provided with a thin film as thick as not less than 3.5 µm, or not less than 10 µm, or not less than 50 µm can also be used suitably as a substrate for a thin film.

A thin film containing at least gallium nitride can be formed on the ceramic-based sintered compact. Specifically, a thin gallium nitride film or a gallium nitride-based thin film can be formed on the ceramic-based sintered compact. The high-crystallinity, single-crystal thin film comprising as a main component at least one selected from gallium nitride, indium nitride and aluminum nitride is easily formed on the ceramic-based sintered compact, providing high luminous efficiency for light-emitting devices.

The gallium nitride thin film or the gallium nitride-based thin film may contain indium nitride and/or aluminum nitride, a doping component such as Si and Mg, etc. Specifically, the thin film containing at least gallium nitride, which is formed on the ceramic-based sintered compact, comprises as a main component at least one selected from gallium nitride, indium nitride and aluminum nitride. Its composition is expressed by AlₓGa_{y}In_{1-x-y}N, wherein 0≤x<1, and 0≤1-x-y<1. The gallium nitride-based thin film usually contains gallium nitride 50 mol % or more.

When those containing a single crystal at least is used as a thin film formed on the ceramic-based sintered compact, it is preferred that the single-crystal thin film is the crystallinity in which the half width of the X ray diffraction rocking curve of a lattice plane (002) is not more than 3600 seconds, and it is more preferred that it is not more than 300 seconds. Those of not more than 240 seconds, not more than 200 seconds, not more than 150 seconds, or not more than 130 seconds is more preferred, and those not more than 100 seconds is most preferred.

In the method of using the ceramic-based sintered compact with optical permeability, a ceramic-based sintered compact being the optical transmissivity not less than 1 % can usually be used.

What is the optical transmissivity not less than 10%, not less than 20%, not less than 30%, not less than 40%, not less than 50%, not less than 60%, furthermore what is the optical transmissivity not less than 80% and not less than 85 %, can also be used.

In the method of using the ceramic-based sintered compact which has optical permeability and is provided with the thin film comprising at least one selected from gallium nitride, indium nitride and aluminum nitride as a main component, those being an amorphous, polycrystalline, orientated polycrystalline or single-crystalline state can be used suitably as the thin film comprising as a main component at least one selected from gallium nitride, indium nitride and aluminum nitride.

Among the thin films having these crystallization states, the thin films being at least partially a single crystal are preferred.

As for the thin film formed on the ceramic-based sintered compact with optical permeability, what has the thin film which includes gallium nitride at least or comprises gallium nitride as a main component can be used.

Those comprising only one layer as these thin films can be used.

Those comprising at least two layers as these thin films can be used.

In the thin film comprising two or more layers, each layer can use suitably those having in an amorphous, polycrystalline, orientated polycrystalline or single-crystalline state, respectively.

In the thin film comprising two or more layers, the thin film layer formed directly on the ceramic-based sintered compact with optical permeability can use those having in an amorphous, polycrystalline, orientated polycrystalline or single-crystalline state.

In the thin film comprising two or more layers, the thin film layer formed directly on the ceramic-based sintered compact with optical permeability can use those which are in an amorphous, polycrystalline or orientated polycrystalline.

In the thin film comprising two or more layers, the thin film layer formed directly on the ceramic-based sintered compact with optical permeability can use those which are is an orientated polycrystal.

The two-layer thin film, in which at least one layer is a single crystal, can be used.

In the thin film comprising two or more layers, it is preferred that a top thin film layer is a single crystal. If the top thin film layer is a single crystal, a thin film comprising as a main component at least one selected from gallium nitride, indium nitride and aluminum nitride with excellent crystallinity can be formed on it.

It is preferred to use those in which the thin film comprising as a main component at least one selected from gallium nitride, indium nitride and aluminum nitride and formed on the ceramic-based sintered compact with optical permeability has at least a single-crystal thin film layer in which the thickness is less than 300 µm, usually not more than 200 µm.

The more desirable thickness of the single-crystal thin film layer formed on the ceramic-based sintered compact with optical permeability is not more than 100 µm.

It is preferred to use what has the thickness of at least not less than 0.1 nm as a thin film formed on the ceramic-based sintered compact with optical permeability. This is preferred in order to prevent the defect due to a pinhole and a disorder of crystal, etc. in a thin film.

When a thin film comprises a thin film layer of two or more layers, if the total thickness of the thin film layers is not less than 0.1 nm even if the thickness of each thin film layer is a case respectively thinner than 0.1 nm, it will be hard to produce the above defect. More desirable thickness is not less than 0.5 nm, and the thickness of not less than 0.3 µm is more preferred. The ceramic-based sintered compact with optical permeability having a thin film having thickness not less than 3.5 µm, or not less than 10 µm, or not less than 50 µm was provided as a substrate for a thin film suitably.

What contains at least gallium nitride as a thin film formed on the ceramic-based sintered compact with optical permeability can be used.

Specifically, the thin film formed on the ceramic-based sintered compact with optical permeability can use what has the thin film which includes gallium nitride at least or comprises gallium nitride as a main component.

What comprises gallium nitride as a main component can be used as a thin film formed on the ceramic-based sintered compact with optical permeability.

For example, when the ceramic-based sintered compact forming the above thin film containing at least gallium nitride is used, on it, it becomes easy to form a single-crystal thin film comprising as a main component at least one selected from gallium nitride, indium nitride and aluminum nitride and having excellent crystallinity, if a light-emitting device is produced using the ceramic-based sintered compact forming the above thin film containing at least gallium nitride, what has higher luminous efficiency can produce.

As for the gallium nitride-based thin film, it may be the thin film in which doping components, such as at least one selected from indium nitride and aluminum nitride besides the gallium nitride component, and Si, and Mg, etc., for example, are contained.

Specifically, the thin film containing at least gallium nitride and formed on the ceramic-based sintered compact with optical permeability comprises as a main component at least one selected from gallium nitride, indium nitride and aluminum nitride. Its composition may be expressed by the chemical formula of AlₓGayIn_{1-x-y}N, in which 0≤x<1, and 0≤1-x-y<1. Usually, the gallium nitride-based thin film contains gallium nitride 50 mol % or more.

When a thin film having at least a single crystal is formed on the ceramic-based sintered compact with optical permeability, the single-crystal thin film has crystallinity with a half width of an X ray diffraction rocking curve of a lattice plane (002), preferably 3600 seconds or less, more preferably 300 seconds or less. Those of not more than 240 seconds, 200 seconds or less, not more than 150 seconds, or not more than 130 seconds is more preferred, and those not more than 100 seconds is most preferred.

Even if it is the ceramic-based sintered compact with low optical permeability, for example, a ceramic-based sintered compact with optical transmissivity less than 1% or a ceramic-based sintered compact with 0% optical transmissivity, a single-crystal thin film comprising as a main component at least one selected from gallium nitride, indium nitride and aluminum nitride can be formed.

For example, when a thin film comprising as a main component at least one selected from gallium nitride, indium nitride and aluminum nitride is formed on such a ceramic-based sintered compact having little optical permeability, a single-crystal thin film with higher crystallinity can be formed.

As mentioned above, a substrate for a thin film of this invention comprises a ceramic-based sintered compact and a ceramic-based sintered compact with optical permeability, furthermore, it contains a ceramic-based sintered compact having the thin film comprising as a main component at least one selected from gallium nitride, indium nitride and aluminum nitride, and a ceramic-based sintered compact having optical permeability and having the thin film comprising as a main component at least one selected from gallium nitride, indium nitride and aluminum nitride.

A thin-film substrate is those in which the thin film comprising as a main component at least one selected from gallium nitride, indium nitride and aluminum nitride was formed on the ceramic-based sintered compact, and those in which the thin film comprising as a main component at least one selected from gallium nitride, indium nitride and aluminum nitride was formed on the ceramic-based sintered compact with optical permeability.

As for the above ceramic-based sintered compact, and ceramic-based sintered compact with optical permeability, they include at least an aluminum nitride-based sintered compact, or a sintered compact which comprises as a main component a ceramic material having at least one of the crystal structure selected from a hexagonal system or a trigonal system, or a sintered compact comprising at least one of materials selected from zirconium oxide, magnesium oxide, magnesium aluminate, titanium oxide, barium titanate, lead titanate zirconate, a rare earth element oxide, thorium oxide, various ferrites, mullite, forsterite, steatite and glass

The above sintered compact which comprises as a main component a ceramic material having at least one of the crystal structures selected from a hexagonal system or a trigonal system includes the various ceramic-based sintered compacts, such as a zinc oxide-based sintered compact, a sintered compact comprising beryllium oxide as a main component, a sintered compact comprising aluminum oxide as a main component, a sintered compact comprising silicon carbide as a main component, a sintered compact comprising silicon nitride as a main component, and a gallium nitride-based sintered compact, etc.

In the above-explained ceramic-based sintered compact substrate for a thin film and a ceramic-based sintered compact with optical permeability, about those having a thin film comprising at least one selected from gallium nitride, indium nitride and aluminum nitride as a main component, that having at least one of crystallization states selected from a single crystal, an amorphous state, a polycrystal, and an orientated polycrystal can be used as the thin film formed, the thin film may be not only that in which at least one of crystallization states selected from a single crystal, an amorphous state, a polycrystal, and an orientated polycrystal exists independently, respectively, but also that in which at least two of each crystallization state exist simultaneously.

That is, for example, it may be the condition in which the thin film of each crystallization state does not form a clear layer, but is intermingled in two or more crystallization states.

Specifically, it may be the condition which does not form a clear layer, such as an amorphous state and an orientated polycrystal, or an orientated polycrystal and a single crystal, or an amorphous state and a single crystal, or an amorphous state and a polycrystal, but exists as a single layer.

For example, when the thin film formed on the ceramic-based sintered compact comprises a single layer or at least two layers, at least one layer of the thin films may be at least two crystallization states selected from a single crystal, an amorphous state, a polycrystal, and an orientated polycrystal is intermingled simultaneously.

In the above thin-film substrate, the thin film comprising as a main component at least one selected from gallium nitride, indium nitride and aluminum nitride is formed on at least one of the sintered compacts selected from the ceramic-based sintered compacts with or without optical permeability, it can use that having at least one of crystallization states selected from a single crystal, an amorphous state, a polycrystal, and an orientated polycrystal, the thin film may be not only that in which at least one of crystallization states selected from a single crystal, an amorphous state, a polycrystal, and an orientated polycrystal exists independently, respectively, but also that in which at least two of each crystallization state exist simultaneously. That is, for example, it may be those in which the thin film of each crystallization state does not form a clear layer, but is intermingled in two or more crystallization states. Specifically, it may be that which does not form a clear layer, such as an amorphous state and an orientated polycrystal, or an orientated polycrystal and a single crystal, or an amorphous state and a single crystal, or an amorphous state and a polycrystal, but exists as a single layer.

Although it can form directly on the ceramic-based sintered compact substrate even if thicker than 200 µm as thickness of a single-crystal thin film comprising as a main component at least one selected from gallium nitride, indium nitride and aluminum nitride, for example, when forming directly on the ceramic-based sintered compact substrate, it is preferred to form in the thin state, for example less than 300 µm usually not more than 200 µm as thickness to obtain a single-crystal thin film excellent in crystallinity because the crystallinity of the single-crystal thin film tends to become small if the thickness of a thin film is formed thickly.

When it is going to form the above single-crystal thin films with thickness thicker than 200 µm for example, on the ceramic-based sintered compact, for example, it is preferred to use the ceramic-based sintered compact having the thin film comprising as a main component at least one selected from gallium nitride, indium nitride and aluminum nitride, or the ceramic-based sintered compact with optical permeability, or the ceramic-based sintered compact with optical permeability having the thin film comprising as a main component at least one selected from gallium nitride, indium nitride and aluminum nitride, etc.

Using the ceramic-based sintered compact with or without optical permeability, if a light-emitting device is produced forming on it the laminate which comprises the thin film comprising at least one selected from gallium nitride, indium nitride and aluminum nitride as a main component and contains at least N-type semiconductor layer, luminescence layer, and P-type semiconductor layer, a light-emitting device which is at least equivalent or has superior luminous efficiency can be provided compared with the light-emitting device produced using the bulk-like single crystals, such as a conventional sapphire.

If what formed the thin film comprising at least one selected from gallium nitride, indium nitride and aluminum nitride is used as the ceramic-based sintered compact, and the ceramic-based sintered compact with optical permeability, a light-emitting device which is more excellent in luminous efficiency can be produced.

In the ceramic-based sintered compact with or without optical permeability, a light-emitting device which is still more excellent in luminous efficiency can be produced using what formed those which includes gallium nitride at least or those comprising gallium nitride as a main component, among the above thin films.

In the method of producing a light-emitting device on a ceramic-based sintered compact with or without optical permeability, a thin film comprising at least one selected from gallium nitride, indium nitride and aluminum nitride as a main component is preferably a single crystal, so that the light-emitting device has better luminous.

Usually, a single-crystal thin film excellent in crystallinity can be formed using the ceramic-based sintered compact having an average surface roughness Ra not more than 2000 nm.

Usually, such a surface of the ceramic-based sintered compact can be obtained as-fired, or by mirror-polishing, blast-polishing, chemical corrosion, plasma gas corrosion, mechanical processing, etc.

Using the ceramic-based sintered compact having the above surface state, and the ceramic-based sintered compact with optical permeability, if a light-emitting device is produced forming on it the laminate constituting a light-emitting device and comprising a thin film comprising at least one selected from gallium nitride, indium nitride and aluminum nitride as a main component and containing at least N-type semiconductor layer, luminescence layer, and P-type semiconductor layer, a light-emitting device which is equivalent at least or has superior luminous efficiency can be provided compared with the light-emitting device produced using the bulk-like single crystals, such as a conventional sapphire.

Even if the surface roughness is large as a ceramic-based sintered compact and a ceramic-based sintered compact with optical permeability, the single-crystal thin film with excellent crystallinity can be formed.

For example, a single-crystal thin film with excellent crystallinity can be formed on the ceramic-based sintered compact with or without optical permeability having large surface roughness, even if the average surface roughness Ra is not less than 70 nm.

A single-crystal thin film with excellent crystallinity can be formed, even if the ceramic-based sintered compact with or without optical permeability has an average surface roughness Ra of more than 2000 nm.

Usually, such a surface state can be obtained in the as-fired surface, the surface by which lap polish was carried out, the surface by which blast polish was carried out, the surface by which chemistry corrosion was carried out, the surface corroded by plasma gas, or the surface where mechanical processings, such as the slot end, were given, etc., in the ceramic-based sintered compact with or without optical permeability.

Using the ceramic-based sintered compact, and the ceramic-based sintered compact with optical permeability, if a light-emitting device is produced forming on it the laminate constituting a light-emitting device and comprising the thin film comprising at least one selected from gallium nitride, indium nitride and aluminum nitride as a main component and containing at least N-type semiconductor layer, luminescence layer, and P-type semiconductor layer, the luminous efficiency of the light-emitting device can be raised more by using those with large surface roughness illustrated above, as the ceramic-based sintered compact or the ceramic-based sintered compact with optical permeability.

The ceramic-based sintered compact with or without optical permeability having large surface roughness preferably has an average surface roughness Ra of not less than 70 nm. Those having an average surface roughness Ra of larger than 100 nm, and those having an average surface roughness Ra of larger than 1000 nm are usable to produce a light-emitting device with high luminous efficiency.

Although a single-crystal thin film comprising as a main component at least one selected from gallium nitride, indium nitride and aluminum nitride and being comparatively excellent in crystallinity can be formed directly on the ceramic-based sintered compact with or without optical permeability having an average surface roughness Ra not more than 2000 nm or having large surface roughness, if a single-crystal thin film comprising as a main component at least one selected from gallium nitride, indium nitride and aluminum nitride is formed on it using the ceramic-based sintered compact forming the thin film comprising as a main component at least one selected from gallium nitride, indium nitride and aluminum nitride, a single-crystal thin film more excellent in crystallinity can be produced.

Although it is also possible to produce a light-emitting device by forming directly the laminate constituting a light-emitting device and comprising the thin film comprising at least one selected from gallium nitride, indium nitride and aluminum nitride as a main component and containing at least N-type semiconductor layer, luminescence layer, and P-type semiconductor layer, onto it, using the ceramic-based sintered compact with or without optical permeability having an average surface roughness Ra of not more than 2000 nm or having large surface roughness, usually, a light-emitting device with higher luminous efficiency can be produced by forming the above laminate on it using what formed the thin film comprising as a main component at least one selected from gallium nitride, indium nitride and aluminum nitride onto the ceramic-based sintered compact with or without optical permeability having an average surface roughness Ra of not more than 2000 nm or having large surface roughness.

This invention provides the light-emitting device which used the ceramic-based sintered compact, as mentioned above.

This invention provides the light-emitting device using the ceramic-based sintered compact with optical permeability.

This invention provides the light-emitting device using the ceramic-based sintered compact having large surface roughness.

This invention provides the light-emitting device using the ceramic-based sintered compact in which the thin film comprising at least one selected from gallium nitride, indium nitride and aluminum nitride was formed.

This invention provides the light-emitting device using the ceramic-based sintered compact in which the single-crystal thin film comprising at least one selected from gallium nitride, indium nitride and aluminum nitride was formed.

In addition, luminous efficiency in this invention means a percentage ratio of the electric power (electric energy) impressed to the device to make a light-emitting device drive and the optical output (optical energy) which was changed into light by the light-emitting device and actually emitted to the outside of a light-emitting device.

For example, that the luminous efficiency is 10% is that 180 mW is obtained as an optical output when a light-emitting device is made to drive by impressing the voltage of 3.6 V and the current of 500 mA.

An optical output can be measured using a spectrophotometer, etc. by collecting all the light emitted after a light-emitting device is put into an integrating sphere and is made to emit light, for example.

In addition, although the luminous efficiency generally used in the lighting field is the quantity of the light (lumen: 1m) to the optical energy per unit time (W); (that is, it is expressed with 1m/W), the luminous efficiency in this invention differs from the luminous efficiency generally being used in the lighting field.

As for the characteristics as a material, such as crystallinity, a lump-like or bulk-like single crystal has been superior to the single-crystal thin film which was integrally adhered to the ceramic-based sintered compact substrate, in many cases.

However, as mentioned above, according to this invention, a single-crystal thin film comprising as a main component at least one selected from gallium nitride, indium nitride and aluminum nitride and being equally close in crystallinity of the lump-like or bulk-like single crystal has become to be able to form on the ceramic-based sintered compact.

Consequently, in those which are the state where the single-crystal thin film and the ceramic-based sintered compact are unified, it was found that the characteristic which could not be realized by the conventional lump-like or bulk-like single crystal can be produced.

For example, a light-emitting device which is equivalent at least or has superior luminous efficiency has been provided compared with the light-emitting device produced using the bulk-like single crystals, such as a conventional sapphire, even if it is the light-emitting device produced using a ceramic-based sintered compact.

Even if the crystallinity of the single-crystal thin film formed on the above ceramic-based sintered compact is inferior to the single crystals with the shape of a lump and the shape of bulk, etc., when electronic devices and electronic components, such as a light-emitting device, an optical waveguide, or a wiring board, etc., are produced, if the thin-film substrate in which a ceramic-based sintered compact and a single-crystal thin film are adhered and unified, and the ceramic-based sintered compact substrate for a thin film being able to form a single-crystal thin film are used, that having the characteristic superior to that which used as a substrate only a single crystal, such as the lump-like or bulk-like single crystal, is easily obtained.

That is, the characteristic of the produced electronic devices or electronic components is not necessarily excellent even if it uses it for the substrate for producing electronic devices or electronic components just because the characteristic of a material is good.

As shown in this invention, if those in which a ceramic-based sintered compact and a single-crystal thin film were unified are used, electronic devices or electronic components with the excellent characteristic which could not be realized by using only the conventional lump-like or bulk-like single crystal are producible.

That is, when a light-emitting device is produced for example, what was produced using the thin-film substrate having the single-crystal thin film which is integrally adhered to the sintered compact ofthis invention comprising a ceramic material as a main component, and the ceramic-based sintered compact substrate for a thin film being able to form such a thin film, is more excellent in the aspect of luminous efficiency, compared with what was produced using only single crystals, such as the shape of a lump and the shape of bulk, as a substrate. That is, large luminescence energy is obtained in low power consumption.

When only single crystals, such as the shape of a lump and the shape of bulk, are used as a substrate, although a thing with good crystallinity can be formed about the laminate constituting a light-emitting device and comprising the thin film comprising at least one selected from gallium nitride, indium nitride and aluminum nitride as a main component and containing at least N-type semiconductor layer, luminescence layer, and P-type semiconductor layer, it is thought that it is because the light from a luminescence layer becomes easily shut up in the inside of the laminate constituting a light-emitting device, since it becomes easy to produce reflection of light in the interface of the laminate and the substrate which constitute the light-emitting device by influence of homogeneity, etc. which the lump-like or bulk-like single crystal has.

On the other hand, and, when the above thin-film substrate or substrate for a thin film of this invention are used, it is thought that it has the synergistic effect of two functions which cannot be realized in those which used only single crystals, such as the shape of a lump and the shape of bulk, as a substrate, such that the above laminate constituting a light-emitting device can form those with comparatively high crystallinity, and that it becomes hard to generate reflection of light in the interface of a laminate and a substrate since the ceramic-based sintered compact is a polycrystalline substance comprising a particulate, and the light from a luminescence layer is not shut up in the inside of the laminate constituting a light-emitting device, but becomes easily emitted to the outside of a device.

In addition, for example, if the above thin-film substrate or substrate for a thin film of this invention are used also when producing electronic devices and electronic components, such as an optical waveguide and a wiring board, since an electric circuit can form in the inside of a ceramic-based sintered compact, it can miniaturize and there is little leading about of wiring, and what has the outstanding function which cannot be realized in those which used only single crystals, such as the shape of a lump and the shape of bulk, as a substrate, is realizable.

The meaning and the purpose of this invention are to provide the substrate having outstanding function, the electronic devices, such as a light-emitting device which used this substrate, or the electronic components, such as a circuit substrate, which are hard to be realized by the material which exists as a single crystal and is used independently in itself, such as the shape of a lump and the shape of bulk, such as conventional sapphire and silicon carbide, by making into the shape of a thin film a single crystal which is excellent in crystallinity and comprising as a main component at least one selected from gallium nitride, indium nitride and aluminum nitride, and unifying firmly it and a ceramic-based sintered compact, and producing the synergistic effect which a single crystal and a ceramic-based sintered compact cannot make by itself respectively. It is the offering of a ceramic-based sintered compact and brings about such an effect.

Hereafter, it explains in more detail about this invention.

A thin film comprising as a main component at least one selected from gallium nitride, indium nitride and aluminum nitride can be formed directly on the surface of the aluminum nitride-based sintered compact substrate of this invention, and it can carry out the direct formation of a single crystal which grew epitaxially at least as a thin film.

When an aluminum nitride-based sintered compact is used as a substrate, a thin film of not only the above single crystal state but also the various crystallization states, such as an amorphous state, a polycrystalline state, or an orientated polycrystalline state, etc., can be formed directly there as a thin film comprising as a main component at least one selected from gallium nitride, indium nitride and aluminum nitride.

When a single-crystal thin film comprising as a main component at least one selected from gallium nitride, indium nitride and aluminum nitride is grown up on this substrate using the aluminum nitride-based sintered compact forming a thin film of various crystallization states, such as the above single crystal state, amorphous state, polycrystalline state, and orientated polycrystalline state, etc., the single-crystal thin film obtained is easily formed as a single-crystal thin film whose crystallinity was improved than the single-crystal thin film formed directly on the aluminum nitride-based sintered compact substrate.

The meaning "formed directly" is literally that the thin film comprising as a main component at least one selected from gallium nitride, indium nitride and aluminum nitride is formed directly on the aluminum nitride-based sintered compact substrate without intervening of other material, intermediate, etc.

To form the above thin film, a special material, an intermediate, or an intervention material are not needed to the surface of the aluminum nitride-based sintered compact substrate.

Thus, a single-crystal thin film which is excellent in crystallinity and comprising as a main component at least one selected from gallium nitride, indium nitride and aluminum nitride can be formed using the aluminum nitride-based sintered compact substrate of this invention.

The thin film formed directly on the aluminum nitride-based sintered compact substrate of this invention may be a single crystal or in other states such as an amorphous, polycrystalline or orientated-polycrystalline state.

When it is going to form a single-crystal thin film comprising as a main component at least one selected from gallium nitride, indium nitride and aluminum nitride, a single-crystal thin film with higher crystallinity is obtained by forming a single-crystal thin film on it using the thin-film substrate in which a thin film comprising as a main component at least one selected from gallium nitride, indium nitride and aluminum nitride and having the above various crystallization states was formed beforehand on the aluminum nitride-based sintered compact substrate of this invention.

As for the effect of the thin-film substrate obtained by forming beforehand the thin film comprising as a main component at least one selected from gallium nitride, indium nitride and aluminum nitride and having various crystallization states including a single crystal or an amorphous state, etc., onto the substrate comprising the aluminum nitride-based sintered compact, and by forming a single-crystal thin film furthermore, it will become still larger when the thin-film substrate in which the single-crystal thin film was formed is used as a substrate for light-emitting device.

A light-emitting device comprises as a main component at least one selected from gallium nitride, indium nitride and aluminum nitride and is manufactured by growing epitaxially plural thin film layers, such as P-type semiconductor layer, an N-type semiconductor layer, and luminescence layer, etc., and laminating these layers, the more the crystallinity of the thin film grown epitaxially (namely, the single-crystal thin film) is high, the more the characteristic of such a light-emitting device is excellent.

Thus, for example, in the case of manufacturing a light-emitting device, when it is required that the thin film comprising as a main component at least one selected from gallium nitride, indium nitride and aluminum nitride should be formed as a single-crystal thin film having higher crystallinity, it becomes more effective to use the thin-film substrate of this invention in which a single-crystal thin film was formed as mentioned above.

In addition, the thin-film substrate of this invention in which the single-crystal thin film was formed includes not only the thin-film substrate obtained by forming beforehand the thin film comprising as a main component at least one selected from gallium nitride, indium nitride and aluminum nitride and having various crystallization states, such as a single crystal, an amorphous state, a polycrystal, and an orientated polycrystal, etc., onto the substrate comprising the above aluminum nitride-based sintered compact, and by forming a single-crystal thin film furthermore, but also the thin-film substrate obtained by forming the single-crystal thin film comprising as a main component at least one selected from gallium nitride, indium nitride and aluminum nitride directly onto the aluminum nitride-based sintered compact substrate.

Thus, according to this invention, the thin film can exist in a state where it is integrally adhered to the substrate comprising various ceramic-based sintered compacts, unlike an independent bulk material.

As mentioned above, a thin film comprising as a main component at least one selected from gallium nitride, indium nitride and aluminum nitride and having various crystallization states, such as a single crystal state, an amorphous state, a polycrystalline state, or an orientated polycrystalline state, etc., can be formed directly on the aluminum nitride-based sintered compact substrate of this invention.

It is important to form a single-crystal thin film comprising as a main component at least one selected from gallium nitride, indium nitride and aluminum nitride, it will not be preferred to use the substrate on which those of a single crystal state cannot form even if it is able to form a thin film of various crystallization states.

That is, the big purposes of this invention is to provide the substrate which can form a single-crystal thin film comprising as a main component at least one selected from gallium nitride, indium nitride and aluminum nitride, and to provide the single-crystal thin-film substrate on which the single-crystal thin film comprising as a main component at least one selected from gallium nitride, indium nitride and aluminum nitride was formed.

As mentioned above, a thin film comprising as a main component at least one selected from gallium nitride, indium nitride and aluminum nitride and being a single crystal state at least can be formed directly on the aluminum nitride-based sintered compact substrate of this invention.

Thus obtained is an excellent substrate for a thin film on which a single-crystal thin film comprising as a main component at least one selected from gallium nitride, indium nitride and aluminum nitride can be formed directly.

However, in the actual use form in which the substrate for a thin film of this invention is used, it is not necessarily limited to only the above substrate for forming a single-crystal thin film comprising as a main component at least one selected from gallium nitride, indium nitride and aluminum nitride.

A thin film comprising as a main component at least one selected from gallium nitride, indium nitride and aluminum nitride and having various crystallization states, such as an amorphous state, a polycrystalline state, and an orientated polycrystalline state, other than a single crystal, can also be formed directly on the substrate for single-crystal thin film formation of this invention comprising an aluminum nitride-based sintered compact.

As for the substrate for a thin film of this invention comprising an aluminum nitride-based sintered compact, it can be actually used as a substrate not only for forming a thin film of single crystal state comprising as a main component at least one selected from gallium nitride, indium nitride and aluminum nitride but also for forming a thin film comprising as a main component at least one selected from gallium nitride, indium nitride and aluminum nitride and having various crystallization states, such as an amorphous state, a polycrystal, and an orientated polycrystal.

As mentioned above, the aluminum nitride-based sintered compact of this invention being able to form a single-crystal thin film can form not only a single-crystal thin film but also a thin film comprising as a main component at least one selected from gallium nitride, indium nitride and aluminum nitride and having various crystallization states, such as an amorphous state, a polycrystal, and an orientated polycrystal.

Specifically, this invention can also provide the thin-film substrates in which a thin film of various crystallization state, such as amorphous thin film, a polycrystalline thin film, or an orientated polycrystalline thin film, was formed, other than the aluminum nitride-based sintered compact substrate in which a single-crystal thin film was formed, for example,
(1) The thing, in which a single-crystal thin film comprising as a main component at least one selected from gallium nitride, indium nitride and aluminum nitride was formed on the aluminum nitride-based sintered compact substrate,
(2) The thing, in which an amorphous thin film comprising as a main component at least one selected from gallium nitride, indium nitride and aluminum nitride was formed on the aluminum nitride-based sintered compact substrate,
(3) The thing, in which a polycrystalline thin film comprising as a main component at least one selected from gallium nitride, indium nitride and aluminum nitride was formed on the aluminum nitride-based sintered compact substrate,
(4) The thing, in which an orientated polycrystalline thin film comprising as a main component at least one selected from gallium nitride, indium nitride and aluminum nitride was formed on the aluminum nitride-based sintered compact substrate, etc.

That is, this invention is a substrate for forming a thin film comprising as a main component at least one selected from gallium nitride, indium nitride and aluminum nitride, and the substrate contains a substrate for a thin film comprising an aluminum nitride-based sintered compact.

This invention also includes the thin-film substrate in which a thin film comprising as a main component at least one selected from gallium nitride, indium nitride and aluminum nitride is being formed on the aluminum nitride-based sintered compact substrate.

The aluminum nitride-based sintered compact of this invention can use equally for both uses, for the substrate for a thin film, and for the thin-film substrate.

When forming a thin film comprising as a main component at least one selected from gallium nitride, indium nitride and aluminum nitride and having various crystallization states, such as a single crystal, an amorphous state, a polycrystal, and an orientated polycrystal, etc., special film formation technique is not needed, anything is arbitrarily applicable if it is the method of growing the thin film of the target composition, that is, decomposing or not decomposing chemically, physically a compound and a simple substance containing at least a part of target chemical component, making it into gas, ion, or a molecular beam in the state as it is, it is made to react or not to react with the compound except the above suitably, after making the component containing the target chemical component into the gaseous phase, such as the usual MOCVD (Metal Organic Chemical Vapor Deposition) method, the MOVPE (Metal Organic Vapor Phase Epitaxy) method, the Hydride VPE (Hydride Vapor Phase Epitaxy) method, the Halide VPE (Halogen Transport Vapor Phase Epitaxy) method containing the Chloride VPE (Chloride Vapor Phase Epitaxy) method, etc., the Plasma CVD method, the other CVD (Chemical Vapor Deposition) methods, and the MBE (Molecular Beam Epitaxy) method, or the laser ablation method using the Excimer laser, etc. and using as a raw material the solid material containing the purpose component which was formed beforehThe PLD method (Pulse Laser Deposition: Pulse Laser Deposition), the Sputtering method, the Ion-plating method, or the Vapor-depositing method, etc.

As the raw material for thin film production of various crystallization states, such as a single crystal state, an amorphous state, a polycrystalline state, and an orientated polycrystalline state, various compounds, such as organic metallic compounds, such as trimethyl gallium, triethyl gallium, tri-iso-butyl gallium, trimethyl indium, triethyl indium, tri-iso-butyl indium, trimethyl aluminum, triethyl aluminum, and tri-iso-butyl aluminum, the halogenated compounds of gallium, indium, and aluminum, such as chlorides such as a gallium chloride, an indium chloride, and an aluminium chloride, and bromides such as a gallium bromide, an indium bromide, and an aluminum bromide, the organic compounds of gallium, indium, and aluminum containing halogens such as diethyl gallium chloride, diethyl indium chloride, diethyl aluminum chloride, nitrides, such as gallium nitride, indium nitride, and aluminum nitride, pure metals, such as gallium, indium, and aluminum, can be used, in addition, Si, or silane compounds, such as SiH₄, SiHCl₃, and Si(C₂H₅)₄, the halogenated compound of silicon, such as SiCl₄ and SiBr₄, silicon compounds, such as Si₃N₄ and SiC, metals, such as magnesium, beryllium, calcium, zinc, cadmium, and germanium, and compounds, such as halogenated compounds and the organic metallic compounds containing these metals, such as dialkyl beryllium (for example, dimethyl beryllium, etc.), dialkylmagnesiums (for example, dimethyl magnesium, etc.) and bis-cyclopentadienyl magnesium (MgCp₂), bis-cyclopentadienyl calcium (CaCp₂), diethyl zinc, dimethyl cadmium, tetramethyl germanium, BeCl₂, BeBr₂, MgCl₂, MgBr₂, CaCl₂, CaBr₂, ZnCl₂, ZnBr₂, CdCl₂, CdBr₂, GeCl₄, GeBr₄, or the compound containing a nonmetal and these nonmetals, such as carbon, silicon, selenium, tellurium, and oxygen, etc., can be used, and they can be used as a main component and the doping elements.

In the MOCVD method and the MOPVE method, organic compounds, such as trimethyl gallium, trimethyl indium, and trimethyl aluminum, are used as a main raw material.

In the Chloride VPE and the Halide VPE method, halogenated compounds, such as gallium chloride, indium chloride, and aluminium chloride, are used as a main raw material.

In the methods of forming a thin film by making a raw material into a gaseous state, such as the above MOCVD method, MOPVE method, Hydride VPE method, Chloride VPE method, Halide VPE method, Plasma CVD method, other CVD methods, and MBE method, ammonia or nitrogen are usually used in the state which was independent or mixed, as gas for reacting with a raw material.

As career gas, hydrogen, argon or nitrogen is used alone or in combination.

To form the single-crystal thin film excellent in crystallinity, it is more preferred to use what contains hydrogen at least as the above career gas.

As an atmosphere in the thin film formation chamber, ammonia, hydrogen, argon, nitrogen, etc. are usually used under normal pressure or decompression.

When forming a thin film by the sputtering method, what formed the various above raw materials is used as a target material.

According to such a method, a thin film comprising as a main component at least one selected from gallium nitride, indium nitride and aluminum nitride can be arbitrarily obtained in the various crystallization states, such as a single crystal, an amorphous state, a polycrystal, and an orientated polycrystal.

In addition, when a single-crystal thin film comprising as a main component at least one selected from gallium nitride, indium nitride and aluminum nitride is formed, for example, using the compound containing the metal component of the target composition (in the case of gallium nitride, it is a compound in which a gallium component is included, for example, trimethyl gallium, gallium trichloride, etc., or in the case of indium nitride, it is a compound containing an indium component, for example, trimethyl indium, indium trichloride, etc., or in the case of aluminum nitride, it is a compound containing an aluminum component, for example, trimethyl aluminum, aluminium chloride, etc.) as a raw material, it is preferred to use the method of forming a single-crystal thin film through process in which those of the target composition is formed after the compound is once decomposed and a nitriding reaction is carried out with reactive gas, such as ammonia, after that, like the MOCVD method or the halide VPE method.

When a single-crystal thin film is formed on the ceramic-based sintered compact, as mentioned above, a single crystal with higher crystallinity can be produced by the method of once decomposing the compound using the compound containing a metal component of the target composition, carrying out a nitriding reaction after that, and acquiring the target composition, than the method of making the raw material only sublimate at high temperature, and producing a single crystal in the state near equilibrium using a raw material of the target composition as it is, like the case of producing the bulk-like and lump-like single crystal by the sublimating method, etc.

As the reason, since a ceramic-based sintered compact is constituted with fine crystal grains in which each grain has random direction respectively, when it is going to form a single-crystal thin film having two-dimensional spread, the range of selection of the material used as a raw material or a compound is widely, control of the substrate temperature or the supply direction and supply amount of a raw material and reactive gas to the a ceramic-based sintered compact substrate is easy, and it is considered because it is possible to control so that a single crystal grows in the target direction instead of spontaneous crystal growth based on the crystal orientation of the fine crystal grains which exist in the ceramic-based sintered compact and have random direction (that is, it is controllable to grow up only in such a direction that its C axis is perpendicular to the substrate surface, for example).

On the other hand, and, in the method of producing a single crystal by making it sublimate at high temperature using the raw material of the target composition as it is like the sublimating method, a lot of raw materials can be sublimated, therefore, it seems that it is suitable when it is going to obtain the bulk-like and lump-like single crystal large-sized in a short time.

However, since the selection range of a raw material is narrowly when it is going to obtain a single-crystal thin film into the substrate comprising the ceramic-based sintered compact, and control of the supply direction and supply amount, etc. of a raw material tends to become difficult, it is not necessarily the suitable method as the method which produces the single-crystal thin film according to this invention.

As the substrate temperature in the case of forming the above thin film comprising as a main component at least one selected from gallium nitride, indium nitride and aluminum nitride, it can be selected suitably in difference of the composition of a thin film or the forming method of a thin film, etc.

When forming a single crystal as a thin film, usually it is more preferred to raise a substrate temperature than what has crystallization states, such as an amorphous state, a polycrystal, and an orientated polycrystal, it may become hard to form a single-crystal thin film if the substrate temperature is low.

For example, as substrate temperature, usually it is desirable to carry out at 400-1200°C when forming the gallium nitride-based thin film, 400-1000°C when forming the indium nitride-based thin film, and 500-1500°C when forming the aluminum nitride-based thin film.

In each above thin film, in the case of forming a gallium nitride-based thin film having a crystallization state other than single crystal, such as an amorphous state, a polycrystal, and an orientated polycrystal, 400-900°C are desirable as substrate temperature, and in the case of forming a single-crystal thin film, it is desirable to carry out by raising the substrate temperature into 700-1200°C.

In case of forming a indium nitride-based thin film having a crystallization state other than single crystal, such as an amorphous state, a polycrystal, and an orientated polycrystal, 400-700°C are desirable as substrate temperature, and in the case of forming a single-crystal thin film, it is desirable to carry out by raising the substrate temperature into 500-900°C.

In case of forming an aluminum nitride-based thin film having a crystallization state other than single crystal, such as an amorphous state, a polycrystal, and an orientated polycrystal, 500-1200°C are desirable as substrate temperature, and in the case of forming a single-crystal thin film, it is desirable to carry out by raising the substrate temperature into 600-1500°C.

If saying Specifically, as substrate temperature in the case of forming a single-crystal thin film by the MOCVD method and the MOVPE method, etc., for example, 900-1100°C are preferable when forming a gallium nitride-based thin film, 600-900°C are preferable when forming a indium nitride-based thin film, and 900-1200°C are preferable when forming an aluminum nitride-based thin film.

As the substrate temperature in the case of forming a single-crystal thin film by the Chloride VPE method or the Halide VPE method, etc., 900-1250°C are preferable when forming a thin film comprising gallium nitride(GaN) as a main component, 700-1000°C are preferable when forming a thin film comprising indium nitride(InN) as a main component, and 1000-1500°C are preferable when forming a thin film comprising aluminum nitride(AlN) as a main component, that it is not less than 1100°C is more desirable since a single-crystal thin film with high crystallinity can be formed.

If the substrate temperature is lower than the temperature illustrated above, it usually tends to become hard to form a single-crystal thin film.

Thus, it is preferred to raise the substrate temperature in the case of forming a single-crystal thin film comprising as a main component at least one selected from gallium nitride, indium nitride and aluminum nitride, and it is preferred to make the substrate temperature low in many cases in the case of forming a thin film of crystallization states, such as an amorphous state, a polycrystal, and an orientated polycrystal.

As for heating of a substrate, any methods, such as resistance heating which used various heaters, high frequency heating using an RF generator, and heating by an infrared lamp, etc., can be used.

Even if it uses what kind of thin film forming method, as substrate temperature, it is not limited only to the above range. It can form at low temperature comparatively, such that room temperature-400°C are preferable when forming a gallium nitride-based thin film, room temperature -400°C are preferable as substrate temperature when forming a indium nitride-based thin film, and that room temperature -500°C are preferable when forming an aluminum nitride-based thin film.

Using methods, such as Sputtering method, Ion-plating method, and Vapor-depositing method, as an example of such method, a thin film can be formed comparatively at low temperature as mentioned above.

For example, also in the method of forming a thin film by the raw material of a gaseous state and the reactive gas, for example, if the reactive gas, such as ammonia or nitrogen, has plasma state by high frequency (for example, microwave with a frequency of 2.45GHz or a radio wave with a frequency of 13.56MHz, etc.), magnetism, etc., even if substrate temperature is low temperature as mentioned above, a good thin film can be obtained.

As for the single-crystal thin film comprising as a main component at least one selected from gallium nitride, indium nitride and aluminum nitride and growing on the aluminum nitride-based sintered compact substrate, the crystal system is expressed with a hexagonal system.

When the above CVD method, etc. are used, a single-crystal thin film formed has the tendency which is usually easy to grow epitaxially in the C axis direction of the hexagonal system to a substrate surface.

If saying in other words, the above single-crystal thin film has the tendency which is easy to grow epitaxially in the direction where the C plane is parallel to a substrate surface.

Since the strong diffraction line from the lattice plane (002) of the hexagonal system will be observed if carrying out X-ray diffraction of the above single-crystal thin film formed on the substrate, it can be explained from the observation in which the above single-crystal thin film is growing epitaxially in the direction of C axis to a substrate surface.

If saying in other words, it can be explained from the observation in which the above single-crystal thin film is growing epitaxially in a state where the C plane is parallel to a substrate surface.

In Fig. 1, the single-crystal thin film 2 comprising as a main component at least one selected from gallium nitride, indium nitride and aluminum nitride is formed on the substrate 1 comprising an aluminum nitride-based sintered compact.

In the substrate in which the single-crystal thin film 2 was formed in such a direction that its C axis is perpendicular to the substrate surface as shown in Fig. 1, only the diffraction line from the lattice plane (002) of aluminum nitride crystal having a hexagonal wurtzite type crystal structure will be obtained if X-ray is irradiated to the surface of the single-crystal thin film 2.

This situation is shown in Fig. 2.

If the thin film formed on the substrate 1 is not a single crystal but the polycrystallized condition, since plural diffraction lines, such as diffraction from the lattice plane (100), for example, other than a lattice plane (002) of hexagonal system as shown in Fig. 2, will be observed, it is clearly distinguishable.

In addition, an orientated polycrystal is a polycrystalline substance of the special state in which the crystal grain gathered in the direction of a specific crystallographic axis.

Even if it is such orientated polycrystal, it can be distinguished from a single crystal comparatively easily.

If saying specifically, a thin film comprising as a main component at least one selected from gallium nitride, indium nitride and aluminum nitride has a wurtzite type crystal structure, if the usual 2θ/θ scan of X-ray diffraction will be performed, for example, in the single-crystal thin film formed in such a direction that its C axis is perpendicular to the substrate surface, only the diffraction line from the lattice plane (002) will appear.

On the other hand, and, in the orientated polycrystal formed in such a direction that its C axis of a thin film is perpendicular to a substrate surface, only the diffraction line from the lattice plane (002) appears by the 2θ/θ scan of X-ray diffraction.

However, in the case of a single-crystal thin film, only the diffraction line from the lattice plane of the Miller Index (100) will appear if the 2θ/ϕ scanning is performed fixing the lattice plane of the Miller Index (100) parallel to C axis. In the case of an orientated polycrystalline thin film, since the diffraction line(s) from other lattice plane parallel to C axis, for example the lattice plane of the Miller Index (110), also appears, the difference in which the thin film formed is either a single crystal or an orientated polycrystal can be judged easily. That is, while a rotation in the C plane is not seen in the case of a single crystal, a rotation of a crystal in the C plane is seen in the case of an orientated polycrystalline thin film.

It is considered that; in the case of a single crystal, it is homogeneous, and is unifying, and there is no boundary as a crystal grain. However, an orientated polycrystal is the aggregate of a crystal grain, the crystallographic axis (for example, C axis) is assembled in the specific direction in each crystal grain, but other crystallographic axes (for example, A-axis) has a different azimuth in each crystal grain.

Thus, an orientated polycrystal can also be called a polycrystalline substance of the special state where the crystal grain gathered in the direction of a specific crystal axis.

As mentioned above, in the case of an usual polycrystalline thin film, if the 2θ/θ scan of X-ray diffraction is performed, the diffraction line appears not only from the lattice plane (002) but also from the lattice plane of (100) for example, so it can distinguish the usual polycrystalline thin film from the usual orientated polycrystalline thin film easily.

If the thin film formed on the substrate 1 is not the single crystal or polycrystal but the amorphous state, a diffraction line with the clear peak is not obtained so the diffraction line becomes into a broad pattern, therefore it can be distinguished clearly from the single crystal, the polycrystal, or the orientated polycrystal.

In Fig. 1, the single-crystal thin film 2 tends to grow in the direction of C axis, the growth direction is a perpendicular direction to the substrate surface, that is, a parallel direction to the substrate surface is the direction of the C plane of the single-crystal thin film 2.

C axis of the single-crystal thin film comprising as a main component at least one selected from gallium nitride, indium nitride and aluminum nitride and formed on the aluminum nitride-based sintered compact substrate tends to grow in the perpendicular direction spontaneously to the substrate surface.

However, if the growth method of a thin film is devised suitably even when the substrate comprising the above aluminum nitride-based sintered compact is used, C axis of the single-crystal thin film comprising as a main component at least one selected from gallium nitride, indium nitride and aluminum nitride can be formed in the parallel direction to the substrate surface.

For example, if the device, such that the source gas for thin film formation is supplied from a parallel direction to the substrate, setting up the above substrate temperature lowness at first, and raising temperature gradually, is carried out, C axis of the single-crystal thin film comprising as a main component at least one selected from gallium nitride, indium nitride and aluminum nitride can be formed in the parallel direction to a substrate surface.

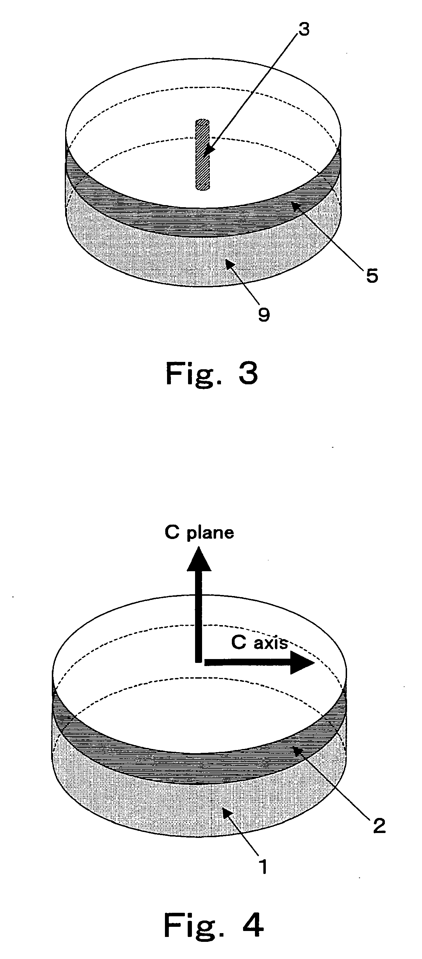

This situation is shown in Fig. 4.

Fig. 4 shows those in which C axis of the single-crystal thin film 2 comprising as a main component at least one selected from gallium nitride, indium nitride and aluminum nitride and formed on the substrate 1 comprising an aluminum nitride-based sintered compact is formed in the parallel direction to the substrate surface (namely, the C plane is formed in the perpendicular direction to the substrate surface).

As for evaluation of the crystallinity of the single-crystal thin film comprising as a main component at least one selected from gallium nitride, indium nitride and aluminum nitride according to an X ray rocking curve, it was carried out by using those which grew in such a direction that its C axis is perpendicular to the substrate surface as shown in Fig. 1, unless it refuses especially.

If surface X-ray diffraction is carried out only by the substrate 1 comprising an aluminum nitride-based sintered compact, the diffraction line which is equivalent to AlN powder described in JCPDS (Joint Committee on Powder Diffraction Standards) file number 25-1134 is obtained, and the aluminum nitride particle in the sintered compact shows that it is the polycrystalline state which has not a specific direction but a random direction.

In addition, although the form of the substrate illustrated in Fig. 1, Fig. 2, and Fig. 4 is circular, the form of the substrate which can be used in this invention can use those of arbitrary form, such as not only a round shape but a square, a rectangle, or other polygons.

As for the thin-film substrates of this invention which are illustrated in Fig. 1, Fig. 2, and Fig. 4 and are produced using the substrate for a thin film comprising an aluminum nitride-based sintered compact, and the aluminum nitride-based sintered compact, what has arbitrary size can be produced using the method which is usually used in the sintered compact production and the thin film production. In the case of a sintered compact, for example, the contour of about 0.01-1000 mm and the thickness of about 1 µm-20 mm are easily obtained.

As for the thin film which was formed on the aluminum nitride-based sintered compact and which comprises at least one selected from gallium nitride, indium nitride and aluminum nitride as a main component and has various crystallization states, such as a single crystal, an amorphous state, a polycrystal, and an orientated polycrystal, etc., it is integrally adhered to the aluminum nitride-based sintered compact, the crack in the formed thin film and the exfoliation in the junction interface, etc., are not seen between the thin film and the aluminum nitride-based sintered compact.

About the junction nature, even if the test, such that pressure sensitive adhesive tape is pasted up to the above formed thin film and torn off, for example, is carried out, exfoliation or breakdown in the junction interface of the thin film and the aluminum nitride-based sintered compact is not seen.

As for the junction nature between the aluminum nitride-based sintered compact and the thin film comprising as a main component at least one selected from gallium nitride, indium nitride and aluminum nitride and having various crystallization states, such as a single crystal, an amorphous state, a polycrystal, and an orientated polycrystal, etc., it is usually not less than 2 kg/mm² by perpendicular tension strength, and what is not less than 4 kg/mm² by perpendicular tension strength is also obtained further.

In the single-crystal thin film comprising gallium nitride and indium nitride as a main component among the single-crystal thin film comprising as a main component at least one selected from gallium nitride, indium nitride and aluminum nitride, when the crystallinity of the contained thin film of the single crystal state is judged by an X-ray diffraction as mentioned above, the diffraction line from the lattice plane (002) of the single-crystal thin film having a hexagonal wurtzite type crystal structure, and the diffraction line from the lattice plane (002) of hexagonal system of the base aluminum nitride-based sintered compact substrate can be distinguished clearly, so the X-ray diffraction method can be used for the crystallinity judgment of those with almost all the thickness of the single-crystal thin film formed.

It is because the locations of the diffraction line from the lattice plane (002) of hexagonal system by X-ray diffraction differ in the degree which can be distinguished easily, since lattice constants differ little by little even if gallium nitride, indium nitride, and aluminum nitride have a wurtzite type crystal structure which belongs to the same hexagonal system.

When the CuKα rays (wavelength 1.542A) are used as characteristic X-rays, the diffraction line from the lattice plane (002) of the base substrate made from an aluminum nitride-based sintered compact appears in the range θ= 17.65-18.45° as diffraction angle, the diffraction line from the lattice plane (002) of a gallium nitride single-crystal thin film appears in the range of θ of 17.20-17.53° as diffraction angle, the diffraction line from the lattice plane (002) of an indium nitride single-crystal thin film appears near θ of 15.55-15.88° as diffraction angle, so the overlap which makes judgment of these diffraction lines impossible does not arise substantially.

On the other hand, the diffraction line from the lattice plane (002) of the single-crystal thin film comprising aluminum nitride as a main component is θ = 17.88-18.20° as diffraction angle.

Therefore, when the crystallinity of the single-crystal aluminum nitride-based thin film among the above single-crystal thin films is judged by X-ray diffraction, if the thickness of the single-crystal thin film which is being formed becomes thin, the X-ray penetrates the single-crystal thin film, so the diffraction line from the base aluminum nitride-based sintered compact will be overlapped, the influence omes to be seen.

As the characteristic X-rays, the CrKα rays (wavelength 2.291A), or CuKα which are comparatively long wavelength are used to control penetration energy small, and it handled by applying acceleration voltage as small as possible to an X-ray tube.

When the crystallinity of the single-crystal aluminum nitride-based thin film is judged by an X-ray diffraction, the limit thickness of the single-crystal thin film which can eliminate the effect of the diffraction from the base aluminum nitride-based sintered compact is about 500 nm by the above devices.

For the judgment of the single crystal nature of the aluminum nitride-based thin film having thickness up to not more than 500 nm from about 5 nm, electron diffraction, such as RHEED (Reflection High Energy Electron Diffraction), was used together, and it was considered that there was no influence from the aluminum nitride-based sintered compact being a substrate.

Therefore, as for the crystallinity evaluation by the half width of the rocking curve of the X-ray diffraction line from the lattice plane (002) of the single-crystal aluminum nitride-based thin film formed on the aluminum nitride-based sintered compact substrate, it was usually carried out by the single-crystal thin film with the thickness not less than 500 nm, or preferably not less than 1000 nm.

As for the thin film comprising as a main component at least one selected from gallium nitride, indium nitride and aluminum nitride, what is the thickness of about 0.5 nm can be formed. Even if the thickness is about such at least 0.5nm, it is thought that it is being formed as a single crystal.

The above thin film can form not only the single crystal but those of various crystallization states, such as an amorphous state, a polycrystal, and an orientated polycrystal.

These thin films can be as thick as about 0.1-0.2 nm.

When the above thin film is formed directly on the substrate, using the aluminum nitride-based sintered compact as a substrate for a thin film, it is preferred that it is not less than 0.5 nm as the thickness of the thin film.

The thin film comprising as a main component at least one selected from gallium nitride, indium nitride and aluminum nitride and having various crystallization states, such as a single crystal, an amorphous state, a polycrystal, and an orientated polycrystal, etc., can be formed using the substrate for a thin film comprising various sintered compacts comprising as a main component a ceramic material, such as aluminum nitride.

There can obtain a thin-film substrate having a single-crystal thin film comprising as a main component at least one selected from gallium nitride, indium nitride and aluminum nitride directly onto the above substrate for a thin film, and a thin-film substrate having furthermore a single-crystal thin film comprising as a main component at least one selected from gallium nitride, indium nitride and aluminum nitride onto the thin-film substrate having a thin film comprising as amain component at least one selected from gallium nitride, indium nitride and aluminum nitride and having various crystallization states, such as a single crystal, an amorphous state, a polycrystal, and an orientated polycrystal, etc.

The thin film comprising as a main component at least one selected from gallium nitride, indium nitride and aluminum nitride and having various crystallization states, such as a single crystal used, an amorphous state, a polycrystal, and an orientated polycrystal, etc., can be formed on the above thin-film substrate.

A thin film of various crystallization states, such as an amorphous state, a polycrystal, and an orientated polycrystal, can also usually be formed comparatively easily in the substrate in which a single crystal among the above thin films can be formed.

It was judged by evaluating the crystallinity of the single crystal which was formed on the substrate whether the above substrate for a thin film and the thin-film substrate would be excellent.

As mentioned above, the crystallization state of the thin film comprising as a main component at least one selected from gallium nitride, indium nitride and aluminum nitride can be easily judged by analysis of X-ray diffraction.

If the above thin film is a single crystal, when C axis of the single-crystal thin film is formed in the perpendicular azimuth to the substrate surface, only the diffraction line from the lattice plane (002) of a hexagonal wurtzite type crystal is detected.

When C axis of the single-crystal thin film is formed in the parallel azimuth to the substrate surface, only the diffraction line from the lattice plane of the Miller Index (100) of a hexagonal wurtzite type crystal is detected.

If the above thin film is polycrystal, it can distinguish easily since plural diffraction lines from the lattice plane (002), (100), etc., are detected.

If the above thin film is amorphous, it can distinguish easily since a clear diffraction peak is not detected but becomes a broad diffraction pattern.

When the aluminum nitride-based sintered compact of this invention is used as a substrate for a thin film, C axis of the single-crystal thin film comprising as a main component at least one selected from gallium nitride, indium nitride and aluminum nitride is easily formed in the perpendicular azimuth to the substrate surface, so only the diffraction line from the lattice plane (002) of a hexagonal wurtzite type crystal is usually detected.

Unless it refuses especially, crystallinity evaluation of the single-crystal thin film was usually carried out by measuring the half width of the rocking curve of the X-ray diffraction line from the lattice plane (002) of the single-crystal thin film.

The used characteristics X-rays are CuKα rays (wavelength 1.542A).

Unless reference is made especially, the half width of the rocking curve of the X-ray diffraction line from the lattice plane (002) is measured by the usual ω scan, and the unit is shown with second (arcsecant).

When performing such crystallinity evaluation, the surface of the substrate comprising various sintered compacts which are used as a substrate for the single-crystal thin film formation and comprise as a main component a ceramic material, such as aluminum nitride, a thing which was mirror-polished to an average surface roughness Ra of about 30 nm can be used, unless reference is made especially.

The substrate for a thin film of this invention should just be the aluminum nitride-based sintered compact, and the thin film comprising as a main component at least one selected from gallium nitride, indium nitride and aluminum nitride and having the various crystallization states containing the single crystal can be formed directly on the substrate.

If using what has optical permeability in the above aluminum nitride-based sintered compact, it tends to raise the crystallinity of the single-crystal thin film comprising as a main component at least one selected from gallium nitride, indium nitride and aluminum nitride and formed on the substrate.

In such sintered compact, the crystallinity of the formed single-crystal thin film comprising as a main component at least one selected from gallium nitride, indium nitride and aluminum nitride will increase if the optical permeability at least in a visible light area is higher, so it is desirable.

As for the optical permeability in a visible light area of the range of 380-800 nm wavelength, it is preferred that the optical transmissivity is not less than 1 % in the sintered compact having a disc-like shape with the diameter of 25.4 mm and the thickness of 0.5 mm and having been mirror-polished to an average surface roughness Ra of about 30 nm.

If the aluminum nitride-based sintered compact substrate with optical transmissivity of not less than 1 % is used, a single-crystal thin film comprising as a main component at least one selected from gallium nitride, indium nitride and aluminum nitride and having the crystallinity, such that the half width of the rocking curve of the X-ray diffraction line from the lattice plane (002) is not more than 300 seconds, is easily formed directly on it.

Using the aluminum nitride-based sintered compact substrate having the optical transmissivity not less than 5 %, a better thing, such that the half width of the above rocking curve of the X-ray diffraction is not more than 240 seconds, is easily obtained.

Using the aluminum nitride-based sintered compact substrate having the optical transmissivity not less than 10%, a still better thing, such that the half width of the above rocking curve of the X-ray diffraction is not more than 200 seconds, is easily obtained, it is more desirable.

The optical transmissivity in the visible light area is the optical transmissivity in the light of the range of the above 380-800 nm wavelength, and unless reference is made especially, the value of the optical transmissivity measured by the light of 605 nm wavelength was used.

According to this invention, the aluminum nitride-based sintered compact having the optical transmissivity in the above visible light has also the same optical transmissivity in the light of the ultraviolet region of 200-380 nm wavelength, what is not less than 1 %, as the optical transmissivity, is obtained.

In such aluminum nitride-based sintered compact, if the optical permeability to the light of the range of at least 200-800 nm wavelength is higher, the crystallinity of the formed single-crystal thin film comprising as a main component at least one selected from gallium nitride, indium nitride and aluminum nitride will desirably increase.

In the aluminum nitride-based sintered compact of this invention having the visible optical permeability, what has the optical transmissivity not less than 5 % in the ultraviolet light of the range of 250-380 nm wavelength is obtained, what has the optical transmissivity not less than 10% in the ultraviolet light of the range of 300-380 nm wavelength is obtained.

In the aluminum nitride-based sintered compact according to this invention, what has the optical transmissivity not less than 40% is obtained in the ultraviolet light of the above range of 200-380 nm wavelength, and what has a maximum of 60-80%, or what has the optical transmissivity not less than 80% are also obtained furthermore.

As mentioned above, the aluminum nitride-based sintered compact substrate of this invention also has optical permeability to the ultraviolet light, if the device for emitting ultraviolet-rays is formed on the substrate of this invention using the single-crystal thin film comprising as a main component at least one selected from gallium nitride, indium nitride and aluminum nitride, for example, it is rare to absorb the ultraviolet rays emitted from the device into the substrate portion, so the effect that the luminous efficiency of the light-emitting device increases is acquired, and it is desirable.

Thus, the aluminum nitride-based sintered compact substrate has the optical transmissivity at least not less than 1 % in the light of the range of 200-800 nm, it was shown clearly that the single-crystal thin film comprising as a main component at least one selected from gallium nitride, indium nitride and aluminum nitride and having more excellent crystallinity could be formed using the substrate having such optical transmissivity.

Using the aluminum nitride-based sintered compact substrate having the optical transmissivity not less than 1 %, the thin film comprising as a main component at least one selected from gallium nitride, indium nitride and aluminum nitride and having the various crystallization states, such as an amorphous state, a polycrystal, and an orientated polycrystal, other than the single crystal, can also be formed.

Unless reference is made especially, hereafter, optical transmissivity is measured by the light with a wavelength of 605nm.

According to this invention, the aluminum nitride-based sintered compact having optical permeability shows usually the almost same transmissivity as the transmissivity measured by the light with a wavelength of 605 nm to the light of any wavelength at least in the visible light area of the range of a wavelength of 380-800 nm.

Though the aluminum nitride-based sintered compact of this invention does not necessarily have the same optical transmissivity as the 605 nm wavelength in the light of all the wavelength ranges of 200-800 nm wavelength except the wavelength of 605 nm, only using the optical transmissivity measured by the light with a wavelength of 605 nm, it can distinguish on behalf of the performances of the aluminum nitride-based sintered compact according to this invention, such as the crystallinity in case of forming a single-crystal thin film comprising as a main component at least one selected from gallium nitride, indium nitride and aluminum nitride, for example.

That is, the characteristic as a substrate of the aluminum nitride-based sintered compact having optical permeability is represented with the optical transmissivity measured by the light of the above wavelength of 605 nm and can be judged.

The aluminum nitride-based sintered compact having optical permeability usually shows optical permeability to the light with a wavelength not less than 200 nm in many cases.

That is, optical permeability begins to be shown to the light of the range of 200-250 nm wavelength, the optical permeability goes up rapidly to the light of the range of 250-350 nm wavelength, and there is a tendency of having almost fixed optical transmissivity to the light with a wavelength not less than 350-400 nm which is in the boundary area which goes into a visible light area from ultraviolet light.

In this invention, unless reference is made especially, the optical transmissivity of an aluminum nitride-based sintered compact means the optical transmissivity measured by the light with a wavelength of 605 nm.

In this invention, in the aluminum nitride-based sintered compact having optical permeability, the optical transmissivity of the visible light in the range of 380-800 nm wavelength is usually larger than the optical transmissivity measured by the ultraviolet light of 200-380 nm wavelength.

Concretely, usually in this invention, in the aluminum nitride-based sintered compact having optical permeability, the optical transmissivity in the visible light of the range of 380-800 nm wavelength will become bigger than 1 % if the optical transmissivity measured by the ultraviolet light of 200-380 nm wavelength is not less than 1 %.

Therefore, when the aluminum nitride-based sintered compact with optical permeability in which the optical transmissivity measured by the ultraviolet light of 200-380 nm wavelength is not less than 1% is used as a substrate, the single-crystal thin film comprising as a main component at least one selected from gallium nitride, indium nitride and aluminum nitride and having excellent crystallinity can be formed directly.

Thus, even if it does not use the measured value to the light other than the wavelength of 605 nm as optical transmissivity, if the optical transmissivity to the light with a wavelength of 605 nm is grasped, it can distinguish on behalf of the performance of the aluminum nitride-based sintered compact of invention, that is, the crystallinity when forming the single-crystal thin film comprising as a main component at least one selected from gallium nitride, indium nitride and aluminum nitride.

Furthermore, for example, the luminous efficiency of the light-emitting device produced can be judged when it uses as a substrate (hereafter, unless it refuses especially, it is only called "the substrate for light-emitting device production") for forming a laminate which constitutes a light-emitting device and which comprises the thin film comprising as a main component at least one selected from gallium nitride, indium nitride and aluminum nitride and contains at least N type semiconductor layer, luminescence layer, and P type semiconductor layer.

In this invention, the optical transmissivity in the ultraviolet light of the range of 200-380 nm wavelength means the optical transmissivity to one of the specific wavelength in the range of 200-380 nm wavelength.

And, in this invention, unless reference is made especially, the visible light is the light of the range of 380-800 nm wavelength, and the ultraviolet light means the light with a wavelength not more than 380 nm.

Unless reference is made especially, the measured value of the optical transmissivity in this invention was expressed with the percentage ratio by measuring the intensity of a incidence light and a transmitted light using the spectrophotometer, etc., applying the light of predetermined wavelength to the sintered compact sample, using the disc-like sample which has the diameter of 25.4 mm and the thickness of 0.5 mm and carried out specular surface polish (usually, average surface roughness Ra = about 30 nm), such as an aluminum nitride-based sintered compact, and other ceramic-based sintered compacts (for example, a sintered compact which comprises as a main component a material having at least one of crystal structures selected from a hexagonal system or a trigonal system, and a sintered compact which comprises as a main component at least one selected from zirconium oxide, magnesium oxide, magnesium aluminate, titanium oxide, barium titanate, lead titanate zirconate, a rare earth oxide, thorium oxide, various ferrites, mullite, forsterite, steatite, and glass, etc.).

Unless reference is made especially, as wavelength, usually it is measured using 605 nm.

By setting the above test sample in the inside of an integrating sphere, and collecting all transmitted lights, the optical transmissivity in this invention was asked as total transmittance which expressed the intensity ratio of all transmitted lights and incident light with percentage.

Although the optical transmissivity of transparent bodies, such as glass, is usually called for as straight line transmissivity, generally in an optical penetration of ceramic materials, such as an aluminum nitride-based sintered compact, incident light is not penetrated linearly and is scattered about inside a sintered compact, and it is penetrated in all the direction in the condition of having been scattered about.

Therefore, the intensity of transmitted light becomes what collected all scattered light without such directivity.

In this invention, as for the optical transmissivity of the aluminum nitride-based sintered compact and the other ceramic-based sintered compacts, it was measured as such total transmissivity, and it differs from the straight line transmissivity of transparent substances, such as glass.

Optical transmissivity changes with the thickness of a sample, when using the above aluminum nitride-based sintered compact according to this invention, and the other ceramic-based sintered compacts (for example, a sintered compact which comprises as a main component a material having at least one of crystal structures selected from a hexagonal system or a trigonal system, and a sintered compact which comprises as a main component at least one selected from zirconium oxide, magnesium oxide, magnesium aluminate, titanium oxide, barium titanate, lead titanate zirconate, a rare earth oxide, thorium oxide, various ferrites, mullite, forsterite, steatite, and glass, etc.), as a substrate for thin-film formation, a thin-film substrate, or a substrate for light-emitting device production, it is effective to make thickness ofthis substrate thin and to raise optical transmissivity, if raising the luminous efficiency of a light-emitting device.

In the cases of a sintered compact, for example, the one which has the contour of 0.01 mm-1000 mm and the thickness of about 1 µm-20 mm is easily producible.

Usually, it is preferred to use a ceramic substrate with the thickness not less than 0.01 mm from the point of a handling strength, for a substrate for a thin film, a thin-film substrate, or a substrate for light-emitting device, etc.

Since the optical transmissivity will tend to lower if the thickness becomes thick, usually it is preferred to use a thing with the thickness not more than 8.0 mm, as a substrate for a thin film, a thin-film substrate, or a substrate for light-emitting device.

In the above aluminum nitride-based sintered compact and other ceramic-based sintered compacts, it is effective if the substrate for a thin film, the thin-film substrate, or the substrate for light-emitting device, etc. have optical permeability in a state where it is actually used, in the range in which the thickness is at least 0.01-8.0 mm.

That is, even if the thickness of the above aluminum nitride-based sintered compact and other ceramic-based sintered compacts is the range of at least 0.01-8.0 mm, or except it, the optical transmissivity may just be at least not less than 1 % in a state where it is actually used, for example, even if the thickness, such as 0.1 mm or 2.0 mm, etc., is not actually 0.5 mm necessarily as a substrate for light-emitting device, the luminous efficiency of the light-emitting device produced will tend to improve if it has optical permeability and optical transmissivity is at least not less than 1%.

In this invention, as for the optical transmissivity of the above aluminum nitride-based sintered compact, and other ceramic-based sintered compacts (for example, a sintered compact which comprises as a main component a material having at least one of crystal structures selected from a hexagonal system or a trigonal system, and a sintered compact which comprises as a main component at least one selected from zirconium oxide, magnesium oxide, magnesium aluminate, titanium oxide, barium titanate, lead titanate zirconate, a rare earth oxide, thorium oxide, various ferrites, mullite, forsterite, steatite, and glass, etc.), it is unrelated to the thickness.

That having optical permeability by making it thin even if it does not have optical permeability in the thick state is included in this invention.

That is, for example, even if it does not have optical permeability when the thickness of the aluminum nitride-based sintered compact and other ceramic-based sintered compacts is 0.5 mm, it is contained in this invention if it shows optical permeability by making thickness thin.

Even if it does not have optical permeability when the thickness of the aluminum nitride-based sintered compact and other ceramic-based sintered compacts is thicker than 0.5 mm, for example, it is contained in this invention if it shows optical permeability by setting thickness to 0.5 mm.

If another word expresses optical permeability, as optical transmissivity of this invention, it is unrelated to the thickness of the aluminum nitride-based sintered compact and other ceramic-based sintered compacts, and it is contained in this invention if the optical transmissivity of the sintered compacts is not less than 1 %.

That is, even if the optical transmissivity is smaller than 1 % when the thickness of the aluminum nitride-based sintered compact and other ceramic-based sintered compacts is 0.5 mm, for example, it is contained in this invention if the optical transmissivity is not less than 1 % by making thickness thin.

For example, even if the optical transmissivity is smaller than 1 % when the thickness of the aluminum nitride-based sintered compact and other ceramic-based sintered compacts is thicker than 0.5mm, it is contained in this invention if the optical transmissivity is not less than 1 % by making thickness 0.5 mm.

As mentioned above, the optical permeability in a state where the sintered compact is actually used is important, as optical permeability of the aluminum nitride-based sintered compact and other ceramic-based sintered compacts according to this invention.

Therefore, it is contained in this invention if it has optical permeability in a state where the sintered compact is actually used, as the aluminum nitride-based sintered compact and other ceramic-based sintered compacts.

If another expression is carried out, as optical transmissivity of this invention, it is unrelated to the thickness of the aluminum nitride-based sintered compact and other ceramic-based sintered compacts, and it is contained in this invention if the optical transmissivity is not less than 1 % in the state where the sintered compact is actually used.

That is, for example, when the thickness of the aluminum nitride-based sintered compact and other ceramic-based sintered compacts is not more than 0.5 mm or larger than 0.5 mm in the state where it is actually used, it is contained in this invention if the optical transmissivity is not less than 1 %.

The optical transmissivity differs from that measured at the time of the substrate thickness of 0.5 mm when the thickness of the aluminum nitride-based sintered compact and other ceramic-based sintered compacts is thinner than 0.5 mm, or when thicker than 0.5 mm, in the state where it is actually used, the optical transmissivity is easy to become high than what was measured at the time of 0.5 mm when thinner than 0.5 mm, and the optical transmissivity is easy to become low than what was measured at the time of 0.5 mm when thicker than 0.5 mm

In this invention, as mentioned above, it is preferred to use what is the optical transmissivity not less than 1 % at least in the state where it is actually used, as the aluminum nitride-based sintered compact and the other ceramic-based sintered compacts.

In this invention, as for the crystallinity of the single-crystal thin film comprising as a main component at least one selected from gallium nitride, indium nitride and aluminum nitride and formed on the substrate comprising an aluminum nitride-based sintered compact, it is not necessarily required that the half width of the rocking curve of the X-ray diffraction line from the lattice plane of the Miller Index (002) is not more than 300 seconds.

For example, even if it is the thing in which the above half width of the X ray diffraction rocking curve is broad, it can also be used satisfactorily for the uses, such as a piezo-electric film for surface acoustic wave devices, etc., an insulator film for wiring boards, a dielectric film, or an optical waveguide material.

If the above half width of the rocking curve of the X-ray diffraction is not more than about 3600 seconds, it can be used satisfactorily for such use.

In the above uses, as for the crystallinity of the thin films comprising as a main component at least one selected from gallium nitride, indium nitride and aluminum nitride, according to the case, that of the crystallization states, such as an amorphous state, a polycrystal, and an orientated polycrystal which are not necessarily the single crystal, may be used.

However, using an aluminum nitride-based sintered compact as the substrate, when a light-emitting device is formed on the single-crystal thin film comprising as a main component at least one selected from gallium nitride, indium nitride and aluminum nitride and being formed there, or when the single-crystal thin film is used directly as a part of the light-emitting device constitution layer, or when the single-crystal thin film is used as a cold cathode material of a field emission display (display by field emission), etc., it is preferred that the above half width of the rocking curve of the X-ray diffraction line from the lattice plane of the Miller Index (002) is as sharp as not more than 300 seconds as the crystallinity of the single-crystal thin film.

In this invention, a thin film which comprises as a main component at least one selected from gallium nitride, indium nitride, and aluminum nitride and is various crystallization states containing a single crystal can be formed directly on the substrate which comprises a sintered compact which comprises aluminum nitride as a main component.

Furthermore, in this invention, the thin film which comprises as a main component at least one selected from gallium nitride, indium nitride, and aluminum nitride and is various crystallization states containing a single crystal can be formed in the constitution of two or more layers, for example, like the case of manufacturing a light-emitting device, onto the above substrate which comprises a sintered compact which comprises aluminum nitride as a main component.

The thin film formed in two or more layers can be formed in the different state, respectively, such as crystallization state, composition, or thickness, in each layer.

As for the thin-film substrate of this invention which comprises at least two thin film layers, at least one layer comprises a single-crystal thin film which comprises as a main component at least one selected from gallium nitride, indium nitride, and aluminum nitride.

When the thin-film substrate of this invention will be used in order to form a single-crystal thin film which comprises as amain component at least one selected from gallium nitride, indium nitride, and aluminum nitride, like the substrate for light-emitting device formation, it is preferred that it is usually a single crystal as the thin film of the surface layer of the thin-film substrate.

In this invention, also in the thin film which is being constituted with two or more layers and which comprises as a main component at least one selected from gallium nitride, indium nitride, and aluminum nitride and is various crystallization states containing the single crystal, in the currently formed single-crystal thin film, the thing which is sharp and has high crystallinity, such that the half width of the rocking curve of the X-ray diffraction line from the lattice plane of the Miller Index (002) is not more than 300 seconds, is easy to be obtained.

As for the optical transmissivity to the visible light or ultraviolet rays of the substrate which comprises a sintered compact which comprises aluminum nitride as a main component, it changes according to the complicated factor peculiar to ceramics, such as,
1) sintered density,
2) existence and size of the pore inside the sintered compact,
3) sintering-acid content,
4) oxygen content,
5) impurities content other than sintering aid and oxygen,
6) size of the aluminum nitride particle in a sintered compact, or
7) the form of the aluminum nitride particle in a sintered compact, etc.

Usually, in the substrate which comprises a sintered compact which comprises aluminum nitride as a main component, if the aluminum nitride-based sintered compact has following nature, it has the tendency that the optical transmissivity to visible light becomes high to not less than 1 %,
1) sintered density is high,
2) there are few pores inside a sintered compact, and the size is small even if it is,
3) amount of sintering aids is the required least amount, or sintering aids are not included, 4) there is few oxygen content,
5) there is few impurities content other than sintering aids or they do not contained,
6) aluminum nitride particle in a sintered compact is small, or the size is uniform,
7) aluminum nitride particle in a sintered compact is not a round thing whose edge was smoothed out but a dense thing which is a polygon and has not a space in the surface of particles, the ridgeline, or the polygonal vertex by accompanying a overlap, or
8) what has few components other than AlN, such as sintering aids, and has high AiN purity, even if the aluminum nitride particle in a sintered compact is large,
9) the thing in which the aluminum nitride particle grew greatly even if there were many components other than AlN, such as sintering aids in a sintered compact.

Therefore, as for the film quality and crystallinity of the single-crystal thin film which comprises as a main component at least one selected from gallium nitride, indium nitride, and aluminum nitride, they tend to improve by using the substrate which comprises a sintered compact which comprises aluminum nitride as a main component and has such nature.

The thermal conductivity of an aluminum nitride-based sintered compact is at least not less than 50 W/mK at room temperature by controlling the amount of sintering aids, oxygen, or other impurities, usually it can obtain those of not less than 100 W/mK.

Therefore, in the light-emitting device produced using as a base material the aluminum nitride-based sintered compact, it has the advantage in which the luminescence output of a light-emitting device increases since the electric power applied there can enlarge compared with the case where the base material is sapphire.

In the case of the aluminum nitride-based sintered compact containing the above sintering aids, oxygen, or other impurities, what has the thermal conductivity not less than 150 W/mK at room temperature is obtained easily, so the input electric power to the light-emitting device manufactured using as a base material the aluminum nitride-based sintered compact can be heightened more, it is desirable.

In the case of the aluminum nitride-based sintered compact containing the above sintering aids, oxygen or other impurities, what has the thermal conductivity not less than 170 W/mK at room temperature is also obtained easily, so the input electric power to the light-emitting device manufactured using as a base material the aluminum nitride-based sintered compact can be heightened furthermore, it is more desirable.

This inventor has examined the sintered compact which comprises as a main component silicon carbide (SiC), silicon nitride (Si₃N₄), gallium nitride (GaN), aluminum oxide (Al₂O₃), zirconium oxide (ZrO₂), zinc oxide (ZnO), magnesium oxide (MgO), beryllium oxide (BeO), magnesium aluminate (MgAl₂O₄: spinel), etc. other than aluminum nitride (AlN), as the substrate for forming directly a thin film which comprises as a main component at least one selected from gallium nitride, indium nitride, and aluminum nitride and is various crystallization states containing the single crystal.

Among them, in the sintered compact which has a hexagonal crystal structure, such as silicon carbide, silicon nitride, gallium nitride, zinc oxide, and beryllium oxide, etc., or has a trigonal crystal structure, such as aluminum oxide, etc., it can make the thin film which comprises at least one selected from indium nitride, and aluminum nitride as a main component into a single crystal state.

In each substrate made from a sintered compact which comprises as a main component silicon carbide, silicon nitride, gallium nitride, zinc oxide, beryllium oxide, and aluminum oxide, the half width of the rocking curve from the lattice plane of the Miller Index (002) of the hexagonal system and trigonal system of the single-crystal thin film formed on it tends to show the crystallinity not more than 3600 seconds.

On the other hand, the thin film which comprises as a main component at least one selected from gallium nitride, indium nitride, and aluminum nitride and was formed on the substrate which comprises a sintered compact which comprises as a main component zirconium oxide, magnesium oxide, and a spinel is still the state of polycrystal and is hard to become into the single crystal state.

It is considered because the crystal system of zirconium oxide is tetragonal system or cubic system or monoclinic system, and the magnesium oxide and spinel is cubic system respectively.

Although the crystal system of aluminum oxide is trigonal system, the classification as a hexagonal system is also possible, so this inventor thinks that the sintered compact which can make a thin film formed directly on it into a single crystal is essentially after all only a substrate which comprises as a main component a material whose crystal system is a hexagonal system or is able to classify as a hexagonal system.

Because the crystal structure in which each thin film of gallium nitride, indium nitride, and aluminum nitride has is a wurtzite type crystal, and the crystal system to which the wurtzite type crystal belongs is a hexagonal system, if the main components of a sintered compact used as a substrate have the crystal structure of a hexagonal system or a trigonal system, or the crystal structure which can be classified as a hexagonal system, it will be considered that the above thin film which comprises as a main component at least one selected from gallium nitride, indium nitride, and aluminum nitride tends to become a single crystal state spontaneously.

In this invention, when a single-crystal thin film which comprises as a main component at least one selected from gallium nitride, indium nitride, and aluminum nitride is formed directly on the substrate which used the sintered compact which comprises as a main component a material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., it is realizable by using the substrate which comprises a sintered compact, such as the above silicon carbide, silicon nitride, gallium nitride, zinc oxide, beryllium oxide, and aluminum oxide, etc., instead of the substrate which comprises a sintered compact which comprises aluminum nitride as a main component, in the substrate 1 which is illustrated in Fig.1, Fig.2, and Fig.4.

In this case, the growth azimuth of the single-crystal thin film is a perpendicular direction to the substrate surface, and tends to grow as C axis of the hexagonal system to which the thin film crystal belongs.

If an X-ray is irradiated, only the diffraction line from the lattice plane of the Miller Index (002) of the single-crystal thin film will be detected like the thing shown in Fig. 2.

In addition, as for the shape of the above substrate which comprises a sintered compact which comprises silicon carbide, silicon nitride, gallium nitride, zinc oxide, beryllium oxide, and aluminum oxide, etc. as a main component, it can use the thing of arbitrary shape, such as not only a round shape but a square, a rectangle, or other polygons, in this invention.

And, as for the substrate for thin-film formation which comprises the above sintered compact which comprises silicon carbide, silicon nitride, gallium nitride, zinc oxide, beryllium oxide, and aluminum oxide, etc. as a main component, and the thin-film substrate produced by using the sintered compact which comprises silicon carbide, silicon nitride, gallium nitride, zinc oxide, beryllium oxide, and aluminum oxide, etc. as a main component, the thing with arbitrary magnitude can be produced using the method usually used in a sintered compact and thin film production.

That is, in the cases of a sintered compact, for example, the one which has the contour of 0.01-1000 mm and the thickness of about 1 µm-20 mm is easily producible.

Among the substrates which comprise various sintered compacts which comprise a ceramic material as a main component and were examined in this invention, a substrate that comprises a sintered compact which comprises aluminum nitride as a main component is excellent especially.

In almost all the single-crystal thin film which comprises as a main component at least one selected from gallium nitride, indium nitride, and aluminum nitride and was formed on the above substrate which comprises a sintered compact which comprises aluminum nitride as a main component, the half width of the rocking curve of the X-ray diffraction line from the lattice plane of the Miller Index (002) of the single-crystal thin film is as sharp as not more than 300 seconds, and it especially excels in crystallinity.

Therefore, it is big one of a background that such knowledge was acquired that this invention resulted in completion.

As for the sintered compact which comprises aluminum nitride as a main component, not only the crystal system but also the thermal expansion coefficient is very close to the thin film of various crystallization state, such as an amorphous state, a polycrystal, and an orientated polycrystal, etc., and the single-crystal thin film which comprise at least one selected from gallium nitride, indium nitride, and aluminum nitride as a main component, and this inventor is surmising that it is one of causes which excel.

That is, the gallium nitride is 5.59x10⁻⁶ (°C-1), the indium nitride is 5.70x10⁻⁶ (°C -1), and the aluminum nitride is 5.64x10⁻⁶ (°C-1).

For example, in the gallium nitride single-crystal thin film which was formed at the temperature of about 1000°C using the sintered compact which comprises aluminum nitride as a main component as a substrate for a thin film according to this invention, the stress produced in the gallium nitride single-crystal thin film is few, after cooling to room temperature, so it is hard to produce fault in the gallium nitride single-crystal thin film.

It is guessed that the stress produced in the gallium nitride single-crystal thin film in the case of this combination becomes compression stress, and that fault stops being able to produce furthermore easily in the gallium nitride single-crystal thin film.

As mentioned above, as an advantage in which the thermal expansion coefficient of a substrate is close to the thin film of various crystallization state, such as an amorphous state, a polycrystal, and an orientated polycrystal, etc., and the single-crystal thin film which comprise at least one selected from gallium nitride, indium nitride, and aluminum nitride as a main component, in addition to this, when the film thickness of the thin film of various crystallization states, such as an amorphous state, a polycrystal, and an orientated polycrystal, etc., and the single-crystal thin film which comprise at least one selected from gallium nitride, indium nitride, and aluminum nitride as a main component and are formed on the substrate needs to be thickened, it is hard to produce faults, such as dislocation and a crack, in the thin film of various crystallization states, such as an amorphous state, a polycrystal, and an orientated polycrystal, and the single-crystal thin film which have thick thickness not less than 10 µm, for example because the stress which is produced in the single-crystal thin film is small and the stress is also compression stress in many cases.

Thus, when the substrate which comprises a sintered compact which comprises aluminum nitride as a main component is used as a substrate for thin-film formation, as for the thin film of various crystallization states, such as an amorphous state, a polycrystal, and an orientated polycrystal, etc., and the single-crystal thin film which are formed on the substrate and comprise at least one selected from gallium nitride, indium nitride, and aluminum nitride as a main component, a thing whose thickness is arbitrary can be formed, a thing whose thickness is at least not less than 0.5 nm can be formed, and a thick thing not less than 10 µm can also be formed easily.

Thus, when the substrate which comprises a sintered compact which comprises aluminum nitride as a main component is used as a substrate for thin-film formation, the thin film which comprises as a main component at least one selected from gallium nitride, indium nitride, and aluminum nitride and is formed on the substrate can form in the state of arbitrary thickness not only what is a single crystal but also what is various crystallization states, such as an amorphous state, a polycrystal, and an orientated polycrystal, what is the thickness of at least not less than 0.5 nm can be formed, a thick thing of not less than 10 µm, and a thing of not less than 50 µm can also be formed easily furthermore, if needed.

In this invention, when the thickness of almost all the single-crystal thin film which comprises as a main component at least one selected from gallium nitride, indium nitride, and aluminum nitride and was formed in the above substrate which comprises a sintered compact which comprises aluminum nitride as a main component is not less than 0.5 nm (even if it is a single-crystal thin film of not less than 10 µm, or not less than 50 µm), the half width of the rocking curve of the X-ray diffraction line from the lattice plane of the Miller Index (002) of the single-crystal thin film is as sharp as not more than 300 seconds, and it especially excels in crystallinity.

Therefore, using the substrate of this invention, when a light-emitting device is formed laminating the thin film of various crystallization state, such as an amorphous state, a polycrystal, and an orientated polycrystal, etc., and the single-crystal thin film which comprise at least one selected from gallium nitride, indium nitride, and aluminum nitride as a main component, there is little dislocation in the device, since the required thickness of the single-crystal thin film and the thin film of various crystallization states, such as an amorphous state, a polycrystal, and an orientated polycrystal, and the thickness of the whole light-emitting device can set arbitrarily in forming a light-emitting device, layout of a light-emitting device becomes easy and the light-emitting device which has high luminous efficiency can be manufactured.

Thus, if the sintered compact which comprises aluminum nitride as a main component is used as a substrate, there is a feature in which the higher quality thing is easy to be obtained in the thin film of various crystallization state, such as an amorphous state, a polycrystal, and an orientated polycrystal, etc., and the single-crystal thin film which comprise at least one selected from gallium nitride, indium nitride, and aluminum nitride as a main component, compared with the sintered compact which comprises silicon carbide, silicon nitride, gallium nitride, zinc oxide, beryllium oxide, and aluminum oxide, etc. as a main component.

In addition, the secondary advantage in the case of using as a substrate the sintered compact which comprises aluminum nitride as a main component is the excellence of the optical transmissivity to ultraviolet light with a wavelength not more than 380 nm.

In the case of the sintered compact which comprises silicon carbide, silicon nitride, gallium nitride, and zinc oxides, etc. as a main component other than the sintered compact which comprises aluminum nitride as a main component, most optical transmissivity to ultraviolet light with a wavelength not more than 380 nm cannot be found and it is 0 % substantially.

Therefore, if the sintered compact which comprises aluminum nitride as a main component is used as a substrate, the rate of the absorption of the ultraviolet light from the light-emitting device by the substrate decreases, there is an advantage that the luminous efficiency of a light-emitting device increases compared with the sintered compact which comprises silicon carbide, silicon nitride, gallium nitride, and zinc oxide, etc. as a main component.

When the single-crystal thin film which comprises as a main component at least one selected from gallium nitride, indium nitride, and aluminum nitride is formed using as the substrate such a sapphire, silicon carbide single crystal, or silicon, though these substrate materials are a single crystal, it is easy to produce a curvature, a crack, or increase of dislocation in the single-crystal thin film obtained, furthermore the single-crystal thin film may be unable to form thickly according to the case, it is also imagined that it is one of the main factors that the thermal expansion coefficient differs from the single-crystal thin film.

For example, among the above single-crystal substrates, the thermal expansion coefficient of silicon carbide single crystal and silicon is smaller than the thin film of various crystallization state, such as an amorphous state, a polycrystal, and an orientated polycrystal, etc., and the single-crystal thin film which comprise at least one selected from gallium nitride, indium nitride, and aluminum nitride as a main component, therefore, tensile stress acts on the thin film, even if it forms the thin film by the comparatively thin thickness of 0.5 µm, it is easy to produce a crack and dislocation in the thin film.

As stated above, the single crystal substance is not necessarily excellent as the substrate for forming a single-crystal thin film which comprises as a main component at least one selected from gallium nitride, indium nitride, and aluminum nitride. Even if a ceramic material is used as the substrate, as this inventor showed, an excellent single-crystal thin film which comprises as amain component at least one selected from gallium nitride, indium nitride, and aluminum nitride can be formed.

The sintered compact which comprises aluminum nitride as a main component is excellent among the ceramic materials, and a conventional problems can be solved.

The substrate for a thin film and the thin-film substrate of this invention, are not limited only to that wherein the single-crystal thin film which comprises as a main component at least one selected from gallium nitride, indium nitride and aluminum nitride is formed directly on the substrate comprising an aluminum nitride-based sintered compact, like that illustrated in Fig. 1, Fig. 2, and a Fig. 4.

As for the substrate for a thin film of this invention, not only the substrate comprising an aluminum nitride-based sintered compact, but also the substrate comprising various sintered compacts comprising as a main component a ceramic material having at least one of the crystal structures selected from a hexagonal system or a trigonal system, such as silicon carbide, silicon nitride, gallium nitride, beryllium oxide, zinc oxide, and aluminum oxide, etc., and the substrate comprising other various ceramic-based sintered compacts, are able to use, and a thin film comprising as a main component at least one selected from gallium nitride, indium nitride and aluminum nitride and having various crystallization state, such as a single crystal, an amorphous state, a polycrystal, and an orientated polycrystal, etc., may be formed directly on these substrates.

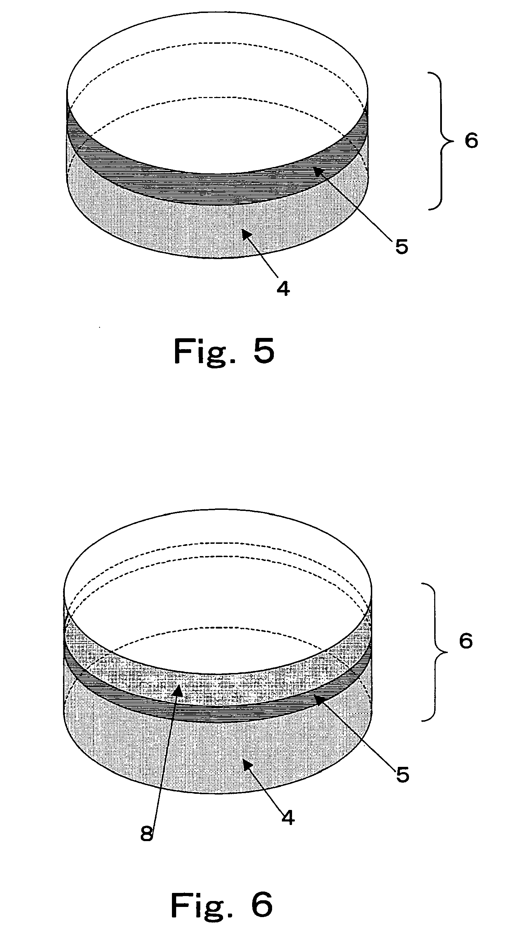

Fig. 5 is a perspective diagram about one example of the substrate for a thin film and a thin-film substrate of this invention.

That shown with the mark 4 in Fig. 5 is the substrate of this invention comprising an aluminum nitride-based sintered compact, various sintered compacts comprising as a main component a ceramic material having at least one of the crystal structures selected from a hexagonal system or a trigonal system, such as silicon carbide, silicon nitride, gallium nitride, beryllium oxide, zinc oxide, and aluminum oxide, etc., and other various ceramic-based sintered compacts in addition to these, it is used as a substrate for a thin film.

The thin film 5 comprising as a main component at least one selected from gallium nitride, indium nitride and aluminum nitride and having at least one of the crystallization states selected from a single crystal, an amorphous state, a polycrystal, and an orientated polycrystal is formed on the substrate 4, and the thin-film substrate 6 is being constituted by the substrate 4 and the thin film 5.

The thin film 5 comprising as a main component at least one selected from gallium nitride, indium nitride and aluminum nitride and having at least one of the crystallization states selected from a single crystal, an amorphous state, a polycrystalline state, and an orientated polycrystalline state is being formed on the substrate 4.

Thin film 5 can be formed also as a thin film which comprises as a main component at least one selected from gallium nitride, indium nitride, and aluminum nitride and is constituted with two or more layers.

In this invention, among the thin films comprising two or more layers, usually, it is desirable that at least one layer is a single-crystal-state thin film comprising as a main component at least one selected from gallium nitride, indium nitride and aluminum nitride, for the use to various electronic devices and electronic-components, such as a substrate for light-emitting device formation, a substrate for field emission, or a dielectric material for wiring boards, or an optical waveguide material.

Among the above thin films constituted with two or more layers, as for the thin film in the surface of a substrate, it is more preferred that it is a single crystal.

The thin film 5 formed in two or more layers can form in the state where various crystallization states, such as an amorphous state, a polycrystalline state, and an orientated polycrystalline state, including a single crystal state, composition, or thickness, etc. differ, respectively, in each layer.

That is, for example, it is the case, wherein the thin film which comprises as a main component at least one selected from gallium nitride, indium nitride, and aluminum nitride and is an amorphous state or an orientated polycrystalline state is formed beforehand on the substrate comprising the various ceramic-based sintered compacts including an aluminum nitride-based sintered compact, various sintered compacts which comprise as a main component a material having the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., and the thin film of a single crystal state is being formed furthermore on it.

In this invention, it can be formed as a two-layer-thin film wherein the crystallization state is same and the composition differs, respectively. That is, for example, it can be formed as a two-layer-thin film wherein the thin film formed is a same single crystal, respectively and the composition differs, respectively.

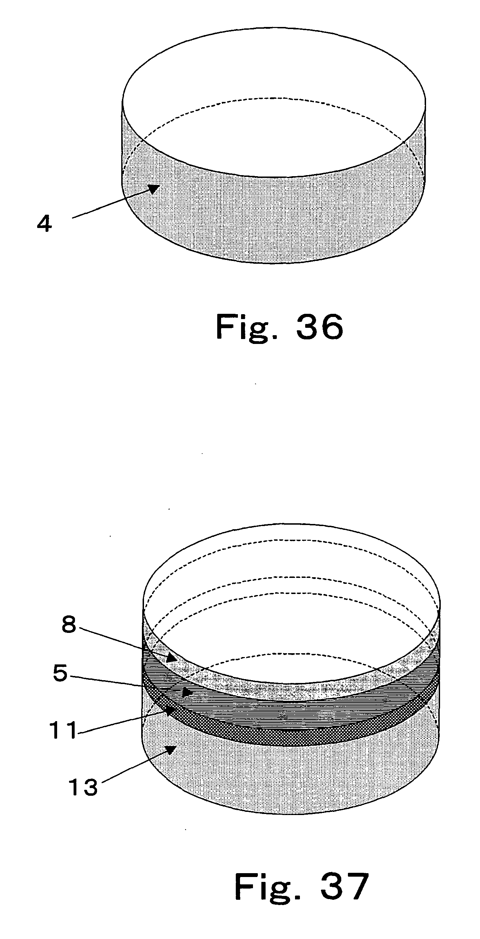

Fig. 36 illustrates the drawing of only the substrate which comprises the aluminum nitride-based sintered compact, the various sintered compacts which comprise as a main component a material having the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., and the other various ceramic-based sintered compacts in addition to these, and the substrate is shown with the mark 4 in it.

The substrate 4 illustrated in Fig. 36 is used as a substrate for a thin film, and the thin film comprising as a main component at least one selected from gallium nitride, indium nitride and aluminum nitride and having at least one of the crystallization states selected from a single crystal, an amorphous state, a polycrystal, and an orientated polycrystal is formed on the substrate.

A thin film comprising as a main component at least one selected from gallium nitride, indium nitride and aluminum nitride and having a single crystal state can be formed directly on the substrate 4 which comprises a various ceramic-based sintered compact of this invention, including an aluminum nitride-based sintered compact, various sintered compacts which comprise as a main component a material having the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., and in addition to this, a thin film having various crystallization states, such as an amorphous state, a polycrystal, and an orientated polycrystal, etc., may be formed directly.

As the embodiment in this invention, the thin film formed directly on the above substrate 4 may not necessarily be a single crystal state comprising as a main component at least one selected from gallium nitride, indium nitride and aluminum nitride, the thin film being formed directly may be at least one of the crystallization states selected from an amorphous state, a polycrystalline state, and an orientated polycrystalline state.

In this invention, a thin film comprises as a main component at least one selected from gallium nitride, indium nitride and aluminum nitride and having at least one of the crystallization states selected from a single crystal, an amorphous state, a polycrystal, and an orientated polycrystal can be formed furthermore on it, using the thin-film substrate as shown in Fig. 5.

In that case, the thin-film substrate will achieve the facility as a substrate for a thin film.

Various electronic devices and electronic components, such as a light-emitting device, a field emission display, a wiring board, or an optical waveguide, etc., are producible using the substrate for a thin film and the thin-film substrate of this invention illustrated in Fig. 5.

Fig. 6 is a perspective diagram which shows one example of the thin-film substrate wherein the thin film shown in Fig. 5 is being constituted with two layers.

In Fig. 6, that shown with the mark 4 is the substrate comprising various ceramic-based sintered compacts of this invention, including an aluminum nitride-based sintered compact, various sintered compacts comprising as a main component a ceramic material having at least one of the crystal structures selected from a hexagonal system or a trigonal system, such as silicon carbide, silicon nitride, gallium nitride, zinc oxide, and beryllium oxide, etc., and can be classified as a trigonal system or a hexagonal system, such as aluminum oxide, etc., and it is used as a substrate for a thin film.

In the substrate for a thin film, the thin film of a total of two layers is formed, wherein the thin film 5 and thin film 8 which comprise at least one selected from gallium nitride, indium nitride and aluminum nitride as a main component and have at least one of the crystallization states selected from a single crystal, an amorphous state, a polycrystal, and an orientated polycrystal are formed respectively in one layer, and the thin-film substrate 6 is being constituted.

The thin film 5 and thin film 8 which are illustrated in Fig. 6 comprise at least one selected from gallium nitride, indium nitride and aluminum nitride as a main component and are the thin film having a single-crystal state, or that having at least one of the crystallization states selected from a amorphous state, a polycrystalline state, and an orientated polycrystalline state, if needed.

The thin film 5 and thin film 8 which were shown in Fig. 6 may be formed in the condition where crystallization states, such as an amorphous state, a polycrystal, and an orientated polycrystal, and a single crystal, or composition, or thickness, etc., differs respectively in each layer.

In the thin film constitution shown in Fig. 6, if the thin film 5 is formed in at least one of the crystallization states selected from a single crystal, an amorphous state, a polycrystal, and an orientated polycrystal, and the thin film 8 is formed as an epitaxially grown single crystal, the crystallinity of the thin film 8 tends to improve than the crystallinity of the single-crystal thin film formed directly on the substrate 4, it is preferred.

The thin-film substrate of such thin film constitution is preferred when using it for production of various electronic devices and electronic components, such as a light-emitting device, a field emission display, a wiring board, or an optical waveguide, etc.

As mentioned above, when it is going to form the thin film 8 as an epitaxially grown single crystal, that formed in at least one of the crystallization states selected from an amorphous state, a polycrystal, and an orientated polycrystal is preferred as the thin film 5, because that being excellent in characteristics of the thin film 8, such as crystallinity, is easy to be obtained, and that wherein the thin film 5 was formed in an orientated polycrystal state is more preferred.

In this invention, not only that wherein the thin film is formed as two layers as shown in Fig. 6 but the thin-film substrate wherein the thin film is formed as three or more layers may be provided easily.

As mentioned above, not all of the thin film shown in Fig. 5 and Fig. 6 are necessarily a single crystal. And, it is not necessarily a single layer.

The thin film shown in Fig. 5 and Fig. 6 can use that comprising as a main component at least one selected from gallium nitride, indium nitride and aluminum nitride and having a various crystallization state, such as a single crystal state, an amorphous state, a polycrystalline state, and an orientated polycrystalline state, etc.

Moreover, the thin film shown in Fig. 5 and Fig. 6 may also be formed as a thin film comprising as a main component at least one selected from gallium nitride, indium nitride and aluminum nitride and constituted with two or more layers.

Although the thin film comprising two or more layers can be formed in the state where the crystallization state, such as a single crystal state, an amorphous state, a polycrystalline state, and an orientated polycrystalline state, etc., or the composition, or the thickness differs respectively in each layer, in this invention, among the thin film constituted with two or more layers, it is preferred that at least one layer is a single crystal comprising as a main component at least one selected from gallium nitride, indium nitride and aluminum nitride.

When the thin-film substrate of this invention is used in order to form a thin film comprising as a main component at least one selected from gallium nitride, indium nitride and aluminum nitride and having a various crystallization state including a single-crystal thin film, like the substrate for light-emitting device formation, or the substrate for field emission, or the dielectric material for wiring boards, or the material for optical waveguide, as for the surface of the thin-film substrate according to this invention, it is preferred that it is usually a single crystal state.

A thin-film substrate of this invention is a substrate in which a thin film comprising as a main component at least one selected from gallium nitride, indium nitride and aluminum nitride is formed on the substrate, using as a substrate an aluminum nitride-based sintered compact, various sintered compacts which comprise as a main component a ceramic material having the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., and other various ceramic-based sintered compacts in addition to these, and it is a substrate in which at least a part of the thin films comprising as a main component at least one selected from gallium nitride, indium nitride and aluminum nitride comprises a single-crystal state, if it requires.

In the thin-film substrate of this invention, in case of what has the single-crystal thin film comprising as a main component at least one selected from gallium nitride, indium nitride and aluminum nitride on the surface, it desires that, wherein the thin film comprising as a main component at least one selected from gallium nitride, indium nitride and aluminum nitride and having at least one of the crystallization states selected from a single crystal state, an amorphous state, a polycrystalline state, and an orientated polycrystalline state was formed beforehand on the various ceramic-based sintered compacts, including an aluminum nitride-based sintered compact, and various sintered compacts which comprise as a main component a material having the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., and the epitaxially grown thin film comprising as a main component at least one selected from gallium nitride, indium nitride and aluminum nitride is formed furthermore on it.

By doing so, since the crystallinity of a single-crystal thin film improves than that in which the single crystal comprising as a main component at least one selected from gallium nitride, indium nitride and aluminum nitride is formed directly on the sintered compact which comprises as a main component various ceramic materials, such as aluminum nitride, it is desirable.

The thin film which comprises as a main component at least one selected from gallium nitride, indium nitride, and aluminum nitride and in which a part is a single crystal state at least can be formed on the above thin-film substrate 6 shown in Fig. 5 and the thin-film substrate 8 shown in Fig. 6, and the thin film of various crystallization states, such as an amorphous state, a polycrystal, and an orientated polycrystal, can also be formed in addition to this.

As a substrate for a thin film according to this invention, it can use not only the substrate shown in Fig. 5 and comprising a sintered compact comprising as a main component various ceramic materials, such as aluminum nitride, but also the substrate in which the thin film comprising as a main component at least one selected from gallium nitride, indium nitride and aluminum nitride was formed on the aluminum nitride-based sintered compact.

Such substrate in which the thin film comprising as a main component at least one selected from gallium nitride, indium nitride and aluminum nitride was formed on the aluminum nitride-based sintered compact is a same substance as the thin-film substrate shown in Fig. 6, the thin-film substrate of this invention can also be used not only as electronic devices and electronic components, such as a substrate for light-emitting device production, a substrate for field emission, a dielectric material for wiring board, or a material for optical waveguide, but also as a substrate for a thin film of this invention.

In the thin-film substrate of this invention, the aluminum nitride-based sintered compact and used for forming a thin film comprising as a main component at least one selected from gallium nitride, indium nitride and aluminum nitride is usually used in the shape of a substrate.

The substrate-like sintered compact comprising aluminum nitride as a main component is a same substance as the substrate comprising an aluminum nitride-based sintered compact used as a substrate for a thin film of this invention.

That is, the substrate for a thin film of this invention which comprises an aluminum nitride-based sintered compact may also be used as a substrate which constitutes a thin-film substrate of this invention.

The substrate for a thin film and the thin-film substrate which are indicated in Fig. 5 and Fig. 6 are disc-like, and though the thin film is drawn as being formed only on the 1 surface of the substrate, the above thin film may be formed not only on the 1 surface of the substrate but also on the other surfaces, if needed, in this invention.

For example, when a square-shaped board (rectangular parallelepiped) is used as the substrate for a thin film and thw thin-film substrate, a thin film comprising as a main component at least one selected from gallium nitride, indium nitride and aluminum nitride may be formed on only 1 surface, only two surfaces, only 3 surfaces, only 4 surfaces, only 5 surfaces, or all 6 surfaces, if needed, in the above substrate for thin-film formation and thin-film substrate.

As for the single-crystal thin film (2 and 5) which comprises as a main component at least one selected from gallium nitride, indium nitride, and aluminum nitride and is shown in Fig. 1, Fig. 2, Fig. 4, Fig. 5, and Fig. 6, it can form as the thin film which includes that having a single-crystal state at least and includes further that having a various crystallization state, such as an amorphous state, a polycrystalline state, and an orientated polycrystalline state, if needed, the thin film (2 and 5) can be formed not only as a single layer but also as plural layers in which the composition, the crystallization state, or the thickness differs.

According to this invention, as for manufacture of the sintered compact which comprises aluminum nitride as a main component and substrate which comprises a sintered compact which comprises aluminum nitride as a main component, conventional methods can be used.

That is, it is manufactured heating the powder compact which comprises aluminum nitride as a main component usually in the temperature range of about 1500-2400°C under normal pressure, decompression, or pressurization, in the non-oxidizing atmosphere, such as the neutral atmosphere which comprises as a main component at least one, such as helium, neon, argon, and nitrogen, or the reduced atmosphere containing at least one, such as hydrogen, carbon monoxide, carbon, and hydrocarbon.

The range of about 10 minutes-3 hours is usually used as firing time. It can also be manufactured firing in a vacuum.

Moreover, it is also manufactured by the hot press method or the HIP (hot isostatic pressing) firing method.

As for the firing condition by the hot press method, the firing temperature range of about 1500-2400°C, the firing time range of about 10 minutes-3 hours, and the pressure range of about 10 kg/cm²-1000 kg/cm² are usually used in the above non-oxidizing atmosphere or vacuum.

As for the firing condition by the HIP method, the above non-oxidizing atmosphere is pressurized in the range of about 500 kg/cm²-10000 kg/cm², and the firing temperature range of about 1500-2400°C and the firing time range of about 10 minutes-10 hours are usually used.

It is easy to obtain the sintered compact which comprises aluminum nitride as a main component and is more excellent in optical permeability if the device in which an aluminum nitride component exists in the firing atmosphere on the occasion of the above firing is performed.

That is, it becomes easier to obtain the sintered compact which comprises aluminum nitride as a main component and is excellent in optical permeability if the vapor which comprises aluminum nitride as a main component exists in the firing atmosphere.

As the method of making an aluminum nitride component exist in the firing atmosphere, for example, there is the method of supplying into the atmosphere by evaporation from the fired thing itself during firing the fired thing of the powder compact comprising aluminum nitride as a main component or the sintered compact comprising aluminum nitride as a main component, or supplying from other than this fired thing.

Concretely, for example, as a method of supplying an aluminum nitride component into the firing atmosphere from the fired thing itself, there are methods, that is, the fired thing is contained in the firing container, such as "saggar", or the firing implement, such as "setter", which are produced with material which does not contain carbon as much as possible, such as boron nitride, tungsten, or molybdenum, and fired, or what carried out coating of the surface by boron nitride, etc. is used even if the firing container or firing implement containing carbon are used, etc., they are effective.

A sintered compact which comprises aluminum nitride as a main component and is excellent in optical permeability is also producible by firing a fired thing in the condition where the degree of sealing is raised furthermore after containing in a firing container or a firing implement, etc.

As the method of supplying an aluminum nitride component into the firing atmosphere from other than the fired thing, a sintered compact which comprises aluminum nitride as a main component and is excellent in optical permeability is producible by containing and firing the fired thing in the firing container, such as "saggar", or the firing implement, such as "setter", which are produced with the material which comprises aluminum nitride as a main component.

A sintered compact which comprises aluminum nitride as a main component and is excellent in optical permeability tends to be acquired by the method of embedding a fired thing into the powder which comprises aluminum nitride as a main component, and firing it.

A sintered compact which comprises aluminum nitride as a main component and is excellent in optical transmissivity is also producible, even if the fired thing is fired simultaneously in the above firing container or implement with at least one which is other than the fired thing and is selected from the powder comprising aluminum nitride as a main component, the powder compact comprising aluminum nitride as a main component, or the sintered compact comprising aluminum nitride as a main component.

Since this method can fire a fired thing in the free state, when carrying out extensive processing of a product and firing the thing of complicated form, it is preferred.

In addition, among the above firing container or firing implement, using the firing container or firing implement which are produced with the material which comprises aluminum nitride as a main component, a sintered compact which comprises aluminum nitride as a main component and is excellent in optical transmissivity is also producible, even if they are fired with at least one which is other than a fired thing and is selected from the powder comprising aluminum nitride as a main component, the powder compact comprising aluminum nitride as a main component, or the sintered compact comprising aluminum nitride as a main component.

In the above method of producing a sintered compact which comprises aluminum nitride as a main component and is excellent in optical permeability by making an aluminum nitride component exist in the firing atmosphere, usually, the sintered compact which comprises aluminum nitride as a main component and is more excellent in optical permeability can be produced by supplying the aluminum nitride component into the atmosphere from other than a fired thing than supplying by evaporation from the fired thing itself.

In addition, in the method of producing a sintered compact which comprises aluminum nitride as a main component and is excellent in optical permeability by making an aluminum nitride component exist in the firing atmosphere, usually, since the components, such as additives like sintering aids, oxygen or unescapable impurities contained in a raw material, are not vaporized while firing, a sintered compact which comprises aluminum nitride as a main component and has the almost same composition as a powder compact is producible.

In addition, when firing is performed by the hot-press method or the HIP method, it is easy to obtain the sintered compact which comprises aluminum nitride as a main component and is more excellent in optical permeability if the sintered compact which comprises aluminum nitride as a main component is re-fired under pressurization after the powder compact is pre-fired and was made into the sintered compact which comprises aluminum nitride as a main component, than carrying out pressurization firing of the powder compact which comprises aluminum nitride as a main component as it is.

Also in the firing by the hot-press method or the HIP method, firing by making an aluminum nitride component exist in the firing atmosphere by various methods, such as using the above firing container and a firing implement, is desirable in order to produce the sintered compact which comprises aluminum nitride as a main component and is more excellent in optical permeability.

When raising the chemical purity of the sintered compact which comprises aluminum nitride as a main component, conditions other than the above can also be chosen if needed.

For example, as for the contained oxygen, component which is used as sintering aids, such as a rare-earth compound and an alkaline-earth-metal compound, component which is used as a agent for lowering the firing temperature, such as an alkali metal and silicon, metal component, such as Mo, W, V, Nb, Ta, Ti or carbon which are used as a blackening agent, or unescapable metals components other than Mo, W, V, Nb, Ta, Ti, etc., they are able to be vaporized, removed, and decreased if comparatively long time firing of not less than 3 hours is performed at the temperature not less than 1750°C in reduced atmosphere if required, the content of ALON (Aluminum oxynitride: the compound which is produced by the chemical reaction between AlN and Al₂O₃ and which has a spinel type crystal structure), above metal components other than aluminum, silicon, or compounds containing carbon are decreased, the AlN purity increases, and it is easy to manufacture the sintered compact which comprises aluminum nitride as a main component and whose optical permeability improved, as the result.

As mentioned above, although the optical permeability of the sintered compact which comprises aluminum nitride as a main component is able to raise more by performing long time firing of not less than 3 hours at the temperature not less than 1750°C in reduced atmosphere if required, this inventor is surmising that aluminum nitride particles tend to grow in the sintered compact which comprises aluminum nitride as a main component by this firing and that the decrease of particle boundaries is also one of the factors in which optical permeability becomes easy to increase, as the result.

When the single-crystal thin film which comprises as a main component at least one selected from gallium nitride, indium nitride, and aluminum nitride is formed using the sintered compact which comprises aluminum nitride as a main component and raised the AlN purity as mentioned above as a substrate, the crystallinity of the single-crystal thin film formed tends to become higher, it is preferred.

Aluminum nitride particles in the sintered compact which comprises as a main component aluminum nitride can be grown greatly by performing the firing, for example, at the temperature not less than 1750°C for comparatively long 3 or more hours.

As a substrate, using the sintered compact which comprises aluminum nitride as a main component and whose aluminum nitride particles have grown, When the single-crystal thin film which comprises as amain component at least one selected from gallium nitride, indium nitride, and aluminum nitride is formed, it becomes easier to form a single-crystal thin film with higher crystallinity, it is preferred.

Thus, in this invention, not only the sintered compact which comprises aluminum nitride as a main component and raised the AlN purity but also the sintered compact which comprises aluminum nitride as a main component and whose aluminum nitride particles have grown is effective for a substrate for forming a thin film which comprises as a main component at least one selected from gallium nitride, indium nitride, and aluminum nitride.

As for the firing temperature when manufacturing the above sintered compact which comprises aluminum nitride as a main component and raised the AlN purity or the sintered compact which comprises aluminum nitride as a main component and whose aluminum nitride particles have grown, in order to shorten the firing time, it is more preferred that it is not less than 1900°C, it is still more preferred that it is not less than 2050°C, and it is most preferred that it is not less than 2100°C.

Of course at the temperature not less than 2050°C, even if it is high temperature not less than 2100°C, it can fire without sublimating most AlN component itself.

In order to raise the AlN purity or to make aluminum nitride particles grow, it is usually preferred to make the firing time not less than 10 hours in the range of a firing temperature of 1750-1900°C, furthermore a bigger effect is acquired in not less than 24 hours.

In the firing temperature not less than 1900°C, the effect of raising the AlN purity enough or making aluminum nitride particles grow is acquired with the firing time not less than 6 hours, and a bigger effect for raising the AlN purity or making aluminum nitride particles grow is acquired with not less than 10 hours.

In the firing temperature not less than 2050°C, the effect of raising the AlN purity enough or making aluminum nitride particles grow is acquired with the firing time not less than 4 hours, and a bigger effect of raising the AlN purity or making aluminum nitride particles grow is acquired with not less than 6 hours.

In the firing temperature not less than 2100°C, the effect of raising the AlN purity enough or making aluminum nitride particles grow is acquired with firing time not less than 3 hours, and a bigger effect of raising the AlN purity enough or making aluminum nitride particles grow is acquired with not less than 4 hours.

When the AlN purity of a sintered compact which comprises aluminum nitride as a main component as mentioned above is raised, or when growing up aluminum nitride particle, there is such a relation, if a firing temperature is raised a firing time can be shortened and if a firing temperature is made low a firing time becomes long, and a firing temperature and firing time can use arbitrary conditions.

As for the firing atmosphere when manufacturing the above sintered compact which comprises aluminum nitride as a main component and has high AlN purity, it is preferred to use the reduced atmosphere which contains at least one, such as hydrogen, carbon monoxide, carbon, and hydrocarbon, in order to make vaporization of impurities easier.

Although it may also be what comprises as the main substance at least one of hydrogen, carbon monoxide, carbon, and hydrocarbon, etc. as a reduced atmosphere, for example, it may be the atmosphere which contains very small amount of about 0.1 ppm of at least one of hydrogen, carbon monoxide, carbon, and hydrocarbon, etc. in the ambient atmosphere which comprises as a main component at least one of nitrogen, helium, neon, and argon, etc.

When the reduced atmosphere is an atmosphere which contains very small amount of at least one of hydrogen, carbon monoxide, carbon, and hydrocarbon, etc. in the ambient atmosphere which comprises at least one of nitrogen, helium, neon, and argon, etc. as the main substance, what contains at least one of hydrogen, carbon monoxide, carbon, and hydrocarbon, etc. not less than 10 ppm is more preferred, in order to make the sintered compact which comprises aluminum nitride as a main component into high purity.

In the above reduced atmosphere, what contains at least one of hydrogen, carbon monoxide, carbon, and hydrocarbon, etc. not less than 100 ppm is still more desirable, in order to make the sintered compact which comprises aluminum nitride as a main component into high purity.

There is especially no need to use the reduced atmosphere as the ambient atmosphere when manufacturing the sintered compact which comprises aluminum nitride as a main component and whose aluminum nitride particles have grown, and it is enough if it is a non-oxidizing atmosphere.

By performing the above comparatively long time firing, when the sintered compact which comprises aluminum nitride as a main component and has high AlN purity, or the sintered compact which comprises aluminum nitride as a main component and whose aluminum nitride particles have grown is manufactured, it may be fired using the powder compact which comprises aluminum nitride raw material powder as a main component, and what was made into the sintered compact by pre-firing the above powder compact may be used. And, it is also preferred to use the powder compact and sintered compact which comprise aluminum nitride as a main component and contain at least one selected from a rare earth compound or an alkaline-earth-metal compound other thaluminum nitride which is the main component.

When manufacturing the sintered compact which comprises aluminum nitride as a main component and has high AlN purity, although the component contained may be, preferably, vaporized and removed by heating for not less than 3 hours at the temperature not less than 1750°C in the above reduced atmospheres using the powder compact and sintered compact which used raw material powder as it is especially without using sintering aids, if the powder compact and sintered compact which comprise aluminum nitride as a main component and contain at least one selected from a rare earth compound or an alkaline-earth-metal compound are used as mentioned above, components other than AlN are vaporized, removed, and reduced, high purification is easy to be attained, it is more desirable.

And, when the powder compact which comprises aluminum nitride as a main component and contains simultaneously at least one compound selected from a rare earth element compound and at least one compound selected from an alkaline-earth-metal compound, or the thing which once fired the powder compact and was made into the sintered compact, is used, it becomes possible to lower a firing temperature by about 50-300°C compared with the case where a rare-earth compound or an alkaline-earth-metal compound is used independently, respectively, components other than AlN are vaporized, removed, and reduced effectively, so high purification is easy to be attained, it is more desirable.

By such method, an aluminum nitride-based sintered compact which comprises an AlN single phase substantially by thealysis using methods, such as X-ray diffraction, can also be manufactured.

In this invention, to raise the AlN purity of the sintered compact which comprises aluminum nitride as a main component and uses as a substrate for thin-film formation is effective to raise the quality of the thin film which comprises as a main component at least one selected from gallium nitride, indium nitride, and aluminum nitride and forms in the substrate.

As the reason, it seems that the area which a grain boundary phase occupies in a sintered compact will be decreased so it becomes to accept only the influence of AlN particles.

However, on the other hand, it is effective to use the sintered compact which comprises aluminum nitride as a main component and whose aluminum nitride particles have grown, as a substrate.

That is, for example, as for the sintered compact which comprises aluminum nitride as a main component and is obtained by firing the above powder compact and sintered compact for comparatively long time of not less than 3 hours at the temperature not less than 1750°C, while the aluminum nitride particles are growing greatly, there remain comparatively many components, such as sintering aids, such as a rare-earth compound and an alkaline-earth-metal compound, oxygen, components used as a agent for lowering the firing temperature, such as an alkali metal and silicon, metal components, such as Mo, W, V, Nb, Ta, and Ti, and carbon which are used as a blackening agent, unescapable metal components other than Mo, W, V, Nb, Ta, and Ti, or ALON, metal components other than the above aluminum, silicon, or compounds containing carbon, etc.

Even if such sintered compact is used as a substrate, the quality of a thin film improves, that is, for example, the crystallinity of the single-crystal thin film which comprises as a main component at least one selected from gallium nitride, indium nitride, and aluminum nitride and is formed on the substrate improves.

That is, in this invention, as for the sintered compact which comprises aluminum nitride as a main component and is used as a substrate for forming a thin film which comprises as a main component at least one selected from gallium nitride, indium nitride, and aluminum nitride, even if the AlN purity is not necessarily high, it is shown that it is effective to enlarge the aluminum nitride particle in a sintered compact.

As the reason, since grain boundaries will decrease in number if the size of the aluminum nitride crystal grain in a sintered compact is enlarged, the effect of a grain boundary decreases, and it is surmised that the AlN particle which enlarged greatly becomes easy to produce the characteristic near a single crystal.

As mentioned above, if it is fired at high temperature for a long time, the size of aluminum nitride crystal grains in a sintered compact will be enlarged, and the AlN purity in the sintered compact which comprises aluminum nitride as a main component usually tends to increase simultaneously.

In order to control improvement of AlN purity only by enlarging the size of aluminum nitride crystal grain in the sintered compact which comprises aluminum nitride as a main component, it is preferred to use a non-oxidizing atmosphere, such as nitrogen and argon, etc., which has comparatively little of reduction nature component, such as hydrogen, carbon monoxide, carbon, and hydrocarbon, as firing environment.

Also as for a firing furnace, for example, it is effective to use the method which uses high melting point metals, such as tungsten and molybdenum as a heating element, or the method which makes high melting point metals, such as tungsten and molybdenum, generate heat by electromagnetic induction, or what uses the furnace material made from high melting point metals, such as tungsten and molybdenum, other than the method which uses carbon heating element, the method which makes carbon generate heat by electromagnetic induction, or what has a furnace material made from carbon, etc.

Even if it is fired in the reduced atmosphere including hydrogen, carbon monoxide, carbon, and hydrocarbon, etc., or it uses what is the method which uses carbon heating element or the firing furnace which makes carbon generate heat by electromagnetic induction, it is also effective to fire in the state where it was isolated as much as possible from the reduced atmosphere by containing the above powder compact and sintered compact in a setter, an implement, or a saggar which do not include carbon as much as possible, such as aluminum nitride, boron nitride, or tungsten, or by embedding into aluminum nitride powder, or by embedding into aluminum nitride powder even if it uses a setter, an implement, or a sagger which include carbon, or by containing in the above setter, firing implement, or sagger and embedding into aluminum nitride powder furthermore, etc.

Without using the above firing methods which control the high purification of a sintered compact, if the above powder compact or sintered compact are fired using the method which uses carbon heating element, or the method which makes carbon generate heat by electromagnetic induction, or the furnace which uses the furnace material made from carbon, etc., or using a setter, an implement, or a sagger which are made from carbon, since the reduced atmosphere which contains carbon monoxide and carbon is easy to be formed spontaneously, components other than AlN evaporate and become easy to be removed, so the sintered compact which comprises aluminum nitride as a main component and has high AlN purity and whose aluminum nitride particles have grown can be obtained easily, it is desirable.

Usually, in order to manufacture the sintered compact which comprises aluminum nitride as a main component and has high AlN purity and whose aluminum nitride particles have grown, it is desirable to fire the above powder compact or sintered compact using the method which uses carbon heating element, or the method which makes carbon generate heat by electromagnetic induction, or the furnace which uses the furnace material which is made from carbon, etc., and using simultaneously the setter, implement, or sagger made from carbon.

Moreover, as mentioned above, as for the sintered compact which comprises aluminum nitride as a main component and which has comparatively little enlargement of the size of aluminum nitride crystal grain and is the state where comparatively much impurities, sintering aids, etc. remained, by performing the firing for comparatively short time not more than 3 hours in the above non-oxidizing atmosphere which is weak in reduction nature or does not contain a reduction component, or at comparatively low temperature not more than 1900°C, for example, in non-oxidizing atmosphere which is weak in reduction nature or does not contain reduction nature component, it is also used satisfactorily as a substrate for forming a thin film which comprises as a main component at least one selected from gallium nitride, indium nitride, and aluminum nitride.

That is, in the sintered compact which comprises aluminum nitride as a main component and is produced like that, as for impurity oxygen in raw material powder, oxygen which is resulting from A₂O₃ which is added to the powder compact, metal components and oxygen component, etc. which are in the added sintering aids, such as a rare-earth compound and an alkaline-earth-metal compound, metal components, silicon component, and oxygen component, etc. in the added alkali metal compound and silicon content compound, metal components and carbon component in the added compound(s) containing each transition metals of Mo, W, V, Nb, Ta, and Ti and compound(s) containing carbon, etc. in the added compound which contains carbon, or metal components and oxygen component, etc. in the added compound containing unescapable impurities, such as Fe, Ni, Cr, Mn, Zr, Hf, Co, Cu, and Zn, etc., they are hardly vaporized and not removed by the firing, and almost the same quantity as the quantity of a powder compact exists in many cases.

On the other hand, unless reference is made especially in this invention, as for the quantity of the impurities contained in the powder compact and the sintered compact which comprises aluminum nitride as a main component, or the various additives which were added in, it is shown with the amount of impurities actually contained on an oxide basis or the amount on an element basis or compounds, such as sintering aids, added in, the quantity of the oxygen component, metal component,s, or silicon component of the above sintered compact which comprises aluminum nitride as a main component is usually based on an oxide or on an element.

As mentioned above, although the sintered compact which comprises aluminum nitride as a main component and has high AlN purity and in which aluminum nitride particles have grown is preferred for the substrate for thin-film formation, even if the AlN purity is not necessarily high, that is, even if it is the sintered compact which comprises aluminum nitride as a main component and which leaves comparatively many components, such as sintering aids, such as a rare-earth compound and an alkaline-earth-metal compound, oxygen, components used as a agent for lowering the firing temperature, such as an alkali metal and silicon, metal components, such as Mo, W, V, Nb, Ta, and Ti and carbon which are used as a blackening agent, unescapable metal components other than Mo, W, V, Nb, Ta, and Ti, ALON, or compounds containing the above metal component other than aluminum, silicon, or carbon, etc., it can become the substrate which can form a single-crystal thin film which comprises as amain component at least one selected from gallium nitride, indium nitride, and aluminum nitride and has high crystallinity, if it is the thing in which aluminum nitride particles have grown.

While the above impurities remain, the sintered compact which comprises aluminum nitride as a main component and whose aluminum nitride particles have grown does not necessarily have optical permeability, or is not small, what has high optical transmissivity of 60-80 % is obtained.

As for such sintered compact which comprises aluminum nitride as a main component, it can become into an excellent substrate which can form a single-crystal thin film which comprises as a main component at least one selected from gallium nitride, indium nitride, and aluminum nitride and has high crystallinity.

In the aluminum nitride-based sintered compact, when AlN purity is high, and/or aluminum nitride particles have grown, the optical transmissivity in the visible light or in the ultraviolet light will increase. It brings the secondary effect in which the thermal conductivity can also be improved into not less than 200 W/mK at room temperature or not less than 220 W/mK.

The thermal conductivity of the sintered compact which comprises aluminum nitride as a main component originally is not less than 50 W/mK at least at room temperature, and usually it is as high as not less than 100 W/mK, therefore, since the light-emitting device produced using as a base material the sintered compact which comprises aluminum nitride as a main component can enlarge electric power applied there compared with the case where the substrate is sapphire, it has the advantage that the emitting output of a light-emitting device increases, and it can heighten the emitting output of a light-emitting device furthermore by raising the thermal conductivity to not less than 200 W/mK at room temperature by the above methods for example, it is more preferred.

Moreover, as for the above sintered compact which comprises aluminum nitride as a main component and has high AlN purity, or sintered compact which comprises aluminum nitride as a main component and whose aluminum nitride particles have grown, since the optical transmissivity in the visible light and/or the ultraviolet light of the range of 200 nm-380 nm wavelength will increase, and the thing which has comparatively high optical transmissivity not less than 20-40 % is easy to be obtained, the rate in which the light from a light-emitting device is absorbed by a substrate decreases, and it also has another advantage in which the luminous efficiency of a light-emitting device increases.

The form of the powder compact and sintered compact which are provided to the firing can use any one in order to raise the optical transmissivity of the above sintered compact which comprises aluminum nitride as a main component and was made into high purity, it is more preferred to use what has bigger surface area, for example, a shape of a board, etc., than a block shape, such as a cube, a rectangular parallelepiped, or a cylindrical one, etc., if it is the same volume.

If what is the one-side magnitude of not more than 8 mm is used in the form of the above powder compact and sintered compact which are provided to the firing, it is preferred for raising the optical transmissivity of the sintered compact which comprises aluminum nitride as a main component and was made into high purity.

Moreover, it is more preferred to use the thing in which the above one side magnitude is not more than 5 mm, it is still more preferred to use the thing in which the one side magnitude is not more than 2.5 mm, and it is most preferred to use the thing in which the one side magnitude is not more than 1 mm.

When the form of the above powder compact and sintered compact which are provided to the firing is board-like, it is desirable to use what is the thickness not more than 8 mm for raising the optical transmissivity of the sintered compact which comprises aluminum nitride as a main component and was made into high purity.

It is more preferred to use a thing of not more than 5 mm as the thickness of the above board-like powder compact and sintered compact, it is still more preferred to use a thing with the thickness not more than 2.5 mm, and it is most preferred to use a thing with the thickness not more than 1 mm.

If what was shown above is described concretely, for example, even if the sintered compact comprises the substantially same composition and substantially AlN single phase, in the sintered compact which comprises aluminum nitride as a main component and was made into high purity and which is manufactured using the thing which has block-like shape, such as the above cube, rectangular parallelepiped, or cylindrical one, or the powder compact and sintered compact which have the one side size of exceeding 8 mm, the optical transmissivity lowers compared with what was manufactured using the compact and sintered compact which are board-like or have one side size of not more than 8 mm, it may become black and the optical transmissivity may become a thing near zero, depending on the case.

Although the reason is not necessarily clear, it is guessed that because the pressure of the vaporization component increases and it is extracted from a sintered compact rapidly, or the minor constituent which can be hard to distinguish by X-ray diffraction or chemical analysis changes into a reduction product, such as a nitride and a carbide, etc., during vaporization of sintering aids, such as Y₂O₃, etc., for example, when components other than AlN are vaporized and removed in process of the firing.

By using the above illustrated method, in sintered compact which comprises aluminum nitride as a main component, the characteristics described below are controllable,
1) the degree of densification,
2) the quantity and size of pores,
3) the quantity and distribution of sintering aids, etc.,
4) the content and an existence condition of oxygen,
5) the quantity and distribution of impurities other than sintering aids,
6) the size of aluminum nitride particles and the particle size distribution, and
7) the form of aluminum nitride particle, etc.

As mentioned above, in the sintered compact which was manufactured by the firing method in which components other than the aluminum and nitrogen which are contained will be vaporized, removed and decreased, there is the feature that the optical permeability becomes high, AlN purity also becomes high, and the size of aluminum nitride particles also becomes large compared with what was manufactured by the usual firing method (including the above methods, such as under decompression, under normal pressure, under pressurization atmosphere, hot press, and HIP, etc.).

Although such sintered compact is a polycrystalline substance, it approaches the quality of a single crystal because the influence of a grain boundary decreases, the quality of a thin film which comprises as a main component at least one selected from gallium nitride, indium nitride, and aluminum nitride tends to improve, such that the crystallinity of the single-crystal thin film formed in the thing which used the sintered compact as a substrate will increase, etc.

This invention also provides the sintered compact which comprises aluminum nitride as a main component and raised the AlN purity and which is manufactured by the firing method which aims at such high purity, or the sintered compact which comprises aluminum nitride as a main component and made the size of aluminum nitride particles grow, or the sintered compact which comprises aluminum nitride as a main component and which raised the AlN purity and made the size of aluminum nitride particles grow.

As for the raw material powder for manufacturing the above sintered compact which comprises aluminum nitride as a main component, what was produced is usable using the methods, such as the method of oxide reduction which reduces aluminum oxide by carbon and is nitrided, or the direct nitriding method which nitrides metal aluminum directly, or the CVD method which decomposes aluminium compound(s), such as aluminium chloride, trimethyl aluminum, and aluminum alkoxide, etc., and is nitrided using ammonia, etc. in the gaseous phase.

In order to raise the optical transmissivity of a sintered compact, it is preferred to use the raw material which has uniform submicron primary particles and has high chemical purity and which was produced by the method of oxide reduction.

Therefore, among the raw materials by the above methods, it is preferred that the thing made by the method of oxide reduction which reduces aluminum oxide by carbon and is nitrided, or the thing made by the direct nitriding method which nitrides metal aluminum directly are used independently or in the mixed state.

As for the optical transmissivity ofthe sintered compact which comprises aluminum nitride as a main component, what is about 60-80 %, or what is not less than 80-90 % is obtained using the above manufacturing processes suitably.

When the sintered compact which comprises aluminum nitride as a main component and has the optical transmissivity not less than 40 % is used as a substrate, as for the crystallinity of the single-crystal thin film which comprises as a main component at least one selected from gallium nitride, indium nitride, and aluminum nitride and was formed directly on the substrate, a good thing, such that the half width of the rocking curve of the X ray diffraction from the lattice plane of the Miller Index (002) is not more than 150 seconds, is easy to be obtained, and it is preferred.

And, if the sintered compact which comprises aluminum nitride as a main component and has high optical transmissivity not less than 60 % is used as a substrate, as for the crystallinity of the single-crystal thin film which comprises as a main component at least one selected from gallium nitride, indium nitride, and aluminum nitride, a good thing, such that the half width of the rocking curve of the X ray diffraction from the lattice plane of the Miller Index (002) is not more than 130 seconds, is easy to be obtained, and it is especially preferred.

And, if the sintered compact which comprises aluminum nitride as a main component and has high optical transmissivity not less than 80 % is used as a substrate, as for the crystallinity of the single-crystal thin film which comprises as a main component at least one selected from gallium nitride, indium nitride, and aluminum nitride, a good thing, such that the half width of the rocking curve of the X ray diffraction from the lattice plane of the Miller Index (002) is not more than 100 seconds, is easy to be obtained, and it is the most preferred.

Although the above optical transmissivity is usually measured by monochromatic light with a wavelength of 605 nm, the sintered compact which comprises aluminum nitride as a main component and has the optical transmissivity measured by the above method has the same transmissivity also in all the visible light area of the range of 380-800 nm wavelength.

The sintered compact which comprises aluminum nitride as a main component and has such optical transmissivity of visible light has high transmissivity also in the light of an ultraviolet region of the range of 200-380 nm wavelength, and has higher transmissivity in the light of the range of 250-380 nm wavelength in the light of the ultraviolet region.

In this invention, since a substrate is the sintered compact which comprises aluminum nitride as a main component, the crystal orientation of the aluminum nitride particles in a sintered compact has turned to the random direction.

Therefore, while the above aluminum nitride particle in the sintered compact which comprises aluminum nitride as a main component is the same crystal structure of wurtzite type as gallium nitride or indium nitride, and the lattice constant is also almost the same, it cannot be said that lattice matching is attained from the theoretical view hitherto called between the substrate and the single-crystal thin film which comprises as a main component at least one selected from gallium nitride, indium nitride, and aluminum nitride.

Thus, although it seems that lattice matching with a substrate cannot be theoretically attained, the thin film formed on the substrate is a single crystal.

Actually, when this inventor has tried to form a thin film which comprises as a main component at least one selected from gallium nitride, indium nitride, and aluminum nitride in the comparatively thin thickness of about 0.5-5 nm onto the substrate which comprises a sintered compact which comprises aluminum nitride as a main component, a thin film which comprises as a main component gallium nitride and indium nitride is at least a single-crystal thin film which has good crystallinity not more than 300 seconds as half width of the rocking curve of the X-ray diffraction line from the lattice plane of the Miller Index (002).

It is judged by electron beam diffraction that the thin film which comprises aluminum nitride as a main component and has the above thickness of 0.5-5 nm is also a single crystal.

Even if it is what formed thickly to 3-6 µm and not less than 10 µm as the thickness of the thin film which comprises as a main component at least one selected from gallium nitride, indium nitride, and aluminum nitride, what is good crystallinity, such that the half width of the rocking curve of the X-ray diffraction line from the lattice plane of the Miller Index (002) is not more than 300 seconds, is obtained.

Furthermore, according to the characteristic of the sintered compact which comprises aluminum nitride as a main component as shown below in addition to the optical transmissivity of visible light, it can also make the crystallinity of the single-crystal thin film which comprises as a main component at least one selected from gallium nitride, indium nitride, and aluminum nitride and was formed on the substrate into the better thing in which the half width of the rocking curve of the X-ray diffraction line from the lattice plane of the Miller Index (002) is not more than 150-300 seconds.

As for the cause wherein a single-crystal thin film which comprises as a main component at least one selected from gallium nitride, indium nitride, and aluminum nitride can be formed using the substrate which comprises a polycrystalline substance called the aluminum nitride-based sintered compact of this invention, it is not necessarily clear at present.

Even if aluminum nitride particulate in the inside of a sintered compact has completely random directivity which results from the chemical component called aluminum nitride and the crystal structure which it probably has, it is surmised that it has originally the characteristic which is easy to become a single crystal aligning at once, for example, in the direction of C axis, when the gas component which comprises as a main component at least one selected from gallium nitride, indium nitride, and aluminum nitride changes to a solid state from gas and nuclear growth begins onto it.

That is, it is surmised that it is because the aluminum nitride which is the main components in a sintered compact originally has strongly the characteristic which helps single crystal-ization of a thin film in itself, in the process wherein the component which comprises as a main component at least one selected from gallium nitride, indium nitride, and aluminum nitride changes to a solid from gas, and the thin film is formed onto the substrate which comprises a sintered compact which comprises aluminum nitride as a main component.

Although single crystal-ization of the thin film can be attained even if a substrate is the sintered compact which comprises as a main component silicon carbide, silicon nitride, gallium nitride, aluminum oxide, zinc oxide, and beryllium oxide, etc. which belong to the crystal system of the same hexagonal system as aluminum nitride or the trigonal system, the validity of the above guess can explain indirectly also from that wherein the thing formed directly on the substrate which used the sintered compact which comprises aluminum nitride as a main component is superior in crystallinity of the formed thin film.

And, as for the thin film which passed through the process changed into a solid film which comprises as a main component at least one selected from gallium nitride, indium nitride, and aluminum nitride after once passing through the gas, ion, single molecule, or molecular beam containing the component which can form at least one selected from gallium nitride, indium nitride, and aluminum nitride, what was single-crystal-ized is easy to be obtained.

In this invention, the single-crystal thin film which comprises as a main component at least one selected from gallium nitride, indium nitride, and aluminum nitride becomes easy to be formed on the substrate directly if the sintered compact containing aluminum nitride not less than 50 volume % is used as a substrate, it is desirable.

The content of the aluminum nitride in the substrate which comprises a sintered compact which comprises aluminum nitride as a main component is easily reckonable by calculating the content of components contained in a sintered compact other than aluminum on an element basis, respectively, such as a rare-earth compound, an alkaline-earth-metal compound, oxygen, an alkali metal, silicon, and metal components of Mo, W, V, Nb, Ta, Ti, etc., carbon, unescapable metal components other than Mo, W, V, Nb, Ta, and Ti, ALON, and the above metal components other than aluminum. In addition, oxygen is what converted as aluminum oxide.

The above guess can be explained to some extent also from the point where correlation is seen between the optical permeability of a sintered compact which comprises aluminum nitride as a main component, and the crystallinity of the single-crystal thin film which is formed on a substrate and comprises as a main component at least one selected from gallium nitride, indium nitride, and aluminum nitride.

That is, the optical permeability of a sintered compact which comprises aluminum nitride as a main component changes by the factors, such as
1) the density of a sintered compact,
2) the existence and the size of the pore inside a sintered compact,
3) the content of the sintering aids or blackening agents of a sintered compact,
4) oxygen content of a sintered compact,
5) impurities contents other than oxygen and the sintering aids of a sintered compact,
6) the size of aluminum nitride particles in a sintered compact,
7) the form of aluminum nitride particles in a sintered compact.

And, it can think that these factors which affect the optical permeability of a sintered compact have high possibility of giving certain effect also to the generation of a single-crystal thin film which comprises as amain component at least one selected from gallium nitride, indium nitride, and aluminum nitride.

In this invention, as mentioned above, a correlation is accepted between the optical permeability of a sintered compact which comprises aluminum nitride as a main component, and the generation of a single-crystal thin film which comprises as a main component at least one selected from gallium nitride, indium nitride, and aluminum nitride and is on the substrate which comprises this sintered compact, even if the optical transmissivity to visible light in a sintered compact which comprises aluminum nitride as a main component, or the optical transmissivity to ultraviolet light are lower than 1 % respectively, or it is what does not penetrate light substantially, generation of the single-crystal thin film which comprises as amain component at least one selected from gallium nitride, indium nitride, and aluminum nitride is possible on the substrate which comprises a sintered compact which comprises aluminum nitride as a main component.

For example, as for the optical transmissivity of a sintered compact which comprises aluminum nitride as a main component and contains blackening elements, such as molybdenum, tungsten, and carbon, or unescapable metal impurities, such as iron, nickel, chromium, and manganese, or agents for lowering the firing temperature, such as alkali metals containing lithium ctc., and a silicon compound, etc., it is lower than 1 %, or the optical transmissivity is zero substantially in many cases.

A single-crystal thin film which comprises as a main component at least one selected from gallium nitride, indium nitride, and aluminum nitride can be formed directly on it even if it is the substrate which comprises such sintered compact, and what is good crystallinity, such that the above half width of the rocking curve of the X-ray diffraction line from the lattice plane of the Miller Index (002) is not more than 300 seconds, is also obtained.

As mentioned above, it is surmised that it is because the main components in a sintered compact called aluminum nitride itself originally have strongly the characteristic which helps single crystal-ization of a thin film easily in process in which a component which comprises as a main component at least one selected from gallium nitride, indium nitride, and aluminum nitride is formed onto a substrate as a thin film via a gaseous phase or a molecular beam.

As for the density of a sintered compact which comprises aluminum nitride as a main component, if it is not the state in which aluminum nitride or sintering aids, etc. were densely packed, that the single-crystal thin film could not be formed can be guessed easily.

Actually, in this invention, it is preferred that the relative density of a sintered compact which comprises aluminum nitride as a main component is not less than 95 %, and a single-crystal thin film which comprises as a main component at least one selected from gallium nitride, indium nitride, and aluminum nitride can be formed directly on such substrate.

Actually, in this invention, a thing in which the half width of the X-ray rocking curve from the lattice plane of the Miller Index (002) of the single-crystal thin film which comprises as a main component at least one selected from gallium nitride, indium nitride, and aluminum nitride and was formed directly on the substrate which comprises the sintered compact which comprises aluminum nitride as a main component is not more than 300 seconds is easy to be formed, when the relative density of a sintered compact which comprises aluminum nitride as a main component is not less than 98 %.

In the thing in which the relative density of a sintered compact is not less than 99 %, a thing in which the half width of the X-ray rocking curve from the lattice plane of the Miller Index (002) of the single-crystal thin film is not more than 240 seconds is easy to be formed, it is more preferable.

In the thing in which the relative density of a sintered compact is not less than 99.5 %, a thing in which the half width of the X-ray rocking curve from the lattice plane of the Miller Index (002) of the single-crystal thin film is not more than 200 seconds is easy to be formed, it is still more preferable.

In this invention, although the relative density is the one to the theoretical density (3.261 g/cm³) of aluminum nitride in the sintered compact which comprises aluminum nitride as a main component and is produced without adding additives, such as sintering aids and a blackening agent, in the sintered compact which comprises aluminum nitride as a main component and is produced adding additives, such as sintering aids and a blackening agent, it is not the one to the theoretical density of aluminum nitride, and it was shown by the value of the density on calculation when it is considered that aluminum nitride and components, such as sintering aids, are only mixing.

Therefore, the relative density of a sintered compact which comprises aluminum nitride as a main component depends on the composition of the sintered compact.

Concretely speaking, in the sintered compact which comprises aluminum nitride as a main component and contains aluminum nitride (AlN) of 95 % by weight and yttrium oxide (Y₂O₃) of 5 % by weight, since the density of AlN is 3.261 g/cm³ and the density of Y₂O₃ is 5.03 g/cm³, it is calculated that the density is 3.319 g/cm³ when the complete densification of the sintered compact of this composition is attained, and the percentage of the density of the actually obtained sintered compact and the above density by calculation becomes the relative density said in this invention.

If an example is furthermore shown, in the sintered compact which comprises aluminum nitride as a main component and contains aluminum nitride (AlN) of 90 % by weight and erbium oxide (Er₂O₃) of 10 % by weight, since the density of Er₂O₃ is 8.64 g/cm³, it is calculated that the density is 3.477 g/cm³ when the complete densification of the sintered compact of this composition is attained, the percentage of the density of the actually obtained sintered compact and the above density by calculation becomes relative density said in this invention.

And, in the sintered compact which comprises aluminum nitride as a main component and contains aluminum nitride (AlN) of 99.5 % by weight and calcium oxide (CaO) of 0.5 % by weight, since the density of CaO is 3.25 g/cm³, it is calculated that the density is 3.261 g/cm³ when the complete densification of the sintered compact of this composition is attained, the percentage of the density of the actually obtained sintered compact and the above density by calculation becomes relative density said in this invention.

Moreover, it can be guessed easily that the thing having a smaller size of the pore inside a sintered compact which comprises aluminum nitride as a main component can form an excellent single-crystal thin film.

Actually, in this invention, in the case of the thing in which the pore size of a sintered compact is an average of not more than 1 µm, a thing in which the half width of the X-ray rocking curve from the lattice plane of the Miller Index (002) of the single-crystal thin film which comprises as amain component at least one selected from gallium nitride, indium nitride, and aluminum nitride and was formed directly on the substrate which comprises the sintered compact which comprises aluminum nitride as a main component is not more than 300 seconds is easy to be formed.

And, in the case of the thing in which the pore size is an average of not more than 0.7 µm, a thing in which the half width of the X-ray rocking curve from the lattice plane of the Miller Index (002) of the single-crystal thin film is not more than 240 seconds is easy to be formed, it is more preferable.

And, in the case of the thing in which the pore size is an average of not more than 0.5 µm, a thing in which the half width of the X-ray rocking curve from the lattice plane of the Miller Index (002) of the single-crystal thin film is not more than 200 seconds is easy to be formed, it is more preferable.

In order to improve the above sintered compact density, to reduce the internal pore of a sintered compact, or to make the size of an inside pore small, the following methods are effective, for example.

That is, 1. using the thing wherein the primary particles are submicron and the distribution of a grain size is uniform, as a raw material for sintered compact manufacture, 2. lowering the firing temperature and controlling the grain growth, 3. carrying out the firing under the condition higher than 1 atmospheric pressure, such as atmospheric pressurized sintering, hot press, or HIP, 4. carrying out holding temperature in many stages in the firing, 5. carrying out by combining the decompression firing or normal pressure sintering, and the firing under the atmosphere higher than 1 atmospheric pressure, such as atmospheric pressurized sintering, hot press, or HIP, etc. And, t is also effective to carry out combining two or more of the above methods.

The substrate of this invention is able to use as sintering aids what contains rare-earth oxides, for example, such as Sc₂O₃, Y₂O₃, La₂O₃, CeO₂, Pr₆O₁₁, Nd₂O₃, Pm₂O₃, Sm₂O₃, Eu₂O₃, Gd₂O₃, Tb₄O₇, Dy₂O₃, Ho₂O₃, Er₂O₃, Tm₂O₃, Yb₂O₃, Lu₂O₃, in addition to this, what contains rare-earth components, such as Sc, Y, La, Ce, Pr, Nd, Pm, Sm, Eu, Gd, Tb, Dy, Ho, Er, Tm, Yb, and Lu, etc., in addition to this, what contains inorganic rare earth compounds, such as carbonate, cnitrate, sulfate, and chloride, containing such as Sc, Y, La, Ce, Pr, Nd, Pm, Sm, Eu, Gd, Tb, Dy, Ho, Er, Tm, Yb, Lu, etc., and various rare-earth compounds, such as organic rare earth compounds, such as acetate, oxalate, and citrate, alkaline earth metal oxides, such as BeO, MgO, CaO, SrO, and BaO, alkaline earth metal element components, such as Be, Mg, Ca, Sr, and Ba, or other inorganic alkaline-earth-metal compounds, such as carbonate, nitrate, sulfate, and chloride, etc. containing Be, Mg, Ca, Sr, Ba, etc., various alkaline-earth-metal compounds, such as organoalkaline-earth-metal compounds, such as acetate, oxalate, and citrate, what simultaneously contains a rare-earth compound and an alkaline-earth-metal compound and what contains alkali metal compounds, such as Li₂O, Li₂CO₃, LiF, LiOH, Na₂O, Na₂CO₃, NaF, NaOH, K₂O, K₂CO₃, KF, and KOH, and silicon compounds, such as SiO₂, Si₃N₄, and SiC, for performing the firing temperature lowering, what contains metals, alloy, and metallic compound containing Mo, W, V, Nb, Ta, Ti, etc., and carbon in order to achieve black-ization, other thaluminum nitride which is a main component.

What contains components, such as a rare-earth component, an alkaline-earth-metal component, an alkali metal component, a silicon component, Mo, W, V, Nb, Ta, Ti, and carbon, can be used as the aluminum nitride-based sintered compact of this invention, as mentioned above.

It can guess easily that these sintering aids, agents for lowering the firing temperature, and blackening agents also affect the optical transmissivity of a sintered compact.

Actually, in this invention, in the substrate which comprises a sintered compact which comprises aluminum nitride as a main component, a single-crystal thin film which comprises as a main component at least one selected from gallium nitride, indium nitride, and aluminum nitride is easy to be formed directly on the substrate using the sintered compact in which the content of components other than the above aluminum nitride which is the main components is a total of not more than 25 volume % on an oxide basis in the case of a rare earth element and an alkaline earth metal, a total of not more than 10 volume % on an oxide basis in the case of an alkali metal and silicon, and a total of not more than 25 volume % on an element basis in the case of the component for achieving the above black-ization. As for the crystallinity of the single-crystal thin film formed directly on the substrate at this time, a good thing, such that the half width of the rocking curve of the X-ray diffraction line from the lattice plane of a Miller Index (002) is not more than 300 seconds, is easy to be obtained.

A single-crystal thin film which comprises as a main component at least one selected from gallium nitride, indium nitride, and aluminum nitride is easy to be formed directly on the substrate by using as a substrate the sintered compact which comprises aluminum nitride as a main component and contains an alkaline metal component and a silicon component not more than 5 volume % in total on an oxide basis. As for the crystallinity of the single-crystal thin film formed directly on the substrate at this time, a good thing, such that the half width of the rocking curve of the X-ray diffraction line from the lattice plane of a Miller Index (002) is not more than 240 seconds, is easy to be obtained.

An alkali metal component and a silicon component may be respectively contained independently, or an alkaline metal component and a silicon component may be contained simultaneously.

The above sintering aids, agents for lowering the firing temperature, and blackening agents tend to produce the different compounds and crystal phases from aluminum nitride inside a sintered compact.

Since the crystal structure of compounds or crystal phases generated by the above sintering aids, agents for lowering the firing temperature, and blackening agents differs from a wurtzite type, such as gallium nitride, indium nitride, and aluminum nitride, the crystal nuclear growth direction tends to become irregular on the substrate in which the compounds and the crystal phases generated by the above sintering aids, agents for lowering the firing temperature, and blackening agents exist so much, and it is guessed that the single-crystal thin film which comprises as a main component at least one selected from gallium nitride, indium nitride, and aluminum nitride and has good crystallinity is hard to be obtained.

In this invention, as for the content of a rare earth element and an alkaline earth metal contained in the sintered compact which constitutes the above substrate and comprises aluminum nitride as a main component, it is what was obtained by being converted into a rare earth element oxide and an alkaline-earth-metal oxide and recalculating to volume percentage (volume %) from the density of these oxides furthermore, after the rare earth and alkaline-earth metal contained were obtained with weight percentage (% by weight) as rare earth element and alkaline-earth-metal element.

The rare-earth oxides used for the basis of conversion are Sc₂O₃, Y₂O₃, La₂O₃, CeO₂, Pr₆O₁₁, Nd₂O₃, Pm₂O₃, Sm₂O₃, Eu₂O₃, Gd₂O₃, Tb₄O₇, Dy₂O₃, Ho₂O₃, Er₂O₃, Tm₂O₃, Yb₂O₃, and Lu₂O₃, and the alkaline-earth-metal oxides are BeO, MgO, CaO, SrO, and BaO.

And, as for the content of an alkaline metal and a silicon contained in the sintered compact which constitutes a substrate and comprises aluminum nitride as a main component, it is what was obtained by being converted into an alkaline metal oxide and silicon oxide and recalculating to volume percentage (volume %) from the density of these oxides furthermore, after the alkaline metal and the silicon contained were obtained with weight percentage (% by weight) as alkaline metal element and silicon.

The alkali metal oxides used for the basis of conversion are Li₂O, Na₂O, K₂O, Rb₂O, and Cs₂O, and the silicon oxide is SiO₂ (density: 2.65 g/cm³).

And, as for the content of the compound containing the metal, alloy, and metal compound containing Mo, W, V, Nb, Ta, Ti, etc., and carbon, etc. which are contained in the sintered compact which constitutes a substrate and comprises aluminum nitride as a main component, it is what was obtained by recalculating to volume percentage (volume %) from the density of these elements furthermore after the content of each component of Mo, W, V, Nb, Ta, Ti, and carbon which are contained was obtained with weight percentage (% by weight) as element.

In this invention, unless it refuses especially, alkaline-earth metals include not only calcium (Ca), strontium (Sr), barium (Ba), and radium (Ra) but also beryllium (Be) and magnesium (Mg).

In addition, as for the above volume % (volume percentage), it is what was calculated from the density and weight percentage of this oxide after each element component contained in a substrate other thaluminum nitride is converted into an oxide.

For example, although it does not mean the volume percent of the reactant which arises actually by the mutual reaction of each above element component contained in a substrate other than the aluminum nitride or by the reaction with unescapable mixing components, such as oxygen and transition metals, etc., it can be the scale which measures the densification degree of a sintered compact.

Concretely speaking, in the sintered compact which comprises aluminum nitride as a main component and contains aluminum nitride (AlN) 95 % by weight and yttrium oxide (Y₂O₃) 5 % by weight, since the density of AlN is 3.261 g/cm³ and the density of Y₂O₃ is 5.03 g/cm³, it is calculated that the content of a rare-earth compound is 3.30 volume %.

In the sintered compact which comprises aluminum nitride as a main component and contains aluminum nitride (AlN) 90 % by weight and erbium oxide (Er₂O₃) 10 % by weight, since the density of Er₂O₃ is 8.64 g/cm³, it is calculated that the content of a rare-earth compound is 4.02 volume %.

And, in the sintered compact which comprises aluminum nitride as a main component and contains aluminum nitride (AlN) 99.5 % by weight and calcium carbonate (CaCO₃) 0.5 % by weight on the basis of calcium oxide (CaO), since the density of CaO is 3.25 g/cm³, it is calculated that the content of an alkaline-earth-metal compound is 0.50 volume %.

And, as for the substrate according to this invention, it contains not only the above component for achieving black-ization, component for lowering the firing temperature, and component as sintering aids but also the unescapable impurities component of the transition metals which are contained in raw materials for sintered compact manufacture and are easy to mix from the manufacturing process, in addition to the aluminum nitride which is a main component.

Such unescapable impurities contain transition metal(s) other than a rare earth element and Mo, W, V, Nb, Ta, and Ti, for example, components of iron, nickel, chromium, manganese, zirconium, hafnium, cobalt, copper, and zinc, etc.

In this invention, "Containing the unescapable impurities component of a transition metal" means that at least one, such as above iron, nickel, chromium, manganese, zirconium, hafnium, cobalt, copper, and zinc, etc., are included.

Such as the above transition metals, the amount of mixing of the unescapable impurities component contained in the substrate which comprises a sintered compact which comprises aluminum nitride as a main component is usually not more than 1 % by weight in many cases, it is not more than 0.5 % by weight, or not more than 0.2 % by weight, and preferably not more than 0.05 % by weight.

Of course, although it is preferred that mixing of such unescapable impurities is few as much as possible, even if it is the sintered compact which comprises aluminum nitride as a main component and contains comparatively many transition-metals components, such as the above iron, nickel, chromium, manganese, zirconium, hafnium, cobalt, copper, and zinc, in this invention, a single-crystal thin film which comprises as a main component at least one selected from gallium nitride, indium nitride, and aluminum nitride can be formed directly on the substrate.

As for the content of transition-metals components, such as the above iron, nickel, chromium, manganese, zirconium, hafnium, cobalt, copper, and zinc, etc., in the sintered compact which comprises aluminum nitride as a main component, it is preferably that it is not more than 30 % by weight on an element basis, a single-crystal thin film which comprises as a main component at least one selected from gallium nitride, indium nitride, and aluminum nitride can be formed directly on the substrate. And, as for the crystallinity of the single-crystal thin film formed on the substrate which comprises a sintered compact which comprises aluminum nitride as a main component, a good thing, such that the half width of the rocking curve of the X-ray diffraction line from the lattice plane of a Miller Index (002) is not more than 300 seconds, is easy to be obtained at this time.

And, when the substrate in which the content of components containing unescapable impurities is not more than 20 % by weight on an element basis is used, as for the crystallinity of the single-crystal thin film formed directly on the substrate, a good thing, such that the half width of the rocking curve of the X-ray diffraction line from the lattice plane of a Miller Index (002) is not more than 240 seconds, is easy to be obtained, and it is more desirable as a substrate. And, if it is not more than 10 % by weight, as for the crystallinity of the single-crystal thin film formed directly on the substrate, since a good thing, such that the half width of the rocking curve of the X-ray diffraction line from the lattice plane of a Miller Index (002) is not more than 200 seconds, is easy to be obtained, it is more desirable.

When manufacturing the sintered compact which comprises aluminum nitride as a main component, mixing of unescapable impurities can be decreased by the device of using a high purity raw material and achieving high purity-ization of the material used for the portion which ceramics contact in manufacturing processes of a green sheet, a granule for powder pressing, or a firing.

As for the substrate according to this invention, it contains not only the above components of sintering aids, components for achieving the coloring, components for lowering the firing temperature, and components of unescapable metal impurity, but also oxygen which is contained in raw materials for sintered compact manufacture and is mixed from a manufacturing process furthermore, other thaluminum nitride which is a main component.

Oxygen is usually contained about 0.01-5.0 % by weight in the raw material for sintered compact manufacture, it vaporizes in part during firing, but it almost remains in a sintered compact as it is in many cases, and ALON (aluminum oxynitride: the compound between AlN and Al₂O₃) of a spinel type crystal structure is generated in the sintered compact manufactured without using sintering aids, etc., in many cases.

The ALON usually shows the diffraction line shown in the JCPDS file number 36-50.
And, oxygen is contained by adding Al₂O₃ positively so that ALON may be generated in a sintered compact. Moreover, these parts are also contained when sintering aids and blackening agents are the compounds containing oxygen, such as an oxide and a complex oxide.

If the amount of oxygen in a sintered compact is more than 10 % by weight, generation of compounds, such as ALON, compounds between sintering aids and oxygen, compounds between blackening agents and oxygen, or compounds between agents for lowering the firing temperature and oxygen, etc., will increase inside a sintered compact, and it will be easy to bring about the lowering of the crystallinity of a single-crystal thin film.

Although the amount of generation of ALON in the inside of a sintered compact is controllable by the amount of oxygen, and the amounts of sintering aids, such as a rare earth element compound and an alkaline-earth-metal compound, when not using sintering aids, it is dependent only on the amount of oxygen in a sintered compact.

Although the crystal structure of the above ALON differs from wurtzite types, such as an gallium nitride, indium nitride, and aluminum nitride, if the amount of ALON is not more than 12 % in the sintered compact which comprises aluminum nitride as a main component, as for the crystallinity of the single-crystal thin film which comprises as a main component at least one selected from gallium nitride, indium nitride, and aluminum nitride and was formed directly on the substrate which comprises the sintered compact which comprises aluminum nitride as a main component, since a thing in which the half width of the rocking curve of the X-ray diffraction line from the lattice plane of the Miller Index (002) of the single-crystal thin film is not more than 240 seconds is easy to be formed, and improvement of crystallinity is shown, it is desirable.

And, since what is not more than 200 seconds as the above half width of the rocking curve of the X-ray diffraction is easy to be formed and more improvement of crystallinity is shown if the sintered compact in which the amount of ALON is not more than 7 % is used as a substrate, it is desirable.

In addition, as for the content of ALON, it is a thing obtained by carrying out the X-ray diffraction in the surface of a substrate as a percentage ratio of the diffraction line intensity from the lattice plane of the Miller Index (311) of ALON and the diffraction line intensity from the lattice plane of the Miller Index (100) of AlN.

In the inside of a sintered compact, what is the amount of ALON not more than 12 % is easy to be formed by what is the amount of oxygen not more than 5.0 % by weight in the sintered compact which is fired only with aluminum nitride raw material powder or only with the mixed powder of the raw material powder and Al₂O₃ without using additives, such as sintering aids.

What is the amount of ALON not more than 7 % is easy to be formed by what is the amount of oxygen not more than 3.0 % by weight in the sintered compact which is fired only with aluminum nitride raw material powder or only with the mixed powder of the raw material powder and Al₂O₃ without using additives, such as sintering aids.

Moreover, if the substrate in which the amount of ALON in a sintered compact is not more than 20 % is used, a thing with not more than 300 seconds as half width of the rocking curve of the X-ray diffraction line from the lattice plane of the Miller Index (002) of the single-crystal thin film which comprises as a main component at least one selected from gallium nitride, indium nitride, and aluminum nitride is easy to be formed on a substrate.

What is the amount of ALON not more than 20 % is easy to be formed by what is the amount of oxygen not more than 10.0 % by weight in the sintered compact which is fired only with aluminum nitride raw material powder or only with the mixed powder of this raw material powder and Al₂O₃ without using additives, such as sintering aids.

On the substrate in which ALON more than 20 % is generating in a sintered compact, it becomes hard to form a single-crystal thin film which comprises as a main component at least one selected from gallium nitride, indium nitride, and aluminum nitride and has good crystallinity not more than 300 seconds as half width of the rocking curve of the X-ray diffraction line from the lattice plane of the Miller Index (002).

If ALON crystal different from a wurtzite type is increased, it is conjectured that it will be because the power which the crystal growth of the single-crystal thin film has originally and which tries to go in the direction of C axis in is prevented and it becomes easy to become an irregular direction.

In addition, as for the content of ALON in the sintered compact which comprises aluminum nitride as a main component, although it was obtained as the percentage ratio of the diffraction line intensity from the lattice plane of the Miller Index (311) of ALON and the diffraction line intensity from the lattice plane of the Miller Index (100) of AlN, by the X-ray diffraction, as mentioned above, it can be regarded as a volume fraction approximately, if the oxygen content contained in the sintered compact and the density 3.837 g/cm³ of ALON indicated in the above JCPDS file number 36-50 are compared.

And, when compounds other than AlN and ALON are generating in the sintered compact which comprises aluminum nitride as a main component, the content of ALON is obtained as the percentage ratio between the strongest line of ALON and the thing which totaled the strongest line of the compounds and the strongest line of AlN and ALON, by X-ray diffraction.

In this invention, although the content of oxygen and the content of transition metals other than Mo, W, V, Nb, Ta, and Ti, such as iron, nickel, chromium, manganese, zirconium, hafnium, cobalt, copper, and zinc, etc., is shown with the weight percentage (% by weight) on each element basis, it can carry out easily re-showing these components with volume percentage by the above method.

When recalculating the content of iron, nickel, chromium, manganese, zirconium, hafnium, cobalt, copper, and zinc, etc. to volume percentage, it can be obtained by recalculating to volume percentage (volume %) with the density of these elements after the content of each component, such as iron, nickel, chromium, manganese, zirconium, hafnium, cobalt, copper, and zinc, etc., is obtained with weight percentage (% by weight) as element

When the content of oxygen is recalculated with volume percentage, after calculating the oxygen content with weight percent as element using the commercial apparatus for analysing oxygen, nitrogen, etc., it is reconverted to Al₂O₃, namely it can be obtained as volume percentage of Al₂O₃.

As for the reason of reconverting into Al₂O₃, the oxygen in the sintered compact which comprises aluminum nitride as a main component reacts with an aluminum component, or aluminum nitride, or sintering aids such as a rare earth element and an alkaline earth metal, etc., it exists in many cases as Al₂O₃, ALON, or a complex oxide with a rare earth element or an alkaline earth metal, since the ALON is the compound of AlN and Al₂O₃, and the complex oxide with a rare earth element or an alkaline earth metal is a compound between Al₂O₃ and the oxide of a rare earth element or the oxide of an alkaline earth metal, it is because the oxygen component contained can be regarded as Al₂O₃ in many cases eventually.

The density of Al₂O₃ is 3.987 g/cm³, and can be easily recalculated based on this.

For example, in the sintered compact which comprises aluminum nitride as a main component and contains oxygen 5 % by weight, since the density of AlN is 3.261 g/cm³, it is calculated that the content of oxygen is 8.86 volume %.

In the sintered compact which comprises aluminum nitride as a main component and contains iron 1 % by weight on an element basis, since the iron density is 7.86 g/cm³, it is calculated that the iron content is 0.417 volume % on an element basis.

In this invention, when recalculating the content of ALON to volume percentage, after obtaining the content of ALON by X-ray diffraction, when contained except ALON and AlN, it can carry out with the density 3.83 7 g/cm³ of ALON, and the density of AlN, and when contained except ALON and AlN, it can carry out by obtaining the content and density of the component.

It can be considered that the content of ALON contained in the sintered compact which comprises aluminum nitride as a main component by X-ray diffraction is a weight fraction approximately, as the result of creation of a working curve.

For example, in the sintered compact which comprises aluminum nitride as a main component and contains ALON 10 %, it is reckonable so that the content of ALON is 8.63 volume %.

In this invention, in the substrate which comprises a sintered compact which comprises aluminum nitride as a main component, what sintered the aluminum nitride particle in a sintered compact in the same condition as the size of the particle of raw material powder without making it grow with an average of about 0.5 µm, for example, can be used.

On the other hand, in the substrate of this invention which comprises a sintered compact which comprises aluminum nitride as a main component, if the size of aluminum nitride particle contained in the inside of a sintered compact increases, the crystallinity of the thin film which comprises as a main component at least one selected from gallium nitride, indium nitride, and aluminum nitride and is formed on the substrate will tend to improve.

When the quality of the thin film is estimated by the crystallinity of this single-crystal thin film after the thin film which comprises as a main component at least one selected from gallium nitride, indium nitride, and aluminum nitride is formed as a single crystal, a thing in which the half width of the rocking curve of the X-ray diffraction line from the lattice plane of the Miller Index (002) of the single-crystal thin film formed directly on the substrate which comprises the sintered compact is not more than 300 seconds is easy to be formed, if the size of the aluminum nitride particle contained in the inside of a sintered compact which comprises aluminum nitride as a main component is an average of not less than 1 µm.

In the sintered compact in which the size of aluminum nitride particle is an average of not less than 5 µm, what has good crystallinity, such that the half width of the rocking curve of the X-ray diffraction line from the lattice plane of the Miller Index (002) of the single-crystal thin film which comprises as a main component at least one selected from gallium nitride, indium nitride, and aluminum nitride and is formed on a substrate is not more than 240 seconds, is easy to be obtained.

In the sintered compact in which the size of aluminum nitride particle is an average of not less than 8 µm, what has better crystallinity, such that the half width of the rocking curve of the X-ray diffraction line from the lattice plane of a Miller Index (002) of the above single-crystal thin film is not more than 200 seconds, is easy to be obtained.

In the sintered compact in which the size of aluminum nitride particle is an average of not less than 15 µm, what has still better crystallinity, such that the half width of the rocking curve of the X-ray diffraction line from the lattice plane of a Miller Index (002) of the above single-crystal thin film is not more than 150 seconds, is easy to be obtained.

In the sintered compact in which the size of aluminum nitride particle is an average of not less than 25 µm, what has still better crystallinity, such that the half width of the rocking curve of the X-ray diffraction line from the lattice plane of a Miller Index (002) of the above single-crystal thin film is not more than 130 seconds, is easy to be obtained.

If the size of aluminum nitride particle inside a sintered compact becomes large, the property of the aluminum nitride crystal grain itself will become easy to be revealed because the area of the grain boundary of aluminum nitride crystal grain will decrease and the effect of a grain boundary will reduce, and it is surmised that it will be easy to make the nuclear growth direction of the single-crystal thin film which comprises as a main component at least one selected from gallium nitride, indium nitride, and aluminum nitride into the state with more regularity.

The above effect of enlarging aluminum nitride particles is usually seen also in the substrate which comprises a sintered compact which comprises aluminum nitride as a main component and has what kind of composition.

As the example of such sintered compact which comprises aluminum nitride as a main component, it is what contains the above oxygen, or components used as sintering aids, such as a rare-earth compound and an alkaline-earth-metal compound, or components used as a agent for lowering the firing temperature, such as an alkali metal and silicon, or metal components used as a blackening agent, such as Mo, W, V, Nb, Ta, Ti, etc., or carbon, or unescapable metal components other than Mo, W, V, Nb, Ta, and Ti, etc., or ALON, etc. as a crystal phase, furthermore.

As the example of such sintered compact which comprises aluminum nitride as a main component, a sintered compact which is manufactured without adding sintering aids to raw material powder, and does not contain substantially sintering aids, such as a rare-earth compound or an alkaline-earth-metal compound, is also contained.

In the substrate which comprises a sintered compact which comprises aluminum nitride as a main component and is illustrated above, the quality of the single-crystal thin film which comprises as a main component at least one selected from gallium nitride, indium nitride, and aluminum nitride and is formed on the substrate becomes easy to improve if the size of aluminum nitride particles grows.

Although it is described also later about the effect of growing the size of aluminum nitride particles in a sintered compact which comprises aluminum nitride as a main component, the quality of the single-crystal thin film which comprises as a main component at least one selected from gallium nitride, indium nitride, and aluminum nitride and is formed on the substrates becomes easy to improve if the sintered compact which comprises aluminum nitride as a main component and which grew the size of aluminum nitride particles and raised furthermore AlN purity is used as a substrate for thin-film formation.

Usually, the above effect of growing aluminum nitride particles is seen also in the substrate which comprises a sintered compact which comprises aluminum nitride as a main component and has what kind of composition, the degree of the effect tends to decrease as the content of AlN in a sintered compact decreases.

If the content of AlN in the substrate of this invention which comprises the sintered compact which comprises aluminum nitride as a main component is more than 50 volume %, it can form a single-crystal thin film which comprises as a main component at least one selected from gallium nitride, indium nitride, and aluminum nitride, using this substrate.

In the sintered compact which comprises aluminum nitride as a main component and in which the content of AlN is not less than 50 volume %, a thing in which the half width of the rocking curve of the X-ray diffraction line from the lattice plane of the Miller Index (002) of the single-crystal thin film which is formed on this sintered compact and comprises as a main component at least one selected from gallium nitride, indium nitride, and aluminum nitride is not more than 3600 seconds is easy to be obtained.

In order to make the above effect of growing aluminum nitride particles easy to generate, as for the content of AlN in the substrate which comprises a sintered compact which comprises aluminum nitride as a main component, it is desirable that it is not less than 80 volume %.

In the thing in which the content of AlN of the sintered compact which comprises aluminum nitride as a main component is not less than 80 volume %, a thing in which the half width of the rocking curve of the X-ray diffraction line from the lattice plane of the Miller Index (002) of the single-crystal thin film which is formed on this sintered compact and comprises as a main component at least one selected from gallium nitride, indium nitride, and aluminum nitride is not more than 300 seconds is easy to be obtained.

In addition, the size of the crystal grain contained inside a sintered compact which comprises aluminum nitride as a main component is an average magnitude, not only what is in the state where the crystal grain contained has gathered in the nearly equal size but also what has the irregular size of a crystal grain, or what contains the crystal grain in which the form is distorted and the crystal grain of the form wherein one side is small and one side is large, such as the needle-like or board-like form wherein one side is several µm and the other side grew up into about 10 µm or more greatly, for example, such as a poly type AlN particle, etc., can be used satisfactorily in this invention.

In order to grow the size of the aluminum nitride particles in a sintered compact which comprises aluminum nitride as a main component, it is usually effective to raise the firing temperature or to lengthen the firing time.

In order to control the size of aluminum nitride particle, although it is easy to be dependent also on the origin and the grain size of raw material powder of aluminum nitride, or the composition of the powder compact or sintered compact, according to this invention, if the firing is carried out for comparatively long time not less than 3 hours at the temperature not less than 1750°C, the sintered compact which comprises aluminum nitride as a main component and has aluminum nitride particle of an average of not less than 5 µm is easy to be obtained.

In order to obtain the sintered compact of the aluminum nitride particle with an average of not less than 8 µm, it is preferred to carry out the firing at the temperature not less than 1750°C for not less than 10 hours, and at the temperature not less than 1900°C for not less than 3 hours.

In order to obtain the sintered compact of the aluminum nitride particle with an average of not less than 15 µm, it is preferred to carry out the firing at the temperature not less than 1900°C for not less than 6 hours, and at the temperature not less than 2050°C for not less than 3 hours.

In order to obtain the sintered compact of the aluminum nitride particle with an average of not less than 25 µm, it is preferred to carry out the firing at the temperature not less than 2050°C for not less than 4 hours, and at the temperature not less than 2100 °C for not less than 3 hours.

In such firing, in order to obtain the sintered compact which comprises aluminum nitride as a main component and is the state wherein only the size of aluminum nitride particles is growing, controlling the vaporization and removal of components, such as oxygen, components used as sintering aids, such as a rare-earth compound or an alkaline-earth-metal compound, etc., components used as a agent for lowering the firing temperature, such as an alkali metal and silicon, etc., meta components used as a blackening agent, such as Mo, W, V, Nb, Ta, Ti, etc., or carbon, or an unescapable metal component other than Mo, W, V, Nb, Ta, and Ti, etc., and furthermore containing ALON, etc. as a crystal phase contained, it is preferred to use non-oxidizing atmosphere, such as nitrogen and argon, etc., which has comparatively little of reduction nature components, as described above.

On the other hand, in order to obtain the sintered compact which comprises aluminum nitride as a main component and which grew the size of aluminum nitride particles and improved the AlN purity, it is preferred to fire in non-oxidizing atmosphere containing reduction nature components, such as hydrogen, carbon monoxide, carbon, and hydrocarbon.

In the substrate of this invention comprising an aluminum nitride-based sintered compact, as for the form of aluminum nitride particles contained inside the sintered compact, the thing of polygon and the thing in which the overlap in each surface and ridgeline, or at a polygonal vertex is dense are desirable as a substrate than the round thing in which the edge of a particle was smoothed out, because the optical transmissivity of a sintered compact can be raised into not less than 1 %, and a good thing in which the half width of the rocking curve of the X-ray diffraction line from the lattice plane of the Miller Index (002) is not more than 300 seconds is easy to be obtained as the crystallinity of the single-crystal thin film which is formed on the substrate and comprises as a main component at least one selected from gallium nitride, indium nitride, and aluminum nitride.

That is, if the form of aluminum nitride particles is a round thing whose edge was smoothed out, the sintered compact particles cannot unite together without spaces in the inside of a sintered compact, and the grain boundary phases which comprise components other thaluminum nitride tend to intervene, and it is surmised that the optical permeability of a sintered compact lowers by these grain boundary phases, and that the nuclear growth direction of the single-crystal thin film which comprises as a main component at least one selected from gallium nitride, indium nitride, and aluminum nitride and which is beginning to grow will become irregular.

The roundish particles of a sintered compact are usually seen when the above sintering aids and agents for lowering the firing temperature are contained superfluously.

That is, since the superfluous liquid phase is generated by the superfluous sintering aids during the firing and sintered compact particles grow in the liquid phases, it is easy to be roundish.

In this invention, that a sintered compact particle becomes easy to be roundish means being easy to be generated when sintering aids, such as the above rare-earth compound and alkaline-earth-metal element compound, and agents for lowering the firing temperature, such as an alkali metal compound, and a silicon compound, etc., are contained more than the range shown above.

In the raw material powder for manufacturing the sintered compact which comprises aluminum nitride as a main component and is used as the above substrate for thin-film formation, oxygen is usually included about 0.01-5.0 % by weight in addition to AlN component.

In this invention, as for the content of a rare earth element contained in the sintered compact which comprises aluminum nitride as a main component, it is preferred to use what is not more than 50 volume % on an oxide basis, as mentioned above.

As for the content of a rare earth element contained in the sintered compact which comprises aluminum nitride as a main component, it is still more preferred that it is not more than 25 volume % on an oxide basis.

The desirable content of the above rare earth element is not more than 12.0 volume % on an oxide basis.

A more desirable content is not more than 7.0 volume % on an oxide basis.

Since the above rare earth elements trap the oxygen contained in a raw material, make it deposit as a grain boundary phase, and carry out the action which makes the aluminum nitride crystal grain in a sintered compact into high purity, promoting the densification of aluminum nitride powder compact, they improve the thermal conductivity of a substrate obtained as the result.

Therefore, in the sintered compact which comprises aluminum nitride as a main component and was obtained after firing, the existence form of a rare earth element is a complex oxide with aluminum, or the oxide of only a rare earth element, in many cases.

The existence as a complex oxide can identify by X ray diffraction easily.

This complex oxide has 3 kinds of crystal form, such as 3Ln₂O₃·5Al₂O₃ of a garnet type crystal structure, Ln₂O₃·Al₂O₃ of a perovskite type crystal structure, and 2Ln₂O₃·Al₂O₃ of a monoclinic system crystal structure, when a rare earth element is expressed with Ln. Among these complex oxides, one or two or more are included simultaneously.

The above complex oxides mainly exist as a grain boundary phase between aluminum nitride particles in the inside of a sintered compact.

The substrate of this invention contains a thing in which the complex oxide(s) was formed.

These complex oxides have a different crystal structure from the wurtzite type crystal of aluminum nitride particle.

In the substrate for thin-film formation and thin-film substrate of this invention, as for the single-crystal thin film which comprises as a main component at least one selected from gallium nitride, indium nitride, and aluminum nitride and is formed directly on the sintered compact which comprises aluminum nitride as a main component and in which the content of a rare earth element is not more than 50 volume % on an oxide basis, what is not more than 3600 seconds as the half width of the rocking curve of the X-ray diffraction line from the lattice plane of the Miller Index (002) of this single-crystal thin film is easy to be obtained.

Moreover, as for the single-crystal thin film which comprises as a main component at least one selected from gallium nitride, indium nitride, and aluminum nitride and is formed directly on the sintered compact which comprises aluminum nitride as a main component and in which the content of a rare earth element is not more than 50 volume % on an oxide basis, what is not more than 300 seconds as the half width of the rocking curve of the X-ray diffraction line from the lattice plane of the Miller Index (002) of this single-crystal thin film may be obtained, depending on the case.

In the substrate for thin-film formation and thin-film substrate of this invention, as for the single-crystal thin film which comprises as a main component at least one selected from gallium nitride, indium nitride, and aluminum nitride and is formed directly on the sintered compact which comprises aluminum nitride as a main component and in which the content of a rare earth element is not more than 25 volume % on an oxide basis, a thing excellent in crystallinity, such that the half width of the rocking curve of the X-ray diffraction line from the lattice plane of the Miller Index (002) of this single-crystal thin film is not more than 300 seconds, is easy to be obtained.

When the content of a rare earth element in the sintered compact which comprises aluminum nitride as a main component is more than 25 volume % on an oxide basis as mentioned above, a thing in which the half width of the rocking curve of the X-ray diffraction line from the lattice plane of the Miller Index (002) of the formed single-crystal thin film which comprises as a main component at least one selected from gallium nitride, indium nitride, and aluminum nitride is not more than 300 seconds becomes hard to be obtained depending on the case, and the reason, such that the controlling force which makes the nuclear growth direction of a single-crystal thin film regular exceeds limit and nuclear growth will become irregular as the result, because many complex oxides from which the crystal structure differs are probably generated, can be surmised.

In this invention, in the substrate containing a rare earth element, the form of aluminum nitride particles in the sintered compact tends to become not a round thing in which the edge was smoothed out but a dense thing which is a polygon and has not a space by an overlap in the surface of particles, the ridgeline, or the polygonal vertex.

And, if the sintered compact which comprises aluminum nitride as a main component and in which the content of a rare earth element is not more than 12.0 volume % on an oxide basis is used, a thing excellent in crystallinity, such that the half width of the rocking curve of the X-ray diffraction line from the lattice plane of the Miller Index (002) of the single-crystal thin film is not more than 240 seconds, is easy to be obtained as the single-crystal thin film which comprises as a main component at least one selected from gallium nitride, indium nitride, and aluminum nitride and is formed directly on the sintered compact which comprises aluminum nitride as a main component.

And, in the sintered compact which comprises aluminum nitride as a main component and in which the content of a rare earth element is not more than 7.0 volume % on an oxide basis, a thing still more excellent in crystallinity, such that the half width of the rocking curve of the X-ray diffraction line from the lattice plane of the Miller Index (002) of the single-crystal thin film is not more than 200 seconds, is easy to be obtained as the single-crystal thin film which comprises as a main component at least one selected from gallium nitride, indium nitride, and aluminum nitride and is formed on the sintered compact which comprises aluminum nitride as a main component.

As for this improvement of crystallinity in the single-crystal thin film which comprises as a main component at least one selected from gallium nitride, indium nitride, and aluminum nitride, it is probably surmised that it will be because it is a thing accompanying reduction of the amount of generation of the above 3Ln₂O₃·5Al₂O₃ of a garnet type crystal structure (for example, 3Y₂O₃·5Al₂O₃, 3Dy₂O₃·5Al₂O₃, 3Ho₂O₃· 5Al₂O₃, 3Er₂O₃·5Al₂O₃, 3Yb₂O₃·5Al₂O₃, etc.), Ln₂O₃·Al₂O₃ of a perovskite type crystal structure (for example, YAlO₃, LaAlO₃, PrAlO₃, NdAlO₃, SmAlO₃, EuAlO₃, GdAlO₃, DyAlO₃, HoAlO₃, ErAlO₃, YbAlO₃, etc.), and 2Ln₂O₃·Al₂O₃ of a monoclinic system crystal structure (for example, 2Y₂O₃·Al₂O₃, 2Sm₂O₃·Al₂O₃, 2Eu₂O₃·Al₂O₃, 2Gd₂O₃· Al₂O₃, 2Dy₂O₃·Al₂O₃, 2Ho₂O₃·Al₂O₃, 2Er₂O₃·Al₂O₃, 2Yb₂O₃·Al₂O₃, etc.), which exist mainly as a grain boundary phase.

In the substrate of this invention, it is preferred that the content of an alkaline earth metal contained in the above sintered compact which comprises aluminum nitride as a main component is also not more than 25 volume % on an oxide basis as above.

A desirable content is not more than 5.0 volume % on an oxide basis. A more desirable content is not more than 3.0 volume % on an oxide basis.

Since the alkaline-earth metals trap the oxygen contained in a raw material, make it deposit as a grain boundary phase, and carry out the action which makes the AlN crystal grain in an aluminum nitride-based sintered compact into high purity, promoting the densification of aluminum nitride powder compact, they improve the thermal conductivity of a substrate obtained, as the result.

Therefore, the existence form of an alkaline earth element in an aluminum nitride substrate obtained after firing is a complex oxide with aluminum, or an independent alkaline-earth-metal oxide in many cases.

The existence as a complex oxide with aluminum can identify by X ray diffraction easily.

The complex oxide is what is the crystal forms, such as 3AeO·Al₂O₃, AeO· Al₂O₃, AeO₂Al₂O₃, and AeO·6Al₂O₃, when an alkaline-earth metal is expressed with Ae. Among these complex oxides, one or two or more are included simultaneously.

The above complex oxides containing alkaline-earth metals element mainly exist as a grain boundary phase between aluminum nitride particles in the inside of a sintered compact. As for the substrate according to this invention, it contains the thing in which the complex oxide(s) was formed.

These complex oxides have a different crystal structure from the wurtzite type of aluminum nitride particle.

In the substrate of this invention, in the thing in which the content of an alkaline earth metal in a sintered compact is not more than 25 volume % on an oxide basis, a thing excellent in crystallinity, such that the half width of the rocking curve of the X-ray diffraction line from the lattice plane of the Miller Index (002) of the single-crystal thin film which comprises as a main component at least one selected from gallium nitride, indium nitride, and aluminum nitride is not more than 300 seconds, is easy to be obtained.

In the substrate of this invention, when there is more alkaline earth metal than 25 volume % on an oxide basis, as shown above, a thing in which the half width of the rocking curve of the X-ray diffraction line from the lattice plane of the Miller Index (002) of the formed single-crystal thin film which comprises as a main component at least one selected from gallium nitride, indium nitride, and aluminum nitride is not more than 300 seconds tends to become hard to be obtained, and the reason, such that the controlling force which makes the nuclear growth direction of a single-crystal thin film regular exceeds limit and nuclear growth will become irregular as the result, because many complex oxides from which the crystal structure differs are probably generated, can be surmised.

In the substrate which comprises a sintered compact which comprises aluminum nitride as a main component in this invention, in the thing in which the content of an alkaline earth metal is not more than 5.0 volume % on an oxide basis, many things are a polygon as the form of aluminum nitride particles in a sintered compact, and the overlap between particles will tend to become dense in each other surface, ridgeline, or the vertex of a polygon particle.

Using the substrate containing an alkaline earth metal in that composition range, a thing more excellent in crystallinity, such that the half width of the rocking curve of the X-ray diffraction line from the lattice plane of a Miller Index (002) of the single-crystal thin film which comprises as a main component at least one selected from gallium nitride, indium nitride, and aluminum nitride is not more than 240 seconds, is easy to be obtained.

And, in the substrate containing an alkaline earth metal not more than 3.0 volume % on an oxide basis, a thing still more excellent in crystallinity, such that the half width of the rocking curve of the X-ray diffraction line from the lattice plane of a Miller Index (002) of the single-crystal thin film which comprises as a main component at least one selected from gallium nitride, indium nitride, and aluminum nitride is not more than 200 seconds, is easy to be obtained.

As for this improvement of the crystallinity of the single-crystal thin film which comprises as a main component at least one selected from gallium nitride, indium nitride, and aluminum nitride, it is surmised that it will be because it is a thing accompanying reduction of the amount of generation of the above 3AeO·Al₂O₃, AeO·Al₂O₃, AeO₂Al₂O₃, and AeO·6Al₂O₃, etc., which probably exist mainly as a grain boundary phase and have a different crystal structure from the wurtzite type.

In this invention, as for the content of at least one selected from Mo, W, V, Nb, Ta, Ti, and carbon which are contained in the sintered compact which comprises aluminum nitride as a main component, it is preferred that it is not more than 25 volume % on an element basis as mentioned above.

A single-crystal thin film which comprises as a main component at least one selected from gallium nitride, indium nitride, and aluminum nitride is easy to be formed directly on the substrate which comprises a sintered compact which comprises aluminum nitride as a main component and has such composition, and a good thing, such that the half width of the rocking curve of the X-ray diffraction line from the lattice plane of a Miller Index (002) is not more than 300 seconds as the crystallinity of this single-crystal thin film, is easy to be obtained.

Moreover, in the substrate of a sintered compact which comprises aluminum nitride as a main component and in which the content of at least one selected from Mo, W, V, Nb, Ta, Ti, and carbon is not more than 10 volume % on an element basis, a better thing, such that the half width of the rocking curve of the X-ray diffraction line from the lattice plane of the Miller Index (002) is not more than 240 seconds as the crystallinity of the formed single-crystal thin film which comprises as a main component at least one selected from gallium nitride, indium nitride, and aluminum nitride, is easy to be obtained.

And, in the substrate of a sintered compact which comprises aluminum nitride as a main component and in which the content of at least one selected from Mo, W, V, Nb, Ta, Ti, and carbon is not more than 5 volume % on an element basis, a still better thing, such that the half width of the rocking curve of the X-ray diffraction line from the lattice plane of the Miller Index (002) is not more than 200 seconds as the above crystallinity of the formed single-crystal thin film, is easy to be obtained.

In this invention, as for the oxygen contained in the sintered compact which comprises aluminum nitride as a main component, it seems that it exists in the state, such as ALON which reacted with AlN of the main component, or a grain boundary phase which reacted with the rare-earth compound and alkaline-earth-metal compound which are the sintering aids, or a thing which dissolved to the crystal lattice of the AlN grain in a sintered compact.

In this invention, it is preferred that the total amount of oxygen contained in the sintered compact which comprises aluminum nitride as a main component is not more than 10 % by weight.

In the substrate which comprises a sintered compact which comprises aluminum nitride as a main component and in which the total amount of oxygen is not more than 10 % by weight, a thing excellent in crystallinity, such that the half width of the rocking curve of the X-ray diffraction line from the lattice plane of the Miller Index (002) of the single-crystal thin film which comprises as a main component at least one selected from gallium nitride, indium nitride, and aluminum nitride and is formed directly on it is not more than 300 seconds, is easy to be obtained.

In the sintered compact in which the total amount of oxygen is not more than 5.0 % by weight, a single-crystal thin film more excellent in crystallinity, such that the half width of the rocking curve of the X-ray diffraction line from the lattice plane of the Miller Index (002) of the single-crystal thin film which comprises as a main component at least one selected from gallium nitride, indium nitride, and aluminum nitride is not more than 240 seconds, is easy to be formed.

And, in the sintered compact in which the total amount of oxygen is not more than 3.0 % by weight, a single-crystal thin film still more excellent in crystallinity, such that the half width of the rocking curve of the X-ray diffraction line from the lattice plane of the Miller Index (002) of the single-crystal thin film which comprises as a main component at least one selected from gallium nitride, indium nitride, and aluminum nitride is not more than 200 seconds, is easy to be formed.

As for the sintered compact which comprises aluminum nitride as a main component and has high AlN purity and which lowered the content of ALON as a crystal phase, the above metal components other than aluminum, and the compound containing silicon or carbon by vaporizing, removing, and decreasing the contained oxygen, components which are used as sintering aids, such as a rare-earth compound and an alkaline-earth-metal compound, components which are used as a agent for lowering the firing temperature, such as an alkali metal and silicon, metal components which are used as a blackening agent, such as Mo, W, V, Nb, Ta, Ti or carbon, or unescapable metals components other than Mo, W, V, Nb, Ta, Ti, etc., by carrying out the firing at the temperature not less than 1750°C for not less than 3 hours in reduced atmosphere, this inventor furthermore investigated about the characteristic of a substrate when it is used for forming directly a thin film which comprises as a main component at least one selected from gallium nitride, indium nitride, and aluminum nitride.

And, the above characteristic as the sintered compact which comprises aluminum nitride as a main component, and characteristic of the thin-film substrate in which a thin film which comprises as a main component at least one selected from gallium nitride, indium nitride, and aluminum nitride was formed directly were investigated.

In the above sintered compact which comprises aluminum nitride as a main component, the AlN purity tends to become so high if the firing time is lengthened and the firing temperature becomes high.

As for the firing temperature, it is more preferred that it is not less than 1900°C, it is still more preferred that it is not less than 2050°C, and it is most preferred that it is not less than 2100°C.

When raising the AlN purity of the sintered compact which comprises aluminum nitride as a main component, it has the relation in which the firing time can be shortened if the firing temperature is raised and the firing time will become long if the firing temperature becomes low, and the effect is almost the same in either.

In order to raise the purity of AlN, in the range of the firing temperature of 1750-1900°C, it is usually preferred that the firing time is not less than 10 hours.

That the firing time is not less than 6 hours if the firing temperature is not less than 1900°C, the firing time is not less than 4 hours if the firing temperature is not less than 2050°C, and the firing time is not less than 3 hours if the firing temperature is not less than 2100°C, is preferred.

By such a method, as the aluminum nitride-based sintered compact of this invention which raised the AlN purity, what has the composition of that whose content of at least one selected from a rare earth element and an alkaline-earth metal is a total of not more than 0.5 % by weight (5000 ppm) on an element basis and whose oxygen content is not more than 0.9 % by weight can be obtained.

Using the sintered compact which comprises aluminum nitride as a main component and raised the AlN purity of such composition, as a substrate, as for the single-crystal thin film which comprises as amain component at least one selected from gallium nitride, indium nitride, and aluminum nitride and is formed directly on the substrate, what has excellent crystallinity is obtained.

In this invention, as for the sintered compact which comprises aluminum nitride as a main component and raised the AlN purity, what has the composition of that whose content of at least one selected from a rare earth element and an alkaline-earth metal is a total of not more than 0.2 % by weight (2000 ppm) on an element basis and whose oxygen content is not more than 0.5 % by weight can be obtained, it is desirable.

And, in this invention, as for the sintered compact which comprises aluminum nitride as a main component and raised the AlN purity, what has the composition of that whose content of at least one selected from a rare earth element and an alkaline-earth metal is a total of not more than 0.05 % by weight (500 ppm) on an element basis and whose oxygen content is not more than 0.2 % by weight can be obtained, it is more desirable.

And, as for the sintered compact which comprises aluminum nitride as a main component and raised the AlN purity, what has the composition of that whose content of at least one selected from a rare earth element and an alkaline-earth metal is a total of not more than 0.02 % by weight (200 ppm) on an element basis and whose oxygen content is not more than 0.1 % by weight can be obtained, it is still more desirable.

And, as for the sintered compact which comprises aluminum nitride as a main component and raised the AlN purity, what has the composition of that whose content of at least one selected from a rare earth element and an alkaline-earth metal is a total of not more than 0.005 % by weight (50 ppm) on an element basis and whose oxygen content is not more than 0.05 % by weight can be obtained, it is the most desirable.

Using the sintered compact which comprises aluminum nitride as a main component and raised the AlN purity, as a substrate, this inventor investigated the quality of the produced thin film by growing directly a thin film which comprises as a main component at least one selected from gallium nitride, indium nitride, and aluminum nitride onto the substrate.

In addition, the formed thin film is a single crystal, and the quality of the thin film was estimated by the crystallinity of the single-crystal thin film.

In the sintered compact which comprises aluminum nitride as a main component and raised the AlN purity, when what has the composition of that whose content of at least one selected from a rare earth element and an alkaline-earth metal is a total of not more than 0.5 % by weight on an element basis and whose oxygen content is not more than 0.9 % by weight is used as a substrate, what has good crystallinity, such that the half width of the rocking curve of the X-ray diffraction line from the lattice plane of the Miller Index (002) is not more than 240 seconds as the single-crystal thin film which comprises as a main component at least one selected from gallium nitride, indium nitride, and aluminum nitride and is formed there directly, is easy to be obtained, as the result.

And, in the sintered compact which comprises aluminum nitride as a main component and raised the AlN purity, when what has the composition of that whose content of at least one selected from a rare earth element and an alkaline-earth metal is a total of not more than 0.2 % by weight on an element basis and whose oxygen content is not more than 0.5 % by weight is used as a substrate, what has better crystallinity, such that the half width of the rocking curve of the X-ray diffraction line from the lattice plane of the Miller Index (002) is not more than 200 seconds as the above single-crystal thin film which is formed there directly, is easy to be obtained, it is preferred.

And, in the sintered compact which comprises aluminum nitride as a main component and raised the AlN purity, when what has the composition of that whose content of at least one selected from a rare earth element and an alkaline-earth metal is a total of not more than 0.05 % by weight on an element basis and whose oxygen content is not more than 0.2 % by weight is used as a substrate, what has better crystallinity, such that the half width of the rocking curve of the X-ray diffraction line from the lattice plane of the Miller Index (002) is not more than 150 seconds as the above single-crystal thin film which is formed there directly, is easy to be obtained, it is more preferred.

And, in the sintered compact which comprises aluminum nitride as a main component and raised the AlN purity, when what has the composition of that whose content of at least one selected from a rare earth element and an alkaline-earth metal is a total of not more than 0.02 % by weight on an element basis and whose oxygen content is not more than 0.1 % by weight is used as a substrate, what has better crystallinity, such that the half width of the rocking curve of the X-ray diffraction line from the lattice plane of the Miller Index (002) is not more than 130 seconds as the above single-crystal thin film which is formed there directly, is easy to be obtained, it is still more preferred.

In the sintered compact which comprises aluminum nitride as a main component and raised the AlN purity, when what has the composition of that whose content of at least one selected from a rare earth element and an alkaline-earth metal is a total of not more than 0.005 % by weight on an element basis and whose oxygen content is not more than 0.05 % by weight is used as a substrate, what has better crystallinity, such that the half width of the rocking curve of the X-ray diffraction line from the lattice plane of the Miller Index (002) is not more than 100 seconds as the above single-crystal thin film which is formed there directly, is easy to be obtained, it is most preferred.

A crystal phase contained in the sintered compact which comprises aluminum nitride as a main component and has the above composition which raised the AlN purity comprises AlN not less than 95-98 %, crystal phases, such as ALON, a rare earth element compound, or an alkaline-earth-metal compound, are not more than 2-5 %, and what is substantially an AlN single phase is also obtained.

And, what has optical permeability is easy to be obtained, for example, what has the optical transmissivity not less than 1 % is easy to be obtained, and what has not less than 5 %, what has not less than 10 %, what has not less than 20 %, what has not less than 30 %, what has not less than 40 %, what has not less than 60 %, and what has not less than 80 % are also obtained, and what has the optical transmissivity of a maximum of not less than 85 % is also obtained.

In addition, the crystal phase in the sintered compact which comprises aluminum nitride as a main component can be identified easily by carrying out the relative comparison of the strongest line of a diffraction peak where each crystal phase obtained by X ray diffraction indicates.

And, other than oxygen, a rare earth element, or an alkaline-earth metal, as for components used as a agent for lowering the firing temperature, such as an alkaline metal and silicon, etc., components, such as Mo, W, V (vanadium), Nb, Ta, Ti, and carbon, etc. which are used as a blackening agent, transition-metals impurities, such as Fe, Ni, Co, Mn, Cr, Zr, Hf, Cu, and Zn, etc. which are mixed from the aluminum nitride powder raw materials or the sintered compact manufacturing process other than Mo, W, V, Nb, Ta, and Ti, they can be vaporized, removed, and decreased by the above method, and an aluminum nitride-based sintered compact which has high AlN purity can be manufactured.

In the sintered compact which comprises aluminum nitride as a main component and raised the AlN purity, when what has the composition of that whose content of an alkali metal and silicon is a total of not more than 0.2 % by weight on an element basis and whose oxygen content is not more than 0.9 % by weight is used as a substrate, what has good crystallinity, such that the half width of the rocking curve of the X-ray diffraction line from the lattice plane of the Miller Index (002) is not more than 240 seconds as the single-crystal thin film which comprises as amain component at least one selected from gallium nitride, indium nitride, and aluminum nitride and is formed there directly, is easy to be obtained.

In the sintered compact which comprises aluminum nitride as a main component and raised the AlN purity, when what has the composition of that whose content of Mo, W, V (vanadium), Nb, Ta, Ti, and carbon is a total of not more than 0.2 % by weight on an element basis and whose oxygen content is not more than 0.9 % by weight is used as a substrate, what has good crystallinity, such that the half width of the rocking curve of the X-ray diffraction line from the lattice plane of the Miller Index (002) is not more than 240 seconds as the single-crystal thin film which comprises as a main component at least one selected from gallium nitride, indium nitride, and aluminum nitride and is formed there directly, is easy to be obtained.

And, in the sintered compact which comprises aluminum nitride as a main component and raised the AlN purity, when what has the composition of that whose content of Fe, Ni, Co, Mn, Cr, Zr, Hf, Cu, and Zn is a total of not more than 0.2 % by weight on an element basis and whose oxygen content is not more than 0.9 % by weight is used as a substrate, what has good crystallinity, such that the half width of the rocking curve of the X-ray diffraction line from the lattice plane of the Miller Index (002) is not more than 240 seconds as the single-crystal thin film which comprises as a main component at least one selected from gallium nitride, indium nitride, and aluminum nitride and is formed there directly, is easy to be obtained.

In addition, as for the rare-earth compounds contained in the above sintered compact which comprises aluminum nitride as a main component, they are a rare earth element, such as Sc, Y, La, Ce, Pr, Nd, Pm, Sm, Eu, Gd, Tb, Dy, Ho, Er, Tm, Yb, and Lu, etc., a rare earth oxide, such as Sc₂O₃, Y₂O₃, La₂O₃, CeO₂ and Pr₆O₁₁, Nd₂O₃, Pm₂O₃, Sm₂O₃, Eu₂O₃, Gd₂O₃, Tb₄O₇, Dy₂O₃, Ho₂O₃, Er₂O₃, Tm₂O₃, Yb₂O₃, and Lu₂O₃, etc., or in addition, it is various rare-earth compound, such as an inorganic rare earth compound, such as carbonate, nitrate, sulfate, and a chloride, and an organic rare earth compound, such as acetate, an oxalate, and citrate, containing Sc, Y, La, Ce, Pr, Nd, Pm, Sm, Eu, Gd, Tb, Dy, Ho, Er, Tm, Yb, Lu, etc., furthermore it is the complex oxides containing various rare earth element, such as 3Ln₂O₃·5Al₂O₃ of a garnet type crystal structure (for example, 3Y₂O₃·5Al₂O₃, 3Dy₂O₃·5Al₂O₃, 3Ho₂O₃·5Al₂O₃, 3Er₂O₃·5Al₂O₃, 3Yb₂O₃·5Al₂O₃, etc.), Ln₂O₃·Al₂O₃ of a perovskite type crystal structure (for example, YAlO₃, LaAlO₃, PrAlO₃, NdAlO₃, SmAlO₃, EuAlO₃, GdAlO₃, DyAlO₃, HoAlO₃, ErAlO₃, YbAlO₃, etc.), and monoclinic system crystal structure 2Ln₂O₃·Al₂O₃ (for example, 2Y₂O₃·Al₂O₃, 2Sm₂O₃· Al₂O₃, 2Eu₂O₃·Al₂O₃, 2Gd₂O₃·Al₂O₃, 2Dy₂O₃·Al₂O₃, 2Ho₂O₃·Al₂O₃, 2Er₂O₃·Al₂O₃, 2Yb₂O₃·Al₂O₃), etc., when a rare earth element is expressed with Ln.

And, as for the alkaline earth metal compounds contained in the above aluminum nitride-based sintered compact, they are an alkaline earth metal, such as Be, Mg, Ca, Sr, and Ba, etc., an alkaline-earth-metal oxide, such as BeO, MgO, CaO, SrO, and BaO, etc., or in addition, various alkaline-earth-metal compound, such as an inorganic alkaline earth metal compound, such as carbonate, nitrate, sulfate, and chloride, and an organic alkaline earth metal compound, such as acetate, oxalate, and citrate, containing Be, Mg, Ca, Sr, and Ba, etc., and furthermore the complex oxides which include an alkaline earth metal, such as 3AeO·Al₂O₃, AeO·Al₂O₃, AeO₂Al₂O₃, and AeO·6Al₂O₃, etc., when an alkaline-earth-metal element is expressed with Ae.

As for the feature of the sintered compact which comprises aluminum nitride as a main component and is obtained by the method of heating at the temperature not less than 1750°C for comparatively long time not less than 3 hours in the above reduced atmosphere, what has high thermal conductivity not less than 200 W/mK at room temperature is easy to be obtained.

And, in the sintered compact which comprises aluminum nitride as a main component, in the case of what has a few impurities content and what comprises an AlN single phase, what is the thermal conductivity not less than 220 W/mK at room temperature is easy to be obtained furthermore.

In addition to such a feature, in the above sintered compact which comprises aluminum nitride as a main component and raised the AlN purity, what has high optical permeability is easy to be obtained.

In addition to a rare earth element or an alkaline-earth metal, as for components which are used as a agent for lowering the firing temperature, such as an alkaline metal and silicon, components, such as Mo, W, V (vanadium), Nb, Ta, Ti, and carbon, etc. which are used as a blackening agent, or transition metal impurities other than Mo, W, V, Nb, Ta, and Ti, such as Fe, Ni, Co, and Mn, etc., which are mixed from the aluminum nitride powder raw materials and the sintered compact manufacturing process, it is surmised that it will be because they are vaporized, removed, and decreased.

And, what has thermal conductivity not less than 200 W/mK at room temperature, what has high thermal conductivity not less than 220 W/mK furthermore, or the sintered compact which comprises aluminum nitride as a main component and is excellent in optical permeability are obtained, even if it is the sintered compact in which impurities and sintering aids, such as the above transition metal, remain.

This inventor is probably surmising that this will be to become easier to generate the original character which AlN has as a single crystal since the aluminum nitride particle in a sintered compact grows greatly by heating for a long time and the effect of a grain boundary decreases.

According to this invention, the size of aluminum nitride particle in the sintered compact which comprises aluminum nitride as a main component usually grows during the above firing process which carries out purity-ization.

It seems that to grow the size of aluminum nitride particles in the above sintered compact which comprises aluminum nitride as a main component and which carried out high purification and raised the AlN purity is a big factor which increases the crystallinity of a single-crystal thin film which comprises as a main component at least one selected from gallium nitride, indium nitride, and aluminum nitride and which is formed directly on the substrate comprising a sintered compact comprising aluminum nitride as a main component, and which gives higher optical transmissivity furthermore.

By raising the firing temperature or lengthening the firing time, components other than AlN, such as sintering aids in the sintered compact which comprises aluminum nitride as a main component, are vaporized, removed, and decreased, components other than AlN decrease in the inside of aluminum nitride particles or in the grain boundaries of aluminum nitride particles in a sintered compact, or it becomes near zero substantially, and in addition, the size of the aluminum nitride crystal grain in a sintered compact grows.

In the sintered compact which comprises aluminum nitride as a main component, components other than AlN will decrease or become near zero substantially in the inside of aluminum nitride particles or in the grain boundaries of aluminum nitride particles, in addition to this, since aluminum nitride particle boundaries (grain boundaries) will decrease in number if the size of aluminum nitride particles in a sintered compact grows, the effect of the grain boundary will decrease, high purification of the aluminum nitride particles itself which grew greatly will be carried out, and the crystallinity will also increase furthermore, and it is surmised that it will become easy to generate the property near the aluminum nitride of a single crystal with high purity.

That is, since it is the sintered compact which comprises big crystal grains in the condition near a single crystal with high purity, the optical permeability also becomes what has high optical transmissivity equal to a single crystal, in the long wavelength side from near wavelength 200 nm of the absorption end of aluminum nitride single crystal.

If this sintered compact is used for a substrate, a single-crystal thin film which comprises as a main component at least one selected from gallium nitride, indium nitride, and aluminum nitride will become easy to be formed in the state of high crystallinity comparable to the case where a single crystal is used as a substrate.

In this invention, a sintered compact which comprises aluminum nitride as a main component and raised the AlN purity is manufactured by raising the firing temperature or lengthening the firing time, and the size of aluminum nitride particles of the sintered compact is usually an average of not less than 5 µm.

Usually, if the firing temperature is raised or the firing time is lengthened, the size of aluminum nitride particles in a sintered compact will also grow to an average of not less than 25 µm.

On the experiment, what has the size of aluminum nitride particles of an average of about 100 µm is obtained.

Thus, it seems that the aluminum nitride particles which have grown will have the state near a single crystal since AlN purity also increases.

When the sintered compact which comprises aluminum nitride as a main component and which was made into high purity by the above method and raised the AlN purity is used as a substrate, a good thing, such that the half width of the rocking curve of the X-ray diffraction line from the lattice plane of the Miller Index (002) of the single-crystal thin film which comprises as amain component at least one selected from gallium nitride, indium nitride, and aluminum nitride and is formed directly on the substrate is not more than 200 seconds, is obtained, if the size of aluminum nitride particles in a sintered compact is an average of not less than 5 µm.

When the substrate in which the size of aluminum nitride particles is an average of not less than 8 µm is used, a good thing, such that the half width of the rocking curve of the X-ray diffraction line from the lattice plane of the Miller Index (002) of the single-crystal thin film which is formed directly on this substrate and comprises as a main component at least one selected from gallium nitride, indium nitride, and aluminum nitride is not more than 150 seconds, is obtained.

And, when the substrate in which the size of aluminum nitride particles is an average of not less than 15 µm is used, a good thing, such that the half width of the rocking curve of the X-ray diffraction line from the lattice plane of the Miller Index (002) of the single-crystal thin film which is formed directly on this substrate and comprises as a main component at least one selected from gallium nitride, indium nitride, and aluminum nitride is not more than 130 seconds, is obtained.

And, when the substrate in which the size of aluminum nitride particles is an average of not less than 25 µm is used, a good thing, such that the half width of the rocking curve of the X-ray diffraction line from the lattice plane of the Miller Index (002) of the single-crystal thin film which is formed directly on this substrate and comprises as a main component at least one selected from gallium nitride, indium nitride, and aluminum nitride is not more than 100 seconds, is obtained.

Thus, the size of aluminum nitride particles in the sintered compact which comprises aluminum nitride as a main component and which was made into high purity and is manufactured by vaporizing, removing and decreasing components other than AlN, such as sintering aids, is important.

A sintered compact which comprises aluminum nitride as a main component and in which the size of aluminum nitride particles in a sintered compact is an average of not less than 5 µm can be provided, and the thing in which the size of aluminum nitride particles in the sintered compact is an average of about 100 µm can be manufactured comparatively easily.

For example, in the sintered compact which comprises aluminum nitride as a main component and is obtained by firing the powder compact which comprises as the raw material a high purity aluminum nitride powder having 1 µm mean particle diameter and containing oxygen 1 % by weight and which mixed Y₂O₃ of 3.3 volume % (including 3.9 % by weight as Y, and 1.1 % by weight as oxygen) as sintering aids and is made into a board-like square with the size of 60 x 60 mm contour and 0.8 mm thickness at 1800°C for 1 hour, the thermal conductivity is in the range of 150-180 W/mK at room temperature, a yttrium component in Y₂O₃ used as sintering aids remains in the sintered compact almost as it is, and it is admitted that about 5-20 % of the grain boundary phase which comprises as the main substance a rare earth compound, such as 3Y₂O₃·5Al₂O₃, YAlO₃, 2Y₂O₃· Al₂O₃, and Y₂O₃, etc., exists by X-ray diffraction.

The quantity of the oxygen of a raw material and the oxygen in Y₂O₃ used as sintering aids also remain in a sintered compact almost as it is, and the optical transmissivity of the sintered compact is about not more than 10 %.

In the above sintered compact, the size of aluminum nitride particles is an average of about 2-4 µm.

If this sintered compact is fired furthermore at 2050-2200°C for 3-24 hours in nitrogen atmosphere which contains carbon monoxide in the range of 1-1000 ppm, for example, the oxygen contained in the used raw material and sintering aids decreased to not more than 0.5 % by weight, and what has 0.014 % by weight was obtained in the case of the fewest one.

Y₂O₃ was almost vaporized and removed, the content became not more than 0.2 % by weight, and the sintered compact which comprises aluminum nitride as a main component and has not more than 0.00005 % by weight (0.5 ppm) was obtained in the case of the fewest one.

In the light of the range of 200-800 nm wavelength, the optical transmissivity is at least not less than 10 %, many are not less than 20-60 %, and what has a maximum of 88 % was obtained.

As for the phase constitution of a sintered compact, AlN is not less than 98 %, and what has substantially an AlN single phase was also obtained easily.

The thermal conductivity became more than 200 W/mK-220 W/mK at room temperature, and what has a maximum of 239 W/mK was obtained.

The size of aluminum nitride particles in the sintered compact was an average of not less than 5-8 µm in minimum, many have grown greatly into an average of not less than 15-25 µm, and what has a maximum of an average of 74 µm was obtained.

When the sintered compact which comprises aluminum nitride as a main component and which raised the AlN purity and was illustrated above is used as a substrate, a single-crystal thin film which comprises as a main component at least one selected from gallium nitride, indium nitride, and aluminum nitride and was formed directly on this substrate and which indicates the good crystallinity, such that the half width of the rocking curve of the X-ray diffraction line from the lattice plane of a Miller Index (002) is not more than 150 seconds, is obtained. And, as what is the best crystallinity, what is not more than 100 seconds is obtained.

The sintered compact which comprises aluminum nitride as a main component and is produced by the method of reducing the sintering aids by vaporizing and removing on the firing conditions illustrated above and which raised the AlN purity by making it into high purity, was ground and polished to specular surface into the thickness of 0.5 mm, and the optical transmissivity was measured, it was as high as 88 % in the wavelength of 605 nm.

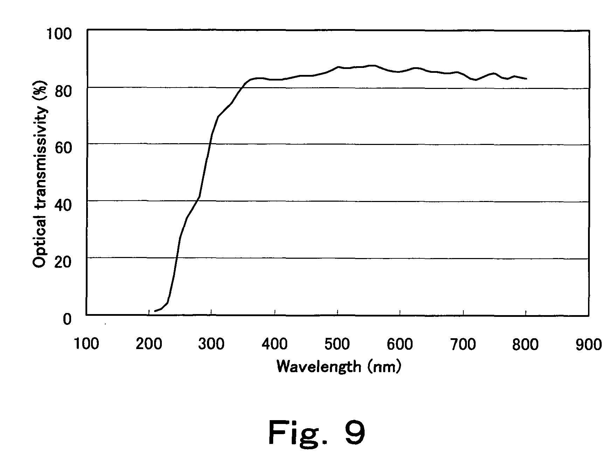

The result is shown in Fig. 9.

In the sintered compact which comprises aluminum nitride as a main component and was used for the optical transmissivity measurement, Y (yttrium) content is not more than 0.0005 % by weight, oxygen content is 0.034 % by weight, the constitution phase is substantially an AlN single phase, and the size of aluminum nitride particles is an average of 29 µm.

As for the optical transmissivity of the sintered compact which comprises aluminum nitride as a main component, as it is clear from Fig. 9, it is not less than 1 % as optical transmissivity in the light of a wavelength 210-220 nm, the optical transmissivity is not less than 5 % in the light of a wavelength 220-230 nm, the optical transmissivity is not less than 30 % in the light of a wavelength 250 nm, the optical transmissivity is not less than 60 % in the light of a wavelength 300 nm, the optical transmissivity not less than 80 % comes to be shown in the light of a wavelength 330 nm, and the optical transmissivity not less than 80 % is shown in the light of all wavelength not less than 330 nm.

The maximum of the optical transmissivity is 85-88 % in the light of the range of 480-650 nm wavelength, it is as high as not less than 85 %.

When this sintered compact which comprises aluminum nitride as a main component is used as a substrate, a good thing, such that the half width of the rocking curve of the X-ray diffraction line from the lattice plane of a Miller Index (002) is not more than 100 seconds as for the crystallinity of the single-crystal thin film which comprises as a main component at least one selected from gallium nitride, indium nitride, and aluminum nitride and was formed directly on the substrate, was obtained.

The main validity is summarized as follows when the above sintered compact which comprises aluminum nitride as a main component and raised the AlN purity is used as a substrate,
1) the luminous efficiency from the inside of a light-emitting device manufactured using this single-crystal thin film will become high, because what is the high crystallinity is easy to be obtained in the single-crystal thin film which comprises as a main component at least one selected from gallium nitride, indium nitride, and aluminum nitride and is formed on a substrate,
2) big electric power can be applied into the light-emitting device formed in such a substrate and the luminescence output can be heightened, because what is the thermal conductivity of a substrate as high as not less than 200 W/mK at room temperature is easy to be obtained,
3) the optical absorption by a substrate is few and the main portion of the light which came out from the light-emitting device is emitted to the outside of a device, because the optical transmissivity of a substrate is high in the light of the range of 200-800 nm wavelength, etc.

That is, since the manufacture of a light-emitting device which is high efficiency, high output, and low cost becomes possible, the influence which gives to industry is large.

In this invention, the sintered compact which comprises aluminum nitride as a main component and has optical permeability usually shows a permeability in the light of a wavelength not less than 200 nm.

As illustrated in Fig. 9, it was confirmed that there is a tendency in which the optical permeability starts to be shown in the light of the range of 200-250 nm wavelength, goes up rapidly in the light of the range of 250-350 nm wavelength, and will be mostly fixed in the light of wavelength not less than 350-400 nm.

In this invention, unless reference is made especially, the optical transmissivity of a sintered compact which comprises aluminum nitride as a main component means the optical transmissivity measured by the light with a wavelength of 605 nm, the performances (that is, the crystallinity when forming directly a single-crystal thin film which comprises as a main component at least one selected from gallium nitride, indium nitride, and aluminum nitride) of an aluminum nitride-based sintered compact of this invention can be distinguished representatively, even if it uses the optical transmissivity in the light with a wavelength of 605 nm.

If speaking more concretely, unless reference is made especially in this invention, the optical transmissivity not less than 1 % is the transmissivity in the light with a wavelength of 605 nm.

Although such a sintered compact which comprises aluminum nitride as a main component and has the optical transmissivity not less than 1 % does not necessarily have optical transmissivity not less than 1 % to the light of the range of 200-800 nm wavelength except the wavelength of 605 nm, it can form a single-crystal thin film which comprises as a main component at least one selected from gallium nitride, indium nitride, and aluminum nitride and has the excellent crystallinity using the sintered compact which comprises aluminum nitride as a main component, as a substrate.

In this invention, as for the sintered compact which comprises aluminum nitride as a main component and is used as a substrate for forming a single-crystal thin film which comprises as a main component at least one selected from gallium nitride, indium nitride, and aluminum nitride, what has the optical transmissivity not less than 1 % to the light of the range of 200-800 nm wavelength is desirable, but what has the optical transmissivity at least not less than 1 % to the light with a wavelength of 605 nm is desirable, even if it does not have the optical transmissivity not less than 1 % to all wavelength.

And, in this invention, a thin film which comprises as a main component at least one selected from gallium nitride, indium nitride, and aluminum nitride and which is various crystallization states, such as an amorphous state, a polycrystal, and an orientated polycrystal other than the single crystal, can also be formed using the sintered compact which comprises aluminum nitride as a main component and has transmissivity not less than 1 % as a substrate.

In this invention, although the sintered compact which comprises aluminum nitride as a main component and has high AlN purity and in which the aluminum nitride particles grew up is preferred as a substrate for forming a single-crystal thin film, even if the purity of AlN is not necessarily high, namely, even if it is the sintered compact which comprises aluminum nitride as a main component and which leaves comparatively many icomponents, such as sintering aids, such as a rare-earth compound and an alkaline-earth-metal compound, or oxygen, or components used as a agent for lowering the firing temperature, such as an alkali metal and silicon, or the metal components, such as Mo, W, V, Nb, Ta, and Ti, and carbon which are used as a blackening agent, or unescapable metal components other than Mo, W, V, Nb, Ta, and Ti, or the above metal components other than aluminum and silicon, or the compound containing carbon, etc., it can become the substrate on which a single-crystal thin film which comprises as a main component at least one selected from gallium nitride, indium nitride, and aluminum nitride and has high crystallinity can be formed if aluminum nitride particle has grown up.

As mentioned above, such a sintered compact which comprises aluminum nitride as a main component and contains comparatively many components other thaluminum nitride and in which aluminum nitride particles have grown up is producible in the firing condition of comparatively high temperature and long time at not less than 1750°C for not less than 3 hours in the non-oxidizing atmosphere which does not contain reduction nature components as much as possible.

That is, as for the size of aluminum nitride particles contained inside the sintered compact which comprises aluminum nitride as a main component and contains comparatively many components, such as the above rare earth element, alkaline earth metal, oxygen, alkali metal, silicon, metal components, such as Mo, W, V, Nb, Ta, and Ti, etc., carbon, unescapable metal components other than Mo, W, V, Nb, Ta, and Ti, ALON, above metal components other than aluminum, etc., if it is an average of not less than 1 µm, a thing, such that the half width of the rocking curve of the X-ray diffraction line from the lattice plane of the Miller Index (002) of the single-crystal thin film formed directly on the substrate which comprises this sintered compact is not more than 300 seconds, is easy to be formed.

In the sintered compact which has grown the size of aluminum nitride particles into an average of not less than 5 µm, a thing excellent in crystallinity, such that the half width of the rocking curve of the X-ray diffraction line from the lattice plane of the Miller Index (002) of the single-crystal thin film which comprises as a main component at least one selected from gallium nitride, indium nitride, and aluminum nitride and which is formed directly on the substrate is not more than 240 seconds, is easy to be obtained.

In the sintered compact which has grown the size of aluminum nitride particles into an average of not less than 8 µm, a thing more excellent in crystallinity, such that the half width of the rocking curve of the X-ray diffraction line from the lattice plane of the Miller Index (002) of the single-crystal thin film which comprises as a main component at least one selected from gallium nitride, indium nitride, and aluminum nitride and which is formed directly on the substrate is not more than 200 seconds, is easy to be obtained.

In the sintered compact which has grown the size of aluminum nitride particles into an average of not less than 15 µm, a thing still more excellent in crystallinity, such that the half width of the rocking curve of the X-ray diffraction line from the lattice plane of the Miller Index (002) of the single-crystal thin film which comprises as a main component at least one selected from gallium nitride, indium nitride, and aluminum nitride and which is formed directly on the substrate is not more than 150 seconds, is easy to be obtained.

In the sintered compact which has grown the size of aluminum nitride particles into an average of not less than 25 µm, a thing still more excellent in crystallinity, such that the half width of the rocking curve of the X-ray diffraction line from the lattice plane of the Miller Index (002) of the single-crystal thin film which comprises as a main component at least one selected from gallium nitride, indium nitride, and aluminum nitride and which is formed directly on the substrate is not more than 130 seconds, is easy to be obtained.

Since the area of the grain boundary of aluminum nitride crystal grains will decrease and the effect of a grain boundary will reduce if the size of aluminum nitride particles inside a sintered compact becomes large, the property of the aluminum nitride crystal grain itself will become easy to be revealed, and it is surmised that it will be easy to make the nuclear growth direction of the single-crystal thin film which comprises as a main component at least one selected from gallium nitride, indium nitride, and aluminum nitride into the state with more regularity.

In this invention, also in the sintered compact which comprises aluminum nitride as a main component and contains comparatively many components, such as a rare earth element, an alkaline earth metal, oxygen, an alkaline metal, silicon, a metal component, such as Mo, W, V, Nb, Ta, and Ti, carbon, an unescapable metal component other than Mo, W, V, Nb, Ta, and Ti, ALON, and the above metal component other than aluminum, etc., a thing in which the aluminum nitride particles have grown up is manufactured by raising the firing temperature or by lengthening firing time in the non-oxidizing atmosphere which does not contain reduction nature components as much as possible, and the size of the grown aluminum nitride particles in this sintered compact is usually an average of not less than 5 µm.

Usually, if the firing temperature is raised or the firing time is lengthened, the size of aluminum nitride particles in a sintered compact will also grow to an average of not less than 8 µm, to an average of not less than 15 µm furthermore, and to an average of not less than 25 µm still furthermore, and what is an average of about 100 µm as the size of aluminum nitride particles is also obtained on an experiment.

In this invention, as mentioned above, if it is what comprises aluminum nitride as a main component (for example, what contains not less than 50 volume % as AlN), what has any composition can be used as the sintered compact which comprises aluminum nitride as a main component and which grew the aluminum nitride particles by raising the firing temperature or lengthening the firing time in a non-oxidizing atmosphere not containing reduction nature components as much as possible and contains comparatively a lot of components, such as a rare earth element, an alkaline earth metal, oxygen, an alkali metal, silicon, a metal component, such as Mo, W, V, Nb, Ta, and Ti, etc., carbon, an unescapable metal component other than Mo, W, V, Nb, Ta, and Ti, ALON, the above metal component other than aluminum, etc., among them it is preferred to use the thing with a composition wherein the content of at least one selected from a rare earth element or an alkaline earth metal is not more than 25 volume % on an oxide basis, oxygen content is not more than 10 % by weight, the content of at least one component selected from an alkaline metal or silicon is not more than 10 volume % on an oxide basis, the content of components which contain at least one selected from Mo, W, V, Nb, Ta, Ti, and carbon is not more than 25 volume % on an element basis, the content of components which contain transition metals other than a rare earth element and Mo, W, V, Nb, Ta, and Ti is a total of not more than 30 % by weight on an element basis, and the content of ALON is not more than 20 %.

If it is the above composition, a thing in which the aluminum nitride particles have grown up can be used as a substrate for forming an excellent single-crystal thin film which comprises as a main component at least one selected from gallium nitride, indium nitride, and aluminum nitride, even if it is the sintered compact which comprises aluminum nitride as a main component in which the purity of AlN is not necessarily high.

The above thin film-like single crystal state which comprises as a main component at least one selected from gallium nitride, indium nitride, and aluminum nitride can be formed on the substrate which has such composition and grew the aluminum nitride particles. And the thin film of various crystallization states other than a single crystal, such as an amorphous state, a polycrystal, and an orientated polycrystal, can also be formed furthermore.

If it is the above composition, an excellent thin-film substrate which formed the single-crystal thin film which comprises as amain component at least one selected from gallium nitride, indium nitride, and aluminum nitride can manufacture using the thing in which the aluminum nitride particles have grown up, as a substrate, even if it is the sintered compact which comprises aluminum nitride as a main component and in which the AlN purity is not necessarily high.

A thin film which comprises as a main component at least one selected from gallium nitride, indium nitride, and aluminum nitride and is the single crystal state can be formed further on such a thin-film substrate, and the thin film of various crystallization states other than a single crystal, such as an amorphous state, a polycrystal, and an orientated polycrystal, can also be formed furthermore.

As for the sintered compact which comprises aluminum nitride as a main component and which grew aluminum nitride particles and contains comparatively lots of components, such as a rare earth element, an alkaline earth metal, oxygen, an alkali metal, silicon, metal components, such as Mo, W, V, Nb, Ta, and Ti, etc., carbon, unescapable metal components other than Mo, W, V, Nb, Ta, and Ti, ALON, the above metal components other than aluminum, etc., it is easy to be obtained by firing in the firing environments which do not contain reduction nature components, such as hydrogen, carbon monoxide, carbon, and hydrocarbon, as much as possible and by raising the firing temperature or by lengthening the firing time, as mentioned above.

In this invention, as mentioned above, as for the sintered compact which comprises aluminum nitride as a main component and is used as a substrate for thin-film formation, it is preferred to use the thing with a composition wherein the content of at least one selected from a rare earth element or an alkaline earth metal is not more than 25 volume % on an oxide basis, oxygen content is not more than 10 % by weight, the content of at least one component selected from an alkaline metal or silicon is not more than 10 volume % on an oxide basis, the content of compounds which contain at least one selected from Mo, W, V, Nb, Ta, Ti, and carbon is not more than 25 volume % on an element basis, the content of components which contain transition metals other than a rare earth element and Mo, W, V, Nb, Ta, and Ti is a total of not more than 30 % by weight on an element basis, and the content of ALON is not more than 20 %.

A thing with the crystallinity, such that the half width of the rocking curve of the X-ray diffraction line from the lattice plane of the Miller Index (002) of the single-crystal thin film which comprises as a main component at least one selected from gallium nitride, indium nitride, and aluminum nitride is not more than 300 seconds, is easy to be obtained, if the sintered compact which comprises aluminum nitride as a main component and has such composition is used as a substrate for thin-film formation.

In this invention, although it is preferred that the content of an aluminum nitride component in the sintered compact which comprises aluminum nitride as a main component is not less than 50 volume %, as for a thing which contains comparatively lots of components other than aluminum nitride, such as a thing in which the content of at least one selected from a rare earth element or an alkaline earth metal in this sintered compact is not more than 50 volume % on an oxide basis, a thing in which the oxygen content is not more than 25 % by weight, a thing in which the content of at least one selected from an alkali metal or silicon is not more than 20 volume % on an oxide basis, a thing in which the content of components which contain at least one selected from Mo, W, V, Nb, Ta, Ti, and carbon is not more than 50 volume % on an element basis, a thing in which the content of component which contains transition metal(s) other than a rare earth element and Mo, W, V, Nb, Ta, and Ti, such as iron, nickel, chromium, manganese, zirconium, hafnium, cobalt, copper, and zinc, is not more than 50 % by weight on an element basis, and a thing in which the content of ALON is not more than 50 %, even when it is used as a substrate for thin-film formation, what is the crystallinity, such that the half width of the rocking curve of the X-ray diffraction line from the lattice plane of a Miller Index (002) is not more than 3600 seconds at least, is easy to be obtained as the single-crystal thin film which comprises as a main component at least one selected from gallium nitride, indium nitride, and aluminum nitride and is formed on the substrate, and what is the crystallinity, such that the half width is not more than 300 seconds, is also obtained.

Moreover, in the above sintered compact which comprises aluminum nitride as a main component and contains comparatively lots of components other thaluminum nitride, as for a thing which contains simultaneously at least one selected from a rare earth element and at least one selected from an alkaline earth metal which are included in this sintered compact not more than 50 volume % on an oxide basis, a thing in which the content of oxygen in this sintered compact is not more than 25 % by weight and which contains simultaneously at least one selected from a rare earth element or an alkaline earth metal, a thing in which the content of at least one selected from an alkali metal or silicon in this sintered compact is not more than 20 volume % on an oxide basis and which contains simultaneously at least one selected from a rare earth element or an alkaline earth metal, a thing in which the content of components containing at least one selected from Mo, W, V, Nb, Ta, Ti, and carbon in the sintered compact is not more than 50 volume % on an element basis and which contains simultaneously at least one selected from a rare earth element or an alkaline earth metal, a thing in which the content of components containing transition metal other than a rare earth element and Mo, W, V, Nb, Ta, and Ti, such as iron, nickel, chromium, manganese, zirconium, hafnium, cobalt, copper, and zinc in the sintered compact is not more than 50 % by weight on an element basis and which contains simultaneously at least one selected from a rare earth element or an alkaline earth metal, and a thing in which the content of ALON in this sintered compact is not more than 50 % and which contains simultaneously at least one selected from a rare earth element or an alkaline earth metal, when they are used as a substrate for thin-film formation, what is the crystallinity, such that the half width of the rocking curve of the X-ray diffraction line from the lattice plane of the Miller Index (002) of the single-crystal thin film which comprises as a main component at least one selected from gallium nitride, indium nitride, and aluminum nitride and is formed on the substrate is not more than 300 seconds, is easier to be obtained.

That is, if the sintered compact which comprises aluminum nitride as a main component and which contains simultaneously a rare earth element and an alkaline earth metal component or contains simultaneously components, such as oxygen, alkali metal, silicon, Mo, W, V, Nb, Ta, Ti, carbon, iron, nickel, chromium, manganese, zirconium, hafnium, cobalt, copper, zinc, and ALON, etc., and at least one selected from a rare earth element or an alkaline earth metal is used as a substrate for thin-film formation, the crystallinity of the single-crystal thin film which comprises as a main component at least one selected from gallium nitride, indium nitride, and aluminum nitride and is formed on the substrate tends to be improved compared with the case in which the sintered compact which comprises aluminum nitride as a main component and which contains alone component, such as a rare earth element, an alkaline earth metal, oxygen, an alkali metal, silicon, Mo, W, V, Nb, Ta, Ti, carbon, iron, nickel, chromium, manganese, zirconium, hafnium, cobalt, copper, zinc, and ALON, etc., respectively, is used as a substrate for thin-film formation.

In addition, also in the sintered compact which comprises aluminum nitride as a main component and which contains simultaneously a rare earth element and an alkaline earth metal component or contains simultaneously components, such as oxygen, alkali metal, silicon, Mo, W, V, Nb, Ta, Ti, carbon, iron, nickel, chromium, manganese, zirconium, hafnium, cobalt, copper, zinc, and ALON, etc., and at least one selected from a rare earth element or an alkaline earth metal, it is preferred that the content of an aluminum nitride component is not less than 50 volume %, as mentioned above.

Formation of the single-crystal thin film which comprises as a main component at least one selected from gallium nitride, indium nitride, and aluminum nitride tends to become difficult, if the content of an aluminum nitride component is smaller than 50 volume %, it is not desirable.

That is, it is preferred to use the sintered compact which comprises aluminum nitride as a main component and which has a composition, such as a thing in which the sintered compact which comprises aluminum nitride as a main component contains simultaneously at least one selected from a rare earth element and an alkaline earth metal not more than 50 volume % in total, a thing in which the content of at least one selected from an alkaline metal or silicon in this sintered compact is not more than 20 volume % on an oxide basis and which contains simultaneously at least one selected from a rare earth element or an alkaline earth metal not more than 50 volume % in total, a thing in which the content of the components which contains at least one selected from Mo, W, V, Nb, Ta, Ti, and carbon in the sintered compact is not more than 50 volume % on an element basis and which contains simultaneously at least one selected from a rare earth element or an alkaline earth metal not more than 50 volume % in total, a thing in which the content of the component which contains transition metal other than a rare earth element and Mo, W, V, Nb, Ta, and Ti, such as iron, nickel, chromium, manganese, zirconium, hafnium, cobalt, copper, and zinc in the sintered compact is not more than 50 % by weight on an element basis and which contains simultaneously at least one selected from a rare earth element or an alkaline earth metal not more than 50 volume % in total, a thing in which the ALON content in the sintered compact is not more than 50 % and which contains simultaneously at least one selected from a rare earth element or an alkaline earth metal not more than 50 volume % in total, and a thing in which the oxygen content in this sintered compact is not more than 25 % by weight and which contains simultaneously at least one selected from a rare earth element or an alkaline earth metal not more than 50 volume % in total.

Thus, when the sintered compact which comprises aluminum nitride as a main component and which contains a rare earth element and an alkaline earth metal component simultaneously or contains simultaneously components, such as oxygen, alkali metal, silicon, Mo, W, V, Nb, Ta, Ti, carbon, iron, nickel, chromium, manganese, zirconium, hafnium, cobalt, copper, zinc, and ALON, etc., and at least one selected from a rare earth element or an alkaline earth metal is used as a substrate for forming a single-crystal thin film, the crystallinity of the single-crystal thin film which comprises as a main component at least one selected from gallium nitride, indium nitride, and aluminum nitride and is formed on the substrate tends to be improved compared with the case in which the sintered compact which comprises aluminum nitride as a main component and which contains alone component, such as a rare earth element, an alkaline earth metal, oxygen, an alkali metal, silicon, Mo, W, V, Nb, Ta, Ti, carbon, iron, nickel, chromium, manganese, zirconium, hafnium, cobalt, copper, zinc, and ALON, etc., respectively, is used as a substrate for single-crystal thin film formation, however, it is not necessarily clear about the reason.

This inventor surmises that if a rare earth element and an alkaline earth metal component are included simultaneously, or components, such as oxygen, an alkali metal, silicon, Mo, W, V, Nb, Ta, Ti, carbon, iron, nickel, chromium, manganese, zirconium, hafnium, cobalt, copper, zinc, and ALON, etc., and at least one selected from a rare earth element or an alkaline earth metal are included simultaneously, a densification becomes possible in the firing temperature as low as about 50-300°C compared with the case in which each component is included alone, respectively, then it is easy to generate the liquid phase comparatively so much, therefore, the microcrystal of the aluminum nitride particle which constitutes the above sintered compact which comprises aluminum nitride as a main component grows spontaneously in the liquid phase and the crystallinity improves as a result, and the crystal alignment of the single-crystal thin film is promoted in the process in which the above single-crystal thin film is formed on the sintered compact which comprises aluminum nitride as a main component.

As for the above sintered compact which comprises aluminum nitride as a main component and which contains a rare earth element and an alkaline earth metal component simultaneously or contains simultaneously components, such as oxygen, an alkali metal, silicon, Mo, W, V, Nb, Ta, Ti, carbon, iron, nickel, chromium, manganese, zirconium, hafnium, cobalt, copper, zinc, and ALON, etc., and at least one selected from a rare earth element or an alkaline earth metal, when it is used as a substrate for forming a single-crystal thin film, the crystallinity of the single-crystal thin film which comprises as a main component at least one selected from gallium nitride, indium nitride, and aluminum nitride and is formed on the substrate tends to improve compared with the case in which the sintered compact which comprises aluminum nitride as a main component and contains alone component(s), such as a rare earth element, an alkaline earth metal, oxygen, an alkali metal, silicon, Mo, W, V, Nb, Ta, Ti, carbon, iron, nickel, chromium, manganese, zirconium, hafnium, cobalt, copper, zinc, and ALON, etc., respectively, is used as a substrate for single-crystal thin film formation, but it does not restrict only in the case wherein each above component(s) is included comparatively so much.

In this invention, as for a thing which contains simultaneously at least one selected from a rare earth element and at least one selected from an alkaline earth metal which are included in the sintered compact not more than 25 volume % on an oxide basis, a thing in which the oxygen content in the sintered compact is not more than 10 % by weight and which contains simultaneously at least one selected from a rare earth element or an alkaline earth metal, a thing in which the content of at least one selected from an alkali metal or silicon in the sintered compact is not more than 10 volume % on an oxide basis and which contains simultaneously at least one selected from a rare earth element or an alkaline earth metal, a thing in which the content of at least one selected from Mo, W, V, Nb, Ta, Ti, and carbon in the sintered compact is not more than 25 volume % on an element basis and which contains simultaneously at least one selected from a rare earth element or an alkaline earth metal, a thing in which the content of components containing transition metal other than a rare earth element and Mo, W, V, Nb, Ta, and Ti, such as iron, nickel, chromium, manganese, zirconium, hafnium, cobalt, copper, and zinc in the sintered compact is not more than 30 % by weight on an element basis and which contains simultaneously at least one selected from a rare earth element or an alkaline earth metal, and a thing in which the content of ALON in the sintered compact is not more than 20 % and which contains simultaneously at least one selected from a rare earth element or an alkaline earth metal, when they are used as a substrate for forming a single-crystal thin film, the crystallinity of the single-crystal thin film which comprises as a main component at least one selected from gallium nitride, indium nitride, and aluminum nitride and is formed on the substrate tends to improve, a thing, such that the half width of the rocking curve of the X-ray diffraction line from the lattice plane of a Miller Index (002) is not more than 240 seconds at least, is easy to be obtained.

And, in this invention, as for a thing which contains simultaneously at least one selected from a rare earth element and at least one selected from an alkaline earth metal which are included in the sintered compact not more than 25 volume % on an oxide basis, a thing in which the oxygen content in the sintered compact is not more than 10 % by weight and which contains simultaneously at least one selected from a rare earth element or an alkaline earth metal, a thing in which the content of at least one selected from an alkali metal or silicon in the sintered compact is not more than 10 volume % on an oxide basis and which contains simultaneously at least one selected from a rare earth element or an alkaline earth metal, a thing in which the content of at least one selected from Mo, W, V, Nb, Ta, Ti, and carbon in the sintered compact is not more than 25 volume % on an element basis and which contains simultaneously at least one selected from a rare earth element or an alkaline earth metal, a thing in which the content of components containing transition metal other than a rare earth element and Mo, W, V, Nb, Ta, and Ti, such as iron, nickel, chromium, manganese, zirconium, hafnium, cobalt, copper, and zinc in the sintered compact is not more than 30 % by weight on an element basis and which contains simultaneously at least one selected from a rare earth element or an alkaline earth metal, and a thing in which the content of ALON in the sintered compact is not more than 20 % and which contains simultaneously at least one selected from a rare earth element or an alkaline earth metal, when they are used as a substrate for forming a single-crystal thin film, the crystallinity of the single-crystal thin film which comprises as a main component at least one selected from gallium nitride, indium nitride, and aluminum nitride and is formed on the substrate tends to improve, a thing, such that the half width of the rocking curve of the X-ray diffraction line from the lattice plane of a Miller Index (002) is not more than 300 seconds at least, is easy to be obtained.

In this invention, when manufacturing the substrate for forming a single-crystal thin film which comprises as a main component at least one selected from gallium nitride, indium nitride, and aluminum nitride, in order to raise the optical permeability of the above sintered compact which comprises aluminum nitride as a main component and is made into high purity anything can be used as the form of the powder compact or sintered compact which are used for firing, for example, such as a cube, a rectangular parallelepiped, or a cylindrical one, but it is preferred to use what beforehand has the shape of a board which is easy to be processed into the shape of a substrate.

If the volume is same, it is preferred to use what has bigger surface area than the shape of block, such as a cube, a rectangular parallelepiped, or the shape of a cylinder.

In the form of the above powder compact or sintered compact which are used for firing, it is desirable to use a thing in which the one-side size is not more than 8 mm in order to raise the optical permeability of the sintered compact which comprises aluminum nitride as a main component and is made into high purity.

Furthermore, it is more preferred to use a thing in which the above size of one side is not more than 5 mm, it is still more preferred to use a thing in which the size of one side is not more than 2.5 mm, and it is most preferred to use a thing in which the size of one side is not more than 1 mm.

When the form of the above powder compact or sintered compact which are used for firing is board-like, it is desirable to use a thing whose thickness is not more than 8 mm in order to raise the optical permeability of the sintered compact which comprises aluminum nitride as a main component and is made into high purity.

Furthermore, as for the thickness of the board-like powder compact or sintered compact, it is more preferred to use what is not more than 5 mm, it is still more preferred to use what is the thickness not more than 2.5 mm, and it is most preferred to use what is the thickness not more than 1 mm.

If what was shown above is described concretely, for example, even if it is the sintered compact in which the composition is same and which is an AlN single phase substantially, in the sintered compact which comprises aluminum nitride as a main component and which is made into high purity and is manufactured using the powder compact or sintered compact which have the above shape of block, such as a cube, a rectangular parallelepiped, or a cylindrical shape, or have one side of more than 8 mm, the optical transmissivity will lower compared with what is manufactured using the powder compact and sintered compact which have the shape of a board or have one side not more than 8 mm, discoloration may increase depending on the case and the optical transmissivity may lower furthermore.

In order to form the single-crystal thin film comprising as a main component at least one selected from gallium nitride, indium nitride and aluminum nitride, as for the smoothness of the surface of the substrate of this invention comprising an aluminum nitride-based sintered compact (namely, the substrate for a thin film) or the surface of the thin-film substrate in which the single-crystal thin film was formed, it is preferred that the average surface roughness Ra is not more than 2000 nm.

It is desirable that the substrates have such surface smooth nature to form the above single-crystal thin film.

Therefore, in this invention, it is desirable that at least one surface of the above substrate for a thin film and thin-film substrate has the above smoothness.

In this invention, a substrate surface having the average surface roughness not more than Ra 2000 nm can be obtained in the as-fired surface, the surface by which lap grinding was carried out, the surface ground by the sandblast, the surface by which specular surface polish was carried out, the surface etched (corroded) chemically, or the surface where mechanical processings, such as the slot end, etc., were given, etc., on the aluminum nitride-based sintered compact.

As for the chemical etching, a wet method using a chemical fluid, etc. and a dry method by the plasma gas containing components, such as a fluoride, etc., can be used suitably, for example.

A single-crystal thin film comprising as a main component at least one selected from gallium nitride, indium nitride and aluminum nitride can be formed directly on the substrates having the average surface roughness Ra not more than 2000 nm, and the single-crystal thin film, such that the halfwidth of the rocking curve of the X-ray diffraction line from the lattice plane of a Miller Index (002) is not more than 3600 seconds, is easy to be obtained.

More desirable average surface roughness Ra of the substrates is not more than 1000 nm.

A substrate surface having the average surface roughness Ra not more than 1000 nm can be obtained in the as-fired surface, the surface by which lap grinding was carried out, the surface by which blast polish was carried out, the surface by which specular surface polish was carried out, the surface etched (corroded) chemically, or the surface where mechanical processings, such as the slot end, etc., were given, etc., on the aluminum nitride-based sintered compact.

A single-crystal thin film comprising as a main component at least one selected from gallium nitride, indium nitride and aluminum nitride can be formed directly on the substrates having the average surface roughness not more than Ra 1000 nm, and the single-crystal thin film, such that the halfwidth of the rocking curve of the X-ray diffraction line from the lattice plane ofa Miller Index (002) is not more than 1000 seconds, is easy to be obtained.

As for the average surface roughness Ra of the substrates, it is still more preferred that it is not more than 100 nm.

A substrate surface having the average surface roughness Ra not more than 100 nm can be obtained in the as-fired surface or the specular polish surface, on the aluminum nitride-based sintered compact.

A single-crystal thin film comprising as a main component at least one selected from gallium nitride, indium nitride and aluminum nitride can be formed directly on the substrates having has the average surface roughness not more than Ra 100 nm, the single-crystal thin film, such that the half width of the rocking curve of the X-ray diffraction line from the lattice plane of a Miller Index (002) is not more than 300 seconds, is easy to be obtained.

In the substrates having the average surface roughness not more than Ra 100 nm, what was made into the specular surface state not more than Ra 60 nm is preferred usually, not more than Ra 30 nm is more preferred, and not more than Ra 20 nm is still more preferably.

The crystallinity of the single-crystal thin film formed becomes easy to be improved by processing into the state of a mirror plane.

In the substrate comprising an aluminum nitride-based sintered compact, a single-crystal thin film comprising as a main component at least one selected from gallium nitride, indium nitride and aluminum nitride can be formed on that having the average surface roughness not more than Ra 60 nm, and the single-crystal thin film, such that the half width of the rocking curve of the X-ray diffraction line from the lattice plane of a Miller Index (002) is not more than 240 seconds, is easy to be obtained.

In the substrate using an aluminum nitride-based sintered compact, a single-crystal thin film comprising as a main component at least one selected from gallium nitride, indium nitride and aluminum nitride can be formed on that having the average surface roughness not more than Ra 30 nm, and the single-crystal thin film, such that the half width of the rocking curve of the X-ray diffraction line from the lattice plane of a Miller Index (002) is not more than 200 seconds, is easy to be obtained.

In the substrate using an aluminum nitride-based sintered compact, a single-crystal thin film comprising as a main component at least one selected from gallium nitride, indium nitride, and aluminum nitride can be formed on that having the average surface roughness not more than Ra 20 nm, and the single-crystal thin film, such that the half width of the rocking curve of the X-ray diffraction line from the lattice plane of a Miller Index (002) is not more than 150 seconds, is easy to be obtained.

When the as-fired surface of the above a ceramic-based sintered compact substrate is used, it is preferred to use what has the condition of having removed affixes, dust particles, and projections, etc. in the surface of a substrate by brushing or honing using an alumina powder, etc.

Lap grinding can be satisfactorily carried out by the method which used alumina abrasive grain, silicon carbide abrasive grain, a diamond abrasive grain, etc. with the lap grinding machine usually used.

Blast polish can be satisfactorily carried out with the usual sandblasting machine, etc. by using alumina abrasive grain, silicon carbide abrasive grain, etc.

Specular surface polish can be satisfactorily carried out by the method which used suitably the abradant comprising as a main component a fine grain, such as alumina, cerium oxide, a diamond, silicon oxide, or chromium oxide, etc., with the grinder having usual tools (polisher), such as a pad made by cloth and a polyurethane pad, etc.

In this invention, in the substrate for thin-film formation which comprises a sintered compact which comprises aluminum nitride as a main component and the thin-film substrate produced by using the sintered compact which comprises aluminum nitride as a main component as a substrate, the surface state and surface smooth nature of the substrate are especially important, when a single-crystal thin film which comprises as a main component at least one selected from gallium nitride, indium nitride, and aluminum nitride is formed.

The surface state and the surface smooth nature are important similarly, when the sintered compact which comprises aluminum nitride as a main component and raised the AlN purity by firing at the temperature not less than 1750°C for comparatively long time not less than 3 hours, etc., or the sintered compact which comprises aluminum nitride as a main component and grew aluminum nitride particles greatly, or the sintered compact which comprises aluminum nitride as a main component and raised the optical transmissivity, are used as a substrate, for example.

If the thin film which comprises as a main component at least one selected from gallium nitride, indium nitride, and aluminum nitride is formed only in the one surface of a substrate, as for the surface state and surface smooth nature of the surface of the substrate for thin-film formation which comprises a sintered compact which comprises aluminum nitride as a main component and in which the thin film is not formed and the surface of the thin-film substrate produced by using the sintered compact which comprises aluminum nitride as a main component as a substrate, they can select arbitrary conditions if needed and may differ from the surface state wherein the thin film is formed.

The crystallinity of the single-crystal thin film which comprises as a main component at least one selected from gallium nitride, indium nitride, and aluminum nitride and is formed directly on a substrate has a tendency to become higher in the state wherein the specular surface polish was carried out, as the surface state of the above substrate of this invention which comprises a sintered compact which comprises aluminum nitride as a main component.

If the as-fired state is compared with the lap polish state, there is a tendency wherein the crystallinity of the above single-crystal thin film formed directly on a substrate is higher in the substrate surface of the as-fired state.

About such phenomenon, it is surmised that it will be because the degree which makes the nuclear growth direction regular differs by the degree of smoothness of a substrate surface (that is, the degree of the surface roughness of a substrate), at the time of growth of a single-crystal thin film which comprises as a main component at least one selected from gallium nitride, indium nitride, and aluminum nitride.

In the above substrate which comprises a sintered compact which comprises aluminum nitride as a main component and carried out the above surface processing, such as the as-fired state, lap polish, blast polish, specular surface polish, and mechanical slot end processing, if furthermore processing is carried out, such as immersing in acid, such as hydrofluoric acid (HF), hydrofluoric-nitric acid (mixed acid of HF+HNO₃), nitric acid (HNO₃), hydrochloric acid (HCl), and sulfuric acid (H₂SO₄), or immersing in organic solvents, such as acetone, isopropyl alcohol, a methylene chloride, and fluorocarbon, or heating and annealing in non-oxidizing atmosphere containing H₂, N₂, Ar, etc. or under decompression, or carrying out by combining these two or more, for example, it is possible to aim at the improvement of crystallinity of the single-crystal thin film formed on the substrate, and it can become effective.

As for the reason in which the crystallinity of the single-crystal thin film formed by carrying out such processing becomes easy to be improved, this inventor is surmising that it will be because the defect of dust particles, projections, cracks, hollows, etc. or the strain produced by grinding, polishing, etc. on the surface of a substrate are removed or mitigated.

It seems that there is the effect to be able to make the average surface roughness Ra smaller, such as not less than 10 nm for example, by carrying out such processing, because the substrate which comprises a sintered compact which comprises aluminum nitride as a main component is a polycrystalline substance in which aluminum nitride particulates were gathered, and it is considered to be easy to produce the defect and the strain in grinding and polishing by the particulate omission and the chip of a particulate, etc. onto the substrate surface.

In this invention, the surface smooth nature of a thin-film substrate in which the thin film which comprises as a main component at least one selected from gallium nitride, indium nitride, and aluminum nitride is being formed is equivalent to the surface state of the sintered compact which comprises aluminum nitride as a main component and is used usually as a substrate, or is improved, if the sintered compact which comprises aluminum nitride as a main component is used as a substrate.

That is, if the smoothness of the surface of the substrate which comprises a sintered compact which comprises aluminum nitride as a main component is average surface roughness Ra=30 nm, the surface smoothness of the thin-film substrate of this invention will become Ra not more than 30 nm.

Therefore, as for the smooth nature of the surface of the thin-film substrate of this invention in which a thin film which comprises as a main component at least one selected from gallium nitride, indium nitride, and aluminum nitride was formed, it is not more than 2000 nm when the substrate comprising a sintered compact which comprises aluminum nitride as a main component and is the average surface roughness not more than Ra=2000 nm is used, Ra is not more than 1000 nm when the substrate comprising a sintered compact which comprises aluminum nitride as a main component and is the average surface roughness not more than Ra=1000 nm is used, Ra is not more than 100 nm when the substrate comprising a sintered compact which comprises aluminum nitride as a main component and is the average surface roughness not more than Ra=100 nm is used, Ra is not more than 20 nm when the substrate comprising a sintered compact which comprises aluminum nitride as a main component and is the average surface roughness not more than Ra=20 nm is used.

As for the smooth nature of the thin-film substrate surface in which the thin film which comprises as a main component at least one selected from gallium nitride, indium nitride, and aluminum nitride was formed using as a substrate the aluminum nitride-based sintered compact of this invention, what is the average surface roughness Ra not more than 10 nm, or what is Ra not more than 3-5 nm, what is Ra not more than 1-3 nm furthermore, are also obtained.

In the thin-film substrate according to this invention, as for the thin film which gives surface smooth nature which is equivalent to the surface smooth nature of the substrate comprising a sintered compact comprising aluminum nitride as a main component or is improved more than it, it is not restricted only to the single-crystal thin film which comprises as a main component at least one selected from gallium nitride, indium nitride, and aluminum nitride.

In the case of the thin-film substrate of this invention which formed a thin film which comprises as a main component at least one selected from gallium nitride, indium nitride, and aluminum nitride and which has at least one of the crystallization states selected from an amorphous state, a polycrystal, and an orientated polycrystal using the substrate which comprises a sintered compact which comprises aluminum nitride as a main component, like the above single-crystal thin film, it is equivalent to the surface smooth nature of the substrate comprising a sintered compact comprising aluminum nitride as a main component or improves more than it, what is Ra not more than 20 nm, or what is Ra not more than 10 nm, or what is Ra not more than 3-5 nm, what is Ra not more than 1-3 nm furthermore, are also obtained, as the degree of smooth nature.

A more excellent thin film which comprises as a main component at least one selected from gallium nitride, indium nitride, and aluminum nitride can be formed on the thin-film substrate which has such surface smooth nature.

That is, if the single-crystal thin film which comprises as a main component at least one selected from gallium nitride, indium nitride, and aluminum nitride is formed furthermore onto the thin-film substrate in which the single-crystal thin film which comprises as a main component at least one selected from gallium nitride, indium nitride, and aluminum nitride is being formed by using as a substrate the sintered compact which comprises aluminum nitride as a main component, or onto the thin-film substrate in which the thin film which comprises as a main component at least one selected from gallium nitride, indium nitride, and aluminum nitride and has at least one of the crystallization states selected from a single crystal, an amorphous state, a polycrystal, and an orientated polycrystal is being formed by using as a substrate the sintered compact which comprises aluminum nitride as a main component, a single-crystal thin film, such that the half width of the rocking curve of the X-ray diffraction line from the lattice plane of the Miller Index (002) of the above single-crystal thin film which comprises as a main component at least one selected from gallium nitride, indium nitride, and aluminum nitride and is formed on the thin-film substrate is not more than 240 seconds, is easy to be obtained, in the case where the surface smooth nature of the above thin-film substrate is not more than Ra 50 nm.

And, when the surface smooth nature of the above thin-film substrate is not more than Ra 20 nm, a single-crystal thin film, such that the half width of the rocking curve of the X-ray diffraction line from the lattice plane of the Miller Index (002) of the above single-crystal thin film which comprises as amain component at least one selected from gallium nitride, indium nitride, and aluminum nitride and is formed on the thin-film substrate is not more than 200 seconds, is easy to be obtained.

When the surface smooth nature of the above thin-film substrate is not more than Ra 10 nm, a single-crystal thin film, such that the half width of the rocking curve of the X-ray diffraction line from the lattice plane of the Miller Index (002) of the above single-crystal thin film which comprises as amain component at least one selected from gallium nitride, indium nitride, and aluminum nitride and is formed on the thin-film substrate is not more than 150 seconds, is easy to be obtained.

When the surface smooth nature of this above thin-film substrate is not more than Ra 5 nm, a single-crystal thin film, such that the half width of the rocking curve of the X-ray diffraction line from the lattice plane of the Miller Index (002) of the above single-crystal thin film which comprises as a main component at least one selected from gallium nitride, indium nitride, and aluminum nitride and is formed on the thin-film substrate is not more than 130 seconds, is easy to be obtained.

Moreover, when the surface smooth nature of the above thin-film substrate is not more than Ra 3 nm, a single-crystal thin film, such that the half width of the rocking curve of the X-ray diffraction line from the lattice plane of the Miller Index (002) of the above single-crystal thin film which comprises as amain component at least one selected from gallium nitride, indium nitride, and aluminum nitride and is formed on the thin-film substrate is not more than 100 seconds, is easy to be obtained.

Not only the above single-crystal thin film which comprises as a main component at least one selected from gallium nitride, indium nitride, and aluminum nitride but also the thin film which comprises as a main component at least one selected from gallium nitride, indium nitride, and aluminum nitride and has at least one of the crystallization states selected from an amorphous state, a polycrystal, and an orientated polycrystal can be formed on the thin-film substrate of this invention which has such smooth nature.

And, in the above thin-film substrate according to this invention, although the thin film which is formed on the substrate comprising a sintered compact comprising aluminum nitride as a main component and which gives the surface smooth nature equivalent to the surface smooth nature of the substrate comprising a sintered compact comprising aluminum nitride as a main component or is improved more than it is a thing which comprises as a main component at least one selected from gallium nitride, indium nitride, and aluminum nitride and has at least one of the crystallization states selected from a single crystal, an amorphous state, a polycrystal, and an orientated polycrystal, a thin-film substrate which has the surface smooth nature which is equivalent to the surface smooth nature of the substrate comprising a sintered compact comprising aluminum nitride as a main component or is improved more than it is obtained, if the thickness of the thin film is not less than 0.5 nm.

As mentioned above, as for the surface smooth nature of the substrate in which a thin film which comprises as a main component at least one selected from gallium nitride, indium nitride, and aluminum nitride and which is various crystallization states, such as a single crystal, an amorphous state, a polycrystal, and an orientated polycrystal, etc., was formed on the substrate which comprises a sintered compact which comprises aluminum nitride as a main component, it tends to be improved than the substrate which comprises a sintered compact which is not forming a thin film and comprises aluminum nitride as a main component.

And, by forming furthermore a thin film of various crystallization states, such as a single crystal, an amorphous state, a polycrystal, and an orientated polycrystal, onto the substrate in which the thin film of various crystallization states, such as a single crystal, an amorphous state, a polycrystal, and an orientated polycrystal, was formed beforehand on the above substrate which comprises a sintered compact which comprises aluminum nitride as a main component, (by forming a thin film in multilayer), the surface roughness of a substrate becomes small, and the surface smooth nature may be improved furthermore.

A thing in which the average surface roughness Ra of the substrate is not more than 10 nm is usually obtained comparatively easily.

When the surface smooth nature of a substrate is improved by forming such multilayered thin film, it is preferred to use the substrate which formed a thin film which has at least one of the crystallization states selected from an amorphous thin film, a polycrystalline thin film, and an orientated polycrystalline thin film among the single-crystal thin film, amorphous thin film, polycrystalline thin film, and orientated polycrystalline thin film which are formed beforehand on the substrate which comprises a sintered compact which comprises aluminum nitride as a main component, and a thin-film substrate in which the average surface roughness Ra is not more than 3 nm can be produced.

When the surface smooth nature of a substrate is improved forming the above multilayered thin film, it is preferred to use the substrate which formed the orientated polycrystalline thin film among a single-crystal thin film, an amorphous thin film, a polycrystalline thin film, and an orientated polycrystalline thin film which are formed beforehand on the substrate which comprises a sintered compact which comprises aluminum nitride as a main component.

As for the average surface roughness Ra of the substrate wherein the thin film was first formed on the ceramic-based sintered compact substrate, that which is not more than 2 nm at least, and is not more than 1 nm is easily obtained, and a single-crystal thin film, an amorphous thin film, a polycrystalline thin film, and an orientated polycrystalline thin film may be formed further on it.

Although the reason why the above effect arises by the orientated polycrystalline thin film formation is not necessarily clear, this inventor is surmising that it is a big factor that the difference in surface smooth nature produced when forming a thin film directly on the substrate which comprises a sintered compact which comprises aluminum nitride as a main component also affects the thin film formed on it as it is.

That is, as for the surface roughness of an orientated polycrystalline thin film formed on the substrate which comprises a sintered compact which comprises aluminum nitride as a main component, it is usually smaller than a single-crystal thin film, an amorphous thin film, and a polycrystalline thin film, in many cases.

The original difference in such surface roughness is considered to be shown as it is as a difference in the surface roughness of the thin film formed on it.

This inventor is surmising that the original difference in surface roughness will be generated by the cause wherein the degree which complements the defect resulting from a sintered compact, such as micro hole, projection, and chip of aluminum nitride particle which exist in the substrate which comprises a sintered compact which comprises aluminum nitride as a main component, is smaller than an orientated polycrystalline thin film, because a comparatively high temperature is required in many cases and a difference of local crystal growth arises in a thin film, when forming a single-crystal thin film, or the density of a thin film is low and many micro defects exist in an amorphous thin film and a polycrystal thin film, for example.

Though such surface smoothness by the thin film formed on the a ceramic-based sintered compact substrate may be produced spontaneously, it is attained also by carrying out the mechanochemical grinding (grinding by mechanical chemical operation) or mirror-polishing using the grinding or polishing machines and the abradants which were illustrated above.

By carrying out the mechanochemical grinding or mirror-polishing, the average surface roughness Ra of a thin-film substrate can be at least not more than 10 nm. A thin-film substrate having an average surface roughness Ra of not more than 3 nm, preferably not more than 2 nm, more preferably not more than 1 nm, can be produced.

As for the reason wherein the excellent smoothness which is at least equivalent to the ceramic-based sintered compact is obtained by carrying out the mechanochemical grinding or polishing, it is surmised that it will be because there are few defects of nm level because the thin film formed on the ceramic-based sintered compact comprises finer particles compared with the ceramic-based sintered compact, or comprises the homogeneous, continuous, and unified construction (monolithic construction) which is not constituted with a particulate, etc.

If furthermore processing is carried out onto the substrate on which the above thin films were formed, such as immersing in acid, such as hydrofluoric acid (HF), hydrofluoric-nitric acid (mixed acid of HF + HNO₃), nitric acid (HNO₃), hydrochloric acid (HCl), and sulfuric acid (H₂SO₄), or heating and annealing in non-oxidizing atmosphere containing H₂, N₂, Ar, etc. or under reduced pressure , or carrying out by combining these two or more, for example, it is possible to aim at the improvement of crystallinity of the single-crystal thin film formed on the substrate surface, and it can become effective.

Using the thin-film substrate having such surface smoothness, if electronic devices or electronic components, such as a light-emitting device, an optical waveguide, a wiring board, and a surface acoustic wave device, are produced, what has more excellent characteristic will be easily obtained.

Especially a light-emitting device excellent in luminous efficiency can be produced.

In this invention, as for the smoothness of the surface of the substrate (namely, substrate for thin-film formation) which used the sintered compact which comprises a material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., or the surface of the thin-film substrate in which a thin film which comprises as a main component at least one selected from gallium nitride, indium nitride, and aluminum nitride was formed on the above substrate for thin-film formation, it is preferred that average surface roughness Ra is not more than 1000 nm, in order to form a thin film which comprises as a main component at least one selected from gallium nitride, indium nitride, and aluminum nitride and is various crystallization states including a single crystal.

It is desirable in order for having the surface smooth nature of such substrate to form the above single-crystal thin film.

Therefore, it is desirable that at least one surface of the thin-film substrate which is produced using the above substrate for thin-film formation in this invention has the above smoothness.

A substrate surface which is the average surface roughness Ra not more than 1000 nm can be obtained in the as-fired surface, the surface by which lap grinding was carried out, the surface by which blast polish was carried out, the surface by which specular surface polish was carried out, the surface etched (corroded) chemically, the surface where mechanical processings, such as the slot end, etc., were given, or the surface of the thin-film substrate produced using the above substrate for thin-film formation, etc., in the sintered compact which comprises a material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc.

As for the chemical etching, a wet method using a chemical fluid, etc. and a dry method by the plasma gas containing components, such as a fluorine, etc., can be used suitably, for example.

A single-crystal thin film which comprises as a main component at least one selected from gallium nitride, indium nitride, and aluminum nitride can be formed directly on these substrates which have the average surface roughness Ra not more than 1000 nm, and a thing, such that the half width of the rocking curve of the X-ray diffraction line from the lattice plane of a Miller Index (002) of the single-crystal thin film is not more than 3600 seconds, is easy to be obtained.

As for the surface smooth nature of the thin-film substrate produced using the above substrate for thin-film formation, usually, a thing in which Ra is not more than 100 nm is preferred, and a thing wherein Ra is not more than 100 nm and has specular surface state is more preferred. The crystallinity of the single-crystal thin film formed becomes easy to improve if making it into specular surface state.

A single-crystal-ized thin film which comprises as a main component at least one selected from gallium nitride, indium nitride, and aluminum nitride can be formed in the thing in which the average surface roughness Ra is not more than 100 nm among the substrate which used the sintered compact which comprises as a main component the material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., and a thing, such that the half width of the rocking curve of the X-ray diffraction line from the lattice plane of a Miller Index (002) of the single-crystal thin film is not more than 1000 seconds, is easy to be obtained.

As for the average surface roughness Ra of these substrates, it is more preferred that it is not more than 10 nm.

These substrates which have the average surface roughness Ra not more than 10 nm can be obtained in the thin-film substrate produced using the above substrate for thin-film formation wherein specular surface polish was carried out in the sintered compact which comprises as a main component a material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc.

A single-crystal-ized thin film which comprises as a main component at least one selected from gallium nitride, indium nitride, and aluminum nitride can be formed directly on the substrate which has the average surface roughness Ra not more than 10 nm, and a thing, such that the half width of the rocking curve of the X-ray diffraction line from the lattice plane of a Miller Index (002) of the single-crystal thin film is not more than 300 seconds, is easy to be obtained.

Moreover, as for the average surface roughness Ra of these substrates, it is still more preferred that it is not more than 5 nm.

The substrate which has the average surface roughness Ra not more than 5 nm can be obtained in the thin-film substrate produced using the above substrate for thin-film formation wherein specular surface polish was carried out in the sintered compact which comprises as a main component a material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc.

A single-crystal-ized thin film which comprises as a main component at least one selected from gallium nitride, indium nitride, and aluminum nitride can be formed directly on the substrate which has the average surface roughness Ra not more than 5 nm, and a thing, such that the half width of the rocking curve of the X-ray diffraction line from the lattice plane of a Miller Index (002) of the single-crystal thin film is not more than 240 seconds, is easy to be obtained.

When using the as-fired surface of the above-mentione substrate which comprises a sintered compact which comprises as a main component a material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., it is preferred to use what is the state which has removed affixes, dust particles, and projections, etc. which are in the surface of a substrate by honing which used a brush, alumina abrasive powder, etc.

As for the lap polish, a method which used alumina abrasive grain, silicon carbide abrasive grain, and a diamond abrasive grain which are usually carried out can be used satisfactorily, using a lap grinding machine.

As for the specular surface polish, a method which used suitably the abradant which comprises as a main component alumina, cerium oxide, a diamond, silicon oxide, or chromium oxide, etc. which are a particulate can be used satisfactorily, using the polishing machine which has usual implements, such as a pad made of cloth and a polyurethane pad, etc.

In this invention, as for the surface state of the thin-film substrate produced using the substrate for thin-film formation which comprises a sintered compact which comprises as a main component a material which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., the surface in which a thin film is formed is important especially.

When the thin film which comprises as a main component at least one selected from gallium nitride, indium nitride, and aluminum nitride is formed on only the one surface of a substrate, as for the surface state of the thin-film substrate produced using the substrate for thin-film formation which comprises a sintered compact which comprises as a main component a material which has the crystal structure which can be classified as a hexagonal system such as silicon carbide, silicon nitride, gallium nitride, zinc oxide, and beryllium oxide, etc., and can be classified as a trigonal system or a hexagonal system, such as aluminum oxide, etc., arbitrary states can be selected if needed, it may differ from the surface state in which the thin film which comprises as a main component at least one selected from gallium nitride, indium nitride, and aluminum nitride is formed.

As for the surface state of the above substrate of this invention which comprises a sintered compact which comprises as a main component a material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., what is in the state which has been ground to specular surface has a tendency in which the crystallinity of the single-crystal thin film which comprises as amain component at least one selected from gallium nitride, indium nitride, and aluminum nitride and is formed directly on a substrate is high.

When what is in the as-fired state is compared with what is in the lap polish state, what is in the state of as-fired substrate surface has a tendency in which the crystallinity of the above single-crystal thin film which is formed directly on a substrate is high.

About such phenomenon, it is surmised that it will be because the degree which makes the nuclear growth direction regular differs by the smoothness of a substrate surface (that is, the degree of the surface roughness of a substrate) at the time of growth of the single-crystal thin film which comprises as a main component at least one selected from gallium nitride, indium nitride, and aluminum nitride.

And, about such phenomenon, although there is a difference in which higher smoothness is requested as the surface of a substrate compared with the case of the substrate which uses the sintered compact which comprises aluminum nitride as a main component, it is surmised that it will be because the degree which makes the nuclear growth direction regular differs by the smoothness of a substrate surface (that is, the degree of the surface roughness of a substrate) at the time of growth of the single-crystal thin film which comprises as a main component at least one selected from gallium nitride, indium nitride, and aluminum nitride.

In this invention, as for the surface smooth nature of the thin-film substrate in which a thin film which comprises as a main component at least one selected from gallium nitride, indium nitride, and aluminum nitride is formed by using as a substrate the sintered compact which comprises as a main component a material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., usually it is equivalent or is improved more than it, to the surface smooth nature of the substrate which comprises a sintered compact which comprises as a main component a material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc.

That is, as for the smoothness on the surface of a substrate which comprises a sintered compact which comprises as a main component a material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., if the average surface roughness Ra is 30 nm, for example, the surface smoothness of the thin-film substrate of this invention will become not more than 30 nm as Ra.

Therefore, as for the smooth nature of the surface of the thin-film substrate of this invention in which a single-crystal thin film which comprises as a main component at least one selected from gallium nitride, indium nitride, and aluminum nitride was formed, Ra is not more than 1000 nm when using the substrate which comprises a sintered compact which has the average surface roughness Ra not more than 1000 nm and comprises as a main component a material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., Ra is not more than 100 nm when using the substrate which comprises a sintered compact which has the average surface roughness Ra not more than 100 nm and comprises as a main component a material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., Ra is not more than 30 nm when using the substrate which comprises a sintered compact which has the average surface roughness Ra not more than 30 nm and comprises as a main component a material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., Ra is not more than 10 nm when using the substrate which comprises a sintered compact which has the average surface roughness Ra not more than 10 nm and comprises as a main component a material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., Ra is not more than 5 nm when using the substrate which comprises a sintered compact which has the average surface roughness Ra not more than 5 nm and comprises as a main component a material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc.

According to this invention, as for the smooth nature of the thin-film substrate surface in which a thin film which comprises as a main component at least one selected from gallium nitride, indium nitride, and aluminum nitride was formed using as a substrate the sintered compact which comprises as a main component a material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., what is Ra not more than 10 nm, or what is Ra not more than 3-5 nm, what is Ra not more than 1-3 nm furthermore, are also obtained.

In the thin-film substrate according to this invention, as for the thin film which gives the surface smooth nature which is equivalent or is improved more than it, to the surface smooth nature of the substrate which comprises a sintered compact which comprises as a main component a material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., it is not restricted only to the single-crystal thin film which comprises as amain component at least one selected from gallium nitride, indium nitride, and aluminum nitride.

In the case of the thin-film substrate of this invention which formed a thin film which comprises as a main component at least one selected from gallium nitride, indium nitride, and aluminum nitride and which has at least one of the crystallization states selected from an amorphous state, a polycrystal, and an orientated polycrystal using the substrate which comprises a sintered compact which comprises as a main component a material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., like the above single-crystal thin film, it is equivalent or is improved more than it, to the surface smooth nature of the substrate which comprises a sintered compact which comprises as a main component the material which has the crystal structure which can be classified as a hexagonal system such as silicon carbide, silicon nitride, gallium nitride, zinc oxide, and beryllium oxide, etc., and can be classified as a trigonal system or a hexagonal system, such as aluminum oxide, etc., what is Ra not more than 20 nm, or what is Ra not more than 10 nm, or what is Ra not more than 3-5 nm, what is Ra not more than 1-3 nm furthermore, are also obtained, as the degree of smooth nature.

And, in the above thin-film substrate according to this invention, as for the thin film which gives the equivalent or improved surface smooth nature to the surface smooth nature of the substrate which comprises a sintered compact which comprises as a main component a material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., although it is a thing which comprises as a main component at least one selected from gallium nitride, indium nitride, and aluminum nitride and has at least one of the crystallization states selected from a single crystal, an amorphous state, a polycrystal, and an orientated polycrystal, a thin-film substrate which has the surface smooth nature which is equivalent or is improved more than it to the surface smooth nature of the substrate which comprises a sintered compact which comprises as a main component a material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., is obtained, if the thickness of the thin film is not less than 0.5 nm.

As mentioned above, as for the surface smooth nature of the substrate in which a thin film which comprises as a main component at least one selected from gallium nitride, indium nitride, and aluminum nitride and has various crystallization states, such as a single crystal, an amorphous state, a polycrystal, and an orientated polycrystal, etc., was formed on the substrate which comprises a sintered compact which comprises as a main component a material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., it is easy to be improved than the substrate which comprises a sintered compact which is not forming a thin film and comprises as a main component a material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc.

And, by forming furthermore a thin film of various crystallization states, such as a single crystal, an amorphous state, a polycrystal, and an orientated polycrystal, onto the substrate in which the thin film of various crystallization states, such as a single crystal, an amorphous state, a polycrystal, and an orientated polycrystal, was formed beforehand on the above substrate which comprises a sintered compact which comprises as a main component a material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., (by forming a thin film in multilayer), the surface roughness of a substrate becomes small, and the surface smooth nature may be improved furthermore.

When the surface smooth nature of a substrate is improved forming such multilayered thin film, it is preferred to use the substrate which formed an orientated polycrystalline thin film among a single-crystal thin film, an amorphous thin film, a polycrystalline thin film, and an orientated polycrystalline thin film which are first formed directly on the substrate which comprises a sintered compact which comprises as a main component a material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc.

As for the surface roughness of the substrate which formed furthermore the single-crystal thin film, the amorphous thin film, the polycrystalline thin film, and the orientated polycrystalline thin film, after the orientated polycrystalline thin film was first formed directly on the substrate which comprises a sintered compact which comprises as a main component a material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., what is at least not more than 2 nm, and furthermore what is not more than 1 nm are easy to be obtained.

Although the reason why the above effect arises by the orientated polycrystalline thin film formation is not necessarily clear, this inventor is surmising that it is a big factor that the difference in surface smooth nature produced when forming a thin film directly on the substrate which comprises a sintered compact which comprises as a main component a material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., also affects the thin film formed on it as it is.

That is, as for the surface roughness of an orientated polycrystalline thin film formed on the substrate which comprises a sintered compact which comprises as a main component a material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., it is usually smaller than a single-crystal thin film, an amorphous thin film, and a polycrystalline thin film, in many cases.

The original difference in such surface roughness is considered to be shown as it is as a difference in the surface roughness of the thin film formed on it.

This inventor is surmising that the original difference in surface roughness will be generated by the cause wherein the degree which complements the defect resulting from a sintered compact, such as micro hole, projection, and chip of aluminum nitride particle which exist in the substrate which comprises a sintered compact which comprises as a main component a material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., is smaller than an orientated polycrystalline thin film, because a comparatively high temperature is required in many cases and a difference of local crystal growth arises in a thin film, when forming a single-crystal thin film, or the density of a thin film is low and many micro defects exist in an amorphous thin film and a polycrystal thin film, for example.

As for such surface smooth nature by the thin film formed on the substrate which comprises a sintered compact which comprises as a main component a material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., though it may be produced spontaneously, it is attained also by carrying out the mechanochemical grinding (grinding by mechanical chemical operation) or specular surface polish using the grinding and polishing machines and the abradants which were illustrated above.

As for the reason wherein the excellent smooth nature which is equivalent or more to the sintered compact which comprises as a main component a material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., is obtained by carrying out the mechanochemical grinding or polishing, it is surmised that it will be because there are few defects of nm parallel because the thin film formed on each sintered compact comprises finer particles compared with the sintered compact which comprises as a main component a material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., or comprises the homogeneous, continuous, and unified construction (monolithic construction) which is not constituted with a particulate, etc.

If furthermore processing is carried out onto the substrate in which the above thin films were formed, such as immersing in acid, such as hydrofluoric acid (HF), hydrofluoric-nitric acid (mixed acid of HF+HNO₃), nitric acid (HNO₃), hydrochloric acid (HCl), and sulfuric acid (H₂SO₄), or heating and annealing in non-oxidizing atmosphere containing H₂, N₂, Ar, etc. or under decompression, or carrying out by combining these two or more, for example, it is possible to aim at the improvement of crystallinity of the single-crystal thin film formed on the substrate surface, and it can become effective.

In addition, as for the relation between the above surface state of the sintered compact which comprises aluminum nitride as a main component and surface state of the sintered compact which comprises as a main component a material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., and the crystallinity of a single-crystal thin film which is formed on it and comprises as a main component at least one selected from gallium nitride, indium nitride, and aluminum nitride and a surface state of the thin film which is formed on it and is various crystallization states, such as a single crystal, an amorphous state, a polycrystal, and an orientated polycrystal, it has the same tendency also in the relation between the surface state and the crystallinity of a single-crystal thin film which is formed on it and comprises as a main component at least one selected from gallium nitride, indium nitride, and aluminum nitride and a surface state of the thin film which is formed on it and is various crystallization states, such as a single crystal, an amorphous state, a polycrystal, and an orientated polycrystal, even when using the sintered compact which comprises as a main component various ceramic material, such as zirconium oxide, magnesium oxide, magnesium aluminate, titanium oxide, barium titanate, lead titanate zirconate, and rare-earth element oxides such as yttrium oxide, thorium oxide, various ferrites, mullite, forsterite, steatite, and glass, etc., for example, other than these sintered compacts.

This inventor showed that the crystallinity of the single-crystal thin film which comprises as a main component at least one selected from gallium nitride, indium nitride, and aluminum nitride and is formed on a substrate and the optical transmissivity in visible light and/or in ultraviolet light of the range of 200-380 nm wavelength have a correlation when the sintered compact which comprises aluminum nitride as a main component was used as a substrate.

Moreover, as an advantage when the optical transmissivity is high, the luminous efficiency of a light-emitting device can be raised, because the rate which absorbs the light from the light-emitting device formed on the substrate which comprises a sintered compact which comprises aluminum nitride as a main component, or from the light-emitting device formed on the substrate which formed a single-crystal thin film which comprises as a main component at least one selected from gallium nitride, indium nitride, and aluminum nitride using the substrate which comprises a sintered compact which comprises aluminum nitride as a main component, by a substrate is made small.

In order to raise the optical transmissivity of the substrate which comprises a sintered compact which comprises aluminum nitride as a main component and has the above features and advantages, it is also effective to make thickness of a substrate thin besides improving the characteristics of the sintered compact itself, such as the chemical composition and microstructure, etc. of a sintered compact.

If the thickness of a substrate is not more than 8.0 mm, optical permeability can be maintained to the light of the range of 200-800 nm wavelength.

That the optical permeability can be maintained means that the optical transmissivity is not less than 1 %, even if the thickness of a substrate which comprises a sintered compact which comprises as a main component aluminum nitride is 8.0 mm.

Even if the optical transmissivity measured using the substrate which comprises a sintered compact which comprises aluminum nitride as a main component and whose thickness is 0.5 mm is as high as the range of 60-80 % in the light of the range of 200-800 nm wavelength, the optical transmissivity decreases if the thickness of a substrate becomes thick.

For example, when the optical transmissivity measured using the substrate with 0.5 mm thickness is 80 % in the light of the range of 200-800 nm wavelength, the optical transmissivity is not less than 1 % in the light of the range of 200-800 nm wavelength even if the thickness is 8.0 mm.

If the thickness of a substrate is not more than 5.0 mm, a thing having the optical transmissivity not less than 5% will be obtained. If the thickness of a substrate is not more than 2.5 mm, a thing having the optical transmissivity not less than 10 % will be obtained.

If the thickness of a substrate is not more than 1.0 mm, a thing having the optical transmissivity not less than 60 % will be obtained.

If the thickness of a substrate becomes thin into not more than 0.2 mm, a thing having the optical transmissivity not less than 90% will be obtained.

If the thickness of a substrate is not more than 0.05 mm, a thing having the optical transmissivity not less than 95% is obtained.

When the optical transmissivity measured using the substrate with 0.5 mm thickness is 1.0 % to the light of the range of 200-800 nm wavelength, what is the optical transmissivity not less than 10 % is obtained if the thickness becomes thin to 0.2 mm.

If the thickness of a substrate is not more than 0.1mm, a thing having the optical transmissivity not less than 20% is obtained.

If the thickness of a substrate is not more than 0.05mm, a thing having the optical transmissivity not less than 40% is obtained.

Thus, in the substrate which comprises a sintered compact which comprises aluminum nitride as a main component and has high optical transmissivity not less than 60 % in the light of the range of 200 nm-800 nm wavelength, it has high optical permeability without being seldom influenced by the thickness of a substrate in case of the thickness not more than 1.0 mm, and in case of the thickness not more than 0.2 mm it becomes the optical transmissivity not less than 90 % which is almost transparent. What has the optical transmissivity near 100% substantially is obtained.

Usually, although the optical transmissivity has an increasing tendency according as the thickness of a substrate becomes thin, the mechanical strength becomes small and there is a defect in which a crack and a chip begin to arise at the time of the work when a single-crystal thin film which comprises as amain component at least one selected from gallium nitride, indium nitride, and aluminum nitride is formed on the substrate, so it is preferred that the thickness of a substrate is not less than 0.01 mm, it is more preferred that it is not less than 0.02 mm, and it is still morepreferred that it is not less than 0.05 mm.

As mentioned above, when the substrate of this invention which comprises a sintered compact which comprises as a main component aluminum nitride is used as a substrate for forming a thin film which comprises as a main component at least one selected from gallium nitride, indium nitride, and aluminum nitride, it is preferred that the thickness of a substrate is not more than 8 mm from the viewpoint of optical permeability, and it is more preferred that it is not more than 5.0 mm (namely, predominance when forming a light-emitting device on the substrate of this invention which comprises a sintered compact which comprises aluminum nitride as a main component).

Moreover, it is still more preferred that the thickness of a substrate is not more than 2.5 mm, and it is most preferred that the thickness of a substrate is not more than 1.0 mm.

In the substrate of such thickness, it is preferred that it is not less than 0.01 mm from the viewpoint of mechanical strength, it is more preferred that it is not less than 0.02 mm, and it is still more preferred that it is not less than 0.05 mm.

A conduction via can be provided to the substrate for thin-film formation which comprises an aluminum nitride-based sintered compact of this invention.

The substrate which comprises a sintered compact which comprises aluminum nitride as a main component and in which a conduction via was provided can be equally used not only for forming a single-crystal thin film but also for forming a thin film of various crystallization states, as a substrate.

A conduction via is usually provided in the inside of a substrate for thin-film formation which comprises a sintered compact which comprises aluminum nitride as a main component.

The conduction via is formed usually in order to connect electrically the surface of up-and-down (namely, the substrate surface of the side in which the thin film of various crystallization states, such as a single-crystal thin film, an amorphous thin film, a polycrystalline thin film, or an orientated polycrystalline thin film, is formed, and the substrate surface of the opposite side of it) of a substrate.

The conduction via can be formed easily by the suitable methods, for example, a through hole (the penetrated hole) is formed in a ceramic powder compact, such as the green sheet which comprises aluminum nitride as a main component, and the conductive powder which comprises a metal, etc. as a main component is beforehand put in there and the co-firing is carried out, or the substrate which comprises a sintered compact which comprises aluminum nitride as a main component which formed a through hole is submerged into a fusion metal and a fusion metal is introduced into the through hole portion, or a conductive paste is introduced into the through hole of a substrate and it heats or fires, etc.

The above conduction via can be formed not only in the inside of a sintered compact which comprises aluminum nitride as a main component but also in the various sintered compacts which comprise as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., and in the other various sintered compacts which comprise a ceramic material as a main component.

Fig. 3 illustrates the situation of the substrate 9 which has the conduction via 3 (the portion shown with the slash) inside and which comprises the sintered compact which comprises aluminum nitride as a main component, the various sintered compacts which comprise as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., and the other various sintered compacts which comprise a ceramic material as a main component. The substrate 9 which has the conduction via 3 can be used as a substrate for thin-film formation. And, on the substrate for thin-film formation, a thin film which comprises as a main component at least one selected from gallium nitride, indium nitride, and aluminum nitride and has at least one of the crystallization states selected from a single crystal, an amorphous state, a polycrystal, and an orientated polycrystal can be formed.

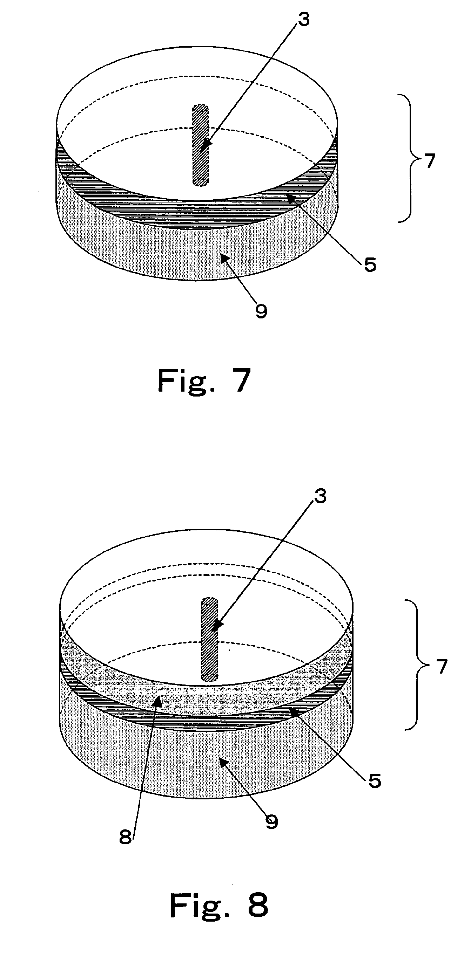

Fig. 7 shows one example of a thin-film substrate, wherein a thin film which comprises as a main component at least one selected from gallium nitride, indium nitride, and aluminum nitride and has at least one of the crystallization states selected from a single crystal, an amorphous state, a polycrystal, and an orientated polycrystal is formed on the substrate 9 which formed the conduction via 3 and which comprises the sintered compact which comprises aluminum nitride as a main component, the various sintered compacts which comprise as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., and the other various sintered compacts which comprise a ceramic material as a main component.

In Fig. 7, the substrate 9 which formed the conduction via 3 and which comprises the sintered compact which comprises aluminum nitride as a main component, the various sintered compacts which comprise as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., and the other various sintered compacts which comprise a ceramic material as a main component is used as a substrate for thin-film formation, the thin film 5 which comprises as a main component at least one selected from gallium nitride, indium nitride, and aluminum nitride and has at least one of the crystallization states selected from a single crystal, an amorphous state, a polycrystal, and an orientated polycrystal is formed on the substrate for thin-film formation, and the thin-film substrate 7 is being constituted by the substrate 9 and the thin film 5.

Although a thin film which comprises as a main component at least one selected from gallium nitride, indium nitride, and aluminum nitride and is various crystallization states, such as a single crystal, an amorphous state, a polycrystal, and an orientated polycrystal, etc., is able to form on the substrate which formed such a conduction via and comprises the sintered compact which comprises aluminum nitride as a main component, the various sintered compacts which comprise as a main component a ceramic material, such as silicon carbide, silicon nitride, gallium nitride, zinc oxide, beryllium oxide, or aluminum oxide, etc., and the other various sintered compacts which comprise a ceramic material as a main component, the above thin film which comprises as a main component at least one selected from gallium nitride, indium nitride, and aluminum nitride and is various crystallization states, such as a single crystal, an amorphous state, a polycrystal, and an orientated polycrystal, etc., is able to be formed also on the conduction via directly.

Although the thin film 5 currently formed on the thin-film substrate which has the conduction via and is illustrated in Fig. 7 can be formed as an epitaxially grown single-crystal thin film, all of the thin film 5 is not a single crystal, it can be formed also as a thin film which has at least one of the crystallization states selected from an amorphous state, a polycrystal, and an orientated polycrystal in addition to this.

And, what is multilayered thin film constitution of two or more layers can also be formed besides a single layer.

That is, the thin film which comprises as a main component at least one selected from gallium nitride, indium nitride, and aluminum nitride and has at least one of the crystallization states selected from a single crystal, an amorphous state, a polycrystal, and an orientated polycrystal is formed, and the thin film of a two-layer constitution in which the epitaxially grown single-crystal thin film which comprises as a main component at least one selected from gallium nitride, indium nitride, and aluminum nitride was formed furthermore on it can be formed.

As for the crystallinity of the single-crystal thin film formed in such constitution, it is preferred since a thing superior to the single-crystal thin film formed directly on the substrate is easy to be obtained.

And, for example, the thin film which comprises as a main component at least one selected from gallium nitride, indium nitride, and aluminum nitride and has at least one of the crystallization states selected from a single crystal, an amorphous state, a polycrystal, and an orientated polycrystal can be formed, and the thin film of a constitution which does not include a single crystal can also be formed.

The thin film 5 can be formed not only as the above constitution but also as the thin film which comprises as a main component at least one selected from gallium nitride, indium nitride, and aluminum nitride and is constituted with two or more layers.

The thin film 5 formed in two or more layers can be formed in the condition of differing respectively in each layer, such as crystallization states, such as an amorphous state, a polycrystal, and an orientated polycrystal including a single crystal, composition, or thickness, and it can be formed in this invention even if it is the thin film constitution in which all the thin film layer of two or more layers is not a single crystal.

All the thin film layer which is being constituted with a two or more-layer thin film layer can form what comprises a single-crystal thin film which comprises as a main component at least one selected from gallium nitride, indium nitride, and aluminum nitride.

When the thin-film substrate of this invention is used for producing various electronic devices and electronic components, such as a light-emitting device, a field emission display, a wiring board, or an optical waveguide, etc., it is usually preferred that it is a single crystal which grew epitaxially as the thin film formed on the thin-film substrate surface.

A thin film which comprises as a main component at least one selected from gallium nitride, indium nitride, and aluminum nitride and has at least one of the crystallization states selected from a single crystal, an amorphous state, a polycrystal, and an orientated polycrystal can be formed further on the thin-film substrate 7 illustrated in Fig. 7. In that case, the thin-film substrate will achieve the facility as a substrate for thin-film formation.

Fig. 8 shows one example of the thin-film substrate which has a conduction via and formed two layers of a thin film. In Fig. 8, as a substrate for thin-film formation, the substrate 9 which formed a conduction via 3 and which comprises the sintered compact which comprises aluminum nitride as a main component, the various sintered compacts which comprise as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., and the other various sintered compacts which comprise a ceramic material as a main component is used, the thin film 5 and thin film 8 which comprise as a main component at least one selected from gallium nitride, indium nitride, and aluminum nitride and have at least one of the crystallization states selected from a single crystal, an amorphous state, a polycrystal, and an orientated polycrystal are formed on the substrate, and the thin-film substrate 7 which has a conduction via is being formed.

The thin film 5 and thin film 8 which are being formed on the thin-film substrate illustrated in Fig. 8 can be formed as an epitaxially grown single-crystal thin film, but a thin film in which all the thin film is not a single crystal and which has at least one of the crystallization states selected from an amorphous state, a polycrystal, and an orientated polycrystal can be formed other than that.

For example, a thin film which comprises as a main component at least one selected from gallium nitride, indium nitride, and aluminum nitride and has various crystallization states, such as a single crystal, an amorphous state, a polycrystal, and an orientated polycrystal, etc., can be formed, and the thin film of a constitution which does not include a single crystal can also be formed.

For example, if a thing which comprises as a main component at least one selected from gallium nitride, indium nitride, and aluminum nitride and has at least one of the crystallization states selected from a single crystal, an amorphous state, a polycrystal, and an orientated polycrystal is formed as a thin film 5, and the epitaxially grown single-crystal thin film which comprises as amain component at least one selected from gallium nitride, indium nitride, and aluminum nitride is formed on it as a thin film 8, the crystallinity of the thin film 8 tends to improve than the crystallinity of the single-crystal thin film formed directly on the substrate 9, and it is preferred.

The thin-film substrate of such thin film constitution is preferred when using it for producing various electronic devices and electronic components, such as a light-emitting device, field emission, a wiring board, or an optical waveguide.

It can also constitute as a thin film of a total of three or more layers which comprises as a main component at least one selected from gallium nitride, indium nitride, and aluminum nitride, by multilayering the thin film 5 and thin film 8 into two or more layers respectively, besides the above constitution.

The thin film 5 and thin film 8 which were formed in two or more layers respectively can be formed in the state in which the crystallization state, such as an amorphous state, a polycrystal, and an orientated polycrystal, including a single crystal, the composition, or the thickness are different in each layer respectively, it can form in this invention, even if it is the constitution of the thin film in which all the thin film layer is not a single crystal and which comprises as a main component at least one selected from gallium nitride, indium nitride, and aluminum nitride.

A thing in which all the thin film layer comprises as a main component at least one selected from gallium nitride, indium nitride, and aluminum nitride and comprises a single-crystal thin film can be formed, even if it is the thin-film substrate in which three or more layers of thin film layers were formed besides the thin-film substrate which is illustrated in Fig. 8 and comprised two layers of thin film layers.

A thin film which comprises as a main component at least one selected from gallium nitride, indium nitride, and aluminum nitride and has at least one of the crystallization states selected from a single crystal, an amorphous state, a polycrystal, and an orientated polycrystal can be formed furthermore on the thin-film substrate 7 illustrated in Fig. 8.

In that case, the thin-film substrate will achieve the facility as a substrate for thin-film formation.

In the thin-film substrate illustrated in Fig. 8, the above thin film 5 which comprises as a main component at least one selected from gallium nitride, indium nitride, and aluminum nitride and has various crystallization states, such as a single crystal, an amorphous state, a polycrystal, and an orientated polycrystal, etc., can form on the conduction via 3 directly.

When the thin-film substrate in which a thin film of two layers or three layers or more was formed and which was illustrated in Fig. 8 is used for producing various electronic devices and electronic components, such as a light-emitting device, a field emission display, a wiring board, or an optical waveguide, etc., it is preferred that the thin film formed in the surface portion of the thin-film substrate is usually a single crystal which grew epitaxially.

According to this invention, the thin-film substrate which has a conduction via is a substrate which formed a thin film which comprises as a main component at least one selected from gallium nitride, indium nitride, and aluminum nitride onto the substrate which has a conduction via and comprises the sintered compact which comprises aluminum nitride as a main component, the various sintered compacts which comprise as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., and the other various sintered compacts which comprise a ceramic material as a main component in addition to these.

As for the thin film formed on the thin-film substrate which has a conduction via according to this invention, a thing which is more excellent in crystallinity of the single-crystal thin film is easy to be obtained if it is made into the constitution, wherein the thin film which comprises as a main component at least one selected from gallium nitride, indium nitride, and aluminum nitride and has at least one of the crystallization states selected from a single crystal, an amorphous state, a polycrystal, and an orientated polycrystal is formed beforehand, and the single-crystal thin film which comprises as a main component at least one selected from gallium nitride, indium nitride, and aluminum nitride is formed furthermore on it if it requires, it is desirable.

Although the form of a substrate which is shown in Fig. 3, Fig. 7, and Fig. 8 and has a conduction via is disc-like, in this invention, the form of the substrate in which the conduction via was formed inside and can use can use what has arbitrary form, such as not only the shape of a disk but a square, a rectangle, or the shape of other polygons.

Although the conduction via of only one piece is shown in Fig. 3, Fig. 7, and Fig. 8, into a substrate, two or more conduction vias can be provided suitably.

For example, as for the size of one piece of a light-emitting device which comprises as the constituent materials a single-crystal thin film which comprises as a main component at least one selected from gallium nitride, indium nitride, and aluminum nitride, since it is about 0.05-10.0 mm, about 2-10000 conduction vias can be provided by considering an edge left for dicing in the disc-like substrate with the diameter of 25.4 mm.

After forming a light-emitting device onto the substrate which has a conduction via, a light-emitting device which has PN electrode arrangement in the up-and-down side of the device can be formed by separating the light-emitting device into one piece respectively from a substrate.

Such a light-emitting device in which the electrode of up-and-down side arrangement is formed differs from the thing in which the PN electrode was formed only in one side of a device in case a sapphire substrate is used, it is not necessary to etch a part of device in order to form the electrodes, there is no fear of the damage of the device which is easy to arise during etching, because a device can be made as it is only by separating from a substrate, and reduction of the manufacture cost of a device can be aimed at, it is desirable.

Moreover, according to this invention, if the substrate which formed a conduction via is used, there is the feature that flexibility of a design also improves because the device in which the PN electrode is attached not only in one side of a device but also in the up-and-down side of a device can be designed.

As for the conductive material used for a conduction via, anything can be used, if the thing is easy to be unified with the sintered compact which comprises aluminum nitride as a main component, the various sintered compacts which comprise as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., and the other various sintered compacts which comprise a ceramic material as a main component in addition to these, and has high junction nature with the thin film which comprises as a main component at least one selected from gallium nitride, indium nitride, and aluminum nitride, and does not generate the faults, such as a crack and exfoliation in the interface with a conduction via when forming the thin film to a conduction via, and has high electrical connectivity with a thin film furthermore if it requires.

Such material comprises as a main component at least one selected from gold, silver, copper, aluminum, iron, cobalt, nickel, ruthenium, rhodium, palladium, osmium, iridium, platinum, tungsten, molybdenum, chromium, titanium, titanium nitride, and zirconium nitride, etc.

As for the conduction via which comprises such material, not only it is easy to be unified with the substrate material which comprises the above sintered compact which comprises aluminum nitride as a main component, various sintered compacts which comprise as a main component a ceramic material which has the crystal structure which can be classified as a hexagonal system such as silicon carbide, silicon nitride, gallium nitride, zinc oxide, and beryllium oxide, etc., and can be classified as a trigonal system or a hexagonal system, such as aluminum oxide, etc., and other various sintered compacts which comprise a ceramic material as a main component, but the junction nature with the thin film formed on a substrate is high, and the thin film which comprises as a main component at least one selected from gallium nitride, indium nitride, and aluminum nitride can be formed directly on the conduction via.

The conduction via which comprises the above material has also high electrical connectivity to the thin film which comprises as a main component at least one selected from gallium nitride, indium nitride, and aluminum nitride.

Usually, as for the single-crystal thin film formed directly on the conduction via which comprises the above material, what is the crystallinity, such that the half width of the rocking curve of the X-ray diffraction line from the lattice plane of a Miller Index (002) is not more than 3600 seconds, is easy to be obtained.

As for what added at least one selected from aluminum nitride, silicon carbide, silicon nitride, gallium nitride, zinc oxide, beryllium oxide, aluminum oxide, a rare-earth compound, and an alkaline-earth-metal compound, etc. to the above main components as the material of a conduction via, not only it is easy to be unified to the substrate materials including an aluminum nitride-based sintered compact but it has still higher junction nature to the thin film which is formed on a substrate, and, a single-crystal thin film which comprises as a main component at least one selected from gallium nitride, indium nitride, and aluminum nitride can be formed directly on the conduction via, and what is the crystallinity, such that the half width of the rocking curve of the X-ray diffraction line from the lattice plane of the Miller Index (002) of the single-crystal thin film is not more than 1000 seconds, is easy to be obtained.

The conduction via which comprises the above material has also high electrical connectivity to the thin film which comprises as a main component at least one selected from gallium nitride, indium nitride, and aluminum nitride.

As for the thing which comprises as a main component at least one selected from molybdenum, tungsten, copper, titanium nitride, and zirconium nitride among the above material of the conduction via, not only it is easy to combine with the materials including an aluminum nitride-based sintered compact of a substrate but a single-crystal thin film which comprises as a main component at least one selected from gallium nitride, indium nitride, and aluminum nitride can be formed onto the conduction via, via the thin film formed on a substrate or directly, and what is the crystallinity, such that the half width of the rocking curve of the X-ray diffraction line from the lattice plane of the Miller Index (002) of the single-crystal thin film is not more than 300 seconds, is easy to be obtained, it is more desirable.

And, as for the thing which comprises as a main component at least one selected from molybdenum, tungsten, copper, titanium nitride, and zirconium nitride and contains furthermore at least one selected from aluminum nitride, aluminum oxide, a rare-earth compound, and an alkaline-earth-metal compound, not only it is easy to combine with the materials including an aluminum nitride-based sintered compact of a substrate but a single-crystal thin film which comprises as amain component at least one selected from gallium nitride, indium nitride, and aluminum nitride can be formed onto the conduction via directly, or through the thin film formed on a substrate, and what is the crystallinity, such that the half width of the rocking curve of the X-ray diffraction line from the lattice plane of the Miller Index (002) of the single-crystal thin film is not more than 240 seconds, is easy to be obtained, it is still more desirable.

As for the content of at least one selected from aluminum nitride, aluminum oxide, a rare-earth compound, and an alkaline-earth-metal compound which are contained in the material which forms a conduction via, it is preferred that it is a total of not more than 30 % by weight, the electric resistivity of the conduction via constituted by the above material becomes not more than 1x10⁻³ Ω·cm at room temperature.

If it is more than 30 % by weight, since the electric resistivity of the conduction via constituted by the above material will tend to become higher than 1x10⁻³ Ω·cm at room temperature, it is not desirable.

More desirable content is not more than 10 % by weight, and since the electric resistivity of the conduction via constituted by the above material tends to become not more than 1x10⁻⁴ Ω·cm at room temperature, it is more preferred.

Furthermore desirable content is not more than 5 % by weight, and since the electric resistivity of the conduction via constituted by the above material tends to become not more than 1x10⁻⁵ Ω·cm at room temperature, it is more preferred.

In addition, the molybdenum and tungsten which are used as a main component of the above conduction via can be used in the state of not only metal but also carbide or nitride.

Thus, among the material of a conduction via, in the thing which comprises as a main component at least one selected from molybdenum, tungsten, copper, titanium nitride, and zirconium nitride, or the thing which comprises as a main component at least one selected from molybdenum, tungsten, copper, titanium nitride, and zirconium nitride and contains furthermore at least one selected from aluminum nitride, aluminum oxide, a rare-earth compound, and a alkaline-earth-metal compound, though the single-crystal thin film which comprises as a main component at least one selected from gallium nitride, indium nitride, and aluminum nitride and which was formed on the conduction via directly or formed on the conduction via through the thin film formed on a substrate has high crystallinity, the reason is not necessarily clear.

This inventor is surmising that it is hard to produce the large strain and stress in the single-crystal thin film which grew epitaxially since the thermal expansion coefficient of the above material which comprises as amain component at least one selected from molybdenum, tungsten, copper, titanium nitride, and zirconium nitride is comparatively small and is probably close to the sintered compact which comprises aluminum nitride as a main component, and is close to the thermal expansion coefficient of the single-crystal thin film which comprises as a main component at least one selected from gallium nitride, indium nitride, and aluminum nitride, or is elasticity comparatively in the case of copper, and surmising that when the thin film which comprises as a main component at least one selected from gallium nitride, indium nitride, and aluminum nitride is formed on the conduction via, the sintered compact which comprises aluminum nitride as a main component will work so that single crystal-ization of the thin film may not be prevented near a conduction via.

In addition, the rare-earth compound used for the above conduction via is a rare earth element, such as Sc, Y, La, Ce, Pr, Nd, Sm, Eu, Gd, Dy, Ho, Er, Yb, and Lu, etc., and a rare earth oxide, such as Sc₂O₃, Y₂O₃, La₂O₃, CeO₂ and Pr₆O₁₁, Nd₂O₃, Sm₂O₃, Eu₂O₃, Gd₂O₃, Dy₂O₃, Ho₂O₃, Er₂O₃, Yb₂O₃, and Lu₂O₃, etc., or in addition to this, it is various rare earth compounds, such as inorganic rare earth compounds, such as carbonate, nitrate, sulfate, and a chloride, and organic rare earth compounds, such as acetate, an oxalate, and citrate, which contains Sc, Y, La, Ce, Pr, Nd, Sm, Eu, Gd, Dy, Ho, Er, Yb, Lu, etc., furthermore it is the complex oxides containing 3Ln₂O₃·5Al₂O₃ of a garnet type crystal structure (for example, 3Y₂O₃·5Al₂O₃, 3D_{y2}O₃·5Al₂O₃, 3Ho₂O₃·5Al₂O₃, 3Er₂O₃·5Al₂O₃, 3Yb₂O₃·5Al₂O₃, etc.), Ln₂O₃·Al₂O₃ of a perovskite type crystal structure (for example, YAlO₃, LaAlO₃, PrAlO₃, NdAlO₃, SmAlO₃, EuAlO₃, GdAlO₃, DyAlO₃, HoAlO₃, ErAlO₃, YbAlO₃, etc.), and monoclinic system crystal structure 2Ln₂O₃·Al₂O₃ (for example, 2Y₂O₃·Al₂O₃, 2Sm₂O₃·Al₂O₃, 2Eu₂O₃·Al₂O₃, 2Gd₂O₃·Al₂O₃, 2Dy₂O₃·Al₂O₃, 2Ho₂O₃· Al₂O₃, 2Er₂O₃·Al₂O₃, 2Yb₂O₃·Al₂O₃, etc.), when a rare earth element is expressed with Ln.

And, as for the alkaline earth metal compounds contained in the above aluminum nitride-based sintered compact, they are an alkaline earth metal, such as Mg, Ca, Sr, and Ba, etc., an alkaline-earth-metal oxide, such as MgO, CaO, SrO, and BaO, etc., or in addition, various alkaline-earth-metal compound, such as an inorganic alkaline-earth-metal compound, such as carbonate, nitrate, sulfate, and chloride, and an organic alkaline earth metal compound, such as acetate, oxalate, and citrate, containing Mg, Ca, Sr, and Ba, etc., and furthermore the complex oxides which include an alkaline earth metal, such as 3AeO·Al₂O₃, AeO·Al₂O₃, AeO₂Al₂O₃, and AeO·6Al₂O₃, etc., when an alkaline-earth-metal element is expressed with Ae.

In this invention, also in each material used for a conduction via other than the thing which comprises as a main component at least one selected from the above molybdenum, tungsten, copper, titanium nitride, and zirconium nitride and contains furthermore at least one selected from aluminum nitride, aluminum oxide, a rare-earth compound, and an alkaline earth metal compound, it is preferred that the electric resistivity is not more than 1x10⁻³ Ω·cm at room temperature as the conductivity, it is more preferred that the electric resistivity is not more than 1x10⁻⁴ Ω·cm at room temperature, it is still more preferred that the electric resistivity is not more than 1x10⁻⁵ Ω·cm.

In this invention, if the substrate in which the above conduction via is formed is the sintered compact which comprises aluminum nitride as a main component, it may be what contains at least one among sintering aids, agents for lowering the firing temperature, blackening agents, unescapable impurities, and ALON, etc., it may be what contains AlN not less than 95 % as a crystal phase by carrying out the high purification, or what contains AlN not less than 98 %, or what comprises an AlN single phase substantially, and any sintered compact which comprises aluminum nitride as a main component can be used.

As for the material of a conduction via formed in the sintered compact which comprises aluminum nitride as a main component, if it is used the thing which comprises as a main component at least one selected from molybdenum, tungsten, copper, titanium nitride, and zirconium nitrides, or the thing which comprises as a main component at least one selected from molybdenum, tungsten, copper, titanium nitride, and zirconium nitride and contains furthermore at least one selected from aluminum nitride, aluminum oxide, a rare-earth compound, and an alkaline-earth-metal compound, since it hardly vaporizes also during the high temperature and prolonged heat treatment performed in order to carry out high purification of the sintered compact which comprises aluminum nitride as a main component and to raise the optical permeability, manufacture of the substrate which has a conduction via is attained easily, an excellent substrate which has high thermal conductivity and optical permeability and can connect the up-and-down side of a substrate and whose thermal expansion coefficient is close to the single-crystal thin film comprising at least one selected from gallium nitride, indium nitride, and aluminum nitride as a main component, can be provided in low cost, the influence which gives to the industrial world is still larger.

In this invention, the size and form of a conduction via can be selected suitably, what is necessary is to be able to form a thin film which comprises as a main component gallium nitride, indium nitride, and aluminum nitride directly and just to be able to form a single-crystal thin film if needed, even if it is the thing of what kind of size.

And, any form can also be select, what is necessary is to be able to form a thin film which comprises as a main component gallium nitride, indium nitride, and aluminum nitride directly and just to be able to form a single-crystal thin film if needed.

Usually, a single-crystal thin film which comprises as a main component at least one selected from gallium nitride, indium nitride, and aluminum nitride can be formed to this conduction via directly, even if the size of a conduction via is larger than 250 µm.

That is, as for the single-crystal thin film which comprises as a main component at least one selected from gallium nitride, indium nitride, and aluminum nitride and which is formed directly on the conduction via, what is the crystallinity, such that the half width of the rocking curve of the X-ray diffraction line from the lattice plane of a Miller Index (002) of the crystal thin film is not more than 3600 seconds, is easy to be obtained, even when the size of a conduction via is larger than 250 µm.

For example, as for the single-crystal thin film which comprises as a main component at least one selected from gallium nitride, indium nitride, and aluminum nitride and which is formed directly on the conduction via, what is the crystallinity, such that the half width of the rocking curve of the X-ray diffraction line from the lattice plane of a Miller Index (002) of the crystal thin film is not more than 3600 seconds, can be obtained, even if the size of a conduction via is comparatively large, such as 500 µm.

As for the size of a conduction via, it is usually preferred that it is not more than 250 µm.

If the size of a conduction via is not more than 250 µm, a thing excellent in crystallinity, such that the half width of the rocking curve of the X-ray diffraction line from the lattice plane of the Miller Index (002) of the single-crystal thin film which comprises as a main component at least one selected from gallium nitride, indium nitride, and aluminum nitride and was formed directly on the conduction via is not more than 300 seconds, will be easy to be obtained.

The preferable size of a conduction via is not more than 100 µm.

If the size of a conduction via is not more than 100 µm, a thing more excellent in crystallinity, such that the half width of the rocking curve of the X-ray diffraction line from the lattice plane of the Miller Index (002) of the single-crystal thin film which comprises as a main component at least one selected from gallium nitride, indium nitride, and aluminum nitride and was formed directly on the conduction via is not more than 240 seconds, will be easy to be obtained.

It is still more preferred that it is not more than 50 µm.

If the size of a conduction via is not more than 50 µm, a thing more excellent in crystallinity, such that the half width of the rocking curve of the X-ray diffraction line from the lattice plane of the Miller Index (002) of the single-crystal thin film which comprises as a main component at least one selected from gallium nitride, indium nitride, and aluminum nitride and was formed directly on the conduction via is not more than 200 seconds, will be easy to be obtained.

It is still more preferred that it is not more than 25 µm.

If the size of a conduction via is not more than 25 µm, a thing more excellent in crystallinity, such that the half width of the rocking curve of the X-ray diffraction line from the lattice plane of the Miller Index (002) of the single-crystal thin film which comprises as a main component at least one selected from gallium nitride, indium nitride, and aluminum nitride and was formed directly on the conduction via is not more than 150 seconds, will be easy to be obtained.

As for the reason in which it is easy to produce a difference in the crystallinity of a single-crystal thin film which comprises as a main component at least one selected from gallium nitride, indium nitride, and aluminum nitride and is formed on a substrate according to the size of a conduction via, it is surmised that it is easy to produce a difference in the degree which makes the nuclear growth direction regular at the time of growth of the single-crystal thin film which comprises as a main component at least one selected from gallium nitride, indium nitride, and aluminum nitride, according to the size, since the conduction via comprises a material which differs from aluminum nitride which is the main components of a substrate.

In addition, in this invention, the size of a conduction via is indicated with the upper limit of a section.

That is, when a section is the form of a circle with the diameter of 200 µm, the size of a conduction via is 200 µm as it is, and in the case of one-side 150 µm square, the size of a conduction via is 212 µm.

Although a conduction via can use an arbitrary section form, it is preferably that a section uses a circular thing from the viewpoint of processability, a single-crystal thin film which comprises as a main component at least one selected from gallium nitride, indium nitride, and aluminum nitride can be formed, if it is such form.

In order to form a conduction via, a laser processing method by carbon dioxide gas laser, YAG laser or an excimer laser, etc., for example, is preferred as a fine drilling processing method, in addition to the punching method which used the needle and is usually carried out as a method of forming a through hole in the ceramic powder compact, such as a green sheet which comprises aluminum nitride as a main component, as mentioned above.

The above laser processing method is suitable also for the punch to the sintered compact after firing.

The conduction via not more than 50 µm and to about 1 µm can be formed by using the laser processing method.

As the size of the conduction via formed in the sintered compact which comprises aluminum nitride as a main component and is obtained by firing a green sheet becomes still smaller than 50 µm and it becomes to near 1 µm, a thing excellent in crystallinity, such that the half width of the rocking curve of the X-ray diffraction line from the lattice plane of the Miller Index (002) of the single-crystal thin film which comprises as a main component at least one selected from gallium nitride, indium nitride, and aluminum nitride and was formed directly on the conduction via is not more than 150 seconds which are considered that the sintered compact which comprises aluminum nitride as a main component originally has, will be easy to be obtained, it is desirable especially.

And, in this invention, as for various forms, such as a thing in which the conductive material was densely filled up in the through hole or a thing in which the conductive material was formed on the side wall of a through hole, they can be used as the form of a conduction via.

Among these cases, a form of so-called "filled via" wherein the conductive material was formed in dense condition in the through hole is preferred, there is an advantage in which the single-crystal thin film which comprises as a main component at least one selected from gallium nitride, indium nitride, and aluminum nitride can be formed easily.

Since the surface and back of the substrate for thin-film formation which comprises a sintered compact which comprises aluminum nitride as a main component and is an insulating material electrically originally are connectable electrically by providing a conduction via, the electrode of the device can be provided to an up-and-down side.

The electrode of a light-emitting device is provided only in the surface which is only the side of a light-emitting device formed on the substrate in the case wherein a conduction via is not provided, but if a conduction via is formed, the flexibility in the case of mounting a light-emitting device increases, and it becomes advantageous.

This inventor has investigated about the formation of a thin film comprising as a main component at least one selected from gallium nitride, indium nitride and aluminum nitride, using an aluminum nitride-based sintered compact, on which a thin film comprising a material having electric conductivity is formed.

The above "thin film comprising a material having electric conductivity" is usually various metals, alloys, metal nitrides, metal carbides, and metal silicides, etc.

As the result, in the aluminum nitride-based sintered compact forming the above thin film-conductive material comprising as a main component various metals, alloys, metal nitrides, metal carbides, and metal silicides, etc., it became clear that it can be used as a substrate for a thin film like the aluminum nitride-based sintered compact on which the thin film-conductive material is not formed.

As for such thin film-conductive material, anything can be used, if the junction nature with an aluminum nitride-based sintered compact is highly, and the junction nature with a thin film comprising as a main component at least one or more components selected from a gallium nitride, an indium nitride and an aluminum nitride is highly, furthermore if it has high electrical connectivity or has high reflectance of light, if needed.

For example, the thin film-conductive material is a material comprising as a main component at least one selected from gold, silver, copper, aluminum, iron, cobalt, nickel, ruthenium, rhodium, palladium, osmium, iridium, platinum, tantalum, molybdenum, tungsten, chromium, titanium, nickel-chromium alloy, titanium nitride, zirconium nitride, and tantalum nitride, etc.

Using the conductive material comprising as a main component at least one selected from gold, silver, copper, aluminum, iron, cobalt, nickel, ruthenium, rhodium, palladium, osmium, iridium, platinum, tantalum, molybdenum, tungsten, chromium, titanium, nickel chromium alloy, titanium nitride, zirconium nitride, and tantalum nitride, etc., the thin film-conductive material may be formed sufficiently by the conventional methods for forming a thin film, such as the sputtering method, the ion-plating method, the vapor-depositing method, the MOCVD (Metal Organic Chemical Vapor Deposition) method, the MOVPE (Metal Organic Vapor Phase Epitaxy) method, the Hydride VPE (Hydride Vapor Phase Epitaxy) method, the Halide VPE (Halogen Transport Vapor Phase Epitaxy) method, such as the Chloride VPE (Chloride Vapor Phase Epitaxy) method etc., the Plasma CVD method, the other CVD (Chemical Vapor Deposition) methods, the MBE (Molecular Beam Epitaxy) method, the laser ablation method using such as excimer laser, and the PLD (Pulsed-Laser Deposition) method etc., and the thin film comprising as a main component at least one selected from gallium nitride, indium nitride and aluminum nitride may be formed on the thin film-conductive material.

Usually, the above thin film-conductive material is formed on the surface of an aluminum nitride-based sintered compact.

A thin film which comprises as a main component at least one selected from gallium nitride, indium nitride, and aluminum nitride and which is various crystallization states, such as a single crystal, an amorphous state, a polycrystal, and an orientated polycrystal can be formed on the sintered compact which comprises aluminum nitride as a main component and which formed the above thin film-conductive material by selecting the thin film formation conditions suitably.

In addition, as the conditions for carrying out the sputtering method, using as the target material the above conductive material comprising as a main component at least one selected from gold, silver, copper, aluminum, iron, cobalt, nickel, ruthenium, rhodium, palladium, osmium, iridium, platinum, tantalum, molybdenum, tungsten, chromium, titanium, nickel chromium alloy, titanium nitride, zirconium nitride, and tantalum nitride, etc., for example, the film formation may be carried out under the condition, wherein the substrate temperature is suitably room temperature-300°C or more, atmosphere is decompression (flowing Ar gas rate; 10-200 cc/min., pressure; 0.2-2.0 Pa), applying power is 0.3-3 kW direct current or high frequency. As the frequency of the high frequency electric power, 2.45 GHz microwave or 13:56 MHz radiofrequency wave is usually used.

When the thin film-conductive material is a metallic compound, such as titanium nitride, zirconium nitride, and tantalum nitride, reactant gas, such as N₂ gas and NH₃ gas, is suitably used alone as a controlled atmosphere, for example, or it is also effective to use in addition to carrier gas, such as Ar gas and H₂ gas, and to form the thin film-conductive material by reactive sputtering.

As the conditions for carrying out the ion-plating method, using as a raw material the above conductive material comprising as a main component at least one selected from gold, silver, copper, aluminum, iron, cobalt, nickel, ruthenium, rhodium, palladium, osmium, iridium, platinum, tantalum, molybdenum, tungsten, chromium, titanium, and nickel chromium alloy, etc., for example, the film formation may be carried out under the condition, wherein the substrate temperature is suitably room temperature-300°C or more, the vacuum degree in the thin film formation chamber is 2x10⁻³ Pa or less, ionizing voltage is 10-200 V, and the applied voltage to the substrate is 300-5000 V. Or it can also carry out, using high frequency as applied electric power. As for the frequency of high frequency (RF) electric power, 2.45 GHz microwave or a 13.56 MHz radiofrequency wave, etc. is usually used.

When the thin film-conductive material is a metallic compound, such as titanium nitride, zirconium nitride, and tantalum nitride, etc., reactant gas, such as N₂ gas and NH₃ gas, is suitably used alone, for example, or it is also effective to use in addition to carrier gas, such as Ar gas and H₂ gas, and to form the thin film-conductive material by reactive Ion-plating method using metal, such as titanium, zirconium, and tantalum for the raw material.

As the conditions for carrying out the vapor-depositing method, using as a raw material the above conductive material comprising as a main component at least one selected from gold, silver, copper, aluminum, iron, cobalt, nickel, ruthenium, rhodium, palladium, osmium, iridium, platinum, tantalum, molybdenum, tungsten, chromium, titanium, and nickel chromium alloy, etc., for example, the film formation may be carried out under the condition, wherein the substrate temperature is suitably room temperature - 300°C or more, the vacuum degree in the thin film formation chamber is 2x10⁻³ Pa or less.

The above sputtering method, ion-plating method, or vapor-depositing method are used not only for forming a thin film-conductive material but also for the method of forming a thin film which comprises as a main component at least one selected from gallium nitride, indium nitride, and aluminum nitride and is various crystallization states, such as a single crystal, an amorphous state, a polycrystal, and an orientated polycrystal, etc., and a thin film which comprises as a main component at least one selected from gallium nitride, indium nitride, and aluminum nitride and is various crystallization states, such as a single crystal, an amorphous state, a polycrystal, and an orientated polycrystal, etc., and which contains doping components, such as Si, Ge, Se, Te, O, Mg, Be, Ca, Zn, Cd, and C, etc., like MOCVD method, Chloride VPE method, Halide VPE method, Hydride VPE method, or MBE method.

When performing these thin films formation, in the sputtering method, a thin film which comprises as a main component gallium nitride, indium nitride, and aluminum nitride and which is the target composition is obtained using the target material which comprises as a main component gallium nitride, indium nitride, and aluminum nitride, or a thin film which comprises as a main component gallium nitride, indium nitride, and aluminum nitride and which is the target composition is obtained by using metal gallium, metal indium, and metal aluminum as a target material, and by making it react with the above N₂ gas, NH₃ gas, etc.

In the ion-plating method and vapor-depositing method, a thin film which comprises as a main component gallium nitride, indium nitride, and aluminum nitride and which is the target composition can be obtained using metal gallium, metal indium, metal aluminum, gallium nitride, indium nitride, and aluminum nitride, etc. as the raw material for evaporation, by reacting or not reacting with the above N₂ gas and NH₃ gas, etc.

Cracks are not seen in the thin film comprising as a main component at least one selected from gallium nitride, indium nitride and aluminum nitride and being formed on the aluminum nitride-based sintered compact having a thin film-conductive material, and faults, such as exfoliation, are hard to be seen between the thin film-conductive material and the thin film comprising as a main component at least one selected from gallium nitride, indium nitride and aluminum nitride.

When the above thin film-conductive material is formed on the aluminum nitride-based sintered compact and the single-crystal thin film comprising as a main component at least one selected from gallium nitride, indium nitride and aluminum nitride is formed furthermore on it, what is the crystallinity, such that the half width of the rocking curve of the X-ray diffraction line from the lattice plane of the Miller Index (002) of the single-crystal thin film is not more than 3600 seconds, is easy to be obtained.

As for the junction nature between the thin film-conductive material and the thin film comprising as a main component at least one selected from gallium nitride, indium nitride and aluminum nitride, it is also high, what is not less than 2 Kg/mm² is easy to be obtained as perpendicular tensile strength.

Exfoliation is not seen between the thin film-conductive material and the thin film comprising as a main component at least one selected from gallium nitride, indium nitride and aluminum nitride, even if the test of tearing off is carried out pasting up the pressure sensitive adhesive tape onto the thin film comprising as a main component at least one selected from gallium nitride, indium nitride and aluminum nitride and being formed on the aluminum nitride-based sintered compact having the above thin film-conductive material.

The above junction nature can be similarly obtained, even if the thin film comprising as a main component at least one selected from gallium nitride, indium nitride and aluminum nitride has what kind of crystallization states, such as a single crystal, an amorphous state, a polycrystal, and an orientated polycrystal.

Thus, the thin film-conductive material of this invention has high junction nature to the thin film comprising as a main component at least one selected from gallium nitride, indium nitride and aluminum nitride, it seems that the thin film-conductive material of this invention has at least equivalent junction nature to the aluminum nitride-based sintered compact as well as the thin film, from the view point of the result of the above junction nature evaluation, like the perpendicular tension strength is not less than 2 Kg/mm².

Usually, using the above thin film-conductive material in which the thickness is not more than 20 µm is preferred, in order to raise the quality of the thin film comprising as a main component at least one selected from gallium nitride, indium nitride and aluminum nitride and being formed on it and to raise the junction nature with the thin film.

When the thickness of the above thin film-conductive material is not more than 20 µm, as for the single-crystal thin film comprising as a main component at least one selected from gallium nitride, indium nitride and aluminum nitride and being formed on the thin film-conductive material, what has the crystallinity, such that the half width of the rocking curve of the X-ray diffraction line from the lattice plane of a Miller Index (002) of the single-crystal thin film is not more than 300 seconds, is easy to be obtained, and even if the thin film has the crystallization state which is not necessarily the single crystal, such as an amorphous state and a polycrystal, what is the perpendicular tensile strength not less than 2 Kg/mm² is easy to be obtained as a junction nature to the thin film.

And, as for the single-crystal thin film which comprises as a main component at least one selected from gallium nitride, indium nitride, and aluminum nitride and is formed on the thin film-conductive material, if the thickness of the above thin film-conductive material is not more than 5 µm, what is the crystallinity, such that the half width of the rocking curve of the X-ray diffraction line from the lattice plane of a Miller Index (002) of the single-crystal thin film is not more than 240 seconds, is easy to be obtained, and even if the thin film is the crystallization states which are not necessarily the single crystal, such as an amorphous state and a polycrystal, since what is the perpendicular tensile strength not less than 2 Kg/mm² is easy to be obtained as a junction nature to the thin film, it is more desirable.

As for the single-crystal thin film which comprises as a main component at least one selected from gallium nitride, indium nitride, and aluminum nitride and is formed on the thin film-conductive material, if the thickness of the above thin film-conductive material is not more than 1 µm, what is the crystallinity, such that the half width of the rocking curve of the X-ray diffraction line from the lattice plane of a Miller Index (002) of the single-crystal thin film is not more than 200 seconds, is easy to be obtained, and even if the thin film is the crystallization states which are not necessarily the single crystal, such as an amorphous state and a polycrystal, since what is the perpendicular tensile strength not less than 2 Kg/mm² is easy to be obtained as a junction nature to the thin film, it is more desirable.

As the above result, it was confirmed that the thin-film substrate in which a thin film which comprises as a main component at least one selected from gallium nitride, indium nitride, and aluminum nitride was formed on the sintered compact which comprises aluminum nitride as a main component and formed the thin film-conductive material can be manufactured.

Moreover, a thin film which comprises as a main component at least one selected from gallium nitride, indium nitride, and aluminum nitride and has at least one of the crystallization states selected from a single crystal, an amorphous state, a polycrystal, and an orientated polycrystal can be formed furthermore on the substrate which formed the above thin film-conductive material and which comprises the various sintered compacts which comprise as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., and other various sintered compacts which comprise a ceramic material as a main component. The thin film can be formed not only as a single layer but also as a thin film layer of two or more layers from which the crystallization state and composition, etc. differ.

In the substrate which comprises a sintered compact in which a thin film-conductive material is being formed and which comprises aluminum nitride as a main component, an epitaxially grown single-crystal thin film which comprises as a main component at least one selected from gallium nitride, indium nitride, and aluminum nitride can be formed, in addition, a thin film in which all is not a single crystal and which has at least one of the crystallization states selected from an amorphous state, a polycrystal, and an orientated polycrystal can also be formed.

Not only a single layer but also a multilayered thin film constitution of two or more layers can be formed.

That is, a thin film which comprises as a main component at least one selected from gallium nitride, indium nitride, and aluminum nitride and which comprises at least one of the crystallization states selected from a single crystal, an amorphous state, a polycrystal, and an orientated polycrystal is formed beforehand, and a thin film of two layers constitution in which the epitaxially grown single-crystal thin film which comprises as a main component at least one selected from gallium nitride, indium nitride, and aluminum nitride was formed on it can be formed.

As for the crystallinity of the single-crystal thin film formed in such constitution, that which is superior to the single-crystal thin film formed directly on the substrate which comprises a sintered compact which comprises aluminum nitride as a main component and formed the thin film-conductive material is easy to be obtained, it is preferred.

And, for example, a thin film which comprises as a main component at least one selected from gallium nitride, indium nitride, and aluminum nitride and has at least one of the crystallization states selected from a single crystal, an amorphous state, a polycrystal, and an orientated polycrystal is formed, and a thin film of two layers constitution in which the thin film which comprises at least one of the crystallization states selected from an amorphous state, a polycrystal, and an orientated polycrystal and which does not contain a single crystal was formed can also be formed on it.

The thin film formed in two or more layers can be formed in the state wherein the crystallization states, such as including a single crystal, an amorphous state, a polycrystal, and an orientated polycrystal, composition, or thickness is different respectively, and it can be formed in this invention even if all the thin film layer of two or more layers is the thin film constitution which is not a single crystal.

All the thin film layer which is being constituted with the thin film layer of two or more layers can form what comprises a single-crystal thin film which comprises as a main component at least one selected from gallium nitride, indium nitride, and aluminum nitride.

As at least one layer among the thin film constituted with two or more layers, and if it requires, as the thin film layer of the top layer, it is preferred that it is a single crystal.

Especially, when the thin-film substrate in which a thin film comprising as a main component at least one selected from gallium nitride, indium nitride and aluminum nitride was formed on the substrate of this invention forming beforehand a thin film-conductive material is used for production of various electronic devices and electronic components, etc., such as a light-emitting device, a field emission display, a wiring board, or an optical waveguide, etc., it is preferred that the thin film formed on the surface portion of the substrate is usually a single crystal which grew epitaxially.

In this invention, the above thin film-conductive material can be formed also on the thin-film substrate in which a thin film comprising as a main component at least one selected from gallium nitride, indium nitride and aluminum nitride was formed on the aluminum nitride-based sintered compact.

That is, the above thin film-conductive material may be formed on the thin film comprising as a main component at least one selected from gallium nitride, indium nitride and aluminum nitride and being formed beforehand on the aluminum nitride-based sintered compact, and it has sufficient junction nature.

A crack is not seen in the thin film comprising as a main component at least one selected from gallium nitride, indium nitride and aluminum nitride and forming the above thin film-conductive material, and faults, such as exfoliation, are hard to be seen between the above thin film-conductive material and the thin film comprising as a main component at least one selected from gallium nitride, indium nitride and aluminum nitride.

And, what is the junction strength not less than 2 Kg/mm² by the perpendicular tensile test is easy to be obtained.

As the reason which such good junction nature is obtained, this inventor is surmising that it is because there is a big factor, wherein the internal stress by the lattice mismatching, or the difference of thermal expansion coefficient, etc. is little because the thin film which comprises as a main component at least one selected from gallium nitride, indium nitride, and aluminum nitride is being formed on the sintered compact which comprises aluminum nitride as a main component, furthermore, distortion and tensile stress which are produced at the time of forming a thin film-conductive material are easy to be produced numerously not in the thin film which is a brittle material but in the thin film-conductive material which is comparatively soft or has a larger thermal expansion - coefficient, or are easy to be produced only in a thin film-conductive material.

In addition, the above junction nature can be similarly acquired, even if the thin film comprising as a main component at least one selected from gallium nitride, indium nitride and aluminum nitride is what kind of crystallization states, such as a single crystal, an amorphous state, a polycrystal, and an orientated polycrystal.

When a material which can be soldered like gold or copper is formed, among the above thin film-conductive materials, what is the perpendicular tensile strength not less than 4 Kg/mm² will be easy to be obtained if the junction strength is measured using solder.

This shows that the junction nature not only between the thin film-conductive material of this invention and the thin film comprising as a main component at least one selected from gallium nitride, indium nitride and aluminum nitride but also between the aluminum nitride-based sintered compact and the thin film-conductive material is high, and the junction nature between the aluminum nitride-based sintered compact and the thin film comprising as a main component at least one selected from gallium nitride, indium nitride and aluminum nitride is originally high.

The above thin film-conductive material of this invention may be provided not only on the surface of a thin film comprising as a main component at least one selected from gallium nitride, indium nitride and aluminum nitride but also in the inside of the thin film.

If a thin film-conductive material is provided to the thin film which comprises as a main component at least one selected from gallium nitride, indium nitride and aluminum nitride and is being formed beforehand on the aluminum nitride-based sintered compact, and a thin film-conductive material is formed in the inside of the thin film comprising as a main component at least one selected from gallium nitride, indium nitride and aluminum nitride by covering furthermore with the thin film comprising as a main component at least one selected from gallium nitride, indium nitride and aluminum nitride, it is hard to produce faults, such as an exfoliation in the junction interface between the thin film-conductive material and the thin film comprising as a main component at least one selected from gallium nitride, indium nitride and aluminum nitride, and a crack in the inside of a thin film comprising as a main component at least one selected from gallium nitride, indium nitride and aluminum nitride, etc.

Moreover, this invention is a substrate for forming a thin film which comprises as a main component at least one selected from gallium nitride, indium nitride, and aluminum nitride, and the substrate includes a substrate for thin-film formation which comprises a sintered compact which comprises aluminum nitride as a main component and which formed a thin film-conductive material.

And, this invention is a thin-film substrate in which a thin film which comprises as a main component at least one selected from gallium nitride, indium nitride, and aluminum nitride was formed on the sintered compact which comprises aluminum nitride as a main component, and the thin-film substrate in which a thin film-conductive material is being formed is included furthermore.

Thus, in this invention, various substrate for thin-film formation and a thin-film substrate can be provided, as below,
1) a substrate for thin-film formation which formed a thin film-conductive material onto the sintered compact which comprises aluminum nitride as a main component,
2) a thin-film substrate in which a thin film which comprises as a main component at least one selected from gallium nitride, indium nitride, and aluminum nitride was formed on the sintered compact which comprises aluminum nitride as a main component and which formed beforehand a thin film-conductive material,
3) a thin-film substrate which formed furthermore a thin film-conductive material on the thin film which comprises as a main component at least one selected from gallium nitride, indium nitride, and aluminum nitride and was formed on the sintered compact which comprises aluminum nitride as a main component,
4) a thin-film substrate which formed furthermore a film-conductive material on the thin film which comprises as a main component at least one selected from gallium nitride, indium nitride, and aluminum nitride and is being formed on the sintered compact which comprises aluminum nitride as a main component and which formed beforehand the thin film-conductive material, etc.

In each thin-film substrate of the above 2), 3), and 4), a thin-film substrate in which a thin film-conductive material was formed in the inside of the thin film which is being formed and comprises as a main component at least one selected from gallium nitride, indium nitride, and aluminum nitride can also be provided.

As for the effect using a substrate for thin-film formation and a thin-film substrate, wherein the above thin film-conductive material was formed on the aluminum nitride-based sintered compact of this invention, the substrate for thin-film formation and the thin-film substrate can be used not only as a substrate for forming a thin film which comprises as a main component at least one selected from gallium nitride, indium nitride, and aluminum nitride but also, for example, as a substrate in which a electrical circuit facility was added in order to drive electrically a light-emitting device formed on the substrate for thin-film formation and the thin-film substrate, wherein the thin film-conductive material was formed by processing the above thin film-conductive material into the shape of a circuit pattern.

Furthermore, if using a substrate for thin-film formation and a thin-film substrate, wherein the above thin film-conductive material was formed on the sintered compact which comprises aluminum nitride as a main component and has a conduction via, an effect in which the electric connection nature to the up-and-down side of a substrate improves will be acquired compared with the case where the sintered compact in which the thin film-conductive material is not formed and which comprises aluminum nitride as a main component and has a conduction via is used.

That is, if a thin film which comprises as a main component at least one selected from gallium nitride, indium nitride, and aluminum nitride has electrical conductivity, the thin film which has conductivity and the substrate surface opposite to the side in which the thin film is being formed are electrically connectable via a conduction via.

Since the above thin film-conductive material can be used as a reflective material of the light emitted from the light-emitting device when a light-emitting device is formed on the substrate for a thin film or the thin-film substrate, wherein the above thin film-conductive material of this invention was provided, there are effects wherein the light emitted from the light-emitting device becomes possible to be focused efficiently, or to be emitted to the specific direction.

That is, when you want to emit the light emitted from the luminescence layer of a light-emitting device into the outside of a device not from the side of the substrate which comprises a sintered compact which comprises aluminum nitride as a main component but from the direction of the opposite side, or focus it into the specific direction of the opposite side, it can realize comparatively easily by forming the above thin film-conductive material in the substrate as a reflective material.

As for things which are desired to control the light from a light-emitting device into the specific direction, they are the surface emission-type laser diode (LD), and the light-emitting diode (LED) used for a flat panel display, etc., for example.

When the substrate which comprises a sintered compact which comprises aluminum nitride as a main component and does not form the above thin film-conductive material is used, since the reflectance of the sintered compact which comprises aluminum nitride as a main component is usually as low as not more than 15 % to the light with a wavelength of at least 200 nm or longer than 200 nm, it becomes difficult to carry out efficiently the control of direction and the control of condensing about the light from the light-emitting device, in many cases, even if the sintered compact which comprises aluminum nitride as a main component and has low optical permeability is used as a substrate in order to prevent the light transmission from the substrate side.

Even if it is the light-emitting device produced using the substrate which formed the above thin film-conductive material as a reflective material, it is rare that the luminous efficiency lowers greatly compared with the case where conventional substrates, such as sapphire, etc., are used, the light-emitting device which has equivalent luminous efficiency at least can be provided.

What has the luminous efficiency at least not less than 8 % is usually producible, if it is the light-emitting device produced using the substrate in which the above thin film-conductive material is provided as a reflective material.

Among such thin film-conductive materials, for example, what has low resistance in which the electric resistivity is not more than 1x10⁻³ Ω·cm at room temperature is preferred to use as a conductor for electrical circuit.

What has high electric resistivity not less than 1x10³ Ω·cm is preferred to use as a resistor for electrical circuit.

When the above thin film-conductive material is used as a reflective material by forming it in a substrate for light-emitting device production which comprises a sintered compact which comprises aluminum nitride as a main component, it is usually formed on the surface of a substrate.

When the thin film-conductive material is used as a reflective material, it is preferred to use that in which the reflectance to the light from a light-emitting device is not less than 15 %.

It is more preferred to use the material in which the reflectance to the light from a light-emitting device is not less than 50 %.

It is still more preferred to use a material in which the reflectance to the light from a light-emitting device is not less than 70 %.

It is most preferred to use a material in which the reflectance to the light from a light-emitting device is not less than 80 %.

The reflectance to the above light from the light-emitting device is a reflectance to the light of the range of 200-800 nm wavelength at least.

The reflectance to the light of the range of 200-800 nm wavelength means the reflectance measured by the light of the specific wavelength of the range of 200-800 nm wavelength.

In this invention, unless reference is made especially, usually the reflectance to the light with a wavelength of 605 nm was used.

The above thin film-conductive material can use what was formed to the aluminum nitride-based sintered compact, as a metallizing of single layer structure using only the single material selected from gold, silver, copper, aluminum, iron, cobalt, nickel, ruthenium, rhodium, palladium, osmium, iridium, platinum, tantalum, molybdenum, tungsten, chromium, titanium, nickel chromium alloy, titanium nitride, zirconium nitride, and tantalum nitride, etc.

The thin film-conductive material can use also a multilayered structure, such as chromium/copper, titanium/molybdenum/gold, titanium/tungsten/nickel, titanium/tungsten/gold, titanium/platinum/gold, titanium/nickel/gold, zirconium/tungsten/gold, and zirconium/platinum/gold, etc., for example, wherein chromium, titanium, zirconium, titanium nitride, and zirconium nitride, etc., is an adhesion material to the aluminum nitride-based sintered compact; iron, cobalt, nickel, rhodium, palladium, osmium, iridium, platinum, molybdenum, tungsten, titanium nitride, and zirconium nitride, etc., is a barrier material; gold, silver, copper, and aluminum, etc., is a low resistance material and is suitably formed in the top side.

Among the above thin film-conductive materials, as for the thing Which has single layer structure or multilayered structure which use low resistance materials, such as gold, silver, copper, and aluminum, etc., as a main component, it is preferred to use as a conductor for electrical circuit.

As for the material with high electric resistivity, such as tantalum nitride and nickel chromium alloy, etc., it is preferred to use as a resistor for electrical circuit.

As the above tantalum nitride, Ta, a compound of Ta and N (for example, TaN, Ta2N, etc.), and a thin film of an amorphous Ta-N composition system, etc. can be used.

In addition, when the thin film-conductive material is used as a reflective material, it can use the metal or alloy which comprise as a main component one or more components from beryllium (Be), magnesium (Mg), scandium (Sc), yttrium (Y), a rare earth metal, titanium (Ti), zirconium (Zr), hafnium (Hf), Vanadium (V), niobium (Nb), tantalum (Ta), chromium (Cr), Molybdenum (Mo), tungsten (W), manganese (Mn), rhenium (Re), Iron (Fe), cobalt (Co), nickel (Ni), ruthenium (Ru), Rhodium (Rh), palladium (Pd), osmium (Os), iridium (Ir), Platinum (Pt), copper (Cu), silver (Ag), gold (Au), zinc (Zn), boron (B), aluminum (Al), gallium (Ga), indium (In), silicon (Si), germanium (Ge), tin (Sn), lead (Pb), antimony (Sb), and bismuth (Bi), etc., for example.

As for the alloy, the reflectance of these metals or alloys is usually not less than 15 % to the light with a wavelength of 605 nm, and it can be enough used as a reflective material by being formed on the surface of a substrate.

And, among the above-illustrated materials, it is preferred to use the metal or alloy which comprise as a main component one or more components selected from Cu, Ag, Au, Al, Mg, Zn, Mo, W, Mn, Fe, Co, Ni, Rh, Pd, Os, Ir, and Pt, because it is easy to obtain a thing in which the reflectance to the light with a wavelength of 605 nm is as high as not less than 50 %, and loss is small.

And, among the above metal materials or alloy materials, since it is easy to obtain a thing in which the reflectance to the light with a wavelength of 605 nm is as high as not less than 70 %, and loss is smaller, it is preferred that it is the metal or alloy which comprise as a main component one or more components selected from Cu, Ag, Au, Al, Mg, Zn, Fe, Co, NI, Rh, Pd, Os, Ir and Pt.

Among these metals or alloys, as for the alloy of Cu, Ag, Au and W, Mo, such as copper/tungsten, copper/molybdenum, silver/tungsten, silver/molybdenum, gold/tungsten, and gold/molybdenum, etc., since it is easy to obtain a thing in which the reflectance to the light with a wavelength of 605 nm is as high as not less than 50 %, and a thing in which the reflectance is as high as not less than 70 % can be obtained furthermore depending on the composition, it can use suitably as a reflective material.

Among the above-illustrated 14 kinds of metal or alloy which are the reflectance not less than 70 %, as for the metal or alloy which comprise as a main component at least one selected from platinum groups, such as Rh, Pd, Os, Ir, and Pt, since what is the reflectance not less than 80 % is obtained depending on the production condition, it is preferred.

In addition, among these metals or alloy materials which are the reflectance not less than 70 %, in the metal or alloy which comprise Cu, Ag, Au, and Al as a main component, since it is easy to obtain a thing in which the reflectance to the light with a wavelength of 605 nm is as high as not less than 80 %, and loss is smallest, it is preferred.

Thus, when the thin film-conductive material which comprises the above-illustrated various metal or alloy is used by forming on the substrate for light-emitting device production of this invention, the thin film-conductive material has a facility as a good reflective material to the luminescence from a light-emitting device.

The reflectance of a thin film-conductive material can be easily measured using optical apparatus, such as a spectrophotometer (Spectrophotometer).

The above thin film-conductive material can also be formed not only on the aluminum nitride-based sintered compact but also on the various sintered compacts comprising as a main component a ceramic material having the crystal structure of a hexagonal system or a trigonal system, such as silicon carbide, silicon nitride, gallium nitride, zinc oxide, beryllium oxide, and aluminum oxide, etc., and other various ceramic-based sintered compacts.

As the various ceramic-based sintered compacts, what has a conduction via can also be used.

A thin film comprising as a main component at least one selected from gallium nitride, indium nitride and aluminum nitride and having at least one of the crystallization states selected from a single crystal, an amorphous state, a polycrystal, and an orientated polycrystal can be formed furthermore on the substrate comprising the various sintered compacts comprising as a main component a ceramic material having the crystal structure of a hexagonal system or a trigonal system, such as silicon carbide, silicon nitride, gallium nitride, zinc oxide, beryllium oxide, and aluminum oxide, etc., and other various ceramic-based sintered compacts, on which the above thin film-conductive material is formed.

The thin film can be formed not only as a single layer but also as a thin film layer of two or more layers in which the crystallization state or composition, etc. differs.

In the substrate comprising the various ceramic-based sintered compacts on which the thin film-conductive material is formed, an epitaxially grown single-crystal thin film comprising as a main component at least one selected from gallium nitride, indium nitride and aluminum nitride can be formed, and a thin film having not only a single crystal state but also at least one of the crystallization states selected from an amorphous state, a polycrystal, and an orientated polycrystal can also be formed.

Not only a single layer but also a multilayered thin film constitution of two or more layers can be formed.

That is, a thin film which comprises as a main component at least one selected from gallium nitride, indium nitride, and aluminum nitride and which comprises at least one of the crystallization states selected from a single crystal, an amorphous state, a polycrystal, and an orientated polycrystal is formed beforehand, and a thin film of two layers constitution in which the epitaxially grown single-crystal thin film which comprises as a main component at least one selected from gallium nitride, indium nitride, and aluminum nitride was formed on it can be formed.

As for the crystallinity of the single-crystal thin film formed in such constitution, that which is superior to the single-crystal thin film formed directly on the substrate which comprises a sintered compact which comprises aluminum nitride as a main component and formed the thin film-conductive material is easy to be obtained, it is preferred.

And, for example, a thin film which comprises as a main component at least one selected from gallium nitride, indium nitride, and aluminum nitride and has at least one of the crystallization states selected from a single crystal, an amorphous state, a polycrystal, and an orientated polycrystal is formed, and a thin film of two layers constitution in which the thin film which comprises at least one of the crystallization states selected from an amorphous state, a polycrystal, and an orientated polycrystal and which does not contain a single crystal was formed can also be formed on it.

The thin film formed in two or more layers can be formed in the state wherein the crystallization states, such as including a single crystal, an amorphous state, a polycrystal, and an orientated polycrystal, composition, or thickness is different respectively, and it can be formed in this invention even if all the thin film layer of two or more layers is the thin film constitution which is not a single crystal.

All the thin film layer which is being constituted with the thin film layer of two or more layers can form what comprises a single-crystal thin film which comprises as a main component at least one selected from gallium nitride, indium nitride, and aluminum nitride.

As at least one layer among the thin film constituted with two or more layers, and if it requires, as the thin film of the top layer, it is preferred that it is a single crystal.

Especially, when the thin-film substrate in which a thin film which comprises as a main component at least one selected from gallium nitride, indium nitride, and aluminum nitride was formed on the substrate of this invention which formed beforehand a thin film-conductive material is used for production of various electronic devices and electronic components, etc., such as a light-emitting device, a field emission display, a wiring board, or an optical waveguide, it is preferred that the thin film formed on the surface portion of the substrate is usually a single crystal which grew epitaxially.

A thin film-conductive material may be formed on the substrate comprising an aluminum nitride-based sintered compact forming a thin film comprising as a main component at least one selected from gallium nitride, indium nitride and aluminum nitride and having at least one of the crystallization states selected from a single crystal, an amorphous state, a polycrystal, and an orientated polycrystal, and in this invention, a thin film-conductive material may be formed not only on the substrate comprising the aluminum nitride-based sintered compact but also on the substrate comprising the above various sintered compacts compriing as a main component a ceramic material having the crystal structure of a hexagonal system or a trigonal system, such as silicon carbide, silicon nitride, gallium nitride, zinc oxide, beryllium oxide, and aluminum oxide, etc., and other various ceramic-based sintered compacts, on which a thin film comprising as a main component at least one selected from gallium nitride, indium nitride and aluminum nitride and havinh at least one of the crystallization states selected from a single crystal, an amorphous state, a polycrystal, and an orientated polycrystal was formed.

In this invention, various electronic devices and electronic components, such as a light-emitting device, a field emission display, a wiring board, or an optical waveguide, etc., are producible using the substrate comprising the various sintered compacts forming the thin film-conductive material and comprising as a main component a ceramic material having the crystal structure of a hexagonal system or a trigonal system, such as silicon carbide, silicon nitride, gallium nitride, zinc oxide, beryllium oxide, and aluminum oxide, etc., and other various ceramic-based sintered compact on which the thin film-conductive material is formed.

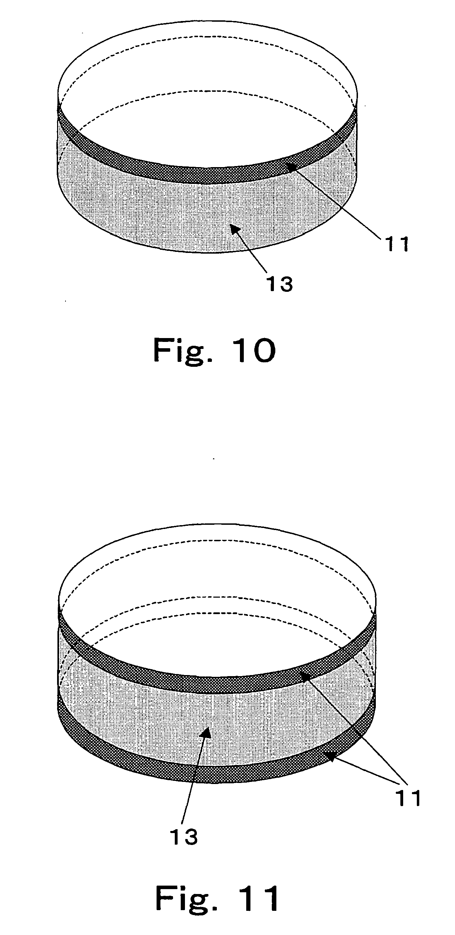

In Figs. 10-20 and Figs. 37-38, the examples of the substrate for a thin film and thin-film substrate in which a thin film-conductive material of this invention is provided are shown.

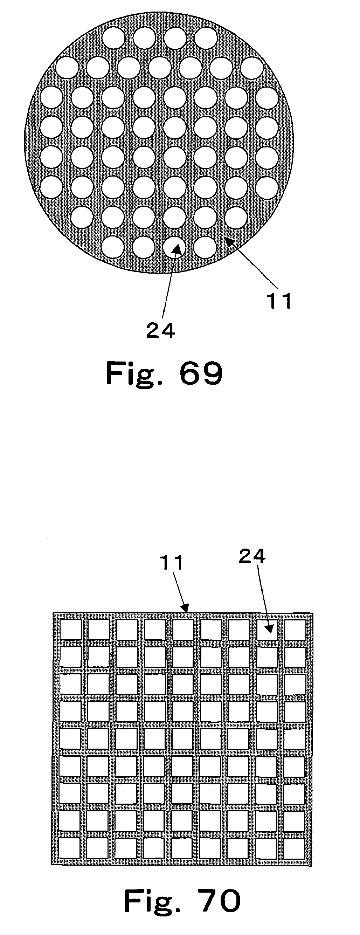

Figs. 69-70 show an example of the thin film-conductive material.

In Figs. 10-20 and Figs. 37-38, they are indicated by the perspective diagram, and in Figs. 69-70, it is indicated by elevational view.

Fig. 10 is a figure showing one example of the substrate for thin-film formation in which the thin film-conductive material 11 was formed on the substrate 13 which comprises a sintered compact which comprises aluminum nitride as a main component.

Fig. 11 is a figure showing one example of the substrate for thin-film formation in which the thin film-conductive material 11 was formed on both sides of the substrate 13 which comprises a sintered compact which comprises aluminum nitride as a main component.

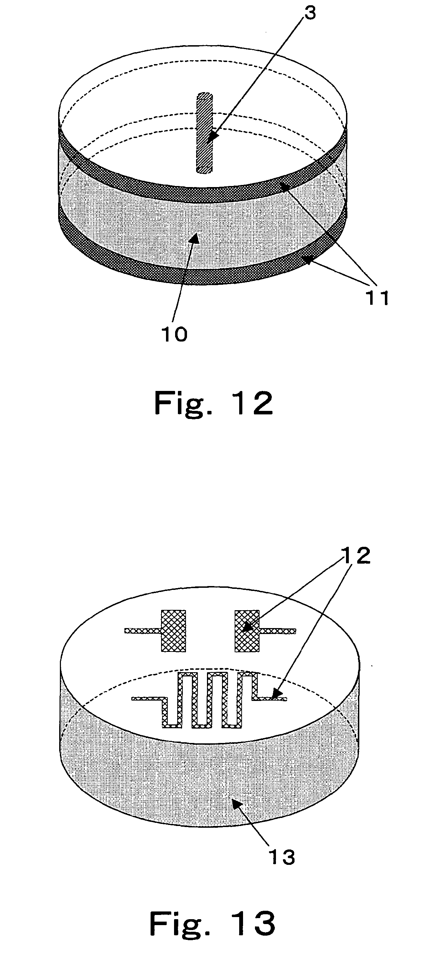

Fig. 12 is a figure showing one example of the substrate for thin-film formation in which the thin film-conductive material 11 was formed on both sides of the substrate 10 which comprises a sintered compact which comprises aluminum nitride as a main component and has a conduction via. Thin film-conductive material 11 formed on both sides of the substrate is connected mutually electrically by the conduction via.

Fig. 13 is a figure showing one example of the substrate for thin-film formation in which the thin film-conductive material 12 with the shape of circuit pattern was formed on the substrate 13 which comprises a sintered compact which comprises aluminum nitride as a main component. In this invention, a thin film which comprises as a main component at least one selected from gallium nitride, indium nitride, and aluminum nitride can be formed on the circuit patterns. A thin film which comprises as a main component at least one selected from gallium nitride, indium nitride, and aluminum nitride can be also formed in the portion of the sintered compact in which a circuit pattern is not formed and which comprises aluminum nitride as a main component, avoiding these circuit patterns. In the substrate for thin-film formation which formed the thin film-conductive material of this invention as an electrical circuit pattern, if functional devices, such as a light-emitting device, are formed on the substrate for thin-film formation, for example, it functions also as the wiring board for mounting a light-emitting device, or the substrate unified with a package. Therefore, although the wiring board or package for mounting functional devices, such as a light-emitting device, are usually required, the effect in which it becomes unnecessary to prepare a circuit substrate or a package independently is obtained in this invention, if the substrate in which the function was united is used.

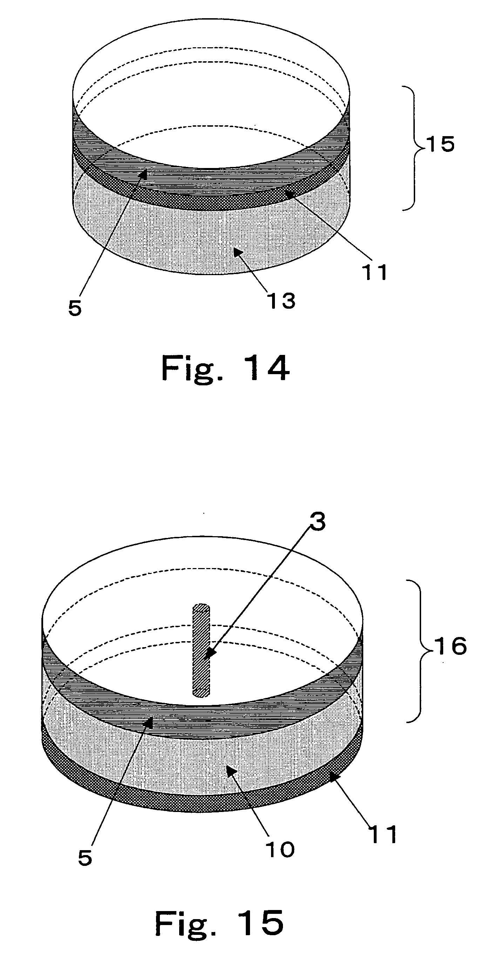

Fig. 14 is a figure showing one example of a thin-film substrate which formed the thin film 5 which comprises as a main component at least one selected from gallium nitride, indium nitride, and aluminum nitride onto the substrate which comprises a sintered compact in which a thin film-conductive material was formed beforehand and which comprises aluminum nitride as a main component. In Fig. 14, the thin-film substrate 15 is being constituted by forming the thin film 5 which comprises as a main component at least one selected from gallium nitride, indium nitride, and aluminum nitride onto the substrate 13 which comprises a sintered compact in which the thin film-conductive material 11 was formed and which comprises aluminum nitride as a main component.

Fig. 15 is a figure showing one example of a thin-film substrate which formed a thin film which comprises as a main component at least one selected from gallium nitride, indium nitride, and aluminum nitride onto the substrate which comprises a sintered compact in which a thin film-conductive material was formed beforehand and which comprises aluminum nitride as a main component and has a conduction via. In Fig. 15, the thin-film substrate 16 is being constituted by forming the thin film 5 which comprises as a main component at least one selected from gallium nitride, indium nitride, and aluminum nitride onto the surface where the thin film-conductive material 11 is not being formed on the substrate 10 which comprises a sintered compact in which the thin film-conductive material 11 was formed beforehand on one side of a substrate and which comprises aluminum nitride as a main component and has the conduction via 3. In Fig. 15, if the thin film 5 which comprises as a main component at least one selected from gallium nitride, indium nitride, and aluminum nitride has conductivity, the thin film 5 which has conductivity and the substrate surface opposite to the side in which the thin film 5 is being formed are electrically connectable via the conduction via 3.

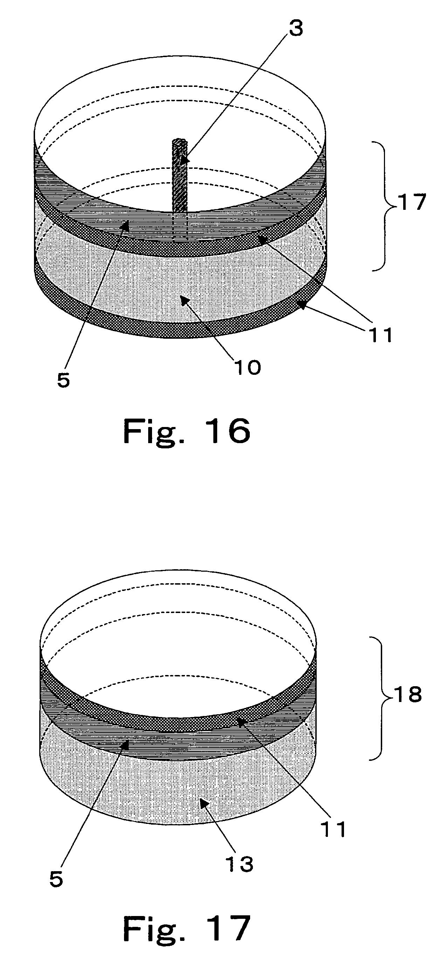

Fig. 16 is a figure showing one example of a thin-film substrate which formed the thin film 5 which comprises as a main component at least one selected from gallium nitride, indium nitride, and aluminum nitride onto the substrate which comprises a sintered compact in which a thin film-conductive material was formed beforehand on both sides and which comprises aluminum nitride as a main component and has a conduction via. In Fig. 16, the thin-film substrate 17 is being constituted by forming the thin film 5 which comprises as a main component at least one selected from gallium nitride, indium nitride, and aluminum nitride onto the substrate 10 which comprises a sintered compact in which the thin film-conductive material 11 was formed beforehand on both sides and which comprises aluminum nitride as a main component and has the conduction via 3. In Fig. 16, if the thin film 5 which comprises as a main component at least one selected from gallium nitride, indium nitride, and aluminum nitride has conductivity, the thin film 5 which has conductivity and the substrate surface opposite to the side in which the thin film 5 is being formed are electrically connectable under high reliability via the conduction via 3.

Fig. 17 shows one example of a thin-film substrate which formed a thin film-conductive material furthermore onto the thin film which comprises as a main component at least one selected from gallium nitride, indium nitride, and aluminum nitride and was formed on the substrate which comprises a sintered compact which comprises aluminum nitride as a main component. Fig. 17 shows the appearance of the thin-film substrate 18, wherein the thin film 5 which comprises as a main component at least one selected from gallium nitride, indium nitride, and aluminum nitride was formed on the substrate 13 which comprises a sintered compact which comprises aluminum nitride as a main component, and the thin film-conductive material 11 was formed on it.

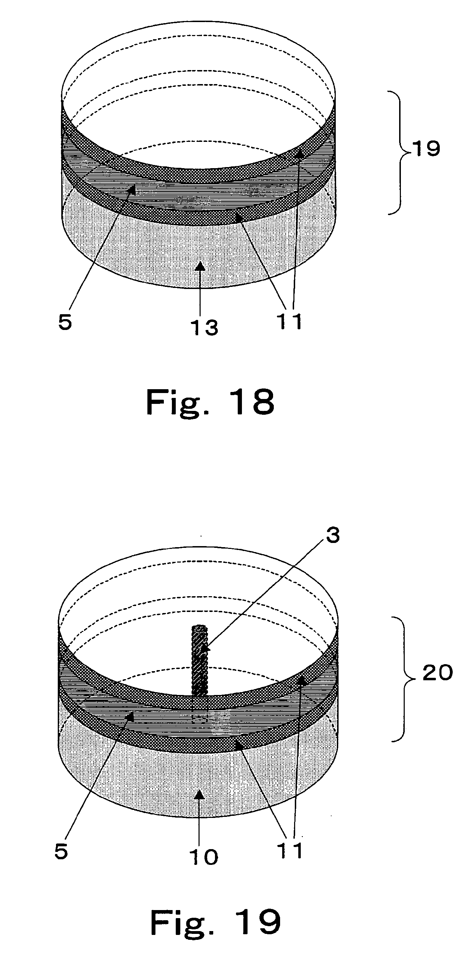

Fig. 18 shows one example of a thin-film substrate in which a thin film-conductive material was formed furthermore on the thin film which comprises as a main component at least one selected from gallium nitride, indium nitride, and aluminum nitride and was formed on the substrate which comprises a sintered compact in which a thin film-conductive material was formed beforehand and which comprises aluminum nitride as a main component. Fig. 18 shows the appearance of the thin-film substrate 19, wherein the thin film 5 which comprises as a main component at least one selected from gallium nitride, indium nitride, and aluminum nitride was formed on the substrate 13 which comprises a sintered compact in which the thin film-conductive material 11 was formed beforehand and which comprises aluminum nitride as a main component, and the thin film-conductive material 11 was formed furthermore on the surface of the thin film 5.

Fig. 19 shows one example of a thin-film substrate in which a thin film-conductive material was formed furthermore on the thin film which comprises as a main component at least one selected from gallium nitride, indium nitride, and aluminum nitride and was formed on the substrate which comprises a sintered compact in which a thin film-conductive material was formed beforehand and which comprises aluminum nitride as a main component and has a conduction via. Fig. 19 shows the appearance of the thin-film substrate 20, wherein the thin film 5 which comprises as a main component at least one selected from gallium nitride, indium nitride, and aluminum nitride was formed on the substrate 10 which comprises a sintered compact in which the thin film-conductive material 11 was formed beforehand and which comprises aluminum nitride as a main component and has the conduction via 3, and the thin film-conductive material 11 was formed furthermore on the surface of the thin film 5.

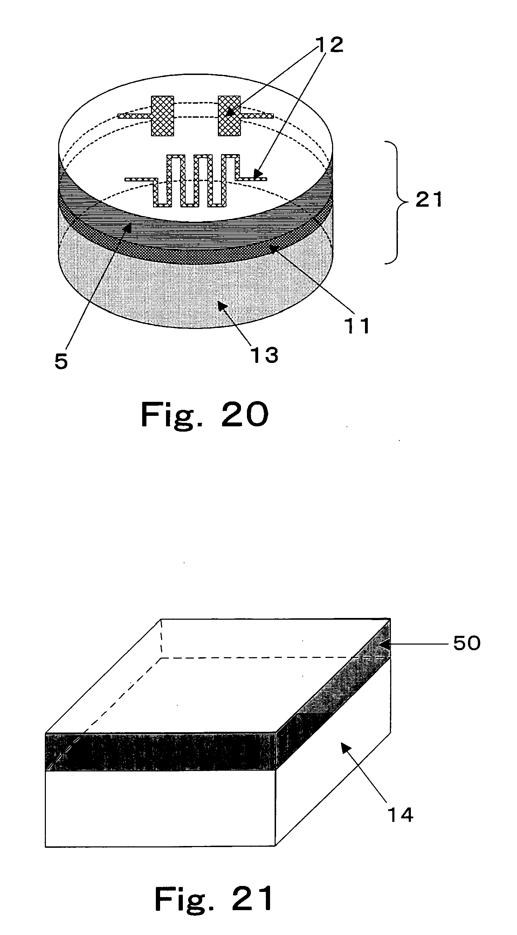

Fig. 20 shows one example of a thin-film substrate in which an electrical circuit pattern by the thin film-conductive material was formed furthermore on the surface of a thin film which comprises as a main component at least one selected from gallium nitride, indium nitride, and aluminum nitride and was formed on the substrate which comprises a sintered compact in which a thin film-conductive material was formed beforehand and which comprises aluminum nitride as a main component. Fig. 20 shows the appearance of the thin-film substrate 21, wherein the thin film 5 which comprises as a main component at least one selected from gallium nitride, indium nitride, and aluminum nitride was formed on the substrate 13 which comprises a sintered compact in which the thin film-conductive material 11 was formed beforehand and which comprises aluminum nitride as a main component, and the thin film-conductive material 12 with circuit pattern form was formed furthermore on the surface of the thin film 5.

Fig. 37 shows one example of the thin-film substrate in which two layers of thin films which were formed on the substrate which comprises a sintered compact in which a thin film-conductive material was formed beforehand and which comprises aluminum nitride as a main component. Fig. 37 shows the thin-film substrate which is shown by the mark 22 and has a constitution, wherein the thin film 5 which comprises as a main component at least one selected from gallium nitride, indium nitride, and aluminum nitride was formed on the substrate 13 which comprises a sintered compact in which the thin film-conductive material 11 was formed beforehand and which comprises aluminum nitride as a main component, and the thin film 8 which comprises as a main component at least one selected from gallium nitride, indium nitride, and aluminum nitride was formed furthermore on it. For example, if a thing which comprises as a main component at least one selected from gallium nitride, indium nitride, and aluminum nitride and has at least one of the crystallization states selected from a single crystal, an amorphous state, a polycrystal, and an orientated polycrystal is formed as a thin film 5, and an epitaxially grown single-crystal thin film which comprises as a main component at least one selected from gallium nitride, indium nitride, and aluminum nitride is formed on it as a thin film 8, the crystallinity of the thin film 8 tends to improve than the crystallinity of the single-crystal thin film formed directly on the substrate 13, it is preferred. The thin-film substrate with such thin film constitution is preferred when it is used for production of various electronic devices and electronic components, such as a light-emitting device, field emission, a wiring board, or an optical waveguide.

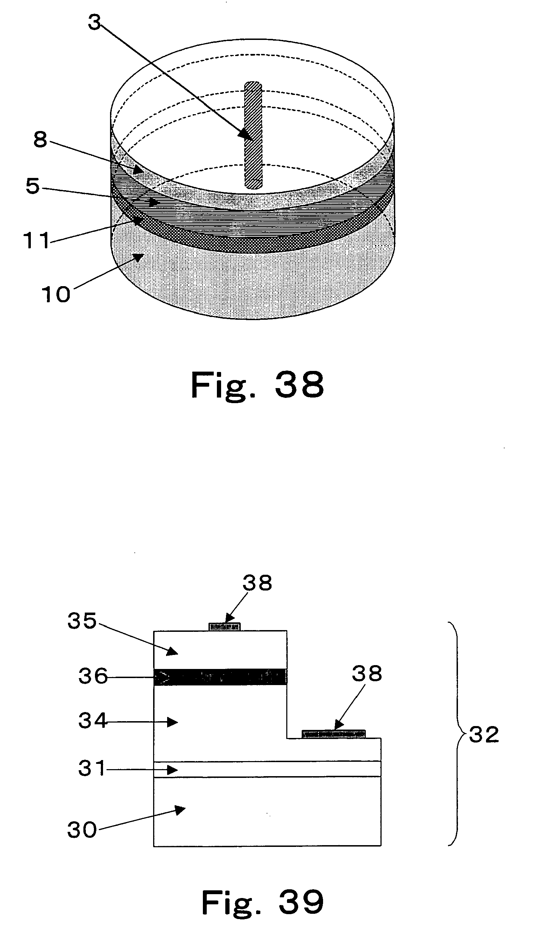

Fig. 38 shows one example of a thin-film substrate in which two layers of thin films which comprise as a main component at least one selected from gallium nitride, indium nitride, and aluminum nitride were formed on the substrate which comprises a sintered compact in which a thin film-conductive material was formed beforehand and which comprises aluminum nitride as a main component and has a conduction via. Fig. 38 shows the thin-film substrate which is shown by the mark 23 and has a constitution, wherein the thin film 5 which comprises as a main component at least one selected from gallium nitride, indium nitride, and aluminum nitride was formed on the substrate 10 which comprises a sintered compact in which the thin film-conductive material 11 was formed beforehand and which comprises aluminum nitride as a main component and has a conduction via 3, and the thin film 8 which comprises as a main component at least one selected from gallium nitride, indium nitride, and aluminum nitride was formed furthermore on it. For example, if a thing which comprises as a main component at least one selected from gallium nitride, indium nitride, and aluminum nitride and has at least one of the crystallization states selected from a single crystal, an amorphous state, a polycrystal, and an orientated polycrystal is formed as a thin film 5, and an epitaxially grown single-crystal thin film which comprises as a main component at least one selected from gallium nitride, indium nitride, and aluminum nitride is formed on it as a thin film 8, the crystallinity of the thin film 8 tends to improve than the crystallinity of the single-crystal thin film formed directly on the substrate 10, it is preferred. The thin-film substrate with such thin film constitution ispreferred when it is used for production of various electronic devices and electronic components, such as a light-emitting device, field emission, a wiring board, or an optical waveguide.

Fig. 69 and Fig. 70 are elevational views showing the example of a thin film-conductive material formed on the substrate which comprises a sintered compact which comprises aluminum nitride as a main component. Space 24 is formed in the inside of the thin film-conductive material 11 in Fig. 69 and Fig. 70. The space is provided in order to prevent that wherein the light emitted from a light-emitting device becomes hard to be emitted to the outside of the substrate by being intercepted by the thin film-conductive material, in the case wherein the substrate in which the thin film-conductive material was formed is used as a substrate for light-emitting device production, for example. If a space is established in the thin film-conductive material, the light emitted from a light-emitting device will pass through the space without being intercepted by the thin film-conductive material and becomes easy to be emitted to the outside of the substrate, and the luminous efficiency of the light-emitting device will be raised, so it is preferred. Fig. 69 shows a thing in which the space is circular. A space is not restricted to the circular thing but may be the thing of what kind of form, such as quadrangle, etc. shown in Fig. 70, for example, and improvement in the luminous efficiency of a light-emitting device tends to be attained by providing such space, so it is preferred.

Although the example which used the sintered compact which comprises aluminum nitride as a main component is shown in the substrate in which the thin film-conductive material was formed and which is shown in Figs. 10-20 and Figs. 37-38, in this invention, it can replace the substrate which comprises the above sintered compact which comprises aluminum nitride as a main component (namely, respectively, the substrate shown with the mark 13 in Fig. 10, the substrate shown with the mark 13 in Fig. 11, the substrate shown with the mark 10 in Fig. 12, the substrate shown with the mark 13 in Fig. 13, the substrate shown with the mark 13 in Fig. 14, the substrate shown with the mark 10 in Fig. 15, the substrate shown with the mark 10 in Fig. 16, the substrate shown with the mark 13 in Fig. 17, the substrate shown with the mark 13 in Fig. 18, the substrate shown with the mark 10 in Fig. 19, the substrate shown with the mark 13 in Fig. 20), and the substrate for thin-film formation and thin-film substrate which are same mode as the thing illustrated in Figs. 10-20 and which formed the above thin film-conductive material are producible using the substrate which comprises various sintered compacts which comprise as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., and other various sintered compacts which comprise a ceramic material as a main component.

According to this invention, in the substrate which comprises a sintered compact which comprises aluminum nitride as a main component, or in the substrate which comprises various sintered compacts which comprise as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., a single-crystal thin film which comprises as a main component at least one selected from gallium nitride, indium nitride, and aluminum nitride can be formed directly as mentioned above.

This inventor has conducted the experiment for forming the single-crystal thin film which comprises as a main component at least one selected from gallium nitride, indium nitride, and aluminum nitride onto the substrate which comprises a sintered compact which comprises aluminum nitride as a main component, or onto the substrate which comprises various sintered compacts which comprise as a main component a ceramic material which has the crystal system which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., and has newly found out that the thin film which comprises as a main component at least one selected from gallium nitride, indium nitride, and aluminum nitride and which is not necessarily a single crystal can be formed in that process.

That is, this thin film is that is various crystallization states, such as not only a single crystal state but an amorphous state, a polycrystalline state, or an orientated polycrystalline state, and the thin film of these various crystallization states also can be formed directly on the substrate which comprises a sintered compact which comprises aluminum nitride as a main component and on the substrate which comprises various sintered compacts which comprise as a main component a ceramic material which has the crystal system which can be classified as a hexagonal system, such as silicon carbide, silicon nitride, gallium nitride, zinc oxide, and beryllium oxide, etc., and can be classified as a trigonal system or a hexagonal system, such as aluminum oxide, etc.

An orientated polycrystal means the polycrystal in which the crystal has grown to the specific one direction.

For example, in the polycrystal with which C axis grew in the perpendicular direction to the substrate surface, the crystallographic axis which exists in the parallel direction to a surface of the substrate has turned to all directions, unlike the single crystal.

If it is the single-crystal thin film which comprises as a main component at least one selected from gallium nitride, indium nitride, and aluminum nitride, in the case wherein the C axis grows in the perpendicular direction to a substrate surface, the A-axis grows in the parallel direction to a substrate surface and the direction is fixed, but in the orientated polycrystal, the A-axis of parallel direction to a substrate does not have fixed directivity, even if the C axis is growing in the perpendicular direction to a substrate surface.

As for the above substrate which comprises a sintered compact which comprises aluminum nitride as a main component, and substrate which comprises various sintered compacts which comprise a ceramic material as a main component, a substrate which has a conduction via is also included.

This invention was made by being based on the knowledge in which a thin film which comprises as a main component at least one selected from gallium nitride, indium nitride, and aluminum nitride and which is not necessarily only a single crystal, such as an amorphous state, can also be formed directly on the substrate which comprises a sintered compact which comprises aluminum nitride as a main component and which can form the single-crystal thin film which comprises as a main component at least one selected from gallium nitride, indium nitride, and aluminum nitride, and on the substrate which comprises various sintered compacts which comprise as a main component a ceramic material which has the crystal system which can be classified as a hexagonal, such as silicon carbide, silicon nitride, gallium nitride, zinc oxide, and beryllium oxide, etc., and can be classified as a trigonal system or a hexagonal system, such as aluminum oxide, etc.

As for the above amorphous thin film, polycrystalline thin film, or orientated polycrystalline thin film which comprise as a main component at least one selected from gallium nitride, indium nitride, and aluminum nitride, they can be formed comparatively easily like a single-crystal thin film.

That is, the above thin films other than a single crystal can be formed by the methods which are usually used for epitaxial growth, such as the MOCVD (Metal Organic Chemical Vapor Deposition) method, the MOVPE (Metal Organic Vapor Phase Epitaxy) method, the Hydride VPE (Hydride Vapor Phase Epitaxy) method, the Halide VPE (Halogen Transport Vapor Phase Epitaxy) method, such as the Chloride VPE (Chloride Vapor Phase Epitaxy) method, etc., the Plasma CVD method, the other CVD (Chemical Vapor Deposition) methods, and the MBE (Molecular Beam Epitaxy) method, or the laser ablation method using the excimer laser, etc. and using as a raw material the solid material containing the purpose component which was formed beforehand, and the PLD method (Pulse Laser Deposition: Pulse Laser Deposition), or by the methods, such as the sputtering method, the ion-plating method, or the vapor-depositing method, etc.

When thin films of a single crystal or other than a single crystal are formed by using the above methods of thin film formation, it can carry out easily by modification of thin film formation conditions, such that the temperature of a substrate is set up low or concentration of thin film source gas is made into height, for example.

For example, using the various CVD methods, such as the above MOCVD, Hydride VPE method, Chloride VPE method, and Halide VPE method, or the Sputtering method, and the Ion-plating method, when the thin film which comprises as a main component at least one selected from gallium nitride, indium nitride, and aluminum nitride is formed directly on the substrate which comprises a sintered compact which comprises aluminum nitride as a main component, and on the substrate which comprises various sintered compacts which comprise as a main component a ceramic material which has the crystal system which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., it is possible to make a single-crystal thin film and thin films other than a single crystal comparatively easily, respectively, by setting the temperature of the substrate comparatively high into not less than 600-700°C in the case of a single-crystal thin film, and by setting the temperature of the substrate into not more than 600-700°C, not more than 500°C, furthermore, not more than 400°C, for example, in the case of forming thin films other than a single crystal.

For example, when the thin film of gallium nitride is formed by the MOCVD method using trimethyl gallium as a raw material, a single-crystal thin film can be formed at 700-800°C or more, preferably at 900-1100°C.

The thin film of an amorphous state, a polycrystalline state, or an orientated polycrystalline state can be formed at not more than 800°C, such as the temperature not more than 600°C, for example.

When the formation of the above thin film which comprises as a main component at least one selected from gallium nitride, indium nitride, and aluminum nitride is carried out, the above thin film can be formed not only by using a single method but by combining two or more methods, such as combining the MOCVD method and the Sputtering method, combining the Chloride VPE method and the Sputtering method, or combining the three methods of the MOCVD method, the Chloride VPE method, and the Sputtering method, etc.

By such combination, it can arbitrarily carry out such thing, wherein the thin film which comprises as a main component at least one selected from gallium nitride, indium nitride, and aluminum nitride and which is an orientated polycrystalline state in which the crystal C axis grew perpendicularly to the substrate surface or the thin film of an amorphous state are formed first beforehand by the sputtering method on the substrate which comprises a sintered compact which comprises aluminum nitride as a main component and on the substrate which comprises various sintered compacts which comprise as a main component a ceramic material which has the crystal system which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., for example, and the thin film which is a single crystal state and comprises as a main component at least one selected from gallium nitride, indium nitride, and aluminum nitride is formed on it by the MOCVD method or the chloride VPE method, etc.

Furthermore, there is a characteristic wherein the thin films other than a single crystal can be formed comparatively easily directly on the substrate which comprises a sintered compact which comprises aluminum nitride as a main component, even if the thin film forming methods which cannot usually form a single-crystal thin film easily, such as the ion-plating method or the vapor-depositing method, are used.

When such thin films other than a single crystal are formed using the ion-plating method or the vapor-depositing method, as for the temperature of the substrate which comprises a sintered compact which comprises aluminum nitride as a main component or the substrate which comprises various sintered compacts which comprise as a main component a ceramic material which has the crystal system which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., it is not more than 600°C, usually is not more than 400°C.

As for the thing wherein it can be easily distinguished by X ray diffraction what kind of crystallization state the above thin film is, it was stated above.

That is, if it is amorphous, it will become a broad diffraction pattern and a diffraction line will not appear in the location of the specific degree of diffraction angle.

If it is polycrystal, since a diffraction pattern is easy to become a broad figure and not only one specific diffraction line (for example, diffraction line of only the diffraction line of a Miller Index (002), or (100)) but two or more diffraction lines appear, it can perform distinction of whether it is a single crystal easily.

In the case of an orientated polycrystal, a specific diffraction line appears by the X-ray diffraction, according to the direction of crystal orientation.

The diffraction line which appears in the polycrystalline thin film in which the C axis orients in the perpendicular direction to the substrate surface as mentioned above is only a diffraction line of a Miller Index (002) plane in case of the 2θ/θscan.

And, also in the single-crystal thin film formed in the direction where the C axis is perpendicular to the substrate surface, the diffraction line which will appear is only a diffraction line of a Miller Index (002) plane if X-ray diffraction by 2θ/θscan is performed.

In this invention, in the case of a single-crystal thin film, the diffraction line of the lattice plane of the Miller Index (002) is sharp, and a thing, such that the half width of the rocking curve of the X-ray diffraction line from the lattice plane of the Miller Index (002) is not more than 3600 seconds, is obtained easily.

On the other hand, in the case of an orientated polycrystalline thin film, the diffraction line of the lattice plane of the Miller Index (002) will tend to become broad compared with the single crystal, and the half width of the rocking curve of the X-ray diffraction line from the lattice plane of this Miller Index (002) tends to become not less than 3600 soconds.

Although the reason why the rocking curve of the X-ray diffraction line from the lattice plane of the Miller Index (002) of the orientated polycrystalline thin film becomes broad as mentioned above is not necessarily clear, it is surmised that while the single-crystal thin film is homogeneous, continuous, and unified structure, it will be because the orientated polycrystalline thin film comprises a particulate which comprises as a main component at least one selected from gallium nitride, indium nitride, and aluminum nitride and gathered in the direction where only the direction of the C axis is perpendicular.

Therefore, distinction between an orientated polycrystalline thin film and a single-crystal thin film can be easily performed not only by the method of checking the existence of the rotation in the C plane of a crystal by combining two of 2θ/θscan and 2θ/φ scan of X-ray diffraction, but by performing only the above 2θ/θscan of X-ray diffraction, and measuring the half width of a rocking curve.

And, distinction between a polycrystalline thin film and a single-crystal thin film can also be attained comparatively easily by performing microstructure observation of the thin film by SEM (scanning electron microscope), SPM (scanning probe microscope), etc., or by using together RHEED (reflective high energy electron diffraction).

When the orientated polycrystalline thin film in which the C axis oriented to the perpendicular direction and which comprises as a main component at least one selected from gallium nitride, indium nitride, and aluminum nitride is formed directly on the substrate which comprises a sintered compact which comprises aluminum nitride as a main component or on the substrate which comprises various sintered compacts which comprise as a main component a ceramic material which has the crystal system which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., by each method described above, what has the crystallinity, such that the half width of the rocking curve of the X-ray diffraction line from the lattice plane of the Miller Index (002) of the orientated polycrystal formed is not more than 36000 seconds, can be formed usually.

As for the orientated polycrystalline thin film which is formed using the MOCVD method, the MOPVE method, the Hydride VPE method, the Chloride VPE method, the Plasma CVD method, the other CVD methods, the MBE method, the laser ablation method using excimer laser, etc., the PLD method, the Sputtering method, the Ion-plating method, and the Vapor-depositing method among the above various methods, what has the crystallinity, such that the half width of the rocking curve of the X-ray diffraction line from the lattice plane of the Miller Index (002) of the thin film is not more than 21000 seconds, can be formed.

Among the above thin films which comprise as a main component at least one selected from gallium nitride, indium nitride, and aluminum nitride, when the orientated polycrystalline thin film is formed directly on the substrate which comprises a sintered compact which comprises aluminum nitride as a main component or on the substrate which comprises various sintered compacts which comprise as a main component a ceramic material which has the crystal system which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., an orientated polycrystalline thin film excellent in crystallinity is easy to be obtained usually if using the MOCVD method, the MOPVE method, the Hydride VPE method, the Chloride VPE method, the Plasma CVD method, the other CVD methods, and the MBE method, etc. compared with the use of the Sputtering method, the Ion-plating method, or the Vapor-depositing method.

For example, when the orientated polycrystalline thin film which comprises as a main component at least one selected from gallium nitride, indium nitride, and aluminum nitride was formed directly on the substrate which comprises a sintered compact which comprises aluminum nitride as a main component, a thing, such that the half width of the rocking curve of the X-ray diffraction line from the lattice plane of the Miller Index (002) is not more than 5000 seconds, can be formed, if using the methods, such as the MOCVD method, the MOPVE method, the Hydride VPE method, the Chloride VPE method, the Plasma CVD method, the other CVD methods, and the MBE method, etc.

Among the above thin films which comprise as a main component at least one selected from gallium nitride, indium nitride, and aluminum nitride, when the orientated polycrystalline thin film is formed using the MOCVD method, the MOPVE method, the Hydride VPE method, the Chloride VPE method, the Plasma CVD method, the other CVD methods, and the MBE method, etc., the orientated polycrystalline thin film which is more excellent in crystallinity can be formed, if the substrate which comprises a sintered compact which comprises aluminum nitride as a main component is used.

When it is formed directly on the substrate which comprises various sintered compacts which comprise as a main component a ceramic material which has the crystal system which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., using the above methods, such as the MOCVD method, the MOPVE method, the Hydride VPE method, the Chloride VPE method, the Plasma CVD method, the other CVD methods, and the MBE method, the half width of the rocking curve of the X-ray diffraction line from the lattice plane of the Miller Index (002) of the orientated polycrystalline thin film obtained is easy to become larger than 5000 seconds.

In addition, in the crystallinity appraisal method of the thin film by the half width of the X ray diffraction rocking curve from the lattice plane of the Miller Index (002), according to this invention, it can also be put in another way that the evaluation of crystallinity is carried out by the index how many crystals inside the thin film are confused.

Generally, the crystal of the actual existence is imperfect hitherto even if it is considered that it is a single crystal, it is said that the mosaic structure which is the aggregate of a fine perfect crystal (crystallite) is comprised.

The mosaic structure is the structure in which the fine perfect crystals (crystallite) in which the directions differ little by little gathered, and it is said that a actual single crystal comprises the mosaic structure confused in this way.

In this invention, the half width of the X ray diffraction rocking curve from the lattice plane of the Miller Index (002) of the thin film is usually not more than 3600 seconds, if the thin film formed is a single crystal, for example.

Therefore, in this invention, it is surmised that the single-crystal thin film comprises the crystallite in the inside wherein each other C axis direction differs in thegle of not more than about ±3600 seconds, i.e., about ±1 degree.

Furthermore, concretely speaking, it is surmised that the single-crystal thin film comprises the crystallite in the inside wherein each other C axis direction differs in thegle of not more than about ±300 seconds, i.e., ±5 minutes, if the thin film formed is a single crystal in which the half width of the X ray diffraction rocking curve from the lattice plane of the Miller Index (002) is 300 seconds, for example.

The thin film, according to this invention, can exist in the state formed on the substrate which comprises various sintered compacts which comprise a ceramic material as a main component, unlike an independent bulk material.

Therefore, if another expression is carried out, it also seems that it is possible to consider that the crystallinity of the thin film formed can be evaluated, by [what inclination does the crystallite in a thin film have to the substrate surface?].

For example, when the C axis of a thin film is formed so that it may become perpendicular to the substrate surface, it can be considered that the thin film comprises the crystallite who has the C axis in thegle range of about 89-90 degrees (namely, thegle range of not more than about 1 degree to the perpendicular line of a substrate surface) to a substrate surface, if the thin film formed is the single crystal in which the half width of the X ray diffraction rocking curve from the lattice plane of the Miller Index (002) is 3600 seconds.

And, it can be considered that the thin film comprises the crystallite who has the C axis in thegle range of about 89 degrees and 55 minutes-90 degrees (namely, thegle range of not more than about 5 minutes to the perpendicular line of a substrate surface) to a substrate surface, for example, if the thin film formed is the single crystal in which the half width of the X ray diffraction rocking curve from the lattice plane of the Miller Index (002) is 300 seconds.

On the other hand, for example, when the thin film formed is an orientated polycrystal, it is guessed that the thin film which comprises an orientated polycrystal is what comprises the crystallite or particulate to which the crystal direction was furthermore in disorder compared with the single-crystal thin film, because the half width of the X ray diffraction rocking curve from the lattice plane of the Miller Index (002) of the thin film tends to become not less than 3600 seconds.

That is, in this invention, in an orientated polycrystal thin film, it is surmised that the many crystallite or particulate wherein each other C axis direction differs in thegle of ±3600 seconds or more, i.e.±1 degree or more, exists in the inside.

Furthermore, concretely speaking, for example, if the thin film formed is an orientated polycrystal in which the half width of the X ray diffraction rocking curve from the lattice plane of the Miller Index (002) is 21000 seconds, it is surmised that the thin film comprises the crystallite or particulate in the inside wherein each other C axis direction differs in thegle of ±21000 seconds or more, i.e.±7 degrees or more.

If another expression is carried out, when the C axis of a thin film is formed so that it may become perpendicular to a substrate surface, it can be considered that the thin film comprises the crystallite who has the C axis in thegle range of about 83 or more degrees (namely, thegle range of not more than about 7 degrees to the perpendicular line of a substrate surface) to a substrate surface, if the thin film is the orientated polycrystal in which the half width of the X ray diffraction rocking curve from the lattice plane of the Miller Index (002) is 21000 seconds.

The meaning wherein such thin film which comprises as a main component at least one selected from gallium nitride, indium nitride, and aluminum nitride and has various crystallization states, such as a single crystal, an amorphous state, a polycrystal, and an orientated polycrystal is formed directly on the sintered compact which comprises aluminum nitride as a main component and on the substrate which comprises various sintered compacts which comprise as a main component a ceramic material which has the crystal system which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., is big.

That is, even if the thin film which comprises at least one selected from gallium nitride, indium nitride, and aluminum nitride and has the above various crystallization states, such as a single crystal, an amorphous state, a polycrystal, and an orientated polycrystal is formed beforehand on the sintered compact which comprises aluminum nitride as a main component and on the substrate which comprises various sintered compacts which comprise as a main component a ceramic material which has the crystal system which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., a single-crystal thin film which comprises as a main component at least one selected from gallium nitride, indium nitride, and aluminum nitride can be formed on the thin film of these various crystallization states comparatively easily, and the advantage wherein the crystallinity of the formed single-crystal thin film becomes easy to improve, and control of the crystal orientation of the single-crystal thin film becomes easy to be carried out furthermore will arise.

In this invention, in the substrate which comprises a sintered compact which comprises aluminum nitride as a main component, and on the substrate which comprises various sintered compacts which comprise as a main component a ceramic material which has the crystal system which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., a single-crystal thin film which has high crystallinity and comprises as a main component at least one selected from gallium nitride, indium nitride, and aluminum nitride can originally be formed directly.

That is, in this invention, a single-crystal thin film which comprises at least one selected from gallium nitride, indium nitride, and aluminum nitride can be formed directly on the substrate which comprises a sintered compact which comprises aluminum nitride as a main component, and on the substrate which comprises various sintered compacts which comprise as a main component a ceramic material which has the crystal system which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., and the single-crystal thin film with high crystallinity can be formed.

However, as mentioned above, if a thin film which comprises at least one selected from gallium nitride, indium nitride, and aluminum nitride and has various crystallization states, such as a single crystal, an amorphous state, a polycrystal, and an orientated polycrystal, is formed beforehand on the substrate which comprises a sintered compact which comprises aluminum nitride as a main component, and on the substrate which comprises various sintered compacts which comprise as a main component a ceramic material which has the crystal system which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., the crystallinity of the single-crystal thin film which comprises at least one selected from gallium nitride, indium nitride, and aluminum nitride and is formed on the above thin film of various crystallization states becomes easy to be improved furthermore than the crystallinity of the single-crystal thin film which comprises as a main component at least one selected from gallium nitride, indium nitride, and aluminum nitride and is formed directly on the substrate which comprises a sintered compact which comprises aluminum nitride as a main component and on the substrate which comprises various sintered compacts which comprise as a main component a ceramic material which has the crystal system which can be classified as a hexagonal system, such as silicon carbide, silicon nitride, gallium nitride, zinc oxide, and beryllium oxide, etc., and can be classified as a trigonal system or a hexagonal system, such as aluminum oxide, etc.

In this invention, if a thin film which comprises at least one selected from gallium nitride, indium nitride, and aluminum nitride and has at least one of the crystallization states selected from a single crystal, an amorphous state, a polycrystal, and an orientated polycrystal is formed beforehand on the substrate which comprises a sintered compact which comprises aluminum nitride as a main component and on the substrate which comprises various sintered compacts which comprise as a main component a ceramic material which has the crystal system which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., and a single-crystal thin film which comprises as a main component at least one selected from gallium nitride, indium nitride, and aluminum nitride is formed furthermore on the thin film, it will become possible to raise the crystallinity of the single-crystal thin film furthermore.

As for such thin film constitution, in the thin film which comprises 3 layers at least, when a thin film which comprises as a main component at least one selected from gallium nitride, indium nitride, and aluminum nitride and has at least one of the crystallization states selected from a single crystal, an amorphous state, a polycrystal, and an orientated polycrystal is formed beforehand on the substrate which comprises a sintered compact which use aluminum nitride as a main component and on the substrate which comprises various sintered compacts which comprise as a main component a ceramic material which has the crystal system which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., and a thin film which comprises as a main component at least one selected from gallium nitride, indium nitride, and aluminum nitride and has at least one of the crystallization states selected from a single crystal, an amorphous state, a polycrystal, and an orientated polycrystal is formed on the thin film, and a single-crystal thin film which comprises as a main component at least one selected from gallium nitride, indium nitride, and aluminum nitride is furthermore formed on it, the crystallinity of each single-crystal thin film formed in the 2nd layer or the 3rd layer can be raised.

In this invention, if using the substrate which comprises a sintered compact which comprises aluminum nitride as a main component, and substrate which comprises various sintered compacts which comprise as a main component a ceramic material which has the crystal system which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., wherein the thin film of various crystallization states, such as a single crystal, an amorphous state, a polycrystal, and an orientated polycrystal, is formed, it will become easy to control the crystal orientation of the thin film which comprises as a main component at least one selected from gallium nitride, indium nitride, and aluminum nitride.

If a thin film comprising as a main component at least one selected from gallium nitride, indium nitride and aluminum nitride and having at least one of the crystallization states selected from a single crystal, an amorphous state, a polycrystal, and an orientated polycrystal is formed on the substrate comprising an aluminum nitride-based sintered compact and on the substrate comprising various sintered compacts comprising as a main component a ceramic material having the crystal structure of a hexagonal system or a trigonal system, such as silicon carbide, silicon nitride, gallium nitride, zinc oxide, beryllium oxide, and aluminum oxide, etc., and a single-crystal thin film comprising as a main component at least one selected from gallium nitride, indium nitride and aluminum nitride is formed furthermore on the thin film, a thin-film substrate in which the single-crystal thin film having excellent crystallinity more than the single-crystal thin film formed directly on the substrate comprising the above various ceramic materials was formed is producible.

The characteristics of electronic devices or electronic components, such as a light-emitting device, an optical waveguide, a wiring board, and an acoustic-optical device, which are produced using the thin-film substrate which comprises such thin film constitution tend to be improved.

For example, when electronic devices or electronic components, such as a light-emitting device, an optical waveguide, a wiring board, and an acoustic-optical device, are newly formed on the above thin-film substrate, or when a part of various thin films which constitute the above thin-film substrate is used for at least a portion of the material which constitutes electronic devices or electronic components, such as a light-emitting device, an optical waveguide, a wiring board, and an acoustic-optical device, it becomes easy to improve the characteristics of electronic devices or electronic components, such as a light-emitting device, an optical waveguide, a wiring board, and an acoustic-optical device, so it is desirable.

In this invention, as for the thin film which comprises as a main component at least one selected from gallium nitride, indium nitride, and aluminum nitride and has at least one of the crystallization states selected from a single crystal, an amorphous state, a polycrystal, and an orientated polycrystal and which is formed beforehand on the substrate which comprises a sintered compact which comprises aluminum nitride as a main component and on the substrate which comprises various sintered compacts which comprise as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., it can use not only what formed the thin film as a single layer but also what has multilayered constitution of two or more layers from which the composition and/or the crystallization state differ, such as what was formed as a multilayered thin film layer of two or more layers which comprises different two or more crystallization states respectively, or what was formed as a multilayered film layer of two or more layers which comprises different two or more compositions respectively, even if it is the same crystallization state, etc.

Moreover, as for the single-crystal thin film which comprises as a main component at least one selected from gallium nitride, indium nitride, and aluminum nitride and is formed on the thin film of the above various crystallization states, it can use what was made into the multilayered constitution by laminating two or more layers, such as what has different crystallinity even if it has the same composition, or what has different composition, etc.

And, among what is made into the multilayer constitution by laminating two or more thin film layers, it can use a thing which was made into the constitution wherein at least one thin film layer is a single-crystal state and the remaining thin film layer(s) is not a single crystal state, such as an amorphous state, a polycrystal, and an orientated polycrystal.

That which has the same composition and the same crystallization state can also be formed as two or more thin film layers in 2 steps or more.

As for the thickness of the thin film which comprises as a main component at least one selected from gallium nitride, indium nitride, and aluminum nitride and has at least one of the crystallization states selected from a single crystal, an amorphous state, a polycrystal, and an orientated polycrystal and which is formed beforehand on the substrate which comprises a sintered compact which use aluminum nitride as a main component, and on the substrate which comprises various sintered compacts which comprise as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., what is arbitrary can be formed.

As for the thickness of the single-crystal thin film which comprises as a main component at least one selected from gallium nitride, indium nitride, and aluminum nitride and is formed furthermore on it, what is arbitrary can also be formed.

As for the above thin film which is formed beforehand and which has at least one of the crystallization states selected from a single crystal an amorphous state, a polycrystal, and an orientated polycrystal, and the single-crystal thin film which is formed furthermore on it, what is the multilayered structure which comprises two or more thin film layers or single layer which are arbitrary thickness respectively, is producible.

As for the thickness of each thin film layer of the above thin film which is formed beforehand, and the single-crystal thin film which is formed furthermore on it, usually, it is preferred to use what is a 0.5 nm-1000 µm range, and is more preferred to use what is a 0.5 nm-200 µm range, combining suitably.

Stating more concretely, when a thin film which comprises as a main component at least one selected from gallium nitride, indium nitride, and aluminum nitride and has at least one of the crystallization states selected from a single crystal, an amorphous state, a polycrystal, and an orientated polycrystal is formed beforehand on the sintered compact which comprises aluminum nitride as a main component, and a single-crystal thin film which comprises as a main component at least one selected from gallium nitride, indium nitride, and aluminum nitride is formed furthermore on it, the single-crystal thin film not only can form a thing in which the half width of the rocking curve of the X-ray diffraction line from the lattice plane of the Miller Index (002) is at least not more than 300 seconds but also can form furthermore what has high crystallinity not more than 100 seconds.

In such thin film constitution, even when a single-crystal thin film which comprises as a main component at least one selected from gallium nitride, indium nitride, and aluminum nitride is formed furthermore on the substrate in which the thin film of a total of two layers was formed by forming beforehand the thin film which comprises as a main component at least one selected from gallium nitride, indium nitride, and aluminum nitride and which has at least one of the crystallization states selected from a single crystal, an amorphous state, a polycrystal, and an orientated polycrystal onto the sintered compact which comprises aluminum nitride as a main component, and forming furthermore the thin film which comprises as a main component at least one selected from gallium nitride, indium nitride, and aluminum nitride and which has at least one of the crystallization states selected from a single crystal, an amorphous state, a polycrystal, and an orientated polycrystal onto it, the single-crystal thin film which is formed in 2nd layer or in 3rd layer not only can form a thing in which the half width of the rocking curve of the X-ray diffraction line from the lattice plane of the Miller Index (002) is at least not more than 300 seconds but also can form furthermore what has high crystallinity not more than 100 seconds.

Such an effect is also acquired similarly, when what formed beforehand three or more layers of thin films is used as a substrate, in addition to the case wherein the substrate which comprises a sintered compact which comprises aluminum nitride as a main component and which formed beforehand one layer or two layers of thin film which comprises as a main component at least one selected from gallium nitride, indium nitride, and aluminum nitride and has at least one of the crystallization states selected from a single crystal, an amorphous state, a polycrystal, and an orientated polycrystal is used.

That is, when a single-crystal thin film which comprises as a main component at least one selected from gallium nitride, indium nitride, and aluminum nitride is formed furthermore on the sintered compact which comprises aluminum nitride as a main component and which formed a total of three or more layers of thin film which comprises as a main component at least one selected from gallium nitride, indium nitride, and aluminum nitride and has at least one of the crystallization states selected from a single crystal, an amorphous state, a polycrystal, and an orientated polycrystal, the single-crystal thin film not only can form a thing in which the half width of the rocking curve of the X-ray diffraction line from the lattice plane of the Miller Index (002) is at least not more than 300 seconds but also can form furthermore what has high crystallinity not more than 100 seconds.

For example, if it is going to form a single-crystal thin film which comprises as a main component at least one selected from gallium nitride, indium nitride, and aluminum nitride and which is high crystallinity in which the half width of the rocking curve of the X-ray diffraction line from the lattice plane of the Miller Index (002) is not more than 100 seconds, directly onto the substrate which comprises a sintered compact which comprises aluminum nitride as a main component, the improvement of quality of a sintered compact will be needed in many cases, such as raising the optical transmissivity of a sintered compact, or growing the aluminum nitride particle size in a sintered compact by performing the firing at high temperature for a long time at the time of manufacture of a sintered compact, or vaporizing sintering aids and raising the purity of a sintered compact, etc., as mentioned above.

And the crystallinity of the single-crystal thin film formed tends to be influenced by the thickness or surface smooth nature of a substrate, etc.

However, in this invention, as mentioned above, if a thin film which comprises as a main component at least one selected from gallium nitride, indium nitride, and aluminum nitride and has at least one of the crystallization states selected from a single crystal, an amorphous state, a polycrystal, and an orientated polycrystal is formed beforehand on the substrate which comprises a sintered compact which comprises aluminum nitride as a main component, and a single-crystal thin film which comprises as a main component at least one selected from gallium nitride, indium nitride, and aluminum nitride is formed furthermore on the thin film which has at least one of the crystallization states selected from a single crystal, an amorphous state, a polycrystal, and an orientated polycrystal, as for the single-crystal thin film, what is higher crystallinity is easy to be obtained with not too much influence by the quality of these sintered compacts, such as the optical permeability of a sintered compact which comprises aluminum nitride as a main component and is used as a substrate, the size of particles of a sintered compact, and the composition or purity of a sintered compact, etc., or by the thickness of a substrate, the surface smooth nature of a substrate, the existence of the conduction via in a substrate, etc., or even if being influenced.

That is, in this invention, the sintered compact which comprises as a main component aluminum nitride can be used as a substrate for forming a single-crystal thin film with higher crystallinity, without being influenced too much by the quality of a material and the manufacture condition, etc., or even if being influenced.

If saying in other words, it can say that forming beforehand a thin film which comprises as a main component at least one selected from gallium nitride, indium nitride, and aluminum nitride and which has at least one of the crystallization states selected from an amorphous state, a polycrystal, an orientated polycrystal, and a single crystal onto the sintered compact which comprises aluminum nitride as a main component is effective for raising the crystallinity of the single-crystal thin film which comprises as a main component at least one selected from gallium nitride, indium nitride, and aluminum nitride and which is formed furthermore on the thin film which has at least one of the crystallization states selected from an amorphous state, a polycrystal, an orientated polycrystal, and a single crystal, etc.

Such an effect may be generated without too much influence by the quality of a sintered compact, such as the optical permeability of a sintered compact which comprises aluminum nitride as a main component and is used as a substrate, the size of particles of a sintered compact, and the composition or purity of the sintered compact, etc., or by the thickness of a substrate, the surface smooth nature of a substrate, and the existence of the conduction via in a substrate, etc.

Of course, in the sintered compact which comprises aluminum nitride as a main component, when what has high optical transmissivity, what grew the size of the aluminum nitride particle in a sintered compact by performing the firing at high temperature for a long time in manufacture of the sintered compact, and what raised the purity of this sintered compact by vaporizing the sintering aids, etc. are used as a substrate, for example, as mentioned above, a single-crystal thin film which comprises as a main component at least one selected from gallium nitride, indium nitride, and aluminum nitride and whose half width of the rocking curve of the X-ray diffraction line from the lattice plane of the Miller Index (002) is not more than 100 seconds can be formed directly on the substrate originally, even when the substrate which comprises such sintered compact which comprises aluminum nitride as a main component is used, a single-crystal thin film in which the half width of the rocking curve of the X-ray diffraction line from the lattice plane of the Miller Index (002) is at least not more than 100 seconds can be formed, when a thin film which comprises as a main component at least one selected from gallium nitride, indium nitride, and aluminum nitride and which has at least one of the crystallization states selected from a single crystal, an amorphous state, a polycrystal, and an orientated polycrystal is formed beforehand on the substrate, and a single-crystal thin film which comprises as a main component at least one selected from gallium nitride, indium nitride, and aluminum nitride is formed furthermore on it.

If another view is carried out, as for the sintered compact which comprises aluminum nitride as a main component and which can form directly a single-crystal thin film which comprises as a main component at least one selected from gallium nitride, indium nitride, and aluminum nitride and is the crystallinity in which the half width of the rocking curve of the X-ray diffraction line from the lattice plane of the Miller Index (002) is at least not more than 100 seconds, it can say that it originally has the excellent characteristic as a substrate for forming a single-crystal thin film because the above single-crystal thin film excellent in crystallinity which comprises as a main component at least one selected from gallium nitride, indium nitride, and aluminum nitride can be formed even if a thin film which comprises as a main component at least one selected from gallium nitride, indium nitride, and aluminum nitride and which has at least one of the crystallization states selected from a single crystal, an amorphous state, a polycrystal, and an orientated polycrystal is not formed beforehand, and even if what kind of method is used.

In this invention, as mentioned above, although a single-crystal thin film which comprises as a main component at least one selected from gallium nitride, indium nitride, and aluminum nitride can be formed directly on the substrate which comprises a sintered compact which comprises aluminum nitride as a main component, and the crystallinity of the formed single-crystal thin film is high, if a thin film which has at least one of the crystallization states selected from a single crystal, an amorphous state, a polycrystal, and an orientated polycrystal is formed beforehand on the substrate which comprises a sintered compact which comprises aluminum nitride as a main component, and a single-crystal thin film is formed furthermore on the thin film which has at least one of the crystallization states selected from a single crystal, an amorphous state, a polycrystal, and an orientated polycrystal, the crystallinity of the single-crystal thin film will become easy to be improved furthermore as mentioned above.

In the above thin film which forms beforehand on the substrate which comprises a sintered compact which comprises aluminum nitride as a main component and which comprises as a main component at least one selected from gallium nitride, indium nitride, and aluminum nitride, if the thin film which has at least one of the crystallization states selected from the amorphous state, the polycrystal, and the orientated polycrystal is used, the effect of raising more the crystallinity of a single-crystal thin film which is formed on it is large than the single crystal.

That is, when a thin film which comprises as a main component at least one selected from gallium nitride, indium nitride, and aluminum nitride and which has at least one of the crystallization states selected from an amorphous state, a polycrystal, and an orientated polycrystal is formed beforehand on the substrate which comprises a sintered compact which comprises aluminum nitride as a main component, and a single-crystal thin film which comprises as a main component at least one selected from gallium nitride, indium nitride, and aluminum nitride is formed furthermore on the thin film which has the crystallization states, what is the high crystallinity, such that the half width of the rocking curve of the X-ray diffraction line from the lattice plane of the Miller Index (002) of the single-crystal thin film is not more than 100 seconds, is easy to be obtained.

On the other hand, when a single-crystal thin film which comprises as a main component at least one selected from gallium nitride, indium nitride, and aluminum nitride is formed beforehand on the substrate which comprises a sintered compact which comprises aluminum nitride as a main component, and a single-crystal thin film which comprises as a main component at least one selected from gallium nitride, indium nitride, and aluminum nitride is formed furthermore on that single-crystal thin film, though a thing, such that the half width of the rocking curve of the X-ray diffraction line from the lattice plane of the Miller Index (002) of the single-crystal thin film is not more than 100 seconds, is obtained depending on the case, it does not necessarily restrict that the thing with high crystallinity of not more than 100 seconds is obtained, what is not less than 100 seconds may be formed depending on the conditions.

Although the reason is not necessarily clear, this inventor is surmising that it is to become easy to produce distortion in the crystal orientation of a single-crystal thin film which grows on it depending on the formation condition, because the surface smooth nature of the single-crystal thin film of the state where it is formed directly on the substrate which comprises a sintered compact which comprises aluminum nitride as a main component is usually smaller (surface roughness is larger) than the thin film which has the crystallization state of an amorphous state, a polycrystal, and an orientated polycrystal and is in the state where it was formed directly on the substrate in many cases, and probably, it is easy to produce the fine unevenness which exists in such substrate surface.

In this invention, in a thin film which is formed beforehand on the substrate which comprises a sintered compact which comprises aluminum nitride as a main component and which has at least one of the crystallization states selected from a single crystal, an amorphous state, a polycrystal, and an orientated polycrystal, if the thin film which has at least one of the crystallization states selected from an amorphous state, a polycrystal and an orientated polycrystal is formed and a single-crystal thin film is formed furthermore on that thin film, a single-crystal thin film which is excellent in surface smooth nature will be easy to be obtained, so it is desirable.

That is, while the average surface roughness Ra of a single-crystal thin film which is formed furthermore on the single-crystal thin film usually tends to become larger than 3 nm when the thin film which is formed beforehand on the substrate which comprises a sintered compact which comprises aluminum nitride as a main component is a single crystal, the average surface roughness Ra of a single-crystal thin film which is formed furthermore on the thin film which has at least one of the crystallization states selected from an amorphous state, a polycrystal, and an orientated polycrystal usually tends to become not more than 3 nm when the thin film which is formed beforehand on the substrate which comprises a sintered compact which comprises aluminum nitride as a main component is what has at least one of the crystallization states selected from an amorphous state, a polycrystal, and an orientated polycrystal.

And, among the thin film which is formed beforehand on the substrate which comprises a sintered compact which comprises aluminum nitride as a main component and which has at least one of the crystallization states selected from a single crystal, an amorphous state, a polycrystal, and an orientated polycrystal, a thin film which is orientated polycrystalline state is formed, and when a single-crystal thin film will be formed furthermore on the orientated polycrystalline thin film, the single-crystal thin film which is furthermore excellent in surface smooth nature will be easy to be obtained, so it is desirable.

That is, while the average surface roughness Ra of the single-crystal thin film which is formed furthermore on the amorphous thin film and the polycrystalline thin film usually tends to become larger than 2 nm when a thin film which is formed beforehand on the substrate which comprises a sintered compact which comprises aluminum nitride as a main component is an amorphous thin film and a polycrystalline thin film, when the thin film which is formed beforehand on the substrate which comprises a sintered compact which comprises aluminum nitride as a main component is an orientated polycrystal, the average surface roughness Ra of the single-crystal thin film which is formed furthermore on the orientated polycrystalline thin film tends to become at least not more than 2 nm, usually tends to become not more than 1.5 nm, furthermore, what is not more than 1.0 nm is also comparatively easy to be obtained.

Thus, if the single-crystal thin film in which Ra is not more than 2 nm is used as a part of film layer which constitutes a light-emitting device, etc. as it is, or if a light-emitting device, etc. is formed on it using the thin-film substrate which formed a single-crystal thin film in which Ra is not more than 2 nm, there is an effect wherein it can manufacture a thing in which the characteristics, such as luminous efficiency, are more excellent.

As for the thin film which is formed beforehand on the substrate which comprises a sintered compact which comprises aluminum nitride as a main component and which comprises as a main component at least one selected from gallium nitride, indium nitride, and aluminum nitride, it explained that it is more desirable to use a thin film which has at least one of the crystallization states selected from an amorphous state, a polycrystal, and an orientated polycrystal, compared with a single crystal, as mentioned above.

Moreover, in this invention, in the thin film which comprises as a main component at least one selected from gallium nitride, indium nitride, and aluminum nitride and has at least one of the crystallization states selected from an amorphous state, a polycrystal, and an orientated polycrystal and which is formed beforehand on the substrate which comprises a sintered compact which comprises aluminum nitride as a main component, it is more desirable to use an orientated polycrystalline thin film.

As for the reason, if the thin film which comprises as a main component at least one selected from gallium nitride, indium nitride, and aluminum nitride and which is formed beforehand on the substrate which comprises a sintered compact which comprises aluminum nitride as a main component is an orientated polycrystal, it is because it is easy to obtain a thing superior to the thin film of an amorphous state and a polycrystalline state as the surface smooth nature of the single-crystal thin film formed furthermore on it, and it is easy to acquire a thing superior to the crystallinity of the single-crystal thin film as mentioned above.

Usually, when an orientated polycrystal thin film which comprises as a main component at least one selected from gallium nitride, indium nitride, and aluminum nitride is formed beforehand on the substrate using at least the same substrate which comprises a sintered compact which comprises aluminum nitride as a main component, in the single-crystal thin film formed furthermore on the orientated polycrystalline thin film, it is easy to obtain a thing more excellent in crystallinity, compared with a thing in which the thin film formed beforehand is amorphous and polycrystal.

For example, when a light-emitting device is produced by the thin film which comprises as a main component at least one selected from gallium nitride, indium nitride, and aluminum nitride and which grew epitaxially on the thin-film substrate which formed beforehand the thin film which comprises as a main component at least one selected from gallium nitride, indium nitride, and aluminum nitride and which has at least one of the crystallization states selected from a single crystal, an amorphous state, a polycrystal, and an orientated polycrystal, onto the substrate which comprises a sintered compact which comprises aluminum nitride as a main component, or when a light-emitting device is produced by the thin film which comprises as a main component at least one selected from gallium nitride, indium nitride, and aluminum nitride and which grew epitaxially on the thin-film substrate which formed furthermore a single-crystal thin film which comprises as a main component at least one selected from gallium nitride, indium nitride, and aluminum nitride, onto the thin film which comprises as a main component at least one selected from gallium nitride, indium nitride, and aluminum nitride and has at least one of the crystallization states selected from a single crystal, an amorphous state, a polycrystal, and an orientated polycrystal and which is formed beforehand on the substrate which comprises a sintered compact which comprises aluminum nitride as a main component, etc., a thing in which the characteristics, such as luminous efficiency, etc., are superior is easy to be obtained if it is a thing in which the thin film formed beforehand has at least one of the crystallization states selected from an amorphous state, a polycrystal, and an orientated polycrystal, compared with a single crystal, and a thing in which the characteristics, such as luminous efficiency, etc., are more superior is easy to be obtained if it is a thing in which the thin film formed beforehand is an orientated polycrystal, compared with a thing which has at least one ofthe crystallization states selected from an amorphous state and a polycrystal.

Such an effect is same, not only in the case where a sintered compact which comprises aluminum nitride as a main component is used as a substrate but also in the case where various sintered compacts which comprise as a main component a ceramic material which has the crystal system which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., are used as a substrate.

That is, when a thin film which comprises as a main component at least one selected from gallium nitride, indium nitride, and aluminum nitride and which has at least one of the crystallization states selected from a single crystal, an amorphous state, a polycrystal, and an orientated polycrystal is formed beforehand on the substrate which comprises various sintered compacts which comprise as a main component a ceramic material which has the crystal system which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., and a single-crystal thin film which comprises as a main component at least one selected from gallium nitride, indium nitride, and aluminum nitride is formed furthermore on it, the single-crystal thin film can form not only a thing in which the half width of the rocking curve of the X-ray diffraction line from the lattice plane of the Miller Index (002) is at least not more than 300 seconds but also a thing which is high crystallinity not more than 200 seconds.

In such thin film constitution, even when a single-crystal thin film which comprises as a main component at least one selected from gallium nitride, indium nitride, and aluminum nitride is formed furthermore on it, using the substrate which formed beforehand a total of two layers of thin films, wherein a thin film which comprises as a main component at least one selected from gallium nitride, indium nitride, and aluminum nitride and which has at least one of the crystallization states selected from a single crystal, an amorphous state, a polycrystal, and an orientated polycrystal is formed beforehand on the substrate which comprises various sintered compacts which comprise as a main component a ceramic material which has the crystal system which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., and a thin film which comprises as a main component at least one selected from gallium nitride, indium nitride, and aluminum nitride and which has at least one of the crystallization states selected from a single crystal, an amorphous state, a polycrystal, and an orientated polycrystal is formed furthermore on it, the single-crystal thin film formed in the 2nd layer or the 3rd layer can form not only a thing in which the half width of the rocking curve of the X-ray diffraction line from the lattice plane of the Miller Index (002) is at least not more than 300 seconds but also a thing which is high crystallinity not more than 200 seconds.

Such an effect is also acquired similarly in the case where what formed beforehand a total of three or more layers of thin films is used as a substrate, in addition to the case where only one layer or two layers of thin films which comprise as a main component at least one selected from gallium nitride, indium nitride, and aluminum nitride and which have at least one of the crystallization states selected from a single crystal, an amorphous state, a polycrystal, and an orientated polycrystal are formed beforehand on the substrate which comprises various sintered compacts which comprise as a main component a ceramic material which has the crystal system which can be classified as a hexagonal system, such as silicon carbide, silicon nitride, gallium nitride, zinc oxide, and beryllium oxide, etc., and can be classified as a trigonal system or a hexagonal system, such as aluminum oxide, etc.

That is, when a single-crystal thin film which comprises as a main component at least one selected from gallium nitride, indium nitride, and aluminum nitride is formed furthermore on the substrate which comprises various sintered compacts which formed beforehand three or more layers of thin films which comprise as a main component at least one selected from gallium nitride, indium nitride, and aluminum nitride and which have at least one of the crystallization states selected from a single crystal, an amorphous state, a polycrystal, and an orientated polycrystal and which comprise as a main component a ceramic material which has the crystal system which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., the single-crystal thin film can form not only a thing in which the half width of the rocking curve of the X-ray diffraction line from the lattice plane of the Miller Index (002) is at least not more than 300 seconds but also a thing which is high crystallinity not more than 200 seconds.

For example, if it is going to form a single-crystal thin film which comprises as a main component at least one selected from gallium nitride, indium nitride, and aluminum nitride and which is high crystallinity in which the half width of the rocking curve of the X-ray diffraction line from the lattice plane of the Miller Index (002) is not more than 200 seconds, directly onto the substrate which comprises various sintered compacts which comprise as a main component a ceramic material which has the crystal system which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., it is usually difficult also by devices, such as by growing the size of crystal grains in a sintered compact, by using the sintered compact with optical permeability, by raising the surface smooth nature of a substrate, and by increasing the thickness of a single-crystal thin film, etc., for example, in many cases, as mentioned above.

However, in this invention, as mentioned above, if a thin film which comprises as a main component at least one selected from gallium nitride, indium nitride, and aluminum nitride and which has at least one ofthe crystallization states selected from a single crystal, an amorphous state, a polycrystal, and an orientated polycrystal is formed beforehand on the substrate which comprises various sintered compacts which comprise as a main component a ceramic material which has the crystal system which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., and a single-crystal thin film which comprises as a main component at least one selected from gallium nitride, indium nitride, and aluminum nitride is formed furthermore on it, as for the single-crystal thin film, what is higher crystallinity is easy to be obtained without too much influence by the size of crystal grains of a sintered compact used as a substrate, the surface smooth nature of a substrate, and the thickness of a thin film, etc., or even if being influenced.

That is, in this invention, a single-crystal thin film which has higher crystallinity is producible without being influenced too much by the material of various sintered compacts which comprise as a main component a ceramic material which has the crystal system which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., or the quality of a substrate, such as surface smooth nature, etc., or even if being influenced.

As mentioned above, in this invention, while a single-crystal thin film which comprises as a main component at least one selected from gallium nitride, indium nitride, and aluminum nitride can be formed directly on the substrate which comprises various sintered compacts which comprise as a main component a ceramic material which has the crystal system which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., and the single-crystal thin film can form what is high crystallinity, the crystallinity of the single-crystal thin film will become easy to be improved furthermore if a single-crystal thin film is formed furthermore on the substrate using the thing in which a thin film which has at least one of the crystallization states selected from a single crystal, an amorphous state, a polycrystal, and an orientated polycrystal is formed beforehand on the substrate which comprises various sintered compacts which comprise as a main component a ceramic material which has the crystal system which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., as mentioned above.

In the above thin film which comprises as a main component at least one selected from gallium nitride, indium nitride, and aluminum nitride and which is formed beforehand on the substrate which comprises various sintered compacts which comprise as a main component a ceramic material which has the crystal system which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., if the thin film which has at least one of the crystallization states selected from an amorphous state, a polycrystal, and an orientated polycrystal is used, an effect of raising more the crystallinity of the single-crystal thin film which is formed on that thin film is large compared with a single crystal, so it is more desirable.

That is, when a thin film which comprises as a main component at least one selected from gallium nitride, indium nitride, and aluminum nitride and which has at least one of the crystallization states selected from an amorphous state, a polycrystal, and an orientated polycrystal is formed beforehand on the substrate which comprises various sintered compacts which comprise as a main component a ceramic material which has the crystal system which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., and a single-crystal thin film which comprises as amain component at least one selected from gallium nitride, indium nitride, and aluminum nitride is formed furthermore on it, what is the high crystallinity, such that the half width of the rocking curve of the X-ray diffraction line from the lattice plane of the Miller Index (002) of the single-crystal thin film is not more than 200 seconds, is easy to be obtained.

On the other hand, when a single-crystal thin film which comprises as a main component at least one selected from gallium nitride, indium nitride, and aluminum nitride is formed beforehand on the substrate which comprises various sintered compacts which comprise as a main component a ceramic material which has the crystal system which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., and a single-crystal thin film which comprises as a main component at least one selected from gallium nitride, indium nitride, and aluminum nitride is formed furthermore on it, it does not necessarily restrict that a thing with high crystallinity wherein the half width of the rocking curve of the X-ray diffraction line from the lattice plane of the Miller Index (002) of the single-crystal thin film is not more than 200 seconds can be obtained, a thing of not less than 200 seconds is formed depending on the case.

Although the reason is not necessarily clear, as for the surface smooth nature of a single-crystal thin film in the condition where it was formed directly on the substrate which comprises various sintered compacts which comprise as a main component a ceramic material which has the crystal system which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., it is usually smaller (surface roughness is larger) compared with the thin film which has at least one of the crystallization states selected from an amorphous state, a polycrystal, and an orientated polycrystal and is in the condition where it was formed on the substrate in many cases, so it is probably easy to produce a fine unevenness which exists in such substrate surface, and this inventor is surmising that it becomes easy to produce distortion in the crystal orientation of a single-crystal thin film which grows on it depending on the formation condition.

Moreover, in the above thin film which comprises as a main component at least one selected from gallium nitride, indium nitride, and aluminum nitride and which is formed beforehand on the substrate which comprises various sintered compacts which comprise as a main component a ceramic material which has the crystal system which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., if the thin film which has the crystallization state of an orientated polycrystal is used, an effect of raising more the crystallinity of the single-crystal thin film formed on it is larger than an amorphous state and a polycrystal, so it is still more desirable.

That is, when using the substrate which formed beforehand a thin film which comprises as a main component at least one selected from gallium nitride, indium nitride, and aluminum nitride and which has the crystallization state of an orientated polycrystal and which comprises various sintered compacts which comprise as a main component a ceramic material which has the crystal system which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., a thing with high crystallinity, such that the half width of the rocking curve of the X-ray diffraction line from the lattice plane of the Miller Index (002) of the single-crystal thin film formed on it is not more than 150 seconds, is easy to be obtained.

On the other hand, when using the substrate which formed beforehand a thin film which comprises as a main component at least one selected from gallium nitride, indium nitride, and aluminum nitride and which has the crystallization state of an amorphous state and a polycrystal and which comprises various sintered compacts which comprise as a main component a ceramic material which has the crystal system which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., it does not necessarily restrict that a thing with high crystallinity in which the half width of the rocking curve of the X-ray diffraction line from the lattice plane of the Miller Index (002) of the single-crystal thin film formed on it is not more than 150 seconds can be obtained.

Although the reason is not necessarily clear, as for the surface smooth nature of an amorphous thin film and a polycrystal thin film which were formed directly on the substrate which comprises various sintered compacts which comprise as a main component a ceramic material which has the crystal system which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., it is usually smaller (surface roughness is larger) compared with the orientated polycrystal thin film formed directly on the substrate in many cases, so it is probably easy to produce a fine unevenness which exists in such substrate surface, and this inventor is surmising that it becomes easy to produce distortion in the crystal orientation of a single-crystal thin film which grows on it depending on the formation condition.

For example, when producing a light-emitting device by the thin film which comprises as a main component at least one selected from gallium nitride, indium nitride, and aluminum nitride and is grown epitaxially on the thin-film substrate in which a thin film which comprises as a main component at least one selected from gallium nitride, indium nitride, and aluminum nitride and which has at least one of the crystallization states selected from a single crystal, an amorphous state, a polycrystal, and an orientated polycrystal was formed beforehand on the substrate which comprises various sintered compacts which comprise as a main component a ceramic material which has the crystal system which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., when producing a light-emitting device by the thin film which comprises as a main component at least one selected from gallium nitride, indium nitride, and aluminum nitride and is grown epitaxially using the thin-film substrate which is obtained by forming furthermore a single-crystal thin film which comprises as a main component at least one selected from gallium nitride, indium nitride, and aluminum nitride on the thin film, wherein a thin film which comprises as a main component at least one selected from gallium nitride, indium nitride, and aluminum nitride and which has at least one of the crystallization states selected from a single crystal, an amorphous state, a polycrystal, and an orientated polycrystal was formed beforehand on the substrate which comprises various sintered compacts which comprise as a main component a ceramic material which has the crystal system which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., a thing in which the characteristics, such as luminous efficiency, etc., are superior is easy to be obtained if it is a thing in which the thin film formed beforehand has at least one of the crystallization states selected from an amorphous state, a polycrystal, and an orientated polycrystal, compared with a single crystal, and a thing in which the characteristics, such as luminous efficiency, etc., are more superior is easy to be obtained if it is a thing in which the thin film formed beforehand is an orientated polycrystal, compared with a thing which is amorphous and polycrystal.

As mentioned above, if a thin film which comprises as a main component at least one selected from gallium nitride, indium nitride, and aluminum nitride and which has at least one of the crystallization states selected from a single crystal, an amorphous state, a polycrystal, and an orientated polycrystal is formed beforehand on the substrate which comprises a sintered compact which comprises aluminum nitride as a main component or various sintered compacts which comprise as a main component a ceramic material which has the crystal system which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., and a single-crystal thin film which comprises as amain component at least one selected from gallium nitride, indium nitride, and aluminum nitride is formed furthermore on it, the single-crystal thin film excellent in crystallinity can be formed easily.

In this invention, although a single-crystal thin film which comprises as a main component at least one selected from gallium nitride, indium nitride, and aluminum nitride can be formed directly on the substrate which comprises a sintered compact which comprises aluminum nitride as a main component and various sintered compacts which comprise as a main component a ceramic material which has the crystal system which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., and the crystallinity of a single-crystal thin film formed directly on the substrate is influenced by the composition of a sintered compact used as a substrate, the optical permeability of a sintered compact, the size of the crystal grain in a sintered compact, or the surface smooth nature of a substrate, etc.

However, on the other hand, as mentioned above, if a thin film which comprises as the main comprises as a main component at least one selected from gallium nitride, indium nitride, and aluminum nitride and which has at least one of the crystallization states selected from an amorphous state, a polycrystal, an orientated polycrystal, and a single crystal is formed beforehand on the substrate which comprises a sintered compact which comprises aluminum nitride as a main component and various sintered compacts which comprise as a main component a ceramic material which has the crystal system which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., and a single-crystal thin film which comprises as a main component at least one selected from gallium nitride, indium nitride, and aluminum nitride is formed furthermore on it, it becomes possible to form a single-crystal thin film with higher crystallinity comparatively easily without too much being influenced by the size of crystal grains in a sintered compact or by the surface smooth nature of the substrate which comprises a sintered compact which comprises aluminum nitride as a main component and various sintered compacts which comprise as a main component a ceramic material which has the crystal system which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., or even if being influenced.

In this invention, if a thin film which comprises as a main component at least one selected from gallium nitride, indium nitride, and aluminum nitride and which has at least one of the crystallization states selected from an amorphous state, a polycrystal, an orientated polycrystal, and a single crystal is formed beforehand, a single-crystal thin film excellent in crystallinity can be formed easily in the substrate, as mentioned above, even if it is in what kind of state, such as an as-fired state, a state of lap polish, a state of specular surface polish, and a state of blast polish, or even if the surface state of a substrate is in what kind of state by grinding processing, polish processing, and slot end processing, etc. for example, in addition to this, as the smooth nature of the surface of a substrate which comprises a sintered compact which comprises as a main component aluminum nitride and various sintered compacts which comprise as a main component a ceramic material which has the crystal system which can be classified as a hexagonal system, such as silicon carbide, silicon nitride, gallium nitride, zinc oxide, and beryllium oxide, etc., and can be classified as a trigonal system or a hexagonal system, such as aluminum oxide, etc.

That is, even if the smooth nature of the surface of a substrate is small, namely, even if it is a substrate with large average surface roughness Ra, if a thin film which comprises as a main component at least one selected from gallium nitride, indium nitride, and aluminum nitride and which has at least one of the crystallization states selected from an amorphous state, a polycrystal, an orientated polycrystal, and a single crystal is formed beforehand, a single-crystal thin film excellent in crystallinity can be formed easily in the substrate, as mentioned above.

Usually, in the case of the substrate which comprises a sintered compact which comprises aluminum nitride as a main component, although a single-crystal thin film which comprises as a main component at least one selected from gallium nitride, indium nitride, and aluminum nitride cannot be formed directly on the substrate whose average surface roughness Ra is larger than 2000 nm, such as the as-fired surface or the surface which processed lap polish, or blast polish, etc., in many cases, if a thin film which comprises as a main component at least one selected from gallium nitride, indium nitride, and aluminum nitride and which has at least one of the crystallization states selected from an amorphous state, a polycrystal, an orientated polycrystal, and a single crystal is formed beforehand on the substrate as mentioned above, a single-crystal thin film excellent in crystallinity not more than 300 seconds as half width of the rocking curve of the X-ray diffraction line from the lattice plane of a Miller Index (002) of the single-crystal thin film which comprises as a main component at least one selected from gallium nitride, indium nitride, and aluminum nitride can be formed comparatively easily, even if the average surface roughness Ra of the substrate is larger than 2000 nm.

In the case of the substrate which comprises various sintered compacts which comprise as a main component a ceramic material which has the crystal system which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., although a single-crystal thin film which comprises as a main component at least one selected from gallium nitride, indium nitride, and aluminum nitride cannot be formed directly on the substrate whose average surface roughness Ra is larger than 1000 nm, such as the as-fired surface, or the surface which processed lap polish or blast polish, etc., in many cases, if a thin film which comprises as a main component at least one selected from gallium nitride, indium nitride, and aluminum nitride and which has at least one of the crystallization states selected from an amorphous state, a polycrystal, an orientated polycrystal, and a single crystal is formed beforehand on the substrate as mentioned above, a single-crystal thin film excellent in crystallinity not more than 300 seconds as half width of the rocking curve of the X-ray diffraction line from the lattice plane of a Miller Index (002) of the single-crystal thin film which comprises as a main component at least one selected from gallium nitride, indium nitride, and aluminum nitride can be formed comparatively easily, even if the average surface roughness Ra of the substrate is larger than 1000 nm.

In this invention, as for the crystal grain in the various sintered compacts which are used as a substrate and which comprise as a main component a ceramic material which has the crystal system which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., what was sintered without making it grow up in about 0.5 µm for example, namely, in the same state as the size of particles of raw material powder, can also be used, a single-crystal thin film which comprises as a main component at least one selected from gallium nitride, indium nitride, and aluminum nitride and has the crystallinity not more than 3600 seconds as half width of the rocking curve of the X-ray diffraction line from the lattice plane of the Miller Index (002) can be formed directly on such substrate.

Usually, a sintered compact which comprises the crystal grain of an average of not less than 1 µm is used as a substrate.

That is, when using as a substrate the various sintered compacts which comprise the crystal grain with an average not less than 1 µm and which comprise as a main component a ceramic material which has the crystal system which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., a single-crystal thin film which comprises as a main component at least one selected from gallium nitride, indium nitride, and aluminum nitride and has the crystallinity not more than 3600 seconds as half width of the rocking curve of the X-ray diffraction line from the lattice plane of the Miller Index (002) can be formed directly on this substrate.

If the size of the crystal grain inside the above various sintered compacts which comprise a ceramic material as a main component grows, the crystallinity of a thin film which comprises as a main component at least one selected from gallium nitride, indium nitride, and aluminum nitride and is formed on the substrate will tend to be improved.

That is, in the sintered compact which has an average of not less than 5 µm as the size of the crystal grain contained in the inside of the above various sintered compacts which comprise a ceramic material as a main component, what has the crystallinity, such that the half width of the rocking curve of the X-ray diffraction line from the lattice plane of the Miller Index (002) of the single-crystal thin film which comprises as a main component at least one selected from gallium nitride, indium nitride, and aluminum nitride and is formed on the substrate is not more than 2000 seconds, can be formed directly.

Moreover, in the sintered compact which has an average of not less than 8 µm as the size of the crystal grain which is contained in the inside of the above various sintered compacts which comprise a ceramic material as a main component, what has good crystallinity, such that the half width of the rocking curve of the X-ray diffraction line from the lattice plane of the Miller Index (002) of the single-crystal thin film which comprises as a main component at least one selected from gallium nitride, indium nitride, and aluminum nitride and is formed on the substrate is not more than 1000 seconds, can be formed directly.

And, in the sintered compact which has an average of not less than 15 µm as the size of the crystal grain which is contained in the inside of the above various sintered compacts which comprise a ceramic material as a main component, what has better crystallinity, such that the half width of the rocking curve of the X-ray diffraction line from the lattice plane of the Miller Index (002) of the single-crystal thin film which comprises as a main component at least one selected from gallium nitride, indium nitride, and aluminum nitride and is formed on the substrate is not more than 300 seconds, can be formed directly.

And, in the sintered compact which has an average of not less than 25 µm as the size of the crystal grain which is contained in the inside of the above various sintered compacts which comprise a ceramic material as a main component, what has better crystallinity, such that the half width of the rocking curve of the X-ray diffraction line from the lattice plane of the Miller Index (002) of the single-crystal thin film which comprises as a main component at least one selected from gallium nitride, indium nitride, and aluminum nitride and is formed on the substrate is not more than 240 seconds, can be formed directly.

In addition, the size of the crystal grain contained inside the above various sintered compacts which comprise a ceramic material as a main component is an average magnitude, not only what is in the state where the crystal grain contained has gathered in the nearly equal size but also what has the irregular size of a crystal grain, or what contains the crystal grain in which the form is distorted and the crystal grain of the form wherein one side is small and one side is large, such as the needle-like or board-like form wherein one side is several µm and the other side grew up into about 10 µm or more greatly, for example, such as beta-Si₃N₄ particle in the sintered compact which comprises silicon nitride as a main component, etc., can be used satisfactorily in this invention.

The size of the crystal grain contained inside the above various sintered compacts which comprise a ceramic material as a main component is controllable using the firing condition independently or together, such as raising the firing temperature or lengthening the firing time.

However, in this invention, as mentioned above, if a thin film which comprises as a main component at least one selected from gallium nitride, indium nitride, and aluminum nitride and which has at least one ofthe crystallization states selected from an amorphous state, a polycrystal, an orientated polycrystal, and a single crystal is formed beforehand on the substrate which comprises various sintered compacts which comprise as a main component a ceramic material which has the crystal system which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., and a single-crystal thin film which comprises as a main component at least one selected from gallium nitride, indium nitride, and aluminum nitride is formed furthermore on it, the single-crystal thin film can produce a thing with comparatively good crystallinity without too much being influenced by the size of the crystal grain inside the above various sintered compacts which comprise a ceramic material as a main component, and by the surface smooth nature of the substrate which comprises the sintered compact, etc.

As mentioned above, although a single-crystal thin film with good crystallinity is formed on it using a substrate which formed a thin film which comprises as a main component at least one selected from gallium nitride, indium nitride, and aluminum nitride and has at least one of the crystallization states selected from an amorphous state, a polycrystal, an orientated polycrystal, and a single crystal, etc., it is possible to improve the crystallinity of the single-crystal thin film furthermore in this invention.

That is, it can be furthermore improved by improvement of the surface smooth nature of the substrate which comprises various sintered compacts which comprise as a main component a ceramic material which has the crystal system which can be classified as a hexagonal system, such as silicon carbide, silicon nitride, gallium nitride, zinc oxide, and beryllium oxide, etc., and can be classified as a trigonal system or a hexagonal system, such as aluminum oxide, etc.

If saying more concretely, when the average surface roughness Ra of the substrate which used the above various sintered compacts which comprise a ceramic material is larger than 10 nm, as for the orientated polycrystalline thin film which is formed beforehand on the substrate and comprises as a main component at least one selected from gallium nitride, indium nitride, and aluminum nitride, the half width of the rocking curve of the X-ray diffraction line from the lattice plane of the Miller Index (002) tends to become larger than 10000 seconds, and a single-crystal thin film formed on the orientated polycrystalline thin film which has such crystallinity has the tendency wherein the half width of the rocking curve of the X-ray diffraction line from the lattice plane of the Miller Index (002) is easy to become larger than 150 seconds.

On the other hand, when the average surface roughness Ra of the substrate which comprises the above various sintered compacts which comprise a ceramic material as a main component is not more than 10 nm, the half width of the rocking curve of the X-ray diffraction line from the lattice plane of the Miller Index (002) of the above orientated polycrystalline thin film formed beforehand on the substrate tends to become not more than 10000 seconds, and the half width of the rocking curve of the X-ray diffraction line from the lattice plane of the Miller Index (002) of the single-crystal thin film formed on the orientated polycrystalline thin film with such crystallinity has the tendency which is easy to become not more than 150 seconds.

Moreover, as for the average surface roughness Ra of the substrate which comprises various sintered compacts which comprise as a main component a ceramic material which has the crystal system which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., when it is not more than 5 nm, the half width of the rocking curve of the X-ray diffraction line from the lattice plane of the Miller Index (002) of the above orientated polycrystalline thin film formed beforehand on the substrate is easy to become not more than 8000 seconds, and the half width of the rocking curve of the X-ray diffraction line from the lattice plane of the Miller Index (002) of the single-crystal thin film formed on the orientated polycrystalline thin film of such crystallinity has the tendency which is easy to become not more than 130 seconds, it usually tends to become not more than 120 seconds.

As for the average surface roughness Ra of the substrate which comprises the above various sintered compacts which comprise as a main component a ceramic material which has the crystal system which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., when it is not more than 5 nm, although the half width of the rocking curve of the X-ray diffraction line from the lattice plane of the Miller Index (002) of the single-crystal thin film formed on it has the tendency easy to become not more than 130 seconds when the thin film has at least one of the crystallization states selected from an amorphous state, a polycrystal, and a single crystal, among the thin films which are formed beforehand on the substrate and comprise as a main component at least one selected from gallium nitride, indium nitride, and aluminum nitride, the crystallinity of the single-crystal thin film formed furthermore on it tends to become more excellent, if the thin film formed beforehand on the substrate is the crystallization state of an orientated polycrystal, as mentioned above.

In this invention, in the substrate which formed beforehand a thin film having at least one of the crystallization states selected from a single crystal, an amorphous state, a polycrystal, and an orientated polycrystal and which comprises various sintered compacts which comprise as a main component a ceramic material which has the crystal system which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., if the substrate which formed the thin film which has at least one of the crystallization states selected from an amorphous state, a polycrystal, and an orientated polycrystal is used, a thing with more excellent surface smooth nature of the single-crystal thin film which forms on it is usually easy to be obtained, so it is desirable.

While the average surface roughness Ra of the single-crystal thin film furthermore formed on it is usually larger than 3 nm when the thin film formed beforehand on a substrate is a single crystal, the average surface roughness Ra of the single-crystal thin film formed on it is usually at least not more than 3 nm when the thin film formed beforehand on a substrate is what has at least one of the crystallization states selected from an amorphous state, a polycrystal, and an orientated polycrystal.

When the thin film of an orientated polycrystal is formed beforehand on the substrate which comprises various sintered compacts which comprise as a main component a ceramic material which has the crystal system which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., what is the most excellent surface smooth nature of a single-crystal thin film formed on it is usually easy to be obtained, so it is still more desirable.

Although the average surface roughness Ra of the single-crystal thin film formed on it tends to become larger than 2 nm usually when the thin film which is formed beforehand on the substrate is an amorphous state and a polycrystal, the average surface roughness Ra of the single-crystal thin film which is formed furthermore on it tends to become at least not more than 2 nm, usually tends to become not more than 1.5 nm, furthermore what is not more than 1.0 nm is also comparatively easy to be obtained, when the thin film which is formed beforehand on the substrate is an orientated polycrystal.

Thus, if the single-crystal thin film in which Ra is not more than 2 nm is used as a part of a film layer which constitutes the electric devices such as a light-emitting device, etc. as it is, or if the electric devices such as, a light-emitting device, etc., are formed on it using the substrate in which a single-crystal thin film in which Ra is not more than 2 nm is formed, there is an effect wherein a thing in which the characteristics, such as luminous efficiency, are more excellent can be manufactured.

When it is going to form a light-emitting device on the substrate in which such single-crystal thin film with high crystallinity was formed, or when the single-crystal thin film with high crystallinity is used directly as a part of the thin film which constitutes a light-emitting device, the luminous efficiency of the formed light-emitting device tends to increase, so it is desirable.

If a thin film which comprises at least one selected from gallium nitride, indium nitride, and aluminum nitride and which has at least one of the crystallization states selected from a single crystal, an amorphous state, a polycrystal, and an orientated polycrystal is formed beforehand on the substrate which comprises a sintered compact which comprises aluminum nitride as a main component or the substrate which comprises various sintered compacts which comprise as a main component a ceramic material which has the crystal system which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., and a single-crystal thin film which comprises at least one selected from gallium nitride, indium nitride, and aluminum nitride is formed furthermore on it, it becomes easy to control the C axis crystal orientation of the single-crystal thin film into the direction perpendicular to a substrate surface or the direction parallel to a substrate surface.

In the thing in which the C axis crystal orientation of the single-crystal thin film was formed to the direction perpendicular to a substrate surface, as for the X-ray diffraction pattern in which the single-crystal thin film shows, the diffraction line from the diffracting plane of the Miller Index (002) appears, and the diffraction line from the diffracting plane of the Miller Index (100) does not appear.

And, in the thing in which the C axis crystal orientation of the single-crystal thin film was formed to the direction parallel to a substrate surface, as for the X-ray diffraction pattern in which the single-crystal thin film shows, since the diffraction line from the diffracting plane of the Miller Index (100) appears and the diffraction line from the diffracting plane of the Miller Index (002) does not appear, the azimuth of the single-crystal thin film can be distinguished easily.

As mentioned above, in this invention, if a single-crystal thin film is formed on the substrate in which the thin film is formed, using the substrate in which at least one layer of a thin film which comprises at least one selected from gallium nitride, indium nitride, and aluminum nitride and has at least one of the crystallization states selected from a single crystal, an amorphous state, a polycrystal, and an orientated polycrystal was formed beforehand on the substrate which comprises a sintered compact which comprises aluminum nitride as a main component and various sintered compacts which comprise as a main component a ceramic material which has the crystal system which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., the crystallinity of the single-crystal thin film can be improved furthermore.

The reason which this phenomenon produces is explained concretely below by using the sintered compact which comprises aluminum nitride as a main component, as an example.

That is, when a single-crystal thin film which comprises at least one selected from gallium nitride, indium nitride, and aluminum nitride is formed directly on the sintered compact which comprises aluminum nitride as a main component, the crystallinity of the formed single-crystal thin film tends to be influenced by the quality of the material of the sintered compact which comprises aluminum nitride as a main component, such as the optical transmissivity of the sintered compact which comprises aluminum nitride as a main component, the chemical composition, and the size of crystal grains, etc.

For example, including an aluminum nitride component not less than 50 volume % is usually important when directly forming a good single-crystal thin film, as a sintered compact which comprises aluminum nitride as a main component.

If there is a fewer content of an aluminum nitride component than 50 volume %, since the direct formation of a good single-crystal thin film is hard to be carried out or the thin film of a polycrystalline state is easy to be formed, it may not be desirable.

On the other hand, if a single-crystal thin film is formed on the substrate which formed beforehand the thin film using the substrate which comprises a sintered compact which comprises aluminum nitride as a main component and which formed beforehand a thin film which has at least one of the crystallization states selected from a single crystal, an amorphous state, a polycrystal, and an orientated polycrystal, there is a feature wherein the crystallinity of the formed single-crystal thin film becomes hard to be influenced by the quality of the material of the sintered compact which comprises aluminum nitride as a main component, such as the optical transmissivity of a sintered compact which comprises aluminum nitride as a main component, the chemical composition, and the size of crystal grains, etc.

That is, for example, even if the content of an aluminum nitride component of a sintered compact which comprises aluminum nitride as a main component is smaller than 50 volume %, if a substrate in which a thin film which has at least one of the crystallization states selected from a single crystal, an amorphous state, a polycrystal, and an orientated polycrystal was formed beforehand on it is used, a thin film which is formed on it and which comprises as a main component at least one selected from gallium nitride, indium nitride, and aluminum nitride becomes hard to be made into polycrystal, and a single-crystal thin film which is comparatively excellent in crystallinity can be formed.

As for such phenomenon, the effect is the same, even if one or two or more doping components, such as Si, Ge, Se, Te, O which give N-type semiconductor characteristics, and Mg, Be, Ca, Zn, Cd, C which give P type semiconductor characteristics, etc., are included in the thin film of various crystallization states, such as a single crystal, an amorphous state, a polycrystal, and an orientated polycrystal.

Experimentally, a thin film which has at least one of the crystallization states selected from a single crystal, an amorphous state, a polycrystal, and an orientated polycrystal can be formed beforehand on the sintered compact which comprises aluminum nitride as a main component and contains an aluminum nitride component not less than 20 volume % at least, if what formed the thin film is used as a substrate, it was confirmed that the single-crystal thin film which comprises at least one selected from gallium nitride, indium nitride, and aluminum nitride and has the crystallinity in which the half width of the rocking curve of the X-ray diffraction line from the lattice plane of the Miller Index (002) is not more than 300 seconds can be formed on it.

Moreover, if a thing in which a thin film which has at least one of the crystallization states selected from a single crystal, an amorphous state, a polycrystal, and an orientated polycrystal was formed on the sintered compact which comprises aluminum nitride as a main component and contains an aluminum nitride component not less than 50 volume % is used as a substrate, it was confirmed that the single-crystal thin film which comprises at least one selected from gallium nitride, indium nitride, and aluminum nitride and has the crystallinity in which the half width of the rocking curve of the X-ray diffraction line from the lattice plane of the Miller Index (002) is not more than 240 seconds can be formed on it

In the above sintered compact which comprises aluminum nitride as a main component and contains an aluminum nitride component not less than 20 volume %, for example, a thing which contains at least one of the components selected from a rare earth element and an alkaline earth metal not more than 80 volume % on an oxide basis, or a thing which contains at least one of the components selected from Mo, W, V, Nb, Ta, Ti, and carbon not more than 80 volume % on an element basis, or a thing which contains ALON not more than 80 %, can be used suitably, as a component other than aluminum nitride.

In the sintered compact which comprises aluminum nitride as a main component and contains an aluminum nitride component not less than 20 volume %, a thing in which the oxygen content is not more than 30 % by weight on an element basis can be used suitably. If the oxygen content is not more than 30 % by weight, a sintered compact which comprises aluminum nitride as a main component and contains ALON not more than 80 % is easy to be obtained.

As for the above components, it may be a thing which contains only one independently, or it may be a thing which contains two or more simultaneously.

When two or more components are contained simultaneously, it may be a thing which contains one or more components from the above rare earth element and alkaline earth metal, and at least one selected from Mo, W, V, Nb, Ta, Ti, and carbon, and suitably two or more components selected from ALON and oxygen, or it may be a thing which contains suitably two or more components from rare earth element, or suitably two or more components from the alkaline earth metal, or suitably two or more components selected from Mo, W, V, Nb, Ta, Ti, and carbon, for example.

And, in the sintered compact which comprises aluminum nitride as a main component and contains an aluminum nitride component not less than 50 volume %, what contains each above component other than aluminum nitride not more than 50 volume %, and what contains at least one of the components selected from an alkali metal and silicon not more than 50 volume % on an oxide basis in addition to this, can also be used suitably.

In those, it is preferred to use the sintered compact which comprises aluminum nitride as a main component and contains an alkali metal not more than 30 volume % on an oxide basis.

And, as for the sintered compacts which comprise aluminum nitride as a main component and contain transition metal(s), for example, at least one of the components selected from iron, nickel, chromium, manganese, zirconium, hafnium, cobalt, copper, and zinc except a rare earth element and Mo, W, V, Nb, Ta, and Ti in not more than 80 % by weight on an element basis, they can also be used suitably as a substrate.

In this invention, as for the content of each component of the above transition metal, for example, iron, nickel, chromium, manganese, zirconium, hafnium, cobalt, copper, and zinc, other than a rare earth element and Mo, W, V, Nb, Ta, and Ti, it has been shown by weight percent (% by weight) on an element basis, but it can be recalculated by the density of these components into volume percentage (volume %) easily.

As for the above components, it may be a thing which contains only one independently, or it may be a thing which contains two or more simultaneously.

When two or more components are contained simultaneously, it may be a thing which contains suitably two or more components selected from suitably one or more components selected from the above alkaline metal and silicon, and suitably at least one selected from transition metals, for example, iron, nickel, chromium, manganese, zirconium, hafnium, cobalt, copper, and zinc, other than a rare earth element and Mo, W, V, Nb, Ta, and Ti, or it may be a thing which contains suitably two or more components selected from an alkaline metal and silicon, or suitably at least two selected from transition metals, for example, iron, nickel, chromium, manganese, zirconium, hafnium, cobalt, copper, and zinc, other than a rare earth element and Mo, W, V, Nb, Ta, and Ti.

As mentioned above, in the substrate which comprises a sintered compact which comprises as a main component zirconium oxide (ZrO₂), magnesium oxide (MgO), and magnesium aluminate (MgAl₂O₄), etc., it is difficult to form directly a single-crystal thin film which comprises as a main component at least one selected from gallium nitride, indium nitride, and aluminum nitride in many cases.

However, it was found out that it can be formed directly on the above substrate, if the thin film is a thing which comprises as a main component at least one selected from gallium nitride, indium nitride, and aluminum nitride and has at least one of the crystallization states selected from an amorphous state, a polycrystal, and an orientated polycrystal.

Moreover, in this invention, if a thin film which comprises as a main component at least one selected from gallium nitride, indium nitride, and aluminum nitride and has at least one of the crystallization states selected from an amorphous state, a polycrystal, and an orientated polycrystal is formed beforehand on the substrate which comprises the above sintered compacts which comprise as a main component zirconium oxide, magnesium oxide, and magnesium aluminate, etc., it was also found out that a single-crystal thin film which comprises as a main component at least one selected from gallium nitride, indium nitride, and aluminum nitride and has the crystallinity in which the half width of the rocking curve of the X-ray diffraction line from the lattice plane of the Miller Index (002) is not more than 3600 seconds can be formed on it.

Moreover, for example, various sintered compacts which comprise as a main component a ceramic material, such as titanium oxide (TiO₂), barium titanate (BaTiO₃), lead titanate zirconate (PZT), rare earth oxides such as yttrium oxide (Y₂O₃), thorium oxide (ThO₂), various ferrites (Fe₃O₄, etc.), mullite (3Al₂O₃·2SiO₂), forsterite (2MgO· SiO₂), steatite (MgO·SiO₂), and glass, etc., can also be used as a substrate, and it was found out that it can also be formed directly on that substrate if the thin film is a thing which comprises as a main component at least one selected from gallium nitride, indium nitride, and aluminum nitride and has at least one of the crystallization states selected from an amorphous state, a polycrystal, and an orientated polycrystal.

Moreover, if what formed beforehand a thin film which comprises as a main component at least one selected from gallium nitride, indium nitride, and aluminum nitride and has at least one of the crystallization states selected from an amorphous state, a polycrystal, and an orientated polycrystal is used as a substrate, it was also found out that a single-crystal thin film which comprises as a main component at least one selected from gallium nitride, indium nitride, and aluminum nitride and has the crystallinity in which the half width of the rocking curve of the X-ray diffraction line from the lattice plane of the Miller Index (002) is not more than 3600 seconds can be formed on it.

Using the substrate in which the average surface roughness was made into not more than 50nm by grinding the surface of the substrate which comprises the above various sintered compacts which comprise as a main component a ceramic material, such as zirconium oxide, magnesium oxide, magnesium aluminate, titanium oxide, barium titanate, lead titanate zirconate, rare earth oxides such as yttrium oxide, thorium oxide, various ferrites, mullite, forsterite, steatite, and glass, etc., by the method of specular surface polish or others, if a thin film which comprises as a main component at least one selected from gallium nitride, indium nitride, and aluminum nitride and has at least one of the crystallization states selected from an amorphous state, a polycrystal, and an orientated polycrystal is formed beforehand, a single-crystal thin film which comprises as a main component at least one selected from gallium nitride, indium nitride, and aluminum nitride and has the crystallinity in which the half width of the rocking curve of the X-ray diffraction line from the lattice plane of a Miller Index (002) is not more than 300 seconds can be formed on it.

And, a single-crystal thin film which has the crystallinity in which the half width of the rocking curve is not more than 200 seconds can be formed on the substrate made into average surface roughness not more than 10 nm.

And, a single-crystal thin film which has the crystallinity in which the half width of the rocking curve is not more than 150 seconds can be formed on the substrate made into average surface roughness not more than 5 nm.

Moreover, an orientated polycrystalline thin film in which the half width of the rocking curve of the X-ray diffraction line from the lattice plane of a Miller Index (002) is not more than 10000 seconds and which comprises as a main component at least one selected from gallium nitride, indium nitride, and aluminum nitride can be formed beforehand on the substrate made into the average surface roughness not more than 10 nm.

And, an orientated polycrystalline thin film in which the half width of the rocking curve of the X-ray diffraction line from the lattice plane of a Miller Index (002) is not more than 8000 seconds and which comprises as a main component at least one selected from gallium nitride, indium nitride, and aluminum nitride can be formed beforehand on the substrate made into the average surface roughness not more than 5 nm.

As the method in which a single-crystal thin film which comprises at least one selected from indium nitride, and aluminum nitride is formed furthermore, after a thin film which comprises at least one selected from gallium nitride, indium nitride, and aluminum nitride and has at least one of the above crystallization states selected from a single crystal, an amorphous state, a polycrystal, and an orientated polycrystal was formed beforehand on the substrate which comprises a sintered compact which comprises aluminum nitride as a main component, and in the various sintered compacts which comprise as a main component a ceramic material which has the crystal system which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., and in the various sintered compacts which comprise as a main component a ceramic material, such as zirconium oxide, magnesium oxide, magnesium aluminate, titanium oxide, barium titanate, lead titanate zirconate, rare earth oxides such as yttrium oxide, thorium oxide, various ferrites, mullite, forsterite, steatite, and glass, etc., the followings can be illustrated, for example.

That is, there are methods, such as the method of forming a single-crystal thin film anew after taking out the substrate on which a thin film which has at least one of the crystallization states selected from a single crystal, an amorphous state, a polycrystal, and an orientated polycrystal was formed from a film deposition apparatus, or the method wherein the temperature of a substrate is set up low at first, an amorphous thin film is formed first on the substrate, the temperature of the substrate is raised gradually or continuously in the condition where the substrate is as it is, and a single-crystal thin film is formed gradually or continuously, etc.

As for the thin film which is formed on the substrate which comprises a sintered compact which comprises aluminum nitride as a main component, or in the substrate which comprises various sintered compacts which comprise as a main component a ceramic material which has the crystal system which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., or in the substrate which comprises various sintered compacts which comprise as a main component a ceramic material, such as zirconium oxide, magnesium oxide, magnesium aluminate, titanium oxide, barium titanate, lead titanate zirconate, rare earth oxides such as yttrium oxide, thorium oxide, various ferrites, mullite, forsterite, steatite, and glass, etc., it can be formed not only as a single layer but also as a thin film which comprises at least two layers, as mentioned above.

A substrate which has a conduction via is also included as the above substrate which comprises a sintered compact which comprises aluminum nitride as a main component, and substrate which comprises various sintered compacts which comprise a ceramic material as a main component.

This thin film which is formed as a thin film which comprises two or more layers can be formed also as the same composition or as what comprises a different component, respectively, furthermore, in the thin film of three or more layers, all can be formed as the same composition, or it can be formed as a thin film layer in which two or more layers are the same composition and another one or more layers are the different composition, furthermore, it can be formed as thin film layers in which the composition is different altogether.

As for the constitution of the thin film formed in two or more layers in the substrate which comprises a sintered compact which comprises aluminum nitride as a main component, and on the substrate which comprises various sintered compacts which comprise as a main component a ceramic material which has the crystal system which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., and on the substrate which comprises various sintered compacts which comprise as a main component a ceramic material, such as zirconium oxide, magnesium oxide, magnesium aluminate, titanium oxide, barium titanate, lead titanate zirconate, rare earth oxides such as yttrium oxide, thorium oxide, various ferrites, mullite, forsterite, steatite, and glass, etc., not only a thing which has the different composition in each thin film layer but also a thing which has the same crystallization state in each thin film layer or has the different crystallization state in each thin film layer, such as a single crystal, an amorphous state, a polycrystal, an orientated polycrystal, etc., for example, can be formed on the substrate which comprises a sintered compact which comprises aluminum nitride as a main component, and on the substrate which comprises various sintered compacts which comprise as a main component a ceramic material which has the crystal system which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., and on the substrate which comprises various sintered compacts which comprise as a main component a ceramic material, such as zirconium oxide, magnesium oxide, magnesium aluminate, titanium oxide, barium titanate, lead titanate zirconate, rare earth oxides such as yttrium oxide, thorium oxide, various ferrites, mullite, forsterite, steatite, and glass, etc., as mentioned above.

That is, in the substrate which comprises a sintered compact which comprises aluminum nitride as a main component, and the substrate which comprises various sintered compacts which comprise as a main component a ceramic material which has the crystal system which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., and the substrate which comprises various sintered compacts which comprise as a main component a ceramic material, such as zirconium oxide, magnesium oxide, magnesium aluminate, titanium oxide, barium titanate, lead titanate zirconate, rare earth oxides such as yttrium oxide, thorium oxide, various ferrites, mullite, forsterite, steatite, and glass, etc., two or more layers of thin films which comprise at least one selected from gallium nitride, indium nitride, and aluminum nitride can be formed, what has any state selected from a single crystal, an amorphous state, a polycrystal, and an orientated polycrystal at least can be formed without being restricted in each thin film layer in these thin films which are being constituted with two or more layers.

When the thin film layer comprises two layers, there are what comprises two layers in which the crystallization state is same and what comprises each layer in which the crystallization state is different. If what comprises two layers in which the crystallization state is same is illustrated, for example,
1) what comprises two layers in which all of each layer is a single crystal state,
2) what comprises two layers in which all of each layer is amorphous, etc.,
   and if what comprises each layer in which the crystallization state is different is illustrated, for example,
3) the thin film in the side of a substrate is amorphous and the thin film which is being formed on it is single crystal, or
4) the thin film in the side of a substrate is polycrystal and the thin film which is being formed on it is single crystal, or
5) the thin film in the side of a substrate is orientated polycrystal and the thin film which is being formed on it is single crystal, etc.

When the above thin film layer comprises two layers, what has at least four kinds of crystallization states, such as a single crystal, an amorphous state, a polycrystal, and an orientated polycrystal, can be formed as the thin film in the side of a substrate, and the thin film which is formed on it can form what has at least four kinds of crystallization states, such as a single crystal, an amorphous state, a polycrystal, and an orientated polycrystal, respectively, so formation of two-layer thin film which comprises the combination of a total of 16 kinds is possible.

When the thin film layer comprises three layers, there are what comprises three layers in which the crystallization state is same, what comprises three layers in which the crystallization state is different respectively, and what comprises three layers in which the crystallization states of two layers are same and one is different, for example, if what comprises three layers in which the crystallization states are same is illustrated,
1) what comprises three layers in which all of each layer is a single crystal state,
2) what comprises three layers in which all of each layer is amorphous, etc., if what comprises three layers in which the crystallization state is different respectively is illustrated,
3) the thin film in the side of a substrate is amorphous and the thin film which is being formed on it is polycrystal and the thin film which is being formed on it is single crystal, if what comprises three layers in which the crystallization states of two layers are same and one is different is illustrated,
4) the thin film in the side of a substrate is amorphous and the two layers of the thin film which is being formed on it are both single crystal, etc.

When the above thin film layer comprises three layers, as the thin film in the side of a substrate what has at least four kinds of crystallization states, such as a single crystal, an amorphous state, a polycrystal, and an orientated polycrystal, can be formed, as the thin film which is formed on it what has at least four kinds of crystallization states, a single crystal, an amorphous state, a polycrystal, and an orientated polycrystal, can be formed respectively, and as the thin film which is formed on it what has at least four kinds of crystallization states, a single crystal, an amorphous state, a polycrystal, and an orientated polycrystal, can be formed furthermore respectively, so formation of three-layer thin film which comprises the combination of a total of at least 64 kinds in which the crystallization states differ is possible.

As for the thin film with four or more layers, as mentioned above, if the thin film is a four-layer, they are at least 256 kinds, if the thin film is a five-layer, they are at least 1024 kinds, if the thin film is a six-layer, they are at least 4096 kinds, if the thin film is a seven-layer, they are at least 16384 kinds, if the thin film is eight more layers, they are at least the combination of 65536 kinds, etc., so formation of all the multilayered films in which the crystallization states differ by combining the crystallization state of each layer arbitrarily is possible.

In this invention, as for the thickness in each layer of the thin film which comprises as a main component at least one selected from gallium nitride, indium nitride, and aluminum nitride and is formed in two or more layers onto the substrate which comprises a sintered compact which comprises aluminum nitride as a main component, and onto the substrate which comprises various sintered compacts which comprise as a main component a ceramic material which has the crystal system which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., and onto the substrate which comprises various sintered compacts which comprise as a main component a ceramic material, such as zirconium oxide, magnesium oxide, magnesium aluminate, titanium oxide, barium titanate, lead titanate zirconate, rare earth oxides such as yttrium oxide, thorium oxide, various ferrites, mullite, forsterite, steatite, and glass, etc., arbitrary combination is also possible.

Usually, the thickness of each thin film layer is used, respectively, combining suitably a thing of the range of 0.5 nm-1000 µm, or a thing of the range of 0.5 nm-200 µm.

Thus, in this invention, as for the thin film which comprises as a main component at least one selected from gallium nitride, indium nitride, and aluminum nitride and is being formed on the thin-film substrate in which a thin film which comprises as a main component at least one selected from gallium nitride, indium nitride, and aluminum nitride is formed on the sintered compact which comprises aluminum nitride as a main component, and in the various sintered compacts which comprise as a main component a ceramic material which has the crystal system which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., and in the various sintered compacts which comprise as a main component a ceramic material, such as zirconium oxide, magnesium oxide, magnesium aluminate, titanium oxide, barium titanate, lead titanate zirconate, rare earth oxides such as yttrium oxide, thorium oxide, various ferrites, mullite, forsterite, steatite, and glass, etc., not only what is a single crystallization state but also what comprises a constitution which combined two or more different crystallization states which are either which is selected from a single crystal, an amorphous state, a polycrystal, and an orientated polycrystal at least suitably can be used.

As for the combination of the crystallization state of such thin film, for example, when a thin film comprises two different crystallization states, at least four kinds of crystallization states, such as a single crystal, an amorphous state, a polycrystal, and an orientated polycrystal, can be formed as a thin film in the side of a substrate which comprises a sintered compact which comprises aluminum nitride as a main component, and at least four kinds of crystallization states, such as a single crystal, an amorphous state, a polycrystal, and an orientated polycrystal, can be formed respectively as a thin film which is formed on it, so a thing which combined a total of 12 kinds of crystallization state can be formed in the case of the thin film which comprises two different crystallization states.

And, for example, when a thin film comprises three different crystallization states respectively, at least 4 kinds of crystallization states, such as a single crystal, an amorphous state, a polycrystal, and an orientated polycrystal, can be formed as a thin film in the side of a substrate which comprises a sintered compact which comprises aluminum nitride as a main component, at least 4 kinds of crystallization states, such as a single crystal, an amorphous state, a polycrystal, and an orientated polycrystal, can be formed as a thin film which is formed on it, and at least 4 kinds of crystallization states, such as a single crystal, an amorphous state, a polycrystal, and an orientated polycrystal, can be formed respectively as a thin film which is formed furthermore on it, so the combination of a total of 36 kinds is possible in the thin film which comprises three different crystallization states.

Moreover, the combination of a different crystallization state can be formed infinitely, like the combination of 108 kinds is possible in the thin film which comprises four different crystallization states as mentioned above, the combination of 324 kinds is possible in the thin film which comprises five different crystallization states, the combination of 972 kinds is possible in the thin film which comprises six different crystallization states, the combination of 2916 kinds is possible in the thin film which comprises seven different crystallization states, and the combination of 8748 kinds is possible in the thin film which comprises eight different crystallization states.

As for the thin-film substrate according to this invention, it is a thing in which at least a single-crystal thin film is formed, even if each layer comprises various crystallization states, such as a single crystal, an amorphous state, a polycrystal, and an orientated polycrystal, and comprises a thing in which also the composition differs in each thin film layer and a thing in which also the thickness differs in each layer, in the case where the thin film being formed is multilayered.

As for the crystallinity of the single-crystal thin film being formed on the above thin-film substrate, what is formed on it using the substrate which formed beforehand a thin film of various crystallization states, such as a single crystal, an amorphous state, a polycrystal, and an orientated polycrystal, is usually superior to what is formed directly on the substrate.

As for the thin film which is formed on the thin-film substrate of this invention, it contains at least a single-crystal thin film even if each layer comprises various crystallization states, such as a single crystal, an amorphous state, a polycrystal, and an orientated polycrystal, and comprises a thing in which also the composition differs in each thin film layer and a thing in which also the thickness differs in each layer, in the case where the thin film being formed is multilayered.

Meaning wherein components differ in the thin film which comprises at least two layers is that the substantial composition ofa thin film differs, as composition of a thin film, not only the thing in which the rate of the component which comprises at least one selected from gallium nitride, indium nitride, and aluminum nitride and which is the main components of the thin film differs but also the case where the main component of the thin film is only one kind of material selected from gallium nitride, indium nitride, and aluminum nitride and the other component is only a doping agent substantially, etc., for example, is included.

Speaking more concretely, in the case of the thin film which comprises only gallium nitride as a main component and includes substantially only a magnesium (Mg) as a doping agent in addition to this, a thing from which the composition ratio of the gallium nitride and magnesium differs is also contained.

Or similarly, in the case of the thin film which comprises only aluminum nitride as a main component and includes substantially only a silicon (Si) as a doping agent in addition to this, a thing from which the composition ratio of the aluminum nitride and silicon differs is also contained.

In this invention, in the substrate which comprises a sintered compact which comprises aluminum nitride as a main component, not only a thin film which comprises as a main component at least one selected from gallium nitride, indium nitride, and aluminum nitride and has the same component can be formed directly as a single layer or two or more layers, but also it can be formed as a thin film of at least two layers which comprises different components, as mentioned above.

Even if the thin film is what formed the same component in two or more layers or is what formed what has a different component in two or more layers, the single-crystal thin film which has the crystallinity, such that the half width of the rocking curve of the X-ray diffraction line from the lattice plane of a Miller Index (002) is not more than 240 seconds, can be obtained, if each thin film formed is a single crystal.

And, when the above mentioned thin film which comprises two or more layers is formed using the substrate which comprises various sintered compacts which comprise as a main component a ceramic material which has the crystal system which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., a thin film which comprises as a main component at least one selected from gallium nitride, indium nitride, and aluminum nitride and is excellent in crystallinity, such that the half width of the rocking curve of the X-ray diffraction line from the lattice plane of the Miller Index (002) is not more than 300 seconds, can be obtained, so it is preferred.

In this invention, as mentioned above, as for the thin film which was formed on the substrate which comprises a sintered compact which comprises aluminum nitride as a main component, or in the substrate which comprises various sintered compacts which comprise as a main component a ceramic material which has the crystal system which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., or in the substrate which comprises various sintered compacts which comprise as a main component a ceramic material, such as zirconium oxide, magnesium oxide, magnesium aluminate, titanium oxide, barium titanate, lead titanate zirconate, rare earth oxides such as yttrium oxide, thorium oxide, various ferrites, mullite, forsterite, steatite, and glass, etc., it can be formed not only as a single layer but also as a thin film which comprises at least two layers which contain a single-crystal thin film.

In this invention, as the above thin film which can be formed in two or more layers which contain a single-crystal thin film, not only the thin film which can be formed on the substrate for thin-film formation which comprises a sintered compact which comprises aluminum nitride as a main component, or the various sintered compacts which comprise as a main component a ceramic material which has the crystal system which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., or the substrate which comprises various sintered compacts which comprise as a main component a ceramic material, such as zirconium oxide, magnesium oxide, magnesium aluminate, titanium oxide, barium titanate, lead titanate zirconate, rare earth oxides such as yttrium oxide, thorium oxide, various ferrites, mullite, forsterite, steatite, and glass, etc., but also the thin film being formed on the thin-film substrate of this invention is contained.

That is, in this invention, the above thin film which can be formed in the two or more layers contains two thin films, that is the thin film which can be formed on the substrate for thin-film formation, and the thin film which is formed on the thin-film substrate.

It was shown clearly that these thin films can be formed not only as a single layer but also as a thin film which contains at least two layers of a single-crystal thin film.

As mentioned above, this invention provides the substrate for thin-film formation which comprises a sintered compact which comprises aluminum nitride as a main component and which can form a thin film which comprises at least one selected from gallium nitride, indium nitride, and aluminum nitride and has at least one of the crystallization states selected from an amorphous state, a polycrystal, an orientated polycrystal, and a single crystal.

Moreover, this invention also provides the thin-film substrate in which a thin film which comprises at least one selected from gallium nitride, indium nitride, and aluminum nitride and has at least one of the crystallization states selected from an amorphous state, a polycrystal, an orientated polycrystal, and a single crystal is being formed on the substrate which comprises a sintered compact which comprises aluminum nitride as a main component.

And, this invention also provides the substrate for thin-film formation which comprises various sintered compacts which can form a thin film comprising at least one selected from gallium nitride, indium nitride, and aluminum nitride and having at least one of the crystallization states selected from an amorphous state, a polycrystal, an orientated polycrystal, and a single crystal and which comprise as a main component a ceramic material which has the crystal system which can be classified as a hexagonal system, such as silicon carbide, silicon nitride, gallium nitride, zinc oxide, and beryllium oxide, etc., and can be classified as a trigonal system or a hexagonal system, such as aluminum oxide, etc.

Moreover, this invention also provides the thin-film substrate in which a thin film which comprises at least one selected from gallium nitride, indium nitride, and aluminum nitride and has at least one of the crystallization states selected from an amorphous state, a polycrystal, an orientated polycrystal, and a single crystal is being formed on the substrate which comprises various sintered compacts which comprise as a main component a ceramic material which has the crystal system which can be classified as a hexagonal system, such as silicon carbide, silicon nitride, gallium nitride, zinc oxide, and beryllium oxide, etc., and can be classified as a trigonal system or a hexagonal system, such as aluminum oxide, etc.

And, this invention also provides the substrate for thin-film formation which comprises various sintered compacts which can form a thin film comprising at least one selected from gallium nitride, indium nitride, and aluminum nitride and having at least one of the crystallization states selected from an amorphous state, a polycrystal, an orientated polycrystal, and a single crystal and which comprise as a main component a ceramic material, such as zirconium oxide, magnesium oxide, magnesium aluminate, titanium oxide, barium titanate, lead titanate zirconate, rare earth oxides such as yttrium oxide, thorium oxide, various ferrites, mullite, forsterite, steatite, and glass, etc.

Moreover, this invention also provides the thin-film substrate in which a thin film which comprises at least one selected from gallium nitride, indium nitride, and aluminum nitride and has at least one of the crystallization states selected from an amorphous state, a polycrystal, an orientated polycrystal, and a single crystal is being formed on the substrate which comprises various sintered compacts which comprise as a main component a ceramic material, such as zirconium oxide, magnesium oxide, magnesium aluminate, titanium oxide, barium titanate, lead titanate zirconate, rare earth oxides such as yttrium oxide, thorium oxide, various ferrites, mullite, forsterite, steatite, and glass, etc.

And, in this invention, a single-crystal thin film which comprises at least one selected from indium nitride, and aluminum nitride can formed on the sintered compact which comprises aluminum nitride as a main component, and in the various sintered compacts which comprise as a main component a ceramic material which has the crystal system which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., and in the various sintered compacts which comprise as a main component a ceramic material, such as zirconium oxide, magnesium oxide, magnesium aluminate, titanium oxide, barium titanate, lead titanate zirconate, rare earth oxides such as yttrium oxide, thorium oxide, various ferrites, mullite, forsterite, steatite, and glass, etc.

As for the single-crystal thin film, there is a thing which can be formed directly on the sintered compact by the difference in the ceramic material in each sintered compact, or is a thing which can be formed on it after forming beforehand a thin film which comprises at least one selected from gallium nitride, indium nitride, and aluminum nitride and which has at least one of the crystallization states selected from a single crystal, an amorphous state, a polycrystal, and an orientated polycrystal.

For example, a single-crystal thin film which comprises at least one selected from gallium nitride, indium nitride, and aluminum nitride can be formed directly on the sintered compact which comprises aluminum nitride as a main component, and on the various sintered compacts which comprise as a main component a ceramic material which has the crystal system which can be classified as a hexagonal system, such as silicon carbide, silicon nitride, gallium nitride, zinc oxide, and beryllium oxide, etc., and can be classified as a trigonal system or a hexagonal system, such as aluminum oxide, etc.

On the other hand, in the various sintered compacts which comprise as a main component a ceramic material, such as zirconium oxide, magnesium oxide, magnesium aluminate, titanium oxide, barium titanate, lead titanate zirconate, rare earth oxides such as yttrium oxide, thorium oxide, various ferrites, mullite, forsterite, steatite, and glass, etc., a single-crystal thin film which comprises at least one selected from gallium nitride, indium nitride, and aluminum nitride can be formed on it after forming beforehand a thin film which comprises at least one selected from gallium nitride, indium nitride, and aluminum nitride and has at least one of the crystallization states selected from an amorphous state, a polycrystal, and an orientated polycrystal.

Thus, according to this invention, a substrate for thin-film formation which comprises a sintered compact which comprises a ceramic material as a main component can be provided, and the substrate is a substrate for forming a single-crystal thin film which comprises as a main component at least one selected from gallium nitride, indium nitride, and aluminum nitride.

And, this invention can provide a thin-film substrate in which a single-crystal thin film which comprises as a main component at least one selected from gallium nitride, indium nitride, and aluminum nitride is being formed on the sintered compact which comprises a ceramic material as a main component.

And, according to this invention, a substrate for thin-film formation which comprises a sintered compact which comprises a ceramic material as a main component and has optical permeability can be provided, and the substrate is a substrate for forming a thin film which comprises as a main component at least one selected from gallium nitride, indium nitride, and aluminum nitride.

Moreover, this invention can provide a thin-film substrate in which a thin film which comprises as a main component at least one selected from gallium nitride, indium nitride, and aluminum nitride is being formed on the sintered compact which comprises a ceramic material as a main component.

In addition, the above ceramic material comprises the composite and compound between at least one selected from metallic elements and semimetal elements and at least one selected from nonmetallic elements, or comprises the composite and compound between at least one selected from metallic elements and at least one selected from semimetal elements, or comprises the composite and compound of at least two selected from semimetal elements, for example, aluminum nitride, a compound (for example, silicon carbide, silicon nitride, gallium nitride, zinc oxide, beryllium oxide, and aluminum oxide, etc.) which has at least one of the crystal structures selected from a hexagonal system or a trigonal system, zirconium oxide, magnesium oxide, magnesium aluminate, titanium oxide, barium titanate, lead titanate zirconate, rare earth oxides such as yttrium oxide, thorium oxide, various ferrites, mullite, forsterite, steatite, and glass, etc.

As the above nonmetallic elements, nitrogen, phosphorus, oxygen, sulfur, a halogen element (fluorine, chlorine, bromine, iodine, and astatine), etc. are usually used suitably.

As the semimetal elements, boron, carbon, silicon, germanium, arsenic, antimony, bismuth, selenium, a tellurium, polonium, etc. are usually used suitably.

The above ceramic material usually comprises an inorganic compound as a main component, such ceramic material may be a thing of crystalline material, or may be a thing of the amorphous state, such as glass, etc., for example, or may be a thing in which a crystalline material and an amorphous material are intermingled.

The above ceramic material usually comprises as a main component a compound or a composite, such as a nitride, a carbide, an oxide, a boride, and a silicide.

In addition, in this invention, as the above ceramic material, a thing which contains a metal, an alloy, an intermetallic compound, an organic substance, an organic compound, an organic resin, and a nonmetal, such as a halogen element or a chalcogen element, in addition to these, etc., is included other than an inorganic material which is the main components.

In this invention, as for the above sintered compact which comprises a ceramic material as a main component, what has optical permeability is preferred, and the crystallinity of a single-crystal thin film which comprises as a main component at least one selected from gallium nitride, indium nitride, and aluminum nitride and is formed on the sintered compact which comprises a ceramic material as a main component becomes easy to be improved, so it is desirable.

The above substrate for thin-film formation is mainly used, in order to form a thin film which comprises at least one selected from gallium nitride, indium nitride, and aluminum nitride and has various crystallization states, such as an amorphous state, a polycrystal, and an orientated polycrystal, including a single crystal.

And, the above thin-film substrate can also be mainly used in order to form a thin film which comprises at least one selected from gallium nitride, indium nitride, and aluminum nitride and has various crystallization states, such as an amorphous state, a polycrystal, and an orientated polycrystal, including a single crystal.

The substrate for a thin film and the thin-film substrate may be used for a light-emitting device, an optical waveguide, a piezo-electric film for surface acoustic wave devices, etc., or an insulator film and a dielectric film of wiring boards.

As mentioned above, this invention can provide two kinds of substrates, that is,
(1) a substrate for thin-film formation for forming a thin film which comprises as a main component at least one selected from gallium nitride, indium nitride, and aluminum nitride and which has various crystallization states, such as an amorphous state, a polycrystal, and an orientated polycrystal, including a single crystal,
(2) a thin-film substrate which formed a thin film which comprises as a main component at least one selected from gallium nitride, indium nitride, and aluminum nitride and has various crystallization states, such as an amorphous state, a polycrystal, and an orientated polycrystal, including a single crystal.

A single-crystal thin film which comprises as a main component at least one selected from gallium nitride, indium nitride, and aluminum nitride can be formed in the above two kinds of substrates.

As for these two kinds of substrates, what has a conduction via, respectively is also contained.

Saying more concretely about the above two kinds of substrates, they are the following two kinds, that is,
(1) a substrate for thin-film formation: what used as a substrate various sintered compacts which comprise a ceramic material, including aluminum nitride, as a main component, as it is,
(2) a thin-film substrate : what formed a thin film which comprises as a main component at least one selected from gallium nitride, indium nitride, and aluminum nitride and which has at least one of the crystallization states selected from an amorphous state, a polycrystal, and an orientated polycrystal, including a single crystal, in the various sintered compacts which comprise a ceramic material, including aluminum nitride, as a main component.

This invention provides these.

The single-crystal thin film which comprises as a main component at least one selected from gallium nitride, indium nitride, and aluminum nitride, respectively can be formed in the above two kinds of substrates.

And, as for these two kinds of substrates, what has a conduction via, respectively is also contained.

In addition, the above thin-film substrate can be used also as a substrate for thin-film formation.

It explained that this invention can provide two kinds of substrates of the substrate for thin-film formation and the thin-film substrate, as mentioned above.

In the two kinds of sbstrates, although it has explained that the substrate for thin-film formation is what used as a substrate various sintered compacts which comprise a ceramic material, including aluminum nitride, as a main component, as they are, this substrate for thin-film formation can use not only what used as the substrate a sintered compact which comprises aluminum nitride as a main component, and various sintered compacts which comprise as a main component a ceramic material which has the crystal system which can be classified as a hexagonal system or a trigonal system, such as silicon carbide, silicon nitride, gallium nitride, zinc oxide, beryllium oxide, and aluminum oxide, etc., and other various sintered compacts which comprise as a main component a ceramic material, such as zirconium oxide, magnesium oxide, magnesium aluminate, titanium oxide, barium titanate, lead titanate zirconate, rare earth oxides such as yttrium oxide, thorium oxide, various ferrites, mullite, forsterite, steatite, and glass, etc., as they are, but also what used as the substrate a thing in which a thin film which comprises as a main component at least one selected from gallium nitride, indium nitride, and aluminum nitride is formed on the sintered compact which comprises aluminum nitride as a main component and in the various sintered compacts which comprise as a main component a ceramic material, such as silicon carbide, silicon nitride, gallium nitride, zinc oxide, beryllium oxide, aluminum oxide, zirconium oxide, magnesium oxide, magnesium aluminate, titanium oxide, barium titanate, lead titanate zirconate, rare earth oxides such as yttrium oxide, thorium oxide, various ferrites, mullite, forsterite, steatite, and glass, etc.

That is, as for the substrate for thin-film formation according to this invention, it can use two kinds of substrates, that is, what used as the substrate a sintered compact which comprises aluminum nitride as a main component and various sintered compacts which comprise as a main component a ceramic material which has the crystal system which can be classified as a hexagonal system or a trigonal system, such as silicon carbide, silicon nitride, gallium nitride, zinc oxide, beryllium oxide, and aluminum oxide, etc., as they are, and what used as the substrate a thing in which a thin film which comprises as a main component at least one selected from gallium nitride, indium nitride, and aluminum nitride is formed on the sintered compact which comprises aluminum nitride as a main component, and in the various sintered compacts which comprise as a main component a ceramic material which has the crystal system which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., and in the other various sintered compacts which comprise as a main component a ceramic material, such as zirconium oxide, magnesium oxide, magnesium aluminate, titanium oxide, barium titanate, lead titanate zirconate, rare earth oxides such as yttrium oxide, thorium oxide, various ferrites, mullite, forsterite, steatite, and glass, etc. (that is, same quality as a thin-film substrate).

As mentioned above, a thin film which comprises as a main component at least one selected from gallium nitride, indium nitride, and aluminum nitride can be formed in various sintered compacts which comprise a ceramic material, including aluminum nitride, as a main component.

As mentioned above, what has the crystallization states, such as a single crystal and an amorphous state, a polycrystal, and an orientated polycrystal, can be used as a thin film which comprises as a main component at least one selected from gallium nitride, indium nitride, and aluminum nitride and which is formed on the sintered compact which comprises aluminum nitride as a main component, and in the various sintered compacts which comprise as a main component a ceramic material which has the crystal system which can be classified as a hexagonal system or a trigonal system, such as silicon carbide, silicon nitride, gallium nitride, zinc oxide, beryllium oxide, and aluminum oxide, etc., and in the other various sintered compacts which comprise as a main component a ceramic material, such as zirconium oxide, magnesium oxide, magnesium aluminate, titanium oxide, barium titanate, lead titanate zirconate, rare earth oxides such as yttrium oxide, thorium oxide, various ferrites, mullite, forsterite, steatite, and glass, etc.

And, as mentioned above, the thin film can use not only one crystallization state selected from a single crystal, an amorphous state, a polycrystal, and an orientated polycrystal but also at least two crystallization states selected from those crystallization states simultaneously.

And, as mentioned above, the thin film can use suitably not only single layer state but also that constituted with at least two layers.

And, as mentioned above, the thin film can use suitably not only a single composition but also that comprising at least two different compositions.

And, as mentioned above, the thin film can also use suitably that constituted with at least two layers in which at least two layers in each thin film layer comprise a different composition.

And, as mentioned above, even if the thin film has conductivity, it can be used suitably.

As for the crystallinity of the single-crystal thin film which comprises as a main component at least one selected from gallium nitride, indium nitride, and aluminum nitride and is formed on it using as the substate a thing in which a thin film which comprises as a main component at least one selected from gallium nitride, indium nitride, and aluminum nitride is formed beforehand on the sintered compact which comprises aluminum nitride as a main component, and in the various sintered compacts which comprise as a main component a ceramic material which has the crystal system which can be classified as a hexagonal system or a trigonal system, such as silicon carbide, silicon nitride, gallium nitride, zinc oxide, beryllium oxide, and aluminum oxide, etc., and in the other various sintered compacts which comprise as a main component a ceramic material, such as zirconium oxide, magnesium oxide, magnesium aluminate, titanium oxide, barium titanate, lead titanate zirconate, rare earth oxides such as yttrium oxide, thorium oxide, various ferrites, mullite, forsterite, steatite, and glass, etc., as mentioned above, it becomes easier to improve compared with the case where the sintered compact which comprises aluminum nitride as a main component and does not form the thin film is used as a substrate as it is.

As for the substrate in which a thin film which comprises as a main component at least one selected from gallium nitride, indium nitride, and aluminum nitride is formed in various sintered compacts which comprise a ceramic material, including aluminum nitride, as a main component, what has a conduction via is also contained.

In this invention, as mentioned above, two kinds of substrates can be used as a substrate for thin-film formation, namely, what used as a substrate various sintered compacts which comprise a ceramic material, including aluminum nitride, as a main component, as they are, and what used as a substrate various sintered compacts which comprise a ceramic material, including aluminum nitride, as a main component and formed a thin film which comprises as a main component at least one selected from gallium nitride, indium nitride, and aluminum nitride.

That is, as for the substrate for thin-film formation according to this invention, it includes what used as the substrate a sintered compact which comprises aluminum nitride as a main component, and various sintered compacts which comprise as a main component a ceramic material which has the crystal system which can be classified as a hexagonal system or a trigonal system, such as silicon carbide, silicon nitride, gallium nitride, zinc oxide, beryllium oxide, and aluminum oxide, etc., and other various sintered compacts which comprise as a main component a ceramic material, such as zirconium oxide, magnesium oxide, magnesium aluminate, titanium oxide, barium titanate, lead titanate zirconate, rare earth oxides such as yttrium oxide, thorium oxide, various ferrites, mullite, forsterite, steatite, and glass, etc., as they are, and includes what used a substrate which comprises a sintered compact in which a thin film which comprises as a main component at least one selected from gallium nitride, indium nitride, and aluminum nitride is being formed and which comprises aluminum nitride as a main component, and a substrate which comprises various sintered compacts in which a thin film which comprises as a main component at least one selected from gallium nitride, indium nitride, and aluminum nitride is being formed and which comprise as a main component a ceramic material which has the crystal system which can be classified as a hexagonal system or a trigonal system, such as silicon carbide, silicon nitride, gallium nitride, zinc oxide, beryllium oxide, and aluminum oxide, etc., and a substrate which comprises other various sintered compacts in which a thin film which comprises as a main component at least one selected from gallium nitride, indium nitride, and aluminum nitride is being formed and which comprise as a main component a ceramic material, such as zirconium oxide, magnesium oxide, magnesium aluminate, titanium oxide, barium titanate, lead titanate zirconate, rare earth oxides such as yttrium oxide, thorium oxide, various ferrites, mullite, forsterite, steatite, and glass, etc.

This invention also contains a thin-film substrate in which a thin film which comprises as a main component at least one selected from gallium nitride, indium nitride, and aluminum nitride is formed on the sintered compact which comprises aluminum nitride as a main component, and in the various sintered compacts which comprise as a main component a ceramic material which has the crystal system which can be classified as a hexagonal system or a trigonal system, such as silicon carbide, silicon nitride, gallium nitride, zinc oxide, beryllium oxide, and aluminum oxide, etc., and the other various sintered compacts which comprise as a main component a ceramic material, such as zirconium oxide, magnesium oxide, magnesium aluminate, titanium oxide, barium titanate, lead titanate zirconate, rare earth oxides such as yttrium oxide, thorium oxide, various ferrites, mullite, forsterite, steatite, and glass, etc.

As a crystallization state of the thin film being formed on the thin-film substrate of this invention, it may be what is not only a single crystal but also other than a single crystal state, such as an amorphous state, a polycrystal, an orientated polycrystal, etc.

If it says in more detail, as the crystallization state of the thin film being formed in the above thin-film substrate of this invention, it may be that which has at least one of the crystallization state selected from a single crystal, an amorphous state, a polycrystal, and an orientated polycrystal, for example, it may be a thin film which does not necessarily contain a single crystal and is only the amorphous state which comprises as a main component at least one selected from gallium nitride, indium nitride, and aluminum nitride.

As for such thin-film substrate according to this invention, if it is illustrated more concretely, for example,
1) A thin-film substrate in which a single-crystal thin film which comprises as a main component at least one selected from gallium nitride, indium nitride, and aluminum nitride is formed on a sintered compact which comprises aluminum nitride as a main component, and in various sintered compacts which comprise as a main component a ceramic material which has the crystal system which can be classified as a hexagonal system or a trigonal system, such as silicon carbide, silicon nitride, gallium nitride, zinc oxide, beryllium oxide, and aluminum oxide, etc., and in other various sintered compacts which comprise as a main component a ceramic material, such as zirconium oxide, magnesium oxide, magnesium aluminate, titanium oxide, barium titanate, lead titanate zirconate, rare earth oxides such as yttrium oxide, thorium oxide, various ferrites, mullite, forsterite, steatite, and glass, etc.,
   and, for example,
2) A thin-film substrate in which an amorphous thin film which comprises as a main component at least one selected from gallium nitride, indium nitride, and aluminum nitride is formed on a sintered compact which comprises aluminum nitride as a main component, and in various sintered compacts which comprise as a main component a ceramic material which has the crystal system which can be classified as a hexagonal system or a trigonal system, such as silicon carbide, silicon nitride, gallium nitride, zinc oxide, beryllium oxide, and aluminum oxide, etc., and in other various sintered compacts which comprise as a main component a ceramic material, such as zirconium oxide, magnesium oxide, magnesium aluminate, titanium oxide, barium titanate, lead titanate zirconate, rare earth oxides such as yttrium oxide, thorium oxide, various ferrites, mullite, forsterite, steatite, and glass, etc.,
   and, for example,
3) A thin-film substrate in which a polycrystalline thin film which comprises as a main component at least one selected from gallium nitride, indium nitride, and aluminum nitride is formed on a sintered compact which comprises aluminum nitride as a main component, and in various sintered compacts which comprise as a main component a ceramic material which has the crystal system which can be classified as a hexagonal system or a trigonal system, such as silicon carbide, silicon nitride, gallium nitride, zinc oxide, beryllium oxide, and aluminum oxide, etc., and in other various sintered compacts which comprise as a main component a ceramic material, such as zirconium oxide, magnesium oxide, magnesium aluminate, titanium oxide, barium titanate, lead titanate zirconate, rare earth oxides such as yttrium oxide, thorium oxide, various ferrites, mullite, forsterite, steatite, and glass, etc.,
   and, for example,
4) A thin-film substrate in which an orientated polycrystalline thin film which comprises as a main component at least one selected from gallium nitride, indium nitride, and aluminum nitride is formed on a sintered compact which comprises aluminum nitride as a main component, and in various sintered compacts which comprise as a main component a ceramic material which has the crystal system which can be classified as a hexagonal system or a trigonal system, such as silicon carbide, silicon nitride, gallium nitride, zinc oxide, beryllium oxide, and aluminum oxide, etc., and in other various sintered compacts which comprise as a main component a ceramic material, such as zirconium oxide, magnesium oxide, magnesium aluminate, titanium oxide, barium titanate, lead titanate zirconate, rare earth oxides such as yttrium oxide, thorium oxide, various ferrites, mullite, forsterite, steatite, and glass, etc.,
   and, for example,
5) A thin-film substrate in which an amorphous thin film which comprises as a main component at least one selected from gallium nitride, indium nitride, and aluminum nitride is formed on a sintered compact which comprises aluminum nitride as a main component, and in various sintered compacts which comprise as a main component a ceramic material which has the crystal system which can be classified as a hexagonal system or a trigonal system, such as silicon carbide, silicon nitride, gallium nitride, zinc oxide, beryllium oxide, and aluminum oxide, etc., and in other various sintered compacts which comprise as a main component a ceramic material, such as zirconium oxide, magnesium oxide, magnesium aluminate, titanium oxide, barium titanate, lead titanate zirconate, rare earth oxides such as yttrium oxide, thorium oxide, various ferrites, mullite, forsterite, steatite, and glass, etc., and a single-crystal thin film which comprises as a main component at least one selected from gallium nitride, indium nitride, and aluminum nitride is formed furthermore on it,
   and, for example,
6) A thin-film substrate in which a polycrystalline thin film which comprises as a main component at least one selected from gallium nitride, indium nitride, and aluminum nitride is formed on a sintered compact which comprises aluminum nitride as a main component, and in various sintered compacts which comprise as a main component a ceramic material which has the crystal system which can be classified as a hexagonal system or a trigonal system, such as silicon carbide, silicon nitride, gallium nitride, zinc oxide, beryllium oxide, and aluminum oxide, etc., and in other various sintered compacts which comprise as a main component a ceramic material, such as zirconium oxide, magnesium oxide, magnesium aluminate, titanium oxide, barium titanate, lead titanate zirconate, rare earth oxides such as yttrium oxide, thorium oxide, various ferrites, mullite, forsterite, steatite, and glass, etc., and a single-crystal thin film which comprises as a main component at least one selected from gallium nitride, indium nitride, and aluminum nitride is formed furthermore on it,
   and, for example,
7) A thin-film substrate in which an orientated polycrystalline thin film which comprises as a main component at least one selected from gallium nitride, indium nitride, and aluminum nitride is formed on a sintered compact which comprises aluminum nitride as a main component, and in various sintered compacts which comprise as a main component a ceramic material which has the crystal system which can be classified as a hexagonal system or a trigonal system, such as silicon carbide, silicon nitride, gallium nitride, zinc oxide, beryllium oxide, and aluminum oxide, etc., and in other various sintered compacts which comprise as a main component a ceramic material, such as zirconium oxide, magnesium oxide, magnesium aluminate, titanium oxide, barium titanate, lead titanate zirconate, rare earth oxides such as yttrium oxide, thorium oxide, various ferrites, mullite, forsterite, steatite, and glass, etc., and a single-crystal thin film which comprises as a main component at least one selected from gallium nitride, indium nitride, and aluminum nitride is formed furthermore on it,
   and, for example,
8) A thin-film substrate in which a single-crystal thin film which comprises as a main component at least one selected from gallium nitride, indium nitride, and aluminum nitride is formed on a sintered compact which comprises aluminum nitride as a main component, and in various sintered compacts which comprise as a main component a ceramic material which has the crystal system which can be classified as a hexagonal system or a trigonal system, such as silicon carbide, silicon nitride, gallium nitride, zinc oxide, beryllium oxide, and aluminum oxide, etc., and in other various sintered compacts which comprise as a main component a ceramic material, such as zirconium oxide, magnesium oxide, magnesium aluminate, titanium oxide, barium titanate, lead titanate zirconate, rare earth oxides such as yttrium oxide, thorium oxide, various ferrites, mullite, forsterite, steatite, and glass, etc., and a single-crystal thin film which comprises as a main component at least one selected from gallium nitride, indium nitride, and aluminum nitride is formed furthermore on it,
   and, for example,
9) A thin-film substrate in which an amorphous thin film which comprises as a main component at least one selected from gallium nitride, indium nitride, and aluminum nitride is formed on a sintered compact which comprises aluminum nitride as a main component, and in various sintered compacts which comprise as a main component a ceramic material which has the crystal system which can be classified as a hexagonal system or a trigonal system, such as silicon carbide, silicon nitride, gallium nitride, zinc oxide, beryllium oxide, and aluminum oxide, etc., and in other various sintered compacts which comprise as a main component a ceramic material, such as zirconium oxide, magnesium oxide, magnesium aluminate, titanium oxide, barium titanate, lead titanate zirconate, rare earth oxides such as yttrium oxide, thorium oxide, various ferrites, mullite, forsterite, steatite, and glass, etc., and an orientated polycrystalline thin film which comprises as a main component at least one selected from gallium nitride, indium nitride, and aluminum nitride is formed furthermore on it, and furthermore a single-crystal thin film which comprises as a main component at least one selected from gallium nitride, indium nitride, and aluminum nitride is formed on it, etc.

In addition, in the thin-film substrate of this invention in which a thin film which comprises as a main component at least one selected from gallium nitride, indium nitride, and aluminum nitride was formed on the substrate which comprises a sintered compact which comprises aluminum nitride as a main component, and on the substrate which comprises various sintered compacts which comprise as a main component a ceramic material which has the crystal system which can be classified as a hexagonal system or a trigonal system, such as silicon carbide, silicon nitride, gallium nitride, zinc oxide, beryllium oxide, and aluminum oxide, etc., and on the substrate which comprises other various sintered compacts which comprise as a main component a ceramic material, such as zirconium oxide, magnesium oxide, magnesium aluminate, titanium oxide, barium titanate, lead titanate zirconate, rare earth oxides such as yttrium oxide, thorium oxide, various ferrites, mullite, forsterite, steatite, and glass, etc., a single-crystal thin film can be formed on it, even if the thin film being formed is multilayered, each layer is at least one of the crystallization state selected from a single crystal, an amorphous state, a polycrystal, and an orientated polycrystal, the composition is also different in each thin film layer, and the thickness also differs in each layer furthermore.

As for the crystallinity of the single-crystal thin film formed on the thin-film substrate of this invention which comprises a sintered compact comprising a ceramic material as a main component, that formed on the substrate in which a thin film was formed beforehand is superior to that formed directly on the substrate.

In the above thin-film substrate of this invention in which a thin film is formed on the substrate comprising a sintered compact which comprises as a main component a ceramic material, that the components in the thin film differ means that the substantial composition of the thin film differs, as the composition of the thin film, not only the case where the rate of the components is different but also the case where the thin film comprises only one kind selected from gallium nitride, indium nitride, and aluminum nitride as a main component, and other components are only a doping agent substantially, etc., for example, are contained.

Speaking more concretely, for example, in the case where the main component of a thin film is only gallium nitride, and only a magnesium (Mg) is contained substantially as a doping agent in addition to this, a thing from which the composition ratio of the gallium nitride and magnesium differs is also contained.

Or similarly, for example, in the case where the main component of a thin film of what is only aluminum nitride, and only a silicon (Si) is contained substantially as a doping agent in addition to this, a thing from which the composition ratio of the aluminum nitride and silicon differs is also contained.

In this invention, as mentioned above, in the substrate which comprises a sintered compact which comprises aluminum nitride as a main component, and on the substrate which comprises various sintered compacts which comprise as a main component a ceramic material which has the crystal system which can be classified as a hexagonal system or a trigonal system, such as silicon carbide, silicon nitride, gallium nitride, zinc oxide, beryllium oxide, and aluminum oxide, etc., and on the substrate which comprises other various sintered compacts which comprise as a main component a ceramic material, such as zirconium oxide, magnesium oxide, magnesium aluminate, titanium oxide, barium titanate, lead titanate zirconate, rare earth oxides such as yttrium oxide, thorium oxide, various ferrites, mullite, forsterite, steatite, and glass, etc., not only a thin film which comprises as a main component at least one selected from gallium nitride, indium nitride, and aluminum nitride and has the same component can be formed as a single layer or two or more layers, but also it can be formed as a thin film of at least two layers which comprises different components.

Even if the thin film is what formed the same component in two or more layers or is what formed what has different components in two or more layers, if each formed thin film is a single crystal, a thing with excellent crystallinity, such that the half width of the rocking curve of the X-ray diffraction line from the lattice plane of the Miller Index (002) of the single-crystal thin film is not more than 240 seconds, can be obtained.

And, in this invention, in the substrate which comprises a sintered compact which comprises aluminum nitride as a main component, and on the substrate which comprises various sintered compacts which comprise as a main component a ceramic material which has the crystal system which can be classified as a hexagonal system or a trigonal system, such as silicon carbide, silicon nitride, gallium nitride, zinc oxide, beryllium oxide, and aluminum oxide, etc., and on the substrate which comprises other various sintered compacts which comprise as a main component a ceramic material, such as zirconium oxide, magnesium oxide, magnesium aluminate, titanium oxide, barium titanate, lead titanate zirconate, rare earth oxides such as yttrium oxide, thorium oxide, various ferrites, mullite, forsterite, steatite, and glass, etc., a thin film which comprises two or more layers can be formed, and at least two in each thin film layer can be used suitably even if it comprises different compositions.

If this thing is explained more concretely, for example, if the thin film comprises three layers, the thin film of two kinds of states is contained, like what comprises three layers, wherein the composition of two layers is same and the composition of other one layer is different, and what comprises three layers, wherein all the composition is different respectively.

And, for example, if the thin film comprises four layers, the thin film of three kinds of states is contained, like what comprises four layers, wherein the composition of two layers is same and the composition of other two layers is different respectively, what comprises four layers, wherein the composition of three layers is same and the composition of other one layer is different, and what comprises four layers, wherein all the composition is different respectively.

As mentioned above, this invention provides a substrate for thin-film formation which comprises an aluminum nitride-based sintered compact which can form a thin film which comprises at least one selected from gallium nitride, indium nitride, and aluminum nitride and has at least one crystallization state selected from an amorphous state, a polycrystal, an orientated polycrystal, and a single crystal.

Moreover, this invention also provides a thin-film substrate in which a thin film which comprises at least one selected from gallium nitride, indium nitride, and aluminum nitride and has at least one crystallization state selected from an amorphous state, a polycrystal, an orientated polycrystal, and a single crystal is being formed on the substrate which comprises a sintered compact which comprises aluminum nitride as a main component.

And, as mentioned above, this invention provides a substrate for thin-film formation which comprises various sintered compacts which can form a thin film which comprises at least one selected from gallium nitride, indium nitride, and aluminum nitride and has at least one crystallization state selected from an amorphous state, a polycrystal, an orientated polycrystal, and a single crystal, and the above sintered compacts comprise as a main component a ceramic material having the crystal system which can be classified as a hexagonal system or a trigonal system, such as silicon carbide, silicon nitride, gallium nitride, zinc oxide, beryllium oxide, and aluminum oxide, etc.

Moreover, this invention also provides a thin-film substrate in which a thin film which comprises at least one selected from gallium nitride, indium nitride, and aluminum nitride and has at least one crystallization state selected from an amorphous state, a polycrystal, an orientated polycrystal, and a single crystal is being formed on the substrate which comprises various sintered compacts which comprise as a main component a ceramic material which has the crystal system which can be classified as a hexagonal system or a trigonal system, such as silicon carbide, silicon nitride, gallium nitride, zinc oxide, beryllium oxide, and aluminum oxide, etc.

Among the thin films which comprise at least one selected from gallium nitride, indium nitride, and aluminum nitride, the above substrate for thin-film formation can be used in order to form a single-crystal thin film.

And, the above thin-film substrate can be used in order to form a single-crystal thin film which comprises at least one selected from gallium nitride, indium nitride, and aluminum nitride.

As for the thin-film substrate according to this invention, as mentioned above, it is a thin-film substrate in which a thin film which comprises as a main component at least one selected from gallium nitride, indium nitride, and aluminum nitride is being formed on the substrate which comprises a sintered compact which comprises aluminum nitride as a main component.

As for the thin-film substrate according to this invention, it is a thin-film substrate in which a thin film which comprises as a main component at least one selected from gallium nitride, indium nitride, and aluminum nitride is being formed on the substrate which comprises various sintered compacts which comprise as a main component a ceramic material which has the crystal system which can be classified as a hexagonal system or a trigonal system, such as silicon carbide, silicon nitride, gallium nitride, zinc oxide, beryllium oxide, and aluminum oxide, etc.

As for the thin-film substrate according to this invention, it is a thin-film substrate in which a thin film which comprises as a main component at least one selected from gallium nitride, indium nitride, and aluminum nitride is being formed on the substrate which comprises a sintered compact which comprises a ceramic material as a main component and which has optical permeability.

As for the thin-film substrate according to this invention, it is a thin-film substrate in which a single-crystal thin film which comprises as a main component at least one selected from gallium nitride, indium nitride, and aluminum nitride is being formed on the substrate which comprises a sintered compact which comprises a ceramic material as a main component.

Speaking more concretely, as for the thin-film substrate according to this invention, it is a thin-film substrate in which a thin film which comprises as a main component at least one selected from gallium nitride, indium nitride, and aluminum nitride and which has at least one of the crystallization states selected from a single crystal, an amorphous state, a polycrystal, and an orientated polycrystal is being formed on the substrate which comprises a sintered compact which comprises aluminum nitride as a main component, and on the substrate which comprises various sintered compacts which comprise as a main component a ceramic material which has the crystal system which can be classified as a hexagonal system or a trigonal system, such as silicon carbide, silicon nitride, gallium nitride, zinc oxide, beryllium oxide, and aluminum oxide, etc., and on the substrate which comprises other various sintered compacts which comprise as a main component a ceramic material, such as zirconium oxide, magnesium oxide, magnesium aluminate, titanium oxide, barium titanate, lead titanate zirconate, rare earth oxides such as yttrium oxide, thorium oxide, various ferrites, mullite, forsterite, steatite, and glass, etc., for example.

As for the thin film which comprises as a main component at least one selected from gallium nitride, indium nitride, and aluminum nitride and is formed on the substrate which comprises a sintered compact which comprises aluminum nitride as a main component, and on the substrate which comprises various sintered compacts which comprise as a main component a ceramic material which has the crystal system which can be classified as a hexagonal system or a trigonal system, such as silicon carbide, silicon nitride, gallium nitride, zinc oxide, beryllium oxide, and aluminum oxide, etc., and on the substrate which comprises other various sintered compacts which comprise as a main component a ceramic material, such as zirconium oxide, magnesium oxide, magnesium aluminate, titanium oxide, barium titanate, lead titanate zirconate, rare earth oxides such as yttrium oxide, thorium oxide, various ferrites, mullite, forsterite, steatite, and glass, etc., for example, it was found out that what has electrical conductivity can be formed.

Moreover, also when using the thin-film substrate in which a thin film which comprises as a main component at least one selected from gallium nitride, indium nitride, and aluminum nitride and has various crystallization states, such as an amorphous state, a polycrystal, an orientated polycrystal, and a single crystal, etc. is formed beforehand on the substrate using a sintered compact which comprises aluminum nitride as a main component, and various sintered compacts which comprise as a main component a ceramic material which has the crystal system which can be classified as a hexagonal system or a trigonal system, such as silicon carbide, silicon nitride, gallium nitride, zinc oxide, beryllium oxide, and aluminum oxide, etc., and other various sintered compacts which comprise as a main component a ceramic material, such as zirconium oxide, magnesium oxide, magnesium aluminate, titanium oxide, barium titanate, lead titanate zirconate, rare earth oxides such as yttrium oxide, thorium oxide, various ferrites, mullite, forsterite, steatite, and glass, etc., it was found out that a thing which has electrical conductivity can be formed, as the thin film which comprises as a main component at least one selected from gallium nitride, indium nitride, and aluminum nitride and which is formed in this substrate.

In the thin-film substrate in which such conductive thin film which comprises as a main component at least one selected from gallium nitride, indium nitride, and aluminum nitride is formed on the sintered compact in which a conduction via is being formed and which comprises aluminum nitride as a main component, and the various sintered compacts in which a conduction via is being formed and which comprise as a main component a ceramic material which has the crystal system which can be classified as a hexagonal system or a trigonal system, such as silicon carbide, silicon nitride, gallium nitride, zinc oxide, beryllium oxide, and aluminum oxide, etc., and the other various sintered compacts in which a conduction via is being formed and which comprise as a main component a ceramic material, such as zirconium oxide, magnesium oxide, magnesium aluminate, titanium oxide, barium titanate, lead titanate zirconate, rare earth oxides such as yttrium oxide, thorium oxide, various ferrites, mullite, forsterite, steatite, and glass, etc., the up-and-down surface of the thin-film substrate can be connected electrically via the conduction via.

Therefore, if semiconductor devices, such as a light-emitting device, are produced using the thin-film substrate or the substrate for thin-film formation which form such conductive thin film, the electrodes can be arranged not only in the one side but also in the up-and-down side of the device, so thin film etching for taking out electrodes becomes unnecessary, moreover, since the mounting characteristics of the devices to the package can be raised, it is desirable.

In order to generate electrical conductivity, such as P type or N type semiconductor, it usually becomes possible by adding a doping agent to the thin film comprising as a main component at least one selected from gallium nitride, indium nitride and aluminum nitride.

The thin film may be used as one semiconductor layer which constitutes the light-emitting device of multilayer structure by making it P type or N type semiconductor.

In this invention, as for the thin film which is various crystallization states, such as an amorphous state, a polycrystal, an orientated polycrystal, and a single crystal, and is formed on the thin-film substrate in which a thin film which comprises as a main component at least one selected from gallium nitride, indium nitride, and aluminum nitride and has the various crystallization states was formed on the substrate which comprises a sintered compact which comprises aluminum nitride as a main component and on the substrate which comprises various sintered compacts which comprise a ceramic material as a main component, it can also form what has electrical conductivity.

In the thin film comprising as a main component at least one selected from gallium nitride, indium nitride and aluminum nitride, a thin film comprising as a main component gallium nitride and/or indium nitride (including the thin film comprising the mixed composition of gallium nitride + indium nitride) may be semiconductorized spontaneously into N type without a doping agent, and electrical conductivity will be generated.

The thin film of various crystallization states which is formed on the thin-film substrate of this invention can be used as one semiconductor layer which constitutes the light-emitting device of multilayer structure by making it semiconductor-ize into P type or N type.

By making the above thin film of various crystallization states into semiconductor-izing, if semiconductor devices, such as a light-emitting device, are produced in the substrate which comprises a sintered compact which comprises aluminum nitride as a main component and has a conduction via, since the electrodes can be arranged not only to the one side but also to the up-and-down side of the device, thin film etching for taking out electrodes becomes unnecessary, moreover, since the mounting characteristics of the devices to the package can be raised, it is desirable.

As the doping agent for making a thin film of this invention having a various crystallization state into the P type semiconductor, it can use one, or not less than two of materials selected from magnesium, beryllium, zinc, and carbon, etc. simultaneously.

As the doping agent for making a thin film of this invention having a various crystallization state into the N type semiconductor, it can use one, or not less than two of materials selected from silicon and oxygen, etc. simultaneously.

Semiconductor-izing is also possible by so-called co-doping which uses both the above doping agent for N-type semiconductor formation and for P type semiconductor formation.

As for the electric resistivity of the above semiconductorized thin film of various crystallization states, such as an amorphous state, a polycrystal, an orientated polycrystal, and a single crystal, it is preferred that it is not more than 1x10⁴ Ω·cm at room temperature. It is more preferred that the electric resistivity is not more than 1x10² Ω·cm at room temperature. It is most preferred that the electric resistivity is not more than 1x10⁰ Ω·cm at room temperature.

It has become clear that the thin film which has such electric resistivity and comprises as a main component at least one selected from gallium nitride, indium nitride, and aluminum nitride can be formed on the substrate which comprises a sintered compact which comprises aluminum nitride as a main component, and on the substrate which comprises various sintered compacts which comprise as a main component a ceramic material which has the crystal system which can be classified as a hexagonal system or a trigonal system, such as silicon carbide, silicon nitride, gallium nitride, zinc oxide, beryllium oxide, and aluminum oxide, etc., and in the other various sintered compacts which comprise as a main component a ceramic material, such as zirconium oxide, magnesium oxide, magnesium aluminate, titanium oxide, barium titanate, lead titanate zirconate, rare earth oxides such as yttrium oxide, thorium oxide, various ferrites, mullite, forsterite, steatite, and glass, etc., and in the thin-film substrate in which a thin film which comprises as a main component at least one selected from gallium nitride, indium nitride, and aluminum nitride is being formed beforehand on these substrates.

A thin film which is various crystallization states, such as a single crystal, an amorphous state, a polycrystal, and an orientated polycrystal, and which has electrical conductivity and comprises as a main component at least one selected from gallium nitride, indium nitride, and aluminum nitride can be formed on the substrate which comprises an aluminum nitride-based sintered compact of this invention, and on the substrate which comprises various sintered compacts which comprise as a main component a ceramic material which has the crystal system which can be classified as a hexagonal system or a trigonal system, such as silicon carbide, silicon nitride, gallium nitride, zinc oxide, beryllium oxide, and aluminum oxide, etc., and in the other various sintered compacts which comprise as a main component a ceramic material, such as zirconium oxide, magnesium oxide, magnesium aluminate, titanium oxide, barium titanate, lead titanate zirconate, rare earth oxides such as yttrium oxide, thorium oxide, various ferrites, mullite, forsterite, steatite, and glass, etc., and in the thin-film substrate in which a thin film which comprises as a main component at least one selected from gallium nitride, indium nitride, and aluminum nitride is being formed beforehand on these substrates.

In the thin film of various crystallization states which comprises as a main component at least one selected from gallium nitride, indium nitride, and aluminum nitride and which is formed on the above substrate which comprises an aluminum nitride-based sintered compact of this invention, and on the substrate which comprises various sintered compacts which comprise as a main component a ceramic material which has the crystal system which can be classified as a hexagonal system or a trigonal system, such as silicon carbide, silicon nitride, gallium nitride, zinc oxide, beryllium oxide, and aluminum oxide, etc., and on the other various sintered compacts which comprise as a main component a ceramic material, such as zirconium oxide, magnesium oxide, magnesium aluminate, titanium oxide, barium titanate, lead titanate zirconate, rare earth oxides such as yttrium oxide, thorium oxide, various ferrites, mullite, forsterite, steatite, and glass, etc., for example, and on the thin-film substrate in which a thin film comprising as a main component at least one selected from gallium nitride, indium nitride and aluminum nitride is being formed beforehand on these substrates;

As the doping agent, one of magnesium (Mg), beryllium (Be), calcium (Ca), zinc (Zn), cadmium (Cd), and carbon (C), etc. may be used for making the thin film into P type semiconductor, or two or more may be used simultaneously. One of silicon (Si), germanium (Ge), oxygen (O), selenium (Se), and tellurium (Te), etc. may be used for making the thin film into N type semiconductor, or two or more may be used simultaneously.

Making the thin film into semiconductor is also possible by co-doping in which both the above doping agents for N-type semiconductor and for P type semiconductor are used.

In the above substrate for thin-film formation and thin-film substrate, a semiconductorized thin film which has electric resistivity not more than 1x10⁴ Ω·cm at room temperature and which comprises as a main component at least one selected from gallium nitride, indium nitride, and aluminum nitride and has various crystallization states, such as an amorphous state, a polycrystal, an orientated polycrystal, and a single crystal, etc., can be formed.

And, in the above substrate for thin-film formation and thin-film substrate, the thin film which has electric resistivity not more than 1x10² Ω·cm at room temperature and has various crystallization states, such as an amorphous state, a polycrystal, an orientated polycrystal, and a single crystal, etc., can be formed, so it is desirable.

Furthermore, in the above substrate for thin-film formation and thin-film substrate, the thin film which has electric resistivity not more than 1x10¹ Ω·cm at room temperature and has various crystallization states, such as an amorphous state, a polycrystal, an orientated polycrystal, and a single crystal, etc., can be formed, so it is more desirable.

And, in the above substrate for thin-film formation and thin-film substrate, the thin film which has electric resistivity not more than 1x10⁰ Ω·cm at room temperature and has various crystallization states, such as an amorphous state, a polycrystal, an orientated polycrystal, and a single crystal, etc., can be formed, so it is still more desirable.

If the thin film of various crystallization states, such as an amorphous state, a polycrystal, an orientated polycrystal, and a single crystal, is made into semiconductor which has such above electric resistivity, the thin film of these various crystallization states can be used directly as the part of a light-emitting device, and the production process which etches a part of the thin film layer which forms a light-emitting device for forming electrodes of the light-emitting device can be skipped, furthermore it is advantageous when it mounts the light-emitting device in a package.

The thin film may contain component(s), such as Mg, Be, Ca, Zn, Cd, C, Si, Ge, O, Se, and Te, etc.

The component(s) may be used as a doping agent, the conductivity may be improved, usually, by carrying out the reheating after thin film formation in the ambient atmosphere, such as in pure N₂ and in a vacuum, etc., or by irradiating electron beam, etc.

It is preferred that the doping agent(s) is included usually in the range of 0.00001-10 mol % on an element basis in the thin film comprising as a main component at least one selected from gallium nitride, indium nitride and aluminum nitride, and the electric resistivity of the thin film may become into at least not more than 1x10⁴ Ω·cm at room temperature.

In the thin film containing the above-mentioned doping component in the range of 0.00001-10 mol %, even when it contains aluminum nitride not more than 95 mol % as a main component and has the composition in which the remainder is at least one selected from gallium nitride and indium nitride, usually, the thin film having the electric resistivity at least not more than 1x10² Ω·cm at room temperature is producible.

In the thin film containing the above-mentioned doping component in the range of 0.00001-10 mol %, when it contains aluminum nitride not more than 55 mol % as a main component and has the composition in which the remainder is at least one selected from gallium nitride and indium nitride, usually, the thin film having the electric resistivity at least not more than 1x10¹ Ω·cm at room temperature is producible.

As mentioned above, in this invention, in the substrate for thin-film formation and thin-film substrate which used as a substrate the sintered compact which comprises aluminum nitride as a main component, and the various sintered compacts which comprise as a main component a ceramic material which has the crystal system which can be classified as a hexagonal system or a trigonal system, such as silicon carbide, silicon nitride, gallium nitride, zinc oxide, beryllium oxide, and aluminum oxide, etc., and the other various sintered compacts which comprise as a main component a ceramic material, such as zirconium oxide, magnesium oxide, magnesium aluminate, titanium oxide, barium titanate, lead titanate zirconate, rare earth oxides such as yttrium oxide, thorium oxide, various ferrites, mullite, forsterite, steatite, and glass, etc., for example, a thin film which has electrical conductivity and which comprises as a main component at least one selected from gallium nitride, indium nitride, and aluminum nitride and has various crystallization states, such as an amorphous state, a polycrystal, an orientated polycrystal, and a single crystal, etc., can be formed.

In this invention, a conductive thin film which comprises as a main component two components of gallium nitride and aluminum nitride expressed with the chemical composition formula of AlₓGa₁₋ₓN (0≤x≤1.0) and has various crystallization states, such as an amorphous state, a polycrystal, an orientated polycrystal, and a single crystal, can also be obtained.

Since the thin film of the above two-component system absorbs a little of ultraviolet light of a wavelength not more than 380 nm, if the thin-film substrate in which this material was formed is used as a substrate for light-emitting device production, there is little optical absorption by a substrate, so the light-emitting device excellent in luminous efficiency can be manufactured.

The conductivity of the two-component system thin film is acquired by semiconductor-izing into P type and N type using doping agent(s).

Magnesium (Mg), beryllium (Be), calcium (Ca), zinc (Zn), cadmium (Cd), and carbon (C), etc. can be suitably used for the doping agent for the formation of P type semiconductor, and it is more preferred in it to use magnesium (Mg).

Silicon (Si), germanium (Ge), oxygen (O), selenium (Se), and tellurium (Te), etc. can be suitably used for the doping agent for the formation of N type semiconductor, and it is more preferred in it to use silicon (Si).

The above thin film of two-component system can include the doping agent for the formation of P type semiconductor, such as Mg, etc., in the range of 0.00001-10 mol % on an element basis to the composite expressed with the chemical formula of main-component AlₓGa₁₋ₓN (0≤x≤1.0), and a conductive thin film which has the electric resistivity not more than 1x10⁴ Ω·cm at room temperature and has various crystallization states, such as an amorphous state, a polycrystal, an orientated polycrystal, and a single crystal, can be formed.

Among them, in the thin film which includes the doping agent for the formation of P type semiconductor, such as Mg, etc., in the range of 0.00001-10 mol % on an element basis to the composite expressed with the chemical formula of main-component AlₓGa₁₋ₓN (0≤x≤0.6), a conductive thin film which has the electric resistivity of about 1x10⁻¹-1x10² Ω·cm at room temperature and has various crystallization states, such as an amorphous state, a polycrystal, an orientated polycrystal, and a single crystal, can be formed.

And, in the above thin film of two-component system, in the thin film which includes the doping agent for the formation of P type semiconductor, such as Mg, etc., in the range of 0.00001-0.5 mol % on an element basis to the composite expressed with the chemical formula of main-component AlₓGa₁₋ₓN (0≤x≤0.6), a conductive thin film which has the electric resistivity not more than 1x10⁴ Ω·cm at room temperature and has various crystallization states, such as an amorphous state, a polycrystal, an orientated polycrystal, and a single crystal, can be formed.

And, the above thin film of two-component system can include the doping agent for the formation of N type semiconductor, such as Si, etc., in the range of 0.00001-10 mol % on an element basis to the composite expressed with the chemical formula of main-component AlₓGa₁₋ₓN (0≤x≤1.0), a conductive thin film which has the electric resistivity not more than 1x10²-1x10⁴ Ω·cm at room temperature and has various crystallization states, such as an amorphous state, a polycrystal, an orientated polycrystal, and a single crystal, can be formed.

Among them, in the thin film which includes the doping agent for the formation ofN type semiconductor, such as Si, etc., in the range of 0.00001-0.5 mol % to the composite expressed with the chemical formula of main-component AlₓGa₁₋ₓN (0≤x≤0.6), a conductive thin film which has the electric resistivity not more than 1x10²-1x10³ Ω·cm at room temperature and has various crystallization states, such as an amorphous state, a polycrystal, an orientated polycrystal, and a single crystal, can be formed.

The thin film of this composition contains the thin film which comprises what is x=1.0, that is, comprises only aluminum nitride as a main component, and contains the doping agent for the formation of N type semiconductor, such as Si, etc., in the range of 0.00001 mol %-0.5 mol % on an element basis.

And, in the thin film which contains the doping agent for the formation of N type semiconductor, such as Si, etc., in the range of 0.00001-10 mol % on an element basis to the composite expressed with the chemical formula of main-component AlₓGa₁₋ₓN (0≤x≤0.6), a conductive thin film which has comparatively low resistance of about 1x10⁻³-1x10¹ Ω·cm at room temperature as the electric resistivity and has various crystallization states, such as an amorphous state, a polycrystal, an orientated polycrystal, and a single crystal, can be formed.

And, in the above thin film of two-component system, the doping agent for the formation of P type semiconductor, such as Mg, etc., and the doping agent for the formation ofN type semiconductor, such as Si, etc., can be contained simultaneously in the range of 0.00001-10 mol % in total on an element basis to the composite expressed with the chemical formula of main-component AlₓGa₁₋ₓN (0≤x≤1.0), and a conductive thin film which has the electric resistivity not more than 1x10⁴ Ω·cm at room temperature and has various crystallization states, such as an amorphous state, a polycrystal, an orientated polycrystal, and a single crystal, can be formed.

In addition, for example, that the content of the doping agent, such as Mg and Si, etc., is 0.00001-10 mol % on an element basis to the main components means that the above thin film of two-component system comprises the composition which includes AlₓGa₁₋ₓN which is a main component in the range of 90-99.99999 mol % and includes the doping agent, such as Mg and Si, etc., in the range of 0.00001-10 mol % on an element basis.

In this invention, as for the sintered compact which comprises aluminum nitride as a main component, or the various sintered compacts which comprise as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., or the other various sintered compacts which comprise as a main component a ceramic material, such as zirconium oxide, magnesium oxide, magnesium aluminate, titanium oxide, barium titanate, lead titanate zirconate, rare earth oxides such as yttrium oxide, thorium oxide, various ferrites, mullite, forsterite, steatite, and glass, etc., for example, they can be used as the substrate for forming a thin film which comprises as a main component at least one selected from gallium nitride, indium nitride, and aluminum nitride and has various crystallization states, such as a single crystal, an amorphous state, a polycrystal, and an orientated polycrystal, etc.

And, this invention can provide the thin-film substrate in which a thin film which comprises as a main component at least one selected from gallium nitride, indium nitride, and aluminum nitride and has various crystallization states, such as a single crystal, an amorphous state, a polycrystal, and an orientated polycrystal, etc., is formed on the substrate which comprises a sintered compact which comprises aluminum nitride as a main component, or various sintered compacts which comprise as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., or other various sintered compacts which comprise as a main component a ceramic material, such as zirconium oxide, magnesium oxide, magnesium aluminate, titanium oxide, barium titanate, lead titanate zirconate, rare earth oxides such as yttrium oxide, thorium oxide, various ferrites, mullite, forsterite, steatite, and glass, etc., for example.

Although what has arbitrary thickness of the thin film can be formed, when the thin film is formed on the substrate for thin-film formation which comprises the above various sintered compacts which comprise a ceramic material as a main component, it is desirable that the thickness is at least not less than 0.5 nm in order to lower the pinhole and defect, etc. in the thin film.

As for the thin film formed directly on the above substrate for thin-film formation which comprises a sintered compact which comprises aluminum nitride as a main component, it can also form a thing with the thickness of not less than 0.5 nm, or furthermore a thing with not less than 10 µm. Moreover, what has not less than 50 µm can also be formed.

In this invention, as mentioned above, using the methods suitably, such as MOCVD (Metal Organic Chemical Vapor Deposition) method, MOVPE (Metal Organic Vapor Phase Epitaxy) method, Hydride VPE (Hydride Vapor Phase Epitaxy) method, Chloride VPE (Chloride Vapor Phase Epitaxy) method, Plasma CVD method, other CVD (Chemical Vapor Deposition) methods, or MBE (Molecular Beam Epitaxy) method, or laser ablation method using excimer laser, PLD (pulsed-laser deposition: pulsed laser decomposition) method, etc., or Sputtering method, etc., a thin film with the comparatively thick thickness of about 500 µm-1000 µm can be formed comparatively easily, but it is usually desirable to use a thing in which the thickness of the thin film is not more than 200 µm in order to obtain a single-crystal thin film with high crystallinity.

Although the growth rate of a thin film is comparatively small in many cases in the case of the MOCVD method or the MOPVE method, like it is a maximum of 5 µm-10 µm per hour and is usually less than it, if the Chloride VPE method and the Halide VPE method, etc. which use halogenated compounds as a raw material, such as a gallium chloride, are used, the growth rate of a thin film is as large as 5 µm-200 µm per hour, since a thin film with thick thickness can be formed in a shorter time, it is desirable.

And, as for the thin film which comprises as a main component at least one selected from gallium nitride, indium nitride, and aluminum nitride and has various crystallization states, such as a single crystal, an amorphous state, a polycrystal, and an orientated polycrystal, etc., not only in the thin film which is formed directly on the above substrate for thin-film formation which comprises a sintered compact which comprises aluminum nitride as a main component, or on the substrate for thin-film formation which comprises various sintered compacts which comprise as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., or on the substrate for thin-film formation which comprises other various sintered compacts which comprise as a main component a ceramic material, such as zirconium oxide, magnesium oxide, magnesium aluminate, titanium oxide, barium titanate, lead titanate zirconate, rare earth oxides such as yttrium oxide, thorium oxide, various ferrites, mullite, forsterite, steatite, and glass, etc., for example, but also in the thin film which is formed on the thin-film substrate in which a thin film which comprises as a main component at least one selected from gallium nitride, indium nitride, and aluminum nitride and which has various crystallization states, such as a single crystal, an amorphous state, a polycrystal, and an orientated polycrystal, etc., is formed and which is produced using a sintered compact which comprises aluminum nitride as a main component, or various sintered compacts which comprise as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., or other various sintered compacts which comprise as a main component a ceramic material, such as zirconium oxide, magnesium oxide, magnesium aluminate, titanium oxide, barium titanate, lead titanate zirconate, rare earth oxides such as yttrium oxide, thorium oxide, various ferrites, mullite, forsterite, steatite, and glass, etc., for example, what has the same film thickness as the above is obtained comparatively easily.

In this invention, as for the crystallinity of the single-crystal thin film and the orientated polycrystalline thin film which comprise as a main component at least one selected from gallium nitride, indium nitride, and aluminum nitride and which are formed on the substrate which comprises a sintered compact which comprises aluminum nitride as a main component, or in the substrate which comprises various sintered compacts which comprise as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., or in the substrate which comprises other various sintered compacts which comprise as a main component a ceramic material, such as zirconium oxide, magnesium oxide, magnesium aluminate, titanium oxide, barium titanate, lead titanate zirconate, rare earth oxides such as yttrium oxide, thorium oxide, various ferrites, mullite, forsterite, steatite, and glass, etc., for example, though it is influenced by the composition and optical permeability of a sintered compact, the size of sintered compact particles, the surface state of a substrate, the constitution of a thin film layer formed, or the thin film formation conditions, as mentioned above, on the other hand, it is influenced by the thickness of the thin film formed.

In this invention, in the substrate which comprises a sintered compact which comprises aluminum nitride as a main component, a single-crystal thin film which comprises as a main component at least one selected from gallium nitride, indium nitride, and aluminum nitride and has the thickness not less than 0.5 nm can be formed.

As the crystallinity of the single-crystal thin film of this thickness, a thing in which the half width of the rocking curve of the X-ray diffraction line from the lattice plane of the Miller Index (002) is not more than 300 seconds can be formed.

And, the above single-crystal thin film with the thickness not less than 0.3 µm can also be formed using the substrate for thin-film formation or the thin-film substrate which comprise an aluminum nitride-based sintered compact of this invention.

A thing with the crystallinity, such that the half width of the rocking curve of the X-ray diffraction line from the lattice plane of the Miller Index (002) of the single-crystal thin film is not more than 240 seconds, is easy to be obtained, if the thickness of the single-crystal thin film which comprises as amain component at least one selected from gallium nitride, indium nitride, and aluminum nitride is not less than 0.3 µm.

The above single-crystal thin film with the thickness not less than 3.5 µm can also be formed using the substrate which comprises an aluminum nitride-based sintered compact of this invention.

A thing with the crystallinity, such that the half width of the rocking curve of the X-ray diffraction line from the lattice plane of the Miller Index (002) of the single-crystal thin film is not more than 200 seconds, is easy to be obtained, if the thickness of the single-crystal thin film which comprises as amain component at least one selected from gallium nitride, indium nitride, and aluminum nitride is not less than 3.5 µm.

And, a comparatively thick single-crystal thin film not less than 10 µm can also be formed using the substrate which comprises an aluminum nitride-based sintered compact of this invention.

A thing with excellent crystallinity, such that the half width of the rocking curve of the X-ray diffraction line from the lattice plane of the Miller Index (002) of the single-crystal thin film is not more than 150 seconds, is easy to be obtained, even if the thickness of the single-crystal thin film which comprises as a main component at least one selected from gallium nitride, indium nitride, and aluminum nitride is not less than 10 µm.

Not less than 50 µm is possible enough as the thickness of a single-crystal thin film which comprises as a main component at least one selected from gallium nitride, indium nitride, and aluminum nitride and is formed on the substrate which comprises an aluminum nitride-based sintered compact of this invention.

A thing with the crystallinity, such that the half width of the rocking curve of the X-ray diffraction line from the lattice plane of the Miller Index (002) of the single-crystal thin film is not more than 130 seconds, is easy to be obtained, so it is preferred, if the thickness of the single-crystal thin film which comprises as a main component at least one selected from gallium nitride, indium nitride, and aluminum nitride is not less than 50 µm.

As for the single-crystal thin film which comprises as a main component at least one selected from gallium nitride, indium nitride, and aluminum nitride, a thing with the thickness of about 200 µm can be formed sufficiently in the substrate which comprises an aluminum nitride-based sintered compact of this invention.

In addition, for example, if using the substrate in which a thin film which comprises as a main component at least one selected from gallium nitride, indium nitride, and aluminum nitride and has various crystallization states, such as an amorphous state, a polycrystal, an orientated polycrystal, and a single crystal, etc., is formed beforehand, or using the substrate which comprises a sintered compact which comprises aluminum nitride as a main component and has optical permeability, a single-crystal thin film with the thickness of about 1000 µm can also be formed in practice, but a thing with not more than about 200 µm is usually preferred as the thickness of a single-crystal thin film which comprises as a main component at least one selected from gallium nitride, indium nitride, and aluminum nitride.

In this invention, since a thin film is usually formed in non-equilibrium states, such as the MOCVD method, the MOVPE method, or the halide VPE method, it is because it will become easy to produce a lowering of crystallinity as mentioned above, if the thickness of the thin film becomes thicker than 200 µm.

In this invention, as for the above shown relation between the thickness and crystallinity of the single-crystal thin film which comprises as a main component at least one selected from gallium nitride, indium nitride, and aluminum nitride, not only in the thing which was formed directly on the sintered compact which comprises aluminum nitride as a main component but also in the single-crystal thin film formed on the thin-film substrate in which a thin film which comprises as a main component at least one selected from gallium nitride, indium nitride, and aluminum nitride and which has various crystallization states, such as a single crystal, an amorphous state, a polycrystal, and an orientated polycrystal, etc., was formed beforehand and is produced using a sintered compact which comprises aluminum nitride as a main component, it has the same relation between the thickness and crystallinity of the thin film.

And, a thin film which comprises as a main component at least one selected from gallium nitride, indium nitride, and aluminum nitride and has various crystallization states, such as a single crystal, an amorphous state, a polycrystal, and an orientated polycrystal, etc., can be formed not only in the substrate which comprises the above sintered compact which comprises aluminum nitride as a main component but also in the substrate which comprises various sintered compacts which comprise as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., as a substrate.

In this invention, as for the crystallinity of the single-crystal thin film and the orientated polycrystalline thin film which comprise as a main component at least one selected from gallium nitride, indium nitride, and aluminum nitride and which are formed on the substrate which comprises various sintered compacts which comprise as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., while it is influenced by the surface state of a substrate, the constitution of the thin film formed, or thin film formation conditions as mentioned above, on the other hand, it is also influenced by the thickness of the thin film formed.

In this invention, in the substrate which comprises various sintered compacts which comprise as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., a single-crystal thin film which comprises as a main component at least one selected from gallium nitride, indium nitride, and aluminum nitride and has the thickness not less than 0.5 nm can be formed.

A thing with the crystallinity, such that the half width of the rocking curve of the X-ray diffraction line from the lattice plane of the Miller Index (002) of the single-crystal thin film is not more than 300 seconds, can be formed.

And, the above single-crystal thin film with the thickness not less than 0.3 µm can also be formed using the substrate which comprises various sintered compacts which comprise as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc.

A thing with the crystallinity, such that the half width of the rocking curve of the X-ray diffraction line from the lattice plane of the Miller Index (002) of the single-crystal thin film is not more than 300 seconds, is easy to be obtained, also in the case where the thickness of the single-crystal thin film which comprises as a main component at least one selected from gallium nitride, indium nitride, and aluminum nitride is not less than 0.3 µm.

The above single-crystal thin film with the thickness not less than 3.5 µm can also be formed using the substrate which comprises various sintered compacts which comprise as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc.

A thing with the crystallinity, such that the half width of the rocking curve of the X-ray diffraction line from the lattice plane of the Miller Index (002) of the single-crystal thin film is not more than 240 seconds, is easy to be obtained, if the thickness of the single-crystal thin film which comprises as amain component at least one selected from gallium nitride, indium nitride, and aluminum nitride is not less than 3.5 µm.

And, a comparatively thick single-crystal thin film not less than 10 µm can also be formed using the substrate which comprises various sintered compacts which comprise as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc.

A thing with excellent crystallinity, such that the half width of the rocking curve of the X-ray diffraction line from the lattice plane of the Miller Index (002) of the single-crystal thin film is not more than 240 seconds, is easy to be obtained, even if the thickness of the single-crystal thin film which comprises as a main component at least one selected from gallium nitride, indium nitride, and aluminum nitride is not less than 10 µm.

And, not less than 50 µm is possible enough as the thickness of a single-crystal thin film which comprises as a main component at least one selected from gallium nitride, indium nitride, and aluminum nitride and is formed on the substrate which comprises various sintered compacts which comprise as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc.

As for the thickness of the single-crystal thin film which comprises as a main component at least one selected from gallium nitride, indium nitride, and aluminum nitride and is formed on the substrate which comprises various sintered compacts which comprise as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., if it is not less than 50 µm, a thing with the crystallinity, such that the half width of the rocking curve of the X-ray diffraction line from the lattice plane of the Miller Index (002) of the single-crystal thin film is not more than 200 seconds, is easy to be obtained, so it is preferred.

And, a thing of about 100-200 µm can be formed sufficiently as the thickness of the single-crystal thin film which comprises as a main component at least one selected from gallium nitride, indium nitride, and aluminum nitride and is fomed in the substrate which comprises various sintered compacts which comprise as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc.

In addition, for example, if using the substrate in which a thin film which comprises as a main component at least one selected from gallium nitride, indium nitride, and aluminum nitride and has various crystallization states, such as an amorphous state, a polycrystal, an orientated polycrystal, and a single crystal, etc., is formed beforehand, or using the substrate which comprises various sintered compacts which have optical permeability and comprise as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., a single-crystal thin film can also be formed even if the thickness is about 500-1000 µm, but a thing with not more than about 200 µm is usually preferred as the thickness of a single-crystal thin film which comprises as a main component at least one selected from gallium nitride, indium nitride, and aluminum nitride.

In this invention, since a thin film is usually formed in non-equilibrium states, such as the MOCVD method, the MOVPE method, or the halide VPE method, it is because it will become easy to produce a lowering of crystallinity as mentioned above, if the thickness of the thin film becomes thicker than 200 µm.

In this invention, as for the above shown relation between the thickness and crystallinity of the single-crystal thin film which comprises as a main component at least one selected from gallium nitride, indium nitride, and aluminum nitride, not only in the thing which was formed as a single layer on various sintered compacts which comprise as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., but also in the single-crystal thin film formed on the thin-film substrate in which a thin film which comprises as a main component at least one selected from gallium nitride, indium nitride, and aluminum nitride and has various crystallization states, such as a single crystal, an amorphous state, a polycrystal, and an orientated polycrystal, etc., was formed beforehand and which is produced using various sintered compacts which comprise as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., it has the same relation between the thickness and crystallinity of the thin film.

As mentioned above, in this invention, as for the single-crystal thin film which is formed on the substrate which comprises a sintered compact which comprises aluminum nitride as a main component and comprises as a main component at least one selected from gallium nitride, indium nitride, and aluminum nitride, a thing excellent in crystallinity is easy to be obtained, even if it is thinner compared with the single-crystal thin film which is being formed on the substrate which comprises various sintered compacts which have optical permeability and comprise as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc.

In this invention, as for the thin film which comprises as a main component at least one selected from gallium nitride, indium nitride, and aluminum nitride and is formed on the substrate which comprises a sintered compact which comprises aluminum nitride as a main component, or in the substrate which comprises various sintered compacts which have optical permeability and comprise as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., or in the substrate which comprises other various sintered compacts which comprise as a main component a ceramic material, such as zirconium oxide, magnesium oxide, magnesium aluminate, titanium oxide, barium titanate, lead titanate zirconate, rare earth oxides such as yttrium oxide, thorium oxide, various ferrites, mullite, forsterite, steatite, and glass, etc., for example, it can be formed not only as a single layer but also as a thin film which comprises at least two layers, as mentioned above.

In the above thin film of two or more layers, a thing from which the composition differs, respectively and a thing from which the crystallization state differs, respectively, etc., are contained.

As explained until now, in this invention, although it has shown clearly that the thin film which comprises as a main component at least one selected from gallium nitride, indium nitride, and aluminum nitride can be formed not only as a single layer but also as a thin film of at least two layers, a thing with arbitrary thickness can also be formed in each thin film layer in the above mentioned thin film which comprises at least two layers and which comprises as a main component at least one selected from gallium nitride, indium nitride, and aluminum nitride.

And, in the above thin film which comprises at least two layers and comprises as a main component at least one selected from gallium nitride, indium nitride, and aluminum nitride, as for the thin film layer (the thin-film layer which is being formed on the substrate side) which is formed directly on the substrate which comprises a sintered compact which comprises aluminum nitride as a main component, or on the substrate which comprises various sintered compacts which comprise as a main component a ceramic material which has the crystal system which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., or on tne substrate which comprises other various sintered compacts which comprise as a main component a ceramic material, such as zirconium oxide, magnesium oxide, magnesium aluminate, titanium oxide, barium titanate, lead titanate zirconate, rare earth oxides such as yttrium oxide, thorium oxide, various ferrites, mullite, forsterite, steatite, and glass, etc., for example, it is preferred that the thickness is not less than 0.5 nm in order to obtain the single-crystal thin film more excellent in crystallinity.

Among the above thin film which comprises at least two layers and comprises as a main component at least one selected from gallium nitride, indium nitride, and aluminum nitride and which is formed on the substrate which comprises a sintered compact which comprises aluminum nitride as a main component, or in the substrate which comprises various sintered compacts which comprise as a main component a ceramic material which has the crystal system which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., or in tne substrate which comprises other various sintered compacts which comprise as a main component a ceramic material, such as zirconium oxide, magnesium oxide, magnesium aluminate, titanium oxide, barium titanate, lead titanate zirconate, rare earth oxides such as yttrium oxide, thorium oxide, various ferrites, mullite, forsterite, steatite, and glass, etc., for example, when at least one layer is a single-crystal thin film and the thickness is not less than 0.5 nm, a thin film with the crystallinity, such that the half width of the rocking curve of the X-ray diffraction line from the lattice plane of the Miller Index (002) of the single-crystal thin film is not more than 300 seconds, can be formed.

And, among the above thin film layer which comprises at least two layers and comprises as a main component at least one selected from gallium nitride, indium nitride, and aluminum nitride, when at least one layer is a single-crystal thin film and the thickness is not less than 0.3 µm, a thin film with the crystallinity, such that the half width of the rocking curve of the X-ray diffraction line from the lattice plane of the Miller Index (002) of the single-crystal thin film is not more than 300 seconds, can be formed.

If the substrate in which the single-crystal thin film is formed is a sintered compact which comprises aluminum nitride as a main component, a single-crystal thin film excellent in crystallinity, such that the half width of the rocking curve of the X-ray diffraction line from the lattice plane of the Miller Index (002) of the single-crystal thin film which comprises as a main component at least one selected from gallium nitride, indium nitride, and aluminum nitride is not more than 240 seconds, can be obtained.

And, among the above thin film layer which comprises at least two layers and comprises as a main component at least one selected from gallium nitride, indium nitride, and aluminum nitride, even when at least one layer is a single-crystal thin film and the thickness is not less than 3.5 µm, a thin film with the crystallinity, such that the half width of the rocking curve of the X-ray diffraction line from the lattice plane of the Miller Index (002) of the single-crystal thin film is not more than 300 seconds, can be formed.

If the substrate in which the single-crystal thin film layer is formed is a sintered compact which comprises aluminum nitride as a main component, a single-crystal thin film excellent in crystallinity, such that the half width of the rocking curve of the X-ray diffraction line from the lattice plane of the Miller Index (002) of the single-crystal thin film which comprises as a main component at least one selected from gallium nitride, indium nitride, and aluminum nitride is not more than 200 seconds, can be obtained.

And, a comparatively thick thin film not less than 10 µm which comprises at least two layers can also be formed, using the substrate which comprises an aluminum nitride-based sintered compact of this invention, or the substrate which comprises various sintered compacts which comprise as a main component a ceramic material which has the crystal system which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., or the substrate which comprises other various sintered compacts which comprise as a main component a ceramic material, such as zirconium oxide, magnesium oxide, magnesium aluminate, titanium oxide, barium titanate, lead titanate zirconate, rare earth oxides such as yttrium oxide, thorium oxide, various ferrites, mullite, forsterite, steatite, and glass, etc., for example.

Among the above thin film layer which comprises at least two layers and comprises as a main component at least one selected from gallium nitride, indium nitride, and aluminum nitride, even when at least one layer is a single-crystal thin film and the thickness is not less than 10 µm, a thin film with the crystallinity, such that the half width of the rocking curve of the X-ray diffraction line from the lattice plane of the Miller Index (002) of the single-crystal thin film is not more than 300 seconds, can be formed.

If the substrate in which the single-crystal thin film is formed is a sintered compact which comprises aluminum nitride as a main component, a single-crystal thin film excellent in crystallinity, such that the half width of the rocking curve of the X-ray diffraction line from the lattice plane of the Miller Index (002) of the single-crystal thin film which comprises as a main component at least one selected from gallium nitride, indium nitride, and aluminum nitride is not more than 150 seconds, can be obtained.

As for the thin film which comprises at least two layers and which comprises as a main component at least one selected from gallium nitride, indium nitride, and aluminum nitride and is formed on the substrate which comprises an aluminum nitride-based sintered compact of this invention, or in the substrate which comprises various sintered compacts which comprise as a main component a ceramic material which has the crystal system which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., or in the substrate which comprises other various sintered compacts which comprise as a main component a ceramic material, such as zirconium oxide, magnesium oxide, magnesium aluminate, titanium oxide, barium titanate, lead titanate zirconate, rare earth oxides such as yttrium oxide, thorium oxide, various ferrites, mullite, forsterite, steatite, and glass, etc., for example, what is the thickness not less than 50 µm can be formed sufficiently.

Even when at least one of the above thin film layers which comprise at least two layers and which comprise as a main component at least one selected from gallium nitride, indium nitride, and aluminum nitride is a single-crystal thin film and the thickness is not less than 50 µm, a thing with the crystallinity, such that the half width of the rocking curve of the X-ray diffraction line from the lattice plane of a Miller Index (002) of the single-crystal thin film is not more than 300 seconds, can be formed.

If the substrate in which the single-crystal thin film is formed is a sintered compact which comprises aluminum nitride as a main component, a thing excellent in crystallinity, such that the half width of the rocking curve of the X-ray diffraction line from the lattice plane of the Miller Index (002) of the single-crystal thin film which comprises as a main component at least one selected from gallium nitride, indium nitride, and aluminum nitride is not more than 130 seconds, can be obtained, so it is preferred.

For example, if the substrate in which a thin film which comprises as a main component at least one selected from gallium nitride, indium nitride, and aluminum nitride and has various crystallization states, such as an amorphous state, a polycrystal, an orientated polycrystal, and a single crystal, etc., is formed beforehand, or the substrate which has optical permeability are used as the substrate for thin-film formation of this invention, it is possible enough to form a thin film which comprises at least two layers and comprises as a main component at least one selected from gallium nitride, indium nitride, and aluminum nitride and which is the thickness of about 500 µm, and a single-crystal thin film with the thickness of 1000 µm can also be formed in practice.

Among the above thin film layer which comprises at least two layers and comprises as a main component at least one selected from gallium nitride, indium nitride, and aluminum nitride, even if at least one layer is a single-crystal thin film and the thickness is in the range of 500-1000 µm, a thin film with the crystallinity, such that the half width of the rocking curve of the X-ray diffraction line from the lattice plane of a Miller Index (002) is not more than 300 seconds, can be formed.

Usually, as the thickness of the above single-crystal thin film which comprises at least two layers and comprises as a main component at least one selected from gallium nitride, indium nitride, and aluminum nitride, a thing to about 200 µm is preferred.

In this invention, since a thin film is usually formed in non-equilibrium states, such as the MOCVD method, the MOVPE method, or the halide VPE method, it is because it will become easy to produce a lowering of crystallinity as mentioned above, if the thickness of the thin film becomes thicker than 200 µm.

In this invention, when forming the above thin film which comprises at least two layers and comprises as a main component at least one selected from gallium nitride, indium nitride, and aluminum nitride, using the methods suitably, such as MOCVD (Metal Organic Chemical Vapor Deposition) method, MOVPE (Metal Organic Vapor Phase Epitaxy) method, Hydride VPE (Hydride Vapor Phase Epitaxy) method, Chloride VPE (Chloride Vapor Phase Epitaxy) method, Plasma CVD method, other CVD (Chemical Vapor Deposition) methods, or MBE (Molecular Beam Epitaxy) method, or laser ablation method using excimer laser, PLD (pulsed-laser deposition: pulsed laser decomposition) method, etc., or Sputtering method, etc., a thin film with the target constitution can be obtained.

In addition, as for the above comparatively thick single-crystal thin film of not less than 10 µm, if using the Chloride VPE (Chloride Vapor Phase Epitaxy) method which uses as the raw material a metal chloride, such as a gallium chloride, an indium chloride, and an aluminium chloride, and a reactive gas, such as ammonia, nitrogen, and hydrogen, since the growth rate of a thin film is as large as about 10-500 µm per hour, it is advantageous in respect of productivity.

In this invention, as for the relation between the thickness and crystallinity of the single-crystal thin film in the above mentioned thin film which comprises at least two layers and which comprises as a main component at least one selected from gallium nitride, indium nitride, and aluminum nitride, not only in the thing which was formed directly on the sintered compact which comprises aluminum nitride as a main component, or on the various sintered compacts which comprise as a main component a ceramic material which has the crystal system which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., but also in the single-crystal thin film formed on the thin-film substrate in which a thin film which comprises as a main component at least one selected from gallium nitride, indium nitride, and aluminum nitride and which has various crystallization states, such as a single crystal, an amorphous state, a polycrystal, and an orientated polycrystal, etc., was formed beforehand on the sintered compact which comprises aluminum nitride as a main component, or in the various sintered compacts which comprise as a main component a ceramic material which has the crystal system which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., or in the other various sintered compacts which comprise as a main component a ceramic material, such as zirconium oxide, magnesium oxide, magnesium aluminate, titanium oxide, barium titanate, lead titanate zirconate, rare earth oxides such as yttrium oxide, thorium oxide, various ferrites, mullite, forsterite, steatite, and glass, etc., for example, it has the same relation between the film thickness and crystallinity.

In this invention, as for the single-crystal thin film which comprises as a main component at least one selected from gallium nitride, indium nitride, and aluminum nitride and which is formed on the substrate which comprises a sintered compact which comprises aluminum nitride as a main component, or various sintered compacts which comprise as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., not only a thing of the same component can be formed as a single layer or two or more layers but also a thing which comprises different components can be formed as a single-crystal thin film of at least two layers.

In this invention, in the sintered compact which comprises aluminum nitride as a main component, or in the various sintered compacts which comprise as a main component a ceramic material which has the crystal system which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., or in the other various sintered compacts which comprise as a main component a ceramic material, such as zirconium oxide, magnesium oxide, magnesium aluminate, titanium oxide, barium titanate, lead titanate zirconate, rare earth oxides such as yttrium oxide, thorium oxide, various ferrites, mullite, forsterite, steatite, and glass, etc., for example, a single-crystal thin film which is constituted with at least two layers can be formed as mentioned above, it can be used suitably even if at least two is what comprises different compositions in each single-crystal thin film layer.

If this is explained more concretely, when a single-crystal thin film comprises three layers, for example, the single-crystal thin film of two kinds of states is contained, that is, what comprises three layers wherein the composition of two layers is same and the composition of remaining one layer is different, and what comprises three layers wherein all the composition is different respectively.

Moreover, for example, when a single-crystal thin film comprises four layers, the thin film of three kinds of states is contained, that is, what comprises four layers wherein the composition of two layers is same and the composition of remaining two layers is different respectively, what comprises four layers wherein the composition of three layers is same and the composition of remaining one layer is different, and what comprises four layers wherein all the composition is different respectively.

Here, that the component differs is that the substantial composition of a single-crystal thin film differs, as for the composition of a single-crystal thin film, not only the case where the rate of component(s) which comprises at least one selected from gallium nitride, indium nitride, and aluminum nitride which are the main components of the single-crystal thin film differs, but also the case where the main component of a single-crystal thin film is only one kind of gallium nitride, indium nitride, and aluminum nitride and the other component is only a doping agent substantially, etc., for example, are contained.

Speaking more concretely, for example, in the case where the main component(s) of a single-crystal thin film is only gallium nitride and magnesium (Mg) is only contained substantially as a doping agent in addition to this, a thing from which the composition ratio of gallium nitride and magnesium differs is also contained.

Or similarly, for example, in the case where the main component(s) of a single-crystal thin film is only aluminum nitride and silicon (Si) is only contained substantially as a doping agent in addition to this, a thing from which the composition ratio of aluminum nitride and silicon differs is also contained.

In this invention, as for the single-crystal thin film which comprises as a main component at least one selected from gallium nitride, indium nitride, and aluminum nitride and is formed on the substrate which comprises a sintered compact which comprises aluminum nitride as a main component, or various sintered compacts which comprise as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., not only a thing of the same component can be formed as a single layer or two or more layers but also a thing which comprises different components can be formed as a single-crystal thin film of at least two layers, even if these are what formed the same component in two or more layers and what formed what is a different component in two or more layers, a thing with the crystallinity, such that the half width of the rocking curve of the X-ray diffraction line from the lattice plane of the Miller Index (002) of the single-crystal thin film of each respectively formed layer is not more than 300 seconds, is obtained.

And, if the substrate in which the single-crystal thin film is formed directly is a sintered compact which comprises aluminum nitride as a main component, a thing excellent in crystallinity, such that the half width of the rocking curve of the X-ray diffraction line from the lattice plane of the Miller Index (002) of the single-crystal thin film which comprises as a main component at least one selected from gallium nitride, indium nitride, and aluminum nitride is not more than 150 seconds, can be obtained, so it is preferred.

In this invention, as for the factor which gives to the crystallinity of the thin film which comprises as a main component at least one selected from gallium nitride, indium nitride, and aluminum nitride and is various crystallization states, such as a single crystal, an amorphous state, a polycrystal, and an orientated polycrystal, and which is formed on the substrate which comprises a sintered compact which comprises aluminum nitride as a main component, or various sintered compacts which comprise as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., or other various sintered compacts which comprise as a main component a ceramic material, such as zirconium oxide, magnesium oxide, magnesium aluminate, titanium oxide, barium titanate, lead titanate zirconate, rare earth oxides such as yttrium oxide, thorium oxide, various ferrites, mullite, forsterite, steatite, and glass, etc., for example, if what has been explained until now is summarized, it will be classified as follows.

That is, in the substrate to be used,
1) Quality of the material of the ceramics (the difference, such as the sintered compact which comprises aluminum nitride as a main component, or the various sintered compacts which comprise as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc.),
2) Composition of the ceramics (the purity and content of the main component(s), the content of the additives or impurities, etc.),
3) Optical transmissivity of the ceramics,
4) Magnitude of ceramic particles,
5) Density of the ceramics,
6) Thickness of the ceramics,
7) Firing conditions of the ceramics,
8) Surface smooth nature of the substrate, and in the thin film,
9) Constitution of the thin film (single layer or multilayer constitution of two or more layers, etc.),
10) Thickness of the thin film,
11) Formation conditions of the thin film (methods for forming a thin film, such as MOCVD, a Chloride VPE, or Sputtering, or substrate temperature, etc.), etc.

And, the following points are mentioned as a factor which seldom affects the crystallinity of the thin film formed on the above ceramic substrate.

That is,
1) whether it has a conduction via in the ceramic substrate (irrespective of the existence of a conduction via, there is no influence in the crystallinity of the thin film formed on a substrate not much),
2) Composition of the thin film (if it is the composition which comprises as a main component at least one selected from gallium nitride, indium nitride, and aluminum nitride, formation in all combination is possible without influencing the crystallinity of the thin film formed, and formation of the thin film which includes various doping component is possible, without influencing the crystallinity), etc.

In this invention, when manufacturing the substrate for thin-film formation for forming the thin film which comprises as a main component at least one selected from gallium nitride, indium nitride, and aluminum nitride and has various crystallization states, such as an amorphous state, a polycrystal, an orientated polycrystal, and a single crystal, etc., and manufacturing the thin-film substrate in which the thin film was formed, as for the substrate which comprises a sintered compact which comprises aluminum nitride as a main component, and various sintered compacts which comprise as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., and other various sintered compacts which comprise as a main component a ceramic material, such as zirconium oxide, magnesium oxide, magnesium aluminate, titanium oxide, barium titanate, lead titanate zirconate, rare earth oxides such as yttrium oxide, thorium oxide, various ferrites, mullite, forsterite, steatite, and glass, etc., for example, the quality of the material is important.

Among those, about the various sintered compacts which comprise as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., and other various sintered compacts which comprise as a main component a ceramic material, such as zirconium oxide, magnesium oxide, magnesium aluminate, titanium oxide, barium titanate, lead titanate zirconate, rare earth oxides such as yttrium oxide, thorium oxide, various ferrites, mullite, forsterite, steatite, and glass, etc., for example, what was manufactured using the conventional method can also be used satisfactorily.

That is, it is what was made into a sintered compact firing the powder compact which mixed suitably sintering aids, a binder, and a dispersant, etc. into a fine powder which comprises as a main component silicon carbide, silicon nitride, zinc oxide, beryllium oxide, aluminum oxide, etc., at high temperature.

The firing condition depends on the grain size or composition of the raw material powder of various ceramic materials respectively, 1500-2500°C in the case of silicon carbide, 1600-2100°C in the case of silicon nitride, 1000-1700°C in the case of gallium nitride, 1100-1700°C in the case of zinc oxide, 1100-2000°C in the case of beryllium oxide, 1100-2000°C in the case of aluminum oxide, etc. are used as a firing temperature, for example.

As an ambient atmosphere at the time of firing, for non-oxides, such as silicon carbide, silicon nitride, and gallium nitride, etc., the non-oxidizing atmosphere which comprises as a main component argon, helium, nitrogen, hydrogen, carbon monoxide, and carbon, etc., the decompression condition smaller than 760 Torr, or the high vacuum condition of not more than 1x10⁻³ Torr are used, as for oxides, such as zinc oxide, beryllium oxide, and aluminum oxide, etc., the oxidizing atmosphere which comprises as a main component air, oxygen, and carbon dioxide, etc. is used in addition to the above non-oxidizing atmosphere, decompression condition, or high vacuum condition.

As a pressure at the time of firing, the pressure of around 1 kg/cm² (760Torr) used in normal pressure sintering, and the pressure of not more than about 5000kg/cm² used by pressurization firing, hot press, and HIP, etc. in addition to the above decompression condition or high vacuum condition, can be used satisfactorily.

As the composition of the above various sintered compacts which comprise as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., even if it is what contains only the main components of each material excluding additives, or what contains one or two or more of components, such as sintering aids, blackening agents, or impurities in a raw material, other than the main components, they can be used satisfactorily.

That is, for example, as the compositions of a sintered compact which comprises silicon carbide as a main component, there are what comprises only SiC substantially, or what contains one or more of components, such as a carbon component, or a boron component, such as B, B4C, and BN, etc., or a rare earth element component, such as Y₂O₃, Er₂O₃, and Yb₂O₃, etc., or an alkaline-earth-metal component, such as BeO, MgO, CaO, SrO, and BaO, etc., or an aluminum component, such as Al₂O₃, etc., or a silicon component, such as SiO₂, etc.

As the compositions of a sintered compact which comprises silicon nitride as a main component, there are what comprises only Si₃N₄ substantially, or what contains one or more of components, such as a rare earth element component, such as Y₂O₃, Er₂O₃, and Yb₂O₃, etc., or an alkaline-earth-metal component, such as BeO, MgO, CaO, SrO, and BaO, etc., or an aluminum component, such as Al₂O₃, etc., or a silicon component, such as SiO₂, etc., or blackening promotion component, such as carbon, molybdenum, and tungsten, etc., or a transition metal component, such as TiO₂, Cr₂O₃, MnO, CoO, NiO, Fe₂O₃, etc.

As the compositions of a sintered compact which comprises gallium nitride as a main component, there are what comprises only GaN substantially, or what contains one or more of components, such as a rare earth element component, such as Y₂O₃, Er₂O₃, and Yb₂O₃, etc., or an alkaline-earth-metal component, such as BeO, MgO, CaO, SrO, and BaO, etc., or an aluminum component, such as Al₂O₃, etc., or a silicon component, such as SiO₂, etc., or blackening promotion component, such as carbon, molybdenum, and tungsten, etc., or a transition metal component, such as TiO₂, Cr₂O₃, MnO, CoO, NiO, Fe₂O₃, etc.

As the compositions of a sintered compact which comprises zinc oxide as a main component, there are what comprises only ZnO substantially, or what contains one or more of components, such as a rare earth element component, such as Y₂O₃, Er₂O₃, and Yb₂O₃, etc., or an alkaline-earth-metal component, such as BeO, MgO, CaO, SrO, and BaO, etc., or an aluminum component, such as Al₂O₃, etc., or a silicon component, such as SiO₂, etc., or a transition metal component, such as TiO₂, Cr₂O₃, MnO, CoO, NiO, Fe₂O₃, etc.

As the compositions of a sintered compact which comprises beryllium oxide as a main component, there are what comprises only BeO substantially, or what contains one or more of components, such as a rare earth element component, such as Y₂O₃, Er₂O₃, and Yb₂O₃, etc., or an alkaline-earth-metal component, such as MgO, CaO, SrO, and BaO, etc., or an aluminum component, such as Al₂O₃, etc., or a silicon component, such as SiO₂, etc., or a transition metal component, such as TiO₂, Cr₂O₃, MnO, CoO, NiO, Fe₂O₃, etc.

As the compositions of a sintered compact which comprises aluminum oxide as a main component, there are what comprises only Al₂O₃ substantially, or what contains one or more of components, such as a rare earth element component, such as Y₂O₃, Er₂O₃, and Yb₂O₃, etc., or an alkaline-earth-metal component, such as BeO, MgO, CaO, SrO, and BaO, etc., or a silicon component, such as SiO₂, etc., or a transition metal component, such as TiO₂, Cr₂O₃, MnO, CoO, NiO, Fe₂O₃, etc.

It has explained until now, when the various sintered compacts which comprise as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., are used as a substrate, the crystallinity of the single-crystal thin film which is formed directly on the substrate and comprises as a main component at least one selected from gallium nitride, indium nitride, and aluminum nitride can be raised by raising the surface smooth nature of the substrate.

However, even if the average surface roughness Ra is about 2 nm as smooth nature of the substrate, it is easy to become the thing, such that the half width of the rocking curve of the X-ray diffraction line from the lattice plane of the Miller Index (002) of the single-crystal thin film is more than 200 seconds.

On the other hand, a thin film which comprises as a main component at least one selected from gallium nitride, indium nitride, and aluminum nitride and has at least one crystallization state selected from an amorphous state, a polycrystal, an orientated polycrystal, and a single crystal is formed beforehand on the substrate using the various sintered compacts which comprise as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., as a substrate, and if a single-crystal thin film which comprises as a main component at least one selected from gallium nitride, indium nitride, and aluminum nitride is formed furthermore on it, the crystallinity of the single-crystal thin film can be raised.

If such a thin film constitution is made, it becomes possible to raise the crystallinity of the single-crystal thin film formed without seldom being influenced by the surface smooth nature of the above substrate, etc.

And, a single-crystal thin film which has still higher crystallinity is producible by optimizing the composition of various sintered compacts which comprise as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc.

As mentioned above, while the single-crystal thin film which comprises as a main component at least one selected from gallium nitride, indium nitride, and aluminum nitride and is formed directly on the substrate which comprises a sintered compact which comprises zinc oxide as a main component is not necessarily able to become a thing excellent in crystallinity by being easy to be influenced by the surface smooth nature of the substrate, etc., if a thin film which comprises as a main component at least one selected from gallium nitride, indium nitride, and aluminum nitride and has at least one crystallization state selected from an amorphous state, a polycrystal, an orientated polycrystal, and a single crystal is formed beforehand on the substrate which comprises a sintered compact which comprises zinc oxide as a main component and a single-crystal thin film which comprises as a main component at least one selected from gallium nitride, indium nitride, and aluminum nitride is formed furthermore on it, it is getting harder to be influenced by the surface smooth nature of the substrate, etc., and the crystallinity of the single-crystal thin film can become what is excellent furthermore.

That is, even if a single-crystal thin film which comprises as a main component at least one selected from gallium nitride, indium nitride, and aluminum nitride is formed directly using as a substrate the sintered compact which comprises zinc oxide as a main component, the single-crystal thin film will not necessarily become a thing comparatively excellent in crystallinity, such that the half width of the rocking curve of the X-ray diffraction line from the lattice plane of the Miller Index (002) is not more than 200 seconds.

On the other hand, using as a substrate the sintered compact which comprises zinc oxide as a main component, if a thin film which comprises as a main component at least one selected from gallium nitride, indium nitride, and aluminum nitride and has at least one crystallization state selected from an amorphous state, a polycrystal, an orientated polycrystal, and a single crystal is formed beforehand and a single-crystal thin film which comprises as a main component at least one selected from gallium nitride, indium nitride, and aluminum nitride is formed furthermore on it, a thing comparatively excellent in crystallinity, such that the half width of the rocking curve of the X-ray diffraction line from the lattice plane of the Miller Index (002) of the single-crystal thin film is not more than 200 seconds, can be formed.

In the above sintered compact which comprises zinc oxide as a main component, when using as a substrate a thing which contains an alkaline-earth-metal component, such as BeO, MgO, CaO, SrO, and BaO, etc., or a rare-earth-elements component, such as Sc₂O₃, Y₂O₃, La₂O₃, CeO₂, Pr₆O₁₁, Nd₂O₃, Pm₂O₃, Sm₂O₃, Eu₂O₃, Gd₂O₃, Tb₄O₇, Dy₂O₃, Ho₂O₃, Er₂O₃, Tm₂O₃, Yb₂O₃, and Lu₂O₃, etc., or a silicon component, such as SiO₂, or a transition-metals component such as MnO, CoO, NiO, Fe₂O₃, Cr₂O₃, and TiO₂, etc., or an aluminum component, in addition to zinc, a thin film with comparatively good crystallinity can be formed on the substrate in many cases.

Among them, it is preferred to use the sintered compact which contains an aluminum component and comprises zinc oxide as a main component.

Usually, when the sintered compact which comprises zinc oxide as a main component and contains an aluminum component in the range of not more than 45.0 mol % on the basis of Al₂O₃ is used as a substrate, a single-crystal thin film which comprises as a main component at least one selected from gallium nitride, indium nitride, and aluminum nitride and is excellent in crystallinity, such that the half width of the rocking curve of the X-ray diffraction line from the lattice plane of the Miller Index (002) is not more than 300 seconds, can be formed directly on it.

Among the above sintered compacts which comprise zinc oxide as a main component, when what contains an aluminum component in the range of 0.001-45.0 mol % on the basis of Al₂O₃ is used as a substrate, a single-crystal thin film which comprises as a main component at least one selected from gallium nitride, indium nitride, and aluminum nitride and is excellent in crystallinity, such that the half width of the rocking curve of the X-ray diffraction line from the lattice plane of the Miller Index (002) is not more than 200 seconds, can be formed directly on it.

Furthermore, when the sintered compact which comprises zinc oxide as a main component and contains an aluminum component in the range of 0.02-45.0 mol % on the basis of Al₂O₃ is used as a substrate, a single-crystal thin film excellent in crystallinity, such that the half width of the rocking curve of the X-ray diffraction line from the lattice plane of the Miller Index (002) is not more than 150 seconds, can be formed directly on the substrate.

Moreover, when the sintered compact which comprises zinc oxide as a main component and contains an aluminum component in the range of 0.08-35.0 mol % on the basis of Al₂O₃ is used as a substrate, a single-crystal thin film excellent in crystallinity, such that the half width of the rocking curve of the X-ray diffraction line from the lattice plane of the Miller Index (002) is not more than 130 seconds, can be formed directly on the substrate.

And, in the sintered compact which comprises zinc oxide as a main component, when using as a substrate a thing which contains not more than 10 mol % on an oxide basis of at least one selected from a rare-earth-elements component, such as Sc₂O₃, Y₂O₃, La₂O₃, CeO₂, Pr₆O₁₁, Nd₂O₃, Pm₂O₃, Sm₂O₃, Eu₂O₃, Gd₂O₃, Tb₄O₇, Dy₂O₃, Ho₂O₃, Er₂O₃, Tm₂O₃, Yb₂O₃, and Lu₂O₃, etc., or a transition-metals component, such as MnO, CoO, NiO, Fe₂O₃, Cr₂O₃, and TiO₂, etc., a single-crystal thin film which comprises as a main component at least one selected from gallium nitride, indium nitride, and aluminum nitride and is excellent in crystallinity, such that the half width of the rocking curve of the X-ray diffraction line from the lattice plane of the Miller Index (002) is not more than 300 seconds, can be formed directly on the substrate.

Usually, a sintered compact which comprises zinc oxide as a main component and which contains at least one selected from Fe and Cr not more than 10.0 mol % on an oxide basis (shown by Fe₂O₃ and Cr₂O₃, respectively) as the above transition-metals component is desirable, a single-crystal thin film which is excellent in crystallinity and comprises as a main component at least one selected from gallium nitride, indium nitride, and aluminum nitride can be formed on it using the sintered compact of such composition, as a substrate.

Furthermore, when the above substrate which comprises a sintered compact which comprises zinc oxide as a main component and contains an aluminum component is used, if a thin film which comprises as a main component at least one selected from gallium nitride, indium nitride, and aluminum nitride and has various crystallization states, such as an amorphous state, a polycrystal, an orientated polycrystal, and a single crystal, etc., is formed beforehand on the substrate which comprises the sintered compact of same composition which comprises zinc oxide as a main component and contains an aluminum component and a single-crystal thin film which comprises as a main component at least one selected from gallium nitride, indium nitride, and aluminum nitride is formed furthermore on it, the crystallinity of the single-crystal thin film can become a thing furthermore superior to the crystallinity of the single-crystal thin film which comprises as a main component at least one selected from gallium nitride, indium nitride, and aluminum nitride and is formed directly on the substrate.

Saying concretely, when a sintered compact which comprises zinc oxide as a main component and contains an aluminum component in the range of not more than 45.0 mol % on the basis of Al₂O₃ is used as the substrate, if a thin film which comprises as a main component at least one selected from gallium nitride, indium nitride, and aluminum nitride and has various crystallization states, such as an amorphous state, a polycrystal, an orientated polycrystal, and a single crystal, etc., is formed beforehand on it and a single-crystal thin film which comprises as a main component at least one selected from gallium nitride, indium nitride, and aluminum nitride is formed furthermore on it, the single-crystal thin film excellent in crystallinity, such that the half width of the rocking curve of the X-ray diffraction line from the lattice plane of the Miller Index (002) is not more than 200 seconds, usually not more than 150 seconds, can be formed comparatively easily.

And, when a sintered compact which comprises zinc oxide as a main component and contains an aluminum component in the range of 0.001-45.0 mol % on the basis of Al₂O₃ is used as the substrate, if a thin film which comprises as a main component at least one selected from gallium nitride, indium nitride, and aluminum nitride and has various crystallization states, such as an amorphous state, a polycrystal, an orientated polycrystal, and a single crystal, etc., is formed beforehand on it and a single-crystal thin film which comprises as a main component at least one selected from gallium nitride, indium nitride, and aluminum nitride is formed furthermore on it, the single-crystal thin film excellent in crystallinity, such that the half width of the rocking curve of the X-ray diffraction line from the lattice plane of the Miller Index (002) is not more than 130 seconds, can be formed comparatively easily.

And, when a sintered compact which comprises zinc oxide as a main component and contains an aluminum component in the range of 0.005-45.0 mol % on the basis of Al₂O₃ is used as the substrate, if a thin film which comprises as a main component at least one selected from gallium nitride, indium nitride, and aluminum nitride and has various crystallization states, such as an amorphous state, a polycrystal, an orientated polycrystal, and a single crystal, etc., is formed beforehand on it and a single-crystal thin film which comprises as a main component at least one selected from gallium nitride, indium nitride, and aluminum nitride is formed furthermore on it, the single-crystal thin film excellent in crystallinity, such that the half width of the rocking curve of the X-ray diffraction line from the lattice plane of the Miller Index (002) is not more than 100 seconds, can be formed comparatively easily.

At this time, as for the crystallinity ofthe orientated polycrystalline thin film which comprises as a main component at least one selected from gallium nitride, indium nitride, and aluminum nitride and is formed beforehand on the above substrate which comprises a sintered compact which comprises zinc oxide as a main component and contains an aluminum component in the range of 0.001-45.0 mol % on the basis of Al₂O₃, it also tends to be improved compared with what used the substrate which comprises a sintered compact which comprises zinc oxide as a main component and does not contain an aluminum component in the above range, a thing, such that the half width of the rocking curve of the X-ray diffraction line from the lattice plane of the Miller Index (002) of the orientated polycrystalline thin film is not more than 9000 seconds, can be formed comparatively easily.

And, in the substrate which comprises a sintered compact which comprises zinc oxide as a main component and contains an aluminum component in the range of 0.005-45.0 mol % on the basis of Al₂O₃, a thing, such that the half width of the rocking curve of the X-ray diffraction line from the lattice plane of the Miller Index (002) of the orientated polycrystalline thin film which comprises as a main component at least one selected from gallium nitride, indium nitride, and aluminum nitride and is formed beforehand on the substrate is not more than 8000 seconds, can be formed comparatively easily.

And, in the sintered compact which comprises zinc oxide as a main component, when what contains at least one selected from a rare-earth-elements component, such as Sc₂O₃, Y₂O₃, La₂O₃, CeO₂, Pr₆O₁₁, Nd₂O₃, Pm₂O₃, Sm₂O₃, Eu₂O₃, Gd₂O₃, Tb₄O₇, Dy₂O₃, Ho₂O₃, Er₂O₃, Tm₂O₃, Yb₂O₃, and Lu₂O₃, etc., or a transition-metals component, such as MnO, CoO, NiO, Fe₂O₃, Cr₂O₃, and TiO₂, etc., not more than 10 mol % on an oxide basis in addition to zinc is used as a substrate, if a thin film which comprises as a main component at least one selected from gallium nitride, indium nitride, and aluminum nitride and has various crystallization states, such as an amorphous state, a polycrystal, an orientated polycrystal, and a single crystal, etc., is formed beforehand on it and a single-crystal thin film which comprises as amain component at least one selected from gallium nitride, indium nitride, and aluminum nitride is formed furthermore on it, a thing excellent in crystallinity, such that the half width of the rocking curve of the X-ray diffraction line from the lattice plane of the Miller Index (002) of the single-crystal thin film is not more than 130 seconds, can be formed comparatively easily.

Usually, a sintered compact which comprises zinc oxide as a main component and contains at least one selected from Fe and Cr not more than 10 mol % on an oxide basis (shown by Fe₂O₃ and Cr₂O₃, respectively) as the above transition-metals component is preferred, and a single-crystal thin film which comprises as a main component at least one selected from gallium nitride, indium nitride, and aluminum nitride and is excellent in crystallinity can be formed on it using the sintered compact of such composition, as a substrate.

Thus, if a thin film which comprises as a main component at least one selected from gallium nitride, indium nitride, and aluminum nitride and has various crystallization states, such as an amorphous state, a polycrystal, an orientated polycrystal, and a single crystal, etc., is formed beforehand on the substrate which comprises a sintered compact which comprises zinc oxide as a main component, furthermore it is effective in raising the crystallinity of the single-crystal thin film which is formed on it and comprises as a main component at least one selected from gallium nitride, indium nitride, and aluminum nitride.

The effect can be shown without being influenced greatly, by the element except the composition of the substrate which comprises a sintered compact which comprises zinc oxide as a main component, such as the surface smooth nature, etc., for example, even if it is not a thing in which the average surface roughness Ra is made into not more than 5 nm (namely, even if it is a thing in which the average surface roughness Ra is not less than 5 nm, such as a substrate with the as-fired surface state, a substrate with the surface state which carried out lap polish, a substrate with the surface state which carried out blast polish, or a substrate which has carried out specular surface polish), for example.

As for the effect of the components which gives to the crystallinity of a single-crystal thin film other than a zinc in a sintered compact which comprises zinc oxide as a main component, especially an aluminum component among them, it is rare that it decreases even if at least one or more metal components other than an aluminum component, for example, an alkaline-earth-metal component, such as BeO, MgO, CaO, SrO, and BaO, etc., or a rare-earth elements component, such as Sc₂O₃, Y₂O₃, La₂O₃, CeO₂, Pr₆O₁₁, Nd₂O₃, Pm₂O₃, Sm₂O₃, Eu₂O₃, Gd₂O₃, Tb₄O₇, Dy₂O₃, Ho₂O₃, Er₂O₃, Tm₂O₃, Yb₂O₃, and Lu₂O₃, etc., or a silicon component, such as SiO₂, or a transition-metals component, such as MnO, CoO, NiO, Fe₂O₃, Cr₂O₃, and TiO₂, etc., are contained in the sintered compact which comprises zinc oxide as a main component.

It is not necessarily clear about the cause in which the single-crystal thin film formed on the substrate becomes what has such high crystallinity when the sintered compact which comprises zinc oxide as a main component and contains an aluminum component not more than 45.0 mol % on the basis of Al₂O₃ is used as a substrate, but this inventor thinks as follows.

While the sintered compact which comprises zinc oxide as a main component and does not contain an aluminum component is usually presenting white or yellow white, the sintered compact which comprises zinc oxide as a main component and contains an aluminum component is usually colored into the blue and has the tendency to increase the coloring nature according to the increase of the content of an aluminum component.

This inventor is guessing that the above coloration to the blue is generated by the formation of a donor parallel by replacing Zn ion by the cause in which Al ion which exists in zinc oxide enters to the crystal lattice of zinc oxide, it changes to the direction in which the size of the zinc oxide crystal becomes small (that is, a lattice constant becomes small) by replacing Zn ion in the zinc oxide crystal by the above Al ion, and the thin film crystal growth direction will be easy to be arranged (epitaxial growth possibility increases spontaneously) when growth of the thin film which comprises as a main component at least one selected from gallium nitride, indium nitride, and aluminum nitride is started, and a single-crystal thin film which is excellent in crystallinity and comprises as a main component at least one selected from gallium nitride, indium nitride, and aluminum nitride becomes easy to be formed on it as the result, when the sintered compact which comprises zinc oxide as a main component and contains such an aluminum component is used as a substrate.

While the zinc oxide-based sintered compact not containing aluminum usually has low conductivity, the zinc oxide-based sintered compact containing aluminum in not more than 45.0 mol % on the basis of Al₂O₃ has higher conductivity.

Specifically, the zinc oxide-based sintered compact containing aluminum in a range of 0.001-45.0 mol % on the basis of Al₂O₃ has electric resistivity of at least not more than 1x10² Ω·cm at room temperature.

In the case of the sintered compact which comprises zinc oxide as a main component and contains an aluminum component in the range of 0.005-45.0 mol % on the basis of Al₂O₃, since what is the electric resistivity at least not more than 1x10¹ Ω·cm at room temperature is easy to be obtained, it becomes possible to use the sintered compact as a substrate without a conduction via, it is desirable.

And, in the case of the sintered compact which comprises zinc oxide as a main component and contains an aluminum component in the range of 0.02-45.0 mol % on the basis of Al₂O₃, since what is the electric resistivity at least not more than 1x10⁰ Ω·cm at room temperature is easy to be obtained, it becomes possible to use the sintered compact as a substrate without a conduction via, it is more desirable.

In ehe case of the sintered compact which comprises zinc oxide as a main component and contains an aluminum component in the range of 0.08-45.0 mol % on the basis of Al₂O₃, since what is the electric resistivity at least not more than 1x10⁻¹ Ω·cm at room temperature is easy to be obtained, it becomes possible to use the sintered compact as a substrate without a conduction via, it is still more desirable.

In the case of the sintered compact which comprises zinc oxide as a main component and contains an aluminum component in the range of 0.2-25.0 mol % on the basis of Al₂O₃, what is the electric resistivity at least not more than 1x10⁻² Ω·cm at room temperature is easy to be obtained, and what has the lower electric resistivity which is about 1-2x10⁻³ Ω·cm is also obtained.

Since the zinc oxide-based sintered compact having such conductivity does not need especially to provide conduction vias for connecting the up-and-down surface of a substrate electrically, it is preferred.

In the above sintered compact which comprises zinc oxide as a main component, even if it contains at least one selected from an alkaline-earth-metal component, such as BeO, MgO, CaO, SrO, and BaO, etc., or a transition-metals component, such as MnO, CoO, NiO, Fe₂O₃, Cr₂O₃, and TiO₂, etc., or a silicon component, such as SiO₂, or a rare-earth elements component, such as Sc₂O₃, Y₂O₃, La₂O₃, CeO₂, Pr₆O₁₁, Nd₂O₃, Pm₂O₃, Sm₂O₃, Eu₂O₃, Gd₂O₃, Tb₄O₇, Dy₂O₃, Ho₂O₃, Er₂O₃, Tm₂O₃, Yb₂O₃, and Lu₂O₃, etc., other than the aluminum component, there are few degrees by which the conductivity is spoiled.

As the content of the component(s) contained in the above sintered compact which comprises zinc oxide as a main component other than the aluminum, as long as the degree by which the conductivity is spoiled is small, it may be what kind of thing.

Usually, if the content of the component(s) other than the aluminum is not more than 10.0 mol % on an oxide basis, the degree by which conductivity is spoiled is small, and it is desirable.

And, the sintered compact which comprises zinc oxide as a main component and has conductivity is possible to be obtained also not only in what contains an aluminum component but also in what contains not more than 10 mol % on an oxide basis of at least one selected from a rare-earth elements component, such as Sc₂O₃, Y₂O₃, La₂O₃, CeO₂, Pr₆O₁₁, Nd₂O₃, Pm₂O₃, Sm₂O₃, Eu₂O₃, Gd₂O₃, Tb₄O₇, Dy₂O₃, Ho₂O₃, Er₂O₃, Tm₂O₃, Yb₂O₃, and Lu₂O₃, etc., or a transition-metals component, such as MnO, CoO, NiO, Fe₂O₃, Cr₂O₃, and TiO₂, etc., as the component other than zinc.

Usually, a sintered compact which comprises zinc oxide as a main component and contains at least one selected from Fe and Cr not more than 10 mol % on an oxide basis as the above transition-metals component is desirable, and a single-crystal thin film which is excellent in crystallinity and comprises as a main component at least one selected from gallium nitride, indium nitride, and aluminum nitride can be formed on it, using the sintered compact of such composition, as a substrate.

In the above sintered compact which comprises zinc oxide as a main component, what has comparatively high optical transmissivity is producible by firing in ambient atmospheres, such as reduced atmosphere containing CO, H₂, etc., or non-oxidizing atmosphere containing Ar, He, N₂, etc., or decompression condition, or high pressure condition by hot pressing, etc., and what has comparatively high optical transmissivity is producible, even if the firing is carried out in air with normal pressure without using such an ambient atmosphere especially.

That is, even if the sintered compact which comprises zinc oxide as a main component is what kind of composition, what has optical permeability to visible light with a wavelength not less than 380 nm, and to light with a wavelength longer than visible light is producible.

For example, even if the sintered compact which comprises zinc oxide as a main component is what kind of composition, a thing in which the optical transmissivity is not less than 1 % is producible.

Usually, in the sintered compact which comprises zinc oxide as a main component and contains a zinc oxide component not less than 55.0 mol % on the basis of ZnO, a thing in which the optical transmissivity is not less than 1 % is producible.

And, for example, in the sintered compact which comprises zinc oxide as a main component and which comprises only ZnO substantially by firing without using an additive, a thing in which the optical transmissivity is not less than 10 % is producible.

In this invention, the optical transmissivity of the sintered compact which comprises zinc oxide as a main component is a thing to the light of the range of 200-800 nm wavelength at least. And, the above optical transmissivity is what was measured using light with a wavelength of 605 nm.

In this invention, unless reference is made especially, the above measured value is used for the optical transmissivity of the sintered compact which comprises zinc oxide as a main component, from now on.

As mentioned above, in the case of the sintered compact which comprises zinc oxide as a main component and contains an aluminum component in the range of not more than 45.0 mol % on the basis of Al₂O₃, not only what has conductivity but also what has optical permeability is producible, as mentioned above.

As the optical transmissivity of the above sintered compact which comprises zinc oxide as a main component and contains an aluminum component, a thing in which the optical transmissivity is not less than 10 % is usually producible.

Furthermore, in the case of the sintered compact which comprises zinc oxide as a main component and contains an aluminum component in the range of 0.001 mol %-45.0 mol % on the basis of Al₂O₃, not only what has conductivity but also what improved the optical transmissivity into not less than 20 % is easy to be obtained as mentioned above, and what is the optical transmissivity not less than 30 %, not less than 40 %, not less than 50 %, not less than 60 %, and furthermore not less than 80 %, is producible.

In addition, the above optical transmissivity is not the straight line transmittance of a transparent body, such as glass, etc., but means the total transmittance like the optical transmissivity of the sintered compact which comprises aluminum nitride as a main component.

If it explains in detail, in such sintered compact which comprises zinc oxide as a main component and has optical permeability, even if it includes metal components, such as an alkaline-earth-metal component, such as BeO, MgO, CaO, SrO, and BaO, etc., or a transition-metals component, such as MnO, CoO, NiO, Fe₂O₃, Cr₂O₃, and TiO₂, etc., or a silicon component, such as SiO₂, etc., or a rare earth element component, such as Sc₂O₃, Y₂O₃, La₂O₃, CeO₂, Pr₆O₁₁, Nd₂O₃, Pm₂O₃, Sm₂O₃, Eu₂O₃, Gd₂O₃, Tb₄O₇, Dy₂O₃, Ho₂O₃, Er₂O₃, Tm₂O₃, Yb₂O₃, and Lu₂O₃, etc., other than an aluminum component, it is rare that the optical permeability or conductivity decrease.

Among them, for example, even if it is the sintered compact which comprises zinc oxide as a main component and which contains an aluminum component such as Al₂O₃ and contains simultaneously at least one selected from a rare-earth-elements component, such as Sc, Y, La, Ce, Pr, Nd, Pm, Sm, Eu, Gd, Tb, Dy, Ho, Er, Tm, Yb, and Lu, etc., not more than 10.0 mol % in total on an oxide basis, what has the optical transmissivity not less than 20% can be obtained.

Moreover, in the above sintered compact which comprises zinc oxide as a main component and contains a rare earth element component in the range of 0.0002 mol %-10.0 mol %, the optical transmissivity becomes easy to be improved furthermore, what has the optical transmissivity not less than 30% becomes easy to be obtained, and what is a maximum of 84 % was also obtained in this invention.

Namely, in the sintered compact which comprises zinc oxide as a main component and which contains an aluminum component not more than 45.0 mol % on the basis of Al₂O₃ and contains simultaneously at least one selected from a rare earth element component in the range of 0.0002-10.0 mol % in total on an oxide basis, what is the optical transmissivity not less than 30 % is easy to be obtained.

And, in the sintered compact which comprises zinc oxide as a main component and which contains an aluminum component not more than 45.0 mol % on the basis of Al₂O₃ and contains furthermore at least one selected from a rare earth element component in the range of 0.0006-6.0 mol % in total on an oxide basis, what is the optical transmissivity not less than 40 % is easy to be obtained.

And, in the sintered compact which comprises zinc oxide as a main component and which contains an aluminum component not more than 45.0 mol % on the basis of Al₂O₃ and contains furthermore at least one selected from a rare earth element component in the range of 0.001-6.0 mol % in total on an oxide basis, what is the optical transmissivity not less than 50 % is easy to be obtained.

And, in the sintered compact which comprises zinc oxide as a main component and which contains an aluminum component not more than 45.0 mol % on the basis of Al₂O₃ and contains furthermore at least one selected from a rare earth element component in the range of 0.002-3.0 mol % in total on an oxide basis, what is the optical transmissivity not less than 60 % is easy to be obtained.

In addition, as the oxide used for the basis of conversion of the content of a rare earth element component contained in the above sintered compact which comprises zinc oxide as a main component, it means Sc₂O₃, Y₂O₃, La₂O₃, CeO₂, Pr₆O₁₁, Nd₂O₃, Pm₂O₃, Sm₂O₃, Eu₂O₃, Gd₂O₃, Tb₄O₇, Dy₂O₃, Ho₂O₃, Er₂O₃, Tm₂O₃, Yb₂O₃, and Lu₂O₃.

Moreover, as for the content of an aluminum component in the above sintered compact which comprises zinc oxide as a main component and contains simultaneously an aluminum component and a rare earth element component, it is preferred that it is the range of 0.001-45.0 mol % on the basis of Al₂O₃ in order to raise the optical permeability.

Thus, in the sintered compact which comprises zinc oxide as a main component and contains simultaneously an aluminum component and a rare earth element component, a thing more excellent in optical permeability is easy to be obtained, and it is rare to damage conductivity by containing an aluminum component and a rare earth element component simultaneously.

Even when the above sintered compact which comprises zinc oxide as a main component and which contains simultaneously a rare-earth-elements component in addition to an aluminum component and has comparatively high optical transmissivity is used as a substrate, as for the crystallinity of the single-crystal thin film which comprises as a main component at least one selected from gallium nitride, indium nitride, and aluminum nitride, or the orientated polycrystalline thin film which comprises as a main component at least one selected from gallium nitride, indium nitride, and aluminum nitride, which are formed on the substrate, it is usually the same degree compared with what used as a substrate the sintered compact which comprises zinc oxide as a main component and which does not contain substantially a rare-earth-elements component but contains an aluminum component, and there is little change of crystallinity lowering greatly.

As mentioned above, in the sintered compact which comprises zinc oxide as a main component and contains an aluminum component, what has conductivity and comparatively high optical transmissivity can be produced comparatively easily.

And, in the case of the sintered compact which comprises zinc oxide as a main component and contains simultaneously an aluminum component and a rare-earth-elements component, what has higher optical transmissivity and conductivity is producible comparatively easily, as mentioned above.

If a light-emitting device is produced using as a substrate the sintered compact which comprises a ceramic material as a main component and has conductivity, such as the above zinc oxides, etc., it has the feature in which the light-emitting device which has the form wherein the electric connection between electrodes and the device is possible by arranging electrodes up and down without forming a conduction via in a substrate is producible.

If the electric resistivity of the sintered compact is not more than 1x10² Ω·cm at room temperature when the sintered compact which comprises a ceramic material as a main component and has conductivity is used as a substrate, electric power sufficient by little loss can be supplied even if the light-emitting device has the form in which the electrodes were arranged up and down.

As the electric resistivity of the sintered compact which has conductivity, what is not more than 1x10¹ Ω·cm is preferred at room temperature, what is not more than 1x10⁰ Ω·cm is more preferred, and what is 1x10⁻¹ Ω·cm is still more preferred.

And, in this invention, while the single-crystal thin film which comprises as a main component at least one selected from gallium nitride, indium nitride, and aluminum nitride and is formed directly on the substrate which comprises a sintered compact which comprises beryllium oxide as a main component is not necessarily able to become a thing excellent in crystallinity by being easy to be influenced by the surface smooth nature of the substrate, etc., as mentioned above, if a thin film which comprises as a main component at least one selected from gallium nitride, indium nitride, and aluminum nitride and has various crystallization states, such as an amorphous state, a polycrystal, an orientated polycrystal, and a single crystal, etc., is formed beforehand on the substrate which comprises a sintered compact which comprises beryllium oxide as a main component and a single-crystal thin film which comprises as a main component at least one selected from gallium nitride, indium nitride, and aluminum nitride is formed furthermore on it, it is getting harder to be influenced by the surface smooth nature of the substrate, etc., and the crystallinity of the single-crystal thin film can become what is excellent furthermore.

That is, even if a single-crystal thin film which comprises as a main component at least one selected from gallium nitride, indium nitride, and aluminum nitride is formed directly using as a substrate the sintered compact which comprises beryllium oxide as a main component, the single-crystal thin film will not necessarily become a thing comparatively excellent in crystallinity, such that the half width of the rocking curve of the X-ray diffraction line from the lattice plane of the Miller Index (002) is not more than 200 seconds.

On the other hand, using as a substrate the sintered compact which comprises beryllium oxide as a main component, if a thin film which comprises as a main component at least one selected from gallium nitride, indium nitride, and aluminum nitride and has various crystallization states, such as an amorphous state, a polycrystal, an orientated polycrystal, and a single crystal, etc., is formed beforehand and a single-crystal thin film which comprises as a main component at least one selected from gallium nitride, indium nitride, and aluminum nitride is formed furthermore on it, a thing comparatively excellent in crystallinity, such that the half width of the rocking curve of the X-ray diffraction line from the lattice plane of the Miller Index (002) of the single-crystal thin film is not more than 200 seconds, can be formed.

In the above sintered compact which comprises beryllium oxide as a main component, when what contains at least one selected from a magnesium component, a calcium component, and a silicon component in addition to beryllium is used as a substrate, a thin film with comparatively good crystallinity can be formed on the substrate.

Usually, when the sintered compact which comprises beryllium oxide as a main component and contains at least one selected from a magnesium component, a calcium component, and a silicon component in the range of not more than 35.0 mol % in total on an oxide basis is used as a substrate, a single-crystal thin film which comprises as a main component at least one selected from gallium nitride, indium nitride, and aluminum nitride and is excellent in crystallinity, such that the half width of the rocking curve of the X-ray diffraction line from the lattice plane of a Miller Index (002) is not more than 300 seconds, can be formed directly on the substrate.

In the above sintered compact which comprises beryllium oxide as a main component, when what contains at least one selected from a magnesium component, a calcium component, and a silicon component in the range of 0.0002-35.0 mol % in total on an oxide basis is used as a substrate, a single-crystal thin film which comprises as a main component at least one selected from gallium nitride, indium nitride, and aluminum nitride and is excellent in crystallinity, such that the half width of the rocking curve of the X-ray diffraction line from the lattice plane of a Miller Index (002) is not more than 200 seconds, can be formed directly on the substrate.

And, when the sintered compact which comprises beryllium oxide as a main component and contains at least one selected from a magnesium component, a calcium component, and a silicon component in the range of 0.004-35.0 mol % in total on an oxide basis is used as a substrate, a single-crystal thin film excellent in crystallinity, such that the half width of the rocking curve of the X-ray diffraction line from the lattice plane of a Miller Index (002) is not more than 150 seconds, can be formed directly on the substrate.

And, when the sintered compact which comprises beryllium oxide as a main component and contains at least one selected from a magnesium component, a calcium component, and a silicon component in the range of 0.015-25.0 mol % in total on an oxide basis is used as a substrate, a single-crystal thin film excellent in crystallinity, such that the half width of the rocking curve of the X-ray diffraction line from the lattice plane of a Miller Index (002) is not more than 130 seconds, can be formed directly on the substrate.

In addition, in the above sintered compact which comprises beryllium oxide as a main component, though the value which carried out on an oxide basis is used as the content of a magnesium component, a calcium component, and a silicon component, the oxide used for the basis of conversion is MgO in the case of a magnesium component, CaO in the case of a calcium component, and SiO₂ in the case of a silicon component.

Hereafter, unless reference is made especially in this invention, as for a magnesium component, a calcium component, and a silicon component which are contained in the beryllium oxide-based sintered compact, the compounds used for the basis converted to oxide are MgO, CaO, and SiO₂, respectively.

Furthermore, when the above substrate which comprises a sintered compact which comprises beryllium oxide as a main component and contains a magnesium component, a calcium component, and a silicon component is used, if a thin film which comprises as a main component at least one selected from gallium nitride, indium nitride, and aluminum nitride and has various crystallization states, such as an amorphous state, a polycrystal, an orientated polycrystal, and a single crystal, etc., is formed beforehand on the substrate which comprises the sintered compact of same composition which comprises beryllium oxide as a main component and contains a magnesium component, a calcium component, and a silicon component and a single-crystal thin film which comprises as a main component at least one selected from gallium nitride, indium nitride, and aluminum nitride is formed furthermore on it, the crystallinity of the single-crystal thin film can become a thing furthermore superior to the crystallinity of the single-crystal thin film which comprises as a main component at least one selected from gallium nitride, indium nitride, and aluminum nitride and is formed directly on the substrate.

Saying concretely, using as the substrate a sintered compact which comprises beryllium oxide as a main component and contains at least one selected from a magnesium component, a calcium component, and a silicon component in the range of not more than 35.0 mol % in total on an oxide basis, if a thin film which comprises as a main component at least one selected from gallium nitride, indium nitride, and aluminum nitride and has various crystallization states, such as an amorphous state, a polycrystal, an orientated polycrystal, and a single crystal, etc., is formed beforehand on it and a single-crystal thin film which comprises as a main component at least one selected from gallium nitride, indium nitride, and aluminum nitride is formed furthermore on it, a thing excellent in crystallinity, such that the half width of the rocking curve of the X-ray diffraction line from the lattice plane of the Miller Index (002) of the single-crystal thin film is not more than 200 seconds, usually not more than 150 seconds, can be formed comparatively easily.

And, using as the substrate a sintered compact which comprises beryllium oxide as a main component and contains at least one selected from a magnesium component, a calcium component, and a silicon component in the range of 0.0002-35.0 mol % in total on an oxide basis, if a thin film which comprises as a main component at least one selected from gallium nitride, indium nitride, and aluminum nitride and has various crystallization states, such as an amorphous state, a polycrystal, an orientated polycrystal, and a single crystal, etc., is formed beforehand on it and a single-crystal thin film which comprises as a main component at least one selected from gallium nitride, indium nitride, and aluminum nitride is formed furthermore on it, a thing excellent in crystallinity, such that the half width of the rocking curve of the X-ray diffraction line from the lattice plane of the Miller Index (002) of the single-crystal thin film is not more than 130 seconds, can be formed comparatively easily.

And, using as the substrate a sintered compact which comprises beryllium oxide as a main component and contains at least one selected from a magnesium component, a calcium component, and a silicon component in the range of 0.001-35.0 mol % in total on an oxide basis, if a thin film which comprises as a main component at least one selected from gallium nitride, indium nitride, and aluminum nitride and has various crystallization states, such as an amorphous state, a polycrystal, an orientated polycrystal, and a single crystal, etc., is formed beforehand on it and a single-crystal thin film which comprises as a main component at least one selected from gallium nitride, indium nitride, and aluminum nitride is formed furthermore on it, a thing excellent in crystallinity, such that the half width of the rocking curve of the X-ray diffraction line from the lattice plane of the Miller Index (002) of the single-crystal thin film is not more than 100 seconds, can be formed comparatively easily.

At this time, as for the crystallinity ofthe orientated polycrystalline thin film which comprises as a main component at least one selected from gallium nitride, indium nitride, and aluminum nitride and is formed beforehand on the above substrate which comprises a sintered compact which comprises beryllium oxide as a main component and contains at least one selected from a magnesium component, a calcium component, and a silicon component in the range of 0.0002-35.0 mol % in total on an oxide basis, it also tends to be improved compared with what used the substrate which comprises a sintered compact which comprises beryllium oxide as a main component and does not contain a magnesium component, a calcium component, and a silicon component in the above range, a thing, such that the half width of the rocking curve of the X-ray diffraction line from the lattice plane of the Miller Index (002) of the orientated polycrystalline thin film is not more than 9000 seconds, can be formed comparatively easily. a thing, such that the half width of the rocking curve of the X-ray diffraction line from the lattice plane of the Miller Index (002) of the orientated polycrystalline thin film which comprises as a main component at least one selected from gallium nitride, indium nitride, and aluminum nitride and is formed beforehand on the substrate is not more than 8000 seconds, can be formed comparatively easily.

Thus, if a thin film which comprises as a main component at least one selected from gallium nitride, indium nitride, and aluminum nitride and has various crystallization states, such as an amorphous state, a polycrystal, an orientated polycrystal, and a single crystal, etc., is formed beforehand on the substrate which comprises a sintered compact which comprises beryllium oxide as a main component, furthermore it is effective in raising the crystallinity of the single-crystal thin film which is formed on it and comprises as a main component at least one selected from gallium nitride, indium nitride, and aluminum nitride.

The effect can be shown without being influenced greatly, by the element except the composition of the substrate which comprises a sintered compact which comprises beryllium oxide as a main component, such as the surface smooth nature, etc., for example, even if it is not a thing in which the average surface roughness Ra is made into not more than 5 nm (namely, even if it is a thing in which the average surface roughness Ra is not less than 5 nm, such as a substrate with the as-fired surface state, a substrate with the surface state which carried out lap polish, a substrate with the surface state which carried out blast polish, or a substrate which has carried out specular surface polish), for example.

As for the effect in which containing at least one selected from a magnesium component, a calcium component, and a silicon component, in a sintered compact comprising beryllium oxide as a main component gives to the crystallinity of a single-crystal thin film, it is rare that it decreases even if metal component(s) other than a magnesium component, a calcium component, and a silicon component, for example, an alkaline-earth-metal component, such as SrO and BaO, etc., or a rare-earth elements component, such as Sc₂O₃, Y₂O₃, La₂O₃, CeO₂, Pr₆O₁₁, Nd₂O₃, Pm₂O₃, Sm₂O₃, Eu₂O₃, Gd₂O₃, Tb₄O₇, Dy₂O₃, Ho₂O₃, Er₂O₃, Tm₂O₃, Yb₂O₃, and Lu₂O₃, etc., or other transition-metals component, such as MnO, CoO, NiO, Fe₂O₃, Cr₂O₃, and TiO₂, etc., is contained in the sintered compact which comprises beryllium oxide as a main component.

Although it is not necessarily clear about the cause in which the single-crystal thin film formed on the substrate becomes such high crystallinity when the sintered compact which comprises beryllium oxide as a main component and contains at least one selected from a magnesium component, a calcium component, and a silicon component in the range of not more than 35.0 mol % in total on an oxide basis is used as a substrate, this inventor thinks that the sintered compact becomes what has a microstructure which has few pores between particles and in which the size of beryllium oxide crystal grain is comparatively equal, because the above component(s) becomes a grain boundary phase, exists between beryllium oxide particles, and probably controls extraordinary particle growth of some beryllium oxide particles.

And, in the above sintered compact which comprises beryllium oxide as a main component, what has comparatively high optical transmissivity is producible by firing in ambient atmospheres, such as reduced atmosphere containing CO, H₂, etc., or non-oxidizing atmosphere containing Ar, He, N₂, etc., or decompression condition, or high pressure condition by hot pressing, etc., and what has comparatively high optical transmissivity is producible, even if the firing is carried out in air with normal pressure without using such an ambient atmosphere.

That is, as for the sintered compact which comprises beryllium oxide as a main component, even if it is what kind of composition, what has optical permeability to ultraviolet light with a wavelength not less than 200 nm, visible light, and light with wavelength longer than visible light is producible.

For example, even if the sintered compact which comprises beryllium oxide as a main component is what kind of composition, a thing in which the optical transmissivity is not less than 1 % is producible.

Usually, in the sintered compact which comprises beryllium oxide as a main component and contains a beryllium oxide component not less than 65.0 mol % on the basis of BeO, a thing in which the optical transmissivity is not less than 1 % is producible.

And, for example, in the sintered compact which comprises beryllium oxide as a main component and which comprises only BeO substantially by firing without using an additive, a thing in which the optical transmissivity is not less than 10 % is producible.

In addition, in this invention, the optical transmissivity of the sintered compact which comprises beryllium oxide as a main component is a thing to the light of the range of 200-800 nm wavelength at least. And, the above optical transmissivity is what was measured using light with a wavelength of 605 nm.

In this invention, unless reference is made especially, the above measured value is used for the optical transmissivity of the sintered compact which comprises beryllium oxide as a main component, from now on.

And, also in the sintered compact which comprises beryllium oxide as a main component and contains at least one selected from a magnesium component, a calcium component, and a silicon component in the range of not more than 35.0 mol % in total on an oxide basis, what is the optical transmissivity not less than 10 % is producible, as mentioned above.

Moreover, in the sintered compact which comprises beryllium oxide as a main component and contains at least one selected from a magnesium component, a calcium component, and a silicon component in the range of 0.0002-35.0 mol % in total on an oxide basis, what improved the optical transmissivity into not less than 20 % is easy to be obtained as mentioned above, and what is the optical transmissivity not less than 30 %, not less than 40 %, not less than 50 %, not less than 60 %, and furthermore not less than 80 %, is producible.

In addition, the above optical transmissivity is not the straight line transmittance of a transparent body, such as glass, etc., but means the total transmittance like the optical transmissivity of the sintered compact which comprises aluminum nitride as a main component.

If it explains in detail, in such sintered compact which comprises beryllium oxide as a main component, even if it includes component(s), such as SrO, BaO, MnO, CoO, NiO, Fe₂O₃, Cr₂O₃, TiO₂, Sc₂O₃, Y₂O₃, La₂O₃, CeO₂, Pr₆O₁₁, Nd₂O₃, Pm₂O₃, Sm₂O₃, Eu₂O₃, Gd₂O₃, Tb₄O₇, Dy₂O₃, Ho₂O₃, Er₂O₃, Tm₂O₃, Yb₂O₃, and Lu₂O₃, etc., other than a magnesium component, a calcium component, and a silicon component, it is rare that the optical permeability decreases.

Among them, for example, even if it is the sintered compact which comprises beryllium oxide as a main component and which contains at least one selected from a magnesium component such as MgO, a calcium component such as CaO, and a silicon component such as SiO₂ and contains simultaneously at least one selected from a rare-earth-elements component, such as Sc, Y, La, Ce, Pr, Nd, Pm, Sm, Eu, Gd, Tb, Dy, Ho, Er, Tm, Yb, and Lu, etc., not more than 5.0 mol % in total on an oxide basis, what has the optical transmissivity not less than 20% can be obtained.

And, in the above sintered compact which comprises beryllium oxide as a main component and contains a rare-earth-elements component in the range of 0.00005-5.0 mol %, the optical transmissivity becomes easy to be improved furthermore, what is the optical transmissivity not less than 30 % is easy to be obtained, and what is a maximum of 81 % was also obtained in this invention.

That is, in the sintered compact which comprises beryllium oxide as a main component and which contains at least one selected from a magnesium component, a calcium component, and a silicon component in the range of not more than 35.0 mol % in total on an oxide basis and contains furthermore at least one selected from a rare-earth-elements component in the range of 0.00005-5.0 mol % in total on an oxide basis, what is the optical transmissivity not less than 30 % is easy to be obtained.

And, in the sintered compact which comprises beryllium oxide as a main component and which contains at least one selected from a magnesium component, a calcium component, and a silicon component in the range of not more than 35.0 mol % in total on an oxide basis and contains furthermore at least one selected from a rare-earth-elements component in the range of 0.0005-3.0 mol % in total on an oxide basis, what is the optical transmissivity not less than 40 % is easy to be obtained.

And, in the sintered compact which comprises beryllium oxide as a main component and which contains at least one selected from a magnesium component, a calcium component, and a silicon component in the range of not more than 35.0 mol % in total on an oxide basis and contains furthermore at least one selected from a rare-earth-elements component in the range of 0.002-3.0 mol % in total on an oxide basis, what is the optical transmissivity notless than 50 % is easy to be obtained.

And, in the sintered compact which comprises beryllium oxide as a main component and which contains at least one selected from a magnesium component, a calcium component, and a silicon component in the range of not more than 35.0 mol % in total on an oxide basis and contains furthermore at least one selected from a rare-earth-elements component in the range of 0.005-3.0 mol % in total on an oxide basis, what is the optical transmissivity not less than 60 % is easy to be obtained.

In addition, as for the oxide used for the basis of conversion of the content of a rare-earth-elements component contained in the above sintered compact which comprises beryllium oxide as a main component, it is Sc₂O₃, Y₂O₃, La₂O₃, CeO₂, Pr₆O₁₁, Nd₂O₃, Pm₂O₃, Sm₂O₃, Eu₂O₃, Gd₂O₃, Tb₄O₇, Dy₂O₃, Ho₂O₃, Er₂O₃, Tm₂O₃, Yb₂O₃, and Lu₂O₃.

And, in the above sintered compact which comprises beryllium oxide as a main component and which contains at least one selected from a magnesium component, a calcium component, and a silicon component and contains furthermore a rare-earth-elements component, it is preferred that the content of at least one selected from a magnesium component, a calcium component, and a silicon component is the range of 0.0002-35.0 mol % in total on an oxide basis in order to raise the optical permeability.

Even when the above sintered compact which comprises beryllium oxide as a main component and has comparatively high optical transmissivity and which contains at least one selected from a magnesium component, a calcium component, and a silicon component and contains simultaneously a rare-earth-elements component is used as a substrate, as for the crystallinity of the single-crystal thin film which comprises as a main component at least one selected from gallium nitride, indium nitride, and aluminum nitride, or the orientated polycrystalline thin film which comprises as a main component at least one selected from gallium nitride, indium nitride, and aluminum nitride, which are formed on the substrate, it is usually the same degree compared with what used as a substrate the sintered compact which comprises beryllium oxide as a main component and which does not contain substantially a rare-earth-elements component but contains at least one selected from a magnesium component, a calcium component, and a silicon component, and there is little change of crystallinity lowering greatly.

And, in this invention, while the single-crystal thin film which comprises as a main component at least one selected from gallium nitride, indium nitride, and aluminum nitride and is formed directly on the substrate which comprises a sintered compact which comprises aluminum oxide as a main component is not necessarily able to become a thing excellent in crystallinity by being easy to be influenced by the surface smooth nature of the substrate, etc., as mentioned above, if a thin film which comprises as a main component at least one selected from gallium nitride, indium nitride, and aluminum nitride and has various crystallization states, such as an amorphous state, a polycrystal, an orientated polycrystal, and a single crystal, etc., is formed beforehand on the substrate which comprises a sintered compact which comprises aluminum oxide as a main component and a single-crystal thin film which comprises as a main component at least one selected from gallium nitride, indium nitride, and aluminum nitride is formed furthermore on it, it is getting harder to be influenced by the surface smooth nature of the substrate, etc., and the crystallinity of the single-crystal thin film can become what is excellent furthermore.

That is, even if a single-crystal thin film which comprises as a main component at least one selected from gallium nitride, indium nitride, and aluminum nitride is formed directly using as a substrate the sintered compact which comprises aluminum oxide as a main component, the single-crystal thin film will not necessarily become a thing comparatively excellent in crystallinity, such that the half width of the rocking curve of the X-ray diffraction line from the lattice plane of the Miller Index (002) is not more than 200 seconds.

On the other hand, using as a substrate the sintered compact which comprises aluminum oxide as a main component, if a thin film which comprises as a main component at least one selected from gallium nitride, indium nitride, and aluminum nitride and has various crystallization states, such as an amorphous state, a polycrystal, an orientated polycrystal, and a single crystal, etc., is formed beforehand and a single-crystal thin film which comprises as a main component at least one selected from gallium nitride, indium nitride, and aluminum nitride is formed furthermore on it, a thing comparatively excellent in crystallinity, such that the half width of the rocking curve of the X-ray diffraction line from the lattice plane of the Miller Index (002) of the single-crystal thin film is not more than 200 seconds, can be formed.

In the above sintered compact which comprises aluminum oxide as a main component, when what contains at least one selected from a magnesium component, a calcium component, and a silicon component in addition to aluminum is used as a substrate, a thin film with comparatively good crystallinity can be formed on the substrate.

Usually, when the sintered compact which comprises aluminum oxide as a main component and contains at least one selected from a magnesium component, a calcium component, and a silicon component in the range of not more than 45.0 mol % in total on an oxide basis is used as a substrate, a single-crystal thin film which comprises as a main component at least one selected from gallium nitride, indium nitride, and aluminum nitride and is excellent in crystallinity, such that the half width of the rocking curve of the X-ray diffraction line from the lattice plane of a Miller Index (002) is not more than 300 seconds, can be formed directly on the substrate.

In the above sintered compact which comprises aluminum oxide as a main component, when what contains at least one selected from magnesium, calcium, silicon component in the range of 0.001-45.0 mol % in total on an oxide basis is used as a substrate, a single-crystal thin film which comprises as a main component at least one selected from gallium nitride, indium nitride, and aluminum nitride and is excellent in crystallinity, such that the half width of the rocking curve of the X-ray diffraction line from the lattice plane of a Miller Index (002) is not more than 200 seconds, can be formed directly on the substrate.

And, when the sintered compact which comprises aluminum oxide as a main component and contains at least one selected from magnesium, calcium, and silicon component in the range of 0.02-45.0 mol % in total on an oxide basis is used as a substrate, a single-crystal thin film excellent in crystallinity, such that the half width of the rocking curve of the X-ray diffraction line from the lattice plane of a Miller Index (002) is not more than 150 seconds, can be formed directly on the substrate.

And, when the sintered compact which comprises aluminum oxide as a main component and contains at least one selected from magnesium, calcium, and silicon component in the range of 0.08-35.0 mol % in total on an oxide basis is used as a substrate, a single-crystal thin film excellent in crystallinity, such that the half width of the rocking curve of the X-ray diffraction line from the lattice plane of a Miller Index (002) is not more than 130 seconds, can be formed directly on the substrate.

In addition, in the above sintered compact which comprises aluminum oxide as a main component, though the value which carried out conversion to oxide is used as the content of a magnesium component, a calcium component, and a silicon component, the oxide used for the basis of conversion is MgO in the case of a magnesium component, CaO in the case of a calcium component, and SiO₂ in the case of a silicon component.

Hereafter, unless reference is made especially in this invention, as for a magnesium component, a calcium component, and a silicon component which are contained in the aluminum oxide-based sintered compact, the compounds used for the basis converted to oxide are MgO, CaO, and SiO₂, respectively.

Furthermore, when the above substrate which comprises a sintered compact which comprises aluminum oxide as a main component and contains a magnesium component, a calcium component, and a silicon component is used, if a thin film which comprises as a main component at least one selected from gallium nitride, indium nitride, and aluminum nitride and has various crystallization states, such as an amorphous state, a polycrystal, an orientated polycrystal, and a single crystal, etc., is formed beforehand on the substrate which comprises the sintered compact of same composition which comprises aluminum oxide as a main component and contains a magnesium component, a calcium component, and a silicon component and a single-crystal thin film which comprises as a main component at least one selected from gallium nitride, indium nitride, and aluminum nitride is formed furthermore on it, the crystallinity of the single-crystal thin film can become a thing furthermore superior to the crystallinity of the single-crystal thin film which comprises as a main component at least one selected from gallium nitride, indium nitride, and aluminum nitride and is formed directly on the substrate.

Saying concretely, using as the substrate a sintered compact which comprises aluminum oxide as a main component and contains at least one selected from magnesium, calcium, and silicon component in the range of not more than 45.0 mol % in total on an oxide basis, if a thin film which comprises as a main component at least one selected from gallium nitride, indium nitride, and aluminum nitride and has various crystallization states, such as an amorphous state, a polycrystal, an orientated polycrystal, and a single crystal, etc., is formed beforehand on it and a single-crystal thin film which comprises as a main component at least one selected from gallium nitride, indium nitride, and aluminum nitride is formed furthermore on it, a thing excellent in crystallinity, such that the half width of the rocking curve of the X-ray diffraction line from the lattice plane of the Miller Index (002) of the single-crystal thin film is not more than 200 seconds, usually not more than 150 seconds, can be formed comparatively easily.

And, using as the substrate a sintered compact which comprises aluminum oxide as a main component and contains at least one selected from magnesium, calcium, and silicon component in the range of 0.001 mol %-45.0 mol % in total on an oxide basis, if a thin film which comprises as a main component at least one selected from gallium nitride, indium nitride, and aluminum nitride and has various crystallization states, such as an amorphous state, a polycrystal, an orientated polycrystal, and a single crystal, etc., is formed beforehand on it and a single-crystal thin film which comprises as a main component at least one selected from gallium nitride, indium nitride, and aluminum nitride is formed furthermore on it, a thing excellent in crystallinity, such that the half width of the rocking curve of the X-ray diffraction line from the lattice plane of the Miller Index (002) of the single-crystal thin film is not more than 130 seconds, can be formed comparatively easily.

And, using as the substrate a sintered compact which comprises aluminum oxide as a main component and contains at least one selected from magnesium, calcium, and silicon component in the range of 0.005 mol %-45.0 mol % in total on an oxide basis, if a thin film which comprises as a main component at least one selected from gallium nitride, indium nitride, and aluminum nitride and has various crystallization states, such as an amorphous state, a polycrystal, an orientated polycrystal, and a single crystal, etc., is formed beforehand on it and a single-crystal thin film which comprises as a main component at least one selected from gallium nitride, indium nitride, and aluminum nitride is formed furthermore on it, a thing excellent in crystallinity, such that the half width of the rocking curve of the X-ray diffraction line from the lattice plane of the Miller Index (002) of the single-crystal thin film is not more than 100 seconds, can be formed comparatively easily.

At this time, as for the crystallinity of the orientated polycrystalline thin film which comprises as a main component at least one selected from gallium nitride, indium nitride, and aluminum nitride and is formed beforehand on the above substrate which comprises a sintered compact which comprises aluminum oxide as a main component and contains at least one selected from a magnesium component, a calcium component, and a silicon component in the range of 0.0002-35.0 mol % in total on an oxide basis, it also tends to be improved compared with what used the substrate which comprises a sintered compact which comprises aluminum oxide as a main component and does not contain a magnesium component, a calcium component, and a silicon component in the above range, a thing, such that the half width of the rocking curve of the X-ray diffraction line from the lattice plane of the Miller Index (002) of the orientated polycrystalline thin film is not more than 9000 seconds, can be formed comparatively easily.

And, in the substrate which comprises a sintered compact which comprises aluminum oxide as a main component and contains at least one selected from a magnesium component, a calcium component, and a silicon component in the range of 0.005-45.0 mol % in total on an oxide basis, a thing, such that the half width of the rocking curve of the X-ray diffraction line from the lattice plane of the Miller Index (002) of the orientated polycrystalline thin film which comprises as a main component at least one selected from gallium nitride, indium nitride, and aluminum nitride and is formed beforehand on the substrate is not more than 8000 seconds, can be formed comparatively easily.

Thus, if a thin film which comprises as a main component at least one selected from gallium nitride, indium nitride, and aluminum nitride and has various crystallization states, such as an amorphous state, a polycrystal, an orientated polycrystal, and a single crystal, etc., is formed beforehand on the substrate which comprises a sintered compact which comprises aluminum oxide as a main component, furthermore it is effective in raising the crystallinity of the single-crystal thin film which is formed on it and comprises as a main component at least one selected from gallium nitride, indium nitride, and aluminum nitride.

The effect can be shown without being influenced greatly, by the element except the composition of the substrate which comprises a sintered compact which comprises aluminum oxide as a main component, such as the surface smooth nature, etc., for example, even if it is not a thing in which the average surface roughness Ra is made into not more than 5 nm (namely, even if it is a thing in which the average surface roughness Ra is not less than 5 nm, such as a substrate with the as-fired surface state, a substrate with the surface state which carried out lap polish, a substrate with the surface state which carried out blast polish, or a substrate which has carried out specular surface polish), for example.

As for the effect in which containing at least one selected from magnesium, calcium, and silicon component, in a sintered compact comprising aluminum oxide as a main component gives to the crystallinity of a single-crystal thin film, it is rare that it decreases even if metal component(s) other than a magnesium component, a calcium component, and a silicon component, for example, an alkaline-earth-metal component, such as BeO, SrO, and BaO, etc., or a rare-earth elements component, such as Sc₂O₃, Y₂O₃, La₂O₃, CeO₂, Pr₆O₁₁, Nd₂O₃, Pm₂O₃, Sm₂O₃, Eu₂O₃, Gd₂O₃, Tb₄O₇, Dy₂O₃, Ho₂O₃, Er₂O₃, Tm₂O₃, Yb₂O₃, and Lu₂O₃, etc., or other transition-metals component, such as MnO, CoO, NiO, Fe₂O₃, Cr₂O₃, and TiO₂, etc., is contained in the sintered compact which comprises aluminum oxide as a main component.

Although it is not necessarily clear about the cause in which the single-crystal thin film formed on the substrate becomes such high crystallinity when the sintered compact which comprises aluminum oxide as a main component and contains at least one selected from magnesium, calcium, and silicon in the range of not more than 45.0 mol % in total on an oxide basis is used as a substrate, this inventor thinks that the sintered compact becomes what has a microstructure which has few pores between particles and in which the size of aluminum oxide crystal grain is comparatively equal, because the above component(s) becomes a grain boundary phase, exists between aluminum oxide particles, and probably controls extraordinary particle growth of some aluminum oxide particles.

And, in the above sintered compact which comprises aluminum oxide as a main component, what has comparatively high optical transmissivity is producible by firing in ambient atmospheres, such as reduced atmosphere containing CO, H₂, etc., or non-oxidizing atmosphere containing Ar, He, N₂, etc., or decompression condition, or high pressure condition by hot pressing, etc., and what has comparatively high optical transmissivity is producible, even if the firing is carried out in air with normal pressure without using such an ambient atmosphere.

That is, as for the sintered compact which comprises aluminum oxide as a main component, even if it is what kind of composition, what has optical permeability to ultraviolet light with a wavelength not less than 160 nm, visible light, and light with wavelength longer than visible light is producible.

For example, even if the sintered compact which comprises aluminum oxide as a main component is what kind of composition, a thing in which the optical transmissivity is not less than 1 % is producible.

Usually, in the sintered compact which comprises aluminum oxide as a main component and contains an aluminum oxide component not less than 55.0 mol % on the basis of Al₂O₃, a thing in which the optical transmissivity is not less than 1 % is producible.

And, for example, in the sintered compact which comprises aluminum oxide as a main component and which comprises only Al₂O₃ substantially by firing without using an additive, a thing in which the optical transmissivity is not less than 10 % is producible.

In addition, in this invention, the optical transmissivity of the sintered compact which comprises aluminum oxide as a main component is a thing to the light of the range of 160-800 nm wavelength at least. The above optical transmissivity is what was measured using light with a wavelength of 605 nm.

In this invention, unless reference is made especially, the above measured value is used for the optical transmissivity of the sintered compact which comprises aluminum oxide as a main component, from now on.

And, among the sintered compact which comprises aluminum oxide as a main component and contains a magnesium component, a calcium component, and a silicon component, in the sintered compact which comprises aluminum oxide as a main component and contains at least one selected from a magnesium component, such as MgO, a calcium component, such as CaO, and a silicon component, such as SiO₂, in the range of not more than 45.0 mol % in total on an oxide basis, what is the optical transmissivity not less than 10 % is usually producible, as mentioned above.

Moreover, among the sintered compact which comprises aluminum oxide as a main component and contains a magnesium component, a calcium component, and a silicon component, in the sintered compact which comprises aluminum oxide as a main component and contains at least one selected from a magnesium component, such as MgO, a calcium component, such as CaO, and a silicon component, such as SiO₂, in the range of 0.001-45.0 mol % in total on an oxide basis, what improved the optical transmissivity into not less than 20 % is easy to be obtained, and what is the optical transmissivity not less than 30 %, not less than 40 %, not less than 50 %, not less than 60 %, and furthermore not less than 80 %, is producible.

The above optical transmissivity is not the straight line transmittance of a transparent body, such as glass, etc., but means the total transmittance like the optical transmissivity of the sintered compact which comprises aluminum nitride as a main component.

If it explains in detail, in such sintered compact which comprises aluminum oxide as a main component, even if it includes component(s), such as BeO, SrO, BaO, MnO, CoO, NiO, Fe₂O₃, Cr₂O₃, TiO₂, Sc₂O₃, Y₂O₃, La₂O₃, CeO₂, Pr₆O₁₁, Nd₂O₃, Pm₂O₃, Sm₂O₃, Eu₂O₃, Gd₂O₃, Tb₄O₇, Dy₂O₃, Ho₂O₃, Er₂O₃, Tm₂O₃, Yb₂O₃, and Lu₂O₃, etc., other than a magnesium component, a calcium component, and a silicon component, it is rare that the optical permeability decreases.

Among them, for example, even if it is the sintered compact which comprises aluminum oxide as a main component and which contains at least one selected from a magnesium component such as MgO, a calcium component such as CaO, and a silicon component such as SiO₂ and contains simultaneously at least one selected from a rare-earth-elements component, such as Sc, Y, La, Ce, Pr, Nd, Pm, Sm, Eu, Gd, Tb, Dy, Ho, Er, Tm, Yb, and Lu, etc., not more than 10.0 mol % in total on an oxide basis, what has the optical transmissivity not less than 20% can be obtained.

And, in the above sintered compact which comprises aluminum oxide as a main component and contains a rare-earth-elements component in the range of 0.0002-10.0 mol %, the optical transmissivity becomes easy to be improved furthermore, what is the optical transmissivity not less than 30 % is easy to be obtained, and what is a maximum of 82 % was also obtained in this invention.

That is, in the sintered compact which comprises aluminum oxide as a main component and which contains at least one selected from a magnesium component, a calcium component, and a silicon component in the range of not more than 45.0 mol % in total on an oxide basis and furthermore contains simultaneously at least one selected from a rare-earth-elements component in the range of 0.0002-10.0 mol % in total on an oxide basis, what is the optical transmissivity not less than 30 % is easy to be obtained.

And, in the sintered compact which comprises aluminum oxide as a main component and which contains at least one selected from a magnesium component, a calcium component, and a silicon component in the range of not more than 45.0 mol % in total on an oxide basis and furthermore contains simultaneously at least one selected from a rare-earth-elements component in the range of 0.001-6.0 mol % in total on an oxide basis, what is the optical transmissivity not less than 40 % is easy to be obtained.

And, in the sintered compact which comprises aluminum oxide as a main component and which contains at least one selected from a magnesium component, a calcium component, and a silicon component in the range of not more than 45.0 mol % in total on an oxide basis and furthermore contains simultaneously at least one selected from a rare-earth-elements component in the range of 0.005-6.0 mol % in total on an oxide basis, what is the optical transmissivity not less than 50 % is easy to be obtained.

And, in the sintered compact which comprises aluminum oxide as a main component and which contains at least one selected from a magnesium component, a calcium component, and a silicon component in the range of not more than 45.0 mol % in total on an oxide basis and furthermore contains simultaneously at least one selected from a rare-earth-elements component in the range of 0.01-3.0 mol % in total on an oxide basis, what is the optical transmissivity not less than 60 % is easy to be obtained.

And, in the above sintered compact which comprises aluminum oxide as a main component and which contains at least one selected from a magnesium component, a calcium component, and a silicon component and furthermore contains simultaneously a rare-earth-elements component, as for at least one selected from a magnesium component, a calcium component, and a silicon component which are contained, it is preferred that it is in the range of 0.001-45.0 mol % in total on an oxide basis in order to raise the optical permeability.

In addition, as the magnesium component, calcium component, and silicon component which are contained simultaneously with a rare earth element component in the above sintered compact which comprises aluminum oxide as a main component, it is desirable to use usually at least two of these in order to raise the optical transmissivity furthermore.

Concretely, including at least two selected from a magnesium component, such as MgO, a calcium component, such as CaO, and a silicon component, such as SiO₂, means including a magnesium component and a silicon component simultaneously, or including a calcium component and a silicon component simultaneously, or including a magnesium component and a calcium component simultaneously, or including three components of a magnesium component, a calcium component, and a silicon component simultaneously.

As for the oxide used for the basis of conversion of the content of a magnesium component, a calcium component, and a silicon component which are contained in the above sintered compact which comprises aluminum oxide as a main component, it is MgO for a magnesium component, CaO for a calcium component, and SiO₂ for a silicon component respectively.

And, as the oxide used for the basis of conversion of the content of a rare-earth-elements component contained in the above sintered compact which comprises aluminum oxide as a main component, it is Sc₂O₃, Y₂O₃, La₂O₃, CeO₂, Pr₆O₁₁, Nd₂O₃, Pm₂O₃, Sm₂O₃, Eu₂O₃, Gd₂O₃, Tb₄O₇, Dy₂O₃, Ho₂O₃, Er₂O₃, Tm₂O₃, Yb₂O₃, and Lu₂O₃.

And, even when the above sintered compact which comprises aluminum oxide as a main component and has comparatively high optical transmissivity and which contains at least one selected from a magnesium component, a calcium component, and a silicon component and contains furthermore a rare-earth-element component simultaneously, or the sintered compact which comprises aluminum oxide as a main component and has comparatively high optical transmissivity and which contains at least one or two or more components selected from a magnesium component, a calcium component, and a silicon component and contains furthermore a rare-earth-elements component simultaneously, are used as a substrate, as for the crystallinity of the single-crystal thin film which comprises as a main component at least one selected from gallium nitride, indium nitride, and aluminum nitride, or the orientated polycrystalline thin film which comprises as a main component at least one selected from gallium nitride, indium nitride, and aluminum nitride, which are formed on the substrate, it is usually the same degree compared with what used as a substrate the sintered compact which comprises aluminum oxide as a main component and which does not contain substantially a rare-earth-elements component but contains at least one selected from a magnesium component, a calcium component, and a silicon component, and there is little change of crystallinity lowering greatly.

As mentioned above, while the single-crystal thin film which comprises as a main component at least one selected from gallium nitride, indium nitride, and aluminum nitride and is formed directly on the substrate which comprises a sintered compact which comprises gallium nitride as a main component is not necessarily able to become a thing excellent in crystallinity by being easy to be influenced by the surface smooth nature of the substrate, etc., if a thin film which comprises as a main component at least one selected from gallium nitride, indium nitride, and aluminum nitride and has at least one crystallization state selected from an amorphous state, a polycrystal, an orientated polycrystal, and a single crystal is formed beforehand on the substrate which comprises a sintered compact which comprises gallium nitride as a main component and a single-crystal thin film which comprises as amain component at least one selected from gallium nitride, indium nitride, and aluminum nitride is formed furthermore on it, it is getting harder to be influenced by the surface smooth nature of the substrate, etc., and the crystallinity of the single-crystal thin film can become what is excellent furthermore.

That is, even if a single-crystal thin film which comprises as a main component at least one selected from gallium nitride, indium nitride, and aluminum nitride is formed directly using as a substrate the sintered compact which comprises gallium nitride as a main component, the single-crystal thin film will not necessarily become a thing comparatively excellent in crystallinity, such that the half width of the rocking curve of the X-ray diffraction line from the lattice plane of the Miller Index (002) is not more than 200 seconds.

On the other hand, using as a substrate the sintered compact which comprises gallium nitride as a main component, if a thin film which comprises as a main component at least one selected from gallium nitride, indium nitride, and aluminum nitride and has at least one crystallization state selected from an amorphous state, a polycrystal, an orientated polycrystal, and a single crystal is formed beforehand and a single-crystal thin film which comprises as a main component at least one selected from gallium nitride, indium nitride, and aluminum nitride is formed furthermore on it, a thing comparatively excellent in crystallinity, such that the half width of the rocking curve of the X-ray diffraction line from the lattice plane of the Miller Index (002) of the single-crystal thin film is not more than 200 seconds, can be formed.

In the above sintered compact which comprises gallium nitride as a main component, when using as a substrate a thing which contains at least one or more of components, such as an alkaline-earth-metal component, such as BeO, MgO, CaO, SrO, and BaO, etc., a rare-earth-elements component, such as Sc₂O₃, Y₂O₃, La₂O₃, CeO₂, Pr₆O₁₁, Nd₂O₃, Pm₂O₃, Sm₂O₃, Eu₂O₃, Gd₂O₃, Tb₄O₇, Dy₂O₃, Ho₂O₃, Er₂O₃, Tm₂O₃, Yb₂O₃, and Lu₂O₃, etc., a transition-metals component such as MnO, CoO, NiO, Fe₂O₃, Cr₂O₃, and TiO₂, etc., an aluminum component, an indium component, oxygen, zinc (Zn), cadmium (Cd), carbon (C), silicon (Si), germanium (Ge), selenium (Se), and tellurium (Te), etc., in addition to zinc, a thin film with comparatively good crystallinity can be formed on the substrate in many cases.

In addition, in the sintered compact which comprises gallium nitride as a main component and contains at least one or more of components, such as beryllium (Be), magnesium (Mg), Zn, Cd, C, Si, Ge, Se, Te, and oxygen, etc., what has comparatively high conductivity is producible.

Usually, when the sintered compact which comprises gallium nitride as a main component and contains a gallium component in the range of not less than 55.0 mol % on the basis of GaN is used as a substrate, a single-crystal thin film which comprises as a main component at least one selected from gallium nitride, indium nitride, and aluminum nitride and is excellent in crystallinity, such that the half width of the rocking curve of the X-ray diffraction line from the lattice plane of the Miller Index (002) is not more than 300 seconds, can be formed directly on it.

Among the above sintered compact which comprises gallium nitride as a main component, the thing which contains an alkaline-earth-metal component, such as BeO, MgO, CaO, SrO, and BaO, etc., and a rare-earth-elements component, such as Sc₂O₃, Y₂O₃, La₂O₃, CeO₂, Pr₆O₁₁, Nd₂O₃, Pm₂O₃, Sm₂O₃, Eu₂O₃, Gd₂O₃, Tb₄O₇, Dy₂O₃, Ho₂O₃, Er₂O₃, Tm₂O₃, Yb₂O₃, and Lu₂O₃, etc., does an action effective in improvement of the crystallinity in the single-crystal thin film formed on the sintered compact.

As for the alkaline-earth-metal component and rare earth element component, it may be independently contained, respectively in the sintered compact which comprises gallium nitride as a main component, or it may be contained simultaneously.

When what contains at least one selected from the alkaline-earth-metal component and rare earth element component not more than 30.0 mol % on an oxide basis is used, a single-crystal thin film which comprises as a main component at least one selected from gallium nitride, indium nitride, and aluminum nitride and is excellent in crystallinity, such that the half width of the rocking curve of the X-ray diffraction line from the lattice plane of the Miller Index (002) is not more than 200 seconds, can be formed directly on it.

Furthermore, when using the sintered compact which comprises gallium nitride as a main component and contains at least one selected from the alkaline-earth-metal component, such as BeO, MgO, CaO, SrO, and BaO, etc., and rare earth element component, such as Sc₂O₃, Y₂O₃, La₂O₃, CeO₂, Pr₆O₁₁, Nd₂O₃, Pm₂O₃, Sm₂O₃, Eu₂O₃, Gd₂O₃, Tb₄O₇, Dy₂O₃, Ho₂O₃, Er₂O₃, Tm₂O₃, Yb₂O₃, and Lu₂O₃, etc., not more than 20.0 mol % on an oxide basis, a single-crystal thin film excellent in crystallinity, such that the half width of the rocking curve of the X-ray diffraction line from the lattice plane of a Miller Index (002) is not more than 150 seconds, can be formed directly on it.

And, when using the sintered compact which comprises gallium nitride as a main component and contains at least one selected from the alkaline-earth-metal component, such as BeO, MgO, CaO, SrO, and BaO, etc., and rare earth element component, such as Sc₂O₃, Y₂O₃, La₂O₃, CeO₂, Pr₆O₁₁, Nd₂O₃, Pm₂O₃, Sm₂O₃, Eu₂O₃, Gd₂O₃, Tb₄O₇, Dy₂O₃, Ho₂O₃, Er₂O₃, Tm₂O₃, Yb₂O₃, and Lu₂O₃, etc., not more than 10.0 mol % on an oxide basis, a single-crystal thin film excellent in crystallinity, such that the half width of the rocking curve of the X-ray diffraction line from the lattice plane of a Miller Index (002) is not more than 100 seconds, can be formed directly on it.

And, even when what contains at least one selected from a transition-metal-elements component, such as MnO, CoO, NiO, Fe₂O₃, Cr₂O₃, TiO₂, MoO₃, WO₃, Nb₂O₅, Ta₂O₅, and V₂O₅, etc., not more than 10.0 mol % on an element basis other than gallium is used as the above sintered compact which comprises gallium nitride as a main component, a single-crystal thin film which comprises as a main component at least one selected from gallium nitride, indium nitride, and aluminum nitride and is excellent in crystallinity, such that the half width of the rocking curve of the X-ray diffraction line from the lattice plane of the Miller Index (002) is not more than 300 seconds, can be formed directly on the sintered compact.

Usually, a sintered compact which comprises gallium nitride as a main component and contains at least one selected from Mo, W, Nb, Ta, V, and Ti not more than 10.0 mol % on an element basis as the above transition metal element component is desirable, and a single-crystal thin film which is excellent in crystallinity and comprises as a main component at least one selected from gallium nitride, indium nitride, and aluminum nitride can be formed on it using the sintered compact of such composition.

And, in the thing containing at least one selected from Zn, Cd, Be, Mg, C, Si, Ge, Se, and Te, etc. other than gallium as the above sintered compact which comprises gallium nitride as a main component, what has comparatively high conductivity is easy to be obtained, even when the sintered compact which comprises gallium nitride as a main component and contains at least one selected from Zn, Cd, Be, Mg, C, Si, Ge, Se, and Te, etc. not more than 10.0 mol % on an element basis, a single-crystal thin film which comprises as a main component at least one selected from gallium nitride, indium nitride, and aluminum nitride and is excellent in crystallinity, such that the half width of the rocking curve of the X-ray diffraction line from the lattice plane of the Miller Index (002) is not more than 300 seconds, can be formed directly on the sintered compact.

And, even when what contains at least one selected from aluminum, indium, and oxygen not more than 40.0 mol % on an element basis other than gallium, is used as the above sintered compact which comprises gallium nitride as a main component, a single-crystal thin film which comprises as amain component at least one selected from gallium nitride, indium nitride, and aluminum nitride and is excellent in crystallinity, such that the half width of the rocking curve of the X-ray diffraction line from the lattice plane of the Miller Index (002) is not more than 300 seconds, can be formed directly on the sintered compact.

Furthermore, When the above sintered compact which comprises gallium nitride as a main component and contains an aluminum component is used, if a thin film which comprises as a main component at least one selected from gallium nitride, indium nitride, and aluminum nitride and has various crystallization states, such as an amorphous state, a polycrystal, an orientated polycrystal, and a single crystal, etc., is formed beforehand on the substrate which comprises the sintered compact which comprises gallium nitride as a main component and has same composition and a single-crystal thin film which comprises as a main component at least one selected from gallium nitride, indium nitride, and aluminum nitride is formed furthermore on it, the crystallinity of the single-crystal thin film can become a thing furthermore superior to the crystallinity of the single-crystal thin film which comprises as a main component at least one selected from gallium nitride, indium nitride, and aluminum nitride and is formed directly on the substrate.

Saying concretely, when a sintered compact which comprises gallium nitride as a main component and contains a gallium component not less than 55.0 mol % on the basis of GaN is used as the substrate, if a thin film which comprises as a main component at least one selected from gallium nitride, indium nitride, and aluminum nitride and has various crystallization states, such as an amorphous state, a polycrystal, an orientated polycrystal, and a single crystal, etc., is formed beforehand on it and a single-crystal thin film which comprises as a main component at least one selected from gallium nitride, indium nitride, and aluminum nitride is formed furthermore on it, the single-crystal thin film excellent in crystallinity, such that the half width of the rocking curve of the X-ray diffraction line from the lattice plane ofthe Miller Index (002) is not more than 200 seconds, usually not more than 150 seconds, can be formed comparatively easily.

And, when using a sintered compact which comprises gallium nitride as a main component and contains at least one selected from an alkaline-earth-metal component, such as BeO, MgO, CaO, SrO, and BaO, etc., and a rare earth element component, such as Sc₂O₃, Y₂O₃, La₂O₃, CeO₂, Pr₆O₁₁, Nd₂O₃, Pm₂O₃, Sm₂O₃, Eu₂O₃, Gd₂O₃, Tb₄O₇, Dy₂O₃, Ho₂O₃, Er₂O₃, Tm₂O₃, Yb₂O₃, and Lu₂O₃, etc., not more than 30.0 mol % on an oxide basis, if a thin film which comprises as a main component at least one selected from gallium nitride, indium nitride, and aluminum nitride and has various crystallization states, such as an amorphous state, a polycrystal, an orientated polycrystal, and a single crystal, etc., is formed beforehand on it and a single-crystal thin film which comprises as a main component at least one selected from gallium nitride, indium nitride, and aluminum nitride is formed furthermore on it, the single-crystal thin film excellent in crystallinity, such that the half width of the rocking curve of the X-ray diffraction line from the lattice plane of the Miller Index (002) is not more than 130 seconds, can be formed comparatively easily.

And, when using a sintered compact which comprises gallium nitride as a main component and contains at least one selected from an alkaline-earth-metal component, such as BeO, MgO, CaO, SrO, and BaO, etc., and a rare earth element component, such as Sc₂O₃, Y₂O₃, La₂O₃, CeO₂, Pr₆O₁₁, Nd₂O₃, Pm₂O₃, Sm₂O₃, Eu₂O₃, Gd₂O₃, Tb₄O₇, Dy₂O₃, Ho₂O₃, Er₂O₃, Tm₂O₃, Yb₂O₃, and Lu₂O₃, etc., not more than 20.0 mol % on an oxide basis, if a thin film which comprises as a main component at least one selected from gallium nitride, indium nitride, and aluminum nitride and has various crystallization states, such as an amorphous state, a polycrystal, an orientated polycrystal, and a single crystal, etc., is formed beforehand on it and a single-crystal thin film which comprises as a main component at least one selected from gallium nitride, indium nitride, and aluminum nitride is formed furthermore on it, the single-crystal thin film excellent in crystallinity, such that the half width of the rocking curve of the X-ray diffraction line from the lattice plane of the Miller Index (002) is not more than 100 seconds, can be formed comparatively easily.

At this time, as for the crystallinity of the orientated polycrystalline thin film which comprises as a main component at least one selected from gallium nitride, indium nitride, and aluminum nitride and is formed beforehand on the above sintered compact which comprises gallium nitride as a main component and contains at least one selected from an alkaline-earth-metal component, such as BeO, MgO, CaO, SrO, and BaO, etc., and a rare earth element component, such as Sc₂O₃, Y₂O₃, La₂O₃, CeO₂, Pr₆O₁₁, Nd₂O₃, Pm₂O₃, Sm₂O₃, Eu₂O₃, Gd₂O₃, Tb₄O₇, Dy₂O₃, Ho₂O₃, Er₂O₃, Tm₂O₃, Yb₂O₃, and Lu₂O₃, etc., not more than 30.0 mol % on an oxide basis, it also tends to be improved compared with what used the sintered compact which comprises gallium nitride as a main component and does not contain the above alkaline-earth-metal component and rare earth element component, a thing, such that the half width of the rocking curve of the X-ray diffraction line from the lattice plane of the Miller Index (002) of the orientated polycrystalline thin film is not more than 9000 seconds, can be formed comparatively easily.

And, in the above sintered compact which comprises gallium nitride as a main component and contains at least one selected from an alkaline-earth-metal component, such as BeO, MgO, CaO, SrO, and BaO, etc., and a rare earth element component, such as Sc₂O₃, Y₂O₃, La₂O₃, CeO₂, Pr₆O₁₁, Nd₂O₃, Pm₂O₃, Sm₂O₃, Eu₂O₃, Gd₂O₃, Tb₄O₇, Dy₂O₃, Ho₂O₃, Er₂O₃, Tm₂O₃, Yb₂O₃, and Lu₂O₃, etc., not more than 20.0 mol % on an oxide basis, a thing, such that the half width of the rocking curve of the X-ray diffraction line from the lattice plane of the Miller Index (002) of the orientated polycrystalline thin film which comprises as a main component at least one selected from gallium nitride, indium nitride, and aluminum nitride and is formed beforehand on the sintered compact is not more than 8000 seconds, can be formed comparatively easily.

And, when what contains at least one selected from a transition-metal-elements component, such as MnO, CoO, NiO, Fe₂O₃, Cr₂O₃, TiO₂, MoO₃, WO₃, Nb₂O₅, Ta₂O₅, and V₂O₅, etc., not more than 10.0 mol % on an element basis other than gallium, is used as the above sintered compact which comprises gallium nitride as a main component, if a thin film which comprises as a main component at least one selected from gallium nitride, indium nitride, and aluminum nitride and has various crystallization states, such as an amorphous state, a polycrystal, an orientated polycrystal, and a single crystal, etc., is formed beforehand on it and a single-crystal thin film which comprises as a main component at least one selected from gallium nitride, indium nitride, and aluminum nitride is formed furthermore on it, a thing excellent in crystallinity, such that the half width of the rocking curve of the X-ray diffraction line from the lattice plane of the Miller Index (002) of the single-crystal thin film is not more than 130 seconds, can be formed comparatively easily.

And, when what contains at least one selected from the above transition metal element component not more than 5.0 mol % on an element basis is used, if a thin film which comprises as a main component at least one selected from gallium nitride, indium nitride, and aluminum nitride and has various crystallization states, such as an amorphous state, a polycrystal, an orientated polycrystal, and a single crystal, etc., is formed beforehand on it and a single-crystal thin film which comprises as a main component at least one selected from gallium nitride, indium nitride, and aluminum nitride is formed furthermore on it, a thing excellent in crystallinity, such that the half width of the rocking curve of the X-ray diffraction line from the lattice plane of the Miller Index (002) of the single-crystal thin film is not more than 100 seconds, can be formed comparatively easily, so it is desirable.

Usually, it is preferred that it is a sintered compact which comprises gallium nitride as a main component and contains at least one selected from Mo, W, Nb, Ta, V, and Ti not more than 10.0 mol %, a single-crystal thin film which is excellent in crystallinity and comprises as a main component at least one selected from gallium nitride, indium nitride, and aluminum nitride can be formed on it using the sintered compact of such composition.

And, when what contains at least one selected from Zn, Cd, C, Si, Ge, Se, and Te, etc. not more than 10.0 mol % on an element basis other than gallium, is used as a sintered compact which comprises gallium nitride as a main component, if a thin film which comprises as a main component at least one selected from gallium nitride, indium nitride, and aluminum nitride and has various crystallization states, such as an amorphous state, a polycrystal, an orientated polycrystal, and a single crystal, etc., is formed beforehand on it and a single-crystal thin film which comprises as a main component at least one selected from gallium nitride, indium nitride, and aluminum nitride is formed furthermore on it, a thing excellent in crystallinity, such that the half width of the rocking curve of the X-ray diffraction line from the lattice plane of the Miller Index (002) of the single-crystal thin film is not more than 130 seconds, can be formed comparatively easily.

And, when what contains at least one selected from the above Zn, Cd, C, Si, Ge, Se, and Te, etc. not more than 5.0 mol % on an element basis, is used, if a thin film which comprises as a main component at least one selected from gallium nitride, indium nitride, and aluminum nitride and has various crystallization states, such as an amorphous state, a polycrystal, an orientated polycrystal, and a single crystal, etc., is formed beforehand on it and a single-crystal thin film which comprises as a main component at least one selected from gallium nitride, indium nitride, and aluminum nitride is formed furthermore on it, a thing excellent in crystallinity, such that the half width of the rocking curve of the X-ray diffraction line from the lattice plane of the Miller Index (002) of the single-crystal thin film is not more than 100 seconds, can be formed comparatively easily, so it is desirable.

And, when what contains at least one selected from aluminum, indium, and oxygen not more than 40.0 mol % on an element basis other than gallium, is used as a sintered compact which comprises gallium nitride as a main component, if a thin film which comprises as a main component at least one selected from gallium nitride, indium nitride, and aluminum nitride and has various crystallization states, such as an amorphous state, a polycrystal, an orientated polycrystal, and a single crystal, etc., is formed beforehand on it and a single-crystal thin film which comprises as a main component at least one selected from gallium nitride, indium nitride, and aluminum nitride is formed furthermore on it, a thing excellent in crystallinity, such that the half width of the rocking curve of the X-ray diffraction line from the lattice plane of the Miller Index (002) of the single-crystal thin film is not more than 130 seconds, can be formed comparatively easily.

And, when what contains at least one selected from the above aluminum, indium, and oxygen not more than 30.0 mol % on an element basis, is used, if a thin film which comprises as a main component at least one selected from gallium nitride, indium nitride, and aluminum nitride and has various crystallization states, such as an amorphous state, a polycrystal, an orientated polycrystal, and a single crystal, etc., is formed beforehand on it and a single-crystal thin film which comprises as a main component at least one selected from gallium nitride, indium nitride, and aluminum nitride is formed furthermore on it, a thing excellent in crystallinity, such that the half width of the rocking curve of the X-ray diffraction line from the lattice plane of the Miller Index (002) of the single-crystal thin film is not more than 100 seconds, can be formed comparatively easily, so it is desirable.

Thus, if a thin film which comprises as a main component at least one selected from gallium nitride, indium nitride, and aluminum nitride and has various crystallization states, such as an amorphous state, a polycrystal, an orientated polycrystal, and a single crystal, etc., is formed beforehand on the sintered compact which comprises gallium nitride as a main component, furthermore it is effective in raising the crystallinity of the single-crystal thin film which is formed on it and comprises as a main component at least one selected from gallium nitride, indium nitride, and aluminum nitride.

The effect can be shown without being influenced greatly, by the element except the composition of a sintered compact which comprises gallium nitride as a main component, such as the surface smooth nature, etc., for example, even if it is not a thing in which the average surface roughness Ra is made into not more than 5 nm (namely, even if it is a thing in which the average surface roughness Ra is not less than 5 nm, such as a substrate with the as-fired surface state, a substrate with the surface state which carried out lap polish, a substrate with the surface state which carried out blast polish, or a substrate which has carried out specular surface polish), for example.

In such component(s) exerted on the crystallinity of a single-crystal thin film other than gallium in the sintered compact which comprises gallium nitride as a main component, especially, as for the effect of an alkaline-earth-metal component, such as BeO, MgO, CaO, SrO, and BaO, etc., and a rare earth element component, such as Sc₂O₃, Y₂O₃, La₂O₃, CeO₂, Pr₆O₁₁, Nd₂O₃, Pm₂O₃, Sm₂O₃, Eu₂O₃, Gd₂O₃, Tb₄O₇, Dy₂O₃, Ho₂O₃, Er₂O₃, Tm₂O₃, Yb₂O₃, and Lu₂O₃, etc., it is rare to be reduced even if at least one, such as a transition metal element component, such as MnO, CoO, NiO, Fe₂O₃, Cr₂O₃, TiO₂, MoO₃, WO₃, Nb₂O₅, Ta₂O₅, and V₂O₅, etc., an aluminum component, an indium component, oxygen, Zn, Cd, C, Si, Ge, Se, and Te, etc., other than an alkaline-earth-metal component and a rare earth element component, are contained in the sintered compact which comprises gallium nitride as a main component.

It is not necessarily clear about the cause in which the single-crystal thin film formed on the sintered compact becomes what has such high crystallinity when the sintered compact which comprises gallium nitride as a main component and contains a gallium component not less than 55.0 mol % on the basis of GaN is used, but this inventor is guessing that a thin film which comprises as a main component at least one selected from gallium nitride, indium nitride, and aluminum nitride is easy to be single-crystallized spontaneously, because the sintered compact which comprises as a main component gallium nitride has the same crystal structures as each thin film of gallium nitride, indium nitride, and aluminum nitride which are wurtzite type crystal.

A gallium nitride-based sintered compact comprises gallium nitride particles, therefore the grain boundaries exist, in spite of not being comparatively near to a homogeneous state, like a single crystal or a thin film, and that usually having conductivity is obtained in many cases.

In the gallium nitride-based sintered compact, even if it is what does not contain substantially component(s), such as Be, Mg, Zn, Cd, C, Si, Ge, Se, Te, and oxygen, etc., what has the conductivity in which the electric resistivity is not more than 1x10⁸ Ω·cm at room temperature is obtained in many cases.

In the gallium nitride-based sintered compact containing at least one selected from Be, Mg, Zn, Cd, C, Si, Ge, Se, Te, and oxygen, etc., the conductivity tends to be improved, so it is preferred.

In the gallium nitride-based sintered compact not containing substantially component(s), such as Be, Mg, Zn, Cd, C, Si, Ge, Se, Te, and oxygen, etc., it does not necessarily have the conductivity in which the electric resistivity is not more than 1x10⁴ Ω·cm at room temperature, but in the gallium nitride-based sintered compact containing at least one selected from Be, Mg, Zn, Cd, C, Si, Ge, Se, Te, and oxygen, the conductivity tends to be improved to the electric resistivity of not more than 1x10⁴ Ω·cm at room temperature, so it is preferred.

Specifically, in the gallium nitride-based sintered compact containing at least one selected from Be, Mg, Zn, Cd, C, Si, Ge, Se, Te, and oxygen not more than 10.0 mol % on an element basis, the conductivity improves, what is the electric resistivity not more than 1x10⁴Ω·cm at least at room temperature is easily obtained, for example.

In the gallium nitride-based sintered compact containing at least one selected from Be, Mg, Zn, Cd, C, Si, Ge, Se, Te, and oxygen in the range of 0.00001-10.0 mol % on an element basis, the conductivity improves, what is the electric resistivity not more than 1x10³ Ω·cm at least at room temperature is easily obtained, for example.

And, in the sintered compact which comprises gallium nitride as a main component and contains at least one selected from Be, Mg, Zn, Cd, C, Si, Ge, Se, Te, and oxygen in the range of 0.00001-7.0 mol % on an element basis, what is the electric resistivity not more than 1x10¹ Ω·cm at least at room temperature is easy to be obtained, and it becomes possible to use this sintered compact as a substrate without a conduction via, so it is desirable.

And, in the sintered compact which comprises gallium nitride as a main component and contains at least one selected from Be, Mg, Zn, Cd, C, Si, Ge, Se, Te, and oxygen in the range of 0.00001-5.0 mol % on an element basis, what is the electric resistivity not more than 1x10⁰ Ω·cm at least at room temperature is easy to be obtained, and it becomes possible to use this sintered compact as a substrate without a conduction via, so it is more desirable.

And, in the sintered compact which comprises gallium nitride as a main component and contains at least one selected from Be, Mg, Zn, Cd, C, Si, Ge, Se, Te, and oxygen in the range of 0.00001-3.0 mol % on an element basis, what is the electric resistivity not more than 1x10⁻¹ Ω·cm at least at room temperature is easy to be obtained, and it becomes possible to use this sintered compact as a substrate without a conduction via, so it is still more desirable.

In the sintered compact which comprises gallium nitride as a main component and has such composition, a thing which has the lower electric resistivity of not more than 1x10⁻² Ω·cm, or of not more than 1-2x10⁻³ Ω·cm is also obtained.

In such sintered compact which comprises gallium nitride as a main component and has conductivity, since it does not need especially to provide a conduction via for connecting the up-and-down surface of a substrate electrically, it is preferred.

In the above gallium nitride-based sintered compact, even if it contains at least one selected from an alkaline earth metal component, such as CaO, SrO, and BaO, etc., a rare earth element component, such as Sc₂O₃; Y₂O₃, La₂O₃, CeO₂, Pr₆O₁₁, Nd₂O₃, Pm₂O₃, Sm₂O₃, Eu₂O₃, Gd₂O₃, Tb₄O₇, Dy₂O₃, Ho₂O₃, Er₂O₃, Tm₂O₃, Yb₂O₃, and Lu₂O₃, etc., etc., a transition-metals component, such as MnO, CoO, NiO, Fe₂O₃, Cr₂O₃, TiO₂, MoO₃, WO₃, Nb₂O₅, Ta₂O₅, and V₂O₅, etc., an aluminum component, and an indium component, etc., other than at least one selected from Be, Mg, Zn, Cd, C, Si, Ge, Se, Te, and oxygen, there are few degrees in which the conductivity is spoiled.

As for the content of component(s) other than at least one or more of the above components selected from Be, Mg, Zn, Cd, C, Si, Ge, Se, Te, and oxygen which are contained in the sintered compact which comprises gallium nitride as a main component, as long as the degree in which the conductivity is spoiled is small, it may be what kind of thing.

As for the content of component(s) other than at least one selected from Be, Mg, Zn, Cd, C, Si, Ge, Se, Te, and oxygen, if it is not more than 10.0 mol % on an oxide basis in case of an alkaline earth metal component and a rare earth element component, not more than 10.0 mol % on an element basis in case of a transition metal element component, and not more than 40.0 mol % on an element basis in case of an aluminum component and an indium component, the degree in which the conductivity is spoiled is small, so it is desirable.

And, as for the sintered compact which comprises gallium nitride as a main component and has conductivity, it can be obtained also in the thing which contains other than a gallium component not only at least one selected from Be, Mg, Zn, Cd, C, Si, Ge,Se, Te, and oxygen but also at least one selected from an alkaline earth metal component, such as CaO, SrO, and BaO, etc., and a rare earth element component, such as Sc₂O₃, Y₂O₃, La₂O₃, CeO₂, Pr₆O₁₁, Nd₂O₃, Pm₂O₃, Sm₂O₃, Eu₂O₃, Gd₂O₃, Tb₄O₇, Dy₂O₃, Ho₂O₃, Er₂O₃, Tm₂O₃, Yb₂O₃, and Lu₂O₃, etc., not more than 10.0 mol % by oxide connversion, or at least one selected from a transition metal element component, such as MnO, CoO, NiO, Fe₂O₃, Cr₂O₃, TiO₂, MoO₃, WO₃, Nb₂O₅, Ta₂O₅, and V₂O₅, etc., not more than 10.0 mol % on an element basis, or at least one selected from aluminum and indium not more than 40.0 mol % on an element basis.

In the above gallium nitride-based sintered compact, what has comparatively high optical permeability can be produced by firing in reduced atmosphere containing CO or H₂, etc., or in normal pressure of the non-oxidizing atmosphere containing Ar, He, or N₂, etc., or in decompression, or in high pressure condition by the hot press and HIP, etc.

That is, even if the gallium nitride-based sintered compact is what kind of composition, what has optical permeability to visible light with a wavelength not less than 360 nm and light with a wavelength longer than visible light can be produced.

For example, even if the gallium nitride-based sintered compact is what kind of composition, the optical transmissivity can be not less than 1 %.

Usually, in the gallium nitride-based sintered compact containing a gallium component not less than 55.0 mol % on a GaN basis, the optical transmissivity can be not less than 1 %.

And, for example, in the sintered compact which comprises gallium nitride as a main component and comprises only GaN substantially by firing without using additive(s), a thing in which the optical transmissivity is not less than 10 % is producible.

In addition, in this invention, the optical transmissivity of the sintered compact which comprises gallium nitride as a main component is a thing to the light of the range of 200 nm-800 nm wavelength at least. And, the above optical transmissivity is measured using the light with a wavelength of 605 nm.

In this invention, unless reference is made especially, the above measured value was used for the optical transmissivity ofthe sintered compact which comprises gallium nitride as a main component from now on.

Among them, the alkaline-earth-metal component, such as BeO, MgO, CaO, SrO, and BaO, etc., and the rare earth element component, such as Sc₂O₃, Y₂O₃, La₂O₃, CeO₂, Pr₆O₁₁, Nd₂O₃, Pm₂O₃, Sm₂O₃, Eu₂O₃, Gd₂O₃, Tb₄O₇, Dy₂O₃, Ho₂O₃, Er₂O₃, Tm₂O₃, Yb₂O₃, and Lu₂O₃, etc., are effective for the optical permeability of a gallium nitride-based sintered compact.

The alkaline-earth-metal component and rare earth element component may be contained in the gallium nitride-based sintered compact separately or in combination.

In the gallium nitride-based sintered compact containing at least one selected from a alkaline-earth-metal component and a rare earth element component not more than 30.0 mol % on an oxide basis, what is the optical transmissivity not less than 10% can be produced.

And, in the above sintered compact which comprises gallium nitride as a main component and contains at least one selected from a alkaline-earth-metal component and a rare earth element component not more than 20.0 mol % on an oxide basis, the optical permeability becomes easy to be improved furthermore, and what is the optical transmissivity not less than 20 % is easy to be obtained.

And, in the sintered compact which comprises gallium nitride as a main component and contains at least one selected from an alkaline-earth-metal component and a rare earth element component not more than 10.0 mol % on an oxide basis, what is the optical transmissivity not less than 30 % is easy to be obtained.

And, in the sintered compact which comprises gallium nitride as a main component and contains at least one selected from an alkaline-earth-metal component and a rare earth element component not more than 6.0 mol % on an oxide basis, what is the optical transmissivity not less than 40 % is easy to be obtained.

And, in the sintered compact which comprises gallium nitride as a main component and contains at least one selected from an alkaline-earth-metal component and a rare earth element component not more than 3.0 mol % on an oxide basis, what is the optical transmissivity not less than 50 % is easy to be obtained.

In the gallium nitride-based sintered compact containing at least one selected from an alkaline-earth-metal component and a rare earth element component in the range of 0.0001-3.0 mol % on an oxide basis, what is the optical transmissivity not less than 60% is easily obtained.

The optical transmissivity of not less than 80%, 86% at maximum, is also obtained.

In the gallium nitride-based sintered compact containing at least one selected from a transition-metal-elements component, such as MnO, CoO, NiO, Fe₂O₃, Cr₂O₃, TiO₂, MoO₃, WO₃, Nb₂O₅, Ta₂O₅, and V₂O₅, etc., not more than 10.0 mol % on an element basis, what is the optical transmissivity not less than 10% can be produced.

In the gallium nitride-based sintered compact containing at least one selected from Zn, Cd, C, Si, Ge, Se, and Te not more than 10.0 mol % on an element basis, what is the optical transmissivity not less than 10% can be produced.

In the gallium nitride-based sintered compact containing at least one selected from aluminum, indium, and oxygen not more than 40.0 mol % on an element basis, what is the optical transmissivity not less than 10% can be produced.

In the gallium nitride-based sintered compact containing at least one selected from aluminum, indium, and oxygen not more than 30.0 mol % on an element basis, what is the optical transmissivity not less than 20% can be produced, so it is desirable.

Even if it is the gallium nitride-based sintered compact containing simultaneously at least two above components, such as at least one selected from an alkaline-earth-metal component and a rare earth element component, at least one selected from a transition-metal-elements component, such as MnO, CoO, NiO, Fe₂O₃, Cr₂O₃, TiO₂, MoO₃, WO₃, Nb₂O₅, Ta₂O₅, and V₂O₅, etc., at least one selected from Zn, Cd, C, Si, Ge, Se, and Te, or at least one selected from aluminum, indium, and oxygen, what has optical permeability can be produced.

For example, even if it is the sintered compact which comprises gallium nitride as a main component and which contains at least one selected from an alkaline-earth-metal component, such as BeO, MgO, CaO, SrO, BaO, etc., and a rare earth element component, such as Sc₂O₃, Y₂O₃, La₂O₃, CeO₂, Pr₆O₁₁, Nd₂O₃, Pm₂O₃, Sm₂O₃, Eu₂O₃, Gd₂O₃, Tb₄O₇, Dy₂O₃, Ho₂O₃, Er₂O₃, Tm₂O₃, Yb₂O₃, and Lu₂O₃, etc., not more than 30.0 mol % on an oxide basis and contains simultaneously at least one selected from a transition-metal-elements component, such as MnO, CoO, NiO, Fe₂O₃, Cr₂O₃, TiO₂, MoO₃, WO₃, Nb₂O₅, Ta₂O₅, and V₂O₅, etc., not more than 10.0 mol % on an element basis, or the sintered compact which comprises gallium nitride as a main component and which contains at least one selected from an alkaline-earth-metal component and a rare earth element component in the above range and contains simultaneously at least one selected from Zn, Cd, C, Si, Ge, Se, and Te not more than 10.0 mol % on an element basis, or the sintered compact which comprises gallium nitride as a main component and which contains at least one selected from an alkaline-earth-metal component and a rare earth element component in the above range and contains simultaneously at least one selected from aluminum, indium, and oxygen not more than 40.0 mol % on an element basis, what is the optical permeability not less than 10 % is producible, respectively.

In addition, even if it is the sintered compact which comprises gallium nitride as a main component and contains simultaneously at least two above components, such as at least one selected from an alkaline-earth-metal component and a rare earth element component, at least one selected from a transition-metal-elements component, such as MnO, CoO, NiO, Fe₂O₃, Cr₂O₃, TiO₂, MoO₃, WO₃, Nb₂O₅, Ta₂O₅, and V₂O₅, etc., at least one selected from Zn, Cd, C, Si, Ge, Se, and Te, or at least one selected from aluminum, indium, and oxygen, as for the crystallinity of the single-crystal thin film which comprises as a main component at least one selected from gallium nitride, indium nitride, and aluminum nitride, or the orientated polycrystalline thin film which comprises as a main component at least one selected from gallium nitride, indium nitride, and aluminum nitride, which are formed on the sintered compact, it is usually the same degree compared with the sintered compact which comprises gallium nitride as a main component and contains only one of the above components, such as at least one selected from an alkaline-earth-metal-component and a rare earth element component, at least one selected from a transition-metal-elements component, such as MnO, CoO, NiO, Fe₂O₃, Cr₂O₃, TiO₂, MoO₃, WO₃, Nb₂O₅, Ta₂O₅, and V₂O₅, etc., at least one selected from Zn, Cd, C, Si, Ge, Se, and Te, or at least one selected from aluminum, indium, and oxygen, and there is little change of the optical permeability lowering greatly.

And, in the sintered compact which comprises gallium nitride as a main component and contains at least one selected from Be, Mg, Zn, Cd, C, Si, Ge, Se, Te, and oxygen, not only what has conductivity but also what has optical permeability is producible.

In the sintered compact which comprises gallium nitride as a main component and contains at least one or more above components selected from Be, Mg, Zn, Cd, C, Si, Ge, Se, Te, and oxygen, what is the optical transmissivity not less than 1 % is producible.

The gallium nitride-based sintered compact containing at least one selected from Be, Mg, Zn, Cd, C, Si, Ge, Se, Te, and oxygen in an amount of not more than 10.0 mol % on an element basis, which has not only conductivity but also improved optical permeability of not less than 10% can be produced.

In the gallium nitride-based sintered compact containing at least one selected from Be, Mg, Zn, Cd, C, Si, Ge, Se, Te, and oxygen in the range of 0.00001-10.0 mol % on an element basis, not only what has conductivity but also what is the optical permeability not less than 20% can be produced, furthermore what is the optical permeability not less than 30%, not less than 40%, not less than 50%, not less than 60%, and not less than 80% is also producible.

In the gallium nitride-based sintered compact having conductivity and optical permeability, even if it is not only what contains at least one selected from Be, Mg, Zn, Cd, C, Si, Ge, Se, Te, and oxygen but also what contains simultaneously at least one selected from an alkaline-earth-metal component, such as CaO, SrO, and BaO, etc., and a rare earth element component, such as Sc₂O₃, Y₂O₃, La₂O₃, CeO₂, Pr₆O₁₁, Nd₂O₃, Pm₂O₃, Sm₂O₃, Eu₂O₃, Gd₂O₃, Tb₄O₇, Dy₂O₃, Ho₂O₃, Er₂O₃, Tm₂O₃, Yb₂O₃, and Lu₂O₃, etc., or what contains simultaneously at least one selected from Be, Mg, Zn, Cd, C, Si, Ge, Se, Te, and oxygen and at least one selected from a transition-metal-elements component, such as MnO, CoO, NiO, Fe₂O₃, Cr₂O₃, TiO₂, MoO₃, WO₃, Nb₂O₅, Ta₂O₅, and V₂O₅, etc., or what contains simultaneously at least one selected from Be, Mg, Zn, Cd, C, Si, Ge, Se, Te, and oxygen and at least one selected from aluminum and indium, it is rare that the above conductivity or optical permeability decrease.

In the sintered compact which comprises gallium nitride as a main component and which has conductivity and has optical permeability furthermore, even if it is not only what contains a total of two components of each respective one component illustrated above but also what contains a total of not less than three components in which either component is not less than two kinds, it is rare that the above conductivity or optical permeability decrease.

In this invention, for example, in the sintered compact which comprises gallium nitride as a main component and which contains simultaneously at least one or more above components selected from an alkaline-earth-metal component and a rare earth element component and at least one selected from Zn, Cd, C, Si, Ge, Se, and Te, a thing which has the conductivity not more than 1x10⁴ Ω·cm as the electric resistivity at room temperature and has optical permeability is producible. And, in the sintered compact which comprises gallium nitride as a main component and has such composition, what has simultaneously high optical transmissivity and high conductivity, such as 1.7x10⁻² Ω·cm as the electric resistivity at room temperature and 82 % as the optical transmissivity, was obtained.

In addition, the above optical transmissivity is not the straight line transmittance of a transparent body, such as glass, etc., but means the total transmittance like the optical transmissivity of the sintered compact which comprises aluminum nitride as a main component.

Although it is not necessarily clear about the reason the sintered compact which comprises gallium nitride as a main component has the above high optical permeability, it is conjectured that that what has a comparatively homogeneous and dense structure can produce easily is a big factor.

Moreover, in the sintered compact which comprises gallium nitride as a main component and has the above composition, it seems that what has high optical permeability is obtained since what has the more homogeneous and denser structure is producible.

A gallium nitride-based sintered compact is produced easily by firing a gallium nitride-based powder compact at about 1000-1700°C in a non-oxidizing atmosphere.

It is preferably fired at 1200°C or higher to have high optical permeability.

Any raw material powder of gallium nitride can be used to produce the above gallium nitride-based sintered compact, and it is desirable to use those excellent in sinterability in order to produce the gallium nitride-based sintered compact having optical permeability.

Fine powder with an average particle diameter of not more than 10 µm can be used suitably in order to produce a gallium nitride-based sintered compact having optical permeability.

Powder having an average particle diameter not more than 5.0 µm is more preferred, and powder having an average particle diameter not more than 2.0 µm is more preferred.

Powder having an average particle diameter not more than 1.0 µm can be used.

Even if the average particle diameter is larger than 10 µm, it can be used suitably by grinding it to finer powder of not more than 10 µm by a ball mill, or a jet mill, etc.

Such gallium nitride-based raw material powder may be as follows:
(1) A product of a direct nitriding reaction of metal gallium with a nitrogen-containing compound such as nitrogen and ammonia.
(2) A product of a reduction-nitriding of gallium oxide with a reducing agent such as carbon, and a nitrogen-containing compound such as nitrogen and ammonia.
(3) A product of a chemical transport method in which a gaseous gallium compound such as trimethyl gallium and gallium chloride state is reacted with a nitrogen-containing compound.

Gallium nitride powder may be produced by reacting metal gallium with a gas containing a nitrogen compound such as nitrogen and ammonia at about 300-1700°C, after the metal gallium is vaporized by heating at about 300-1700°C in an inert atmosphere such as argon and helium, or in a reducing atmosphere such as hydrogen.

Gallium nitride powder may also be produced by a reduction and nitriding reaction of gallium oxide by heating a mixture of gallium oxide powder and carbon powder with a gas containing a nitrogen compound at about 400-1600°C. Remaining carbon may be removed by heating in an oxidizing atmosphere such as air.

Gallium nitride powder may also be produced by vaporizing a gallium compound such as gallium chloride, gallium bromide or trimethyl gallium by heating at about 50-1800°C in a non-oxidizing atmosphere such as argon, helium or nitrogen, or in a reducing atmosphere such as hydrogen, and reacting a gaseous gallium compound with a gas containing a nitrogen compound at about 300-1800°C, in the presence of a reducing gas, if needed.

Oxygen may be contained as impurities in such powder comprising gallium nitride as a main component and can be used as a raw material for sintered compact production, but a dense sintered compact having optical permeability, and a sintered compact having conductivity are producible, even if it is the gallium nitride-based sintered compact produced using such raw material powder containing impurities oxygen.

Usually, if the oxygen content of gallium nitride powder is not more than 10 % by weight, in the gallium nitride-based sintered compact produced using the powder, optical permeability or conductivity may be shown.

When the gallium nitride-based sintered compact produced using the gallium nitride powder in which the oxygen content is not more than 10 % by weight is used, a single-crystal thin film comprising as a main component at least one selected from gallium nitride, indium nitride and aluminum nitride and being excellent in crystallinity, such that the half width of the rocking curve of the X-ray diffraction line from the lattice plane (002) is not more than 300 seconds, can be formed directly on it.

If a thin film comprising as a main component at least one selected from gallium nitride, indium nitride and aluminum nitride and having various crystallization states, such as an amorphous state, a polycrystal, an orientated polycrystal, and a single crystal, etc., is formed beforehand on the gallium nitride-based sintered compact and a single-crystal thin film comprising as a main component at least one selected from gallium nitride, indium nitride and aluminum nitride is formed furthermore on it, that being excellent in crystallinity, such that the half width of the rocking curve of the X-ray diffraction line from the lattice plane (002) of the single-crystal thin film is not more than 130 seconds, can be formed comparatively easily.

If the oxygen content of gallium nitride powder is not more than 5.0 % by weight, a gallium nitride-based sintered compact being the optical transmissivity not less than 5 % or being the electric resistivity not more than 1x10⁴ Ω·cm at room temperature is obtained, so it is preferred.

In addition, the above powder comprising gallium nitride as a main component of this invention means usually a powder containing a gallium component not less than 55.0 mol % on a GaN basis.

The content of an alkaline-earth metal in the gallium nitride-based sintered compact is expressed on the basis of BeO, MgO, CaO, SrO and BaO, respectively. The content of a rare earth metal in the sintered compact is expressed on the basis of Sc₂O₃, Y₂O₃, La₂O₃, CeO₂, Pr₆O₁₁, Nd₂O₃, Pm₂O₃, Sm₂O₃, Eu₂O₃, Gd₂O₃, Tb₄O₇, Dy₂O₃, Ho₂O₃, Er₂O₃, Tm₂O₃, Yb₂O₃ and Lu₂O₃, respectively.

If a light-emitting device is produced using a conductive ceramic-based sintered compact, such as the above zinc oxide and gallium nitride, it has the feature in which the light-emitting device having the constitution wherein the electric connection between electrodes and the device is possible by arranging electrodes up and down without forming conduction vias in a substrate can be produced.

When the ceramic-based sintered compact having conductivity is used, a light-emitting device having the constitution wherein the electrodes were arranged up and down can be produced, if the electric resistivity of the sintered compact is not more than 1x10⁴ Ω·cm at room temperature.

Usually, electric power can be supplied sufficiently in a little loss, if the electric resistivity is not more than 1x10² Ω·cm at room temperature in the sintered compact having conductivity

As the electric resistivity at room temperature of the sintered compact having conductivity, what is not more than 1x10¹ Ω·cm is preferred, what is not more than 1x10⁰ Ω·cm is more preferred, and what is 1x10⁻¹ Ω·cm is more preferred.

In this invention, as mentioned above, a single-crystal thin film which has high crystallinity and comprises as a main component at least one selected from gallium nitride, indium nitride and aluminum nitride is producible using the sintered compact which comprises as a main component zinc oxide, beryllium oxide, and aluminum oxide, respectively, as a substrate.

Therefore, using the substrate in which such a single-crystal thin film was formed, a light-emitting device is producible forming a thin film anew on it, or a light-emitting device is also producible using such a thin film which has high crystallinity at least as the part of a thin film layer which constitutes a light-emitting device as it is.

As for the light-emitting device which is produced using such sintered compact which comprises as a main component zinc oxide, beryllium oxide, and aluminum oxide, respectively as a substrate, that which has equivalent luminous efficiency at least has been provided compared with the light-emitting device produced using a conventional sapphire substrate.

On the other hand, as mentioned above, in the sintered compact which comprises as a main component zinc oxide, beryllium oxide, and aluminum oxide, respectively, what has comparatively high optical permeability can be obtained, therefore, a light-emitting device is also producible using such sintered compact which has optical permeability and comprises as a main component zinc oxide, beryllium oxide, and aluminum oxide, respectively as a substrate.

In the light-emitting device produced using such sintered compact which has optical permeability and comprises as a main component zinc oxide, beryllium oxide, and aluminum oxide, respectively as a substrate, since what is furthermore excellent in luminous efficiency is easy to be obtained, what is more excellent in luminous efficiency can be provided, compared with the light-emitting device produced using a conventional sapphire substrate.

Although the reason is not necessarily clear, since a substrate is a sintered compact unlike conventional sapphire, etc., reflection decreases in the interface between the substrate and the thin film which constitutes a light-emitting device, and the light from a light-emitting device is penetrated into the substrate as it is, the light which advanced into the substrate becomes easy to be emitted to the outside of a substrate because the substrate has optical permeability, it seems that the luminous efficiency of a light-emitting device becomes easy to be improved.

And, it becomes hard to generate the reflection in the interface with a surrounding atmosphere, it seems that the light from a light-emitting device is easy to be emitted to the outside of a device through the thin film layer.

In addition, unless reference is made especially in this invention, as for the measured value of optical transmissivity ofthe above sintered compacts which comprise as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., it was expressed with the percentage ratio by measuring the intensity of a incidence light and a transmitted light using the spectrophotometer, etc., applying the light of predetermined wavelength to the above sintered compact sample, using he disc-like sample which has the diameter of 25.4 mm and the thickness of 0.5 mm and carried out specular surface polish like the sintered compact which comprises aluminum nitride as a main component.

Unless reference is made especially, as the wavelength, usually it is measured using 605 nm.

The optical transmissivity in this invention is what calculated as a total transmittance which expressed the intensity ratio of this all transmitted light and incident light with percentage, by setting the above test sample in the inside of an integrating sphere, and by collecting all transmitted light.

In addition, as for the performance of the various sintered compacts of this invention which comprise as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., even if the optical transmissivity has not measured using the light other than the wavelength of 605nm, the luminous efficiency of the produced light-emitting device when used as a substrate for light-emitting device production can be judged, for example, if the optical transmissivity to the light with a wavelength 605 nm is grasped.

The optical transmissivity changes by the thickness of a sample, as for the above various sintered compacts of this invention which comprise as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., when they are actually used as a substrate for thin-film formation, a thin-film substrate, or a substrate for light-emitting device production, it is effective to make the thickness of the substrate thin and to raise the optical transmissivity, in order to raise the luminous efficiency of a light-emitting device for example.

Usually, it is desirable to use what has the thickness not less than 0.01 mm as a substrate for thin-film formation, a thin-film substrate, or a substrate for light-emitting device production from the point of handling strength.

And, since the optical transmissivity tends to decrease if the thickness becomes thick, it is usually preferred to use what has the thickness not more than 8.0 mm as a substrate for thin-film formation, a thin-film substrate, or a substrate for light-emitting device production, etc.

In this invention, as for the thickness of the above various sintered compacts which comprise as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., it is effective if it has optical permeability in the state which uses actually the sintered compact as a substrate for thin-film formation, a thin-film substrate, or a substrate for light-emitting device production, etc., in the range of at least 0.01-8.0 mm.

That is, as for the thickness of the above various sintered compacts which comprise as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., even if it is the range of at least 0.01-8.0 mm or except it, the optical transmissivity in the state where it is actually used should just be at least 1% or more. For example, even if the thickness is not actually 0.5 mm necessarily as a substrate for light-emitting device production, such as 0.1 mm or 2.0 mm, etc., if it has optical permeability, if the optical transmissivity is at least not less than 1 %, for example, the luminous efficiency of the light-emitting device produced tends to be improved.

In this invention, as for the optical permeability of various sintered compacts which comprise as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., it is unrelated to thickness.

This invention includes what has optical permeability by making it thin even if it does not have optical permeability in the thick state.

That is, for example, in the various sintered compacts which comprise as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., this invention includes a thing in which the optical permeability is shown by making thickness thin even if it does not have optical permeability, when the thickness of it is 0.5 mm.

And, for example, in the various sintered compacts which comprise as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., this invention also includes a thing in which the optical permeability is shown by setting thickness to 0.5 mm even if it does not have optical permeability, when the thickness of it is thicker than 0.5 mm.

If the optical permeability is expressed by another word, the optical transmissivity is unrelated to the thickness of various sintered compacts which comprise as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., it is included in this invention if the optical transmissivity of the sintered compact is not less than 1 %.

That is, for example, in the various sintered compacts which comprise as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., this invention includes a thing in which the optical transmissivity is not less than 1 % inmaking thickness thin even if the optical transmissivity is smaller than 1 %, when the thickness of it is 0.5 mm.

And, for example, in the various sintered compacts which comprise as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., this invention includes a thing in which the optical transmissivity is not less than 1 % in setting thickness to 0.5 mm even if the optical transmissivity is smaller than 1 %, when the thickness of it is thicker than 0.5mm.

As for the optical permeability of various sintered compacts which comprise as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., the optical permeability in the state where the sintered compacts are actually used is important, as mentioned above.

Therefore, as the various sintered compacts which comprise as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., they are included in this invention if they have optical permeability in the state where the sintered compacts are actually used.

If another expression is carried out, as for the optical transmissivity of this invention, it is unrelated to the thickness of various sintered compacts which comprise as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., and it is included in this invention if the optical transmissivity in the real busy condition of the sintered compacts is not less than 1 %.

That is, as for the thickness of various sintered compacts which comprise as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., when it is not more than 0.5 mm or larger than 0.5 mm at a real busy condition, for example, a thing in which the optical transmissivity is not less than 1 % is included in this invention.

As for the optical transmissivity of various sintered compacts which comprise as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., the optical transmissivity differs from the thing measured at the time of the substrate thickness of 0.5 mm when the thickness of the substrate is thinner than 0.5 mm at an actually used condition or is thicker than 0.5 mm, the optical transmissivity tends to become high than the measurement at the time of 0.5 mm when thinner than 0.5 mm, it is easy to become lower than the optical transmissivity measured at the time of 0.5 mm when thicker than 0.5 mm.

In this invention, it is preferred to use various sintered compacts which are the optical transmissivity not less than 1 % in the state where it is actually used and comprise as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc.

In addition, it has mainly illustrated until now that the thing which has the crystal structure of a hexagonal system or a trigonal system, such as the sintered compact which comprises as a main component silicon carbide, silicon nitride, gallium nitride, zinc oxide, beryllium oxide, and aluminum oxide, etc., is used as the substrate for thin-film formation, and a thin-film substrate. But, even if the above main components are what has the crystal structures other than a hexagonal system or a trigonal system, such as a cubic system, a tetragonal system, a orthorhombic system, a monoclinic system, a triclinic system, and an amorphous state, etc., it can be used suitably as the substrate for thin-film formation, and a thin-film substrate if it is a thing which comprises as a main component silicon carbide, silicon nitride, gallium nitride, zinc oxide, beryllium oxide, and aluminum oxide, etc.

For example, in the sintered compact which comprises silicon carbide as a main component, even if it has the cubic system as a crystal structure, it can be used suitably.

And, for example, in the sintered compact which makes aluminum oxide the main components, even if it has the cubic system or spinel structure as a crystal structure, it can be used suitably as a substrate.

In this invention, using not only the above sintered compact which comprises as a main component aluminum oxide, zinc oxide, beryllium oxide, silicon carbide, silicon nitride, and gallium nitride, but also the sintered compact which comprises as a main component zirconium oxide, magnesium oxide, magnesium aluminate, titanium oxide, barium titanate, lead titanate zirconate, and rare-earth element oxides such as yttrium oxide, thorium oxide, various ferrites, mullite, forsterite, steatite, and glass, etc., as a substrate, if using a substrate in which a thin film which comprises as a main component at least one selected from gallium nitride, indium nitride, and aluminum nitride and has various crystallization states, such as a single crystal, an amorphous state, a polycrystal, and an orientated polycrystal, etc., is formed beforehand on the substrate, a single-crystal thin film which comprises as a main component at least one selected from gallium nitride, indium nitride, and aluminum nitride can be formed on it. And, a light-emitting device is also producible by forming a thin film anew on it using the substrate in which such a single-crystal thin film was formed, or a light-emitting device is also producible using the single-crystal thin film formed like that as it is, as at least a part of the thin film layer which constitutes a light-emitting device.

In this invention, as for the light-emitting device produced using a substrate wherein a thin film which comprises as a main component at least one selected from gallium nitride, indium nitride, and aluminum nitride and has various crystallization states, such as a single crystal, an amorphous state, a polycrystal, and an orientated polycrystal, etc., is formed beforehand on the substrate which comprises various sintered compacts which comprise as a main component a ceramic material, such as silicon carbide, silicon nitride, gallium nitride, zirconium oxide, magnesium oxide, magnesium aluminate, titanium oxide, barium titanate, lead titanate zirconate, and rare-earth element oxides such as yttrium oxide, thorium oxide, various ferrites, mullite, forsterite, steatite, and glass, etc., and a single-crystal thin film which comprises as a main component at least one selected from gallium nitride, indium nitride, and aluminum nitride is formed furthermore on it, that which has equivalent luminous efficiency at least has been provided now compared with the light-emitting device produced using a conventional sapphire substrate.

If it explains in detail, in this invention, not only in the sintered compact which comprises as a main component aluminum oxide, zinc oxide, beryllium oxide, silicon carbide, silicon nitride, and gallium nitride, but also in the various sintered compacts which comprise as a main component zirconium oxide, magnesium oxide, magnesium aluminate, titanium oxide, barium titanate, lead titanate zirconate, and rare-earth element oxides such as yttrium oxide, thorium oxide, various ferrites, mullite, forsterite, steatite, and glass, etc., it is possible to obtain what has optical permeability.

Concretely speaking, a thing in which the optical transmissivity is not less than 1 %, usually not less than 10 %, is producible.

And, in the above sintered compact which comprises as a main component zirconium oxide, magnesium oxide, magnesium aluminate, titanium oxide, barium titanate, lead titanate zirconate (especially, a thing containing a rare earth element component), and rare-earth element oxides such as yttrium oxide, thorium oxide, various ferrites, mullite, forsterite, steatite, and glass, etc., a thing with the optical transmissivity not less than 50 % is producible, and the thing of a maximum of not less than 80 % is producible.

If such various sintered compacts which comprise a ceramic material as a main component and have optical permeability are used for a substrate for light-emitting device production, the luminous efficiency of the light-emitting device produced will tend to be improved compared with the light-emitting device produced using a conventional sapphire, etc. as a substrate.

Although the reason is not necessarily clear, reflection of the luminescence from a light-emitting device decreases in the interface between the substrate and the thin film which constitutes a light-emitting device and it becomes easy to be penetrated into a substrate as it is because the substrate is a sintered compact unlike a conventional sapphire, etc., the light which advanced into the substrate becomes easy to be emitted to the outside of a substrate because the substrate has optical permeability, it seems that the luminous efficiency of a light-emitting device becomes easy to be improved.

And, also in the thin film layer which constitutes a light-emitting device, it becomes hard to generate reflection in the interface with a surrounding atmosphere, it seems that the light from a light-emitting device is easy to be emitted to the outside of a device through the thin film layer.

Among the above various sintered compacts which comprise a ceramic material as a main component, it is especially excellent in optical permeability in the case of the sintered compact which comprises as a main component zirconium oxide, magnesium oxide, magnesium aluminate, rare-earth oxides, such as yttrium oxide, thorium oxide, mullite, and glass, what has optical permeability is producible comparatively easily, adding sintering aids suitably, by using a conventional method, such as normal pressure sintering (for example, in air, or in reducing gas, such as H₂, or in non-oxidizing gas, such as N₂, or in weak oxidizing gas, such as CO₂), decompression firing, and hot press.

Even if it is the normal pressure sintering in air, what is the optical transmissivity not less than 10 %, usually the optical transmissivity not less than 20 % or the optical transmissivity not less than 30 %, is producible.

And, by firing in hydrogen, or by hot press, or by decompression firing, etc., what is the optical transmissivity not less than 40 %, usually the optical transmissivity not less than 50 % and the optical transmissivity not less than 60 %, is producible, and what is the optical transmissivity not less than 80 % is also producible.

In order to raise the optical permeability, in the case of zirconium oxide, compounds, such as an oxide containing a rare-earth-elements component, such as Sc₂O₃, Y₂O₃, La₂O₃, CeO₂, Pr₆O₁₁, Nd₂O₃, Pm₂O₃, Sm₂O₃, Eu₂O₃, Gd₂O₃, Tb₄O₇, Dy₂O₃, Ho₂O₃, Er₂O₃, Tm₂O₃, Yb₂O₃, and Lu₂O₃, etc., or compounds, such as an oxide containing alkaline earth metal components, such as BeO, MgO, CaO, SrO, and BaO, etc., can be used suitably as sintering aids, for example.

And, in the case of magnesium oxide, compounds, such as an oxide containing a rare-earth-elements component, such as Sc₂O₃, Y₂O₃, La₂O₃, CeO₂, Pr₆O₁₁, Nd₂O₃, Pm₂O₃, Sm₂O₃, Eu₂O₃, Gd₂O₃, Tb₄O₇, Dy₂O₃, Ho₂O₃, Er₂O₃, Tm₂O₃, Yb₂O₃, and Lu₂O₃, etc., or compounds, such as an oxide containing alkaline earth metal components, such as BeO, CaO, SrO, and BaO, etc., or compounds, such as a fluoride containing alkali metal components, such as LiF, and NaF, etc., or silicon compounds, such as SiO₂, etc., can be used suitably.

And, in the case of magnesium aluminate, compounds, such as an oxide containing a rare-earth-elements component, such as Sc₂O₃, Y₂O₃, La₂O₃, CeO₂, Pr₆O₁₁, Nd₂O₃, Pm₂O₃, Sm₂O₃, Eu₂O₃, Gd₂O₃, Tb₄O₇, Dy₂O₃, Ho₂O₃, Er₂O₃, Tm₂O₃, Yb₂O₃, and Lu₂O₃, etc., or compounds, such as an oxide containing alkaline earth metal components, such as BeO, MgO, CaO, SrO, and BaO, etc., or silicon compounds, such as SiO₂, etc., can be used suitably.

And, in the case of the rare-earth oxide, such as yttrium oxide, compounds, such as an oxide containing aluminum component, such as Al₂O₃, etc., compound, such as an oxide which contains at least one or more rare earth components and which is different from the main components selected from Sc₂O₃, Y₂O₃, La₂O₃, CeO₂, Pr₆O₁₁, Nd₂O₃, Pm₂O₃, Sm₂O₃, Eu₂O₃, Gd₂O₃, Tb₄O₇, Dy₂O₃, Ho₂O₃, Er₂O₃, Tm₂O₃, Yb₂O₃, and Lu₂O₃, etc., or compounds, such as an oxide containing alkaline earth metal components, such as BeO, MgO, CaO, SrO, and BaO, etc., can be used suitably.

And, in the case of thorium oxide, compounds, such as an oxide containing a rare-earth-elements component, such as Sc₂O₃, Y₂O₃, La₂O₃, CeO₂, Pr₆O₁₁, Nd₂O₃, Pm₂O₃, Sm₂O₃, Eu₂O₃, Gd₂O₃, Tb₄O₇, Dy₂O₃, Ho₂O₃, Er₂O₃, Tm₂O₃, Yb₂O₃, and Lu₂O₃, etc., or compounds, such as an oxide containing alkaline earth metal components, such as BeO, MgO, CaO, SrO, and BaO, etc., can be used suitably.

And, in the case of mullite, compounds, such as an oxide containing a rare-earth-elements component, such as Sc₂O₃, Y₂O₃, La₂O₃, CeO₂, Pr₆O₁₁, Nd₂O₃, Pm₂O₃, Sm₂O₃, Eu₂O₃, Gd₂O₃, Tb₄O₇, Dy₂O₃, Ho₂O₃, Er₂O₃, Tm₂O₃, Yb₂O₃, and Lu₂O₃, etc., or compounds, such as an oxide containing alkaline earth metal components, such as BeO, CaO, SrO, and BaO, etc., or silicon compounds, such as SiO₂, etc., can be used suitably.

And, in the case of glass, compounds, such as an oxide containing a rare-earth-elements component, such as Sc₂O₃, Y₂O₃, La₂O₃, CeO₂, Pr₆O₁₁, Nd₂O₃, Pm₂O₃, Sm₂O₃, Eu₂O₃, Gd₂O₃, Tb₄O₇, Dy₂O₃, Ho₂O₃, Er₂O₃, Tm₂O₃, Yb₂O₃, and Lu₂O₃, etc., or compounds, such as an oxide containing alkaline earth metal components, such as BeO, CaO, SrO, and BaO, etc., or silicon compounds, such as SiO₂, etc., can be used suitably.

And, in these sintered compacts which comprise as a main component zirconium oxide, magnesium oxide, magnesium aluminate, a rare-earth oxide, such as yttrium oxide, thorium oxide, mullite, and glass, what contains components, such as transition metal components, such as tungsten, vanadium, niobium, tantalum, titanium, iron, nickel, chromium, manganese, a zirconium, hafnium, cobalt, copper, and zinc, or carbon, in addition to the component illustrated above, respectively can be used suitably. And, in the thing containing these components, what colored into black, ashes black, gray, brown, yellow, green, blue, reddish brown, and red, etc., is easy to be obtained, and a thing which has optical permeability is obtained even if it colored.

In addition, in this invention, the optical transmissivity of the above various sintered compacts which comprise a ceramic material as a main component is a thing to the light of the range of 200-800 nm wavelength at least. And, the above optical transmissivity is measured using the light with a wavelength of 605 nm.

In this invention, unless reference is made especially, the above measured value was used for the optical transmissivity of the various sintered compacts which comprise a ceramic material as a main component from now on.

Using such various sintered compacts which comprise a ceramic material as a main component and have optical permeability, as a substrate, if a thing in which a thin film which comprises as a main component at least one selected from gallium nitride, indium nitride, and aluminum nitride and has various crystallization states, such as a single crystal, an amorphous state, a polycrystal, and an orientated polycrystal, etc., is formed beforehand on the substrate is used as a substrate, since a single-crystal thin film which comprises as a main component at least one selected from gallium nitride, indium nitride, and aluminum nitride can be formed on it, a light-emitting device is producible by forming a thin film anew on it using such substrate in which a single-crystal thin film is formed, or a light-emitting device is also producible using at least a part of the single-crystal thin film formed by doing in this way as it is, as at least a part of the thin film layer which constitutes a light-emitting device.

In this invention, among the above sintered compacts which comprise as a main component each zirconium oxide, magnesium oxide, magnesium aluminate, titanium oxide, barium titanate, lead titanate zirconate, rare-earth oxides for example yttrium oxide, thorium oxide, various ferrites, mullite, forsterite, steatite, and glass, etc., in the case of a light-emitting device produced using as a substrate what has optical permeability, what excels in luminous efficiency is easy to be obtained, so that which is at least equivalent or has been improved to a maximum of not less than 2-3 times has been producible compared with the luminous efficiency of a light-emitting device produced using a conventional sapphire substrate.

In addition, unless reference is made especially in this invention, as for the measured value of optical transmissivity ofthe above various sintered compacts which comprise as a main component a ceramic material, such as zirconium oxide, magnesium oxide, magnesium aluminate, titanium oxide, barium titanate, lead titanate zirconate, rare earth oxides such as yttrium oxide, thorium oxide, various ferrites, mullite, forsterite, steatite, and glass, etc., it was expressed with the percentage ratio by measuring the intensity of a incidence light and a transmitted light using the spectrophotometer, etc., applying the light of predetermined wavelength to the above sintered compact sample, using he disc-like sample which has the diameter of 25.4 mm and the thickness of 0.5 mm and carried out specular surface polish like the sintered compact which comprises aluminum nitride as a main component.

Unless reference is made especially, as the wavelength, usually it is measured using 605 nm.

The optical transmissivity in this invention is what calculated as a total transmittance which expressed the intensity ratio of this all transmitted light and incident light with percentage, by setting the above test sample in the inside of an integrating sphere, and by collecting all transmitted light.

In addition, as for the performance of the various sintered compacts of this invention which comprise as a main component a ceramic material, such as zirconium oxide, magnesium oxide, magnesium aluminate, titanium oxide, barium titanate, lead titanate zirconate, rare earth oxides such as yttrium oxide, thorium oxide, various ferrites, mullite, forsterite, steatite, and glass, etc., even if the optical transmissivity has not measured using the light other than the wavelength of 605nm, the luminous efficiency of the produced light-emitting device when used as a substrate for light-emitting device production can be judged, for example, if the optical transmissivity to the light with a wavelength 605 nm is grasped.

The optical transmissivity changes by the thickness of a sample, as for the above various sintered compacts of this invention which comprise as a main component a ceramic material, such as zirconium oxide, magnesium oxide, magnesium aluminate, titanium oxide, barium titanate, lead titanate zirconate, rare earth oxides such as yttrium oxide, thorium oxide, various ferrites, mullite, forsterite, steatite, and glass, etc., when they are actually used as a substrate for thin-film formation, a thin-film substrate, or a substrate for light-emitting device production, it is effective to make the thickness of the substrate thin and to raise the optical transmissivity, in order to raise the luminous efficiency of a light-emitting device for example.

Usually, it is desirable to use what has the thickness not less than 0.01 mm as a substrate for thin-film formation, a thin-film substrate, or a substrate for light-emitting device production from the point of handling strength.

And, since the optical transmissivity tends to decrease if the thickness becomes thick, it is usually preferred to use what has the thickness not more than 8.0 mm as a substrate for thin-film formation, a thin-film substrate, or a substrate for light-emitting device production, etc.

In this invention, as for the thickness of the above various sintered compacts which comprise as a main component a ceramic material, such as zirconium oxide, magnesium oxide, magnesium aluminate, titanium oxide, barium titanate, lead titanate zirconate, rare earth oxides such as yttrium oxide, thorium oxide, various ferrites, mullite, forsterite, steatite, and glass, etc., it is effective if it has optical permeability in the state which uses actually the sintered compact as a substrate for thin-film formation, a thin-film substrate, or a substrate for light-emitting device production, etc., in the range of at least 0.01-8.0 mm.

That is, as for the thickness of the above various sintered compacts which comprise as a main component a ceramic material, such as zirconium oxide, magnesium oxide, magnesium aluminate, titanium oxide, barium titanate, lead titanate zirconate, rare earth oxides such as yttrium oxide, thorium oxide, various ferrites, mullite, forsterite, steatite, and glass, etc., even if it is the range of at least 0.01-8.0 mm or except it, the optical transmissivity in the state where it is actually used should just be at least 1% or more. For example, even if the thickness is not actually 0.5 mm necessarily as a substrate for light-emitting device production, such as 0.1 mm or 2.0 mm, etc., if it has optical permeability, if the optical transmissivity is at least not less than 1 %, for example, the luminous efficiency of the light-emitting device produced tends to be improved.

In this invention, as for the optical permeability of various sintered compacts which comprise as a main component a ceramic material, such as zirconium oxide, magnesium oxide, magnesium aluminate, titanium oxide, barium titanate, lead titanate zirconate, rare earth oxides such as yttrium oxide, thorium oxide, various ferrites, mullite, forsterite, steatite, and glass, etc., it is unrelated to thickness.

This invention includes what has optical permeability by making it thin even if it does not have optical permeability in the thick state.

That is, for example, in the various sintered compacts which comprise as a main component a ceramic material, such as zirconium oxide, magnesium oxide, magnesium aluminate, titanium oxide, barium titanate, lead titanate zirconate, rare earth oxides such as yttrium oxide, thorium oxide, various ferrites, mullite, forsterite, steatite, and glass, etc., this invention includes a thing in which the optical permeability is shown by making thickness thin even if it does not have optical permeability, when the thickness of it is 0.5 mm.

And, for example, in the various sintered compacts which comprise as a main component a ceramic material, such as zirconium oxide, magnesium oxide, magnesium aluminate, titanium oxide, barium titanate, lead titanate zirconate, rare earth oxides such as yttrium oxide, thorium oxide, various ferrites, mullite, forsterite, steatite, and glass, etc., this invention also includes a thing in which the optical permeability is shown by setting thickness to 0.5 mm even if it does not have optical permeability, when the thickness of it is thicker than 0.5 mm.

If the optical permeability is expressed by another word, the optical transmissivity is unrelated to the thickness of various sintered compacts which comprise as a main component a ceramic material, such as zirconium oxide, magnesium oxide, magnesium aluminate, titanium oxide, barium titanate, lead titanate zirconate, rare earth oxides such as yttrium oxide, thorium oxide, various ferrites, mullite, forsterite, steatite, and glass, etc., it is included in this invention if the optical transmissivity of the sintered compact is not less than 1 %.

That is, for example, in the various sintered compacts which comprise as a main component a ceramic material, such as zirconium oxide, magnesium oxide, magnesium aluminate, titanium oxide, barium titanate, lead titanate zirconate, rare earth oxides such as yttrium oxide, thorium oxide, various ferrites, mullite, forsterite, steatite, and glass, etc., this invention includes a thing in which the optical transmissivity is not less than 1 % in making thickness thin even if the optical transmissivity is smaller than 1 %, when the thickness of it is 0.5 mm.

And, for example, in the various sintered compacts which comprise as a main component a ceramic material, such as zirconium oxide, magnesium oxide, magnesium aluminate, titanium oxide, barium titanate, lead titanate zirconate, rare earth oxides such as yttrium oxide, thorium oxide, various ferrites, mullite, forsterite, steatite, and glass, etc., this invention includes a thing in which the optical transmissivity is not less than 1 % in setting thickness to 0.5 mm even if the optical transmissivity is smaller than 1 %, when the thickness of it is thicker than 0.5mm.

As for the optical permeability of various sintered compacts which comprise as a main component a ceramic material, such as zirconium oxide, magnesium oxide, magnesium aluminate, titanium oxide, barium titanate, lead titanate zirconate, rare earth oxides such as yttrium oxide, thorium oxide, various ferrites, mullite, forsterite, steatite, and glass, etc., the optical permeability in the state where the sintered compacts are actually used is important, as mentioned above.

Therefore, as the various sintered compacts which comprise as a main component a ceramic material, such as zirconium oxide, magnesium oxide, magnesium aluminate, titanium oxide, barium titanate, lead titanate zirconate, rare earth oxides such as yttrium oxide, thorium oxide, various ferrites, mullite, forsterite, steatite, and glass, etc., they are included in this invention if they have optical permeability in the state where the sintered compacts are actually used.

If another expression is carried out, as for the optical transmissivity of this invention, it is unrelated to the thickness of various sintered compacts which comprise as a main component a ceramic material, such as zirconium oxide, magnesium oxide, magnesium aluminate, titanium oxide, barium titanate, lead titanate zirconate, rare earth oxides such as yttrium oxide, thorium oxide, various ferrites, mullite, forsterite, steatite, and glass, etc., and it is included in this invention if the optical transmissivity in the real busy condition of the sintered compacts is not less than 1 %.

That is, as for the thickness of various sintered compacts which comprise as a main component a ceramic material, such as zirconium oxide, magnesium oxide, magnesium aluminate, titanium oxide, barium titanate, lead titanate zirconate, rare earth oxides such as yttrium oxide, thorium oxide, various ferrites, mullite, forsterite, steatite, and glass, etc., when it is not more than 0.5 mm or larger than 0.5 mm at a real busy condition, for example, a thing in which the optical transmissivity is not less than 1 % is included in this invention.

As for the optical transmissivity of various sintered compacts which comprise as a main component a ceramic material, such as zirconium oxide, magnesium oxide, magnesium aluminate, titanium oxide, barium titanate, lead titanate zirconate, rare earth oxides such as yttrium oxide, thorium oxide, various ferrites, mullite, forsterite, steatite, and glass, etc., the optical transmissivity differs from the thing measured at the time of the substrate thickness of 0.5 mm when the thickness of the substrate is thinner than 0.5 mm at an actually used condition or is thicker than 0.5 mm, the optical transmissivity tends to become high than the measurement at the time of 0.5 mm when thinner than 0.5 mm, it is easy to become lower than the optical transmissivity measured at the time of 0.5 mm when thicker than 0.5 mm.

In this invention, it is preferred to use various sintered compacts which are the optical transmissivity not less than 1 % in the state where it is actually used and comprise as a main component a ceramic material, such as zirconium oxide, magnesium oxide, magnesium aluminate, titanium oxide, barium titanate, lead titanate zirconate, rare earth oxides such as yttrium oxide, thorium oxide, various ferrites, mullite, forsterite, steatite, and glass, etc.

In this invention, a thin-film substrate in which an optical waveguide by the thin film comprising as a main component at least one selected from gallium nitride, indium nitride and aluminum nitride was formed on the aluminum nitride-based sintered compact may be provided.

A thin-film substrate which can operate for the optical transmission of a broad wavelength area from the ultraviolet-rays area to the infrared area, such as the range of wavelength of 200-7000 nm, can be provided using the thin-film substrate in which an optical waveguide was formed.

Especially, it became possible to transmit an ultraviolet light of the range of 200-380 nm without big loss.

If the thin film which is used for an optical waveguide and comprises as a main component at least one selected from gallium nitride, indium nitride and aluminum nitride is a single crystal, the transmission loss of light can reduce more.

The optical transmission nature is realizable by the excellent optical permeability of the thin film comprising as a main component at least one selected from gallium nitride, indium nitride and aluminum nitride.

Transmission of ultraviolet light with short wavelength, especially the range of 200-380 nm, is realizable using a thin film having much aluminum nitride content.

Such optical transmission nature also results from the phenomena in which the thin film which comprises as a main component at least one selected from gallium nitride, indium nitride and aluminum nitride and becomes into an optical waveguide may be formed as a single crystal on the aluminum nitride-based sintered compact.

Such optical transmission nature also results from the good junction nature between the aluminum nitride-based sintered compact and the thin film which comprises as the main component(s) at least one selected from gallium nitride, indium nitride, and aluminum nitride and becomes into an optical waveguide.

As for the junction nature between the aluminum nitride-based sintered compact and the thin film comprising as a main component at least one selected from gallium nitride, indium nitride, and aluminum nitride, a crack is not found in the thin film after joining, exfoliation is not found in the junction interface, and exfoliation in the junction interface does not arise even if a tearing test is carried out using the adhesive tape, as mentioned above.

It is because a single-crystal thin film which comprises as a main component at least one selected from gallium nitride, indium nitride, and aluminum nitride can be formed on the sintered compact which comprises aluminum nitride as a main component, in this invention.

This invention includes the thin-film substrate in which an optical waveguide was formed by the thin film which comprises as a main component at least one selected from gallium nitride, indium nitride, and aluminum nitride, and it is preferred in the case where high-output light-emitting devices, such as a semiconductor laser, are mounted because the sintered compact which comprises aluminum nitride as a main component is used for the material which constitutes a substrate and it excels in the nature of radiating heat.

And, since not only the above optical waveguide but also an electrical circuit can be formed in the inside and/or surface in the sintered compact which comprises aluminum nitride as a main component, there is the feature that it can use as an optical wiring substrate which has the above optical waveguide and an electrical circuit.

That is, this invention can provide a thin-film substrate which can transmit the light from light-emitting devices which emit blue color and ultraviolet-rays, such as the semiconductor laser diode or light-emitting diode in which it is predicted that application will spread greatly from now on and which comprise as a main component at least one selected from gallium nitride, indium nitride, and aluminum nitride.

And, this invention has the feature which can provide the above thin-film substrate which mounts directly the light-emitting devices which emit blue color and ultraviolet-rays and acts as an optical wiring substrate.

In the thin film which comprises as a main component at least one selected from gallium nitride, indium nitride and aluminum nitride and was formed on the aluminum nitride-based sintered compact, the thin film having at least one of the crystallization states selected from a single crystal, an amorphous state, a polycrystal, and an orientated polycrystal may be used as an optical waveguide.

When the light with a wavelength of 650 nm is transmitted using the thin films of such crystallization states, an optical waveguide in which the transmission loss is not more than 10 dB/cm at least can usually be formed.

Among them, it becomes possible to achieve the reduction of transmission loss using a single-crystal thin film, it usually becomes possible to form an optical waveguide with the transmission loss not more than 5 dB/cm at least.

In the single-crystal thin film comprising as a main component at least one selected from gallium nitride, indium nitride and aluminum nitride and having the half width of the rocking curve of the X-ray diffraction line from the lattice plane of the Miller Index (002) not more than 100 seconds, it becomes possible to form an optical waveguide with the transmission loss not more than 3 dB/cm at least.

The wavelength of the light which can be transmitted using the optical waveguide depends on the composition of a thin film which comprises as a main component at least one selected from gallium nitride, indium nitride and aluminum nitride.

To the ultraviolet light of the range of a wavelength of 200-380 nm and the light with a wavelength not less than 380 nm, it is preferred to use a thin film comprising as a main component at least one selected from gallium nitride and aluminum nitride, as an optical waveguide.

When the ultraviolet light with shorter wavelength is transmitted, it is preferred to use a thin film of a composition having only aluminum nitride or having much aluminum nitride content.

An ultraviolet light with short wavelength can be transmitted with lower loss using a thin film of such composition.

To the visible light with a wavelength of 380-650 nm, a thin film which comprises as a main component at least one selected from gallium nitride, indium nitride and aluminum nitride may be used as an optical waveguide, besides the thin film of the above-mentioned composition.

When the visible light with shorter wavelength is transmitted, it is preferred to use a thin film of the composition having only aluminum nitride or having much aluminum nitride content, or a thin film of the composition having only a gallium nitride or having much gallium nitride content.

A visible light with short wavelength can be transmitted with lower loss using a thin film of such composition.

To the light with a wavelength not less than 650 nm at least, a thin film of the composition of all the combination of gallium nitride, indium nitride and aluminum nitride may be used as an optical waveguide.

In this invention, it is preferred to use a thin film which comprises as a main component at least one selected from gallium nitride and aluminum nitride as an optical waveguide for transmitting an ultraviolet light, as mentioned above.

Speaking more concretely, it is preferred to use a thin film which comprises as a main component a composite expressed by the chemical formula of AlₓGa₁₋ₓN (0.0≤x≤1.0) as an optical waveguide for transmitting an ultraviolet light.

It becomes possible to transmit up to the ultraviolet-rays with a wavelength of 200 nm using these materials as an optical waveguide.

The optical waveguide formed by the above-mentioned thin film which comprises as a main component at least one selected from gallium nitride and aluminum nitride can transmit not only an ultraviolet light but also a visible light of a wavelength not less than 380 nm and an infrared light of a wavelength not less than 800 nm with low loss.

In order to lessen the transmission loss of an ultraviolet light with shorter wavelength, it is preferred more to use a thin film containing much aluminum nitride component as an optical waveguide.

That is, when transmitting the light with a wavelength not more than 380 nm, it is preferred to use a thin film having the composition of the range of 0.0≤x≤1.0 in the above-mentioned chemical formula, and when the light with a wavelength of 380 nm is used, an optical waveguide in which the transmission loss is not more than 10 dB/cm may be provided.

As the thin film of the above-mentioned composition range, an optical waveguide in which the transmission loss is not more than 5 dB/cm may be provided using a single crystal.

In the single-crystal thin film in which the half width of the rocking curve of the X-ray diffraction line from the lattice plane of the Miller Index (002) is not more than 100 seconds, it becomes possible to provide an optical waveguide of at least not more than 3 dB/cm.

When transmitting the light with a wavelength not more than 300 nm, it is preferred to use a thin film having the composition of the range of 0.5≤x≤1.0, and when the light with a wavelength of 300 nm is used, an optical waveguide in which the transmission loss is not more than 10 dB/cm may be provided.

As the thin film of the above-mentioned composition range, an optical waveguide in which the transmission loss is not more than 5 dB/cm may be provided using a single crystal.

In the single-crystal thin film in which the half width of the rocking curve of the X-ray diffraction line from the lattice plane of the Miller Index (002) is not more than 100 seconds, it becomes possible to provide an optical waveguide of at least not more than 3 dB/cm. When transmitting the light with a wavelength not more than 270 nm, it is preferred to use a thin film having the composition of the range of 0.8≤x≤1.0, and when the light with a wavelength of 270 nm is used, an optical waveguide in which the transmission loss is not more than 10 dB/cm may be provided.

As the thin film of the above-mentioned composition range, an optical waveguide in which the transmission loss is not more than 5 dB/cm can be provided using a single crystal.

In the single-crystal thin film in which the half width of the rocking curve of the X-ray diffraction line from the lattice plane of the Miller Index (002) is not more than 100 seconds, it becomes possible to provide an optical waveguide of at least not more than 3 dB/cm.

When transmitting the light with a wavelength not more than 250 nm, it is preferred to use a thin film having the composition of the range of 0.9≤x≤1.0, and when the light with a wavelength of 250 nm is used, an optical waveguide in which the transmission loss is not more than 10 dB/cm may be provided.

As the thin film of the above-mentioned composition range, an optical waveguide in which the transmission loss is not more than 5 dB/cm may be provided using a single crystal.

In the single-crystal thin film in which the half width of the rocking curve of the X-ray diffraction line from the lattice plane of the Miller Index (002) is not more than 100 seconds, it becomes possible to provide an optical waveguide of at least not more than 3 dB/cm. If the above-mentioned single-crystal thin film which has the composition of the range of 0.8≤x≤1.0 is used, it will enable to obtain an embedded type of three dimension optical waveguide in which the transmission loss of the light with a wavelength not less than 300 nm is not more than 1 dB/cm.

Since materials, such as LiNbO₃, LiTaO₃, PLZT, GaAs and PbMoO₄, etc. which are hitherto used as an optical waveguide, do not penetrate an ultraviolet light, they cannot perform transmission of an ultraviolet light.

As the material which can penetrate and transmit an ultraviolet light, many things, such as silica glass, alumina (sapphire), and calcium fluoride, etc., are known.

However, when these materials are formed on the sintered compact which comprises aluminum nitride as a main component in the thickness not less than 0.5 µm, as a thin film, in these thin films, a distortion which is considered to be originated by the lattice mismatching or the difference of thermal expansion coefficient is generated or a crack occurs when extreme, or exfoliation may arise in the junction interface between the sintered compact which comprises aluminum nitride as a main component and the thin film materials, such as silica glass, alumina (sapphire), and calcium fluoride, etc., so it is unsuitable to transmit an ultraviolet light substantially.

In this invention, since the thin film which comprises as a main component at least one selected from gallium nitride and aluminum nitride is used in the sintered compact which comprises aluminum nitride as a main component, it is hard to produce such fault.

According to this invention, a thin-film substrate which has the optical waveguide which can carry out the transmission of an ultraviolet light which was difficult by the optical waveguide which used conventional materials, such as LiNbO₃ system, etc., can be provided, as mentioned above.

In addition, as the material which can penetrate and transmit an ultraviolet light, there are things in which a thin film which comprises as a main component at least one selected from gallium nitride and aluminum nitride is formed in the sapphire substrate or in the silicon substrate, as the optical waveguide.

However, even if these thin films can be formed as a single-crystal thin film with high crystallinity, it is easy to produce a crystal dislocation and a strain in the optical waveguide by the mismatching of crystal lattice or by the difference of thermal expansion coefficient between the substrate and the thin film, the transmission loss will tend to become more than 10 dB/cm easily, as a result.

And, it is difficult to function as an optical waveguide because a crack, or exfoliation between the substrate is easy to produce in the aluminum nitride thin film formed in the silicon substrate, and it is hard to form an electrical circuit directly on the substrate because the electric insulation is small and the dielectric constant is high, when the silicon substrate is used.

Since not only the above optical waveguide but also an electrical circuit can be formed in the inside and/or surface of the above sintered compact which comprises aluminum nitride as a main component and constitutes the thin-film substrate which has an optical waveguide which can transmit an ultraviolet light, as for the thin-film substrate according to this invention, there is a feature in which it can be used as an optical wiring substrate which can transmit an ultraviolet light and has an optical waveguide and an electrical circuit.

In this invention, a thin film which comprises as a main component at least one selected from gallium nitride, indium nitride, and aluminum nitride and was formed directly on the sintered compact which comprises aluminum nitride as a main component can be used as an optical waveguide.

And, as for the thin film which comprises as a main component at least one selected from gallium nitride, indium nitride, and aluminum nitride and is formed anew on it using the sintered compact which comprises aluminum nitride as a main component and formed beforehand a thin film which comprises at least one selected from gallium nitride, indium nitride, and aluminum nitride as a main component, it can also be used as an optical waveguide, and the transmission loss may be able to be lowered compared with what formed a thin film directly on the sintered compact which comprises aluminum nitride as a main component.

As for the index of refraction of the above thin film formed anew on the sintered compact which comprises aluminum nitride as a main component and formed beforehand a thin film which comprises as a main component at least one selected from gallium nitride, indium nitride, and aluminum nitride, it is desirable that it is larger than the index of refraction of a thin film which is being formed beforehand on the sintered compact which comprises aluminum nitride as a main component in order to reduce the transmission loss.

Other than the reason in which a better thin film than the thing formed directly on the sintered compact which comprises aluminum nitride as a main component can be formed, as mentioned above, it is thought that it is based on the principle that the light is transmitted as a result, because the light which penetrates the inside of a material with large index of refraction is shut up into the material with large index of refraction when the material with large index of refraction is formed in the material with small index of refraction.

The thickness of the above thin film formed beforehand can use anything, what is the range of 0.5 nm-1000 µm, for example, can be used suitably, and what is not more than 200 µm can usually be used suitably because a single-crystal thin film with high crystallinity can be obtained.

Usually, an optical waveguide with less transmission loss is producible using what is the thickness not less than 50 nm.

And, as for the thickness of a thin film with large index of refraction which is formed anew on the thin film formed beforehand and functions as an optical waveguide, it is preferred to use what is the range of 0.1-1000 µm, and is usually preferred to use what is not more than 200 µm because a single-crystal thin film with high crystallinity can be obtained.

When a thin film with large index of refraction is operated as an optical waveguide by combining a thin film of small index of refraction and a thin film of large index of refraction, it can function enough, if the thickness of the optical waveguide is not less than 0.1 µm.

In this invention, all the combination of a thin film with a small index of refraction and a thin film with a large index of refraction which is used as an optical waveguide is possible.

That is, in all the composition of the thin film which comprises as a main component at least one selected from gallium nitride, indium nitride, and aluminum nitride, or in all the crystallization states, such as a single crystal, an amorphous state, a polycrystal, and an orientated polycrystal, the above combination is possible.

The thin film with small index of refraction can bear a role of a cladding layer in the optical waveguide usually used hitherto.

In this invention, as for the thin film with small index of refraction, not only what is formed between the sintered compact which comprises aluminum nitride as a main component and the thin film with large index of refraction which is used as an optical waveguide, but also what is formed on the thin film with large index of refraction which is used as an optical waveguide which is formed on the sintered compact which comprises aluminum nitride as a main component can be used as mentioned above, and it can bear a role of a cladding layer in the optical waveguide usually used hitherto even if a thin film with small index of refraction is in the above formation conditions.

If a concrete example is shown about the thin-film substrate which is formed by combining a thin film of small index of refraction and a thin film of large index of refraction which becomes into an optical waveguide, it is as follows,
1) what combined the thin film which comprises as a main component at least one selected from gallium nitride, indium nitride, and aluminum nitride, and the thin film which comprises as a main component at least one selected from gallium nitride, indium nitride, and aluminum nitride and which contains more of at least one selected from gallium and indium,
2) what combined the thin film which comprises as a main component at least one selected from gallium nitride, indium nitride, and aluminum nitride, and the thin film which comprises as a main component at least one selected from gallium nitride, indium nitride, and aluminum nitride and which contains furthermore at least one selected from niobium and tantalum.

The background of the above example having been shown is based on the thing in which the knowledge of two points shown below has been acquired.

That is,
1) it was confirmed that the refractive index of the thin film rises according as many of at least one selected from gallium and indium are contained in the thin film which comprises as a main component at least one selected from gallium nitride, indium nitride, and aluminum nitride and was formed on the sintered compact which comprises aluminum nitride as a main component. Saying concretely, if the increment of at least one selected from gallium nitride and indium nitride is not more than 20 mol % to the original thin film which comprises as a main component at least one selected from gallium nitride, indium nitride, and aluminum nitride, the raise of refractive index is not more than 2x10⁻¹. And, even if the increment of at least one selected from gallium nitride and indium nitride is about 0.01 mol % to the original thin film which comprises as a main component at least one selected from gallium nitride, indium nitride, and aluminum nitride, the raise of refractive index is observed at least not less than 1x10⁻⁵.
2) in the case of the thin film which comprises as a main component at least one selected from gallium nitride, indium nitride, and aluminum nitride and contains furthermore at least one selected from niobium and tantalum, it was found out that the index of refraction has risen compared with the thin film which comprises as a main component at least one selected from gallium nitride, indium nitride, and aluminum nitride and does not contain niobium or tantalum. Saying concretely, in the thin film which comprises as a main component at least one selected from gallium nitride, indium nitride, and aluminum nitride, if the content of at least one selected from niobium and tantalum is not more than 20 mol % on a nitride basis to the main component(s), the raise of refractive index is not more than 2x10⁻¹. And, in the thin film which comprises as a main component at least one selected from gallium nitride, indium nitride, and aluminum nitride, even if the content of at least one selected from niobium and tantalum is about 0.01 mol % on a nitride basis to the main component(s), the raise of the refractive index at least not less than 1x10⁻⁵ is observed.

As the effect of niobium or tantalum being included, this inventor is surmising that it is the main cause that it probably has the property in which niobium or tantalum tends to dissolve in gallium nitride, indium nitride, aluminum nitride, or a compound having two or more of these components.

That is, it is guessed that niobium or tantalum should dissolve in the crystal of gallium nitride, indium nitride, aluminum nitride, or a compound having two or more of these components, as niobium nitride or tantalum nitride.

In the niobium nitride or tantalum nitride, it is considered that it is easy to realize the dissolving since it has the crystal structure of the same hexagonal system as gallium nitride, indium nitride, aluminum nitride, or a compound having two or more of these components.

It is surmised that the raise of refractive index is attained since what is the same crystal structure has dissolved each other on the atomic parallel inside the crystal not in the state where they are being only mixed physically as a different material, even if they are the different component.

In this invention, as for the above thin film which comprises as a main component at least one selected from gallium nitride, indium nitride, and aluminum nitride and contains furthermore at least one selected from niobium or tantalum, it can be used also as an optical waveguide which transmits the light of the range of 200-7000 nm wavelength at least, because it can transmit not only the visible light and infrared light but also the ultraviolet light of the range of a wavelength of 200-380 nm.

In the thin film which comprises as a main component at least one selected from gallium nitride, indium nitride, and aluminum nitride, what contains the component of only niobium or only tantalum or both of niobium and tantalum simultaneously can be obtained.

As for the content of at least one selected from niobium and tantalum in the thin film which comprises as a main component at least one selected from gallium nitride, indium nitride, and aluminum nitride, it is preferred that it is not more than 20 mol % on a nitride basis to the main components.

That is, the content of a niobium component or a tantalum component which are contained is shown by the formula (1-m) (NbuTal-uN) if the content of a main component is expressed with the formula of m (AlₓGa_{y}In_{1-x-y}N:0.0≤x≤1.0, 0.0≤y≤1.0, and 0.0≤x+y≤1.0) by considering that a niobium component and a tantalum component are what exists as niobium nitride (NbN) and tantalum nitride (TaN) in a thin film, respectively, and it is preferred that the content of niobium and tantalum in a thin film is the range of 0.8≤m≤1.0 and 0.0≤u≤1.0.

Because the transmission loss becomes easy to increase when the thin film is used as an optical waveguide, if the content of at least one selected from niobium and tantalum in a thin film is more than 20 mol % on a nitride basis.

As for the effect of containing niobium and tantalum in the thin film which comprises as a main component at least one selected from gallium nitride, indium nitride, and aluminum nitride, even if the quantity is about 0.01 mol % on a nitride basis to the main components, the refractive index of the main component(s) is raised at least not less than 1x10⁻⁵ and the thin film may be made to function as an optical waveguide.

In addition, measurement of the refractive index of a thin film can be easily performed using optical apparatus, such as polarization analysis using the usual ellipsometer, etc., a repetition interference microscope method, a prism coupler method, or other spectrophotometers.

The accuracy of measurement of such refractive index is possible to the digit of 1x10⁻⁵, and it can be measured in the accuracy of at least 2x10⁻⁵.

As mentioned above, in this invention, not only the thin film which comprises as a main component at least one selected from gallium nitride, indium nitride, and aluminum nitride but also the thin film which comprises as a main component at least one selected from gallium nitride, indium nitride, and aluminum nitride and contains at least one selected from niobium and tantalum can be used as an optical waveguide.

As for the above thin film which contains at least one selected from niobium and tantalum in the thin film which comprises as a main component at least one selected from gallium nitride, indium nitride, and aluminum nitride, it can be used not only as an optical waveguide which was combined with the thin film with refractive index smaller than the thin film, but also as an optical waveguide independently, such as directly forming on the sintered compact which comprises aluminum nitride as a main component, for example.

In this invention, in the above thin-film substrate in which a thin film with large refractive index which becomes an optical waveguide was formed in a thin film with small refractive index, or in the thin-film substrate in which a thin film with small refractive index was formed in a thin film with large refractive index which becomes an optical waveguide, by the conventional methods, such as the above CVD, MOCVD, MBE, and Sputtering, what laminated the thin film with large refractive index into the thin film with small refractive index one by one, or what laminated a thin film with small refractive index into the thin film with large refractive index one by one, can be used.

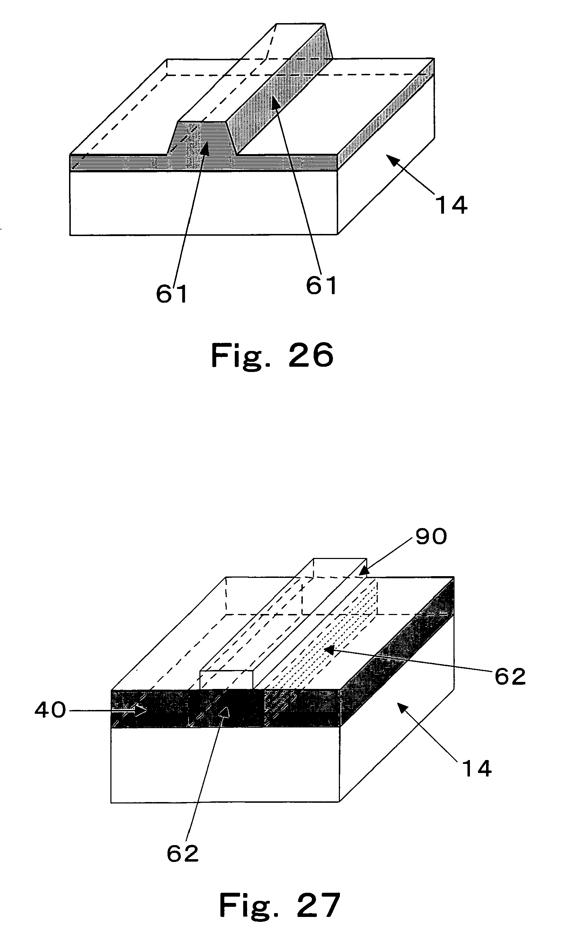

By such method, the optical waveguide illustrated in Figs. 21-26, and Fig. 34 is producible. And, the method wherein the slot and the hollow are formed in the thin film with small refractive index and a thin film with large refractive index is embedded one by one can also be used, and the optical waveguide illustrated in Figs. 27-33, and Fig. 35 can be produced by such method.

And, as the above thin-film substrate in which a thin film with large refractive index which becomes an optical waveguide was formed in a thin film with small refractive index, it can also be produced by the method of raising the refractive index of a thin film portion in which at least one selected from gallium, indium, niobium, and tantalum are contained by containing at least one selected from gallium, indium, niobium, and tantalum, for example, especially in the depth direction of the thin film which comprises as a main component at least one selected from gallium nitride, indium nitride, and aluminum nitride, using the thermal diffusion method or the ion implantation method, for example, in addition to the method in which a thin film is formed one by one by laminating as mentioned above.

As the thermal diffusion method, there are methods, for example, the gallium, indium, niobium, and tantalum component are diffused in the thin film which comprises as a main component at least one selected from gallium nitride, indium nitride, and aluminum nitride by heat-treating at high temperature not less than 800°C in non-oxidizing atmospheres, such as nitrogen, if it requires, after the material containing gallium components, such as gallium nitride, a metal gallium, and a gallium oxide, etc., or indium components, such as indium nitride, a metal indium, and an indium oxide, etc., or niobium components, such as a niobium nitride, a metal niobium, and a niobium oxide, etc., or tantalum components, such as a tantalum nitride, a metal tantalum, and a tantalum oxide, etc., is newly formed in the thin film which comprises as a main component at least one selected from gallium nitride, indium nitride, and aluminum nitride and is formed on the sintered compact which comprises aluminum nitride as a main component, etc.

As the result, a portion with more contents of gallium or indium than the original thin film which comprises as a main component at least one selected from gallium nitride, indium nitride, and aluminum nitride is formed in the depth direction and width direction of a thin film, and an index of refraction rises, and it comes to function as an optical waveguide.

And, a thin film which comprises as a main component at least one selected from gallium nitride, indium nitride, and aluminum nitride and contains newly the niobium or tantalum component is formed, and the refractive index rises, and it comes to function as an optical waveguide.

It seems that the increment of at least one selected from gallium nitride and indium nitride is not more than 20 mol % to the original thin film which comprises as a main component at least one selected from gallium nitride, indium nitride, and aluminum nitride, because the raise of the refractive index is not more than 2x10⁻¹, usually in the range of 1x10⁻⁵-2x10⁻¹, by heating temperature or heating time, when using the above thermal diffusion method.

And, even if the above increment of the gallium-nitride or indium-nitride component is not more than 1 mol % to the main component(s), the raise of the refractive index is usually in the range of 1x10⁻⁵-1x10⁻², it functions as an optical waveguide enough.

Furthermore, the content of at least one selected from niobium and tantalum is not more than 20 mol % to the main component(s), because the raise of the refractive index of the thin film which comprises as a main component at least one selected from gallium nitride, indium nitride, and aluminum nitride and contains at least one selected from the niobium and tantalum component is not more than 2x10⁻¹, usually in the range of 1x10⁻⁵-2x10⁻¹, by heating temperature or heating time, when using the above thermal diffusion method.

It is preferred that the content of niobium or tantalum is not more than 10 mol % to the main component(s), in order to lower the transmission loss.

And, even if the above niobium or tantalum is not more than 1 mol % to the main component(s), the raise of the refractive index is usually in the range of 1x10⁻⁵-1x10⁻², it functions as an optical waveguide enough.

As ion implantation method, there is a method, for example, gallium components, such as a gallium chloride, a gallium bromide, and a gallium hydride, etc., or indium components, such as or an indium chloride, an indium bromide, and an indium hydride, etc., or niobium components, such as a niobium chloride, a niobium bromide, and a niobium hydride, etc., or tantalum components, such as a tantalum chloride, a tantalum bromide, and a tantalum hydride, etc., are used as an ionization source, the above component(s) is ionized using electric discharge, etc., after removing unnecessary ion with mass spectrograph, etc., gallium, indium, niobium, and tantalum ion are accelerated with the accelerator, then they are implanted to the thin film which comprises as a main component at least one selected from gallium nitride, indium nitride, and aluminum nitride, after that it heat-treats in non-oxidizing atmospheres, such as nitrogen for example, at the temperature of not less than 500°C if required, so that ion implanted may become uniform, and a portion in which many gallium or indium is contained and a portion which contains newly niobium or tantalum in this thin film are formed, etc.

As the result, a portion with more contents of gallium or indium than the original thin film which comprises as a main component at least one selected from gallium nitride, indium nitride, and aluminum nitride is formed in the depth direction and width direction of a thin film, and an index of refraction rises, and it comes to function as an optical waveguide.

And, a thin film which comprises as a main component at least one selected from gallium nitride, indium nitride, and aluminum nitride and contains newly the niobium or tantalum component is formed, and the refractive index rises, and it comes to function as an optical waveguide.

When an optical waveguide is formed by the above thermal diffusion method or ion implantation method, in the original thin film which comprises as a main component at least one selected from gallium nitride, indium nitride, and aluminum nitride and was formed on the sintered compact which comprises aluminum nitride as a main component, the refractive index becomes smaller than the optical waveguide, so the thin film will function inevitably as a cladding layer for shutting up the light transmitted by the optical waveguide.

Since the thermal diffusion method or ion implantation method can form a fine optical waveguide using the processing methods, such as optical lithography, it is effective when forming an embedded type of optical waveguide used widely hitherto.

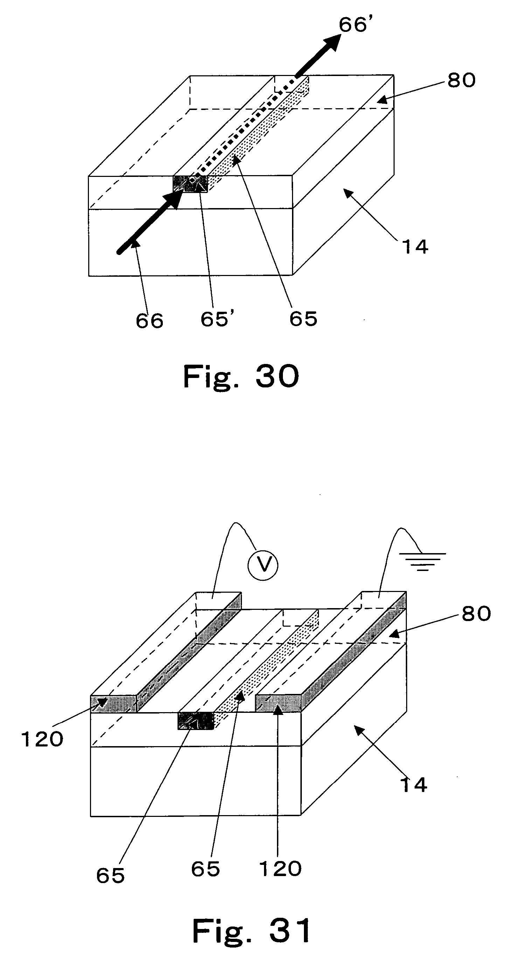

In addition, in this invention, as the example of an embedded type of optical waveguide, Figs. 30-33, and Fig. 35 which are mentioned below are illustrated.

In this above invention, when an optical waveguide is formed by the thermal diffusion method or ion implantation method, the size of the portion in which the component which raises a refractive index is introduced can produce an arbitrary thing, it will function as an optical waveguide enough, ifit is usually not less than 0.5 µm as the width in the case of the above embedded type of optical waveguide.

Usually, as for the width of an optical waveguide, it is formed in not less than 1 µm.

Usually, as for the width of an optical waveguide, what is the range of 1-500 µm is used.

Although arbitrary things can be produced as the diffusion depth or the impregnation depth, it can function enough as an optical waveguide with small transmission loss, if there are not less than 0.1 µm.

And, if the diffusion depth or the impregnation depth is not less than 0.3 µm, it can function as an optical waveguide with smaller transmission loss.

Usually, as for the diffusion depth or the impregnation depth, what is not less than 0.5 µm is used.

When an optical waveguide is formed by the above thermal diffusion method or ion implantation method, as for the portion in which the component which raises a refractive index was formed beforehand on the thin film, especially in the thermal diffusion method, the width of the portion in which the component for improvement of a refractive index was introduced tends to spread after thermal diffusion compared with before performing the thermal diffusion, but it may function as an optical waveguide satisfactory even if it is in such condition.

In addition, when using the usual optical methods in the refractometry of a thin film with thin width like the above optical waveguide, the accuracy of a refractive index tends to lower to the digit which is about 10-2 because the light beam which is irradiated to the measured portion is narrowed down with an optical lens, etc., so it is not measured directly in such a portion with thin width, and it is regarded as the refractive index of a thin film with thin width in many cases, by measuring the refractive index of the thin film which is formed by the same method in another portion in the shape of a large field so that it becomes the same composition.

Although what is not less than 500 µm is usually used as the diameter of the light beam which is irradiated to the measured portion, it is possible to measure a refractive index by irradiating such light beam which is narrowed down to the wavelength of light, for example about 650 nm in the minimum using an optical lens, etc., to the thin film portion which has the width of 650 nm or more, for example, but as the result, the accuracy of measurement of a refractive index tends to lower greatly from the original digit of 1x10⁻⁵ to the digit of about 1x10⁻¹-1x10⁻².

Speaking more concretely, for example, when forming a fine thin film with a width of 10 µm as an optical waveguide using the above sequential laminating method, diffusion method, or ion implantation method, the refractive index of the thin film of the portion which forms the optical waveguide is not measured directly and the refractive index of the thin film formed in another portion in large area (for example, 0.5 mm x 2 mm, or more) so that it might become the same composition is measured, and the refractive index of this thin film is regarded as the refractive index of the optical waveguide of a width of 10 µm.

In this invention, the refractive index of an optical waveguide which comprised a thin film with thin width was also measured by such method.

In this invention, the increment of the refractive index of the material which comprises as a main component at least one selected from gallium nitride, indium nitride, and aluminum nitride and contains niobium and tantalum, and the optical transmission nature as an optical waveguide were observed also except in the above thin film.

That is, when niobium and tantalum are contained by the thermal diffusion method using each bulk-like single crystal which comprises gallium nitride and aluminum nitride and is not a thin film, the raise of the refractive index and the optical transmission nature are observed.

In the optical waveguide formed by making the bulk-like single crystal of gallium nitride contain indium, niobium, and tantalum by the above thermal diffusion method, the refractive index rises at least not less than 1x10⁻⁵ in the visible light area, and the optical waveguide in which a light with a wavelength of at least not less than 380 nm can be transmitted in the condition not more than 3 dB/cm as transmission loss can form in the bulk single crystal which comprises gallium nitride as a main component.

In the optical waveguide formed by making the bulk-like single crystal of aluminum nitride contain gallium, indium, niobium, and tantalum by the above thermal diffusion method, the refractive index rises at least not less than 1x10⁻⁵ in the visible light area, and the optical waveguide in which a light with a wavelength of at least not less than 250 nm can be transmitted in the condition not more than 3dB/cm as transmission loss can form in the bulk single crystal which comprises aluminum nitride as a main component.

Furthermore, the optical waveguide in which a light with a wavelength of at least not less than 220 nm can be transmitted in the condition not more than 10 dB/cm as transmission loss can form in the bulk single crystal which comprises aluminum nitride as a main component.

In this invention, when a thin film which comprises as a main component at least one selected from gallium nitride, indium nitride, and aluminum nitride and is formed on the sintered compact which comprises aluminum nitride as a main component is used as an optical waveguide, a thing in which the transmission loss is at least equivalent or less compared with the optical waveguide produced using the above bulk single crystal is producible.

In this invention, the thin film which comprises as a main component at least one selected from gallium nitride, indium nitride, and aluminum nitride and is formed directly on the sintered compact which comprises aluminum nitride as a main component can be used as an optical waveguide.

This is suggested that the refractive index of the thin film is higher than the sintered compact which comprises aluminum nitride as a main component.

Although it seems that it is a big factor that the refractive index of aluminum nitride is smallest originally among each component of gallium nitride, indium nitride, and aluminum nitride, in addition, in the sintered compact in which the densification was carried out enough and which comprises aluminum nitride as a main component, it is thought that the crystallization of aluminum nitride particles which constitute the sintered compact advances enough and that it is in the condition near a single crystal, and it is surmised that it will be because it becomes smaller than the refractive index of a single crystal by the effect of the dissolution of impurities into aluminum nitride particle, grain boundary as a sintered compact, or grain boundary phase.

Therefore, it seems that it becomes easy to produce a total reflection in it even if it is a thin film formed directly on the sintered compact which comprises aluminum nitride as a main component.

An aluminum nitride crystal is an optical anisotropic substance wherein a direction perpendicular to the optical axis, i.e., the C axis of a crystal, is the direction of ordinary light and a direction parallel to the C axis is the direction of extraordinary light, the refractive index differs in ordinary light and extraordinary light, the refractive index in extraordinary light is larger about 0.05 in the visible light area.

On the other hand, since the sintered compact which comprises aluminum nitride as a main component is a polycrystalline substance and aluminum nitride crystal grains which constitute the sintered compact have random direction, there is no directivity of a crystal substantially, and it seems that the optical property as a crystal is equalized.

It seems that it has a dissolution of impurities, such as minute amount of cation impurities, carbon, or oxygen, etc., in the inside of aluminum nitride particles which constitute a sintered compact, since the sintered compact which comprises aluminum nitride as a main component is produced by firing.

Moreover, since the sintered compact which comprises aluminum nitride as a main component is a polycrystalline substance as mentioned above and the grain boundary and the grain boundary phase exist, it can consider the condensation and deposition of impurities to that portion.

The refractive index lowers than the single crystal by the feature as above sintered compacts, therefore this inventor is guessing that the thin film which comprises as a main component at least one selected from gallium nitride, indium nitride, and aluminum nitride and is formed directly on the sintered compact which comprises aluminum nitride as a main component can function enough as an optical waveguide.

Usually, the refractive index of what was formed in a single crystal is not less than 2.0, even if it is the thin film which comprises as a main component at least one selected from gallium nitride, indium nitride, and aluminum nitride and is formed directly on the sintered compact which comprises aluminum nitride as a main component, and it functions as an optical waveguide enough.

In order to raise the crystallinity of the single-crystal thin film which comprises as a main component at least one selected from gallium nitride, indium nitride, and aluminum nitride and is used as an optical waveguide, especially the single-crystal thin film comprising aluminum nitride as a main component among them, when the homogeneous thin film which comprises as a main component at least one selected from gallium nitride, indium nitride, and aluminum nitride is used as an intermediate layer between the sintered compact which comprises aluminum nitride as a main component, it is preferred to use a thing in which the refractive index of the intermediate layer thin film is smaller than 2.0.

In this case, it is considered that the intermediate layer thin film plays a role of cladding layer for operating an optical waveguide.

In this invention, the thin-film substrate can be used for the substrate for optical transmissions, such as optical modulator, optical phase converter, wavelength filter, or optical switch, or the acoustic optical device, by providing electrode(s) to the thin-film substrate in which an optical waveguide comprising a thin film which comprises as a main component at least one selected from gallium nitride, indium nitride, and aluminum nitride was formed on the sintered compact which comprises aluminum nitride as a main component.

It seems that it will become possible because the refractive index of the thin film can be changed by applying potential to the thin film which comprises as a main component at least one selected from gallium nitride, indium nitride, and aluminum nitride.

As for the currently formed thin film which comprises as a main component at least one selected from gallium nitride, indium nitride, and aluminum nitride, it is preferred to use a single crystal.

Other than the reason in which it can be easy to lower the transmission loss, it is because it can control the direction of the potential to the optical axis (namely, C axis of a crystal) and it becomes easy to control the variation of refractive index as a result, if the thin film is a single crystal.

An aluminum nitride crystal, gallium nitride crystal, indium nitride crystal, or the mixed crystal of these nitrides is an optical anisotropic substance wherein a direction perpendicular to the optical axis, i.e., the C axis of a crystal, is the direction of ordinary light and a direction parallel to the C axis is the direction of extraordinary light, the refractive index differs in ordinary light and extraordinary light, it is larger in extraordinary light.

If the thin film is a single crystal, it becomes easy to control the variation of a refractive index by making the direction of applying potential into parallel to C axis or into perpendicular to C axis.

Moreover, in this invention, although the thin-film substrate in which a single-crystal thin film which comprises as amain component at least one selected from gallium nitride, indium nitride, and aluminum nitride was formed on the sintered compact which comprises aluminum nitride as a main component can be provided, the crystallographic-axis formation direction of the single-crystal thin film is possible either in the direction where C axis is perpendicular to a substrate surface or in the parallel direction, and various controls of refractive index become still more possible.

The effect of using the above single crystals for the thin film which forms an optical waveguide is large in the thin-film substrate which has an embedded type of optical waveguide (for example, Fig. 30, Fig. 31, Fig. 32, Fig. 33, and Fig. 35) which is mentioned after.

In this invention, an optical modulator, an optical phase converter, a wavelength filter, an optical switch, etc. are producible using the property in which the refractive index of a thin film tends to change by providing electrode(s) and applying potential, as mentioned above.

As mentioned above, the feature of this invention is in the point wherein the optical waveguide which is made from the thin film which comprises as a main component at least one selected from gallium nitride, indium nitride, and aluminum nitride can be formed on the sintered compact which comprises aluminum nitride as a main component, instead of a conventional sapphire substrate, etc.

For example, about the reason in which the above characteristics, such that ultraviolet light can be transmitted under low transmission loss, are acquired as an optical waveguide, it is considered to be one of the main factors that the high junction nature is obtained between the sintered compact which comprises aluminum nitride as a main component and the thin film which comprises as a main component at least one selected from gallium nitride, indium nitride, and aluminum nitride.

As the result, it becomes easy to form a thin film with few strains and defects easily.

And, as for the reason that the characteristics as an optical waveguide are acquired as mentioned above, it also seems that it is one of the main factors that a single-crystal thin film which comprises as amain component at least one selected from gallium nitride, indium nitride, and aluminum nitride can be formed on the sintered compact which comprises aluminum nitride as a main component.

As mentioned above, a thin-film substrate in which the optical waveguide by the thin film which comprises as a main component at least one selected from gallium nitride, indium nitride and aluminum nitride was formed on the sintered compact which comprises aluminum nitride as a main component can be provided according to this invention.

As for the optical waveguide according to this invention, it is producible even if it is the two dimension waveguide and three dimension optical waveguide which are what kind of structures which have been known hitherto.

And, by forming furthermore an electrical circuit to the thin-film substrate according to this invention, the thin-film substrate can be used as an optical wiring substrate which has an optical waveguide and an electric circuit at least.

It is preferred to use the thin film-conductive material of this invention as a material for forming the above electrical circuit, because it excels in junction nature with the thin film which comprises as a main component at least one selected from gallium nitride, indium nitride, and aluminum nitride, and with the sintered compact which comprises aluminum nitride as a main component.

In addition to this, as the material for forming the above electrical circuit, a thing which comprises as a main component tungsten, molybdenum, and copper and is formed by co-firing with the sintered compact which comprises aluminum nitride as a main component, or a material which comprises as a main component gold, silver, copper, platinum, palladium, tungsten, molybdenum, manganese, and nickel, etc. and which is formed by the thick film printing method to the sintered compact which comprises aluminum nitride as a main component, or a material which comprises as a main component gold, silver, copper, platinum, palladium, and nickel, etc. which are formed by the pasting-up method using the resin component as conductive paste to the sintered compact which comprises aluminum nitride as a main component, etc., can be used.

Figures are illustrated and explained below about the thin-film substrate in which an optical waveguide by the thin film which comprises as a main component at least one selected from gallium nitride, indium nitride, and aluminum nitride was formed on the aluminum nitride-based sintered compact of this invention.

Figs. 21-23 is an example which shows the thin-film substrate in which the two dimension optical waveguide is formed.

Fig. 21 is a perspective diagram showing one example of a thin-film substrate, wherein the two dimension optical waveguide 50 is being formed on the substrate 14 which comprises a sintered compact which comprises aluminum nitride as a main component by the thin film which comprises as a main component at least one selected from gallium nitride, indium nitride, and aluminum nitride.

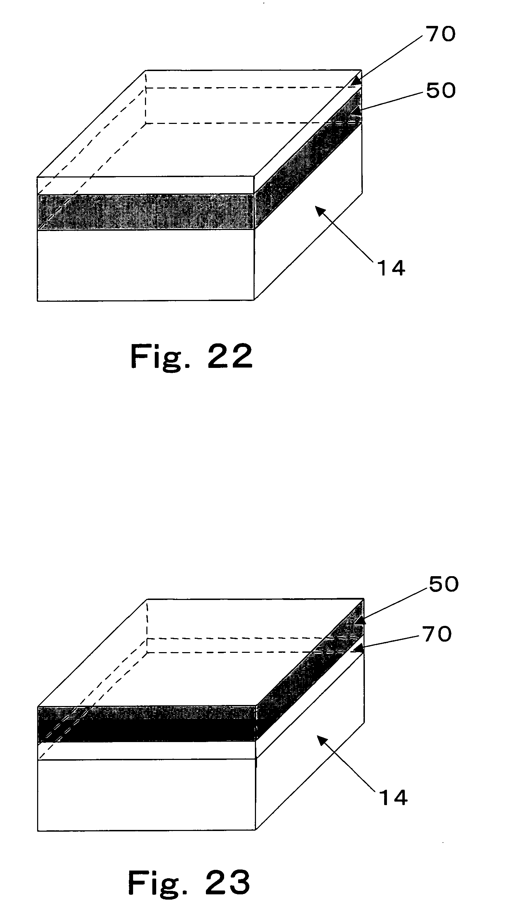

Fig. 22 is a perspective diagram showing one example of a thin-film substrate, wherein the two dimension optical waveguide 50 was formed on the substrate 14 which comprises a sintered compact which comprises aluminum nitride as a main component by the thin film which comprises as a main component at least one selected from gallium nitride, indium nitride, and aluminum nitride, and the cladding layer 70 was formed on the two dimension optical waveguide.

In Fig. 22, if the cladding layer is a material with the refractive index smaller than a thin film which comprises as a main component at least one selected from gallium nitride, indium nitride, and aluminum nitride and which forms an optical waveguide, anything can be used, for example, SiO₂, Al₂O₃, various glass, etc., but it is preferred to use a homogeneous material which comprises as a main component at least one selected from gallium nitride, indium nitride, and aluminum nitride, from the view point of junction nature, etc.

In Fig. 22, air can be used as the cladding layer, the thin-film substrate shown in Fig. 22 will become equivalent to the thin-film substrate shown in Fig. 21 in that case.

Fig. 23 is perspective diagram showing one example of a thin-film substrate, wherein the cladding layer 70 is formed on the substrate 14 which comprises a sintered compact which comprises aluminum nitride as a main component, and the two dimension optical waveguide 50 is being formed on it by the thin film which comprises as a main component at least one selected from gallium nitride, indium nitride, and aluminum nitride.

In Fig. 23, if the cladding layer is a material with the refractive index smaller than a thin film which comprises as a main component at least one selected from gallium nitride, indium nitride, and aluminum nitride and which forms an optical waveguide, anything can be used, for example, SiO₂, Al₂O₃, various glass, etc., but it is preferred to use a homogeneous material which comprises as a main component at least one selected from gallium nitride, indium nitride, and aluminum nitride, from the point of junction nature, etc.

In Figs. 21-23, when a light is introduced into the thin film which comprises as a main component at least one selected from gallium nitride, indium nitride, and aluminum nitride and is formed in the shape of a plate, the introduced light is confined in the perpendicular direction of a substrate, and the thin film functions as a two dimension optical waveguide.

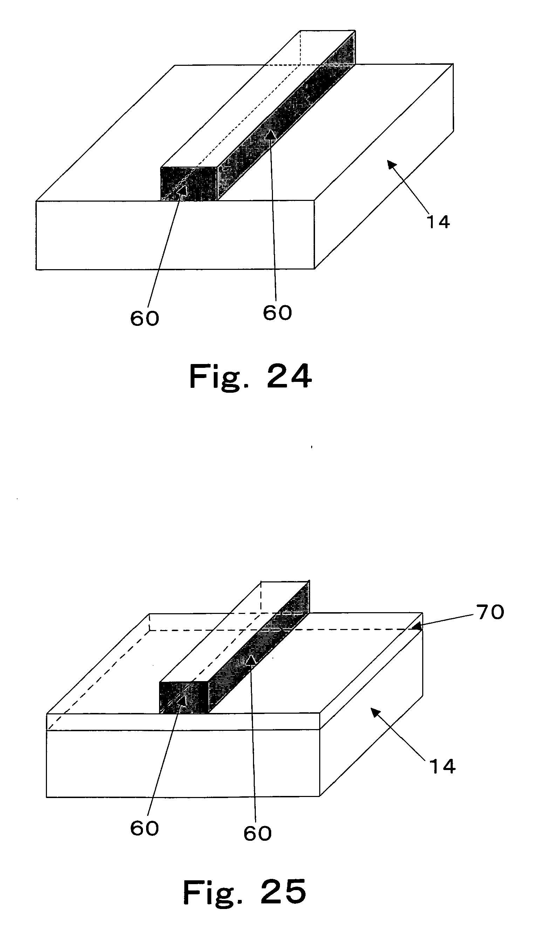

In Figs. 24-30, examples of a thin-film substrate in which a three dimension optical waveguide was formed are shown.

Fig. 24 is a perspective diagram showing one example of a thin-film substrate, wherein the three dimension optical waveguide 60 is being formed on the substrate 14 which comprises a sintered compact which comprises aluminum nitride as a main component by the thin film which comprises as a main component at least one selected from gallium nitride, indium nitride, and aluminum nitride.

In Fig. 24, the circumference of the three dimension optical waveguide 60 is air.

Fig. 25 is a perspective diagram showing one example of a thin-film substrate, wherein the cladding layer 70 is formed on the substrate 14 which comprises a sintered compact which comprises aluminum nitride as a main component, and the three dimension optical waveguide 60 is being formed on it by the thin film which comprises as a main component at least one selected from gallium nitride, indium nitride, and aluminum nitride.

In Fig. 25, if the cladding layer is a material with the refractive index smaller than a thin film which comprises as a main component at least one selected from gallium nitride, indium nitride, and aluminum nitride and which forms an optical waveguide, anything can be used, for example, SiO₂, Al₂O₃, various glass, etc., but it is preferred to use a homogeneous material which comprises as a main component at least one selected from gallium nitride, indium nitride, and aluminum nitride, from the point of junction nature, etc.

Fig. 26 is a perspective diagram showing one example of a thin-film substrate, wherein the three dimension optical waveguide 61 is being formed on the substrate 14 which comprises a sintered compact which comprises aluminum nitride as a main component by the thin film which comprises as a main component at least one selected from gallium nitride, indium nitride, and aluminum nitride and is formed in the shape of a ridge.

Although it is not illustrated in Fig. 26, it is desirable to use a material (for example, a homogeneous material which comprises as a main component at least one selected from gallium nitride, indium nitride, and aluminum nitride) of the refractive index smaller than the optical waveguide, between the substrate 14 which comprises a sintered compact which comprises aluminum nitride as a main component and the ridge-like three dimension optical waveguide 61, in order to lower the optical transmission loss.

Fig. 27 is a perspective diagram showing one example of a thin-film substrate, wherein the two dimension optical waveguide 50 is produced in the substrate 14 which comprises a sintered compact which comprises aluminum nitride as a main component by forming a thin film which comprises as a main component at least one selected from gallium nitride, indium nitride, and aluminum nitride and is the shape of a plate, and the dielectric material 40, such as SiO₂, Al₂O₃, and various glass, is formed in this two dimension optical waveguide, and the three dimension optical waveguide 62 is made by raising the refractive index of the two dimension optical waveguide of a portion in which the dielectric material was formed.

Although it is not illustrated in Fig. 27, it is desirable to use a material (for example, a homogeneous material which comprises as a main component at least one selected from gallium nitride, indium nitride, and aluminum nitride) of the refractive index smaller than the optical waveguide, between the substrate 14 which comprises a sintered compact which comprises aluminum nitride as a main component and the two dimension optical waveguide 50 and three dimension optical waveguide 62, in order to lower the optical transmission loss.

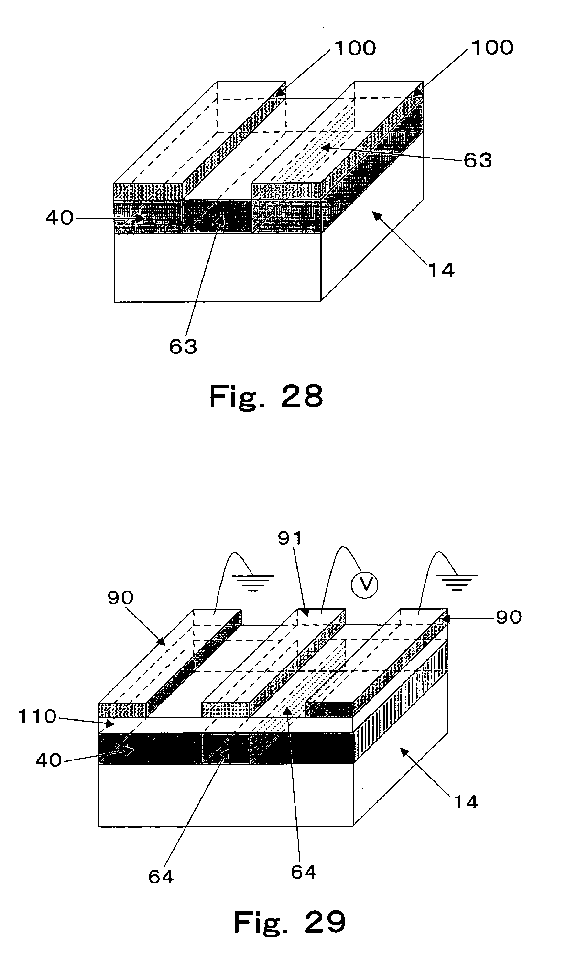

Fig. 28 is a perspective diagram showing one example of a thin-film substrate, wherein the two dimension optical waveguide 50 is produced in the substrate 14 which comprises a sintered compact which comprises aluminum nitride as a main component by forming a thin film which comprises as a main component at least one selected from gallium nitride, indium nitride, and aluminum nitride and is the shape of a plate, and the metal materials 100 are formed directly on the two dimension optical waveguide, and the three dimension optical waveguide 63 is produced by raising relatively the refractive index of the portion in which the metal is not formed by making low the refractive index of the two dimension optical waveguide of a portion in which the metal material was formed.

Although it is not illustrated in Fig. 28, it is desirable to use a material (for example, a homogeneous material which comprises as a main component at least one selected from gallium nitride, indium nitride, and aluminum nitride) of the refractive index smaller than this optical waveguide, between the substrate 14 which comprises a sintered compact which comprises aluminum nitride as a main component and the two dimension optical waveguide 50 and three dimension optical waveguide 63, in order to lower the optical transmission loss.

Fig. 29 is a perspective diagram showing one example of a thin-film substrate, wherein the two dimension optical waveguide 50 is produced in the substrate 14 which comprises a sintered compact which comprises aluminum nitride as a main component by forming a thin film which comprises as a main component at least one selected from gallium nitride, indium nitride, and aluminum nitride and is the shape of a plate, furthermore the buffer layer 110 is formed by a material (such as SiO₂, Al₂O₃, and various glass, etc., for example) of the refractive index smaller than the thin film that comprises as a main component at least one selected from gallium nitride, indium nitride, and aluminum nitride, and electrodes 90 and 91 are formed on it, and the three dimension optical waveguide 64 is formed raising the refractive index of the two dimension optical waveguide of the portion of the electrode 91 in which high potential is impressed, by impressing potential between these electrodes.

Although it is not illustrated in Fig. 29, it is desirable to use a material (for example, a homogeneous material which comprises as a main component at least one selected from gallium nitride, indium nitride, and aluminum nitride) of the refractive index smaller than the optical waveguide, between the substrate 14 which comprises a sintered compact which comprises aluminum nitride as a main component and the two dimension optical waveguide 50 and three dimension optical waveguide 64, in order to lower the optical transmission loss.

Fig. 30 is a perspective diagram showing one example of a thin-film substrate, wherein the embedded type of three dimension optical waveguide 65 is being formed in the thin film 80 which comprises as a main component at least one selected from gallium nitride, indium nitride, and aluminum nitride and is formed on the substrate 14 which comprises a sintered compact which comprises aluminum nitride as a main component.

In Fig. 30, the three dimension optical waveguide 65 is embedded in the inside of the thin film 80 with the refractive index smaller than this waveguide, and it functions as an embedded type of three dimension optical waveguide because the part touches air in the substrate surface.

In Fig. 30, the optical waveguide 65 is obtained forming a thin film in which the refractive index is larger than the thin film 80 and which comprises as a main component at least one selected from gallium nitride, indium nitride, and aluminum nitride, into the slot, after slot processing is carried out in the thin film 80 which comprises as a main component at least one selected from gallium nitride, indium nitride, aluminum nitride.

And, in Fig. 30, the embedded type of optical waveguide 65 is producible forming a portion with the refractive index larger than the thin film 80 in the inside of the thin film 80, by making at least one selected from gallium, indium, niobium, and tantalum contain in the thin film 80 which comprises as a main component at least one selected from gallium nitride, indium nitride, and aluminum nitride.

The portion in which the refractive index became large is used as an optical waveguide 65.

Methods, such as the above thermal diffusion and ion implantation, can be used as a method of making at least one selected from gallium, indium, niobium, and tantalum contain in the thin film 80 which comprises as a main component at least one selected from gallium nitride, indium nitride, and aluminum nitride.

That is, a space which arrives to the thin film surface is formed, removing the resist of only the size of the width of the optical waveguide 65 by optical lithography, after applying a resist into the thin film 80 which comprises as a main component at least one selected from gallium nitride, indium nitride, and aluminum nitride and is formed on the substrate 14 which comprises a sintered compact which comprises aluminum nitride as a main component, Only the size of the width of an optical waveguide 65 should remove a resist.

By the thermal diffusion method, an optical waveguide can be formed using the above lift-off method, for example.

That is, a space which arrives to the thin film surface is formed removing a resist of only the size of the width of the optical waveguide 65 by optical lithography, a thin film which contains component(s) of gallium, indium, niobium, or tantalum is formed through the space by methods, such as sputtering, vacuum deposition, or CVD, if the resist is removed after that, a thin film which contains component(s) of gallium, indium, niobium, or tantalum and is only the width of the optical waveguide 65 remains in the surface of the thin film 80 which comprises as a main component at least one selected from gallium nitride, indium nitride, and aluminum nitride, and component(s) of gallium, indium, niobium, or tantalum will be diffused in the thin film 80 which comprises as a main component at least one selected from gallium nitride, indium nitride, and aluminum nitride if high temperature heat-treatment is carried out in that state, and the optical waveguide 65 is formed in the state where it was embedded in the thin film 80.

In the ion implantation method, ion containing component(s) of gallium, indium, niobium, or tantalum will be implanted through the space which is formed in the resist formed by the above method, and the optical waveguide 65 is formed in the state where it was embedded in the thin film 80 by carrying out heat treatment suitably.

In addition, although it is not illustrated in Fig. 30, the optical transmission loss becomes easy to be lowered, if a homogeneous thin film which comprises as a main component at least one selected from gallium nitride, indium nitride, and aluminum nitride is formed furthermore between the substrate 14 which comprises a sintered compact which comprises aluminum nitride as a main component and the thin films 80, so it is preferred.

In Figs. 31-33, examples in which electrodes were formed on the thin-film substrate which has an optical waveguide are shown.

In addition, in Figs. 31-33, the optical waveguide is illustrated using an embedded type indicated in Fig. 30.

In this invention, an optical modulator and an optical switch, etc. are producible using the characteristic in which the refractive index of the thin film tends to change, by providing electrodes and impressing potential, as mentioned above. The thin-film substrate in which electrodes were formed and which has an optical waveguide and is illustrated in Figs. 31-33 is shown as an example of the thin-film substrate which has such function.

In the thin-film substrate which has an embedded type of optical waveguide, in the domain of an optical waveguide having many contents of gallium or indium, or in the domain of an optical waveguide containing a component of niobium or tantalum, a still bigger refractive-index change tends to be obtained by impressing the above potential.

Fig. 31 is a perspective diagram showing one example of a thin-film substrate, wherein the embedded type of three dimension optical waveguide 65 is formed in the thin film 80 which comprises as a main component at least one selected from gallium nitride, indium nitride, and aluminum nitride and is formed on the substrate 14 which comprises a sintered compact which comprises aluminum nitride as a main component, and the electrodes 120 are being formed further on the surface of the thin film 80 so that it may sandwich the optical waveguide 65.

The thin-film substrate shown in Fig. 31 can do the modulation of an optical phase, the modulation of light wavelength, and the modulation of optical amplitude, etc. by impressing potential into electrodes and changing the refractive index, and it is applicable to an optical phase modulation machine, etc.

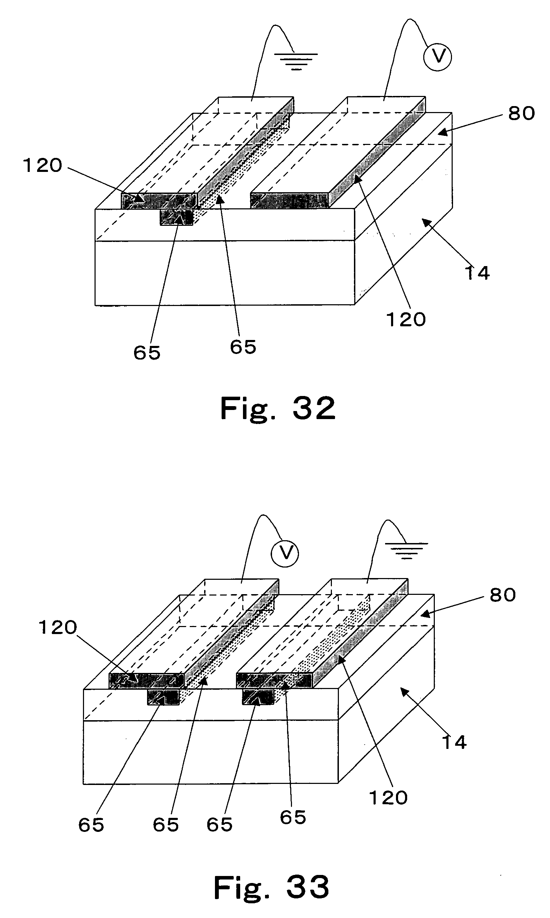

Fig. 32 is a perspective diagram showing the example of a thin-film substrate, wherein the embedded type of three dimension optical waveguide 65 is formed in the thin film 80 which comprises as a main component at least one selected from gallium nitride, indium nitride, and aluminum nitride and is formed on the substrate 14 which comprises a sintered compact which comprises aluminum nitride as a main component, and the electrodes 120 are being formed further on the thin film 80 and the optical waveguide 65.

The thin-film substrate shown in Fig. 32 can do the modulation of an optical phase, the modulation of light wavelength, and the modulation of optical amplitude, etc. by impressing potential into electrodes and changing the refractive index, and it is applicable to an optical phase modulation machine, etc.

Fig. 33 is a perspective diagram showing the example of a thin-film substrate, wherein the embedded type of three dimension optical waveguide 65 is formed in the thin film 80 which comprises as a main component at least one selected from gallium nitride, indium nitride, and aluminum nitride and is formed on the substrate 14 which comprises a sintered compact which comprises aluminum nitride as a main component, and the electrodes 120 are being formed further on the optical waveguide 65.

The thin-film substrate shown in Fig. 33 can do the modulation of an optical phase, the modulation of light wavelength, and the modulation of optical amplitude, etc. by impressing potential into electrodes and changing the refractive index, and it is applicable to an optical phase modulation machine, and an optical switch for changing a transmission line, etc.

In addition, Although any material can be used as electrodes 120 in Figs. 31-33, it is preferred to use the above thin film-conductive material of this invention, because junction reliability with a thin film which comprises as a main component at least one selected from gallium nitride, indium nitride, and aluminum nitride is high, etc.

And, although it is not shown in Figs. 31-33, it is desirable to form a buffer layer by a material (such as SiO₂, Al₂O₃, and various glass, etc., for example) of the refractive index smaller than the thin films 80 and the optical waveguide 65, between the thin film 80 and the electrodes 120, and between the optical waveguide 65 and the electrodes 120, in order to lower the transmission loss.

And, although it is not illustrated in Figs. 31-33, it is desirable to form furthermore a homogeneous thin film which comprises as a main component at least one selected from gallium nitride, indium nitride, and aluminum nitride, between the substrate 14 which comprises a sintered compact which comprises aluminum nitride as a main component and the thin films 80, because it becomes easy to lower the transmission loss.

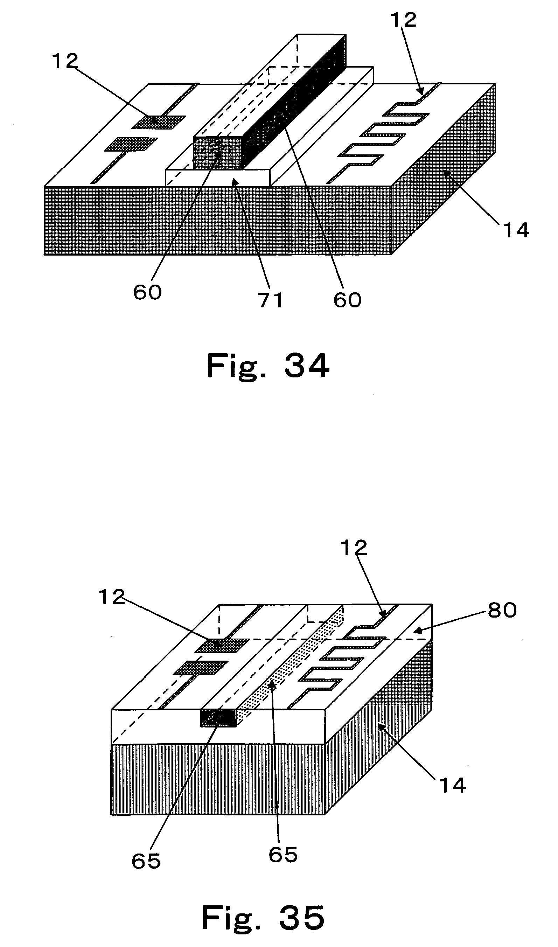

Fig. 34 and Fig. 35 show an example of the thin-film substrate in which an electric circuit was furthermore formed simultaneously in the thin-film substrate of this invention which has an optical waveguide.

The thin-film substrate illustrated in Fig. 34 and Fig. 35 can be used as an optical wiring substrate which can transmit both electricity and light.

Fig. 34 is a perspective diagram showing one example of a thin-film substrate, wherein the cladding layer 71 which comprises as a main component at least one selected from gallium nitride, indium nitride, and aluminum nitride is formed on the substrate 14 which comprises a sintered compact which comprises aluminum nitride as a main component, and the three dimension waveguide 60 is being formed on it.

The electric circuit 12 is being formed simultaneously in the portion of the sintered compact 14 which comprises aluminum nitride as a main component.

In addition, if lowering the transmission loss of light, it is preferred that the refractive index of a cladding layer is smaller than the refractive index of an optical waveguide.

Fig. 35 is a perspective diagram showing one example of a thin-film substrate, wherein the embedded type of three dimension optical waveguide 65 is being formed in the thin film 80 which comprises as a main component at least one selected from gallium nitride, indium nitride, and aluminum nitride and is formed on the substrate 14 which comprises a sintered compact which comprises aluminum nitride as a main component.

Furthermore, the electric circuit 12 is being formed simultaneously in a part of the thin film 80.

Although it is not illustrated in Fig. 35, it is desirable to form furthermore a homogeneous thin film which comprises as a main component at least one selected from gallium nitride, indium nitride, and aluminum nitride, between the substrate 14 which comprises a sintered compact which comprises aluminum nitride as a main component and the thin films 80, because it becomes easy to lower the transmission loss.

In addition, usually, light is introduced into the optical waveguide from the external side of the optical waveguide, and it is emitted from other external sides.

In Fig. 30, the guessed advance situation of an introduced light into the optical waveguide is shown by the dotted line and the arrow mark.

That is, it seems that the light 66 is horizontally introduced to the interface of the optical waveguide and thin film layer 80 from the portion of the side 65' of the optical waveguide 65 shown in Fig. 30, and that it goes on along with the optical waveguide as shown by the dotted line in the inside of the optical waveguide, and is emitted as light 66' from the side of opposite side.

Even if it is the optical waveguide produced by forming a thin film which comprises as a main component at least one selected from gallium nitride, indium nitride, and aluminum nitride directly in the substrate which comprises a sintered compact which comprises aluminum nitride as a main component, there is little transmission loss, in addition to the optical waveguide formed in the inside of a thin film which comprises as a main component at least one selected from gallium nitride, indium nitride, and aluminum nitride and is formed on the substrate which comprises a sintered compact which comprises aluminum nitride as a main component, like the optical waveguide shown in Fig. 30.

Since the direction of the light introduced is a horizontal direction to the interface, between the optical waveguide and the substrate, even if it uses the sintered compact which comprises aluminum nitride as a main component, in the interface of the sintered compact and the above thin film which comprises as a main component at least one selected from gallium nitride, indium nitride, and aluminum nitride, it is hard to produce the penetration of an introduced light by the sintered compact which comprises aluminum nitride as a main component and the absorption and scattering of light by a grain boundary phase by the crystal grain, grain boundary, or additives in the sintered compact, and it seems that that is the cause in which the transmission loss is small.

As for the action of the light introduced in such an optical waveguide, it is considered to be the same not only in the three dimension optical waveguide of this invention illustrated in Fig. 30 but also in a two dimension optical waveguide.

A thing with any size can be used as an optical waveguide of this invention, and if the width is not less than 0.5 µm and the depth (or thickness) is not less than 0.1 µm, it will function enough.

In the three dimension waveguide of this invention illustrated in Fig. 24-Fig. 35, if the width is usually not less than 1 µm and the depth (or thickness) is not less than 0.3 µm, it will function enough.

According to this invention, a light-emitting device excellent in luminous efficiency is producible using the substrate which comprises a sintered compact which comprises aluminum nitride as a main component, or using the thin-film substrate in which a thin film which comprises as a main component at least one selected from gallium nitride, indium nitride, and aluminum nitride and has various crystallization states, such as an amorphous state, a polycrystal, an orientated polycrystal, and a single crystal, etc., was formed on the substrate which comprises a sintered compact which comprises aluminum nitride as a main component.

A light-emitting device which is formed in such substrate is manufactured usually by epitaxially growing a thin film of the target composition, after once making into the gaseous phase the component which contains the target chemical component, by making it react or not react with the compound except the above suitably, by making it into gas, ion, or molecular beam by decomposing chemically physically the compound and simple substance which contain at least a part of target chemical entity, or by not decomposing in the state as it is, by the above method, such as the MOCVD method, the MOVPE method, the Hydride VPE method, the Halide VPE method containing the Chloride VPE method, the Plasma CVD method, other CVD methods (Chemical Vapor Phase Deposition), the MBE method (Molecular Beam Epitaxy), or the laser ablation method which uses the Excimer laser, etc. and uses as a raw material the solid material containing the purpose component which was formed beforehand, the PLD method (Pulse Laser Deposition: Pulse Laser Deposition), the Sputtering method, the Ion-plating method, or the Vapor-depositing method, etc., usually using as the main raw materials metal organic compounds, such as a trimethyl gallium, a trimethyl indium, and a trimethyl aluminum, etc., halogenated compounds, such as a gallium chloride, an indium chloride, and aluminium chloride, etc., and nitrogen containing compounds, such as ammonia, etc., in addition, silane compounds, such as SiH₄, etc., and organic metallic compounds, such as a dimethyl magnesium and a bis-cyclopentadienyl magnesium, etc., are used as the materials for doping elements.

Usually, the constitution of a light-emitting device is what laminated at least N type semiconductor layer, luminescence layer which comprises an quantum well structure, etc., and P type semiconductor layer, in about 0.5 nm-several µm as the thickness respectively, using the thin film of various compositions which comprises as a main component at least one selected from gallium nitride, indium nitride, and aluminum nitride and was epitaxially grown from the materials illustrated above on the substrate, and a luminescence function is generated.

The above N type semiconductor layer, luminescence layer, and P type semiconductor layer are the fundamental constituent factor in order to generate a luminescence from the luminescence layer.

This invention has the feature in the point which constituted a light-emitting device by making a laminated body by laminating at least the above N type semiconductor layer, luminescence layer, and P type semiconductor layer onto the sintered compact which comprises aluminum nitride as a main component, or onto the substrate which is made from the sintered compact.

The above N type semiconductor layer usually contains donor formation doping agents, such as Si, Ge, Se, Te, and O, etc., other than the main components.

And, the P type semiconductor layer usually contains acceptor formation doping agents, such as Mg, Be, Ca, Zn, Cd, and C, etc., other than the main components.

An epitaxially grown single-crystal thin film is usually used as the above N type semiconductor layer, luminescence layer, and P type semiconductor layer which are the fundamental constituent factor of a light-emitting device, and what is the various crystallization states, such as an amorphous state, a polycrystal, and an orientated polycrystal, etc., can also be used suitably in addition to the single crystal.

In addition, a buffer layer between the substrate and the N type semiconductor layer or P type semiconductor layer can also be used suitably as a constituent factor of a light-emitting device in addition to the above N type semiconductor layer, luminescence layer, and P type semiconductor layer, if needed.

Usually, the buffer layer is formed from a thin film which comprises as a main component at least one selected from gallium nitride, indium nitride, aluminum nitride.

Although what is various crystallization states, such as an amorphous state, a polycrystal, an orientated polycrystal, and a single crystal, etc., can be used as a thin film which constitutes the buffer layer, usually, what is at least one of the crystallization states selected from an amorphous state, a polycrystal, and an orientated polycrystal is used. And, what is an epitaxially grown single crystal can also be used.

Luminescence, such as green-blue color, blue color, purple-blue color, ultraviolet rays, or white color generated using together the phosphor which comprises YAG (yttrium aluminum garnett) as a main component, etc., for example, or the light by laser oscillation, is obtained by impressing direct-current electric power of about several mW-several W into such light-emitting device.

When producing the above light-emitting device, the thin film formation of various crystallization states, such as an amorphous state, a polycrystal, an orientated polycrystal, and a single crystal, etc., is usually performed under the substrate temperature of about 400-1300°C.

Or it is suitably performed under the comparatively low substrate temperature, such as room temperature-400°C. It may be effective to perform at low substrate temperature, when the crystal growth of a thin film formed on a substrate is controlled and the crystal direction is controlled.

In addition, in the case of the doping element for forming a P type semiconductor, such as Mg, it is preferred to perform annealing at the temperature of not less than 400°C in non-oxidizing atmosphere, such as nitrogen which does not contain hydrogen as much as possible after single-crystal thin film formation, in order to form a P type single-crystal thin film with low resistance.

This invention also contains a thing, wherein a thin film which comprises as a main component at least one selected from gallium nitride, indium nitride, and aluminum nitride and which is various crystallization state, such as an amorphous state, a polycrystal, an orientated polycrystal, and a single crystal, etc., and is formed directly on the substrate which comprises a sintered compact which comprises aluminum nitride as a main component is being formed as a part of the layer which constitutes a light-emitting device, like a P type semiconductor layer, a luminescence layer, or a N type semiconductor layer.

And, this invention also contains a light-emitting device which used the above thin film which comprises as a main component at least one selected from gallium nitride, indium nitride, and aluminum nitride and which is various crystallization states, such as an amorphous state, a polycrystal, an orientated polycrystal, and a single crystal, etc., and is formed directly on the substrate which comprises a sintered compact which comprises aluminum nitride as a main component.

In addition, in order to raise the luminous efficiency, it is preferred that each thin film layer ofN type semiconductor layer, luminescence layer, and P type semiconductor layer which constitute a light-emitting device should usually be the single-crystal thin film of high crystallinity which grew epitaxially and comprises as a main component at least one selected from gallium nitride, indium nitride, and aluminum nitride.

In this invention, in order to raise more the crystallinity of the single-crystal thin film which constitutes a light-emitting device, although it is preferred to form beforehand a thin film which comprises as a main component at least one selected from gallium nitride, indium nitride, and aluminum nitride in the substrate which comprises a sintered compact which comprises aluminum nitride as a main component before forming the single-crystal thin film, the thin film which is formed beforehand on the substrate which comprises a sintered compact which comprises aluminum nitride as a main component can use not only a single crystal but also the thing of what kind of crystallization states, such as an amorphous state, a polycrystal, and an orientated polycrystal, etc.

And, as for the above N type semiconductor layer, not only a single layer but also what is constituted with at least two thin film layers, such as the cladding layer which connects with a luminescence layer and the contact layer to connect with an electrode, is used suitably.

And, as for the above contact layer and cladding layer which constitute N type semiconductor layer, not only a single layer but also what is constituted with at least two thin film layers is also used suitably.

As for the luminescence layer, not only a single layer, such as a hetero structure, a double hetero structure, or a single quantum well structure, etc., but also what is constituted with at least two thin film layers, such as a multi-quantum-well structure, for example, is also used suitably.

And, as for the P type semiconductor layer, not only a single layer but also what is constituted with at least two thin film layers, such as the cladding layer which connects with a luminescence layer and the contact layer to connect with an electrode, is used suitably.

As for the above contact layer and cladding layer which constitute P type semiconductor layer, not only a single layer but also what is constituted with at least two thin film layers is also used suitably.

And, when forming a light-emitting device on the substrate, usually, it is preferred not to form a contact layer on the substrate immediately, but to form the contact layer which has N type semiconductor characteristic or P type semiconductor characteristic after forming a buffer layer which comprises a thin film which comprises as a main component at least one selected from gallium nitride, indium nitride, and aluminum nitride, between the substrate and the contact layer.

The thin film which forms the buffer layer can use a thing which comprises as a main component at least one selected from gallium nitride, indium nitride, and aluminum nitride and is various crystallization states, such as an amorphous state, a polycrystal, an orientated polycrystal, and a single crystal, etc., but usually a thing which is the crystallization states, such as an amorphous state, a polycrystal, and an orientated polycrystal, is used. And, it can use, even if it is the epitaxially grown single-crystal thin film with high crystallinity.

And, the buffer layer can be used also in the state where doping element(s) is not included, and it can be used suitably also in the state which has N type semiconductor characteristic or P type semiconductor characteristic by containing doping element(s).

The feature of the light-emitting device of this invention is in the point of having used the sintered compact which comprises aluminum nitride as a main component, as a substrate.

If it says in detail, there are at least two kinds of substrates as the substrate of this invention for producing a light-emitting device, that is, a thing which used the sintered compact which comprises aluminum nitride as a main component as a substrate as it is, and a thing which is made into the thin-film substrate by that in which at least one layer of thin films which comprise as a main component at least one selected from gallium nitride, indium nitride, and aluminum nitride and have at least one of the crystallization states selected from an amorphous state, a polycrystal, an orientated polycrystal, and a single crystal, etc., is formed on the substrate which was made with a sintered compact which comprises aluminum nitride as a main component.

Moreover, the thin-film substrate also includes that made into the thin-film substrate by that in which at least one layer of single-crystal thin films which comprise as a main component at least one selected from gallium nitride, indium nitride, and aluminum nitride is formed further on it, after at least one layer of thin films which comprise as a main component at least one selected from gallium nitride, indium nitride, and aluminum nitride and have at least one of the crystallization states selected from an amorphous state, a polycrystal, an orientated polycrystal, and a single crystal, etc. was formed beforehand on the substrate which comprises a sintered compact which comprises aluminum nitride as a main component.

While the luminous efficiency of a light-emitting device produced using conventional single-crystal substrates, such as sapphire, etc., is usually about 2-8 %, a thing in which the luminous efficiency of the light-emitting device of this invention which was produced using as a substrate the sintered compact which comprises aluminum nitride as a main component is at least equivalent or is a maximum of not less than 4-5 times is obtained.

That is, in the case of a light-emitting device according to this invention, a maximum of not less than 30-40 % of the impressed electric power can be emitted to the outside of a light-emitting device as optical energy.

In addition, the luminous efficiency in this invention is a percentage ratio of the electric power (electric energy) impressed to the device in order to make a light-emitting device drive and the optical output (optical energy) which was changed into light by the light-emitting device and was actually emitted to the outside of a light-emitting device, as mentioned above. For example, that the luminous efficiency is 40 % is that 720 mW is obtained as an optical output when a light-emitting device is made to drive by impressing the voltage of 3.6 V and the current of 500 mA.

Although it is not necessarily clear about the cause in which a light-emitting device produced using the substrate which comprises an aluminum nitride-based sintered compact of this invention has high luminous efficiency, it is certain that a single-crystal thin film of high crystallinity which constitutes a device and comprises as a main component at least one selected from gallium nitride, indium nitride, and aluminum nitride can be formed now in the substrate which comprises a sintered compact which comprises aluminum nitride as a main component, and that it is important for the first that a single-crystal thin film excellent in such crystallinity can be used now as at least N type semiconductor layer, luminescence layer, and P type semiconductor layer of a light-emitting device.

However, it seems that the cause in which a light-emitting device of this invention has higher luminous efficiency than what used single-crystal substrates, such as sapphire, etc., is not only that but also a big contribution of resulting from a microstructure of the sintered compact which comprises aluminum nitride as a main component and is used as a substrate.

As a result of this inventor's examination, a single-crystal thin film which comprises as a main component at least one selected from gallium nitride, indium nitride, and aluminum nitride and has the crystallinity, such that the half width of the rocking curve of the X-ray diffraction line from the lattice plane of the Miller Index (002) is at least not more than 300 seconds, can also be formed on the sapphire substrate as well as the substrate which comprises a sintered compact which comprises aluminum nitride as a main component.

Hitherto, a light-emitting device has been manufactured by forming a single-crystal thin film excellent in such crystallinity so that each layer of N type semiconductor layer, luminescence layer, and P type semiconductor layer may be constituted at least, after forming a buffer layer first on a substrate, such as sapphire, etc., if it requires.

On the other hand, as explained until now in this invention, a single-crystal thin film which comprises as a main component at least one selected from gallium nitride, indium nitride, and aluminum nitride and which is excellent in crystallinity at least equivalent to a conventional single-crystal substrate, such as sapphire, etc., or more than it can also be formed on the substrate which comprises a sintered compact which comprises aluminum nitride as a main component, the single-crystal thin film can be formed at least as N type semiconductor layer, luminescence layer, P type semiconductor layer, or buffer layer, respectively so that it may function as a light-emitting device.

In this invention, when a light-emitting device is produced with the same film constitution using a thin film which comprises as a main component at least one selected from gallium nitride, indium nitride, and aluminum nitride, if the case where a conventional sapphire, etc. is used as a substrate is compared with the case where a sintered compact which comprises aluminum nitride as a main component is used, the luminous efficiency is at least equivalent or is as high as a maximum of not less than 4 times-5 times compared with the case where a conventional sapphire is used as a substrate, when the substrate which comprises a sintered compact which comprises as a main component aluminum nitride is used.

Speaking concretely, using as a substrate the conventional sapphire and the sintered compact which comprises aluminum nitride as a main component, when a light-emitting device which has N type semiconductor layer, luminescence layer, P type semiconductor layer, or buffer layer if needed and is the same constitution is produced in these substrates by a thin film which comprises as a main component at least one selected from gallium nitride, indium nitride, and aluminum nitride, the luminous efficiency of the light-emitting device produced using the substrate comprising a sintered compact which comprises as a main component aluminum nitride is at least equivalent or is as high as a maximum of not less than 4-5 times compared with the case where a conventional sapphire is used as a substrate, even if a thin film which constitutes at least the N type semiconductor layer, luminescence layer, and P type semiconductor layer among these thin film layers which constitute a light-emitting device is the single crystal which has the same crystallinity of 150 seconds, for example, as the half width of the rocking curve of the X ray diffraction from the lattice plane of the Miller Index (002).

Therefore, although it is important conditions for the first that the single-crystal thin film excellent in crystallinity can be formed on the substrate which comprises a sintered compact which comprises aluminum nitride as a main component when producing a light-emitting device with high luminous efficiency, as mentioned above, it seems only for the reason that the luminous efficiency of a light-emitting device produced using the substrate which comprises a sintered compact which comprises aluminum nitride as a main component does not become equivalent to conventional substrates, such as sapphire, etc., at least, or does not become still higher than those.

Other than the original characteristic, such as the optical absorption end being near the wavelength of 200 nm or the refractive index being close to gallium nitride, since a sintered compact which comprises aluminum nitride as a main component has a microstructure which is being constituted by firing and solidifying the crystal grain or grain boundary phase which comprises aluminum nitride as a main component, it seems that it is hard to produce a reflection of light in the interface of a sintered compact and a thin film, or in the interface of a sintered compact and a outside space, unlike a transparent body like sapphire.

That is, since it is hard to produce such reflection of light, it seems that among the light emitted from a light-emitting device what was irradiated directly into the interface of the above sintered compact and thin film, or the light which was irradiated into the above interface by being reflected from the thin film surface which is directly in contact with an outside space not being in the substrate side among the thin films which constitute a light-emitting device, trespasses almost into the inside of a sintered compact which comprises aluminum nitride as a main component without being reflected, and the light which reached to the interface of the outside space and the sintered compact which comprises aluminum nitride as a main component is emitted to the outside of a device.

When the optical permeability is compared between the sapphire substrate and the substrate which comprises a sintered compact which comprises aluminum nitride as a main component, in the case of the substrate which comprises a sintered compact which comprises aluminum nitride as a main component, the permeability is shown to the light up to the wavelength of 210-220 nm in a thing excelled most, and it shows the optical transmissivity not less than 80 % in the light with 330 nm wavelength, on the other hand in the case of a sapphire substrate, it is usually transparent to the ultraviolet area near the wavelength of 150 nm, the optical transmissivity is also 80 %-90 % in the range of 200 nm-4500 nm wavelength, and it is easy to penetrate light linearly because it is a transparent body, so the sapphire substrate seems to excel the substrate which comprises a sintered compact which comprises aluminum nitride as a main component, in the aspect of optical permeability.

Therefore, if it sees from the aspect of optical permeability, it will seem that more light which is emitted from the luminescence layer of a light-emitting device is emitted to the outside of a device than the substrate which comprises a sintered compact which comprises aluminum nitride as a main component if a sapphire substrate is used, but it is the contrary in practice.

And, since the luminous efficiency of a light-emitting device which is formed on the substrate was equivalent or more to a sapphire substrate even when what does not have optical permeability among the sintered compacts which comprise aluminum nitride as a main component is used as a substrate, it seems that the light which was emitted from the luminescence layer of a light-emitting device is probably reflected in the interface of the sapphire substrate and the thin film, or in the interface of the sapphire substrate and the outside space, and that it is hard to penetrate a sapphire substrate.

If saying in other words, when a sapphire substrate is used, it seems that the light which was emitted from the luminescence layer of a light-emitting device is probably reflected in each above interface and is returned to the inside of a device, and that it is hard to be emitted to the outside of a device by penetrating a sapphire substrate.

And, as for the light which was irradiated in each above interface by reflecting from the thin film surface which is directly in contact with an outside space, not from the sapphire substrate side in the thin films which constitute a light-emitting device among the light emitted from a light-emitting device, almost all is also reflected and reaches again to the thin film surface which is directly in contact with an outside space, and the repetition of being reflected in the thin film surface again arises, it is conjectured that as the result, a light emitted to the outside from the thin filmsurface also tends to decrease than the case where the sintered compact which comprises aluminum nitride as a main component and which does not have optical permeability is used as a substrate.

The sizes of the outside of a light-emitting device are about 0.05-10 mm square, usually are about 0.1-3 mm square, and as for the thickness of a thin film layer which constitutes a light-emitting device, it is about 0.5-50 µm, usually about 1-20 µm, when totaled.

And, since it seems that the luminescence layer of a light-emitting device is the shape of a plane, and that the light emitted from the luminescence layer is irradiated to the substrate surface which faces each other perpendicularly in distance of about 0.5-50 µm, it seems that it is originally hard to produce phenomena, such as total reflection, in the interface of the substrate and the thin film which constitutes a light-emitting device, but it seems that in the case of a sapphire substrate, the refractive index is 1.76-1.78 in 605 nm wavelength and is low compared with gallium nitride, indium nitride, and aluminum nitride which constitute a thin film, furthermore because it is a single crystal, there are not a grain boundary and a grain boundary phase and it is homogeneous, and the high smooth nature of the substrate surface becomes a cause, so it seems that it becomes easy to produce a reflection in the above interface.

Since the luminous efficiency of a light-emitting device which is formed on the substrate is equivalent to what used the sapphire substrate or is more excellent, even when what does not have optical permeability is used as a substrate among the sintered compacts which comprise aluminum nitride as a main component, as mentioned above, it was conjectured that it is the cause of lowering the luminous efficiency like it has been said hitherto that much dislocation or distortion by the lattice mismatching or difference of thermal expansion coefficient exists in the thin film in the case of the sapphire substrate.

On the other hand, when the sintered compact which comprises aluminum nitride as a main component is used as a substrate, the refractive index of aluminum nitride is 2.00-2.25 in the wavelength of 650 nm and is comparatively close to gallium nitride and indium nitride which constitute a light-emitting device other than aluminum nitride, it is not homogeneous because a crystal grain which comprises aluminum nitride as a main component, a grain boundary, or a grain boundary phase by an additive, etc. in the sintered compact which comprises aluminum nitride as a main component exists in the interface with the thin film which constitutes a light-emitting device, and the smooth nature of the surface of a substrate is also usually small compared with sapphire, so it is conjectured that it is a big cause of the improvement in luminous efficiency that it is still harder to produce the reflection of light emitted from the luminescence layer and that many of light emitted from the luminescence layer can advance into the sintered compact which comprises as a main component aluminum nitride.

And, in the sintered compact which comprises aluminum nitride as a main component, since what has comparatively high optical transmissivity not less than 80 % can be manufactured even if linear optical permeability is low unlike a transparent body, much light which was emitted from the luminescence layer of a light-emitting device and was entered into the such sintered compact which comprises aluminum nitride as a main component penetrates the sintered compact which comprises aluminum nitride as a main component, and is emitted to the outside of a light-emitting device, and it is surmised that that is also the cause in which the luminous efficiency became extremely high compared with the sapphire substrate.

And, as mentioned above, the sizes of the outside of a light-emitting device are about 0.05-10 mm square, usually are about 0.1-3 mm square, and as for the thickness of a thin film layer which constitutes a light-emitting device, it is about 0.5-50 µm, usually about 1-20 µm, when totaled.

Since it seems that the luminescence layer formed in a light-emitting device is the shape of a plane, and that the light emitted from the luminescence layer is irradiated to the substrate surface which faces each other perpendicularly in distance of about 0.5 µm-50 µm, it is originally the structure in which phenomena, such as total reflection, cannot be produced easily in the interface of a substrate and a thin film which constitutes a light-emitting device, and it also seems that that is a big factor in which a sintered compact which comprises aluminum nitride as a main component functions more effectively as a substrate.

Furthermore, since the thermal conductivity of the substrate which used a sintered compact which comprises aluminum nitride as a main component is as large as 5 times to 10 times compared with a sapphire substrate, it will be promptly emitted to the outside of a light-emitting device even if a part of light is confined in the inside of a device and changes to thermal energy, so the temperature raising of a device will be controlled and there is no decline of the luminous efficiency by the temperature raising of a device, and it also seems that that is one of the factors.

In this invention, as for the sintered compact which comprises aluminum nitride as a main component and is used as a substrate for producing the above light-emitting device, anything can be used if a thin film in which at least N type semiconductor layer, a luminescence layer, and P type semiconductor layer which are the constituent factor of a light-emitting device is formed and which comprises as a main component at least one selected from gallium nitride, indium nitride, and aluminum nitride can be formed as a epitaxially grown single crystal.

If saying in other words, if it is the thing in which an epitaxially grown single-crystal thin film which comprises as amain component at least one selected from gallium nitride, indium nitride, and aluminum nitride can be formed by the method described below, no matter it may be what sintered compact which comprises aluminum nitride as a main component, it can use as a substrate for producing a light-emitting device.

That is,
1) it is the method of producing a light-emitting device, wherein an epitaxially grown single-crystal thin film which comprises as a main component at least one selected from gallium nitride, indium nitride, and aluminum nitride and constitutes a light-emitting device is laminated as N type semiconductor layer, luminescence layer, and P type semiconductor layer directly on it, using as a substrate the sintered compact which comprises aluminum nitride as a main component as it is.
   In this method, it is desirable that a buffer layer which comprises a thin film which comprises as a main component at least one selected from gallium nitride, indium nitride, and aluminum nitride is first formed on a substrate, if it requires, and that a light-emitting device is produced laminating N type semiconductor layer, luminescence layer, and P type semiconductor layer onto it.
2) it is the method of producing a light-emitting device, wherein an epitaxially grown single-crystal thin film which comprises as a main component at least one selected from gallium nitride, indium nitride, and aluminum nitride and constitutes a light-emitting device is laminated as N type semiconductor layer, luminescence layer, and P type semiconductor layer onto it, after making a thin-film substrate by that in which at least one layer of thin films which comprise as a main component at least one selected from gallium nitride, indium nitride, and aluminum nitride and have at least one of the crystallization states selected from an amorphous state, a polycrystal, an orientated polycrystal, and a single crystal, etc., is formed beforehand on the substrate produced from the sintered compact which comprises aluminum nitride as a main component.
   When producing a light-emitting device using the above thin-film substrate, it is also possible to use at least a part of the thin film layer which is being formed on the thin-film substrate as a constituent factor for a light-emitting device to function.
   In this method, it is desirable that a buffer layer which comprises a thin film which comprises as a main component at least one selected from gallium nitride, indium nitride, and aluminum nitride is first formed on a thin-film substrate, if it requires, and that a light-emitting device is produced laminating N type semiconductor layer, luminescence layer, and P type semiconductor layer onto it.
3) it is the method of producing a light-emitting device, wherein an epitaxially grown single-crystal thin film which comprises as a main component at least one selected from gallium nitride, indium nitride, and aluminum nitride and constitutes a light-emitting device is laminated as N type semiconductor layer, luminescence layer, and P type semiconductor layer onto it, after making a thin-film substrate by that in which at least one layer of single-crystal thin films which comprise as a main component at least one selected from gallium nitride, indium nitride, and aluminum nitride is formed furthermore on that in which at least one layer of thin films which comprise as a main component at least one selected from gallium nitride, indium nitride, and aluminum nitride and have at least one of the crystallization states selected from an amorphous state, a polycrystal, an orientated polycrystal, and a single crystal, etc., is formed beforehand on the substrate produced from the sintered compact which comprises aluminum nitride as a main component.

When producing a light-emitting device using the above thin-film substrate, it is also possible to use at least a part of the thin film layer which is being formed on the thin-film substrate as a constituent factor for a light-emitting device to function.

In this method, it is desirable that a buffer layer which comprises a thin film which comprises as a main component at least one selected from gallium nitride, indium nitride, and aluminum nitride is first formed on a thin-film substrate, if it requires, and that a light-emitting device is produced laminating N type semiconductor layer, luminescence layer, and P type semiconductor layer onto it.

Among the method shown in the above 1)-3), when a thing in which a thin film which comprises as a main component at least one selected from gallium nitride, indium nitride, and aluminum nitride and has at least one of the crystallization states selected from an amorphous state, a polycrystal, an orientated polycrystal, and a single crystal, etc. is formed beforehand on the substrate which is made from the sintered compact which comprises aluminum nitride as a main component and is shown in 2)-3) is used as a substrate for thin film production, it is desirable in order to produce a light-emitting device excellent in luminous efficiency.

Usually, a light-emitting device with the luminous efficiency not less than 10 % is producible using such thin-film substrate.

Moreover, if a thin film which is formed on a substrate and comprises as a main component at least one selected from gallium nitride, indium nitride, and aluminum nitride is made into at least two layers, and a substrate in which the surface one among the thin films of two or more layers is a single crystal is used, a light-emitting device excellent in luminous efficiency can be produced easily on it regardless of the crystal state of a thin film formed beforehand on a substrate, so it is desirable.

That is, when using as a substrate a sintered compact which comprises aluminum nitride as a main component, if using the substrate wherein at least one layer of thin films which comprise as a main component at least one selected from gallium nitride, indium nitride, and aluminum nitride and have at least one of the crystallization states selected from an amorphous state, a polycrystal, an orientated polycrystal, and a single crystal, etc. is formed beforehand on it, and at least one layer of single-crystal thin films which comprise as a main component at least one selected from gallium nitride, indium nitride, and aluminum nitride is formed furthermore on it, a light-emitting device of luminous efficiency not less than 12 % can be produced easily on it.

Especially, when producing what has luminous efficiency not less than 15 % as a light-emitting device, or when producing a laser diode as a light-emitting device, it is effective to use such thin-film substrate in which a single-crystal thin film was formed in the surface.

When producing a light-emitting device using the above thin-film substrate, it is also possible to use at least a part of the thin film layer currently formed on the thin-film substrate as a constituent factor for a light-emitting device to function.

In this method, it is desirable to produce a light-emitting device by first forming a buffer layer which comprises a thin film which comprises as a main component at least one selected from gallium nitride, indium nitride, and aluminum nitride onto the thin-film substrate, if it requires, and by laminating N type semiconductor layer, luminescence layer, and P type semiconductor layer onto it.

When producing a light-emitting device using a thin-film substrate of this invention, it is also possible to produce a light-emitting device, without providing especially the above buffer layer.

In this invention, as for the quality, such as the crystallinity of a thin film formed on the substrate which used a sintered compact which has such characteristics and comprises aluminum nitride as a main component, the relation with the composition, purity, content of an aluminum nitride component, optical permeability, size of a sintered compact crystal grain, and existence of a conduction via, etc. in the sintered compact which comprises aluminum nitride as a main component, or the relation with the surface smooth nature and thickness of a substrate, etc. when using as a substrate the sintered compact which comprises aluminum nitride as a main component, or the relation with the thin film constitution and thin film thickness, etc. which are formed on the substrate which comprises the sintered compact which comprises aluminum nitride as a main component, has been explained until now.

In this invention, if the sintered compact which comprises as a main component aluminum nitride is what can form a single-crystal thin film which comprises as a main component at least one selected from gallium nitride, indium nitride, and aluminum nitride, even if it is what has what kind of composition, a light-emitting device which has excellent luminous efficiency is producible using as a substrate the sintered compact which comprises aluminum nitride as a main component.

Usually, a light-emitting device which has equivalent luminous efficiency at least or has been improved to a maximum of not less than 4-5 times can be provided compared with the luminous efficiency of the light-emitting device produced using the conventional substrates, such as a sapphire, etc.

Usually, it is preferred to use as a substrate the sintered compact which contains an aluminum nitride component not less than 20 volume % at least and comprises aluminum nitride as a main component, a light-emitting device which is at least equivalent or has been improved to a maximum of not less than 4-5 times is producible compared with the luminous efficiency of the light-emitting device produced using conventional substrates, such as a sapphire, etc.

If it says in more detail,
1) in the case of the method of producing a light-emitting device, wherein a buffer layer which comprises a thin film which comprises as a main component at least one selected from gallium nitride, indium nitride, and aluminum nitride is first formed on it, if it requires, using the sintered compact which comprises aluminum nitride as a main component as a substrate as it is, and an epitaxially grown single-crystal thin film which comprises as a main component at least one selected from gallium nitride, indium nitride, and aluminum nitride is laminated on it as N type semiconductor layer, luminescence layer, and P type semiconductor layer, it is usually preferred to use a sintered compact which comprises aluminum nitride as a main component and contains an aluminum nitride component not less than 50 volume %, and a light-emitting device in which the luminous efficiency is not less than 10 % at least can be produced.
   Even when producing a light-emitting device by the method explained in the following 2)-3), a light-emitting device in which the luminous efficiency is at least not less than 10 % is producible,
2) the method of producing a light-emitting device, wherein the sintered compact which comprises aluminum nitride as a main component is made as a substrate, a thin-film substrate is made by that in which at least one layer of thin films which comprise as a main component at least one selected from gallium nitride, indium nitride, and aluminum nitride and have at least one of the crystallization states selected from an amorphous state, a polycrystal, an orientated polycrystal, and a single crystal, etc. is formed beforehand on it, a buffer layer which comprises a thin film which comprises as a main component at least one selected from gallium nitride, indium nitride, and aluminum nitride is first formed on it, if it requires, and an epitaxially grown single-crystal thin film which comprises as a main component at least one selected from gallium nitride, indium nitride, and aluminum nitride is laminated on it as N type semiconductor layer, luminescence layer, and P type semiconductor layer, and
3) the method of producing a light-emitting device, wherein the sintered compact which comprises aluminum nitride as a main component is made as a substrate, at least one layer of thin films which comprise as a main component at least one selected from gallium nitride, indium nitride, and aluminum nitride and have at least one of the crystallization states selected from an amorphous state, a polycrystal, an orientated polycrystal, and a single crystal, etc. is formed beforehand on it, a thin-film substrate is made by that in which at least one layer of single-crystal thin films which comprise as a main component at least one selected from gallium nitride, indium nitride, and aluminum nitride is formed furthermore on it, a buffer layer which comprises a thin film which comprises as a main component at least one selected from gallium nitride, indium nitride, and aluminum nitride is first formed on it, if it requires, and an epitaxially grown single-crystal thin film which comprises as amain component at least one selected from gallium nitride, indium nitride, and aluminum nitride is laminated on it as N type semiconductor layer, luminescence layer, and P type semiconductor layer.

In the method shown in the above 1)-3), usually, it is preferred to use as a substrate the sintered compact which comprises aluminum nitride as a main component and contains an aluminum nitride component not less than 20 volume %, and a light-emitting device in which the luminous efficiency is at least not less than 10 % is producible.

When using as a substrate the sintered compact which comprises aluminum nitride as a main component and contains an aluminum nitride component not less than 20 volume %, usually, it is preferred to use the substrate in which a thin film which comprises as a main component at least one selected from gallium nitride, indium nitride, and aluminum nitride and has at least one of the crystallization states selected from an amorphous state, a polycrystal, and an orientated polycrystal was formed beforehand on the substrate.

When using as a substrate the sintered compact which comprises aluminum nitride as a main component and contains an aluminum nitride component not less than 20 volume %, a light-emitting device in which the luminous efficiency is at least not less than 12 % is producible on it if the thin film which is formed beforehand on the substrate and comprises as a main component at least one selected from gallium nitride, indium nitride, and aluminum nitride has the crystallization state of an orientated polycrystal.

When using as a substrate the sintered compact which comprises aluminum nitride as a main component and contains an aluminum nitride component not less than 20 volume %, a light-emitting device in which the luminous efficiency is at least not less than 12 % is producible on it regardless of the crystallization states of the thin film formed beforehand on a substrate, if at least two layers of thin films which comprise as a main component at least one selected from gallium nitride, indium nitride, and aluminum nitride are formed, and the surface one is a single crystal among the thin film of two or more layers.

That is, when using as a substrate the sintered compact which comprises aluminum nitride as a main component and contains an aluminum nitride component not less than 20 volume %, a light-emitting device in which the luminous efficiency is at least not less than 12 % is producible on it, if at least one layer of thin films which have at least one of the crystallization states selected from an amorphous state, a polycrystal, and an orientated polycrystal and which comprise as a main component at least one selected from gallium nitride, indium nitride, and aluminum nitride is formed beforehand on it, and a thin-film substrate in which at least one layer of single-crystal thin films which comprise as a main component at least one selected from gallium nitride, indium nitride, and aluminum nitride is formed furthermore on it is used.

Moreover, although it can be used as a substrate for light-emitting device production as it is when using as a substrate the sintered compact which comprises aluminum nitride as a main component and contains an aluminum nitride component not less than 50 volume %, usually, it is preferred to use a thing in which a thin film which comprises as a main component at least one selected from gallium nitride, indium nitride, and aluminum nitride and has at least one of the crystallization states selected from a single crystal, an amorphous state, a polycrystal, and an orientated polycrystal was formed beforehand on the substrate.

When using as a substrate the sintered compact which comprises aluminum nitride as a main component and contains an aluminum nitride component not less than 50 volume %, a light-emitting device in which the luminous efficiency is at least not less than 12 % is producible on it, if a thin film which comprises as a main component at least one selected from gallium nitride, indium nitride, and aluminum nitride is what has at least one of the crystallization states selected from an amorphous state, a polycrystal, and an orientated polycrystal.

When using as a substrate the sintered compact which comprises aluminum nitride as a main component and contains an aluminum nitride component not less than 50 volume %, a light-emitting device in which the luminous efficiency is at least not less than 15 % is producible on it, if a thin film which comprises as a main component at least one selected from gallium nitride, indium nitride, and aluminum nitride is what has the crystallization state of an orientated polycrystal When using as a substrate the sintered compact which comprises aluminum nitride as a main component and contains an aluminum nitride component not less than 50 volume %, a light-emitting device in which the luminous efficiency is at least not less than 15 % is producible on it regardless of the crystallization states of the thin film formed beforehand on a substrate, if at least two layers of thin films which comprise as a main component at least one selected from gallium nitride, indium nitride, and aluminum nitride are formed, and the surface one is a single crystal among the thin film of two or more layers.

That is, when using as a substrate the sintered compact which comprises aluminum nitride as a main component and contains an aluminum nitride component not less than 50 volume %, a light-emitting device in which the luminous efficiency is at least not less than 15 % is producible on it, if at least one layer of thin films which comprise as a main component at least one selected from gallium nitride, indium nitride, and aluminum nitride and have at least one of the crystallization states selected from an amorphous state, a polycrystal, an orientated polycrystal, and a single crystal, etc. is formed beforehand on it, and a substrate in which at least one layer of single-crystal thin films which comprise as a main component at least one selected from gallium nitride, indium nitride, and aluminum nitride is formed furthermore on it is used.

Especially, when producing a thing in which the luminous efficiency is at least not less than 20 % as a light-emitting device, or when producing a laser diode as a light-emitting device, it is effective to use such substrate in which a single-crystal thin film was formed in the surface.

In this invention, a light-emitting device which has excellent luminous efficiency is also producible even if the sintered compact which comprises aluminum nitride as a main component and is the optical transmissivity smaller than 1 % or does not have optical permeability substantially is used as a substrate.

And, a light-emitting device which has excellent luminous efficiency is also producible even if the sintered compact which comprises aluminum nitride as a main component and which has optical permeability whose optical transmissivity is not less than 1 % is used as a substrate.

Usually, by using as a substrate the above sintered compact which comprises aluminum nitride as a main component, a light-emitting device which is at least equivalent or has been improved to a maximum of not less than 4-5 times can be provided compared with the luminous efficiency of the light-emitting device produced using conventional substrates, such as a sapphire, etc.

If it says in more detail, if the sintered compact which comprises aluminum nitride as a main component and which has the optical transmissivity smaller than 1 % or does not have optical permeability substantially, or the sintered compact which comprises aluminum nitride as a main component and has the optical transmissivity not less than 1 %, are used as a substrate, a light-emitting device in which the luminous efficiency is at least not less than 10 % is producible.

Usually, as for the sintered compact which comprises aluminum nitride as a main component, if what has higher optical permeability is used as a substrate, a light-emitting device with higher luminous efficiency is producible, so it is desirable.

That is, when the sintered compact which comprises aluminum nitride as a main component and is the optical transmissivity not less than 10 % is used as a substrate, a thing in which the luminous efficiency of a light-emitting device formed on it is not less than 12 % is easy to be obtained, so it is preferred.

When the sintered compact which comprises aluminum nitride as a main component and is the optical transmissivity not less than 20 % is used as a substrate, a thing in which the luminous efficiency of a light-emitting device formed on it is not less than 15 % is easy to be obtained. When the sintered compact which comprises aluminum nitride as a main component and is the optical transmissivity not less than 30 % is used as a substrate, a thing in which the luminous efficiency of a light-emitting device formed on it is not less than 20 % is easy to be obtained.

When the sintered compact which comprises aluminum nitride as a main component and is the optical transmissivity not less than 40 % is used as a substrate, a thing in which the luminous efficiency of a light-emitting device formed on it is not less than 25 % is easy to be obtained.

When the sintered compact which comprises aluminum nitride as a main component and is the optical transmissivity not less than 50 % is used as a substrate, a thing in which the luminous efficiency of a light-emitting device formed on it is not less than 30 % is easy to be obtained.

In this invention, what is the optical transmissivity not less than 60 % is obtained, and furthermore what is a maximum of not less than 80 % is also obtained, as mentioned above, when the sintered compact which comprises aluminum nitride as a main component and has such high optical transmissivity is used as a substrate, a thing in which the luminous efficiency of a light-emitting device formed on it is not less than 40 %, and a maximum of 62 %, was easy to be obtained.

Thus, since a thing in which the luminous efficiency of a light-emitting device produced using as a substrate the sintered compact which comprises as a main component aluminum nitride is at least not less than 10 % is easy to be obtained, a light-emitting device which is at least equivalent or has been improved to a maximum of not less than 4-5 times if compared with the luminous efficiency of a light-emitting device produced using conventional substrates, such as a sapphire, etc., can be provided.

In this invention, if the sintered compact which comprises as a main component aluminum nitride is what can form a single-crystal thin film which comprises as a main component at least one selected from gallium nitride, indium nitride, and aluminum nitride, even if the aluminum nitride crystal grain in the sintered compact is a thing of what kind of size, a light-emitting device which has excellent luminous efficiency is producible using as a substrate the sintered compact which comprises aluminum nitride as a main component.

Usually, a light-emitting device in which the luminous efficiency is at least equivalent or has been improved to a maximum of not less than 4-5 times if compared with the luminous efficiency of a light-emitting device produced using conventional substrates, such as a sapphire, etc., can be provided.

Usually, it is preferred to use as a substrate the sintered compact which comprises aluminum nitride as a main component and has the aluminum nitride crystal grain whose size is an average of not less than 0.5 µm, and a light-emitting device which is at least equivalent or has been improved to a maximum of not less than 4-5 times if compared with the luminous efficiency of a light-emitting device produced using conventional substrates, such as a sapphire, etc., is producible.

If saying in more detail, if the sintered compact which comprises aluminum nitride as a main component and has the aluminum nitride crystal grain whose size is an average of not less than 1.0 µm is used as a substrate, a light-emitting device in which the luminous efficiency is at least not less than 10 % is producible.

Even if not only what is in the state where the crystal grain contained has gathered in the nearly equal size but also the sintered compact which comprises aluminum nitride as a main component and which has the irregular size of a crystal grain or contains the crystal grain in which the form is distorted and the crystal grain of the form wherein one side is small and one side is large, such as the needle-like or board-like form wherein one side is several µm and the other side grew up into about 10 µm or more greatly, for example, such as a poly type AlN particle, etc., is used as a substrate, a light-emitting device excellent in luminous efficiency is producible satisfactorily at all.

In addition, even if what formed a conduction via in the sintered compact which comprises aluminum nitride as a main component is used as a substrate, a single-crystal thin film which comprises as a main component at least one selected from gallium nitride, indium nitride, and aluminum nitride can be formed, and a light-emitting device which has excellent luminous efficiency is producible.

It is possible to use anything, if it is a material which has conductivity as a conduction via.

Usually, as the material of a conduction via, a material which comprises as a main component a metal, an alloy, or a metal compound, such as tungsten, molybdenum, gold, silver, copper, and titanium nitride, etc., is used.

If the sintered compact which comprises aluminum nitride as a main component and formed a conduction via which comprises such material is used as a substrate, a light-emitting device which has the luminous efficiency which is equivalent at least or has been improved to a maximum of not less than 4-5 times if compared with the luminous efficiency of a light-emitting device produced using conventional substrates, such as a sapphire, etc., can be provided.

If it says in more detail, a light-emitting device in which the luminous efficiency is at least not less than 10 % is producible using as a substrate what formed a conduction via in the sintered compact which comprises aluminum nitride as a main component.

As mentioned above, it explained that it is effective to use the sintered compact which comprises aluminum nitride as a main component as a substrate for making a light-emitting device, and that especially if it is what has optical permeability, a light-emitting device more excellent in luminous efficiency is producible.

In addition, in this invention, even if it is the thing of what kind of state as the surface smooth nature of the substrate which comprises a sintered compact which comprises aluminum nitride as a main component, if it is what can form a single-crystal thin film which comprises as a main component at least one selected from gallium nitride, indium nitride, and aluminum nitride, what has excellent luminous efficiency is producible, as the light-emitting device which is formed on the substrate which comprises a sintered compact which comprises aluminum nitride as a main component.

Usually, as for the luminous efficiency of a light-emitting device produced using the substrate which comprises a sintered compact which has the above surface smooth nature and comprises aluminum nitride as a main component, a thing which is at least equivalent or has been improved to a maximum of not less than 4-5 times if compared with the luminous efficiency of a light-emitting device produced using conventional substrates, such as a sapphire, etc., can be provided.

If it says in more detail,
1) in the case of the method of producing a light-emitting device, wherein the sintered compact which comprises aluminum nitride as a main component is used as a substrate as it is, a buffer layer which comprises a thin film which comprises as a main component at least one selected from gallium nitride, indium nitride, and aluminum nitride is first formed on it, if it requires, and an epitaxially grown single-crystal thin film which comprises as a main component at least one selected from gallium nitride, indium nitride, and aluminum nitride is laminated on it as N type semiconductor layer, luminescence layer, and P type semiconductor layer, usually, a light-emitting device in which the luminous efficiency is at least not less than 10 % is producible using what is not more than 2000 nm as the average surface roughness Ra of the substrate which comprises a sintered compact which comprises aluminum nitride as a main component.
   When producing a light-emitting device by the method explained in the following 2)-3), a light-emitting device in which the luminous efficiency is at least not less than 10 % is producible, even if a thing in which the average surface roughness Ra of the substrate which comprises a sintered compact which comprises aluminum nitride as a main component is larger than 2000 nm is used,
2) the method of producing a light-emitting device, wherein the sintered compact which comprises aluminum nitride as a main component is made as a substrate, a thin-film substrate is made by that in which at least one layer of thin films which comprise as a main component at least one selected from gallium nitride, indium nitride, and aluminum nitride and have at least one of the crystallization states selected from an amorphous state, a polycrystal, an orientated polycrystal, and a single crystal, etc. is formed beforehand on it, a buffer layer which comprises a thin film which comprises as a main component at least one selected from gallium nitride, indium nitride, and aluminum nitride is first formed on it, if it requires, and an epitaxially grown single-crystal thin film which comprises as a main component at least one selected from gallium nitride, indium nitride, and aluminum nitride is laminated on it as N type semiconductor layer, luminescence layer, and P type semiconductor layer, and,
3) the method of producing a light-emitting device, wherein the sintered compact which comprises aluminum nitride as a main component is made as a substrate, at least one layer of thin films which comprise as a main component at least one selected from gallium nitride, indium nitride, and aluminum nitride and have at least one of the crystallization states selected from an amorphous state, a polycrystal, an orientated polycrystal, and a single crystal, etc. is formed beforehand on it, a thin-film substrate is made by that in which at least one layer of single-crystal thin films which comprise as a main component at least one selected from gallium nitride, indium nitride, and aluminum nitride is formed further on it, a buffer layer which comprises a thin film which comprises as a main component at least one selected from gallium nitride, indium nitride, and aluminum nitride is first formed on the thin-film substrate, if it requires, and an epitaxially grown single-crystal thin film which comprises as a main component at least one selected from gallium nitride, indium nitride, and aluminum nitrideis laminated on it as N type semiconductor layer, luminescence layer, and P type semiconductor layer.

In this invention, even if the thickness of the substrate which comprises a sintered compact which comprises aluminum nitride as a main component is what kind of thing, if it is what can form a single-crystal thin film which comprises as a main component at least one selected from gallium nitride, indium nitride, and aluminum nitride, what has excellent luminous efficiency is producible, as the light-emitting device which is formed on the substrate which comprises a sintered compact which comprises aluminum nitride as a main component.

Usually, as for the luminous efficiency of the light-emitting device produced using the substrate which comprises a sintered compact which has the above thickness of a substrate and comprises aluminum nitride as a main component, a thing which is at least equivalent or has been improved to a maximum of not less than 4-5 times if compared with the luminous efficiency of the light-emitting device produced using conventional substrates, such as a sapphire, etc., can be provided.

Usually, a light-emitting device in which the luminous efficiency is at least not less than 10 % is producible using the thing in which the thickness of the substrate which comprises a sintered compact which comprises aluminum nitride as a main component is not more than 8.0 mm.

As mentioned above, as the substrate for producing a light-emitting device, it is effective to use the sintered compact which comprises aluminum nitride as a main component, and the effect of the purity (composition), optical transmissivity, sintered compact crystal grain, existence of a conduction via, surface smooth nature as a substrate, and thickness as a substrate, etc. has been explained about the sintered compact which comprises aluminum nitride as a main component.

It has explained above, when producing a light-emitting device by the method which is explained in the following a) and b), if the thin film which comprises as a main component at least one selected from gallium nitride, indium nitride, and aluminum nitride and is formed beforehand on the substrate which comprises a sintered compact which comprises aluminum nitride as a main component is the thing which has at least one of the crystallization states selected from a single crystal, an amorphous state, a polycrystal, and an orientated polycrystal, a light-emitting device in which the luminous efficiency is not less than 10 % is usually producible on it, unless reference is made especially;
a) the method of producing a light-emitting device, wherein the sintered compact which comprises aluminum nitride as a main component is made as a substrate, a thin-film substrate is made by that in which at least one layer of thin films which comprise as a main component at least one selected from gallium nitride, indium nitride, and aluminum nitride and have at least one of the crystallization states selected from an amorphous state, a polycrystal, an orientated polycrystal, and a single crystal, etc. is formed beforehand on it, and N type semiconductor layer, luminescence layer, and P type semiconductor layer are laminated on the thin-film substrate,
b) the method of producing a light-emitting device, wherein the sintered compact which comprises aluminum nitride as a main component is made as a substrate, at least one layer of thin films which comprise as amain component at least one selected from gallium nitride, indium nitride, and aluminum nitride and have at least one of the crystallization states selected from an amorphous state, a polycrystal, an orientated polycrystal, and a single crystal, etc. is formed beforehand on it, a thin-film substrate is made by that in which at least one layer of single-crystal thin films which comprise as a main component at least one selected from gallium nitride, indium nitride, and aluminum nitride is formed further on it, and N type semiconductor layer, luminescence layer, and P type semiconductor layer are laminated on the thin-film substrate.

Among the thin film which comprises as a main component at least one selected from gallium nitride, indium nitride, and aluminum nitride and is formed beforehand on the above substrate, what has at least one of the crystallization states selected from an amorphous state, a polycrystal, and an orientated polycrystal is more preferred.

In the thing in which the thin film which comprises as a main component at least one selected from gallium nitride, indium nitride, and aluminum nitride and is formed beforehand on the substrate has the crystallization state of an orientated polycrystal, a light-emitting device in which the luminous efficiency is not less than 12 % is usually producible on it, unless reference is made especially.

If a thin film which comprises as a main component at least one selected from gallium nitride, indium nitride, and aluminum nitride is made into at least two layers, and the substrate in which the surface one among the thin films of two or more layers is a single crystal is used, a light-emitting device which is the luminous efficiency at least not less than 12 % is producible on it regardless of the crystallization states of the thin film formed beforehand on a substrate.

In this invention, in addition to the above substrate which comprises a sintered compact which comprises aluminum nitride as a main component, using as a substrate various sintered compacts which comprise as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., a buffer layer which comprises a thin film which comprises as a main component at least one selected from gallium nitride, indium nitride, and aluminum nitride is first formed on the substrate, an epitaxially grown single-crystal thin film which comprises as a main component at least one selected from gallium nitride, indium nitride, and aluminum nitride is laminated on it as N type semiconductor layer, luminescence layer, and P type semiconductor layer, and a light-emitting device is producible.

This invention has the feature in which a light-emitting device has been constituted by having laminated the above N type semiconductor layer, luminescence layer, and P type semiconductor layer at least onto the various sintered compacts which comprise as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., or onto the sintered compact which was made into the shape of a substrate.

As for the light-emitting device produced using as a substrate the various sintered compacts which comprise as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., a thing excellent in luminous efficiency is also producible.

That is, using the substrate which comprises various sintered compacts which comprise as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., a light-emitting device which is at least equivalent or has been improved to a maximum of not less than 3-4 times if compared with the luminous efficiency of a light-emitting device produced using conventional single-crystal substrates, such as a sapphire, etc., can be provided.

That is, in the light-emitting device produced using the substrate of this invention which comprises various sintered compacts which comprise as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., a maximum of not less than 20-30 % of the inputted electric power can be emitted to the outside of a light-emitting device as optical energy.

As for the light-emitting device produced using the substrate which comprises various sintered compacts which comprise as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., though it is not necessarily clear about the cause in which it has high luminous efficiency, it seems that it is important for the first that a single-crystal thin film which comprises as a main component at least one selected from gallium nitride, indium nitride, and aluminum nitride and is excellent in crystallinity can be formed.

However, in addition to that, as for the above substrate which comprises various sintered compacts which comprise as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., as a cause of having the luminous efficiency more than equal to conventional single-crystal substrates, such as a sapphire, etc., it seems that it is still more important that it is not a bulk single crystal like sapphire but has the microstructure as a sintered compact which is fired and solidified and comprises a crystal grain and a grain boundary phase, etc. like the substrate which comprises sintered compact which comprises aluminum nitride as a main component.

As mentioned above, a single-crystal thin film which comprises as a main component at least one selected from gallium nitride, indium nitride, and aluminum nitride and has the crystallinity in which the half width of the rocking curve of the X ray diffraction from the lattice plane of a Miller Index (002) is not more than 300 seconds at least can also be formed on the sapphire substrate, and a light-emitting device has been manufactured by forming such single-crystal thin film which is excellent in crystallinity and is constituted with each layer of N type semiconductor layer, luminescence layer, and P type semiconductor layer at least, onto the sapphire substrate.

As for the light-emitting device produced using the substrate of this invention which comprises various sintered compacts which comprise as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., a light-emitting device which is at least equivalent or has been improved to a maximum of not less than 3-4 times if compared with the luminous efficiency of a light-emitting device produced using the above single-crystal substrates, such as sapphire, etc., can be provided.

That is, as for the light-emitting device produced using the substrate of this invention which comprises various sintered compacts which comprise as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., what has the luminous efficiency at least not less than 8 % is producible.

In this invention, as the above various sintered compacts which are used as a substrate for producing a light-emitting device and comprise as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., anything can be used if a thin film in which at least N type semiconductor layer, a luminescence layer, and P type semiconductor layer which are the constituent factor of a light-emitting device is formed and which comprises as a main component at least one selected from gallium nitride, indium nitride, and aluminum nitride can be formed as a epitaxially grown single crystal.

If saying in other words, if it is the thing in which an epitaxially grown single-crystal thin film which comprises as a main component at least one selected from gallium nitride, indium nitride, and aluminum nitride can be formed by the method described below, it can be used as a substrate for producing a light-emitting device, even if it is what kind of various sintered compacts which comprise as a main component a ceramic material which has the crystal structure which can be classified as a hexagonal system, such as silicon carbide, silicon nitride, gallium nitride, zinc oxide, and beryllium oxide, etc., and can classified as a trigonal system or a hexagonal system, such as aluminum oxide, etc.

That is,
1) it is the method of producing a light-emitting device, wherein an epitaxially grown single-crystal thin film which comprises as a main component at least one selected from gallium nitride, indium nitride, and aluminum nitride and constitutes a light-emitting device is laminated as N type semiconductor layer, luminescence layer, and P type semiconductor layer directly on it, using as a substrate the various sintered compacts which comprise as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., as it is.
   In this method, it is desirable that a buffer layer which comprises a thin film which comprises as a main component at least one selected from gallium nitride, indium nitride, and aluminum nitride is first formed on a substrate, if it requires, and that a light-emitting device will be produced laminating N type semiconductor layer, luminescence layer, and P type semiconductor layer onto it.
2) It is the method of producing a light-emitting device, wherein an epitaxially grown single-crystal thin film which comprises as a main component at least one selected from gallium nitride, indium nitride, and aluminum nitride and constitutes a light-emitting device is laminated as N type semiconductor layer, luminescence layer, and P type semiconductor layer onto it, after making a thin-film substrate by that in which at least one layer of thin films which comprise as a main component at least one selected from gallium nitride, indium nitride, and aluminum nitride and have at least one of the crystallization states selected from an amorphous state, a polycrystal, an orientated polycrystal, and a single crystal, etc., is formed beforehand on the substrate produced from the various sintered compacts which comprise as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc.
   When producing a light-emitting device using the above thin-film substrate, it is also possible to use at least a part of the thin film layer currently formed on the thin-film substrate as a constituent factor for a light-emitting device to function.
   In this method, it is desirable to produce a light-emitting device by first forming a buffer layer which comprises a thin film which comprises as a main component at least one selected from gallium nitride, indium nitride, and aluminum nitride onto the above thin-film substrate, if it requires, and by laminating N type semiconductor layer, luminescence layer, and P type semiconductor layer onto it.
3) It is the method of producing a light-emitting device, wherein an epitaxially grown single-crystal thin film which comprises as a main component at least one selected from gallium nitride, indium nitride, and aluminum nitride and constitutes a light-emitting device is laminated as N type semiconductor layer, luminescence layer, and P type semiconductor layer onto it, after making a thin-film substrate by that in which at least one layer of single-crystal thin films which comprise as a main component at least one selected from gallium nitride, indium nitride, and aluminum nitride is formed furthermore on that in which at least one layer of thin films which comprise as a main component at least one selected from gallium nitride, indium nitride, and aluminum nitride and have at least one of the crystallization states selected from an amorphous state, a polycrystal, an orientated polycrystal, and a single crystal, etc., is formed beforehand on the substrate produced from the various sintered compacts which comprise as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc.

When producing a light-emitting device using the above thin-film substrate, it is also possible to use at least a part of the thin film layer currently formed on the thin-film substrate as a constituent factor for a light-emitting device to function.

In this method, it is desirable to produce a light-emitting device by first forming a buffer layer which comprises a thin film which comprises as a main component at least one selected from gallium nitride, indium nitride, and aluminum nitride onto the above thin-film substrate, if it requires, and by laminating N type semiconductor layer, luminescence layer, and P type semiconductor layer onto it.

According to the method explained in the above 1)-3), a light-emitting device in which the luminous efficiency is not less than 8 % is producible easily using the various sintered compacts of this invention which comprise as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., as a substrate for light-emitting device production.

In the method explained in the above 1)-3), if the thin film which is formed on a substrate and comprises as a main component at least one selected from gallium nitride, indium nitride, and aluminum nitride is made into at least two layers, and the substrate in which the surface thin film among the thin films of two or more layers is a single crystal is used, a light-emitting device excellent in luminous efficiency is producible easily on it regardless of the crystal state of the thin film formed beforehand on a substrate, so it is desirable.

That is, when using as a substrate the various sintered compacts which comprise as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., if at least one layer of thin films which comprise as a main component at least one selected from gallium nitride, indium nitride, and aluminum nitride and have at least one of the crystallization states selected from an amorphous state, a polycrystal, an orientated polycrystal, and a single crystal, etc., is formed beforehand on it, and a substrate on which at least one layer of single-crystal thin films which comprise as a main component at least one selected from gallium nitride, indium nitride, and aluminum nitride is formed further on it is used, a light-emitting device in which the luminous efficiency is not less than 10 % at least is producible on it.

Especially, when producing a thing in which the luminous efficiency is at least not less than 12 % as a light-emitting device, or when producing a laser diode as a light-emitting device, it is effective to use such substrate in which a single-crystal thin film was formed in the surface.

When producing a light-emitting device using the above thin-film substrate, it is also possible to use at least a part of the thin film layer currently formed on the thin-film substrate as a constituent factor for a light-emitting device to function.

In this method, it is desirable to produce a light-emitting device by first forming a buffer layer which comprises a thin film which comprises as a main component at least one selected from gallium nitride, indium nitride, and aluminum nitride onto the thin-film substrate, if it requires, and by laminating N type semiconductor layer, luminescence layer, and P type semiconductor layer onto it.

When producing a light-emitting device using a thin-film substrate of this invention, it is also possible to produce a light-emitting device, without providing especially the above buffer layer.

In this invention, as for the quality, such as the crystallinity of a thin film formed on the substrate which used various sintered compacts which have such characteristics and comprise as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., the relation with the composition, purity, content of each main component, optical permeability, size of a sintered compact crystal grain, and existence of a conduction via, etc. in the various sintered compacts which comprise as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., or the relation with the surface smooth nature and thickness of a substrate, etc. when using as a substrate the various sintered compacts which comprise as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., or the relation with the thin film constitution and thin film thickness, etc. which are formed on the substrate which comprises the various sintered compacts which comprise as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., has been explained until now.

In this invention, as for the various sintered compacts which comprise as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., if it is what can form a single-crystal thin film which comprises as a main component at least one selected from gallium nitride, indium nitride, and aluminum nitride, even if it is a thing which has what kind of composition, a light-emitting device which has excellent luminous efficiency is producible using as a substrate the various sintered compacts which comprise as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc.

Usually, a light-emitting device which has the luminous efficiency which is at least equivalent or has been improved to a maximum of not less than 3-4 times if compared with the luminous efficiency of the light-emitting device produced using conventional substrates, such as a sapphire, etc., can be provided.

If it says concretely, as the composition of the sintered compact which comprises silicon carbide as a main component, for example, there are what comprises only SiC substantially, or what contains a carbon component, or a boron component, such as B, B4C, and BN, etc., or a rare earth element component, such as Y₂O₃, Er₂O₃, and Yb₂O₃, etc., or an alkaline-earth-metal component, such as BeO, MgO, CaO, SrO, and BaO, etc., or an aluminum component, such as Al₂O₃, etc., or a silicon component, such as SiO₂, etc., or what contains one of these components or two or more.

As the composition of the sintered compact which comprises silicon nitride as a main component, there are what comprises only Si₃N₄ substantially, or what contains a rare earth element component, such as Y₂O₃, Er₂O₃, and Yb₂O₃, etc., or an alkaline-earth-metal component, such as BeO, MgO, CaO, SrO, and BaO, etc., or an aluminum component, such as Al₂O₃, etc., or a silicon component, such as SiO₂, etc., or a blackening promotion component, such as carbon, molybdenum, and tungsten, etc., or a transition metal component, such as TiO₂, Cr₂O₃, MnO, CoO, NiO, Fe₂O₃, etc., or what contains one of these components or two or more.

As the composition of the sintered compact which comprises zinc oxide as a main component, there are what comprises only ZnO substantially, or what contains a rare earth element component, such as Y₂O₃, Er₂O₃, and Yb₂O₃, etc., or an alkaline-earth-metal component, such as BeO, MgO, CaO, SrO, and BaO, etc., or an aluminum component, such as Al₂O₃, etc., or a silicon component, such as SiO₂, etc., or a transition metal component, such as TiO₂, Cr₂O₃, MnO, CoO, NiO, Fe₂O₃, etc., or what contains one of these components or two or more.

As the composition of the sintered compact which comprises beryllium oxide as a main component, there are what comprises only BeO substantially, or what contains a rare earth element component, such as Y₂O₃, Er₂O₃, and Yb₂O₃, etc., or analkaline-earth-metal component, such as BeO, MgO, CaO, SrO, and BaO, etc., or an aluminum component, such as Al₂O₃, etc., or a silicon component, such as SiO₂, etc., or a transition metal component, such as TiO₂, Cr₂O₃, MnO, CoO, NiO, Fe₂O₃, etc., or what contains one of these components or two or more.

As the composition of the sintered compact which comprises aluminum oxide as a main component, there are what comprises only Al₂O₃ substantially, or what contains a rare earth element component, such as Y₂O₃, Er₂O₃, and Yb₂O₃, etc., or an alkaline-earth-metal component, such as BeO, MgO, CaO, SrO, and BaO, etc., or an aluminum component, such as Al₂O₃, etc., or a silicon component, such as SiO₂, etc., or a transition metal component, such as TiO₂, Cr₂O₃, MnO, CoO, NiO, Fe₂O₃, etc., or what contains one of these components or two or more.

If it says in more detail, usually, it is desirable to use a sintered compact which comprises zinc oxide as a main component and contains a zinc oxide component not less than 55.0 mol % on the basis of ZnO, if the sintered compact which comprises zinc oxide as a main component is used as a substrate, a light-emitting device in which the luminous efficiency is at least not less than 8 % is producible.

As the components other than the above zinc oxide, for example, there are a sintered compact which comprises zinc oxide as a main component and contains an aluminum component not more than 45.0 mol % on the basis of Al₂O₃, or a sintered compact which comprises zinc oxide as a main component and which contains an aluminum component not more than 45.0 mol % on the basis of Al₂O₃ and contains simultaneously at least one selected from a rare earth element component, such as Sc, Y, La, Ce, Pr, Nd, Pm, Sm, Eu, Gd, Tb, Dy, Ho, Er, Tm, Yb, and Lu, etc. not more than 10.0 mol % on an oxide basis, a light-emitting device in which the luminous efficiency is at least not less than 8 % is producible using the substrate which comprises these sintered compacts.

Usually, it is desirable to use a sintered compact which comprises beryllium oxide as a main component and contains a beryllium oxide component not less than 65.0 mol % on the basis of BeO, a light-emitting device in which the luminous efficiency is at least not less than 8 % is producible using as a substrate the sintered compact which comprises beryllium oxide as a main component.

As the components other than the above beryllium oxide, for example, there are a sintered compact which comprises beryllium oxide as a main component and contains at least one selected from a magnesium component, a calcium component, and a silicon component a total of not more than 35.0 mol % on the basis of MgO, CaO, and SiO₂, or a sintered compact which comprises beryllium oxide as a main component and which contains at least one selected from a magnesium component, a calcium component, and a silicon component a total of not more than 35.0 mol % on the basis of MgO, CaO, and SiO₂ and contains simultaneously at least one selected from a rare earth element component, such as Sc, Y, La, Ce, Pr, Nd, Pm, Sm, Eu, Gd, Tb, Dy, Ho, Er, Tm, Yb, and Lu, etc. not more than 5.0 mol % on an oxide basis, a light-emitting device in which the luminous efficiency is at least not less than 8 % is producible using the substrate which comprises these sintered compacts.

Usually, it is desirable to use a sintered compact which comprises aluminum oxide as a main component and contains an aluminum oxide component not less than 55.0 mol % on the basis of Al₂O₃, a light-emitting device in which the luminous efficiency is at least not less than 8 % is producible using as a substrate the sintered compact which comprises aluminum oxide as a main component.

As the components other than the above aluminum oxide, for example, there are the sintered compact which comprises aluminum oxide as a main component and contains at least one selected from a magnesium component, a calcium component, and a silicon component a total of not more than 45.0 mol % on the basis of MgO, CaO, and SiO₂, or the sintered compact which comprises aluminum oxide as a main component and contains at least one selected from a magnesium component, a calcium component, and a silicon component a total of not more than 45.0 mol % on the basis of MgO, CaO, and SiO₂ and contains simultaneously at least one selected from a rare earth element component, such as Sc, Y, La, Ce, Pr, Nd, Pm, Sm, Eu, Gd, Tb, Dy, Ho, Er, Tm, Yb, and Lu, etc. not more than 10.0 mol % on an oxide basis, or the sintered compact which contains at least one selected from a magnesium component, a calcium component, and a silicon component a total of not more than 45.0 mol % on the basis of MgO, CaO, and SiO₂ and contains simultaneously at least two selected from a rare earth element component, such as Sc, Y, La, Ce, Pr, Nd, Pm, Sm, Eu, Gd, Tb, Dy, Ho, Er, Tm, Yb, and Lu, etc. not more than 10.0 mol % on an oxide basis, a light-emitting device in which the luminous efficiency is at least not less than 8 % is producible using the substrate which comprises these sintered compacts.

In this invention, if using as a substrate the various sintered compacts which comprise as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., even if the optical transmissivity is smaller than 1 % or it does not have optical permeability substantially, a light-emitting device which has excellent luminous efficiency is producible.

If using as a substrate the various sintered compacts which comprise as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., even if it has optical permeability whose optical transmissivity is not less than 1 %, a light-emitting device which has excellent luminous efficiency is producible.

Usually, using as a substrate the above various sintered compacts which comprise as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., a light-emitting device which is at least equivalent or has been improved to a maximum of not less than 3-4 times if compared with the luminous efficiency of a light-emitting device produced using conventional substrates, such as a sapphire, etc., can be provided.

If it says in more detail, if the sintered compact which comprises zinc oxide as a main component and has the optical transmissivity smaller than 1 % or does not have optical permeability substantially, or the sintered compact which comprises zinc oxide as a main component and has the optical transmissivity not less than 1 %, is used as a substrate, a light-emitting device in which the luminous efficiency is at least not less than 8 % is producible.

Usually, as for the sintered compact which comprises zinc oxide as a main component, if what has high optical permeability is used as a substrate, a light-emitting device with higher luminous efficiency is producible, so it is desirable.

That is, when the sintered compact which comprises zinc oxide as a main component and is the optical transmissivity not less than 10 % is used as a substrate, what is not less than 10 % as the luminous efficiency of a light-emitting device formed on it is easy to be obtained.

When the sintered compact which comprises zinc oxide as a main component and is the optical transmissivity not less than 20 % is used as a substrate, what is not less than 12 % as the luminous efficiency of a light-emitting device formed on it is easy to be obtained, so it is desirable.

When the sintered compact which comprises zinc oxide as a main component and is the optical transmissivity not less than 30 % is used as a substrate, what is not less than 15 % as the luminous efficiency of a light-emitting device formed on it is easy to be obtained.

When the sintered compact which comprises zinc oxide as a main component and is the optical transmissivity not less than 40 % is used as a substrate, what is not less than 20 % as the luminous efficiency of a light-emitting device formed on it is easy to be obtained.

When the sintered compact which comprises zinc oxide as a main component and is the optical transmissivity not less than 50 % is used as a substrate, what is not less than 25 % as the luminous efficiency of a light-emitting device formed on it is easy to be obtained.

In this invention, what is the optical transmissivity not less than 60 % is obtained, and furthermore what is a maximum of not less than 80 % is also obtained, as mentioned above, when the sintered compact which comprises zinc oxide as a main component and has such high optical transmissivity is used as a substrate, a thing in which the luminous efficiency of a light-emitting device formed on it is not less than 30 %, and a maximum of 55 %, was easy to be obtained.

If the sintered compact which comprises beryllium oxide as a main component and has the optical transmissivity smaller than 1 % or does not have optical permeability substantially, or the sintered compact which comprises beryllium oxide as a main component and has the optical transmissivity not less than 1 %, is used as a substrate, a light-emitting device in which the luminous efficiency is at least not less than 8 % is producible.

Usually, as for the sintered compact which comprises beryllium oxide as a main component, if what has high optical permeability is used as a substrate, a light-emitting device with higher luminous efficiency is producible, so it is desirable.

That is, when the sintered compact which comprises beryllium oxide as a main component and is the optical transmissivity not less than 10 % is used as a substrate, what is not less than 10 % as the luminous efficiency of a light-emitting device formed on it is easy to be obtained.

When the sintered compact which comprises beryllium oxide as a main component and is the optical transmissivity not less than 20 % is used as a substrate, what is not less than 12 % as the luminous efficiency of a light-emitting device formed on it is easy to be obtained, so it is desirable.

When the sintered compact which comprises beryllium oxide as a main component and is the optical transmissivity not less than 30 % is used as a substrate, what is not less than 15 % as the luminous efficiency of a light-emitting device formed on it is easy to be obtained.

When the sintered compact which comprises beryllium oxide as a main component and is the optical transmissivity not less than 40 % is used as a substrate, what is not less than 20 % as the luminous efficiency of a light-emitting device formed on it is easy to be obtained.

When the sintered compact which comprises beryllium oxide as a main component and is the optical transmissivity not less than 50 % is used as a substrate, what is not less than 25 % as the luminous efficiency of a light-emitting device formed on it is easy to be obtained.

In this invention, what is the optical transmissivity not less than 60 % is obtained, and furthermore what is a maximum of not less than 80 % is also obtained, as mentioned above, when the sintered compact which comprises beryllium oxide as a main component and has such high optical transmissivity is used as a substrate, a thing in which the luminous efficiency of a light-emitting device formed on it is not less than 30 %, and a maximum of 52 %, was easy to be obtained.

If the sintered compact which comprises aluminum oxide as a main component and has the optical transmissivity smaller than 1 % or does not have optical permeability substantially, or the sintered compact which comprises aluminum oxide as a main component and has the optical transmissivity not less than 1 %, is used as a substrate, a light-emitting device in which the luminous efficiency is at least not less than 8 % is producible.

Usually, as for the sintered compact which comprises aluminum oxide as a main component, if what has high optical permeability is used as a substrate, a light-emitting device with higher luminous efficiency is producible, so it is desirable.

That is, when the sintered compact which comprises aluminum oxide as a main component and is the optical transmissivity not less than 10 % is used as a substrate, what is not less than 10 % as the luminous efficiency of a light-emitting device formed on it is easy to be obtained.

When the sintered compact which comprises aluminum oxide as a main component and is the optical transmissivity not less than 20 % is used as a substrate, what is not less than 12 % as the luminous efficiency of a light-emitting device formed on it is easy to be obtained, so it is desirable.

When the sintered compact which comprises aluminum oxide as a main component and is the optical transmissivity not less than 30 % is used as a substrate, what is not less than 15 % as the luminous efficiency of a light-emitting device formed on it is easy to be obtained.

When the sintered compact which comprises aluminum oxide as a main component and is the optical transmissivity not less than 40 % is used as a substrate, what is not less than 20 % as the luminous efficiency of a light-emitting device formed on it is easy to be obtained.

When the sintered compact which comprises aluminum oxide as a main component and is the optical transmissivity not less than 50 % is used as a substrate, what is not less than 25 % as the luminous efficiency of a light-emitting device formed on it is easy to be obtained.

In this invention, what is the optical transmissivity not less than 60 % is obtained, and furthermore what is a maximum of not less than 80 % is also obtained, as mentioned above, when the sintered compact which comprises aluminum oxide as a main component and has such high optical transmissivity is used as a substrate, a thing in which the luminous efficiency of a light-emitting device formed on it is not less than 30 %, and a maximum of 51 %, was easy to be obtained.

If the sintered compact which comprises gallium nitride as a main component and has the optical transmissivity smaller than 1 % or does not have optical permeability substantially, or the sintered compact which comprises gallium nitride as a main component and has the optical transmissivity not less than 1 %, is used as a substrate, a light-emitting device in which the luminous efficiency is at least not less than 8 % is producible.

Usually, as for the sintered compact which comprises gallium nitride as a main component, if what has high optical permeability is used as a substrate, a light-emitting device with higher luminous efficiency is producible, so it is desirable.

That is, when the sintered compact which comprises gallium nitride as a main component and is the optical transmissivity not less than 10 % is used as a substrate, what is not less than 10 % as the luminous efficiency of a light-emitting device formed on it is easy to be obtained.

When the sintered compact which comprises gallium nitride as a main component and is the optical transmissivity not less than 20 % is used as a substrate, what is not less than 12 % as the luminous efficiency of a light-emitting device formed on it is easy to be obtained, so it is desirable.

When the sintered compact which comprises gallium nitride as a main component and is the optical transmissivity not less than 30 % is used as a substrate, what is not less than 15 % as the luminous efficiency of a light-emitting device formed on it is easy to be obtained.

When the sintered compact which comprises gallium nitride as a main component and is the optical transmissivity not less than 40 % is used as a substrate, what is not less than 20 % as the luminous efficiency of a light-emitting device formed on it is easy to be obtained.

When the sintered compact which comprises gallium nitride as a main component and is the optical transmissivity not less than 50 % is used as a substrate, what is not less than 25 % as the luminous efficiency of a light-emitting device formed on it is easy to be obtained.

In this invention, what is the optical transmissivity not less than 60 % is obtained, and furthermore what is a maximum of not less than 80 % is also obtained, as mentioned above, when the sintered compact which comprises gallium nitride as a main component and has such high optical transmissivity is used as a substrate, a thing in which the luminous efficiency of a light-emitting device formed on it is not less than 30 %, and a maximum of 63 %, was easy to be obtained.

Thus, as for the luminous efficiency of a light-emitting device produced using as a substrate the various sintered compacts which comprise as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., what has not less than 8 % is easy to be obtained, and a light-emitting device which is at least equivalent or has been improved to a maximum of not less than 3-4 times if compared with the luminous efficiency of a light-emitting device produced using conventional substrates, such as a sapphire, etc., can be provided.

In this invention, as for the various sintered compacts which comprise as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., if it is what can form a single-crystal thin film which comprises as a main component at least one selected from gallium nitride, indium nitride, and aluminum nitride, even if the crystal grain of silicon carbide, silicon nitride, gallium nitride, zinc oxide, beryllium oxide, and aluminum oxide, etc. in the sintered compact is the thing of what kind of size, a light-emitting device which has excellent luminous efficiency is producible using as a substrate the various sintered compacts which comprise as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc.

Usually, a light-emitting device in which the luminous efficiency is at least equivalent or has been improved to a maximum of not less than 3-4 times if compared with the luminous efficiency of a light-emitting device produced using conventional substrates, such as a sapphire, etc., can be provided.

Usually, it is preferred to use as a substrate the various sintered compacts in which the crystal grain size of silicon carbide, silicon nitride, gallium nitride, zinc oxide, beryllium oxide, and aluminum oxide, etc. is an average of not less than 0.5 µm and which comprise as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., a light-emitting device which is at least equivalent or has been improved to a maximum of not less than 3-4 times if compared with the luminous efficiency of a light-emitting device produced using conventional substrates, such as a sapphire, etc., is producible.

If saying in more detail, using as a substrate the various sintered compacts in which the crystal grain size of silicon carbide, silicon nitride, gallium nitride, zinc oxide, beryllium oxide, and aluminum oxide, etc. is an average of not less than 1.0 µm and which comprise as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., a light-emitting device in which the luminous efficiency is at least not less than 8 % is producible.

Even when using as a substrate not only what is in the state where the crystal grain contained has gathered in the nearly equal size but also what has the irregular size of a crystal grain or contains the crystal grain in which the form is distorted and the crystal grain of the form wherein one side is small and one side is large, such as the needle-like or board-like form wherein one side is several µm and the other side grew up into about 10 µm or more greatly, for example, such as a β-Si₃N₄ particle, etc., in the various sintered compacts which comprise as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., a light-emitting device excellent in luminous efficiency is producible satisfactorily at all.

In addition, even if using as a substrate what formed a conduction via in the various sintered compacts which comprise as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., a single-crystal thin film which comprises as amain component at least one selected from gallium nitride, indium nitride, and aluminum nitride can be formed, and a light-emitting device which has excellent luminous efficiency is producible.

It is possible to use anything, if it is a material which has conductivity as a conduction via.

Usually, as the material of a conduction via, a material which comprises as a main component tungsten, molybdenum, gold, silver, copper, and titanium nitride, etc. is used.

Using as a substrate the various sintered compacts which formed a conduction via comprising such material and comprise as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., a light-emitting device which has the luminous efficiency which is equivalent at least or has been improved to a maximum of not less than 3-4 times if compared with the luminous efficiency of a light-emitting device produced using conventional substrates, such as a sapphire, etc., can be provided.

If it says in more detail, a light-emitting device in which the luminous efficiency is at least not less than 8 % is producible using as a substrate what formed a conduction via in the various sintered compacts which comprise as a main component a ceramic material which has the crystal structure which can be classified as a hexagonal system, such as silicon carbide, silicon nitride, gallium-nitride, zinc oxide, and beryllium oxide, etc., and can be classified as a trigonal system or a hexagonal system, such as aluminum oxide, etc.

As mentioned above, it explained that it is effective to use as a substrate the various sintered compacts which comprise as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., for making a light-emitting device, and that especially if it is what has optical permeability, a light-emitting device more excellent in luminous efficiency is producible.

In addition, in this invention, even if it is the thing of what kind of state as the surface smooth nature of the substrate which comprises various sintered compacts which comprise as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., if it is what can form a single-crystal thin film which comprises as a main component at least one selected from gallium nitride, indium nitride, and aluminum nitride, what has excellent luminous efficiency is producible, as the light-emitting device which is formed on the substrate which comprises various sintered compacts which comprise as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc.

Usually, as for the luminous efficiency of a light-emitting device produced using the substrate which comprises various sintered compacts which have the above surface smooth nature and comprise as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., a thing which is at least equivalent or has been improved to a maximum of not less than 3-4 times if compared with the luminous efficiency of a light-emitting device produced using conventional substrates, such as a sapphire, etc., can be provided.

If it says in more detail,
1) in the case of the method of producing a light-emitting device, wherein using as a substrate the various sintered compacts which comprise as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., as they are, a buffer layer which comprises a thin film which comprises as a main component at least one selected from gallium nitride, indium nitride, and aluminum nitride is first formed on it, if it requires, and an epitaxially grown single-crystal thin film which comprises as a main component at least one selected from gallium nitride, indium nitride, and aluminum nitride is laminated on it as N type semiconductor layer, luminescence layer, and P type semiconductor layer, usually, a light-emitting device in which the luminous efficiency is at least not less than 8 % is producible using what is not more than 1000 nm as the average surface roughness Ra of the substrate which comprises various sintered compacts which comprise as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc.
   When producing a light-emitting device by the method explained in the following 2)-3), a light-emitting device in which the luminous efficiency is at least not less than 8 % is producible, even if the thing which is larger than 1000 nm is used as the average surface roughness Ra of the substrate which comprises various sintered compacts which comprise as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc.,
2) the method of producing a light-emitting device, wherein making as a substrate the various sintered compacts which comprise as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., a thin-film substrate is made by that in which at least one layer of thin films which comprise as a main component at least one selected from gallium nitride, indium nitride, and aluminum nitride and have at least one of the crystallization states selected from an amorphous state, a polycrystal, an orientated polycrystal, and a single crystal, etc. is formed beforehand on it, a buffer layer which comprises a thin film which comprises as a main component at least one selected from gallium nitride, indium nitride, and aluminum nitride is first formed on it, if it requires, and an epitaxially grown single-crystal thin film which comprises as a main component at least one selected from gallium nitride, indium nitride, and aluminum nitride is laminated on it as N type semiconductor layer, luminescence layer, and P type semiconductor layer, and,
3) the method of producing a light-emitting device, wherein making as a substrate the various sintered compacts which comprise as a main component a ceramic material which has the crystal structure which can be classified as a hexagonal system, such as silicon carbide, silicon nitride, gallium nitrids, zinc oxide, and beryllium oxide, etc., and can be classified as a trigonal system or a hexagonal system, such as aluminum oxide, etc., at least one layer of thin films which comprise as a main component at least one selected from gallium nitride, indium nitride, and aluminum nitride and have at least one of the crystallization states selected from an amorphous state, a polycrystal, an orientated polycrystal, and a single crystal, etc. is formed beforehand on it, a thin-film substrate is made by that in which at least one layer of single-crystal thin films which comprise as a main component at least one selected from gallium nitride, indium nitride, and aluminum nitride is formed further on it, a buffer layer which comprises a thin film which comprises as a main component at least one selected from gallium nitride, indium nitride, and aluminum nitride is first formed on the thin-film substrate, if it requires, and an epitaxially grown single-crystal thin film which comprises as a main component at least one selected from gallium nitride, indium nitride, and aluminum nitrideis laminated on it as N type semiconductor layer, luminescence layer, and P type semiconductor layer.

In this invention, even if it is the thing of what kind of thickness of the substrate which comprises various sintered compacts which comprise as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., if it is what can form a single-crystal thin film which comprises as a main component at least one selected from gallium nitride, indium nitride, and aluminum nitride, what has excellent luminous efficiency is producible, as the light-emitting device which is formed on the substrate which comprises various sintered compacts which comprise as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc.

Usually, as for the luminous efficiency of a light-emitting device produced using the substrate which comprises various sintered compacts which have the above thickness of a substrate and comprise as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., a thing which is at least equivalent or has been improved to a maximum of not less than 3-4 times if compared with the luminous efficiency of a light-emitting device produced using conventional substrates, such as a sapphire, etc., can be provided.

Usually, a light-emitting device in which the luminous efficiency is at least not less than 10 % is producible using the thing which is not more than 8.0 mm as the thickness of the substrate which comprises various sintered compacts which comprise as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc.

As mentioned above, as the substrate for producing a light-emitting device, it is effective to use the various sintered compacts which comprise as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., and the effect of the purity (composition), optical transmissivity, sintered compact crystal grain, existence of a conduction via, surface smooth nature as a substrate, and thickness as a substrate, etc. has been explained about the various sintered compacts which comprise as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc.

It has explained above, when producing a light-emitting device by the method which is explained in the following a) and b), as for the thin film which comprises as a main component at least one selected from gallium nitride, indium nitride, and aluminum nitride and is formed beforehand on the substrate which comprises various sintered compacts which comprise as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., if it is the thing which has at least one of the crystallization states selected from a single crystal, an amorphous state, a polycrystal, and an orientated polycrystal, a light-emitting device in which the luminous efficiency is not less than 8 % is usually producible on it, unless reference is made especially;
a) the method of producing a light-emitting device, wherein making as a substrate the various sintered compacts which comprise as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., a thin-film substrate is made by that in which at least one layer of thin films which comprise as a main component at least one selected from gallium nitride, indium nitride, and aluminum nitride and have at least one of the crystallization states selected from an amorphous state, a polycrystal, an orientated polycrystal, and a single crystal, etc. is formed beforehand on it,
b) the method of producing a light-emitting device, wherein making as a substrate the various sintered compacts which comprise as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., at least one layer of thin films which comprise as a main component at least one selected from gallium nitride, indium nitride, and aluminum nitride and have at least one of the crystallization states selected from an amorphous state, a polycrystal, an orientated polycrystal, and a single crystal, etc. is formed beforehand on it, and a thin-film substrate is made by that in which at least one layer of single-crystal thin films which comprise as a main component at least one selected from gallium nitride, indium nitride, and aluminum nitride is formed further on it.

Among the thin film which comprises as a main component at least one selected from gallium nitride, indium nitride, and aluminum nitride and is formed beforehand on the above substrate, what has at least one of the crystallization states selected from an amorphous state, a polycrystal, and an orientated polycrystal is more preferred.

In the thing in which the thin film which comprises as a main component at least one selected from gallium nitride, indium nitride, and aluminum nitride and is formed beforehand on the substrate has the crystallization state of an orientated polycrystal, a light-emitting device in which the luminous efficiency is not less than 10 % is usually producible on it, unless reference is made especially.

If a thin film which comprises as a main component at least one selected from gallium nitride, indium nitride, and aluminum nitride is made into at least two layers, and the substrate in which the surface one among the thin films of two or more layers is a single crystal is used, a light-emitting device which is the luminous efficiency at least not less than 10 % is producible on it regardless of the crystallization states of the thin film formed beforehand on a substrate.

In addition, in the above illustrated sintered compact which comprises as a main component silicon carbide, silicon nitride, gallium nitride, zinc oxide, beryllium oxide, aluminum oxide, etc., as for the silicon carbide, silicon nitride, gallium nitride, zinc oxide, beryllium oxide, and aluminum oxide, etc. which are the main components, it has mainly illustrated that what has the crystal structure of a hexagonal system or a trigonal system is usually used as a substrate for light-emitting device production. But, even if the above main components are what has the crystal structures other than a hexagonal system or a trigonal system, such as a cubic system, a tetragonal system, a orthorhombic system, a monoclinic system, a triclinic system, and an amorphous state, etc., it can be used suitably as the substrate for light-emitting device production, if it is a thing which comprises as a main component silicon carbide, silicon nitride, gallium nitride, zinc oxide, beryllium oxide, and aluminum oxide, etc.

For example, even if the sintered compact which comprises silicon carbide as a main component is a sintered compact which comprises as a main component silicon carbide which has cubic system as a crystal structure, it can be suitably used as a substrate.

For example, even if the sintered compact which comprises aluminum oxide as a main component is a sintered compact which comprises aluminum oxide as a main component and has cubic system, or spinel structure as a crystal structure, it can be suitably used as a substrate.

In this invention, using not only the above various sintered compacts which comprise as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., but also the various sintered compacts which comprise as a main component a ceramic material, such as zirconium oxide (ZrO₂), magnesium oxide (MgO), magnesium aluminate (MgAl₂O₄), titanium oxide (TiO₂), barium titanate (BaTiO₃), lead titanate zirconate (PZT), rare earth oxides such as yttrium oxide (Y₂O₃), a thorium dioxide (ThO₂), various ferrites (complex oxide expressed with a general formula AFe₂O₄, such as Fe₃O₄ or MnFe₂O₄ : here, A is divalent metal elements), mullite (3Al₂O₃·2SiO₂), forsterite (2MgO·SiO₂), steatite (MgO·SiO₂), and glass, etc., a light-emitting device excellent in luminous efficiency is producible.

For example, in the above various sintered compacts which comprise as a main component a ceramic material, such as zirconium oxide, magnesium oxide, magnesium aluminate, titanium oxide, barium titanate, lead titanate zirconate, rare earth oxides such as yttrium oxide, thorium oxide, various ferrites, mullite, forsterite, steatite, and glass, etc., what has optical permeability is producible comparatively easily, and a light-emitting device more excellent in luminous efficiency is also producible using as a substrate the sintered compact which comprises a ceramic material as a main component and has optical permeability.

Usually, for example, except for the above various sintered compacts which comprise as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., if using as a substrate the various sintered compacts which comprise as a main component a ceramic material, such as zirconium oxide, magnesium oxide, magnesium aluminate, titanium oxide, barium titanate, lead titanate zirconate, rare earth oxides such as yttrium oxide, a thorium dioxide, various ferrites, mullite, forsterite, steatite, and glass, etc., as they are, it is difficult to form directly an epitaxially grown single-crystal thin film which comprises as a main component at least one selected from gallium nitride, indium nitride, and aluminum nitride, onto it in many cases, so it is usually difficult to produce a light-emitting device which has good luminous efficiency by the method which produces a light-emitting device by laminating the single-crystal thin film which grew epitaxially as N type semiconductor layer, luminescence layer, and P type semiconductor layer using each above sintered compact as it is.

However, for example, if a thin-film substrate is made by that in which at least one layer of thin films which comprise as a main component at least one selected from gallium nitride, indium nitride, and aluminum nitride and have at least one of the crystallization states selected from an amorphous state, a polycrystal, and an orientated polycrystal is formed beforehand on the above substrate which comprises various sintered compacts which comprise as a main component a ceramic material, such as zirconium oxide, magnesium oxide, magnesium aluminate, titanium oxide, barium titanate, lead titanate zirconate, rare earth oxides such as yttrium oxide, a thorium dioxide, various ferrites, mullite, forsterite, steatite, and glass, etc., it becomes possible to laminate an epitaxially grown single-crystal thin film which comprises as a main component at least one selected from gallium nitride, indium nitride, and aluminum nitride and which constitutes a light-emitting device as N type semiconductor layer, luminescence layer, P type semiconductor layer, or buffer layer onto the thin-film substrate, a light-emitting device in which the luminous efficiency is at least not less than 8 % is producible, even if it is a thing in which the optical transmissivity is smaller than 1 % or which does not have optical permeability substantially.

In this case, it is also possible to use at least a part of the thin film which comprises as a main component at least one selected from gallium nitride, indium nitride, and aluminum nitride and is formed beforehand, as a constituent factor of the light-emitting device.

In this invention, if at least one layer of thin films which comprise as a main component at least one selected from gallium nitride, indium nitride, and aluminum nitride and have at least one of the crystallization states selected from an amorphous state, a polycrystal, an orientated polycrystal, and a single crystal is formed beforehand on the above substrate which comprises various sintered compacts which comprise as a main component a ceramic material, such as zirconium oxide, magnesium oxide, magnesium aluminate, titanium oxide, barium titanate, lead titanate zirconate, rare earth oxides such as yttrium oxide, a thorium dioxide, various ferrites, mullite, forsterite, steatite, and glass, etc., and a thin-film substrate is made by that in which at least one layer of single-crystal thin films which comprise as a main component at least one selected from gallium nitride, indium nitride, and aluminum nitride is formed further on it, a light-emitting device which has luminous efficiency at least 10 % is producible now using the thin-film substrate, even if it is a thing in which the optical transmissivity is smaller than 1 % or which does not have optical permeability substantially, so it is desirable.

Thus, in this invention, even if using the above substrate which comprises various sintered compacts which comprise as a main component a ceramic material, such as zirconium oxide, magnesium oxide, magnesium aluminate, titanium oxide, barium titanate, lead titanate zirconate, rare earth oxides such as yttrium oxide, a thorium dioxide, various ferrites, mullite, forsterite, steatite, and glass, etc., a thing which is at least equivalent or has been improved to a maximum of not less than 2-3 times if compared with the luminous efficiency of the light-emitting device produced using a conventional sapphire substrate, can be provided.

In this invention, in the above various sintered compacts which comprise as a main component a ceramic material, such as zirconium oxide, magnesium oxide, magnesium aluminate, titanium oxide, barium titanate, lead titanate zirconate, rare earth oxide such as yttrium oxide, a thorium dioxide, various ferrites, mullite, forsterite, steatite, and glass, etc., what has optical transmissivity at least not less than 1 %, usually not less than 10 %, is producible.

In the above sintered compact which comprises as a main component zirconium oxide, magnesium oxide, magnesium aluminate, titanium oxide, barium titanate, lead titanate zirconate (especially, a thing containing a rare earth element component), and rare-earth element oxides such as yttrium oxide, thorium oxide, various ferrites, mullite, forsterite, steatite, and glass, etc., a thing with the optical transmissivity not less than 50 % is producible, and a thing of a maximum of not less than 80 % is producible.

Among those, it is preferred to use a sintered compact which comprises as a main component at least one selected from zirconium oxide, magnesium oxide, magnesium aluminate, rare earth oxides such as yttrium oxide, thorium oxide, mullite, and glass.

Especially, in the sintered compact which comprises zirconium oxide as a main component and contains a rare earth element compound, such as Y₂O₃, or an alkaline-earth-metal compound, such as CaO, the sintered compact which comprises magnesium oxide as a main component and contains an alkaline metal, such as LiF or NaF, or an alkaline-earth metal, such as CaO, or a rare earth element compound, such as Y₂O₃, the sintered compact which comprises only magnesium oxide substantially and does not contain any components other than the impurities mixing from the raw materials and manufacturing process, the sintered compact which comprises magnesium aluminate as a main component and contains an alkaline-earth metal, such as CaO, or a rare earth element compounds, such as Y₂O₃, the sintered compact which comprises only magnesium aluminate substantially and does not contain any components other than the impurities mixing from the raw materials and manufacturing process, the sintered compact which comprises as a main component a rare earth element oxide, such as Y₂O₃, and contains a different rare earth element component, and the sintered compact which comprises substantially only a rare earth element oxide, such as Y₂O₃, etc., and does not contain any components other than the impurities mixing from the raw materials and manufacturing process, a thing excellent in optical permeability is producible, so it is more desirable.

Making into a substrate such various sintered compacts which comprise a ceramic material as a main component and have optical permeability, if the thing in which a thin film which comprises as a main component at least one selected from gallium nitride, indium nitride, and aluminum nitride and has various crystallization states, such as a single crystal, an amorphous state, a polycrystal, and an orientated polycrystal, etc., was formed beforehand on the substrate is used as a substrate, a single-crystal thin film which comprises as a main component at least one selected from gallium nitride, indium nitride, and aluminum nitride can be formed on it, and a light-emitting device is producible by forming a thin film anew on it using such substrate in which a single-crystal thin film is formed, or a light-emitting device is also producible using a single-crystal thin film formed by doing in this way as at least a part of thin film layer which constitutes a light-emitting device as it is.

In this invention, as for the light-emitting device produced using as a substrate what has optical permeability among the above sintered compacts which comprise as a main component each material, such as zirconium oxide, magnesium oxide, magnesium aluminate, titanium oxide, barium titanate, lead titanate zirconate, rare earth oxides such as yttrium oxide, a thorium dioxide, various ferrites, mullite, forsterite, steatite, and glass, etc., a thing which is more excellent in luminous efficiency is producible, and a thing in which the luminous efficiency is equivalent at least or has been improved to a maximum of not less than 3-4 times if compared with the light-emitting device produced using a conventional sapphire substrate, can be provided.

If it says more concretely, as for the light-emitting device produced using as a substrate what has the optical transmissivity not less than 10 % among the above sintered compacts which comprise as a main component each material, such as zirconium oxide, magnesium oxide, magnesium aluminate, titanium oxide, barium titanate, lead titanate zirconate, rare earth oxides such as yttrium oxide, a thorium dioxide, various ferrites, mullite, forsterite, steatite, and glass, etc., what has luminous efficiency not less than 10 % is producible.

In the light-emitting device produced using as a substrate what has the optical transmissivity not less than 20 %, what has luminous efficiency not less than 12 % is producible.

In the light-emitting device produced using as a substrate what has the optical transmissivity not less than 30 %, what has luminous efficiency not less than 15 % is producible.

In the light-emitting device produced using as a substrate what has the optical transmissivity not less than 40 %, what has luminous efficiency not less than 20 % is producible.

In the light-emitting device produced using as a substrate what has the optical transmissivity not less than 50 %, what has luminous efficiency not less than 25 % is producible.

In the light-emitting device produced using as a substrate what has the optical transmissivity not less than 60 %, what has luminous efficiency not less than 30 % is producible.

In this invention, in the substrate which comprises a sintered compact which comprises magnesium oxide and magnesium aluminate as a main component, what has the optical transmissivity 83 %, and 81 %, respectively was produced, in the light-emitting device produced using these substrates, the luminous efficiency was a maximum of 51% and 50%, respectively, and was excellent.

As it has been explained in the above, in this invention, producing as a substrate the various sintered compacts which comprise as a main component a ceramic material, such as zirconium oxide, magnesium oxide, magnesium aluminate, titanium oxide, barium titanate, lead titanate zirconate, rare earth oxides such as yttrium oxide, a thorium dioxide, various ferrites, mullite, forsterite, steatite, and glass, etc., and a thin-film substrate is made by that in which at least one layer of thin films which comprise as a main component at least one selected from gallium nitride, indium nitride, and aluminum nitride and have at least one of the crystallization states selected from an amorphous state, a polycrystal, and an orientated polycrystal is formed beforehand on it, when producing a light-emitting device by the method which produces the light-emitting device onto the thin-film substrate, a thing in which the luminous efficiency of the light-emitting device produced is not less than 8 % is usually producible.

At least one layer of thin films which comprise as a main component at least one selected from gallium nitride, indium nitride, and aluminum nitride and have at least one of the crystallization states selected from an amorphous state, a polycrystal, and an orientated polycrystal is formed beforehand on the substrate which comprises various sintered compacts which comprises as a main component a ceramic material, such as zirconium oxide, magnesium oxide, magnesium aluminate, titanium oxide, barium titanate, lead titanate zirconate, rare earth oxides such as yttrium oxide, a thorium dioxide, various ferrites, mullite, forsterite, steatite, and glass, etc., and a thin-film substrate is made by that in which at least one layer of single-crystal thin films which comprise as a main component at least one selected from gallium nitride, indium nitride, and aluminum nitride is formed further on it, a light-emitting device which has the luminous efficiency of at least 10 % is usually producible using the thin-film substrate.

The feature of the light-emitting device of this invention is in the point of having used as a substrate the sintered compact which comprises aluminum nitride as a main component, the various sintered compacts which comprise as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., and the other various sintered compacts which comprise as a main component a ceramic material, such as zirconium oxide, magnesium oxide, magnesium aluminate, titanium oxide, barium titanate, lead titanate zirconate, rare earth oxides such as yttrium oxide, a thorium dioxide, various ferrites, mullite, forsterite, steatite, and glass, etc., for example.

As the substrate for producing a light-emitting device of this invention, in the sintered compact which comprises aluminum nitride as a main component, the various sintered compacts which comprise as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., and the other various sintered compacts which comprise as a main component a ceramic material, such as zirconium oxide, magnesium oxide, magnesium aluminate, titanium oxide, barium titanate, lead titanate zirconate, rare earth oxides such as yttrium oxide, a thorium dioxide, various ferrites, mullite, forsterite, steatite, and glass, etc., for example, if using what has optical permeability, it is more desirable in order to raise the luminous efficiency of a light-emitting device.

In addition, the feature of the light-emitting device of this invention is in the point of having used the various sintered compacts which comprise a ceramic material as a main component and have optical permeability, as the substrate for producing a light-emitting device.

As the substrate for producing a light-emitting device according to this invention, there are at least two kinds of substrates as the substrate of this invention for producing a light-emitting device, one is what used the sintered compact which comprises aluminum nitride as a main component, and the various sintered compacts which comprise as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., as a substrate as they are, and other one is that which used the thin-film substrate in which at least one layer of thin films which comprise as a main component at least one selected from gallium nitride, indium nitride, and aluminum nitride and have at least one of the crystallization states selected from an amorphous state, a polycrystal, an orientated polycrystal, and a single crystal, etc., is formed on the substrate made from the sintered compact comprising aluminum nitride as a main component, the various sintered compacts which comprise as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., and the other various sintered compacts which comprise as a main component a ceramic material, such as zirconium oxide, magnesium oxide, magnesium aluminate, titanium oxide, barium titanate, lead titanate zirconate, rare earth oxides such as yttrium oxide, a thorium dioxide, various ferrites, mullite, forsterite, steatite, and glass, etc., for example.

As the thin-film substrate, there is also a thing, wherein making into a substrate the sintered compact which comprises aluminum nitride as a main component, the various sintered compacts which comprise as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., and the other various sintered compacts which comprise as a main component a ceramic material, such as zirconium oxide, magnesium oxide, magnesium aluminate, titanium oxide, barium titanate, lead titanate zirconate, rare earth oxides such as yttrium oxide, a thorium dioxide, various ferrites, mullite, forsterite, steatite, and glass, etc., for example, at least one layer of thin films which comprise as a main component at least one selected from gallium nitride, indium nitride, and aluminum nitride and have at least one of the crystallization states selected from an amorphous state, a polycrystal, an orientated polycrystal, and a single crystal, etc. is formed beforehand on it, and a thin-film substrate is made by that in which at least one layer of single-crystal thin films which comprise as a main component at least one selected from gallium nitride, indium nitride, and aluminum nitride is formed further on it.

Usually, in such thin-film substrate for producing a light-emitting device, if the thing which formed a single-crystal thin film which comprises as a main component at least one selected from gallium nitride, indium nitride, and aluminum nitride is used, it is desirable in order to raise the luminous efficiency of a light-emitting device.

In this invention, among the above substrates which comprise various sintered compacts which comprise a ceramic material as a main component, since a light-emitting device which is more excellent in luminous efficiency is easy to be obtained if the sintered compact which comprises aluminum nitride as a main component is used, it is desirable.

That is, concretely, there are that which used the sintered compact which comprises aluminum nitride as a main component as it is as a substrate, and that which is made into the thin-film substrate by that in which at least one layer of thin films which comprise as a main component at least one selected from gallium nitride, indium nitride, and aluminum nitride and have at least one of the crystallization states selected from an amorphous state, a polycrystal, an orientated polycrystal, and a single crystal is formed on the substrate made from a sintered compact comprising aluminum nitride as a main component, and that which is made into the thin-film substrate by that in which at least one layer of thin films which comprise as a main component at least one selected from gallium nitride, indium nitride, and aluminum nitride and have at least one of the crystallization states selected from an amorphous state, a polycrystal, an orientated polycrystal, and a single crystal is formed beforehand on the substrate made from a sintered compact comprising aluminum nitride as a main component, and at least one layer of single-crystal thin films which comprise as a main component at least one selected from gallium nitride, indium nitride, and aluminum nitride is formed further on it.

Among the above substrates which comprise various sintered compacts which comprise a ceramic material as a main component, a light-emitting device which is comparatively excellent in luminous efficiency is easy to be obtained if the sintered compact which comprises zinc oxide as a main component is used, and what has conductivity whose electric resistivity is not more than 1x10² Ω·cm at room temperature can also be produced even if the sintered compact which comprises as a main component zinc oxide is the thing which has the optical transmissivity not more than 10 % or has still smaller optical permeability, such as the optical transmissivity of 0 %, and a light-emitting device of up-and-down electrical connection type electrode arrangement is producible, so it is desirable.

Among the above substrates which comprise various sintered compacts which comprise a ceramic material as a main component, since a light-emitting device which is more excellent in luminous efficiency is easy to be obtained if the sintered compact which has optical permeability is used, it is desirable.

In the above sintered compact which comprises zinc oxide as a main component, since what has conductivity simultaneously with optical permeability is obtained, a light-emitting device which is excellent in luminous efficiency and has up-and-down electrical connection type electrode arrangement is producible, it is preferred.

In the above thin-film substrate in which at least one layer of thin films which comprise as a main component at least one selected from gallium nitride, indium nitride, and aluminum nitride and have at least one of the crystallization states selected from an amorphous state, a polycrystal, an orientated polycrystal, and a single crystal, etc., is formed on the sintered compact comprising aluminum nitride as a main component, and on the various sintered compacts which comprise as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., and on the other various sintered compacts which comprise as a main component a ceramic material, such as zirconium oxide, magnesium oxide, magnesium aluminate, titanium oxide, barium titanate, lead titanate zirconate, rare earth oxides such as yttrium oxide, a thorium dioxide, various ferrites, mullite, forsterite, steatite, and glass, etc., for example, the thin film which comprises as a main component at least one selected from gallium nitride, indium nitride, and aluminum nitride and has at least one of the crystallization states selected from an amorphous state, a polycrystal, an orientated polycrystal, and a single crystal, etc. and was formed on the thin-film substrate can be used in the state where not only it is formed as it is, but also the thin film is polished into the specular surface, etc.

In the thin-film substrate wherein at least one layer of thin films which comprise as a main component at least one selected from gallium nitride, indium nitride, and aluminum nitride and have at least one of the crystallization states selected from an amorphous state, a polycrystal, an orientated polycrystal, and a single crystal, etc., is formed beforehand on the sintered compact comprising aluminum nitride as a main component, and on the various sintered compacts which comprise as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., and on the other various sintered compacts which comprise as a main component a ceramic material, such as zirconium oxide, magnesium oxide, magnesium aluminate, titanium oxide, barium titanate, lead titanate zirconate, rare earth oxides such as yttrium oxide, a thorium dioxide, various ferrites, mullite, forsterite, steatite, and glass, etc., for example, and at least one layer of single-crystal thin films which comprise as a main component at least one selected from gallium nitride, indium nitride, and aluminum nitride is formed further, the single-crystal thin film which comprises as a main component at least one selected from gallium nitride, indium nitride, and aluminum nitride and was formed on the thin-film substrate can be used in the state where not only it is formed as it is, but also the single-crystal thin film is polished into the specular surface, etc.

As for the surface flat and smooth nature of the above thin-film substrate, even if it is in the state where the thin film was formed as it is, what is the average surface roughness Ra at least not more than 10 nm is obtained spontaneously, furthermore a thin-film substrate in which the average surface roughness Ra is not more than 3 nm, or not more than 2 nm, or not more than 1 nm, can also be produced spontaneously comparatively easily.

A thing in which the average surface roughness Ra is at least not more than 10 nm is obtained by the specular surface polish of the thin-film substrate using the mechanochemical method, etc., moreover a thin-film substrate in which the average surface roughness Ra is not more than 3 nm, or not more than 2 nm, or not more than 1 nm, can also be produced comparatively easily.

Therefore, even if the spontaneous surface smooth nature of the thin film formed on the substrate is low, a thin-film substrate with the target surface smooth nature is producible using the above method of polishing or grinding, etc.

A light-emitting device excellent in luminous efficiency is producible using the thin-film substrate which has such surface smooth nature.

As mentioned above, the feature of the light-emitting device of this invention is in the point of having used the sintered compact which comprises aluminum nitride as a main component, the various sintered compacts which comprise as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., and the other various sintered compacts which comprise as a main component a ceramic material, such as zirconium oxide, magnesium oxide, magnesium aluminate, titanium oxide, barium titanate, lead titanate zirconate, rare earth oxides such as yttrium oxide, a thorium dioxide, various ferrites, mullite, forsterite, steatite, and glass, etc., for example.

Furthermore, the feature is in the point of having used the various sintered compacts having optical permeability.

In this invention, a light-emitting device can be provided by the methods, wherein it is produced on it using these substrates which comprise a sintered compacts which comprises a ceramic material as a main component as they are, or it is produced on it after forming a thin film which comprises as a main component at least one selected from gallium nitride, indium nitride, and aluminum nitride into these substrates which comprise a sintered compact which comprises a ceramic material as a main component, or it is produced on the thin-film substrate after making into a thin-film substrate by forming a thin film which comprises as a main component at least one selected from gallium nitride, indium nitride, and aluminum nitride into these substrates which comprise a sintered compact which comprises a ceramic material as a main component.

As the above substrates which comprise a sintered compact which comprises a ceramic material as a main component, what is illustrated in Fig. 3, Figs. 5-8, Figs. 10-20, and Figs. 36-38 is used suitably.

As for the thin film which comprises as a main component at least one selected from gallium nitride, indium nitride, and aluminum nitride and is formed on the substrate which comprises a ceramic material as a main component before producing the above light-emitting device, and the thin film which comprises as a main component at least one selected from gallium nitride, indium nitride, and aluminum nitride and is formed on the substrate which comprises a ceramic material as a main component for producing a thin-film substrate, they are formed usually by the methods, such as the Sputtering method, or the Ion plating method, or the Vapor-depositing method, or the MOCVD method, or the MOVPE method, or the other CVD methods, or the Halide VPE methods including a Chloride VPE method, or the MBE method, etc.

As the thin film, what is various crystallization states, such as a single crystal, an amorphous state, a polycrystal, and an orientated polycrystal, can be used.

As the thin film, what is a single layer or what is a multilayer constitution of at least two layers can also be used satisfactory.

When forming the thin film as a single layer, if it is formed in at least one of the crystallization states selected from an amorphous state, a polycrystal, and an orientated polycrystal, a single-crystal thin film in which the characteristics, such as crystallinity and surface smooth nature, are more excellent can be formed on it, so it is desirable when raising the luminous efficiency of a light-emitting device.

When forming the thin film as a single layer, if it is formed in the crystallization state of an orientated polycrystal, a single-crystal thin film in which the characteristics, such as crystallinity and surface smooth nature, are still more excellent can be formed on it, so it is still more desirable.

When these thin films are formed in the orientated polycrystalline state or in the single crystal state, a thing in which the C axis of the crystal was perpendicularly formed to the substrate surface is usually used.

As mentioned above, the thin film may comprise not a single layer constitution but two or more layers (for example, the composition differs, or the crystallization states differ, etc.).

Since the thin film of the surface layer can be formed as a single crystal excellent in crystallinity when the thin film is formed in two or more layers, a light-emitting device excellent in luminous efficiency is producible on it.

In order to form a single-crystal thin film more excellent in crystallinity, it is preferred that the thin film of at least one of the crystallization states selected from an amorphous state, a polycrystal, and an orientated polycrystal is formed beforehand on the above substrate which comprises a sintered compact which comprises a ceramic material as a main component.

It is still more preferred to form the thin film of an orientated polycrystalline state beforehand.

The thin film may have conductivity, but it does not necessarily need to have conductivity.

Conductivity can be given comparatively easily by making the thin film into N type semiconductor or P type semiconductor by adding doping components, such as Si (silicon), Ge (germanium), Se (selenium), Te (tellurium), O (oxygen), Mg (magnesium), Be (beryllium), Ca (calcium), Zn (zinc), Cd (cadmium), and C (carbon), etc., to the main components in the thin film.

According to this invention, a light-emitting device which has high luminous efficiency can be manufactured now using the sintered compact which comprises a ceramic material as a main component, and the sintered compact which comprises a ceramic material as a main component and has optical permeability, as a substrate for light-emitting device production.

In this invention, it is possible to raise the luminous efficiency of a light-emitting device furthermore.

There are at least two methods specifically described below.

That is,
1) using as a substrate at least one of the sintered compacts selected from the sintered compact which comprises a ceramic material as a main component and has comparatively large surface roughness, and the sintered compact which comprises a ceramic material as a main component and has optical permeability,
2) using what includes at least gallium nitride or what comprises gallium nitride as a main component, as the thin film formed on the sintered compact selected from the sintered compact which comprises a ceramic material as a main component, and the sintered compact which comprises a ceramic material as a main component and has optical permeability.

These methods are explained in more detail.

First, about the method of the above 1), the luminous efficiency of a light-emitting device improves by changing the surface of a sintered compact which comprises a ceramic material as a main component and forms a laminated body which constitutes a light-emitting device and which comprises the thin film comprising at least one selected from gallium nitride, indium nitride, and aluminum nitride as a main component and contains at least N type semiconductor layer, luminescence layer, and P type semiconductor layer, into a state with comparatively much unevenness.

That is, as for the luminous efficiency of the light-emitting device produced using what has comparatively many surface unevenness in the same sintered compact which comprises a ceramic material as a main component, it is at least equivalent compared with the luminous efficiency of the light-emitting device produced using the sintered compact which comprises a ceramic material as a main component and has the surface state of comparatively little unevenness like the surface in which the specular surface polish was carried out, for example, as a substrate for light-emitting device production, and a light-emitting device in which the luminous efficiency is high about 2-50 % is usually brought in many cases.

That is, as for the luminous efficiency of the light-emitting device produced using the sintered compact which comprises a ceramic material as a main component and has the surface state with a little unevenness like the surface in which the specular surface polish was carried out, for example, if it is 10 %, a light-emitting device in which the luminous efficiency is at least 10 % or more, usually 12-60 %, is producible when the sintered compact which comprises a ceramic material as a main component and has the surface state with comparatively many surface unevenness is used as a substrate for light-emitting device production, as mentioned above.

Using the sintered compact which comprises a ceramic material as a main component and has such a surface state, it becomes possible to heighten furthermore the effect in which the sintered compact which comprises a ceramic material as a main component and is aggregates of a particulate originally has and which is easy to raise the luminous efficiency of the light-emitting device.

As for the improvement in luminous efficiency seen when producing a light-emitting device using the above sintered compact which comprises a ceramic material as a main component and has the surface state with comparatively many unevenness, it is seen irrespective of whether the sintered compact which comprises a ceramic material as a main component has optical permeability.

When the sintered compact which comprises a ceramic material as a main component has optical permeability, in the light-emitting device produced using the sintered compact which comprises a ceramic material as a main component, what has comparatively high luminous efficiency is easy to be obtained, and if the sintered compact which comprises a ceramic material as a main component has optical permeability and is what is in the surface state with comparatively much unevenness, in other words, what is the surface roughness large, in the light-emitting device produced using the sintered compact which comprises a ceramic material as a main component, what has still higher luminous efficiency is easy to be obtained.

In this invention, in the light-emitting device produced using a thing with the optical transmissivity not less than 80 %, such as the sintered compact comprising gallium nitride as a main component, the sintered compact comprising aluminum nitride as a main component, and the sintered compact comprising zinc oxide as a main component, etc., what is the luminous efficiency not less than 70 % is producible.

And, even if the sintered compact which comprises a ceramic material as a main component is what does not have optical permeability, if it is in the surface state with comparatively much unevenness, in the light-emitting device produced using the sintered compact which comprises a ceramic material as a main component, what has higher luminous efficiency is easy to be obtained if compared with the light-emitting device produced using the thing which is the surface state with comparatively little unevenness.

That the surface of the sintered compact which comprises a ceramic material as a main component is in a state with comparatively much unevenness usually means that the surface smooth nature is small, the state where the surface roughness is large if it puts in another way.

As the things in which the surface of a sintered compact which comprises a ceramic material as a main component is in a state with comparatively much unevenness, they include not only a thing which comprises a comparatively irregular concavo-convex state, such as the as-fired surface, the surface by which lap grinding was carried out, the surface by which blast polish was carried out, or the surface etched (corroded) chemically, but also a thing in which regular unevenness, such as the shape of a grid, circle form, and straight line, was formed by giving mechanical processings, such as the slot end, for example.

As the machining, such as the slot end, etc., the method of using diamond tools, such as a diamond blade and a diamond drill, the method of using an ultrasonic wave, and the method of using laser, etc., are used suitably, for example.

The above formation of regular unevenness, such as the shape of a grid, circle form, and straight line, can attain not only by the mechanical processing method but also by the method which etches by the medical fluid chemically, or by the dry process, such as RIE (reactant ion etching), ECR (electronic cyclotron resonance), and ion milling, etc. which use an ion beam and a plasma gas, etc. containing components, such as inert gas, fluorine, and oxygen, or processes by the physical method by the sandblast, etc., to an opening portion of the sintered compact which comprises a ceramic material as a main component by giving masks, such as a resist in which a regular opening is formed, onto the sintered compact which comprises a ceramic material as a main component.

In this invention, a sintered compact which comprises a ceramic material as a main component and has large surface roughness can be obtained by processing the sintered compact which comprises a ceramic material as a main component using the mechanical method, the physical method, or the chemical method, etc., as mentioned above.

On the other hand, in this invention, a sintered compact which comprises a ceramic material as a main component and has large surface roughness can be obtained even if it is the as-fired thing which fired a powder compact, even if it does not process especially the surface of a sintered compact which comprises a ceramic material as a main component using the mechanical method, the physical method, or the chemical method, etc.

When the sintered compact which comprises a ceramic material as a main component and has large surface roughness is obtained in the as-fired state, the sintered compact which comprises as a main component a ceramic material may have the large state of surface roughness spontaneously in the firing process of a powder compact even if it is not what enlarged surface roughness especially as a powder compact before firing.

When the sintered compact which comprises a ceramic material as a main component and has large surface roughness is obtained in the as-fired state, it is also effective to use the large thing of surface roughness as a powder compact before firing.

If it says more concretely, a sintered compact which comprises a ceramic material as a main component and has large surface roughness in the as-fired state is producible by firing the powder compact by processing a powder compact produced by the molding method, such as sheet forming, uniaxial press molding, isostatic press molding, slip casting, or extrusion molding, etc., from the target powder which comprises a ceramic material as a main component into the state of large surface roughness.

As the above method which enlarges the surface roughness of a powder compact, there is the method of processing later the surface of the produced powder compact by the mechanical methods, such as a slot end, a sandblast, and a brush polish, etc., or by the physical method or chemical method, etc., in addition to this

In the case of the method of processing later the above powder compact and enlarging surface roughness of a powder compact, the method, such that the mould which has proper form, such as unevenness, and the implement which has the shape of a needle and a cylindrical form, are forced to a powder compact, the thing of the form formed in the above mould and implement is formed on the surface of a powder compact, and the target powder compact of large surface roughness is obtained, can be used.

For example, when a sheet-like powder compact is produced by the sheet forming by the doctor blade method, etc. and the surface roughness of the powder compact is enlarged, the method of enlarging later the surface roughness of a powder compact can be effectively adapted because the above sheet forming object is easy to have the surface state spontaneously formed in the dryness process of a solvent and the control range of surface roughness is narrow in many cases, it is possible to produce the sheet forming object of arbitrary surface roughness.

When the thing of large surface roughness is formed by forcing later the above mould and implement which are illustrated to the surface of a powder compact, though it can also carry out at room temperature, a thing of the form formed in the mould and implement becomes much easier to be formed in the surface of a powder compact using what changed the powder compact into the soft state by heating the powder compact suitably, for example in the temperature range of about room temperature-200 degree C by the kind and quantity, etc. of a binder, a plasticizer, etc. which are contained, and the powder compact which has the target surface roughness is producible more suitably, as the result.

As for the method which produces the powder compact of large surface roughness by forcing the mould and implement using the powder compact which was heated and was changed into the soft state, for example, it can be used suitably for the case which enlarges the surface roughness of the powder compact of the shape of a sheet by the doctor blade method.

In the above-illustrated method which obtains the target powder compact of the large surface roughness by forcing the mould and implement to a powder compact, the pressure when forcing the mould and implement is usually not more than 200 Kg/cm², and an effect can demonstrate enough.

When it heats and the powder compact of a soft state is used, usually, an effect can demonstrate enough by the pressure not more than 100 kg/cm².

As the method which enlarges the surface roughness of the above powder compact, there is the method of enlarging surface roughness of the powder compact simultaneously at the time of fabricating, it can use suitably.

For example, when a powder compact is produced by the uniaxial press molding, hydrostatic pressure molding, or slip cast molding, etc., the powder compact in which the form of unevenness and slot, etc. was formed simultaneously at the time of fabrication is producible by giving the proper form, such as unevenness and slot, to the mould, such as a metal die, a rubber mould, or a gypsum mould for fabrication, and a powder compact which has the target surface state is obtained, as the result.

For example, when a powder compact is produced by extrusion molding, a powder compact in which the form, such as a slot or unevenness, was formed simultaneously at the time of molding in the molding direction is producible if what gave the form, such as unevenness, is used for the cap for molding, and a powder compact of large surface roughness is obtained as the result.

Of course, in the powder compact produced using the uniaxial press molding, hydrostatic pressure molding, slip cast molding, or extrusion molding which are illustrated above, the surface roughness can be enlarged not only by the method which enlarges the surface roughness simultaneously at the time of molding but also by the mechanical, physical, or chemical method, etc. at post forming.

A sintered compact which comprises a ceramic material as a main component and has large surface roughness can be obtained using such powder compact which enlarged the surface roughness at post forming or simultaneously at the time of molding.

In addition, when the sintered compact which comprises a ceramic material as a main component and has large surface roughness is obtained in the as-fired state, high-pressure firing methods, such as the hot press and HIP method, can also be used.

For example, if a hot press is carried out using moulds, such as a product made from carbon which gave proper form, such as unevenness and a slot, the powder for molding which comprises a ceramic material as a main component is sintered and the sintered compact which comprises a ceramic material as a main component and in which the form of unevenness, a slot, etc. was formed simultaneously is producible, and the sintered compact which comprises a ceramic material as a main component and has the target surface roughness is obtained in the as-fired state, as the result.

In this invention, a sintered compact which comprises a ceramic material as a main component and has large surface roughness can be obtained by processing the sintered compact which comprises a ceramic material as a main component using the mechanical method, the physical method, or the chemical method, etc., as mentioned above.

A sintered compact which comprises a ceramic material as a main component and has large surface roughness spontaneously can be obtained in the as-fired state.

Furthermore, a sintered compact which comprises a ceramic material as a main component and has large surface roughness can be obtained by firing using the powder compact of large surface roughness

In this invention, a single-crystal thin film which comprises as a main component at least one selected from gallium nitride, indium nitride, and aluminum nitride can be formed in the above-illustrated sintered compact which comprises a ceramic material as a main component and has large surface roughness.

The single-crystal thin film can be formed not only in the sintered compact which comprises a ceramic material as a main component and has large surface roughness and which formed beforehand the thin film which comprises as a main component at least one selected from gallium nitride, indium nitride, and aluminum nitride and has the crystallization states, such as an amorphous state, a polycrystal, an orientated polycrystal, and a single crystal, etc., but also directly in the sintered compact which comprises a ceramic material as a main component and has large surface roughness.

The single-crystal thin film can be formed directly on it by devising the formation method even if it is the sintered compact which comprises a ceramic material as a main component and has large surface roughness.

For example, it can be formed directly by the device, such that the gallium component, indium component, and aluminum component which are used as the raw material of a thin film are supplied from a specific direction to the sintered compact which comprises a ceramic material as a main component and has large surface roughness.

Speaking more concretely, a single-crystal thin film which comprises as a main component at least one selected from gallium nitride, indium nitride, and aluminum nitride can be formed directly on the sintered compact which comprises a ceramic material as a main component and has large surface roughness, if the gallium component, indium component, and aluminum component which are used as the raw material of a thin film are supplied from the direction selected from the perpendicular, parallel, and slant, to the surface of the substrate which comprises a sintered compact which comprises a ceramic material as a main component.

Usually, a single-crystal thin film which comprises as a main component at least one selected from gallium nitride, indium nitride, and aluminum nitride and is excellent in crystallinity can be formed directly on the sintered compact which comprises a ceramic material as a main component and has large surface roughness, if the gallium component, indium component, and aluminum component which are used as the raw material of a thin film are supplied from at least two directions selected from the perpendicular, parallel, and slant, to the surface of the substrate which comprises a sintered compact which comprises a ceramic material as a main component.

A single-crystal thin film which comprises as a main component at least one selected from gallium nitride, indium nitride, and aluminum nitride can be formed directly on the sintered compact which comprises a ceramic material as a main component and has large surface roughness, if the raw material of a thin film is supplied by at least seven following methods, that is,
1) the above gallium component, indium component, and aluminum component which are used as the raw material of a thin film are supplied from the perpendicular direction to the substrate surface which comprises sintered compact which comprises a ceramic material as a main component,
2) the above gallium component, indium component, and aluminum component which are used as the raw material of a thin film are supplied from the parallel direction to the substrate surface which comprises sintered compact which comprises a ceramic material as a main component,
3) the above gallium component, indium component, and aluminum component which are used as the raw material of a thin film are supplied from the slanted direction to the substrate surface which comprises sintered compact which comprises a ceramic material as a main component,
4) the above gallium component, indium component, and aluminum component which are used as the raw material of a thin film are supplied from the two directions of a perpendicular direction and a parallel direction to the substrate surface which comprises sintered compact which comprises a ceramic material as a main component,
5) the above gallium component, indium component, and aluminum component which are used as the raw material of a thin film are supplied from the two directions of a perpendicular direction and a slanted direction to the substrate surface which comprises sintered compact which comprises a ceramic material as a main component,
6) the above gallium component, indium component, and aluminum component which are used as the raw material of a thin film are supplied from the two directions of a parallel direction and a slanted direction to the substrate surface which comprises sintered compact which comprises a ceramic material as a main component,
7) the above gallium component, indium component, and aluminum component which are used as the raw material of a thin film are supplied from the three directions of a perpendicular direction, a parallel direction, and a slanted direction to the substrate surface which comprises sintered compact which comprises a ceramic material as a main component.

In addition, that the supply direction of the gallium component, indium component, and aluminum component which are used as the raw material of a thin film is slanting means that the supply direction to a substrate surface is all the direction other than the perpendicular and parallel direction.

In this invention, in the single-crystal thin film which comprises as a main component at least one selected from gallium nitride, indium nitride, and aluminum nitride, since what has good crystallinity is formed in many cases by the method which produces the thing of the target composition by the nitriding reaction with reactive gas, such as ammonia, after the compound containing a gallium component, an indium component, and an aluminum component is once decomposed by the MOCVD method or the halide VPE method, for example, it is easy to supply the raw material of a thin film from a specific direction, and it can become possible to form a single-crystal thin film effectively.

Speaking more concretely, for example, when a single-crystal thin film is formed using the MOCVD method or the halide VPE method, a single-crystal thin film which comprises as a main component at least one selected from gallium nitride, indium nitride, and aluminum nitride can be formed directly on the surface even if it is the sintered compact which comprises a ceramic material as a main component and has comparatively large surface roughness, for example, if the organic gallium compound, organic indium compound, organic aluminium compound, halogenated gallium compound, halogenated indium compound, and halogenated aluminum compound which are the main raw material are supplied from at least one or more directions selected from perpendicular, parallel, and slanted direction to the surface of the substrate which comprises a sintered compact which comprises a ceramic material as a main component.

Usually, in order to raise the crystallinity of the single-crystal thin film formed, it is desirable that for example, the organic gallium compound, organic indium compound, organic aluminium compound, halogenated gallium compound, halogenated indium compound, and halogenated aluminum compound which are the main raw material are supplied from at least two directions selected from perpendicular, parallel, and slanted direction to the surface of the substrate which comprises a sintered compact which comprises a ceramic material as a main component.

As the single-crystal thin film, what is comparatively excellent in crystallinity, such that the half width of the rocking curve of the X ray diffraction from the lattice plane of a Miller Index (002) is not more than 300 seconds at least, can be formed.

When methods, such as the MOCVD method or the halide VPE method, are used, usually, the main raw material containing a gallium component, an indium component, and an aluminum component is supplied with career gas, such as hydrogen, nitrogen + hydrogen, or argon.

It is also desirable that ammonia, nitrogen, or hydrogen, etc. which are reactive gas are supplied from at least one or preferably two or more directions selected from perpendicular, parallel, and slanted direction to the surface of the substrate which comprises a sintered compact which comprises a ceramic material as a main component, when a single-crystal thin film which comprises as a main component at least one selected from gallium nitride, indium nitride, and aluminum nitride is formed directly on the sintered compact which comprises a ceramic material as a main component.

Thus, in this invention, a single-crystal thin film which comprises as a main component at least one selected from gallium nitride, indium nitride, and aluminum nitride can be formed even if it is the sintered compact which comprises a ceramic material as a main component and has large surface roughness.

As the result, in this invention, a light-emitting device which has high luminous efficiency is producible using the sintered compact which comprises a ceramic material as a main component and has large surface roughness.

In addition, to the sintered compact which comprises aluminum nitride as a main component and has large surface roughness, or the sintered compact which has large surface roughness and which comprises a ceramic material as a main component and has at least one of the crystal structures selected from a hexagonal system or a trigonal system, such as a sintered compact which comprises zinc oxide as a main component, a sintered compact which comprises beryllium oxide as a main component, a sintered compact which comprises aluminum oxide as a main component, a sintered compact which comprises silicon carbide as a main component, a sintered compact which comprises silicon nitride as a main component, a sintered compact which comprises gallium nitride as a main component, etc., a single-crystal thin film which comprises as a main component at least one selected from gallium nitride, indium nitride, and aluminum nitride can be formed directly eve if the gallium component, indium component, and aluminum component which are used as the raw material of a thin film are not supplied from at least one or at least two directions selected from perpendicular, parallel, and slanted direction to the surface of the substrate which comprises a sintered compact which comprises a ceramic material as a main component, that is, even if it does not limit especially the direction of raw material supply of a thin film, but it is preferred that the gallium component, indium component, and aluminum component which are used as the raw material of a thin film are supplied from at least one, or preferably two or more directions.

In this invention, it was found out that a single-crystal thin film which comprises as a main component at least one selected from gallium nitride, indium nitride, and aluminum nitride can be formed directly eve if it is not the sintered compact which comprises aluminum nitride as a main component, or the sintered compact which comprises as a main component a ceramic material which has at least one of the crystal structures selected from a hexagonal system or a trigonal system, such as a sintered compact which comprises zinc oxide as a main component, a sintered compact which comprises beryllium oxide as a main component, a sintered compact which comprises aluminum oxide as a main component, a sintered compact which comprises silicon carbide as a main component, a sintered compact which comprises silicon nitride as a main component, a sintered compact which comprises gallium nitride as a main component, etc., if the formation method of a thin film is devised as mentioned above, such as, for example, the device wherein the gallium component, indium component, and aluminum component which are used as the raw material of a thin film are supplied from a specific direction to the sintered compact which comprises a ceramic material as a main component.

Speaking more concretely, if the gallium component, indium component, and aluminum component which are used as the raw material of a thin film are supplied from at least one or preferably two or more directions selected from perpendicular, parallel, and slanted direction to the surface of the substrate which comprises a sintered compact which comprises a ceramic material as a main component, it was found out that a single-crystal thin film which comprises as a main component at least one selected from gallium nitride, indium nitride, and aluminum nitride can be formed directly on it even if it is not the sintered compact which comprises aluminum nitride as a main component, or the sintered compact which comprises as a main component a ceramic material which has at least one of the crystal structures selected from a hexagonal system or a trigonal system, such as a sintered compact which comprises zinc oxide as a main component, a sintered compact which comprises beryllium oxide as a main component, a sintered compact which comprises aluminum oxide as a main component, a sintered compact which comprises silicon carbide as a main component, a sintered compact which comprises silicon nitride as a main component, a sintered compact which comprises gallium nitride as a main component, etc.

That is, for example, if a single-crystal thin film which comprises as a main component at least one selected from gallium nitride, indium nitride, and aluminum nitride is going to be formed directly on the sintered compact which comprises as a main component at least one selected from zirconium oxide, magnesium oxide, magnesium aluminate, titanium oxide, barium titanate, lead titanate zirconate, rare earth oxides such as yttrium oxide, thorium oxide, various ferrites, mullite, forsterite, steatite, and glass, it is usually difficult to form a single-crystal thin film in many cases if it is carried out without limiting the direction of raw material supply of a thin film.

On the other hand, if the gallium component, indium component, and aluminum component which are used as the raw material of a thin film are supplied from a specific direction, for example, if they are supplied from at least one or more directions selected from perpendicular, parallel, and slanted direction to the surface of the above substrate which comprises a sintered compact which comprises a ceramic material as a main component, or if a thin film is formed combining at least two different supply directions of a raw material, a single-crystal thin film which comprises as a main component at least one selected from gallium nitride, indium nitride, and aluminum nitride can be formed directly on the sintered compact which comprises as a main component at least one selected from zirconium oxide, magnesium oxide, magnesium aluminate, titanium oxide, barium titanate, lead titanate zirconate, rare earth oxides such as yttrium oxide, thorium oxide, various ferrites, mullite, forsterite, steatite, and glass, for example.

A single-crystal thin film which comprises as a main component at least one selected from gallium nitride, indium nitride, and aluminum nitride can be formed directly on the sintered compacts which comprise a ceramic material as a main component, regardless of the surface state of these sintered compacts which comprise a ceramic material as a main component, for example, even if it is not the thing in which the average surface roughness Ra is comparatively as large as not less than 70 nm, that is, for example, even if it is the thing in which the average surface roughness Ra is not more than 70 nm, if the gallium component, indium component, and aluminum component which are used as the raw material of a thin film are supplied from at least one or preferably two or more directions selected from perpendicular, parallel, and slanted direction to the surface of the substrate which comprises a sintered compact which comprises a ceramic material as a main component, as mentioned above.

As for the reason wherein a single-crystal thin film which comprises as a main component at least one selected from gallium nitride, indium nitride, and aluminum nitride can be formed directly on the sintered compact which comprises a ceramic material as a main component and has large surface roughness, and the sintered compact which comprises a ceramic material as a main component and is not the sintered compact which comprises aluminum nitride as a main component, or the sintered compact which comprises as a main component a ceramic material which has at least one of the crystal structures selected from a hexagonal system or a trigonal system, by supplying the gallium component, indium component, and aluminum component which are used as the raw material of a thin film from at least one or preferably two or more directions selected from perpendicular, parallel, and slanted direction to the surface of the substrate which comprises a sintered compact which comprises a ceramic material as a main component, it is not necessarily clear.

However, this inventor is guessing the reason as follows.

That is, as for the thin film which comprises as a main component at least one selected from gallium nitride, indium nitride, and aluminum nitride, especially, the thin film produced by the nitriding reaction with reactive gas, such as ammonia, after the compound containing a gallium component, an indium component, and an aluminum component is once decomposed by the MOCVD method or the halide VPE method, etc., it seems that it has the character in which C axis tends to grow in the perpendicular direction to a substrate surface originally, but according to the kind of ceramic material, growth of a thin film crystal follows the crystal orientation of a ceramic particle and it becomes easy to be polycrystal-ized if a raw material is supplied only from one direction because a sintered compact which comprises a ceramic material as a main component is constituted with a fine crystal grain which turned to all directions, the power in which a thin film crystal tends to grow is negated or controlled to the crystal orientation of a ceramic particle and the crystal growth to the direction which the thin film has originally becomes easy to be carried out if the raw material is supplied from at least one or more directions or two or more directions furthermore, therefore, it seems that the single-crystal thin film excellent in crystallinity can be formed now directly.

As for the thin film which comprises as a main component at least one selected from gallium nitride, indium nitride, and aluminum nitride and was formed on the sintered compact which comprises a ceramic material as a main component and has comparatively large surface roughness, it can become spontaneously what was excellent in surface smooth nature, and the surface smooth nature or flat nature can be raised also by performing mechanochemical grinding or specular surface polish (grinding or specular surface polish by mechanical chemical operation).

A thing in which the average surface roughness Ra is at least not more than 10 nm is producible by the mechanochemical grinding or specular surface polish even if it is the thin film which comprises as a main component at least one selected from gallium nitride, indium nitride, and aluminum nitride and was formed on the sintered compact which comprises a ceramic material as a main component and has comparatively large surface roughness. And, a thing in which the average surface roughness Ra is not more than 3 nm, or not more than 2 nm, and furthermore not more than 1 nm, is producible.

As mentioned above, a light-emitting device which has high luminous efficiency is producible on it by raising the smooth nature or flat nature of a thin film which comprises as a main component at least one selected from gallium nitride, indium nitride, and aluminum nitride.

It can become possible to improve the crystallinity of the single-crystal thin film formed on the substrate surface and it can become effective, if the following treatment is performed, that is, the above substrate which comprises a sintered compact which comprises a ceramic material as a main component and has comparatively large surface roughness and which formed a thin film which comprises as a main component at least one selected from gallium nitride, indium nitride, and aluminum nitride is immersed in acid, such as hydrofluoric acid (HF), hydrofluoric-nitric acid (mixed acid of HF+HNO₃), nitric acid (HNO₃), hydrochloric acid (HCl), and sulfuric acid (H₂SO₄), for example, or is heated and annealed in non-oxidizing atmosphere containing H₂, N₂, and Ar, etc., or in decompression, or it carries out combining these two or more, etc.

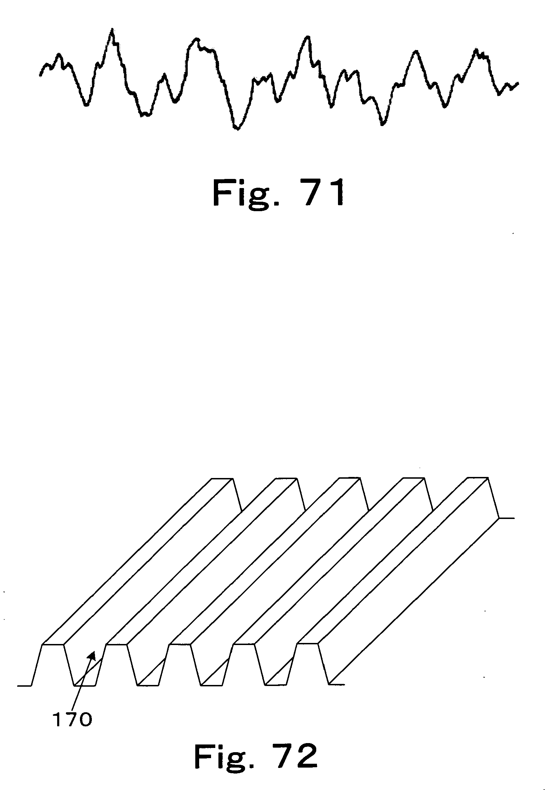

Fig. 71 is a mimetic diagram showing one example of the surface state of the sintered compact which comprises a ceramic material as a main component and has the comparatively irregular concavo-convex surface (in other words, surface roughness is large).

Fig. 72 is a perspective diagram showing one example of the surface state of the sintered compact which comprises a ceramic material as a main component and has the regular concavo-convex surface.

Fig. 72 shows a situation in which the regular concavo-convex surface is formed by providing the straight line-like slot 170 in the surface of a sintered compact which comprises a ceramic material as a main component by mechanical slot end processing and etching by plasma gas, etc., for example.

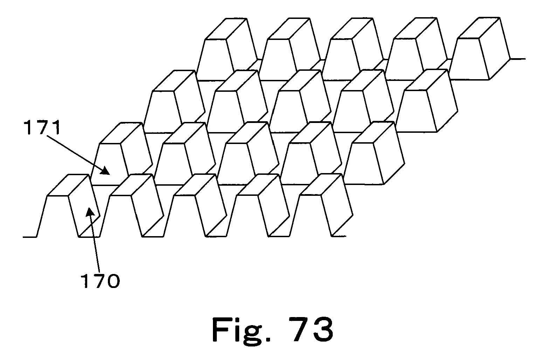

Fig. 73 is a perspective diagram showing one example of the surface state of a sintered compact which comprises a ceramic material as a main component and has the regular concavo-convex surface.

Fig. 73 shows a situation in which the regular concavo-convex grid surface is formed by providing the straight line-like slots 170 and 171 so that it may become mutually right-angled direction in the surface of a sintered compact which comprises a ceramic material as a main component by mechanical slot end processing, for example.

The concavo-convex state (concavo-convex degree) on the surface of a sintered compact which comprises a ceramic material as a main component may usually be expressed by surface smooth nature, i.e., surface roughness, as mentioned above.

Especially, to the surface of the comparatively irregular concavo-convex state illustrated in Fig. 71, the grade of the unevenness can be expressed clearly.

Although surface roughness is expressed by ten-point average surface roughness (Rz), the maximum surface roughness (Rmax), average surface roughness (Ra: arithmetic average roughness), etc., average surface roughness (Ra) is used in this invention.

As for the concavo-convex state (concavo-convex degree) on the surface of a sintered compact in which regular unevenness was given by mechanical processing, etc. and which comprises a ceramic material as a main component, it can be expressed by the above surface roughness, and it can also be expressed by processing form and its size.

In this invention, as the sintered compact which comprises a ceramic material as a main component and has a surface state having comparatively much unevenness, it is preferred to use the thing in which the average surface roughness Ra is not less than 70 nm, usually, not less than 100 nm.

When using the same sintered compact which comprises a ceramic material as a main component, a light-emitting device in which the luminous efficiency is at least equivalent and is usually high about 2-30 % is brought in many cases compared with the light-emitting device produced using a sintered compact which comprises a ceramic material as a main component and is the average surface roughness Ra smaller than 70 nm.

That is, if the luminous efficiency of the light-emitting device produced using the sintered compact which comprises a ceramic material as a main component and is the surface state having little unevenness like the surface in which specular surface polish was carried out is 40%, for example, a light-emitting device wherein the luminous efficiency is at least not less than 40%, and usually the luminous efficiency is 42 %-70 %, is producible, when the above sintered compact which comprises a ceramic material as a main component and has a surface state having comparatively much unevenness is used as a substrate for light-emitting device production.

If the average surface roughness Ra of the sintered compact which comprises a ceramic material as a main component is not less than 70 nm, the effect of the improvement in luminous efficiency of the light-emitting device produced using the sintered compact is accepted in many cases.

For example, when a light-emitting device is produced using the sintered compact which comprises a ceramic material as a main component and has a surface state having comparatively much unevenness in which Ra is 2000 nm or more, the effect of the improvement in luminous efficiency is accepted in many cases if compared with the light-emitting device produced using the same sintered compact which comprises a ceramic material as a main component and is the average surface roughness Ra smaller than 70 nm.

Therefore, it can be used suitably even if the surface state of a sintered compact which comprises a ceramic material as a main component is what kind of thing, if a thin film which comprises as a main component at least one selected from gallium nitride, indium nitride, and aluminum nitride is what can be formed in the state where faults, such as a crack and exfoliation, do not arise.

For example, the various CVD methods, such as the MOCVD method and the halide VPE method, the MBE method, the sputtering method, the ion plating method, the vapor-depositing method, or the PLD method can be used.

When raising the luminous efficiency of a light-emitting device, it is preferred to use a sintered compact which comprises a ceramic material as a main component and formed a single-crystal thin film which comprises as a main component at least one selected from gallium nitride, indium nitride, and aluminum nitride and has high crystallinity, in many cases.

The above single-crystal thin film may be formed directly on the sintered compact which comprises a ceramic material as a main component and has large surface roughness, or may be formed anew on it after a thin film which comprises as a main component at least one selected from gallium nitride, indium nitride, and aluminum nitride and has the crystallization states, such as an amorphous state, a polycrystal, an orientated polycrystal, and a single crystal, etc., is formed beforehand on the sintered compact which comprises a ceramic material as a main component.

That is, it is preferred to form a laminated body which constitutes a light-emitting device and which comprises the thin film comprising at least one selected from gallium nitride, indium nitride, and aluminum nitride as a main component and contains at least N type semiconductor layer, luminescence layer, and P type semiconductor layer in the sintered compact which comprises a ceramic material as a main component and has large surface roughness and which formed a single-crystal thin film, in many cases.

If it is such a method, it becomes hard to generate faults, such as exfoliation in the inside of a thin film, and in the interface of a thin film and a sintered compact which comprises a ceramic material as a main component, even if the sintered compact which comprises a ceramic material as a main component is the average surface roughness Ra of about 5000 nm and is a thing in which there is much unevenness, and a light-emitting device in which the luminous efficiency is high is producible stably.

In addition, in this invention, a thing in which the luminous efficiency is equivalent or superior to the luminous efficiency of the light-emitting device produced using a sintered compact which comprises a ceramic material as a main component and is Ra not less than 70 nm is producible even if it is the light-emitting device produced using what has a surface state in which the average surface roughness Ra is smaller than 70 nm, if the composition, quality, or internal structure of the sintered compact which comprises a ceramic material as a main component is different.

In this invention, when the light-emitting device is produced using a sintered compact which comprises a ceramic material as a main component and has a surface state with comparatively much unevenness, if saying in other words, a sintered compact which comprises a ceramic material as a main component and has large surface roughness, though a laminated body which constitutes the light-emitting device and which comprises the thin film comprising at least one selected from gallium nitride, indium nitride, and aluminum nitride as a main component and contains at least N type semiconductor layer, luminescence layer, and P type semiconductor layer can be formed directly on the above sintered compact which comprises a ceramic material as a main component and has a surface state having comparatively much unevenness, a light-emitting device with higher luminous efficiency is producible if the above laminated body is formed on the sintered compact which comprises a ceramic material as a main component and formed a thin film which comprises as a main component at least one selected from gallium nitride, indium nitride, and aluminum nitride.

The above thin film which comprises as a main component at least one selected from gallium nitride, indium nitride, and aluminum nitride is usually used in at least one crystallization state selected from an amorphous state, a polycrystal, an orientated polycrystal, and a single crystal.

As for the thin film which comprises as a main component at least one selected from gallium nitride, indium nitride, and aluminum nitride and is formed on the above sintered compact which comprises a ceramic material as a main component and has a surface state having comparatively much unevenness, not only the thing of the constitution of only one layer which has at least one crystallization state selected from an amorphous state, a polycrystal, an orientated polycrystal, and a single crystal, but also the thing of the constitution of two or more layers can be used suitably.

As the thin film of the constitution of two or more layers, for example, there is that in which a single-crystal thin film which comprises as a main component at least one selected from gallium nitride, indium nitride, and aluminum nitride is formed further on it after forming beforehand the thin film which has at least one crystallization state selected from an amorphous state, a polycrystal, an orientated polycrystal, and a single crystal, it can be used suitably.

Usually, to use a single-crystal thin film as the thin film formed on the sintered compact which comprises a ceramic material as a main component and has large surface roughness is desirable when raising the luminous efficiency of a light-emitting device.

If the sintered compact which comprises as a main component a ceramic material is the sintered compact which comprises as a main component aluminum nitride, or the sintered compact which comprises as a main component a ceramic material which has the crystal structure of a hexagonal system or a trigonal system, such as silicon carbide, silicon nitride, gallium nitride, beryllium oxide, zinc oxide, and aluminum oxide, a single-crystal thin film which comprises as amain component at least one selected from gallium nitride, indium nitride, and aluminum nitride can be formed directly on the sintered compact which comprises as a main component a ceramic material even if it has a surface state with comparatively much unevenness.

On the other hand, if the gallium component, indium component, and aluminum component which are used as the raw material of a thin film are supplied from a specific direction to the sintered compact which comprises as a main component a ceramic material, a single-crystal thin film which comprises as a main component at least one selected from gallium nitride, indium nitride, and aluminum nitride can be formed directly even if it is things other than the above sintered compact which comprises as a main component aluminum nitride, or sintered compact which comprises as a main component a ceramic material which has the crystal structure of a hexagonal system or a trigonal system, such as silicon carbide, silicon nitride, gallium nitride, beryllium oxide, zinc oxide, and aluminum oxide.

As the single-crystal thin film, a thing which has the crystallinity in which the half width of the rocking curve of the X-ray diffraction line from the lattice plane of the Miller Index (002) is not more than 3600 seconds, usually not more than 300 seconds, is producible.

As mentioned above, a thin film which comprises two or more layers and has at least one crystallization state selected from an amorphous state, a polycrystal, an orientated polycrystal, and a single crystal can be formed on the sintered compact, for example, even if it is the sintered compact which comprises a ceramic material as a main component and has a surface state with comparatively much unevenness.

In this invention, it has explained that the single-crystal thin film stops easily being influenced of the surface smooth nature of the sintered compact, etc., and that a thin film with high crystallinity is producible, if a thin film which comprises as a main component at least one selected from gallium nitride, indium nitride, and aluminum nitride and has at least one crystallization state selected from an amorphous state, a polycrystal, an orientated polycrystal, and a single crystal is formed beforehand and a single-crystal thin film which comprises as a main component at least one selected from gallium nitride, indium nitride, and aluminum nitride is formed furthermore on it.

Usually, a thin film which has at least one crystallization state selected from a single crystal, an amorphous state, a polycrystal, and an orientated polycrystal can be formed directly on it, even if the sintered compact which comprises a ceramic material as a main component is what kind of thing, such as the sintered compact which comprises as a main component zirconium oxide, magnesium oxide, magnesium aluminate, titanium oxide, barium titanate, lead titanate zirconate, a rare earth oxide, thorium oxide, various ferrites, mullite, forsterite, steatite, and glass, etc., other than the sintered compact which comprises aluminum nitride as a main component, or the sintered compact which comprises as a main component a ceramic material which has the crystal structure of a hexagonal system or a trigonal system, such as silicon carbide, silicon nitride, gallium nitride, beryllium oxide, zinc oxide, and aluminum oxide.

A single-crystal thin film which comprises as a main component at least one selected from gallium nitride, indium nitride, and aluminum nitride, and a thin film which has at least one crystallization state selected from an amorphous state, a polycrystal, and an orientated polycrystal, are able to be formed furthermore on the thin film which comprises as a main component at least one selected from gallium nitride, indium nitride, and aluminum nitride and has at least one crystallization state selected from a single crystal, an amorphous state, a polycrystal, and an orientated polycrystal.

Thus, a single-crystal thin film which comprises as a main component at least one selected from gallium nitride, indium nitride, and aluminum nitride can be formed on it also by making the constitution of a thin film into at least two layers, even if the sintered compact which comprises a ceramic material as a main component and has a surface state with comparatively much unevenness is what comprises what kind of material as a main component.

That is, usually, a thin film which comprises two or more layers containing a single-crystal thin film can be formed by the method, such that a single-crystal thin film which comprises as a main component at least one selected from gallium nitride, indium nitride, and aluminum nitride is formed furthermore on it after a thin film which comprises as a main component at least one selected from gallium nitride, indium nitride, and aluminum nitride and has at least one crystallization state selected from an amorphous state, a polycrystal, an orientated polycrystal, and a single crystal is formed beforehand on it, even if the sintered compact which comprises a ceramic material as a main component and has a surface state with comparatively much unevenness is what comprises what kind of ceramic material as a main component, such as, for example, the sintered compact which comprises aluminum nitride as a main component, or the sintered compact which comprises as a main component a ceramic material which has the crystal structure of a hexagonal system or a trigonal system, such as silicon carbide, silicon nitride, gallium nitride, beryllium oxide, zinc oxide, and aluminum oxide, or the sintered compact which comprises as a main component zirconium oxide, magnesium oxide, magnesium aluminate, titanium oxide, barium titanate, lead titanate zirconate, a rare earth oxide, thorium oxide, various ferrites, mullite, forsterite, steatite, and glass, etc.

Among the above thin film which comprises two or more layers, in the single-crystal thin film, a thing in which the half width of the rocking curve of the X-ray diffraction line from the lattice plane of the Miller Index (002) is not more than 300 seconds is producible.

As for the cause, it is not necessarily clear in why the luminous efficiency of the light-emitting device tends to be improved, when a light-emitting device is produced using the sintered compact which comprises a ceramic material as a main component and has a surface state with comparatively much unevenness, as mentioned above.

It is surmised that it is hard to produce reflection or total reflection without depending on the surface state in the interface of the laminated body of N type semiconductor layer, luminescence layer, and P type semiconductor layer which constitute a light-emitting device, or the thin film which was formed beforehand and comprises as a main component at least one selected from gallium nitride, indium nitride, and aluminum nitride and the sintered compact which comprises a ceramic material as a main component from the first, because the sintered compact which comprises a ceramic material as a main component comprises a particulate unlike a single crystal and glass, etc.

It seems that it will be because light becomes hard to be confined in the inside of a laminated body which contains at least N type semiconductor layer, luminescence layer, and P type semiconductor layer which comprise as a main component at least one selected from gallium nitride, indium nitride, and aluminum nitride and which constitute a light-emitting device and it becomes easy to be emitted to the outside of the laminated body (that it is, the outside of a light-emitting device) as the result, because the light from a luminescence layer becomes harder to be reflected or to be total reflected in the interface of the laminated body ofN type semiconductor layer, luminescence layer, and P type semiconductor layer which constitute a light-emitting device and the sintered compact which comprises a ceramic material as a main component, or in the interface of the thin film which was formed beforehand and comprises as a main component at least one selected from gallium nitride, indium nitride, and aluminum nitride and the sintered compact which comprises a ceramic material as a main component, when a light-emitting device is produced using the sintered compact which comprises a ceramic material as a main component and has a surface state with comparatively much unevenness, as mentioned above.

Next, in order to raise the luminous efficiency of a light-emitting device furthermore, it will be explained about the method for producing a light-emitting device using the sintered compact selected from the sintered compact comprising a ceramic material as a main component and the sintered compact comprising a ceramic material as a main component and having optical permeability, wherein the above thin film which includes gallium nitride at least or comprises gallium nitride as a main component is formed.

As for the light-emitting device according to this invention, it is the thing in which a laminated body which contains at least N type semiconductor layer, luminescence layer, and P type semiconductor layer which comprise as a main component at least one selected from gallium nitride, indium nitride, and aluminum nitride and which constitute a light-emitting device is formed on the sintered compact selected from the sintered compact comprising a ceramic material as a main component and the sintered compact comprising a ceramic material as a main component and having optical permeability.

When producing a light-emitting device, although it is also possible to form the above laminated body directly in the sintered compact comprising a ceramic material as a main component and the sintered compact comprising a ceramic material as a main component and having optical permeability, a light-emitting device with higher luminous efficiency is usually producible by forming the above laminated body in the sintered compact comprising a ceramic material as a main component and the sintered compact comprising a ceramic material as a main component and having optical permeability which form a thin film which comprises as a main component at least one selected from gallium nitride, indium nitride, and aluminum nitride.

In addition, as for the thin film which comprises as a main component at least one selected from gallium nitride, indium nitride, and aluminum nitride and is formed on the sintered compact comprising a ceramic material as a main component and the sintered compact comprising a ceramic material as a main component and having optical permeability, it is usually used in at least one crystallization state selected from an amorphous state, a polycrystal, an orientated polycrystal, and a single crystal.

As the thin film which comprises as a main component at least one selected from gallium nitride, indium nitride, and aluminum nitride and is formed on the sintered compact comprising a ceramic material as a main component and the sintered compact comprising a ceramic material as a main component and having optical permeability, it can use not only a thing of the constitution of only one layer but also a thing of the constitution of two or more layers, for example.

As the thin film of the constitution of two or more layers, for example, there is that wherein at least one crystallization state selected from an amorphous state, a polycrystal, an orientated polycrystal, and a single crystal is first formed and a single-crystal thin film which comprises as amain component at least one selected from gallium nitride, indium nitride, and aluminum nitride is formed further on it, and it can be used suitably.

In this invention, although the light-emitting device which has comparatively high luminous efficiency is producible if a light-emitting device is produced using a sintered compact which comprises a ceramic material as a main component and which formed a thin film which comprises as a main component at least one selected from gallium nitride, indium nitride, and aluminum nitride, or a sintered compact which comprises a ceramic material as a main component and has optical permeability and which formed a thin film which comprises as a main component at least one selected from gallium nitride, indium nitride, and aluminum nitride, the light-emitting device which has higher luminous efficiency by using what includes gallium nitride at least or what comprises gallium nitride as a main component is producible, as the thin film formed on the sintered compact which comprises a ceramic material as a main component, or the sintered compact which comprises a ceramic material as a main component and has optical permeability, so it is desirable.

In this invention, if a light-emitting device is produced on it using the above sintered compact which comprises a ceramic material as a main component and which formed a thin film which includes gallium nitride at least or comprises gallium nitride as a main component, or sintered compact which comprises a ceramic material as a main component and has optical permeability and which formed a thin film which includes gallium nitride at least or comprises gallium nitride as a main component, a light-emitting device in which the luminous efficiency is at least equivalent and is usually high about 2-10 % is brought in many cases compared with the light-emitting device produced using the same sintered compact comprising a ceramic material as a main component and sintered compact comprising a ceramic material as a main component and having optical permeability, wherein a thin film which does not include gallium nitride and comprises as a main component at least one selected from indium nitride and aluminum nitride is formed.

That is, a light-emitting device wherein the luminous efficiency is at least not less than 50 %, and usually, the luminous efficiency is 52 %-60 %, is producible when the same sintered compact which comprises a ceramic material as a main component and which formed a thin film which includes gallium nitride at least or comprises gallium nitride as a main component, or the same sintered compact which comprises a ceramic material as a main component and has optical permeability and which formed a thin film which includes gallium nitride at least or comprises gallium nitride as a main component, if the luminous efficiency of the light-emitting device produced using a sintered compact which comprises a ceramic material as a main component and which formed a thin film which comprises as a main component at least one selected from indium nitride and aluminum nitride, or a sintered compact which comprises a ceramic material as a main component and has optical permeability and which formed a thin film which comprises as a main component at least one selected from indium nitride and aluminum nitride, is 50 %, for example.

In this invention, as mentioned above, the luminous efficiency of the light-emitting device will tend to be improved, ifa light-emitting device is produced on it using a sintered compact which comprises a ceramic material as a main component and which formed a thin film which includes gallium nitride at least or comprises gallium nitride as a main component, or a sintered compact which comprises a ceramic material as a main component and has optical permeability and which formed a thin film which includes gallium nitride at least or comprises gallium nitride as a main component.

In this invention, as for the thin film which includes gallium nitride at least or comprises gallium nitride as a main component and which is formed on the sintered compact comprising a ceramic material as a main component or the sintered compact comprising a ceramic material as a main component and having optical permeability, it means a thin film which includes a gallium nitride component at least or comprises a gallium nitride component as a main component.

As the thin film which includes gallium nitride at least or comprises gallium nitride as a main component, it may be the thin film in which at least one selected from indium nitride and aluminum nitride, or the doping components, such as Si and Mg, are included other than a gallium nitride component.

Usually, the thin film which comprises as a main component gallium nitride is what includes a gallium nitride component not less than 50 mol %.

In this invention, even if it is the thin film which includes a gallium nitride component less than 50 mol % in addition to such thin film which comprises as a main component gallium nitride, it can contribute to the improvement in luminous efficiency of a light-emitting device, if a gallium nitride component is included at least.Even if it is a thin film only containing a quantity smaller than 50 mol %

In this invention, the luminous efficiency of the light-emitting device can be improved more, when a light-emitting device is produced using the sintered compact comprising a ceramic material as a main component and the sintered compact comprising a ceramic material as a main component and having optical permeability, wherein a thin film which includes gallium nitride at least or comprises gallium nitride as a main component is formed.

As for the above "thin film which contains gallium nitride at least", if it is explained in another expression, "the thin film which contains gallium nitride at least" means that which has the composition of 0<y≤1 (namely, 0≤x<1, 0≤1-x-y<1) when it is expressed with the chemical formula of AlₓGa_{y}In_{1-x-y}N, for example, in the thin film which is formed on the sintered compact comprising a ceramic material as a main component and on the sintered compact comprising a ceramic material as a main component and having optical permeability, and comprises as a main component at least one selected from gallium nitride, indium nitride, and aluminum nitride.

As for the thin film formed on the sintered compact comprising a ceramic material as a main component and on the sintered compact comprising a ceramic material as a main component and having optical permeability, if it is not only the thing in which all are such a thin film which includes gallium nitride at least or comprises gallium nitride as a main component, but the thing of a constitution in which a thin film which includes gallium nitride at least or comprises as a main component gallium nitride is included in part at least, it contributes to the improvement in luminous efficiency of a light-emitting device in many cases.

That is, the luminous efficiency of the light-emitting device improves, even when a light-emitting device is produced using a sintered compact comprising a ceramic material as a main component and a sintered compact comprising a ceramic material as a main component and having optical permeability, wherein a thin film which comprises as a main component at least one selected from indium nitride and aluminum nitride and a thin film which includes gallium nitride at least or comprises as a main component gallium nitride are formed by combining.

If it says concretely, as the thin film formed on the sintered compact comprising a ceramic material as a main component and on the sintered compact comprising a ceramic material as a main component and having optical permeability, even if a part is the thin film which includes gallium nitride at least or comprises as a main component gallium nitride, and a part is the thin film which comprises as a main component at least one selected from indium nitride and aluminum nitride, the luminous efficiency of a light-emitting device improves.

If it says more concretely, for example, when the thin film formed on the sintered compact comprising a ceramic material as a main component and on the sintered compact comprising a ceramic material as a main component and having optical permeability comprises two layers, it may be a thing wherein all two layers include gallium nitride at least or comprise gallium nitride as a main component, or it may be a thing wherein one layer comprises as a main component at least one selected from indium nitride and aluminum nitride, and one layer includes gallium nitride at least or comprises gallium nitride as a main component.

If a surface (top layer) thin film is a thin film which includes gallium nitride at least or comprises as a main component gallium nitride, the luminous efficiency of a light-emitting device can be improved more.

Thus, the luminous efficiency of the light-emitting device can be improved more, when a light-emitting device is produced using a sintered compact comprising a ceramic material as a main component and a sintered compact comprising a ceramic material as a main component and having optical permeability, wherein the thin film of a constitution which includes a thin film which includes gallium nitride at least or comprises as a main component gallium nitride is formed.

As mentioned above, using a sintered compact which comprises a ceramic material as a main component and which formed a thin film which includes gallium nitride at least or comprises as a main component gallium nitride or a sintered compact which comprises a ceramic material as a main component and has optical permeability and which formed a thin film which includes gallium nitride at least or comprises as a main component gallium nitride, it becomes possible to heighten furthermore the effect of being easy to raise the luminous efficiency of the light-emitting device which a sintered compact which is the aggregate of a particulate and comprises a ceramic material as a main component and a sintered compact which comprises a ceramic material as a main component and has optical permeability originally have.

As for the improvement in luminous efficiency seen when producing a light-emitting device using a sintered compact which comprises a ceramic material as a main component and formed a thin film which includes gallium nitride at least or comprises as a main component gallium nitride, it is seen irrespective of whether the sintered compact which comprises a ceramic material as a main component has optical permeability.

When a sintered compact which comprises as a main component a ceramic material has optical permeability, what has comparatively high luminous efficiency is easy to be obtained in the light-emitting device produced using the sintered compact which comprises a ceramic material as a main component and has optical permeability, and what has higher luminous efficiency is easy to be obtained in the light-emitting device produced using the sintered compact which comprises as a main component a ceramic material if the sintered compact which comprises as a main component a ceramic material has optical permeability and is the thing which formed a thin film which includes gallium nitride at least or comprises as a main component gallium nitride.

In addition, if it is the thing which formed a thin film which includes gallium nitride at least or comprises as a main component gallium nitride even if a sintered compact does not have optical permeability, what has high luminous efficiency is easy to be obtained compared with the light-emitting device produced using the same sintered compact which does not have optical permeability, in the light-emitting device produced using the sintered compact which comprises a ceramic material as a main component.

As for the improvement in luminous efficiency seen when producing a light-emitting device using a sintered compact comprising a ceramic material as a main component and a sintered compact comprising a ceramic material as a main component and having optical permeability, wherein a thin film which includes gallium nitride at least or comprises gallium nitride as a main component is formed, it can be seen similarly even if the sintered compact comprising a ceramic material as a main component and the sintered compact comprising a ceramic material as a main component and having optical permeability are the thing which formed a thin film which includes gallium nitride at least or comprises as a main component gallium nitride, in the sintered compact comprising a ceramic material as a main component and the sintered compact comprising a ceramic material as a main component and having optical permeability which have a surface state of comparatively much unevenness.

In the light-emitting device produced using the sintered compact comprising a ceramic material as a main component and the sintered compact comprising a ceramic material as a main component and having optical permeability which have a surface state with comparatively much unevenness, what has comparatively high luminous efficiency is easy to be obtained, and what has higher luminous efficiency is easy to be obtained in the light-emitting device produced using the thing which formed furthermore a thin film which includes gallium nitride at least or comprises as a main component gallium nitride, in the sintered compact comprising a ceramic material as a main component and the sintered compact comprising a ceramic material as a main component and having optical permeability which have a surface state of comparatively much unevenness.

In this invention, that in which the luminous efficiency is not less than 70 % is producible, in the light-emitting device produced using the thing which formed a thin film which includes gallium nitride at least or comprises as a main component gallium nitride, in the sintered compact comprising gallium nitride as a main component, the sintered compact comprising aluminum nitride as a main component, and the sintered compact comprising zinc oxide as a main component, for example, which have the surface state of comparatively much unevenness where average surface roughness is not less than 70 nm.

As the thin film which includes gallium nitride at least or comprises as a main component gallium nitride, it can use that having at least one crystallization state selected from an amorphous state, a polycrystal, an orientated polycrystal, and a single crystal, for example.

That of not only one layer but the constitution of at least two layers can be suitably used as a thin film constitution.

As the thin film of the constitution of two or more layers, for example, there is that wherein at least one crystallization state selected from an amorphous state, a polycrystal, an orientated polycrystal, and a single crystal is formed beforehand and at least one crystallization state selected from an amorphous state, a polycrystal, an orientated polycrystal, and a single crystal is formed on it further, and it can be used suitably.

Usually, when the thin film which includes gallium nitride at least or comprises as a main component gallium nitride and which forms in the sintered compact comprising a ceramic material as a main component and the sintered compact comprising a ceramic material as a main component and having optical permeability is constituted with two or more layers, it is preferred that a surface thin film (namely, a thin film in which the laminated body containing N type semiconductor layer, luminescence layer, and P type semiconductor layer which constitute a light-emitting device is formed directly) is a single crystal in order to produce the light-emitting device excellent in luminous efficiency.

If the sintered compact which comprises a ceramic material as a main component, and the sintered compact which comprises a ceramic material as a main component and has optical permeability are the sintered compact which comprises aluminum nitride as a main component, or the other sintered compact which comprises as a main component a ceramic material which has the crystal structure of a hexagonal system or a trigonal system, such as silicon carbide, silicon nitride, gallium nitride, beryllium oxide, zinc oxide, and aluminum oxide, a single-crystal thin film which comprises as a main component at least one selected from gallium nitride, indium nitride, and aluminum nitride can be formed on the sintered compact which comprises a ceramic material as a main component, and the sintered compact which comprises a ceramic material as a main component and has optical permeability, and it can be formed directly even if the single-crystal thin film is what includes gallium nitride at least or comprises gallium nitride as a main component.

As the single-crystal thin film which includes gallium nitride at least or comprises gallium nitride as a main component, what has crystallinity in which the half width of the rocking curve of the X-ray diffraction line from the lattice plane of the Miller Index (002) is not more than 3600 seconds is producible.

Usually, a thin film which comprises as a main component at least one selected from gallium nitride, indium nitride, and aluminum nitride and has at least one crystallization state selected from a single crystal, an amorphous state, a polycrystal, and an orientated polycrystal can be formed directly on it even if it comprises as a main component what kind of ceramic material, such as the sintered compact which comprises as a main component zirconium oxide, magnesium oxide, magnesium aluminate, titanium oxide, barium titanate, lead titanate zirconate, a rare earth oxide, thorium oxide, various ferrites, mullite, forsterite, steatite, and glass, etc., in addition to the sintered compact which comprises aluminum nitride as a main component, or the sintered compact which comprises as a main component a ceramic material which has the crystal structure of a hexagonal system or a trigonal system, such as silicon carbide, silicon nitride, gallium nitride, beryllium oxide, zinc oxide, and aluminum oxide, etc., as the sintered compact which comprises a ceramic material as a main component, and the sintered compact which comprises a ceramic material as a main component and has optical permeability. And, it can be formed directly even if the thin film is what includes gallium nitride at least or comprises gallium nitride as a main component.

Although a single-crystal thin film which comprises as a main component at least one selected from gallium nitride, indium nitride, and aluminum nitride, and a thin film which has at least one crystallization state selected from a single crystal, an amorphous state, a polycrystal, and an orientated polycrystal can be formed furthermore on the thin film which has at least one crystallization state selected from an amorphous state, a polycrystal, and an orientated polycrystal, it can be formed even if the thin film includes gallium nitride at least or comprises gallium nitride as a main component.

Thus, even if the sintered compact which comprises a ceramic material as a main component, and the sintered compact which comprises a ceramic material as a main component and has optical permeability are what comprises what kind of material as a main component, a thin film which includes gallium nitride at least or comprises as a main component gallium nitride can be formed in the state of a single crystal on these by making the constitution of a thin film into at least two layers.

At least in the single-crystal thin film among the above thin film which comprises two or more layers, what has crystallinity in which the half width of the rocking curve of the X-ray diffraction line from the lattice plane of the Miller Index (002) is not more than 300 seconds is producible.

As mentioned above, when a light-emitting device is produced using a sintered compact comprising a ceramic material as a main component and a sintered compact comprising a ceramic material as a main component and having optical permeability which form a thin film which includes gallium nitride at least or comprises gallium nitride as a main component, about the cause, it is not necessarily clear in why the luminous efficiency of the light-emitting device is easy to be improved compared with the light-emitting device produced using the sintered compact comprising a ceramic material as a main component and the sintered compact comprising a ceramic material as a main component and having optical permeability which only form a thin film which comprises as a main component at least one selected from indium nitride and aluminum nitride.

When gallium nitride is compared with aluminum nitride, the refractive index of gallium nitride is larger than the refractive index of aluminum nitride.

Therefore, it is surmised that the reflection or total reflection of the light from the luminescence layer is hard to be generated in the interface between the formed thin film which includes gallium nitride at least or comprises gallium nitride as a main component and the sintered compact comprising a ceramic material as a main component and the sintered compact comprising a ceramic material as a main component and having optical permeability, compared with that in the interface between the thin film which comprises aluminum nitride at least as a main component and the sintered compact comprising a ceramic material as a main component and the sintered compact comprising a ceramic material as a main component and having optical permeability.

Therefore, if a light-emitting device is produced using a sintered compact comprising a ceramic material as a main component and a sintered compact comprising a ceramic material as a main component and having optical permeability which form a thin film which includes gallium nitride at least or comprises gallium nitride as a main component, it seems that it will be because light becomes hard to be confined in the inside of a laminated body containing at least N type semiconductor layer, luminescence layer, and P type semiconductor layer which comprise a thin film which comprises as a main component at least one selected from gallium nitride, indium nitride, and aluminum nitride and constitutes a light-emitting device and it becomes easy to be emitted to the outside of the laminated body (namely, the outside of a light-emitting device) as a result, compared with the light-emitting device produced using a sintered compact comprising a ceramic material as a main component and a sintered compact comprising a ceramic material as a main component and having optical permeability which only form a thin film of aluminum nitride or a thin film comprising aluminum nitride as a main component.

It is conjectured that it is easy to produce absorption of light with short wavelength compared with gallium nitride because the band gap energy of a thin film of indium nitride or a thin film which comprises as a main component indium nitride is small compared with gallium nitride, and that therefore the luminous efficiency becomes easy to be lowered, when a light-emitting device is produced using a sintered compact comprising a ceramic material as a main component and a sintered compact comprising a ceramic material as a main component and having optical permeability which only form a thin film of indium nitride or a thin film comprising indium nitride as a main component.

Thus, in this invention, in order to raise the luminous efficiency of a light-emitting device, there are following methods, etc., and it is effective,
1) producing a light-emitting device using the sintered compact which comprises a ceramic material as a main component and has optical permeability,
2) producing a light-emitting device using the sintered compact which comprises a ceramic material as a main component and has a surface state with comparatively much unevenness, if saying in other words, the sintered compact which comprises a ceramic material as a main component and has large surface roughness,
3) producing a light-emitting device using the sintered compact which comprises a ceramic material as a main component and formed a thin film which comprises as a main component at least one selected from gallium nitride, indium nitride, and aluminum nitride,
4) producing a light-emitting device using the sintered compact which comprises a ceramic material as a main component and formed a thin film which includes gallium nitride at least or comprises gallium nitride as a main component, among the sintered compact which comprises a ceramic material as a main component and formed a thin film which comprises as a main component at least one selected from gallium nitride, indium nitride, and aluminum nitride.
   It is effective to raise the luminous efficiency when producing a light-emitting device by combining these methods. For example, there are following methods, etc., and it is effective,
5) roducing a light-emitting device using the sintered compact which comprises a ceramic material as a main component and which has optical permeability and has large surface roughness,
6) producing a light-emitting device using the thing in which a thin film which comprises as a main component at least one selected from gallium nitride, indium nitride, and aluminum nitride is formed on the sintered compact which comprises a ceramic material as a main component and has optical permeability,
7) producing a light-emitting device using the thing in which a thin film which includes gallium nitride at least or comprises as a main component gallium nitride is formed on the sintered compact which comprises a ceramic material as a main component and has optical permeability,
8) producing a light-emitting device using the thing in which a thin film which comprises as a main component at least one selected from gallium nitride, indium nitride, and aluminum nitride is formed on the sintered compact which comprises a ceramic material as a main component and has large surface roughness,
9) producing a light-emitting device using the thing in which a thin film which includes gallium nitride at least or comprises as a main component gallium nitride is formed on the sintered compact which comprises a ceramic material as a main component and has large surface roughness,
10) producing a light-emitting device using the thing in which a thin film which comprises as a main component at least one selected from gallium nitride, indium nitride, and aluminum nitride is formed on the sintered compact which comprises a ceramic material as a main component and which has optical permeability and has large surface roughness,
11) producing a light-emitting device using the thing in which a thin film which includes gallium nitride at least or comprises as a main component gallium nitride is formed on the sintered compact which comprises a ceramic material as a main component and which has optical permeability and has large surface roughness.

It is preferred to use a sintered compact which comprises gallium nitride as a main component, a sintered compact which comprises aluminum nitride as a main component, and a sintered compact which comprises zinc oxide as a main component, etc., as the above sintered compact comprising a ceramic material as a main component and sintered compact comprising a ceramic material as a main component and having optical permeability which are used in order to raise the luminous efficiency of a light-emitting device.

Thus, this invention provides a light-emitting device, wherein the light-emitting device is constituted with a laminated body containing at least N type semiconductor layer, luminescence layer, and P type semiconductor layer which comprise a thin film which comprises as a main component at least one selected from gallium nitride, indium nitride, and aluminum nitride, and the laminated body ofN type semiconductor layer, luminescence layer, and P type semiconductor is formed on the sintered compact which comprises a ceramic material as a main component.

As for the light-emitting device of this invention, it has the feature in which a laminated body containing at least N type semiconductor layer, luminescence layer, and P type semiconductor layer is formed on the sintered compact which comprises a ceramic material as a main component, a thing in which the luminous efficiency is equivalent at least or is a maximum of not less than 4-5 times if compared with the light-emitting device produced using a conventional sapphire substrate, etc., can be provided.

As for the light-emitting device of this invention, although the laminated body which contains N type semiconductor layer, a luminescence layer, and P type semiconductor layer at least is formed on the sintered compact which comprises a ceramic material as a main component and is not homogeneous compared with a single crystal and an orientated polycrystal, etc., a thing in which the luminous efficiency is equivalent at least or is a maximum of not less than 4-5 times if compared with the light-emitting device produced using a conventional sapphire substrate, etc., can be provided.

Hitherto, it has usually regarded that the material which comprises as a main component a ceramic material is not homogeneous, and that it is difficult to grow epitaxially a thin film which comprises as a main component at least one selected from gallium nitride, indium nitride, and aluminum nitride if it is neither a single-crystal substrate nor an orientated polycrystal substrate, the crystallinity is low even if it is able to grow epitaxially, therefore, the luminous efficiency of a light-emitting device which comprises at least a laminated body containing at least N type semiconductor layer, luminescence layer, and P type semiconductor layer was not necessarily in the situation where what is excellent compared with the light-emitting device produced using single-crystal substrates, such as conventional sapphire, can be provided.

It can be said that such conventional common sense and situation were overthrown according to this invention.

It is possible to use not only what does not have optical permeability but also what has optical permeability, as the above sintered compact which comprises a ceramic material as a main component.

If what has optical permeability is used as the sintered compact which comprises a ceramic material as a main component, the luminous efficiency of a light-emitting device will tend to be improved, so it is desirable.

The above laminated body which constitutes a light-emitting device and contains at least N type semiconductor layer, luminescence layer, and P type semiconductor layer can be formed directly not only in the sintered compact which comprises a ceramic material as a main component, but also in the sintered compact which comprises a ceramic material as a main component and formed beforehand a thin film which comprises as a main component at least one selected from gallium nitride, indium nitride, and aluminum nitride.

If the laminated body which contains N type semiconductor layer, luminescence layer, and P type semiconductor layer at least is formed on it using the sintered compact which comprises a ceramic material as a main component and formed beforehand a thin film which comprises as a main component at least one selected from gallium nitride, indium nitride, and aluminum nitride, the luminous efficiency of a light-emitting device tends to be improved, so it is desirable.

In addition, the above ceramic material comprises a thing which comprises as a main component the composite or compound of at least one selected from metal elements and semimetal elements elements and at least one selected from nonmetallic elements, or the composite or compound of at least one selected from metal elements and at least one selected from semimetal elements, or the composite or compound of at least two selected from semimetal elements, for example, aluminum nitride, a material which has at least one of crystal structures selected from a hexagonal system or a trigonal system (for example, silicon carbide, silicon nitride, gallium nitride, zinc oxide, beryllium oxide, and aluminum oxide, etc.), zirconium oxide, magnesium oxide, magnesium aluminate, titanium oxide, barium titanate, lead titanate zirconate, rare earth oxides such as yttrium oxide, thorium oxide, various ferrites, mullite, forsterite, steatite, and glass, etc. which constitute a sintered compact.

As the above nonmetallic element, usually, nitrogen, phosphorus, oxygen, sulfur, and a halogen element (fluorine, chlorine, bromine, iodine, astatine), etc. are used suitably.

As semimetal elements, usually, boron, carbon, silicon, germanium, arsenic, antimony, bismuth, selenium, tellurium, and polonium, etc. are used suitably.

The above ceramic material usually comprises an inorganic compound as a main component, such ceramic material may be the things of crystalline material, or it may be the things of the amorphous state, such as glass, etc., or it may be the things wherein a crystalline material and an amorphous thing are intermingled.

The above ceramic material usually comprises as a main component a compound or a composite, such as a nitride, a carbide, an oxide, a boride, and a silicide.

In addition, in this invention, as the above ceramic material, the thing containing non-metal, such as a metal, an alloy, an intermetallic compound, an organic substance, an organic compound, an organic resin, other halogen element or chalcogen element, etc., for example, is also contained in addition to the inorganic material which is the main components.

In this invention, as for the above sintered compact which comprises a ceramic material as a main component, what has optical permeability is preferred, the crystallinity of a thin film which comprises as a main component at least one selected from gallium nitride, indium nitride, and aluminum nitride becomes easy to be improved, and the luminous efficiency of the light-emitting device which is constituted with a laminated body which contains N type semiconductor layer, luminescence layer, and P type semiconductor layer at least and is formed on the sintered compact which comprises a ceramic material as a main component and has optical permeability can become into what is more excellent thing, so it is preferred.

In this invention, what formed beforehand the thin film which comprises as a main component at least one selected from gallium nitride, indium nitride, and aluminum nitride is preferred as the above sintered compact which comprises a ceramic material as a main component, a single-crystal thin film excellent in crystallinity which comprises as a main component at least one selected from gallium nitride, indium nitride, and aluminum nitride can be formed on the sintered compact which comprises a ceramic material as a main component and formed beforehand the thin film, and the luminous efficiency of the light-emitting device obtained by forming a laminated body containing N type semiconductor layer, luminescence layer, and P type semiconductor layer at least in the sintered compact which comprises a ceramic material as a main component and formed beforehand the thin film can become into what is more excellent thing, so it is preferred.

As for the light-emitting device of this invention, it is,
1) a light-emitting device constituted with the laminated body which comprises a thin film comprising at least one selected from gallium nitride, indium nitride, and aluminum nitride as a main component and contains at least N type semiconductor layer, luminescence layer, and P type semiconductor layer, and the laminated body ofN type semiconductor layer, luminescence layer, and P type semiconductor layer is formed on the sintered compact which comprises a ceramic material as a main component,
   if it says in detail, it includes,
2) a light-emitting device constituted with the laminated body which comprises a thin film comprising at least one selected from gallium nitride, indium nitride, and aluminum nitride as a main component and contains at least N type semiconductor layer, luminescence layer, and P type semiconductor layer, and the laminated body of N type semiconductor layer, luminescence layer, and P type semiconductor layer is formed on the sintered compact which comprises a ceramic material as a main component and has optical permeability.
   It includes,
3) a light-emitting device constituted with the laminated body which comprises a thin film comprising at least one selected from gallium nitride, indium nitride, and aluminum nitride as a main component and contains at least N type semiconductor layer, luminescence layer, and P type semiconductor layer, and the laminated body of N type semiconductor layer, luminescence layer, and P type semiconductor layer is formed on the sintered compact which comprises a ceramic material as a main component and formed a thin film comprising at least one selected from gallium nitride, indium nitride, and aluminum nitride as a main component.
   It includes,
4) a light-emitting device constituted with the laminated body which comprises a thin film comprising at least one selected from gallium nitride, indium nitride, and aluminum nitride as a main component and contains at least N type semiconductor layer, luminescence layer, and P type semiconductor layer, and the laminated body of N type semiconductor layer, luminescence layer, and P type semiconductor layer is formed on the sintered compact which comprises a ceramic material as a main component and formed a single-crystal thin film comprising at least one selected from gallium nitride, indium nitride, and aluminum nitride as a main component.
   It includes,
5) a light-emitting device, wherein the sintered compact which comprises a ceramic material as a main component and is used for the above light-emitting device is a sintered compact which comprises aluminum nitride as a main component.
   It includes,
6) a light-emitting device, wherein the sintered compact which comprises a ceramic material as a main component and is used for the above light-emitting device is a sintered compact which comprises as a main component a material which has at least one of crystal structures selected from a hexagonal system or a trigonal system.
   It includes,
7) a light-emitting device, wherein the ceramic-based sintered compact used for the above light-emitting device is a sintered compact which comprises as a main component at least one selected from zinc oxide, beryllium oxide, aluminum oxide, silicon carbide, silicon nitride, gallium nitride, zirconium oxide, magnesium oxide, magnesium aluminate, titanium oxide, barium titanate, lead titanate zirconate, a rare earth oxide, thorium oxide, various ferrites, mullite, forsterite, steatite, and glass.

As for the light-emitting device of this invention, as mentioned above, it includes the thing in which a laminated body which comprises a thin film comprising at least one selected from gallium nitride, indium nitride, and aluminum nitride as a main component and contains at least N type semiconductor layer, luminescence layer, and P type semiconductor layer is formed directly on the sintered compact which comprises a ceramic material as a main component.

It also includes the thing in which a laminated body which comprises a thin film comprising at least one selected from gallium nitride, indium nitride, and aluminum nitride as a main component and contains at least N type semiconductor layer, luminescence layer, and P type semiconductor layer is formed on the sintered compact which comprises a ceramic material as a main component and formed beforehand a thin film comprising at least one selected from gallium nitride, indium nitride, and aluminum nitride as a main component.

As for the light-emitting device of this invention, as the laminated body which is a constituent factor and comprises a thin film comprising at least one selected from gallium nitride, indium nitride, and aluminum nitride as a main component, it also includes the thing which has buffer layer in addition to the thing which has N type semiconductor layer, luminescence layer, and P type semiconductor layer.

The light-emitting device of this invention does not necessarily need the above buffer layer.

In this invention, it also includes a light-emitting device in which a laminated body ofN type semiconductor layer, luminescence layer, and P type semiconductor layer is formed on the sintered compact which comprises a ceramic material as a main component and does not have a buffer layer.

When a light-emitting device has a buffer layer, usually, the buffer layer is first formed on the sintered compact which comprises a ceramic material as a main component, and the laminated body of N type semiconductor layer, luminescence layer, and P type semiconductor layer is formed after that.

In this invention, when a light-emitting device has a buffer layer, the laminated body which is a constituent factor of a light-emitting device and comprises a thin film which comprises as a main component at least one selected from gallium nitride, indium nitride, and aluminum nitride becomes into a constitution which contains a buffer layer, a N type semiconductor layer, a luminescence layer, and a P type semiconductor layer at least.

As for the buffer layer, usually, it uses the thing of the state where a thin film which comprises as a main component at least one selected from gallium nitride, indium nitride, and aluminum nitride is not grown epitaxially (namely, crystallization state of an amorphous state, a polycrystal, and an orientated polycrystal).

If the thing in which a thin film which comprises as a main component at least one selected from gallium nitride, indium nitride, and aluminum nitride was beforehand formed is used as the above sintered compact which comprises a ceramic material as a main component, an epitaxially grown (namely, single crystal state) thin film which comprises as a main component at least one selected from gallium nitride, indium nitride, and aluminum nitride can also be used comparatively easily as a buffer layer.

Moreover, if the thing in which a thin film which comprises as a main component at least one selected from gallium nitride, indium nitride, and aluminum nitride was beforehand formed is used as the sintered compact which comprises a ceramic material as a main component, as the buffer layer, it may use suitably the thin film which comprises as a main component a compound which has at least one of crystal structures selected from a hexagonal system or a trigonal system, such as silicon carbide, silicon nitride, gallium nitride, zinc oxide, beryllium oxide, etc., or a compound, such as zirconium oxide, magnesium oxide, magnesium aluminate, titanium oxide, barium titanate, lead titanate zirconate, a rare earth oxide, thorium oxide, various ferrites, mullite, forsterite, and steatite.

Hereafter, a light-emitting device is explained using a figure.

Fig. 39 is a sectional view showing the fundamental constitution of a light-emitting device.

That is, the buffer layer 31 is formed on the substrate 30 for light-emitting device production by the thin film which comprises as a main component at least one selected from gallium nitride, indium nitride, and aluminum nitride, and the thin film layer 34 is formed on it by the thin film which has the N type or the P type semiconductor characteristics and comprises as a main component at least one selected from gallium nitride, indium nitride, and aluminum nitride.

The luminescence layer 36 is formed on it by the thin film which comprises as a main component at least one selected from gallium nitride, indium nitride, and aluminum nitride.

The thin film layer 35 is formed on it by the thin film which has the P type or the N type semiconductor characteristics and comprises as a main component at least one selected from gallium nitride, indium nitride, and aluminum nitride.

The thin film layer 35 is adjusted so that it may become the P type semiconductor characteristics if the thin film layer 34 has the N type semiconductor characteristics, the thin film layer 35 is adjusted so that it may become the N type semiconductor characteristics if the thin film layer 34 has the P type semiconductor characteristics.

The electrode 38 is formed on the thin film layer 34 and the thin film layer 35, respectively.

The buffer layer 31 is first formed on the substrate 30 if it requires, the N type semiconductor layer (P type semiconductor layer) 34, the luminescence layer 36, and the P type semiconductor layer (N type semiconductor layer) 35 are laminated on it, the electrode 38 is formed furthermore, and thus, the light-emitting device 32 is constituted as a whole including a substrate.

The light-emitting device drives by impressing direct-current electric power to the electrode 38 formed in N type semiconductor layer and P type semiconductor layer.

Light can be emitted over the wide wavelength range of an ultraviolet-rays domain to a visible light domain, for example, as the wavelength of luminescence, by adjusting the composition of a luminescence layer, etc.

Speaking concretely, it can emit the light of the wavelength range of 250-650 nm, for example, it is usually produced in many cases so that the light of the wavelength range of 300-600 nm can be emitted.

If it explains in detail, in Fig. 39, hitherto, sapphire, etc., for example, has been used as the substrate 30 for light-emitting device production.

In this invention, as the substrate 30 for light-emitting device production, there are what used a sintered compact as the substrate in the state as it is, for example, as illustrated in Fig. 3, Figs. 5-8, Figs. 10-20, and Figs. 36-38, the sintered compact which comprises aluminum nitride as a main component, the sintered compact which comprises as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., and the other various sintered compacts which comprise as a main component a ceramic material, such as zirconium oxide, magnesium oxide, magnesium aluminate, titanium oxide, barium titanate, lead titanate zirconate, rare earth oxides such as yttrium oxide, a thorium dioxide, various ferrites, mullite, forsterite, steatite, and glass, etc., or there are some which were used as a thin-film substrate in which the thin film which comprises as a main component at least one selected from gallium nitride, indium nitride, and aluminum nitride was formed in these substrates which comprise a sintered compact which comprises a ceramic material as a main component.

On the substrate 30, the buffer layer 31 which comprises a thin film which comprises as a main component at least one selected from gallium nitride, indium nitride, and aluminum nitride is formed by the methods, such as the MOCVD method, the MOVPE method, the other CVD methods, the chloride VPE method, or the MBE method.

Although what is an amorphous state is usually used as the buffer thin film layer 31, in addition to this, what is various crystallization states, such as a polycrystal and an orientated polycrystal, can also be used, and what is the single crystal state which grew epitaxially can also be used furthermore.

Although the buffer layer 31 may have conductivity made into semiconductor of N type or P type, it does not necessarily need to have conductivity.

On the buffer layer 31, the thin film layer 34 which has the N type or the P type semiconductor characteristics and is constituted by the epitaxially grown thin film which comprises as a main component at least one selected from gallium nitride, indium nitride, and aluminum nitride is being formed by the methods, such as the MOCVD method, the MOVPE method, the other CVD methods, the chloride VPE method, or the MBE method.

In addition, usually, the above buffer layer 31 is provided in order to adjust the crystal mismatching between the substrate 30 and the thin film layer 34 and to improve the characteristics, such as the crystallinity and surface smooth nature of the thin film layer 34, but it may be provided if needed, it is also possible to form the thin film layer 34 directly on the substrate 30, and to produce a light-emitting device even if it does not provide especially, in this invention.

Usually, the thin film layer 34 is adjusted so that it may have N type semiconductor characteristics, but it may be P type semiconductor.

Usually, the N type semiconductor characteristics are generated by containing donor formation doping components, such as Si (silicon), Ge (germanium), Se (selenium), Te (tellurium), and ○ (oxygen), into the main components which constitute the thin film layer 34.

On the thin film layer 34, the luminescence layer 36 which comprises an epitaxially grown thin film which comprises as a main component at least one selected from gallium nitride, indium nitride, and aluminum nitride is formed.

As for the thin film which constitutes the luminescence layer 36, usually, an undoped type of the thin film which does not contain a doping component, or what contains one or more components selected from the acceptor formation doping component, or what contains one or more components selected from the donor formation doping component, or a (co-doped) thin film which contains simultaneously each one or more components selected from the acceptor formation doping component and the donor formation doping component, is used suitably.

The wavelength of the light emitted from a luminescence layer is controllable by the composition of GaN, InN, and AlN which are used as a luminescence layer, or by the kind of doping component.

The luminescence layer 36 may be what was formed from the single thin film layer, for example, like hetero structure, or double hetero structure, or single quantum well structure, and may be what was constituted with two or more layers, for example, like multi-quantum-well structure.

In the case of the single quantum well structure, the luminescence layer 36 comprises a thin single thin film layer of the single composition which becomes a well layer, for example, not more than 100 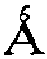 , and it is the structure sandwiched by the barrier layer of N type semiconductor thin film and the barrier layer of P type semiconductor thin film.

For the luminescence layer 36, a thing of the multi-quantum-well structure constituted by laminating alternately the thin thin film which becomes a well layer and a barrier layer and has at least two different composition can also be used.

In the case of the multi-quantum-well structure, as for the thickness of a well layer and a barrier layer, the thing of not more than 150 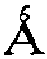 , preferably not more than 100 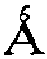 , and still more preferably not more than 70 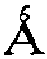 , is used in the well layer, and the thing of not more than 200 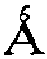 , preferably not more than 150 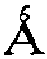 , and still more preferably not more than 100 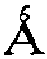 , is usually used in the barrier layer.

In the case of the multi-quantum-well structure, the two thin film layers which are in the most outer layer are usually preferred to be formed by the well layer.

In addition, the above light-emitting device which has hetero structure, double hetero structure, or single quantum well structure is usually used as a light-emitting diode (LED), and the light-emitting device which has multi-quantum-well structure is usually used as a laser diode (LD).

It is also preferred that the above thin film which becomes the well layer and barrier layer which constitute a luminescence layer is usually constituted with an epitaxially grown thin film which comprises as a main component at least one selected from gallium nitride, indium nitride, and aluminum nitride.

Although what has the undoped state which does not add a doping component is usually used as the thin film which becomes the well layer of the single quantum well structure and multi-quantum-well structure, what was semiconductorized into N type or P type respectively by adding the doping component suitably, or what was semiconductorized by adding simultaneously the doping component for semiconductor-izig into N type and P type, etc., can be used.

Although what has the undoped state which does not add a doping component is usually used as the thin film which becomes the barrier layer when the luminescence layer is multi-quantum-well structure, what was semiconductorized into N type or P type by adding the doping component suitably, or what was semiconductorized by adding simultaneously the doping component for semiconductor-izing into N type and P type respectively, etc., can also be used.

As the well layer/barrier layer which constitutes a quantum well layer, there is what has the combination which comprises the composition system, for example, such as InGaN/GaN, InGaN/InGaN (the composition differs, respectively), InGaN/AlGaN, AlGaN/GaN, etc.

Thin film layer 35 constituted by the epitaxially grown thin film which comprises as a main component at least one selected from gallium nitride, indium nitride, and aluminum nitride is formed on the luminescence layer 36.

When the above thin film layer 34 has N type semiconductor characteristics, the thin film layer 35 is adjusted so that it may have P type semiconductor characteristics.

When the above thin film layer 34 has P type semiconductor characteristics, it is adjusted so that it may have N type semiconductor characteristics.

P type semiconductor characteristics are usually generated by containing the acceptor formation doping components, such as Mg (magnesium), Be (beryllium), Ca (calcium), Zn (zinc), Cd (cadmium), and C (carbon), into the main components which constitute the thin film layer 35.

In addition, although the above donor formation doping component and acceptor formation doping component are able to be contained into the main components in any rates in order to make the thin film into N type semiconductor or P type semiconductor, and in order to make the electrical resistivity of the thin film low, they are usually contained in the range of 0.00001-10 mol % on an element basis.

Even if a thin film which comprises as a main component at least one selected from gallium nitride, indium nitride, and aluminum nitride is the undoped type which does not contain a doping component, it has the N type semiconductor characteristics spontaneously, and conductivity may be generated, but it can be used for a light-emitting device even if it is such undoped type thin films.

The electrode 38 which comprises Al, Au, Pt, Ti, Ni, Cr, Sn, Al/Ti, Au/Ni, Au/Ti, Au/Pd, Au/Pt/Ti, etc. is formed in the above thin film layer 34 and the thin film layer 35, luminescence of the device is performed by impressing the direct-current potential from there.

In addition, the above thin film layer 34 and the thin film layer 35 may comprise two or more multi-layers (for example, the composition differs), respectively, other than a single layer constitution.

If it says in more detail, as for the above thin film layer 34 and the thin film layer 35, not only what was constituted as a single layer but also what comprises at least two-layer thin film layers is used suitably, at least one of the layers is a contact layer for connecting with an electrode and a cladding layer linked to a luminescence layer, etc., for example.

As for the contact layer and cladding layer which constitute the above thin film layer 34 and the thin film layer 35, not only a single layer but also a thing in which at least either of the layers is constituted with at least two thin film layers, respectively, can be used suitably.

Even if the thin film layer 34 and the thin film layer 35 are respectively single thin film layers or only either is a single thin film layer, it can also be operated as a barrier layer in case the luminescence layer 36 is used as a well layer of quantum well structure.

For example, when it is going to produce a light-emitting device which has single quantum well structure, a target light-emitting device which has single quantum well structure is also producible by forming the luminescence layer 36 of Fig. 36 as a well layer which comprises a single composition and a thin single thin film layer of not more than 100 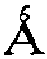 , and by using the thin film layer of a single layer as a barrier layer of the well layer among the thin film layer 34 or the thin film layer 35, for example.

When the thin film layer 34 and the thin film layer 35 comprise a two or more thin film layers, respectively, or only either comprises a two or more thin film layers, a single quantum well structure can be formed using the cladding layer which is directly in contact with the luminescence layer among two or more thin film layers as a barrier layer of a well layer.

As for the above thin film layer 34, thin film layer 35, and luminescence layer 36, it is preferred that it is usually the single crystal which grew epitaxially, respectively, in order to raise the luminous efficiency of a light-emitting device.

As for the crystallinity, it is preferred that the half width of the rocking curve of the X ray diffraction from the lattice plane of the Miller Index (002) of the thin film is not more than 3600 seconds, it is preferred that it is not more than 300 seconds if needed, and it is preferred that it is the crystallinity more than it.

Although it is preferred that the thin film layer 34 and the thin film layer 35 are usually in the single crystal state altogether, when the thin film layer 34 and the thin film layer 35 comprise at least two layers as a contact layer and a cladding layer, as mentioned above, the contact layer for electrode connection may necessarily be the crystallization state of not a single crystal state but an amorphous state, a polycrystal, and an orientated polycrystal.

As for the light-emitting device of this invention, an excellent thing wherein the luminous efficiency is equivalent at least, or not less than 2-3 times, or not less than 3-4 times, or a maximum of not less than 4-5 times compared with the light-emitting device produced using the conventional substrates, such as a sapphire, etc., came to be obtained, using as a substrate the above sintered compact which comprises a ceramic material as a main component as it is instead of the conventional substrate which comprises sapphire, etc., or using the thin-film substrate made by forming in the substrate the thin film which comprises as a main component at least one selected from gallium nitride, indium nitride, and aluminum nitride.

When the light-emitting device is actually produced, it may be the method of preparing only the above substrate which comprises a sintered compact which comprises a ceramic material as a main component and forming each thin film layer one by one on it, or it may be the method of preparing the thin-film substrate wherein at least one layer of thin films which comprise as a main component at least one selected from gallium nitride, indium nitride, and aluminum nitride and have at least one of the crystallization states selected from a single crystal, an amorphous state, a polycrystal, and an orientated polycrystal, etc. is formed beforehand on the above substrate which comprises a sintered compact which comprises a ceramic material as a main component, and each thin film layer is formed further one by one on it.

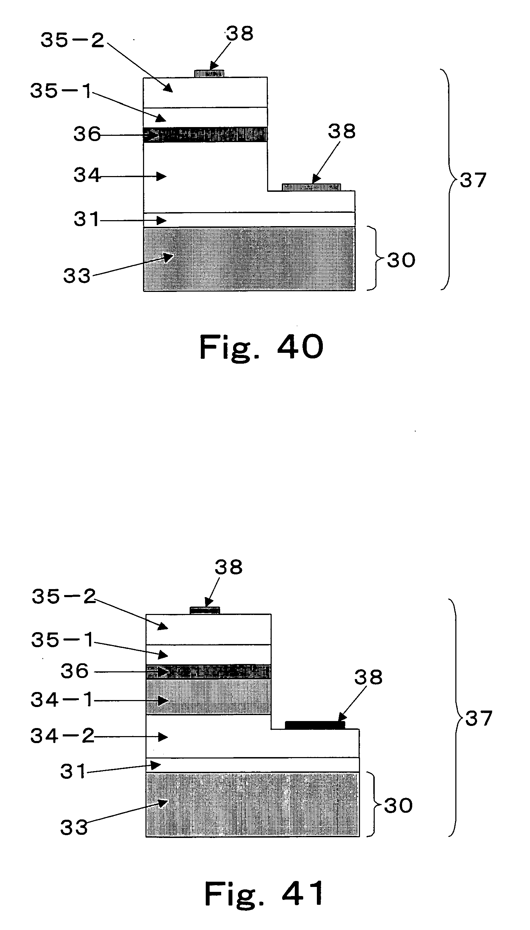

Figs. 40 and 41 are sectional views having shown one example of the light-emitting device produced using conventional substrates, such as a sapphire.

The light-emitting device of the structure illustrated in Fig. 40 is an example in which the thin film layer 35 in Fig. 39 is formed in the state of two layers.

Usually, a light-emitting device of single quantum well structure is produced by such thin film constitution.

In Fig. 40, the buffer layer 31 which comprises a thin film which comprises as a main component at least one selected from gallium nitride, indium nitride, and aluminum nitride is formed on the substrates 33, for example, such as sapphire in which the substrate surface is the C plane (namely, direction where C axis is perpendicular to a substrate surface), by the methods, such as the MOCVD method, or the MOVPE method, or the other CVD methods, or the halide VPE method, such as the Chloride VPE method, or the MBE method, etc.

The substrate 33 is used as the substrate 30 for light-emitting device production as it is. Usually, what formed the GaN thin film of an amorphous state in the thickness of about 100-1500 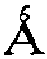 as the buffer thin film layer 31 is used.

On the buffer layer 31, the thin film layer 34 which has N type or P type semiconductor characteristics and is constituted by the epitaxially grown thin film which comprises as a main component at least one selected from gallium nitride, indium nitride, and aluminum nitride is formed by the methods, such as the MOCVD method, or the MOVPE method, or the other CVD methods, or the halide VPE method, such as the Chloride VPE method, or the MBE method.

The thin film layer 34 may function also as a barrier layer of a single quantum well layer.

Usually, the thing in which the epitaxially grown single crystal GaN thin film which doped Si, etc. and has N type semiconductor characteristics is formed in the thickness of about 0.5-20 µm is used as the thin film layer 34.

On the thin film layer 34, the luminescence layer 36 constituted by the epitaxially grown thin film which comprises as a main component at least one selected from gallium nitride, indium nitride, and aluminum nitride is formed by the methods, such as the MOCVD method, or the MOVPE method, or the other CVD methods, or the halide VPE method, such as the Chloride VPE method, or the MBE method.

For example, when a light-emitting device which has single quantum well structure is produced, the luminescence layer 36 in which the undoped thin film of the epitaxially grown single crystal InGaN mixture composition is formed in the thickness of about 5-200 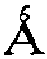 is usually used as the well layer.

The wavelength of the light emitted from a luminescence layer changes by the InGaN composition, that is, the luminescence wavelength is about 520 nm (green) in the composition of In_{0.45}Ga_{0.55}N, the luminescence wavelength is about 450 nm (blue) in the composition of In_{0.20}Ga_{0.80}N, and the luminescence wavelength is about 390 nm (purple) in the composition of In_{0.06}Ga_{0.94}N.

On the luminescence layer 36, the thin film layer 35-1 which has P type or N type semiconductor characteristics and is constituted by the epitaxially grown thin film which comprises as a main component at least one selected from gallium nitride, indium nitride, and aluminum nitride is formed by methods, such as the MOCVD method, or the MOVPE method, or the other CVD methods, or the halide VPE method, such as the Chloride VPE method, or the MBE method.

The thin film layer 35-1 is adjusted to the P type semiconductor characteristics when the thin film layer 34 is N type semiconductor, and the thin film layer 35-1 is adjusted to the N type semiconductor characteristics when the thin film layer 34 is P type semiconductor.

The thin film layer 35-1 may function also as a barrier layer of a single quantum well layer.

Usually, the thing in which the thin film of the epitaxially grown single crystal AlGaN mixture composition which doped Mg, etc. and has P type semiconductor characteristics is formed in the thickness of 0.02 µm 1.0 µm is used as the thin film layer 35-1.

On the thin film layer 35-1, the thin film layer 35-2 which has the same type of semiconductor characteristics as the thin film layer 35-1 and is constituted with the epitaxially grown thin film which comprises as a main component at least one selected from gallium nitride, indium nitride, and aluminum nitride is formed by methods, such as the MOCVD method, or the MOVPE method, or the other CVD methods, or the halide VPE method, such as the Chloride VPE method, or the MBE method.

Usually, the thin film layer 35-2 functions as a contact layer.

What formed the epitaxially grown single crystal GaN thin film in which Mg, etc. was usually doped and which has P type semiconductor characteristics in the thickness of about 0.05-5 µm is used as the thin film layer 35-2.

The thin film layer 34 is used not only as the barrier layer of a well layer but also as the contact layer which forms an electrode.

The electrode 38 which is constituted with Ti/Al or Ni/Au, etc. is formed on the thin film layer 34 and the thin film layer 35.

In addition, in the case of the light-emitting device which emits light with short wavelength, such as a purple-blue color, purple, or ultraviolet rays, in order to lessen absorption of luminescence as much as possible, the thing in which the main component is 100 mol % GaN is not used, but the thing formed with AlGaN of the mixed composition of AlN and GaN is suitably used as the thin film layer 34, the thin film layer 35-1, and the thin film layer 35-2.

Donor formation doping components, such as Si, Ge, Se, Te, and O, and acceptor formation doping components, such as Mg, Be, Ca, Zn, Cd, and C, make a thin film into N type semiconductor or P type semiconductor, furthermore, they can be contained in what kind of rate to the main components in order to lower the electric resistivity of the thin film, but usually they are contained in the range of 0.00001-10 mol % on an element basis.

As illustrated in Fig. 40, the conventional light-emitting device 37 which has single quantum well structure, etc. has been formed by the substrate 33 which comprises a sapphire, etc., buffer layer 31, the thin film layer 34 which has N type semiconductor characteristics (or the thin film layer which has P type semiconductor characteristics), the luminescence layer 36, the thin film layer 35-1 which has P type semiconductor characteristics (or the thin film layer which has N type semiconductor characteristics), the thin film layer 35-2 which has P type semiconductor characteristics (or the thin film layer which has N type semiconductor characteristics), and the electrode 38.

By impressing direct-current electric power to the electrode 38, the light-emitting device is driven and emits light.

The luminous efficiency of the above conventional light-emitting devices which is produced using substrates, such as sapphire, etc., and has the single quantum well structure, etc. is usually about 2-8 %.

Fig. 41 is a sectional view showing one example of the light-emitting device produced using conventional substrates, such as a sapphire, etc., etc.

The light-emitting device of the structure illustrated in Fig. 41 is an example in which the thin film layer 34 and the thin film layer 35 in Fig. 39 were formed in the state of every two layers, respectively.

Usually, the light-emitting device of double hetero structure is produced by such thin film constitution.

In Fig. 41, the buffer layer 31 which comprises a thin film which comprises as a main component at least one selected from gallium nitride, indium nitride, and aluminum nitride is formed on the substrates 33, for example, such as sapphire in which the substrate surface is the C plane (namely, direction where C axis is perpendicular to a substrate surface), by the methods, such as the MOCVD method, or the MOVPE method, or the other CVD methods, or the halide VPE method, such as the Chloride VPE method, or the MBE method, etc.

In addition, the substrate 33 is used as the substrate 30 for light-emitting device production as it is.

As the buffer thin film layer 31, what formed the GaN thin film of an amorphous state in the thickness of about 100-2000 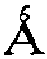 is usually used.

On the buffer layer 31, the thin film layer 34-2 which has N type or P type semiconductor characteristics and is constituted by the epitaxially grown thin film which comprises as a main component at least one selected from gallium nitride, indium nitride, and aluminum nitride is formed by the methods, such as the MOCVD method, or the MOVPE method, or the other CVD methods, or the halide VPE method, such as the Chloride VPE method, or the MBE method, etc.

The thin film layer 34-2 is a contact layer for connecting with the electrode electrically and impressing potential to the luminescence layer.

As the thin film layer 34-2, what formed the epitaxially grown single crystal GaN thin film in which Si, etc. was doped and which has N type semiconductor characteristics in the thickness of about 0.5-20 µm is usually used.

On the luminescence layer 34-2, the thin film layer 34-1 which has N type or P type semiconductor characteristics and is constituted by the epitaxially grown thin film which comprises as a main component at least one selected from gallium nitride, indium nitride, and aluminum nitride is formed by the methods, such as the MOCVD method, or the MOVPE method, or the other CVD methods, or the halide VPE method, such as the Chloride VPE method, or the MBE method, etc.

The thin film layer 34-1 is one of the cladding layers which sandwich the luminescence layer.

As a thin film layer 34-1, what formed the epitaxially grown single crystal AlGaN thin film in which Si, etc. was doped and which has N type semiconductor characteristics in the thickness of about 0.02-1.0 µm is usually used.

The thin film layer 34-1 and the thin film layer 34-2 have the same type of semiconductor characteristics.

On the thin film layer 34-1, the luminescence layer 36 which doped no dopant, or only Zn, or only Si, or Zn and Si simultaneously and which is constituted with the epitaxially grown thin film which comprises as a main component at least one selected from gallium nitride, indium nitride, and aluminum nitride is formed by the methods, such as the MOCVD method, or the MOVPE method, or the other CVD methods, or the halide VPE method, such as the Chloride VPE method, or the MBE method, etc.

For example, when the light-emitting device of double hetero structure is produced, what formed the thin film of the epitaxially grown single crystal InGaN mixture composition which is the undoped one or contains the above doping components in the thickness of about 50-5000 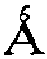 is usually used as the luminescence layer 36.

The wavelength of light emitted from the luminescence layer changes by the kinds of InGaN composition or doped component, the luminescence wavelength is about 450 nm (blue) in the case of the composition of undoped In_{0.20}Ga_{0.80}N, the luminescence wavelength is about 390 nm (purple) in the case of the composition of undoped In_{0.06}Ga_{0.94}N, and the luminescence wavelength is about 450 nm (blue) in the In_{0.06}Ga_{0.94}N composition wherein only Zn is doped or Zn and Si are doped simultaneously.

On the luminescence layer 36, the thin film layer 35-1 which has P type or N type semiconductor characteristics and is constituted with the epitaxially grown thin film which comprises as a main component at least one selected from gallium nitride, indium nitride, and aluminum nitride is formed by the methods, such as the MOCVD method, or the MOVPE method, or the other CVD methods, or the halide VPE method, such as the Chloride VPE method, or the MBE method, etc.

The thin film layer 35-1 is adjusted to the P type semiconductor characteristics when the thin film layer 34-1 is N type semiconductor, and the thin film layer 35-1 is adjusted to the N type semiconductor characteristics when the thin film layer 34-1 is P type semiconductor.

The thin film layer 35-1 functions as a cladding layer which sandwiches the luminescence layer.

As the thin film layer 35-1, what formed the thin film of the epitaxially grown single crystal AlGaN mixture composition in which Mg, etc. was doped and which has P type semiconductor characteristics in the thickness of about 0.02-1.0 µm is usually used.

On the thin film layer 35-1, the thin film layer 35-2 which has the same type of semiconductor characteristics as the thin film layer 35-1 constituted with the epitaxially grown thin film which comprises as a main component at least one selected from gallium nitride, indium nitride, and aluminum nitride is formed by the methods, such as the MOCVD method, or the MOVPE method, or the other CVD methods, or the halide VPE method, such as the Chloride VPE method, or the MBE method, etc.

The thin film layer 35-2 functions as a contact layer.

As a thin film layer 35-2, what formed the epitaxially grown single crystal GaN thin film in which Mg, etc. was doped and which has P type semiconductor characteristics in the thickness of about 0.05-5 µm is usually used.

The electrode 38 which comprised Ti/Al orNi/Au is formed on the thin film layer 34-2 and the thin film layer 35-2.

The light-emitting device shown in Fig. 41 has double hetero structure, wherein the luminescence layer 36 is sandwiched between the two-layer semiconductor thin film layer 34-1, 34-2 and the two-layer semiconductor thin film layers 35-1, 35-2.

In addition, the light-emitting device of the structure in which the luminescence layer is sandwiched, respectively, by a total of a three-layer thin film layer, wherein the above thin film layer 34-1 and thin film layer 35-1 which are the cladding layer are formed furthermore in the state of two layers and the contact layer is included, is also producible.

That is, as such an example, for example, there is the thing which is respectively constituted with two layers, wherein the thin film layer 34-1 comprises the thin film in which the luminescence layer side is the mixture composition of InGaN which doped Si, etc. and the thin film in which the contact layer side is the mixture composition of AlGaN which doped Si, etc., and the thin film layer 35-1 comprises the thin film in which the luminescence layer side is the mixture composition of InGaN which doped Mg, etc. and the thin film in which the contact layer side is the mixture composition of AlGaN which doped Mg, etc.

In addition, in the case of the light-emitting device which emits light with short wavelength, such as a purple-blue color, purple, or ultraviolet rays, in order to lessen absorption of luminescence as much as possible, the thing in which the main component is 100 mol % GaN is not used, but the thing formed with AIGaN of the mixed composition of AlN and GaN is suitably used as the thin film layer 34-1, the thin film layer 34-2, the thin film layer 35-1, and the thin film layer 35-2.

Donor formation doping components, such as Si, Ge, Se, Te, and O, and acceptor formation doping components, such as Mg, Be, Ca, Zn, Cd, and C, make a thin film into N type semiconductor or P type semiconductor, furthermore, they can be contained in what kind of rate to the main components in order to lower the electric resistivity of the thin film, but usually they are contained in the range of 0.00001-10 mol % on an element basis.

As illustrated in Fig. 41, the conventional light-emitting device 37 of the double hetero structure has been formed by the substrate 33 which comprises sapphire, etc., the buffer layer 31, the thin film layer 34-2 which has N type semiconductor characteristics (or the thin film layer which has P type semiconductor characteristics), the thin film layer 34-1 which has N type semiconductor characteristics (or the thin film layer which has P type semiconductor characteristics), the luminescence layer 36, the thin film layer 35-1 which has P type semiconductor characteristics (or the thin film layer which has N type semiconductor characteristics), the thin film layer 35-2 which has P type semiconductor characteristics (or the thin film layer which has N type semiconductor characteristics), and the electrode 38.

The light-emitting device drives and emits light by impressing direct-current electric power to the electrode 38.

The luminous efficiency of the above conventional light-emitting device which is produced using substrates, such as a sapphire, etc., and has double hetero structure is usually about 2-8 %.

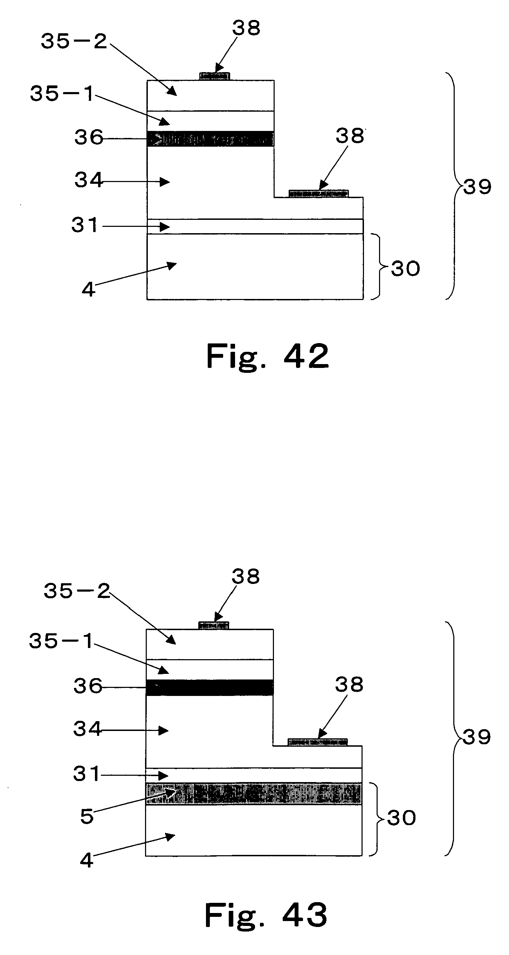

In Figs. 42-61, there show the examples of the light-emitting device produced using the ceramic-based sintered compact of this invention, such as the sintered compact which comprises aluminum nitride as a main component, the sintered compact which comprises as a main component a ceramic material which has the crystal structure of a hexagonal system or a trigonal system, and the sintered compact which comprises a ceramic material as a main component and formed the thin film which comprises at least one which are selected from gallium nitride, indium nitride, and aluminum nitride as a main component, etc.

In Figs. 42-61, there show the situations, wherein the above sintered compacts which comprise as a main component each ceramic material are used as a substrate and the light-emitting device is constituted by laminating N type semiconductor layer, luminescence layer, and P type semiconductor layer which comprise a thin film which is the basic element of a light-emitting device and which comprises as a main component at least one selected from gallium nitride, indium nitride, and aluminum nitride into the substrate.

Fig. 42 is a sectional view showing one example of the light-emitting device of this invention, wherein the substrate which comprises a sintered compact which comprises a ceramic material as a main component is used as the substrate for light-emitting device production as it is, instead of the conventional substrates, such as a sapphire, etc.

That is, in Fig. 42, there shows the situation, wherein the sintered compact which comprises as a main component a ceramic material is used as a substrate 30 for light-emitting device production as it is and the light-emitting device 39 of this invention is formed in the same thin film constitution as what was shown in Fig. 40.

In Fig. 42, the substrate 4 which comprises a sintered compact which comprises a ceramic material as a main component is itself used as a substrate 30 for light-emitting device production.

In the light-emitting device of this invention illustrated in Fig. 42, the thin film layer 34, the thin film layer 35-1, the thin film layer 35-2, and the luminescence layer 36 can be formed usually as a single crystal which grew epitaxially, respectively, in order to raise the luminous efficiency of the light-emitting device.

What has the crystallinity, such that the half width of the rocking curve of the X ray diffraction from the lattice plane of the Miller Index (002) of the thin film is not more than 3600 seconds, usually not more than 300 seconds, and furthermore not more than 100 seconds, can be formed.

Although it is preferred that the thin film layer 34, the thin film layer 35-1, and the thin film layer 35-2 are usually in the single crystal state altogether, the contact layer for electrode connection among the two layers may necessarily be the crystallization state of not a single crystal state but an amorphous state, a polycrystal, and an orientated polycrystal, when the thin film layer 35-2 and the thin film layer 34 comprise two or more layers.

As for the luminous efficiency of the above light-emitting device of this invention which is illustrated in Fig. 42 and is produced using the substrate which comprises a sintered compact which comprises a ceramic material as a main component, it is usually not less than 8 %, and is superior to the luminous efficiency of the conventional light-emitting device produced using substrates, such as a sapphire, etc.

When the sintered compact which comprises aluminum nitride as a main component is used as a substrate 4, the light-emitting device which has luminous efficiency at least not less than 10 % is producible.

Fig. 43 is a sectional view showing one example of the light-emitting device of this invention, wherein at least one layer of thin films which comprise as a main component at least one selected from gallium nitride, indium nitride, and aluminum nitride may be formed on the substrate which comprises a sintered compact which comprises as a main component a ceramic material and it is used as a substrate for light-emitting device production, instead of conventional substrates, such as a sapphire.

That is, in Fig. 43, there shows the situation, wherein the substrate 4 which comprises a sintered compact which comprises a ceramic material as a main component and which formed the thin film 5 which comprises as a main component at least one selected from gallium nitride, indium nitride, and aluminum nitride is used as a substrate 30 for light-emitting device production and the light-emitting device 39 of this invention is formed in the same thin film constitution as what was shown in Fig. 40.

What has at least one of the crystallization states selected from a single crystal, an amorphous state, a polycrystal, and an orientated polycrystal is usually used as the thin film 5.

In Fig. 43, the substrate 30 for light-emitting device production is constituted with the substrate 4 which comprises a sintered compact which comprises a ceramic material as a main component, and the thin film 5 formed on the substrate 4.

In the light-emitting device of this invention illustrated in Fig. 43, the thin film layer 34, the thin film layer 35-1, the thin film layer 35-2, and the luminescence layer 36 can be formed usually as a single crystal which grew epitaxially, respectively, in order to raise the luminous efficiency of the light-emitting device.

What has the crystallinity, such that the half width of the rocking curve of the X ray diffraction from the lattice plane of the Miller Index (002) of the thin film is not more than 3600 seconds, usually not more than 300 seconds, and furthermore not more than 100 seconds, can be formed.

Although it is preferred that the thin film layer 34, the thin film layer 35-1, and the thin film layer 35-2 are usually in the single crystal state altogether, the contact layer for electrode connection among the two layers may necessarily be the crystallization state of not a single crystal state but an amorphous state, a polycrystal, and an orientated polycrystal, when the thin film layer 35-2 and the thin film layer 34 comprise two or more layers.

The luminous efficiency of the above light-emitting device of this invention which is illustrated in Fig. 43 and is produced using the substrate which comprises a sintered compact which comprises a ceramic material as a main component is usually not less than 8 %, and is superior to the luminous efficiency of the conventional light-emitting device produced using substrates, such as a sapphire, etc.

When the sintered compact which comprises aluminum nitride as a main component is used as the substrate 4, the light-emitting device which has luminous efficiency at least not less than 10 % is producible.

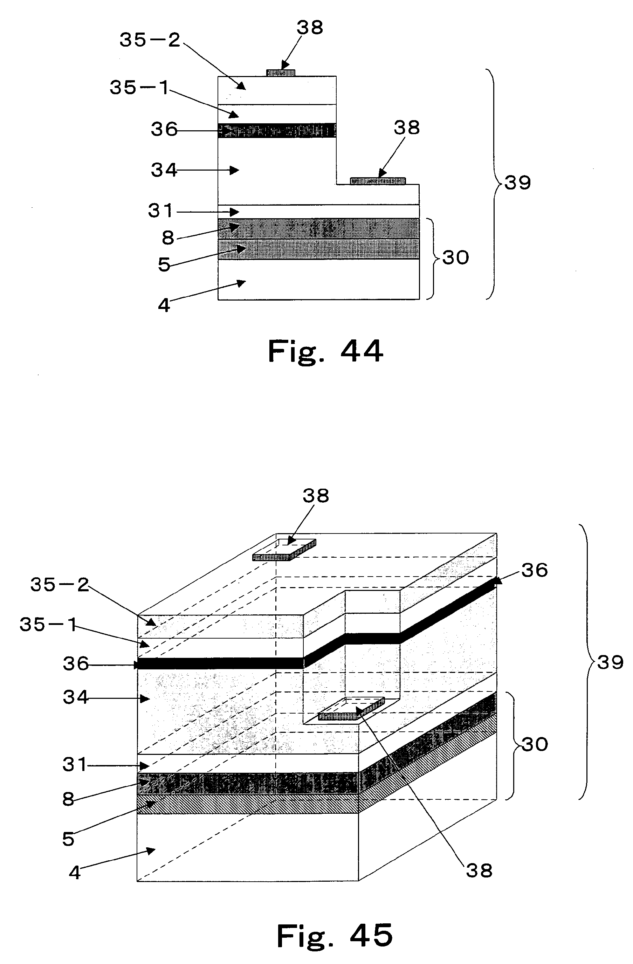

Fig. 44 is a sectional view showing one example of the light-emitting device of this invention, wherein what formed at least two layers of thin films which comprise as a main component at least one selected from gallium nitride, indium nitride, and aluminum nitride onto the substrate which comprises a sintered compact which comprises as a main component a ceramic material is used as a substrate for light-emitting device production, instead of conventional substrates, such as a sapphire.

That is, in Fig. 44, there shows a situation, wherein the thin film 5 which comprises as a main component at least one selected from gallium nitride, indium nitride, and aluminum nitride is formed on the substrate 4 which comprises a sintered compact which comprises a ceramic material as a main component, and the thing which formed at least two layers of thin films by forming furthermore the thin film 8 which comprises as a main component at least one selected from gallium nitride, indium nitride, and aluminum nitride onto it is used as the substrate 30 for light-emitting device production, and the light-emitting device 39 is formed in the same thin film constitution as what was shown in Fig. 40.

As for the thin film 5 and thin film 8, what is at least one of the crystallization states selected from a single crystal, an amorphous state, a polycrystal, and an orientated polycrystal is used usually.

Usually, as for the thin film 8, it is preferred to use what is a single crystal state. In that case, as for the thin film 5, it is preferred to use what is at least one of the crystallization states selected from an amorphous state, a polycrystal, and an orientated polycrystal, and it is furthermore preferred to use what is an orientated polycrystalline state.

In Fig. 44, the substrate 30 for light-emitting device production is constituted with the substrate 4 which comprises a sintered compact which comprises a ceramic material as a main component, the thin film 5 formed on the substrate 4, and the thin film 8.

In the light-emitting device of this invention illustrated in Fig. 44, the thin film layer 34, the thin film layer 35-1, the thin film layer 35-2, and the luminescence layer 36 can be formed usually as a single crystal which grew epitaxially, respectively, in order to raise the luminous efficiency of the light-emitting device.

What has the crystallinity, such that the half width of the rocking curve of the X ray diffraction from the lattice plane of the Miller Index (002) of the thin film is not more than 3600 seconds, usually not more than 300 seconds, and furthermore not more than 100 seconds, can be formed.

Although it is preferred that the thin film layer 34, the thin film layer 35-1, and the thin film layer 35-2 are usually in the single crystal state altogether, the contact layer for electrode connection among the two layers may necessarily be the crystallization state of not a single crystal state but an amorphous state, a polycrystal, and an orientated polycrystal, when the thin film layer 35-2 and the thin film layer 34 comprise two or more layers.

The luminous efficiency of the above light-emitting device of this invention which is illustrated in Fig. 44 and is produced using the substrate which comprises a sintered compact which comprises a ceramic material as a main component is usually not less than 8 %, and is superior to the luminous efficiency of the conventional light-emitting device produced using substrates, such as a sapphire, etc.

When the sintered compact which comprises aluminum nitride as a main component is used as the substrate 4, the light-emitting device which has luminous efficiency at least not less than 10 % is producible.

Fig. 45 is a perspective diagram showing one example of the situation in which the light-emitting device of this invention shown as a sectional view in Fig. 44 was seen aslant.

Fig. 45 shows an example, wherein the substrate which comprises a sintered compact which comprises a ceramic material as a main component and which formed at least two layers of thin films which comprise as a main component at least one selected from gallium nitride, indium nitride, and aluminum nitride is used as a substrate for light-emitting device production, instead of the conventional substrates, such as a sapphire, etc.

In Fig. 45, a situation in which the electrode 38 is formed in the small size by removing a part of corner of the thin film layer 34 by etching, etc. is shown.

The other electrode 38 is formed in the small size in the portion of the corner of the thin film layer 35-2.

The light-emitting device which comprises such electrode arrangement is used for the light-emitting diode (LED) in which the luminescence is usually emitted from the whole luminescence layer surface.

When the electrode is formed in the small size in the portion of the corner of a thin film layer, etc. as illustrated in Fig. 45, or it is although it is not indicated in Fig. 45, when the electrode is formed covering a large area of the thin film layer 34 and the thin film layer 35-2 in order to raise the electric connection, it is preferred to constitute the electrode so that the luminescence may be emitted as much as possible into the outside of the device, as the luminescence from the whole luminescence layer surface is not intercepted as much as possible by the electrode by making the electrode thin to the thickness by which the luminescence from a luminescence layer can be penetrated.

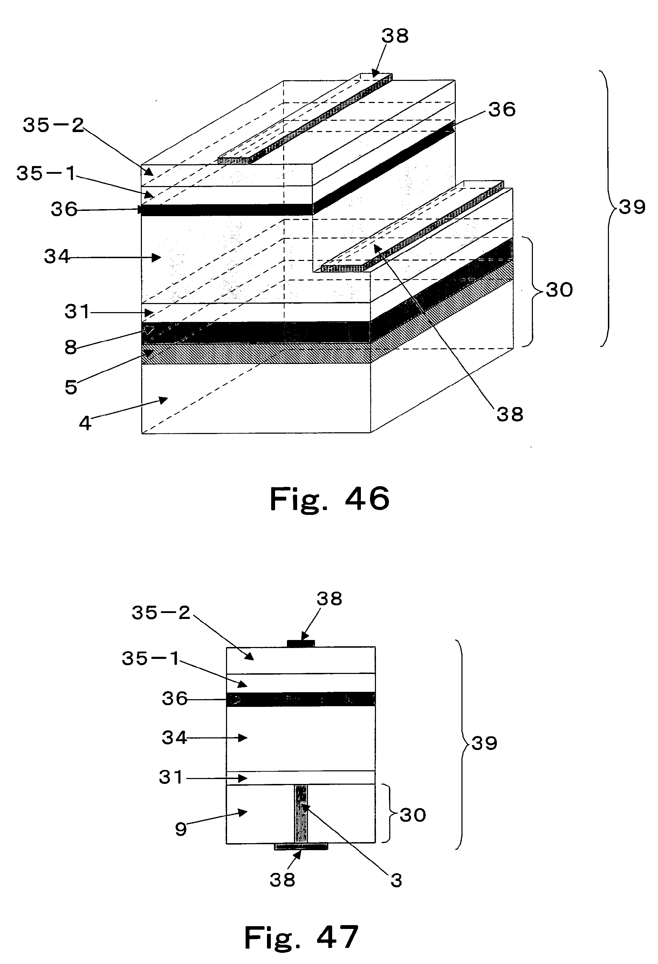

Fig. 46 is a perspective diagram showing one example of the situation in which the light-emitting device of this invention shown as a sectional view in Fig. 44 was seen aslant.

Fig. 46 shows an example, wherein the substrate which comprises a sintered compact which comprises a ceramic material as a main component and which formed at least two layers of thin films which comprise as a main component at least one selected from gallium nitride, indium nitride, and aluminum nitride is used as a substrate for light-emitting device production, instead of the conventional substrates, such as a sapphire, etc.

Fig. 46 shows the example of a light-emitting device in which the electrode arrangement of the light-emitting device of this invention shown in Fig. 45 is not formed in the small size in the corner of a thin film layer, but formed in the belt-like shape over the whole thin film layer.

In Fig. 46, the electrode 38 is formed by removing all the portion of one side of the thin film layer 34 by etching, etc., and other electrode 38 is also formed in the belt-like shape on the thin film layer 35-2.

The light-emitting device which comprises such electrode arrangement is usually used as a laser diode (LD) in which the multiple reflection of the light is carried out within the luminescence layer of the portion immediately under the electrode formed on the thin film layer 35-2 and the luminescence with high energy is performed only in the fixed direction from the luminescence layer like laser light.

When the light-emitting device of the structure illustrated in Fig. 46 is formed as a laser diode, what comprises a sintered compact which comprises aluminum nitride as a main component is preferred as the ceramic substrate 4 which constitutes the substrate 30 for light-emitting device production.

That is, when a laser diode is produced using the conventional substrates, such as a sapphire, etc., in order to mitigate a lattice mismatching, or a disagreement of thermal expansion coefficient, etc., between the substrate and the thin film which comprises as a main component at least one selected from gallium nitride, indium nitride, and aluminum nitride, the method, so-called ELO (Epitaxially Lateral Over-growth) method, wherein the thin film which comprises as a main component at least one selected from gallium nitride, indium nitride, and aluminum nitride is formed anew on the thin film, such as SiO₂, formed beforehand on the belt-like shape and the thin film portion with few dislocation and cracks, etc. is used as a material which functions as a laser diode, is used in many cases. But, on the other hand, if what comprises a sintered compact which comprises aluminum nitride as a main component is used as the substrate 4, there is an effect in which the laser diode excellent in luminous efficiency is producible even if it is used at any portion of the thin film regardless of the specific place of the thin film, because the lattice mismatching or the disagreement of thermal expansion coefficient, etc. are small between the substrate and the thin films which comprise as a main component at least one selected from gallium nitride, indium nitride, and aluminum nitride, and the thin film which has few dislocation and cracks and comprises as a main component at least one selected from gallium nitride, indium nitride, and aluminum nitride can be formed directly on the substrate without forming the thin film, such as SiO₂, as indicated in Fig. 46.

And, as the laser diode, what has high output and long life is easy to be obtained by what is the structure formed so that a luminescence layer may be sandwiched by the thin film layer of the super lattice structure in which the AlGaN mixture composition thin film not more than 100 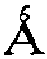 and the GaN thin film not more than 100 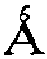 are laminated in tens or more layers of thin films and which is made into N type and P type semiconductor respectively. And, in this invention, especially when the sintered compact which comprises aluminum nitride as a main component is used as a substrate for light-emitting device production, the laser diode with high luminous efficiency, high output, and long life is producible even if it is the thing in which the cladding layer or the contact layer other than the luminescence layer of multi-quantum-well structure is respectively constituted with the thin film of single layer without using the super lattice structure, in addition to the laser diode produced using the thin film layer of such super lattice structure.

Also in the light-emitting device ofthe structure illustrated in Fig. 46, it is preferred that it is the single-crystal thin film which comprises as a main component at least one selected from gallium nitride, indium nitride, and aluminum nitride, as the thin film layer 8 formed on a substrate.

In that case, it is preferred to use what has at least one of the crystallization states selected from an amorphous state, a polycrystal, and an orientated polycrystal as a thin film 5, furthermore, it is more preferred to use what has an orientated polycrystalline state.

When the light-emitting device of the structure illustrated in Fig. 46 is formed as a laser diode, it is preferred to use not the single quantum well structure that comprises a well layer of one layer of thin film but the multi-quantum-well structure which repeated and laminated the well layer and the barrier layer, as the luminescence layer.

When the light-emitting device is formed as a laser diode, as for the thin film layer 34, the thin film layer 35-1, and the thin film layer 34-2, etc., the thing which was suitably multilayered, respectively, and was formed is used.

Fig. 47 is a sectional view showing one example of the light-emitting device of this invention, wherein the substrate which comprises a sintered compact which comprises a ceramic material as a main component and has a conduction via is used as a substrate for light-emitting device production as it is, instead of conventional substrates, such as a sapphire.

That is, in Fig. 47, there shows a situation, wherein the substrate 9 which comprises a sintered compact which comprises a ceramic material as a main component and has a conduction via 3 is used as a substrate 30 for light-emitting device production and the light-emitting device 39 is formed in the same thin film constitution as what was shown in Fig. 40.

In Fig. 47, substrate 9 which comprises a sintered compact which comprises a ceramic material as a main component and has a conduction via 3 is itself used as a substrate 30 for light-emitting device production.

In the case of the light-emitting device of this invention which is illustrated in Fig. 47 and is produced using the substrate 9 which comprises a sintered compact which comprises a ceramic material as a main component and has the conduction via 3, it is not necessary to remove a part of the thin film layer 34 by etching, etc. in order to form the electrode, and the light-emitting device of the constitution in which the electrode 38 was formed in the ceramic substrate 9 and which arranged the electrodes up and down is producible, as shown in Figs. 42-46.

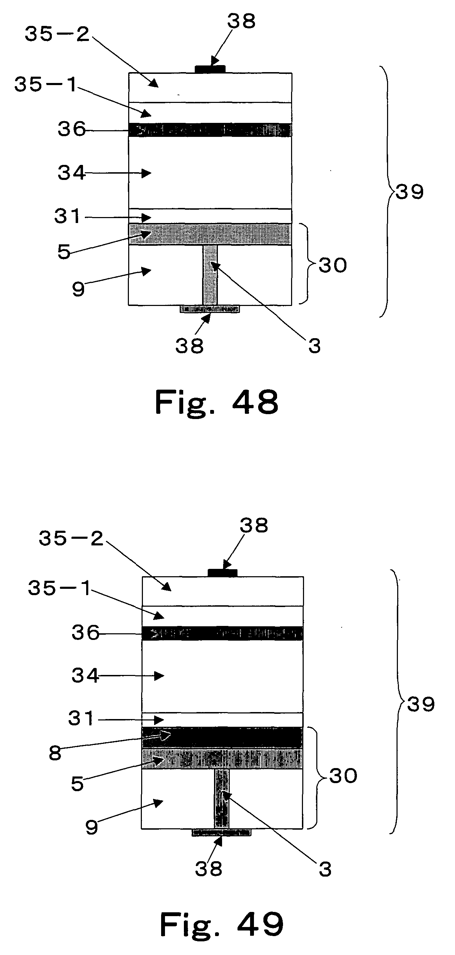

Fig. 48 is a sectional view showing one example of the light-emitting device of this invention, wherein the substrate which comprises a sintered compact which comprises a ceramic material as a main component and has a conduction via and on which at least one layer of thin films which comprise as a main component at least one selected from gallium nitride, indium nitride, and aluminum nitride is formed is used as a substrate for light-emitting device production, instead of conventional substrates, such as a sapphire.

That is, in Fig. 48, there shows situation, wherein the substrate 9 which comprises a sintered compact which comprises a ceramic material as a main component and has a conduction via 3 and which formed the thin film 5 which comprises as a main component at least one selected from gallium nitride, indium nitride, and aluminum nitride is used as a substrate 30 for light-emitting device production and the light-emitting device 39 is formed in the same thin film constitution as what was shown in Fig. 40.

As for the thin film 5, what is at least one of the crystallization states selected from a single crystal, an amorphous state, a polycrystal, and an orientated polycrystal is usually used.

In Fig. 48, the substrate 9 which comprises a sintered compact which comprises a ceramic material as a main component and has a conduction via 3 and which formed the thin film 5 which comprises as a main component at least one selected from gallium nitride, indium nitride, and aluminum nitride is used as a substrate 30 for light-emitting device production.

In the case of the light-emitting device of this invention which is illustrated in Fig. 48 and is produced using the substrate 9 which comprises a sintered compact which comprises a ceramic material as a main component and has the conduction via 3, it is not necessary to remove a part of the thin film layer 34 by etching, etc. as shown in Figs. 42-46 in order to form the electrode, and the light-emitting device of the constitution in which the electrode 38 was formed in the ceramic substrate 9 and which arranged the electrodes up and down is producible by making the thin film 5 into conductivity, as shown in Figs. 42-46.

Fig. 49 is a sectional view showing one example of the light-emitting device of this invention, wherein what formed at least two layers of thin films which comprise as a main component at least one selected from gallium nitride, indium nitride, and aluminum nitride onto the substrate which comprises a sintered compact which comprises a ceramic material as a main component and has a conduction via is used as a substrate for light-emitting device production, instead of conventional substrates, such as a sapphire.

That is, in Fig. 49, there shows a situation, wherein the thin film 5 which comprises as a main component at least one selected from gallium nitride, indium nitride, and aluminum nitride is formed on the substrate 9 which comprises a sintered compact which comprises a ceramic material as a main component and has the conduction via 3, and the thing which formed at least two layers of thin films which formed furthermore the thin film 8 which comprises as a main component at least one selected from gallium nitride, indium nitride, and aluminum nitride onto it is used as the substrate 30 for light-emitting device production, and the light-emitting device 39 is formed in the same thin film constitution as what was shown in Fig. 40.

As for the thin film 5, what is at least one of the crystallization states selected from a single crystal, an amorphous state, a polycrystal, and an orientated polycrystal is usually used.

In Fig. 49, what formed at least two layers of thin films, wherein the thin film 5 which comprises as a main component at least one selected from gallium nitride, indium nitride, and aluminum nitride was formed on the substrate 9 which comprises a sintered compact which comprises a ceramic material as a main component and has the conduction via 3 and the thin film 8 which comprises as a main component at least one selected from gallium nitride, indium nitride, and aluminum nitride is formed furthermore on it, is used as the substrate 30 for light-emitting device production.

In the case of the light-emitting device of this invention which is illustrated in Fig. 49 and is produced using the substrate 9 which comprises a sintered compact which comprises a ceramic material as a main component and which has the conduction via 3, it is not necessary to remove a part of the thin film layer 34 by etching, etc. as shown in Figs. 42-46 in order to form the electrode, and the light-emitting device of the constitution in which the electrode 38 was formed in the ceramic substrate 9 and which arranged the electrodes up and down is producible by making the thin film 5 and the thin film 8 into conductivity, as shown in Figs. 42-46.

In the light-emitting device of this invention which is illustrated in Figs. 47-49 and is produced using the substrate which comprises a sintered compact which comprises a ceramic material as a main component and has a conduction via, the thin film layer 34, the thin film layer 35-1, the thin film layer 35-2, and the luminescence layer 36 can be formed usually as a single crystal which grew epitaxially, respectively, in order to raise the luminous efficiency of the light-emitting device.

What has the crystallinity, such that the half width of the rocking curve of the X ray diffraction from the lattice plane of the Miller Index (002) of the thin film is not more than 3600 seconds, usually not more than 300 seconds, and furthermore not more than 100 seconds, can be formed.

Although it is preferred that the above thin film layer 34, thin film layer 35-1, and thin film layer 5-2 are usually in the single crystal state altogether, the contact layer for electrode connection among the two layers may necessarily be the crystallization state of not a single crystal state but an amorphous state, a polycrystal, and an orientated polycrystal, when the thin film layer 35-2 and the thin film layer 34 comprise two or more layers.

The luminous efficiency of the above light-emitting device of this invention which is illustrated in Figs. 47-49 and is produced using the substrate which comprises a sintered compact which comprises a ceramic material as a main component and has a conduction via is usually not less than 8 %, and is superior to the luminous efficiency of the conventional light-emitting device produced using the substrates, such as a sapphire.

When the sintered compact which comprises aluminum nitride as a main component is used as a substrate 9, the light-emitting device which has the luminous efficiency at least not less than 10 % is producible.

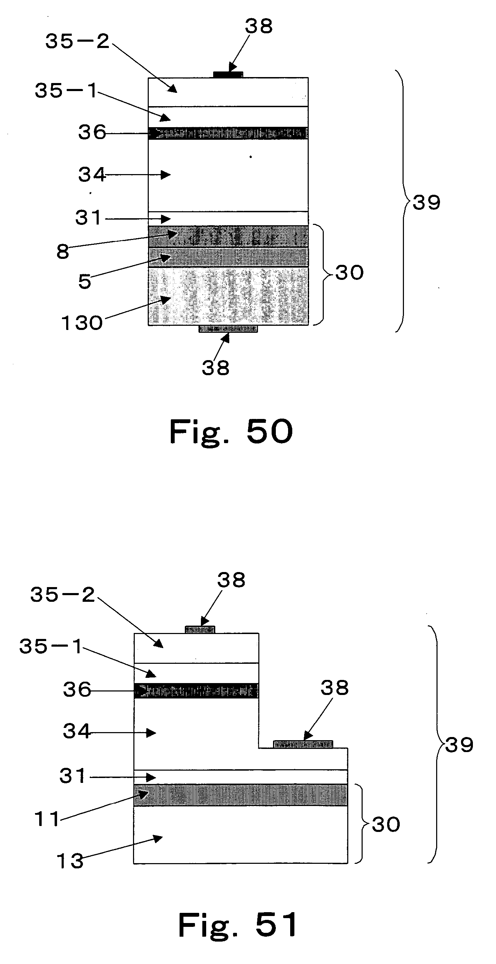

Fig. 50 is a sectional view showing one example of the light-emitting device of this invention, wherein what formed at least two layers of thin films which comprise as a main component at least one selected from gallium nitride, indium nitride, and aluminum nitride onto the substrate which comprises a sintered compact which comprises a ceramic material as a main component and has conductivity is used as a substrate for light-emitting device production, instead of conventional substrates, such as a sapphire.

That is, in Fig. 50, there shows a situation, wherein the thin film 5 which comprises as a main component at least one selected from gallium nitride, indium nitride, and aluminum nitride is formed on the substrate 130 which comprises a sintered compact which comprises a ceramic material as a main component and has conductivity, and the thing which formed at least two layers of thin films which formed furthermore the thin film 8 which comprises as a main component at least one selected from gallium nitride, indium nitride, and aluminum nitride onto it is used as the substrate 30 for light-emitting device production, and the light-emitting device 39 is formed in the same thin film constitution as what was shown in Fig. 40.

As for the thin film 5, the thing of at least one of the crystallization states selected from a single crystal, an amorphous state, a polycrystal, and an orientated polycrystal is usually used.

In Fig. 50, what formed at least two layers of thin films, wherein the thin film 5 which comprises as a main component at least one selected from gallium nitride, indium nitride, and aluminum nitride was formed on the substrate 130 which comprises a sintered compact which comprises a ceramic material as a main component and has conductivity and the thin film 8 which comprises as a main component at least one selected from gallium nitride, indium nitride, and aluminum nitride is formed furthermore on it, is used as the substrate 30 for light-emitting device production.

In the case of the light-emitting device of this invention which is illustrated in Fig. 50 and is produced using the substrate 130 which comprises a sintered compact which comprises a ceramic material as a main component and which has conductivity, it is not necessary to remove a part of the thin film layer 34 by etching, etc. as shown in Figs. 42-46 in order to form the electrode, and the light-emitting device of the constitution in which the electrode 38 was formed in the ceramic substrate 130 and which arranged the electrodes up and down is producible by making the thin film 5 and the thin film 8 into conductivity, as shown in Figs. 42-46.

As for the electric resistivity at room temperature of the above sintered compact which comprises a ceramic material as a main component and has conductivity, what is not more than 1x10² Ω·cm is usually used.

In order to supply the electric power to the luminescence layer under the state of low loss as much as possible, what is not more than 1x10¹ Ω·cm is preferred, what is not more than 1x10⁰ Ω·cm is more preferred, what is not more than 1x10⁻¹ Ω·cm is still more preferred, and what is not more than 1x10⁻² Ω·cm is most preferred, as the electric resistivity at room temperature.

For example, what comprises a sintered compact which comprises as a main component zinc oxide can be used as the substrate 130 which comprises a sintered compact which comprises a ceramic material as a main component and has conductivity.

In the case of the sintered compact which comprises zinc oxide as a main component, what has the electric resistivity not more than 1x10² Ω·cm at room temperature can be obtained comparatively easily by adding an aluminum component or a transition-metals-component, such as iron or chromium, or by adding simultaneously the aluminum component and the above transition-metals-component or a rare earth elements component.

Since what is not more than 1x10¹ Ω·cm, what is not more than 1x10⁰ Ω·cm, what is not more than 1x10⁻¹ Ω·cm, and what is not more than 1x10⁻² Ω·cm can also be obtained comparatively easily as the electric resistivity at room temperature, it is desirable.

In the case of the sintered compact which comprises zinc oxide as a main component, what has simultaneously optical permeability and conductivity is obtained as it became clear according to this invention, and since it can be used as a substrate for producing the light-emitting device having the electrode arrangement of up-and-down electrical connection type excellent in luminous efficiency, it is desirable.

In the light-emitting device of this invention which is illustrated in Fig. 50 and is produced using the substrate which comprises a sintered compact which comprises a ceramic material as a main component and has conductivity, the thin film layer 34, the thin film layer 35-1, the thin film layer 35-2, and the luminescence layer 36 can be formed usually as a single crystal which grew epitaxially, respectively, in order to raise the luminous efficiency of the light-emitting device.

What has the crystallinity, such that the half width of the rocking curve of the X ray diffraction from the lattice plane of the Miller Index (002) of the thin film is not more than 3600 seconds, usually not more than 300 seconds, and furthermore not more than 100 seconds, can be formed.

Although it is preferred that the above thin film layer 34, thin film layer 35-1, and thin film layer 35-2 are usually in the single crystal state altogether, the contact layer for electrode connection among the two layers may necessarily be the crystallization state of not a single crystal state but an amorphous state, a polycrystal, and an orientated polycrystal, when the thin film layer 35-2 and the thin film layer 34 comprise two or more layers.

The luminous efficiency of the above light-emitting device of this invention which is illustrated in Fig. 50 and is produced using the substrate which comprises a sintered compact which comprises a ceramic material as a main component and has conductivity is usually not less than 8 %, and is superior to the luminous efficiency of the conventional light-emitting device produced using the substrates, such as a sapphire.

Fig. 51 is a sectional view showing one example of the light-emitting device of this invention, wherein at least one layer of thin film-conductive material which comprises as a main component a material, such as various metal, alloy, metal nitride, metal carbide, and metal silicide, is formed on the substrate which comprises a sintered compact which comprises as a main component aluminum nitride, and it is used as a substrate for light-emitting device production instead of conventional substrates, such as a sapphire.

That is, in Fig. 51, there shows situation, wherein what formed the thin film-conductive material 11 on the substrate 13 which comprises a sintered compact which comprises aluminum nitride as a main component is used as a substrate 30 for light-emitting device production and the light-emitting device 39 is formed in the same thin film constitution as what was shown in Fig. 40.

In Fig. 51, what formed the thin film-conductive material 11 on the substrate 13 which comprises a sintered compact which comprises aluminum nitride as a main component is used as a substrate 30 for light-emitting device production. In case of the light-emitting device of this invention which is illustrated in Fig. 51 and is produced using the substrate 13 which comprises a sintered compact in which the thin film-conductive material 11 was formed and which comprises aluminum nitride as a main component, the luminescence from the light-emitting device becomes hard to be emitted from the substrate 13 by using the thin film-conductive material 11 as a reflective material, and since it becomes easy to be emitted to the outside of the device from the upper direction of the substrate 13, the light-emitting device, such as the surface emission-type laser or the light-emitting diode which is used for a flat panel display, etc., for example, wherein the directivity control of the luminescence is required, is producible, so it is desirable.

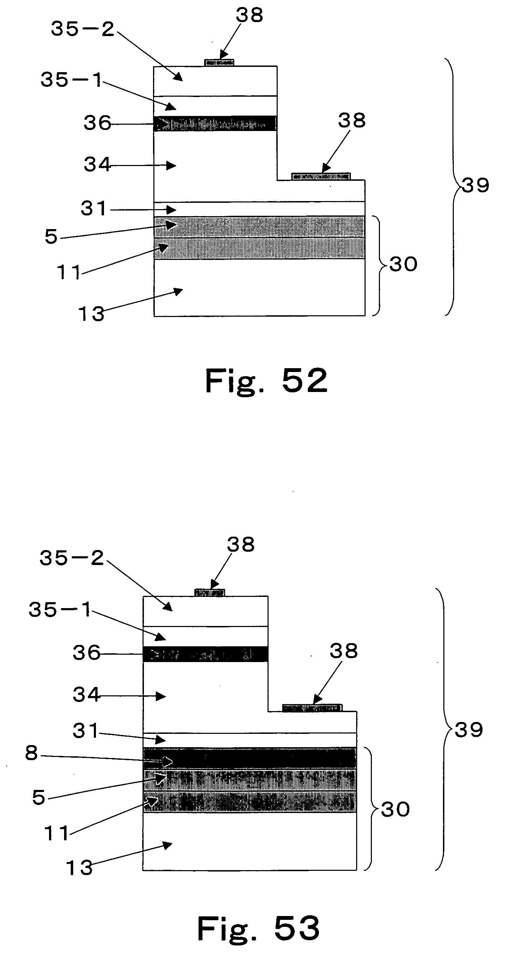

Fig. 52 is a sectional view showing one example of the light-emitting device of this invention which is produced using that in which at least one layer of thin films which comprise as a main component at least one selected from gallium nitride, indium nitride, and aluminum nitride is formed like Figs. 43 and 48 on the substrate 13 which comprises a sintered compact which comprises aluminum nitride as a main component and formed the thin film-conductive material 11, as a substrate 30 for light-emitting device production.

The effect at the time of using the thin film-conductive material 11 as a reflective material is the same as the case of the light-emitting device illustrated in Fig. 51.

Fig. 53 is a sectional view showing one example of the light-emitting device of this invention which is produced using that in which at least two layers of thin films are formed as the substrate 30 for light-emitting device production, wherein at least one layer of thin films which comprise as a main component at least one selected from gallium nitride, indium nitride, and aluminum nitride is formed like Figs. 44, 49, and 50 on the substrate 13 which comprises a sintered compact comprising aluminum nitride as a main component and on which the thin film-conductive material 11 shown in Fig. 51 is formed, and the thin film which comprises as a main component at least one selected from gallium nitride, indium nitride, and aluminum nitride is formed furthermore on it.

As for the effect at the time of using the thin film-conductive material 11 as a reflective material, it is the same as the case ofthe light-emitting device illustrated in Fig. 51.

In the light-emitting device of this invention which is illustrated in Figs. 51-53 and is produced using the substrate which comprises a sintered compact which comprises aluminum nitride as a main component and formed a thin film-conductive material, the thin film layer 34, the thin film layer 35-1, the thin film layer 35-2, and the luminescence layer 36 can be formed usually as a single crystal which grew epitaxially, respectively, in order to raise the luminous efficiency of the light-emitting device.

What has the crystallinity, such that the half width of the rocking curve of the X ray diffraction from the lattice plane of the Miller Index (002) of the thin film is not more than 3600 seconds, usually not more than 300 seconds, and furthermore not more than 100 seconds, can be formed.

Although it is preferred that the above thin film layer 34, thin film layer 35-1, and thin film layer 35-2 are usually in the single crystal state altogether, the contact layer for electrode connection among the two layers may necessarily be the crystallization state of not a single crystal state but an amorphous state, a polycrystal, and an orientated polycrystal, when the thin film layer 35-2 and the thin film layer 34 comprise two or more layers.

The luminous efficiency of the above light-emitting device of this invention which is illustrated in Figs. 51-53 and is produced using the substrate which comprises a sintered compact which comprises aluminum nitride as a main component and formed a thin film-conductive material is usually not less than 8 %, and is superior to the luminous efficiency of the conventional light-emitting device produced using the substrates, such as a sapphire.

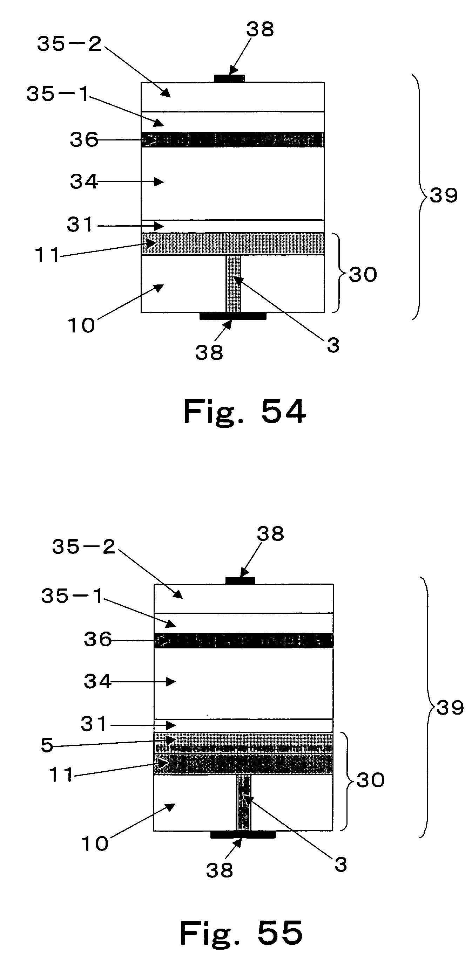

Figs. 54-56 is the sectional view showing the example of the light-emitting device of this invention which is produced using what formed the thin film-conductive material 11 shown in Figs. 51-53 into the substrate 10 which comprises a sintered compact which comprises aluminum nitride as a main component and has the conduction via 3, as the substrate 30 for light-emitting device production.

In Figs. 54-56, the effect of forming the conduction via 3 is the same as the light-emitting device illustrated in Figs. 47-49, it is not necessary to remove a part of the thin film layer 34 by etching, etc. in order to form the electrode, and the light-emitting device in which the electrodes were arranged up and down is producible

Moreover, by forming the thin film-conductive material, there is also an effect in which the electric connection with the buffer layer 31, the thin film layer 34, and the luminescence layer 36 which are formed on the thin film-conductive material 11 and are in the light-emitting device becomes easy to be improved.

Fig. 54 shows one example of the light-emitting device of this invention which is produced using what formed the thin film-conductive material 11 into the substrate 10 which comprises a sintered compact which comprises aluminum nitride as a main component and has the conduction via 3, as the substrate 30 for light-emitting device production as it is.

Fig. 55 shows one example of the light-emitting device of this invention which is produced using that in which at least one layer of thin films which comprise as a main component at least one selected from gallium nitride, indium nitride, and aluminum nitride is formed on it like Figs. 43, 48, and 52 as a substrate 30 for light-emitting device production, wherein the thin film-conductive material 11 is formed on the substrate 10 which comprises a sintered compact which comprises aluminum nitride as a main component and has the conduction via 3.

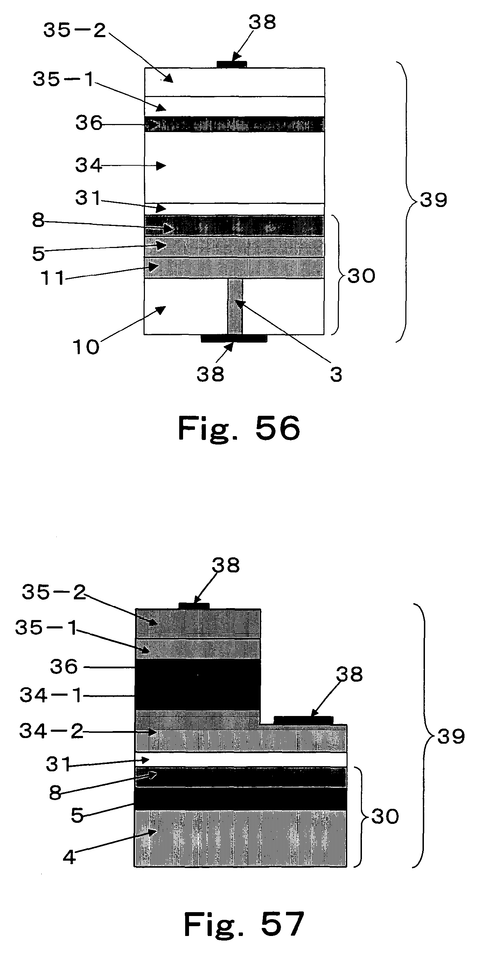

Fig. 56 shows one example of the light-emitting device of this invention which is produced using that in which at least two layers of thin films which comprise as a main component at least one selected from gallium nitride, indium nitride, and aluminum nitride are formed furthermore on it as the substrate 30 for light-emitting device production, wherein the thin film-conductive material 11 was formed on the substrate 10 which comprises a sintered compact which comprises aluminum nitride as a main component and has the conduction via 3, and at least one layer of thin films which comprise as a main component at least one selected from gallium nitride, indium nitride, and aluminum nitride is formed on it, like Fig. 44 , Fig. 49, Fig. 50, and Fig. 53.

In the light-emitting device illustrated in Figs. 54-56, as for the effect at the time of using the thin film-conductive material 11 as a reflective material, it is the same as the case of the light-emitting device illustrated in Fig. 51.

In the light-emitting device of this invention which is illustrated in Figs. 54-56 and is produced using the substrate which comprises a sintered compact which comprises aluminum nitride as a main component and has a conduction via and which formed a thin film-conductive material, the thin film layer 34, the thin film layer 35-1, the thin film layer 35-2, and the luminescence layer 36 can be formed usually as a single crystal which grew epitaxially, respectively, in order to raise the luminous efficiency of the light-emitting device.

What has the crystallinity, such that the half width of the rocking curve of the X ray diffraction from the lattice plane of the Miller Index (002) of the thin film is not more than 3600 seconds, usually not more than 300 seconds, and furthermore not more than 100 seconds, can be formed.

Although it is preferred that the above thin film layer 34, thin film layer 35-1, and thin film layer 35-2 are usually in the single crystal state altogether, the contact layer for electrode connection among the two layers may necessarily be the crystallization state of not a single crystal state but an amorphous state, a polycrystal, and an orientated polycrystal, when the thin film layer 35-2 and the thin film layer 34 comprise two or more layers.

The luminous efficiency of the above light-emitting device of this invention which is illustrated in Figs. 54-56 and is produced using the substrate which comprises a sintered compact which comprises aluminum nitride as a main component and has a conduction via and which formed a thin film-conductive material is usually not less than 8 %, and is superior to the luminous efficiency of the conventional light-emitting device produced using the substrates, such as a sapphire.

In this invention, a light-emitting device is producible using the substrate which comprises various sintered compacts which formed the thin film-conductive material and comprise as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc., and the other various sintered compacts which formed the thin film-conductive material and comprise as a main component a ceramic material, such as zirconium oxide, magnesium oxide, magnesium aluminate, titanium oxide, barium titanate, lead titanate zirconate, rare earth oxides such as yttrium oxide, a thorium dioxide, various ferrites, mullite, forsterite, steatite, and glass, etc., instead of the substrate which comprises a sintered compact which formed the above thin film-conductive material and which comprises aluminum nitride as a main component and is shown in Figs. 51-56.

In the light-emitting device using the substrate which comprises the sintered compact which comprises a ceramic material as a main component other than the sintered compact which comprises aluminum nitride as a main component, the luminescence from the light-emitting device becomes also hard to be emitted from the substrate 13 by using the thin film-conductive material as a reflective material, and since it becomes easy to be emitted to the outside of the device from the upper direction of the substrate, the light-emitting device, such as the surface emission-type laser or the light-emitting diode which is used for a flat panel display, etc., for example, wherein the directivity control of the luminescence is required, is producible, so it is desirable.

Fig. 57 is the sectional view showing an example in which the thin film layer 34 is formed by two layers of the thin film layer 34-1 and the thin film layer 34-2, in the light-emitting device of this invention shown in Fig. 44.

The thin film layer 34-2 is usually used as a contact layer connected with the electrode 38.

The light-emitting device which comprises the constitution illustrated in Fig. 57 is producible as the light-emitting device, such as the double hetero structure, the single quantum well structure, or the multi-quantum-well structure.

In the case of the light-emitting device with the double hetero structure, the thin film layer 34-1 is used as a cladding layer which sandwiches the luminescence layer 36 with the thin film layer 35-1.

When the light-emitting device which comprises the constitution illustrated in Fig. 57 is produced as a light-emitting device with the single quantum well structure, the thin film layer 34-1 is used as a barrier layer of the luminescence layer 36 which functions as a well layer.

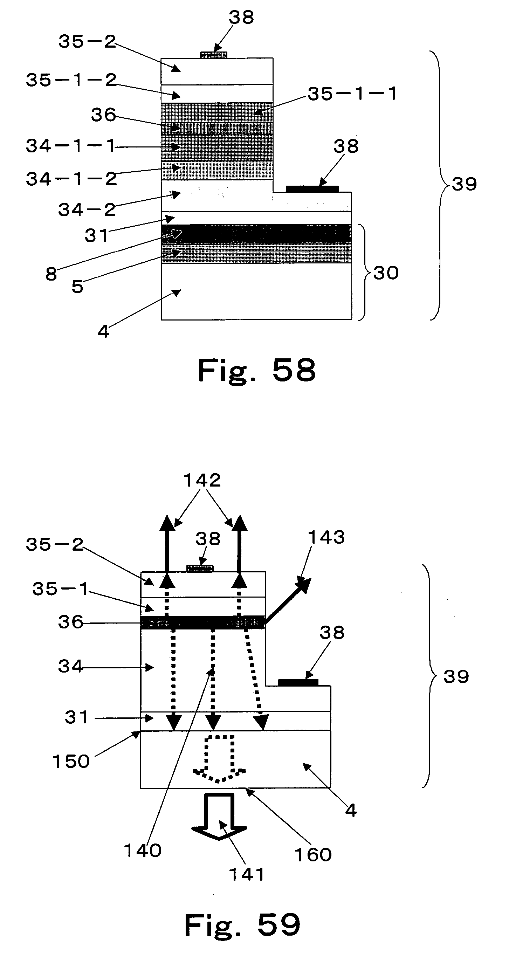

Fig. 58 is the sectional view showing an example, wherein in the light-emitting device of this invention shown in Fig. 57, the thin film layer 34-1 is formed by two layers of the thin film layer 34-1-1 and the thin film layer 34-1-1 and the thin film layer 35-1 is formed furthermore by two layers of the thin film layer 35-1-1 and the thin film layer 35-1-2.

The light-emitting device which comprises the constitution illustrated in Fig. 58 is producible as a light-emitting device, such as the double hetero structure, the single quantum well structure, or the multi-quantum-well structure, in which two layers of cladding layers which have N type and P type semiconductor characteristics are formed respectively.

In the case of the light-emitting device with the double hetero structure, the thin film layer 34-1-1 and the thin film layer 34-1-2 are used as a cladding layer which sandwiches the luminescence layer 36 with the thin film layer 35-1-1 and the thin film layer 35-1-2.

When the light-emitting device which comprises the constitution illustrated in Fig. 58 is produced as a light-emitting device with the single quantum well structure, the thin film layer 34-1-1 and the thin film layer 35-1-1 are used as a barrier layer of the luminescence layer 36 which functions as a well layer.

As for the light-emitting device which is shown in Fig. 58 and comprises the thin film which has multilayer constitution and grew epitaxially and which comprises as a main component at least one selected from gallium nitride, indium nitride, and aluminum nitride, it is producible as a laser diode of the multi-quantum-well layer structure in which the multilayer lamination of the well layer and the barrier layer is carried out respectively as the luminescence layer.

In this invention, the light-emitting device is being constituted by the lamination of at least three or more layers of N type semiconductor layer, luminescence layer, and P type semiconductor layer which comprises an epitaxially grown thin film which comprises as a main component at least one selected from gallium nitride, indium nitride, and aluminum nitride.

The size of the outside of a light-emitting device is about 0.05-10 mm square, usually is in the range of about 0.1-3 mm square, though the thickness of each thin film layer which constitutes a light-emitting device differs in each thin film layer and it is in the range of about 0.005-20 µm respectively, in the state where each thin film layer was multilayered and it became a light-emitting device, the total of the thickness is about 0.5-50 µm, and usually it is in the range of about 1-20 µm.

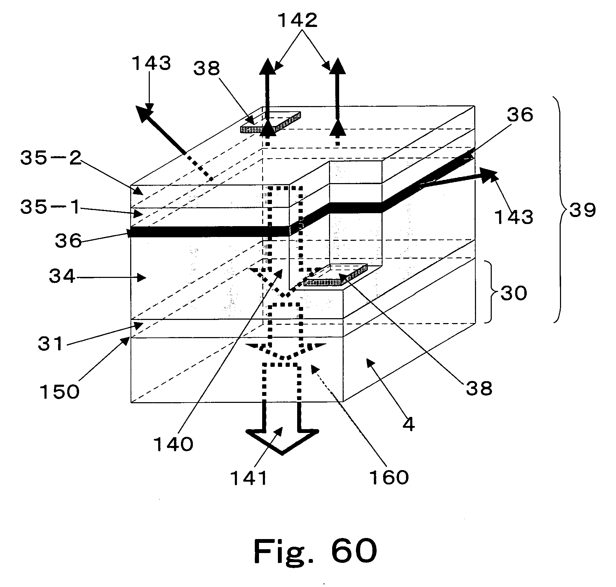

Usually, the luminescence layer of a light-emitting device is a plane form, and it is considered that the light emitted from the luminescence layer is irradiated to the substrate surface which keeps about 0.5-50 µm distance and confronts each other perpendicularly. Fig. 59 and 60 show this situation typically.

Fig. 59 is a sectional view which guessed the discharge situation of the light emitted from the luminescence layer of the light-emitting device shown in Fig. 42, and filled it in typically.

Fig. 60 is what guessed the discharge situation of the light emitted from the luminescence layer of the light-emitting device which is shown in Fig. 45 and is drawn as a perspective diagram, and filled it in typically.

In Fig. 59 and Fig. 60, the luminescence layer 36 of the light-emitting device 39 is usually formed in the shape of a plane, it is guessed that a part of the light 140 emitted from the luminescence layer 36 is irradiated from across to the surface of the substrate 4 which confronts each other perpendicularly and which comprises a sintered compact which comprises ceramics as a main component.

If the substrate 4 is a sapphire at this time, many of light 140 emitted from the luminescence layer 36 will be reflected in the interface 150 of the substrate 4 and the thin film layer 31 (or the thin film layer 34) which is formed on the substrate 4 and it will return to the thin film layer or the luminescence layer, it is confined in the thin film layer 31, the thin film layer 34, the thin film layer 35-1, the thin film layer 35-2, or the luminescence layer 36, and is not emitted to the outside of the light-emitting device, and only the part of the light emitted from the luminescence layer is mainly emitted to the outside of the device as the emitted light 142 from the thin film layer 35-2.

Therefore, what has low luminous efficiency is seemed.

On the other hand, if the substrate 4 is the sintered compact which comprises aluminum nitride as a main component, or the various sintered compacts which comprise as a main component a ceramic material which has the crystal structure of a hexagonal system or a trigonal system, such as silicon carbide, silicon nitride, gallium nitride, zinc oxide, beryllium oxide, and aluminum oxide, etc., or the other various ceramic-based sintered compacts of this invention, many of light 140 emitted from the luminescence layer 36 are not reflected in the interface 150 of the substrate 30 and the thin film layer 31 (or thin film layer 34), and it penetrates the substrate and is emitted to the outside of the light-emitting device as the emitted light 141 when the substrate 4 has optical permeability.

In addition, a part of the light emitted from the luminescence layer is emitted from the thin film layer 35-2 as the emitted light 142, and a part is emitted to the outside of the device as the emitted light 143 from the side of the luminescence layer.

Therefore, it seems that the luminous efficiency of the light-emitting device produced using such substrate which comprises a sintered compact which comprises a ceramic material as a main component becomes high, if compared with the case where a sapphire substrate is used.

It is surmised that such phenomenon is produced in the interface of the thin film 5 and the substrate 4 which comprises a sintered compact which comprises a ceramic material as a main component, even if one layer of thin film of the thin film 5, or two layers of thin films of the thin film 5 and a thin film 8 are formed on the substrate 4 which is illustrated in Fig. 43 and 44 and which comprises a sintered compact which comprises a ceramic material as a main component.

That is, even if it is the light-emitting device produced using that in which at least one layer or two or more layers of thin films are formed on the above substrate 4 which is illustrated in Figs. 43 and 44 and comprises a sintered compact which comprises as a main component a ceramic material as a substrate, it is guessed that luminous efficiency becomes equivalent, or not less than 2-3 times, or not less than 3-4 times, or a maximum of not less than 4-5 times like the thing in which the thin film is not formed and which was illustrated in Fig. 42, if compared with the luminous efficiency of the light-emitting device produced using conventional substrates, such as a sapphire, etc.

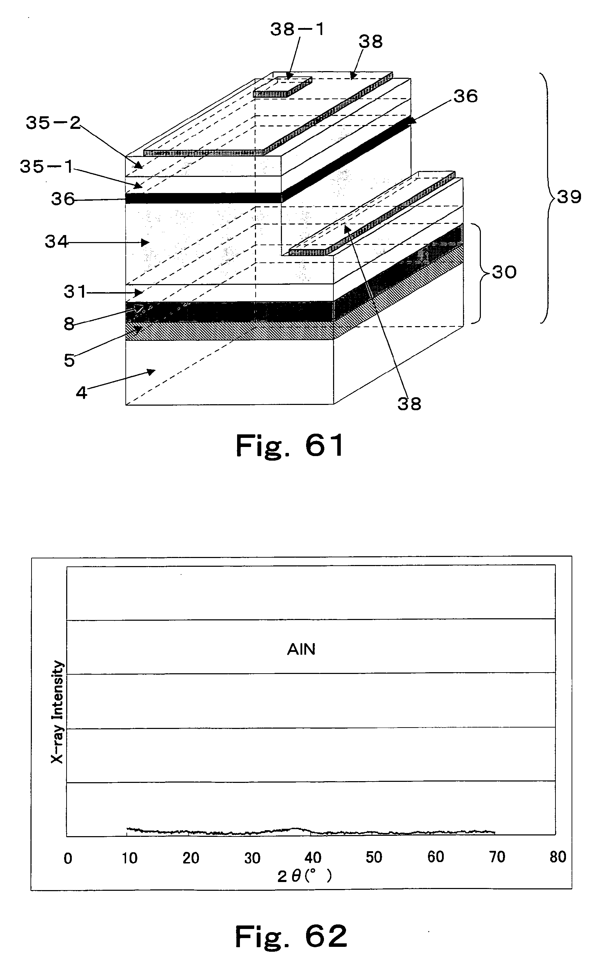

In addition, Fig. 61 is shown as an example of the light-emitting device of this invention which formed the electrode covering a large area.

Fig. 61 is a perspective diagram showing one example of the situation in which the light-emitting device of this invention shown as a sectional view in Fig. 44 was seen aslant.

Fig. 61 is shown as the example in which what formed at least two layers of thin films which comprise as a main component at least one selected from gallium nitride, indium nitride, and aluminum nitride onto the substrate which comprises a sintered compact which comprises a ceramic material as a main component was used as a substrate for light-emitting device production instead of the conventional substrates, such as a sapphire.

In Fig. 61, a situation wherein a part of the corner of the thin film layer 34 is removed by etching, etc. and the electrode 38 is formed widely in the belt-like shape is shown.

Another electrode 38 is formed covering a large area on the thin film layer 35-2.

There is an advantage of becoming easy to supply large current to the luminescence layer in the condition of low loss, using such a wide electrode.

When a light-emitting device is produced using the electrode with a wide area, it is preferred to use a transparent electrode or an electrode of optical permeability so that the luminescence from the luminescence layer may not be intercepted as much as possible by the electrode.

As for the transparent electrode or the electrode of optical permeability, it is preferred to use what has transparency or optical permeability at least to the light emitted from a light-emitting device.

Therefore, as the electrode, it is preferred to use a conductive material which has transparency or optical permeability to the light with a wavelength at least not more than 550 nm.

When the material, such as metal and alloy, etc., which cannot usually penetrate the light easily is used as the electrode, it is preferred to generate transparency or optical permeability by making the thickness into at least not more than 100 nm, preferably not more than 10 nm.

Furthermore, in order to raise the electric power supply to the electrode formed in the above wide area, it is also effective to form the terminal 38-1 independently for electric power supplies on the electrode using the material which is excellent in conductivity.

As mentioned above, the luminous efficiency of the light-emitting device of this invention is influenced by the existence of the thin film which comprises as a main component at least one selected from gallium nitride, indium nitride, and aluminum nitride and is formed beforehand on the substrate which comprises various sintered compacts which comprise a ceramics material as a main component, or the crystallization state of the thin film.

Furthermore, although the luminous efficiency of the light-emitting device of this invention is also influenced by the quality of the material (main component), composition, purity, optical permeability, size of a sintered compact crystal grain, and existence of the conduction via, surface smooth nature of the case in which the various sintered compacts which comprise a ceramic material are used as a substrate, and thickness of the substrate, etc., in the various sintered compacts which comprise a ceramic material and are used as a substrate, it can provide what is at least equivalent, or not less than 2-3 times, or not less than 3-4 times, or a maximum of not less than 4-5 times, if compared with the luminous efficiency of the light-emitting device produced using conventional substrates, such as a sapphire, etc.

Thus, the optical waveguide with less transmission loss of ultraviolet rays than the optical waveguide produced using the conventional sapphire substrate or LiNbO₃ substrate, etc. can be provided now according to this invention.

The light-emitting device excellent in luminous efficiency than the light-emitting device produced using a conventional sapphire substrate can be provided now.

As the factor which it has realized, I can think that a single-crystal thin film which has high crystallinity and comprises as a main component at least one selected from gallium nitride, indium nitride, and aluminum nitride has been able to be formed on it not using homogeneous single-crystal substrates but using the various sintered compacts which comprise a ceramic material as a main component and which comprise a crystal grain, a grain boundary, or a grain boundary phase by additives, etc.

It can also consider that it is a big factor that high junction nature has been realized between the substrate and the thin film which comprises as a main component at least one selected from gallium nitride, indium nitride, and aluminum nitride and includes the single-crystal thin film, or between these thin films.

As such a sintered compact, what comprises aluminum nitride as a main component, or what comprises as a main component various ceramic materials which have the crystal structure of the hexagonal systems or the trigonal system, such as silicon carbide, silicon nitride, gallium nitride, beryllium oxide, zinc oxide, and aluminum oxide, can be used suitably.

In addition to these, even if it uses the substrate which comprises various sintered compacts which comprise as a main component a ceramic material, such as zirconium oxide, magnesium oxide, magnesium aluminate, titanium oxide, barium titanate, lead titanate zirconate, yttrium oxide, a thorium dioxide, a ferrite, mullite, forsterite, steatite, and glass, etc., a light-emitting device excellent in luminous efficiency is producible.

Among each above sintered compact, since what comprises as a main component aluminum nitride has more excellent luminous efficiency as a substrate for light-emitting device production, it is desirable.

Also in the optical waveguide, it is preferred to use the substrate which comprises a sintered compact which comprises aluminum nitride as a main component. As for the above-explained factor given to the crystallinity of the single-crystal thin film formed on the substrate which used the above various sintered compacts which comprise a ceramic material, it is summarized below.
(1) The quality of the material of ceramics (difference of the fundamental main component, such as the sintered compact which comprises aluminum nitride as a main component, or the various sintered compacts which comprise as a main component a ceramic material which has the crystal structure which can be classified as a hexagonal system, such as silicon carbide, silicon nitride, gallium nitride, zinc oxide, and beryllium oxide, etc., and can be classified as a trigonal system or a hexagonal system, such as aluminum oxide, etc.)
(2) The composition of ceramics (the purity and content of the main components, and the content of additives or impurities, etc.)
(3) The optical permeability of ceramics
(4) The size of a ceramic particle
(5) The density of ceramics
(6) The thickness of ceramics
(7) The firing conditions of ceramics
(8) The surface smooth nature of a substrate
(9) The constitution of a thin film (a single layer, or a multilayered constitution of two or more layers, etc.)
(10) The crystallization state of the thin film formed beforehand on a substrate
(11) The thickness of a thin film
(12) The formation condition of a thin film (the method for forming a thin film, such as the MOCVD method, the Chloride VPE, or the Sputtering method, etc., or the substrate temperature, etc.)
   The following points are mentioned as the factor which cannot affect too much the crystallinity of the thin film formed in the ceramic substrate.
(13) Does it have the conduction via in the sintered compact or not? (irrespective of whether the conduction via is formed in the inside of a sintered compact, the thin film with comparatively excellent crystallinity can be formed on the substrate which comprises a sintered compact).
(14) The composition of a thin film (If it is the composition which comprises as a main component at least one selected from gallium nitride, indium nitride, and aluminum nitride, a thin film with comparatively excellent crystallinity can be formed even if it is what kind of combination. And, a thin film with comparatively excellent crystallinity can be formed even if various doping components are included in the thin film.)

As for the thin film which comprises as a main component at least one selected from gallium nitride, indium nitride, and aluminum nitride and has at least one of crystalized states selected from an amorphous state, a polycrystal, an orientated polycrystal, and a single crystal, etc. and which is formed on the substrate which comprises a sintered compact which comprises aluminum nitride as a main component, or on the substrate for thin-film formation and the thin-film substrate which used the aluminum nitride-based sintered compact of this invention, it can also be used as a field emission material and the cold cathode.

It has realized only after there was contribution by having formed the single-crystal thin film which has good crystallinity, such that the half width of the rocking curve of the X-ray diffraction line from the lattice plane of the Miller Index (002) of the single-crystal thin film which comprises as a main component at least one selected from gallium nitride, indium nitride, and aluminum nitride is not more than 300 seconds, onto the substrate which comprises a sintered compact which comprises aluminum nitride as a main component and which is being considered hitherto that the lattice matching is not carried out with the thin film which comprises as a main component at least one selected from gallium nitride, indium nitride, and aluminum nitride and has various crystallization states, such as an amorphous state, a polycrystal, an orientated polycrystal, and a single crystal.

Although the performance of the field emission material or cold cathode is excellent when it uses for a display so that the luminosity at the time of making a phosphor emit light is high, a high value not less than 1000 candelas/m2 is easy to be acquired in this invention as the luminosity at the time of making a color phosphor color, when the aluminum nitride thin film and the thin film which comprises aluminum nitride as a main component and has various crystallization states, such as an amorphous state, a polycrystal, an orientated polycrystal, and a single crystal, are used for the field emission material or cold cathode, among the above thin films of various crystallization states containing the single crystal.

When the above thin film of this invention having various crystallization states, such as an amorphous state, a polycrystal, an orientated polycrystal, and a single crystal, is used for the field emission material or cold cathode, it is desirable to make the thin film of various crystallization states, such as an amorphous state, a polycrystal, an orientated polycrystal, and a single crystal, into N type semiconductor by doping Si, O, etc. in order to make an electron easy to emit.

In this invention, as for the field emission material or cold cathode which comprise a thin film which comprises as amain component at least one selected from gallium nitride, indium nitride, and aluminum nitride and has various crystallization states, such as an amorphous state, a polycrystal, an orientated polycrystal, and a single crystal, etc., since it is formed on the substrate which comprises a sintered compact which comprises aluminum nitride as a main component, realization of a display which has a large-sized size of at least 10 inches or more and is cheap in also cost became possible, the effect on industry is large.

As mentioned above, this invention is a substrate for forming a thin film which comprises as a main component at least one selected from gallium nitride, indium nitride, and aluminum nitride and has various crystallization states, such as a single crystal, an amorphous state, a polycrystal, and an orientated polycrystal, etc., and the substrate is a substrate for thin ilm formation which comprises a sintered compact which comprises aluminum nitride as a main component. Furthermore, it also includes a thin-film substrate in which the thin film comprises as a main component at least one selected from gallium nitride, indium nitride, and aluminum nitride and is formed on the sintered compact which comprises aluminum nitride as a main component.

The thin-film substrate can be used for the above substrate for light-emitting device production which comprises as a main component at least one selected from gallium nitride, indium nitride, and aluminum nitride, in addition to this, it is also possible to use for the substrate in which the thin film which comprises as a main component at least one selected from gallium nitride, indium nitride, and aluminum nitride and has various crystallization states, such as a single crystal, an amorphous state, a polycrystal, and an orientated polycrystal, etc., is used as a surface acoustic wave device material, or the wiring substrate in which the single-crystal thin film which comprises as a main component at least one selected from gallium nitride, indium nitride, and aluminum nitride is used as a dielectric material and an insulation material, or the substrate in which the single-crystal thin film which comprises as amain component at least one selected from gallium nitride, indium nitride, and aluminum nitride is used as an optical waveguide, etc.

In addition to the above substrate for single-crystal thin film formation, and single-crystal thin-film substrate, this invention also includes, for example, the sintered compact which comprises aluminum nitride as a main component and has high AlN purity by making into high purity by being manufactured by the method in which the contained components are vaporized, removed, and reduced.

By using such sintered compact as a substrate, the thin film which is more excellent in characteristics and which comprises as a main component at least one selected from gallium nitride, indium nitride, and aluminum nitride and has various crystallization states including the single crystal, such as an amorphous state, a polycrystal, and an orientated polycrystal, etc., can be formed.

### Example 1

High-purity, submicron ceramic raw material powders used were aluminum nitride powder of grade "F" available from Tokuyama, Inc., silicon carbide powder of grade "OY-15" available from Yakushima Denko Co., Ltd., silicon nitride powder of grade "SN-E05" available from Ube Industries, Ltd., aluminum oxide powder of grade "AKP-30" available from Sumitomo Chemical Co., Ltd., partially stabilized zirconia powder of grade "TZ-3Y" containing 3 mol % of Y₂O₃ as a stabilization agent available from TOSOH CORP., zinc oxide of "first grade" available from Sakai Chemical Industry Co., Ltd., guaranteed magnesium oxide powder available from Kanto Kagaku, and beryllium oide powder and magnesium aluminate (MgAl₂O₄: spinel) powder both available from Kojundo Chemical Laboratory Co., Ltd. The purity was not less than 99 % by weight except for partially stabilized zirconia. The oxygen content was 1.0 % by weight in the aluminum nitride powder.

1.0% by weight of B₄C powder and 1.0% by weight of carbon powder were added to silicon carbide. 2.0% by weight of Y₂O₃ powder and 2.0% by weight of Al₂O₃ powder were added to silicon nitride powder. 1.8 % by weight of CaCO₃ powder was added to beryllium oxide powder. Each resultant mixture was wet-blended in ethanol in ball mill for 24 hours, and dried.

5 % by weight of paraffin wax was added to each powder to produce powder for molding, and disk-like powder compacts of 25.4 mm in diameter and 1.5 mm in thickness and those of 32 mm in diameter and 1.5 mm in thickness were obtained by uniaxial pressing.

These powder compacts were fired under the conditions shown in Table 1 after degreasing under reduced pressure at 300°C to obtain sintered compacts.

The relative density of each sintered compact was not less than 99 %. The surfaces of these sintered compacts were mirror-polished using a chromic oxide and alumina abradant, ultrasonic washing was carried out with acetone, and the substrates for thin film formation were produced. The surface roughness of each substrate obtained is shown in Table 1.

The constitution phase of these substrates was investigated by X ray diffraction. As the result, the X ray diffraction pattern shown by the sintered compact obtained using aluminum nitride powder as raw material was the crystal phase indicated by the file number 25-1133 of JCPDS, comprising as a main phase AlN (hexagonal).

The X ray diffraction pattern shown by the sintered compact obtained using silicon carbide powder as raw material had as a main phase α-SiC (hexagonal) indicated by the above file number 29-1131.

The X ray diffraction pattern shown by the sintered compact obtained using silicon nitride powder as raw material had as a main phase β-Si₃N₄ (Hexagonal) indicated by the above file number 33-1160, and contains unknown phase 6.6 % in addition to this.

The X ray diffraction pattern shown by the sintered compact obtained using aluminum oxide powder as raw material had as a main phase α-Al₂O₃ (Trigonal) indicated by the above file number 10-173.

The X ray diffraction pattern shown by the sintered compact obtained using zirconium oxide powder as raw material had as a main phase ZrO₂ (Tetragonal) indicated by the above file number 17-923.

The X ray diffraction pattern shown by the sintered compact obtained using zinc oxide powder as raw material had as a main phase ZnO (Hexagonal) indicated by the above file number 36-1451.

The X ray diffraction pattern shown by the sintered compact obtained using magnesium oxide powder as raw material had as a main phase MgO (Cubic) indicated by the above file number 4-829.

The X ray diffraction pattern shown by the sintered compact obtained using beryllium oxide powder as raw material had as a main phase BeO (Hexagonal) indicated by the above file number 35-818.

The X ray diffraction pattern shown by the sintered compact obtained using magnesium aluminate powder as raw material had as a main phase MgAl₂O₄ (Cubic) indicated by the above file number 21-1152.

These sintered compacts were clearly polycrystalline substances in which the direction of the crystal grains of the main components inside the sintered compacts is random.

The result of the phase constitution by X ray diffraction of the substrate for a thin film was shown in Table 1.

Using each substrate obtained, the thin films of gallium nitride, indium nitride, and aluminum nitride were formed directly on the substrate surface by the MOCVD (Metal Organic Chemical Vapor Deposition growth) equipment by high frequency induction heating.

The produced substrates were heated at 1000°C in a hydrogen gas in a reaction container of the above equipment.

Trimethyl gallium (TMG), trimethyl indium (TMI), and trimethyl aluminum (TMA) were used as thin film-forming materials, hydrogen or nitrogen + hydrogen was introduced into the above each three kinds of fluid raw materials as career gas, and was bubbled, and each raw material was introduced to the reaction part in which high frequency induction heating will be carried out with ammonia gas. The gallium nitride thin film was formed at the substrate temperature of 1000°C, the indium nitride thin film was formed at the substrate temperature of 700°C, the aluminum nitride thin film was formed at the substrate temperature of 1100°C, and the mixed crystal thin film of 50 mol % GaN+50 mol % AlN was formed at the substrate temperature of 1050°C. The formation rate of the thin film is about 0.2-0.4 µm/hour, 0.2-0.5 µm/hour, 1-3 µm/hour, 0.5-1.5 µm/hour, respectively. In addition, the thickness of each formed thin film is 0.25 µm.

Only in the case of the aluminum nitride thin film formed on the aluminum nitride-based sintered compact substrate, what has the thickness of 3 µm and 6 µm was produced.

Observation of each thin film obtained was carried out using the optical microscope and the electron microscope, but a crack was not seen inside the thin films, and exfoliation was not seen in the interface between the thin film and the aluminum nitride-based sintered compact, and the other various ceramic-based sintered compacts.

Tested by pasting up and tearing off after adhesive tape is pasted up to each thin film obtained, but exfoliations were not seen in the interface between the thin films and the aluminum nitride-based sintered compacts, and the other various ceramic-based sintered compacts, so the thin films were integrally adhered to the sintered compacts comprising aluminum nitride as a main component, and the other various ceramic-based sintered compacts.

The thin film-conductive material of Ti/Pt/Au was formed in each above thin film formed, the metal leads were soldered, and the perpendicular tensile strength was investigated, but it all is not less than 2 kg/mm², so the aluminum nitride-based sintered compact and the other various ceramic-based sintered compacts are integrally adhered to each thin film.

The crystallization state of the thin film was investigated by measuring the X ray diffraction pattern of each thin film using the CuKα line after thin film formation, furthermore, the rocking curve of the X ray diffraction from the lattice plane (002) of each thin film was taken, and the half width was measured.

Only in the case of the aluminum nitride thin film as thick as 0.25 µm formed on the aluminum nitride-based sintered compact substrate, electron beam diffraction was carried out, and the crystallization state of the thin film was investigated.

The result is shown in Table 1.

Table 1 indicates that a thin film formed directly on the substrate comprising a sintered compact comprising as a main component zirconium oxide, magnesium oxide, or a spinel is not a single crystal.

Since the diffraction line has appeared not only from the Miller Index (002) lattice plane but also from the (100) lattice plane, it is obvious that it is a polycrystalline state.

In the thin film formed on the other sintered compact substrate, only the diffraction line from the Miller Index (002) lattice plane does appear, it has been in single crystal state.

In every substrate, the half width of the rocking curve of the Miller Index (002) lattice plane of the single-crystal-ized thin film was not more than 3600 seconds.

As for the formation direction of these single-crystal thin films to the substrate, C axis of these single-crystal thin films was a perpendicular direction to the substrate surface, in all the sintered compact in which the thin film has become a single crystal state.

From this experimental result, I can guess that the cause in which a thin film did not become a single crystal state is that the crystal system of zirconium oxide is a tetragonal system and it is a cubic system in the case of magnesium oxide and a spinel.

The main component of other substrates is a hexagonal system altogether except aluminum oxide.

Though the crystal system of the above aluminum oxide is a trigonal system, the classification as a hexagonal system is also possible for it. As for those in which the thin film formed directly on it can become a single crystal state, it seems that it is essentially only the case of the substrate comprising a sintered compact comprising as a main component the material of a hexagonal system and the material which can be classified as a hexagonal system.

As is clear from the experimental result, a single-crystal thin film was formed directly on the aluminum nitride-based sintered compact substrate.

In almost all the formed thin film, the half width of the rocking curve of the X ray diffraction from the lattice plane (002) is as sharp as not more than 300 seconds, and it excels in crystallinity.

As mentioned above, even if the various sintered compacts comprising as a main component a ceramic material are used as a substrate, it was confirmed that the single-crystal thin film comprising as a main component at least one selected from gallium nitride, indium nitride and aluminum nitride can be formed directly on the substrates made from a sintered compact.

The crystallinity of the single-crystal thin film produced using the aluminum nitride-based sintered compact was most excellent in it.

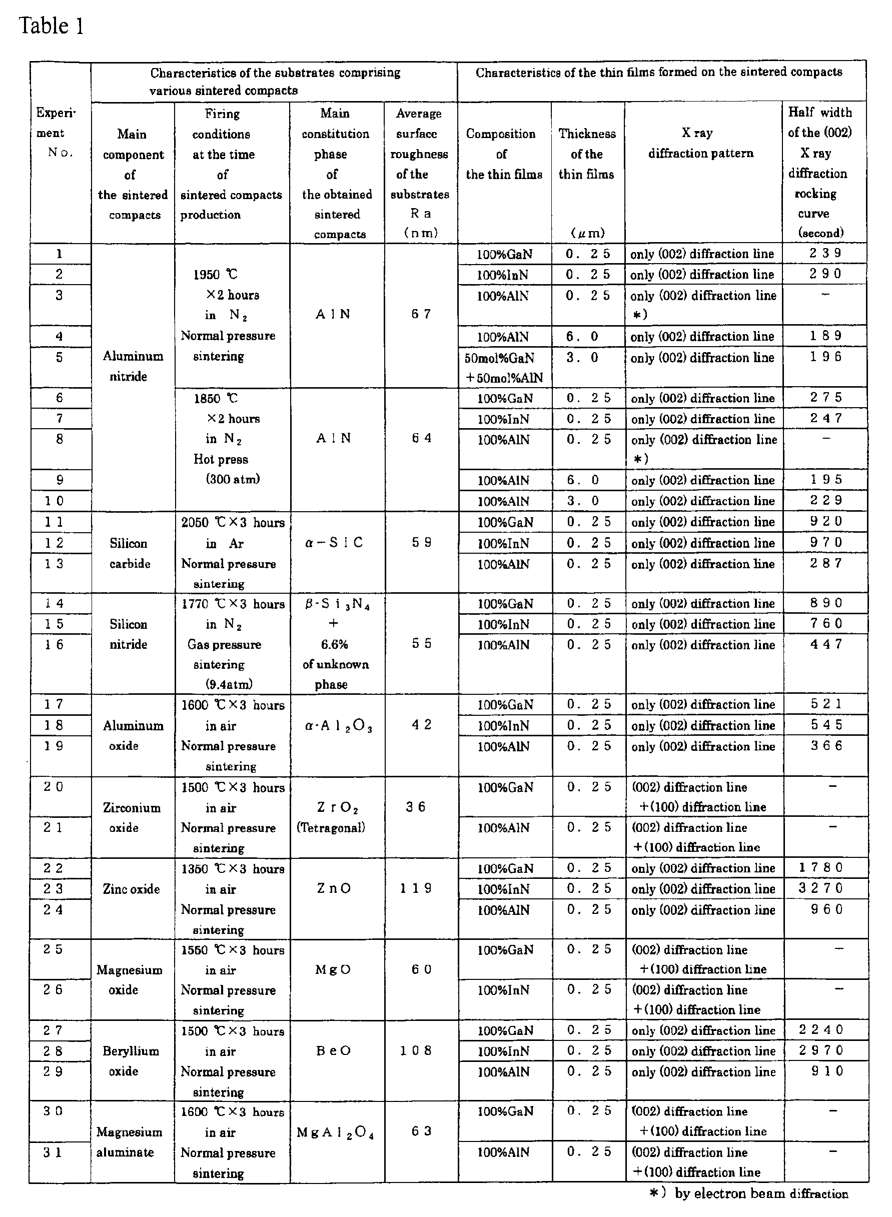

### Example 2

As for the crystallinity of the single-crystal thin film comprising as a main component at least one selected from gallium nitride, indium nitride and aluminum nitride and formed directly on the aluminum nitride-based sintered compact substrate, the influence by the characteristics, such as the composition of the aluminum nitride-based sintered compact, the microstructure of the sintered compact, and the optical transmissivity, etc., was investigated.

As the raw material powder for sintered compact production used for the experiment the same high purity aluminum nitride powder [the grade "F" by Tokuyama Soda Co., Ltd. (present: Tokuyama, Inc.)] as those having been used in Example 1 was prepared.

The raw material powder is manufactured by the method of oxide reduction.

After additives, such as sintering aids, and blackening agents, etc., are suitably added to the raw material powder, it mixes by the ball mill with ethanol for 24 hours, and it was dried and the ethanol was vaporized, then paraffine wax was added to the mixed powder 5 % by weight, powders for molding were produced, and the disk-like powder compacts with the diameter of 25.4 mm x thickness of 1.5 mm and the diameter of 32 mm x thickness of 1.5 mm were acquired by the uniaxial pressing.

After that, paraffine wax was degreased under reduced pressure at 300°C, the setter made from tungsten is used as an firing implement, normal-pressure sintering and atmospheric pressure sintering (gas pressure sintering) were performed surrounding the circumference of the powder compact which is a fired thing with the frame made from tungsten in pure nitrogen atmosphere so that it may not become reduced atmosphere, then the various sintered compacts comprising aluminum nitride as a main component were produced.

The various sintered compacts comprising aluminum nitride as a main component were also produced by the hot pressing and HIP (hot isostatic press: hydrostatic pressure sintering).

The detail of firing conditions is indicated in Table 2.

The aluminum nitride-based sintered compact substrate was produced by grinding and polishing the sintered compact into the size with the diameter of 25.4 mm x thickness of 0.5 mm.

In the inside of obtained various aluminum nitride-based sintered compacts, components, such as unescapable mixing components, such as oxygen in raw material powder, sintering aids, such as a rare earth element compound and an alkaline-earth-metal compound, alkaline metal, silicon component, molybdenum, tungsten, niobium, titanium, carbon, iron, nickel, etc., are not vaporized and removed almost, almost the same quantity as the inside of a powder compact is existing.

Using such obtained various substrates, a thin film comprising as a main component gallium nitride, indium nitride, and aluminum nitride was formed on the substrate surface by the method which used the MOCVD (Metal Organic Chemical Vapor Deposition) equipment with the same high frequency induction heating as Example 1.

The mixed crystal thin film of 50 mol % GaN+50 mol % InN was formed under the substrate temperature of 780°C.

It is admitted that all the obtained thin film is a single crystal by measurement of the X ray diffraction pattern using CuKα characteristic X-rays and the electron beam diffraction.

Observation of the obtained single-crystal thin films was performed using the optical microscope and the electron microscope, but a crack was not seen in the inside of the single-crystal thin films, and exfoliation in the junction interface between the single-crystal thin films and the aluminum nitride-based sintered compacts is not seen.

Tested by pasting up and tearing off after adhesive tape is pasted up to each single-crystal thin film obtained, but the exfoliation and destruction in the junction interface between the single-crystal thin films and the aluminum nitride-based sintered compacts were not seen.

The thin film-conductive material of Ti/Pt/Au was formed in each above single-crystal thin film formed, the metal leads were soldered and the perpendicular tensile strength was investigated, but it all is not less than 2 kg/mm², so the aluminum nitride-based sintered compact and each single-crystal thin film have unified firmly.

The half width of the rocking curve of the X ray diffraction from the attice plane (002) was measured, and the crystallinity of the above single-crystal thin film was investigated.

As for the formation direction of these single-crystal thin films to the substrate, C axis of these single-crystal thin films was perpendicular direction to the substrate surface altogether.

These results are shown in Table 2 and Table 3.

In Table 2, the production conditions and the characteristics of the examined substrates comprising an aluminum nitride-based sintered compact are shown.

In Table 3, composition, film thickness, and crystallinity of the single-crystal thin film comprising as a main component at least one selected from gallium nitride, indium nitride and aluminum nitride and formed on the substrates are shown, using the above various substrates comprising an aluminum nitride-based sintered compact.

In Table 2 and Table 3, as for the crystallinity of the single-crystal thin films which comprise as a main component at least one selected from gallium nitride, indium nitride and aluminum nitride and were formed directly on the substrates in which the optical transmissivity of the aluminum nitride-based sintered compact is not less than 1 %, it is shown that the half width of the rocking curve of the X ray diffraction from the lattice plane of a Miller Index (002) is not more than 300 seconds.

In the sintered compact in which the optical transmissivity is not less than 5 %, the half width of the rocking curve of the X ray diffraction from the lattice plane (002) of the single-crystal thin films is not more than 240 seconds.

In the aluminum nitride-based sintered compact in which the optical transmissivity is not less than 10 %, the half width of the rocking curve of the X ray diffraction from the lattice plane (002) of the single-crystal thin films is not more than 200 seconds.

In the aluminum nitride-based sintered compact in which the optical transmissivity is not less than 40 %, the half width of the rocking curve of the X ray diffraction from the lattice plane (002) of the single-crystal thin films is not more than 150 seconds.

In addition, in measurement of the optical transmissivity, the spectrophotometer U-4000 by Hitachi, Ltd. is used, and the produced aluminum nitride-based substrates were put in the integrating sphere, then the intensity is measured by collecting all of a transmitted light and the light which carried out incidence into the sintered compact, and the optical transmissivity was obtained by computing the percentage ratio of the intensity of all transmitted light and incidence light.

The value of the optical transmissivity is measured using the light with a wavelength of 605 nm.

In Table 2 and Table 3, in the case of the substrate in which the content of a rare earth element and an alkaline-earth metal in the sintered compact is not more than 25 volume % on the basis of oxide respectively, the half width of the rocking curve of the X ray diffraction from the lattice plane of the Miller Index (002) is not more than 300 seconds, as the crystallinity of the single-crystal thin films formed directly on it and comprising as a main component at least one selected from gallium nitride, indium nitride and aluminum nitride.

In the case of a sintered compact in which the content is not more than 12 volume % respectively, the half width of the rocking curve of the X ray diffraction from the lattice plane (002) of the single-crystal thin films is not more than 240 seconds.

In the case of the aluminum nitride-based sintered compact in which the content is not more than 7 volume % respectively, the half width of the rocking curve of the X ray diffraction from the lattice plane (002) of the single-crystal thin films is not more than 200 seconds.

In Table 2, in X ray diffraction of the aluminum nitride-based sintered compacts which were used in the experiment No.34, 45, 49, 50, 58 and 66 and do not forming a single-crystal thin film,
in the case of the sintered compact of the experiment No.34, the diffraction line was a polycrystalline AlN of the main phase shown in the file number 25-1134 of JCPDS, and the polycrystalline ALON shown in the file number 36-50 of JCPDS,
in the case of No.45 different phases were not detected, it was only the diffraction line of polycrystalline AlN shown in the file number 25-1134 of JCPDS,
in the case of the substrate of No.49 the diffraction line of YAlO₃ and Y₄Al₂O₉ were detected besides the above AlN,
in the case of the substrate of No.50 the diffraction line of YAlO₃, Y₄Al₂O₉, and Y₂O₃ were detected besides the above AlN,
in the case of the substrate of No.58 the diffraction line of ErAlO₃ and Er₄Al₂O₉ were detected besides the above AlN,
in the case of the substrate of No.66 the diffraction line of W (tungsten) was detected besides the above AlN.

In addition, when the content of ALON in the sintered compact of No.34 was calculated by the strongest line peak ratio of the diffraction line of AlN and ALON, it was calculated as 1.4 %.

When X ray diffraction of the aluminum nitride-based sintered compacts which were used in the experiment No.37-40 and do not form a single-crystal thin film was carried out, the diffraction line of the polycrystalline ALON shown in the file number 36-50 of JCPDS was detected besides the diffraction line of polycrystalline AlN shown in the file number 25-1134 of JCPDS.

As for the ALON content in the sintered compact which is obtained from the intensity ratio of the strongest line (311) of ALON and the strongest line (100) of AlN, it was calculated that it is 3.2 % in case of No.37, 9.6 % in case of No.38, 19.1 % in case of No.39, and 29.4 % in case of No.40, respectively.

In Table 2 and Table 3, as for the crystallinity of the single-crystal thin films of gallium nitride and aluminum nitride which are formed directly on the substrate which comprises the aluminum nitride-based sintered compacts which contain an alkaline metal or a silicon compound and were used in the experiment No.61, 62, and 63, the half width of the rocking curve of the X ray diffraction from the lattice plane (002) is not more than 300 seconds.

Table 2 and Table 3 show the optical transmissivity (total transmissivity) measured using the light with a wavelength of 605 nm in the aluminum nitride-based sintered compacts used in the experiment No.65, 66, 68 and 70, though the optical transmissivity is smaller than 1 %, and it is zero in the sintered compact of the experiment No.65, 68 and 70, the single-crystal thin films of gallium nitride and aluminum nitride formed directly on these substrates have the crystallinity in which the half width of the rocking curve of the X ray diffraction from the lattice plane (002) is not more than 300 seconds.

In Table 2 and Table 3, in the case of the substrates which are used for the experiment and comprise the aluminum nitride-based sintered compact in which a total amount of oxygen is not more than 10 % by weight, the half width of the rocking curve of the X ray diffraction from the lattice plane of the Miller Index (002) of the single-crystal thin films which comprise as a main component at least one selected from gallium nitride, indium nitride and aluminum nitride and are formed directly on these is not more than 300 seconds.

In the sintered compact in which a total amount of oxygen is not more than 5.0 % by weight, the half width of the rocking curve of the X ray diffraction from the lattice plane of the Miller Index (002) of the single-crystal thin films which comprise as a main component at least one selected from gallium nitride, indium nitride and aluminum nitride is not more than 240 seconds.

In the sintered compact in which a total amount of oxygen is not more than 3.0 % by weight, the half width of the rocking curve of the X ray diffraction from the lattice plane of the Miller Index (002) of the single-crystal thin films which comprise as a main component at least one selected from gallium nitride, indium nitride and aluminum nitride is not more than 200 seconds.

In Table 2 and Table 3, in case of the substrates in which the amount of ALON in the aluminum nitride-based sintered compact used for the experiment is not more than 20 %, the half width of the rocking curve of the X ray diffraction from the lattice plane of the Miller Index (002) of the single-crystal thin films which comprise as a main component at least one selected from gallium nitride, indium nitride and aluminum nitride and are formed directly on these is not more than 300 seconds.

In the sintered compact in which the amount of ALON is not more than 7 %, the half width of the rocking curve of the X ray diffraction from the lattice plane of the Miller Index (002) of the single-crystal thin films which comprise as a main component at least one selected from gallium nitride, indium nitride and aluminum nitride is not more than 200 seconds.

In Table 2 and Table 3, as for the crystallinity of the single-crystal thin films which comprise as a main component at least one selected from gallium nitride, indium nitride and aluminum nitride and are formed directly on the substrates comprising an aluminum nitride-based sintered compact in which the relative density is not less than 98 %, it is shown that the half width of the X ray rocking curve of the lattice plane of the Miller Index (002) of the single-crystal thin films is not more than 300 seconds.

When the relative density of the sintered compact is not less than 99 %, the half width of the X ray rocking curve of the lattice plane of the Miller Index (002) of the single-crystal thin films is not more than 240 seconds.

When the relative density of the sintered compact is not less than 99.5 %, the half width of the X ray rocking curve of the lattice plane of the Miller Index (002) of the single-crystal thin films is not more than 200 seconds.

In Table 2 and Table 3, when the size of the pore in the sintered compacts used in the experiment is an average of not more than 1 µm, the single-crystal thin films comprising as a main component at least one selected from gallium nitride, indium nitride and aluminum nitride have the crystallinity in which the half width of the X ray rocking curve of the lattice plane of the Miller Index (002) is not more than 300 seconds.

When the size of the pore in the sintered compact is an average of not more than 0.7 µm, the half width of the X ray rocking curve of the lattice plane of the Miller Index (002) of the single-crystal thin films is not more than 240 seconds.

When the size of the pore in the sintered compact is an average of not more than 0.5 µm, the half width of the X ray rocking curve of the lattice plane of the Miller Index (002) of the single-crystal thin films is not more than 200 seconds.

In Table 2 and Table 3, if the firing temperature becomes high and the firing time becomes long, the size of the AlN crystal grain in the aluminum nitride-based sintered compact will tend to grow.

That is, the size of the AlN crystal grain in the sintered compact becomes not less than 8 µm by the firing of not less than 3 hours at the temperature not less than 1900°C.

The size of the AlN crystal grain in the sintered compact becomes not less than 15 µm by the firing of not less than 6 hours at the temperature not less than 1900°C.

When the size of the AlN crystal grain of the aluminum nitride-based sintered compacts used for the experiment is an average of not less than 1 µm, the single-crystal thin films comprising as a main component at least one selected from gallium nitride, indium nitride and aluminum nitride have the crystallinity in which the half width of the X ray rocking curve of the lattice plane of the Miller Index (002) is not more than 300 seconds.

When the size of the AlN crystal grain of the sintered compacts is an average of not less than 5 µm, the half width of the X ray rocking curve of the lattice plane of the Miller Index (002) of the single-crystal thin films is not more than 240 seconds.

When the size of the AlN crystal grain of the sintered compacts is an average of not less than 8 µm, the half width of the X ray rocking curve of the lattice plane of the Miller Index (002) of the single-crystal thin films is not more than 200 seconds.

When the size of the AlN crystal grain of the sintered compacts is an average of not less than 15 µm, that in which the half width of the X ray rocking curve of the lattice plane of the Miller Index (002) of the single-crystal thin films is not more than 150 seconds is obtained.

In the case of the sintered compact in which the AlN content is less than 80 volume %, that in which the crystallinity of the single-crystal thin film formed lowers is seen.

In Table 2 and Table 3, in the case of the substrates in which the degree of the surface smoothness of the aluminum nitride-based sintered compacts used for the experiment is the average surface roughness Ra not more than 100 nm, the half width of the rocking curve of the X ray diffraction from the lattice plane of the Miller Index (002) of the single-crystal thin films which comprise as a main component at least one selected from gallium nitride, indium nitride and aluminum nitride and are formed directly on those is not more than 300 seconds.

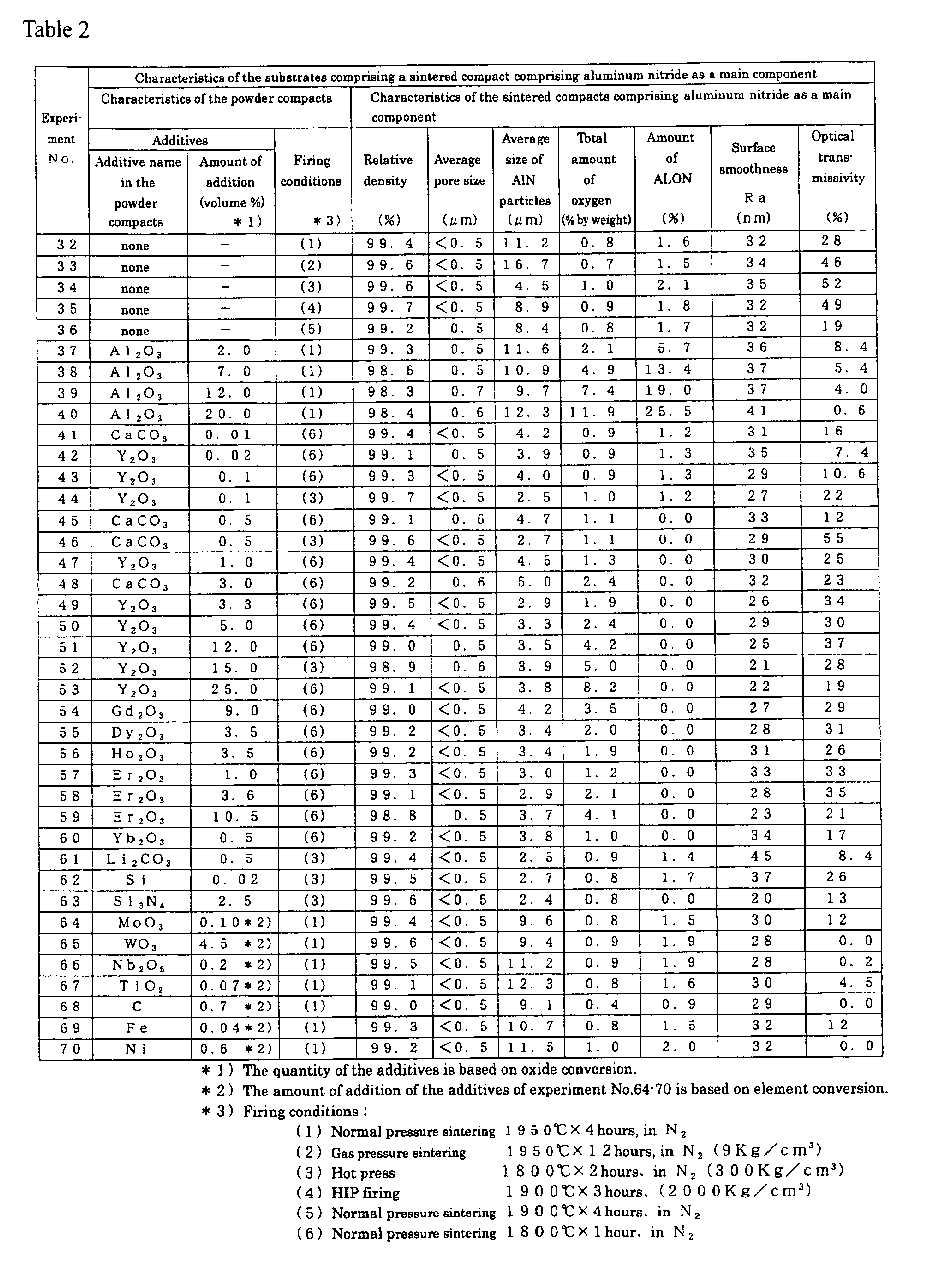

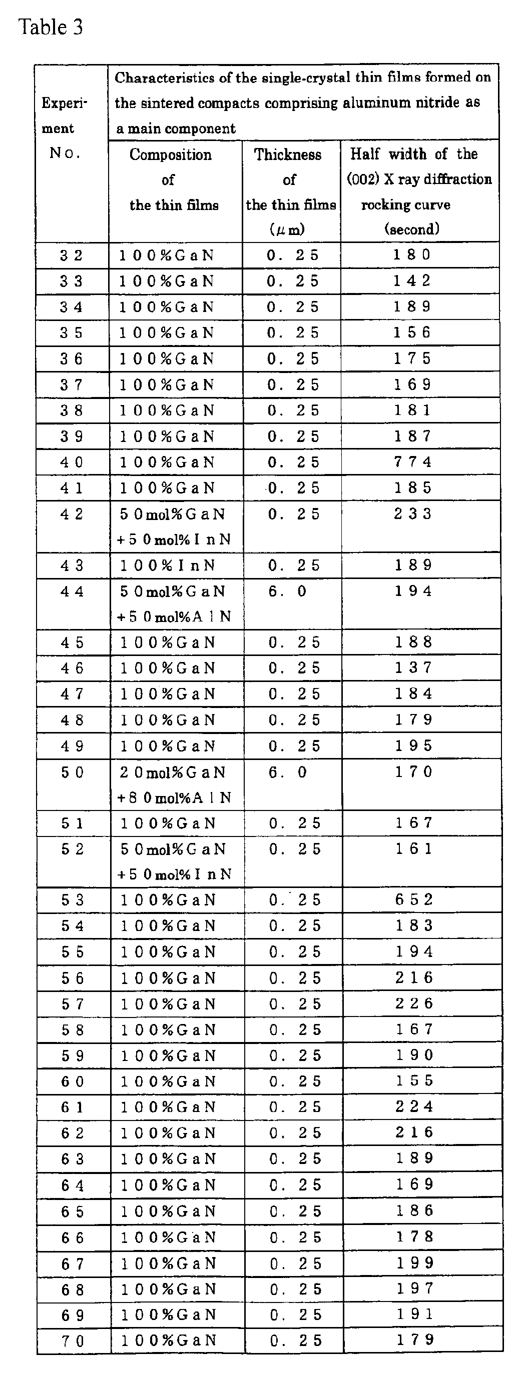

### Example 3

High purity aluminum nitride powder (the grade "H" available from Tokuyama, Inc.) was prepared as the raw material powder for producing an aluminum nitride-based sintered compact. This raw material powder was manufactured by the method of oxide reductionin. This raw material powder contains oxygen 1.3 % by weight as impurities.

Added to this raw material powder were 3.3 volume % of Y₂O₃ powder, 4.02 volume % of Er₂O₃ powder, and 0.6 volume % by of CaCO₃ powder on a CaO basis, and mixed with toluene and isopropyl alcohol by the ball mill for 24 hours, then an acrylic binder was added 12 weight parts to 100 weight parts of the powder raw materials, furthermore they were mixed for 12 hours and made into a paste, and the green sheets having three kinds of composition as thick as 0.75 mm by the doctor blade method were produced.

The green sheets were formed into square sheets of 35 mm x 35 mm, to which circular through-holes having a diameter of 25 µm, 50 µm, 250 µm and 500 µm, respectively, were bored by YAG laser.

Each paste for conduction via produced using three kinds of powder, pure tungsten, mixed powder of 50 volume % tungsten + 50 volume % copper, and a pure copper powder as a conductive component, and adding α-terpineol as a solvent, and an acrylic resin as a binder was charged into the above through-holes and dried, and normal-pressure sintering was carried out at 1820°C in N₂ for 2 hours after a binder was removed suitably in the atmosphere comprising as a main component nitrogen or a nitrogen/hydrogen mixture, in order to obtain an aluminum nitride-based sintered compact having conduction vias.

In addition, when carrying out the firing, degreased substances of the green sheets in which the through holes were filled up with a conduction via paste were put on the setter made from tungsten, the aluminum nitride powder compacts were simultaneously placed besides degreased substances, and the circumference of them was surrounded by the tungsten frame.

The metal components in the through holes were enough made dense by sintering or solidification after fusion, and conductivity has arisen in them, they were also unifying with the aluminum nitride-based sintered compact, and they were functioning as a conduction via.

Conduction vias were exposed by grinding and polishing the sintered compacts obtained into the specular surface to the size with the diameter of 25.4 mm x thickness of 0.5 mm, the substrates which comprise an aluminum nitride-based sintered compact having the degree of surface roughness Ra 26 nm and having conduction vias were produced.

The resistance of the conduction vias was measured at room temperature by the 4 terminal method after that, and the electric resistivity at room temperature was computed from the shape of conduction vias.

The size of the conduction vias has shrunk after firing and has become the diameter of 20-23 µm, 40-44 µm, 209-215 µm, and 422 µm, respectively.

The single-crystal thin films of gallium nitride were formed directly in the thickness of 0.25 µm by the same MOCVD method used in Example 1 and 2 on one surface side of the above substrates, and the half width of the rocking curve of the X ray diffraction from the lattice plane of the Miller Index (002) of the single-crystal thin films was measured.

Those results were shown in Table 4.

Observation about the single-crystal thin films of the circumference where the conduction via was formed was carried out after single-crystal thin film formation, but faults, such as a crack and exfoliation in the interface with the conduction vias, were not found, they were in good appearance states, so it was confirmed that the conduction vias which used the material of this invention have good junction nature to the gallium nitride thin films.

All of the half width of the rocking curve of the X ray diffraction from the lattice plane of the Miller Index (002) of the single-crystal thin film was not more than 300 seconds, and the electric resistivity of the conduction vias was the range of 2.0x10⁻⁶-7.7x10⁻⁶ Ω·cm at room temperature.

The thin films which were produced in this Example and comprise gallium nitride as a main component have conductivity.

An electrical connection exists between this thin film which comprises gallium nitride as a main component and was produced by using each sintered compact in which the conduction via is being formed, and the conduction via exposed in the substrate surface side in which this thin film is not being formed.

Between the gallium nitride-based single-crystal thin films having electrical conductivity, and the conduction vias, which were produced in this Example, not only the mechanical junction nature but also the electrical connection was confirmed.

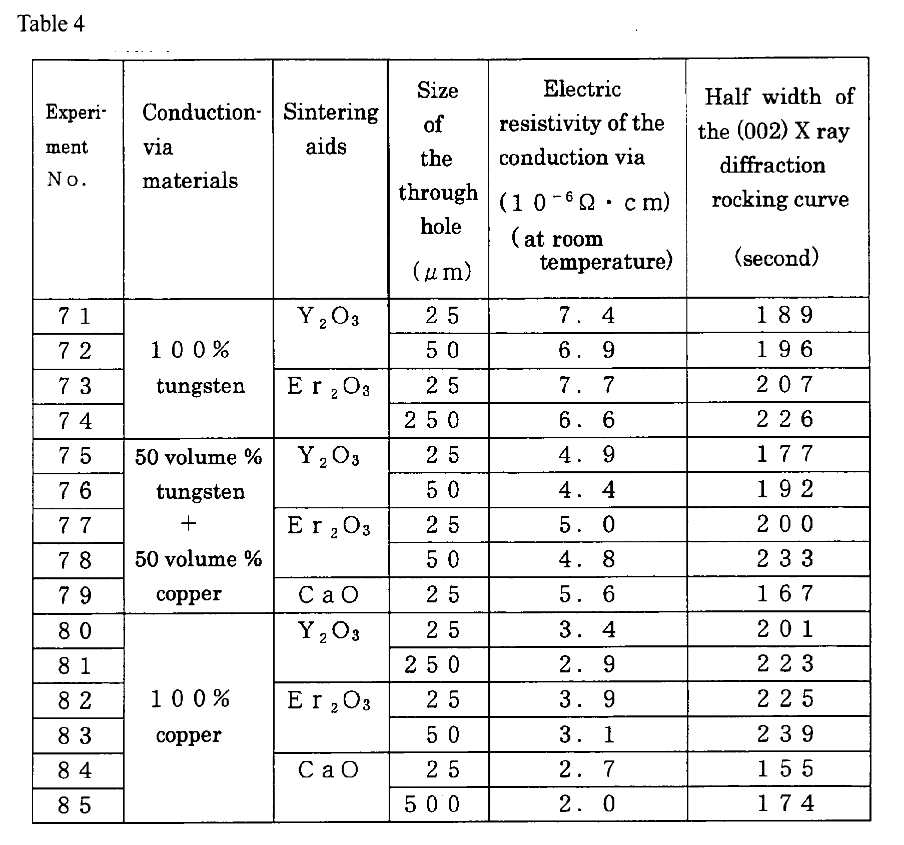

### Example 4

The square sheets of 35 mm x 35 mm were produced from the green sheets produced in Example 3, and the sintered compacts comprising as a main component aluminum nitride were obtained by carrying out the normal-pressure sintering at 1800°C in nitrogen for 1 hour, after the binder was degreased at 500°C in air.

The substrates in which the degree of surface roughness Ra is 25 nm and comprising a sintered compact comprising as a main component aluminum nitride were produced by grinding and polishing the sintered compacts obtained into the square with one-side of 25.4 mm x thickness of 0.5 mm.

The thin films with various thickness of 0.7-4200 nm comprising as a main component at least one selected from gallium nitride, indium nitride and aluminum nitride were formed directly on the substrate using the same MOCVD equipment as what was used in Example 1 and 2.

In addition, the mixed thin film of 50 mol % InN+50 mol % AlN was formed at a substrate temperature of 820°C.

The resultant thin films have the diffraction line from the lattice plane (002) and were a single crystal, when X ray diffraction patterns were taken by CuKα except for the 100% aluminum nitride of the experiment No.90.

In addition, the 100% aluminum nitride thin film was investigated by electron beam diffraction, but only the diffraction line from the lattice plane (002) appeared, diffraction from the lattice plane of the Miller Index (100) was not recognized, so this was also in the state of a single crystal.

The half width of the rocking curve of the X ray diffraction from the lattice plane (002) of the obtained single-crystal thin film was measured.

The result was shown in Table 5.

In all the thickness of the single-crystal thin films, the half width of the rocking curve of the X ray diffraction from the lattice plane (002) is not more than 300 seconds.

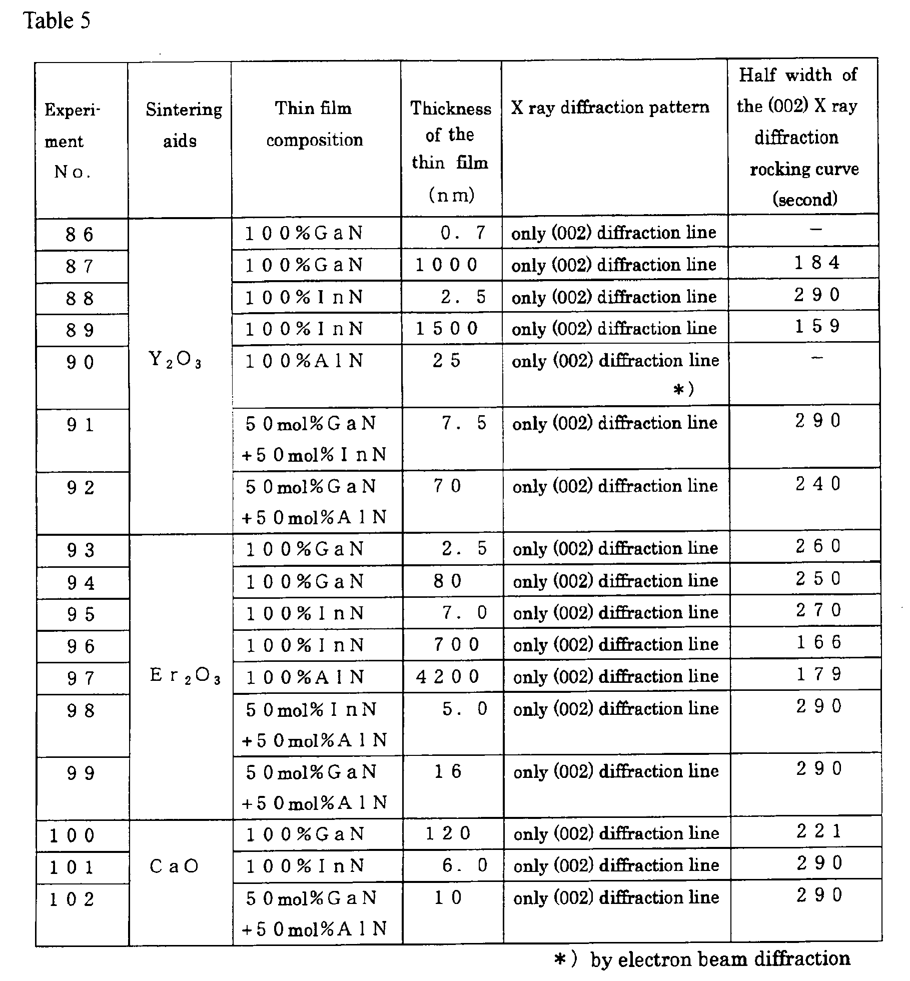

### Example 5

As the raw material powder for producing a sintered compact which comprises aluminum nitride as a main component, two kinds of aluminum nitride powder (the "TOYALNITE" made by Toyo Aluminium K.K., and the "Grade B" made by Starck Co. in Germany) produced by the direct nitriding method from aluminum metal were prepared besides two kinds of raw material produced by the method of aluminum oxide reduction used in Example 1, 2 and 3.

Using two kinds of a raw material powder produced by the direct nitriding method of aluminum metal respectively independently, and that in which each raw material produced by the direct nitriding method of aluminum metal is mixed with each raw material produced by the method of aluminum oxide reduction by a unit of 50 % by weight, respectively, molding and degreasing were carried out by the same method as Example 1, then six kinds of an aluminum nitride-based sintered compact were obtained by carrying out a hot press under 300 kg/cm² at 1950°C for 2 hours in nitrogen.

The substrates comprising an aluminum nitride sintered compact in which the degree of surface roughness Ra is 27 nm were produced by grinding and polishing the sintered compacts obtained to the size with the diameter of 25.4 mm x thickness of 0.5 mm.

In the sintered compact in which only the "TOYALNITE" was used as a raw material, ALON was detected 1.6 % by X ray diffraction besides AlN which is the main phase.

In the sintered compact in which only the "Grade B" was used as a raw material, ALON was detected 2.2 % besides AlN which is the main phase.

In the sintered compacts produced from the mixed raw materials produced by the method of aluminum oxide reduction and by the direct nitriding method of aluminum metal, similarly, the main phase is AlN and they contain ALON 1.2 %.

All of the relative density of these six kinds of the sintered compact were not less than 98 %.

All of the porosity was not more than 1 %.

Next, the thin films with the thickness of 0.25 µm comprising as a main component at least one selected from gallium nitride, indium nitride and aluminum nitride were formed directly on the substrate using the same MOCVD equipment as what was used in Example 1 and 2.

The single-crystal thin film of 100 % aluminum nitride was formed in the thickness of 6 µm.

The half width of the rocking curve of the X ray diffraction from the lattice plane of the Miller Index (002) of the single-crystal thin films obtained like this was measured.

As a result, in all the single-crystal thin films, the half width of the rocking curve of the X ray diffraction from the lattice plane of the Miller Index (002) lattice plane was not more than 300 seconds.

### Example 6

The substrates comprising a sintered compact comprising as a main component aluminum nitride were newly produced using the same raw material as Example 2, the characteristics of the substrates were investigated like Example 2, furthermore, the single-crystal thin films comprising as a main component at least one selected from gallium nitride, indium nitride and aluminum nitride were formed like Example 1 and Example 2 on these substrates, and the crystallinity was investigated.

When the sintered compacts comprising as a main component aluminum nitride were produced, forming of powder compacts and degreasing of the powder compacts were performed by the same method as Example 2.

As the powder compacts, what has no additives, such as sintering aids was used, and MgO, CaCO₃, Al₂O₃, Y₂O₃, Er₂O₃, V₂O₅, and Cr₂O₃ were used as the additives, such as sintering aids.

The details are indicated in Table 6.

After degreasing the above powder compacts containing the various additives, the powder compacts were fired as a fired thing.

The firing of the powder compacts was carried out using the setter made from tungsten, that is, another prepared powder compacts comprising only aluminum nitride powder were put on the setter with the fired things, and they were fired by surrounding the circumferences by the frame of tungsten, or by surrounding the circumference of the fired things by the frame made from aluminum nitride using the setter made from aluminum nitride.

Normal pressure sintering was carried out at 1820°C for 2 hours in N₂ of 1 atmospheric pressure.

In carrying out the hot press, firing under pressure was performed using what was once made into the sintered compacts after the normal-pressure sintering of the powder compacts was once carried out at 1820°C for 1 hour in nitrogen using the tungsten setter.

The result is shown in Table 6.

As a result, the optical transmissivity of all the sintered compacts comprising aluminum nitride as a main component was not less than 30%.

Improving was confirmed compared with the optical transmissivity of that which does not contain an additive and was produced in Example 2, or of the sintered compacts which comprise aluminum nitride as amain component and contain MgO, CaCO₃, Al₂O₃, Y₂O₃, and Er₂O₃ as an additive.

In this Example, compared with the Example 2 it seems that the optical permeability improved more since the aluminum nitride component was supplied into the firing atmosphere from other than the fired thing.

Although it is not indicated in Table 6, as for the optical transmissivity of the aluminum nitride-based sintered compacts obtained by carrying out the hot press of the powder compacts containing MgO, V₂O₅, and Cr₂O₃ as an additive under the pressure of 300 kg/cm² at 1820°C in nitrogen atmosphere for 1 hour as it is without once firing, it was 0 % altogether.

In the various aluminum nitride-based sintered compacts obtained like this, if the aluminum nitride-based sintered compact having the optical transmissivity not less than 40 % is used for a substrate, it is shown that the single-crystal thin films being formed directly on these and comprising as a main component at least one selected from gallium nitride, indium nitride and aluminum nitride have the crystallinity in which the half width of the rocking curve of the X ray diffraction from the lattice plane of the Miller Index (002) is not more than 150 seconds.

In the sintered compact in which the optical transmissivity is not less than 60 %, the half width of the rocking curve of the X ray diffraction from the lattice plane (002) of the single-crystal thin films is not more than 130 seconds.

Even if the optical transmissivity of the substrates comprising the aluminum nitride-based sintered compacts is zero in visible light, it is shown that the single-crystal thin films formed directly on these and comprising as a main component at least one selected from gallium nitride, indium nitride and aluminum nitride have the crystallinity in which the half width of the rocking curve of the X ray diffraction from the lattice plane of the Miller Index (002) is not more than 200 seconds.

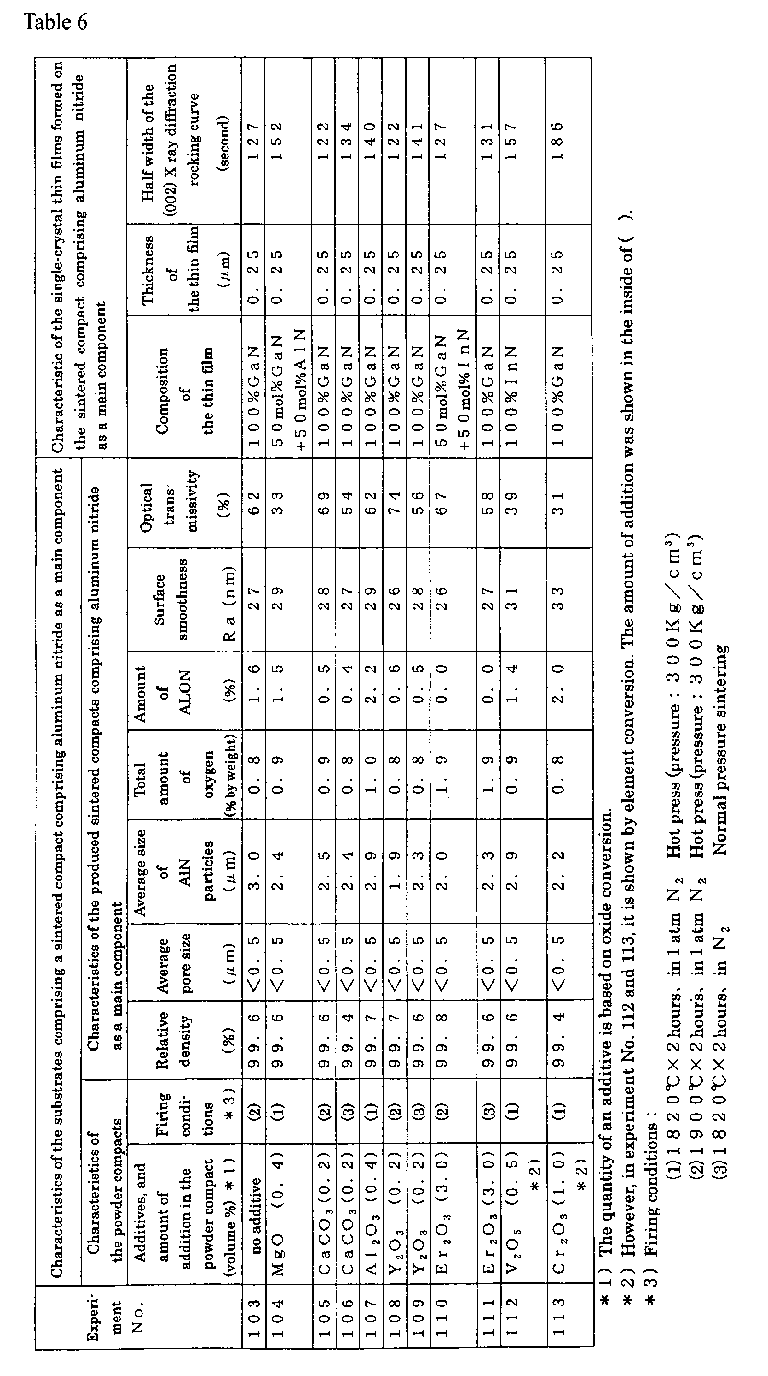

### Example 7

The optical transmissivity of the aluminum nitride-based sintered compacts produced in Example 2 and 6 was measured using the light with 300 nm wavelength.

Except that light was replaced with ultraviolet rays, measurement was carried out by the same method as Example 2.

The result is shown in Table 7.

As a result, in the substrates comprising an aluminum nitride-based sintered compact having high optical transmissivity of visible light, it is shown clearly that they also have the tendency in which the transmissivity of ultraviolet rays is high. As the optical transmissivity of 300 nm ultraviolet rays, what is as high as a maximum of 67 % is obtained.

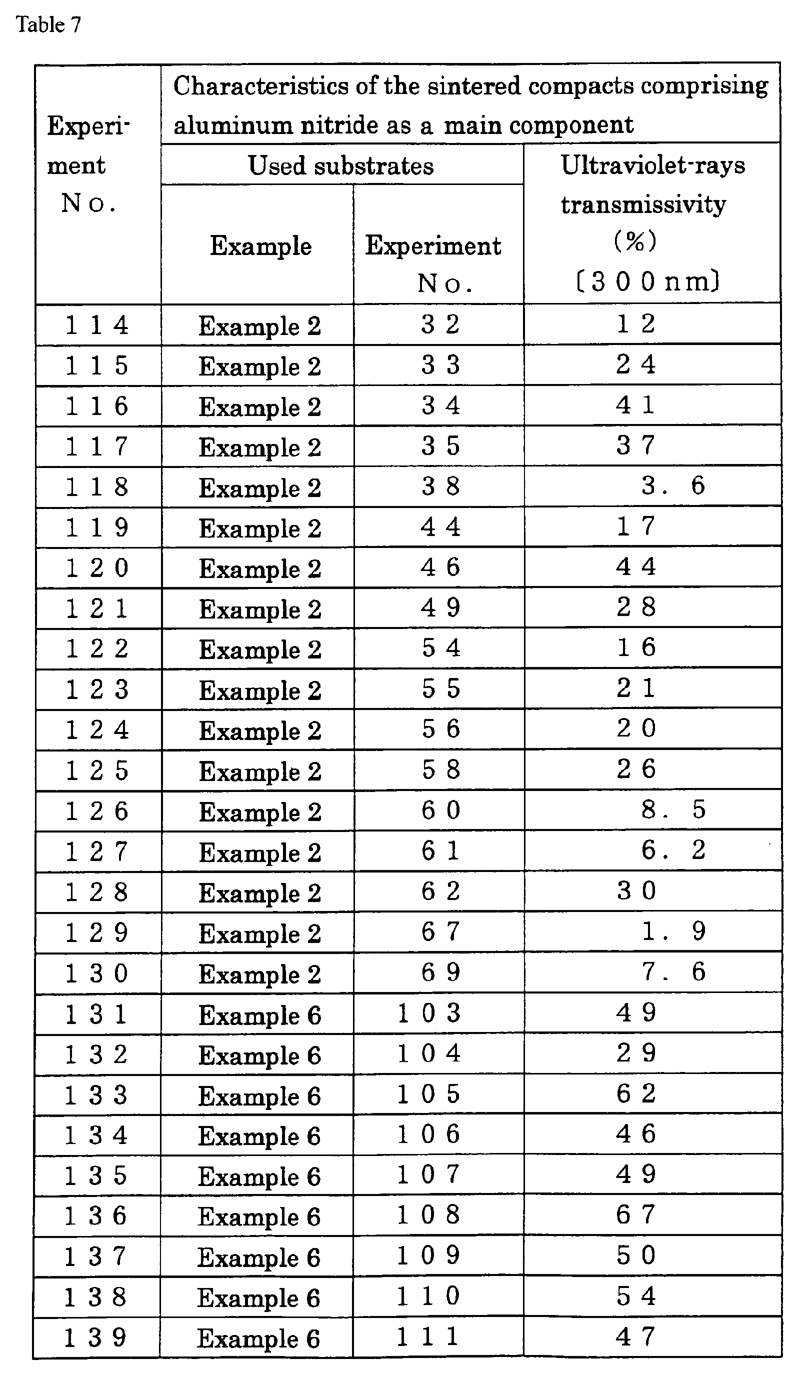

### Example 8

Here prepared the sintered compacts which were produced in Example 1-6 and comprise as a main component aluminum nitride, and the various sintered compacts which were produced in Example 1 and comprise as a main component the ceramic material of silicon carbide, silicon nitride, aluminum oxide, zinc oxide, and beryllium oxide.

The relation between the surface smoothness of these substrates and the crystallinity of the single-crystal thin films which were formed directly on there and comprise as a main component at least one selected from gallium nitride, indium nitride and aluminum nitride was investigated.

As the surface smoothness of the substrates, what is the following three kinds of states was used.

That is, 1) those in which the substrate surface is in the as-fired state (however, surface adhesion objects were removed with a brush using alumina powder), 2) those of the state where the substrate surfaces were ground by lap polish using the grain of SiC or alumina, 3) those of the state where the substrate surfaces were mirror-polished using the abradant comprising as a main component alumina, cerium oxide, a diamond, silicon oxide, or a chromic oxide.

As for the abradant used for lap polish and its particle size, in the case of the aluminum nitride-based sintered compact, #240 of SiC was used in what was produced and used in the experiment No.1-5 of Example 1 and what was produced in the experiment No.62 and 64 of Example 2, #280 of SiC was used in what was produced in the experiment No. 107 of Example 6, #400 of SiC was used in what was produced in the experiment No.34 and 46 of Example 2, what was produced and used in the experiment No.86-92 of Example 4, what was produced and used in the experiment No.100-102 of Example 4, and what was produced in the experiment No. 105 of Example 6, and #600 of SiC was used in the case of the other sintered compacts.

In the case of the sintered compact comprising silicon carbide as a main component, the abradant with the grain size #240 of SiC was used.

In the case of the sintered compact comprising silicon nitride as a main component, the abradant with the grain size #800 of SiC was used.

In the case of the zinc oxide-based sintered compact, the abradant with the grain size #400 of alumina was used.

As for the sintered compacts comprising aluminum nitride as a main component, and the sintered compact comprising silicon nitride as a main component, heat-treatment was performed at 1200°C in N₂ for 1 hour, after the grinding processing of lap polish.

As for the sintered compact comprising silicon carbide as a main component and carried out lap polish, heat-treatment was performed at 1200°C in argon for 1 hour after the grinding processing.

As for the zinc oxide-based sintered compact in which lap polish was carried out, heat-treatment was performed at 1000°C in air for 1 hour after the grinding processing.

The mirror-surface polishing was carried out using the pad made from cloth of commercial item as a polisher, and using the followings as an abradant respectively.

That is, the abradant comprising as a main component a chromic oxide with the particle diameter of 0.1 µm and 0.2 µm was used for the mirror-polishing of the substrates comprising an aluminum nitride-based sintered compact.

The abradant comprising as a main component a diamond with the particle diameter of 0.1 µm (mirror-polished surface 1), and the abradant comprising as a main component a colloidal alumina with the particle diameter of 0.05 µm (mirror-polished surface 2) were used for mirror-polish of the substrates comprising a sintered compact comprising silicon carbide as a main component,

The abradant comprising as a main component a diamond with the particle diameter of 0.25 µm (mirror-polished surface 3), and the abradant comprising as a main component a colloidal alumina with the particle diameter of 0.05 µm (mirror-polished surface 4) were used for mirror-polished surface polish of the substrates comprising a sintered compact comprising silicon nitride as a main component,

The abradant comprising as a main component a diamond with the particle diameter of 0.1 µm (mirror-polished surface 5), and the abradant comprising as a main component a colloidal silicon oxide with the particle diameter of 0.02 µm (mirror-polished surface 6) were used for mirror-polished surface polish of the substrates comprising a sintered compact comprising aluminum oxide as a main component.

The abradant comprising as a main component cerium oxide with the particle diameter of 0.5 µm (mirror-polished surface 7) was used for mirror-polished surface polish of the substrate comprising a zinc oxide-based sintered compact.

The abradant comprising as a main component a diamond with the particle diameter of 0.25 µm (mirror-polished surface 8), and the abradant comprising as a main component a colloidal alumina with the particle diameter of 0.05 µm (mirror-polished surface 9) were used for mirror-surface polish of the substrates comprising a sintered compact comprising beryllium oxide as a main component.

Though not indicated in Table 8, in the case of the substrates which used what is the particle diameter 0.1 µm among the abradant comprising as a main component the chromic oxide and used for mirror-surface polish of the aluminum nitride-based sintered compact substrate, altogether what has the surface smoothness in which the surface roughness Ra is not more than 100 nm were obtained (the substrates used in the experiment No.198-200 and the experiment No.210-211).

All other substrates carried out mirror-surface polish by the abradant comprising as a main component a chromic oxide with the particle diameter of 0.2 µm.

The surface smoothness (shown as the surface roughness Ra) of each above substrate and the surface state of the substrates which were thus produced are shown in Table 8.

After each substrate having the above surface states was washed by ultrasonic using acetone and IPA, the thin films comprising as a main component at least one selected from gallium nitride, indium nitride and aluminum nitride were formed in the thickness shown in Table 8, like the Example 1 and the Example 2, and the crystallinity was investigated.

The above experimental result is shown in Table 8.

As a result, in the substrates which used the aluminum nitride-based sintered compact, the thin films comprising as a main component at least one selected from gallium nitride, indium nitride and aluminum nitride can be formed in the state of single crystal without becoming the polycrystalline state directly in the surface even if it is in the as-fired state.

The surface smooth nature of the substrates which used the aluminum nitride-based sintered compact with as-fired state is in the range of 90-1000 nm as the average surface roughness Ra.

In the substrates which used the aluminum nitride-based sintered compact, the thin films comprising as a main component at least one selected from gallium nitride, indium nitride and aluminum nitride may be formed in the state of single crystal without becoming the polycrystalline state directly on the surface even if it is what is in the state where lap polish of the surface was carried out.

As for the surface smooth nature of the substrates which used the aluminum nitride-based sintered compact having the state where lap polish of the surface was carried out, it is in the range of 100-2000 nm as average surface roughness Ra.

In the substrates which used the aluminum nitride-based sintered compact, the thin films comprising as a main component at least one selected from gallium nitride, indium nitride and aluminum nitride may be formed in the state of single crystal without becoming the polycrystalline state directly on the surface having the state where the specular surface polish was carried out.

The surface smooth nature of the substrates which used the aluminum nitride-based sintered compact having the state where the specular surface polish was carried out is in the range of not more than 100 nm as the average surface roughness Ra.

The result of this Example is shown in Table 8.

That is, in the substrates which used the aluminum nitride-based sintered compact, if that in which the surface state of the substrates is what carried out the specular surface polish is used among the above three kinds, it was shown that what has more excellent crystallinity is easy to be obtained, as the single-crystal thin films which comprise as a main component at least one selected from gallium nitride, indium nitride and aluminum nitride and are formed directly on the substrates.

In Table 8, it is shown that the single-crystal-ized thin films comprising as a main component at least one selected from gallium nitride, indium nitride and aluminum nitride may be formed directly on that in which the average surface roughness Ra of the substrates which used the aluminum nitride-based sintered compact is not more than 2000 nm, and that the single-crystal thin films in which the half width of the rocking curve of the X ray diffraction from the lattice plane of the Miller Index (002) is not more than 3600 seconds are obtained.

It is shown that the single-crystal-ized thin films comprising as a main component at least one selected from gallium nitride, indium nitride and aluminum nitride may be formed directly on that in which the average surface roughness Ra is not more than 1000 nm among the substrates which used the aluminum nitride-based sintered compact, and that the single-crystal thin films in which the half width of the rocking curve of the X ray diffraction from the lattice plane of the Miller Index (002) is not more than 1000 seconds are obtained.

It is shown that the single-crystal-ized thin films comprising as a main component at least one selected from gallium nitride, indium nitride and aluminum nitride may be formed directly on that in which the average surface roughness Ra is not more than 100 nm among the substrates which used the aluminum nitride-based sintered compact, and that the single-crystal thin films in which the half width of the rocking curve of the X ray diffraction from the lattice plane of the Miller Index (002) is not more than 300 seconds are obtained.

It is shown that the single-crystal-ized thin films comprising as a main component at least one selected from gallium nitride, indium nitride and aluminum nitride may be formed directly on that in which the average surface roughness Ra is not more than 60 nm among the substrates which used the aluminum nitride-based sintered compact, and that the single-crystal thin films in which the half width of the rocking curve of the X ray diffraction from the lattice plane of the Miller Index (002) is not more than 240 seconds are obtained.

It is shown that the single-crystal-ized thin films comprising as a main component at least one selected from gallium nitride, indium nitride and aluminum nitride may be formed directly on that in which the average surface roughness Ra is not more than 30 nm among the substrates which used the aluminum nitride-based sintered compact, and that the single-crystal thin films in which the half width of the rocking curve of the X ray diffraction from the lattice plane of the Miller Index (002) is not more than 200 seconds are obtained.

It is shown that the single-crystal-ized thin films comprising as a main component at least one selected from gallium nitride, indium nitride and aluminum nitride may be formed directly on that in which the average surface roughness Ra is not more than 20 nm among the substrates which used the aluminum nitride-based sintered compact, and that the single-crystal thin films in which the half width of the rocking curve of the X ray diffraction from the lattice plane of the Miller Index (002) is not more than 150 seconds are obtained.

In Table 8, in the substrates which used the aluminum nitride-based sintered compact, it was shown that what has excellent crystallinity is easy to be obtained as the single-crystal thin films which are formed directly on the substrates and comprise as a main component at least one selected from gallium nitride, indium nitride and aluminum nitride, if using as the surface state of the substrates what carried out the specular surface polish among the above three kinds which are as-fired state, lap polish, and specular surface polish.

If the substrates having the surface state of as-fired state are compared with the substrates having the surface state which carried out lap polish, it was shown that what has excellent crystallinity is easy to be obtained using the substrates having the as-fired surface state as the above single crystals formed directly there.

In the substrates which used the sintered compacts which comprise as a main component various ceramic materials other than aluminum nitride, the thin films comprising as a main component at least one selected from gallium nitride, indium nitride and aluminum nitride may be formed in the state of single crystal without becoming the polycrystalline state directly on the surface, even if they are in the as-fired state.

The surface smooth nature of the substrates which used the sintered compacts which comprise as a main component various ceramic materials other than aluminum nitride and have the as-fired state is in the range of 90-1000 nm as the average surface roughness Ra.

In the substrates which used the sintered compacts which comprise as a main component various ceramic materials other than aluminum nitride, the thin films comprising as a main component at least one selected from gallium nitride, indium nitride and aluminum nitride may be formed in the state of single crystal without becoming the polycrystalline state directly on the surface, even if they are in the as-fired state.

The surface smooth nature of the substrates which used the sintered compacts which comprise as a main component various ceramic materials other than aluminum nitride and have the state where the lap polish of the surface was carried out is in the range of 80-1000 nm as the average surface roughness Ra.

In the substrates which used the sintered compacts which comprise as a main component various ceramic materials other than aluminum nitride, the thin films comprising as a main component at least one selected from gallium nitride, indium nitride and aluminum nitride may be formed in the state of single crystal without becoming the polycrystalline state directly on the surface with the state where specular surface polish was carried out.

The surface smooth nature of the substrates which used the sintered compact which comprises as a main component various ceramic materials other than aluminum nitride and have the state where specular surface polish was carried out is in the range of 1-100 nm as the average surface roughness Ra.

In Table 8, it is shown that the single-crystal-ized thin films comprising as a main component at least one selected from gallium nitride, indium nitride and aluminum nitride may be formed directly on those in which the average surface roughness Ra of the substrates which used the sintered compact which comprises as a main component various ceramic materials other than aluminum nitride is not more than 1000 nm, and that the single-crystal thin films in which the half width of the rocking curve of the X ray diffraction from the lattice plane of the Miller Index (002) is not more than 3600 seconds are obtained.

It is shown that the single-crystal-ized thin films comprising as a main component at least one selected from gallium nitride, indium nitride and aluminum nitride may be formed directly on those in which the average surface roughness Ra is not more than 100 nm among the substrates which used the sintered compact which comprises as a main component various ceramic materials other than aluminum nitride, and that the single-crystal thin films in which the half width of the rocking curve of the X ray diffraction from the lattice plane of the Miller Index (002) is not more than 1000 seconds are obtained.

It is shown that the single-crystal-ized thin films comprising as a main component at least one selected from gallium nitride, indium nitride and aluminum nitride may be formed directly on those in which the average surface roughness Ra is not more than 10 nm among the substrates which used the sintered compact which comprises as a main component various ceramic materials other than aluminum nitride, and that the single-crystal thin films in which the half width of the rocking curve of the X ray diffraction from the lattice plane of the Miller Index (002) is not more than 300 seconds are obtained.

It is shown that the single-crystal-ized thin films comprising as a main component at least one selected from gallium nitride, indium nitride and aluminum nitride may be formed directly on those in which the average surface roughness Ra is not more than 5 nm among the substrates which used the sintered compact which comprises as a main component various ceramic materials other than aluminum nitride, and that the single-crystal thin films in which the half width of the rocking curve of the X ray diffraction from the lattice plane of the Miller Index (002) is not more than 240 seconds are obtained.

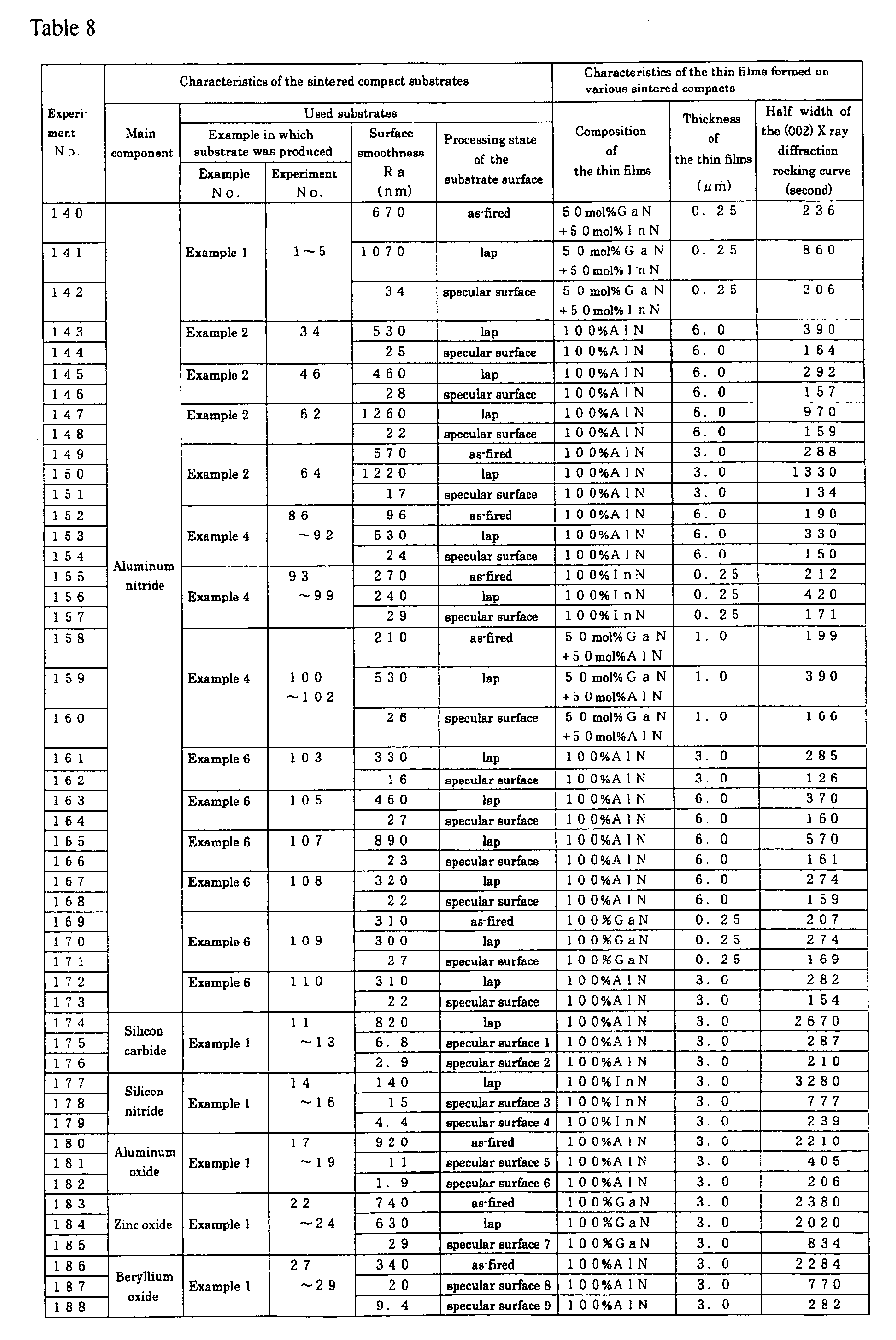

### Example 9

Here prepared the sintered compacts which were produced in Example 1-6 and comprise aluminum nitride as a main component, and the sintered compacts which were produced in Example 1 and comprise as a main component various ceramicss of silicon carbide, silicon nitride, aluminum oxide, zinc oxide, and beryllium oxide

The single-crystal thin films comprising as a main component at least one selected from gallium nitride, indium nitride and aluminum nitride were formed directly on these substrates by the same method as Example 1 and Example 2, and the relation between the thickness after forming the single-crystal thin films and the crystallinity of the single-crystal thin films formed was investigated.

Specular surface polish of the used substrates made from the sintered compacts comprising as a main component aluminum nitride and various ceramicss has been carried out beforehand by the same method as Example 8, and the surface roughness is shown in Table 9.

The substrate comprising a zinc oxide-based sintered compact used in this Example was ground using abradant comprising as a main component cerium oxide with the particle diameter of 0.2 µm.

In this Example, using the MOCVD method in which the conditions were changed and which was shown in Example 1, the thin film formation was performed in the condition where the substrate temperature is 1050°C in the case of gallium nitride thin film, 650°C in the case of indium nitride thin film, 1200°C in the case of aluminum nitride thin film, and 1100°C in the case of the mixed crystal thin film of 50 mol % GaN+50 mol % AlN.

The formation rate of each thin film is about 0.5-1.5 µm/hour, about 0.5-1.5µm/hour, about 2-6 µm/hour, and about 1-3 µm/hour, respectively.

Production of the single-crystal thin films comprising as a main component gallium nitride, indium nitride, and aluminum nitride was also carried out newly by the Chloride VPE (Chloride Vapor Phase Epitaxy) method which used a gallium chloride, an indium chloride, and an aluminium chloride as a raw material.

Nitrogen was used as a career gas of the vaporized raw materials, and ammonia was used for a reactive gas.

Rapid thin film formation was possible, such as 5-200 µm per hour, as the thin film formation rate.

The single-crystal thin film by the Chloride VPE method was formed on the substrates used in the experiment No.193, 195, 197, 200, 202, 203, 209, 210, 211, 213, 215, 217, and 222.

As for the substrate temperature at the time of the formation of single-crystal thin films by the Chloride VPE method, it was carried out at 1150°C in the case of a gallium nitride thin film, at 800°C in the case of an indium nitride thin film, and at 1280°C in the case of an aluminum nitride thin film.

Using a silica tube as the reaction chamber, a carbon setter is heated by the high frequency induction from the outside, and the indirect heating of the substrates which were placed on it and comprise the sintered compacts comprising as a main component aluminum nitride and various ceramicss was carried out.

The result is shown in Table 9.

Table 9 shows that as for the crystallinity of the single-crystal thin films comprising as a main component at least one selected from gallium nitride, indium nitride and aluminum nitride and formed directly on the substrates of this invention comprising an aluminum nitride-based sintered compact, the half width of the rocking curve of the X ray diffraction from the lattice plane (002) of the single-crystal thin films was not more than 240 seconds, when the thickness of the single-crystal thin films was not less than 0.3 µm.

As for the crystallinity of the single-crystal thin films which comprise as a main component at least one selected from gallium nitride, indium nitride and aluminum nitride and were formed directly on the substrates comprising an aluminum nitride-based sintered compact, it is shown that the half width of the rocking curve of the X ray diffraction from the lattice plane of the Miller Index (002) is not more than 200 seconds, when the thickness of the single-crystal thin films is not less than 3.5 µm.

As for the crystallinity of the single-crystal thin films which comprise as a main component at least one selected from gallium nitride, indium nitride and aluminum nitride and were formed directly on the substrates comprising an aluminum nitride-based sintered compact, it is shown that the half width of the rocking curve of the X ray diffraction from the lattice plane of the Miller Index (002) is not more than 150 seconds, when the thickness of the single-crystal thin films is not less than 10 µm.

Furthermore, as for the crystallinity of the single-crystal thin films which comprise as a main component at least one selected from gallium nitride, indium nitride, and aluminum nitride and were formed directly on the substrates comprising an aluminum nitride-based sintered compact, it is shown that the half width of the rocking curve of the X ray diffraction from the lattice plane of the Miller Index (002) is not more than 130 seconds, when the thickness of the single-crystal thin films is not less than 50 µm.

In the above formation method of single-crystal thin films, it was confirmed that the thick thin films up to about 500-1000 µm can be formed using the Chloride VPE method.

This is considered to be because the aluminum nitride-based sintered compacts used as a substrate have comparatively high optical permeability.

Although not shown in Table 9, when formation of the thin films having the thickness of 500 µm-1000 µm and comprising aluminum nitride as a main component was tried by the Chloride VPE method of the same conditions as the above, using the substrates comprising the aluminum nitride-based sintered compacts being produced in the experiment No.65, 68 and 70 of Example 2 and having less optical permeability, while the crystallinity is comparatively excellent like the half width of the rocking curve of the X ray diffraction from the lattice plane of the Miller Index (002) is not more than 130 seconds, the crack was seen in the thin films, and exfoliation was also seen between the thin film and substrate.

When formation of the aluminum nitride-based thin film was tried in the condition where the temperature of the substrate which comprises an aluminum nitride-based sintered compact is 800°C and 900°C, by using the above Chloride VPE method, the aluminum nitride-based thin film could not be formed in the state of a single crystal, but was a thin film of crystallization states, such as an amorphous state, a polycrystal, or an orientated polycrystal, altogether.

When the aluminum nitride-based single-crystal thin film is formed on the substrate comprising an aluminum nitride-based sintered compact by the Chloride VPE method, it was confirmed that it is required to set up the substrate temperature properly.

On the other hand, in the case of the substrates which used the sintered compacts comprising a ceramic material which comprises as a main component silicon carbide, silicon nitride, zinc oxide, beryllium oxide, and aluminum oxide other than aluminum nitride, it was shown that the crystallinity of the single-crystal thin films was good even if the thickness of the single-crystal thin films which comprise as a main component at least one selected from gallium nitride, indium nitride and aluminum nitride and were formed directly on there is at least not less than 0.3 µm.

That is, in the single-crystal thin films with the thickness not less than 0.3 µm which comprise as a main component at least one selected from gallium nitride, indium nitride and aluminum nitride and were formed directly on the above substrates which used the sintered compacts comprising a ceramic material which comprises as a main component silicon carbide, silicon nitride, zinc oxide, beryllium oxide, and aluminum oxide other than aluminum nitride, it is shown that the half width of the rocking curve of the X ray diffraction from the lattice plane of the Miller Index (002) is not more than 300 seconds.

It is shown that the half width of the rocking curve of the X ray diffraction from the lattice plane of the Miller Index (002) of the single-crystal thin films with the thickness not less than 3.5 µm is not more than 240 seconds.

Moreover, it is shown that the half width of the rocking curve of the X ray diffraction from the lattice plane of the Miller Index (002) of the single-crystal thin films with the thickness not less than 10 µm is also not more than 240 seconds.

Observation of the obtained thin films was carried out using the optical microscope and the electron microscope, as a result, a crack is not seen in the inside of the thin films produced by the MOCVD method and the Chloride VPE method, and exfoliation was not seen in the junction interface between the thin film and the sintered compact comprising as a main component aluminum nitride and other various ceramic materials.

Tested by pasting up and tearing off after adhesive tape is pasted up to each thin film obtained, as a result, there are no exfoliations in the interface between the thin films and the aluminum nitride-based sintered compacts, and the other various ceramic-based sintered compacts. The sintered compacts comprising aluminum nitride as a main component and the other various ceramic-based sintered compacts are integrally adhered to the thin films.

The thin film-conductive material of Ti/Pt/Au was formed in each above thin film formed, the metal leads were soldered and perpendicular tensile strength was investigated, as a result, it all is not less than 2 kg/mm², so the aluminum nitride-based sintered compact and the other various ceramic-based sintered compacts are integrally adhered to the thin film.

Specular surface polish was carried out further by the abradant comprising as a main component a colloidal silicon oxide and having the particle diameter of 0.02 µm after polishing the thin films produced in the experiment No.191 192, 193, 206, 208, and 220 using the abradant comprising as a main component a chromic oxide and having the particle diameter of 0.2 µm, the surface roughness (Ra) was 1.2 nm (the experiment No.191), 1.04 nm (the experiment No.192), 0.94 nm (the experiment No.193), 1.1 nm (the experiment No.206), 1.06 nm (the experiment No.208), and 0.99 nm (the experiment No.220), respectively, all are not more than 2 nm, and it was confirmed that the thin-film substrates in which the single-crystal thin films excellent in smooth nature were formed by carrying out polish are obtained.

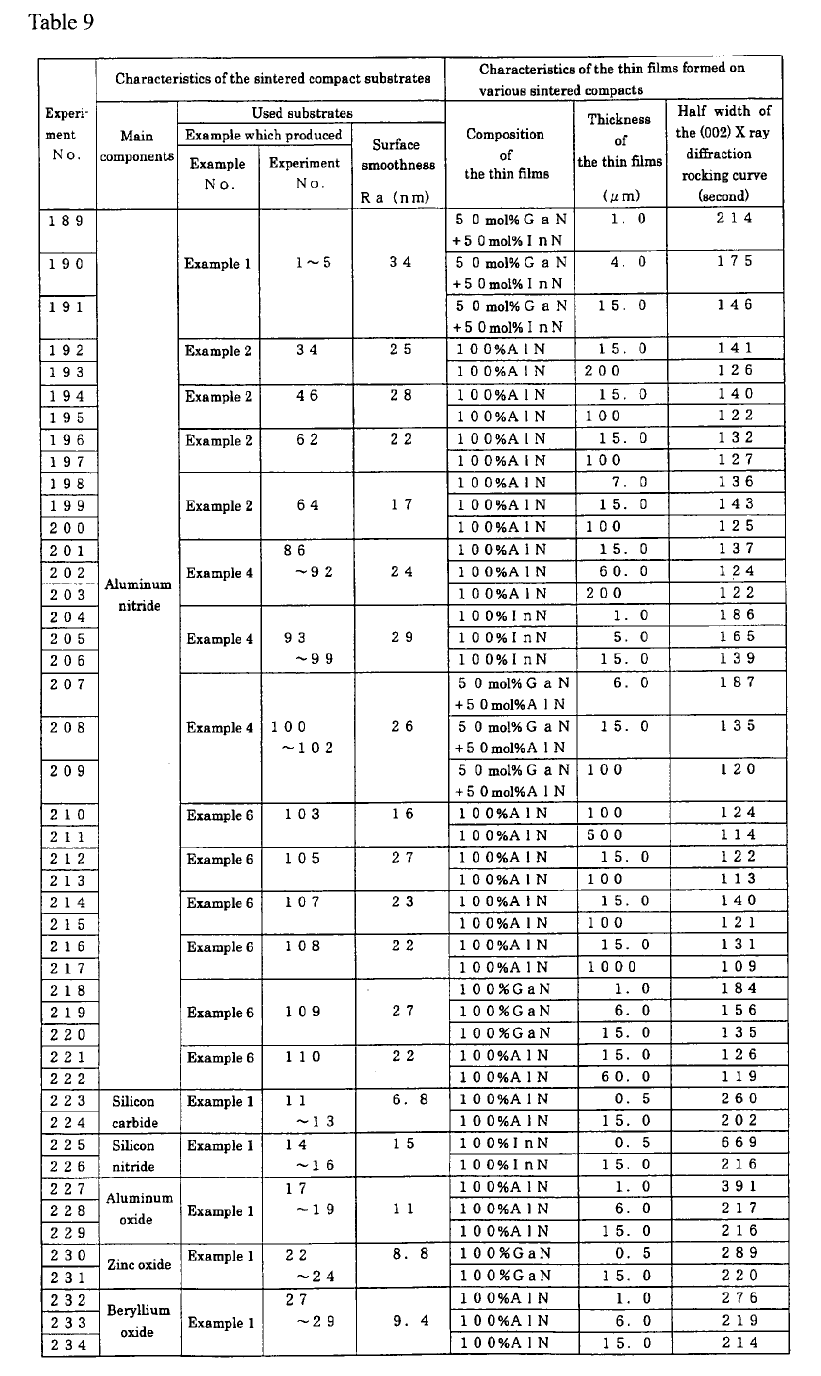

### Example 10

Here prepared the aluminum nitride-based sintered compacts produced in Example 1-6, and the sintered compacts which were produced in Example 1 and comprise as a main component various ceramic materials of silicon carbide, silicon nitride, aluminum oxide, zinc oxide, and beryllium oxide.

Specular surface polish is given to the substrates surface by the same method as Example 8 and Example 9.

Two or more layers of the single-crystal thin films comprising as a main component at least one selected from gallium nitride, indium nitride and aluminum nitride were formed on the above sintered compact substrates by the MOCVD method and the Chloride VPE method on the same conditions as what was shown in Example 1, Example 2, or Example 9, except having changed the substrate temperature, then the crystallinity of each single-crystal thin film layer obtained was investigated.

The Chloride VPE method was used only when forming the thin films exceeding the thickness of 15 µm.

Thin films were formed using dimethyl beryllium, bis-cyclopentadienyl magnesium, diethyl zinc, and SiH₄ as a raw material for doping in the case of thin film formation by the MOCVD method, and MgBr₂ was used as a raw material for doping in the case of thin film formation by the Chloride VPE method.

When thin films are formed using the MOCVD method, 1st layer of the thin films formed directly on the aluminum nitride-based sintered compact was formed by the same raw material, gas, substrate temperature, and other formation conditions as Example 1.

As for the 2nd layer and 3rd layer of the thin films formed on the 1st layer, the formation was carried out in the condition where the substrate temperature is 950°C in the case of what comprises GaN as a main component, 750°C in the case of what comprises InN as a main component, and 1050°C in the case of what comprises AlN as a main component, and it was carried out in the condition where the raw material, gas, and formation condition are same as Example 1, irrespective of the existence of doping component content.

The substrate temperature was 1000°C in the case of what comprises a mixed crystal of GaN+AlN as a main component, irrespective of the existence of doping component content, the substrate temperature was 800°C in the case of the mixed crystal of GaN+InN, and the formation was carried out in the condition where the raw material, gas, and formation condition are same as Example 1.

In addition, in the thin film formation by the Chloride VPE method, formation of the thin film containing Mg as a doping component in the mixed crystal comprising GaN+AlN as a main component was carried out at 1200°C as the substrate temperature, and it was carried out in the condition where the raw material, gas, and formation condition, etc. are same as Example 9.

The constitution of the single-crystal thin films layer formed in two or more layers is the following three kinds, as mentioned above.

That is,
1) what formed the single-crystal thin film of the same composition separately in 2 steps or more,
2) that in which the composition of gallium nitride, indium nitride and aluminum nitride which are the main components differs,
3) that wherein the main component is the same but the content of the component of very small quantity, such as a doping agent, differs.

As for the substrates forming the thin films having the doping component of Be, Mg, Zn, and Si other than the component comprising as a main component at least one selected from gallium nitride, indium nitride and aluminum nitride, they were heat-treated at 700°C in pure N₂ atmosphere after the above thin film formation by the MOCVD method and the Chloride VPE method.

The crystallinity of each single-crystal thin film layer obtained like that was investigated.

In the single-crystal thin films having the constitution of two or more layers, the crystallinity of the single-crystal thin films formed under the surface layer was investigated by X ray diffraction before the upside single-crystal thin films layer is formed, or it was investigated after carrying out the removal by grinding the upside single-crystal thin films layer.

The result is shown in Table 10.

In addition, in the column of the thin film composition of Table 10, that of the 1 st layer is a single-crystal thin film currently formed directly on the sintered compact substrate, that of the 2nd layer is a single-crystal thin film formed directly on the single-crystal thin film of the 1 st layer, and that of the 3rd layer is a single-crystal thin film formed directly on the single-crystal thin film of the 2nd layer.

So that it is clear from Table 10, as for the crystallinity of the single-crystal thin films which were formed on the substrates in two or more layers and comprise as a main component at least one selected from gallium nitride, indium nitride and aluminum nitride, there shows that in which all the half width of the rocking curve of the X ray diffraction from the lattice plane of a Miller Index (002) is not more than 300 seconds, if the substrates of this invention comprising a sintered compact comprising aluminum nitride and various ceramic materials as a main component are used.

As shown in Table 10, as for the crystallinity of each single-crystal thin film layer of the 2nd layer and the 3rd layer which were formed in the constitution of two or more layers on the above substrates comprising a sintered compact comprising aluminum nitride and various ceramic materials as a main component, it was also confirmed that it has the tendency being excellent compared with the crystallinity of the single-crystal thin film of the 1 st layer.

As for the crystallinity of each single-crystal thin film layer of the 2nd layer and the 3rd layer which were formed in the constitution of two or more layers on the above substrates comprising a sintered compact comprising aluminum nitride and various ceramic materials as a main component, when using the aluminum nitride-based sintered compact among the above substrates, the half width of the rocking curve of the X ray diffraction from the lattice plane of the Miller Index (002) is not more than 150 seconds, it was shown that those being excellent further are obtained compared with the various sintered compacts comprising as a main component a ceramic material having the crystal structure which can be classified as a hexagonal system, such as silicon carbide, silicon nitride, zinc oxide, and beryllium oxide, etc., and can be classified as a trigonal system or a hexagonal system, such as aluminum oxide, etc.

It was confirmed that the single-crystal thin film with comparatively thick thickness of about 200 µm can be formed also as a two-layer constitution.

The electric resistivity at room temperature was measured about each single-crystal thin film of the 2nd layer which doped Si in the experiment No.237 and 238, and it was confirmed that they have semiconductorized into 0.6 Ω·cm (49.94 mol % GaN+49.94 mol % AlN+0.12 mol % Si) and 86 Ω·cm (99.94 mol % AlN+0.06 mol % Si), respectively.

The electric resistivity at room temperature was measured about each single-crystal thin film which doped Mg, Be, and Zn of the 3rd layer in the experiment No.240, the 2nd layer in the experiment No.241, and the 2nd layer in the experiment No.242, and it was confirmed that they have semiconductorized into 0.097 Ω·cm (99.9 mol % GaN+0.1 mol %Mg), 0.44 Ω·cm (99.9 mol % GaN+0.1 mol % Be), and 0.26 Ω·cm (99.9 mol % GaN+0.1 mol %Zn), respectively.

Furthermore, the electric resistivity at room temperature was measured about each single-crystal thin film of the 2nd layer in the experiment No.239, the 3rd layer in the experiment No.241, and the 4th layer in the experiment No.246, they were 0.054 Ω·cm (100 % GaN), 0.036 Ω·cm (70 mol % GaN+30 mol % InN), and 0.011 Ω·cm (100 % InN), respectively, and GaN, InN and GaN+InN which do not contain a doping element have semiconductorized spontaneously.

As mentioned above, in this invention, as for the thin-film substrates in which the single-crystal thin films comprising at least one layer and two layers and comprising as a main component at least one selected from gallium nitride, indium nitride and aluminum nitride were formed on the aluminum nitride-based sintered compact, or on the various sintered compacts comprising as a main component a ceramic material, such as silicon carbide, silicon nitride, aluminum oxide, zinc oxide, and beryllium oxide, it was shown that the single-crystal thin film comprising asa main component at least one selected from gallium nitride, indium nitride and aluminum nitride may be formed furthermore on it.

As for the crystallinity of the single-crystal thin films formed on the single-crystal thin films with at least one layer and two layers comprising as a main component at least one selected from gallium nitride, indium nitride and aluminum nitride and being formed beforehand on the above substrates which comprise the various ceramic-based sintered compacts, it was confirmed that it is easy to be improved than the single-crystal thin films formed under it.

Thus, as for the above thin-film substrate in which the single-crystal thin films comprising at least one layer and two layers and comprising as a main component at least one selected from gallium nitride, indium nitride and aluminum nitride were formed on the sintered compact comprising as a main component aluminum nitride, or on the various sintered compacts comprising as a main component a ceramic material, such as silicon carbide, silicon nitride, aluminum oxide, zinc oxide, and beryllium oxide, it was confirmed that it can be used also as a substrate for forming a single-crystal thin film comprising as a main component at least one selected from gallium nitride, indium nitride and aluminum nitride.

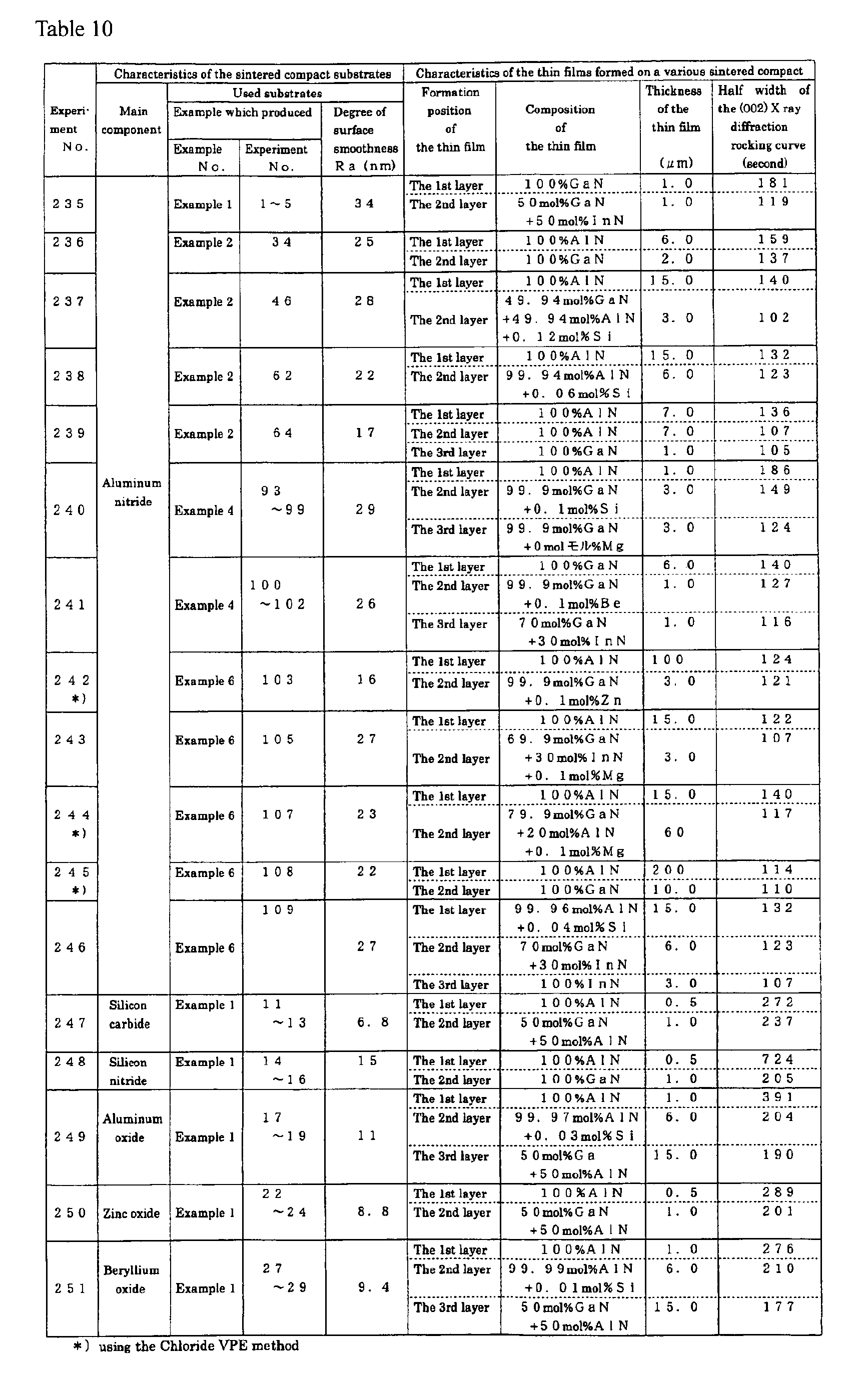

### Example 11

The high purity aluminum nitride powder [the grade "H" by Tokuyama Soda Co., Ltd. (present: Tokuyama, Inc.)] manufactured by the method of reduction of an oxide (aluminum oxide), and the "TOYALNITE" by Toyo Aluminium K.K. produced by the method of direct nitriding of metal aluminum were prepared as a raw material powder for producing the sintered compacts comprising aluminum nitride as a main component, and various powders of a rare earth element compound and an alkaline-earth-metal compound were prepared as sintering aids.

As a result of analysis, oxygen is contained 1.2 % by weight in the "H" grade, and oxygen is contained 1.4 % by weight in the "TOYALNITE", as impurities.

Mean particle size of the powders is 0.9 µm and 1.1 µm, respectively.

In addition to those, aluminum oxide, carbon, and silicon, etc. were prepared as additives.

The powder compacts of various composition were produced by the same method as Example 2 using these raw materials.

They were fired at 1800°C for 1 hour by the same method as Example 2 so that sintering aids, etc. are not vaporized as much as possible using some of the powder compacts obtained in this way, and the beforehand fired sintered compacts were also produced.

As the beforehand fired sintered compacts, the samples of the experiment No.283-286 of Table 11 and Table 12 in which the contents of this Example are shown are them.

After putting the powder compacts and beforehand fired sintered compacts which were obtained onto the setter made from carbon, they were put into the saggar made from carbon, they were fired in nitrogen atmosphere containing carbon monoxide 1000 ppm at high temperature and for long time using a carbon furnace, and the sintered compacts comprising aluminum nitride as a main component were obtained.

As for the sintered compacts obtained, the chemical composition analysis, the fixed quantity of the AlN crystal phase by X ray diffraction, and the measurement of the size of aluminum nitride particles were carried out.

The fixed quantity of the AlN crystal phase by X ray diffraction is the value calculated by deducting the quantity of the crystal phases other than AlN from the quantity of the whole crystal phases, after the diffraction peaks of the crystal phases other than AlN were measured and the percentage ratio between those and the strongest diffraction peak of AlN was asked for.

Specular polish of the surface of the sintered compacts obtained was carried out into 30 nm, and the optical transmissivity to the light with a wavelength of 605 nm was measured by the same method as Example 2.

The optical transmissivity measured is the total transmissivity.

Using the substrates in which the mirror-surface polish was carried out, the single-crystal thin films comprising as a main component at least one selected from gallium nitride, indium nitride and aluminum nitride were formed by the same method as Example 1 and Example 2, and the crystallinity of the single-crystal thin films was investigated.

These results are shown in Table 11 and Table 12.

In Table 11, the compositions of powder compacts for producing a sintered compact comprising as a main component aluminum nitride, the firing conditions, and the compositions and characteristics of the sintered compacts obtained are shown.

In Table 12, the compositions of the single-crystal thin films formed on the substrates, and their crystallinity are shown, when the sintered compacts comprising as a main component aluminum nitride are used for a substrate.

That is, the sintered compacts comprising aluminum nitride as a main component and which raised the AlN purity by the above method were obtained.

In the powder compacts which contain simultaneously a rare earth element compound and an alkaline-earth-metal compound which were used as sintering aids, or in the sintered compacts fired beforehand, components, such as sintering aids, are vaporized and removed at lower temperature and in short time, there is a tendency in which the purity of AlN of the aluminum nitride-based sintered compacts will increase.

The single-crystal thin films comprising as a main component at least one selected from gallium nitride, indium nitride and aluminum nitride were formed using the sintered compacts as a substrate, and the crystallinity of the single-crystal thin films was investigated.

As a result, the aluminum nitride-based sintered compacts comprising the composition wherein the content of at least one compound selected from a rare earth element compound and an alkaline-earth-metal compound is a total of not more than 0.5 % by weight on an element basis and the content of oxygen is not more than 0.9 % by weight can be obtained.

In the single-crystal thin films which are formed directly on the substrates of this composition and comprise as a main component at least one selected from gallium nitride, indium nitride and aluminum nitride, what has good crystallinity, such that the half width of the rocking curve of the X ray diffraction from the lattice plane of the Miller Index (002) is at least not more than 240 seconds, is obtained.

The aluminum nitride-based sintered compacts comprising the composition wherein the content of at least one compound selected from a rare earth element compound and an alkaline-earth-metal compound is a total of not more than 0.2 % by weight on an element basis and the content of oxygen is not more than 0.5 % by weight may be obtained.

In the single-crystal thin films which are formed directly on the substrates of this composition and comprise as a main component at least one selected from gallium nitride, indium nitride and aluminum nitride, what has good crystallinity, such that the half width of the rocking curve of the X ray diffraction from the lattice plane of the Miller Index (002) is at least not more than 200 seconds, is obtained.

The aluminum nitride-based sintered compacts comprising the composition wherein the content of at least one compound selected from a rare earth element compound and an alkaline-earth-metal compound is a total of not more than 0.05 % by weight on an element basis and the content of oxygen is not more than 0.2 % by weight may be obtained.

In the single-crystal thin films which are formed directly on the substrates of this composition and comprise as a main component at least one selected from gallium nitride, indium nitride and aluminum nitride, what has good crystallinity, such that the half width of the rocking curve of the X ray diffraction from the lattice plane of the Miller Index (002) is at least not more than 150 seconds, is obtained.

The aluminum nitride-based sintered compacts comprising the composition wherein the content of at least one compound selected from a rare earth element compound and an alkaline-earth-metal compound is a total of not more than 0.02 % by weight on an element basis and the content of oxygen is not more than 0.1 % by weight may be obtained.

In the single-crystal thin films which are formed directly on the substrates of this composition and comprise as a main component at least one selected from gallium nitride, indium nitride and aluminum nitride, what has good crystallinity, such that the half width of the rocking curve of the X ray diffraction from the lattice plane of the Miller Index (002) is at least not more than 130 seconds, is obtained.

Furthermore, the aluminum nitride-based sintered compacts comprising the composition wherein the content of at least one compound selected from a rare earth element compound and an alkaline-earth-metal compound is a total of not more than 0.005 % by weight on an element basis and the content of oxygen is not more than 0.05 % by weight may be obtained.

In the single-crystal thin films which are formed directly on the substrates of this composition and comprise as a main component at least one selected from gallium nitride, indium nitride and aluminum nitride, what has good crystallinity, such that the half width of the rocking curve of the X ray diffraction from the lattice plane of the Miller Index (002) is at least not more than 100 seconds, is obtained.

In the aluminum nitride-based sintered compacts which were obtained in this Example and raised the AlN purity, the size of aluminum nitride particles grew by raising the firing temperature or lengthening the firing time.

That is, the single-crystal thin films comprising as a main component at least one selected from gallium nitride, indium nitride and aluminum nitride were formed using as a substrate the above aluminum nitride-based sintered compacts wherein the size of aluminum nitride particles grew and the AlN purity was raised, and the crystallinity of the single-crystal thin films was investigated.

As a result, those wherein the AlN purity is high and the size of aluminum nitride particles in the sintered compact is an average of not less than 5 µm are obtained.

In the substrates in which the size of aluminum nitride particles in the sintered compact is an average of not less than 5 µm, good things, such that the half width of the rocking curve of the X ray diffraction from the lattice plane of the Miller Index (002) of the single-crystal thin films which comprise as a main component at least one selected from gallium nitride, indium nitride and aluminum nitride and are formed directly on the substrates is not more than 200 seconds, were obtained.

Those wherein the AlN purity is high and the size of aluminum nitride particles in the sintered compact is an average of not less than 8 µm are obtained.

In the substrates in which the size of aluminum nitride particles in the sintered compact is an average of not less than 8 µm, good things, such that the half width of the rocking curve of the X ray diffraction from the lattice plane of the Miller Index (002) of the single-crystal thin films which comprise as a main component at least one selected from gallium nitride, indium nitride and aluminum nitride and are formed directly on the substrates is not more than 150 seconds, were obtained.

Those wherein the AlN purity is high and the size of aluminum nitride particles in the sintered compact is an average of not less than 15 µm are obtained.

In the substrates in which the size of aluminum nitride particles in the sintered compact is an average of not less than 15 µm, good things, such that the half width of the rocking curve of the X ray diffraction from the lattice plane of the Miller Index (002) of the single-crystal thin films which comprise as a main component at least one selected from gallium nitride, indium nitride and aluminum nitride and are formed directly on the substrates is not more than 130 seconds, were obtained.

Furthermore, those wherein the AlN purity is high and the size of aluminum nitride particles in the sintered compact is an average of not less than 25 µm are obtained.

In the substrates in which the size of aluminum nitride particles in the sintered compact is an average of not less than 25 µm, good things, such that the half width of the rocking curve of the X ray diffraction from the lattice plane of the Miller Index (002) of the single-crystal thin films which comprise as a main component at least one selected from gallium nitride, indium nitride and aluminum nitride and are formed directly on the substrates is not more than 100 seconds, were obtained.

In the aluminum nitride-based sintered compacts which were obtained in this Example and raised the AlN purity, the transmissivity of the aluminum nitride-based sintered compacts was increased in the light of the range of 200-800 nm wavelength by raising the firing temperature, or lengthening the firing time.

That is, the single-crystal thin films comprising as a main component at least one selected from gallium nitride, indium nitride and aluminum nitride were formed using as a substrate the above aluminum nitride-based sintered compacts wherein the optical transmissivity increased and the AlN purity was raised, and the crystallinity of the single-crystal thin films was investigated.

As a result, when the aluminum nitride-based sintered compacts having high AlN purity and having the optical transmissivity of visible light not less than 40 % in the light of the range of 200 nm-800 nm wavelength were used as the substrates obtained, those having good crystallinity, such that the half width of the rocking curve of the X ray diffraction from the lattice plane of the Miller Index (002) is not more than 150 seconds, were obtained, as the single-crystal thin films which were formed directly on the substrates and comprise as a main component at least one selected from gallium nitride, indium nitride and aluminum nitride.

When the aluminum nitride-based sintered compacts having high optical transmissivity of the visible light not less than60 % were used as the substrates obtained, those having good crystallinity, such that the half width of the rocking curve of the X ray diffraction from the lattice plane of the Miller Index (002) is not more than 130 seconds, were obtained, as the single-crystal thin films comprising as a main component at least one selected from gallium nitride, indium nitride and aluminum nitride.

When the aluminum nitride-based sintered compacts having high optical transmissivity of the visible light not less than 80 % were used as the substrates obtained, those having good crystallinity, such that the half width of the rocking curve of the X ray diffraction from the lattice plane of the Miller Index (002) is not more than 100 seconds, were obtained, as the single-crystal thin films comprising as a main component at least one selected from gallium nitride, indium nitride and aluminum nitride.

As for the aluminum nitride-based sintered compacts obtained except in the experiment No.252-255 and 272, 273, 275, and 276, they had high characteristics in which the thermal conductivity is not less than 200 W/mK at room temperature.

In the aluminum nitride-based sintered compact, when AlN is contained not less than 99 % as a crystal phase, and it comprises AlN single phase, that having still higher characteristics in which the thermal conductivity is not less than 220 W/mK at room temperature and is a maximum of 237 W/mK was obtained.

So that it is clear from Table 11 and 12, with being seldom influenced by the origin of the raw material powders, even if any one of the powder compacts and the beforehand fired sintered compacts is used, phenomenon, such as the vaporization and removal of sintering aids and oxygen, etc., arises by firing them at high temperature for a long time, and, high purity-ization of the aluminum nitride-based sintered compacts will progress.

Furthermore, the aluminum nitride particles in the sintered compacts also grew, the transmissivity of sintered compacts themselves will improve, those having the transmissivity not less than 80 % in the light of the range of the 200 nm-800 nm wavelength, and that of a maximum of 88 % are obtained.

As for the crystallinity of the single-crystal thin films which comprise as a main component at least one selected from gallium nitride, indium nitride and aluminum nitride and are formed on the obtained substrates which comprise an aluminum nitride-based sintered compact, it is also improved.

As for the crystallinity of the single-crystal thin films, if the composition (i.e., the AlN purity) of the aluminum nitride-based sintered compact obtained becomes high, the crystallinity will increase.

As for the crystallinity of the single-crystal thin films, there was a tendency in which not only the above AlN purity but also the size of aluminum nitride particles or the optical transmissivity affects it more greatly.

That is, if the size of aluminum nitride particles becomes large, the crystallinity of the single-crystal thin films will increase furthermore.

If the optical transmissivity of the substrates which comprise an aluminum nitride-based sintered compact becomes high, the crystallinity of the single-crystal thin films will increase furthermore like growing of the size of the above aluminum nitride particles.

That is, as for the crystallinity of the single-crystal thin films obtained in this Example, it seems that the elements (that wherein the composition, that is, the AlN purity of the aluminum nitride-based sintered compacts used as a substrate becomes high, that wherein the size of aluminum nitride particles grows, and that wherein the optical transmissivity of the sintered compacts comprising aluminum nitride as a main component becomes high) will raise the crystallinity of the single-crystal thin films comprising as a main component at least one selected from gallium nitride, indium nitride and aluminum nitride by the synergistic effect of each other.

That is, in order to obtain the single-crystal thin film with high crystallinity, it was shown that it can become effective to use the aluminum nitride-based sintered compacts in which the inside of the sintered compacts was improved by the high temperature firing and the prolonged firing, as the substrate for a thin film.

### Comparative example 1

To compare, the same powder compact as the experiment No.265 is put on the setter made from tungsten, it put into the saggar made from tungsten with the aluminum nitride powder prepared separately, then it was fired at the temperature of 2200°C for 8 hours in pure nitrogen atmosphere by the tungsten furnace comprising tungsten furnace material and a heating element, as a result, most yttrium oxide which is a sintering aid is not vaporized and removed but it remained in the state of the powder compact as it is, high purity is not attained.

The thermal conductivity is also lower than 200 W/mK, the optical permeability is also 62 %, they were smaller than what was produced in the experiment No.265 of Table 11.

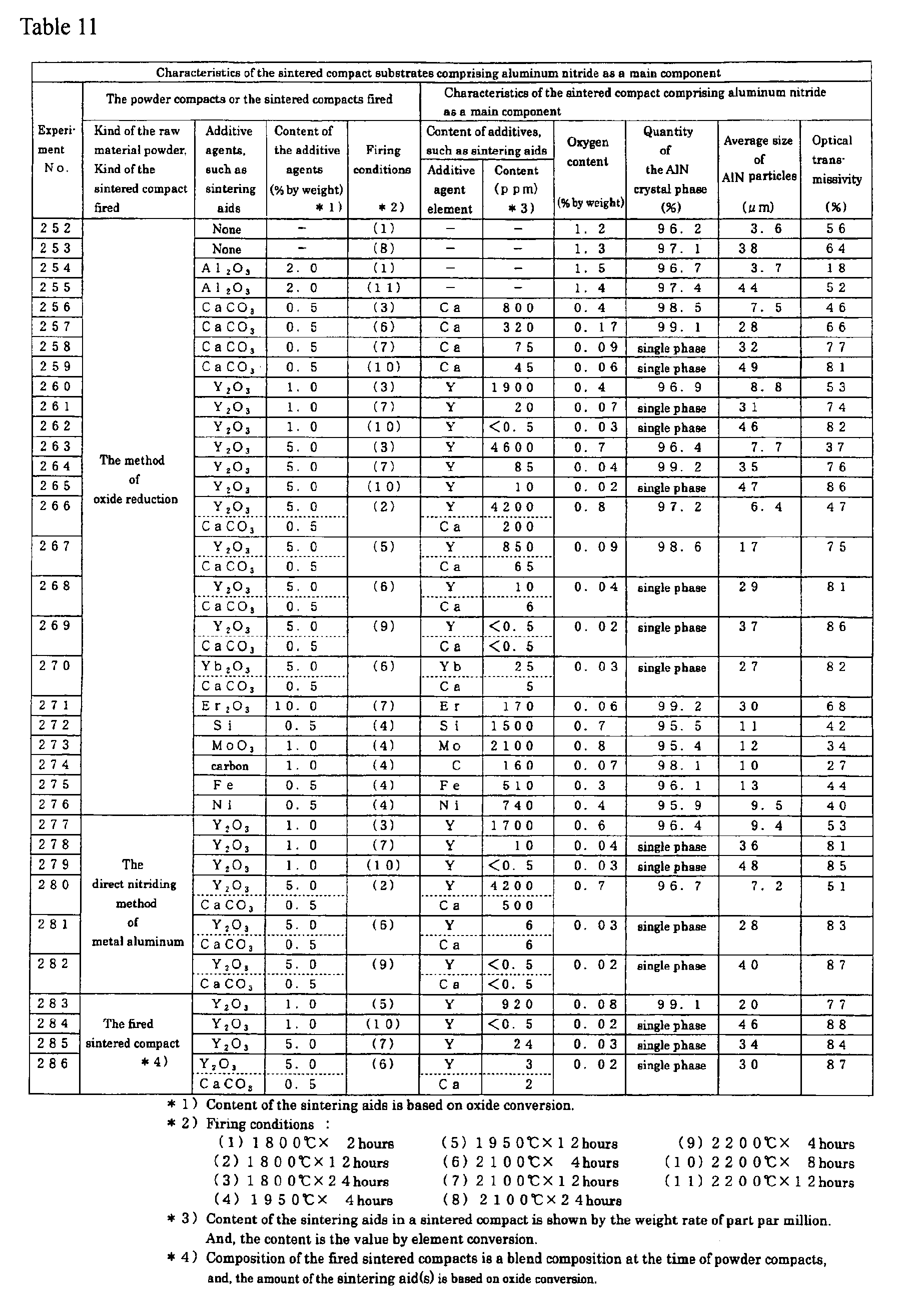

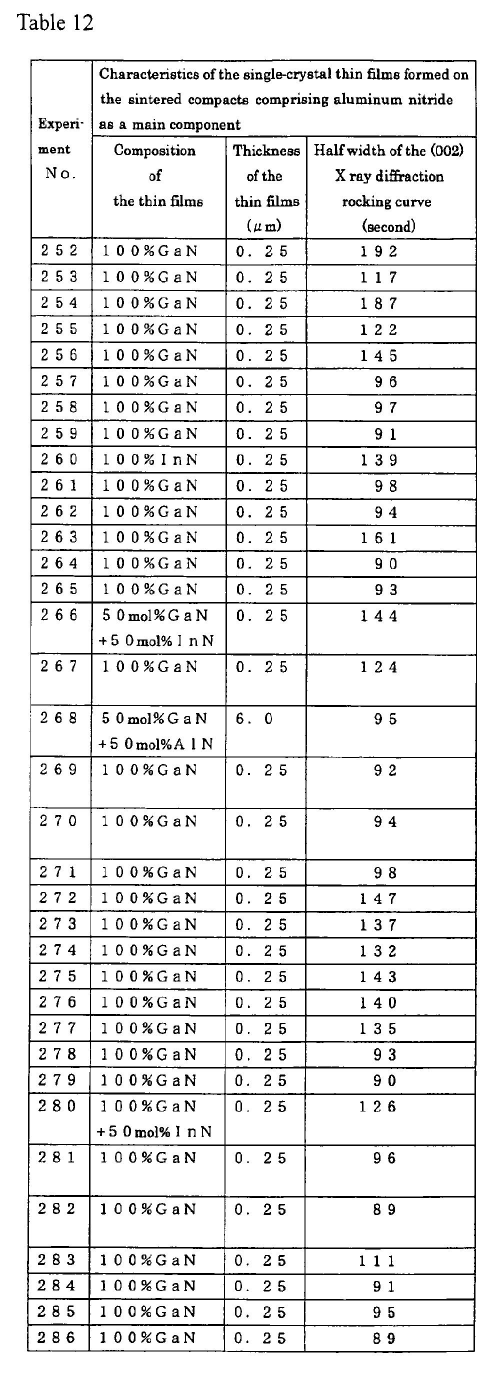

### Example 12

Using the sintered compacts produced and used in Example 1-11 as a substrate, that is, using the aluminum nitride-based sintered compacts, and the various sintered compacts which comprise as a main component a ceramic material of silicon carbide, silicon nitride, aluminum oxide, zinc oxide, and beryllium oxide, formation of the thin films having an amorphous state, a polycrystalline state, and an orientated polycrystalline state and comprising as a main component at least one selected from gallium nitride, indium nitride and aluminum nitride was tried by the MOCVD method.

In the MOCVD method of this Example, the same raw materials and equipments as Example 1, Example 2, and Example 10 were used.

Specular surface polish of the above-mentioned substrates was carried out by the same method as Example 8 and Example 9, and the surface smooth nature is shown in Table 13.

Furthermore, formation of the single-crystal thin films which comprise as the main component(s) at least one selected from gallium nitride, indium nitride and aluminum nitride was tried onto the substrates in which the amorphous thin films, the polycrystalline thin films, and the orientated polycrystalline thin films, etc. were formed.

First, the thin film formation was tried in the condition, wherein the substrate temperature is 300-700°C in the case of the gallium nitride(GaN)-based thin films, the substrate temperature is 300-600°C in the case of the indium nitride(InN)-based thin films, and the substrate temperature is 350-1000°C in the case of the aluminum nitride(AlN)-based thin films.

The 100 mol % GaN thin films shown in the experiment No.287 and 293 in Table 13 were produced under the substrate temperature of 340°C.

The 100 mol % AlN thin films shown in the experiment No.288, 289, 290, 292, 294, 297, 298, 299, 300, and 301 were produced under the substrate temperature of 370°C.

The 100 mol % AlN thin film shown in the experiment No.296 is produced under the substrate temperature of 400°C.

The 100 mol % AlN thin film shown in the experiment No.295 is produced under the substrate temperature of 1050°C.

As for the crystallization states of the above-mentioned thin films (the thin films formed on the substrate side) which comprise as a main component at least one selected from gallium nitride, indium nitride and aluminum nitride and were formed directly on the aluminum nitride-based sintered compacts and on the various sintered compacts comprising a ceramic material as a main component, they were investigated by X ray diffraction.

About the aluminum nitride-based thin films, electron beam diffraction was also used together for the judgment of the crystallization state.

As a result, the crystallization states of the thin films obtained were clearly showed an amorphous state, a polycrystalline state, or an orientated polycrystalline state.

The result is shown in Table 13.

In this Example, the polycrystalline AlN thin film formed directly on the substrate used in the experiment No.291 was an orientated polycrystal formed in the direction where C axis is perpendicular to the substrate surface.

The measured half width of the rocking curve of the X ray diffraction from the lattice plane of the Miller Index (002) of this orientated polycrystalline thin film was 4620 seconds.

Formation of the AlN orientated polycrystalline thin film formed directly on the substrate comprising an aluminum nitride-based sintered compact of the above-mentioned experiment No.291 was carried out under the substrate temperature of 550°C.

In addition, in the experiment No.295 of Table 13, formation of an AlN single-crystal thin film was tried as a thin film formed directly on a substrate.

In the experiment No.295, the substrate temperature was set up to 1100°C higher than the above-mentioned conditions, the thin film formation was carried out by the MOCVD method in which raw materials, gases, and other formation conditions are same as Example 1.

100 mol % AlN thin film in the experiment No.295 in Table 13 is a single crystal formed in the direction where C axis is perpendicular to the substrate surface, and the measured half width of the rocking curve of the X ray diffraction from the lattice plane of the Miller Index (002) of this single-crystal thin film was 127 seconds.

Thus, in this Example, it was shown clearly that it can obtain the thin-film substrates in which the thin films comprising as a main component at least one selected from gallium nitride, indium nitride and aluminum nitride and having various crystallization states, such as an amorphous state, a polycrystal, and an orientated polycrystal, etc. besides a single crystal, were formed directly on the above aluminum nitride-based sintered compacts and various ceramic-based sintered compacts.

Next, in the experiment No.293, and 299 and 301, it produced the substrates in which one layer thin films comprising gallium nitride and aluminum nitride as a main component and containing the doping component of very small quantity were formed furthermore on the thin-film substrates having beforehand the amorphous thin films comprising gallium nitride and aluminum nitride as a main component and comprising a sintered compact comprising aluminum nitride, aluminum oxide, and beryllium oxide as a main component, under the substrate temperature of 450°C (the experiment No.293) and 550°C (the experiment No. 299 and 301), respectively.

Other formation conditions are the same as the MOCVD method shown in Example 1 and Example 10.

The obtained thin films were clearly the orientated polycrystal in which C axis was formed perpendicularly to the substrate surface as a result of X ray diffraction.

As for the half width of the rocking curve of the X ray diffraction from the lattice plane of the Miller Index (002) of the orientated polycrystals, it was 4540 seconds in case of the experiment No.293, 10820 seconds in case of the experiment No.299, and 9890 seconds in case of the experiment No.301.

Thus, in case of the orientated polycrystals formed by using the substrate comprising the aluminum nitride-based sintered compact, the tendency in which the crystallinity is superior to the case where the substrates comprising a sintered compact comprising aluminum oxide and beryllium oxide as a main component were used was shown.

As explained above, in this Example, it was shown clearly that it can obtain the thin-film substrates in which at least one layer or two layers of thin films comprising as a main component at least one selected from gallium nitride, indium nitride and aluminum nitride and having various crystallization states, such as an amorphous state, a polycrystal, and an orientated polycrystal, etc., are formed on the aluminum nitride-based sintered compacts, and on the various sintered compacts comprising a ceramic material as a main component.

Next, formation of the single-crystal thin films comprising as a main component at least one selected from gallium nitride, indium nitride and aluminum nitride was tried by the MOCVD method onto such thin-film substrates comprising an aluminum nitride-based sintered compact and various ceramic-based sintered compacts and having one layer and two layers of thin films of various crystallization states, such as an amorphous state, a polycrystal, and an orientated polycrystal, etc.

The substrate in which the 100 mol % AlN single-crystal thin film produced in the experiment No.295 was formed was also used for the trial of the single-crystal thin film formation.

As for what comprises GaN, InN, and AlN as the main components, when the single-crystal thin films are formed, the raw materials used, gases, formation conditions, etc. were same as Example 1 and Example 10, irrespective of containing or not containing the doping components.

On the other hand, the substrate temperature was set to 1050°C in the case of the mixed crystals of GaN+AlN, irrespective of containing or not containing the doping components, and the substrate temperature was set to 830°C in the case of the mixed crystals of GaN+InN, in addition, the raw materials, gases, and formation conditions were same as Example 1, Example 2, and Example 10.

Thus, the substrates in which one layer of thin films comprising as a main component at least one selected from gallium nitride, indium nitride and aluminum nitride was formed furthermore on the substrates in which the thin films of various crystallization states, such as an amorphous state, a polycrystal, and an orientated polycrystal, etc., were formed were obtained.

When the formed thin films were analyzed by X ray diffraction, it was confirmed that all are a single crystal.

These single-crystal thin films are formed in the direction where C axis is perpendicular to the substrate surface.

The crystallinity of the single-crystal thin films obtained was investigated, and the result was shown in Table 13.

In addition, about the aluminum nitride-based thin films, electron beam diffraction was also used together for the judgment of the crystallization state.

As a result, it became clear that the substrates in which the thin films with the two-layer constitution in which at least the surface one comprises a single-crystal thin film were formed are obtained.

Moreover, in the experiment No.293, 299 and 301, it became clear that the substrates in which the thin films with the three-layer constitution in which the surface one comprises a single-crystal thin film were formed are obtained.

As mentioned above, the substrates of the experiment No.291 and 292 were selected from the substrates having the thin film of two-layer constitution and having a single-crystal thin film in the layer of the surface side, then formation of a single-crystal thin film was tried using the MOCVD method under the same conditions as the above.

As a result, the thin films newly formed in the surface side were clearly a single crystal formed in the direction where C axis is perpendicular to the substrate surface, by X ray diffraction.

As the result, in the experiment No. 291 and 292, it was confirmed that the substrates which comprise three-layer constitution thin films having two layers of single-crystal thin films are producible.

In the experiment No. 291 and 292, the crystallinity of the single-crystal thin films which are last formed in the surface side is improving than the crystallinity of the single-crystal thin films which are formed first (or which are formed as the intermediate layer).

That is, in the experiment No.291, while the half width of the rocking curve of the X ray diffraction from the lattice plane of the Miller Index (002) of the single-crystal thin film formed first is 96 seconds, it was 91 seconds in the case of the single-crystal thin film formed on it.

In the experiment No.292, while the half width of the rocking curve of the X ray diffraction from the lattice plane of the Miller Index (002) of the single-crystal thin film formed first is 97 seconds, it was 89 seconds in the case of the single-crystal thin film formed on it.

So that it is clear from Table 13, the single-crystal thin films which comprise as a main component at least one selected from gallium nitride, indium nitride and aluminum nitride may be formed on the substrates comprising the aluminum nitride-based sintered compacts and having beforehand at least one layer or two layers of thin films of various crystallization states, such as an amorphous state, a polycrystal, and an orientated polycrystal.

As for the crystallinity, the half width of the rocking curve of the X ray diffraction from the lattice plane of the Miller Index (002) of the single-crystal thin films comprising as a main component at least one selected from gallium nitride, indium nitride and aluminum nitride was not more than 100 seconds altogether in the tested substrates.

Usually, when the single-crystal thin films comprising as a main component at least one selected from gallium nitride, indium nitride and aluminum nitride were formed directly on the aluminum nitride-based sintered compacts which were used in this Example and were produced in the experiment No. 46, 49, 110, 267, and 283, these single-crystal thin films having high crystallinity, such that the half width of the rocking curve of the X ray diffraction from the lattice plane of the Miller Index (002) becomes not more than 100 seconds, are hard to be obtained.

But, if the substrates comprising the aluminum nitride-based sintered compacts and having beforehand at least one layer or two layers of thin films of various crystallization states, such as an amorphous state, a polycrystal, and an orientated polycrystal, are used, as mentioned above, it was confirmed that there is the tendency in which the crystallinity of the single-crystal thin films formed improves further than the case where a single-crystal thin film is formed directly on the substrate comprising an aluminum nitride-based sintered compact.

The single-crystal thin films comprising as a main component at least one selected from gallium nitride, indium nitride and aluminum nitride can also be formed on the substrates comprising the sintered compacts having beforehand at least one layer or two layers of thin films of various crystallization states, such as an amorphous thin film, a polycrystalline thin film, and an orientated polycrystalline thin film, and comprising as a main component a ceramic material which has the crystal structure which can be classified as a hexagonal system or a trigonal system, such as a silicon carbide, a silicon nitride, a zinc oxide, a beryllium oxide, and an aluminum oxide, etc. As for the crystallinity, the half width of the rocking curve of the X ray diffraction from the lattice plane of the Miller Index (002) of the single-crystal thin films comprising as a main component at least one selected from gallium nitride, indium nitride and aluminum nitride was not more than 200 seconds altogether in the tested substrates.

Usually, when the single-crystal thin films comprising as a main component at least one selected from gallium nitride, indium nitride and aluminum nitride were formed directly on the sintered compacts comprising as a main component a ceramic material having the crystal structure which can be classified as a hexagonal system or a trigonal system, such as a silicon carbide, a silicon nitride, a zinc oxide, a beryllium oxide, and an aluminum oxide, etc., these single-crystal thin films having high crystallinity, such that the half width of the rocking curve of the X ray diffraction from the lattice plane of the Miller Index (002) becomes not more than 200 seconds, are hard to be obtained.

But, as mentioned above, if using the substrates which comprise the sintered compacts having beforehand at least one layer or two layers of thin films of various crystallization states, such as an amorphous state, a polycrystal, and an orientated polycrystal, and comprising as a main component a ceramic material having the crystal structure which can be classified as a hexagonal system or a trigonal system, such as a silicon carbide, a silicon nitride, a zinc oxide, a beryllium oxide, and an aluminum oxide, etc., it was confirmed that there is the tendency in which the crystallinity of the single-crystal thin films formed improves further than the case where a single-crystal thin film is formed directly on the substrates comprising the sintered compacts comprising as a main component a ceramic material having the crystal structure which can be classified as a hexagonal system or a trigonal system, such as a silicon carbide, a silicon nitride, a zinc oxide, a beryllium oxide, and an aluminum oxide, etc.

Thus, if at least one layer or two layers of thin films of various crystallization states, such as an amorphous state, a polycrystal, and an orientated polycrystal, are formed beforehand, it was confirmed that the single-crystal thin films having comparatively higher crystallinity and comprising as a main component at least one selected from gallium nitride, indium nitride and aluminum nitride can be formed easily on the substrates comprising the sintered compacts comprising as a main component a ceramic material having the crystal structure which can be classified as a hexagonal system or a trigonal system, such as a silicon carbide, a silicon nitride, a zinc oxide, a beryllium oxide, and an aluminum oxide, etc.

So that it is clear from having explained above, in this Example, it may easily obtain the thin-film substrates in which the thin films comprising as a main component at least one selected from gallium nitride, indium nitride and aluminum nitride and having various crystallization states, such as a single crystal, an amorphous state, a polycrystal, and an orientated polycrystal, etc., were formed in two layers and three layers.

In the thin films formed in two layers and three layers, it was confirmed that the single-crystal thin films having excellent crystallinity may be formed in the top layer.

In these single-crystal thin films, it was confirmed experimentally that the crystallinity is higher than that of the thin films formed directly on the substrates comprising an aluminum nitride-based sintered compact and a sintered compact comprising as a main component a ceramic material having the crystal structure which can be classified as a hexagonal system or a trigonal system, such as a silicon carbide, a silicon nitride, a zinc oxide, a beryllium oxide, and an aluminum oxide, etc.

In this Example, as for the substrate comprising an aluminum nitride-based sintered compact used in the experiment No.294, though the single-crystal thin film which is formed directly on the substrate and comprises as a main component at least one selected from gallium nitride, indium nitride and aluminum nitride has originally good crystallinity, such that the half width of the rocking curve of the X ray diffraction from the lattice plane of a Miller Index (002) is 92 seconds, as shown in Example 11, if the substrate in which the amorphous thin film was formed beforehand in the substrate which comprises an aluminum nitride-based sintered compact is used, the crystallinity of the single-crystal thin film formed on it increases further into 82 seconds.

In the thin film in which the substrate of the experiment No.295 was used, all layers are a single crystal, including the layer first formed directly on the substrate.

Although the half width of the rocking curve of the X ray diffraction from the lattice plane of the Miller Index (002) of the single-crystal thin film formed first directly was 127 seconds, the half width of the rocking curve of the X ray diffraction from the lattice plane of the Miller Index (002) of the single-crystal thin film formed on it was 87 seconds, the crystallinity was improved further.

As mentioned above, in this Example, as for the thin-film substrates in which at least 1-2 layers of thin films comprising as a main component at least selected from gallium nitride, indium nitride and aluminum nitride were formed on the aluminum nitride-based sintered compacts, or on the various sintered compacts comprising as a main component a ceramic material, such as a silicon carbide, a silicon nitride, an aluminum oxide, a zinc oxide, and a beryllium oxide, it was shown that the thin films comprising as a main component at least one selected from gallium nitride, indium nitride and aluminum nitride may be formed on it.

That is, as for the above-mentioned thin-film substrates in which at least 1-2 layers of thin films comprising as a main component at least one selected from gallium nitride, indium nitride and aluminum nitride and having various crystallization states, such as a single crystal, an amorphous state, a polycrystal, and an orientated polycrystal, etc., were formed on the aluminum nitride-based sintered compacts, or on the various sintered compacts comprising as a main component a ceramic material, such as a silicon carbide, a silicon nitride, an aluminum oxide, a zinc oxide, and a beryllium oxide, it was confirmed that they can also be used as a substrate (namely, a substrate for thin-film formation) for forming a thin film comprising as a main component at least one selected from gallium nitride, indium nitride and aluminum nitride.

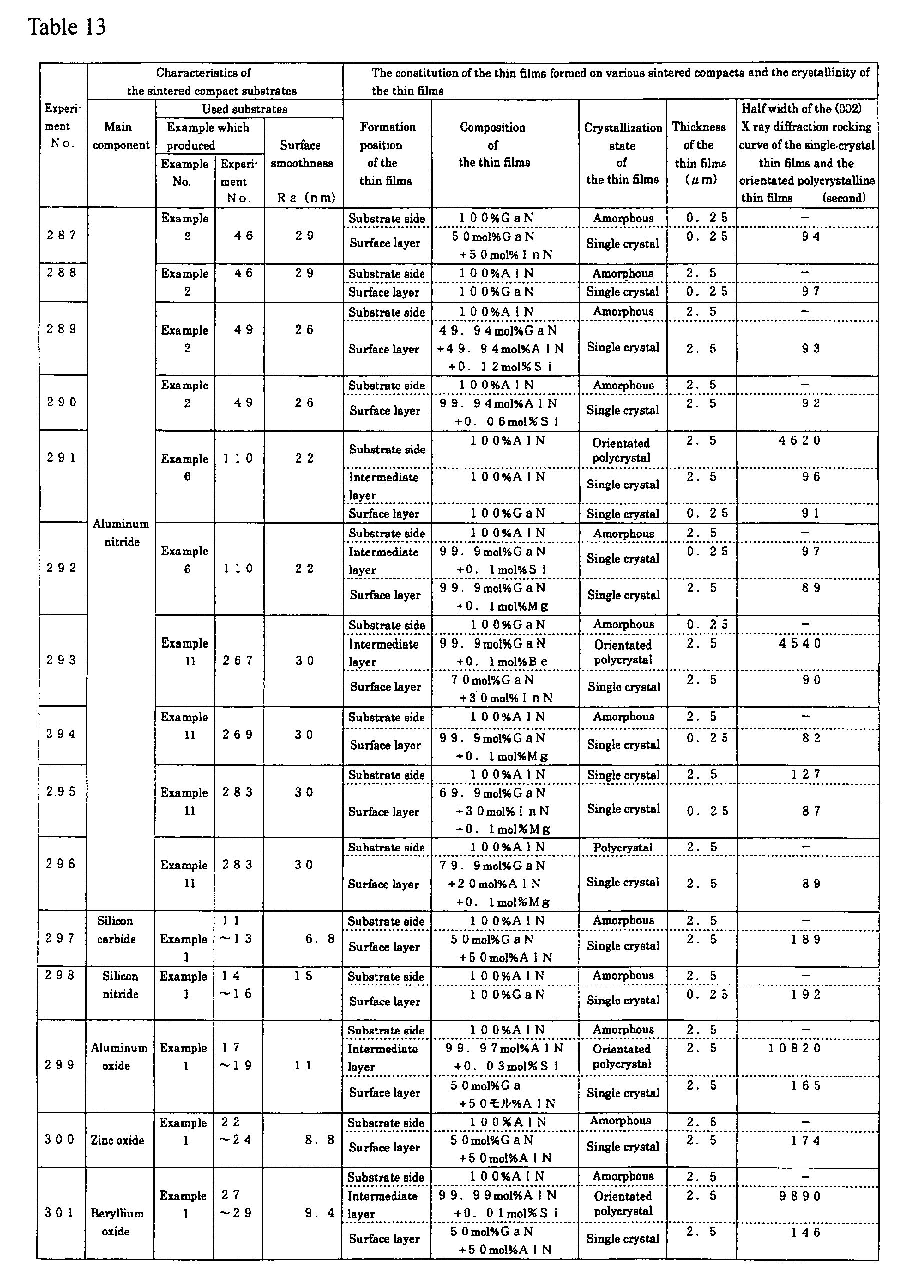

### Example 13

Using the powder compacts of the experiment No.269 which was used in Example 11 among the powder compacts produced in Example 11, they were fired at the temperature of 2200°C for 4 hours in the condition where the carbon setter, carbon saggar, and carbon furnace were used as well as Example 11, except the firing atmosphere was replaced into the four kinds, such as the nitrogen including carbon monoxide 150 ppm, the nitrogen including hydrogen 60 ppm, the nitrogen including hydrocarbon 240 ppm, and the argon including carbon monoxide 1800 ppm, and the sintered compacts comprising aluminum nitride as a main component were obtained.

As a result, in all the things fired in the above atmosphere, the content of yttrium and calcium has become not more than 0.5 ppm, respectively, like Example 11. The aluminum nitride particles also grew up to the size of 35-40 µm, and the optical transmissivity also exceeded 80 % altogether.

Furthermore, the substrates were produced using the aluminum nitride-based sintered compacts obtained in each atmosphere, and the gallium nitride single-crystal thin film was formed in the thickness of 0.5 µm by the MOCVD method like Example 1, as a result, good crystallinity, such that the half width of the rocking curve of the X ray diffraction from the lattice plane of the Miller Index (002) of the single-crystal thin film is not more than 100 seconds, has been shown in all the substrates.

### Example 14

High purity aluminum nitride powder [the grade "H" by Tokuyama Soda Co., Ltd. (present: Tokuyama, Inc.)] was prepared as a raw material powder for producing an aluminum nitride-based sintered compact.

This raw material powder is manufactured by the method of oxide reduction.

That which added only Y₂O₃ powder 5 % by weight, and that which added Y₂O₃ powder 5 % by weight and added CaCO₃ powder 0.5 % by weight on the basis of CaO, were mixed with toluene and iso propyl alcohol by the ball mill for 24 hours, and an acrylic binder was added 12 weight parts to 100 weight parts of the raw material powders, furthermore they were mixed for 12 hours and made into the paste, and the green sheets with the thickness of 0.8 mm having two kinds of composition were produced by the doctor blade method.

The sheets with a square shape in which the one-side is 35 mm were produced from the green sheets, and the circular through holes having the diameter of 25 µm and 50 µm and penetrating the surface and the back were formed in the sheets by YAG laser.

Next, alpha terpineol was used as a solvent, the acrylic resin was used as a binder, tungsten powder was used as a conductive component, furthermore, the above aluminum nitride powder was added to the tungsten powder in the range of 0-20 % by weight, and mixed with them, and the pastes for conduction vias were produced.

The powder pastes of each mixture ratio were filled up in the above through holes, they dried, and the aluminum nitride-based sintered compacts having a conduction via were produced on the following two firing conditions, after the binder was removed suitably in the atmosphere comprising as a main component nitrogen or mixed gas of nitrogen and hydrogen.

The firing conditions are the following two conditions, that is,
1) carrying out the normal pressure sintering at 1800°C for 2 hours in N₂ atmosphere,
2) firing at 2200°C for 4 hours in nitrogen atmosphere including carbon monoxide 200 ppm.

Thus, the aluminum nitride-based sintered compacts in which the conduction via was formed in the inside were obtained.

Also in which sintered compact, the conductive components in the through holes were made dense enough, and the conductivity has been generated, they are also unifying with the aluminum nitride-based sintered compacts, and they are functioning as a conduction via.

In the case of the above aluminum nitride-based sintered compacts which were fired by the normal pressure sintering at 1800°C for 2 hours and formed the conduction via, the sintering aids hardly vaporized and the optical transmissivity was in the range of 51 %-65 %, but in the case of what was fired at 2200°C for 4 hours, sintering aids vaporized and the content of yttrium and calcium has become a total of not more than 50 ppm.

The aluminum nitride particles were also growing up to 35-45 µm, and the optical transmissivity was also not less than 80 %.

The sintered compacts obtained like this were ground and polished into the size of diameter 25.4 mm x thickness 0.5 mm, the conduction vias were made into the state of having been exposed, and the substrates having the surface roughness Ra 30 nm and comprising an aluminum nitride-based sintered compact having a conduction via were produced.

After that, the resistance of the conduction vias was measured at the room temperature by the 4 terminal method, and the electric resistivity at room temperature was calculated from the shape of the conduction vias.

The size of the conduction vias has shrunk after firing and has become the diameter of 40-44 µm and 20-23 µm, respectively.

The single-crystal thin films of gallium nitride were formed in the thickness of 0.25 µm by the method using the same MOCVD equipment as what was used in Example 1 and 2 directly onto one surface of the above substrates in which the conduction vias were formed, and the half width of the rocking curve of the X ray diffraction from the lattice plane of the Miller Index (002) of the single-crystal thin films was measured.

Those results were shown in Table 14.

Observation was carried out about the single-crystal thin film of the circumference where the conduction via is formed after single-crystal thin film formation, consequently, faults, such as a crack and exfoliation in the interface with the conduction vias, are not found especially, but are in good appearance states, and it was confirmed that the conduction vias which used the materials of this invention has good junction nature to the gallium nitride thin films.

Although the electric resistivity of the conduction vias was changed by the content of aluminum nitride, the firing conditions and the diameter of the through holes, etc., it is the range of 6.8x10⁻⁶-132x10⁻⁶ Ω·cm at room temperature, and all the half width of the rocking curve of the X ray diffraction from the lattice plane of the Miller Index (002) of the single-crystal thin film is not more than 300 seconds.

In the substrates obtained by firing at 1800°C for 2 hour, the tendency in which the crystallinity of the single-crystal thin films formed on the substrates improves is seen according as the content of the aluminum nitride in the conduction vias increases, the half width of the rocking curve of the X ray diffraction from the lattice plane of the Miller Index (002) of the single-crystal thin films became into not more than 150 seconds in case of the conduction vias which contain the aluminum nitride powder not less than 10 % by weight.

As for the half width of the rocking curve of the X ray diffraction from the lattice plane of the Miller Index (002) of the single-crystal thin films formed on the substrates which are obtained by firing at 2200°C for 4 hours and have the conduction vias, what has high crystallinity not more than 100 seconds was obtained.

The electric resistivity of each gallium nitride-based thin film produced in this Example is the range of 0.059-0.101 Ω·cm at room temperature, and it has conductivity.

There are an electrical connection between the gallium nitride-based thin films produced using each sintered compact having a conduction via, and the conduction vias exposed in the substrate surface side in which the thin film is not formed.

Thus, it was confirmed that there are not only the mechanical junction nature but also the electrical connectivity between the gallium nitride-based single-crystal thin films which were produced in this Example and have conductivity, and the conduction vias.

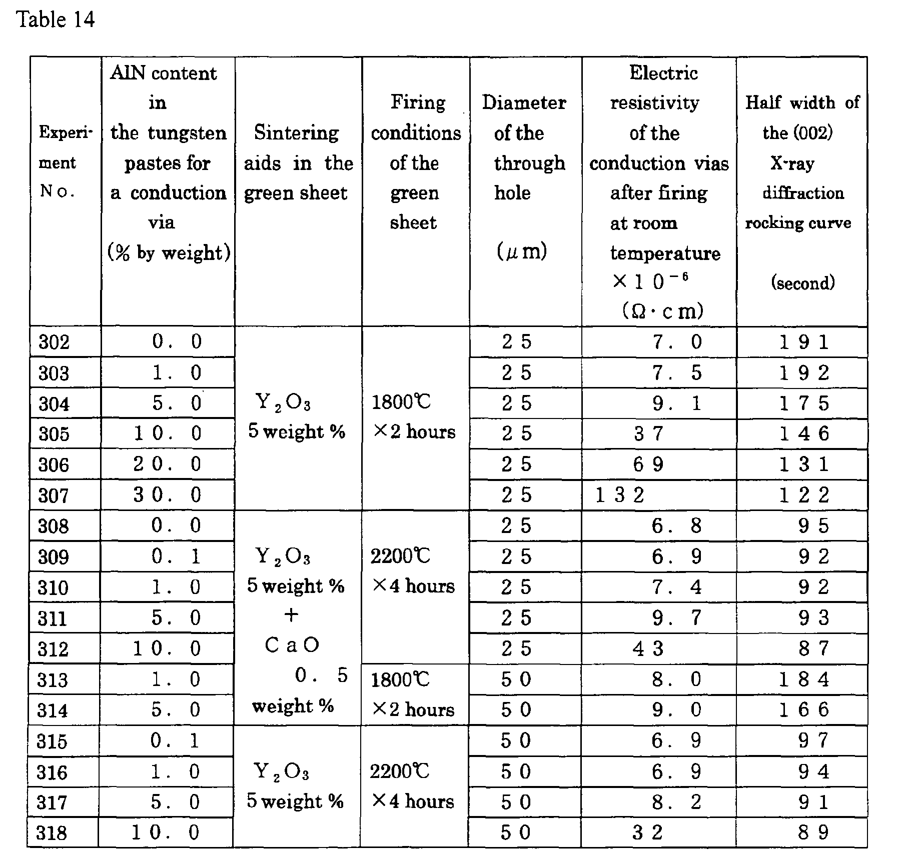

### Example 15

The powder compacts having the shape of a disk of the outer size of 32 mm diameter and having various thickness were produced using the mixed powder which contains yttrium oxide 5 % by weight as sintering aids in the aluminum nitride raw material powder which was used in Example 11 and was made by the method of oxide reduction.

The powder compacts were fired at 2200°C for 8 hours in the nitrogen atmosphere containing 1000 ppm carbon monoxide by the carbon furnace using the setter made from carbon and the saggar made from carbon, like Example 11.

As a result, the sintered compacts having translucency were obtained when the thickness of the powder compacts is not more than 8 mm.

In the things having the thickness thicker than it, they have become black and they have no translucency, it is hard to form a single-crystal thin film comprising as a main component at least one selected from gallium nitride, indium nitride and aluminum nitride, and the thin films became the polycrystalline state being not a single crystal according to a case.

### Example 16

Formation of the conductive single-crystal thin films comprising as a main component gallium nitride and aluminum nitride and having the composition expressed with the chemistry formula of AlₓGa₁₋ₓN (0≤x≤1.0) was tried by the MOCVD method, using as a substrate the aluminum nitride-based sintered compacts produced and used in Example 1-15. Mg and Si are doped to the thin films with the above composition up to 10 mol %, respectively, and are doped up to a total of 10 mol % in case of the simultaneous doping of Mg and Si.

As the substrates, the sintered compact produced in the experiment No.49 of Example 2, the sintered compact produced in the experiment No.73 of Example 3, the sintered compact of the experiment No.75, the sintered compact of the experiment No.80, the sintered compact of the experiment No.82, the sintered compact produced in the experiment No.110 of Example 6, the sintered compact produced in the experiment No.284 of Example 11, the sintered compact produced in the experiment No.305 of Example 14, the sintered compact of the experiment No.311, and the sintered compact of the experiment No.317, were used.

In the sintered compact of the experiment No.73, the sintered compact of the experiment No.75, the sintered compact of the experiment No.80, the sintered compact of the experiment No.82, the sintered compact of the experiment No.305, the sintered compact of the experiment No.311, and the sintered compact of the experiment No.317, the conduction vias were formed, respectively and the conduction vias are exposed in the up-and-down surfaces of the substrates

The production conditions of the single-crystal thin films are the same as Example 1, Example 2, and Example 10.

The shape of the substrates is the same as that of Example 1, 3, and 14.

The thickness of the thin films was controlled to 3 µm, and the thin films were formed in one surface side of the substrates produced using each sintered compact.

After forming the thin films by CVD, the substrates in which the thin films were formed were heat-treated at 700°C in pure N₂ atmosphere.

As a result, in the substrates which used each sintered compact, such as the sintered compact of the experiment No.73, the sintered compact of the experiment No.75, the sintered compact of the experiment No.80, the sintered compact of the experiment No.82, and the sintered compact of the experiment No.305, the single-crystal thin films may be formed in all the compositions of the above AlₓGa₁₋ₓN (0≤x≤1.0) which doped Mg and Si up to 10 mol %, and the half width of the rocking curve of the X ray diffraction from the lattice plane of a Miller Index (002) of the single-crystal thin films was as good as not more than 200 seconds.

In the substrates which used each sintered compact of the experiment No.49 and the experiment No.110, the single-crystal thin films may be formed in all the compositions of the above AlₓGa₁₋ₓN (0≤x≤1.0) which doped Mg and Si up to 10 mol %, the half width of the rocking curve of the X ray diffraction from the lattice plane of a Miller Index (002) of the single-crystal thin films was as good as not more than 150 seconds.

In the substrate which used each sintered compact of the experiment No.284, the experiment No.311, and the experiment No.317, the single-crystal thin films may be formed in all the compositions of the above AlₓGa₁₋ₓN (0≤x≤1.0) which doped Mg and Si up to 10 mol %, the half width of the rocking curve of the X ray diffraction from the lattice plane of a Miller Index (002) of the single-crystal thin films was still as better as not more than 100 seconds.

The circumference of the conduction vias was observed about the single-crystal thin films produced using the sintered compacts which formed a conduction via, such as the sintered compact of the experiment No.73, the sintered compact of the experiment No.75, the sintered compact of the experiment No.80, the sintered compact of the experiment No.82, the sintered compact of the experiment No.305, the sintered compact of the experiment No.311, and the sintered compact of the experiment No.317, but, as a result, faults, such as a crack and exfoliation in the interface with the conduction vias, are not found especially, and are in good appearance states, it was confirmed that the conduction vias which used the materials of this invention have good junction nature to the single-crystal thin films having the composition of AlₓGa₁₋ₓN (0≤x≤1.0), and to the single-crystal thin films having the composition in which Si and Mg were doped to AlₓGa₁₋ₓN (0≤x≤1.0).

The electric resistivity at room temperature was measured about the single-crystal thin films of these various compositions, as a result, in those containing Mg in the range of 0.00001-10 mol % on an element basis to the composite expressed with the chemical formula of AlₓGa₁₋ₓN (0≤x≤1.0), the electric resistivity was not more than 1x10⁴ Ω·cm at room temperature.

Among those, in the single-crystal thin films containing Mg in the range of 0.00001-10 mol % on an element basis to the composite expressed with the chemical formula of AlₓGa₁₋ₓN (0≤x≤0.6), the electric resistivity was 1x10⁻¹-1x10² Ω·cm at room temperature.

In the single-crystal thin films containing Si in the range of 0.00001-0.5 mol % on an element basis to the composite expressed with the chemical formula of AlₓGa₁₋ₓN (0≤x≤0.6), the electric resistivity was shown in the range of 1x10⁰-1x10³ Ω·cm at room temperature.

In the single-crystal thin films of this composition, the thin films wherein the main component comprises only aluminum nitride (that is, x=1.0) and Si is contained in the range of 0.00001 mol %-0.5 mol %, are included, and the electric resistivity was the range of 40-200 Ω·cm at room temperature.

In the single-crystal thin films containing Mg and Si simultaneously in the range of 0.00001-10 mol % to the composite expressed with the chemical formula of AlₓGa₁₋ₓN (0≤x≤0.6), those in which the electric resistivity is 1x10⁻¹-1x10³ Ω·cm at room temperature were obtained.

In the single-crystal thin films which contain Si in the range of 0.00001-10 mol % to the composite expressed with the chemical formula of AlₓGa₁₋ₓN (0≤x≤0.6), the comparatively low resistance, such that the electric resistivity is the range of 1x10⁻³-1x10¹ Ω·cm at room temperature, was shown.

In the single-crystal thin films which contain Si and Mg simultaneously in the range of 0.00001-10 mol % to the composite expressed with the chemical formula of AlₓGa₁₋ₓN (0≤x≤0.6), the comparatively low resistance, such that the electric resistivity is the range of 1x10⁻³-1x10¹ Ω·cm at room temperature, was shown.

In the single-crystal thin films produced using the sintered compacts in which the conduction vias are formed, such as the sintered compact of the experiment No.73, the sintered compact of the experiment No.75, the sintered compact of the experiment No.80, the sintered compact of the experiment No.82, the sintered compact of the experiment No.305, the sintered compact of the experiment No.311, and the sintered compact of the experiment No.317, there are electrical connections with the conduction vias exposed in the substrate surface on which the thin films are not formed, and it was confirmed that there are not only the mechanical junction nature but also the electrical connectivity between the conductive single-crystal thin films produced in this Example and having the composition of AlₓGa₁₋ₓN (0≤x≤1.0), and the conduction vias.

These results were described in Table 15.

In Table 15, in the thin films, the amount of doping agent addition has shown by mol % to AlₓGa₁₋ₓN of the main component.

That is, for example, that the amount of addition of Mg is 0.5 mol % means that the thin films formed have the composition wherein AlₓGa₁₋ₓN of the main component is 99.5 mol % and Mg of the doping agent is 0.5 mol %.

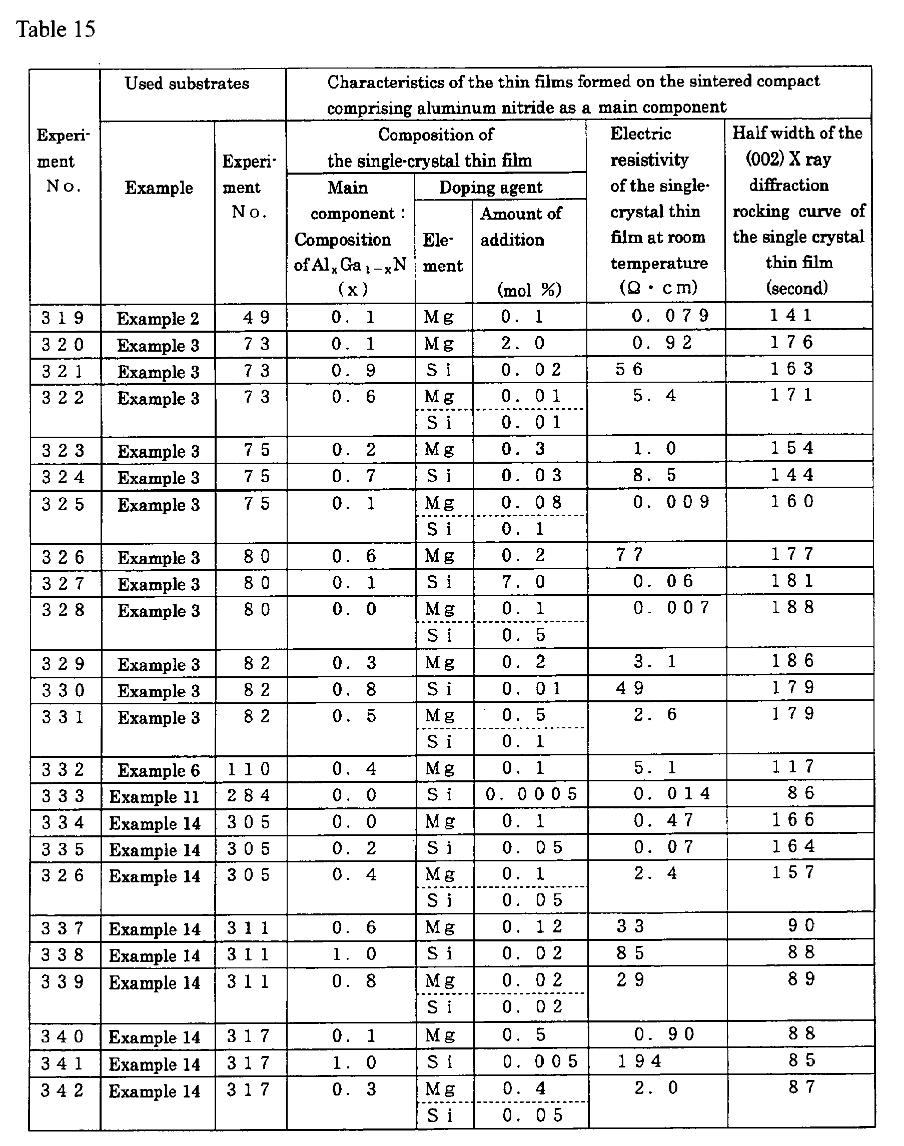

### Example 17

As for the electrical conductive single-crystal thin films, amorphous thin films, polycrystalline thin films and orientated polycrystalline thin films with C axis perpendicular to the substrate surface which comprise as a main component at least one selected from gallium nitride, indium nitride and aluminum nitride, formation was tried by the MOCVD method like Example 1, Example 2, Example 10, and Example 12, using as a substrate each aluminum nitride-based sintered compact of the experiment No.73, 75, 80, 82, 305, 311, and 317 which was used in Example 16 and has a conduction via, and the aluminum nitride-based sintered compacts of the experiment No.49 which have not a conduction via.

The thin film was formed in one side of each substrate as the single layer or two layers (comprising the layer of the side of a substrate and the layer of surface side).

On the occasion of formation of the indium nitride thin films of the experiment No. 350 and 351, it carried out under each substrate temperature of 320°C and 360°C.

In addition, on the occasion of formation of the gallium nitride thin films of the experiment No. 347 and 356, it carried out under each substrate temperature of 340°C and 380°C.

The thickness of each thin film layer was controlled to 3 µm, respectively.

As a result, as for the thin films comprising as a main component at least one selected from gallium nitride, indium nitride and aluminum nitride, even if they are the amorphous states, polycrystals, and orientated polycrystals other than a single crystal, it became clear that the those which have conductivity may be formed on the aluminum nitride-based sintered compacts.

It became clear that the thin films having conductivity may also be formed in the constitution of two or more layers.

The circumference of the conduction vias was observed about the thin films of single crystal, amorphous state, and polycrystal which are produced using the sintered compacts which formed a conduction via, such as the sintered compact of the experiment No.73, the sintered compact of the experiment No.75, the sintered compact of the experiment No.80, the sintered compact of the experiment No.82, the sintered compact of the experiment No.305, the sintered compact of the experiment No.311, and the sintered compact of the experiment No.317, but, as a result, faults, such as a crack and exfoliation in the interface with the conduction vias, are not found especially, and are in good appearance states, it was confirmed that the conduction vias which used the materials of this invention have good junction nature to the thin films of various composition which comprise as a main component at least one selected from gallium nitride, indium nitride and aluminum nitride.

In the single-crystal thin films produced using the sintered compacts in which the conduction vias are formed, such as the sintered compact of the experiment No.73, the sintered compact of the experiment No.75, the sintered compact of the experiment No.80, the sintered compact of the experiment No.82, the sintered compact of the experiment No.305, the sintered compact of the experiment No.311, and the sintered compact of the experiment No.317, there are electrical connections with the conduction vias which have been exposed in the substrate surface on which a thin film is not formed, and it was confirmed that there are not only the mechanical junction nature but also the electrical connectivity between the conduction vias, and the electrical conductive single-crystal thin films, amorphous thin films, polycrystalline thin films, and orientated polycrystalline thin films with C axis perpendicular to the substrate surface which were produced in this Example and comprise various compositions of at least one selected from gallium nitride, indium nitride and aluminum nitride as a main component.

These results were described in Table 16.

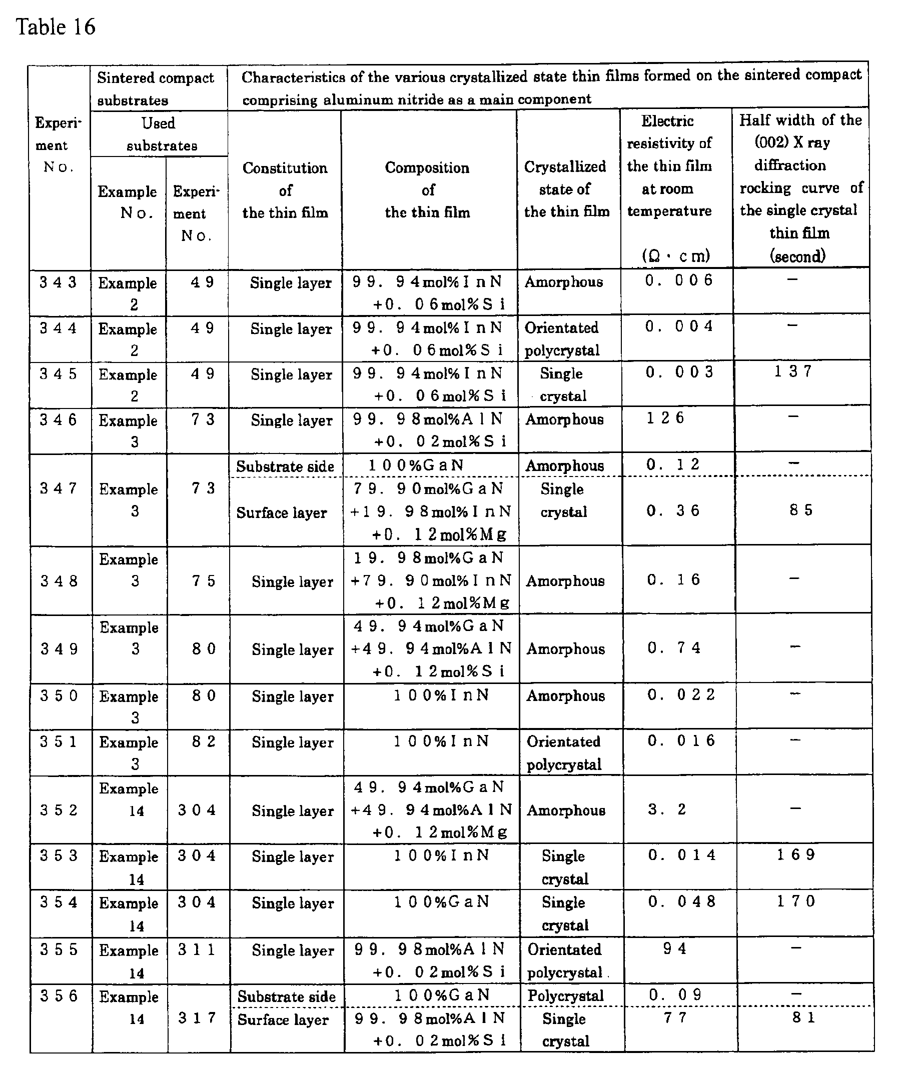

### Example 18

The substrates comprising the sintered compacts comprising aluminum nitride as a main component and forming the various thin film-conductive materials were obtained by forming various materials, such as titanium, chromium, nickel, molybdenum, tungsten, platinum, aluminum, tantalum, tantalum nitride, titanium nitride, gold, copper, tungsten/copper alloy (W : 70 % by weight + Cu : 30 % by weight), etc., onto the both sides of the substrates by the RF Sputtering method of frequency 13.56MHz and output 500W-1500W, using the substrates comprising the sintered compacts comprising aluminum nitride as a main component and having conduction vias, and the sintered compacts comprising aluminum nitride as a main component and not having conduction vias.

Sputtering was carried out under the substrate temperature of 250°C, passing Ar+N₂ gas into the decompression chamber.

The reflectances of the produced thin film-conductive materials to the light with a wavelength of 605 nm were measured, and they are shown in Table 17.

The thin films comprising as a main component at least one selected from gallium nitride, indium nitride and aluminum nitride and adding the doping agents suitably were formed in the thickness of 3 µm in one side of the substrates in which the various thin film-conductive materials were formed.

As a result, even if it is the substrates in which various thin film-conductive materials were formed beforehIt was confirmed that the thin films of an amorphous state, an orientated polycrystal, and a single crystal can form.

It was confirmed that the orientated polycrystalline thin films and the single-crystal thin films are formed in such a direction that its C axis is perpendicular to the substrate surface, respectively.

The result investigated about the crystallinity of such thin films was shown in Table 17.

As for the crystallinity of the single-crystal thin films, the half width of the rocking curve of the X ray diffraction from the lattice plane of the Miller Index (002) of the single-crystal thin films was not more than 200 seconds.

In the thin films which were shown in Table 17 and comprise as a main component at least one selected from gallium nitride, indium nitride and aluminum nitride, what was measured as a single crystal, was what was formed on the same conditions as Example 10, and amorphous thin films and orientated polycrystalline thin films other than the single crystals are formed on the same conditions as what was indicated in Example 12.

Although not indicated in Table 17, when the single-crystal thin films of 100 mol % GaN and 100 mol % AlN were formed on it by the same method as Example 1 using the substrates of the experiment No.360, experiment No.362-364, experiment No.366-367, experiment No.369, and experiment No.372 wherein the thin film-conductive materials were formed and the amorphous thin films and the orientated polycrystalline thin films were formed on it, the half width of the rocking curve of the X ray diffraction from the lattice plane of the Miller Index (002) of the single-crystal thin films was not more than 100 seconds altogether.

As shown in Table 17, observation of appearances was carried out about the formed thin film comprising as a main component at least one selected from gallium nitride, indium nitride and aluminum nitride, but, as a result, faults, such as a crack and exfoliation in the interface with the thin film-conductive materials, are not found especially, and are in good appearance states, it was confirmed that the thin film-conductive materials which used the materials of this invention have good junction nature to the thin films of various composition which comprise as a main component at least one selected from gallium nitride, indium nitride and aluminum nitride.

In order to confirm the junction nature between the thin film-conductive materials and the thin films of various composition which comprise as a main component at least one selected from gallium nitride, indium nitride and aluminum nitride, the next test was carried out furthermore.

The test method is that which measures the perpendicular tensile strength after the circular aluminum pin with the diameter of 3 mm was pasted up on the produced substrates by epoxy resin, and it was confirmed that the perpendicular tensile strength is not less than 2 kg/mm² altogether. The exfoliations exist in the adhesion interface between the epoxy resin and the thin films of various composition comprising as a main component at least one selected from gallium nitride, indium nitride and aluminum nitride, or in the adhesion interface between the epoxy resin and the pin, or in the inside of the epoxy resin, it was confirmed that the exfoliations or destructions between the thin film-conductive materials and the thin films of various composition comprising as a main component at least one selected from gallium nitride, indium nitride and aluminum nitride are not seen, and good junction nature is formed.

Furthermore, although the junction nature was tested by the method wherein the pressure sensitive adhesive tape was pasted up on the substrates produced and the tape was torn off, the exfoliations or destructions between the thin film-conductive materials and the thin films of various composition which comprise as a main component at least one selected from gallium nitride, indium nitride and aluminum nitride were not seen altogether.

As for the electrical conductive thin films which comprise as a main component at least one selected from gallium nitride, indium nitride and aluminum nitride and were produced using the sintered compacts in which the conduction vias were formed, such as the sintered compact of the experiment No.73, the sintered compact of the experiment No.75, the sintered compact of the experiment No.80, the sintered compact of the experiment No.82, the sintered compact of the experiment No.305, the sintered compact of the experiment No.311, and the sintered compact of the experiment No.317, they have an electrical connection with the substrate surface on which the thin films are not formed, it was confirmed that there are not only the mechanical junction nature but also the electrical connection between the thin film-conductive materials produced in this Example and the thin films comprising as a main component at least one selected from gallium nitride, indium nitride and aluminum nitride.

These results were described in Table 17.

In the thin film-conductive materials produced in this Example, electric resistivity of titanium, chromium, nickel, molybdenum, tungsten, platinum, aluminum, tantalum, titanium nitride, gold, and copper is not more than 1x10⁻³ Ω·cm altogether at room temperature, since they have higher conductivity than the electrical conductive thin films of various composition which comprise as a main component at least one selected from gallium nitride, indium nitride and aluminum nitride and are obtained by adding a doping agent, still higher electrical connection nature is obtained between the electrical conductive thin films which comprise as a main component at least one selected from gallium nitride, indium nitride and aluminum nitride and the substrate surface in which the thin films are not formed, if using the thin film-conductive materials of this invention.

If functional devices, such as a light-emitting device, are formed on the substrates for a thin film, for example, using the substrates for a thin film on which the thin film-conductive materials of this invention were formed as an electric circuit pattern, it functions also as the circuit board for mounting a light-emitting device, or the substrate which united a package.

Therefore, though the circuit board or package for mounting the functional devices, such as a light-emitting device, are usually required, the effect in which it becomes unnecessary to prepare the wiring board or the package independently is acquired, if using the substrates of this invention which united the function.

Each above result was collectively shown in Table 17.

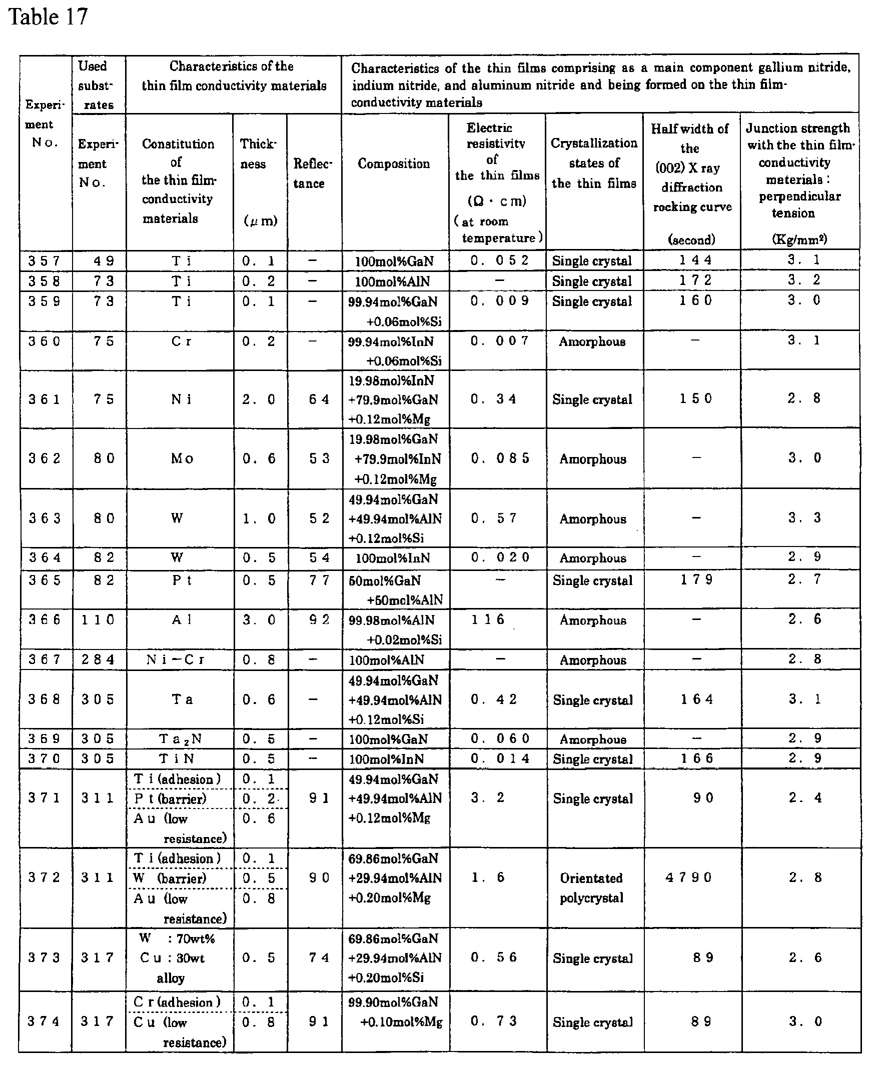

### Example 19

High purity aluminum nitride powder (the grade "H" by Tokuyama Soda Co., Ltd. (present: Tokuyama, Inc.)) was prepared as a raw material powder for producing a sintered compact.

This raw material powder is manufactured by the method of oxide reduction. This raw material powder contains oxygen 0.8 % by weight as impurities.

After a rare earth element compound, an alkaline-earth-metal compound, alumina, a transition metal compound, an alkali metal compound, and a silicon compound, etc., are added suitably to the raw material powder, they mixed by the ball mill with ethanol for 24 hours, paraffine wax was added to the mixed powders 5 % by weight, the powders for molding were produced, and the powder compacts of circle shape with the diameter of 36 mm x thickness of 2.0 mm were acquired by the uniaxial press molding.

After that, paraffine wax was degreased under decompression at 300°C, the powder compacts of various composition which are the fired thing were put into the setter and saggar made from aluminum nitride, or the above fired things were put into the setter and saggar made from the tungsten, BN, and the carbon in which the coating was carried out with the boron nitride powder to the surface, the powder compacts which comprise only aluminum nitride independently prepared were placed simultaneously in the setter and the saggar, normal pressure sintering was carried out in nitrogen atmosphere, and the aluminum nitride-based sintered compacts of various composition were obtained.

The powder compacts which added a rare earth element compound and an alkaline-earth-metal compound as sintering aids were fired at 1800°C for 2 hours.

The powder compacts which do not add a rare earth element compound and an alkaline-earth-metal compound were fired at 1950°C for 2 hours.

All the obtained sintered compacts became the dense state where the relative density is not less than 95 %.

Next, the obtained sintered compacts were ground to the size of the diameter of 25.4 mm x thickness of 0.5 mm, and furthermore specular surface polish processing was carried out by the same method as Example 8 using the chromic oxide-based abradant with the particle diameter of 0.2 µm, and the total amount of oxygen, the amount of ALON, and the optical transmissivity to the light with a wavelength of 605 nm were measured by the same method as Example 2, about the various aluminum nitride-based sintered compacts.

Measurement of the thermal conductivity was also carried out in some samples.

This measurement result is shown in Tables 18-23.

In the obtained various aluminum nitride-based sintered compacts, the quantity of the impurities or added various additives which are contained in the powder compacts is that in which the impurities actually contained or the compounds actually added were converted into the oxide or the element, in this Example.

As for the impurities oxygen in raw material powder and the oxygen component resulting from added Al₂O₃, or the metal components and the oxygen component, etc. in the sintering aids, such as an added rare earth element compound and an alkaline-earth-metal compound, or the metal component and the oxygen component, etc. in the alkali metal compound and silicon content compound which were added, or the metals component and the carbon component, etc. in the compound containing each transition metal of Mo, W, V, Nb, Ta and Ti and the compound containing carbon which were added, or the metals component, etc. in the compound containing unescapable metal, such as Fe, Ni, Cr, Mn, Zr, Hf, Co, Cu and Zn, etc. which were added, it was confirmed that they are hardly vaporized and not removed by firing, and that the almost same quantity as the quantity in the powder compact exists in the aluminum nitride-based sintered compacts produced in this Example.

That is, when the above converted value was used as the amount of impurities and the amount of additives, as for the quantity of the impurities or the additives in the aluminum nitride-based sintered compacts produced in this Example, the difference with the quantity of the impurities or the additives which are contained in the powder compacts is small, and it can be considered that it is almost the same amount.

Therefore, as the obtained compositions of the aluminum nitride-based sintered compacts, it is not indicated especially except the total amount of oxygen in each Table.

Al₂O₃ quantity added when producing the above aluminum nitride-based sintered compacts is calculated on the basis of oxide (that is, it is the quantity as it is), and the amount of oxygen in the aluminum nitride-based sintered compacts is measured on an element basis.

Table 18 shows the examples in which Al₂O₃ was used alone as an additive, and the examples in which a rare earth element compound or an alkaline-earth-metal compound were added simultaneously with Al₂O₃.

Table 19 shows the examples in which a rare earth element compound and an alkaline-earth-metal compound were used respectively alone or simultaneously as an additive.

The measurement result of the thermal conductivity at room temperature is also shown in the experimental examples of Table 19.

Table 20 shows the examples in which a compound containing silicon and an alkali metal compound were used as an additive.

Table 20 also shows the examples in which a rare earth element compound or an alkaline-earth-metal compound was added simultaneously with a compound containing silicon.

Table 20 also shows the examples in which a rare earth element compound or an alkaline-earth-metal compound was added simultaneously with an alkali metal compound.

Table 21 shows the examples in which each transition metal component of Mo, W, V, Nb, Ta and Ti, and carbon were used as an additive.

Table 22 shows the examples in which a rare earth element compound or an alkaline-earth-metal compound was added simultaneously with each transition metal component of Mo, W, V, Nb, Ta and Ti, and carbon.

Table 23 shows the examples in which each component of iron, nickel, chromium, manganese, zirconium, hafnium, cobalt, copper and zinc was used as an additive.

Table 23 also shows the examples in which a rare earth element compound or an alkaline-earth-metal compound was used simultaneously with each component of iron, nickel, chromium, manganese, zirconium, hafnium, cobalt, copper and zinc.

In addition, after specular surface polish, the surface smooth nature of the aluminum nitride-based sintered compacts was the range of 31-36 nm as the average surface roughness Ra.

As shown in Tables 18-23, in this Example, the aluminum nitride-based sintered compacts in which the optical transmissivity is not more than 50 % were obtained except for the experiment No.396.

In those which contain comparatively a lot of oxygen (it used as Al₂O₃), rare earth element compound, alkaline-earth-metal compound, silicon content compound, alkali metal compound, Mo, W, V, Nb, Ta, Ti, carbon, iron, nickel, chromium, manganese, zirconium, hafnium, cobalt, copper, or zinc, the optical transmissivity tends to lower into not more than 10 %, and those in which the optical transmissivity is 0 % were also obtained easily.

In the aluminum nitride-based sintered compacts produced in the experimental example shown in Table 19, the thermal conductivity was not less than 50 W/mK at room temperature, in all the things belonging to the range of this invention, and it was a maximum of 177 W/mK.

Next, the thin films comprising as amain component gallium nitride, indium nitride and aluminum nitride were formed on the substrate surface by the method which used the same MOCVD (Metal Organic Chemical Vapor Deposition) equipment as Example 1 and Example 2 by the high frequency induction heating, using as a substrate the obtained aluminum nitride-based sintered compacts.

As for the thin films obtained, the crystallinity evaluation was carried out by X ray diffraction which used CuKα characteristic X-rays.

As a result, in the experimental examples which used Al₂O₃ as an additive agent and are shown in Table 18, the single-crystal thin films comprising as a main component gallium nitride, indium nitride and aluminum nitride and having the crystallinity in which the half width of the rocking curve of the X ray diffraction from the lattice plane of a Miller Index (002) is not more than 200 seconds were formed as shown in Table 18, in the case of the aluminum nitride-based sintered compacts in which the amount of ALON is not more than 7 %.

The single-crystal thin films comprising as a main component gallium nitride, indium nitride, and aluminum nitride and having the crystallinity in which the half width of the rocking curve of the X ray diffraction from the lattice plane of a Miller Index (002) is not more than 240 seconds were formed, in the case of the aluminum nitride-based sintered compacts in which the amount of ALON is not more than 12 %.

The single-crystal thin films comprising as a main component gallium nitride, indium nitride, and aluminum nitride and having the crystallinity in which the half width of the rocking curve of the X ray diffraction from the lattice plane of a Miller Index (002) is not more than 300 seconds were formed, in the case of the aluminum nitride-based sintered compacts in which the amount of ALON is not more than 20 %.

The single-crystal thin films comprising as a main component gallium nitride, indium nitride, and aluminum nitride and having the crystallinity in which the half width of the rocking curve of the X ray diffraction from the lattice plane of a Miller Index (002) is not more than 200 seconds were formed, in the case of the aluminum nitride-based sintered compacts in which the content of oxygen is not more than 3 % by weight.

The single-crystal thin films comprising as a main component gallium nitride, indium nitride, and aluminum nitride and having the crystallinity in which the half width of the rocking curve of the X ray diffraction from the lattice plane of a Miller Index (002) is not more than 240 seconds were formed, in the case of the aluminum nitride-based sintered compacts in which the content of oxygen is not more than 5 % by weight.

The single-crystal thin films comprising as a main component gallium nitride, indium nitride, and aluminum nitride and having the crystallinity in which the half width of the rocking curve of the X ray diffraction from the lattice plane of a Miller Index (002) is not more than 300 seconds were formed, in the case of the aluminum nitride-based sintered compacts in which the content of oxygen is not more than 10 % by weight.

The content of ALON also increases according as the total amount of oxygen in the aluminum nitride-based sintered compacts increases, and the content of ALON will also increase into more than 20 % if the total amount of oxygen increases into more than 10 % by weight. But, the single-crystal thin films comprising as a main component gallium nitride, indium nitride and aluminum nitride were formed.

Furthermore, if the total amount of oxygen in the aluminum nitride-based sintered compacts becomes more than 25 % by weight, the content of ALON will also become more than 50 %, the thin films which comprise as a main component gallium nitride, indium nitride and aluminum nitride and are formed on the aluminum nitride-based sintered compacts tend to become to the polycrystalline state, and formation of a single-crystal thin film tends to become difficult.

If the aluminum nitride-based sintered compacts produced by adding simultaneously a rare earth element compound or an alkaline-earth-metal compound were used, it was confirmed that the crystallinity of the formed single-crystal thin films comprising as a main component gallium nitride, indium nitride and aluminum nitride improves than what added Al₂O₃ alone.

In the experimental examples which are shown in Table 19 and used a rare earth element compound and an alkaline-earth-metal compound as the additive agents, the single-crystal thin films comprising as a main component gallium nitride, indium nitride and aluminum nitride and having the crystallinity in which the half width of the rocking curve of the X ray diffraction from the lattice plane of the Miller Index (002) is not more than 200 seconds were formed, if the content of a rare earth element component in the aluminum nitride-based sintered compacts is up to 7 volume % on the basis of oxide.

The single-crystal thin films comprising as a main component gallium nitride, indium nitride and aluminum nitride and having the crystallinity in which the half width of the rocking curve of the X ray diffraction from the lattice plane of the Miller Index (002) is not more than 240 seconds were formed, if the content of a rare earth element component is up to 12 volume % on the basis of oxide.

The single-crystal thin films comprising as a main component gallium nitride, indium nitride and aluminum nitride and having the crystallinity in which the half width of the rocking curve of the X ray diffraction from the lattice plane of the Miller Index (002) is not more than 300 seconds were formed, if the content of a rare earth element component is up to 25 volume % on the basis of oxide.

The single-crystal thin films comprising as a main component gallium nitride, indium nitride and aluminum nitride and having the crystallinity in which the half width of the rocking curve of the X ray diffraction from the lattice plane of the Miller Index (002) is not more than 200 seconds were formed, if the content of an alkaline-earth-metal component in the aluminum nitride-based sintered compacts is up to 3 volume % on the basis of oxide.

The single-crystal thin films comprising as a main component gallium nitride, indium nitride, and aluminum nitride and having the crystallinity in which the half width of the rocking curve of the X ray diffraction from the lattice plane of the Miller Index (002) is not more than 240 seconds were formed, if the content of an alkaline-earth-metal component in the aluminum nitride-based sintered compacts is up to 5 volume % on the basis of oxide.

The single-crystal thin films comprising as a main component gallium nitride, indium nitride and aluminum nitride and having the crystallinity in which the half width of the rocking curve of the X ray diffraction from the lattice plane of the Miller Index (002) is not more than 300 seconds were formed, if the content of a rare earth element component and an alkaline-earth-metal component in the aluminum nitride-based sintered compacts is up to 3 volume % on the basis of oxide, respectively.

There is a tendency in which the crystallinity of the single-crystal thin films comprising as a main component gallium nitride, indium nitride and aluminum nitride decreases according as the content of a rare earth element component and an alkaline-earth-metal component in the sintered compacts increases.

The thin films comprising as a main component gallium nitride, indium nitride and aluminum nitride tend to become into the polycrystalline state, and the formation of a single-crystal thin film tends to become difficult, if the content of a rare earth element component and an alkaline-earth-metal component in the aluminum nitride-based sintered compacts becomes more than 50 volume % on the basis of oxide, respectively.

If it is the same amount of addition, it was confirmed that the crystallinity of the single-crystal thin films comprising as a main component gallium nitride, indium nitride and aluminum nitride is improved than what added a rare earth element compound and an alkaline-earth-metal compound alone respectively, when the sintered compacts produced adding a rare earth element compound or an alkaline-earth-metal compound simultaneously were used.

In the experiment examples which were shown in Table 20 and used an alkaline metal compound and a silicon compound as the additive agents, the single-crystal thin films comprising as a main component gallium nitride, indium nitride and aluminum nitride and having the crystallinity, such that half width of the rocking curve of the X ray diffraction from the lattice plane of the Miller Index (002) is not more than 240 seconds, were formed, if the content of an alkaline metal and silicon component in the aluminum nitride-based sintered compacts is up to 5 volume % on the basis of oxide, respectively.

The single-crystal thin films comprising as a main component gallium nitride, indium nitride and aluminum nitride and having the crystallinity, such that half width of the rocking curve of the X ray diffraction from the lattice plane of the Miller Index (002) is not more than 300 seconds, were formed, if the content of an alkaline metal and silicon component in the aluminum nitride-based sintered compacts is up to 10 volume % on the basis of oxide, respectively.

There is a tendency in which the crystallinity of the single-crystal thin films comprising as a main component gallium nitride, indium nitride and aluminum nitride decreases according as the content of an alkaline metal component and a silicon component in the sintered compacts increases.

The thin films comprising as a main component gallium nitride, indium nitride and aluminum nitride tend to become into the polycrystalline state, and the formation of a single-crystal thin film tends to become difficult, if the content of an alkaline metal component and a silicon component in the aluminum nitride-based sintered compacts becomes more than 20 volume % on the basis of oxide, respectively.

If the aluminum nitride-based sintered compacts produced by adding simultaneously a rare earth element compound or an alkaline-earth-metal compound were used, it was confirmed that the crystallinity of the formed single-crystal thin films comprising as a main component gallium nitride, indium nitride and aluminum nitride improves than what added respectively an alkaline metal component and a silicon component alone.
In the experiment examples which are shown in Table 21 and used each transition-metals-component of Mo, W, V, Nb, Ta and Ti, and carbon as an additive agent, the single-crystal thin films comprising as a main component gallium nitride, indium nitride and aluminum nitride and having the crystallinity in which the half width of the rocking curve of the X ray diffraction from the lattice plane of the Miller Index (002) is not more than 200 seconds were formed, if the content of each transition-metals-component of Mo, W, V, Nb, Ta and Ti, and carbon in the aluminum nitride-based sintered compacts is up to 5 volume % on the basis of oxide, respectively.

The single-crystal thin films comprising as a main component gallium nitride, indium nitride and aluminum nitride and having the crystallinity in which the half width of the rocking curve of the X ray diffraction from the lattice plane of the Miller Index (002) is not more than 240 seconds were formed, if the content of each transition-metals-component of Mo, W, V, Nb, Ta and Ti, and carbon in the aluminum nitride-based sintered compacts is up to 10 volume % on the basis of oxide, respectively.

Tthe single-crystal thin films comprising as a main component gallium nitride, indium nitride and aluminum nitride and having the crystallinity in which the half width of the rocking curve of the X ray diffraction from the lattice plane of the Miller Index (002) is not more than 300 seconds were formed, if the content of each transition-metals-component of Mo, W, V, Nb, Ta and Ti, and carbon in the aluminum nitride-based sintered compacts is up to 25 volume % on the basis of oxide, respectively.

There is a tendency in which the crystallinity of the single-crystal thin films comprising as a main component gallium nitride, indium nitride and aluminum nitride decreases according as the content of each transition-metals-component of Mo, W, V, Nb, Ta and Ti, and carbon in the sintered compacts increases.

The thin films comprising as a main component gallium nitride, indium nitride and aluminum nitride tend to become into the polycrystalline state, and the formation of a single-crystal thin film tends to become difficult, if the content of each transition metal component of Mo, W, V, Nb, Ta and Ti, and carbon in the aluminum nitride-based sintered compacts becomes more than 50 volume % on an element basis, respectively.

In the experimental examples which are shown in Table 22 and added simultaneously a rare earth element compound or an alkaline-earth-metal compound with each transition metal component of Mo, W, V, Nb, Ta and Ti, and carbon, as an additive agent, even if the aluminum nitride-based sintered compacts are what contains each transition metal component of Mo, W, V, Nb, Ta and Ti, and carbon comparatively so much up to 25 volume % on an element basis, respectively, the single-crystal thin films comprising as a main component gallium nitride, indium nitride and aluminum nitride and having the crystallinity in which the half width of the rocking curve of the X ray diffraction from the lattice plane of the Miller Index (002) is not more than 240 seconds were formed, and improvement of the crystallinity was confirmed clearly.

In the experimental examples which are shown in Table 23 and used each component of iron, nickel, chromium, manganese, zirconium, hafnium, cobalt, copper and zinc as an additive agent, the single-crystal thin films comprising as a main component gallium nitride, indium nitride and aluminum nitride and having the crystallinity in which the half width of the rocking curve of the X ray diffraction from the lattice plane of the Miller Index (002) is not more than 200 seconds were formed, if the content of each transition metal component of iron, nickel, chromium, manganese, zirconium, hafnium, cobalt, copper and zinc in the aluminum nitride-based sintered compacts is up to 10 % by weight on an element basis, respectively.

The single-crystal thin films comprising as a main component gallium nitride, indium nitride, and aluminum nitride and having the crystallinity in which the half width of the rocking curve of the X ray diffraction from the lattice plane of the Miller Index (002) is not more than 240 seconds have been formed, if the content of each transition metal component of iron, nickel, chromium, manganese, zirconium, hafnium, cobalt, copper and zinc in the aluminum nitride-based sintered compacts is up to 20 % by weight on an element basis, respectively.

The single-crystal thin films comprising as a main component gallium nitride, indium nitride, and aluminum nitride and having the crystallinity in which the half width of the rocking curve of the X ray diffraction from the lattice plane of the Miller Index (002) is not more than 300 seconds were formed, if the content of each transition metal component of iron, nickel, chromium, manganese, zirconium, hafnium, cobalt, copper and zinc in the aluminum nitride-based sintered compacts is up to 30 % by weight on an element basis, respectively.

There is a tendency in which the crystallinity of the single-crystal thin films comprising as a main component gallium nitride, indium nitride and aluminum nitride decreases, according as the content of each transition metal component of iron, nickel, chromium, manganese, zirconium, hafnium, cobalt, copper and zinc in the sintered compacts increases.

The thin films comprising as a main component gallium nitride, indium nitride and aluminum nitride tend to become into the polycrystalline state, and the formation of a single-crystal thin film tends to become difficult, if the content of each transition metal component of iron, nickel, chromium, manganese, zirconium, hafnium, cobalt, copper and zinc in the aluminum nitride-based sintered compacts becomes more than 50 % by weight on an element basis, respectively. If the aluminum nitride-based sintered compacts produced by adding simultaneously a rare earth element compound or an alkaline-earth-metal compound were used, it was confirmed that the crystallinity of the formed single-crystal thin films which comprise as a main component gallium nitride, indium nitride and aluminum nitride improves clearly than what added respectively each transition metal component of iron, nickel, chromium, manganese, zirconium, hafnium, cobalt, copper and zinc alone.

In the thin films obtained in this Example, observation of the single-crystal thin films was carried out using the optical microscope and the electron microscope, as a result, cracks were not seen in the inside of the single-crystal thin films, and exfoliations in the junction interface between the single-crystal thin films and the aluminum nitride-based sintered compacts are not seen.

Tested by pasting up and tearing off after adhesive tape is pasted up to each single-crystal thin film obtained, but the exfoliations and destructions in the junction interface between the single-crystal thin films and the sintered compacts which comprise aluminum nitride as a main component were not seen.

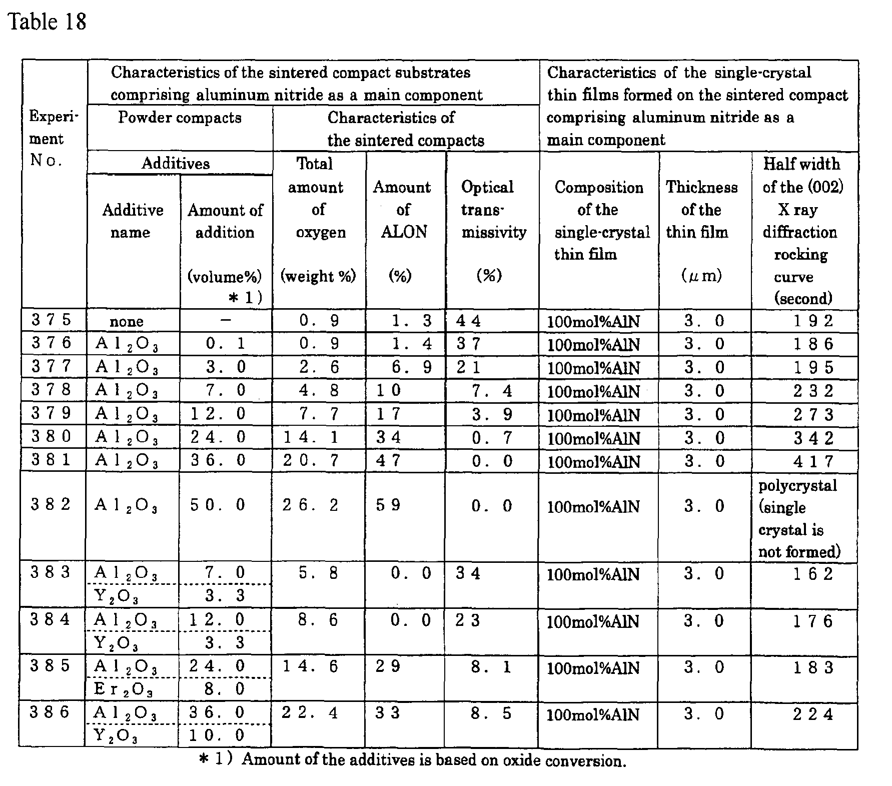

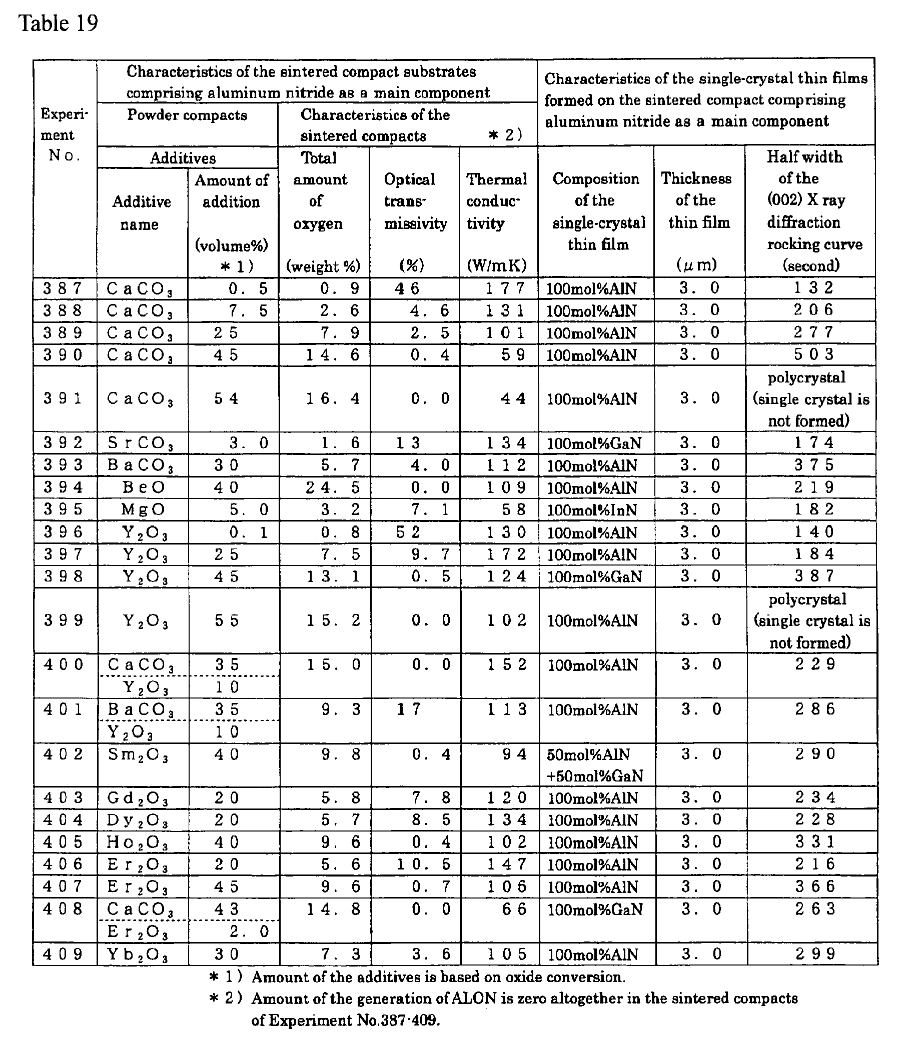

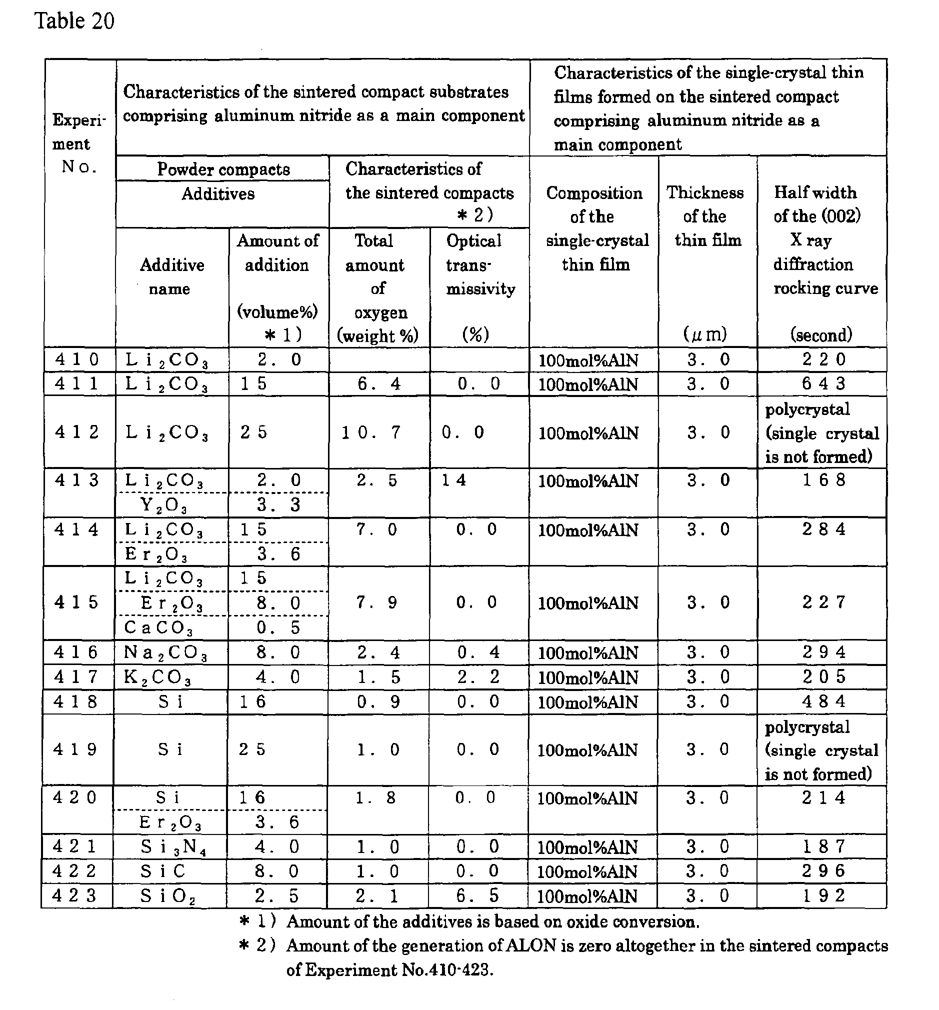

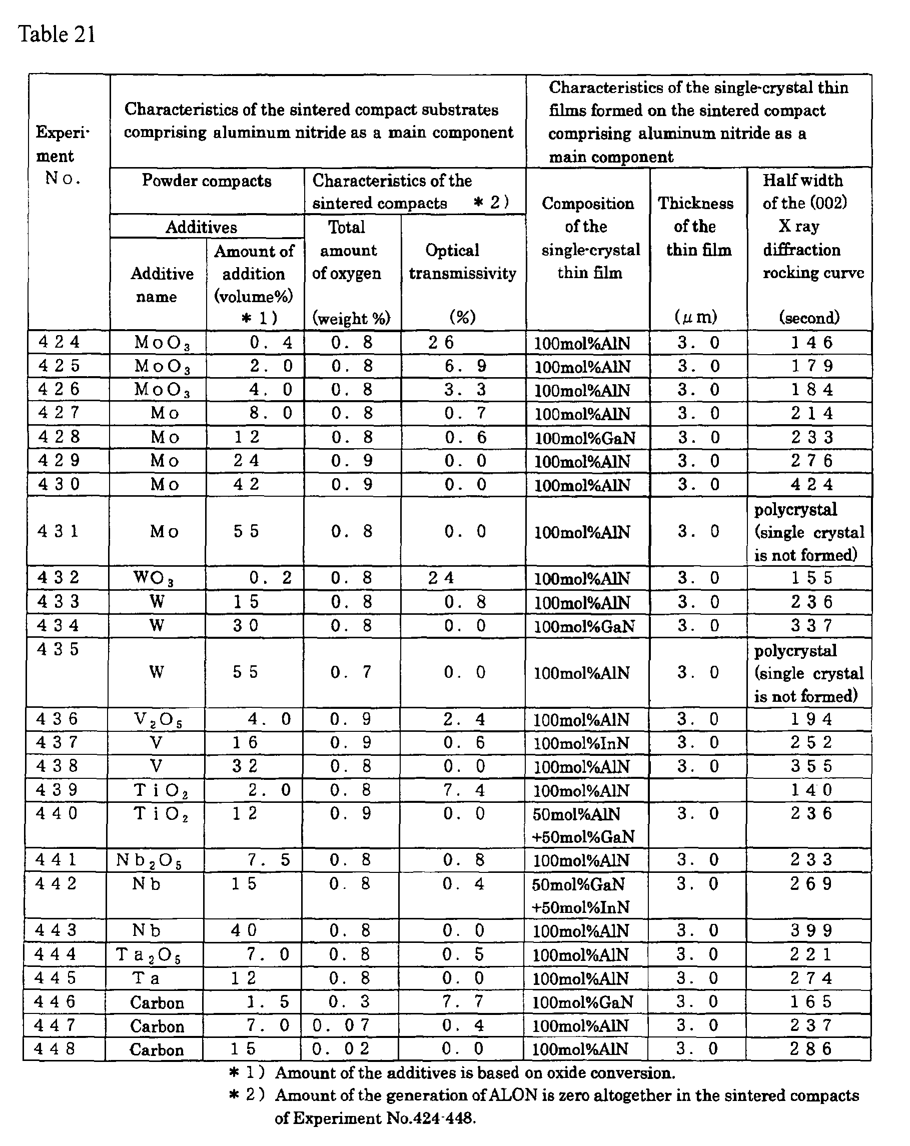

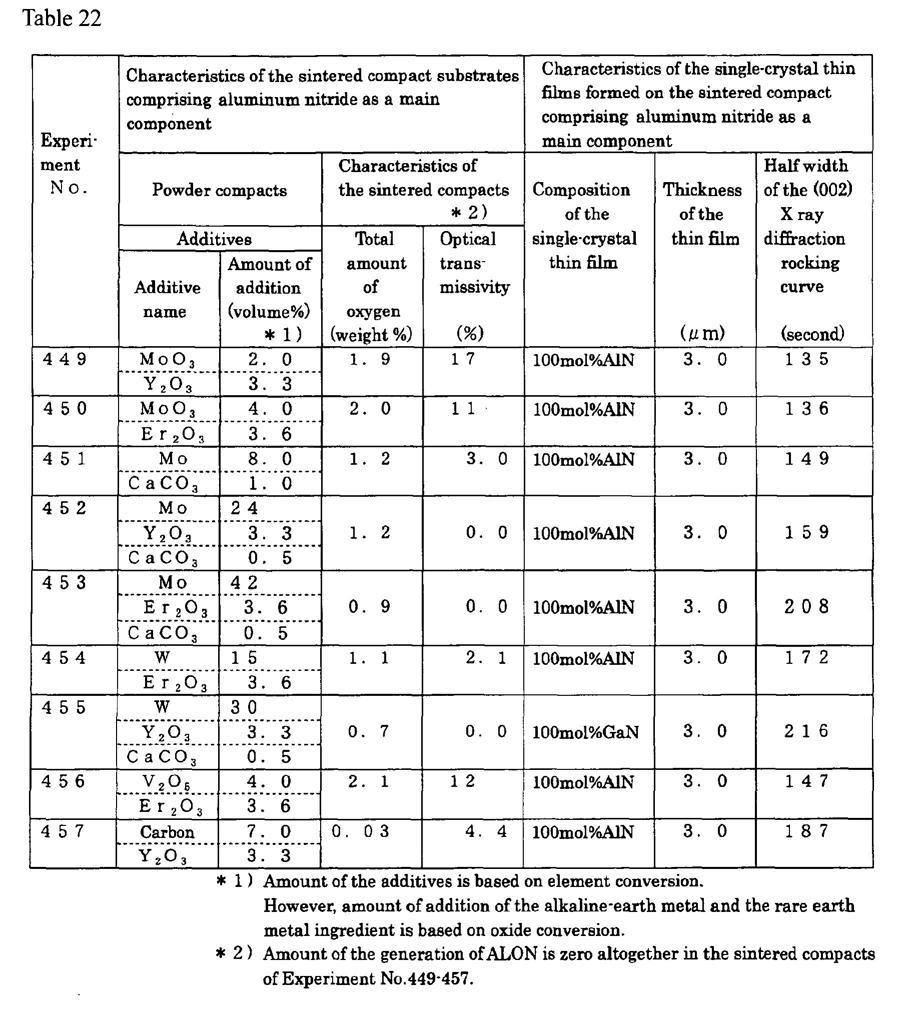

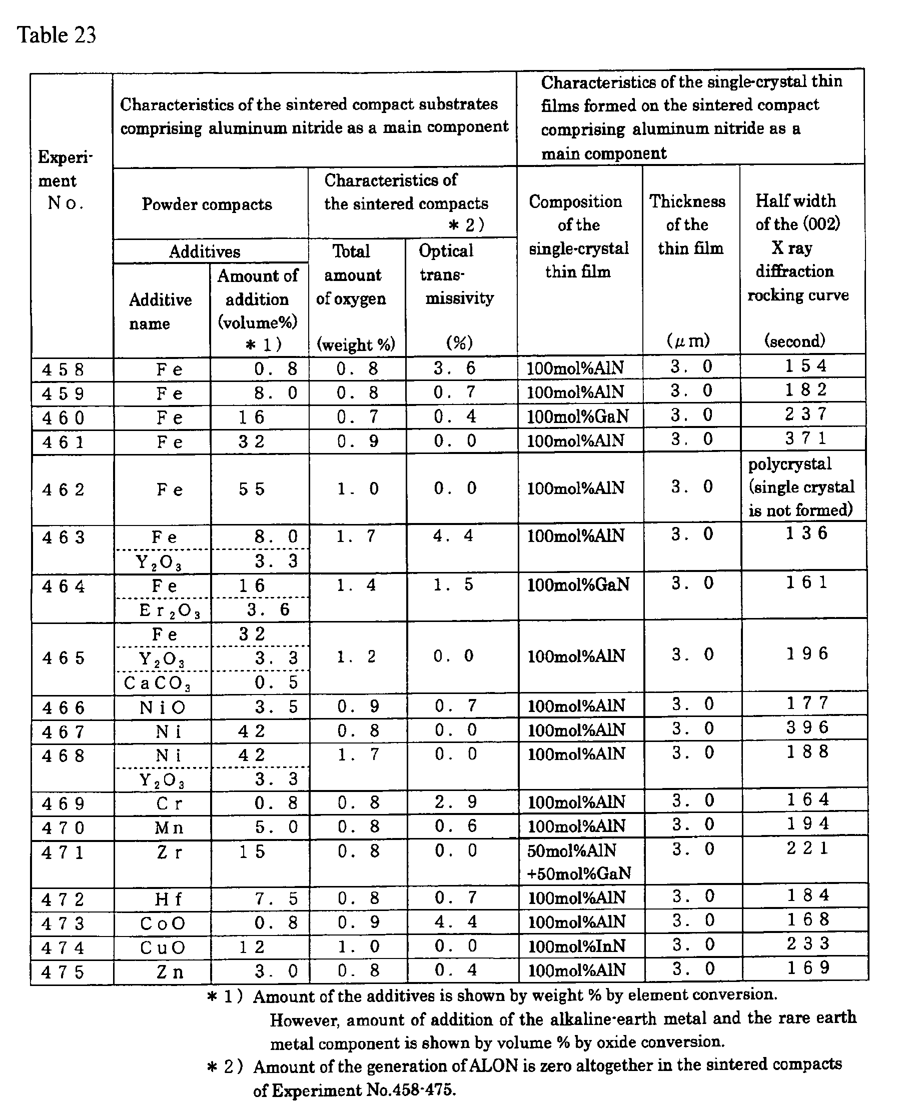

### Example 20

Using the things which were processed into the shape of a substrate of the size with the diameter of 25.4 mm x thickness of 0.5 mm and which carried out the mirror-surface polishing on the aluminum nitride-based sintered compacts used in Example 18 and having conduction vias, the aluminum nitride-based sintered compacts having not conduction vias, and each sintered compact of the experiment No.265, experiment No.269, and experiment No.271 which was produced in Example 18 and raised the purity of aluminum nitride, the thin films having various compositions and various crystallization states and comprising as a main component at least one selected from gallium nitride, indium nitride and aluminum nitride were formed in the thickness of 3 µm on one surface of each above sintered compact by the same method as Example 1, Example 2, and various thin-film substrates were produced.

As for the compositions and the crystallization states of the thin films, they are shown in Table 24.

In addition to these, here prepared the thin-film substrates in which the thin films comprising as a main component at least one selected from gallium nitride, indium nitride and aluminum nitride were formed further on the substrates comprising the aluminum nitride-based sintered compacts produced in Example 18 and having beforehand the various conductive materials, such as titanium, chromium, nickel, molybdenum, tungsten, platinum, aluminum, tantalum, nitriding tantalum, nitriding titanium, gold, copper, tungsten/copper alloy (W : 90 weight % + Cu 10 weight %), etc.

As for the thin-film substrates produced in Example 18, though the compositions and crystallization states of the thin films were same as Example 18, they re-published in Table 25 anew.

Using the thin-film substrates produced or prepared, the various thin film-conductive materials comprising titanium, chromium, nickel, molybdenum, tungsten, platinum, aluminum, tantalum, tantalum nitride, titanium nitride, gold, and copper, etc. were formed by the same method as Example 18 on the thin films which are being formed on the thin-film substrates and comprise as a main component at least one selected from gallium nitride, indium nitride and aluminum nitride.

As for the constitution and thickness of the various thin film-conductive materials, they are as having been indicated in Table 24 and 25.

After forming the various thin film-conductive materials, observation of appearances was carried out about the thin films comprising as a main component at least one selected from gallium nitride, indium nitride and aluminum nitride and formed on the used thin-film substrates, as a result, especially faults, such as a crack and exfoliation in the interface with the thin film-conductive materials, are not found, and are in good appearance states, it was confirmed that the thin film-conductive materials which used the material of this invention have good junction nature to the thin films of various compositions comprising as a main component at least one selected from gallium nitride, indium nitride and aluminum nitride.

To confirm the junction nature between the thin film-conductive materials and the thin films of various compositions comprising as a main component at least one selected from gallium nitride, indium nitride and aluminum nitride, the next test was carried out furthermore.

The test method is that which measures the perpendicular tensile strength after the circular aluminum pin with the diameter of 3 mm was pasted up on the thin film-conductive materials formed in the produced substrates by epoxy resin, and it was confirmed that the perpendicular tensile strength is not less than 2 kg/mm² altogether. The exfoliations exist in the adhesion interface between the epoxy resin and the thin films of various composition comprising as a main component at least one selected from gallium nitride, indium nitride and aluminum nitride, or in the adhesion interface between the epoxy resin and the pin, or in the inside of the epoxy resin, it was confirmed that the exfoliations or destructions between the thin film-conductive materials and the thin films of various composition comprising as a main component at least one selected from gallium nitride, indium nitride and aluminum nitride are not seen, and good junction nature is formed.

In addition, the lead and the thin film-conductive materials were connected by the solder using the lead made from kovar having a pad with the diameter of 1.5 mm in the tip, about the things (each sample of the experiment No.494-497, 500, 502-504, and 512-515) of the constitution having gold and copper in the surface among the thin film-conductive materials formed, and perpendicular tensile strength was measured.

As a result, the perpendicular tensile strength is not less than 4 kg/mm² altogether, after testing the leads and the portions to which the leads were joined in the thin-film substrates were observed, all were being destroyed in the inside of the solders or in the portions between the solder and the lead, and the exfoliations or destructions between the thin film-conductive materials and the thin films comprising as a main component at least one selected from gallium nitride, indium nitride and aluminum nitride were not observed.

Therefore, it was confirmed that the junction strength between the thin film-conductive materials and the above thin films is originally not less than 4 kg/mm² and that the junction nature is high.

The junction nature was tested by the method which pastes up the pressure sensitive adhesive tape on the thin film-conductive materials currently formed on the substrate produced and tears off the tape, but, the exfoliations or destructions between the thin film-conductive materials and the thin films of various compositions comprising as a main component at least one selected from gallium nitride, indium nitride and aluminum nitride were not seen altogether.

The above examination result is proving that not only the junction nature between the thin film-conductive materials and the thin films comprising as a main component at least one selected from gallium nitride, indium nitride and aluminum nitride is high, but also the junction nature between the sintered compacts comprising aluminum nitride as a main component and the thin film-conductive materials, and the junction nature between the sintered compacts comprising aluminum nitride as a main component and the thin films comprising as a main component at least one selected from gallium nitride, indium nitride and aluminum nitride, are also high.

These results were described in Table 24 and 25.

Also in this invention, as for the conductive thin films which comprise as a main component at least one selected from gallium nitride, indium nitride aluminum nitride and were produced using the sintered compacts having the conduction vias, such as the sintered compact of the experiment No.73, the sintered compact of the experiment No.75, the sintered compact of the experiment No.80, the sintered compact of the experiment No.82, the sintered compact of the experiment No.305, the sintered compact of the experiment No.311, and the sintered compact of the experiment No.317, they have an electrical connection with the substrate surfaces where the thin films are not formed, it was confirmed that there are not only the mechanical junction nature but also the electrical connection between the thin film-conductive materials produced in this Example and the thin films comprising as a main component at least one selected from gallium nitride, indium nitride and aluminum nitride.

In the thin film-conductive materials produced in this Example, electric resistivity of titanium, chromium, nickel, molybdenum, tungsten, platinum, aluminum, tantalum, titanium nitride, gold, and copper is not more than 1x10⁻³ Ω·cm altogether at room temperature, since they have higher conductivity than the electrical conductive thin films of various composition which comprise as a main component at least one selected from gallium nitride, indium nitride and aluminum nitride and are obtained by adding a doping agent, still higher electrical connection nature is obtained between the electrical conductive thin films which comprise as a main component at least one selected from gallium nitride, indium nitride and aluminum nitride and the substrate surface where the thin films are not formed, if using the thin film-conductive materials of this invention.

If functional devices, such as a light-emitting device, are formed on the substrates for a thin film, for example, using the substrates for a thin film on which the thin film-conductive materials of this invention were formed as an electric circuit pattern, it functions also as the circuit board for mounting a light-emitting device, or the substrate joined with a package.

Therefore, although the circuit board or package for mounting the functional devices, such as a light-emitting device, are usually required, the effect in which it becomes unnecessary to prepare the wiring board or the package independently is acquired, if using the substrates of this invention which united the function.

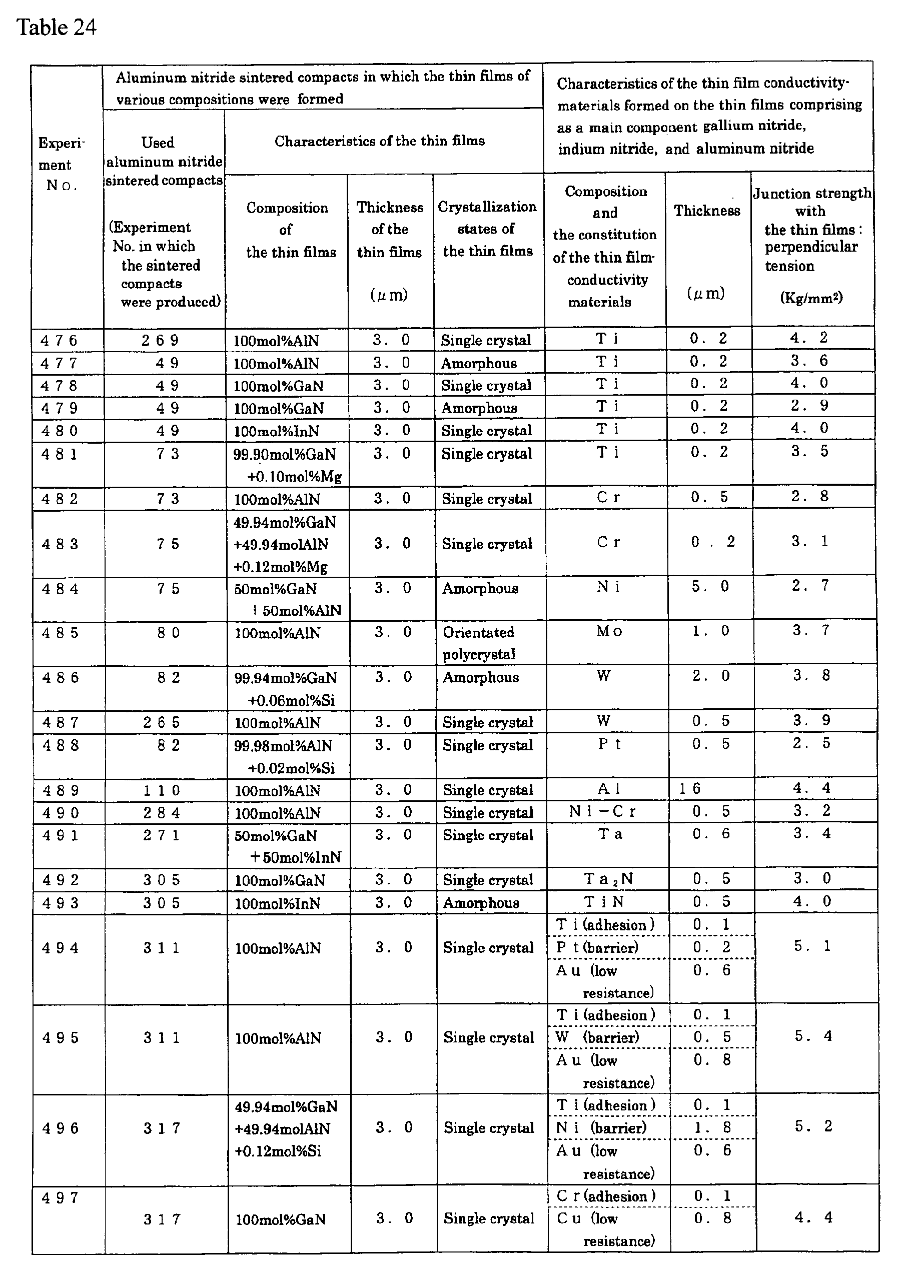

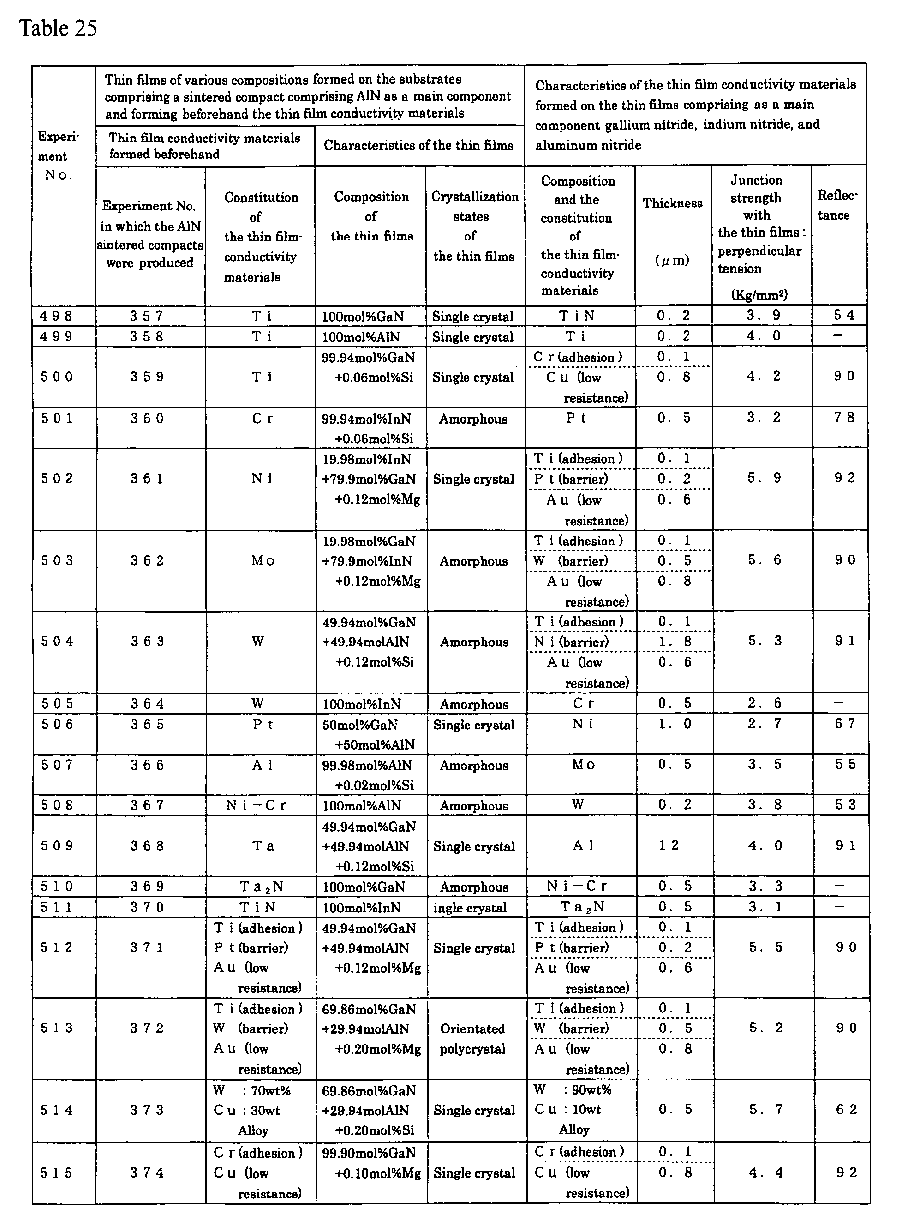

### Example 21

Each aluminum nitride-based sintered compact of the experiment No.49 and experiment No.58 which were produced in Example 2 and the experiment No.269 produced in Example 11, was processed in the shape of a substrate having the size with a diameter of 25.4 mm x thickness of 0.5 mm, and the specular surface polish was carried out further, the thin films of various composition comprising as a main component at least one selected from gallium nitride, indium nitride and aluminum nitride were formed in the thickness of 6 µm onto it by the same MOCVD method as Example 1, Example 2, Example 10 and Example 12, and the thin-film substrates were produced.

The thin films of various composition containing niobium and tantalum and comprising as a main component at least one selected from gallium nitride, indium nitride and aluminum nitride were also formed.

The thin films containing niobium and tantalum were formed in the thickness of 6 µm by the same Chloride VPE method as Example 9.

Niobium chloride and tantalum chloride were used as a raw material of the component of niobium and tantalum.

These thin films were formed so that they become into each crystallization state of a single crystal, an amorphous state, and an orientated polycrystal.

When the single-crystal thin films were formed, the substrates in which the orientated polycrystalline thin film comprising 100 mol % AlN composition substantially and having the direction where C axis is perpendicular to the substrate surface was formed beforehand on all the substrates comprising an aluminum nitride-based sintered compact by the above described MOCVD method were used.

As for the single-crystal thin films formed on such an orientated polycrystalline thin film, two kinds of that in which the direction of a crystal C axis is perpendicularly formed to the substrate surface, and that formed horizontally, were produced.

The thin films of each crystallization state of an amorphous state, and an orientated polycrystal other than the single crystal were formed directly on the substrates comprising an aluminum nitride-based sintered compact, as it.

The orientated polycrystalline thin films are formed so that C axis becomes perpendicular to the substrate surface (the experiment No. 546, 548).

Although the appearance of each thin film formed was observed, faults, such as a crack in the inside of the thin films and an exfoliation between the thin films and the aluminum nitride-based sintered compacts, were not seen.

Although the exfoliation test was carried out using the pressure sensitive adhesive tape, there was no exfoliation between the thin films formed and the aluminum nitride-based sintered compacts.

The half width of the rocking curve of the X ray diffraction from the lattice plane of the Miller Index (002) of the orientated polycrystalline AlN thin film formed first on the above substrates comprising an aluminum nitride-based sintered compact was in the range of 4270-4740 seconds.

On the other hand, as for the crystallinity of the single-crystal thin films formed on the above orientated polycrystalline thin films, the half width of the rocking curve of the X ray diffraction from the lattice plane of a Miller Index (002) was not more than 300 seconds.

Next, the refractive index of the formed thin films to the light with a wavelength of 650 nm was investigated using the spectrophotometer [product name : FilmTek4000 made by U.S. "SCI (Scientific Computing International) Co"].

The refractive index of a direction parallel to C axis (namely, extraordinary light) was measured in case of the refractive index of the thin films in which the crystal C axis of single-crystal thin films was formed perpendicularly to the substrate surface, and the refractive index of a direction perpendicular to C axis (namely, ordinary light) was measured in case of the refractive index of the thin films in which the crystal C axis of single-crystal thin films was formed horizontally to the substrate surface.

As a result, also in the thin films of any crystallization states of a single crystal and an amorphous state in the thin films comprising as a main component at least one selected from gallium nitride, indium nitride and aluminum nitride, it was confirmed that the refractive index becomes large if increasing the content of gallium nitride or indium nitride without depending on the formation direction of the crystal C axis in the single-crystal thin films, and that it tends to decrease if increasing the content of aluminum nitride.

It was found out that if the content of niobium or tantalum increases, the refractive index becomes large.

In the thin films formed, if the amount of increases of at least one selected from gallium nitride and indium nitride which are contained in what comprises as a main component aluminum nitride is more than 0.01 mol % to the main components, the increase of a refractive index of at least not less than 1x10⁻⁵ is observed, and the increase of a refractive index was not more than 2x10⁻¹ if it is at least not more than 20 mol %.

In the formed thin films comprising as a main component at least one selected from gallium nitride, indium nitride and aluminum nitride, if the content of at least one selected from niobium and tantalum is not less than 0.01 mol % to the main components, the increase of a refractive index of at least not less than 1x10⁻⁵ is observed, and the increase of a refractive index was not more than 2x10⁻¹ if it is at least not more than 20 mol %.

The refractive index of the single-crystal thin films in which C axis was horizontally formed to the substrate surface is smaller than what was formed perpendicularly, and the difference is about 0.03-0.05.

Although there is a tendency in which the refractive index of the thin film of a polycrystal is larger than the amorphous state, it is not more than 2.0 in those of both crystallization states, and it was smaller than the single-crystal's one.

Although the thin films were formed on the thin-film substrates produced in the experiment No.549-577 by the Chloride VPE method, the refractive index differs each other from the thin films formed by the MOCVD method even if it was the thin film of the same composition, the tendency in which the refractive index of the thin films produced by the Chloride VPE method becomes large was shown.

These results are shown in Table 26.

In addition, in Table 26, the components of niobium and tantalum were described by supposing as niobium nitride and tantalum nitride.

### (Comparative example)

In the other, preparing the substrates comprising the aluminum nitride-based sintered compact produced in the above experiment No.49, some substrates are left as they are, and the 100 mol % AlN orientated polycrystalline thin film was formed in some substrates on the same condition as this Example.

LiNbO₃, SiO₂ and Al₂O₃ thin films with the thickness of 6.0 µm were formed in these substrates after that by the radio frequency (RF) magnetron sputtering method with the frequency of 13.56MHz.

The sputtering was carried out on the condition where the substrate temperature was 250°C, the Ar gas pressure was 0.6Pa, and the electric power was 1000W.

As a result, irrespective of forming the 100 mol % AlN orientated polycrystalline thin film, cracks arose in any thin films of LiNbO₃, SiO₂, and Al₂O₃, it was difficult to use them as an optical waveguide.

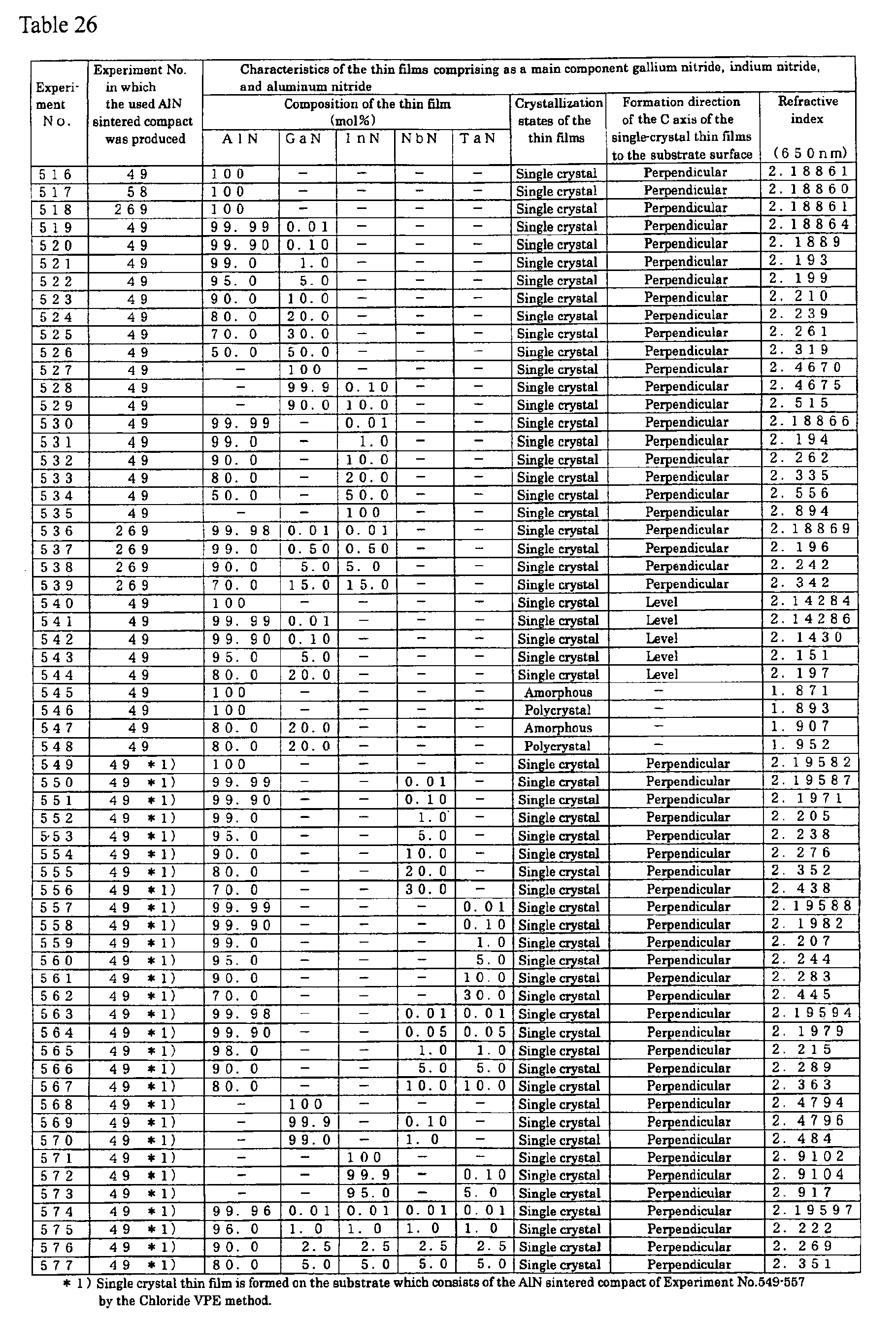

### Example 22

The aluminum nitride-based sintered compacts produced in the experiment No.49 and experiment No.58 of Example 2, and the aluminum nitride-based sintered compact produced in the experiment No.269 of Example 11 were processed into the shape of a substrate with the size of the diameter of 25.4 mm x thickness of 0.5 mm, and the specular surface polish was carried out further, and the thin-film substrates in which the thin films having various compositions and various crystallization states and comprising as a main component at least one selected from gallium nitride, indium nitride and aluminum nitride were formed onto them by the same MOCVD method and Chloride VPE method which were used in Example 1, Example 2, Example 4, Example 9, Example 12, and Example 21 were produced.

The thickness of the thin films produced by the MOCVD method is 25 µm, and the thickness of the thin films produced by the Chloride VPE method is 100 µm.

On the occasion of formation of the mixed-crystal thin films with 3 components of AlN+GaN+InN, it was carried out on the condition where the substrate temperature is 950°C.

On the occasion of forming the single-crystal thin films, the substrates in which the orientated polycrystalline thin film comprising 100 mol % AlN composition substantially and having the direction wherein C axis is perpendicular to the substrate surface was formed beforehand on all the substrates comprising an aluminum nitride-based sintered compact by the radio frequency (RF) magnetron sputtering method with the frequency of 13.56MHz were used.

The condition of sputtering was as follows, that is, the high purity AlN sintered compact was used as the target material, the mixed gas of Ar+N₂ was introduced in the mixture ratio ofN₂/Ar=0.4, the pressure inside the chamber was 0.8 Pa, and the electric power was 1000W.

The thin films of each crystallization state of an amorphous state and an orientated polycrystal other than a single crystal were formed directly on the substrates comprising an aluminum nitride-based sintered compact, as they are.

The orientated polycrystalline thin films were formed so that C axis becomes perpendicular to the substrate surface.

All the single-crystal thin films were formed so that C axis becomes perpendicular to the substrate surface.

The half width of the rocking curve of the X ray diffraction from the lattice plane of the Miller Index (002) of the orientated polycrystal AlN thin films first formed on the above substrates comprising an aluminum nitride sintered compact was in the range of 6440 seconds-7190 seconds.

Although the appearance of each thin film formed was observed, faults, such as a crack in the inside of the thin films and an exfoliation between the thin films and the aluminum nitride-based sintered compacts, were not seen.

Although the exfoliation test was carried out using the pressure sensitive adhesive tape, there was no exfoliation between the thin films formed and the sintered compacts comprising aluminum nitride as a main component.

As for the crystallinity of the single-crystal thin films formed, the half width of the rocking curve of the X ray diffraction from the lattice plane of the Miller Index (002) was not more than 100 seconds, altogether.

The commercial bulk-like gallium nitride single crystals with the size of 10 mm x 10 mm x 0.5 mm thickness were prepared as a substrate, besides those.

The crystal C axis of the bulk-like gallium nitride single crystals is the perpendicular direction to the substrate surface, and the surface is polished to the specular surface.

Moreover, the bulk-like aluminum nitride single crystals with the size of 3 mm x 3 mm x 0.5 mm thickness which were produced by the sublimating method were prepared as a substrate, besides those.

The crystal C axis of the bulk-like aluminum nitride single crystals is the perpendicular direction to the substrate surface, and the surface is polished to the specular surface.

In the bulk gallium nitride-based single crystals, and in the bulk aluminum nitride-based single crystals, the content of impurities was few, they comprise GaN and AlN substantially, respectively.

Thus, the refractive indices of the thin films formed on the prepared above thin-film substrates and the bulk single-crystal substrates were measured by the wavelength of 650 nm using the spectrophotometer [product name : FilmTek4000 made by U.S. "SCI (Scientific Computing International) Co"].

Next, to these thin-film substrates and bulk single-crystal substrates, various thin films were formed all over the surface of the substrates in the thickness of 50 nm at the substrate temperature of 250°C using the targets which comprise each material of metal gallium, gallium nitride, gallium oxide, metal indium, indium nitride, indium oxide, metal niobium, niobium nitride, niobium oxide, metal tantalum, tantalum nitride, and tantalum oxide by the RF magnetron sputtering method with the frequency of 13.5MHz and the electric power of 800W.

As the gas for sputtering, pure Ar and the mixed gas of N₂+Ar with the mixture ratio range of N₂/Ar = 0.02-0.80 were introduced, and they were used in the condition where the pressure inside the chamber is 0.9 Pa.

Pure Ar was used in each thin film formation of gallium oxide, indium oxide, niobium oxide, tantalum oxide, metal niobium, and metal tantalum.

In case of forming each thin film of gallium nitride, indium nitride, niobium nitride, and tantalum nitride, the mixed gas was used changing the composition ratio of N₂+Ar suitably.

The target materials comprising metal gallium and metal indium were used for forming the gallium-nitride and indium-nitride thin films by the reaction sputtering, respectively.

In the sputtering thin films obtained like this, patterning was carried out so that they remain as the line with the size of the width of 10 µm x thickness of 50 nm using the lift-off method by optical lithography.

Patterning was carried out so that another portion of the sputtering thin films remains as a line with the size of the width of 1.5 mm x thickness of 50 nm using the same sputtering thin films.

As for the length of the sputtering thin films in which patterning was carried out, it is 25.4 mm in the case of what used the substrates comprising an aluminum nitride-based sintered compact, it is 10 mm in the case of what used the bulk-like gallium nitride single crystals, and it is 3 mm in the case of what used the bulk-like aluminum nitride single crystals.

Next, they were heated at 1500°C in nitrogen atmosphere for 6 hours.

Although the appearance after heating was investigated, faults, such as exfoliation between each thin film and the aluminum nitride-based sintered compacts, were not seen.

Although the appearance of the portion of each thin film in which each component of gallium, indium, niobium, and tantalum was introduced was observed, neither cracks nor exfoliations were seen.

Although the exfoliation test was carried out using the pressure sensitive adhesive tape, there were not exfoliation between the formed thin films and the aluminum nitride-based sintered compacts, and the exfoliations and destructions in the thin film portion in which each component of gallium, indium, niobium, and tantalum was formed.

As for each bulk single crystal after heating, faults on appearance, such as a crack in the portion in which each component of gallium, indium, niobium, and tantalum was introduced, were not seen.

Next, the refractive index of the portion in which the patterning with the width of 1.5 mm was given among the portions in which the sputtering thin films comprising each component of gallium, indium, niobium and tantalum were formed was measured by the light with a wavelength of 650 nm using each sample of the thin-film substrates and the bulk single-crystal substrates after heating.

The refractive index measurement was carried out using the spectrophotometer [product name : FilmTek4000 made by U.S. "SCI (Scientific Computing International) Co"].

As a result, it was confirmed that the refractive index of the thin films and bulk single crystals which carried out the stress relief heat treatment after forming the sputtering thin films having the component of gallium, indium, niobium, and tantalum becomes large than the refractive index of the bulk single crystals and the first produced thin films comprising as a main component at least one selected from gallium nitride, indium nitride and aluminum nitride.

As a result, it is predicted that the component of gallium, indium, niobium and tantalum is diffused and dissolved in the bulk single crystals and the first produced thin films comprising as a main component at least one selected from gallium nitride, indium nitride and aluminum nitride.

In all samples, the amount of increases of the refractive index was in the range of 0.002-0.012, and was not more than 2x10⁻¹.

Therefore, as for the increased amount of the component of gallium and indium and the introduced amount of the niobium and tantalum component in the bulk single crystals and the first produced thin films comprise as a main component at least one selected from gallium nitride, indium nitride and aluminum nitride, it seems that it is at least not more than 20 mol %, and that it is the range of 0.1-5.0 mol % to the main components by the conversion of gallium nitride, indium nitride, niobium nitride and tantalum nitride, respectively.

The domain where the gallium component, the indium component, the niobium component and the tantalum component were introduced to the thin films and bulk single crystals after heating, spreads in the width of 12 µm-18 µm, and it seems that it has achieved to 0.5-10 µm into the depth direction according to the measurement which used the above spectrophotometer "FilmTek4000".

Thus, the thin-film substrates in which each component of gallium, indium, niobium and tantalum was introduced in the belt-like shape into the thin films which comprise as a main component at least one selected from gallium nitride, indium nitride and aluminum nitride and were formed on the substrates comprising an aluminum nitride-based sintered compact were obtained.

The bulk single-crystal substrates in which each component of gallium, indium, niobium and tantalum was introduced respectively in the belt-like shape into the gallium nitride-based bulk single crystals and the aluminum nitride-based bulk single crystals were obtained.

Next, in the portion in which the components of gallium, indium, niobium and tantalum were introduced by the above sputtering thin films to the thin films comprising as a main component at least one selected from gallium nitride, indium nitride and aluminum nitride, and in the portion in which the components of gallium, indium, niobium and tantalum were introduced by the above sputtering thin films to the bulk single crystals into the portion in which the patterning with the width of 10 µm was given to the sputtering thin films before heat treatment, the red light is inputted with the output of 50 mW using the commercial red semiconductor laser of a GaAsP system in which the luminescence wavelength is 650 nm, and the transmission loss was computed by measuring the amount of attenuation of the transmitted output light.

As a result, regardless of the quality of the material and composition of the substrates, there is permeability to the 650nm red light in all the samples, and the transmissiones loss were also not more than 10 dB/cm in all the samples.

When the thin films are a single crystal, the transmission losses were not more than 5 dB/cm altogether.

The transmission losses of the single-crystal thin films formed using the experiment No.269 as a substrate comprising the aluminum nitride-based sintered compact were not more than 3 dB/cm altogether.

The transmission losses of the single-crystal thin films including aluminum nitride not less than 80 mol % were not more than 1 dB/cm altogether.

Also in the bulk single crystals comprising aluminum nitride as a main component, the transmission losses were not more than 1 dB/cm in all samples.

As a result, as for the portions in which the components of gallium, indium, niobium and tantalum were mixed into the thin films which were produced in this invention and comprise as a main component at least one selected from gallium nitride, indium nitride and aluminum nitride, and into the bulk single crystals, it was confirmed that it functions as an embedding type of three dimension optical waveguide.

These results were shown in Table 27.

The values of the transmission loss measured using the light with a wavelength of 650 nm are shown in Table 27.

Next, after confirming the optical transmission by the above red light, the transmission loss in the ultraviolet-light area in the above each three dimension optical waveguide produced in this Example was measured further using the commercial laser light generating equipment which can vary the wavelength.

Measurement wavelength is four kinds of 380 nm, 300 nm, 270 nm and 250 nm.

As a result, in the thin films with many aluminum nitride contents among the thin films formed on the substrates comprising the aluminum nitride-based sintered compact, and in the aluminum nitride-based bulk single crystals, it was confirmed that there is high transmission nature of ultraviolet light.

The thin films with many gallium nitride contents and the bulk single crystals comprising as a main component gallium nitride did not show the transmission nature of light with the wavelength shorter than 380 nm, but the most thin films with many aluminum nitride contents and the bulk single crystals comprising as a main component aluminum nitride showed the high transmission nature of ultraviolet light.

That is, in the thin films formed on the substrates comprising the aluminum nitride-based sintered compact, the thin films including aluminum nitride not less than 50 mol % can transmit the ultraviolet light with the wavelength of up to 300 nm at least, and the transmission loss was not more than 10 dB/cm.

In the thin films formed on the substrates comprising the aluminum nitride-based sintered compact, the thin films including aluminum nitride not less than 90 mol % can transmit the ultraviolet light with the wavelength of up to 270 nm at least, and the transmission loss was not more than 10 dB/cm.

In the thin films of 2 components composition comprising aluminum nitride as a main component and containing gallium nitride further among the thin films formed on the substrates which comprise the aluminum nitride-based sintered compact, the thin films including aluminum nitride not less than 50 mol % can transmit the ultraviolet light with the wavelength of up to 300 nm at least, and the transmission loss was not more than 10 dB/cm.

When the above thin films are a single crystal, the transmission losses are at least not more than 5 dB/cm, and in the case of the optical waveguides formed in the single-crystal thin-film substrates which include aluminum nitride 50 mol % and were produced in the experiment No.590 of this Example, it was 2.4dB/cm and was not more than 3 dB/cm.

What includes aluminum nitride not less than 80 mol % can transmit the ultraviolet light with the wavelength of up to 270 nm at least, and the transmission loss was not more than 10 dB/cm.

When the above thin films are a single crystal, the transmission losses are at least not more than 5 dB/cm, and in the case of the thin-film substrate in which the single-crystal thin film which includes aluminum nitride 80 mol % was formed and which was produced in the experiment No.589 of this Example, the transmission loss of light with a wavelength of 270 nm was 0.9dB/cm and was not more than 3 dB/cm.

Those including aluminum nitride not less than 90 mol % can transmit the ultraviolet light with the wavelength of up to 250 nm at least, and the transmission losses were not more than 10 dB/cm.

When the above thin films are a single crystal, the transmission losses are at least not more than 5 dB/cm, and also in the case of the thin-film substrates in which the single-crystal thin film which includes aluminum nitride 90 mol % was formed and which were produced in the experiment No.588 and experiment No.601 of this Example, the transmission losses of light with a wavelength of 250 nm were 2.5dB/cm, 2.6 dB/cm, respectively and were not more than 3 dB/cm.

Thus, as for the thin-film substrates in which an optical waveguide comprises the thin films which comprise as a main component at least one selected from gallium nitride, indium nitride and aluminum nitride and were formed on the aluminum nitride-based sintered compact of this invention, it was confirmed that it has high transmission nature of ultraviolet light.

It was confirmed that those containing at least one selected from niobium and tantalum in the thin films or bulk single crystals which comprise as a main component at least one selected from gallium nitride and aluminum nitride can be used as an optical waveguide.

It was confirmed simultaneously that the bulk single crystals comprising as a main component at least one selected from gallium nitride and aluminum nitride can be used as an optical waveguide.

Among them, it was confirmed that the bulk single crystals comprising as a main component aluminum nitride can transmit the ultraviolet light.

These results were shown in Table 28.

The values of the transmission losses measured using the light of the wavelength of 380 nm, 300 nm, 270 nm, and 250 nm are shown in Table 28.

### (Comparative example)

The commercial sapphire substrate having the lattice plane of the Miller Index (002) was prepared.

To the sapphire substrate, specular surface polish was carried out, and the average surface roughness Ra is 1.2 nm.

Some sapphire substrates are in the as gotten surface state, and the 100 mol % AlN orientated polycrystalline thin films were formed in some sapphire substrates on the same conditions as this Example.

100 mol % AlN single-crystal thin films were formed in these substrates by the same MOCVD method as this Example after that, and the gallium oxide thin films were formed on these by the RF sputtering method, patterning of the sputtering thin films was carried out so that they become the line shape with the size wherein the width is 10 µm and the thickness is 50 nm, using the lift-off method by the optical lithography, they were heat-treated at 1500°C in nitrogen atmosphere, and the optical waveguides were produced.

Next, although the transmission losses ofthe optical waveguides were measured by the same method as this Example, they were larger than 10 dB/cm in all the cases of the wavelength of 650 nm, 380 nm, 300 nm, 270 nm, and 250 nm.

Thus, in this invention, when the thin films which comprise as a main component at least one selected from gallium nitride, indium nitride and aluminum nitride and were formed on the aluminum nitride-based sintered compact were used as an optical waveguide, it was confirmed that those with low transmission loss which is at least equivalent or less are producible, compared with the optical waveguide produced using each above bulk single crystal.

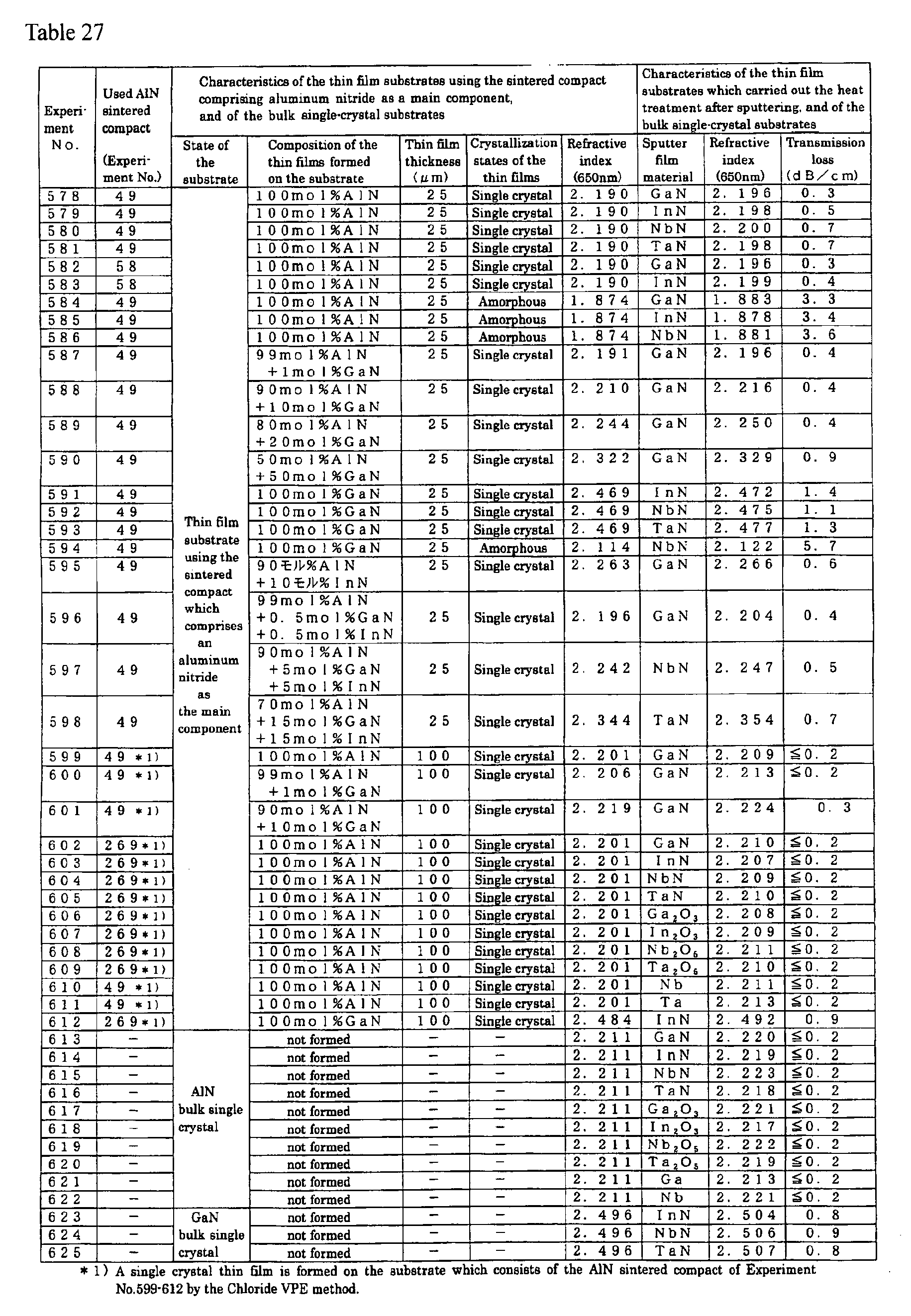

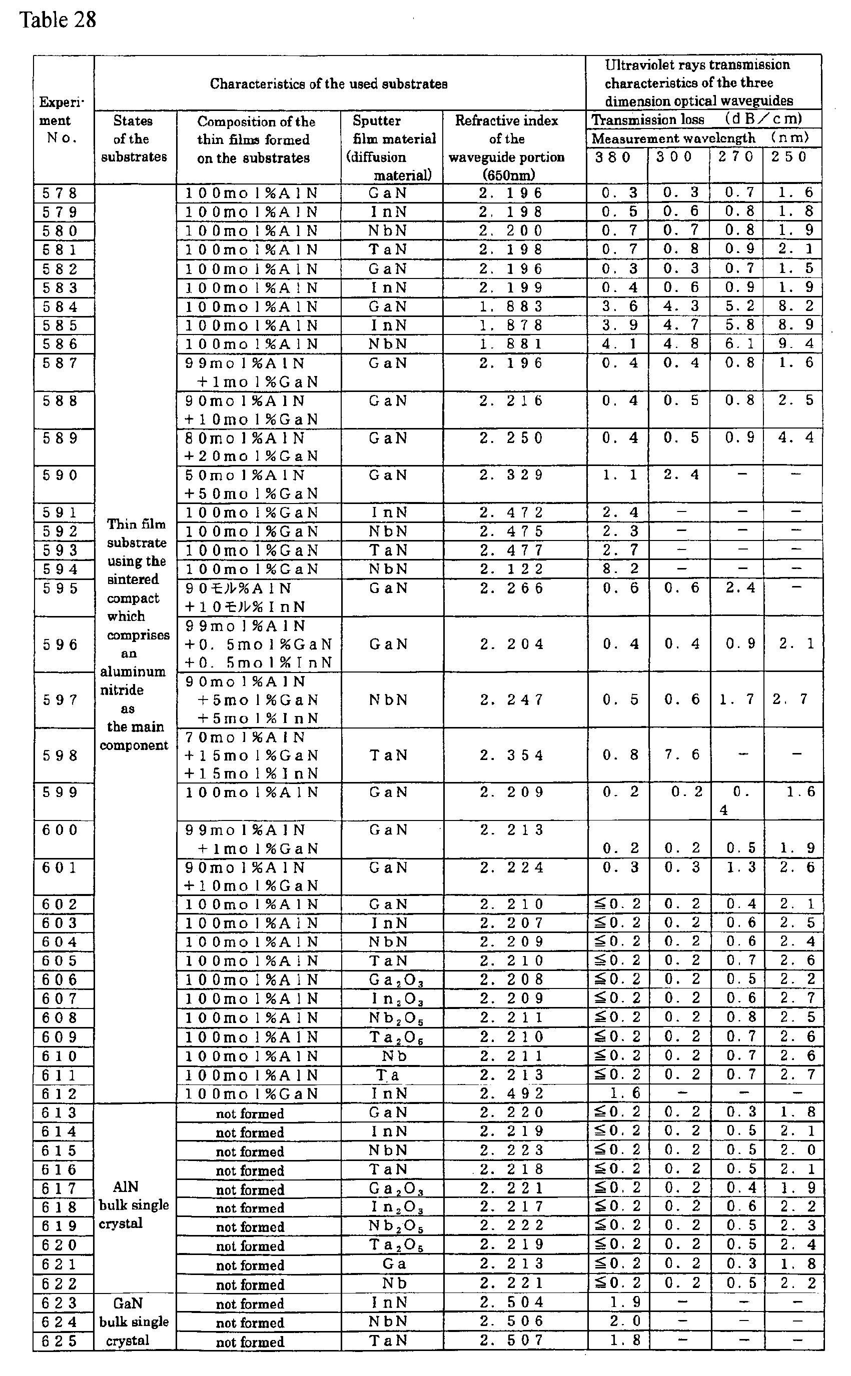

### Example 23

Like Example 22, the aluminum nitride-based sintered compacts produced in the experiment No.49 of Example 2 were processed into the shape of a substrate with the size wherein the diameter is 25.4 mm and the thickness is 0.5 mm, and those in which the specular surface polish was carried out further were prepared.

Next, the thin-film substrates forming the single-crystal thin film comprising 100 mol % aluminum nitride substantially in the thickness of 25 µm by the same MOCVD method as Example 22 were produced.

The refractive index of the single-crystal thin film formed on the thin-film substrates was 2.19017 to the light with a wavelength of 605 nm.

Next, like Example 22, each thin film of gallium nitride, indium nitride, niobium nitride and tantalum nitride was formed on all over the surface of the above thin-film substrates, changing the thickness of 1.0-1000 nm, by the magnetron sputtering at room temperature.

In the sputtering thin films obtained like this, patterning was carried out so that they remain as the line with the size wherein the width is 10 µm and the length is 25.4 mm, using the lift-off method by optical lithography.

Using the same sputtering thin films, patterning was carried out so that another portions of the sputtering thin films remain as the line, wherein the width is 1.5 mm and the length is 25.4 mm.

They were heated at 1500°C in nitrogen atmosphere for 6 hours after that.

Although the appearance after heating was investigated, faults, such as exfoliations between each thin film and the aluminum nitride-based sintered compacts, were not seen.

Although the appearance of the portions in which each component of gallium, indium, niobium and tantalum was formed in each thin film was observed, neither cracks nor exfoliations were seen.

Although the exfoliation test was carried out using the pressure sensitive adhesive tape, there were not exfoliations between the formed thin films and the aluminum nitride-based sintered compacts, and the exfoliations and destructions in the thin film portion in which each component of gallium, indium, niobium and tantalum was formed.

Next, using each sample of the thin-film substrates after heating, among the portions in which the sputtering thin films comprising each component of gallium, indium, niobium and tantalum were formed, the refractive index of the portion in which patterning was given to the sputtering thin films before heated in the width of 1.5 mm x length of 25.4 mm was measured by the light having a wavelength of 650 nm by the same spectrophotometer as what was used in Example 21 and Example 22.

As a result, it was confirmed that the refractive index of the thin films heat-treated after forming the sputtering thin films having the components of gallium, indium, niobium and tantalum becomes large than the refractive index of the aluminum nitride single-crystal thin film which was first produced and comprises the composition of 100 mol % substantially.

It was also confirmed that the refractive index becomes large according as the formation thickness of each sputtering material of gallium, indium, niobium and tantalum becomes thick.

It seems that this result will have suggested that the components of gallium, indium, niobium and tantalum are diffused and introduced in the aluminum nitride single-crystal thin film which was first produced and comprises the composition of 100 mol % substantially, and that the composition is changed if the consideration is carried out referring to the thin film compositions investigated in Example 21 and the change of the refractive index accompanying it.

In the sample in which the gallium component was diffused and introduced, the amount of change of the refractive index is the range of 4x10⁻⁵ to 8.4x10⁻², and it seems that the content of the gallium component is in the range of 0.01-40 mol % on the basis of gallium nitride.

In the sample in which the indium component was diffused and introduced, the amount of change of the refractive index is the range of 6x10⁻⁵ to 9.4x10⁻², and it seems that the content of the indium component is in the range of 0.01-20 mol % on the basis of indium nitride.

In the sample in which the niobium component was diffused and introduced, the amount of change of the refractive index is the range of 9 x 10⁻⁵ to 1.1 x 10⁻¹, and it seems that the content of the niobium component is in the range of 0.01-20 mol % on the basis of niobium nitride.

In the sample in which the tantalum component was diffused and introduced, the amount of change of the refractive index is the range of 7 x 10⁻⁵ to 1.1 x 10⁻¹, and it seems that the content of the tantalum component is in the range of 0.01-20 mol % on the basis of tantalum nitride.

Thus, in all samples, the amount of increases of the refractive index is in the range of 1x10⁻⁵ to 2x10⁻¹, it seems that the components which comprise at least one selected from gallium, indium, niobium and tantalum are introduced in the above quantity into the inside of the aluminum nitride single-crystal thin film which was first produced and comprises the composition of 100 mol % substantially.

Next, using the commercial laser light generating equipment which can vary the wavelength, the light with the wavelength of 650 nm, 380 nm, 300 nm, and 250 nm was inputted into the portion in which patterning was given to the sputtering thin films before heated in the width of 10 µm x length of 25.4 mm among the above portions in which the components of gallium, indium, niobium and tantalum were mixed in the single-crystal thin film comprising aluminum nitride as amain component by the sputtering thin film, the transmission losses were computed after having measured the amount of attenuation of the transmitted output lights.

As a result, it was penetrable to incidence light in all samples, and the transmission losses were also not more than 3 dB/cm in all samples.

As a result, as for the portions in which the components of gallium, indium, niobium and tantalum were mixed into the aluminum nitride single-crystal thin films which were produced in this Example and comprise the composition of 100 mol % substantially, it was confirmed that it functions as an embedding type of three dimension optical waveguide which can transmit ultraviolet light and visible light.

These results were shown in Table 29.

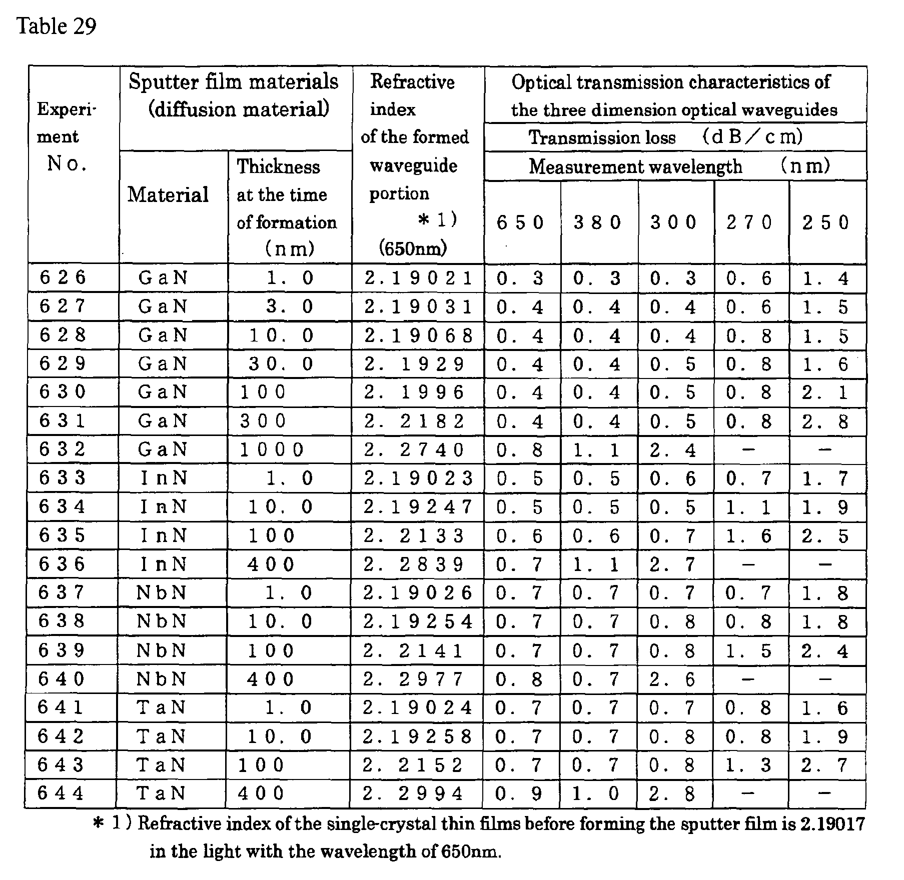

### Example 24

The substrates comprising the sintered compacts of the experiment No.49, experiment No.58, and experiment No.269 which comprise aluminum nitride as a main component and were used in Example 21 and Example 22 were prepared.

To all these substrates, the orientated polycrystalline thin films comprising aluminum nitride of 100 mol % composition substantially were formed in the thickness of 6 µm by the RF sputtering method under the condition where the substrate temperature is 280°C, an aluminum nitride-based sintered compact is used as the target material, the frequency is 13.56MHz, and the electric power is 1000W.

In the orientated polycrystalline thin films, C axis was formed in perpendicular direction to the substrate surface, and the half width of the rocking curve of the X ray diffraction from the lattice plane of the Miller Index (002) was in the range of 6360-7150 seconds.

The refractive index was 1.937-1.973.

Next, the thin-film substrates in which the single-crystal thin films of various composition which comprise as a main component at least one selected from gallium nitride, indium nitride and aluminum nitride and contain the components of niobium and tantalum suitably were formed in the thickness of 2 µm on the orientated polycrystalline thin films by the same MOCVD method as Example 21 were produced.

The single-crystal thin films were formed so that the crystal C axis becomes perpendicular to the substrate surface.

The above polycrystalline thin films were not formed on the substrates which were used in the experiment No.669-673 and comprise the aluminum nitride-based sintered compact, but the single-crystal thin films were formed directly on these sintered compacts by the MOCVD method.

Although the appearance after single-crystal thin film formation was investigated, faults, such as exfoliations between each orientated polycrystalline thin film, single-crystal thin film, and the aluminum nitride-based sintered compacts, were not seen.

And, faults, such as exfoliations between each polycrystalline thin film and the single-crystal thin films, were not seen.

Although the exfoliation test was carried out using the pressure sensitive adhesive tape, there were not exfoliations between each polycrystalline thin film, single-crystal thin film, and the aluminum nitride-based sintered compacts, and exfoliations or destructions between each polycrystalline thin film and the single-crystal thin films.

All the refractive indices of the above single-crystal thin films obtained like this were not less than 2.16, and were almost the same as the values measured in Examples 21-23 in those in which the composition is same as Example 21, regardless of the difference of the substrates comprising an aluminum nitride-based sintered compact.

The produced thin-film substrates have the form in which the single-crystal thin films formed may function as a two dimension optical waveguide as shown in Fig. 21 and Fig. 23.

Next, dry type etching was carried out only on the single-crystal thin films portion by the ion milling using some thin-film substrates produced, and they were processed in the shape of a straight line with the width of 10 µm.

The thin-film substrates have the form in which the single-crystal thin films obtained by processing may function as a three dimension optical waveguide as shown in Fig. 24 and Fig. 25.

Next, the light with the wavelength of 650 nm, 300 nm, and 250 nm was inputted into the portion of the two dimension optical waveguide and three dimension optical waveguide of the thin-film substrates produced like the above using the commercial laser light generating equipment which can vary the wavelength, and the transmission losses were computed after having measured the amount of attenuation of the transmitted output light.

As a result, it was penetrable to incidence light in all samples, and the transmission losses were also not more than 10 dB/cm in all samples.

As a result, as for the portions in which the components of gallium, indium, niobium and tantalum were mixed into the aluminum nitride single-crystal thin films which were produced in this Example and comprise the composition of 100 mol % substantially, it was confirmed that they function as an embedding type of the two dimension optical waveguide and three dimension optical waveguide which can transmit ultraviolet light and visible light.

The characteristics as an optical waveguide do not depend on the difference of the substrates comprising the aluminum nitride-based sintered compacts.

Even if they are the single-crystal thin films which were formed directly on the aluminum nitride-based sintered compacts, it was confirmed that they function enough as an optical waveguide which can transmit ultraviolet light and visible light.

These results were shown in Table 30.

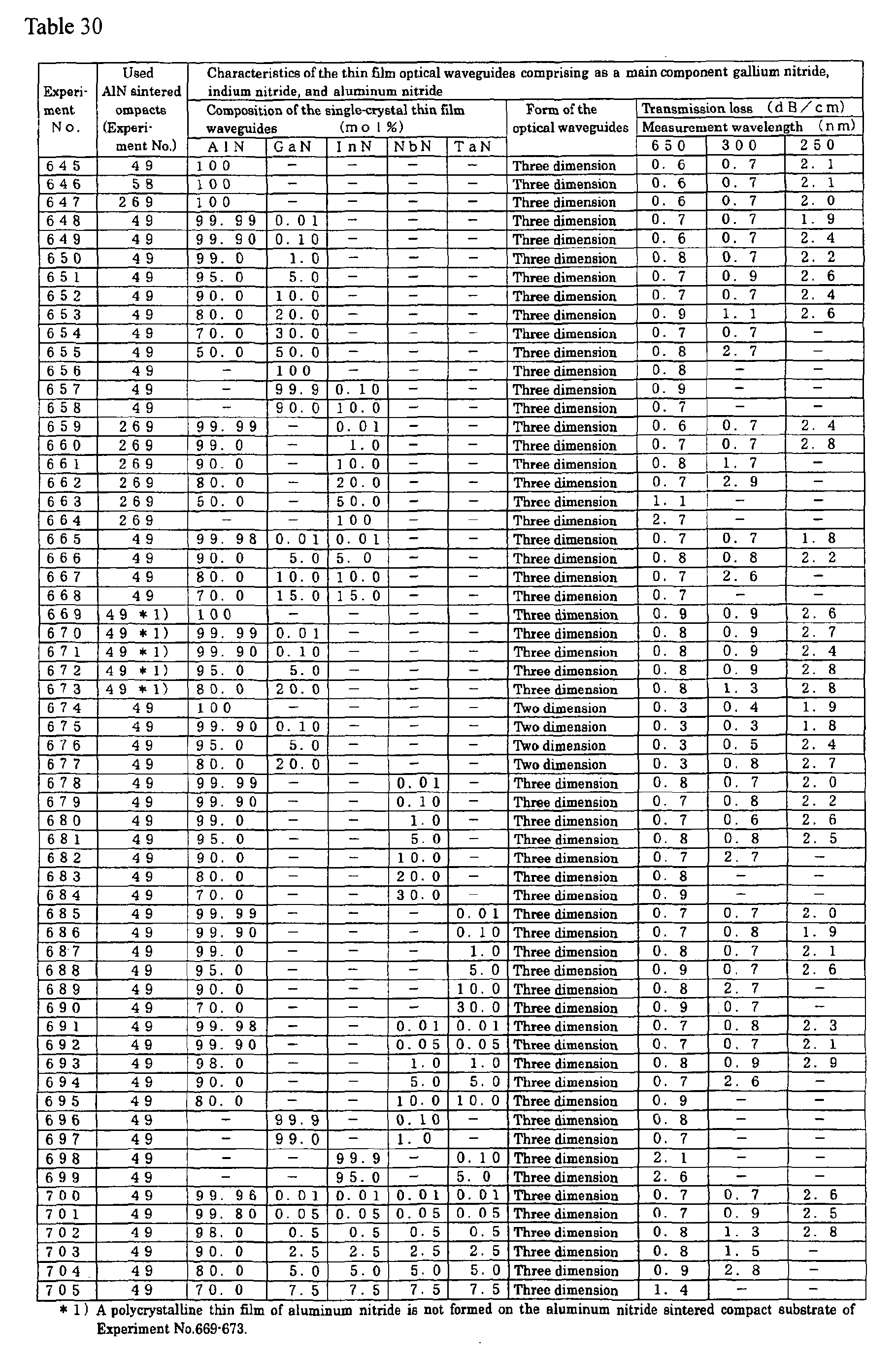

### Example 25

This Example shows the examples of the multilayer thin film in which a single-crystal thin film comprising as a main component at least one selected from gallium nitride, indium nitride and aluminum nitride was formed furthermore on the thin films after forming beforehand a single-crystal thin film, an amorphous thin film, a polycrystalline thin film, and an orientated polycrystalline thin film comprising as a main component at least one selected from gallium nitride, indium nitride and aluminum nitride onto it by the method of not only the MOCVD but also the sputtering and ion-plating method using the sintered compacts comprising aluminum nitride as a main component, as a substrate.

This Example also shows the effects in which the thin films formed beforehand on the substrates comprising as a main component aluminum nitride affect the crystallinity of the single-crystal thin films formed furthermore on them.

In addition, the aluminum nitride-based sintered compacts used as a substrate also include what has a conduction via.

As the sintered compacts comprising aluminum nitride as a main component, those containing the sintering-aids component and having comparatively many contents of an AlN component were used.

First, among the sintered compacts comprising aluminum nitride as a main component, as what does not have a conduction via, here prepared those which were produced in the experiment No. 49 and 58 of Example 2 and the experiment No. 259, 261, 266, and 269 of Example 11 and which carried out ultrasonic washing with acetone and IPA after immersing into fluoro-nitric acid (50%HF+50%HNO₃) at room temperature after carrying out mirror-surface polish by the same method as Example 8, as a substrate.

As for the surface roughness Ra of the substrates without conduction vias, it was 26 nm in the case of the experiment No.49, 28 nm in the case of the experiment No.58, and 30 nm in the case of the experiment No.259, 261, 266, and 269.

As those having conduction vias, those which were produced in the experiment No. 80 and 83 of Example 3 were prepared as a substrate, and those were mirror-polished by the same method as Example 8 and washed with methylene chloride.

The surface roughness Ra was 26 nm in the case of the experiment No.80 and the experiment No.83, and 30 nm in the case of the experiment No.304.

Using that containing Er₂O₃ powder 4.02 volume % as that having conduction vias among the green sheets produced in Example 3, the through hole of 50 µm was punched in the green sheets, and they were filled up with what contains AlN 5.0 % by weight among the conduction via pastes comprising tungsten as a main component, normal-pressure sintering was carried out at 1820°C for 2 hours like Example 3, they are made into the same size as Example 3 by grinding and mirror-polishing, conduction vias were exposed, and those which were washed with methylene chloride were prepared as a substrate.

The surface roughness Ra of the substrates having the conduction vias was 32 nm.

First, the thin films comprising as a main component at least one selected from gallium nitride, indium nitride and aluminum nitride and having various crystallization states, such as a single-crystal thin film, an amorphous thin film, a polycrystalline thin film, and an orientated polycrystalline thin film, were formed on each substrate prepared by the MOCVD method, the sputtering method, and the ion-plating method.

When the thin film formation was carried out by the MOCVD method, the same raw materials and thin film formation conditions as Examples 1, 10, 12 and 17 were used.

When thin film formation is carried out by the sputtering method, examination of thin film formation was carried out by the high frequency (RF) magnetron sputtering method with a frequency of 13.56MHz, using the metal aluminum, AlN sintered compact, and AlN sintered compact containing 0.02-mol % Si component as the target material, under the condition where the mixed gas of Ar+N₂ of very small quantity was introduced in the mixture ratio of N₂/Ar=0.02-1.0, the pressure inside the chamber was 0.1-1.5Pa, and the electric power was 400-1500W. As for the substrate temperature, it was carried out in the range of room temperature-600°C.

When thin film formation is carried out by the ion-plating method, examination of thin film formation was carried out by the reaction nitriding of metal vapor, melting the Al metal used for the raw material for thin film formation under the condition where very-small-quantity N₂ gas was introduced in the decompression chamber and ionized on the ionization voltage of 20V-150V, and the applied voltage to the substrate was 500V-2000V. As for the substrate temperature, it was carried out in the range of room temperature-600°C.

As mentioned above, the crystallization states were investigated by X ray diffraction about the thin films which were formed directly on the substrates comprising an aluminum nitride-based sintered compact, and the electric resistivity at room temperature and the half width of the rocking curve of a lattice plane (002) were measured further about the thin films produced.

The result is shown in Tables 31-34.

Next, in the substrates comprising an aluminum nitride-based sintered compact forming the thin films with the above various crystallization states, formation of the single-crystal thin films comprising as a main component at least one selected from gallium nitride, indium nitride and aluminum nitride was tried by the MOCVD method using the same raw materials and thin film formation conditions as what was shown in Example 1, Example 2, and Example 10, and by the Chloride VPE method using the same raw materials and the thin film formation conditions as what was shown in Example 9.

The crystallization states were investigated by X ray diffraction about each single-crystal thin film formed, and the electric resistivity at room temperature and the half width of the rocking curve of the lattice plane of the Miller Index (002) were measured further about the thin films produced.

The result is also shown in Tables 31-34.

Table 31 and 32 are the experimental result about the thin films which do not contain the doping components, and Table 33 and 34 are the experimental result about the thin films containing the doping components.

As for the characteristics of the AlN thin films formed in the thickness of 3 µm directly on the substrates comprising the aluminum nitride-based sintered compact, they are shown in the experiment No.706-709 of Table 31.

The thin film of the experiment No.706 is what was produced by the sputtering method under the condition where the substrate temperature was room temperature, the mixed gas of Ar+N₂ was introduced in the mixture ratio of N₂/Ar=0.6, the pressure inside the chamber was 0.5Pa, and the electric power was 500W.

The thin film of the experiment No.707 is what was produced by the sputtering method under the condition where the substrate temperature was 250°C, the mixed gas of Ar+N₂ was introduced in the mixture ratio of N₂/Ar=0.3, the pressure inside the chamber was 0.6Pa, and the electric power was 800W.

The thin film of the experiment No.708 is what was produced by the sputtering method under the condition where the substrate temperature was 280°C, the mixed gas of Ar+N₂ was introduced in the mixture ratio of N₂/Ar=0.4, the pressure inside the chamber was 0.8Pa, and the electric power was 1000W.

In the sputtering of the experiment No.706-708, the high purity AlN sintered compact was used for the target material.

The thin film of the experiment No.709 was produced by the MOCVD method of the same conditions as Example 1 using trimethyl aluminum as a raw material.

Although the crystallinity judgment of these thin films was carried out by X ray diffraction, as described in Table 31, it was amorphous in the case of the experiment No.706, it was polycrystal in the case of the experiment No.707, it was orientated polycrystal in the case of the experiment No.708, and it was single crystal in the case of the experiment No.709, respectively, as the crystallization state.

As for the polycrystal of the experiment No.707, the diffraction line appeared only from the lattice plane of the Miller Index (002), (101), and (102).

In all thin films produced in the experiment No.708 and 709, C axis was formed in the perpendicular direction to the substrate surface.

The half width of the rocking curve of the X ray diffraction from the lattice plane of the Miller Index (002) of the thin films of the experiment No.708 and 709 was 7910 seconds and 187 seconds, respectively, the difference in crystallinity was clearly observed even if the growth direction of a crystal of the orientated polycrystalline thin film and the single-crystal thin film was the same.

The appearance of the above thin films produced in the experiment No.706-709 was investigated, and, defects, such as a crack and a crevice, are not seen in all.

Though the exfoliation test was carried out using the pressure sensitive adhesive tape, in all the thin films, exfoliations were not seen between the thin films, and the substrates comprising an aluminum nitride-based sintered compact.

The thin film-conductive material of Ti/Pt/Au was formed on the surface of the thin films produced in the experiment No.706-709, the metal leads were soldered and perpendicular tensile strength was investigated, and it all is not less than 2 kg/mm², so the sintered compacts comprising aluminum nitride as a main component, and the thin films were integrally adhered.

Using the substrates wherein the AlN amorphous thin film, AlN polycrystalline thin film, and AlN orientated polycrystalline thin film which were produced by the sputtering method under the same conditions as the experiment No.706, 707, and 708 were formed in the thickness of 3 µm, respectively, and using the substrate wherein the single-crystal thin film is formed beforehand in the thickness of 3 µm and was produced in the experiment No.709, AlN thin films were formed further on them in the thickness of 3 µm, respectively, by the MOCVD method under the same condition as above-mentioned experiment No.709 of this Example, the characteristics are shown in the experiment No.710-713 in Table 31.

As a result of X ray diffraction, these thin films are clearly the single crystal formed in the direction where C axis is perpendicular to the substrate surface.

As for the crystallinity of the single-crystal thin films which comprise AlN as a main component and were produced in the experiment No.710, 711, 712, and 713, the half width of the rocking curve of the X ray diffraction from the lattice plane of the Miller Index (002) is 89 seconds, 93 seconds, 79 seconds, and 105 seconds, respectively, and it is clearly superior to 187 seconds in which the AlN single-crystal thin film of the experiment No.709 produced by the MOCVD method of the same conditions has.

Thus, using the substrates comprising an aluminum nitride-based sintered compact and forming beforehand AlN thin films of an amorphous state, a polycrystal, an orientated polycrystal, and a single crystal, the aluminum nitride-based single-crystal thin films may be formed on it. It was confirmed that the crystallinity improves than the single-crystal thin films formed directly on the substrates which comprise an aluminum nitride-based sintered compact.

In the experiment No.710-712, when the substrates in which the thin films formed beforehand are an amorphous state, a polycrystal, and an orientated polycrystal are used, it is shown that the half width of the rocking curve of the X ray diffraction from the lattice plane of the Miller Index (002) of the AlN single-crystal thin films formed on them is not more than 100 seconds, the crystallinity of the single-crystal thin films was superior to the crystallinity of the single-crystal thin film formed on the substrate in which the thin film formed beforehand on the substrate is a single crystal, as shown in the experiment No.713.

Although the appearance of the above-mentioned thin films produced in the experiment No.710-713 was investigated, defects, such as a crack and a crevice, are not seen altogether.

Although the exfoliation test was carried out using the pressure sensitive adhesive tape, in all the thin films, exfoliations were not seen between the thin films and the aluminum nitride-based sintered compacts, or between the thin films.

And, the thin film-conductive material of Ti/Pt/Au was formed on the surface of the thin films produced in the experiment No.710-713, the metal leads were soldered and the perpendicular tensile strength was investigated, it all is not less than 2 Kg/mm², so each above-mentioned thin film adheres integrally to the aluminum nitride-based sintered compacts, or the thin film adheres integrally each other.

The characteristics of the GaN thin film and InN thin film which are formed directly on the substrate comprising an aluminum nitride-based sintered compact in the thickness of 3 µm, are shown in the experiment No.714-715 of Table 31.

These thin films are produced by the MOCVD method under the same conditions as Example 1 using trimethyl gallium and trimethyl indium as a raw material.

As for these obtained thin films, it was confirmed that these are clearly a single crystal in which C axis was formed in the perpendicular direction to the substrate surface altogether by X ray diffraction.

As for the half width of the rocking curve of the X ray diffraction from the lattice plane of the Miller Index (002) of these single-crystal thin films, it was 179 seconds in the case of GaN, and was 190 seconds in the case of InN, respectively.

Using the substrates in which the AlN orientated polycrystalline thin films produced under the same sputtering conditions as the experiment No.708 were formed in the thickness of 3 µm, GaN and InN thin film were formed further on them in the thickness of 3 µm by the MOCVD method under the same conditions as this Example, the characteristics are shown in the experiment No.716 and 717.

As a result of X ray diffraction, each thin film of the GaN and InN is clearly the single crystal formed in the direction where C axis is perpendicular to the substrate surface.

The half width of the rocking curve of the X ray diffraction from the lattice plane of the Miller Index (002) of these single-crystal thin films which comprise GaN and InN as a main component and are formed on the substrates in which the orientated polycrystalline thin film is formed beforehand is 89 seconds and 87 seconds, respectively, it is not more than 100 seconds, they were clearly superior to 179 seconds of the GaN single-crystal thin film of the experiment No.714 and 190 seconds of the InN single-crystal thin film of the experiment No.715.

Using the substrates in which an AlN amorphous thin film, a polycrystalline thin film, and a single-crystal thin film which were formed under the same conditions as the experiment No.706, 707, and 709 were formed beforehand respectively in the thickness of 3 µm, the GaN thin films were formed further on them in the thickness of 3 µm by the MOCVD method under the same conditions as this Example, the characteristics are shown in the Experiment No.718, 719, and 720.

These GaN thin films are clearly the single crystals formed in the direction where C axis is perpendicular to the substrate surface.

The half width of the rocking curve of the X ray diffraction from the lattice plane of the Miller Index (002) of the GaN single-crystal thin films formed on the substrates in which the thin film is formed beforehand is 90 seconds, 92 seconds, and 107 seconds, respectively, it was clearly superior to 179 seconds of the GaN single-crystal thin film of the experiment No.714 produced by the MOCVD method of the same conditions.

As shown in the experiment No.716, 718 and 719, when the substrates in which the thin films formed beforehand on the substrate are an amorphous state, a polycrystal, and an orientated polycrystal are used, the half width of the rocking curve of the X ray diffraction from the lattice plane of the Miller Index (002) of the GaN single-crystal thin films formed on them is not more than 100 seconds, the crystallinity of the GaN single-crystal thin films was superior to the crystallinity of the GaN single-crystal thin film formed on the substrate in which the single crystal is formed beforehand, as shown in the experiment No.720.

Thus, if forming the single-crystal thin films which comprise GaN and InN as a main component using the substrates in which the orientated polycrystalline thin film is formed beforehand, it was confirmed that the single-crystal thin films having the better crystallinity than those formed directly on the substrates which comprise an aluminum nitride-based sintered compact are producible, besides the single-crystal thin films comprising as a main component AlN.

Although the appearance of the above-mentioned thin films produced in the experiment No.714-720 was investigated, defects, such as a crack and a crevice, are not seen altogether.

Although the exfoliation test was carried out using the pressure sensitive adhesive tape, in all the thin films, exfoliations were not seen between the thin films and the aluminum nitride-based sintered compacts, or between the thin films.

And, the thin film-conductive material of Ti/Pt/Au was formed on the surface of the thin films produced in the experiment No.714-720, the metal leads were soldered and the perpendicular tensile strength was investigated, it all is not less than 2 Kg/mm², so each above-mentioned thin film adheres integrally to the aluminum nitride-based sintered compacts, or the thin film adheres integrally each other.

In the experiment No.721 and 722 of Table 31, the characteristics of the 100 mol % AlN thin films formed directly on the substrates comprising an aluminum nitride-based sintered compact in the thickness of 3 µm are shown.

Each thin film is formed by the MOCVD method and the ion-plating method.

Except making the substrate temperature into 480°C by the MOCVD method, the AlN thin film shown in the experiment No.721 was produced using the same raw materials and thin film formation conditions as Example 1 and Example 12.

The AlN thin film shown in the experiment No.722 was produced by the ion-plating method under the condition, wherein the substrate temperature is 250°C, metal aluminum was used for a raw material, N₂ gas was flowing in the rate of 40 cc/min., the ionization voltage was 40 volts, and the applied voltage to the substrate was 1000 volts.

Among the AlN thin films obtained, that of the experiment No.721 is the orientated polycrystal in which C axis was formed in the perpendicular direction to the substrate surface, and the half width of the rocking curve of the X ray diffraction from the lattice plane of the Miller Index (002) was 4670 seconds, so the crystallinity was superior to the thin films by the sputtering method.

That of the experiment No.722 was the polycrystal in which the diffraction peak from the Miller Index (100) and (002) appeared.

Using the substrates in which the AlN orientated polycrystalline thin film and the AlN polycrystalline thin film were formed beforehand in the same conditions as the above-mentioned MOCVD method and ion-plating method, the AlN thin films were formed further on them in the thickness of 3 µm respectively by the MOCVD method of the same conditions as Example 1, the characteristics are shown in the experiment No.723 and 724.

As a result of X ray diffraction, these thin films formed after are clearly the single crystal formed in the direction where C axis is perpendicular to the substrate surface.

The crystallinity of the AlN single-crystal thin films of the experiment No.723 and 724 is clearly superior to the AlN single-crystal thin film of the experiment No.709, if single-crystal thin films are formed on the substrates in which the polycrystalline thin film and the orientated polycrystalline thin film are formed beforehand, it was confirmed that the single-crystal thin films excellent in crystallinity are easy to be obtained compared with the thin films formed directly on the substrates comprising an aluminum nitride-based sintered compact.

Even if the polycrystalline thin film and orientated polycrystalline thin film which are formed beforehand are formed by the ion-plating method and the MOCVD method, etc. besides the sputtering method, it was confirmed that the single-crystal thin films excellent in crystallinity are producible on them.

Although the appearance of the above-mentioned thin films produced in the experiment No.721-724 was investigated, defects, such as a crack and a crevice, are not seen altogether.

Although the exfoliation test was carried out using the pressure sensitive adhesive tape, in all the thin films, exfoliations were not seen between the thin films and the aluminum nitride-based sintered compacts, or between the thin films.

And, the thin film-conductive material of Ti/Pt/Au was formed on the surface of the thin films produced in the experiment No.721-724, the metal leads were soldered and the perpendicular tensile strength was investigated, it all is not less than 2 Kg/mm², so each above-mentioned thin film adheres integrally to the aluminum nitride-based sintered compacts, or the thin film adheres integrally each other.

In the experiment No.725 of Table 31, the characteristics of the AlN thin film formed directly in the thickness of 3 µm on the substrate comprising an aluminum nitride-based sintered compact, are shown.

This AlN thin film which used aluminium chloride as a raw material, and was produced by the Chloride VPE method under the same conditions as Example 9.

As for this thin film, it was confirmed that C axis is perpendicularly formed to the substrate surface by X ray diffraction, and that it is a single crystal.

The half width of the rocking curve of the X ray diffraction from the lattice plane of the Miller Index (002) of this single-crystal thin film was 177 seconds.

In the experiment No.726 and 727, using the substrates in which the AlN amorphous thin film and the AlN orientated polycrystalline thin film which were produced by the same sputtering conditions as the experiment No.706 and the experiment No.708 were respectively formed beforehand in the thickness of 3 µm, the characteristics of the AlN thin films formed furthermore on them in the thickness of 3 µm by the Chloride VPE method under the same conditions as the above-mentioned experiment No.725 are shown.

The thin films are clearly the single crystal formed in the direction where C axis is perpendicular to the substrate surface as a result of X ray diffraction.

The half width of the rocking curve of the X ray diffraction from the lattice plane of the Miller Index (002) of the AlN single-crystal thin films formed on the substrates on which the AlN amorphous thin film and the AlN orientated polycrystalline thin film were formed beforehand is 91 seconds and 86 seconds, respectively, and it was clearly superior to 177 seconds of the AlN single-crystal thin film of the experiment No. 725 produced by the Chloride VPE method of the same conditions.

Thus, also in the single-crystal thin films produced not only by the MOCVD method but also by the Chloride VPE method, it was confirmed that the single-crystal thin films which are excellent in crystallinity than those formed directly on the substrates comprising an aluminum nitride-based sintered compact are producible, if forming on them using the substrates on which the amorphous thin film and the orientated polycrystalline thin film were formed beforehand.

Although the appearance of the above-mentioned thin film produced in the experiment No.725 was investigated, defects, such as a crack and a crevice, are not seen.

Although the exfoliation test was carried out using the pressure sensitive adhesive tape, exfoliations were not seen between it and the substrate comprising the aluminum nitride-based sintered compact.

Although the appearance of the above-mentioned thin films produced in the experiment No.726 and 727 was investigated, defects, such as a crack and a crevice, are not seen in all.

And, although the exfoliation test was carried out using the pressure sensitive adhesive tape, in all the thin films, exfoliations were not seen between them and the substrates comprising an aluminum nitride-based sintered compact, or between the thin films.

Although perpendicular tensile strength was investigated by soldering the metal leads after the thin film-conductive material of Ti/Pt/Au was formed on the surface of the thin films which were produced in the above-mentioned experiment No.725-727 and were produced using the Chloride VPE method, it all is not less than 2 Kg/mm2, so the aluminum nitride-based sintered compacts, and each above-mentioned thin film are joined firmly, or there is firm junction between each thin film.

In the experiment No.728-731 of Table 31, the characteristics of the 100 mol % GaN thin films and the 100 mol % InN thin film which were formed directly in the thickness of 3 µm on the substrates comprising an aluminum nitride-based sintered compact are shown.

The thin films are formed by the MOCVD method.

Except making the substrate temperatures into 330°C, 380°C, and 440°C, respectively, the GaN thin films shown in the experiment No.728, 729, and 730 were produced with the same raw materials and thin film formation conditions as Example 1, Example 12, and Example 17.

Except making the substrate temperature into 420°C, the InN thin film shown in the experiment No.731 was produced with the same raw materials and thin film formation conditions as Example 1 and Example 12.

As a result by X ray diffraction, among the GaN thin films, that of the experiment No.728 was amorphous, and that of the experiment No.729 was a polycrystalline substance which has the diffraction peak of the Miller Index (002), (101).

In the obtained GaN thin films and InN thin film, the experiment No.730 and 731 all were the orientated polycrystal in which C axis was formed in the perpendicular direction to the substrate surface, and the half width of the rocking curve of the X ray diffraction from the lattice plane of the Miller Index (002) was 4710 seconds in case of the GaN thin film, and was 4820 seconds in case of the InN thin film.

In the experiment No.732-739 of Table 31, using the substrates in which the GaN thin films and the InN orientated polycrystalline thin films were formed beforehand under the same conditions as the above-described MOCVD method, the characteristics of the AlN thin films, GaN thin films, and InN thin films which were formed furthermore on them in the thickness of 3 µm respectively by the MOCVD method under the same conditions as the case where the thin films were produced in the experiment No.709, 714, and 715 of this Example are shown.

Each thin film formed after was clearly the single crystal in which C axis was formed in the perpendicular direction to the substrate surface in all as a result of X ray diffraction.

As shown in Table 31, the half width of the rocking curve of the X ray diffraction from the lattice plane of the Miller Index (002) of these single-crystal thin films was not more than 100 seconds in all, and they were those having high crystallinity.

Thus, by beforehand forming directly the GaN thin film and InN thin film which have each crystallized state of an amorphous state, a polycrystal, and an orientated polycrystal on the substrate comprising an aluminum nitride-based sintered compact, the single-crystal thin films comprising as the main component(s) at least one or more components selected from a gallium nitride, an indium nitride and an aluminum nitride may be formed on them, and it was confirmed that the crystallinity can be raised than the single-crystal thin films formed directly on the substrates comprising an aluminum nitride-based sintered compact.

Although the appearance of the above-mentioned thin films produced in the experiment No.728-731 was investigated, defects, such as a crack and a crevice, are not seen.

And, although the exfoliation test was carried out using the pressure sensitive adhesive tape, exfoliations were not seen between them and the substrates comprising an aluminum nitride-based sintered compact.

The appearance of each thin film produced in the experiment No.732-739 was investigated, defects, such as a crack and a crevice, are not seen in all.

Although the exfoliation test was carried out using the pressure sensitive adhesive tape, in all the thin films, exfoliations were not seen between them and the substrates comprising an aluminum nitride-based sintered compact, or between the thin films.

Although perpendicular tensile strength was investigated by soldering the metal leads after the thin film-conductive material of Ti/Pt/Au was formed on the surface of the thin films which were produced in the above-mentioned experiment No.725-727 and were produced using the Chloride VPE method, it all is not less than 2 Kg/mm2, so the aluminum nitride-based sintered compacts, and each above-mentioned thin film are joined firmly, or there is firm junction between each thin film.

Fig. 62 shows the X ray diffraction pattern of the AlN amorphous thin film produced in the experiment No.706, and it was measured by 2θ/θ scan in the range where the diffraction angle 2θ is 10 degrees-70 degrees. But the clear peak does not appear, it has become a broad pattern, and it seems that it is clearly in the amorphous state.

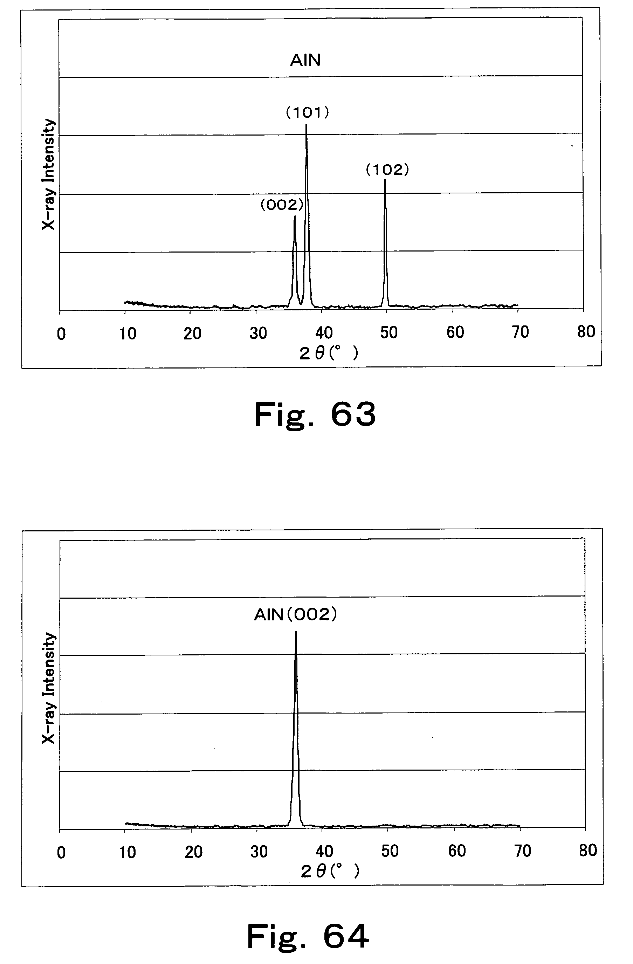

Fig. 63 shows the X ray diffraction pattern of the AlN polycrystalline thin film produced in the experiment No.707, and it was measured by 2θ/θ scan in the range where the diffraction angle 2θ is 10 degrees -70 degrees. The peaks have appeared from each lattice plane of the Miller Index (002), (101), (102), and it is clearly the polycrystal.

Fig. 64 shows the X ray diffraction pattern of the AlN orientated polycrystalline thin film produced in the experiment No.708, and it was measured by 2θ/θ scan in the range where the diffraction angle 2θ is 10 degrees-70 degrees. The peak has appeared only from the lattice plane of the Miller Index (002), and it is clearly the orientated polycrystal formed in the direction where C axis is perpendicular to the substrate surface.

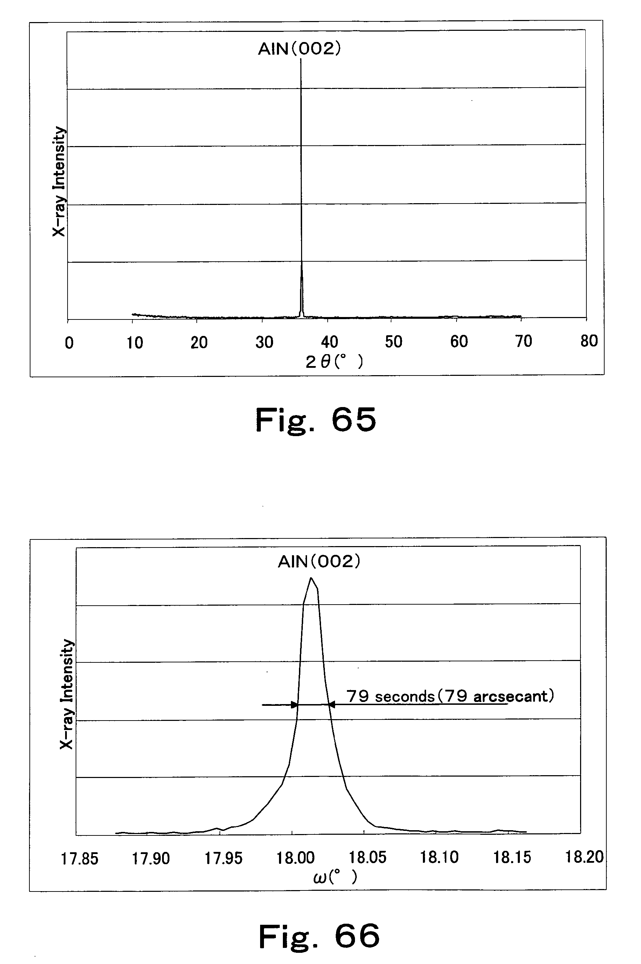

Fig. 65 shows the X ray diffraction pattern of the AlN single-crystal thin film produced in the experiment No.712, and it was measured by 2θ/θ scan in the range where the diffraction angle 2θ is 10 degrees -70 degrees. The peak has appeared only from the lattice plane of the Miller Index (002), and is extremely sharp than the AlN orientated polycrystalline thin film of the experiment No.708, it is clearly the single crystal formed in the direction where C axis is perpendicular to the substrate surface.

Fig. 66 is the rocking curve of the X ray diffraction from the lattice plane of the Miller Index (002) of the single-crystal thin film produced in the above-mentioned experiment No.712, and it was measured by ω scan in the range where the diffraction angle is 17.88 degrees-18.16 degrees.

In Fig. 66, it is also described together that the half width of the rocking curve of this thin film is 79 seconds (79 arcsecant).

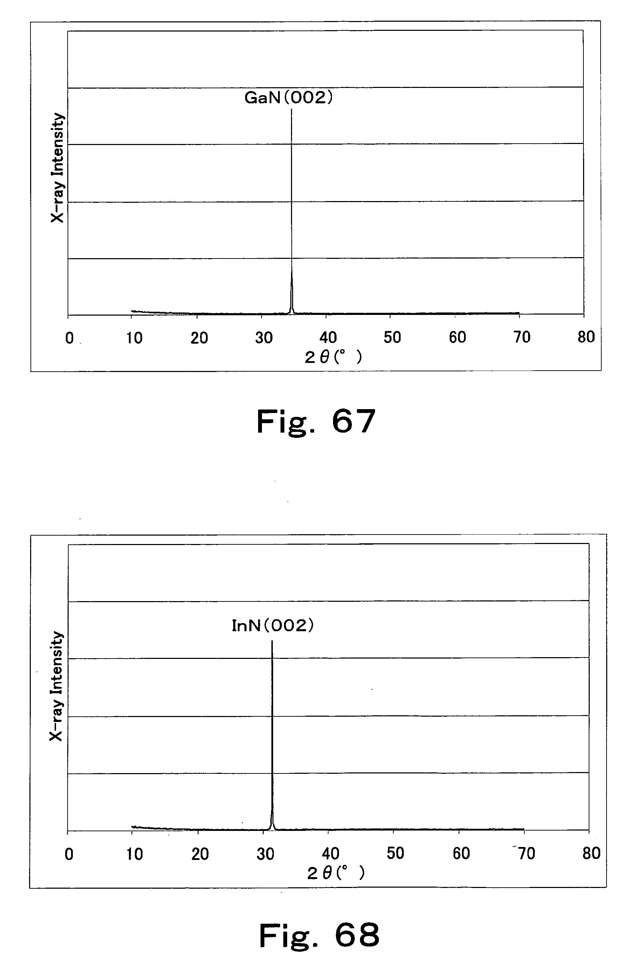

Fig. 67 shows the X ray diffraction pattern of the GaN single-crystal thin film produced in the experiment No.716, and it was measured by 2θ/θ scan in the range where the diffraction angle 2θ is 10 degrees-70 degrees. The peak has appeared only from the lattice plane of the Miller Index (002), and is also sharp, it is clearly the single crystal formed in the direction where C axis is perpendicular to the substrate surface.

Fig. 68 shows the X ray diffraction pattern of the InN single-crystal thin film produced in the experiment No.717, and it was measured by 2θ/θ scan in the range where the diffraction angle 2θ is 10 degrees-70 degrees. The peak has appeared only from the lattice plane of the Miller Index (002), and is also sharp, it is clearly the single crystal formed in the direction where C axis is perpendicular to the substrate surface.

In addition, the X ray diffraction patterns shown in Fig. 62-Fig. 68 were measured using the CuKα line.

In the X ray diffraction patterns shown in Figs. 62-65 and Figs. 67-68, the horizontal axis of each figure shows diffraction angle : 2θ, the vertical axis shows the intensity of diffraction X-rays (X-ray Intensity).

In the X ray diffraction pattern shown in Fig. 66, the horizontal axis shows diffraction angle : ω, the vertical axis shows the intensity of diffraction X-rays (X-ray Intensity).

In this Example, although the surface roughness of the substrate surface in the state where the thin film(s) was formed was measured, the surface roughness Ra in all the substrates produced was not more than 10 nm as shown in Table 31.

Thus, it was confirmed that it becomes smaller extremely than the surface roughness of the original substrate comprising an aluminum nitride-based sintered compact, and that the thin-film substrates in which the flat and smooth nature was improved are easy to be obtained.

As mentioned above, in the substrates forming furthermore the single-crystal thin film on the substrates in which the thin films of an amorphous state, a polycrystal, an orientated polycrystal, and a single crystal were formed beforehand on the substrate comprising an aluminum nitride-based sintered compact, it was confirmed that the surface roughness becomes small and the surface smooth nature is improved (in the substrate surface, the surface roughness of the single-crystal thin films produced in the experimental example 710-713, 716-719, 723-724, 726-727, and 732-739 is smaller than the thin films produced in the experiment example 706-709, 714-715, 721-722, and 728-731).

Among the amorphous thin film, polycrystalline thin film, and orientated polycrystalline thin film which are formed directly on the substrate comprising an aluminum nitride-based sintered compact, it is preferred to use the substrate in which the orientated polycrystalline thin film was formed.

In this Example, as for the surface roughness Ra of the single-crystal thin films (the experiment No.710, 711, 718, 719, 724, and 726) formed on the substrates in which the AlN amorphous thin film and the AlN polycrystalline thin film were formed beforehand on the substrate comprising an aluminum nitride-based sintered compact, it is the range of 2.0-2.5 nm, but, as for the surface roughness Ra of the single-crystal thin films (the experiment No.712, 716, 717, 720, and 727) formed on the substrates in which the orientated polycrystal was formed beforehand, it is in the range of 0.87-1.09 nm, it was confirmed that the surface smooth nature is excellent furthermore.

Next, evaluation of the thin films formed using the substrates in which the materials quality (the composition, the crystal phase, the optical transmissivity, and the size of a sintered compact crystal grain, etc.) of the aluminum nitride-based sintered compact differs was carried out.

Formation of the thin films was carried out under the same conditions as what was described in above this Example.

The result is shown in the experiment No.740-757 of Table 32.
In the experiment No.740-757, clearly,
1) even if the quality of the materials of the substrates comprising an aluminum nitride-based sintered compact differs, those with high crystallinity, such that the half width of the rocking curve of the X ray diffraction line from the lattice plane of the Miller Index (002) is not more than 100 seconds, are obtained, even if the single-crystal thin films formed on the substrates forming beforehand an amorphous thin film, a polycrystal thin film, and an orientated polycrystal thin film are GaN and InN besides AlN, and it was confirmed that it is equivalent at least or is superior furthermore, if compared with the crystallinity of the single-crystal thin films (the single-crystal thin films produced in the experiment No.740, 744, 749, and 753) formed directly on the substrates comprising an aluminum nitride-based sintered compact.
   And,
2) it was confirmed that the surface smooth nature of the substrates comprising an aluminum nitride-based sintered compact forming the thin film(s) is superior to the surface smooth nature of the substrates comprising only an aluminum nitride-based sintered compact.
3) it was confirmed that the surface smooth nature of the thin films formed on the substrates forming beforehand an amorphous thin film, a polycrystalline thin film, and an orientated polycrystalline thin film is superior to the surface smooth nature of the thin films formed directly on the substrates comprising an aluminum nitride-based sintered compact.
4) among the thin films formed beforehand on the substrates comprising an aluminum nitride-based sintered compact, it was confirmed that the surface smooth nature of the single-crystal thin films formed on the substrates on which an orientated polycrystalline thin film was formed is superior to the substrates on which an amorphous thin film and a polycrystalline thin film were formed.

Although the appearance of the above thin films produced in the experiment No.740-757 was investigated, defects, such as a crack and a crevice, are not seen in all.

Although the exfoliation test was carried out using the pressure sensitive adhesive tape, in all the thin films, exfoliations were not seen between them and the substrates comprising an aluminum nitride-based sintered compact, or between the thin films.

Although perpendicular tensile strength was investigated by soldering the metal leads after the thin film-conductive material of Ti/Pt/Au was formed in each above single-crystal thin film formed, it all is not less than 2 Kg/mm², so the aluminum nitride-based sintered compacts, and each above thin film are integrally adhered, or there is firm unification between each thin film.

In this Example, the above phenomena were confirmed also in what used as a substrate the various aluminum nitride-based sintered compacts having conduction vias comprising tungsten and copper as a main component.

That is, the result is shown in the experiment No.758-765 of Table 32.

The thin films formed beforehand directly on the substrates comprising the aluminum nitride-based sintered compacts which have a conduction via and are shown in the experiment No.758-765 were produced using the sputtering method and the MOCVD method under the same conditions as what was indicated in above this Example.

AlN, GaN and an InN thin film were formed further on the substrates in which each thin film was formed beforehand by the MOCVD method and the Chloride VPE method under the same conditions as what was shown in above this Example.

Each formed AlN, GaN, InN thin film was the single crystal in which C axis was formed in the perpendicular direction to the substrate surface, and they were the single crystals which have excellent crystallinity in which the half width of the rocking curve of the X ray diffraction from the lattice plane of the Miller Index (002) is not more than 100 seconds altogether.

Thus, also in the substrates comprising the aluminum nitride-based sintered compacts having a conduction via, the single-crystal thin films comprising as a main component at least one selected from gallium nitride, indium nitride and aluminum nitride may be formed on them by forming beforehand the AlN thin film having each crystallization state of an amorphous state, a polycrystal, and an orientated polycrystal, the GaN thin film of orientated polycrystal, and the InN thin film of orientated polycrystal, and it was confirmed that the crystallinity rises than the single-crystal thin films formed directly on the substrates comprising the aluminum nitride-based sintered compacts.

The surface smooth nature of the above single-crystal thin films produced in the experiment No.758-765 was superior to the surface smooth nature of the substrates comprising the aluminum nitride-based sintered compacts.

Among the thin films formed beforehand on the substrates comprising the aluminum nitride-based sintered compacts, it was confirmed that the surface smooth nature of the single-crystal thin films formed on the substrates forming an orientated polycrystalline thin film is superior to the substrates (the experimental example of 760 and 764) forming an amorphous thin film and a polycrystalline thin film.

Although the appearance of the above thin films produced in the experiment No.758-765 was investigated, defects, such as a crack and a crevice, are not seen in all.

Although the exfoliation test was carried out using the pressure sensitive adhesive tape, in all the thin films, exfoliations were not seen between them and the substrates comprising the aluminum nitride-based sintered compacts, or between the thin films.

Although the perpendicular tensile strength was investigated by soldering the metal leads after the thin film-conductive material of Ti/Pt/Au was formed on each above single-crystal thin film formed, it all is not less than 2 Kg/mm², so the aluminum nitride-based sintered compacts, and each above thin film are integrally adhered, or there is firm unification between each thin film.

The examples in which the thin films containing the doping component(s) were formed on the substrate comprising an aluminum nitride-based sintered compact, are shown in Table 33.

The thin films in each experiment indicated in Table 33 were produced so that the thickness becomes into 3 µm.

The experiment No.766-775 is the examples in which the thin films containing doping component(s) were formed directly on the substrate comprising an aluminum nitride-based sintered compact.

The example of the thin film produced by the sputtering method in which the GaN single crystal containing 0.02 mol % Si component was used as the target material is shown in the experiment No.766.

The example of the thin film produced by the sputtering method in which the high purity InN sintered compact containing 0.02 mol % Si component was used as the target material is shown in the experiment No.767.

The example of the thin film produced by the sputtering method in which the high purity AlN sintered compact containing 0.02 mol % Si component was used as the target material is shown in the experiment No.768.

The thin film of the experiment No.766 is what was produced by the sputtering method under the condition where the substrate temperature was room temperature, the mixed gas of Ar+N₂ was introduced in the mixture ratio of N₂/Ar=0.6, the pressure inside the chamber was 0.5Pa, and the electric power was 400W.

The thin film of the experiment No.767 is what was produced by the sputtering method under the condition where the substrate temperature was 250°C, the mixed gas of Ar+N₂ was introduced in the mixture ratio of N₂/Ar=0.3, the pressure inside the chamber was 0.6Pa, and the electric power was 600W.

The thin film of the experiment No.768 is what was produced by the sputtering method under the condition where the substrate temperature was 280°C, the mixed gas of Ar+N₂ was introduced in the mixture ratio of N₂/Ar=0.4, the pressure inside the chamber was 0.8Pa, and the electric power was 1000W.

The electric power used in the above described sputtering method is high frequency with the frequency of 13.56MHz.

The experiment No.769 and 770 show the examples of the thin films produced by the MOCVD method under the same conditions as above this Example, except for making the substrate temperature into 480°C, and using newly SiH₄ as a raw material for doping.

The thin film produced in the experiment No.766 was amorphous, and the thin film produced in the experiment No.767 was a polycrystal wherein the diffraction lines of the lattice planes of the Miller Index (002), (101), (102), have appeared as a result of X ray diffraction.

On the other hand, the thin films produced in the experiment No.768, 769, and 770 were the orientated polycrystal wherein only the diffraction line of the lattice plane of the Miller Index (002) has appeared and C axis was perpendicularly formed to the substrate surface.

The half width of the rocking curve of the X ray diffraction from the lattice plane of the Miller Index (002) of the orientated polycrystalline thin films is 7930 seconds, 4560 seconds, and 4390 seconds, respectively, and the orientated polycrystalline thin films produced by the MOCVD method were better in crystallinity.

The thin films produced in the experiment No.766-770 all had conductivity as shown in Table 33.

Although the appearance of the above thin films produced in the experiment No.766-770 was investigated, defects, such as a crack and a crevice, are not seen in all.

Although the exfoliation test was carried out using the pressure sensitive adhesive tape, in all the thin films, exfoliations were not seen between them and the substrates comprising an aluminum nitride-based sintered compact.
Although perpendicular tensile strength was investigated by soldering the metal leads after the thin film-conductive material of Ti/Pt/Au was formed on each above orientated polycrystal thin film formed, it all is not less than 2 Kg/mm², so the aluminum nitride-based sintered compacts and each above thin film are unified firmly.

The experiment No.771-775 is also the examples forming directly the thin films containing the doping component(s) in the substrate comprising an aluminum nitride-based sintered compact.

They are the examples of the thin films produced by the MOCVD method under the same conditions as Example 1 except that the substrate temperature was made into 1100°C in the case of the thin film of the experiment No.771, the substrate temperature was made into 1000°C in the case of the thin films of the experiment No.772 and 773, the substrate temperature was made into 840°C in the case of the thin films of the experiment No.774 and 775, and SiH₄, bis-cyclopentadienyl magnesium, and diethyl zinc were newly used as a raw material for doping.

These thin films all were the single crystals in which C axis was perpendicularly formed to the substrate surface as a result of X ray diffraction, and the half width of the rocking curve of the X ray diffraction from the lattice plane of the Miller Index (002) was 171 seconds, 157 seconds, 182 seconds, 192 seconds and 197 seconds, respectively.

All had conductivity, as shown in Table 33.

Although the appearance of the above thin films produced in the experiment No.771-775 was investigated, defects, such as a crack and a crevice, are not seen in all.

Although the exfoliation test was carried out using the pressure sensitive adhesive tape, in all the thin films, exfoliations weres not seen between them and the substrates comprising an aluminum nitride-based sintered compact.
The thin film-conductive material of Ti/Pt/Au was formed on each above single-crystal thin film formed, the metal leads were soldered and the perpendicular tensile strength was investigated, but it all is not less than 2 Kg/mm², so the aluminum nitride-based sintered compacts and each above single-crystal thin film have integrally adhered.

Next, the orientated polycrystalline thin films of same composition having the same doping component as the above experiment No.768 and 770 were formed beforehand on the substrate comprising an aluminum nitride-based sintered compact by the sputtering method and MOCVD method under the same thin film formation conditions, and the formation of the single-crystal thin films having the doping component(s) was tried on them by the MOCVD method under the same thin film formation conditions as the above experiment No.771-775.

The result was shown in Table 34.

As for the thin films which are shown in the experiment No.776-785 of Table 34 and are formed on the substrates comprising an aluminum nitride-based sintered compact forming beforehand the orientated polycrystalline thin films by the above sputtering method and MOCVD method, all were the single crystals in which C axis was perpendicularly formed to the substrate surface.

The half width of the rocking curve of the X ray diffraction from the lattice plane of the Miller Index (002) of the single-crystal thin films is in the range of 80 seconds-95 seconds, and it was confirmed that the crystallinity was improving clearly, compared with those wherein the single-crystal thin films which were produced in the experiment No.771-775 and were formed directly on the substrates comprising an aluminum nitride-based sintered compact are 157-197 seconds.

The single-crystal thin films formed on the orientated polycrystalline thin films all had conductivity, as shown in Table 34.

While the surface roughness of the single-crystal thin films which were produced in the experiment No.771-775 and were formed directly on the substrate comprising an aluminum nitride-based sintered compact is in the range of 4.6 nm-7.1 nm, the surface roughness Ra of the single-crystal thin films which were produced in the experiment No.776-785 and were formed on the orientated polycrystalline thin film is in the range of 0.87-1.01 nm, and it was confirmed that the surface roughness was also improved clearly.

Although the appearance of the above thin films produced in the experiment No.758-765 was investigated, defects, such as a crack and a crevice, are not seen altogether in the orientated polycrystalline thin films of the substrate side, and in the single-crystal thin films of the surface.

Although the exfoliation test was carried out using the pressure sensitive adhesive tape, in all the thin films, exfoliations were not seen between them and the substrates comprising the aluminum nitride-based sintered compacts, or between thin films.

The thin film-conductive material of Ti/Pt/Au was formed on the single-crystal thin films produced in the experiment No. 776-785, the metal leads were soldered and the perpendicular tensile strength was investigated, but it all is not less than 2 Kg/mm², so there is firm unification nature between the aluminum nitride-based sintered compacts and the orientated polycrystalline thin films, and between the orientated polycrystalline thin films and the single-crystal thin films.

In addition, although not indicated in Table 34, further formation of the single-crystal thin films having doping component(s) was tried by the MOCVD method with the same compositions under the same thin film formation conditions as the case of being produced in the above experiment No.771-775 onto them, after an amorphous thin film, a polycrystalline thin film, and an orientated polycrystalline thin film were formed beforehand on the substrates comprising an aluminum nitride-based sintered compact (what was produced in the experiment No.49) by the sputtering method and MOCVD method of the same thin film formation conditions in the same composition as the experiment No.766, 767, and 769, respectively.

As a result, the same amorphous thin film, polycrystalline thin film, and orientated polycrystalline thin film as the above experiment No.766, 767, and 769 are formed on the substrates comprising an aluminum nitride-based sintered compact, and the thin films formed on those thin films all were the single crystal in which C axis was perpendicularly formed to the substrate surface.

The half width of the rocking curve of the X ray diffraction from the lattice plane of the Miller Index (002) of the single-crystal thin films is not more than 100 seconds altogether, and it was confirmed that the crystallinity was clearly improved more than the single-crystal thin films which were produced in the experiment No.743-747 and were formed directly on the substrates comprising the aluminum nitride-based sintered compacts.

As for the surface roughness Ra of the above single-crystal thin films, it is in the range of 2.1 nm-2.7 nm in the case of what was formed on the amorphous thin film, it is in the range of 1.8 nm-2.5 nm in the case of what was formed on the polycrystalline thin film, and it is in the range of 0.89 nm-1.08 nm in the case of what was formed on the orientated polycrystalline thin film, and it was confirmed that the surface roughness was also improved clearly.

In addition, it was confirmed that there is a tendency in which better surface smooth nature is given to the single-crystal thin films formed on it, when the thin film formed beforehand on the substrate comprising an aluminum nitride-based sintered compact is the orientated polycrystal like that shown in Table 31, as mentioned above.

Thus, in this Example, even when the single-crystal thin films including the doping component(s) and comprising as a main component at least one selected from gallium nitride, indium nitride and aluminum nitride are formed on the substrates comprising an aluminum nitride-based sintered compact, it was confirmed that it is more effective to use the substrates in which the orientated polycrystal was formed beforehand than forming directly in the substrates.

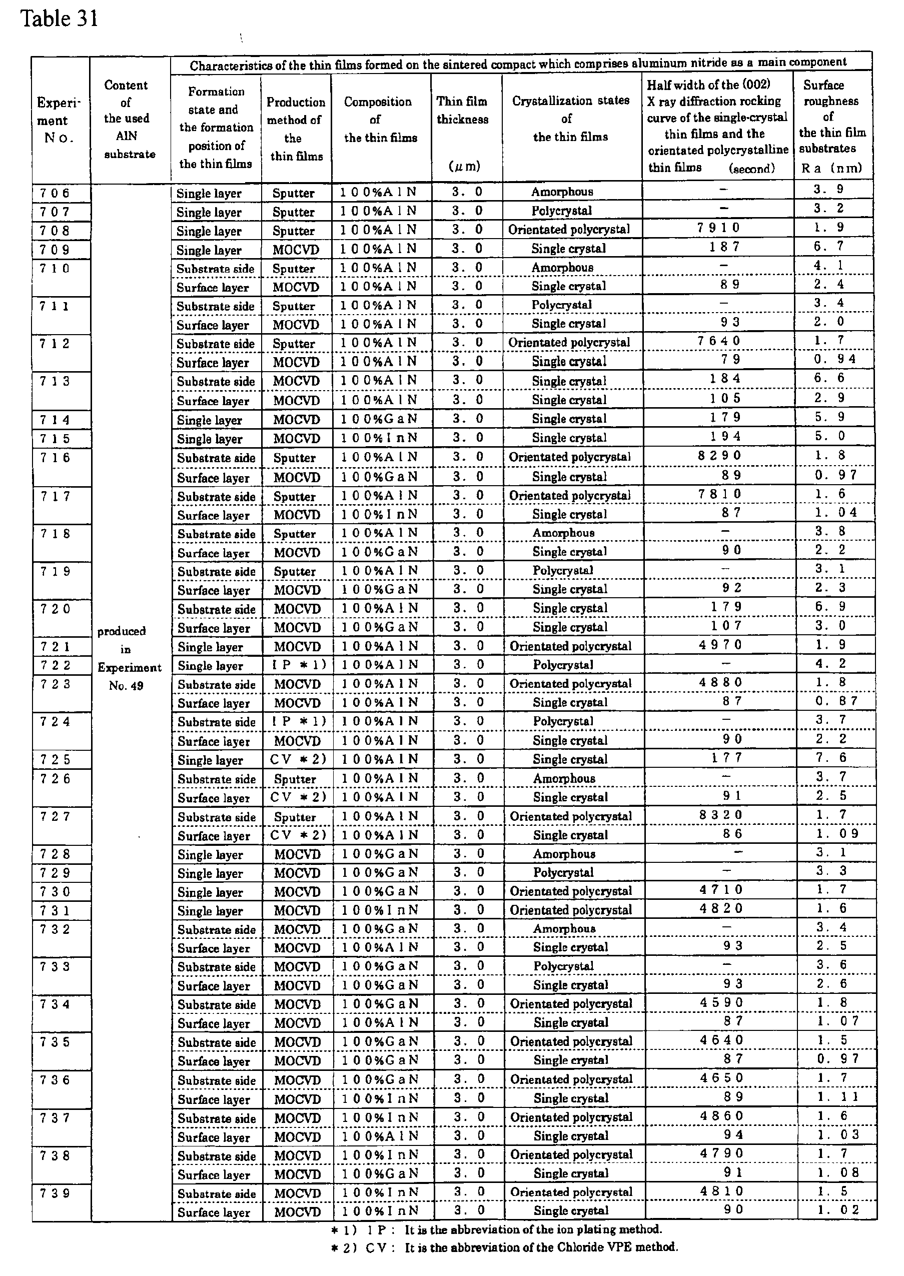

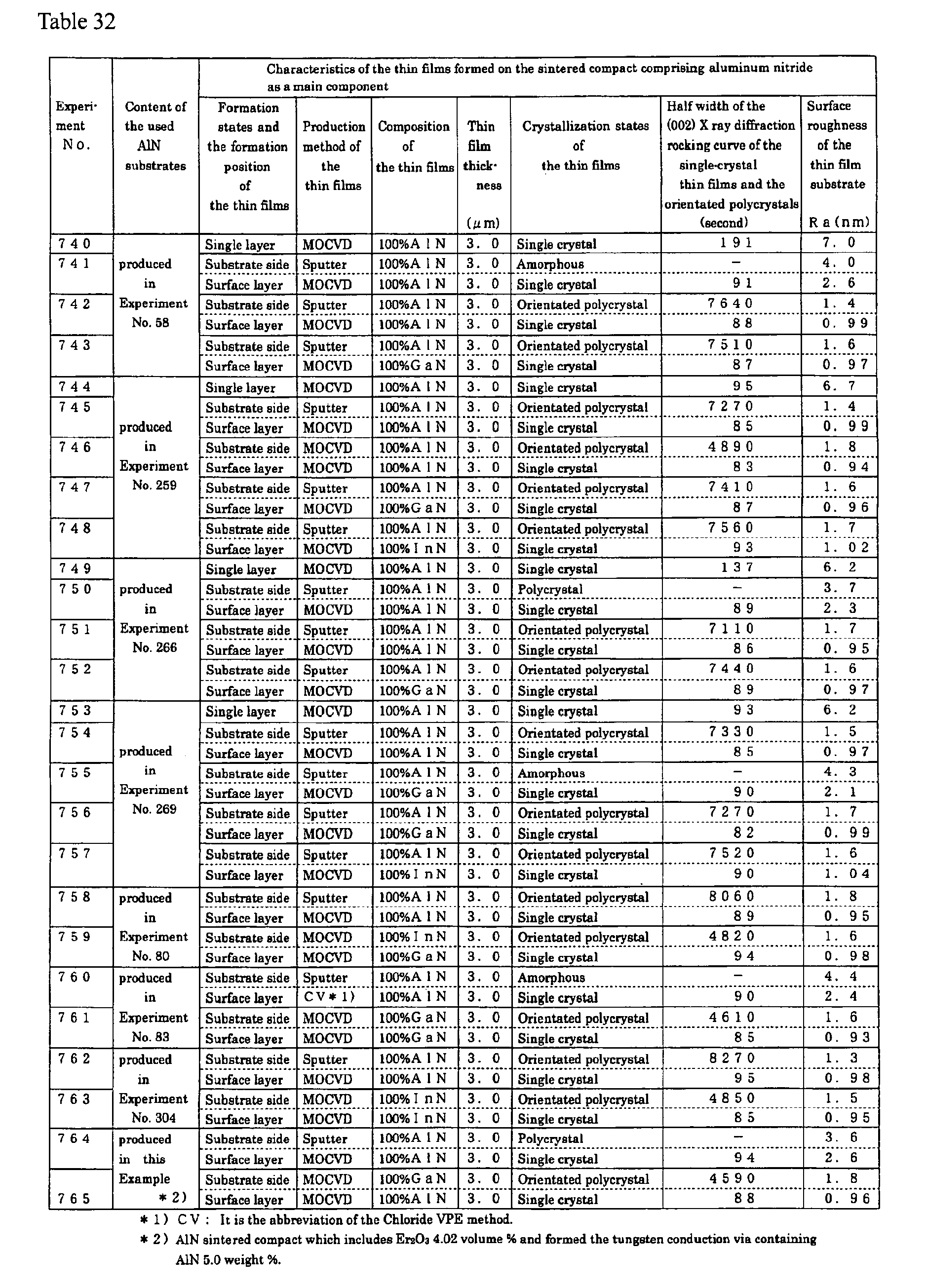

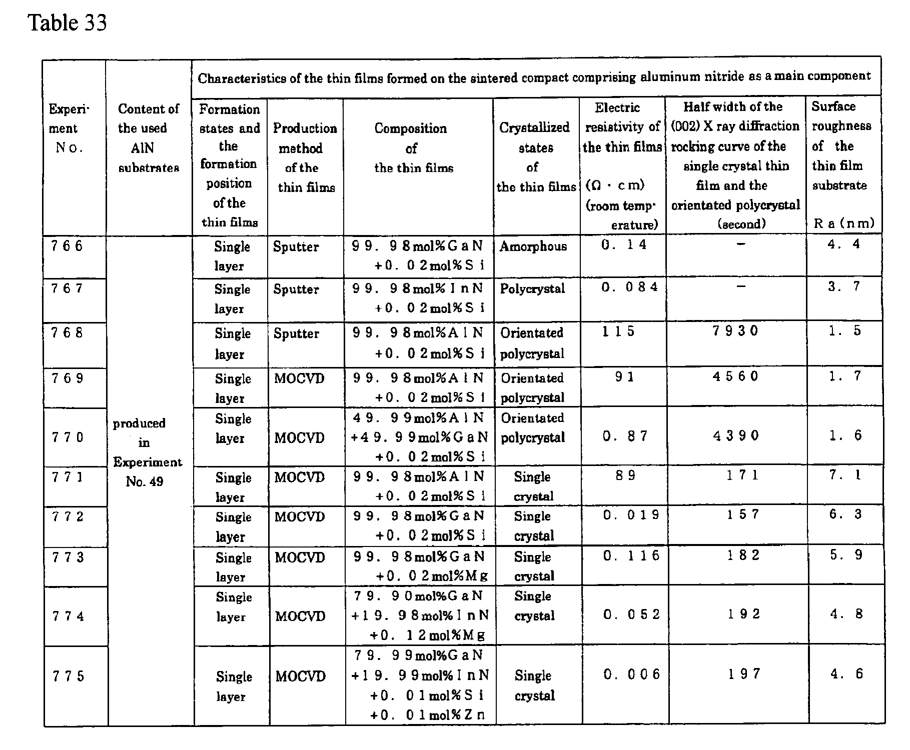

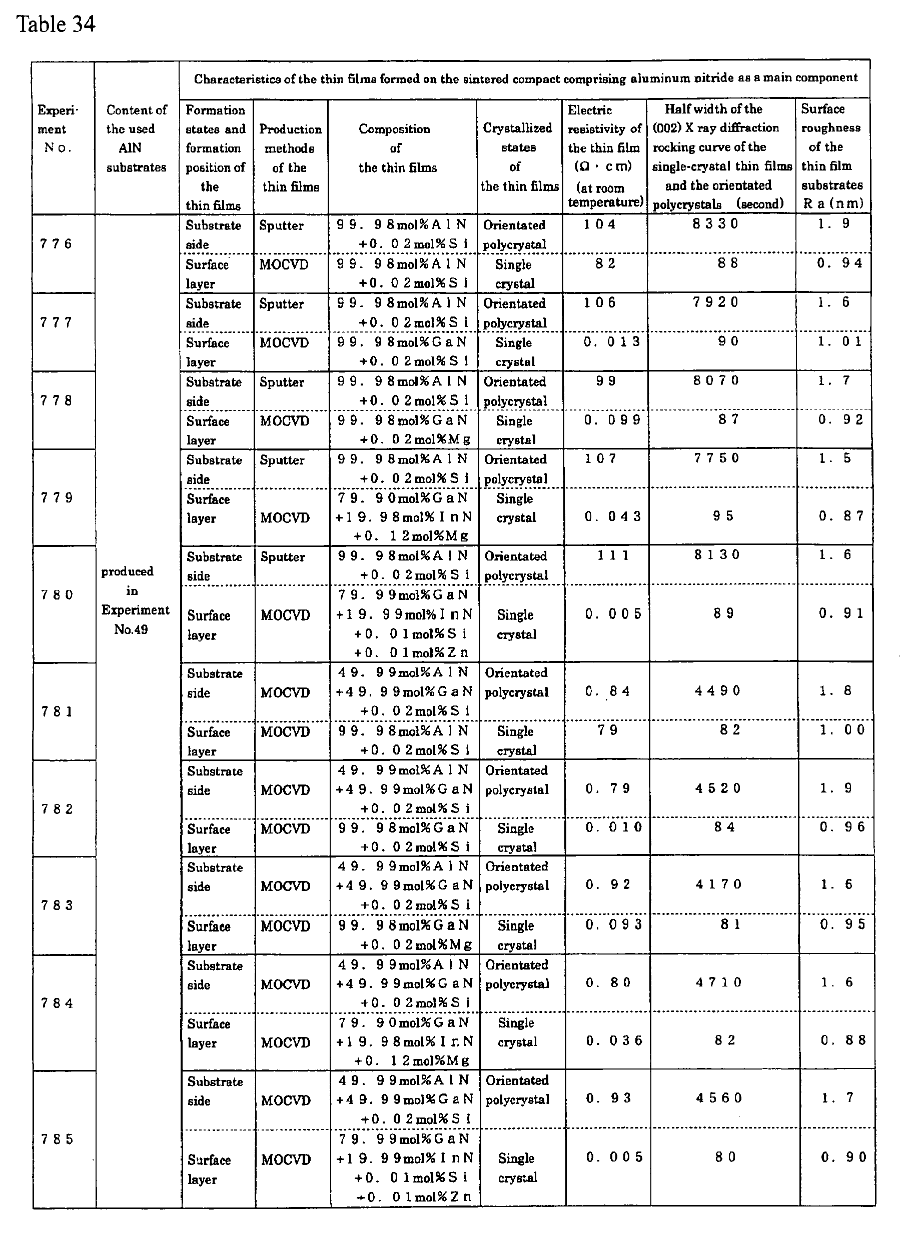

### Example 26

In this Example, the effect of the thin films formed beforehand on the substrates comprising an aluminum nitride-based sintered compact was examined further.

It was examined using those produced in Example 19 and having various compositions as it is, as a substrate comprising an aluminum nitride-based sintered compact.

The aluminum nitride-based sintered compacts having various composition were newly produced by the same method as Example 19 by carrying out the normal pressure sintering of the powder compacts at 1800°C for 2 hours in N₂, then specular surface polish was carried out on the sintered compacts obtained like Example 19, and they were used as a substrate for a thin film.

In addition, in the various aluminum nitride-based sintered compacts newly produced, the quantity of the various additives added or impurities contained in the powder compacts is what converted the impurities actually contained or the compound added, into the oxide or the element, like Example 19.

In the aluminum nitride-based sintered compacts produced in this Example, as for the impurities oxygen in the raw material powders and the oxygen resulting from added Al₂O₃, or the metal component(s) and the oxygen component, etc. in the added sintering aids, such as an rare earth element compound and an alkaline-earth-metal compound, or the metal component(s) and the oxygen component, etc. in the added alkali metals compound and silicon content compound, or the metal component(s) and carbon component, etc. in the added compound(s) containing each transition metal of Mo, W, V, Nb, Ta, and Ti and the compound(s) containing carbon, or the metal component(s), etc. in the added compound(s) containing unescapable metal(s), such as Fe, Ni, Cr, Mn, Zr, Hf, Co, Cu, and Zn, etc., it was confirmed that they are hardly vaporized and not removed by firing and that the almost same quantity as the quantity in the powder compact exists.

That is, in this Example, when the above converted values were used as the amount of impurities and the amount of additives, like Example 19, the difference is small between the quantity of the impurities or additives in the produced aluminum nitride-based sintered compacts and the quantity of the impurities or additives contained in the powder compacts, and it can be considered that it is almost the same amount.

Therefore, as the obtained composition of the aluminum nitride-based sintered compacts, it is not indicated especially except the total amount of oxygen in each Table.

The details of the substrates comprising the aluminum nitride-based sintered compacts which were used in this Example and were newly produced in this Example were shown in Tables 35-40.

On these substrates, forming beforehand the single-crystal thin film, amorphous thin film, polycrystalline thin film, and orientated polycrystalline thin film which comprise as a main component at least one selected from gallium nitride, indium nitride and aluminum nitride, the effect which gives to the characteristics of the single-crystal thin films formed further on them was examined.

First, the composition is made into 100 mol % AlN as the thin films formed beforehand on the substrates, what has the thickness of 3 µm was produced by the same method as the sputtering method carried out in the experiment No.706, 707 and 708, and as the MOCVD method carried out in the experiment No.709 of Example 25.

As for the thin films formed on them, the composition is made into 100 mol % AlN, 100 mol % GaN, 100 mol % InN, 50 mol % AlN+50 mol % GaN and 50 mol % GaN+50 mol % InN, they were produced so that they become correspondence of the same composition as the substrates comprising an aluminum nitride-based sintered compact, and as the single-crystal thin films formed directly on the sintered compacts substrates, in Example 19.

All the thickness of the thin films formed was 3 µm.

As the forming method, it was carried out like the description in Example 19 by the MOCVD method under the same conditions as Example 1 and Example 2.

The characteristics of the thin films produced like that were shown in Tables 35-40.

Next, analysis by X ray diffraction was carried out about the AlN thin films formed beforehand on each substrate comprising an aluminum nitride-based sintered compact, and it was confirmed that the AlN thin films produced by the sputtering method under the same conditions as the experiment No.706, 707, and 708 of above Example 25 correspond to the experiment No.706, and 707 and 708, and that they are the amorphous state, the polycrystal, and the orientated polycrystal, respectively.

It was confirmed that the AlN thin film produced by the MOCVD method under the same condition as the experiment No.709 of the above Example 25 corresponds to the experiment No.709, and that it is the single crystal.

These results were indicated in Tables 35-40.

Among these AlN thin films formed beforehand, as for what is the orientated polycrystal and the single-crystal thin film, it was confirmed that C axis is perpendicularly formed to the substrate surface.

As for the crystallinity, the measured values of the half width of the rocking curve of the X ray diffraction from the lattice plane of the Miller Index (002) were in the range of 6640-7550 seconds in the case of the orientated polycrystalline thin films, and in the range of 138-235 seconds in the case of the single-crystal thin films, as shown in Tables 35-40.

Next, using the substrates forming beforehand the thin films of the above various crystallization states, the thin films formed furthermore on them were investigated by X ray diffraction, and it was confirmed that they all are clearly the single crystal in which C axis is formed perpendicularly to the substrate surface.

The examples using the substrates comprising the aluminum nitride-based sintered compacts adding Al₂O₃ as an additive are shown in Table 35.

In Table 35, all the substrates comprising the aluminum nitride-based sintered compacts which are indicated in Table 18 and are produced in Example 19 are used as they are, except the substrates comprising the aluminum nitride-based sintered compacts which were used in the experiment No.802 and 803 and were produced by adding Al₂O₃ 56 volume % on the basis of oxide.

As shown in each experiment of Table 35, in all the substrates comprising the aluminum nitride-based sintered compacts forming beforehand the thin film(s) comprising various crystallization states, such as an amorphous state, a polycrystal, an orientated polycrystal, and a single crystal, etc., the single-crystal thin films comprising as a main component at least one selected from gallium nitride, indium nitride and aluminum nitride may be formed on those.

The single-crystal thin films were what has the crystallinity not more than 300 seconds as the half width of the rocking curve of the lattice plane of the Miller Index (002).

It was confirmed that the crystallinity of the single-crystal thin films was improved than what was formed directly on the same substrates comprising an aluminum nitride-based sintered compact.

When using those in which the thin film(s) comprising various crystallization states, such as an amorphous state, a polycrystal, an orientated polycrystal, and a single crystal, etc., was formed beforehand on the substrates comprising the aluminum nitride-based sintered compacts indicated in Table 35 of this Example, the half width of the rocking curve of the lattice plane of the Miller Index (002) of the single-crystal thin films formed on them was not less than 100 seconds in the substrates containing ALON not less than 50 %, but many of them were not more than 100 seconds in the other substrates containing ALON not more than 50 %.

Even if the substrates comprising the aluminum nitride-based sintered compacts adding Al₂O₃ as an additive are what cannot directly form a single-crystal thin film on them, it was confirmed that the single-crystal thin films comprising as a main component at least one selected from gallium nitride, indium nitride and aluminum nitride may be formed on them, if what formed beforehand the thin films comprising various crystallization states, such as an amorphous state, a polycrystal, and an orientated polycrystal, etc., is used as a substrate, as shown in Table 35 in this Example.

As shown in the experiment No.382 of Table 18 of Example 19, the ALON phase generates 59 % other than the AlN phase in the aluminum nitride-based sintered compact adding Al₂O₃ 50 volume %, and the direct formation of a single-crystal thin film was difficult, but in this Example, even if the same substrates are used as shown in the experiment No.799-801, it was confirmed that the single-crystal thin films excellent in crystallinity can easily be formed on them, when beforehand forming the AlN thin films of an amorphous state, a polycrystal, and an orientated polycrystal.

In addition, as shown in the experiment No.802 of Table 35 in this Example, the ALON phase was generating 77 % other than the AlN phase in the aluminum nitride-based sintered compact dding Al₂O₃ 56 volume %.

The thin film formed on the substrate which used this sintered compact was a polycrystalline substance in which the diffraction peak is shown only from the lattice plane of the Miller Index (002), (101), (102), and the direct formation of a single-crystal thin film was difficult on this substrate.

On the other hand, as shown in the experiment No.803, even if the substrate comprising the same sintered compact is used, it was confirmed that the single-crystal thin film excellent in crystallinity can easily be formed on it, when beforehand forming the AlN thin film of the orientated polycrystal.

The examples which used the substrates comprising the aluminum nitride-based sintered compacts adding a rare earth element and an alkaline-earth metal as an additive are shown in Table 36.

In Table 36, all the substrates comprising the aluminum nitride-based sintered compacts which were produced in Example 19 and are described in Table 19 are used as they are, except for the substrates comprising the aluminum nitride-based sintered compacts which were used in the experiment No.828 and 829 and were produced by adding Y₂O₃ 72 volume % on the basis of oxide.

As shown in each experiment of Table 36, in all the substrates comprising the aluminum nitride-based sintered compacts forming beforehand the thin film(s) comprising various crystallization states, such as an amorphous state, a polycrystal, an orientated polycrystal, and a single crystal, etc., the single-crystal thin films comprising as a main component at least one selected from gallium nitride, indium nitride and aluminum nitride may be formed on them.

These single-crystal thin films had the crystallinity, such that the half width of the rocking curve of the lattice plane of the Miller Index (002) is not more than 300 seconds.

It was confirmed that the crystallinity of these single-crystal thin films was improved than what is formed directly on the same substrates comprising the aluminum nitride-based sintered compacts.

When what formed beforehand the thin film(s) comprising various crystallization states, such as an amorphous state, a polycrystal, an orientated polycrystal, and a single crystal, etc., onto the substrates comprising the aluminum nitride-based sintered compacts indicated in Table 36 of this Example is used, many of the half width of the rocking curve of the lattice plane of the Miller Index (002) of the single-crystal thin films formed on them were not less than 100 seconds in the substrates which contain at least one selected from a rare earth element and an alkaline-earth metal not less than 50 volume % on the basis of oxide, but many of them were not more than 100 seconds in the substrates which contain at least one selected from a rare earth element and an alkaline-earth metal not more than 50 volume % on the basis of oxide.

Even if the substrates comprising an aluminum nitride-based sintered compact containing a rare earth element and an alkaline-earth metal as an additive are what cannot form directly a single-crystal thin film on them, it was confirmed that the single-crystal thin films comprising as a main component at least one selected from gallium nitride, indium nitride and aluminum nitride may be formed on them, when what beforehand formed directly the thin films comprising various crystallization states, such as an amorphous state, a polycrystal, and an orientated polycrystal, etc., is used as a substrate, as shown in Table 36 in this Example.

As shown in the experiment No.391 and experiment No.399 of Table 19 in Example 19, the direct formation of a single-crystal thin film was difficult on the aluminum nitride-based sintered compacts adding CaCO₃ 54 volume % on the basis of oxide and Y₂O₃ 55 volume % on the basis of oxide, but it was confirmed that the single-crystal thin films excellent in crystallinity can easily be formed on them in this Example when the AlN thin films of an amorphous state, a polycrystal, and an orientated polycrystal were formed beforehand, even if the same substrates were used, as shown in the experiment No.812-814 and the experiment No.825-827.

All of the half width of the rocking curve of the lattice plane of the Miller Index (002) of the single-crystal thin films formed in these six experiments was not more than 130 seconds.

In addition, as shown in the experiment No.828 of Table 36 in this Example, the thin film formed on the substrate comprising the aluminum nitride-based sintered compact adding Y₂O₃ 72 volume % was a polycrystalline substance in which the diffraction peaks are shown from the lattice plane of the Miller Index (002), (101), (102), and the direct formation of a single-crystal thin film was difficult on this substrate.

On the other hand, as shown in the experiment No.829, it was confirmed that the single-crystal thin film excellent in crystallinity can easily be formed on it when the AlN thin film of an orientated polycrystal was formed beforehand, even if the substrate comprising the same sintered compact was used.

Table 37 shows the examples which used the substrates comprising the aluminum nitride-based sintered compacts adding an alkaline metal and a silicon compound as an additive.

In Table 37, all the substrates comprising the aluminum nitride-based sintered compacts which were produced in Example 19 and are indicated in Table 20 are used as they are, except for the substrates comprising the aluminum nitride-based sintered compacts which were used in the experiment No.861-864 and were produced by adding SiO₂ 50 volume % on the basis of oxide.

As shown in each experiment of Table 37, in all the substrates comprising the aluminum nitride-based sintered compacts forming beforehand the thin film(s) comprising various crystallization states, such as an amorphous state, a polycrystal, an orientated polycrystal, and a single crystal, etc., the single-crystal thin films comprising as a main component at least one selected from gallium nitride, indium nitride and aluminum nitride may be formed on those.

These single-crystal thin films had the crystallinity, such that the half width of the rocking curve of the lattice plane of the Miller Index (002) is not more than 300 seconds.

It was confirmed that the crystallinity of these single-crystal thin films was improved than those formed directly on the substrates comprising the same aluminum nitride-based sintered compacts.

When those forming beforehand the thin film(s) comprising the various crystallization states, such as an amorphous state, a polycrystal, an orientated polycrystal, and a single crystal, etc., onto the substrates comprising the aluminum nitride-based sintered compacts shown in Table 37 of this Example are used, the half width of the rocking curve of the lattice plane of the Miller Index (002) of the single-crystal thin films formed on them was not less than 100 seconds in the substrates containing at least one selected from an alkaline metal and silicon not less than 20 volume % on the basis of oxide, but many of them were not more than 100 seconds in the other substrates containing at least one selected from an alkaline metal and silicon not more than 20 volume % on the basis of oxide.

Even if the substrates comprising an aluminum nitride-based sintered compact containing an alkaline metal and a silicon compound as an additive are what cannot form directly a single-crystal thin film on them, it was confirmed that the single-crystal thin films comprising as a main component at least one selected from gallium nitride, indium nitride and aluminum nitride may be formed on them, when what beforehand formed directly the thin films comprising the various crystallization states, such as an amorphous state, a polycrystal, and an orientated polycrystal, etc., is used as a substrate, as shown in Table 37 in this Example.

As shown in the experiment No.412 and 419 in Table 20 of Example 19, the thin films formed on the substrates which used the aluminum nitride-based sintered compacts adding Li₂CO₃ 25 volume % on the basis of Li₂O and Si 25 volume % on the basis of SiO₂ are a polycrystalline substance in which the diffraction peaks are shown from the lattice plane of the Miller Index (002), (101), (102), and the direct formation of a single-crystal thin film was difficult on these substrates.

On the other hand, in this Example, as shown in the experiment No.842-844 and experiment No.851-853 of Table 37, it was confirmed that the single-crystal thin films excellent in crystallinity can easily be formed on them when the AlN thin films of an amorphous state, a polycrystal, and an orientated polycrystal were formed beforehand, even if the substrates comprising the same sintered compacts are used.

In addition, as shown in the experiment No.861 of Table 37 in this Example, the direct formation of a single-crystal thin film was difficult on the aluminum nitride-based sintered compact adding SiO₂ 50 volume %, but it was confirmed that the single-crystal thin films excellent in crystallinity can easily be formed on them as shown in the experiment No.862-864, when the AlN thin films of an amorphous state, a polycrystal, and an orientated polycrystal were formed beforehand, even if the same substrates were used.

Table 38 shows the examples which used the substrates comprising the aluminum nitride-based sintered compacts adding each transition metal component of Mo, W, V, Nb, Ta and Ti, and carbon as an additive.

In Table 38, all the substrates comprising the aluminum nitride-based sintered compacts which were produced in Example 19 and are indicated in Table 21 are used as they are, except for the substrates comprising the aluminum nitride-based sintered compacts which were used in the experiment No.884-887 and were produced by adding W 75 volume % on an element basis.

As shown in each experiment of Table 38, in all the substrates comprising the aluminum nitride-based sintered compacts forming beforehand the thin film(s) comprising the various crystallization states, such as an amorphous state, a polycrystal, an orientated polycrystal, and a single crystal, etc., the single-crystal thin films comprising as a main component at least one selected from gallium nitride, indium nitride and aluminum nitride may be formed on those.

These single-crystal thin films had the crystallinity, such that the half width of the rocking curve of the lattice plane of the Miller Index (002) is not more than 300 seconds.

It was confirmed that the crystallinity of these single-crystal thin films was improved than what was formed directly on the same substrates comprising an aluminum nitride-based sintered compact.

When what formed beforehand the thin film(s) comprising the various crystallization states, such as an amorphous state, a polycrystal, an orientated polycrystal, and a single crystal, etc., onto the substrates comprising the aluminum nitride-based sintered compacts shown in Table 38 of this Example is used, many of the half width of the rocking curve of the lattice plane of the Miller Index (002) of these single-crystal thin films formed on them were not less than 100 seconds in the substrates containing at least one selected from each transition metal component of Mo, W, V, Nb, Ta and Ti, and carbon not less than 50 volume % on an element basis, but many of them were not more than 100 seconds in the other substrates containing at least one selected from each transition metal component of Mo, W, V, Nb, Ta and Ti, and carbon not more than 50 volume % on an element basis.

Even if the substrates comprising an aluminum nitride-based sintered compact containing the compound(s) containing each transition metal component of Mo, W, V, Nb, Ta and Ti, and carbon as an additive are what cannot directly form a single-crystal thin film on them, it was confirmed that the single-crystal thin films comprising as a main component at least one selected from gallium nitride, indium nitride and aluminum nitride may be formed on them, if what beforehand formed directly the thin film(s) comprising the various crystallization states, such as an amorphous state, a polycrystal, and an orientated polycrystal, etc., is used as a substrate as shown in Table 38 in this Example.

As shown in the experiment No.431, and 435 of Table 21 of Example 19, the thin films formed on the substrates using the aluminum nitride-based sintered compacts adding Mo 55 volume % on an element basis and W 55 volume % on an element basis are a polycrystalline substance in which the diffraction peak is shown from the lattice plane of the Miller Index (002), (101), (102), and the direct formation of a single-crystal thin film was difficult on these substrates.

On the other hand, in this Example, it was confirmed that the single-crystal thin films excellent in crystallinity can easily be formed on them when the AlN thin film(s) of an amorphous state, a polycrystal, and an orientated polycrystal is formed beforehand, even if the substrates comprising the same sintered compacts are used as shown in the experiment No.875-877 and experiment No.881-883 of Table 38.

Furthermore, as shown in the experiment No.884 of Table 38 in this Example, the thin film formed on the substrate using the aluminum nitride-based sintered compact adding W 75 volume % is a polycrystalline substance in which the diffraction peak is shown from the lattice plane of the Miller Index (002), (101), (102), and the direct formation of a single-crystal thin film was difficult on this substrate.

On the other hand, it was confirmed that the single-crystal thin films excellent in crystallinity can easily be formed on them when the AlN thin film(s) of an amorphous state, a polycrystal, and an orientated polycrystal is formed beforehand, even if the substrates comprising the same sintered compacts are used as shown in the experiment No.885-887.

Table 39 shows the examples using the substrates comprising the aluminum nitride-based sintered compacts adding each transition metal component of Mo, W and V, and carbon and adding further at least one or more of a rare earth element and an alkaline-earth-metal component as an additive.

In Table 39, all the substrates comprising the aluminum nitride-based sintered compacts which were produced in Example 19 and are indicated in Table 22 are used as they are, except for the substrates comprising the aluminum nitride-based sintered compacts which were used in the experiment No.913-916 and were produced by adding together W 60 volume % on an element basis and Er₂O₃ 3.6 volume % on the basis of oxide.

As shown in each experiment of Table 39, in all the substrates comprising the aluminum nitride-based sintered compacts forming beforehand the thin film(s) comprising the various crystallization states, such as an amorphous state, a polycrystal, an orientated polycrystal, and a single crystal, etc., the single-crystal thin films comprising as a main component at least one selected from gallium nitride, indium nitride and aluminum nitride may be formed on those.

These single-crystal thin films had the crystallinity, such that the half width of the rocking curve of the lattice plane of the Miller Index (002) is not more than 300 seconds.

It was confirmed that the crystallinity of these single-crystal thin films was improved than what was formed directly on the same substrates comprising an aluminum nitride-based sintered compact.

When what formed beforehand the thin film(s) comprising the various crystallization states, such as an amorphous state, a polycrystal, an orientated polycrystal, and a single crystal, etc., onto the substrates comprising the aluminum nitride-based sintered compacts shown in Table 39 of this Example is used, many of the half width of the rocking curve of the lattice plane of the Miller Index (002) of the single-crystal thin films formed on those were not less than 100 seconds in the substrates containing these not less than 50 volume % in total, when the content of each transition metal component of Mo, W and V, and carbon is calculated on an element basis, and the content of a rare earth element and an alkaline-earth-metal component is calculated on the basis of oxide, but many of them were not more than 100 seconds in the substrates containing the above component not more than 50 volume % in total.

As for the substrates comprising an aluminum nitride-based sintered compact containing together the compound containing each transition metal component of Mo, W, V, Nb, Ta and Ti, and carbon and the compound containing at least one or more of a rare earth element and alkaline-earth-metal component, even if they are what cannot form directly a single-crystal thin film on them, it was confirmed that the single-crystal thin films comprising as a main component at least one selected from gallium nitride, indium nitride and aluminum nitride may be formed on them, if what beforehand formed directly the thin film(s) comprising the various crystallization states, such as an amorphous state, a polycrystal, and an orientated polycrystal, etc., is used as a substrate as shown in Table 39 in this Example.

As for the thin film formed on the substrate using the aluminum nitride-based sintered compact adding together W 60 volume % on an element basis and Er₂O₃ 3.6 volume % on the basis of oxide as shown in the experiment No.913 of Table 39 in this Example, it is the polycrystalline substance in which the diffraction peak is shown from the lattice plane of the Miller Index (002), (101), (102), and the direct formation of a single-crystal thin film was difficult on this substrate.

On the other hand, as shown in the experiment No.914-916, it was confirmed that the single-crystal thin films excellent in crystallinity can easily be formed on them when the AlN thin film(s) of an amorphous state, a polycrystal, and an orientated polycrystal is formed beforehand, even if the substrates comprising the same sintered compacts are used.

Table 40 shows the examples using the substrates comprising the aluminum nitride-based sintered compact containing the compound(s) containing the unescapable metal(s), such as Fe, Ni, Cr, Mn, Zr, Hf, Co, Cu and Zn, or containing together the compound(s) containing these unescapable metals and at least one or more of a rare earth element compound and an alkaline-earth-metal compound, as an additive.

In Table 40, all the substrates comprising the aluminum nitride-based sintered compacts which were produced in Example 19 and are indicated in Table 23 are used as they are, except for the substrates comprising the aluminum nitride-based sintered compacts which were used in the experiment No.930-931 and were produced by adding Fe 72 % by weight on an element basis.

As shown in each experiment of Table 40, in all the substrates comprising the aluminum nitride-based sintered compacts forming beforehand the thin film(s) comprising the various crystallization states, such as an amorphous state, a polycrystal, an orientated polycrystal, and a single crystal, etc., the single-crystal thin films comprising as a main component at least one selected from gallium nitride, indium nitride and aluminum nitride may be formed on those.

These single-crystal thin films had the crystallinity, such that the half width of the rocking curve of the lattice plane of the Miller Index (002) is not more than 300 seconds.

It was confirmed that the crystallinity of these single-crystal thin films was improved than what was formed directly on the same substrates comprising an aluminum nitride-based sintered compact.

When what formed beforehand the thin film(s) comprising the various crystallization states, such as an amorphous state, a polycrystal, an orientated polycrystal, and a single crystal, etc., onto the substrates comprising the aluminum nitride-based sintered compacts shown in Table 40 of this Example is used, many of the half width of the rocking curve of the lattice plane of the Miller Index (002) of the single-crystal thin films formed on them were not less than 100 seconds in the substrates containing at least one selected from Fe, Ni, Cr, Mn, Zr, Hf, Co, Cu and Zn not less than 50 % by weight on an element basis, but it was not more than 100 seconds in the other substrates containing at least one selected from Fe, Ni, Cr, Mn, Zr, Hf, Co, Cu and Zn not more than 50 % by weight on an element basis.

Even if the substrates comprising the aluminum nitride-based sintered compacts containing the unescapable metallic compound(s), such as Fe, Ni, Cr, Mn, Zr, Hf, Co, Cu and Zn, as an additive are what cannot directly form a single-crystal thin film on them, it was confirmed that the single-crystal thin films comprising as a main component at least one selected from gallium nitride, indium nitride and aluminum nitride may be formed on them, if what beforehand formed directly the thin film(s) comprising the various crystallization states, such as an amorphous state, a polycrystal, and an orientated polycrystal, etc., is used as a substrate as shown in Table 40 in this Example.

As shown in the experiment No.462 of Table 23 of Example 19, as for the thin film formed on the substrate using the aluminum nitride-based sintered compact adding Fe 55 % by weight on an element basis, it is the polycrystalline substance in which the diffraction peak is shown from the lattice plane of the Miller Index (002), (101), (102), and the direct formation of a single-crystal thin film was difficult on this substrate.

On the other hand, in this Example, as shown in the experiment No.927-929 of Table 40, it was confirmed that the single-crystal thin films excellent in crystallinity can easily be formed on them when the AlN thin film(s) of an amorphous state, a polycrystal, and an orientated polycrystal is formed beforehand, even if the substrates comprising the same sintered compacts are used.

Furthermore, as shown in the experiment No.930 of Table 40 in this Example, as for the thin film formed on the substrate using the aluminum nitride-based sintered compact adding Fe 72 % by weight, it is the polycrystalline substance in which the diffraction peak is shown from the lattice plane of the Miller Index (002), (101), (102), and the direct formation of a single-crystal thin film was difficult on this substrate.

On the other hand, as shown in the experiment No.931, it was confirmed that the single-crystal thin film excellent in crystallinity can easily be formed on it if the AlN orientated polycrystalline thin film is formed beforehand, even if the substrate comprising the same sintered compact is used.

In this Example, the appearance of all the thin films produced in the experiment indicated in Tables 35-40 was investigated, but defects, such as a crack and a crevice, are not seen altogether in the thin film(s) formed beforehand on the substrate, and in the thin films formed furthermore on them.

Although the exfoliation test was carried out using the pressure sensitive adhesive tape, in all the thin films, exfoliations were not seen between them and the substrates comprising the aluminum nitride-based sintered compacts, or between thin films.

The thin film-conductive material of Ti/Pt/Au was formed on the thin films of the surface of the substrates, the metal leads were soldered and the perpendicular tensile strength was investigated, but it all is not less than 2 Kg/mm², so there are firm unifications between the aluminum nitride-based sintered compacts and the thin films formed beforehand on the substrates, and between these thin films and the thin films formed furthermore on them.

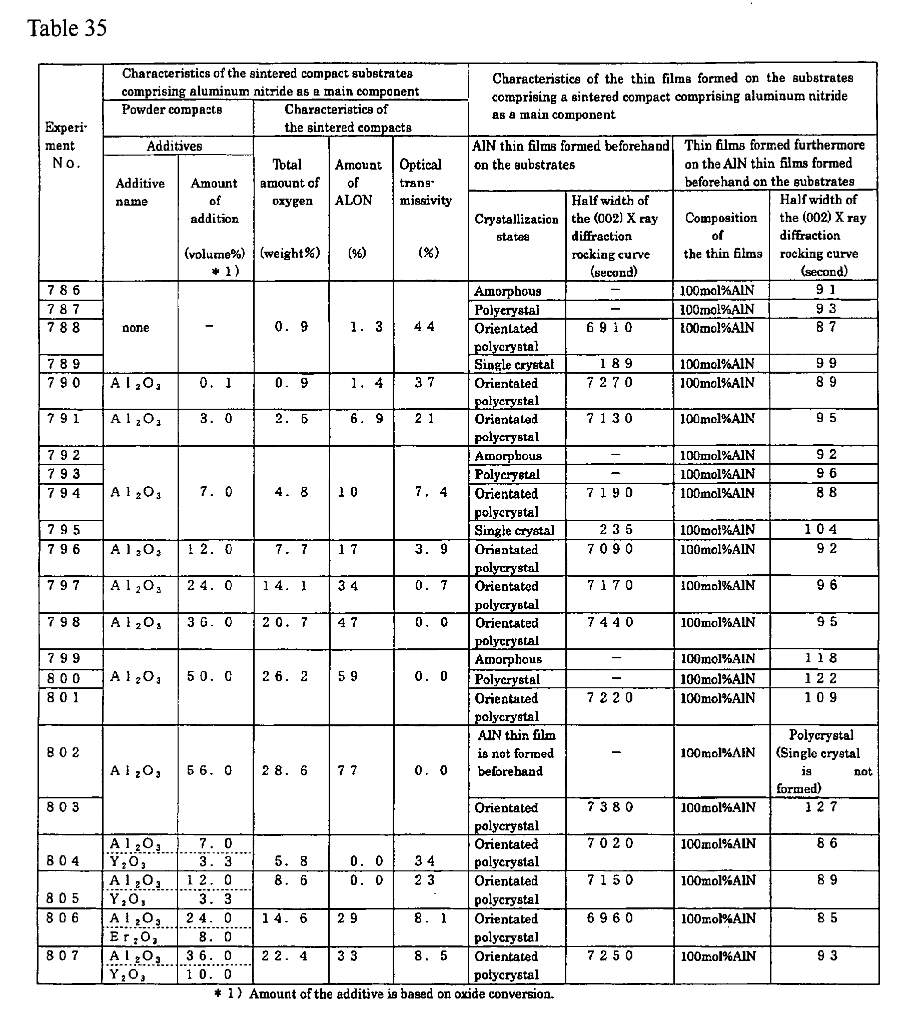

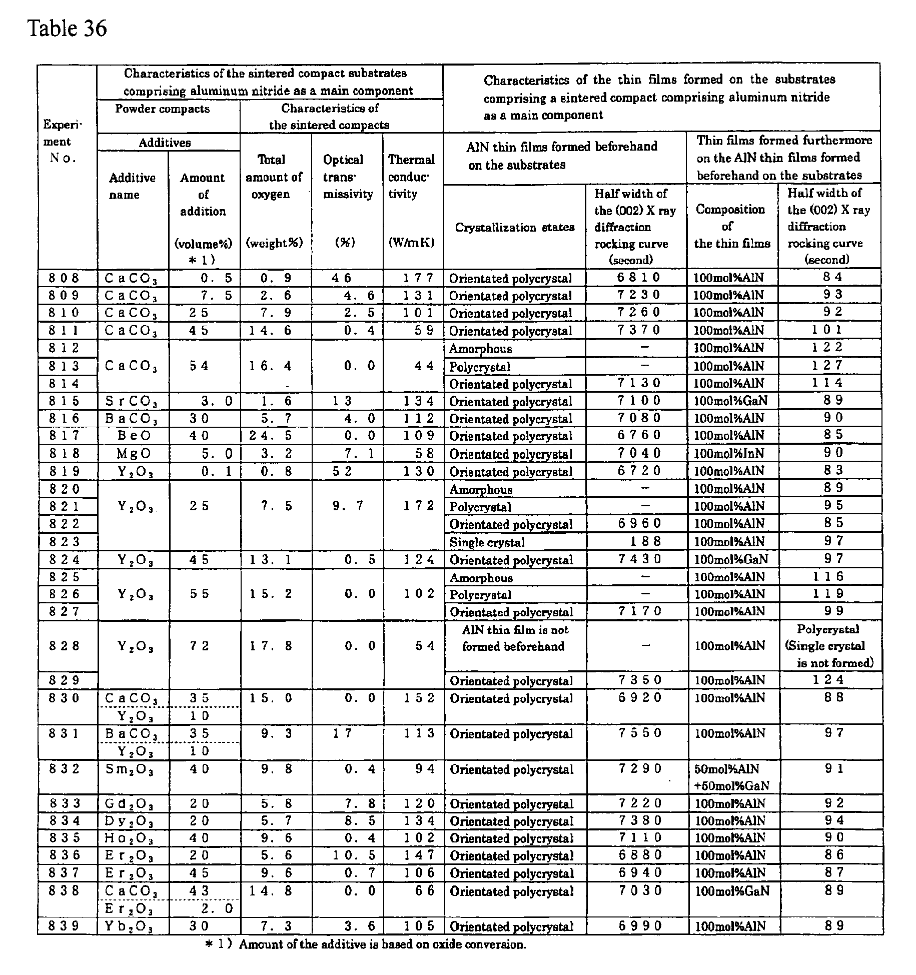

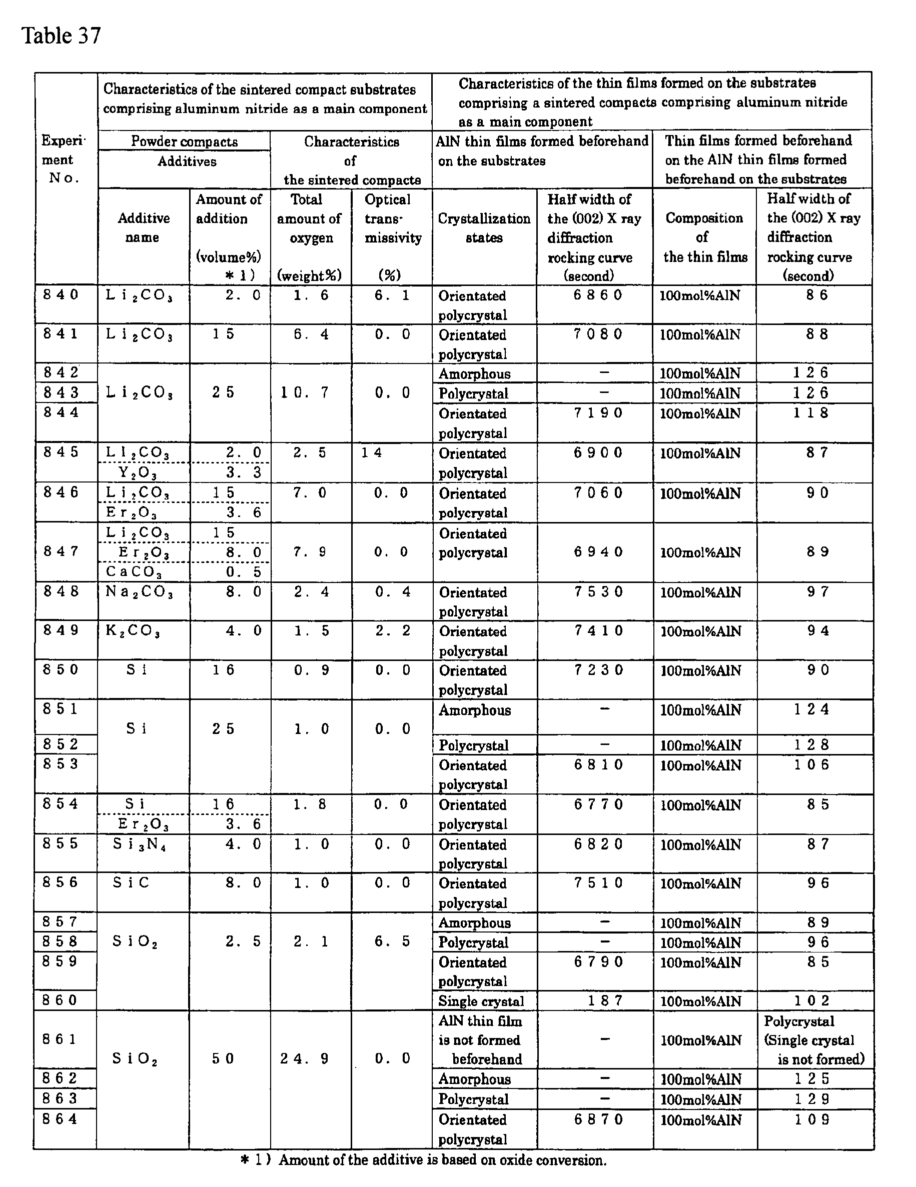

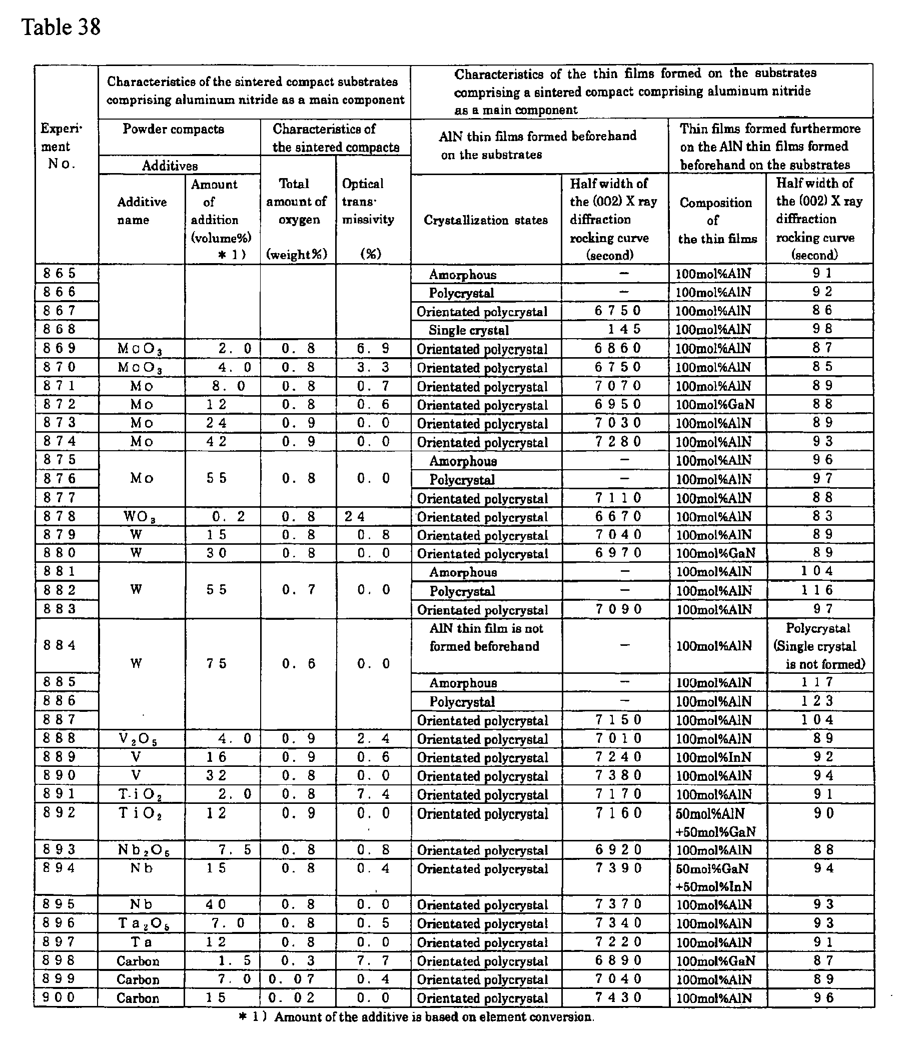

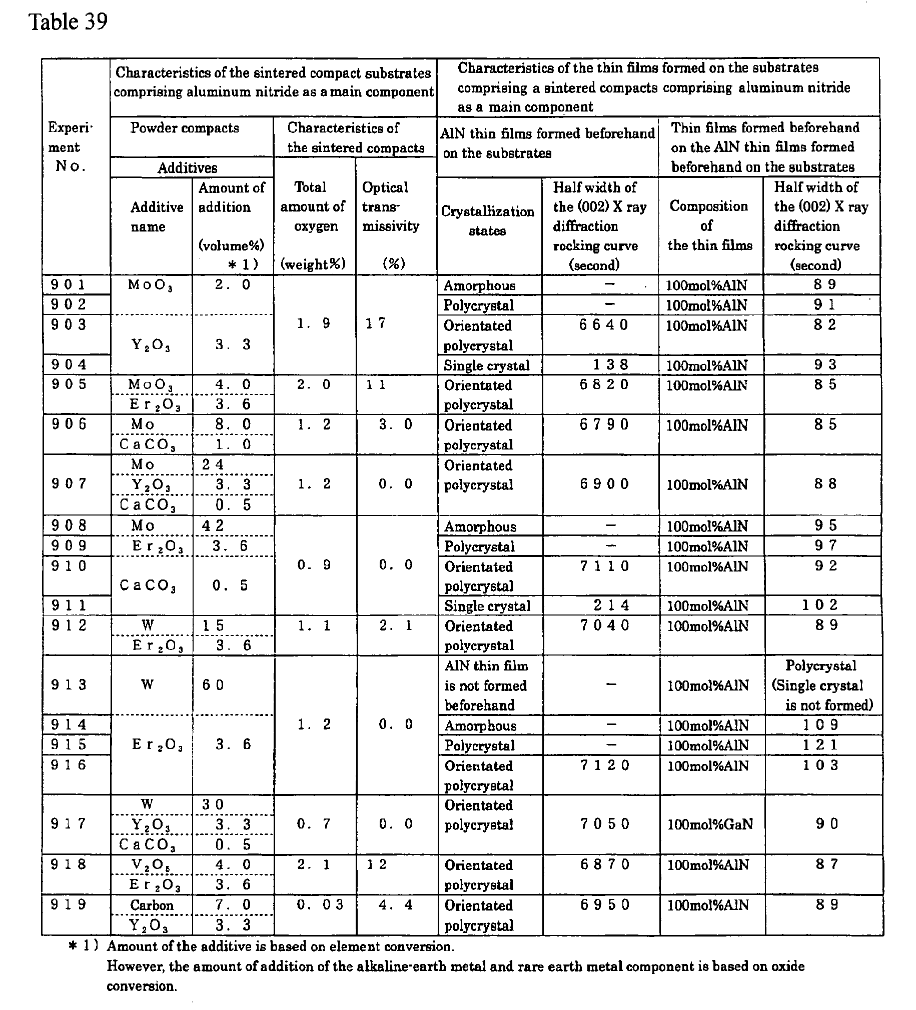

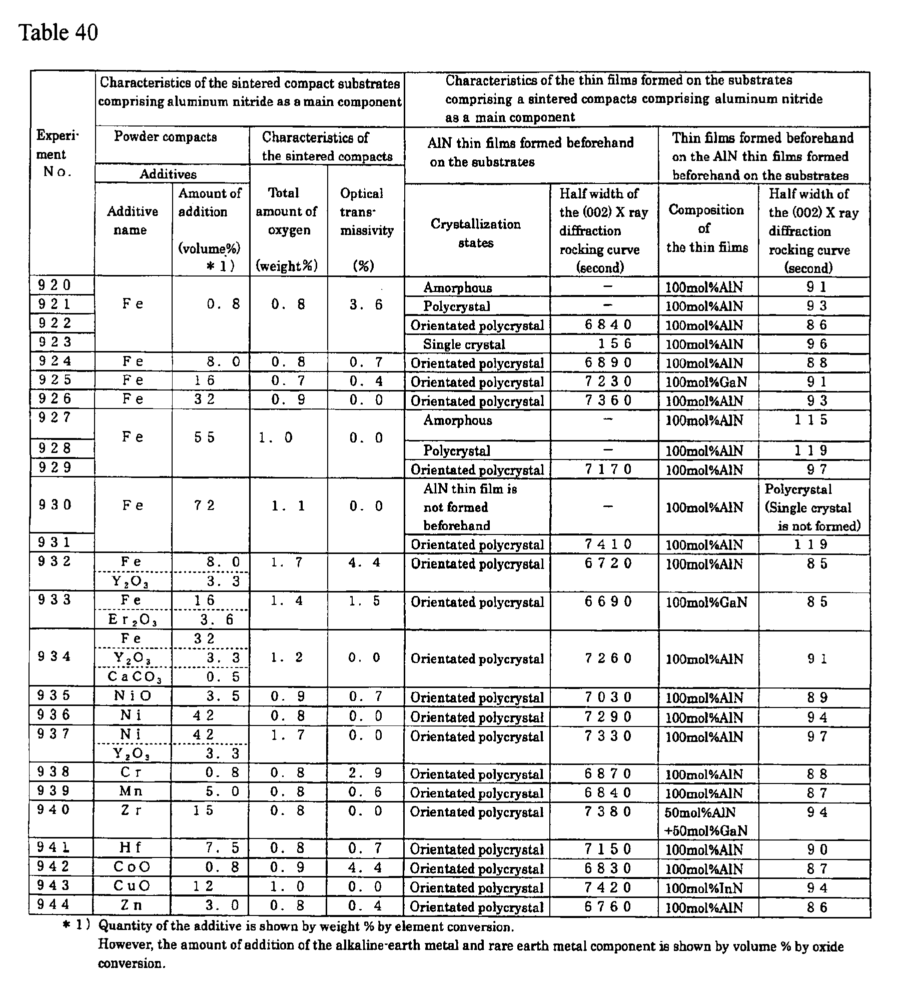

### Example 27

This Example shows the examples in which further formation of the single-crystal thin films comprising as a main component at least one selected from gallium nitride, indium nitride and aluminum nitride was tried onto the substrates in which the thin films were formed, after the single-crystal thin film, amorphous thin film, polycrystalline thin film, and orientated polycrystalline thin film which comprise as a main component at least one selected from gallium nitride, indium nitride and aluminum nitride were formed beforehand on the substrates by the MOCVD method, the sputtering method, and the ion-plating method, using the sintered compacts comprising as a main component silicon carbide, silicon nitride, zinc oxide, beryllium oxide and aluminum oxide, as a substrate.

First, the substrates comprising the sintered compacts produced in Example 1 and comprising as a main component silicon carbide, silicon nitride, zinc oxide, beryllium oxide, and aluminum oxide were prepared.

To these substrate surfaces, specular surface polishing was given by the same method as Example 8 and Example 9, and the ultrasonic washing was carried out with methylene chloride.

Next, after choosing some of the substrates prepared like that, the thin films of 100 mol % AlN were formed beforehand on them in the thickness of 3 µm by the same conditions as the sputtering method carried out in the experiment No.706, 707 and 708 and the MOCVD method carried out in the experiment No.709 of Example 25.

Furthermore, the thin films of 100 mol % GaN were formed beforehand in the thickness of 3 µm under the same conditions as the MOCVD method carried out in the experiment No.714, 728, 729, and 730, and the thin films of 100 mol % InN were formed beforehand in the thickness of 3 µm under the same conditions as the MOCVD method carried out in the experiment No.715 and 731.

Next, the thin films of each composition of the same 100 mol % AlN, 100 mol % GaN, 100 mol % InN, 50 mol % AlN+50 mol % GaN, and 50 mol % GaN+50 mol % InN as what was described in Example 19 were formed furthermore on them in the thickness of 3 µm by the MOCVD method, using the substrates in which the AlN thin film, the GaN thin film and the InN thin film were formed beforehand, and the substrates left without forming the AlN thin film, as mentioned above.

As for the conditions of MOCVD, they were the same as Example 1 and Example 2, as described in Example 19.

The characteristics of the thin films produced like that were shown in Table 41 and 42.
In Table 41, the examples using AlN as the thin film formed beforehand are indicated.

In Table 42, the examples using GaN and InN as the thin film formed beforehand are indicated.

As shown in Table 41, as for the GaN thin films formed beforehand by the MOCVD method directly on the substrates comprising the sintered compacts comprising as a main component silicon carbide, silicon nitride, zinc oxide, beryllium oxide and aluminum oxide, what corresponded to the crystallization state of the AlN thin films formed in the experiment No.706, 707, 708 and 709 of Example 25 was formed as well as the aluminum nitride-based sintered compacts.

That is, the AlN thin films of the experiment No.948, 959, 966, and 977 which were formed by the sputtering method under the same condition as the experiment No.706 were amorphous, and the AlN thin films of the experiment No.949, 967, and 978 which were formed by the sputtering method under the same condition as the experiment No.707 were the polycrystal in which the diffraction lines have appeared from the lattice plane of the Miller Index (002), (101), (102).

As for the AlN thin films formed by the sputtering method of the same conditions as the experiment No.708, only the diffraction line from the lattice plane of the Miller Index (002) has appeared, and they were the orientated polycrystal formed in the direction where C axis is perpendicular to the substrate surface.

As for the AlN thin films of the experiment No.951, 969, 980, and 989 which were formed by the MOCVD method under the same condition as the experiment No.709, only the diffraction line from the lattice plane of the Miller Index (002) has appeared, and it was confirmed that they are the single crystal formed in the direction where C axis is perpendicular to the substrate surface.

In Table 41, the half width of the rocking curve of the X ray diffraction line from the lattice plane of the Miller Index (002) of the thin films formed in the states of the orientated polycrystal and the single crystal among the thin films formed beforehand on these substrates is indicated.

Next, as for the crystallinity of the thin films which comprise each above composition of 100 mol % AlN, 100 mol % GaN, 100 mol % InN, 50 mol % AlN+50 mol % GaN, and 50 mol % GaN+50 mol % InN and were formed by the MOCVD method on the substrates on which the AlN thin film(s) of various crystallization states was formed beforehand, and on the substrates comprising the sintered compacts not forming the AlN thin film(s) and comprising as a main component silicon carbide, silicon nitride, zinc oxide, beryllium oxide and aluminum oxide, it was investigated by X ray diffraction.

As a result, it was confirmed that all the produced thin films are the single crystal formed in the direction where C axis is perpendicular to the substrate surface.

If the crystallinity is seen, as for the half width of the rocking curve of the X ray diffraction line from the lattice plane of the Miller Index (002), it is not less than 240 seconds altogether in the case of the AlN, GaN, and InN single-crystal thin films which were formed directly on the substrates in which the AlN thin film(s) was not formed beforehand on the substrates comprising the sintered compacts comprising as a main component silicon carbide, silicon nitride, zinc oxide, beryllium oxide and aluminum oxide, but it is not more than 200 seconds altogether in the case of the AlN, GaN, and InN single-crystal thin films which were formed furthermore on the AlN thin film(s) formed beforehand on the above substrates comprising the various ceramics as a main component, and it was confirmed that the single-crystal thin films excellent in crystallinity are clearly obtained.

In each sintered compact, it was shown that the single crystal(s) formed on it has the tendency in which what has excellent crystallinity is easy to be formed, if the crystallization state of the AlN thin film formed beforehand is an orientated polycrystal than a single crystal, an amorphous state, and a polycrystal.

Based on the experimental result shown in Table 41, the details are stated below.

While the half width of the rocking curve of the X ray diffraction line from the lattice plane of the Miller Index (002) of the single-crystal thin films formed directly on the substrates comprising a silicon carbide-based sintered compact is in the range of 255-283 seconds, it is in the range of 139-192 seconds in the case of the single-crystal thin films formed on the substrates forming beforehand the AlN thin film, so the single-crystal thin films in which the crystallinity was improved clearly are obtained.

While the half width of the rocking curve of the X ray diffraction line from the lattice plane of the Miller Index (002) of the single-crystal thin films formed on them is in the range of 169-192 seconds when the AlN thin films formed beforehand are the crystallization state of an amorphous state, a polycrystal, and a single crystal, it is in the range of 139-147 seconds in the case of the crystallization state of an orientated polycrystal, so the single-crystal thin films in which the crystallinity was improved more are obtained.

While the half width of the rocking curve of the X ray diffraction line from the lattice plane of the Miller Index (002) of the single-crystal thin films formed directly on the substrates comprising a silicon nitride-based sintered compact is the range of 493-647 seconds, it is in the range of 163-188 seconds in the case of the single-crystal thin films formed on the substrates forming beforehand the AlN thin film, so the single-crystal thin films in which the crystallinity was improved clearly are obtained.

While the half width of the rocking curve of the X ray diffraction line from the lattice plane of the Miller Index (002) of the single-crystal thin film formed on it is 188 seconds when the AlN thin film formed beforehand is the crystallization state of an amorphous state, it is in the range of 163-167 seconds in the case of the crystallization state of an orientated polycrystal, so the single-crystal thin films in which the crystallinity was improved more are obtained.

While the half width of the rocking curve of the X ray diffraction line from the lattice plane of the Miller Index (002) of the single-crystal thin films formed directly on the substrates which comprise an aluminum oxide-based sintered compact is in the range of 377-426 seconds, it is in the range of 155-195 seconds in the case of the single-crystal thin films formed on the substrates forming beforehand the AlN thin film, so the single-crystal thin films in which the crystallinity was improved clearly are obtained.

While the half width of the rocking curve of the X ray diffraction line from the lattice plane of the Miller Index (002) of the single-crystal thin films formed on them is in the range of 169-195 seconds when the AlN thin films formed beforehand are the crystallization state of an amorphous state, a polycrystal, and a single crystal, it is in the range of 155-163 seconds in the case of the crystallization state of an orientated polycrystal, so the single-crystal thin films in which the crystallinity was improved more are obtained.

While the half width of the rocking curve of the X ray diffraction line from the lattice plane of the Miller Index (002) of the single-crystal thin films formed directly on the substrates which comprise a zinc oxide-based sintered compact is the range of 258-291 seconds, it is in the range of 136 -196 seconds in the case of the single-crystal thin films formed on the substrates which formed beforehand the AlN thin film, so the single-crystal thin films in which the crystallinity was improved clearly are obtained.

While the half width of the rocking curve of the X ray diffraction line from the lattice plane of the Miller Index (002) of the single-crystal thin films formed on them is in the range of 182-196 seconds when the AlN thin films formed beforehand are the crystallization state of an amorphous state, a polycrystal, and a single crystal, it is in the range of 136-144 seconds in the case of the crystallization state of an orientated polycrystal, so the single-crystal thin films in which the crystallinity was improved more are obtained.

While the half width of the rocking curve of the X ray diffraction line from the lattice plane of the Miller Index (002) of the single-crystal thin films formed directly on the substrates comprising a beryllium oxide-based sintered compact is in the range of 268-290 seconds, it is in the range of 137-192 seconds in the case of the single-crystal thin films formed on the substrates forming beforehand the AlN thin film, so the single-crystal thin films in which the crystallinity was improved clearly are obtained.

While the half width of the rocking curve of the X ray diffraction line from the lattice plane of the Miller Index (002) of the single-crystal thin films formed on it is 202 seconds when the AlN thin film formed beforehand is the crystallization state of a single crystal, it is in the range of 136-144 seconds in the case of the crystallization state of an orientated polycrystal, so the single-crystal thin films in which the crystallinity was improved more are obtained.

As for the GaN thin films beforehand formed directly on the substrates comprising the sintered compacts comprising as a main component silicon carbide, silicon nitride, zinc oxide, beryllium oxide and aluminum oxide by the MOCVD method, what corresponded to the crystallization state of the AlN thin films formed in the experiment No.714, 728, 729, and 730 of Example 25 was formed as well as the aluminum nitride-based sintered compact, as shown in Table 42.

As for the InN thin films formed beforehand by the MOCVD method directly, what corresponded to the crystallization state of the InN thin films formed in the experiment No.715 and 731 of Example 25 was formed, as shown in Table 42.

That is, the GaN thin films of the experiment No.994, 1003, 1010, 1019 and 1028 formed by the MOCVD method under the same condition as the experiment No.728, were amorphous, and the GaN thin films of the experiment No.995, 1004, 1011, 1020 and 1029 formed by the MOCVD method under the same condition as the experiment No.729, were the polycrystal in which the diffraction lines have appeared from the lattice plane of the Miller Index (002), (101).

As for the GaN thin films formed by the MOCVD method under the same conditions as the experiment No.730, only the diffraction line from the lattice plane of the Miller Index (002) was appeared, and they were the orientated polycrystal formed in the direction where C axis is perpendicular to the substrate surface.

As for the GaN thin films of the experiment No.997, 1006, 1013, 1022 and 1031 formed by the MOCVD method under the same condition as the experiment No.714, only the diffraction line from the lattice plane of the Miller Index (002) has appeared, and it was confirmed that they are the single crystal formed in the direction where C axis is perpendicular to the substrate surface.

As for the InN thin films of the experiment No.1001, 1008, 1017, 1026 and 1035 formed by the MOCVD method under the same condition as the experiment No.731, only the diffraction line from the lattice plane of the Miller Index (002) has appeared, and they were the orientated polycrystal formed in the direction where C axis is perpendicular to the substrate surface.

As for the InN thin films of the experiment No.1002, 1009, 1018, 1027 and 1036 formed by the MOCVD method under the same condition as the experiment No.715, only the diffraction line from the lattice plane of the Miller Index (002) has appeared, and it was confirmed that they are the single crystal formed in the direction where C axis is perpendicular to the substrate surface.

As mentioned above, as for the crystallization states identified by X ray diffraction of the thin films beforehand formed directly on these substrates comprising the sintered compacts comprising as a main component silicon carbide, silicon nitride, zinc oxide, beryllium oxide and aluminum oxide, they are shown in Table 42.

As for the thin films identified as an orientated polycrystal and a single crystal among these thin films, the half width of the rocking curve of the X ray diffraction from the lattice plane of the Miller Index (002) is indicated.

Next, as for the crystallinity of the thin films which comprise each above composition of 100 mol % AlN, 100 mol % GaN, 100 mol % InN, 50 mol % AlN+50 mol % GaN, and 50 mol % GaN+50 mol % InN and were formed on the substrates forming beforehand the GaN thin film and InN thin film of various crystallization states by the MOCVD method, and on the substrates comprising the sintered compacts not forming a GaN thin film and an InN thin film and comprising as a main component silicon carbide, silicon nitride, zinc oxide, beryllium oxide and aluminum oxide, it was investigated by X ray diffraction.

As a result, it was confirmed that all the produced thin films are the single crystal formed in the direction where C axis is perpendicular to the substrate surface.

If the crystallinity is seen, as for the AlN, GaN, and InN single-crystal thin films formed directly on the substrates without beforehand forming the GaN thin film and InN thin film on the substrates comprising the sintered compacts comprising as a main component silicon carbide, silicon nitride, zinc oxide, beryllium oxide and aluminum oxide, the half width of the rocking curve of the X ray diffraction from the lattice plane of the Miller Index (002) is not less than 240 seconds altogether as shown in Table 42, but it is not more than 200 seconds altogether in the case of the AlN, GaN, and InN single-crystal thin films formed furthermore on the GaN thin film and InN thin film which were formed beforehand on the substrates comprising various ceramics as a main component, so it was confirmed that the single-crystal thin films excellent in crystallinity are clearly obtained.

In each sintered compact, if the crystallization state of the GaN thin film and InN thin film formed beforehand is an orientated polycrystal, it was shown that the single crystals formed on them have the tendency in which those excellent in crystallinity are easy to be formed than what is a single crystal, an amorphous state, and a polycrystal.

Based on the result shown in Table 42, the details are stated below.

While the half width of the rocking curve of the X ray diffraction from the lattice plane of the Miller Index (002) of the single-crystal thin films formed directly on the substrate comprising a silicon carbide-based sintered compact is in the range of 255-283 seconds, it is in the range of 137-189 seconds in the case of the single-crystal thin films formed on the substrates forming beforehand the GaN thin film or the InN thin film, so the single-crystal thin films in which the crystallinity was clearly improved are obtained.

While the half width of the rocking curve of the X ray diffraction from the lattice plane of the Miller Index (002) of the single-crystal thin films formed on them is in the range of 165-189 seconds when the GaN thin film or InN thin film formed beforehand is the crystallization state of an amorphous state, a polycrystal and a single crystal, it is in the range of 137-146 seconds in the case of the crystallization state of an orientated polycrystal, so the single-crystal thin films in which the crystallinity was improved more are obtained.

While the half width of the rocking curve of the X ray diffraction from the lattice plane of the Miller Index (002) of the single-crystal thin films formed directly on the substrate comprising a silicon nitride-based sintered compact is in the range of 493-647 seconds, it is in the range of 141-189 seconds in the case of the single-crystal thin films formed on the substrates forming beforehand the GaN thin film or the InN thin film, so the single-crystal thin films in which the crystallinity was clearly improved are obtained.

While the half width of the rocking curve of the X ray diffraction from the lattice plane of the Miller Index (002) of the single-crystal thin films formed on them is in the range of 169-189 seconds when the GaN thin film or InN thin film formed beforehand is the crystallization state of an amorphous state, a polycrystal and a single crystal, it is in the range of 161-167 seconds in the case of the crystallization state of an orientated polycrystal, so the single-crystal thin films in which the crystallinity was improved more are obtained.

While the half width of the rocking curve of the X ray diffraction from the lattice plane of the Miller Index (002) of the single-crystal thin film formed directly on the substrate comprising an aluminum oxide-based sintered compact is in the range of 377-426 seconds, it is in the range of 154-190 seconds in the case of the single-crystal thin films formed on the substrates forming beforehand the GaN thin film or the InN thin film, so the single-crystal thin films in which the crystallinity was clearly improved are obtained.

While the half width of the rocking curve of the X ray diffraction from the lattice plane of the Miller Index (002) of the single-crystal thin films formed on them is in the range of 170-190 seconds when the GaN thin film or InN thin film formed beforehand is the crystallization state of an amorphous state, a polycrystal and a single crystal, it is in the range of 154-165 seconds in the case of the crystallization state of an orientated polycrystal, so the single-crystal thin films in which the crystallinity was improved more are obtained.

While the half width of the rocking curve of the X ray diffraction from the lattice plane of the Miller Index (002) of the single-crystal thin films formed directly on the substrate which comprising a zinc oxide-based sintered compact is in the range of 258-291 seconds, it is in the range of 136-192 seconds in the case of the single-crystal thin films formed on the substrates forming beforehand the GaN thin film or the InN thin film, so the single-crystal thin films in which the crystallinity was clearly improved are obtained.

While the half width of the rocking curve of the X ray diffraction from the lattice plane of the Miller Index (002) of the single-crystal thin films formed on them is in the range of 157-192 seconds when the GaN thin film or InN thin film formed beforehand is the crystallization state of an amorphous state, a polycrystal, and a single crystal, it is in the range of 137-146 seconds in the case of the crystallization state of an orientated polycrystal, so the single-crystal thin films in which the crystallinity was improved more are obtained.

While the half width of the rocking curve of the X ray diffraction from the lattice plane of the Miller Index (002) of the single-crystal thin films formed directly on the substrate comprising a beryllium oxide-based sintered compact is in the range of 268-290 seconds, it is in the range of 138-190 seconds in the case of the single-crystal thin films formed on the substrates forming beforehand the GaN thin film or the InN thin film, so the single-crystal thin films in which the crystallinity was clearly improved are obtained.

While the half width of the rocking curve of the X ray diffraction from the lattice plane of the Miller Index (002) of the single-crystal thin films formed on them is in the range of 160-190 seconds when the GaN thin film or InN thin film formed beforehand is the crystallization state of an amorphous state, a polycrystal and a single crystal, it is in the range of 138-147 seconds in the case of the crystallization state of an orientated polycrystal, so the single-crystal thin films in which the crystallinity was improved are obtained.

In this Example, although the appearance of all the thin films produced in the experiment indicated in Table 41 and Table 42 was investigated, defects, such as a crack and a crevice, are not seen altogether in the thin films formed beforehand on the substrate and the thin films formed furthermore on them.

Although the exfoliation test was carried out using the pressure sensitive adhesive tape, in all the thin films, exfoliations were not seen between them and the substrates comprising the sintered compact, or between thin films.

The thin film-conductive material of Ti/Pt/Au was formed on the thin films of the surface of the substrates, the metal leads were soldered and the perpendicular tensile strength was investigated, but it all is not less than 2 Kg/mm², so there are firm unifications between the sintered compacts and the thin films formed beforehand on the substrates, and between these thin films and the thin films formed furthermore on them.

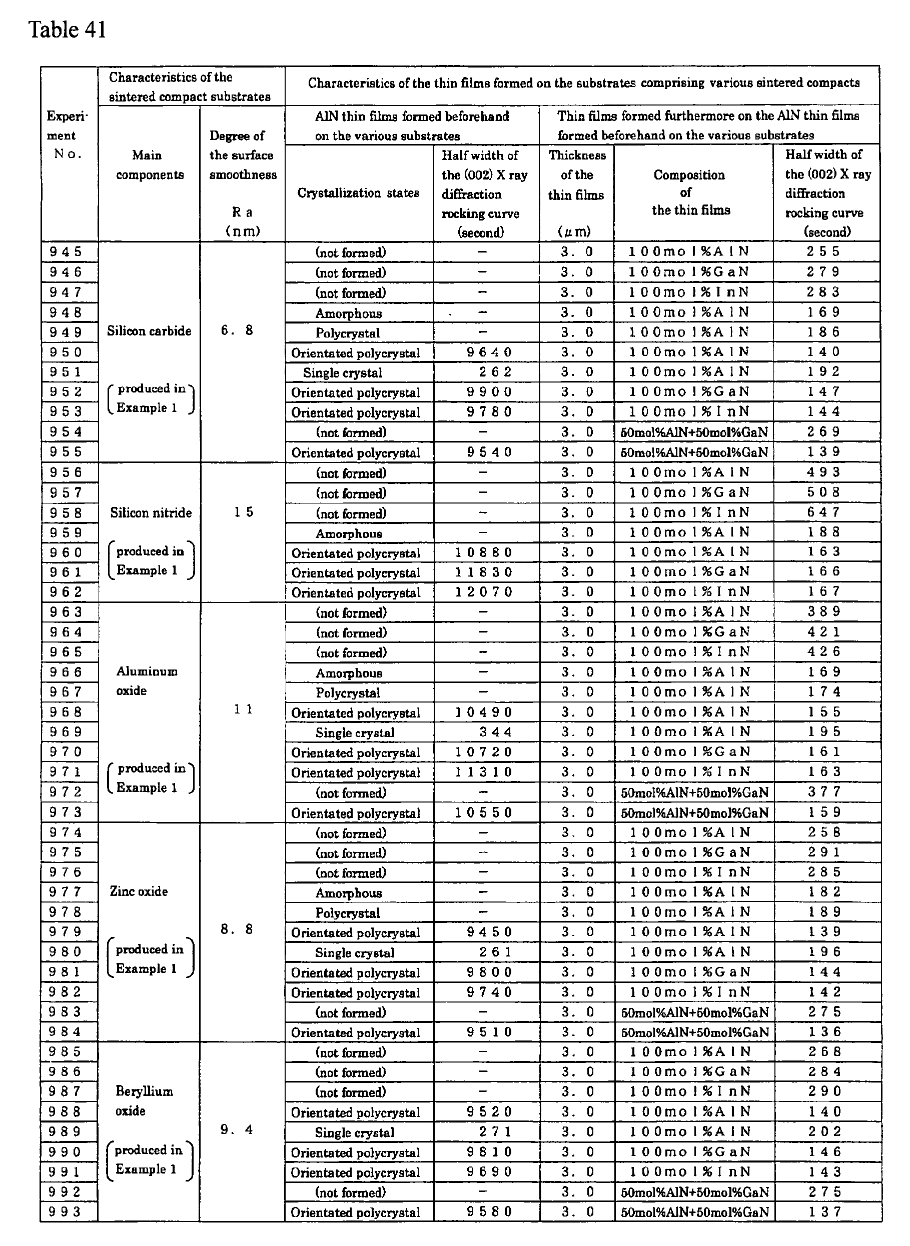

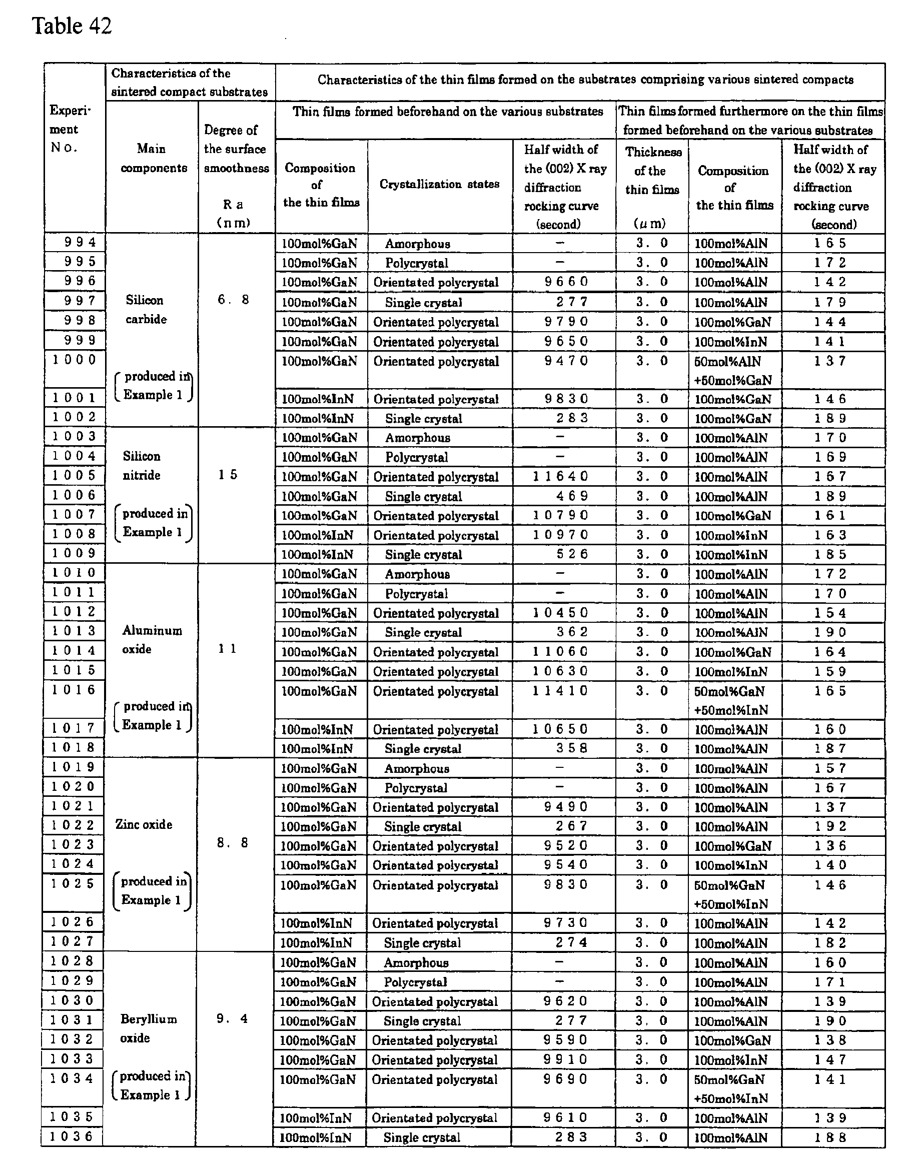

### Example 28

This Example shows the examples which investigated the influence in which the surface smooth nature of the substrates and the layer constitution of the thin films formed on them and comprising as a main component gallium nitride, indium nitride and aluminum nitride gives to the crystallinity of these thin films, using the sintered compacts comprising as a main component silicon carbide, silicon nitride, zinc oxide, beryllium oxide and aluminum oxide, as a substrate.

First, the substrates produced in Example 1 and comprising the sintered compacts comprising as a main component silicon carbide, silicon nitride, zinc oxide, beryllium oxide and aluminum oxide were prepared.

To these substrate surfaces, specular surface polishing was given by the same method as Example 8 and Example 9, and the ultrasonic washing was carried out with methylene chloride.

In addition, the substrates in which the specular surface polish was carried out using the followings respectively as an abradant and using the commercial pad made from cloth as a polisher were also newly prepared.

That is, there also newly prepared that in which the specular surface polish was carried out onto the substrates comprising an aluminum oxide-based sintered compact using the abradant comprising as a main component a colloidal alumina with the particle diameter of 0.05 µm, that in which the specular surface polish was carried out onto the substrate comprising a zinc oxide-based sintered compact using the abradant comprising as a main component cerium oxide with the particle diameter of 0.05 µm, and that in which the specular surface polish was carried out onto the substrate comprising a beryllium oxide-based sintered compact using the abradant comprising as a main component a colloidal silicon oxide with the particle diameter of 0.02 µm.

Next, the thin films were formed by the same method as what was shown in Example 27 on each above-prepared substrate from which the surface smooth nature differs.

That is, the thin films of 100 mol % AlN were formed beforehand on the substrates prepared in the thickness of 3 µm under the same conditions as the sputtering method carried out in the experiment No.706, 707 and 708, and the MOCVD method carried out in the experiment No.709 and 721 of Example 25.

The thin films of 100 mol % GaN were formed beforehand in the thickness of 3 µm under the same condition as the MOCVD method carried out in the experiment No.730, and the thin films of 100 mol % InN were formed beforehand in the thickness of 3 µm under the same condition as the MOCVD method carried out in the experiment No.731.

Next, using the substrates in which the AlN thin film, the GaN thin film and the InN thin film were formed beforehand as mentioned above, the thin films of each composition of the same 100 mol % AlN, 100 mol % GaN, 100 mol % InN, 50 mol % AlN+50 mol % GaN and 50 mol % GaN+50 mol % InN as what was described in Example 19 were formed furthermore on them in the thickness of 3 µm by the MOCVD method.

As the condition of MOCVD, it was same as Example 1 and Example 2, as described in Example 19.

The above experimental result was collectively shown in Table 43.

That is, as for the average surface roughness Ra of the specularly polished substrates newly produced in this Example and comprising respectively the aluminum oxide-based sintered compact, the zinc oxide-based sintered, and the beryllium oxide-based sintered compact, it is shown that it is 7.3 nm, 2.6 nm, and 3.7 nm, respectively, in Table 43.

In this Example, as for the 100 mol % AlN thin films formed beforehand directly on the substrates, what corresponded to the crystallization state of the AlN thin films produced in the experiment No.706, 707, 708, 709, and 721 of Example 25 was formed.

That is, the AlN thin film formed by the sputtering method under the same condition as the experiment No.706, was amorphous, and the AlN thin film formed by the sputtering method of the same condition as the experiment No.707, was the polycrystal in which the diffraction lines have appeared from the lattice plane of the Miller Index (002), (101), (102).

As for the AlN thin film formed by the sputtering method under the same conditions as the experiment No.708, only the diffraction line from the lattice plane of the Miller Index (002) has appeared, and it was the orientated polycrystal formed in the direction where C axis is perpendicular to the substrate surface.

As for the AlN thin film formed by the MOCVD method under the same condition as the experiment No.709, only the diffraction line from the lattice plane of the Miller Index (002) has appeared, and it was confirmed that it is the single crystal formed in the direction where C axis is perpendicular to the substrate surface.

As for the AlN thin film formed by the MOCVD method under the same condition as the experiment No.721, only the diffraction line from the lattice plane of the Miller Index (002) has appeared, it is the orientated polycrystal formed in the direction where C axis is perpendicular to the substrate surface, and the crystallinity was improved than that of the experiment No.708 which showed the crystallization state of the same orientated polycrystal.

As for the 100 mol % GaN thin films formed beforehand directly on the substrates, what corresponded to the crystallization state of the GaN thin film produced in the experiment No.730 of Example 25 was formed.

That is, in the GaN thin films formed by the MOCVD method under the same condition as the experiment No.730, only the diffraction line from the lattice plane of the Miller Index (002) has appeared, and it was the orientated polycrystal formed in the direction where C axis is perpendicular to the substrate surface.

As for the 100 mol % InN thin films formed beforehand directly on the substrates, what corresponded to the crystallization state of the InN thin film produced in the experiment No.731 of Example 25 was formed.

That is, in the InN thin films formed by the MOCVD method of the same condition as the experiment No.731, only the diffraction line from the lattice plane of the Miller Index (002) has appeared, and it was the orientated polycrystal formed in the direction where C axis is perpendicular to the substrate surface.

The crystallization state identified by X ray diffraction of the thin films formed beforehand on these substrates is shown in Table 43, and the half width of the rocking curve of the X ray diffraction from the lattice plane of the Miller Index (002) of the thin films identified as an orientated polycrystal and a single crystal is indicated in it.

Next, as for the crystallinity of the thin films comprising each above composition of the 100 mol %AlN, 100 mol % GaN, 100 mol % InN, 50 mol %AlN+50 mol % GaN, and 50 mol % GaN+50 mol % InN which were formed by the MOCVD method on the substrates comprising the sintered compacts comprising as a main component silicon carbide, silicon nitride, zinc oxide, beryllium oxide and aluminum oxide and forming beforehand the AlN thin film, GaN thin film and InN thin film of various crystallization states, it was investigated by X ray diffraction.

As a result, it was confirmed that all the produced thin films are the single crystal formed in the direction where C axis is perpendicular to the substrate surface.

As for the crystallinity, in all the substrates comprising the sintered compacts comprising as a main component silicon carbide, silicon nitride, zinc oxide, beryllium oxide and aluminum oxide, it was confirmed that there is a tendency which is improved according as the average surface roughness Ra becomes small, as shown in Table 43.

That is, when the substrates in which Ra is larger than 10 nm were used, while the half width of the rocking curve of the X ray diffraction from the lattice plane of the Miller Index (002) of the single-crystal thin films formed is larger than 150 seconds even when the orientated polycrystalline thin films were formed beforehand, the crystallinity is improved into not more than 150 seconds in the case of the Ra not more than 10 nm when the orientated polycrystalline thin films are formed beforehand, and it was confirmed that they are improved more into not more than 130 seconds in the case of the Ra not more than 5 nm even when the thin films formed beforehand are all the case which has the crystallization states of an amorphous state, a polycrystal, an orientated polycrystal and a single crystal.

Based on the result shown in Table 43, the details are stated below.

In the case of the substrates comprising a silicon carbide-based sintered compact, the half width of the rocking curve of the X ray diffraction line from the lattice plane of the Miller Index (002) of the single-crystal thin film formed furthermore on it is 165 seconds when the crystallization state of the thin films formed beforehand on that in which the average surface roughness Ra is 6.8 nm is amorphous, and the half width of the rocking curve of the X ray diffraction from the lattice plane of the Miller Index (002) of the single-crystal thin films formed furthermore on the thin films in which the crystallization state is an orientated polycrystal is in the range of 139-145 seconds, but when the substrate in which the average surface roughness Ra is 2.9 nm was used, the half width of the rocking curve of the X ray diffraction from the lattice plane of the Miller Index (002) of the single-crystal thin films formed furthermore on the amorphous thin film, polycrystalline thin film, orientated polycrystalline thin films and single-crystal thin film which were formed beforehand, is not more than 130 seconds, so the crystallinity was improved.

Especially the half width of the rocking curve of the X ray diffraction line from the lattice plane of the Miller Index (002) of the single-crystal thin films formed furthermore on the orientated polycrystalline thin films formed beforehand was not more than 120 seconds, so it was improved further.

In the case of the substrates comprising a silicon nitride-based sintered compact, while the half width of the rocking curve of the X ray diffraction from the lattice plane of the Miller Index (002) of the single-crystal thin films formed furthermore on the amorphous thin film and orientated polycrystalline thin film which are formed beforehand on that in which the average surface roughness Ra is 15 nm is in the range of 169-189 seconds, when the substrate in which the average surface roughness Ra is 4.4 nm was used, the half width of the rocking curve of the X ray diffraction from the lattice plane of the Miller Index (002) of the single-crystal thin films formed furthermore on the amorphous thin film, polycrystalline thin film, orientated polycrystalline thin films and single-crystal thin film which were formed beforehand, is not more than 130 seconds, so the crystallinity was improved.

Especially the half width of the rocking curve of the X ray diffraction from the lattice plane of the Miller Index (002) of the single-crystal thin films formed furthermore on the orientated polycrystalline thin films formed beforehand was not more than 120 seconds, so it was improved further.

In the case of the substrates comprising an aluminum oxide-based sintered compact, while the half width of the rocking curve of the X ray diffraction from the lattice plane of the Miller Index (002) of the single-crystal thin films formed furthermore on the amorphous thin film and orientated polycrystalline thin film which are formed beforehand on that in which the average surface roughness Ra is 11 nm is in the range of 154-177 seconds, when the substrate in which the average surface roughness Ra is 7.3 nm was used, the half width of the rocking curve of the X ray diffraction from the lattice plane of the Miller Index (002) of the single-crystal thin films formed furthermore on them is in the range of 135-140 seconds in the case where the thin films beforehand formed are the crystallization state of an orientated polycrystal, so the crystallinity was improved.

When the substrate in which the average surface roughness Ra is 1.9 nm was used, the half width of the rocking curve of the X ray diffraction from the lattice plane of the Miller Index (002) of the single-crystal thin films formed furthermore on the amorphous thin film, polycrystalline thin film, orientated polycrystalline thin films and single-crystal thin film which were formed beforehand is not more than 130 seconds, so the crystallinity was improved.

Especially, the half width of the rocking curve of the X ray diffraction from the lattice plane of the Miller Index (002) of the single-crystal thin films formed furthermore on the orientated polycrystalline thin films formed beforehand was not more than 120 seconds, so it was improved further.

In the case of the substrates comprising a zinc oxide-based sintered compact, the half width of the rocking curve of the X ray diffraction from the lattice plane of the Miller Index (002) of the single-crystal thin films formed furthermore on it is 170 seconds when the crystallization state of the thin films formed beforehand on that in which the average surface roughness Ra is 6.8 nm is amorphous, and the half width of the rocking curve of the X ray diffraction from the lattice plane of the Miller Index (002) of the single-crystal thin films formed furthermore on the thin films in which the crystallization state is an orientated polycrystal is in the range of 137-144 seconds, but when the substrate in which the average surface roughness Ra is 2.6 nm was used, the half width of the rocking curve of the X ray diffraction line from the lattice plane of the Miller Index (002) of the single-crystal thin films formed furthermore on the amorphous thin film, polycrystalline thin film, the orientated polycrystalline thin films and single-crystal thin film which were formed beforehand is not more than 130 seconds, so the crystallinity was improved.

Especially the half width of the rocking curve of the X ray diffraction line from the lattice plane of the Miller Index (002) of the single-crystal thin films formed furthermore on the orientated polycrystalline thin films formed beforehand was not more than 120 seconds, so it was improved further.

In the case of the substrate comprising a beryllium oxide-based sintered compact, the half width of the rocking curve of the X ray diffraction from the lattice plane of the Miller Index (002) of the single-crystal thin films formed furthermore on it is 166 seconds when the crystallization state of the thin film formed beforehand on that in which the average surface roughness Ra is 9.4 nm is amorphous, and the half width of the rocking curve of the X ray diffraction from the lattice plane of the Miller Index (002) of the single-crystal thin films formed furthermore on the thin films in which the crystallization state is an orientated polycrystal is in the range of 138-141 seconds, but when the substrate in which the average surface roughness Ra is 3.7 nm was used, the half width of the rocking curve of the X ray diffraction from the lattice plane of the Miller Index (002) of the single-crystal thin films formed furthermore on the amorphous thin film, polycrystalline thin film, orientated polycrystalline thin films and single-crystal thin film which were formed beforehand is not more than 130 seconds, so the crystallinity was improved.

Especially the half width of the rocking curve of the X ray diffraction from the lattice plane of the Miller Index (002) of the single-crystal thin films formed furthermore on the orientated polycrystalline thin films formed beforehand was not more than 120 seconds, so it was improved further.

As mentioned above, in this Example, as for the crystallinity of the single-crystal thin films formed furthermore on the substrates comprising the sintered compacts comprising as a main component silicon carbide, silicon nitride, zinc oxide, beryllium oxide and aluminum oxide and forming beforehand the AlN thin film, the GaN thin film and the InN thin film, it is improved by the improvement of the surface smooth nature of the substrates comprising these sintered compacts.

On the other hand, the crystallinity of the AlN thin films, GaN thin films and InN thin films which are formed beforehand on the substrates comprising these sintered compacts and have the crystallization state of an orientated polycrystal is also improved according as the surface smooth nature of the substrates is improved.

That is, as described in Table 43, when the average surface roughness Ra of the substrates comprising the sintered compacts comprising as a main component silicon carbide, silicon nitride, zinc oxide, beryllium oxide and aluminum oxide is larger than 10 nm, the half width of the rocking curve of the X ray diffraction from the lattice plane of the Miller Index (002) of the AlN thin films, GaN thin films and InN thin films which are formed beforehand on these substrates and have the above crystallization state of an orientated polycrystal tends to become larger than 10000 seconds, and it was confirmed that the half width of the rocking curve of the X ray diffraction from the lattice plane of the Miller Index (002) of the single-crystal thin films formed on the orientated polycrystalline thin films of such crystallinity has the tendency which is easy to become larger than 150 seconds.

When the average surface roughness Ra of the substrates comprising the sintered compacts comprising as a main component silicon carbide, silicon nitride, zinc oxide, beryllium oxide and aluminum oxide is not more than 10 nm, the half width of the rocking curve of the X ray diffraction from the lattice plane of the Miller Index (002) of the AlN thin films, GaN thin films and InN thin films which are formed beforehand on these substrates and have the above crystallization state of an orientated polycrystal tends to become not more than 10000 seconds, and it was confirmed that half width of the rocking curve of the X ray diffraction from the lattice plane of the Miller Index (002) of the single-crystal thin films formed on the orientated polycrystalline thin films of such crystallinity has the tendency which is easy to form what is not more than 150 seconds.

Furthermore, when the average surface roughness Ra of the substrates comprising the sintered compacts comprising as a main component silicon carbide, silicon nitride, zinc oxide, beryllium oxide and aluminum oxide is not more than 5 nm, those, such that the half width of the rocking curve of the X ray diffraction from the lattice plane of the Miller Index (002) of the AlN thin films, GaN thin films and InN thin films which are formed beforehand on these substrates and have the above crystallization state of an orientated polycrystal is not more than 8000 seconds, may be formed, and it was confirmed that it has the tendency which is easy to form those in which the half width of the rocking curve of the X ray diffraction from the lattice plane of the Miller Index (002) of the single-crystal thin films formed on the orientated polycrystalline thin films with such crystallinity is not more than 130 seconds.

In this Example, although the appearance of all the thin films produced in the experiment indicated in Table 43 was investigated, defects, such as a crack and a crevice, are not seen altogether in the thin films formed beforehand on the substrates and the thin films formed furthermore on them.

Although the exfoliation test was carried out using the pressure sensitive adhesive tape, in all the thin films, exfoliations were not seen between them and the substrates comprising the sintered compacts, or between thin films. The thin film-conductive material of Ti/Pt/Au was formed on the thin films of the surface of the substrates, the metal leads were soldered and the perpendicular tensile strength was investigated, but it all is not less than 2 Kg/mm², so there are firm unifications between the sintered compacts and the thin films formed beforehand on the substrates, and between these thin films and the thin films formed furthermore on them.

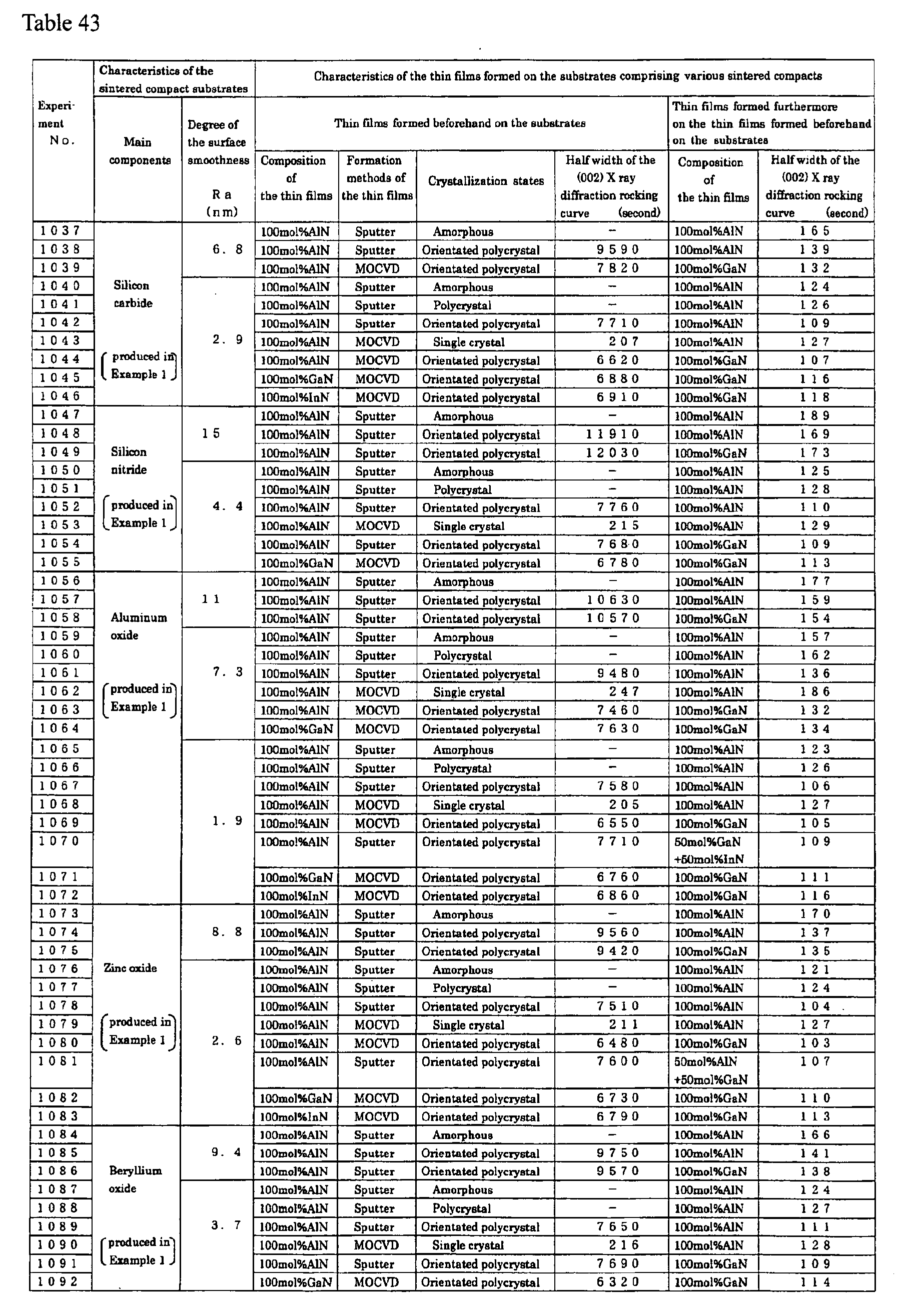

### Example 29

This Example shows the examples which investigated the influence in which the layer constitution of the thin films which are formed on them and comprise as a main component gallium nitride, indium nitride and aluminum nitride gives to the crystallinity of the thin films formed, using those in which the surface smoothness is comparatively coarse, among the substrates comprising the aluminum nitride-based sintered compact and the substrates comprising the sintered compacts comprising silicon carbide, silicon nitride, zinc oxide, beryllium oxide and aluminum oxide as a main component.

First, the sintered compacts comprising aluminum nitride as a main component and produced in the experiment No.49 of Example 2 were prepared.

In the other, the sintered compacts produced in Example 1 and comprising as a main component silicon carbide, silicon nitride, zinc oxide, beryllium oxide, and aluminum oxide were prepared.

Some of these substrates have the as-fired state and lap-polished state which were used in Example 8.

As for some of the sintered compacts prepared, those in which the thin film formation side is in the as-fired state were used as they are, or some of them were processed by the lap polish or the blast polish, then they were processed further into the diameter of 25.4 mm and the thickness of 0.5 mm, and the substrates for a thin film were produced.

Among the substrates newly produced in this Example, those having the substrate surface of the as-fired state and lap-polished state were processed by the same method as Example 8.

In all the substrates having the surface of the as-fired state, the surface adhesions were removed by brushing using a commercial alumina powder with the particle size of 3 µm.

In the substrates in which the lap polish was carried out, it was carried out using those with the particle size #240 of SiC in the case of the sintered compacts comprising aluminum nitride as a main component, it was carried out using those with the particle size #400 of SiC in the case of the sintered compacts comprising aluminum oxide as a main component, and it was carried out using those with the particle size #240 of SiC in the case of the sintered compacts comprising beryllium oxide as a main component.

The blast polish was carried out by the sandblast machine using those with the particle size #400 of alumina in the case of the sintered compacts comprising aluminum nitride as a main component, in the case of the sintered compacts comprising silicon carbide as a main component, it was carried out using those with the particle size #600 of alumina, in the case of the sintered compacts comprising as a main component silicon nitride, aluminum oxide, and zinc oxide, it was carried out using those with the particle size #800 of alumina, and in the case of the sintered compacts comprising beryllium oxide as a main component, it was carried out using those with the particle size #1200 of alumina.

The thin films were formed by the same method as what was shown in Example 25, 26, 27 and 28 to each prepared above substrate from which the surface smoothness differs.

That is, the thin films of 100 mol % AlN were formed beforehand on the substrates prepared under the same condition as the sputtering method carried out in the experiment No.706, 707, and 708, and as the MOCVD method carried out in the experiment No.709, in Example 25.

The thin films of 100 mol % GaN were formed beforehand by the same condition as the MOCVD method carried out in the experiment No.730.

The thickness of the thin films formed beforehand on the above substrates was made into 6 µm, respectively.

Using the substrates in which the AlN thin film, GaN thin film, and InN thin film were formed beforehand, the thin films of each composition of the same 100 mol % AlN and 100 mol % GaN were formed furthermore on them in the thickness of 3 µm by the MOCVD method.

As the condition of MOCVD, it was the same condition as Example 1 and Example 2.

The above experimental result was collectively shown in Table 44.

As a result, in the substrates comprising the aluminum nitride-based sintered compact, and in the substrates comprising the sintered compacts comprising as a main component silicon carbide, silicon nitride, zinc oxide, beryllium oxide, and aluminum oxide, the thin films of the same crystallization state as the thin films produced in Example 25 were formed beforehand directly on the substrates comprising each above sintered compact without being influenced by the surface state, that is, the AlN thin films formed by the same sputtering method as the experimental example 706 were the amorphous state, the AlN thin films formed by the same sputtering method as the experimental example 707 were the polycrystal, and the AlN thin films formed by the same sputtering method as the experimental example 708 were the orientated polycrystal.

On the other hand, when the aluminum nitride-based sintered compacts were used as a substrate, the formation of the 100 mol % AlN single-crystal thin films was tried by the same MOCVD method as the experimental example 709, but the thin films formed on the substrates in which the average surface roughness Ra is larger than 2000 nm were the polycrystalline substance in which the diffraction peak is shown from the lattice plane (002), (101), (102), and the direct formation of a single-crystal thin film was difficult on these substrates.

On the other hand, and, the single-crystal thin films may be formed directly on the substrates in which the average surface roughness Ra is not more than 2000 nm.

If the 100 mol % AlN thin film and the 100 mol % GaN thin film were formed furthermore on them after the 100 mol % AlN thin films having each crystallization state of an amorphous state, a polycrystal, and an orientated polycrystal were beforehand formed using the substrates comprising the aluminum nitride-based sintered compacts having the average surface roughness Ra larger than 2000 nm, they are single-crystal-ized, and all of the half width of the rocking curve of the X ray diffraction from the lattice plane (002) of these single-crystal thin films were not more than 300 seconds.

If the 100 mol % AlN thin film and the 100 mol % GaN thin film were formed furthermore on them after the 100 mol % AlN thin films having each crystallization state of an amorphous state, a polycrystal and an orientated polycrystal were beforehand formed using the substrates comprising the aluminum nitride-based sintered compacts having the average surface roughness Ra larger than 2000 nm, they also are single-crystal-ized, and all of the half width of the rocking curve of the X ray diffraction from the lattice plane (002) of these single-crystal thin films were not more than 100 seconds.

When the sintered compacts comprising as a main component silicon carbide, silicon nitride, zinc oxide, beryllium oxide, and aluminum oxide are used as a substrate, the formation of the 100 mol % AlN single-crystal thin films was tried by the same MOCVD method as the experimental example 709, but the thin films formed on the substrates in which the average surface roughness Ra was larger than 1000 nm were the polycrystalline substance in which the diffraction peak is shown from the lattice plane (002), (101), (102), and the direct formation of the single-crystal thin films was difficult in these substrates.

On the other hand, the single-crystal thin films may be formed directly on the substrates in which the average surface roughness Ra is not more than 1000 nm.

If the 100 mol % AlN thin film and the 100 mol % GaN thin film were formed furthermore on them after the 100 mol % AlN thin films having each crystallization state of an amorphous state, a polycrystal and an orientated polycrystal were beforehand formed using the substrates comprising the sintered compacts comprising as a main component silicon carbide, silicon nitride, zinc oxide, beryllium oxide and aluminum oxide and which are the average surface roughness Ra larger than 1000 nm, they are single-crystal-ized, and all of the half width of the rocking curve of the X ray diffraction from the lattice plane (002) of these single-crystal thin films were not more than 300 seconds.

If the 100 mol % AlN thin film and the 100 mol % GaN thin film were formed furthermore on them after the 100 mol % AlN thin films having each crystallization state of an amorphous state, a polycrystal and an orientated polycrystal were beforehand formed using the substrates comprising the sintered compacts comprising as a main component silicon carbide, silicon nitride, zinc oxide, beryllium oxide, and aluminum oxide and which are the average surface roughness Ra not more than 1000 nm, they also are single-crystal-ized, and the half width of the rocking curve of the X ray diffraction from the lattice plane (002) of these single-crystal thin films was not more than 200 seconds.

If the 100 mol % AlN thin film and the 100 mol % GaN thin film were formed furthermore on them after the 100 mol % AlN thin films of the orientated polycrystal state were beforehand formed using the substrates comprising the sintered compacts comprising as a main component silicon carbide, silicon nitride, zinc oxide, beryllium oxide, and aluminum oxide and which are the average surface roughness Ra not more than 1000 nm, they also are single-crystal-ized, and the half width of the rocking curve of the X ray diffraction from the lattice plane (002) of these single-crystal thin films was not more than 150 seconds.

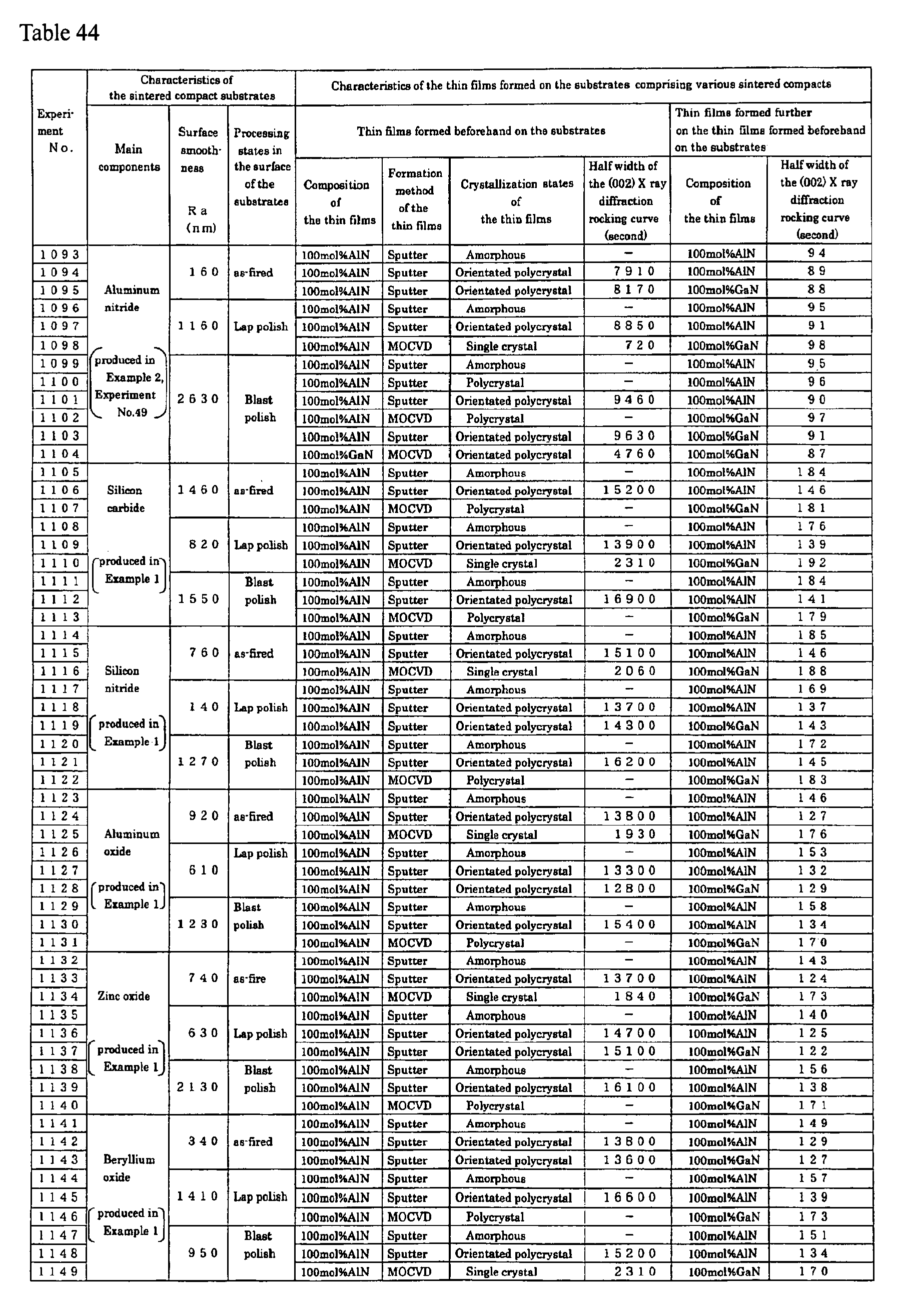

### Example 30

This Example shows the examples which investigated about the compositions of the substrates, and about the influences which give to the crystallinity of the thin films formed on the substrates and comprising as a main component gallium nitride, indium nitride, and aluminum nitride, when the zinc oxide-based sintered compacts are used as a substrate.

First, the guaranteed reagent powder by Kanto Kagaku Incorporated Company was prepared as zinc oxide (ZnO) powder, the Alcoa's brand name "A-16SG" was prepared as the raw material of alumina (Al₂O₃) powder, such powders were mixed by the ball mill so that they become the predetermined compositions by the same method as Example 1, then the paraffine wax was added and the powders for molding were produced, they were degreased after the powder compacts of the same size as Example 1 were molded by the uniaxial pressing, the normal-pressure sintering was carried out at 1460°C for 1 hour in air after that, and the sintered compacts comprising zinc oxide as a main component and contain an aluminum component in various rate were produced.

Each of these sintered compacts was made dense to not less than 98 % as the relative density.

As for the zinc oxide-based sintered compacts produced thus, while what does not contain an aluminum component was light white yellow, what colored into blue was seen in what contains an aluminum component, the coloring to deeper blue advances according as the content of an aluminum component increases, the deepest blue was presented in those including Al₂O₃ 3.0 mol %, and the degree of the blue color became weak and changed to the color tone of blue white gradually according as the content of an aluminum component increases after that.

In the other, the Fe₂O₃ powder having the purity not less than 99.99 % and the Cr₂O₃ powder having the purity not less than 99.9 % were prepared, and these powders were produced by Kojundo Chemical Laboratory Co., Ltd.

The Y₂O₃ powder having the purity not less than 99.99 %, the Er₂O₃ powder having the purity not less than 99.99 %, the Yb₂O₃ powder having the purity not less than 99.99 %, the Dy₂O₃ powder having the purity not less than 99.99 %, and the Ho₂O₃ powder having the purity not less than 99.99 % were prepared as a rare earth element compound, and these powders were produced by Shin-Etsu Chemical Co., Ltd.

By the same method as what was shown in this Example, each above powder of the predetermined quantity was mixed with the zinc oxide powder and the alumina powder by using a ball mill, the uniaxial pressing was carried out, and the normal-pressure sintering was carried out at 1460°C for 1 hour in air, and here produced a zinc oxide-based sintered compact containing only an iron component, a zinc oxide-based sintered compact containing only a chromium component, a zinc oxide-based sintered compact containing only a yttrium component, a zinc oxide-based sintered compact containing only an erbium component, a zinc oxide-based sintered compact containing only a ytterbium component, the zinc oxide-based sintered compact containing an aluminum component and an iron component simultaneously, the zinc oxide-based sintered compact containing an aluminum component and a chromium component simultaneously, and the zinc oxide-based sintered compacts containing simultaneously an aluminum component and various rare earth element components.

The electric resistivity at room temperature of each sintered compact obtained was measured by the four-terminal method.

After that, each sintered compact obtained was mirror-polished by the abradant comprising as a main component a colloidal silicon oxide with the particle diameter of 0.02 µm, then the washing was carried out by the ultrasonic wave using a methylene chloride and IPA, and the substrates were produced.

The average surface roughness Ra of the mirror-polished substrates was in the range of 6.9-7.7 nm.

The optical transmissivity to the light of 605 nm wavelength was measured by the same method as Example 2 using the substrates after polish.

The characteristics of the obtained substrates comprising a zinc oxide-based sintered compact are shown in Table 45 and 46.

In the above produced substrates comprising a zinc oxide-based sintered compact, the characteristics of those containing only an aluminum component, and of those not containing an aluminum component and containing only a chromium component, an iron component, a yttrium component, an erbium component and a ytterbium component were indicated in Table 45.

On the other hand, the characteristics of the substrates comprising the zinc oxide-based sintered compacts containing an aluminum component simultaneously with a chromium component, an iron component, or various rare earth element components were indicated in Table 46.

In Table 45, the experiment No.1150-1193 is the experimental result about the zinc oxide-based sintered compacts adding only an aluminum component and fired, and the content of the aluminum component of the sintered compacts is shown in the column of "composition" on the basis of Al₂O₃.

In Table 45, the experiment No.1194-1195 is the experimental result about the zinc oxide-based sintered compact adding only an iron component and fired, the content of the iron component of the sintered compact is shown in the column of "composition" on the basis of Fe₂O₃.

In Table 45, experiment the No.1196-1197 is the experimental result about the zinc oxide-based sintered compact adding only a chromium component and fired, the content of the chromium component of the sintered compact is shown in the column of "composition" on the basis of Cr₂O₃.

In Table 45, the experiment No.1198-1199 is the experimental result about the zinc oxide-based sintered compact adding only a yttrium component and fired, the content of the yttrium component of the sintered compact is shown in the column of "composition" on the basis of Y₂O₃.

In Table 45, the experiment No.1200-1201 is the experimental result about the zinc oxide-based sintered compact adding only an erbium component and fired, the content of the erbium component of the sintered compact is shown in the column of "composition" on the basis of Er₂O₃.

In Table 45, the experiment No.1202-1203 is the experimental result about the zinc oxide-based sintered compact adding only a ytterbium component and fired, the content of the ytterbium component of the sintered compact is shown in the column of "composition" on the basis of Yb₂O₃.

As shown in Table 45, as for the zinc oxide-based sintered compacts produced in this Example, what does not contain an aluminum component is an electric insulator, the electric resistivity lowers according as the content of the aluminum component increases, and in those including the aluminum component 3.0 mol % on the basis of Al₂O₃, the electric resistivity at room temperature became smallest, such as 1.6x10⁻³ Ω·cm.

After that, the electric resistivity began to become high according as the content of the aluminum component increases, and it became the electric insulator in those including the aluminum component 50.0 mol % on the basis of Al₂O₃.

As shown in the experiment No.1194-1197 of Table 45, in the zinc oxide-based sintered compacts not containing the aluminum component and containing respectively an iron component 1.0 mol % on the basis of Fe₂O₃, or a chromium component 1.0 mol % on the basis of Cr₂O₃, they show conductivity, the electric resistivity at room temperature was comparatively low as 8.7x10⁻¹ Ω·cm, and 3.4x10⁻¹ Ω·cm.

As shown in Table 46, all the zinc oxide-based sintered compacts containing the iron component, the chromium component, or various rare earth element components simultaneously with the aluminum component show conductivity.

The electric resistivity seldom changed and was the almost same level as the electric resistivity of a zinc oxide-based sintered compact containing only an aluminum component.

As shown in Table 45, as for the optical transmissivity of the zinc oxide-based sintered fired without adding an aluminum component and not including substantially except the impurities mixed in a raw materials or at the time of sintered compact manufacture, it was 16 % to the light of 605 nm wavelength, but the optical transmissivity shows the tendency to go up according as the content of an aluminum component increases, and that containing the 3.0-mol % aluminum component on the basis of Al₂O₃ was reached to 56 %.

After that, the optical transmissivity shows the tendency to lower gradually according as the content of an aluminum component increases, the optical transmissivity became 17 % in the case of the zinc oxide-based sintered containing the aluminum component 50.0 mol % on the basis of Al₂O₃, it became almost the same as the optical transmissivity of the sintered compact not containing an aluminum component and comprising only zinc oxide substantially.

As shown in the experiment No.1194-1197 of Table 45, in the zinc oxide-based sintered compacts not containing the aluminum component and containing respectively an iron component 1.0 mol % on the basis of Fe₂O₃, or a chromium component 1.0 mol % on the basis of Cr₂O₃, the optical transmissivity to the light of 605 nm wavelength was 6.9 % and 9.2 %, respectively.

As shown in the experiment No.1198-1203 of Table 45, as for the optical transmissivity of the zinc oxide-based sintered compacts not containing the aluminum component and containing respectively only a yttrium component 0.04 mol % on the basis of Y₂O₃, only an erbium component 0.04 mol % on the basis of Er₂O₃, or only a ytterbium component 0.04 mol % on the basis of Yb₂O₃, it became 57 %, 53 % and 54 % to the light of 605 nm wavelength, and it became higher than the optical transmissivity of the sintered compacts not containing the aluminum component and comprising only zinc oxide substantially.

Furthermore, as shown in Table 46, as for the optical transmissivity of the zinc oxide-based sintered compacts containing the aluminum component 3.0 mol % on the basis of Al₂O₃ and containing simultaneously an iron component 0.2 mol % on the basis of Fe₂O₃, or a chromium component 0.2 mol % on the basis of Cr₂O₃, respectively, it is 53 % and 55 % to the light of 605 nm wavelength, and it was almost the same as the optical transmissivity of the zinc oxide-based sintered compact containing only the aluminum component 3.0 mol % on the basis of Al₂O₃.

As shown in Table 46, in the zinc oxide-based sintered compacts containing the aluminum component 0.03 mol % on the basis of Al₂O₃ and containing simultaneously a yttrium component in the range of 0.0001-12.0 mol % on the basis of Y₂O₃, the optical transmissivity of that containing the yttrium component 0.0001 mol % on the basis of Y₂O₃ was 28 % to the light of 605 nm wavelength, it was almost the same as the optical transmissivity of the zinc oxide-based sintered compact containing only the aluminum component 0.03 mol % on the basis of Al₂O₃.

Furthermore, the optical transmissivity becomes high according as the content of the yttrium component increases, it becomes 37 % in that containing the yttrium component 0.0004 mol % on the basis of Y₂O₃, 45 % in that containing the yttrium component 0.0008 mol % on the basis of Y₂O₃, 56 % in that containing the yttrium component 0.0015 mol % on the basis of Y₂O₃, and 64 % in that containing the yttrium component 0.005 mol % on the basis of Y₂O₃, and it reached to 68 % in that containing the yttrium component 0.04 mol % on the basis of Y₂O₃.

After that, the optical transmissivity lowers gradually according as the content of the yttrium component increases, the optical transmissivity to the light of 605 nm wavelength became 24 % in the zinc oxide-based sintered compact containing the yttrium component 12.0 mol % on the basis of Y₂O₃, it became almost the same as the optical transmissivity of the zinc oxide-based sintered compact containing only the aluminum component 0.03 mol % on the basis of Al₂O₃.

As shown in Table 46, in the zinc oxide-based sintered compacts containing the yttrium component 0.04 mol % on the basis of Y₂O₃ and contain simultaneously the aluminum component in the range of 0.002-50.0 mol % on the basis of Al₂O₃, the optical transmissivity of that containing the aluminum component 0.002 mol % on the basis of Al₂O₃ is 62 % to the light of 605 nm wavelength. Furthermore, the optical transmissivity also becomes high according as the content of an aluminum component increases, it reached to 84 % in that containing the aluminum component 1.0 mol % and 3.0 mol % on the basis of Al₂O₃.

After that, the optical transmissivity lowers gradually according as the content of an aluminum component increases, although the optical transmissivity was 66 % in that containing the aluminum component 30.0 mol % on the basis of Al₂O₃, the optical transmissivity to the light of 605 nm wavelength became 27 % in the zinc oxide-based sintered compact containing the aluminum component 50.0 mol % on the basis of Al₂O₃.

As shown in Table 46, the optical transmissivity to the light of 605 nm wavelength was 68 % in the zinc oxide-based sintered compact containing the aluminum component 0.10 mol % on the basis of Al₂O₃ and containing simultaneously an erbium component 0.04 mol % on the basis of Er₂O₃.

As shown in Table 46, as for the optical transmissivity of those containing the aluminum component 3.0 mol % on the basis of Al₂O₃ and containing simultaneously a dysprosium component 0.04 mol % on the basis of Dy₂O₃, a holmium component 0.04 mol % on the basis of Ho₂O₃, an erbium component 0.04 mol % on the basis of Er₂O₃, or a ytterbium component 0.04 mol % on the basis of Yb₂O₃ as a rare earth element component, it was high as 77 %, 80 %, 78 %, and 81 %, respectively, to the light of 605 nm wavelength.

As shown in Table 46, as for the optical transmissivity of the zinc oxide-based sintered compact containing simultaneously the three components including the aluminum component 1.0 mol % on the basis of Al₂O₃, the yttrium component 0.02 mol % on the basis of Y₂O₃, and then erbium component 0.02 mol % on the basis of Er₂O₃, it was high as 83 % to the light of 605 nm wavelength.

Next, the thin films were formed in the above substrates prepared by the same method as what was shown in Example 27.

That is, choosing some of the substrates prepared, the thin films of 100 mol % AlN were formed beforehand on them in the thickness of 3 µm by the same conditions as the sputtering method carried out in the experiment No.706, 707, and 708, and as the MOCVD method carried out in the experiment No.709 of Example 25.

Furthermore, the thin films of 100 mol % GaN were formed beforehand in the thickness of 3 µm by the same conditions as the MOCVD method carried out in the experiment No.728 and 730, and the thin film of 100 mol % InN was formed beforehand in the thickness of 3 µm under the same condition as the MOCVD method carried out in the experiment No.731.

In addition, as for the thin films formed beforehand on the substrates comprising the zinc oxide-based sintered compacts containing simultaneously the aluminum component and the iron component, the zinc oxide-based sintered compacts containing simultaneously the aluminum component and the chromium component, and the zinc oxide-based sintered compacts containing simultaneously the aluminum component and the various rare earth element components, they used only a 100 mol % AlN by the sputtering method carried out in the experiment No.708 of Example 25.

Next, using the above substrates comprising the zinc oxide-based sintered compacts forming beforehand the aluminum nitride-based thin films, the gallium nitride-based thin films, and the indium nitride-based thin film, and using the substrates comprising the zinc oxide-based sintered compacts left without forming a thin film, the thin films having each composition of the same 100 mol % AlN, 100 mol % GaN, 100 mol % InN, 50 mol % AlN+50 mol % GaN and 50 mol % GaN+50 mol % InN as what was described in Example 19 were formed furthermore on them in the thickness of 3 µm by the MOCVD method.

As the conditions of MOCVD, they were the same conditions as Example 1 and Example 2 like the description in Example 19.

The characteristics of the thin films produced like that were shown in Table 45 and Table 46.

In this Example, as for each thin film formed beforehand on each above substrate, those having the crystallization states corresponding to each formation condition were formed.

That is, the AlN thin films formed by the sputtering method under the same condition as the experiment No.706, were amorphous, and the AlN thin films formed by the sputtering method under the same condition as the experiment No.707, were the polycrystal in which the diffraction lines have appeared from the lattice plane of the Miller Index (002), (101), (102).

As for the AlN thin films formed by the sputtering method under the same conditions as experiment No.708, only the diffraction line from the lattice plane of the Miller Index (002) appeared, they were the orientated polycrystal formed in the direction where C axis is perpendicular to the substrate surface.

As for the AlN thin films formed by the MOCVD method under the same conditions as experiment No.709, only the diffraction line from the lattice plane of a Miller Index (002) has appeared, and it was confirmed that they are the single crystal formed in the direction where C axis is perpendicular to the substrate surface.

The GaN thin film formed by the MOCVD method under the same condition as the experiment No.728 is amorphous, in the GaN thin film formed by the MOCVD method under the same conditions as the experiment No.730, only the diffraction line from the lattice plane of the Miller Index (002) had appeared, and it was the orientated polycrystal formed in the direction where C axis is perpendicular to the substrate surface.

In the InN thin film formed by the MOCVD method of the same conditions as the experiment No.731, only the diffraction line from the lattice plane of the Miller Index (002) has appeared, and it was the orientated polycrystal formed in the direction where C axis is perpendicular to the substrate surface.

If the crystallinity of the 100 mol % AlN orientated polycrystalline thin films formed by the same sputtering method as the experiment No.708 is seen, the half width of the rocking curve of the X ray diffraction from the lattice plane of the Miller Index (002) of the orientated polycrystalline thin film was 9430 seconds, as shown in Table 45, when the substrate comprising the zinc oxide-based sintered compact not containing an aluminum component substantially was used.

The crystallinity of these orientated polycrystalline thin films showed the tendency to be improved according as the aluminum component increases.

That is, when using the substrate comprising the zinc oxide-based sintered compact containing an aluminum component 0.002 mol % on the basis of Al₂O₃, the half width of the rocking curve of the X ray diffraction from the lattice plane of the Miller Index (002) of the AlN orientated polycrystalline thin film formed on the substrate is 8190 seconds, and it is 7620 seconds when using the substrate comprising the zinc oxide-based sintered compact containing an aluminum component 0.008 mol % on the basis of Al₂O₃, it became low into not more than 8000 seconds.

After that, the crystallinity of these AlN orientated polycrystalline thin films showed the tendency which improves a little, according as the content of an aluminum component increases, and when the zinc oxide-based substrates containing 3.0 mol % on the basis of Al₂O₃ are used, what is 7320-7460 seconds was formed, the crystallinity improved most.

After that, the crystallinity showed the tendency which lowers a little, according as the content of an aluminum component increases.

When using the zinc oxide-based substrates in which the content of an aluminum component is 40.0 mol % on the basis of Al₂O₃, the crystallinity of these AlN orientated polycrystalline thin films was 7530-7570 seconds.

However, in the case of 100 mol % AlN orientated polycrystalline thin film formed on the substrate comprising the zinc oxide sintered compact containing an aluminum component 50.0 mol % on the basis of Al₂O₃, it was 9260 seconds, and the crystallinity became low.

As shown in Table 46, when having used the substrates comprising the zinc oxide sintered compacts containing an aluminum component 45.0 mol % on the basis of Al₂O₃ and further containing an iron component, a chromium component, or at least one selected from a rare earth element component, the half width of the rocking curve of the X ray diffraction from the lattice plane of the Miller Index (002) of the AlN orientated polycrystalline thin film formed on these substrates is in the range of 7380-7920 seconds, it was not more than 8000 seconds altogether.

Next, as for the thin films comprising each composition of 100 mol % AlN, 100 mol % GaN and 100 mol % InN and formed by the above MOCVD method using the substrates comprising the zinc oxide-based sintered compacts left without forming the above thin films, the crystallinity was investigated by X ray diffraction.

As a result, it was confirmed that all the produced thin films are the single crystals formed in the direction where C axis is perpendicular to the substrate surface.

If the crystallinity is seen, as shown in Table 45, when having used the zinc oxide-based sintered compact fired without adding an aluminum component and not including substantially except the impurities mixed in a raw material or at the time of sintered compact manufacture, the half width of the rocking curve of the X ray diffraction from the lattice plane of the Miller Index (002) of the 100 mol % AlN single-crystal thin film formed directly on the substrate was 255 seconds.

On the other hand, in the case of the 100 mol % AlN single-crystal thin film formed directly on the substrate comprising the zinc oxide-based sintered compact containing an aluminum component 0.002 mol % on the basis of Al₂O₃, it became small to 187 seconds, and the crystallinity was improved.

In the case of the 100 mol % AlN single-crystal thin film formed directly on the substrate comprising the zinc oxide-based sintered compact containing an aluminum component 0.008 mol % on the basis of Al₂O₃, it is 159 seconds, and the crystallinity was improved more.

In the case of the 100 mol % AlN single-crystal thin film formed directly on the substrate comprising the zinc oxide-based sintered compact containing an aluminum component 0.03 mol % on the basis of Al₂O₃, it is 138 seconds, and the crystallinity was improved further.

In the case of the 100 mol % AlN single-crystal thin film formed directly on the substrate comprising the zinc oxide-based sintered compact containing an aluminum component 0.1 mol % on the basis of Al₂O₃, it was 126 seconds, it became into not more than 130 seconds and the crystallinity was improved further.

Furthermore, the half width of the rocking curve of the X ray diffraction from the lattice plane of the Miller Index (002) of the single-crystal thin films formed directly on the substrates comprising the zinc oxide-based sintered compact became small according as the content of an aluminum component increased.

In the case of the 100 mol % AlN single-crystal thin film formed directly on the substrate comprising the zinc oxide-based sintered compact containing an aluminum component 3.0 mol % on the basis of Al₂O₃, it became the smallest in this Example to 112 seconds, and the crystallinity was most excellent.

After that, the half width of the rocking curve of the X ray diffraction from the lattice plane of the Miller Index (002) of the single-crystal thin films formed directly on the substrates comprise the zinc oxide-based sintered compact became large according as the content of an aluminum component increases, in the case of the 100 mol % AlN single-crystal thin film formed directly on the substrate comprising the zinc oxide-based sintered compact containing an aluminum component 40.0 mol % on the basis of Al₂O₃, it became into 136 seconds.

In the case of the 100 mol % AlN single-crystal thin film formed directly on the substrate comprising the zinc oxide-based sintered compact containing an aluminum component 50.0 mol % on the basis of Al₂O₃, it became into 229 seconds, and it became larger than 200 seconds.

On the other hand, as shown in Table 45 and 46 in this Example, in the substrates comprising the zinc oxide-based sintered compacts including an aluminum component, it was confirmed that there is little change of lowering greatly the crystallinity of the single-crystal thin films formed directly on these substrates and comprising as a main component at least one selected from gallium nitride, indium nitride and aluminum nitride, even if the component(s) other than aluminum, such as iron, chromium, or a rare earth element, etc., was contained in these sintered compacts.

If saying in other words, in the substrates comprising the zinc oxide-based sintered compacts including an aluminum component, it was confirmed that the crystallinity of the single-crystal thin films formed directly on these substrates cannot be influenced easily by the component(s), even if the component(s) other than aluminum, such as iron, chromium, or a rare earth element, etc., for example, was contained in these sintered compacts.

Concretely, the half width of the rocking curve of the X ray diffraction from the lattice plane of the Miller Index (002) of the 100 mol % AlN single-crystal thin films formed directly on the substrates comprising the zinc oxide-based sintered compacts containing an aluminum component 0.03 mol % on the basis of Al₂O₃ and containing a yttrium component simultaneously in the range of 0.0001-12.0 mol % on the basis of Y₂O₃ is in the range of 134-145 seconds, the crystallinity did not show the tendency to change a lot from 138 seconds of the 100 mol %AlN single-crystal thin film formed directly on the substrate comprising the zinc oxide sintered compact containing only an aluminum component 0.03 mol % on the basis of Al₂O₃ and not containing a yttrium component.

Furthermore, in Table 45 and Table 46, as for the half width of the rocking curve of the X ray diffraction from the lattice plane of the Miller Index (002) of the 100 mol % AlN single-crystal thin films formed directly on the substrates comprising the zinc oxide-based sintered compacts containing an aluminum component 3.0 mol % on the basis of Al₂O₃ and containing simultaneously an iron component 0.2 mol % on the basis of Fe₂O₃, a chromium component 0.2 mol % on the basis of Cr₂O₃, a yttrium component 0.04 mol % on the basis of Y₂O₃, a holmium component 0.04 mol % on the basis of Ho₂O₃, or an erbium component 0.04 mol % on the basis of Er₂O₃, respectively, it is in the range of 111-117 seconds, the crystallinity did not show the tendency to change a lot from 112 seconds of the 100 mol % AlN single-crystal thin film formed directly on the substrate comprising the zinc oxide-based sintered compact containing only an aluminum component 3.0 mol % on the basis of Al₂O₃.

As for the half width of the rocking curve of the X ray diffraction from the lattice plane of the Miller Index (002) of the 100 mol % GaN single-crystal thin films formed directly on the substrates comprising the zinc oxide-based sintered compacts containing an aluminum component 3.0 mol % on the basis of Al₂O₃ and containing simultaneously a dysprosium component 0.04 mol % on the basis of Dy₂O₃ or a ytterbium component 0.04 mol % on the basis of Yb₂O₃, respectively, it is in the range of 113-116 sconds, the crystallinity did not show the tendency to change a lot from 118 seconds of the 100 mol % GaN single-crystal thin film formed directly on the substrate comprising the zinc oxide-based sintered compact containing only an aluminum component 3.0 mol % on the basis of Al₂O₃.

In Table 45 and Table 46, if the crystallinity of the 100 mol % AlN single-crystal thin films formed directly on the substrates comprising the zinc oxide-based sintered compacts containing a yttrium component 0.04 mol % on the basis of Y₂O₃ and containing simultaneously an aluminum component in the range of 0.002-50.0 mol % on the basis of Al₂O₃ is compared with the crystallinity of the 100 mol % AlN single-crystal thin films formed directly on the substrates comprising the zinc oxide-based sintered compacts containing only an aluminum component, it seldom changed about the crystallinity, and was the almost same level as the substrates comprising the zinc oxide-based sintered compacts containing the same quantity of an aluminum component, respectively.

For example, the half width of the rocking curve of the X ray diffraction from the lattice plane of the Miller Index (002) of the 100 mol % AlN single-crystal thin film formed directly on the substrate comprising the zinc oxide-based sintered compact containing a yttrium component 0.04 mol % on the basis of Y₂O₃ and containing simultaneously an aluminum component 0.002 mol % on the basis of Al₂O₃ is 175 seconds, the crystallinity did not show the change tendency to lower greatly from 187 seconds of the 100 mol % AlN single-crystal thin film formed directly on the substrate comprising the zinc oxide-based sintered compact containing only an aluminum component 0.002 mol % on the basis of Al₂O₃ and not containing a yttrium component substantially.

The half width of the rocking curve of the X ray diffraction from the lattice plane of the Miller Index (002) of the 100 mol % AlN single-crystal thin film formed directly on the substrate comprising the zinc oxide-based sintered compact containing a yttrium component 0.04 mol % on the basis of Y₂O₃ and containing simultaneously an aluminum component 0.10 mol % on the basis of Al₂O₃ is 125 seconds, the crystallinity did not show the change tendency to lower greatly from 126 seconds of the 100 mol % AlN single-crystal thin film formed directly on the substrate comprising the zinc oxide-based sintered compact containing only an aluminum component 0.10 mol % on the basis of Al₂O₃ and not containing a yttrium component substantially.

The half width of the rocking curve of the X ray diffraction from the lattice plane of the Miller Index (002) of the 100 mol % AlN single-crystal thin film formed directly on the substrate comprising the zinc oxide-based sintered compact containing a yttrium component 0.04 mol % on the basis of Y₂O₃ and containing simultaneously an aluminum component 30.0 mol % on the basis of Al₂O₃ is 126 seconds, the crystallinity did not show the change tendency to lower greatly from 127 seconds of the 100 mol % AlN single-crystal thin film formed directly on the substrate comprising the zinc oxide-based sintered compact containing only an aluminum component 30.0 mol % on the basis of Al₂O₃ and not containing a yttrium component substantially.

That is, as for the crystallinity of the 100 mol % AlN single-crystal thin films formed directly on the zinc oxide-based sintered compacts containing an aluminum component in the range of 0.002-50.0 mol % on the basis of Al₂O₃, even if the yttrium component was simultaneously contained in these zinc oxide-based sintered compacts in addition to the aluminum component, it was confirmed that it hardly changed and has the tendency to be hard to be influenced by the existence of the yttrium component.

Furthermore, the half width of the rocking curve of the X ray diffraction from the lattice plane of the Miller Index (002) of the 100 mol % GaN single-crystal thin film formed directly on the substrate comprising the zinc oxide-based sintered compact containing a yttrium component 0.04 mol % on the basis of Y₂O₃ and containing simultaneously an aluminum component 1.0 mol % on the basis of Al₂O₃ is 119 seconds, the crystallinity did not show the change tendency to lower greatly from 121 seconds of the 100 mol % AlN single-crystal thin film formed directly on the substrate comprising the zinc oxide-based sintered compact containing only an aluminum component 1.0 mol % on the basis of Al₂O₃.

In Table 45 and Table 46, the half width of the rocking curve of the X ray diffraction from the lattice plane of the Miller Index (002) of the 100 mol % GaN single-crystal thin film formed directly on the zinc oxide sintered compact containing simultaneously the three components including an aluminum component 3.0 mol % on the basis of Al₂O₃, a yttrium component 0.04 mol % on the basis of Y₂O₃, and an erbium component 0.04 mol % on the basis of Er₂O₃, is 116 seconds, the crystallinity did not show the tendency to change a lot from 118 seconds of the 100 mol % GaN single-crystal thin film formed directly on the substrate comprising the zinc oxide-based sintered compact containing only an aluminum component 3.0 mol % on the basis of Al₂O₃.

In addition to these, as shown in Table 45, when the zinc oxide-based sintered compact not containing an aluminum component and containing an iron component 1.0 mol % on the basis of Fe₂O₃ was used for a substrate, the half width of the rocking curve of the X ray diffraction from the lattice plane of the Miller Index (002) of the single-crystal thin film formed directly on this substrate was 227 seconds.

When the zinc oxide-based sintered compact not containing an aluminum component and containing a chromium component 1.0 mol % on the basis of Cr₂O₃ was used for a substrate, the half width of the rocking curve of the X ray diffraction from the lattice plane of the Miller Index (002) of the single-crystal thin film formed directly on this substrate was 220 seconds.

When the zinc oxide-based sintered compact not containing an aluminum component and containing a yttrium component 0.04 mol % on the basis of Y₂O₃ was used for a substrate, the half width of the rocking curve of the X ray diffraction from the lattice plane of the Miller Index (002) of the single-crystal thin films formed directly on the substrate was 192 seconds, and it was not more than 200 seconds.

When the zinc oxide-based sintered compact not containing an aluminum component and containing an erbium component 0.04 mol % on the basis of Er₂O₃ was used for a substrate, the half width of the rocking curve of the X ray diffraction from the lattice plane of the Miller Index (002) of the single-crystal thin film formed directly on this substrate was 206 seconds.

When the zinc oxide-based sintered compact not containing an aluminum component and containing a ytterbium component 0.04 mol % on the basis of Yb₂O₃ was used for a substrate, the half width of the rocking curve of the X ray diffraction line from the lattice plane of the Miller Index (002) of the single-crystal thin film formed directly on this substrate was 203 seconds.

Thus, in this Example, when these sintered compacts were used as a substrate even if they are the zinc oxide-based sintered compacts not containing an aluminum component and containing the component(s), such as iron, chromium, yttrium, erbium and ytterbium, it was confirmed that the single-crystal thin films with comparatively good crystallinity comprising as a main component at least one selected from gallium nitride, indium nitride and aluminum nitride are formed directly on these substrates.

The crystallinity was not inferior compared with 255 seconds of the 100 mol %AlN single-crystal thin film formed directly on the substrate using the sintered compact comprising only zinc oxide substantially and being fired without adding an aluminum component and other component(s) and not including the impurities except in a raw material.

As mentioned above, all of the half width of the rocking curve of the X ray diffraction from the lattice plane of the Miller Index (002) of the 100 mol % AlN single-crystal thin films, 100 mol % GaN single-crystal thin films and 100 mol % InN single-crystal thin film which were formed directly on the substrates comprising the zinc oxide-based sintered compacts having various composition were not more than 300 seconds, it was excellent in crystallinity.

When the above substrates comprising the zinc oxide-based sintered compacts having various composition and having such characteristics are used, it was confirmed that the crystallinity of the obtained single-crystal thin films was excellent than the crystallinity of the single-crystal thin films formed directly on these substrates and comprising as a main component at least one selected from gallium nitride, indium nitride and aluminum nitride, if the thin film(s) comprising as amain component at least one selected from gallium nitride, indium nitride and aluminum nitride and having various crystallization states, such as an amorphous state, a polycrystal, an orientated polycrystal and a single crystal, etc., is formed beforehand on these substrates and the single-crystal thin film(s) comprising as a main component at least one selected from gallium nitride, indium nitride and aluminum nitride is formed furthermore on it.

That is, the half width of the rocking curve of the X ray diffraction from the lattice plane of the Miller Index (002) of the single-crystal thin films comprising as a main component at least one selected from gallium nitride, indium nitride and aluminum nitride does not necessarily become into not more than 200 seconds, even if the zinc oxide-based sintered compacts having various compositions are used as a substrate.

On the other hand, even if the zinc oxide-based sintered compacts having such various compositions are used as a substrate, it was confirmed that those, such that the half width of the rocking curve of the X ray diffraction from the lattice plane of the Miller Index (002) of this single-crystal thin film(s) is not more than 200 seconds, may be formed, when the thin film(s) comprising as a main component at least one selected from gallium nitride, indium nitride and aluminum nitride and having various crystallization states, such as an amorphous state, a polycrystal, an orientated polycrystal and a single crystal, etc., is formed beforehand on these substrates and the single-crystal thin film(s) comprising as a main component at least one selected from gallium nitride, indium nitride and aluminum nitride is formed furthermore on it.

When the single-crystal thin film(s) comprising as a main component at least one selected from gallium nitride, indium nitride and aluminum nitride is formed using the substrates comprise the zinc oxide-based sintered compacts having the same composition, it was confirmed that the crystallinity of this obtained single-crystal thin film(s) is excellent than the crystallinity of the single-crystal thin film(s) formed directly on these substrates and comprising as a main component at least one selected from gallium nitride, indium nitride and aluminum nitride, if the thin film(s) comprising as a main component at least one selected from gallium nitride, indium nitride and aluminum nitride and having various crystallization states, such as an amorphous state, a polycrystal, an orientated polycrystal and a single crystal, etc., is formed beforehand on these substrates and the single-crystal thin film(s) comprises as a main component at least one selected from gallium nitride, indium nitride and aluminum nitride is formed furthermore on it.

That is, using the substrates comprising the zinc oxide-based sintered compacts containing an aluminum component in the range of 0.001-45.0 mol % on the basis of Al₂O₃, if the thin film(s) comprising as a main component at least one selected from gallium nitride, indium nitride and aluminum nitride and having various crystallization states, such as an amorphous state, a polycrystal, an orientated polycrystal and a single crystal, etc., is formed beforehand and the single-crystal thin film(s) comprising as a main component at least one selected from gallium nitride, indium nitride and aluminum nitride is formed furthermore on it, the half width of the rocking curve of the X ray diffraction from the lattice plane of the Miller Index (002) of this single-crystal thin film(s) tends to become not more than 130 seconds, and it was confirmed that those, such that the half width of the rocking curve of the X ray diffraction from the lattice plane of the Miller Index (002) of this single-crystal thin film(s) is not more than 100 seconds, may be formed when the zinc oxide-based sintered compacts containing an aluminum component in the range of 0.005-45.0 mol % on the basis of Al₂O₃ are used as a substrate.

It was confirmed that it is hard to receive great change of lowering the crystallinity of the single-crystal thin films formed on these substrates if compared with the crystallinity of the single-crystal thin films formed on the above substrates comprising the zinc oxide-based sintered compacts containing an aluminum component and not containing substantially the other component(s), such as an iron component, a chromium component, a yttrium component, a dysprosium component, a holmium component, an erbium component, and a ytterbium component, even if they are the substrates comprising the zinc oxide-based sintered compacts containing the above amount of an aluminum component and containing simultaneously the component(s), such as an iron component, a chromium component, a yttrium component, a dysprosium component, a holmium component, an erbium component, or a ytterbium component, etc., other than these.

That is, if the substrates are what comprises the zinc oxide-based sintered compacts containing the above amount of an aluminum component, it was confirmed that the crystallinity of the formed single-crystal thin films is what cannot be influenced easily by the component(s), even if the component(s), such as an iron component, a chromium component, a yttrium component, a dysprosium component, a holmium component, an erbium component, and a ytterbium component, was contained other than an aluminum component.

More concretely, as shown in Table 45, while the half width of the rocking curve of the X ray diffraction from the lattice plane of the Miller Index (002) of the 100 mol %AlN single-crystal thin film formed directly on the substrate comprising a zinc oxide-based sintered compact fired without adding an aluminum component and not including substantially the impurities except those mixed in a raw material or at the time of sintered compact manufacture, is 255 seconds, the half width of the rocking curve of the X ray diffraction from the lattice plane of the Miller Index (002) of the 100 mol % AlN single-crystal thin film formed furthermore on it is 136 seconds when the orientated polycrystal of 100 mol % AlN was formed beforehand on the substrate comprising the same zinc oxide-based sintered compact, and the crystallinity improved.

On the other hand, while the half width of the rocking curve of the X ray diffraction from the lattice plane of the Miller Index (002) of the 100 mol % AlN single-crystal thin film formed directly on this substrate is 187 seconds when the substrate comprising a zinc oxide-based sintered compact containing an aluminum component 0.002 mol % on the basis of Al₂O₃ is used, the half width of the rocking curve of the X ray diffraction from the lattice plane of the Miller Index (002) of the 100 mol %AlN single-crystal thin film formed furthermore on it is 107 seconds when the orientated polycrystal of 100 mol % AlN was formed beforehand on the substrate comprising the same zinc oxide-based sintered compact containing an aluminum component, and the crystallinity was improved.

While the half width of the rocking curve of the X ray diffraction from the lattice plane of the Miller Index (002) of the 100 mol % AlN single-crystal thin film formed directly on this substrate is 159 seconds when the substrate comprising a zinc oxide-based sintered compact containing an aluminum component 0.008 mol % on the basis of Al₂O₃ is used, the half width of the rocking curve of the X ray diffraction from the lattice plane of the Miller Index (002) of the 100 mol % AlN single-crystal thin film formed furthermore on it is 97 seconds when the orientated polycrystal of 100 mol % AlN was formed beforehand on the substrate comprising the same zinc oxide-based sintered compact containing an aluminum component, and it became not more than 100 seconds.

When the substrates comprising the zinc oxide-based sintered compacts containing an aluminum component in the range of 0.005-45.0 mol % on the basis of Al₂O₃ are used, if the thin film(s) comprising the various crystallization states, such as an amorphous state, a polycrystal, an orientated polycrystal, and a single crystal, etc., and comprising as a main component at least one selected from gallium nitride, indium nitride and aluminum nitride is formed beforehand on these substrates and the single-crystal thin films comprising as a main component at least one selected from gallium nitride, indium nitride and aluminum nitride are formed furthermore on it, the single-crystal thin films in which the crystallinity is superior to the crystallinity of the single-crystal thin films formed directly on the substrates and comprising as a main component at least one selected from gallium nitride, indium nitride and aluminum nitride are obtained, these single-crystal thin films have the crystallinity in which the half width of the rocking curve of the X ray diffraction from the lattice plane of the Miller Index (002) of these single-crystal thin films is in the range of 86-97 seconds, and it was confirmed that it is not more than 100 seconds altogether.

While the half width of the rocking curve of the X ray diffraction from the lattice plane of the Miller Index (002) of this single-crystal thin film is 229 seconds in the case of the 100 mol % AlN single-crystal thin film formed directly on the substrate comprising a zinc oxide-based sintered compact containing an aluminum component 50.0 mol % on the basis of Al₂O₃, it is 134 seconds in the case of the 100 mol % AlN single-crystal thin film formed on the 100 mol % AlN orientated polycrystalline thin film formed beforehand on the same substrate, and the crystallinity was improved.

As shown in Table 46, for example, when using the substrate comprising a sintered compact containing an aluminum component 0.002 mol % on the basis of Al₂O₃ and containing further a yttrium component 0.04 mol % on the basis of Y₂O₃, while the half width of the rocking curve of the X ray diffraction from the lattice plane of the Miller Index (002) of the 100 mol % AlN single-crystal thin film formed directly on this substrate is 175 seconds, the half width of the rocking curve of the X ray diffraction from the lattice plane of the Miller Index (002) is 107 seconds in the case of the 100 mol % AlN single-crystal thin film formed furthermore on the 100 mol % AlN orientated polycrystalline thin film formed beforehand on the substrate comprising the same zinc oxide-based sintered compact containing an aluminum and a yttrium component, and the crystallinity was improved.

When using the substrate comprising a zinc oxide-based sintered compact containing an aluminum component 0.008 mol % on the basis of Al₂O₃ and containing further a yttrium component 0.04 mol % on the basis of Y₂O₃, while the half width of the rocking curve of the X ray diffraction from the lattice plane of the Miller Index (002) of the 100 mol % AlN single-crystal thin film formed directly on this substrate is 157 seconds, the half width of the rocking curve of the X ray diffraction from the lattice plane of the Miller Index (002) is 96 seconds in the case of the 100 mol % AlN single-crystal thin film formed furthermore on the 100 mol % AlN orientated polycrystalline thin film formed beforehand on the substrate comprising the same zinc oxide-based sintered compact containing an aluminum and a yttrium component, and the crystallinity was improved to not more than 100 seconds.

As shown in Table 46, when using the substrates comprising the zinc oxide-based sintered compacts of various compositions containing an aluminum component 0.03 mol %, 0.10 mol %, 0.30 mol %, 1.0 mol %, 3.0 mol %, 10.0 mol %, or 30.0 mol % on the basis of Al₂O₃ and containing further one of an iron component, a chromium component, a yttrium component, a dysprosium component, a holmium component, an erbium component and a ytterbium component, as for the crystallinity of the 100 mol % AlN single-crystal thin films or 100 mol % GaN single-crystal thin films which are formed furthermore on the 100 mol % AlN orientated polycrystal(s) formed beforehand on the substrates comprising the same zinc oxide-based sintered compacts containing an aluminum component and containing one of an iron component, a chromium component, a yttrium component, a dysprosium component, a holmium component, an erbium component and a ytterbium component, it is improved more than the crystallinity of the 100 mol % AlN single-crystal thin films or 100 mol % GaN single-crystal thin films formed directly on each of these substrates, and it was confirmed that all of the half width of the rocking curve of the X ray diffraction from the lattice plane of the Miller Index (002) of these single-crystal thin films are not more than 100 seconds.

When using the substrate comprising a zinc oxide-base sintered compact containing an aluminum component 3.0 mol % on the basis of Al₂O₃ and containing further a yttrium component 0.04 mol % on the basis of Y₂O₃ and an erbium component 0.04 mol % on the basis of Er₂O₃, while the half width of the rocking curve of the X ray diffraction from the lattice plane of the Miller Index (002) of the 100 mol % GaN single-crystal thin film formed directly on this substrate is 116 seconds, the half width of the rocking curve of the X ray diffraction from the lattice plane of the Miller Index (002) is 93 seconds, 96 seconds, and 87 seconds, respectively, in the case of the 100 mol % AlN single-crystal thin films and 100 mol % GaN single-crystal thin film which were formed further on the 100 mol % AlN amorphous thin film, 100 mol % AlN polycrystalline thin film, and 100 mol % AlN orientated polycrystalline thin film which were formed beforehand on the substrate comprising the same zinc oxide-based sintered compact containing an aluminum component, a yttrium component and an erbium component, and it was improved to not more than 100 seconds.

In addition to these, even when the substrates comprising the zinc oxide-based sintered compacts having all the compositions shown in Table 45 and Table 46 are used, if the thin film(s) comprising various crystallization states, such as an amorphous state, a polycrystal, an orientated polycrystal and a single crystal, etc., and comprising as a main component at least one selected from gallium nitride, indium nitride and aluminum nitride is formed beforehand on these substrates and the single-crystal thin films comprising as a main component at least one selected from gallium nitride, indium nitride and aluminum nitride are formed furthermore on it, the single-crystal thin films in which the crystallinity is superior to the crystallinity of the single-crystal thin films formed directly on these substrates and comprising as a main component at least one selected from gallium nitride, indium nitride and aluminum nitride are obtained.

For example, as shown in Table 45, while the half width of the rocking curve of the X ray diffraction from the lattice plane of the Miller Index (002) of the 100 mol % AlN single-crystal thin film formed directly on this substrate is 227 seconds when the substrate comprising a zinc oxide-based sintered compact not containing an aluminum component and containing an iron component 1.0 mol % on the basis of Fe₂O₃ was used, the half width of the rocking curve of the X ray diffraction from the lattice plane of the Miller Index (002) is 124 seconds in the case of the 100 mol % AlN single-crystal thin film formed furthermore on the 100 mol % AlN orientated polycrystalline thin film formed beforehand on the substrate comprising the same zinc oxide-based sintered compact containing a iron component, and the crystallinity was improved.

While the half width of the rocking curve of the X ray diffraction from the lattice plane of the Miller Index (002) of the 100 mol % GaN single-crystal thin film formed directly on this substrate is 220 seconds when the substrate comprising a zinc oxide-based sintered compact not containing an aluminum component and containing a chromium component 1.0 mol % on the basis of Cr₂O₃ is used, the half width of the rocking curve of the X ray diffraction from the lattice plane of the Miller Index (002) is 119 seconds in the case of the 100 mol % GaN single-crystal thin film formed furthermore on the 100 mol % AlN orientated polycrystalline thin film formed beforehand on the substrate comprising the same zinc oxide-based sintered compact containing a chromium component, and the crystallinity was improved.

While the half width of the rocking curve of the X ray diffraction from the lattice plane of the Miller Index (002) of the 100 mol % AlN single-crystal thin film formed directly on this substrate is 192 seconds when the substrate comprising a zinc oxide-based sintered compact not containing an aluminum component and containing a yttrium component 0.04 mol % on the basis of Y₂O₃ is used, the half width of the rocking curve of the X ray diffraction from the lattice plane of the Miller Index (002) is 104 seconds in the case of the 100 mol % AlN single-crystal thin film formed furthermore on the 100 mol % AlN orientated polycrystalline thin film formed beforehand on the substrate comprising the same zinc oxide-based sintered compact containing a yttrium component, and the crystallinity was improved.

While the half width of the rocking curve of the X ray diffraction from the lattice plane of the Miller Index (002) of the 100 mol % GalN single-crystal thin film formed directly on this substrate is 206 seconds when the substrate comprising a zinc oxide-based sintered compact not containing an aluminum component and containing an erbium component 0.04 mol % on the basis of Er₂O₃ is used, the half width of the rocking curve of the X ray diffraction from the lattice plane of the Miller Index (002) is 107 seconds in the case of the 100 mol % GaN single-crystal thin film formed furthermore on the 100 mol % AlN orientated polycrystalline thin film formed beforehand on the substrate comprising the same zinc oxide-based sintered compact containing an erbium component, and the crystallinity was improved.

While the half width of the rocking curve of the X ray diffraction from the lattice plane of the Miller Index (002) of the 100 mol % AlN single-crystal thin film formed directly on this substrate is 203 seconds when the substrate comprising a zinc oxide-based sintered compact not containing an aluminum component and containing a ytterbium component 0.04 mol % on the basis of Yb₂O₃ is used, the half width of the rocking curve of the X ray diffraction from the lattice plane of the Miller Index (002) is 109 seconds in the case of the 100 mol % AlN single-crystal thin film formed furthermore on the 100 mol % AlN orientated polycrystalline thin film formed beforehand on the substrate comprising the same zinc oxide-based sintered compact containing a ytterbium component, and the crystallinity was improved.

In the other, the thin films with a different constitution from those indicated in Table 45 and Table 46 were formed on the substrates comprising the zinc oxide-based sintered compacts of various composition produced in this Example and shown in Table 45 and Table 46.

That is, as mentioned above, the thin films of 100 mol % AlN are formed beforehand in the thickness of 3 µm on the substrates comprising the zinc oxide-based sintered compacts of various composition comprising as a main component and shown in Table 45 and Table 46 under the same conditions as the sputtering method carried out in the experiment No.706, 707 and 708 of Example 25 and as the MOCVD method carried out in the experiment No.709, and the aluminum nitride-based thin films having the state of an amorphous state, a polycrystal, an orientated polycrystal and a single crystal which are same as Example 25 were formed respectively.

The thin films of 100 mol % GaN were formed beforehand in the thickness of 3 µm under the same conditions as the MOCVD method carried out in the experiment No.728 and 730, and the gallium nitride-based thin films having the state of an amorphous state and an orientated polycrystal which are same as Example 25 were formed respectively.

The thin film of 100 mol % InN was formed beforehand in the thickness of 3 µm under the same conditions as the MOCVD method carried out in the experiment No.731, and the indium nitride-based thin films having the same orientated polycrystalline state as Example 25 were formed.

Using the above substrates comprising the zinc oxide-based sintered compacts forming beforehand the thin films comprising aluminum nitride as a main component, the thin films comprising gallium nitride as a main component, and the thin films comprising indium nitride as a main component, and the substrates comprising the zinc oxide-based sintered compacts left without forming a thin film, the single-crystal thin films of each composition of 100 mol % AlN, 100 mol % GaN, 100 mol % InN, 50 mol % AlN+50 mol % GaN and 50 mol % GaN+50 mol % InN were formed furthermore on them in the thickness of 3 µm by the same MOCVD method as what was described in Example 19.

Even when the above thin films are formed on the substrates comprising the zinc oxide-based sintered compacts of various composition produced in the different constitution from what was shown in Table 45 and Table 46 in this Example, it was confirmed that the crystallinity is superior to the crystallinity of the single-crystal thin films comprising as a main component at least one selected from gallium nitride, indium nitride and aluminum nitride and formed directly on the same substrates compriinge a zinc oxide-based sintered compact, if the thin film(s) comprising as a main component at least one selected from gallium nitride, indium nitride and aluminum nitride and having various crystallization states, such as an amorphous state, a polycrystal, an orientated polycrystal and a single crystal, etc., is formed beforehand and the single-crystal thin films are formed furthermore on it.

Thus, in this Example, when the substrates comprising a zinc oxide-based sintered compacts are used, it was confirmed that the single-crystal thin films having the crystallinity superior to the crystallinity of the single-crystal thin films formed directly on these substrates and comprising as a main component at least one selected from gallium nitride, indium nitride and aluminum nitride are obtained in all the experiment, if the thin film(s) comprising as a main component at least one selected from gallium nitride, indium nitride and aluminum nitride and having various crystallization states, such as an amorphous state, a polycrystal, an orientated polycrystal and a single crystal, etc., is formed beforehand on these substrates and the single-crystal thin films comprising as a main component at least one selected from gallium nitride, indium nitride and aluminum nitride are formed furthermore on it.

In this Example, although the appearance of the thin films of the constitution indicated in Table 45 and 46 and all the other thin films produced was investigated, faults, such as a crack and a crevice, are not seen in all the thin films formed beforehand on the substrates and the thin films formed furthermore on them.

Though the exfoliation test was carried out using the pressure sensitive adhesive tape, in all the thin films, exfoliations were not seen between them and the substrates comprising a zinc oxide-based sintered compact, or between thin films.

The thin film-conductive material of Ti/Pt/Au was formed on the thin films of the surface of the substrates, the metal leads were soldered and the perpendicular tensile strength was investigated, but it all is not less than 2 kg/mm², so there are firm unifications between the zinc oxide-based sintered compacts and the thin films formed beforehand on the substrates, and between these thin films and the thin films formed furthermore on them.

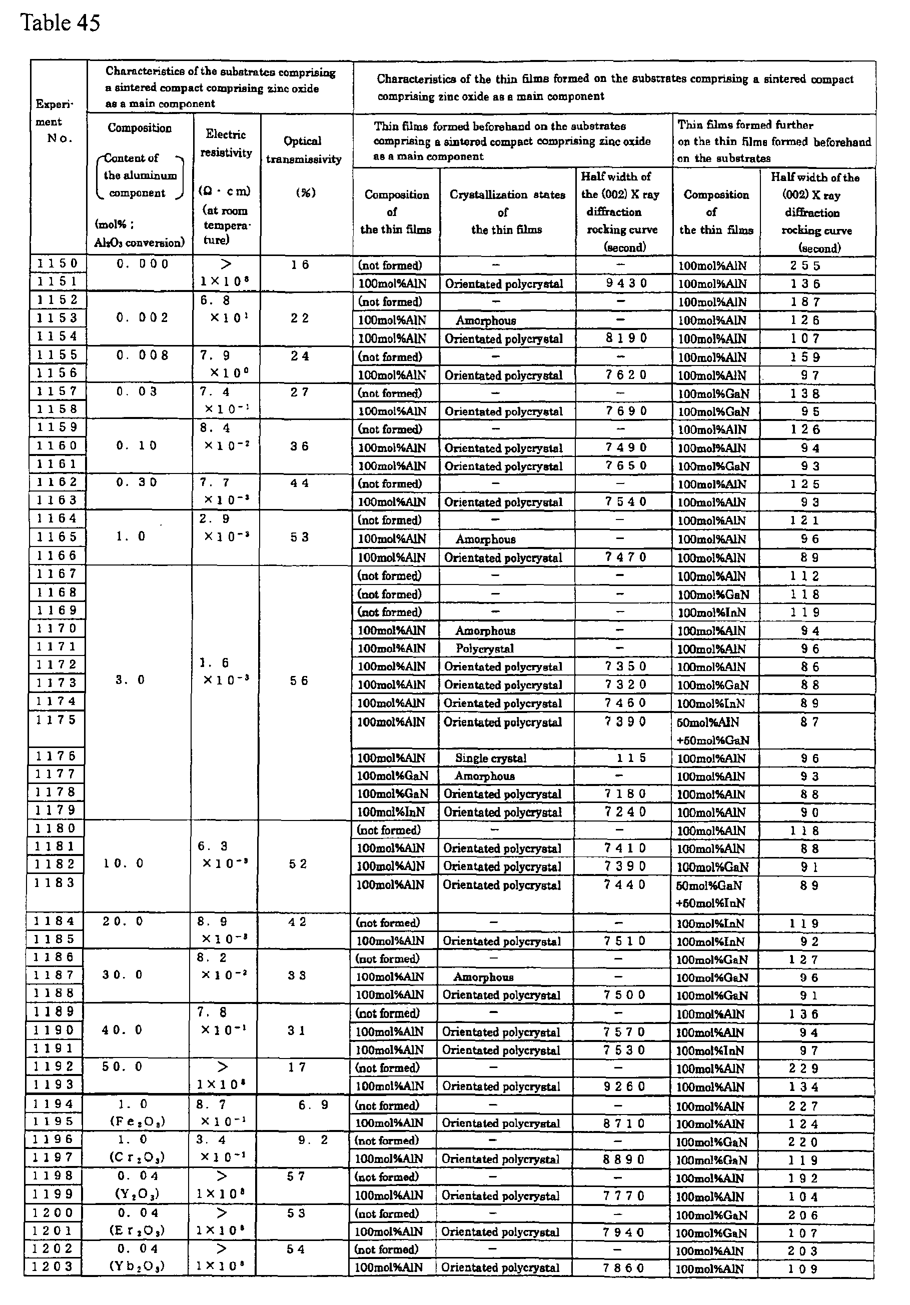

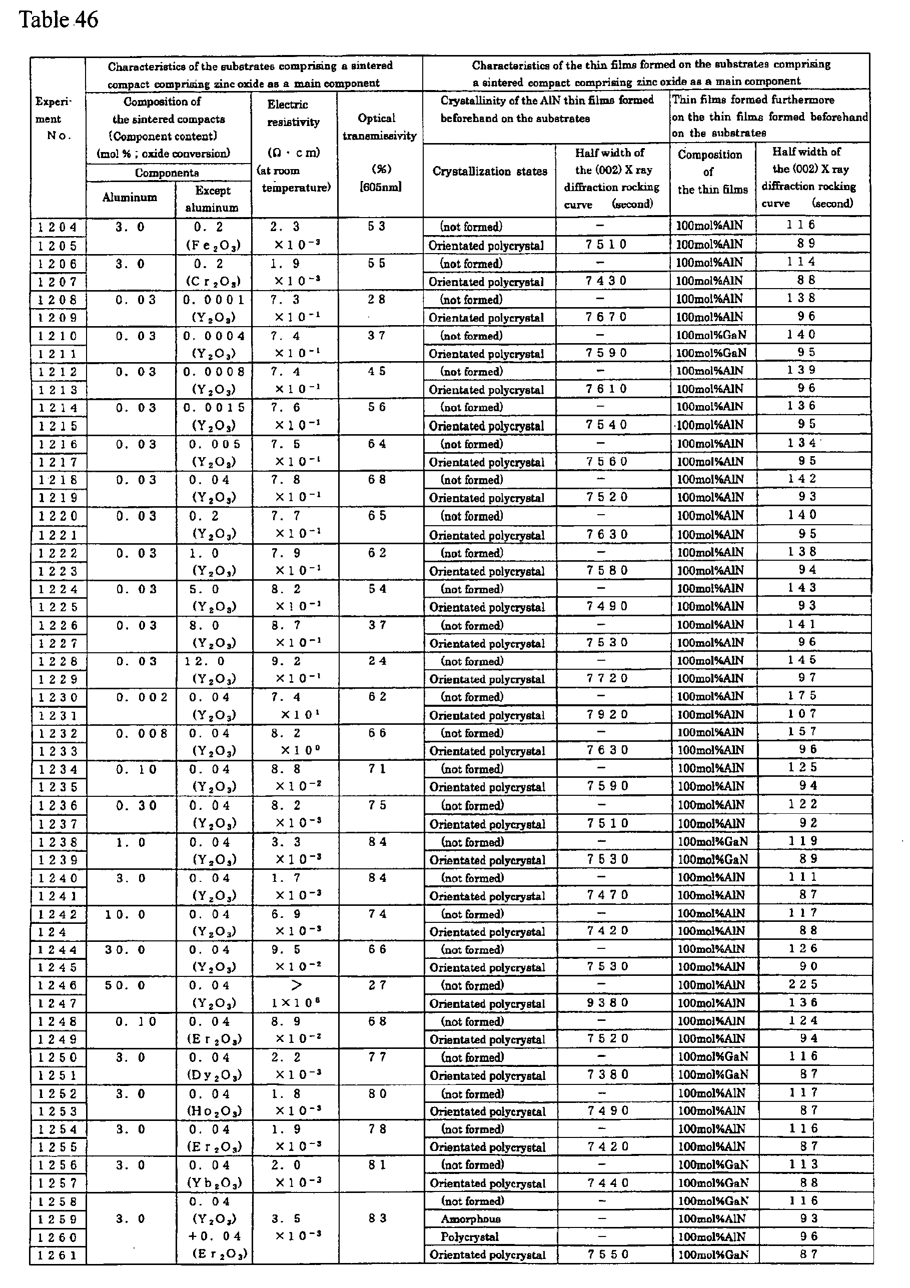

### Example 31

This Example shows the examples which investigated about the compositions of these substrates, and about the influences which give to the crystallinity of the thin films formed on these substrates and comprising as a main component gallium nitride, indium nitride and aluminum nitride, when the sintered compacts comprising as a main component beryllium oxide are used as a substrate.

First, that used in Example 1 and having 99 % of purity by Kojundo Chemical Laboratory Co., Ltd. was prepared as beryllium oxide (BeO) powder, what has 99.99 % of purity by Kojundo Chemical Laboratory Co., Ltd. was prepared as a magnesia (MgO) powder, what has 99.99 % of purity by Kojundo Chemical Laboratory Co., Ltd. was prepared as calcium carbonate (CaCO₃) powder, and the "SO-E2" grade produced by Admatechs Corp. and having 99.9 % of purity was prepared as a silica (SiO₂) powder.

These powders were pulverized and mixed by the ball mill so that they become the predetermined composition by the same method as Example 1, then a paraffine wax was added and the powders for molding were produced, they were degreased after the uniaxial pressing to the powder compacts having the same size as Example 1, the normal-pressure sintering was carried out at 1500°C for 3 hours in air, and the sintered compacts comprising beryllium oxide as a main component and containing a magnesium component, a calcium component and a silicon component in various rate were produced.

Each of these sintered compacts became dense to not less than 98 % as the relative density.

Specular surface polish was carried out using the abradant comprising as a main component the colloidal alumina with the particle diameter of 0.05 µm like Example 8, the washing was carried out by the ultrasonic wave using a methylene chloride and IPA, and the substrates were produced.

The average surface roughness Ra of the mirror-polished substrates was in the range of 8.6-9.5 nm.

The optical transmissivity to the light of 605 nm wavelength was measured by the same method as Example 2 using the substrates after polish.

The characteristics of the substrates obtained like that and comprising a beryllium oxide-based sintered compact are shown in Table 47.

Although the optical transmissivity ofthe substantially beryllium oxide-based sintered compact fired without adding a magnesium component, a calcium component, a silicon component and other components and not including the impurities except those in a raw material was 14 % to the light of 605 nm wavelength, the tendency in which the optical transmissivity becomes high is shown according as the content of a magnesium component, a calcium component and a silicon component increases, and it reached to 57 % in that containing a calcium component 0.45 mol % on the basis of CaO.

After that, the optical transmissivity lowers gradually according as the content of a magnesium component, a calcium component and a silicon component increases, the optical transmissivity to the light of 605 nm wavelength becomes 24 % in the beryllium oxide-based sintered compact containing a magnesium component 30.0 mol % on the basis of MgO, and the optical transmissivity became 7.6 % in the beryllium oxide-based sintered compact containing a magnesium component 40.0 mol % on the basis of MgO.

In this Example, in the beryllium oxide-based sintered compacts containing at least one or more of a magnesium component, a calcium component and a silicon component in the range of not more than 35.0 mol % in total on an oxide basis and containing furthermore at least one selected from a rare-earth element in the range of 0.00005-5.0 mol % in total on an oxide basis, it was confirmed that those in which the optical transmissivity to the light with 605 nm wavelength is not less than 30 % are easy to be obtained.

Furthermore, it was also confirmed that the beryllium oxide-based sintered compacts having the optical transmissivity not less than 80 % may be manufactured.

That is, as shown in Table 47, in the beryllium oxide-based sintered compact containing a calcium component 0.0004 mol % on the basis of CaO and containing simultaneously a yttrium component 0.0002 mol % on the basis of Y₂O₃, the optical transmissivity to the light of 605 nm wavelength was 35 %.

After that, the optical transmissivity shows the increasing tendency according as a yttrium component increases, in the beryllium oxide-based sintered compact containing a calcium component 0.45 mol % on the basis of CaO and containing simultaneously a yttrium component 0.040 mol % on the basis of Y₂O₃, the optical transmissivity to the light of 605 nm wavelength was 81 %.

Furthermore, after that, the optical transmissivity shows the tendency to lower according as a yttrium component increases, in the beryllium oxide-based sintered compact containing a calcium component 0.0004 mol % on the basis of CaO and containing simultaneously a yttrium component 4.0 mol % on the basis of Y₂O₃, the optical transmissivity to the light of 605 nm wavelength was 37 %, and in the beryllium oxide-based sintered compact containing a calcium component 0.0004 mol % on the basis of CaO and containing simultaneously a yttrium component 6.0 mol % on the basis of Y₂O₃, the optical transmissivity to the light of 605 nm wavelength was 28 %.

As mentioned above, the optical transmissivity of the beryllium oxide-based sintered compact containing a calcium component 0.45 mol % on the basis of CaO and containing furthermore a yttrium component 0.040 mol % on the basis of Y₂O₃ was 81 % to the light of 605 nm wavelength, and the optical transmissivity of the beryllium oxide-based sintered compacts containing a calcium component 0.45 mol % on the basis of CaO and containing furthermore the rare earth element component(s) 0.040 mol % other than yttrium on the basis of oxide was also high as 75-80 % to the light of 605 nm wavelength.

That is, the optical transmissivity ofthe beryllium oxide-based sintered compact containing a calcium component 0.45 mol % on the basis of CaO and furthermore containing simultaneously a dysprosium component 0.040 mol % on the basis of Dy₂O₃ as the rare earth element components was 76 % to the light of 605 nm wavelength, the optical transmissivity of the beryllium oxide-based sintered containing simultaneously a holmium component 0.040 mol % on the basis of Ho₂O₃ was 75 %, the optical transmissivity of the beryllium oxide-based sintered compact containing simultaneously an erbium component 0.040 mol % on the basis of Er₂O₃ was 80 %, and the optical transmissivity of the beryllium oxide-based sintered compact containing simultaneously a ytterbium component 0.040 mol % on the basis of Yb₂O₃ was 78 %.

Furthermore, in the beryllium oxide-based sintered compact containing simultaneously three components including a calcium component 0.45 mol % on the basis of CaO, a silicon component 0.20 mol % on the basis of SiO₂, and a yttrium component 0.040 mol % on the basis of Y₂O₃, the optical transmissivity to the light with a wavelength of 605 nm was 80 %.

Next, the thin films were formed by the same method as what was shown in Example 27 to the above substrate prepared.

That is, after choosing some substrates prepared, the thin films of 100 mol % AlN were formed beforehand on them in the thickness of 3 µm under the same conditions as the sputtering method carried out in the experiment No.708 of Example 25.

Next, using the above substrates comprising the beryllium oxide-based sintered compacts forming beforehand an AlN thin film, and the substrates comprising the beryllium oxide-based sintered compacts left without forming an AlN thin film, the thin films of each composition of the same 100 mol % AlN and 100 mol % GaN as what was described in Example 19 were formed furthermore on them in the thickness of 3 µm by the MOCVD method.

They were the same conditions as Example 1 and Example 2 like the description in Example 19 as the condition of MOCVD.

The characteristics of the thin films produced like that were shown in Table 47.

In this Example, in the 100 mol %AlN thin films formed beforehand on each above substrate, only the diffraction line from the lattice plane of the Miller Index (002) appeared, and it was clearly the orientated polycrystal formed in the direction where C axis is perpendicular to the substrate surface.

If the crystallinity of the AlN orientated polycrystalline thin films formed beforehand on each above substrate was seen, the half width of the rocking curve of the X ray diffraction from the lattice plane of the Miller Index (002) of this orientated polycrystalline thin film was 9670 seconds, when the substrate comprising a beryllium oxide-based sintered compact not containing substantially a magnesium component, a calcium component and a silicon component was used as shown in Table 47.

The crystallinity of these orientated polycrystalline thin films showed the tendency to be improved according as a magnesium component, a calcium component and a silicon component increase.

That is, although it was 9120 seconds when the substrate comprises a beryllium oxide-basede sintered compact containing a magnesium component 0.0001 mol % on the basis of MgO was used, it was 8540 seconds when the substrate comprising a beryllium oxide-based sintered compact containing a calcium component 0.0004 mol % on the basis of CaO was used, it was 7710 seconds and was lowered into not more than 8000 seconds, when the substrate comprising a beryllium oxide-based sintered compact containing a silicon component 0.002 mol % on the basis of SiO₂ was used.

After that, the crystallinity of these AlN orientated polycrystalline thin films showed the tendency to be improved a little according as the content of a magnesium component, a calcium component and a silicon component increases.

When the substrate comprising a beryllium oxide-based sintered compact containing a calcium component 0.45 mol % on the basis of CaO and a silicon component 0.2 mol % on the basis of SiO₂ was used, it became 7190 seconds and it has been improved most.

After that, the crystallinity of these AlN orientated polycrystalline thin films showed the tendency to lower a little, according as the content of a magnesium component, a calcium component and a silicon component increases.

In the case of the AlN orientated polycrystalline thin film formed on the substrate comprising a beryllium oxide-based sintered compact containing a magnesium component 30.0 mol % on the basis of MgO, it was 7650 seconds.

However, in the case of the AlN orientated polycrystalline thin film formed on the substrate comprising a beryllium oxide-based sintered compact containing a magnesium component 40.0 mol % on the basis of MgO, it was 9480 seconds and the crystallinity was lowered.

In the case of the AlN orientated polycrystalline thin films formed on the substrates comprising the beryllium oxide-based sintered compacts containing at least one of a magnesium component, a calcium component and a silicon component not more than 35.0 mol % in total on an oxide basis and containing furthermore at least one selected from a rare earth element(s), the half width of the rocking curve of the X ray diffraction from the lattice plane of the Miller Index (002) of these orientated polycrystalline thin films was in the range of 7220-7960 seconds, and it was not more than 8000 seconds altogether.

Next, the crystallinity of the thin films comprising each composition of 100 mol % AlN and 100 mol % GaN and formed by the above MOCVD method was investigated by X ray diffraction, using the substrates comprising the beryllium oxide-based sintered compacts left without forming beforehand the above thin films.

As a result, it was confirmed that all the produced thin films are the single crystals formed in the direction where C axis is perpendicular to the substrate surface.

If the crystallinity is seen, as shown in Table 47, as for the half width of the rocking curve of the X ray diffraction from the lattice plane of the Miller Index (002) of the 100 mol % AlN single-crystal thin film formed directly on the substrate comprising a beryllium oxide-based sintered compact fired without adding a magnesium component, a calcium component, a silicon component and other components and not containing substantially anything other than the impurities mixed in a raw material or at the time of sintered compact manufacture, it was 270 seconds.

On the other hand, in the case of the 100 mol % AlN single-crystal thin film formed directly on the substrate comprising a beryllium oxide-based sintered compact containing a magnesium component 0.0001 mol % on the basis of MgO, it became small to 221 seconds and the crystallinity was improved.

Furthermore, it is 191 seconds in the case of the 100 mol % AlN single-crystal thin film formed directly on the substrate comprises a beryllium oxide-based sintered compact containing a calcium component 0.0004 mol % on the basis of CaO, and it is 168 seconds in the case of the 100 mol % AlN single-crystal thin film formed directly on the substrate comprising a beryllium oxide-based sintered compact containing a silicon component 0.0020 mol % on the basis of SiO₂, it became into not more than 200 seconds, respectively, and the crystallinity was improved.

It is 142 seconds in the case of the 100 mol % AlN single-crystal thin film formed directly on the substrate comprising a beryllium oxide-based sintered compact containing a magnesium component 0.0080 mol % on the basis of MgO, it became not more than 150 seconds, and the crystallinity was improved more.

It is 122 seconds in the case of the 100 mol % AlN single-crystal thin film formed directly on the substrate comprising a beryllium oxide-based sintered compact containing a calcium component 0.020 mol % on the basis of CaO, and it is 127 seconds in the case of the 100 mol % AlN single-crystal thin film formed directly on the substrate comprising a beryllium oxide-based sintered compact containing a silicon component 0.40 mol % on the basis of SiO₂, it became into not more than 130 seconds, respectively, and the crystallinity was improved still more.

After that, the half width of the rocking curve of the X ray diffraction from the lattice plane of the Miller Index (002) of the single-crystal thin films formed directly on the substrates comprising a beryllium oxide-based sintered compact became small, according as the content of a magnesium component, a calcium component and a silicon component increased.

That is, it is 109 seconds in the case of the 100 mol % AlN single-crystal thin film formed directly on the substrate comprising a beryllium oxide-based sintered compact containing a calcium component 0.45 mol % on the basis of CaO, and it is 108 seconds in the case of the 100 mol % AlN tsingle-crystal thin film formed directly on the substrate comprising a beryllium oxide-based sintered compact containing simultaneously a calcium component 0.45 mol % on the basis of CaO and a silicon component 0.20 mol % on the basis of SiO₂, it became the smallest in the single-crystal thin films formed directly on the substrates in this Example, and the crystallinity was best.

After that, the half width of the rocking curve of the X ray diffraction from the lattice plane of the Miller Index (002) of the single-crystal thin films formed directly on the substrates comprising a beryllium oxide-based sintered compacts became large according as the content of a magnesium component, a calcium component and a silicon component increased, it became 132 seconds in the case of the 100 mol % AlN single-crystal thin film formed directly on the substrate comprising a beryllium oxide-based sintered compact containing a magnesium component 30.0 mol % on the basis of MgO.

It became 217 seconds in the case of the 100 mol % AlN single-crystal thin film formed directly on the substrate comprising a beryllium oxide-based sintered compact containing a magnesium component 40.0 mol % on the basis of MgO, and it became larger than 200 seconds.

On the other hand, in this Example, as shown in Table 47, in the substrates comprising a beryllium oxide-based sintered compact containing at least one or more of a magnesium, a calcium and a silicon component, even if the components other than a magnesium, a calcium and a silicon component, such as a rare earth element, were contained in this sintered compact, it was confirmed that there is little change of lowering greatly the crystallinity of a single-crystal thin film formed directly on this substrate and comprising as a main component at least one selected from gallium nitride, indium nitride and aluminum nitride.

If saying in other words, in the case of the substrates comprising the beryllium oxide-based sintered compacts containing at least one of magnesium, calcium and silicon, it was confirmed that the crystallinity of the single-crystal thin films formed directly on these substrates is what cannot be influenced easily by these components, even if the components other than magnesium, calcium and silicon, such as a rare earth element, were contained in the sintered compacts.

Concretely saying, as for the half width of the rocking curve of the X ray diffraction from the lattice plane of the Miller Index (002) of the 100 mol % AlN single-crystal thin films formed directly on the substrates comprising the beryllium oxide-based sintered compact containing simultaneously a calcium component 0.0004 mol % on the basis of CaO and a yttrium component 0.0002 mol % on the basis of Y₂O₃, and of the beryllium oxide-based sintered compact containing simultaneously a calcium component 0.0004 mol % on the basis of CaO and a yttrium component 6.0 mol % on the basis of Y₂O₃, it is 182 seconds and 189 seconds, respectively, the crystallinity did not show the change tendency of lowering greatly from 191 seconds of the 100 mol % AlN single-crystal thin film formed directly on the substrate comprising the beryllium oxide-based sintered compact containing only a calcium component 0.0004 mol % on the basis of CaO and not containing a yttrium component substantially.

The half width of the rocking curve of the X ray diffraction from the lattice plane of the Miller Index (002) of the 100 mol % GaN single-crystal thin film formed directly on the substrate comprising the beryllium oxide-based sintered compact containing a calcium component 0.0004 mol % on the basis of CaO and containing simultaneously a yttrium component 4.0 mol % on the basis of Y₂O₃ is 176 seconds, the crystallinity did not show the change tendency of lowering greatly from 191 seconds of the 100 mol % AlN single-crystal thin film formed directly on the substrate comprising the beryllium oxide-based sintered compact containing only a calcium component 0.0004 mol % on the basis of CaO and not containing a yttrium component substantially.

The half width of the rocking curve of the X ray diffraction from the lattice plane of the Miller Index (002) of the 100 mol % AlN single-crystal thin films formed directly on the substrates comprising the beryllium oxide-based sintered compacts containing a calcium component 0.020 mol % on the basis of CaO and simultaneously containing a yttrium component 0.0010 mol % and 0.0040 mol % on the basis of Y₂O₃, is 121 seconds and 120 seconds respectively, the crystallinity did not show the change tendency of lowering greatly from 122 seconds of the 100 mol % AlN single-crystal thin film formed directly on the substrate comprising the beryllium oxide-based sintered compact containing only a calcium component 0.020 mol % on the basis of CaO and not containing a yttrium component substantially.

The half width of the rocking curve of the X ray diffraction from the lattice plane of the Miller Index (002) of the 100 mol % GaN single-crystal thin film formed directly on the substrate comprising the beryllium oxide-based sintered compact containing a calcium component 0.020 mol % on the basis of CaO and containing simultaneously a yttrium component 0.010 mol % on the basis of Y₂O₃ is 118 seconds, the crystallinity did not show the change tendency of lowering greatly from 122 seconds of the 100 mol % AlN single-crystal thin film formed directly on the substrate comprising the beryllium oxide-based sintered compact containing only a calcium component 0.020 mol % on the basis of CaO and not containing a yttrium component substantially.

The half width of the rocking curve of the X ray diffraction from the lattice plane of the Miller Index (002) of the 100 mol % AlN single-crystal thin films formed directly on the substrates comprising the beryllium oxide-based sintered compacts containing a calcium component 0.45 mol % on the basis of CaO and simultaneously containing a yttrium component 0.040 mol % on the basis of Y₂O₃, a holmium component 0.040 mol % on the basis of Ho₂O₃, and an erbium component 0.040 mol % on the basis of Er₂O₃ is 104 seconds, 107 seconds, and 108 seconds respectively, the crystallinity did not show the change tendency of lowering greatly from 109 seconds of the 100 mol % AlN single-crystal thin film formed directly on the substrate comprising the beryllium oxide-based sintered compact containing only a calcium component 0.45 mol % on the basis of CaO and not containing the above various rare earth element components substantially.

The half width of the rocking curve of the X ray diffraction from the lattice plane of the Miller Index (002) of the 100 mol % GaN single-crystal thin films formed directly on the substrates comprising the beryllium oxide-based sintered compacts containing a calcium component 0.45 mol % on the basis of CaO and simultaneously containing a dysprosium component 0.040 mol % on the basis of Dy₂O₃ and a ytterbium component 0.040 mol % on the basis of Yb₂O₃ is 110 seconds and 106 seconds respectively, the crystallinity did not show the change tendency of lowering greatly from 109 seconds of the 100 mol % AlN single-crystal thin film formed directly on the substrate comprising the beryllium oxide-based sintered compact containing only a calcium component 0.45 mol % on the basis of CaO and not containing the above various rare earth element components substantially.

The half width of the rocking curve of the X ray diffraction from the lattice plane of the Miller Index (002) of the 100 mol % GaN single-crystal thin film formed directly on the substrate comprising the beryllium oxide-based sintered compact containing a calcium component 0.45 mol % on the basis of CaO and a silicon component 0.20 mol % on the basis of SiO₂ and containing simultaneously a yttrium component 0.040 mol % on the basis of Y₂O₃ is 109 seconds, the crystallinity did not show the change tendency of lowering greatly from 108 seconds of the 100 mol % AlN single-crystal thin film formed directly on the substrate comprising the beryllium oxide-based sintered compact containing only a calcium component 0.45 mol % on the basis of CaO and a silicon component 0.20 mol % on the basis of SiO₂ and not containing a yttrium component substantially.

Thus, in the substrates comprising a beryllium oxide-based sintered compact containing at least one selected from a magnesium component, a calcium component and a silicon component, it was confirmed that the crystallinity of the single-crystal thin films formed directly on these substrates and comprising as a main component gallium nitride and aluminum nitride changes little and has the tendency to be hard to be influenced by the existence of the rare earth element component(s), such as a yttrium component, even if these substrates comprise a beryllium oxide-based sintered compact containing simultaneously the rare earth element component(s), such as yttrium, other than a magnesium component, a calcium component and a silicon component.

As mentioned above, the half width of the rocking curve of the X ray diffraction from the lattice plane of the Miller Index (002) of the 100 mol % AlN single-crystal thin film and 100 mol % GaN single-crystal thin film which were formed directly on the substrates comprising the beryllium oxide-based sintered compacts having various composition is not more than 300 seconds altogether, it excelled in crystallinity.

In this Example, when the substrates comprising the above beryllium oxide-based sintered compacts having various composition and having such characteristics are used, it was confirmed that the single-crystal thin films excellent in crystallinity than the crystallinity of the single-crystal thin films formed directly on these substrates and comprising as a main component at least one selected from gallium nitride and aluminum nitride are obtained, if the orientated polycrystalline thin film(s) comprising as a main component aluminum nitride is formed beforehand on these substrates, and the single-crystal thin films comprising as a main component at least one selected from gallium nitride and aluminum nitride are formed furthermore on it.

That is, it does not necessarily restrict that half width of the rocking curve of the X ray diffraction from the lattice plane of the Miller Index (002) of the single-crystal thin films formed directly on these substrates and comprising as a main component at least one selected from gallium nitride and aluminum nitride becomes not more than 200 seconds, even if the beryllium oxide-based sintered compacts having various composition are used as a substrate.

On the other hand, if the orientated polycrystalline thin film(s) comprising as a main component aluminum nitride is formed beforehand on these substrates, and the single-crystal thin films comprising as a main component at least one selected from gallium nitride and aluminum nitride are formed furthermore on it, it was confirmed that the single-crystal thin films in which the half width of the rocking curve of the X ray diffraction from the lattice plane of the Miller Index (002) is not more than 200 seconds may be formed, even if the beryllium oxide-based sintered compacts having such various composition are used as a substrate.

When the single-crystal thin films comprising as a main component at least one selected from gallium nitride and aluminum nitride are formed using the substrates comprising a beryllium oxide-based sintered compact having the same composition, it was confirmed that the single-crystal thin films excellent in crystallinity than the crystallinity of the single-crystal thin films formed directly on these substrates and compriinge as a main component at least one selected from gallium nitride and aluminum nitride are obtained, if the orientated polycrystalline thin film(s) comprising aluminum nitride as a main component is formed beforehand on these substrates, and the single-crystal thin films comprising as a main component at least one selected from gallium nitride and aluminum nitride are formed furthermore on it.

That is, it was confirmed that the single-crystal thin films tend to become those excellent in crystallinity in which the halfwidth of the rocking curve of the X ray diffraction from the lattice plane of the Miller Index (002) is not more than 130 seconds, if the orientated polycrystalline thin film(s) comprising aluminum nitride as a main component is formed beforehand on them, and the single-crystal thin films comprising as a main component at least one selected from gallium nitride and aluminum nitride are formed furthermore on it, using the substrates comprising a beryllium oxide-based sintered compact containing at least one of a magnesium component, a calcium component and a silicon component in the range of 0.0002-35.0 mol % in total on an oxide basis, and it was confirmed that the single-crystal thin films tend to become those excellent in crystallinity in which the half width of the rocking curve of the X ray diffraction from the lattice plane of the Miller Index (002) is not more than 100 seconds, if the orientated polycrystalline thin film(s) comprising aluminum nitride as a main component is formed beforehand on them, and the single-crystal thin films comprising as a main component at least one selected from gallium nitride and aluminum nitride are formed furthermore on it, using the substrates comprising a beryllium oxide-based sintered compact containing at least one of a magnesium component, a calcium component and a silicon component in the range of 0.001-35.0 mol % in total on an oxide basis.

It was confirmed that it is hard to receive the great change of lowering the crystallinity of the single-crystal thin films formed on these substrates compared with the crystallinity of the single-crystal thin films formed on the above substrates comprising a beryllium oxide-based sintered compact containing a magnesium component, a calcium component and a silicon component and not containing substantially other component(s), such as a yttrium component, a dysprosium component, a holmium component, an erbium component and a ytterbium component, even if they are the substrates comprising a beryllium oxide-based sintered compact containing the above amount of a magnesium component, a calcium component and a silicon component and containing simultaneously a component, such as a yttrium component, a dysprosium component, a holmium component, an erbium component and a ytterbium component, etc., other than these.

That is, if they are the substrates comprising a beryllium oxide-based sintered compact containing the above amount of at least one selected from a magnesium component, a calcium component and a silicon component, it was confirmed that the crystallinity of the formed single-crystal thin films comprising as a main component at least one selected from gallium nitride and aluminum nitride is what cannot be influenced easily by the component(s), even if the component(s) other than a magnesium component, a calcium component and a silicon component, such as a yttrium component, a dysprosium component, a holmium component, an erbium component and a ytterbium component, was contained.

If saying more concretely, as shown in Table 47, while the half width of the X ray diffraction from the lattice plane of the Miller Index (002) of the 100 mol % AlN single-crystal thin film formed directly on the substrate comprising the beryllium oxide-based sintered compact fired without adding a magnesium component, a calcium component, a silicon component and other component(s) and not containing substantially anything other than the impurities mixed in a raw material or at the time of sintered compact manufacture is 270 seconds, the half width of the rocking curve of the X ray diffraction from the lattice plane of the Miller Index (002) of the 100 mol % AlN single-crystal thin film formed furthermore on the 100 mol % AlN orientated polycrystalline thin film formed beforehand on the substrate comprising the same beryllium oxide-based sintered compact is 139 seconds, and the crystallinity was improved.

While the half width of the rocking curve of the X ray diffraction from the lattice plane of the Miller Index (002) of the 100 mol % AlN single-crystal thin film formed directly on the substrate is 221 seconds when the substrate comprising the beryllium oxide-based sintered compact containing a magnesium component 0.0001 mol % on the basis of MgO is used, the half width of the rocking curve of the X ray diffraction from the lattice plane of the Miller Index (002) of the 100 mol % AlN single-crystal thin film formed furthermore on the 100 mol % AlN orientated polycrystalline thin film(s) formed beforehand on the substrate comprising the same beryllium oxide-based sintered containing a magnesium component is 132 seconds, and the crystallinity was improved.

Furthermore, while the half width of the rocking curve of the X ray diffraction from the lattice plane of the Miller Index (002) of the 100 mol % AlN single-crystal thin film formed directly on the substrate is 191 seconds when the substrate comprising the beryllium oxide-based sintered compact containing a calcium component 0.0004 mol % on the basis of CaO is used, the half width of the rocking curve of the X ray diffraction from the lattice plane of the Miller Index (002) of the 100 mol % AlN single-crystal thin film formed furthermore on the 100 mol % AlN orientated polycrystalline thin film(s) formed beforehand on the substrate comprising the same beryllium oxide-based sintered compact containing a calcium component is 124 seconds, and the crystallinity was improved.

While the half width of the rocking curve of the X ray diffraction from the lattice plane of the Miller Index (002) of the 100 mol % AlN single-crystal thin film formed directly on the substrate is 168 seconds when the substrate comprising the beryllium oxide-based sintered compact containing a silicon component 0.002 mol % on the basis of SiO₂ is used, the half width of the rocking curve of the X ray diffraction from the lattice plane of the Miller Index (002) of the 100 mol % AlN single-crystal thin film formed furthermore on the 100 mol % AlN orientated polycrystalline thin film(s) formed beforehand on the substrate comprising the same beryllium oxide-based sintered compact containing a silicon component is 96 seconds, and it became into not more than 100 seconds.

As shown below, when the substrates comprising a beryllium oxide-based sintered compact containing at least one selected from a magnesium component, a calcium component and a silicon component in the range of 0.001-35.0 mol % in total on an oxide basis are used, if the orientated polycrystalline thin film(s) comprising as a main component aluminum nitride is formed beforehand on these substrates, and the single-crystal thin films comprising as a main component at least one selected from gallium nitride and aluminum nitride are formed furthermore on it, the single-crystal thin films in which the crystallinity is superior to the crystallinity of the single-crystal thin films formed directly on the substrates and comprising as a main component at least one selected from gallium nitride, indium nitride and aluminum nitride, are obtained, and it was confirmed that the half width of the rocking curve of the X ray diffraction from the lattice plane of the Miller Index (002) of these single-crystal thin films is the range of 89-97 seconds and is not more than 100 seconds altogether.

While the half width of the rocking curve of the X ray diffraction from the lattice plane of the Miller Index (002) of the single-crystal thin film is 217 seconds in the case of the 100 mol % AlN single-crystal thin film formed directly on the substrate comprising the beryllium oxide-based sintered compact containing a magnesium component 40.0 mol % on the basis of MgO, it is 142 seconds in the case of 100 mol % AlN single-crystal thin film formed furthermore on the 100 mol % AlN orientated polycrystalline thin film formed beforehand on the same substrate, and the crystallinity was improved.

For example, as shown in Table 47, when the substrates comprising a beryllium oxide-based sintered compact containing at least one selected from magnesium, calcium and silicon and containing furthermore a rare-earth-elements component were used, it was confirmed that the crystallinity is improved than the crystallinity of the 100 mol % AlN single-crystal thin film or 100 mol % GaN single-crystal thin film which were formed directly on these substrates, if the orientated polycrystalline thin film(s) of 100 mol % AlN is formed beforehand on the substrates comprising the same beryllium oxide-based sintered compact containing at least one selected from magnesium, calcium and silicon and further containing a rare-earth-elements component simultaneously, and the 100 mol % AlN single-crystal thin film or the 100 mol % GaN single-crystal thin film were formed furthermore on it.

For example, while the half width of the rocking curve of the X ray diffraction from the lattice plane of the Miller Index (002) of the 100 mol % AlN single-crystal thin films or 100 mol % GaN single-crystal thin film which were formed directly on these substrates is 182 seconds, 176 seconds and 189 seconds in each substrate when using the substrates comprising the beryllium oxide-based sintered compacts containing a calcium component 0.0004 mol % on the basis of CaO and containing furthermore a yttrium component 0.0002 mol %, 4.0 mol %, and 6.0 mol % on the basis of Y₂O₃, the half width of the rocking curve of the X ray diffraction from the lattice plane of the Miller Index (002) of the 100 mol % AlN single-crystal thin film or 100 mol % GaN single-crystal thin film which were formed furthermore on the 100 mol % AlN orientated polycrystalline thin film formed beforehand on the substrates comprising the same beryllium oxide-based sintered compacts containing a calcium component and a yttrium component is 119 seconds, 121 seconds and 126 seconds in each substrate, and the crystallinity was improved.

Furthermore, when using those in which the 100 mol % AlN orientated polycrystalline thin film was formed beforehand on the substrates comprising the beryllium oxide-based sintered compacts containing a calcium component 0.020 mol % on the basis of CaO and containing furthermore a yttrium component 0.0010 mol %, 0.0040 mol % and 0.010 mol % on the basis of Y₂O₃, the half width of the rocking curve of the X ray diffraction from the lattice plane of the Miller Index (002) of the 100 mol % AlN single-crystal thin film or 100 mol % GaN single-crystal thin film which were formed on these is 93 seconds, 94 seconds and 92 seconds respectively, they were not more than 100 seconds, and the crystallinity was improved than what was formed directly on the same substrates.

When using those in which the 100 mol % AlN orientated polycrystalline thin film was formed beforehand on the substrates comprising the beryllium oxide-based sintered compacts having the composition containing a calcium component 0.45 mol % on the basis of CaO and contains furthermore a yttrium component 0.040 mol % on the basis of Y₂O₃, a dysprosium component 0.040 mol % on the basis of Dy₂O₃, a holmium component 0.040 mol % on the basis of Ho₂O₃, an erbium component 0.040 mol % on the basis of Er₂O₃, and a ytterbium component 0.040 mol % on the basis of Yb₂O₃ respectively, the half width of the rocking curve of the X ray diffraction from the lattice plane of the Miller Index (002) of the 100 mol % AlN single-crystal thin film or 100 mol % GaN single-crystal thin film which were formed on these is 88 seconds, 91 seconds, 90 seconds, 89 seconds and 90 seconds respectively, it was not more than 100 seconds altogether, and the crystallinity was improved than what was formed directly on the same substrates.

In addition, although it is not indicated in Table 47, in the substrates comprising the beryllium oxide-based sintered compacts of various composition produced in this Example and shown in Table 47, not only the 100 mol % AlN orientated polycrystalline thin films but also the 100 mol % AlN thin films are formed beforehand in the thickness of 3 µm under the same conditions as the sputtering method carried out in the experiment No.706 and 707 and the MOCVD method carried out in the experiment No.709 in Example 25, and the aluminum nitride-based thin films having the amorphous state, polycrystalline state and single crystal state which are the same as Example 25 were formed, respectively.

The gallium nitride-based thin films having the amorphous state and orientated polycrystal which are the same as Example 25 were formed respectively, forming beforehand the 100 mol % GaN thin films in the thickness of 3 µm under the same conditions as the MOCVD method carried out in the experiment No. 728 and 730.

The indium nitride-based thin films having the same orientated polycrystalline state as Example 25 were formed, forming beforehand the 100 mol % InN thin films in the thickness of 3 µm under the same conditions as the MOCVD method carried out in the experiment No.731.

Using the substrates comprising the beryllium oxide-based sintered compacts forming beforehand the aluminum nitride-based thin films, the gallium nitride-based thin films and the indium nitride-based thin films, as mentioned above, and using the substrates comprising the beryllium oxide-based sintered compacts left without forming a thin film, the single-crystal thin films of each composition of 100 mol % AlN, 100 mol % GaN, 100 mol % InN, 50 mol % AlN+50 mol % GaN and 50 mol % GaN+50 mol % InN were formed furthermore on it in the thickness of 3 µm by the same MOCVD method as what was described in Example 19.

Also when the thin films of the above constitution were formed on the substrates comprising the same beryllium oxide-based sintered compact shown in Table 47, it was confirmed that they have the same effect as those of the constitution wherein the thin films formed beforehand are the 100 mol % AlN orientated polycrystal and the thin films formed furthermore on them are the 100 mol % AlN or 100 mol % GaN single-crystal thin film.

For example, it was confirmed that the crystallinity is superior to the crystallinity of the single-crystal thin films comprising as a main component at least one selected from gallium nitride, indium nitride and aluminum nitride and formed directly on the same substrates comprising a beryllium oxide-based sintered compact, if the thin film(s) comprising as a main component at least one selected from gallium nitride, indium nitride and aluminum nitride and having various crystallization states, such as an amorphous state, a polycrystal, an orientated polycrystal and a single crystal, etc., is formed beforehand and the single-crystal thin films are formed furthermore on it.

Thus, in this Example, when the substrates comprising a beryllium oxide-based sintered compacts are used, it was confirmed that the single-crystal thin films with the crystallinity superior to the crystallinity of the single-crystal thin films formed directly on these substrates and comprising as a main component at least one selected from gallium nitride, indium nitride and aluminum nitride are obtained in all the experiment, if the thin film(s) comprising as a main component at least one selected from gallium nitride, indium nitride and aluminum nitride and having various crystallization states, such as an amorphous state, a polycrystal, an orientated polycrystal and a single crystal, etc., is formed beforehand on these substrates and the single-crystal thin films comprising as a main component at least one selected from gallium nitride, indium nitride and aluminum nitride are formed furthermore on it.

In this Example, although the appearance of the thin films of the constitution indicated in Table 47 and all the other thin films produced was investigated, faults, such as a crack and a crevice, are not seen in all the thin films formed beforehand on the substrates and the thin films formed furthermore on them.

Though the exfoliation test was carried out using the pressure sensitive adhesive tape, in all the thin films, exfoliations were not seen between them and the substrates comprising a sintered compact comprising beryllium oxide as a main component, or between thin films.

The thin film-conductive material of Ti/Pt/Au was formed on the thin films of the surface of the substrates, the metal leads were soldered and the perpendicular tensile strength was investigated, but it all is not less than 2 kg/mm², so there are firm unifications between the sintered compacts comprising as a main component beryllium oxide and the thin films formed beforehand on the substrates, and between these thin films and the thin films formed furthermore on them.

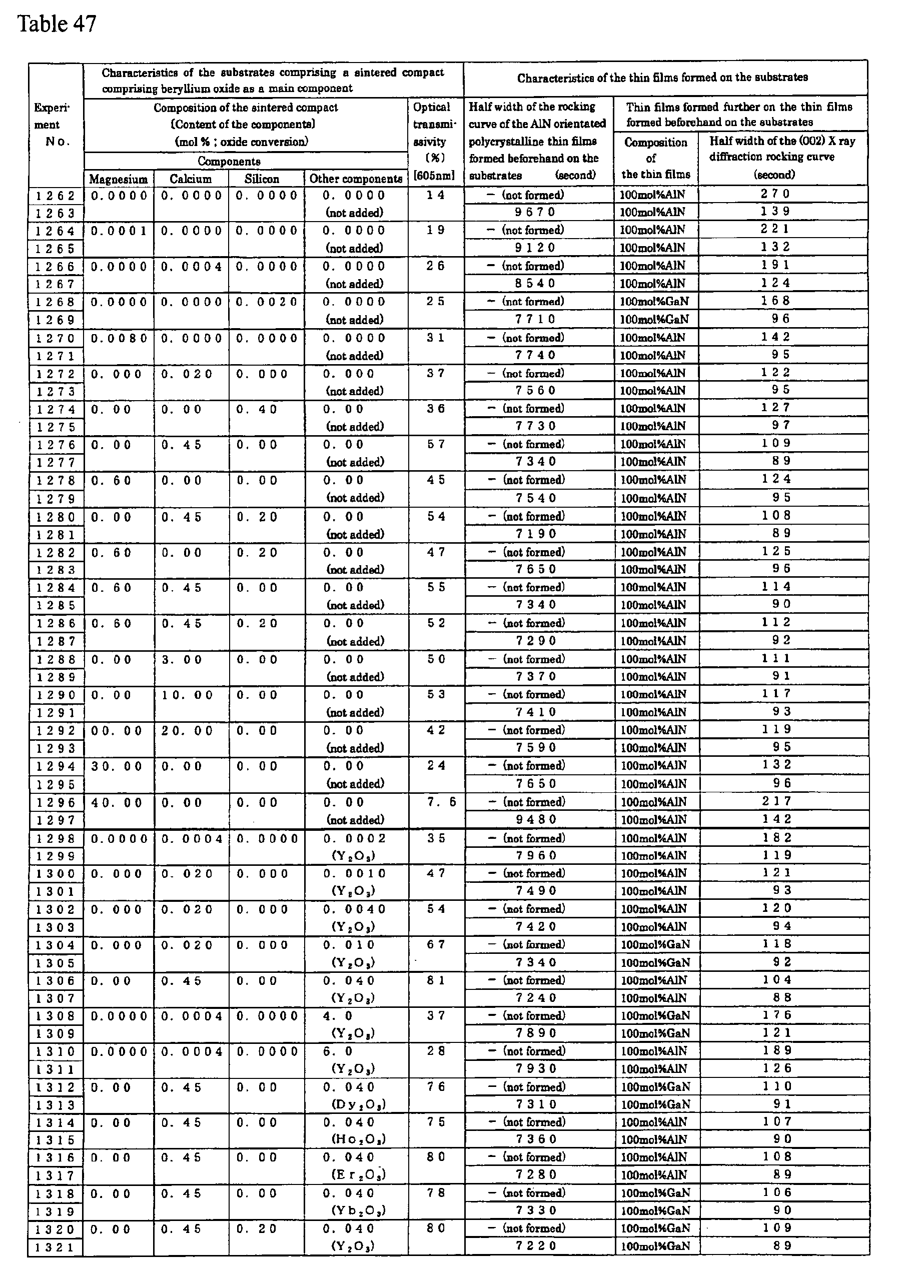

### Example 32

This Example shows the examples which investigated about the compositions of these substrates, and about the influences which give to the crystallinity of the thin films formed on these substrates and comprising as a main component gallium nitride, indium nitride and aluminum nitride, when the sintered compacts comprising as a main component aluminum oxide are used as a substrate.

First, "A-31" grade by Nippon Light Metal Co., Ltd. was prepared as aluminum oxide (Al₂O₃) powder, what is 99.99 % purity by Kojundo Chemical Laboratory Co., Ltd. was prepared as a magnesia (MgO) powder, what is 99.99 % purity by Kojundo Chemical Laboratory Co., Ltd. was prepared as calcium carbonate (CaCO₃) powder, the "SO-E2" grade with the 99.9 % purity made by Admatechs Corp. was prepared as a silica (SiO₂) powder.

These powders were pulverized and mixed by the ball mill so that they become the predetermined composition by the same method as Example 1, then a paraffine wax was added and the powders for molding were produced, they were degreased after the uniaxial pressing to the powder compacts of the same size as Example 1, the normal-pressure sintering was carried out at 1550°C for 3 hours in air, and the sintered compacts comprising aluminum oxide as a main component and containing a magnesium component, a calcium component and a silicon component in various rate were produced.

Each of these sintered compacts became dense to not less than 98 % as a relative density.

Specular surface polish was carried out using the abradant comprising as a main component the colloidal alumina with the particle diameter of 0.05 µm like Example 8, the washing was carried out by the ultrasonic wave using a methylene chloride and IPA, and the substrates were produced.

The average surface roughness Ra of the mirror-polished substrates was in the range of 6.7-7.6 nm.

The optical transmissivity to the light with a wavelength of 605 nm was measured by the same method as Example 2 using the substrates after polish.

Thus, the characteristics of the obtained substrates comprising the sintered compacts comprising as a main component aluminum oxide are shown in Table 48.

Although the optical transmissivity of the aluminum oxide-based sintered compact fired without adding a magnesium component, a calcium component, a silicon component and other components and not containing substantially anything other than the impurities mixed in a raw material or at the time of sintered compact manufacture was 18 % to the light with a wavelength of 605 nm, the tendency in which the optical transmissivity also becomes high is shown according as the content of a magnesium component, a calcium component and a silicon component increases, and it reached to 57 % in what contains a magnesium component 1.20 mol % on the basis of MgO.

After that, the optical transmissivity lowers gradually according as the content of a magnesium component, a calcium component and a silicon component increases, the optical transmissivity to the light with a wavelength of 605 nm becomes 22 % in the aluminum oxide-based sintered compact containing simultaneously a calcium component 20.0 mol % on the basis of CaO and a silicon component 20.0 mol % on the basis of SiO₂, and the optical transmissivity became 6.4 % in the aluminum oxide-based sintered compact containing simultaneously a magnesium component 20.0 mol % on the basis of MgO and a silicon component 30.0 mol % on the basis of SiO₂.

In this Example, as for the optical transmissivity of the aluminum oxide-based sintered compacts containing at least one of a magnesium component, a calcium component and a silicon component in the range of not more than 45.0 mol % in total on an oxide basis and containing furthermore at least one selected from a rare-earth-elements component in the range of 0.0002-10.0 mol % in total on an oxide basis, it was confirmed that the change of decreasing is hardly seen compared with the optical transmissivity of the aluminum oxide-based sintered compacts containing at least one of a magnesium component, a calcium component and a silicon component in the same quantity as the above and not containing substantially a rare earth element component.

That is, the optical transmissivity ofthe aluminum oxide-based sintered compact containing a calcium component 0.050 mol % on the basis of CaO is 36 % to the light with a wavelength of 605 nm, and the optical transmissivity of the aluminum oxide-based sintered compact containing simultaneously a calcium component 0.050 mol % on the basis of CaO and a yttrium component 0.04 mol % on the basis of Y₂O₃ was 37 %, it hardly changes, and it was confirmed that influence by containing a rare earth element component in the aluminum oxide-based sintered compact besides a magnesium component, a calcium component, and a silicon component is seldom seen.

Moreover, although the optical transmissivity of the aluminum oxide-based sintered compact containing a magnesium component 1.20 mol % on the basis of MgO was 57 % to the light with a wavelength of 605 nm and was comparatively high, the optical transmissivity of the aluminum oxide-based sintered compact containing simultaneously a magnesium component 1.20 mol % on the basis of MgO and a yttrium component 0.04 mol % on the basis of Y₂O₃ was 59 %, the optical transmissivity of the aluminum oxide-based sintered compact containing simultaneously a magnesium component 1.20 mol % on the basis of MgO and a holmium component 0.04 mol % on the basis of Ho₂O₃ was 56 %, and the optical transmissivity of the aluminum oxide-based sintered compact containing simultaneously a magnesium component 1.20 mol % on the basis of MgO and a ytterbium component 0.04 mol % on the basis of Yb₂O₃ was 58 %, the optical transmissivity of these sintered compacts was also comparatively high, and the phenomenon in which the optical transmissivity lowers greatly and which gives the bad influence by containing a rare earth element component including yttrium was not seen.

In Table 48, the optical transmissivity of the aluminum oxide-based sintered compact containing a calcium component 0.050 mol % on the basis of CaO and further containing simultaneously a yttrium component 8.0 mol % on the basis of Y₂O₃ was 36 % to the light with a wavelength of 605 nm, and the optical transmissivity of the aluminum oxide-based sintered compact containing a calcium component 0.05 mol % on the basis of CaO and further containing simultaneously a yttrium component 12.0 mol % on the basis of Y₂O₃ was 27 % to the light with a wavelength of 605 nm.

Thus, in this Example, in the aluminum oxide-based sintered compacts containing at least one of a magnesium component, a calcium component and a silicon component in the range of not more than 45.0 mol % in total on an oxide basis and containing furthermore at least one selected from a rare-earth-elements component in the range of 0.0002-10.0 mol % in total on an oxide basis, it was confirmed that those in which the optical transmissivity to the light with 605 nm wavelength is not less than 30 % are producible.

Moreover, in this Example, in the aluminum oxide-based sintered compacts containing at least two of a magnesium component, a calcium component and a silicon component and containing simultaneously at least one selected from a rare earth element component, it was confirmed that those having higher optical transmissivity are producible.

It was also confirmed that the aluminum oxide-based sintered compacts having the optical transmissivity of a maximum of not less than 80 may be manufactured.

That is, as shown in Table 48, in the aluminum oxide-based sintered compacts containing simultaneously a magnesium component 0.60 mol % on the basis of MgO, a calcium component 0.80 mol % on the basis of CaO and a silicon component 0.80 mol % on the basis of SiO₂ and containing further a yttrium component 0.0080 mol % on the basis of Y₂O₃, and a dysprosium component 0.040 mol % on the basis of Dy₂O₃ respectively, the optical transmissivity to the light with a wavelength of 605 nm increased to 57 %, and 78 % respectively.

In the aluminum oxide-based sintered compact containing simultaneously a magnesium component 0.60 mol % on the basis of MgO and a silicon component 0.20 mol % on the basis of SiO₂ and containing further a yttrium component 0.040 mol % on the basis of Y₂O₃, the optical transmissivity to the light with a wavelength of 605 nm was 69%.

Furthermore, as for the optical transmissivity of the aluminum oxide-based sintered compacts containing simultaneously a magnesium component 1.0 mol % on the basis of MgO and a calcium component 0.20 mol % on the basis of CaO and containing further a rare earth element component, such as yttrium, 0.040 mol % on an oxide basis, it was high as 81-82 % to the light with a wavelength of 605 nm.

That is, in the aluminum oxide-based sintered compact containing a yttrium component 0.040 mol % on the basis of Y₂O₃ as a rare earth element component simultaneously with the magnesium component and calcium component of the above amount, the optical transmissivity to the light with a wavelength of 605 nm is 82 %, and in the aluminum oxide-based sintered compact containing simultaneously an erbium component 0.04 mol % on the basis of Er₂O₃, the optical transmissivity was 81 %.

Next, the thin films were formed by the same method as what was shown in Example 27 to the above substrates prepared.

That is, choosing some of the substrates prepared, the 100 mol % AlN thin films were formed beforehand on them in the thickness of 3 µm by the same conditions as the sputtering method carried out in the experiment No.708 of Example 25.

Next, using the above substrates comprising an aluminum oxide-based sintered compact forming beforehand an AlN thin film, and using the substrates comprising an aluminum oxide-based sintered compact left without forming an AlN thin film, the thin films of each composition of the same 100 mol % AlN and 100 mol % GaN as what was described in Example 19 were formed furthermore on them in the thickness of 3 µm by the MOCVD method.

They were the same conditions as Example 1 and Example 2 like the description in Example 19 as conditions of MOCVD.

The characteristics of the thin films produced like that were shown in Table 48.

In this Example, in the 100 mol % AlN thin films formed beforehand on each above substrate, only the diffraction line from the lattice plane of the Miller Index (002) appeared, they were clearly the orientated polycrystal formed in the direction where C axis is perpendicular to the substrate surface.

If the crystallinity of the AlN orientated polycrystalline thin films formed beforehand on each above substrate was seen, the half width of the rocking curve of the X ray diffraction from the lattice plane of the Miller Index (002) of this orientated polycrystalline thin film was 9720 seconds as shown in Table 48, when using the substrate comprising the aluminum oxide-based sintered compact not containing substantially a magnesium component, a calcium component and a silicon component.

The crystallinity of the orientated polycrystalline thin films showed the tendency to improve according as the magnesium component, the calcium component and the silicon component increase.

That is, while it was 9240 seconds when the substrate comprising the aluminum oxide-based sintered compact containing a calcium component 0.0005 mol % on the basis of CaO was used, it was 8660 seconds when the substrate comprising the aluminum oxide-based sintered compact containing a silicon component 0.0020 mol % on the basis of SiO₂ was used, and it was 7810 seconds when the substrate comprising the aluminum oxide-based sintered compact containing a magnesium component 0.010 mol % on the basis of MgO was used, it lowered to not more than 8000 seconds.

After that, the crystallinity of the AlN orientated polycrystalline thin films showed the tendency to be improved a little, according as the content of a magnesium component, a calcium component and a silicon component increase.

When the substrate which comprises the aluminum oxide-based sintered compact containing simultaneously a magnesium component 1.0 mol % on the basis of MgO and a calcium component 0.20 mol % on the basis of CaO was used, it was 7240 seconds, and it improved most.

After that, the crystallinity of the AlN orientated polycrystalline thin films showed the tendency to be lowered a little, according as the content of a magnesium component, a calcium component and a silicon component increase.

In the case of the AlN orientated polycrystalline thin film formed on the substrate comprising the aluminum oxide-based sintered compact containing simultaneously a calcium component of 20.0 mol % on the basis of CaO and a silicon component of 20.0 mol % on the basis of SiO₂, it was 7830 seconds.

However, in the case of the AlN orientated polycrystalline thin film formed on the substrate comprising the aluminum oxide-based sintered compact containing simultaneously a magnesium component of 20.0 mol % on the basis of MgO and a silicon component of 30.0 mol % on the basis of SiO₂, it was 9370 seconds, the crystallinity lowered.

The crystallinity seldom changes when the crystallinity of the AlN orientated polycrystalline thin films formed on the substrates comprising an aluminum oxide-based sintered compact containing at least one of a magnesium component, a calcium component and a silicon component not more than 45.0 mol % in total on an oxide basis and containing further at least one selected from a rare earth element component was compared with the crystallinity of the AlN orientated polycrystalline thin films formed on the substrates comprising an aluminum oxide-based sintered compact not containing substantially a rare earth element component and containing at least one selected from a magnesium component, a calcium component and a silicon component in the same quantity as the above, and it was confirmed that the influence by that in which the rare earth element component(s) is contained in the aluminum oxide-based sintered compacts besides a magnesium component, a calcium component and a silicon component is seldom seen.

In this Example, as for the half width of the rocking curve of the X ray diffraction from the lattice plane of the Miller Index (002) of the orientated polycrystalline thin films formed on these substrates comprising an aluminum oxide-based sintered compact containing at least one of a magnesium component, a calcium component and a silicon component and containing furthermore the rare earth element component(s), it is in the range of 7070-7830 seconds, and was not more than 8000 seconds altogether.

Next, the crystallinity of the thin films comprising each composition of 100 mol % AlN and 100 mol % GaN which were formed by the above MOCVD method was investigated by X ray diffraction, using the substrates comprising an aluminum oxide-based sintered compact left without forming beforehand the above thin film(s).

As a result, it was confirmed that all the produced thin films are the single crystals formed in the direction where C axis is perpendicular to the substrate surface.

If the crystallinity is seen, as for the half width of the rocking curve of the X ray diffraction from the lattice plane of the Miller Index (002) of the 100 mol % AlN single-crystal thin film formed directly on the substrate comprising the aluminum oxide-based sintered compact fired without adding a magnesium component, a calcium component, a silicon component and other components and not containing substantially anything other than the impurities mixed in a raw material or at the time of sintered compact manufacture, it was 274 seconds as shown in Table 48.

On the other hand, in the case of the 100 mol % AlN single-crystal thin film formed directly on the substrate comprising the aluminum oxide-based sintered compact containing a calcium component 0.0005 mol % on the basis of CaO, it became small to 215 seconds, and the crystallinity was improved.

Moreover, it was 187 seconds in the case of the 100 mol % AlN single-crystal thin film formed directly on the substrate comprising the aluminum oxide-based sintered compact containing a silicon component 0.0020 mol % on the basis of SiO₂, and it was 156 seconds in the case of the 100 mol % AlN single-crystal thin film formed directly on the substrate comprising the aluminum oxide-based sintered compact containing a magnesium component 0.010 mol % on the basis of MgO, it became to not more than 200 seconds respectively, and the crystallinity was improved.

In the case of the 100 mol % AlN single-crystal thin film formed directly on the substrate comprising an aluminum oxide-based sintered compact containing a calcium component 0.050 mol % on the basis of CaO, it was 140 seconds and became to not more than 150 seconds, and the crystallinity was improved more.

It was 119 seconds in the case of the 100 mol % AlN single-crystal thin film formed directly on the substrate comprising the aluminum oxide-based sintered compact containing a magnesium component 0.12 mol % on the basis of MgO, and it was 116 seconds in the case of the 100 mol % AlN single-crystal thin film formed directly on the substrate comprising the aluminum oxide-based sintered compact containing a magnesium component 0.60 mol % on the basis of MgO and containing a silicon component 0.20 mol % on the basis of SiO₂, it became to not more than 130 seconds respectively, and the crystallinity was improved further.

After that, the half width of the rocking curve of the X ray diffraction from the lattice plane of the Miller Index (002) of the single-crystal thin films formed directly on the substrates comprising an aluminum oxide-based sintered compact became small, according as the content of a magnesium component, a calcium component and a silicon component increased.

That is, it was 114 seconds in the case of the 100 mol % AlN single-crystal thin film formed directly on the substrate comprising the aluminum oxide-based sintered compact containing a magnesium component 1.20 mol % on the basis of MgO, it was 113 seconds in the case of the 100 mol % AlN single-crystal thin film formed directly on the substrate comprising the aluminum oxide-based sintered compact containing simultaneously a magnesium component 1.00 mol % on the basis of MgO and a calcium component 0.20 mol % on the basis of CaO, it became the smallest in the single-crystal thin films formed directly on the substrate in this Example, and the crystallinity was most excellent.

After that, the half width of the rocking curve of the X ray diffraction from the lattice plane of the Miller Index (002) of the single-crystal thin films formed directly on the substrate comprising an aluminum oxide-based sintered compact became large according as the content of a magnesium component, a calcium component and a silicon component increased, it became 141 seconds in the case of the 100 mol % AlN single-crystal thin film formed directly on the substrate comprising the aluminum oxide-based sintered compact containing simultaneously a calcium component 20.0 mol % on the basis of CaO and a silicon component 20.0 mol % on the basis of SiO₂.

In the case of the 100 mol % AlN single-crystal thin film formed directly on the substrate comprising the aluminum oxide-based sintered compact containing simultaneously a magnesium component 20.0 mol % on the basis of MgO and a silicon component 30.0 mol % on the basis of SiO₂, it became 226 seconds and was larger than 200 seconds. On the other hand, as shown in Table 48 in this Example, in the substrates comprising an aluminum oxide-based sintered compact containing at least one of magnesium, calcium and silicon, even if the component(s) other than magnesium, calcium and silicon, such as a rare earth element, was contained, it was confirmed that there is little change of lowering greatly the crystallinity of the single-crystal thin films formed directly on these substrates and comprising as a main component at least one selected from gallium nitride, indium nitride and aluminum nitride.

If saying in other words, in the case of the substrates comprising an aluminum oxide-based sintered compact containing at least one of magnesium, calcium and silicon, even if the component(s) other than magnesium, calcium and silicon, such as a rare earth element, was contained, it was confirmed that the crystallinity of the single-crystal thin films formed directly on these substrates is what cannot be influenced easily by these components.

If it says concretely, in the 100 mol % AlN single-crystal thin films formed directly on the substrates comprising the aluminum oxide-based sintered compact containing a calcium component 0.050 mol % on the basis of CaO and containing simultaneously a yttrium component 0.040 mol %, 8.00 mol %, and 12.0 mol % on the basis of Y₂O₃ respectively, the half width of the rocking curve of the X ray diffraction from the lattice plane of the Miller Index (002) is 137 seconds, 127 seconds, and 134 seconds respectively, and the crystallinity did not show the change tendency of lowering greatly from 140 seconds of the 100 mol % AlN single-crystal thin film formed directly on the substrate comprising the aluminum oxide-based sintered compact containing a calcium component 0.05 mol % on the basis of CaO and not containing substantially a yttrium component.

In the 100 mol % AlN single-crystal thin films formed directly on the substrate comprising the aluminum oxide-based sintered compact containing a magnesium component 1.20 mol % on the basis of MgO and containing simultaneously a yttrium component 0.040 mol % on the basis of Y₂O₃, and the substrate comprising the aluminum oxide-based sintered compact containing a magnesium component 1.20 mol % on the basis of MgO and containing simultaneously a ytterbium component 0.040 mol % on the basis of Yb₂O₃, the half width of the rocking curve of the X ray diffraction from the lattice plane of the Miller Index (002) is 112 seconds and 115 seconds respectively, and the crystallinity did not show the change tendency of lowering greatly compared with 114 seconds of the 100 mol % AlN single-crystal thin film formed directly on the substrate comprising the aluminum oxide-based sintered compact containing only a magnesium component 1.20 mol % on the basis of MgO and not containing substantially a yttrium component.

In the 100 mol % AlN single-crystal thin film formed directly on the substrate comprising the aluminum oxide-based sintered compact containing a magnesium component 1.20 mol % on the basis of MgO and containing simultaneously a holmium component 0.040 mol % on the basis of Ho₂O₃, the half width of the rocking curve of the X ray diffraction from the lattice plane of the Miller Index (002) is 115 seconds, and the crystallinity did not show the change tendency of lowering greatly compared with 114 seconds of the 100 mol % AlN single-crystal thin film formed directly on the substrate comprising the aluminum oxide-based sintered compact containing only a magnesium component 1.20 mol % on the basis of MgO and not containing substantially the rare earth element component(s), such as yttrium.

In the 100 mol % AlN single-crystal thin film formed directly on the substrate comprising the aluminum oxide-based sintered compact containing a silicon component 0.0020 mol % on the basis of SiO₂ and containing simultaneously a yttrium component 0.0005 mol % on the basis of Y₂O₃, the half width of the rocking curve of the X ray diffraction from the lattice plane of the Miller Index (002) is 161 seconds, and the crystallinity did not show the change tendency of lowering greatly from 187 seconds of the 100 mol % AlN single-crystal thin film formed directly on the substrate comprising the aluminum oxide-based sintered compact containing a silicon component 0.0020 mol % on the basis of SiO₂ and not containing substantially a yttrium component.

In the 100 mol % AlN single-crystal thin films formed directly on the substrates comprising the aluminum oxide-based sintered compact containing simultaneously a magnesium component 0.60 mol % on the basis of MgO, a calcium component 0.80 mol % on the basis of CaO, and a silicon component 0.80 mol % on the basis of SiO₂ and further containing a yttrium component 0.0080 mol % on the basis of Y₂O₃ and a dysprosium component 0.040 mol % on the basis of Dy₂O₃, the half width of the rocking curve of the X ray diffraction from the lattice plane of the Miller Index (002) is 111 seconds and 113 seconds respectively, and the crystallinity did not show the change tendency of lowering greatly from 120 seconds of the 100 mol % AlN single-crystal thin film formed directly on the substrate comprising the aluminum oxide-based sintered compact containing simultaneously a magnesium component 0.60 mol % on the basis of MgO, a calcium component 0.80 mol % on the basis of CaO, and a silicon component 0.80 mol % on the basis of SiO₂ and not containing substantially a yttrium component.

In the 100 mol % AlN single-crystal thin film formed directly on the substrate comprising the aluminum oxide-based sintered compact containing simultaneously a magnesium component 0.60 mol % on the basis of MgO and a silicon component 0.20 mol % on the basis of SiO₂ and further containing a yttrium component 0.040 mol % on the basis of Y₂O₃, the half width of the rocking curve of the X ray diffraction from the lattice plane of the Miller Index (002) is 112 seconds, and the crystallinity did not show the change tendency of lowering greatly from 116 seconds of the 100 mol % AlN single-crystal thin film formed directly on the substrate comprising the aluminum oxide-based sintered compact containing simultaneously a magnesium component 0.60 mol % on the basis of MgO and a silicon component 0.20 mol % on the basis of SiO₂ and not containing substantially a yttrium component.

In the 100 mol % AlN single-crystal thin film formed directly on the substrate comprising the aluminum oxide-based sintered compact containing simultaneously a magnesium component 1.00 mol % on the basis of MgO and a calcium component 0.20 mol % on the basis of CaO and further containing a yttrium component 0.040 mol % on the basis of Y₂O₃, the half width of the rocking curve of the X ray diffraction from the lattice plane of the Miller Index (002) is 107 seconds, and the crystallinity did not show the change tendency of lowering greatly from 113 seconds of the 100 mol % AlN single-crystal thin film formed directly on the substrate comprising the aluminum oxide-based sintered compact containing simultaneously a magnesium component 1.00 mol % on the basis of MgO and a calcium component 0.20 mol % on the basis of CaO and not containing substantially a yttrium component.

In the 100 mol % AlN single-crystal thin film formed directly on the substrate comprising the aluminum oxide-based sintered compact containing simultaneously a magnesium component 1.00 mol % on the basis of MgO and a calcium component 0.20 mol % on the basis of CaO and further containing an erbium component 0.040 mol % on the basis of Er₂O₃, the half width of the rocking curve of the X ray diffraction from the lattice plane of the Miller Index (002) is 109 seconds, and the crystallinity did not show the change tendency of lowering greatly from 113 seconds of the 100 mol % AlN single-crystal thin film formed directly on the substrate comprising the aluminum oxide-based sintered compact containing simultaneously a magnesium component 1.00 mol % on the basis of MgO and a calcium component 0.20 mol % on the basis of CaO and not containing substantially a rare earth element component, such as yttrium.

Thus, in the substrates comprising an aluminum oxide-based sintered compact containing at least one selected from magnesium, calcium and silicon, it was confirmed that the crystallinity of the single-crystal thin films comprising gallium nitride and aluminum nitride as a main component and formed directly on these substrates changes little and has the tendency to be hard to be influenced by the existence of the rare earth element component(s), such as a yttrium component, even if these substrates were what comprises an aluminum oxide-based sintered compact containing simultaneously the rare earth element component(s), such as yttrium, other than a magnesium component, a calcium component and a silicon component.

As mentioned above, the half width of the rocking curve of the X ray diffraction from the lattice plane of the Miller Index (002) of the 100 mol % AlN single-crystal thin film and 100 mol % GaN single-crystal thin film which were formed directly on the substrates comprising an aluminum oxide-based sintered compact having various compositions was not more than 300 seconds altogether, they were excellent in crystallinity.

In this Example, when the substrates comprising an aluminum oxide-based sintered compact having such characteristic and having the above various compositions are used, it was confirmed that the single-crystal thin films excellent in crystallinity than the crystallinity of the single-crystal thin films formed directly on these substrates and comprising as a main component at least one selected from gallium nitride and aluminum nitride are obtained, if the orientated polycrystalline thin film(s) comprising aluminum nitride as a main component is formed beforehand on these substrates, and the single-crystal thin films comprising as a main component at least one selected from gallium nitride and aluminum nitride are formed furthermore on it.

That is, it does not necessarily restrict that half width of the rocking curve of the X ray diffraction from the lattice plane of the Miller Index (002) of the single-crystal thin films formed directly on these substrates and comprising as a main component at least one selected from gallium nitride and aluminum nitride becomes not more than 200 seconds, even if the aluminum oxide-based sintered compacts having various composition are used as a substrate.

On the other hand, if the orientated polycrystalline thin film(s) comprising as a main component aluminum nitride is formed beforehand on these substrates, and the single-crystal thin films comprising as a main component at least one selected from gallium nitride and aluminum nitride are formed furthermore on it, it was confirmed that the single-crystal thin films in which the half width of the rocking curve of the X ray diffraction from the lattice plane of the Miller Index (002) is not more than 200 seconds may be formed, even if the aluminum oxide-based sintered compacts having such various composition are used as a substrate.

When the single-crystal thin films comprising as a main component at least one selected from gallium nitride and aluminum nitride are formed using the substrates comprising an aluminum oxide-based sintered compact having the same composition, it was confirmed that the single-crystal thin films more excellent in crystallinity than the crystallinity of the single-crystal thin films formed directly on these substrates and comprising as a main component at least one selected from gallium nitride and aluminum nitride are obtained, if the orientated polycrystalline thin film(s) comprising aluminum nitride as a main component is formed beforehand on these substrates, and the single-crystal thin films comprising as a main component at least one selected from gallium nitride and aluminum nitride are formed furthermore on it.

That is, it was confirmed that the single-crystal thin films tend to become those excellent in crystallinity in which the half width of the rocking curve of the X ray diffraction from the lattice plane of the Miller Index (002) is not more than 130 seconds, if the orientated polycrystalline thin film(s) comprising aluminum nitride as a main component is formed beforehand on them, and the single-crystal thin films comprising as a main component at least one selected from gallium nitride and aluminum nitride are formed furthermore on it, using the substrates comprising an aluminum oxide-based sintered compact containing at least one of a magnesium component, a calcium component and a silicon component in the range of 0.001-45.0 mol % in total on an oxide basis, and it was confirmed that the single-crystal thin films tend to become those excellent in crystallinity in which the half width of the rocking curve of the X ray diffraction from the lattice plane of the Miller Index (002) is not more than 100 seconds, if the orientated polycrystalline thin film(s) comprising aluminum nitride as a main component is formed beforehand on them, and the single-crystal thin films comprising as a main component at least one selected from gallium nitride and aluminum nitride are formed furthermore on it, using the substrates comprising an aluminum oxide-based sintered compact containing at least one of a magnesium component, a calcium component and a silicon component in the range of 0.005-45.0 mol % in total on an oxide basis.

It was confirmed that it is hard to receive the great change of lowering the crystallinity of the single-crystal thin films formed on these substrates compared with the crystallinity of the single-crystal thin films formed on the above substrates comprising an aluminum oxide-based sintered compact containing a magnesium component, a calcium component and a silicon component and not containing substantially other component(s), such as a yttrium component, a dysprosium component, a holmium component, an erbium component and a ytterbium component, even if they are the substrates comprising an aluminum oxide-based sintered compact containing the above amount of a magnesium component, a calcium component and a silicon component and contains simultaneously the component(s), such as a yttrium component, a dysprosium component, a holmium component, an erbium component and a ytterbium component, etc., other than these.

That is, if they are the substrates comprising an aluminum oxide-based sintered compact containing the above amount of at least one selected from a magnesium component, a calcium component and a silicon component, it was confirmed that the crystallinity of the formed single-crystal thin films comprising as a main component at least one selected from gallium nitride and aluminum nitride is what cannot be influenced easily by the component(s), even if the component(s) other than a magnesium component, a calcium component and a silicon component, such as a yttrium component, a dysprosium component, a holmium component, an erbium component and a ytterbium component, was contained.

If saying more concretely, as shown in Table 48, while the half width of the X ray diffraction from the lattice plane of the Miller Index (002) of the 100 mol % AlN single-crystal thin film formed directly on the substrate comprising the aluminum oxide-based sintered compact fired without adding a magnesium component, a calcium component, a silicon component and other component(s) and not containing substantially anything other than the impurities mixed in a raw material or at the time of sintered compact manufacture is 274 seconds, the half width of the rocking curve of the X ray diffraction from the lattice plane of the Miller Index (002) of the 100 mol % AlN single-crystal thin film formed furthermore on the 100 mol % AlN orientated polycrystalline thin film formed beforehand on the substrate comprising the same aluminum oxide-based sintered compact is 142 seconds, and the crystallinity was improved.

While the half width of the rocking curve of the X ray diffraction from the lattice plane of the Miller Index (002) of the 100 mol % AlN single-crystal thin film formed directly on this substrate is 215 seconds when the substrate comprising the aluminum oxide-based sintered compact containing a calcium component 0.0005 mol % on the basis of CaO is used, the half width of the rocking curve of the X ray diffraction from the lattice plane of the Miller Index (002) of the 100 mol % AlN single-crystal thin film formed furthermore on the 100 mol % AlN orientated polycrystalline thin film formed beforehand on the substrate comprising the same aluminum oxide-based sintered compact containing a calcium component is 133 seconds, and the crystallinity was improved.

Furthermore, while the half width of the rocking curve of the X ray diffraction from the lattice plane of the Miller Index (002) of the 100 mol % AlN single-crystal thin film formed directly on this substrate is 187 seconds when the substrate comprising the aluminum oxide-based sintered compact containing a silicon component 0.0020 mol % on the basis of SiO₂ is used, the half width of the rocking curve of the X ray diffraction from the lattice plane of the Miller Index (002) of the 100 mol % AlN single-crystal thin film formed furthermore on the 100 mol % AlN orientated polycrystalline thin film formed beforehand on the substrate comprising the same aluminum oxide-based sintered compact containing a silicon component is 122 seconds, and the crystallinity was improved.

While the half width of the rocking curve of the X ray diffraction from the lattice plane of the Miller Index (002) of the 100 mol % AlN single-crystal thin film formed directly on this substrate is 156 seconds when the substrate comprising the aluminum oxide-based sintered compact containing a magnesium component 0.010 mol % on the basis of MgO is used, the half width of the rocking curve of the X ray diffraction from the lattice plane of the Miller Index (002) of the 100 mol % AlN single-crystal thin film formed furthermore on the 100 mol % AlN orientated polycrystalline thin film formed beforehand on the substrate comprising the same aluminum oxide-based sintered compact containing a magnesium component is 96 seconds, and became not more than 100 seconds.

As shown below, when the substrates comprising an aluminum oxide-based sintered compact containing at least one selected from a magnesium component, a calcium component and a silicon component in the range of 0.001-45.0 mol % in total on an oxide basis are used, if the orientated polycrystalline thin film(s) comprising as a main component aluminum nitride is formed beforehand on these substrates, and the single-crystal thin films comprising as a main component at least one selected from gallium nitride and aluminum nitride are formed furthermore on it, the single-crystal thin films in which the crystallinity is superior to the crystallinity of the single-crystal thin films formed directly on the substrates and comprising as a main component at least one selected from gallium nitride, indium nitride and aluminum nitride, are obtained, and it was confirmed that the half width of the rocking curve of the X ray diffraction from the lattice plane of the Miller Index (002) of these single-crystal thin films is the range of 90-97 seconds and is not more than 100 seconds altogether.

While the half width of the rocking curve of the X ray diffraction from the lattice plane of the Miller Index (002) of the single-crystal thin film is 226 seconds in the case of the 100 mol % AlN single-crystal thin film formed directly on the substrate comprising the aluminum oxide-based sintered compact containing simultaneously a magnesium component 20.0 mol % on the basis of MgO and a silicon component 30.0 mol % on the basis of SiO₂, the crystallinity improved to 147 seconds in the case of the 100 mol % AlN single-crystal thin film formed furthermore on the 100 mol % AlN orientated polycrystalline thin film formed beforehand on the same substrate.

For example, as shown in Table 48, when the substrates comprising an aluminum oxide-based sintered compact containing at least one selected from magnesium, calcium and silicon and containing furthermore a rare-earth-elements component were used, it was confirmed that the crystallinity is improved than the crystallinity of the 100 mol %AlN single-crystal thin film or 100 mol % GaN single-crystal thin film formed directly on these substrates, if the orientated polycrystalline thin film(s) of 100 mol % AlN is formed beforehand on the substrates comprising the same aluminum oxide-based sintered compact containing at least one selected from magnesium, calcium and silicon and further containing a rare-earth-elements component simultaneously, and the 100 mol % AlN single-crystal thin film or the 100 mol % GaN single-crystal thin film were formed furthermore on it.

For example, as shown in Table 48, when the thing in which the 100 mol % AlN orientated polycrystalline thin film was formed beforehand on the substrate comprising the aluminum oxide-based sintered compact containing a silicon component 0.0020 mol % on the basis of SiO₂ and further containing a yttrium component 0.0005 mol % on the basis of Y₂O₃ besides it was used, the half width of the rocking curve of the X ray diffraction from the lattice plane of the Miller Index (002) of the single-crystal thin film formed on it was improved to 104 seconds.

Furthermore, when the thing in which the 100 mol % AlN orientated polycrystalline thin film was formed beforehand on the substrate comprising an aluminum oxide-based sintered compact containing a calcium component 0.050 mol % on the basis of CaO and further containing a yttrium component 0.040 mol % on the basis of Y₂O₃ besides it was used, the half width of the rocking curve of the X ray diffraction from the lattice plane of the Miller Index (002) of the single-crystal thin film formed on it was 95 seconds and was improved to not more than 100 seconds.

When using those in which the 100 mol % GaN orientated polycrystalline thin films were formed beforehand on the substrates comprising the aluminum oxide-based sintered compacts containing a magnesium component 1.20 mol % on the basis of MgO and further containing respectively a yttrium component 0.040 mol % on the basis of Y₂O₃ and a ytterbium component 0.040 mol % on the basis of Yb₂O₃ besides it, the half width of the rocking curve of the X ray diffraction from the lattice plane of the Miller Index (002) of the single-crystal thin films formed on them was 89 seconds and 90 seconds respectively and was not more than 100 seconds altogether.

As shown in Table 48, even when the substrates comprising an aluminum oxide-based sintered compact containing at least two selected from magnesium, calcium and silicon and further containing at least one selected from a rare earth element component were used, it was confirmed that the crystallinity of these single-crystal thin films is improved than the crystallinity of the 100 mol % AlN single-crystal thin film or 100 mol % GaN single-crystal thin film which were formed directly on these substrates, if the 100 mol % AlN orientated polycrystalline thin film(s) or the 100 mol % GaN orientated polycrystalline thin film(s) are formed beforehand on the substrates comprising the same aluminum oxide-based sintered compact containing at least two selected from magnesium, calcium and silicon and further containing at least one selected from a rare earth element component, and the 100 mol % AlN single-crystal thin film or the 100 mol % GaN single-crystal thin film are formed furthermore on them.

For example, while the half width of the rocking curve of the X ray diffraction from the lattice plane of the Miller Index (002) of the 100 mol % AlN single-crystal thin films formed directly on these substrates is 111 seconds and 113 seconds respectively when using the substrates comprising the aluminum oxide-based sintered compacts containing a magnesium component 0.60 mol % on the basis of MgO, a calcium component 0.80 mol % on the basis of CaO, and a silicon component 0.80 mol % on the basis of SiO₂ and further containing a yttrium component 0.0080 mol % on the basis of Y₂O₃ and a dysprosium component 0.040 mol % on the basis of Dy₂O₃ besides these, the half width of the rocking curve of the X ray diffraction from the lattice plane of the Miller Index (002) of the 100 mol % AlN single-crystal thin films formed furthermore on the 100 mol % AlN orientated polycrystalline thin films formed beforehand on the substrates comprising the aluminum oxide-based sintered compacts containing a same component is 92 seconds and 90 seconds respectively, and the crystallinity was improved.

While the half width of the rocking curve of the X ray diffraction from the lattice plane of the Miller Index (002) of the 100 mol % AlN single-crystal thin film formed directly on this substrate is 112 seconds when the substrate comprising the aluminum oxide-based sintered compact containing a magnesium component 0.60 mol % on the basis of MgO and a silicon component 0.20 mol % on the basis of SiO₂ and further containing a yttrium component 0.040 mol% on the basis of Y₂O₃ besides these was used, the half width of the rocking curve of the X ray diffraction from the lattice plane of the Miller Index (002) of the 100 mol % AlN single-crystal thin film formed furthermore on the 100 mol % AlN orientated polycrystalline thin film formed beforehand on the substrate comprising the aluminum oxide-based sintered compact containing a same component is 91 seconds, and the crystallinity was improved.

While the half width of the rocking curve of the X ray diffraction from the lattice plane of the Miller Index (002) of the 100 mol % AlN single-crystal thin film formed directly on this substrate is 107 seconds when the substrate comprising the aluminum oxide-based sintered compact containing a magnesium component 1.0 mol % on the basis of MgO and a calcium component 0.20 mol % on the basis of CaO and further containing a yttrium component 0.040 mol % on the basis of Y₂O₃ besides these was used, the half width of the rocking curve of the X ray diffraction from the lattice plane of the Miller Index (002) of the 100 mol % AlN single-crystal thin film formed furthermore on the 100 mol % AlN orientated polycrystalline thin film formed beforehand on the substrate comprising the aluminum oxide-based sintered compact containing a same component is 88 seconds, and the crystallinity was improved.

While the half width of the rocking curve of the X ray diffraction from the lattice plane of the Miller Index (002) of the 100 mol % GaN single-crystal thin film formed directly on this substrate is 107 seconds when the substrate comprising the aluminum oxide-based sintered compact containing a magnesium component 1.0 mol % on the basis of MgO and a calcium component 0.20 mol % on the basis of CaO and further containing an erbium component 0.040 mol % on the basis of Er₂O₃ besides these was used, the half width of the rocking curve of the X ray diffraction from the lattice plane of the Miller Index (002) of the 100 mol % GaN single-crystal thin film formed furthermore on the 100 mol % GaN orientated polycrystalline thin film formed beforehand on the substrate comprising the aluminum oxide-based sintered compact containing a same component is 89 seconds, and the crystallinity was improved.

In addition, although it is not indicated in Table 48, in the substrates comprising the aluminum oxide-based sintered compacts of various composition produced in this Example and shown in Table 48, not only the 100 mol % AlN orientated polycrystalline thin films but also the 100 mol % AlN thin films are formed beforehand in the thickness of 3 µm under the same conditions as the sputtering method carried out in the experiment No.706 and 707 and MOCVD method carried out in the experiment No.709 in Example 25, and the aluminum nitride-based thin films having an amorphous state, a polycrystalline state and a single crystal state which are same as Example 25 were formed respectively.

The gallium nitride-based thin films having the same amorphous state and orientated polycrystal as Example 25 were formed respectively, forming beforehand the 100 mol % GaN thin films in the thickness of 3 µm under the same conditions as the MOCVD method carried out in the experiment No. 728 and 730.

The indium nitride-based thin films having the same orientated polycrystalline state as Example 25 were formed, forming beforehand the 100 mol % InN thin films in the thickness of 3 µm under the same conditions as the MOCVD method carried out in the experiment No.731.

Using the substrates comprising the aluminum oxide-based sintered compacts forming beforehand the aluminum nitride-based thin films, the gallium nitride-based thin films and the indium nitride-based thin films, as mentioned above, and using the substrates comprising the aluminum oxide-based sintered compacts left without forming a thin film, the single-crystal thin films of each composition of 100 mol % AlN, 100 mol % GaN, 100 mol % InN, 50 mol % AlN+50 mol % GaN and 50 mol % GaN+50 mol % InN were formed furthermore on it in the thickness of 3 µm by the same MOCVD method as what was described in Example 19.

When the thin films of the above constitution were formed on the substrate comprising the aluminum oxide-based sintered compacts being same as what was shown in Table 48, it was confirmed that it has the same effect as that omprising the constitution wherein the thin film formed beforehand is a 100 mol % AlN orientated polycrystal and the thin film formed furthermore on it is a 100 mol % AlN single-crystal thin film or a 100 mol % GaN single-crystal thin film.

For example, it was confirmed that the crystallinity is superior to the crystallinity of the single-crystal thin films comprising as a main component at least one selected from gallium nitride, indium nitride and aluminum nitride and formed directly on the same substrates comprising an aluminum oxide-based sintered compact, if the thin film(s) comprising as a main component at least one selected from gallium nitride, indium nitride and aluminum nitride and having various crystallization states, such as an amorphous state, a polycrystal, an orientated polycrystal and a single crystal, etc., is formed beforehand and the single-crystal thin films are formed furthermore on it.

Thus, in this Example, when the substrates comprising an aluminum oxide-based sintered compact are used, it was confirmed that the single-crystal thin films with the crystallinity superior to the crystallinity of the single-crystal thin films formed directly on these substrates and comprising as a main component at least one selected from gallium nitride, indium nitride and aluminum nitride are obtained in all the experiment, if the thin film(s) comprising as a main component at least one selected from gallium nitride, indium nitride and aluminum nitride and having various crystallization state, such as an amorphous state, a polycrystal, an orientated polycrystal and a single crystal, etc., is formed beforehand on these substrates, and the single-crystal thin films comprising as a main component at least one selected from gallium nitride, indium nitride and aluminum nitride are formed furthermore on it.

In this Example, although the appearance of the thin films of the constitution indicated in Table 48 and all the other thin films produced were investigated, faults, such as a crack and a crevice, are not seen in all the thin films formed beforehand on the substrates and the thin films formed furthermore on them.

Though the exfoliation test was carried out using the pressure sensitive adhesive tape, in all the thin films, exfoliations were not seen between them and the substrates comprising a sintered compact comprising aluminum oxide as a main component, or between thin films.

The thin film-conductive material of Ti/Pt/Au was formed on the thin films of the surface of the substrates, the metal leads were soldered and the perpendicular tensile strength was investigated, but it all is not less than 2 kg/mm², so there are firm unifications between the sintered compacts comprising as a main component aluminum oxide and the thin films formed beforehand on the substrates, and between these thin films and the thin films formed furthermore on them.

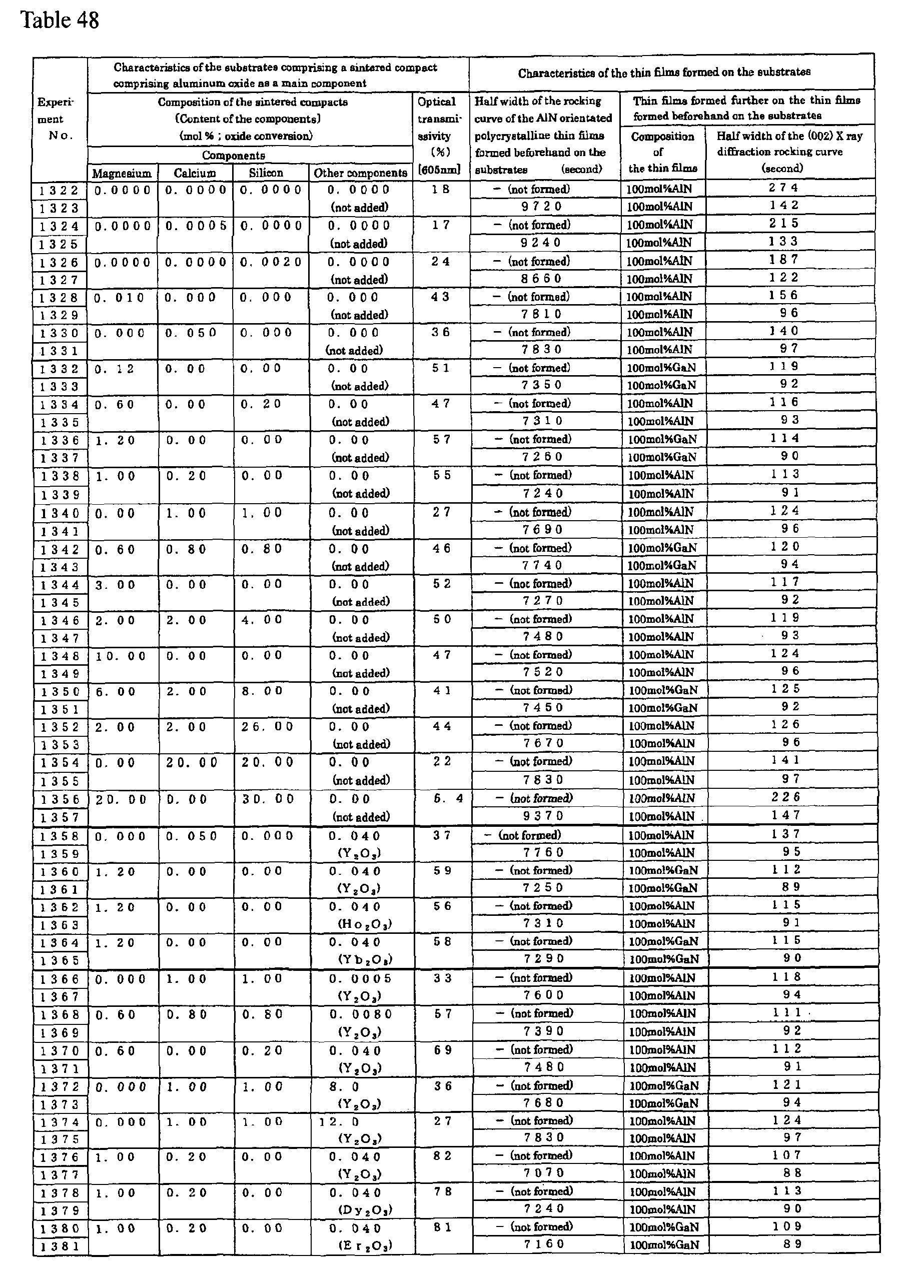

### Example 33

This Example shows the examples, wherein the optical permeability is investigated about the substrates comprising a sintered compact comprising as a main component zirconium oxide, magnesium oxide, magnesium aluminate and yttrium oxide, and formation of the single-crystal thin films comprising as a main component at least one selected from gallium nitride, indium nitride and aluminum nitride was tried on it by forming beforehand the thin film(s) comprising as a main component at least one selected from gallium nitride, indium nitride and aluminum nitride and having at least one of the crystallization states selected from an amorphous state, a polycrystal, an orientated polycrystal, and a single crystal, using these substrates.

As for the substrates comprising a sintered compact comprising as a main component zirconium oxide, magnesium oxide and magnesium aluminate, two kinds, that are the sintered compacts produced in Example 1, and the sintered compacts newly produced in this Example, were prepared, respectively.

The substrate comprising a sintered compact comprising yttrium oxide as a main component was newly produced in this Example.

In this Example, the sintered compacts comprising as a main component zirconium oxide, magnesium oxide, magnesium aluminate, and yttrium oxide by the method shown below were newly produced.

That is, here prepared the zirconium oxide raw material which includes 3 mol % Y₂O₃ as the same stabilization agent as what was used in Example 1, the sintering aids were not added to the raw material powder like Example 1, but the paraffine wax was added, and the powder for molding was produced, it degreased after molding this powder by a uniaxial press, a hot press was carried out under the pressure of 150kg/cm² at 1400°C for 2 hours in air, thus the sintered compacts comprising zirconium oxide as a main component were produced.

The same magnesium oxide raw material as what was used in Example 1 was prepared, CaO and Y₂O₃ were added by 1% by weight respectively as sintering aids, pulverization mixture was carried out by the ball mill like Example 1, it degreased after the powder in which a paraffine wax was added was molded by the uniaxial press, normal-pressure sintering was carried out at 1600°C for 6 hours in air, and the sintered compacts comprising magnesium oxide as a main component were produced.

The same magnesium aluminate raw material as what was used in Example 1 is prepared, CaO and Y₂O₃ were added by 0.1 % by weight respectively as sintering aids, like the case of the magnesium oxide, pulverization mixture was carried out by the ball mill, a paraffine wax was added and the powder for molding was produced, it degreased after the uniaxial pressing, normal-pressure sintering was carried out at 1650°C for 8 hours in hydrogen current, and the sintered compacts comprising magnesium aluminate as a main component were produced.

The same Y₂O₃ powder, Dy₂O₃ powder and Ho₂O₃ powder as what was used in Example 13 were prepared, the powder for moulding was produced adding a paraffine wax after pulverization by the ball mill using only the above Y₂O₃ powder as a main component, it degreased after the uniaxial pressing, normal-pressure sintering was carried out at 1600°C for 3 hours in air, and the sintered compacts comprising as a main component yttrium oxide were produced.

In the other, the Dy₂O₃ and Ho₂O₃ powder were added 0.25 % by weight respectively as a sintering aid to the above Y₂O₃ powder of 99.5 % by weight and pulverization mixture was carried out by the ball mill, the powder for moulding was produced adding a paraffine wax, they degreased after the uniaxial pressing, normal-pressure sintering was carried out at 2100°C for 3 hours in hydrogen current, and the sintered compacts comprising as a main component yttrium oxide were produced.

The mirror-polishing of each sintered compact produced in Example 1 and this Example was carried out using the abradant comprising a colloidal aluminum oxide with the particle diameter of 0.05 µm after the grinding processing, they were washed by acetone and iso-propyl alcohol, and the disk-like substrates with the diameter of 25.4 mm and the thickness of 0.5 mm were produced.

Though the optical permeability to the light with a wavelength of 605 nm was measured about the substrates produced like this, it was confirmed that all the substrates have optical permeability.

After that, the thin film(s) comprising as a main component at least one selected from gallium nitride, indium nitride and aluminum nitride and having the amorphous, polycrystalline or orientated polycrystalline state was formed beforehand on these substrates in the thickness of 3 µm, and the formation of the single-crystal thin films comprising as a main component at least one selected from gallium nitride, indium nitride and aluminum nitride was tried on it in the thickness of 3 µm.

It was thus confirmed that the single-crystal thin films may clearly be formed on the substrates comprising a sintered compact produced in this Example and comprising as a main component zirconium oxide, magnesium oxide, and magnesium aluminate.

These results are shown in Table 49.

Also in the substrates comprising the sintered compacts which comprise as a main component zirconium oxide, magnesium oxide, magnesium aluminate, and yttrium oxide, it was confirmed that those in which the average surface roughness Ra is not more than 10 nm are producible.

In the substrates comprising the sintered compacts produced in this Example and comprising as a main component magnesium oxide and zirconium oxide, it was confirmed that those in which the average surface roughness Ra is not more than 5 nm are producible. Those in which the optical transmissivity is not less than 20 % are also producible, and it was confirmed that the optical transmissivity is a maximum of 59 % in case of the substrates comprising a zirconium oxide-based sintered compact, it is a maximum of 83 % in case of the substrates comprising a magnesium oxide-based sintered compact, it is a maximum of 79 % in case of the substrates comprising a magnesium aluminat-basede sintered compact, and that it is a maximum of 82 % in case of the substrates comprising a yttrium oxide-based sintered compact.

If the thin film(s) comprising as a main component at least one selected from gallium nitride, indium nitride and aluminum nitride has each crystallization state of an amorphous state, a polycrystal and an orientated polycrystal, it was confirmed that it can be formed directly on the substrates comprising the sintered compacts which comprise as a main component zirconium oxide, magnesium oxide, magnesium aluminate, and yttrium oxide.

If the thin films comprising as a main component at least one selected from gallium nitride, indium nitride and aluminum nitride are formed on it forming beforehand the thin film(s) having at least one of the crystallization states selected from an amorphous state, a polycrystal, and an orientated polycrystal and comprising as a main component at least one selected from gallium nitride, indium nitride and aluminum nitride, these thin films can form those of a single-crystal state, and it was confirmed that those having the crystallinity in which the half width of the rocking curve of the X ray diffraction from the lattice plane of the Miller Index (002) of these single-crystal thin films is not more than 200 seconds altogether may be formed. And, in the substrates in which the average surface roughness is not more than 5 nm, it was confirmed that those having the crystallinity in which the half width of the rocking curve of the X ray diffraction from the lattice plane of the Miller Index (002) of these single-crystal thin films is not more than 150 seconds altogether can be formed.

In this Example, although the appearance of the thin films of the constitution indicated in Table 49 was investigated, faults, such as a crack and a crevice, are not seen in all the thin films formed beforehand on the substrates and the thin films formed furthermore on them.

Though the exfoliation test was carried out using the pressure sensitive adhesive tape, in all the thin films, exfoliations were not seen between them and the substrates comprising the sintered compacts comprising zirconium oxide, magnesium oxide, magnesium aluminate, and yttrium oxide as a main component, or between thin films.

The thin film-conductive material of Ti/Pt/Au was formed on the thin films of the surface of the substrates, the metal leads were soldered and the perpendicular tensile strength was investigated, but it all is not less than 2 kg/mm², so there are firm unifications between the sintered compacts comprising as a main component zirconium oxide, magnesium oxide, magnesium aluminate and yttrium oxide, and the thin films formed beforehand on the substrates, and between these thin films and the thin films formed furthermore on them.

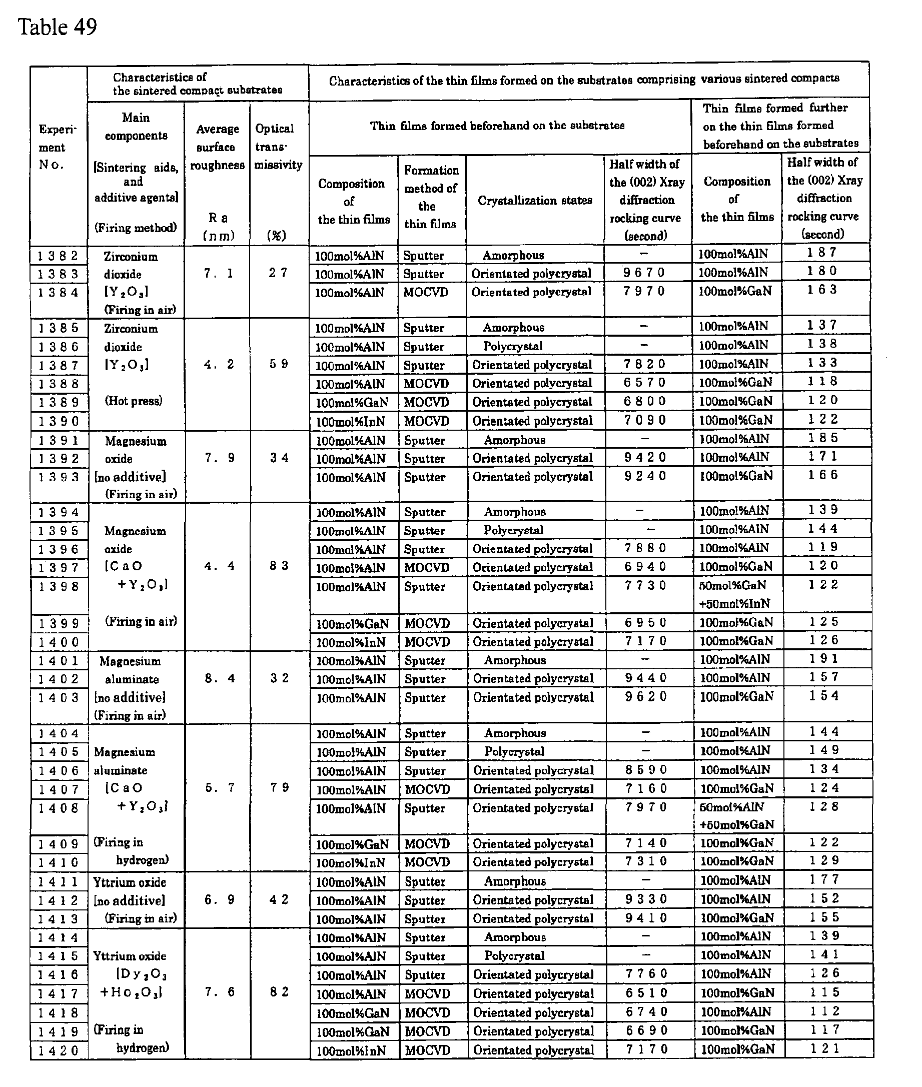

### Example 34

This Example shows the examples which investigated the luminous efficiency of the light-emitting devices produced using the aluminum nitride-based sintered compact, as a substrate.

First, using the aluminum nitride-based sintered compacts produced in this invention, as a substrate, those from which the composition (the content of an aluminum nitride component) and the optical transmissivity differ respectively were prepared.

Those having conduction vias were prepared.

The substrates prepared have disk-like shape with the diameter of 25.4 mm and the thickness of 0.5 mm, and the mirror-polishing and subsequent washing have been carried out by the method which uses the abradant comprising chromic oxide as a main component like Example 8.

The average surface roughness Ra is in the range of 19-33 nm.

As the thin film of the 1st layer, the thin film(s) comprising as a main component a material selected from gallium nitride or aluminum nitride and having at least one of the crystallization states selected from an amorphous state, a polycrystal, an orientated polycrystal and a single crystal was formed suitably on the substrates prepared in the thickness of 3 µm by the same sputtering method or MOCVD method as what was shown in the experiment No.706, 707, 708, 709 and 730 in Example 25.

After that, onto these substrates having a thin film, furthermore the single-crystal thin film comprising as a main component a material selected from gallium nitride or aluminum nitride was suitably formed in the thickness of 3 µm by the same method as what was shown in Example 1, as the thin film of the 2nd layer.

In addition, there are those which do not form the above thin films and used the sintered compacts comprising aluminum nitride as a main component, as a substrate as it is, or those which comprise only one layer of thin film and do not form the single-crystal thin film of the 2nd layer.

Each thin film-conductive material of Cr, Mo, W, W/Cu alloy, Ru, Rh, Pd, Os, Ir, Pt, Ti and Ni was formed suitably on the other substrates prepared in the thickness of 0.5 µm by the same sputtering method as what was shown in Example 18 and Example 20, and the orientated polycrystalline thin films comprising as a main component at least one selected from gallium nitride or aluminum nitride were formed furthermore suitably on these thin film-conductive materials in the thickness of 3 µm by the same sputtering method or MOCVD method as what was shown in the experiment No.708 and 730 in Example 25, as the thin film of the 1 st layer.

The single-crystal thin films comprising as a main component at least one selected from gallium nitride and aluminum nitride were suitably formed furthermore on them in the thickness of 3 µm by the same MOCVD method as what was shown in Example 1, as the thin film of the 2nd layer.

Production of the light-emitting devices was tried using these substrates in which the thin film comprising as a main component a material selected from gallium nitride or aluminum nitride, and/or each thin film-conductive material of Cr, Mo, W, W/Cu alloy, Ru, Rh, Pd, Os, Ir, Pt, Ti, and Ni were formed on the aluminum nitride-based sintered compacts.

For comparison, the commercial sapphire substrates having the diameter of 25.4 mm, thickness of 0.5 mm and an average surface roughness Ra of 1.2 nm, the substrate surface being C plane (namely, C axis is perpendicular to the substrate surface), were produced by KYOCERA Corp., and the production of the light-emitting devices was tried on them.

As for these sapphire substrates, here prepared those with the surface states as they are, and those having the thin films of one or two layers comprising as a main component at least one selected from gallium nitride and aluminum nitride onto the surface by the method in this Example, and the light-emitting devices were produced.

The characteristics of each above substrate used for light-emitting device production are shown in Table 50.

The origins of the substrates used in this Example (produced experiment No.) are also shown in Table 50.

The optical transmissivity of each substrate in Table 50 is those to the light with a wavelength of 605 nm.

Each above substrate prepared was put into the reaction container of the same MOCVD equipment as what was used in Example 1, and the preliminary heating was carried out at 950-1050°C, flowing H₂.

After that, using trimethyl gallium for a gallium raw material, and using H₂ for a career gas, and NH₃ for a reactive gas, the GaN film was formed on each above substrate as a buffer layer, in the thickness of 500 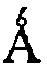 and the substrate temperature of 520°C, by the MOCVD method of the same equipment as what was used in above Example 1.

Onto each buffer layer formed, a Si doping epitaxial growth GaN thin film which becomes the contact layer and the barrier layer of a single quantum well was formed in the thickness of 5 µm using trimethyl gallium as a main raw material, and using further SiH₄ gas as a raw material for the doping component by the MOCVD method under the same conditions as the above except having made the substrate temperature into 1000°C.

Onto it, 2 components mixture composition thin film of undoped epitaxially grown InGaN which becomes a well layer of the single quantum well which is a luminescence layer was formed in the thickness of 30 Å using the trimethyl gallium and trimethyl indium as a main raw material without using the doping component by the MOCVD method under the same conditions as the above except having made the substrate temperature into 800°C.

As for the composition of the InGaN thin film which becomes a luminescence layer, three kinds of things, i.e., In_{0.06}Ga_{0.94}N, In_{0.20}Ga_{0.80}N, and In_{0.45}Ga_{0.55}N, were produced.

Onto it, the epitaxially grown thin film of Al_{0.20}Ga_{0.80}N composition which doped Mg and becomes a barrier layer of a single quantum well was formed in the thickness of 0.15 µm using the trimethyl gallium and trimethyl aluminum as a main raw material, and using further bis-cyclopentadienyl magnesium (MgCp₂) as a raw material for the doping component by the MOCVD method of the same conditions as the above except having made the substrate temperature into 1050°C.

Onto it, the epitaxially grown GaN thin film which doped Mg and becomes a contact layer was formed in the thickness of 0.5 µm using trimethyl gallium as a main raw material, and using further bis-cyclopentadienyl magnesium (MgCp₂) as a raw material for the doping component by the MOCVD method under the same conditions as the above except having made the substrate temperature into 1000°C.

After that, the substrates in which the thin films were formed were taken out from the reaction container, and they were heated at 700°C in N₂.

The masks of predetermined shape were formed on the P-type GaN thin film layers in which Mg was doped and were made like that, etching was carried out until the GaN thin film layers of the above Si doping were exposed, and the electrodes were produced by two layers of metal thin films of Ti/Al on these GaN thin film layers of the Si doping.

The electrodes were produced by two layers of metal thin films of Ni/Au onto these Mg doping GaN thin film layers currently formed on the top layer.

After that, the substrates in which the thin films were formed were cut into the chips with the outside size of 1 mm x 1 mm, and the light-emitting devices (LED) of single quantum well structure were produced.

Among the light-emitting devices produced, what used the substrates not forming a thin film layer is what has the constitution illustrated in Fig. 42.

What used the substrates in which only one layer of thin film layers was formed is what has the constitution illustrated in Fig. 43.

What used the substrates in which two layers of thin film layers were formed is what has the constitution illustrated in Fig. 44.

What used the substrates forming the thin film-conductive material and forming furthermore two layers of thin film layers is what has the constitution illustrated in Fig. 53.

The electrodes are formed by arrangement illustrated in Fig. 45.

In addition, in what used the substrates having a conduction via, electrode formation by the above etching was not carried out, the light-emitting devices of the single quantum well structure having the form having arranged the electrodes to the upper and lower sides of the light-emitting device were produced by forming not the GaN thin film layer of the Si doping but the electrode with three layers of metal thin films of Ti/Pt/Au onto the aluminum nitride-based sintered compact, as shown in Figs. 47-49 and Figs. 54-56.

The outside size of the light-emitting device chips having the form having arranged the electrodes up and down is also 1 mm x 1 mm.

The light-emitting devices produced using the sapphire substrates are the constitution as shown in Fig. 40, and the electrodes are formed by arrangement illustrated in Fig. 45 like the light-emitting devices produced using the substrates comprising an aluminum nitride-based sintered compact.

Next, using those in which the composition of the InGaN thin film which becomes the luminescence layer is In_{0.20}Ga_{0.80}N among the light-emitting devices produced, direct-current potential was impressed and the luminescence was tried.

As a result, luminescences with the main wavelength of 450 nm were obtained by impressing the voltage of 3.5-3.8 volts into light-emitting devices produced.

Next, in all the light-emitting devices of single quantum well structure having the above luminescence layer, the actuating currents inputted in order to make these devices drive and the luminescence outputs emitted from the light-emitting devices at the time were measured, and the luminous efficiencies were calculated.
The result was shown in the experiment No.1421-1457 of Table 50. The experiment No.1457 of Table 50 is the result of the light-emitting devices produced using the sapphire substrates.

The actuating currents of Table 50 are the value at the time of having made the light-emitting devices drive on the operating voltage of 3.6 volts.

As a result, in the case of the light-emitting devices of the single quantum well structure produced using the sapphire substrates, the luminous efficiency was small regardless of the existence of the thin films, it was 6.7 % in that which does not form the gallium-nitride and aluminum-nitride thin films on the surface of these sapphire substrates, and it is in the range of 6.9 %-7.4 % even if one or two layers of the gallium-nitride and aluminum-nitride thin films are formed, on the other hand in the case of the light-emitting devices produced using the substrates of this invention comprising an aluminum nitride-based sintered compact, the luminous efficiency was not less than 10% altogether.

As shown in Table 50, the optical transmissivity of the sapphire substrates is not less than 90 %, and is very high.

On the other hand, the luminous efficiency of the light-emitting devices produced using these substrates comprising an aluminum nitride-based sintered compact is not less than 10 %, even if the substrates comprising an aluminum nitride-based sintered compact are what does not have optical transmissivity or what is the optical transmissivity not more than 10 %, the luminous efficiency is larger than the light-emitting devices produced using a sapphire substrate.

Even if the light-emitting devices are what was produced using the substrates as they are without forming beforehand the gallium-nitride and aluminum-nitride thin films onto the substrates of this invention comprising an aluminum nitride-based sintered compact, the luminous efficiency was not less than 10 %.

Furthermore, the luminous efficiency of the light-emitting devices produced using the substrates in which at least one layer of gallium nitride or aluminum nitride was formed was improved.

It was confirmed that the luminous efficiency of the light-emitting devices formed on these substrates is improved furthermore than the substrates in which only one layer of thin films was formed, if using the substrates of the two layer constitution of thin films in which the single-crystal thin film comprising gallium nitride or aluminum nitride as a main component was formed furthermore on it after the thin film comprising gallium nitride or aluminum nitride as a main component and having at least one of the crystallization states selected from an amorphous state, a polycrystal, an orientated polycrystal and a single crystal was formed beforehand on the substrates comprising an aluminum nitride-based sintered compact.
Furthermore, it was confirmed that those in which the luminous efficiency of the light-emitting devices produced on them is not less than 12 % are obtained, if using the substrates of the two layer constitution of thin films in which the single-crystal thin film comprising gallium nitride or aluminum nitride as a main component was formed furthermore on it after the thin film comprising gallium nitride or aluminum nitride as a main component and having at least one of the crystallization states selected from an amorphous state, a polycrystal, an orientated polycrystal and a single crystal was formed beforehand on the substrates comprising an aluminum nitride-based sintered compact containing an aluminum nitride component not less than 20 volume %.

It was confirmed that those in which the luminous efficiency of the light-emitting devices produced on them is not less than 12 % are obtained, if using the substrates in which the thin film comprising gallium nitride or aluminum nitride as a main component and having at least one of the crystallization states selected from an amorphous state, a polycrystal, an orientated polycrystal and a single crystal was formed beforehand on the substrates comprising an aluminum nitride-based sintered compact containing an aluminum nitride component not less than 50 volume %.

It was confirmed that those in which the luminous efficiency of the light-emitting devices produced on them is not less than 15 % are obtained, if using the substrates in which the thin film comprising gallium nitride or aluminum nitride as a main component and having the orientated polycrystalline state was formed beforehand on the substrates comprising an aluminum nitride-based sintered compact containing an aluminum nitride component not less than 50 volume %.

It was confirmed that those in which the luminous efficiency of the light-emitting devices produced on them is not less than 15 % are obtained, if using the substrates of the two layer constitution of the thin films in which the single-crystal thin film comprising gallium nitride or aluminum nitride as a main component was formed furthermore on it after the thin film comprising gallium nitride or aluminum nitride as a main component and having at least one of the crystallization states selected from an amorphous state, a polycrystal, an orientated polycrystal and a single crystal was formed beforehand on the substrates comprising an aluminum nitride-based sintered compact containing an aluminum nitride component not less than 50 volume %.

In this Example, the light-emitting devices in which the luminous efficiency is not less than 10 % at least were producible, even if those in which the optical transmissivity is smaller than 1 % or which do not have optical permeability substantially, or those in which the optical transmissivity is not less than 1 %, are used as the substrates comprising an aluminum nitride-based sintered compact.

The more the optical transmissivity of the above substrates is large, the more the luminous efficiency of the light-emitting devices produced on these substrates is improved.

That is, when the aluminum nitride-based sintered having the optical transmissivity not less than 10 % are used as a substrate, it was confirmed that those in which the luminous efficiency of the light-emitting devices produced on them is not less than 12 % are obtained.

When the aluminum nitride-based sintered compacts having the optical transmissivity not less than 20 % are used as a substrate, it was confirmed that those in which the luminous efficiency of the light-emitting devices produced on them is not less than 15 % are obtained.

When the aluminum nitride-based sintered compacts having the optical transmissivity not less than 30 % are used as a substrate, it was confirmed that those in which the luminous efficiency of the light-emitting devices produced on them is not less than 20 % are obtained.

When the aluminum nitride-based sintered compacts having the optical transmissivity not less than 40 % are used as a substrate, it was confirmed that those in which the luminous efficiency of the light-emitting devices produced on them is not less than 25 % are obtained.

When the aluminum nitride-based sintered compacts having the optical transmissivity not less than 50 % are used as a substrate, it was confirmed that those in which the luminous efficiency of the light-emitting devices produced on them is not less than 30 % are obtained.

When the aluminum nitride-based sintered compacts having the optical transmissivity not less than 60 % are used as a substrate, it was confirmed that those in which the luminous efficiency of the light-emitting devices produced on them is not less than 40 % are obtained.

In this Example, when the substrate comprising an aluminum nitride-based sintered compact in which the optical transmissivity is 88 % is used, the light-emitting device having the greatest luminous efficiency of 62 % in this Example was produced on it.

In the light-emitting devices produced using the substrates of this invention comprising an aluminum nitride-based sintered compact having a thin film-conductive material, the luminous efficiency was not less than 10% altogether.

In the light-emitting devices produced using the substrates in which the thin film-conductive material(s) was formed, the luminescence from the substrate side was seldom seen, but the luminescence from the direction of the P type GaN thin film layer side opposite to it and luminescence layer side was observed.

The luminous efficiency of the light-emitting devices produced using the substrates in which the thin film-conductive material(s) was formed did not lower compared with the luminous efficiency of the light-emitting devices produced using the substrates which do not form the thin film-conductive material(s) on the same substrate.

The tendency in which the luminous efficiency lowers was not especially seen even if the light-emitting devices are those produced using the substrates having a conduction via and having the form which arranged the electrode up and down, and it was confirmed that they can be enough used as a light-emitting device.

In addition, although it is not indicated in Table 50, though the main luminescence wavelength has changed to 390 nm and 520 nm respectively in the case of the light-emitting devices of the single quantum well structure in which the composition of the InGaN thin film which becomes a luminescence layer was produced as In_{0.06}Ga_{0.94}N and In_{0.45}Ga_{0.55}N, all things have the luminous efficiency not less than 10% like those in which the composition of a luminescence layer is In_{0.20}Ga_{0.80}N in the case of the light-emitting devices produced using the substrates of this invention comprising an aluminum nitride-based sintered compact, and the luminous efficiency was higher compared with those in which it is 6.6 % and 6.1 % respectively in the case of the light-emitting devices produced using the sapphire substrates (the gallium-nitride and aluminum-nitride thin films are not formed).

Next, in the other, the light-emitting devices of double hetero structure were produced using the above substrates prepared and comprising a ceramic material as a main component, and the sapphire substrates prepared for comparison.

That is, the above substrates prepared were put into the reaction container of the same MOCVD equipment as what was used in Example 1, preliminary heating was carried out at 950-1050°C, flowing H₂.

After that, using trimethyl gallium for a gallium raw material, and using H₂ for a career gas, and NH₃ for a reactive gas, the GaN film was formed on each above substrate as a buffer layer, in the thickness of 500 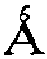 and the substrate temperature of 500°C, by the MOCVD method of the same equipment as what was used in above Example 1.

Onto each buffer layer formed, a Si doping epitaxial growth GaN thin film which becomes the contact layer was formed in the thickness of 4 µm using trimethyl gallium as a main raw material, and using further SiH₄ gas as a raw material for the doping component by the MOCVD method under the same conditions as the above except having made the substrate temperature into 1050°C.

Onto it, the epitaxially grown thin film which becomes a cladding layer and has Al_{0.15}Ga_{0.85}N composition which doped Si was formed in the thickness of 0.15 µm using the trimethyl gallium and trimethyl aluminumas a main raw material, and using further SiH₄ gas as a raw material for the doping component by the MOCVD method under the same conditions as the above except having made the substrate temperature into 1050°C.

Onto it, the epitaxially grown thin film of In_{0.06}Ga_{0.94}N composition which becomes a luminescence layer was formed in the thickness of 500 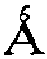 using the trimethyl gallium and trimethyl indium as a main raw material, and using furthermore the SiH₄ gas and diethyl zinc as the raw material for the doping component by the MOCVD method under the same conditions as the above except having made the substrate temperature into 800°C.

Onto it, the epitaxially grown thin film which becomes a cladding layer and has Al_{0.15}Ga_{0.85}N composition which doped Mg was formed in the thickness of 0.15 µm using the trimethyl gallium and trimethyl aluminum as a main raw material, and using further bis-cyclopentadienyl magnesium (MgCp₂) as a raw material for the doping component by the MOCVD method under the same conditions as the above except having made the substrate temperature into 1050°C.

Onto it, the epitaxially grown GaN thin film which doped Mg and becomes a contact layer was formed in the thickness of 0.5 µm using trimethyl gallium as a main raw material, and using further bis-cyclopentadienyl magnesium (MgCp₂) as a raw material for the doping component by the MOCVD method under the same conditions as the above except having made the substrate temperature into 1050°C.

After that, the substrates in which the thin films were formed were taken out from the reaction container, and they were heated at 700°C in N₂.

Next, the masks of predetermined shape were formed on the P type GaN thin film layers doping Mg and being made like that, etching was carried out until the above GaN thin film layers of Si doping were exposed, and the electrodes were produced with two layers of metal thin films of Ti/Al onto these GaN thin film layers of Si doping.

The electrodes were produced by two layers of metal thin films of Ni/Au onto these Mg doping GaN thin film layers currently formed on the top layer.

After that, the substrates in which the thin films were formed were cut into the chips with the outside size of 1 mm x 1 mm, and the light-emitting devices (LED) of double hetero structure were produced.

Among the light-emitting devices produced, what used the substrates in which two layers of thin film layers were formed is what has the constitution illustrated in Fig. 57.

What used the substrates not forming the thin film layers is what has the constitution in which the thin film layer 5 and 8 of Fig. 57 are not formed.

What used the substrates forming the thin film-conductive material and forming furthermore two layers of thin film layers is what has the constitution in which the thin film-conductive material was formed between the substrate 4 and the thin film layer 5 in Fig. 57.

The electrodes are formed by arrangement illustrated in Fig. 45.

In addition, in what used the substrates having a conduction via, electrode formation by the above etching was not carried out, the light-emitting devices of the double hetero structure having the form which arranged the electrodes to the upper and lower sides of the light-emitting device were produced by forming not the GaN thin film layer of the Si doping but the electrode with three layers of metal thin films of Ti/Pt/Au onto the aluminum nitride -basedsintered compact, as shown in Figs. 47-49 and Figs. 54-56.

The light-emitting devices produced using the sapphire substrates have the constitution as shown in Fig. 41, and the electrodes are formed by the arrangement illustrated in Fig. 45 like the light-emitting devices produced using the substrates comprising an aluminum nitride-based sintered compact.

Next, direct-current potential was impressed to the light-emitting devices produced, and the luminescence was tried.

Luminescences with the main wavelength of 450 nm were obtained by impressing the voltage of 3.5-3.8 volts into light-emitting devices produced.

Next, in all the produced light-emitting devices of the double hetero structure, the actuating currents inputted in order to make these devices drive and the luminescence outputs emitted from the light-emitting devices at the time were measured, and the luminous efficiencies were calculated.

The result was shown in the experiment No.1460-1470 of Table 50.

In Table 50, the experiment No.1469 and 1470 are the result of the light-emitting devices produced using the sapphire substrate.

In addition, the actuating current of Table 50 is the value at the time of having made the light-emitting devices drive on the operating voltage of 3.6 volts.

As a result, the luminous efficiency was 5.4 % in the case of the light-emitting device of the double hetero structure produced using the sapphire substrate in which the gallium-nitride and aluminum-nitride thin films were not form, and the luminous efficiency was 5.9 % in the case of the light-emitting device of the double hetero structure produced using the sapphire substrate in which the gallium nitride thin film was formed, but the luminous efficiency was not less than 10 % altogether in the case of the light-emitting devices of the double hetero structure produced using the substrates of this invention comprising an aluminum nitride-based sintered compact.

As shown in Table 50, the optical transmissivity of the sapphire substrates is not less than 90 %, and is very high.

On the other hand, the luminous efficiency of the light-emitting devices produced using these substrates comprising an aluminum nitride-based sintered compact is not less than 10 %, even if the substrates comprising an aluminum nitride-based sintered compact are what does not have optical transmissivity or what has the optical transmissivity not more than 10 %, and it is larger than the light-emitting devices produced using the sapphire substrates.

Even if the light-emitting devices are what was produced using the substrates as they are without forming beforehand the gallium-nitride and aluminum-nitride thin films onto the substrates of this invention comprising an aluminum nitride-based sintered compact, the luminous efficiency was not less than 10 %.

Furthermore, the luminous efficiency of the light-emitting devices produced using the substrates in which at least one layer of gallium nitride or aluminum nitride was formed was improved.

It was confirmed that the luminous efficiency of the light-emitting devices formed on these substrates is improved furthermore than the substrates in which only one layer of thin films was formed, if using the substrates of the two layer constitution of thin films in which the single-crystal thin film comprising gallium nitride or aluminum nitride as a main component was formed furthermore on it after the thin film comprising gallium nitride or aluminum nitride as a main component and having at least one of the crystallization states selected from an amorphous state, a polycrystal, an orientated polycrystal and a single crystal was formed beforehand on the substrates comprising an aluminum nitride-based sintered compact.

Next, the 100 mol % AlN orientated polycrystalline thin film of the thickness of 3 µm was first formed by the same sputtering method as Example 25 using the substrate comprising aluminum nitride as a main component and produced in the experiment No.49 of Example 2.

After that, the substrate was taken out from the sputtering chamber, and the 100 mol % AlN single-crystal thin film in which C axis is a perpendicular direction to the substrate surface was formed in the thickness of 25 µm by the same MOCVD method as Example 1.

The half width of the rocking curve of the X ray diffraction from the lattice plane of the Miller Index (002) of this AlN single-crystal thin film was 84 seconds.

Specular surface polish of the formed AlN single-crystal thin film was carried out by the abradant comprising chromic oxide as a main component and having the particle diameter 0.1 µm, and by the abradant comprising a colloidal SiO₂ as a main component and having the particle diameter 0.02 µm, the washing was carried out with acetone and iso-propyl alcohol using the ultrasonic wave, and the thin-film substrate in which the average surface roughness Ra is 1.2 nm was produced.

In addition, the AlN single-crystal thin film in the surface remained in the thickness of 9 µm after polish.

The laser diodes were produced using this thin-film substrate as a substrate for light-emitting device production, and using further the above sapphire substrate for comparison.

In addition, SiO₂ film for carrying out the ELO method onto the buffer layer was not formed in the sapphire substrate used, and the sapphire substrate was used in the state as it is.

The above two kinds of substrates prepared like that were put in the reaction container of the same MOCVD equipment as what was used in Example 1, and the preliminary heating was carried out at 1000°C, flowing H₂.

After that, using trimethyl gallium for a gallium raw material, and using H₂ for a career gas, and NH₃ for a reactive gas, the GaN film was formed on each above substrate as a buffer layer, in the thickness of 500 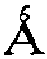 and the substrate temperature of 500°C, by the MOCVD method of the same equipment as what was used in above Example 1.

Onto each buffer layer formed, a Si doping epitaxial growth GaN thin film which becomes the contact layer was formed in the thickness of 6 µm using trimethyl gallium as a main raw material, and using further SiH₄ gas as a raw material for the doping component by the MOCVD method under the same conditions as the above except having made the substrate temperature into 1050°C.

Onto it, the epitaxially grown thin film which becomes the second cladding layer and has Al_{0.15}Ga_{0.85}N composition which doped Si was formed in the thickness of 0.1 µm using the trimethyl gallium and trimethyl aluminum as a main raw material, and using further SiH₄ gas as a raw material for the doping component by the MOCVD method of the same conditions as the above except having made the substrate temperature into 1050°C.

Onto it, 150 layers of the epitaxially grown Al_{0.15}Ga_{0.85}N thin film and GaN thin film which doped Si were laminated alternately in the thickness of 20 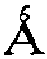 respectively, using the trimethyl gallium and trimethyl aluminum as a main raw material, and using further SiH₄ gas as a raw material for the doping component by the MOCVD method under the same conditions as the above except having made the substrate temperature into 1050°C, and the super lattice layer was formed.

Onto it, the epitaxial growth GaN thin film which doped Si and becomes the first cladding layer was formed in the thickness of 0.1 µm using trimethyl gallium as a main raw material, and using further SiH₄ gas as a raw material for the doping component by the MOCVD method under the same conditions as the above except having made the substrate temperature into 1000°C.

Onto it, the multi-quantum-well of the epitaxially grown In_{0.15}Ga_{0.85}N(Si doping)/In_{0.02}Ga_{0.98}N(Si doping) which becomes a luminescence layer was formed using the trimethyl gallium and trimethyl indium as a main raw material, and using further SiH₄ gas as a raw material for the doping component by the MOCVD method under the same conditions as the above except having made the substrate temperature into 800°C.

6 layers of In_{0.15}Ga_{0.85}N thin films of the thickness of 30 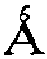 which become a well layer and 5 layers of In_{0.02}Ga_{0.98}N thin films of the thickness of 85 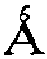 which become a barrier layer are laminated alternately respectively, and the constitution of the multi-quantum-well was formed.

Onto it, the epitaxial growth GaN thin film which doped Mg and becomes the 1st cladding layer was formed in the thickness of 0.1 µm using trimethyl gallium as a main raw material, and using further bis-cyclopentadienyl magnesium (MgCp₂) as a raw material for the doping component by the MOCVD method under the same conditions as the above except having made the substrate temperature into 1000°C.

Onto it, 150 layers of the epitaxially grown Al_{0.15}Ga_{0.85}N thin film and GaN thin film which have doped Mg were laminated alternately in the thickness of 20 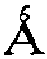 respectively, using the trimethyl gallium and trimethyl aluminum as a main raw material, and using further bis-cyclopentadienyl magnesium (MgCp₂) as a raw material for the doping component by the MOCVD method under the same conditions as the above except having made the substrate temperature into 1050°C, and the super lattice layer was formed.

Onto it, the epitaxially grown thin film which becomes the 2nd cladding layer and has Al_{0.15}Ga_{0.85}N composition which doped Mg was formed in the thickness of 0.05 µm using the trimethyl gallium and trimethyl aluminum as a main raw material, and using further bis-cyclopentadienyl magnesium (MgCp₂) as a raw material for the doping component by the MOCVD method under the same conditions as the above except having made the substrate temperature into 1050°C.

Onto it, the epitaxially grown GaN thin film which doped Mg and becomes the contact layer was formed in the thickness of 0.2 µm using trimethyl gallium as a main raw material, and using further bis-cyclopentadienyl magnesium (MgCp₂) as a raw material for the doping component by the MOCVD method under the same conditions as the above except having made the substrate temperature into 1000°C.

After that, the substrates in which the thin films were formed were taken out from the reaction container, and they were heated at 700°C in N₂.

Next, after extracting from the thermal treatment equipment, the masks with the shape which can form the strip electrode as shown in Fig. 46 were formed on the Mg dope P type GaN thin film layers of the top layer, etching was carried out until the above GaN thin film layers of Si doping were exposed, and the strip electrodes as shown in Fig. 46 were produced with two layers of metal thin films of Ti/Al onto these GaN thin film layers of Si doping.

The strip electrodes with the width of 10 µm shown in Fig. 46 were produced with two layers of metal thin films of Ni/Au onto the Mg doping GaN thin film layers formed on the top layer.

After electrodes formation, the substrates were cut into the chips of the size of 0.45 mm x 0.45 mm, the cut both-ends sides which are perpendicular to the longitudinal direction of the strip electrodes were polished into the specular surface state, the mirrors were formed, and the laser diodes were produced.

Next, direct-current potential was impressed to the laser diodes produced, and luminescence was tried.

As a result, in what was produced using the conventional sapphire as a substrate, the oscillation of the laser light with the 402 nm wavelength and 8 mW outputs was confirmed under the 4.7 volts operating voltage and 70 mA actuating current.

Thus, the luminous efficiency of the laser diode produced using the conventional sapphire as a substrate was 2.4 %.

On the other hand, in the case of the laser diode produced using the thin-film substrate on which the AlN single-crystal thin film was formed on the surface of the substrate of this invention comprising an aluminum nitride-based sintered compact, the oscillation of the laser light with the 402 nm wavelength and 49 mW outputs was confirmed under the 4.3 volts operating voltage and 70 mA actuating current. Thus, the luminous efficiency of the laser diode produced using the thin-film substrate of this invention comprising an aluminum nitride-based sintered compact was 16.3 %.

A GaN thin film was formed on the sapphire substrate in the thickness of 500 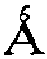 as a buffer layer as well as the above, what formed the strip SiO₂ thin film with the width of 10 µm in intervals of 10 µm onto it was prepared as a substrate, and production of the laser diode by the ELO method was tried.

The thickness of this SiO₂ thin film is 0.1 µm.

Thus, using the sapphire substrate on which the strip SiO₂ thin film was formed beforehand in equal intervals, the GaN thin film of Si doping which becomes the contact layer was formed first by the same method as the above, the laser diode was produced by the same method as the above after that, and luminescence was tried.

In addition, the electrode formed on the P type GaN thin film layer of the produced laser diode was formed in the position equivalent onto the space portion of the strip SiO₂ thin film which is considered rare to bring dislocation and distortion into the epitaxial thin film of gallium nitride, indium nitride and aluminum nitride.

As a result, in this laser diode, the oscillation of the laser light with the 402 nm wavelength and 22 mW outputs was observed under the 4.4 volts operating voltage and 70 mA actuating current.

The luminous efficiency is 7.1 %.

Thus, when conventional sapphire substrate is used, the luminous efficiency is comparatively small even if the laser diode is produced using the ELO method.

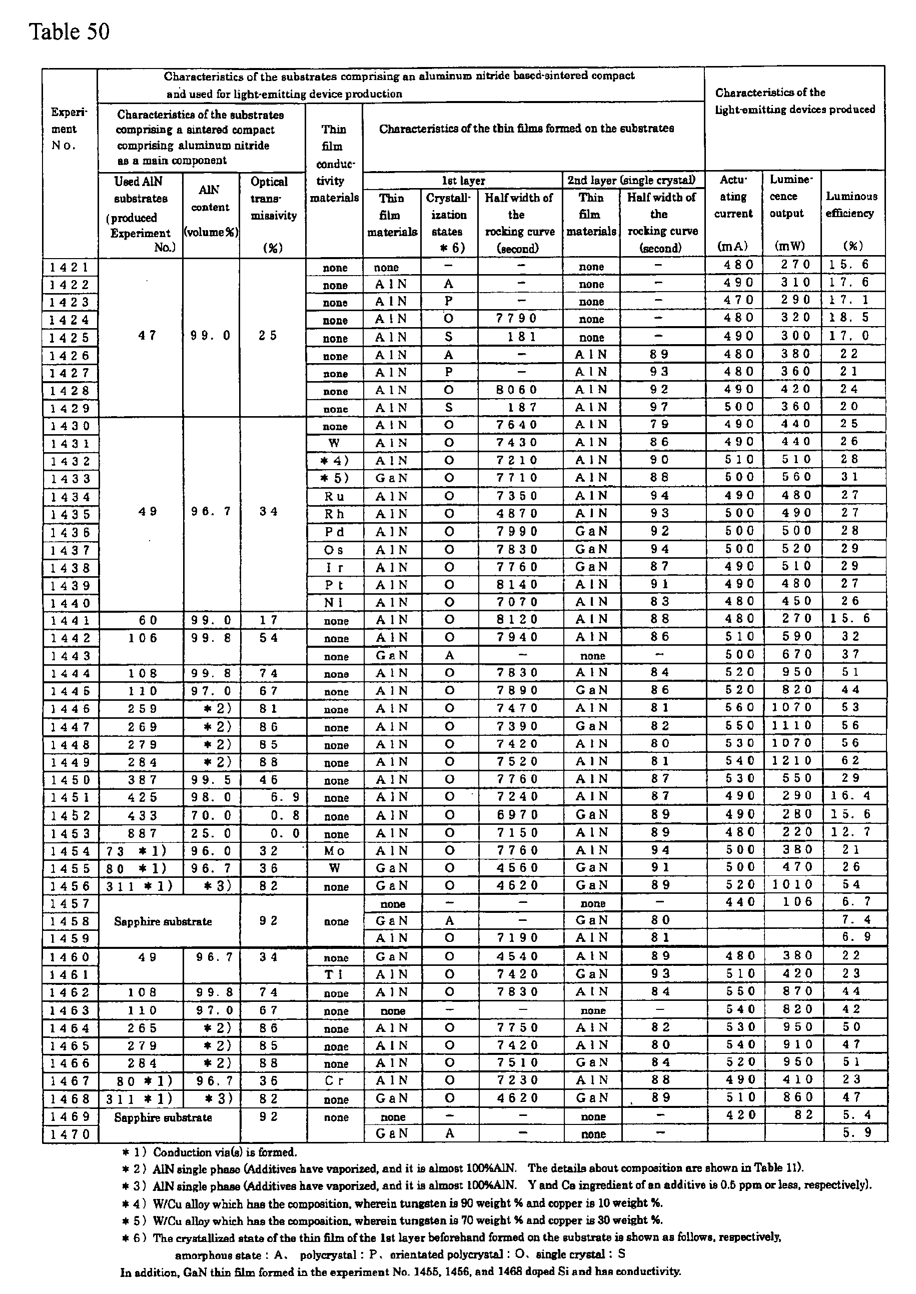

### Example 35

This Example shows the examples which investigated the luminous efficiency, carrying out the trial of production of the light-emitting devices using the sintered compacts comprising as a main component each silicon carbide, silicon nitride, zinc oxide, beryllium oxide, aluminum oxide, zirconium oxide, magnesium oxide, magnesium aluminate and yttrium oxide, as a substrate.

First, using each sintered compact produced in this invention and comprising as a main component silicon carbide, silicon nitride, zinc oxide, beryllium oxide, aluminum oxide, zirconium oxide, magnesium oxide, magnesium aluminate and yttrium oxide, as a substrate, the those from which the composition (content of each ceramic main components) and optical transmissivity differ respectively were prepared.

The substrates prepared have the shape of disk with the diameter of 25.4 mm and the thickness of 0.5 mm, and mirror-polishing and subsequent washing have been carried out.

The average surface roughness Ra of each substrate is the same as each origin, i.e., what was shown in Example 1, Example 8, Example 30, Example 31, Example 32 and Example 33 (Ra of the substrate comprising a sintered compact produced in Example 1 and comprising zirconium oxide as a main component is 36 nm, Ra of the substrate comprising a sintered compact comprising magnesium oxide as a main component is 60 nm, Ra of the substrate comprising a sintered compact comprising magnesium aluminate as a main component is 63 nm, and all the remaining substrates are the average surface roughness not more than those).

The thin films comprising as a main component a material selected from gallium nitride or aluminum nitride and having at least one of the crystallization states selected from an amorphous state, a polycrystal, an orientated polycrystal and a single crystal were formed suitably on the substrates prepared in the thickness of 3 µm as the thin film of the 1 st layer by the same sputtering method or MOCVD method as what was shown in the experiment No.706, 707, 708, 709 and 730 in Example 25.

After that, onto these substrates in which a thin film was formed, furthermore the single-crystal thin films comprising as a main component a material selected from gallium nitride or aluminum nitride were suitably formed in the thickness of 3 µm by the same method as what was shown in Example 1, as the thin film of the 2nd layer.

In addition, there are those not forming the above thin films and using the sintered compacts as a substrate as they are, or those with only one layer of thin films not forming the single-crystal thin film of the 2nd layer

The characteristics of each above substrate used for light-emitting device production are shown in Table 51.

The origin (the produced experiment No.) of the substrates used in this Example is also shown in Table 51.

The average surface roughness Ra of each substrate is the same as each origin, i.e., what was shown in Example 1, Example 8, Example 30, Example 31, Example 32, and Example 33 (Ra of the substrate comprising a zirconium oxide-based sintered compact produced in Example 1 is 36 nm, Ra of the substrate comprising a magnesium oxide-based sintered compact is 60 nm, Ra of the substrate comprising a magnesium aluminate-based sintered compact is 63 nm, and all the remaining substrates have the average surface roughness not more than those).

The optical transmissivity of each substrate in Table 51 is the value to the light with a wavelength of 605 nm.

Hereafter, production of the light-emitting devices of single quantum well structure was tried as well as Example 34 using each substrate prepared in this Example.

That is, each above substrate prepared was put into the reaction container of the same MOCVD equipment as what was used in Example 1, and preliminary heating was carried out at 950-1050°C, flowing H₂.

After that, using trimethyl gallium for a gallium raw material, and using H₂ for a career gas, and NH₃ for a reactive gas, the GaN film was formed on each above substrate as a buffer layer, in the thickness of 500 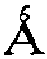 and the substrate temperature of 520°C, by the MOCVD method of the same equipment as what was used in above Example 1.

Onto each buffer layer formed, a Si doping epitaxial growth GaN thin film which becomes the contact layer and the barrier layer of a single quantum well was formed in the thickness of 5 µm using trimethyl gallium as a main raw material, and using further SiH₄ gas as a raw material for the doping component by the MOCVD method under the same conditions as the above except having made the substrate temperature into 1000°C.

Onto it, 2 components mixture composition thin film of undoped epitaxially grown InGaN which becomes a well layer of the single quantum well which is a luminescence layer was formed in the thickness of 30 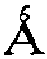 using the trimethyl gallium and trimethyl indium as a main raw material without using the doping component by the MOCVD method under the same conditions as the above except having made the substrate temperature into 800°C.

As for the composition of the InGaN thin film which becomes a luminescence layer, three kinds of the things, i.e., In_{0.06}Ga_{0.94}N, In_{0.20}Ga_{0.80}N, and In_{0.45}Ga_{0.55}N, were produced.

Onto it, the epitaxially grown thin film of Al_{0.20}Ga_{0.80}N composition which doped Mg and becomes a barrier layer of a single quantum well was formed in the thickness of 0.15 µm using the trimethyl gallium and trimethyl aluminum as a main raw material, and using further bis-cyclopentadienyl magnesium (MgCp₂) as a raw material for the doping component by the MOCVD method under the same conditions as the above except having made the substrate temperature into 1050°C.

Onto it, the epitaxially grown GaN thin film which doped Mg and becomes a contact layer was formed in the thickness of 0.5 µm using trimethyl gallium as a main raw material, and using further bis-cyclopentadienyl magnesium (MgCp₂) as a raw material for the doping component by the MOCVD method under the same conditions as the above except having made the substrate temperature into 1000°C.

After that, the substrates in which the thin films were formed were taken out from the reaction container, and they were heated at 700°C in N₂.

Next, the masks of predetermined shape were formed on the P type GaN thin film layers in which Mg was doped and which were made like that, etching was carried out until the above GaN thin film layers of Si doping were exposed, and the electrodes were produced with two metal layers of Ti/Al onto these GaN thin film layers of Si doping.

The electrodes were produced by two metal layers of Ni/Au onto these Mg doping GaN thin film layers currently formed in the top layer.

After that, the substrates in which the thin films were formed were cut into the chips with the outside size of 1 mm x 1 mm, and the light-emitting devices of single quantum well structure were produced.

Among the light-emitting devices produced, what used the substrates not forming a thin film layer is what has the constitution illustrated in Fig. 42.

What used the substrates in which only one layer of thin film layers was formed is what has the constitution illustrated in Fig. 43.

What used the substrates in which two layers of thin film layers were formed is what has the constitution illustrated in Fig. 44.

The electrodes are formed by the arrangement illustrated in Fig. 45, they are the same as that of the light-emitting devices produced using the substrates comprising an aluminum nitride-based sintered compact in Example 34.

In addition, the light-emitting devices produced in the experiment Nos. 1492 and 1495 use as a substrate the sintered compacts comprising zinc oxide as a main component and having conductivity, and the thin films formed beforehand on the substrates used also the GaN thin films of Si doping which have conductivity.

The light-emitting devices produced in the experiment Nos. 1492 and 1495, and having a single quantum well structure having upper and lower electrodes sandwiching a light-emitting device as shown in Fig. 50, and produced by directly forming a Ti/Pt/Au three-layer metal thin film on each zinc oxide-based sintered compact.

The outside size of the light-emitting device chips of the form which arranged the electrodes up and down is also 1 mm x 1 mm.

Next, using those in which the composition of the InGaN thin film which becomes the luminescence layer is In_{0.20}Ga_{0.80}N among the light-emitting devices produced, direct-current potential was impressed and the luminescence was tried.

As a result, luminescences with the main wavelength of 450 nm were obtained by impressing the voltage of 3.5-3.8 volts into the light-emitting devices produced.

Next, in all the light-emitting devices of single quantum well structure having the above luminescence layer, the actuating currents inputted in order to make these devices drive and the luminescence outputs emitted from the light-emitting devices at the time were measured, and the luminous efficiencies were calculated.

The result was shown in Table 51.

In addition, the actuating current of Table 51 is the value at the time of having made the light-emitting devices drive on the operating voltage of 3.6 volts.

As a result, although the luminous efficiency was in the range of 6.7-7.4 % as shown in Example 34 in the case of the light-emitting devices produced using the sapphire substrates and having the single quantum well structure, the luminous efficiency was not less than 8 % altogether in the case of the light-emitting devices produced using the substrates of this invention comprising each sintered compact comprising as a main component silicon carbide, silicon nitride, zinc oxide, beryllium oxide, aluminum oxide, zirconium oxide, magnesium oxide, magnesium aluminate and yttrium oxide, and it was higher than what was produced using the sapphire substrates.

As shown in Table 50 of Example 34, the optical transmissivity of the sapphire substrates is not less than 90 %, and is very high.

On the other hand, the luminous efficiency of the light-emitting devices produced using these substrates comprising the sintered compacts comprising as a main component each silicon carbide, silicon nitride, zinc oxide, beryllium oxide, aluminum oxide, zirconium oxide, magnesium oxide, magnesium aluminate and yttrium oxide is not less than 10 %, even if the substrates comprising each sintered compact comprising as a main component silicon carbide, silicon nitride, zinc oxide, beryllium oxide, aluminum oxide, zirconium oxide, magnesium oxide, magnesium aluminate and yttrium oxide are what does not have optical transmissivity or what is the optical transmissivity not more than 10 %, and it is larger than the light-emitting devices produced using the sapphire substrates.

Even if the light-emitting devices are what was produced using the substrates as they are without forming beforehand the gallium-nitride and aluminum-nitride thin films onto the substrates of this invention comprising a zinc oxide-based sintered compact, the luminous efficiency was not less than 8 %.

Furthermore, the luminous efficiency of the light-emitting devices produced using the substrates in which at least one layer of gallium nitride or aluminum nitride was formed was improved.

It was confirmed that the luminous efficiency of the light-emitting devices formed on these substrates is improved furthermore than the substrates in which only one layer of thin films was formed on the substrates comprising the sintered compacts comprising as a main component each silicon carbide, silicon nitride, zinc oxide, beryllium oxide, aluminum oxide, zirconium oxide, magnesium oxide, magnesium aluminate and yttrium oxide, if using the substrates of the two layer constitution of the thin films in which the single-crystal thin film comprising gallium nitride or aluminum nitride as a main component was formed furthermore on it after the thin film comprising gallium nitride or aluminum nitride as a main component and having at least one of the crystallization states selected from an amorphous state, a polycrystal, an orientated polycrystal and a single crystal was formed beforehand on the same above substrates comprising the sintered compacts comprising as a main component each silicon carbide, silicon nitride, zinc oxide, beryllium oxide, aluminum oxide, zirconium oxide, magnesium oxide, magnesium aluminate and yttrium oxide.

In this Example, the content of a zinc oxide component in the zinc oxide-based sintered compacts used for light-emitting device production is not less than 55.0 mol %, and it was confirmed that the luminous efficiency of the light-emitting devices produced using the substrates comprising these sintered compacts is not less than 8 %.

The content of a beryllium oxide component in the beryllium oxide-based sintered compacts used for light-emitting device production is not less than 65.0 mol %, and it was confirmed that the luminous efficiency of the light-emitting devices produced using the substrates comprising these sintered compacts is not less than 8 %.

The content of an aluminum oxide component in the aluminum oxide-based sintered compacts used for light-emitting device production is not less than 55.0 mol %, and it was confirmed that the luminous efficiency of the light-emitting devices produced using the substrates comprising these sintered compacts is not less than 8 %.

In this invention, the light-emitting devices in which the luminous efficiency is not less than 8 % were producible, even if those in which the optical transmissivity is smaller than 1 % or which do not have optical permeability substantially, or those in which the optical transmissivity is not less than 1 %, are used as the substrates comprising the sintered compacts comprising as a main component each silicon carbide, silicon nitride, zinc oxide, beryllium oxide, aluminum oxide, zirconium oxide, magnesium oxide, magnesium aluminate and yttrium oxide.

The more the optical transmissivity of the above substrates is large, the more the luminous efficiency of the light-emitting devices produced on these substrates is improved.

That is, in each sintered compact comprising as a main component silicon carbide, silicon nitride, zinc oxide, beryllium oxide, aluminum oxide, zirconium oxide, magnesium oxide, magnesium aluminate and yttrium oxide, it was confirmed that those in which the luminous efficiency of the light-emitting devices produced on them is not less than 10 % are obtained when the sintered compacts in which the optical transmissivity is not less than 10 % are used as a substrate.

In each sintered compact which comprises as a main component silicon carbide, silicon nitride, zinc oxide, beryllium oxide, aluminum oxide, zirconium oxide, magnesium oxide, magnesium aluminate and yttrium oxide, it was confirmed that those in which the luminous efficiency of the light-emitting devices produced on them is not less than 12 % are obtained when the sintered compacts in which the optical transmissivity is not less than 20 % are used as a substrate.

In each sintered compact comprising as a main component silicon carbide, silicon nitride, zinc oxide, beryllium oxide, aluminum oxide, zirconium oxide, magnesium oxide, magnesium aluminate and yttrium oxide, it was confirmed that those in which the luminous efficiency of the light-emitting devices produced on them is not less than 15 % are obtained when the sintered compacts in which the optical transmissivity is not less than 30 % are used as a substrate.

In each sintered compact comprising as a main component silicon carbide, silicon nitride, zinc oxide, beryllium oxide, aluminum oxide, zirconium oxide, magnesium oxide, magnesium aluminate and yttrium oxide, it was confirmed that those in which the luminous efficiency of the light-emitting devices produced on them is not less than 20 % are obtained when the sintered compacts in which the optical transmissivity is not less than 40 % are used as a substrate.

In each sintered compact comprising as a main component silicon carbide, silicon nitride, zinc oxide, beryllium oxide, aluminum oxide, zirconium oxide, magnesium oxide, magnesium aluminate and yttrium oxide, it was confirmed that those in which the luminous efficiency of the light-emitting devices produced on them is not less than 25 % are obtained when the sintered compacts in which the optical transmissivity is not less than 50 % are used as a substrate.

It was confirmed that those in which the luminous efficiency of the light-emitting devices produced on them is not less than 30 % are obtained when each sintered compact having the optical transmissivity not less than 60 % and comprising as a main component silicon carbide, silicon nitride, zinc oxide, beryllium oxide, aluminum oxide, zirconium oxide, magnesium oxide, magnesium aluminate and yttrium oxide is used as a substrate.

In this Example, when the substrate comprising a zinc oxide-based sintered compact in which the optical transmissivity is 84 % was used, the light-emitting device having the highest luminous efficiency of 55 % in this Example was produced on it.

In this Example, when the substrate comprising a beryllium oxide sintered compact in which the optical transmissivity is 81 % was used, the light-emitting device in which the luminous efficiency is 52 % was produced on it.

In this Example, when the substrate comprising an aluminum oxide-based sintered compact in which the optical transmissivity is 82 % was used, the light-emitting device in which the luminous efficiency is 51 % was produced on it.

In this Example, when the substrate comprising a zirconium oxide-based sintered compact in which the optical transmissivity is 59 % was used, the light-emitting device in which the luminous efficiency is 27 % was produced on it.

In this Example, when the substrate comprising a magnesium oxide-based sintered compact in which the optical transmissivity is 83 % was used, the light-emitting device in which the luminous efficiency is 51 % was produced on it.

In this Example, when the substrate comprising a magnesium aluminate-based sintered compact in which the optical transmissivity is 81 % was used, the light-emitting device in which the luminous efficiency is 50 % was produced on it.

In this Example, when the substrate comprising a yttrium oxide-based sintered compact in which the optical transmissivity is 83 % was used, the light-emitting device in which the luminous efficiency is 51 % was produced on it.

The tendency in which the luminous efficiency lowers was not especially seen even if the light-emitting devices were produced using the zinc oxide-based sintered compacts having conductivity and have the form which arranged the electrode up and down, and it was confirmed that they can be enough used as a light-emitting device.

In addition, in the other, although the light-emitting devices of single quantum well structure were produced changing only the composition of the InGaN thin film which becomes a luminescence layer from In_{0.20}Ga_{0.80}N into In_{0.06}Ga_{0.94}N and In_{0.45}Ga_{0.55}N and using the substrates of this invention comprising each sintered compact comprising as a main component silicon carbide, silicon nitride, zinc oxide, beryllium oxide, aluminum oxide, zirconium oxide, magnesium oxide and magnesium aluminate, all were the luminous efficiency not less than 8 % like the light-emitting devices in which the composition of the luminescence layer is In_{0.20}Ga_{0.80}N and which were produced first in this Example, except that the main luminescence wavelength changed to 390 nm and 520 nm respectively.

In the other, the light-emitting devices of the same double hetero structure as Example 34 were produced using each above sintered compact comprising as a main component silicon carbide, silicon nitride, zinc oxide, beryllium oxide, aluminum oxide, zirconium oxide, magnesium oxide, magnesium aluminate and yttrium oxide, as a substrate.

All the substrates shown in Table 51 were used on the occasion of production of these light-emitting devices.

As for the substrates used for light-emitting device production, they are what was made into the thin-film substrate by forming the thin film as shown in Table 51 onto each sintered compact comprising as a main component silicon carbide, silicon nitride, zinc oxide, beryllium oxide, aluminum oxide, zirconium oxide, magnesium oxide, magnesium aluminate and yttrium oxide.

As a result, in all the produced light-emitting devices, the luminous efficiency is not less than 8 %, and superior clearly compared with the luminous efficiency of the light-emitting device produced in Example 34 using the sapphire substrate.

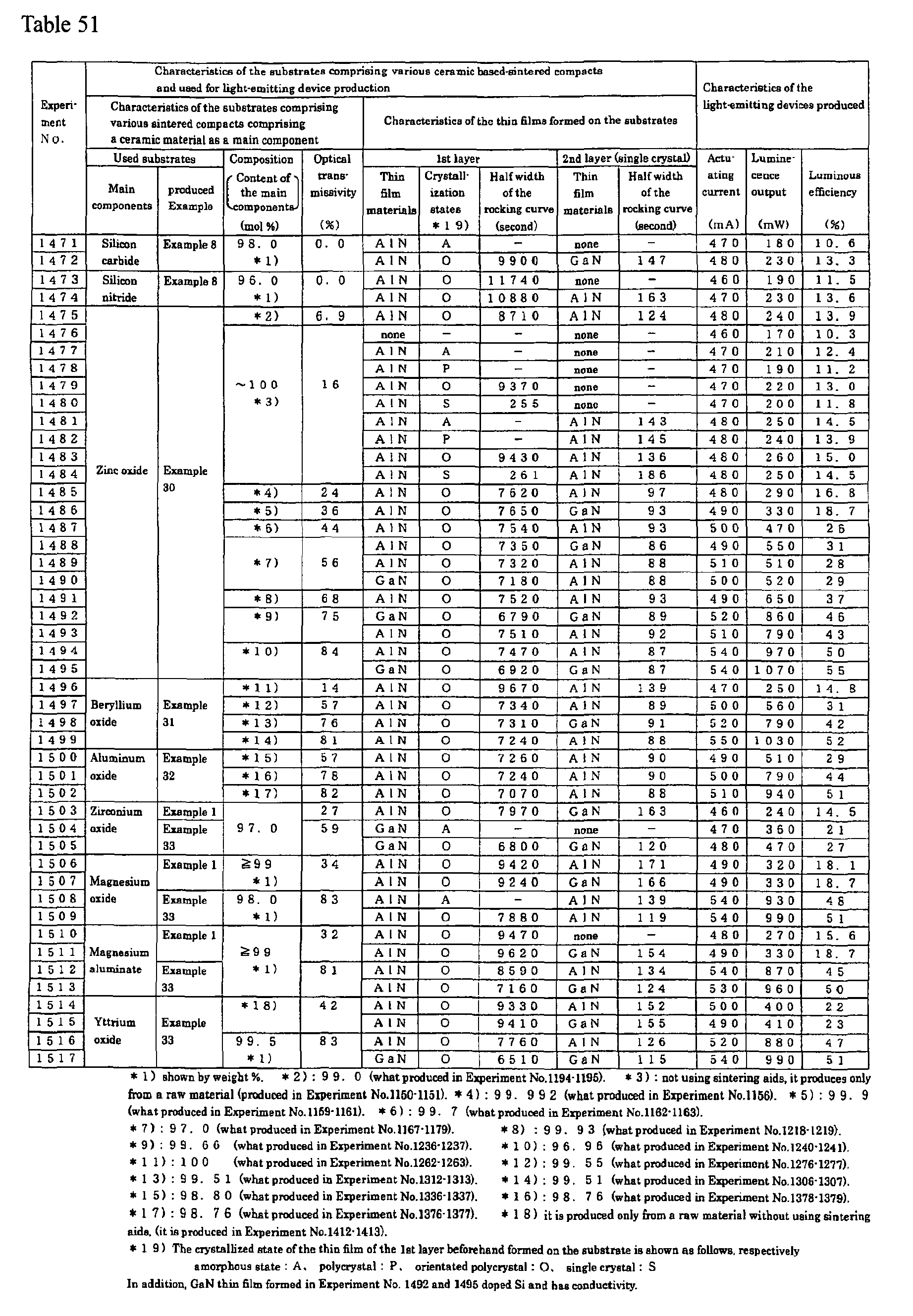

### Example 36

This Example shows the examples which investigated the characteristics about the gallium nitride-based sintered compacts.

First, the raw material powders of gallium nitride were prepared by the following method.

### 1) First, the metal gallium with the purity of 4N by Kojundo Chemical Laboratory Co., Ltd. was prepared.

This metal gallium was put into the alumina container, and put on the heating part of the reaction container made from a silica tube having the heating part and the reaction part, the metal gallium was evaporated by heating at 1200°C in argon gas current containing hydrogen 5 volume % and it was led to the reaction part by the argon gas current, and nitrogen gas was introduced into the reaction part and reacted with the evaporated metal gallium at 1100°C.

As a result, a deposit of ash gray powder was accepted near the exit of the reaction container in which the temperature is low, and it was confirmed that it is gallium nitride by the result of X ray diffraction.

The average particle diameter of the powder was 14 µm.

In addition, the reaction container is one silica tube, and the heating part and the reaction part are connected directly, feed port for career gas, such as argon gas, is provided in the entrance of the container, and feed ports for reactive gas, such as nitrogen gas and ammonia gas, are provided into the reaction part of the container.

The heating part and reaction part of the reaction container are heated by the external heater.

Especially the heater for heating is not prepared at the gas entrance portion of the container, but natural cooling is carried out.

The powder obtained was ground by the ball mill and gallium nitride powder with an average particle diameter of 1.7 µm was produced.

Oxygen was contained in this gallium nitride powder 1.1 % by weight.

The gallium nitride powder by the direct nitriding method of metal was produced in this way.

### 2) the gallium oxide (Ga₂O₃) powder with the purity of 4N by Kojundo Chemical Laboratory Co., Ltd. and the commercial carbon black powder were prepared, and 300 g

of the gallium oxide powder and 90 g of the carbon black powder were mixed in the dry state by the ball mill.

This mixed powder was put into the carbon container, and heated at 1350°C for 5 hours in nitrogen gas in the furnace made from carbon, and the reaction has been carried out.

The mixed powder was taken out after heating, a remaining carbon black was oxidized and removed by heating at 500°C for 2 hours in air, after that.

When the remaining powder was analyzed by X ray diffraction, it was confirmed that it is only the peak of gallium nitride clearly.

The average particle diameter of this powder was 0.9 µm. The oxygen content of this powder was 0.8 % by weight.

The gallium nitride powder by the oxide reduction method was produced in this way.

### 3) gallium trichloride (GaCl₃) with the purity of 5N by Kojundo Chemical Laboratory Co., Ltd. was prepared.

This gallium trichloride was put into the quartz container, and it was heated at 90°C and fused, the gallium trichloride gas was led to the reaction container made from a silica tube by being bubbled with the nitrogen gas containing hydrogen 20 volume %, and the ammonia gas introduced to the reaction container and the evaporated gallium trichloride were reacted at 1050°C.

As the result, a deposit of ash gray powder was accepted near the exit of the reaction container in which the temperature is low, and it was confirmed that it is gallium nitride by the result of X ray diffraction.

Average particle diameter of the powder was 0.4 µm. The oxygen content of this powder was 1.3 % by weight.

The gallium nitride powder by the chemical transport method was produced in this way.

The Y₂O₃ powder, Er₂O₃ powder, Yb₂O₃ powder, Dy₂O₃ powder, and Ho₂O₃ powder which have the purity not less than 99.99 % and were produced by Shin-Etsu Chemical Co., Ltd., were prepared as a rare earth element compound, CaCO₃ powder was prepared as an alkaline-earth-metal component, Si₃N₄ powder was prepared as a silicon component, AlN powder was prepared as an aluminum component, and MoO₃ powder was prepared as a transition metal component.

These powders of the suitable quantity shown in Table 52 were added to the gallium nitride raw material powder produced in this Example, and they were mixed with ethanol which is a solvent for 24 hours by the ball mill in the wet state, then they were dried and the ethanol was vaporized.

Paraffine wax was added 5 % by weight in these mixed powders after dried, and the powders for moulding were produced, the uniaxial pressing of these powders was carried out under the pressure of 500 kg/cm², and the disk-like powder compacts with the diameter of 32 mm and thickness of 1.5 mm were obtained.

In addition, as the powder for moulding, and the powder compact, those which used only three kinds of gallium nitride raw material powders produced in this Example as they were without adding each above additive component were also produced.

After these powder compacts were degreased at 300°C under the reduced pressure state, they were fired at 1450°C in nitrogen atmosphere for 2 hours, and the gallium nitride-based sintered compacts were obtained.

The sintered compacts after fired became dense to the relative density not less than 99 %, even if which raw material was used.

After mirror-polishing the surfaces of these sintered compacts obtained using the abradant comprising a colloidal silica, the washing was carried out by the ultrasonic wave using acetone and the substrates were produced.

The range of average surface roughness Ra of the mirror-polished sintered compacts was 17-24 nm.

In the sintered compacts obtained, the electric resistivity at room temperature, and the optical permeability to the light with a wavelength of 605nm were measured.

In all the produced gallium nitride-based sintered compacts, the electric resistivity at room temperature was not more than 1x10⁸ Ω·cm as shown in Table 52.

It was confirmed that the gallium nitride-based sintered compacts containing silicon have the conductivity not more than 1x10⁴ Ω·cm.

In the gallium nitride-based sintered compacts containing silicon in the range of 0.00001-10.0 mol % on an element basis, the things in which the electric resistivity at room temperature is at least not more than 1x10³ Ω·cm are easily obtained.

In the gallium nitride-based sintered compacts containing silicon in the range of 0.00001-7.0 mol % on an element basis, the things in which the electric resistivity at room temperature is at least not more than 1x10¹ Ω·cm were obtained.

In the gallium nitride-based sintered compacts containing silicon in the range of 0.00001-5.0 mol % on an element basis, the things in which the electric resistivity at room temperature is at least not more than 1x10⁰ Ω·cm were obtained.

In the gallium nitride-based sintered compacts containing silicon in the range of 0.00001-3.0 mol % on an element basis, the things in which the electric resistivity at room temperature is at least not more than 1x10⁻¹ Ω·cm were obtained.

In the produced gallium nitride-based sintered compacts, what has high conductivity, such that the electric resistivity at room temperature is the lowest 1.4x10⁻³ Ω·cm, were obtained.

Almost all the gallium nitride-based sintered compacts had optical permeability.

Among them, even if the gallium nitride-based sintered compacts comprise substantially only gallium as a metal element without having additives, they had optical permeability.

An alkaline earth metal and a rare earth element component are effective to the optical permeability of the gallium nitride-based sintered compacts, in the gallium nitride-based sintered compacts in which at least one selected from an alkaline earth metal and a rare earth element are contained not more than 30.0 mol % on an oxide basis, the things in which the optical transmissivity is not less than 10% are producible.

In the gallium nitride-based sintered compacts in which at least one selected from the above alkaline earth metal component and rare earth element component are contained not more than 20 mol % on an oxide basis, the optical permeability becomes easily improved, and the things in which the optical transmissivity is not less than 20% were obtained.

In the gallium nitride-based sintered compacts in which at least one selected from an alkaline-earth-metal component and a rare earth element component on an oxide basis are contained not more than 15 mol %, the things in which the optical transmissivity is not less than 30% were obtained.

In the gallium nitride-based sintered compacts in which at least one selected from an alkaline-earth-metal component and a rare earth element component on an oxide basis are contained not more than 10.0 mol %, the things in which the optical transmissivity is not less than 40% were obtained.

In the gallium nitride-based sintered compacts in which at least one selected from an alkaline-earth-metal component and a rare earth element component on an oxide basis are contained not more than 8.0 mol %, the things in which the optical transmissivity is not less than 50% were obtained.

In gallium nitride-based the sintered compacts in which at least one selected from an alkaline-earth-metal component and a rare earth element component on an oxide basis are contained not more than 6.0 mol %, it was confirmed that the things in which the optical transmissivity is not less than 60% were obtained.

In this Example, in the gallium nitride-based sintered compact containing yttrium oxide 0.01 mol % on the basis of Y₂O₃, the highest optical transmissivity was 86 %.

Even if the gallium nitride-based sintered compacts contained an alkaline earth metal component and a rare earth element component, it was confirmed that they had good optical permeability like those containing them separately.

In the gallium nitride-based sintered compacts containing a molybdenum component, those having the optical transmissivity not less than 10% were obtained.

In the gallium nitride-based sintered compacts containing silicon nitride, those having the optical transmissivity not less than 10% were obtained.

In the gallium nitride-based sintered compacts containing aluminum nitride, those having the optical transmissivity not less than 10% were obtained.

In the gallium nitride-based sintered compact being produced in this Example and containing simultaneously silicon nitride 0.01 mol % on a silicon basis and yttrium oxide 0.01 mol % on the basis of Y₂O₃, the optical transmissivity is high as 82 %, and the conductivity is also high like the electric resistivity at room temperature is 1.7x10⁻² Ω·cm.

In the gallium nitride-based sintered compact containing simultaneously a total of three kinds of components which are silicon nitride of 0.01 mol % on a silicon basis, calcium oxide of 0.2 mol % on the basis of CaO, and yttrium oxide of 0.2 mol % on the basis of Y₂O₃, the optical transmissivity is high as 76 %, and the conductivity is also high like the electric resistivity at room temperature is 2.4x10⁻² Ω·cm.

The thin films comprising as a main component at least one selected from gallium nitride, indium nitride and aluminum nitride and having at least one of the crystallization states selected from a single crystal, an amorphous state, a polycrystal, and an orientated polycrystal were formed in the thickness of 3µm on the produced substrates using the sputtering method and the MOCVD method under the same conditions as Example 25, after that.

It was thus confirmed that the single-crystal thin films may clearly be formed directly on the gallium nitride-based sintered compacts produced in this Example.

It was confirmed that the thin films in an amorphous, polycrystalline or orientated polycrystalline state may be formed.

As for the crystallinity of the orientated polycrystal thin films comprising gallium nitride as a main component, the phenomenon of being easy to have a tendency superior to those comprising aluminum nitride as a main component was seen.

Selecting suitably from the substrates in which the thin films of such various crystallization states were formed, the formation of the single-crystal thin films comprising as a main component at least one selected from gallium nitride, indium nitride and aluminum nitride was tried furthermore on them in the thickness of 3 µm.

As a result, in the gallium nitride-based sintered compacts forming beforehand the thin films comprising as a main component at least one selected from gallium nitride, indium nitride and aluminum nitride and having at least one of the crystallization states selected from a single crystal, an amorphous state, a polycrystal, and an orientated polycrystal, it was confirmed that the single-crystal thin films more excellent in crystallinity may be formed.

These results are shown in Table 52.

In addition, the thin films indicated in Table 52 and having at least one of the crystallization states selected from an amorphous state, a polycrystal, and an orientated polycrystal were formed by the sputtering method, and the single-crystal thin films were formed by the MOCVD method.

The sputtering target used at the time of forming the GaN thin films by the sputtering method was produced using the gallium nitride-based sintered compact being produced using the raw material powder produced in this Example by the method of oxide reduction without adding an additive.

As for the production conditions for the GaN thin films by the sputtering method, they were carried out like Example 25, except having used the above gallium nitride-based sintered compact as a sputtering target.

In the gallium nitride-based sintered compacts shown in Table 52, it was confirmed that the single-crystal thin films comprising as a main component at least one selected from gallium nitride, indium nitride and aluminum nitride and being excellent in crystallinity, such that the half width of the rocking curve of the X-ray diffraction from the lattice plane (002) is not more than 300 seconds, can be formed.

When the things in which at least one selected from the above alkaline earth metal component and rare earth element component are contained not more than 30.0 mol % on an oxide basis were used, the single-crystal thin films comprising as a main component at least one selected from gallium nitride, indium nitride and aluminum nitride and are excellent in crystallinity, such that the half width of the rocking curve of the X-ray diffraction from the lattice plane (002) is not more than 200 seconds, can be formed directly on them.

When the gallium nitride-based sintered compacts in which at least one selected from the above alkaline earth metal component and rare earth element component are contained not more than 20 mol % on an oxide basis were used, the single-crystal thin films excellent in crystallinity, such that the half width of the rocking curve of the X-ray diffraction from the lattice plane (002) is not more than 150 seconds, can be formed directly on them.

When the gallium nitride-based sintered compacts in which at least one selected from the above alkaline earth metal component and rare earth element component are contained not more than 10.0 mol % on an oxide basis were used, it was confirmed that the single-crystal thin films excellent in crystallinity, such that the half width of the rocking curve of the X-ray diffraction from the lattice plane (002) is not more than 130 seconds, can be formed directly on them.

Even if the gallium nitride-based sintered compacts contain simultaneously an alkaline earth metal component and a rare earth element component, it was confirmed that the crystallinity of the single-crystal thin films formed on them is good as well as what is respectively contained separately.

In the gallium nitride-based sintered compacts containing a molybdenum component, the single-crystal thin films excellent in crystallinity, such that the half width of the rocking curve of the X-ray diffraction from the lattice plane (002) is not more than 300 seconds, can be formed directly on them.

In the gallium nitride-based sintered compacts containing silicon nitride, the single-crystal thin films excellent in crystallinity, such that the half width of the rocking curve of the X-ray diffraction from the lattice plane (002) is not more than 300 seconds, can be formed directly on them.

In the gallium nitride-based sintered compacts containing aluminum nitride, the single-crystal thin films excellent in crystallirity, such that the half width of the rocking curve of the X-ray diffraction from the lattice plane (002) is not more than 300 seconds, can be formed directly on them.

When the single-crystal thin films comprising as a main component at least one selected from gallium nitride, indium nitride and aluminum nitride were formed on those having beforehand the thin films comprising as a main component at least one selected from gallium nitride, indium nitride and aluminum nitride and being single crystal, amorphous, polycrystal, and orientated polycrystal, using the same gallium nitride-based sintered compacts, the single-crystal thin films in which the crystallinity is superior to the single-crystal thin films formed directly on the gallium nitride-based sintered compacts were obtained.

In this Example, as for the crystallinity of the single-crystal thin films formed on the gallium nitride-based sintered compacts and comprising as a main component at least one selected from gallium nitride, indium nitride and aluminum nitride, it was confirmed that it is easily improved according as the optical permeability of the gallium nitride-based sintered compacts is improved.

In addition, although not shown in Table 52, it was confirmed that the thin films comprising gallium nitride as a main component and having at least one of the crystallization states selected from an amorphous state, a polycrystal, and an orientated polycrystal can be formed suitably on the gallium nitride-based sintered compacts, even if the MOCVD method is used.

As for the crystallinity of the orientated polycrystal thin films formed using the MOCVD method, the half width of the rocking curve of the X-ray diffraction from the lattice plane (002) is 4000-6000 seconds, and it was superior to the case formed using the sputtering method.

In this Example, although all the appearance of the thin films of the constitution indicated in Table 52, and the thin films produced in this Example was investigated, faults, such as a crack and a crevice, are not seen in all the thin films formed beforehand on the substrates and the thin films formed furthermore on them.

Though the exfoliation test was carried out using the pressure sensitive adhesive tape, in all the thin films, exfoliations were not seen between them and the substrates comprising a gallium nitride-based sintered compact, or between thin films.

The thin film-conductive material of Ti/Pt/Au was formed on the thin films of the surface of the substrates, the metal leads were soldered and the perpendicular tensile strength was investigated, but it all is not less than 2 kg/mm², so there are firm unifications between the gallium nitride-based sintered compacts and the thin films formed beforehand on the substrates, and between these thin films and the thin films formed furthermore on them.

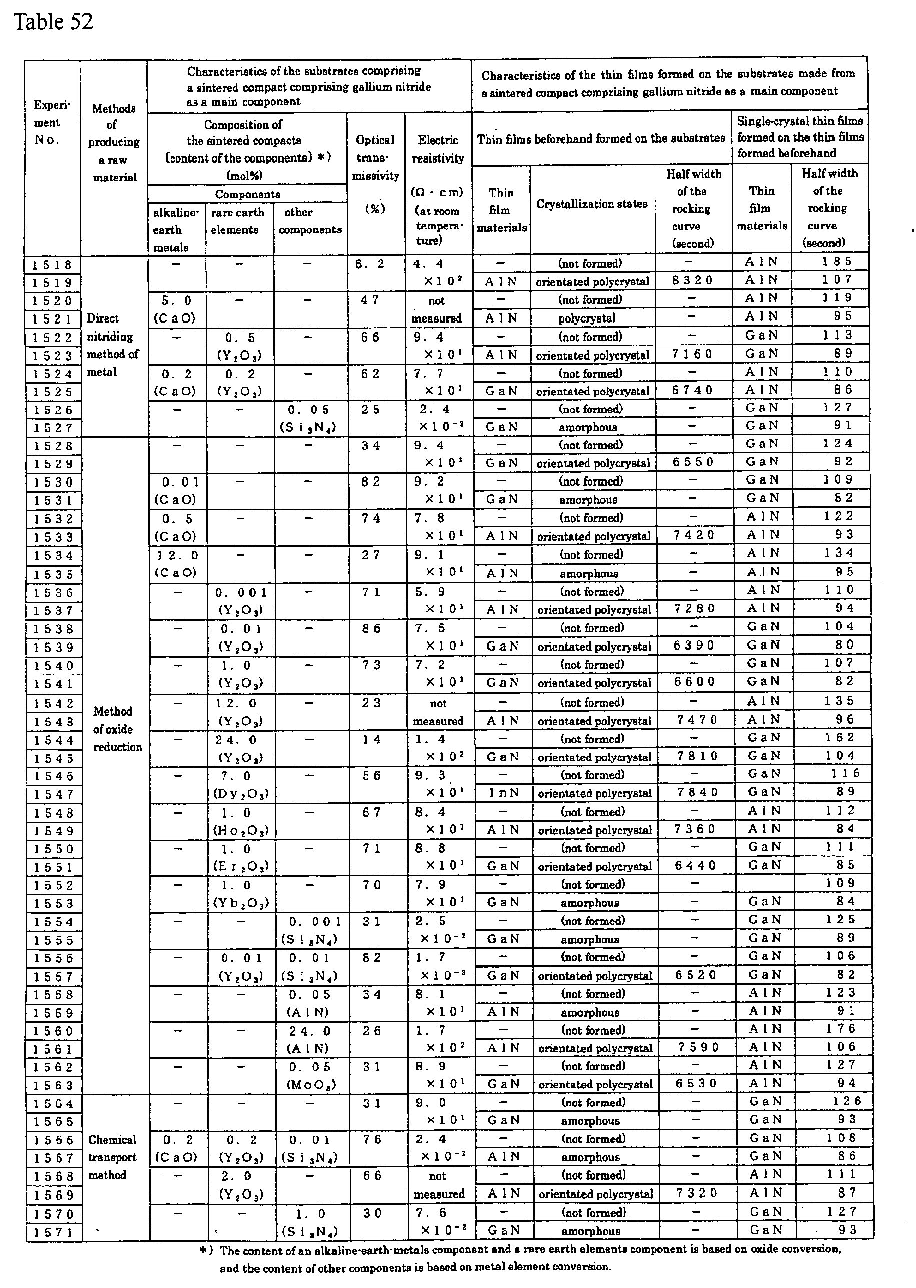

### Example 3 7

This Example shows the examples which investigated about the effect of the optical permeability of the gallium nitride-based sintered compacts exerted on the luminous efficiency of the light-emitting devices produced using the gallium nitride-based sintered compacts, and the effect of the thin films formed on the gallium nitride-based sintered compacts.

Selecting suitably from the gallium nitride-based sintered compacts produced in Example 36, the thin films comprising as a main component at least one selected from gallium nitride, indium nitride and aluminum nitride and having at least one of the crystallization states selected from a single crystal, an amorphous state, a polycrystal, and an orientated polycrystal were formed in the thickness of 3 µm on these sintered compacts using the sputtering method and the MOCVD method under the same conditions as Example 11, and the single crystals comprising as a main component at least one selected from gallium nitride and aluminum nitride were further formed on them in the thickness of 3 µm by the suitable sputtering method and MOCVD method, and the substrates which comprise a gallium nitride-based sintered compact and are used for production of the light-emitting devices were produced.

The formation of the above thin films comprising as a main component at least one selected from gallium nitride or aluminum nitride and having at least one of the crystallization states selected from an amorphous state, a polycrystal, and an orientated polycrystal was carried out by the sputtering method altogether, and the gallium nitride-based sintered compact produced in Example 36 was used as a sputtering target when forming the GaN thin films.

In addition, some gallium nitride-based sintered compact substrates were used without forming a thin film.

Some substrates were not provided with a 2nd-layer single-crystal thin film.

Using the substrates thus produced, the laminates which comprise the thin films comprising as a main component at least one selected from gallium nitride, indium nitride and aluminum nitride and contain at least N-type semiconductor layer, luminescence layer, and P-type semiconductor layer were formed by the same method as Examples 17 and 18, and the light-emitting devices having a single quantum well structure as a luminescence layer were produced.

The luminous efficiency was investigated by impressing the potential of 3.5-3.8 volts into each light-emitting device as well as Examples 17 and 18.

These results are shown in Table 53.

In addition, the actuating current shown in Table 53 is the value at the time of making the light-emitting devices drive on the operating voltage of 3.6 volts.

The light-emitting devices produced with the gallium nitride-based sintered compacts were clearly superior in luminous efficiency to those produced with the sapphire substrate.

And, it was confirmed that the luminous efficiency of the light-emitting devices produced using the gallium nitride-based sintered compacts increases according as the optical permeability of the gallium nitride-based sintered compacts improves.

In the light-emitting devices produced using the gallium nitride-based sintered compacts as they are without forming beforehand the gallium nitride, indium nitride and an aluminum nitride thin film, the luminous efficiency was 10 % or more.

If the gallium nitride-based sintered compacts were used as a substrate, the luminous efficiency of the produced light-emitting devices improved.

It was confirmed that the luminous efficiency of the light-emitting devices formed on these substrates is improved furthermore than those in which only one layer of thin films was formed, if using the substrates of the two layer constitution of thin films in which the single-crystal thin film comprising gallium nitride or aluminum nitride as a main component was formed furthermore on it after the thin film comprising gallium nitride, indium nitride, or aluminum nitride as a main component and having at least one of the crystallization states selected from an amorphous state, a polycrystal, an orientated polycrystal, and a single crystal was formed beforehand on the substrates comprising a gallium nitride-based sintered compact.

In the light-emitting devices produced using the gallium nitride-based sintered compacts forming the thin films comprising at least one selected from gallium nitride, indium nitride, and aluminum nitride as a main component, it was confirmed that there is a tendency wherein the luminous efficiency of the light-emitting devices produced using the gallium nitride-based sintered compacts forming the gallium nitride-based thin films is superior to the luminous efficiency of the light-emitting devices produced using the gallium nitride-based sintered compacts forming the thin films comprising aluminum nitride as a main component.

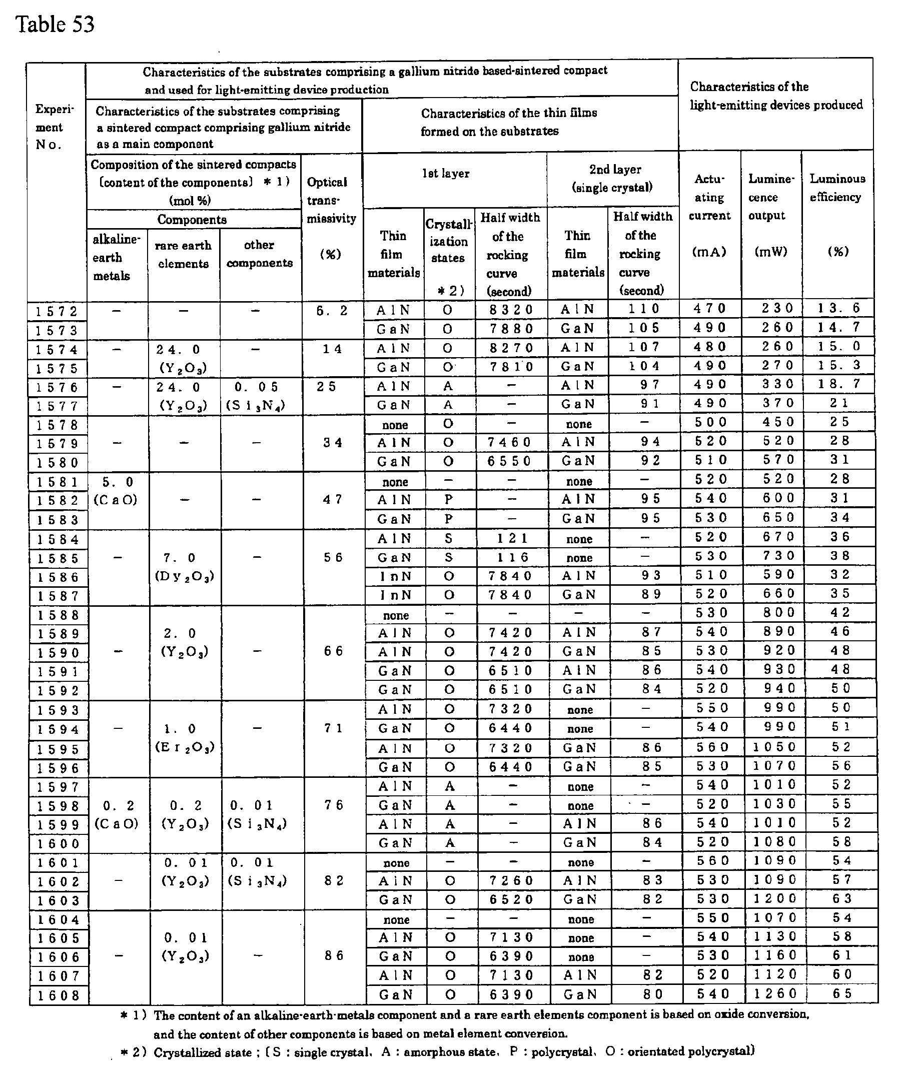

### Example 38

This Example shows the examples which investigated about the effect exerted on the luminous efficiency of the light-emitting devices produced using what formed the thin films comprising gallium nitride as a main component in the ceramic-based sintered compacts, as a substrate.

Here prepared suitably the sintered compacts used in Example 34 and Example 35 and comprising as a main component each aluminum nitride, silicon carbide, silicon nitride, zinc oxide, beryllium oxide, aluminum oxide, zirconium oxide, magnesium oxide, magnesium aluminate, and yttrium oxide, as the substrates for light-emitting device production.

As the surface state of these sintered compacts, those by which the same specular surface polish as what was used in Example 34 and Example 35 was carried out were used as they were.

The thin films comprising as a main component at least one selected from gallium nitride or aluminum nitride and having at least one of the crystallization states selected from an amorphous state, a polycrystal, an orientated polycrystal, and a single crystal were formed in the thickness of 3µm on each sintered compact prepared like this by the sputtering method and the MOCVD method under the same conditions as Example 34, Example 35, and Example 37.

After that, onto these sintered compacts in which these thin films were formed, furthermore the single-crystal thin films comprising as a main component a material selected from gallium nitride or aluminum nitride were suitably formed in the thickness of 3 µm by the same MOCVD method as what was shown in Example 34, 35, and 37, as the thin film of the 2nd layer. In addition, the formation of the above thin films comprising as a main component at least one selected from gallium nitride or aluminum nitride and having at least one of the crystallization states selected from an amorphous state, a polycrystal, and an orientated polycrystal was carried out by the sputtering method altogether, and the gallium nitride-based sintered compact produced in Example 36 was used as a sputtering target when forming the GaN thin films.

There are some not forming the single-crystal thin film of the 2nd layer.

Using the substrates produced like that, the laminates which comprise the thin films comprising at least one selected from gallium nitride, indium nitride and aluminum nitride as a main component and contain at least N type semiconductor layer, luminescence layer, and P type semiconductor layer were formed by the same method as Example 34 and Example 35, and the light-emitting devices having a single quantum well structure as a luminescence layer were produced.

Next, the luminous efficiency was investigated by impressing the potential of 3.5-3.8 volts into each light-emitting device as well as Example 34, Example 35, and Example 37.

These results were shown in Table 54 and 55.

Table 54 is the result about the light-emitting devices produced using the aluminum nitride-based sintered compacts.

Table 55 is the result about the light-emitting devices produced using the sintered compacts comprising as a main component each aluminum nitride, silicon carbide, silicon nitride, zinc oxide, beryllium oxide, aluminum oxide, zirconium oxide, magnesium oxide, magnesium aluminate, and yttrium oxide.

In addition, the actuating current shown in Table 54 and Table 55 is the value at the time of making the light-emitting devices drive on the operating voltage of 3.6 volts.

As a result, as for the luminous efficiency of the light-emitting devices produced using the substrates comprising the sintered compacts forming a gallium nitride thin film or a gallium nitride-based thin film and comprising as a main component each aluminum nitride, silicon carbide, silicon nitride, zinc oxide, beryllium oxide, aluminum oxide, zirconium oxide, magnesium oxide, magnesium aluminate, and yttrium oxide, it was confirmed that it is at least equivalent or superior to the luminous efficiency of the light-emitting devices produced using the substrates comprising each above ceramic-based sintered compact forming a thin film comprising at least one selected from indium nitride and aluminum nitride as a main component.

That is, for example, as for the luminous efficiency of the light-emitting device produced using the aluminum nitride-based sintered compact in which the optical transmissivity is 54 % and which formed a total of two layers of the gallium nitride-based thin films comprising one layer ofthe orientated polycrystal thin film and one layer of the single-crystal thin film, it was improving 6 %, compared with the luminous efficiency of the light-emitting device produced using that in which a total of two layers of the aluminum nitride-based thin films comprising one layer of the orientated polycrystal thin film and one layer of the single-crystal thin film was formed on the same aluminum nitride-based sintered compact in which the optical transmissivity is 54 %.

As for the luminous efficiency of the light-emitting device produced using the zinc oxide-based sintered compact in which the optical transmissivity is 84 % and which formed a total of two layers of the gallium nitride-based thin films comprising one layer of the orientated polycrystal thin film and one layer of the single-crystal thin film, it was improving 10 %, compared with the luminous efficiency of the light-emitting device produced using that in which a total of two layers of the aluminum nitride-based thin films comprising one layer of the orientated polycrystal thin film and one layer of the single-crystal thin film was formed on the same zinc oxide-based sintered compact in which the optical transmissivity is 84 %.

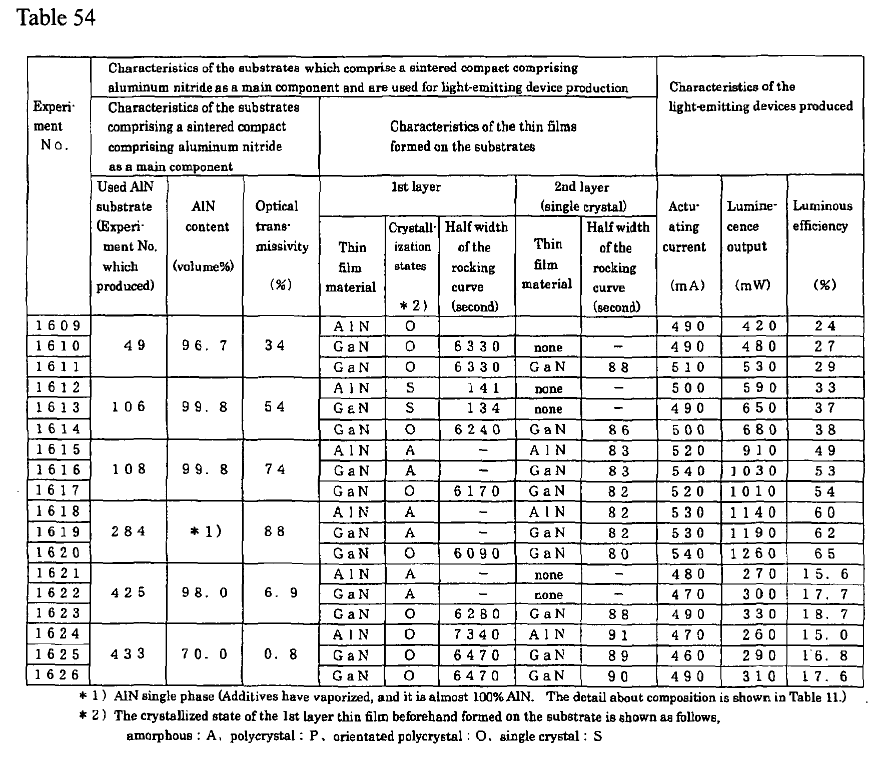

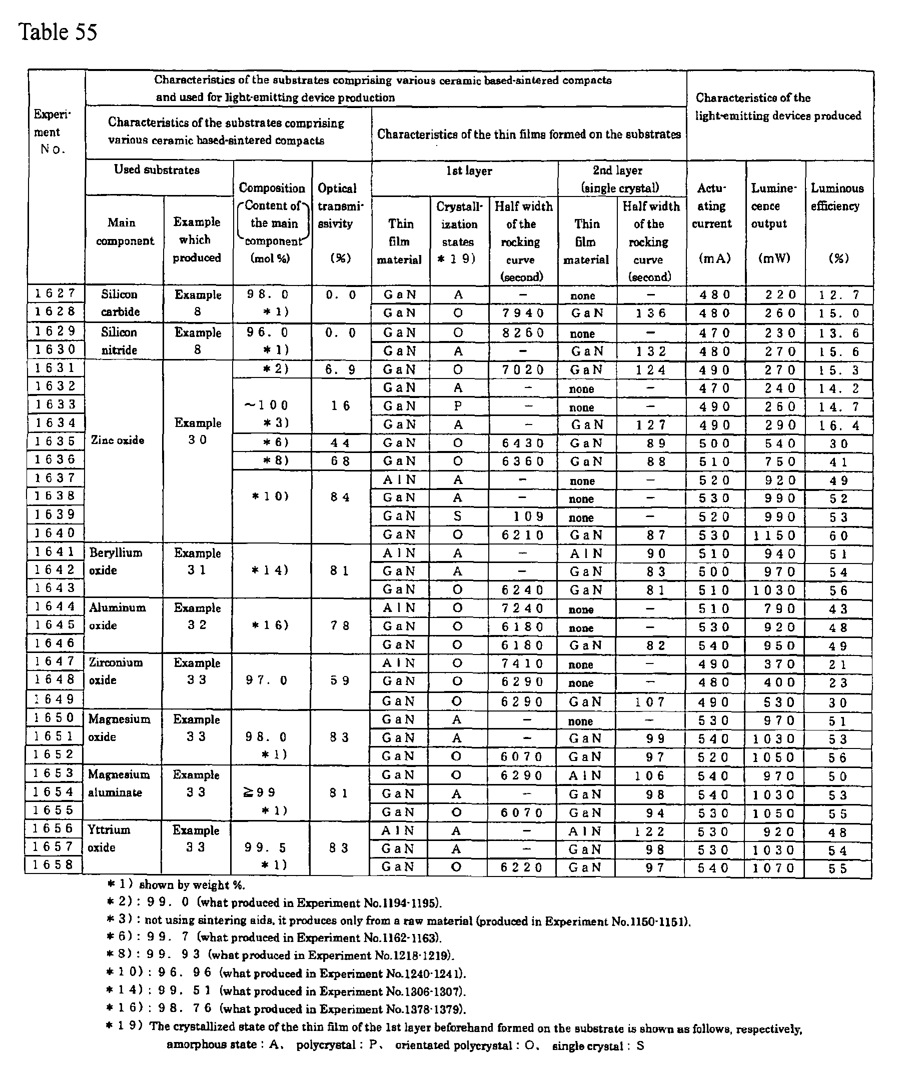

### Example 39

This Example shows the examples which investigated about the effect exerted on the luminous efficiency of the light-emitting devices produced using the ceramic-based sintered compacts having comparatively large surface roughness and used to produce light-emitting devices.

Here suitably prepared the same sintered compacts which were used in Examples 34, 35, 37 and 38 and comprise as a main component each aluminum nitride, silicon carbide, silicon nitride, gallium nitride, zinc oxide, beryllium oxide, aluminum oxide, zirconium oxide, magnesium oxide, magnesium aluminate, and yttrium oxide, as the ceramic-based sintered compacts.

Processing was carried out suitably to the surface of these sintered compacts, to provide those as-fired, those mirror-polished, those sandblasted, those lap-polished, those etched with caustic soda, and those with regular unevenness.

In all the sintered compacts having the as-fired surface state, the surface adhesion things were removed by brush using a commercial alumina powder with the particle size of 3 µm.

The mirror-polished sintered compacts were the same as in Examples 34, 35, 37 and 38.

As for the sandblast polish, in the sintered compacts comprising zinc oxide and gallium nitride as a main component, three kinds of things in which the particle size of alumina abradant is #600, #1200, and #5000 were used, and in the sintered compacts comprising each silicon carbide, silicon nitride, beryllium oxide, aluminum oxide, zirconium oxide, magnesium oxide, magnesium aluminate, and yttrium oxide as a main component, those in which the particle size of alumina abradant is #1200 was used, and they were produced by the methods in which other conditions are the same as Example 29.

In the sintered compacts in which the lap polish was carried out, the silicon carbide abradant with the particle size of #400 was used, and they were produced by the same method as Example 29.

The sintered compacts etched with caustic soda and those lapped with #800 alumina abrasive were immersed in a 5-N caustic soda solution at 90°C for 1 minute and then washed with distilled water.

The sintered compacts with regular unevenness are the things having hollows of regular meshes as deep as 0.5 µm and as wide as 1 µm (projections with the square of 1 µm x 1 µm and the height of 0.5 µm were regularly formed at intervals of 2 µm) by etching with SF₆ + O₂ plasma, after forming the shape of meshes to which the windows of 1 µm width intersected regularly in right angle at intervals of 2 µm by optical lithography, after the commercial resist was applied to each sintered compact. The form is shown in Fig. 73.

The average surface roughness Ra of these sintered compacts was measured. The measurement result is shown in Table 56. The average surface roughness Ra of the ceramic-based sintered compacts was 79-3240 nm.

The thin films comprising as a main component at least one selected from gallium nitride and aluminum nitride and having at least one of the crystallization states selected from an amorphous state and an orientated polycrystal were formed on each ceramic-based sintered compact prepared like this by the sputtering method like Examples 34, 35, 37, and 38, they were made into the thickness of 3 µm by carrying out the specular surface polish, the single-crystal thin films comprising as amain component at least one selected from gallium nitride and aluminum nitride were formed on them in the thickness of 3 µm by the MOCVD method, and the substrates for light-emitting device production were prepared.

In addition, as the sputtering target when forming GaN thin films by the sputtering method, the gallium nitride-based sintered compacts produced in Example 36 were used.

As shown in Table 56, there are some used as a substrate as they are without forming a thin film on each above sintered compact.

There are also things of only one layer of thin films by the sputtering method without forming the single-crystal thin film of the 2nd layer.

The laminates which compris the thin films comprising as a main component at least one selected from gallium nitride, indium nitride and aluminum nitride and contain at least N type semiconductor layer, luminescence layer, and P type semiconductor layer were formed by the same method as Example 34, 35, 37 and 38 onto the single-crystal thin films formed like this.

The light-emitting devices having a single quantum well structure as a luminescence layer were produced by the same method as Examples 34, 35, 37 and 38.

The luminous efficiency was investigated by impressing the potential of 3.5-3.8 volts into each light-emitting device as well as Example 34, 35, 37 and 38.

These results are shown in Table 56.

The actuating current shown in Table 56 is the value at the time of making the light-emitting devices drive on the operating voltage of 3.6 volts.

As a result, as shown in Table 56 in this Example, it was confirmed that the luminous efficiency of the light-emitting devices produced using the ceramic-based sintered compacts having comparatively large surface roughness is at least equivalent compared with the luminous efficiency of the light-emitting devices produced by using those having small surface roughness, even if the ceramic-based sintered compacts are the same things produced in Examples 34, 35, 37 and 38.

For example, as for the luminous efficiency of the light-emitting device produced using the zinc oxide-based sintered compact with enlarged surface roughness produced in this Example and having the same optical transmissivity, it improved 22 % compared with the light-emitting device produced using the zinc oxide-based sintered compact having the optical transmissivity 68 % and having small surface roughness.

In the light-emitting devices produced using the aluminum nitride-based sintered compact having optical transmissivity 88 %, and the gallium nitride-based sintered compact having optical transmissivity 86 %, among the ceramic-based sintered compacts having comparatively large surface roughness, those in which the luminous efficiency is a maximum of 73 % were obtained.

In the light-emitting devices were produced using the zinc oxide-based sintered compact having optical transmissivity 84 %, the magnesium oxide-based sintered compact having optical transmissivity 83 %, the magnesium aluminate-based sintered compact having optical transmissivity 81 %, and the yttrium oxide-based sintered compact having optical transmissivity 83 %, those in which the luminous efficiency is a maximum of 70-71 % were obtained.

In addition to these, in the light-emitting device produced using the beryllium oxide-based sintered compact having optical transmissivity 81%, what has a maximum of 69 % of luminous efficiency was obtained.

In the light-emitting device produced using the aluminum oxide-based sintered compact having optical transmissivity 78 %, what has a maximum of 66 % of luminous efficiency was obtained.

In the light-emitting device produced using the zirconium oxide-based sintered compact having optical transmissivity 59 %, what has a maximum of 44 % of luminous efficiency was obtained.

Also in the light-emitting devices produced using the sintered silicon carbide-based or silicon nitride-based compact having optical transmissivity 0 %, it was confirmed that the luminous efficiency improved a maximum of 20.0 % and 16.4 % respectively, compared with the light-emitting devices produced using the sintered compacts having small surface roughness and produced in Example 38, if the surface roughness is enlarged.

Next, onto all the ceramic-based sintered compacts having various surface roughness and produced in this Example, it tried to form directly the single-crystal thin films comprising as a main component at least one selected from gallium nitride and aluminum nitride by the MOCVD method, as shown in Table 56.

That is, the same MOCVD method as Example 34, 35, 37 and 38 was used, except for the supply method of nitrogen+hydrogen or hydrogen which are the career gas, ammonia which is the reactive gas, and trimethyl gallium or trimethyl aluminum which are the main raw material.

In addition, in the MOCVD method used in Example 34, 35, 37 and 38, the supply of the above main raw material or reactive gas was carried out to the substrates comprising a ceramic-based sintered compact by the method which extends the main raw material and reactive gas in the whole container from the entrance of a silica glass tube which is a reaction container to the direction of an exit, not by the method which supplies from a specific direction, the substrates comprising a ceramic-based sintered compact are put on the inside of a container.

On the other hand, in this Example, at the time of the trial to form directly the single-crystal thin films comprising as a main component at least one selected from gallium nitride and aluminum nitride onto the sintered compacts, the method of supplying the above main raw material and reactive gas from a specific direction to the substrates comprising a ceramic-based sintered compact was used.

That is, as for the aluminum nitride-based sintered compacts, the silicon carbide-based sintered compacts, the silicon nitride-based sintered compacts, the gallium nitride-based sintered compacts, the zinc oxide-based sintered compacts, the beryllium oxide-based sintered compacts, and the aluminum oxide-based sintered compacts, they were put in the reaction container made from silica glass, and the supply tube made from silica glass is independently arranged so that it may become the two directions of perpendicular and 45 degrees to the surface of the substrates comprising these sintered compacts, and trimethyl gallium or trimethyl aluminum which are the main raw material, hydrogen or nitrogen+hydrogen which are the career gas, and furthermore ammonia which is reactive gas were supplied to the substrates comprising each above ceramic-based sintered compact, and formation of single-crystal thin films was tried.

As for the zirconium oxide-based sintered compacts, the magnesium oxide-based sintered compacts, the magnesium aluminate-based sintered compacts, and the yttrium oxide-based sintered compact, the supply tube made from silica glass is independently arranged so that it may become the three directions of perpendicular, parallel, and 45 degrees to the surface of the substrates comprising these sintered compacts, and trimethyl gallium or trimethyl aluminum which are the main raw material, hydrogen or nitrogen+hydrogen which are the career gas, and furthermore ammonia which is reactive gas were supplied to the substrates which comprise each above ceramic-based sintered compact, and formation of single-crystal thin films was tried.

As a result, in all the ceramic-based sintered compacts in which the formation of the thin films was tried, it was confirmed that the single-crystal thin films comprising gallium nitride and aluminum nitride as a main component can be formed directly.

That is, it was confirmed that the single-crystal thin films comprising gallium nitride and aluminum nitride as a main component may be formed directly on the surfaces, even if the ceramic-based sintered compacts have the surface roughness shown in Table 56 at least.

The single-crystal thin films formed were those comparatively excellent in crystallinity, such that the half width of the rocking curve of the X ray diffraction from the lattice plane of the Miller Index (002) is not more than 300 seconds at least.

As the thickness of the thin films formed directly, it was confirmed that those with at least 0.1 nm or more can be formed as a single crystal.

As mentioned above, it was confirmed that the single-crystal thin films comprising as a main component gallium nitride and aluminum nitride and having the various surface roughness shown in Table 56 may be formed directly, even if the thin films having at least one of crystallization states selected from an amorphous state and an orientated polycrystal are not formed beforehand.

That is, in this Example, if the gallium component and aluminum component which are used as a raw material of the thin films are supplied to the surfaces of the substrates comprising a ceramic-based sintered compact so that they may become in at least two directions selected from perpendicular, parallel, and slant, it was confirmed that the single-crystal thin films comprising gallium nitride and aluminum nitride as a main component may be formed directly on the surfaces, even if the ceramic-based sintered compacts having comparatively large surface roughness.

Next, from the various ceramic-based sintered compacts shown in Table 56, selecting the aluminum nitride-based sintered compacts (those with the four kinds of 88%, 74%, 54%, and 34% as optical transmissivity), the gallium nitride-based sintered compacts (two kinds of 86 % and 76 % as optical transmissivity), the aluminum oxide-based sintered compact (78 % as optical transmissivity), the magnesium oxide-based sintered compact (83 % as optical transmissivity), and the yttrium oxide-based sintered compact (83 % as optical transmissivity), the single-crystal thin films comprising as a main component gallium nitride and aluminum nitride are formed directly on all those having the surface state shown in Table 56 about each sintered compact by the MOCVD method described above, then specular surface polish was carried out and they were made into the thickness of 3 µm.

After that, the laminates which comprise the thin films comprising at least one selected from gallium nitride, indium nitride and aluminum nitride as a main component and contain at least N type semiconductor layer, luminescence layer, and P type semiconductor layer were formed on the formed single-crystal thin films by the same method as Example 34, 35, 37 and 38, and the light-emitting devices having a single quantum well structure as a luminescence layer were produced.

Next, the luminous efficiency was investigated by impressing the potential of 3.5-3.8 volts into each light-emitting device as well as Example 34, 35, 37 and 38.

As a result, in the light-emitting devices produced using the aluminum nitride-based sintered compact in which the optical transmissivity is 88 %, the luminous efficiency was 66-72 %.

In the light-emitting devices produced using the aluminum nitride-based sintered compact in which the optical transmissivity is 74 %, the luminous efficiency was 60-62 %.

In the light-emitting devices produced using the aluminum nitride-based sintered compact in which the optical transmissivity is 54 %, the luminous efficiency was 45-51 %.

In the light-emitting devices produced using the aluminum nitride-based sintered compact in which the optical transmissivity is 34 %, the luminous efficiency was 38-41 %.

In the light-emitting devices produced using the gallium nitride-based sintered compact in which the optical transmissivity is 86 %, the luminous efficiency was 67-71 %.

In the light-emitting devices produced using the gallium nitride-based sintered compact in which the optical transmissivity is 76 %, the luminous efficiency was 64-67 %.

In the light-emitting device produced using the aluminum oxide-based sintered compact in which the optical transmissivity is 78 %, the luminous efficiency was 67 % in that in which the blast polish was carried out.

In the light-emitting devices produced using the magnesium oxide-based sintered compact in which the optical transmissivity is 83 %, the luminous efficiency was 68 % in the as-fired thing, and was 70 % in that in which the blast polish was carried out.

In the light-emitting devices produced using the yttrium oxide-based sintered compact in which the optical transmissivity is 83 %, the luminous efficiency was 71 % in that in which the lap polish was carried out, and it was 71 % in that in which the blast polish was carried out.

Thus, formation of the single-crystal thin films comprising gallium nitride and aluminum nitride as a main component is also possible onto the ceramic-based sintered compacts having large surface roughness, and it was confirmed that the light-emitting devices having high luminous efficiency are producible.

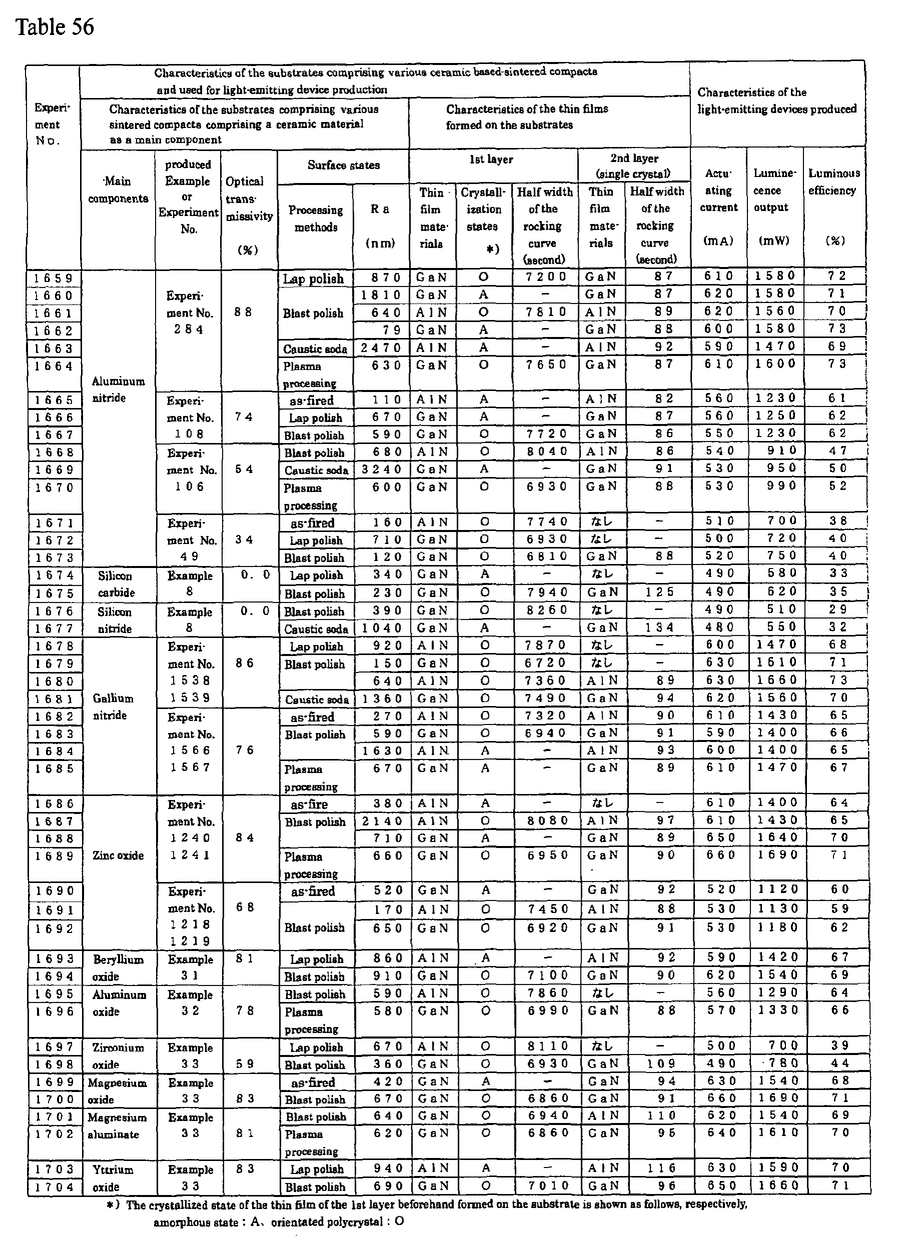

### Example 40

This Example shows the examples which investigated about the effect exerted on the luminous efficiency of the light-emitting devices produced using the ceramic-based sintered compacts having comparatively large surface roughness and used in order to produce the light-emitting devices.

If it says in more detail, the investigation was carried out about the formation state of the single-crystal thin films formed on the ceramic-based sintered compacts having large surface roughness and produced by using the powder compacts with large surface roughness, and in the ceramic-based sintered compacts having large surface roughness and produced by the hot pressing method, and the examples investigated about the effect exerted on the luminous efficiency of the light-emitting devices produced using the ceramic-based sintered compacts having large surface roughness are shown.

First, here prepared the powders for moulding comprising as a main component aluminum nitride, gallium nitride, zinc oxide, beryllium oxide, aluminum oxide, magnesium oxide, magnesium aluminate, and yttrium oxide.

As for the aluminum nitride-based powders for moulding, they are three kinds of things, that produced in the experiment No.49 of Example 2 and containing Y₂O₃ 3.3 volume %, that produced in the experiment No. 108-109 of Example 6 and containing Y₂O₃ 0.2 volume %, and that produced in the experiment No.260-262 of Example 11 using the raw material by the method of oxide reduction and containing Y₂O₃ 1.0 % by weight. As for the gallium nitride-based powders for moulding, they are two kinds of things, that produced in the experiment No.1538-1539 of Example 36 and containing Y₂O₃ 0.01 mol %, and that produced in the experiment No.1566-1567 of Example 36 and containing simultaneously CaO 0.2 mol %, Y₂O₃ 0.2 mol % and Si₃N₄ 0.01 mol %.

As for the zinc oxide-based powders for moulding, they are two kinds of things, that produced in the experiment No.1218-1219 of Example 30 and containing simultaneously Al₂O₃ 0.03 mol % and Y₂O₃ 0.04 mol %, and that produced in the experiment No.1240-1241 of Example 30 and containing simultaneously Al₂O₃ 3.0 mol % and Y₂O₃ 0.04 mol %.

As for the beryllium oxide-based powder for moulding, it is the thing produced in the experiment No.1306-1307 of Example 31 and containing simultaneously CaO 0.45 mol % and Y₂O₃ 0.04 mol %.

As for the aluminum oxide-based powders for moulding, they are two kinds of things, that produced in the experimentNo.1332-1333 of Example 32 and containing MgO 0.12 mol %, and that produced in the experiment No.1376-1377 of Example 32 and containing simultaneously MgO 1.0 mol %, CaO 0.2 mol % and Y₂O₃ 0.04 mol %.

As for the magnesium oxide-based powder for moulding, it is the thing produced in the experiment No.1394-1400 of Example 33 and containing simultaneously CaO 1.0 % by weight and Y₂O₃ 1.0 % by weight.

As for the magnesium aluminate-based powder for moulding, it is the thing produced in the experiment No.1404-1410 of Example 33 and containing simultaneously CaO 0.1 % by weight and Y₂O₃ 0.1 % by weight.

As for the yttrium oxide-based powder for moulding, it is the thing produced in the experiment No.1414-1420 of Example 33 and containing simultaneously Dy₂O₃ 0.25 % by weight and Ho₂O₃ 0.25 % by weight.

Next, here prepared the molding die with the inner diameter of 32 mm made from tungsten carbide and having unevenness with the square where one side is 2µm and the height of 2µm was regularly formed on the up-and-down punch, and the uniaxial press molding was carried out under the pressure of 500 kg/cm² using the above powders for moulding.

As a result, the powder compacts comprising as a main component aluminum nitride, gallium nitride, zinc oxide, beryllium oxide, aluminum oxide, magnesium oxide, magnesium aluminate and yttrium oxide and having unevenness with the square where one side is 2µm and the height of 2µm was regularly formed on the surface like the form given to the molding die were obtained.

The diameter of the powder compacts obtained is 32 mm, and the thickness is 0.6 mm.

Next, each produced powder compact was fired on the conditions shown below after degreasing.

In the case of the aluminum nitride-based powder compacts, in that containing Y₂O₃ 3.3 volume % and that containing Y₂O₃ 0.2 volume %, normal pressure sintering was carried out at 1800°C for 2 hours in 1 atm N₂. In that containing Y₂O₃ 1.0 % by weight, normal pressure sintering was carried out at 2200°C for 8 hours in 1 atm N₂.

In the case of the gallium nitride-based powder compacts, in that having two kinds of composition, normal pressure sintering was carried out at 1450°C for 2 hours in 1 atm N₂.

In the case of the zinc oxide-based powder compacts, in any things having two kinds of composition, normal pressure sintering was carried out at 1460°C for 1 hour in air.

In the case of the beryllium oxide-based powder compact, normal pressure sintering was carried out at 1500°C for 3 hours in air.

In the case of the aluminum oxide-based powder compacts, in that containing MgO 0.12 mol %, normal pressure sintering was carried out at 1820°C for 5 hours in 1 atm hydrogen. In that containing simultaneously MgO 1.0 mol %, CaO 0.2 mol % and Y₂O₃ 0.04 mol %, normal pressure sintering was carried out at 1550°C for 3 hours in air.

In the case of the magnesium oxide-based powder compact, normal pressure sintering was carried out at 1600°C for 6 hours in air.

In the case of the magnesium aluminate-based powder compact, normal pressure sintering was carried out at 1650°C for 8 hours in hydrogen current.

In the case of the yttrium oxide-based powder compact, normal pressure sintering was carried out at 2100°C for 3 hours in hydrogen current.

Each obtained sintered compact was fully made dense.

Next, flush washing of each sintered compact obtained after firing was carried out with the brush, and the adhesion things were removed.

Thus, the sintered compacts of as-fired state comprising as a main component aluminum nitride, gallium nitride, zinc oxide, beryllium oxide, aluminum oxide, magnesium oxide, magnesium aluminate, and yttrium oxide were obtained.

It was confirmed that unevenness with the square where one side is 1.6µm and the height of 1.6µm is being regularly formed in the surface of each sintered compact.

The formed unevenness had the same form as what was illustrated in Fig. 73.

Although the specular surface polish of a part of each sintered compact obtained after that was carried out and the optical transmissivity was measured, it was confirmed that the optical transmissivity is large enough without almost reducing, even if the surface roughness in which concavo-convex form was formed is big.

The result was shown in Table 57.

The aluminum nitride-based green sheet produced by the doctor blade method in Example 3 and containing Er₂O₃ 4.02 volume % was independently prepared.

The aluminum nitride-based green sheet produced by the doctor blade method in Example 14 and containing Y₂O₃ 5.0 % by weight, and the green sheet which comprises aluminum nitride as a main component and contains simultaneously Y₂O₃ 5.0 % by weight and CaO 0.5 % by weight were prepared.

Next, the green sheets produced by the above doctor blade methods were put into the molding die in which unevenness with the square where one side is 2µm and the height of 2µm was regularly formed on the punch, they were heated at 60°C and pressurized under the pressure of 10 kg/cm², and three kinds of the aluminum nitride-based green sheets in which unevenness with the square where one side is 2µm and the height of 2µm was formed on the surface like the form given to the molding die were obtained as a result.

Next, after degreasing these sheet-like compacts in nitrogen, normal pressure sintering was carried out under the conditions at the temperature of 1820°C for 2 hours in 1 atm N₂ in case of the sheet containing Er₂O₃ 4.02 volume %, at 1800°C for 8 hours in 1 atm N₂ in case of the sheet containing Y₂O₃ 5.0 % by weight, and at 2200°C for 4 hours in 1 atm N₂ in case of the sheet containing simultaneously Y₂O₃ 5.0 % by weight and CaO 0.5 % by weight.

Each obtained sintered compact was fully made dense.

Next, flush washing of each sintered compact obtained after firing was carried out with the brush, and the adhesion things were removed.

Thus, the aluminum nitride-based sintered compacts having an as-fired state were obtained.

It was confirmed that unevenness with the square where one side is 1.6µm and the height of 1.6µm is being regularly formed on the surface of each sintered compact.

The formed unevenness had the same form as what was illustrated in Fig. 73.

Although some of each obtained aluminum nitride-based sintered compact were polished into specular surface and the optical transmissivity was measured after that, and it was confirmed that the optical transmissivity is large enough without almost reducing, even if the surface roughness in which concavo-convex form was formed is big.

The result was shown in Table 57.

Next, the high-density graphite mould for hot press having the inner diameter 25.4mm was prepared.

The up-and-down punch of the graphite mould was made into the surface state in which the average surface roughness Ra is 2940nm by the sandblast polish using the alumina abradant with the particle size of #400

The aluminum nitride-based powder for moulding produced in the experiment No. 105-106 of Example 6 and containing CaO 0.2 volume % was prepared independently.

This powder for moulding and the aluminum nitride-based powder for moulding produced in the experiment No. 08-109 of the above Example 6 and containing Y₂O₃ 0.2 volume % were moulded preliminarily into the size with the diameter of 25.4 mm x thickness of 1.0 mm under the pressure of 500 Kg/cm², and were put into the carbon moulding after degreasing, and the hot press was carried out at 1820°C for 4 hours in 1 atm N₂ under the pressure of 300 Kg/cm².

The sintered compacts obtained were fully made dense.

Next, flush washing of each sintered compact obtained after hot press was carried out with the brush, and the adhesion things were removed.

Thus, the aluminum nitride-based sintered compacts of two kinds of composition having an as-fired state were obtained by the hot press method.

As for the average surface roughness Ra of these sintered compacts, it was 3120 nm in case of that produced from the powder for moulding containing CaO 0.2 volume %, and it was 2790 nm in case of that produced from the powder for moulding containing Y₂O₃ 0.2 volume %.

It was confirmed that any sintered compact is almost the same as the surface roughness of the punch of the carbon mould.

Although some of each aluminum nitride-based sintered compact obtained were polished into specular surface and the optical transmissivity was measured after that, it was confirmed that the optical transmissivity is large enough without reducing, even if the surface roughness is big as mentioned above

The result was shown in Table 57.

Formation of the single-crystal thin films comprising gallium nitride and aluminum nitride as a main component was tried by the MOCVD method, using as a substrate the obtained ceramic-based sintered compacts having large surface roughness in the as-fired state and produced using the powder compacts with large surface roughness.

Formation of the single-crystal thin films which comprising gallium nitride and aluminum nitride as a main component was also tried by the MOCVD method, onto the ceramic-based sintered compacts with large surface roughness produced by the hot press method using the carbon mould with large surface roughness.

Formation of the single-crystal thin films was carried out by the two methods described below.

That is, one method is a method, in which formation of the single-crystal thin films comprising gallium nitride and aluminum nitride as a main component is tried by the MOCVD method onto the amorphous thin film or orientated polycrystalline thin film using those forming beforehand the amorphous thin film or orientated polycrystalline thin film comprising gallium nitride or aluminum nitride as a main component by the MOCVD method.

Another method is a method, in which direct formation of the single-crystal thin films comprising gallium nitride and aluminum nitride as a main component is tried by the MOCVD method onto each above ceramic-based sintered compact.

In the above methods, although the MOCVD method was used as the method by which an amorphous thin film or an orientated polycrystal thin film are formed beforehand onto the ceramic-based sintered compacts, this MOCVD method is the same method as what was shown in Example 25 except for having changed the substrate temperature.

That is, the substrate temperature was made into 620°C when the orientated polycrystalline thin films comprising as a main component aluminum nitride are formed.

The substrate temperature was made into 490°C when the amorphous thin films comprising as a main component aluminum nitride are formed.

The substrate temperature was made into 560°C when the orientated polycrystalline thin films comprising as amain component gallium nitride are formed.

Furthermore, the substrate temperature was made into 430°C when the amorphous thin films comprising as a main component gallium nitride are formed.

When formation of the single-crystal thin films comprising as a main component gallium nitride and aluminum nitride is tried onto those forming beforehand the amorphous thin film or orientated polycrystal thin film comprising gallium nitride or aluminum nitride as a main component, supply of the main raw materials, career gases, and reactive gases was carried out by the same method as Example 34, 35, 37 and 38.

On the other hand, when formation of the single-crystal thin films comprising as a main component gallium nitride and aluminum nitride is tried onto each ceramic-based sintered compact, supply of the main raw materials (trimethyl gallium or trimethyl aluminum), career gases (hydrogen, or nitrogen+hydrogen), and reactive gases (ammonia) was carried out by the same method as Example 39.

That is, as for the aluminum nitride-based sintered compacts, the gallium nitride-based sintered compacts, the zinc oxide-based sintered compacts, the beryllium oxide-based sintered compacts, and the aluminum oxide-based sintered compacts, they were put in the reaction container made from silica glass, and the supply tube made from silica glass is independently arranged so that supply of the main raw materials, career gases, and reactive gases may become the two directions of perpendicular and 45 degrees to the surface of the substrates comprising these sintered compacts, and formation of single-crystal thin films was tried.

As for the magnesium oxide-based sintered compacts, the magnesium aluminate-based sintered compacts, and the yttrium oxide-based sintered compact, they were put in the reaction container made from silica glass, and the supply tube made from silica glass is independently arranged so that supply of the main raw materials (trimethyl gallium or trimethyl aluminum), career gases (hydrogen, or nitrogen+hydrogen), and reactive gases (ammonia) may become the three directions of perpendicular, parallel, and 45 degrees to the surface of the substrates comprising these sintered compacts, and formation of single-crystal thin films was tried.

As a result, in addition to those in which the amorphous thin film or orientated polycrystalline thin film comprising gallium nitride or aluminum nitride as a main component were formed beforehand, it was confirmed that the single-crystal thin films comprising as a main component gallium nitride and aluminum nitride may be formed directly onto all the sintered compacts produced in this Example, such as the aluminum nitride-based sintered compacts, the gallium nitride-based sintered compacts, the zinc oxide-based sintered compacts, the beryllium oxide-based sintered compacts, the aluminum oxide-based sintered compacts, the magnesium oxide-based sintered compacts, the magnesium aluminate-based sintered compacts, and the yttrium oxide-based sintered compact.

Even if the single-crystal thin films are those formed directly on each above ceramic-based sintered compact, they were comparatively excellent in crystallinity, such that the half width of the rocking curve of the X ray diffraction from the lattice plane of the Miller Index (002) is not more than 300 seconds at least.

In many of the single-crystal thin films formed directly on each ceramic-based sintered compact, the half width was 100 or less seconds.

In the single-crystal thin films formed directly on the aluminum nitride-based sintered compacts, the gallium nitride-based sintered compacts, the zinc oxide-based sintered compacts, the beryllium oxide-based sintered compacts, and the aluminum oxide-based sintered compacts, which were produced in this Example, it was confirmed that the half width of the rocking curve of the X ray diffraction from the lattice plane of the Miller Index (002) is decreased and that the crystallinity is improving, compared with those formed by supplying by a method in which they spread spontaneously in a reaction container without limiting particularly the supply direction of the main raw material or reactive gas

It can be said that this shows that the single-crystal thin films excellent in crystallinity may be formed on a ceramic-based sintered compact by optimizing more the method of thin film formation, irrespective of the surface state.

This situation is shown in Table 57.

In addition, in Table 57, the thin films of the 1st layer formed directly on the ceramic-based sintered compacts were polished into specular surface, and were made into the thickness of 3 µm.

The thickness of the thin films of the 2nd layer formed on them is 3 µm.

Although the appearance of all the thin films formed on the ceramic-based sintered compacts produced in this Example was investigated, faults, such as a crack and a crevice, are not seen.

Although the exfoliation test was carried out using the pressure sensitive adhesive tape, in all the thin films, exfoliations were not seen between them and the substrates comprising these ceramic-based sintered compacts, or between thin films formed in two layers.

The thin film-conductive material of Ti/Pt/Au was formed on the surface of the thin films produced, the metal leads were soldered and the perpendicular tensile strength was investigated, but it all is not less than 2 Kg/mm², so there are firm unifications between the ceramic-based sintered compacts and each thin film, and between each thin film.

Next, using those in which the single-crystal thin films comprising gallium nitride and aluminum nitride as a main component are formed in the thickness of 3 µm onto the ceramic-based material sintered compacts having large surface roughness in the as-fired state and produced in this Example using the powder compacts with large surface roughness, and using those in which the single-crystal thin films comprising gallium nitride and aluminum nitride as a main component are formed in the thickness of 3 µm onto the ceramic-based sintered compacts having large surface roughness and produced by the hot press method, the light-emitting devices having single quantum well structure were formed, and the luminous efficiency was investigated.

As a result, even if the light-emitting devices were produced using the ceramic-based sintered compacts produced in this Example, the luminous efficiency hardly decreases compared with those in which the surface roughness was made large by processing the once-fired ceramic-based sintered compacts produced in Example 39, and it was confirmed that the light-emitting devices having high luminous efficiency as well as the light-emitting devices produced in Example 39 are producible.

As mentioned above, the results of this Example was collectively shown in Table 57.

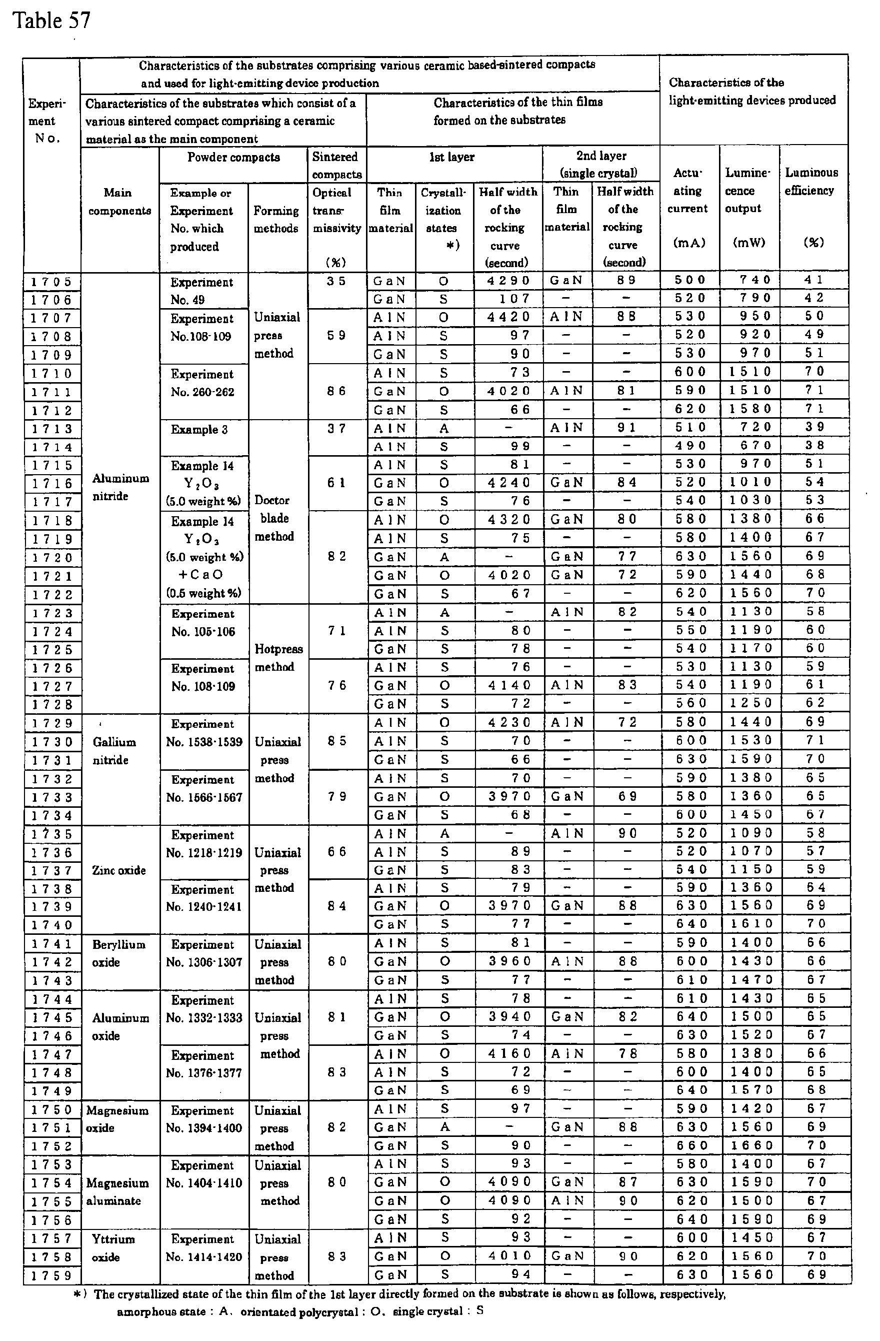

As illustrated in Example 39 and 40, even if the thin films comprising as a main component at least one selected from gallium nitride, indium nitride and aluminum nitride are formed on the ceramic-based sintered compacts with comparatively large surface roughness, the ceramic-based sintered compacts and the thin films are strongly bonded without cracks in these thin films and exfoliation between the ceramic-based sintered compacts and the thin films.

As mentioned above, the present invention was explained in the above Examples.

If this invention is supplemented further, in the sintered compacts of this invention comprising as a main component a ceramic material, such as aluminum nitride, silicon carbide, silicon nitride, gallium nitride, zinc oxide, aluminum oxide, beryllium oxide, zirconium oxide, magnesium oxide, magnesium aluminate, titanium oxide, barium titanate, lead titanate zirconate, rare earth oxides such as yttrium oxide, a thorium dioxide, various ferrites, mullite, forsterite, steatite, and glass, etc., for example, those having optical permeability are obtained, and it has explained since before that the ceramic-based sintered compacts having such optical permeability can be used as a substrate for a thin film, a thin-film substrate, or a substrate for light-emitting device production.

In this invention, "a ceramic-based sintered compact having optical permeability" means usually a ceramic-based sintered compact in which the optical transmissivity is 1 % or more.

But, in the above various sintered compacts comprising as a main component a ceramic material, such as aluminum nitride, silicon carbide, silicon nitride, gallium nitride, zinc oxide, aluminum oxide, beryllium oxide, zirconium oxide, magnesium oxide, magnesium aluminate, titanium oxide, barium titanate, lead titanate zirconate, rare earth oxides such as yttrium oxide, a thorium dioxide, various ferrites, mullite, forsterite, steatite, and glass, etc., for example, even if the optical transmissivity is smaller than 1 % or the optical transmissivity is 0 %, i.e., what does not have optical permeability substantially, they can be used as a substrate for a thin film, a thin-film substrate, or a substrate for light-emitting device production.

Among the above-illustrated ceramic-based sintered compacts having optical permeability, in the various sintered compacts comprising as a main component a ceramic material, such as zirconium oxide, magnesium oxide, magnesium aluminate, titanium oxide, barium titanate, lead titanate zirconate, rare earth oxides such as yttrium oxide, a thorium dioxide, various ferrites, mullite, forsterite, steatite, and glass, etc., for example, while it is usually difficult to form directly a single-crystal thin film comprising as a main component at least one selected from gallium nitride, indium nitride and aluminum nitride in many cases, if forming beforehand a thin film comprising as a main component at least one selected from gallium nitride, indium nitride and aluminum nitride and having at least one of the crystallization states selected from an amorphous state, a polycrystal, an orientated polycrystal, it becomes possible to form a single-crystal thin film comprising as a main component at least one selected from gallium nitride, indium nitride and aluminum nitride, comparatively easily on the above various sintered compacts comprising as a main component a ceramic material, such as zirconium oxide, magnesium oxide, magnesium aluminate, titanium oxide, barium titanate, lead titanate zirconate, rare earth oxides such as yttrium oxide, a thorium dioxide, various ferrites, mullite, forsterite, steatite, and glass, etc., even if the optical transmissivity of these sintered compacts is smaller than 1 % or is 0%.

In this invention, in the ceramic-based sintered compacts forming a thin film of at least one of the crystallization state selected from a single crystal, an amorphous state, a polycrystal, and an orientated polycrystal, it becomes possible to laminate an epitaxially grown thin film comprising as a main component at least one selected from gallium nitride, indium nitride and aluminum nitride even if the optical transmissivity of these sintered compacts is smaller than 1 % or is 0 %, those in which the luminous efficiency is equivalent at least or is superior, if compared with the light-emitting device produced using a conventional sapphire substrate, etc., are producible as a result.

### (Mode of this invention)

As mentioned above, this invention relates to,
1) a substrate for forming a thin film comprising as a main component gallium nitride, indium nitride and aluminum nitride,
2) a material of the above substrate for a thin film,
3) a thin-film substrate in which a thin film comprising as a main component gallium nitride, indium nitride and aluminum nitride was formed,
4) an optical waveguide constituted by the thin film comprising as a main component gallium nitride, indium nitride and aluminum nitride, and
5) a light-emitting device constituted by the thin film comprising as a main component gallium nitride, indium nitride and aluminum nitride.

If it says in detail, this invention relates to,
1) a substrate for forming a thin film comprising as a main component gallium nitride, indium nitride and aluminum nitride,
2) a manufacture method of the substrate for a thin film formation using the aluminum nitride-based sintered compact,
3) an aluminum nitride-based sintered compact having optical permeability,
4) a zinc oxide-based sintered compact having optical permeability,
5) a thin-film substrate in which a thin film comprising as a main component gallium nitride, indium nitride and aluminum nitride is formed,
6) a manufacture method of a thin-film substrate,
7) an optical waveguide constituted by the thin film comprising as a main component gallium nitride, indium nitride and aluminum nitride,
   and
8) a light-emitting device constituted by the thin film comprising as a main component gallium nitride, indium nitride and aluminum nitride.

As explained until now, the mode of this invention includes the following contents.

Details are explained about the mode of this invention below.
Item 1. A substrate for a thin film in which a single-crystal thin film comprises at least one selected from gallium nitride, indium nitride and aluminum nitride as a main component, and the substrate comprises a ceramic-based sintered compact.
Item 2. The substrate for a thin film as described in Item 1, wherein a single-crystal thin film comprises at least one selected from gallium nitride, indium nitride and aluminum nitride as a main component, and the substrate comprises a ceramic-based sintered compact forming a thin film comprising as a main component at least one selected from gallium nitride, indium nitride and aluminum nitride.
Item 3. The substrate for a thin film as described in Item 2, wherein the thin film comprising as a main component at least one selected from gallium nitride, indium nitride and aluminum nitride and formed on a ceramic-based sintered compact has at least one of the crystallization states selected from an amorphous state, a polycrystal, an orientated polycrystal, and a single crystal
Item 4. The substrate for a thin film as described in Item 2 or 3, wherein a part of the thin film comprising as a main component at least one selected from gallium nitride, indium nitride and aluminum nitride and formed on a ceramic-based sintered compact is a single crystal at least.
Item 5. The substrate for a thin film as described in any one of Items 2-4, wherein the thin film comprising as a main component at least one selected from gallium nitride, indium nitride and aluminum nitride and formed on a ceramic-based sintered compact is constituted with one layer.
Item 6. The substrate for a thin film as described in any one of Items 2-4, wherein the thin film comprising as a main component at least one selected from gallium nitride, indium nitride and aluminum nitride and formed on a ceramic-based sintered compact is constituted with at least two layers.
Item 7. The substrate for a thin film as described in Item 6, wherein the thin film comprising as a main component at least one selected from gallium nitride, indium nitride and aluminum nitride and formed on a ceramic-based sintered compact is constituted with at least two layers, and each layer has at least one of the crystallization states selected from an amorphous state, a polycrystal, an orientated polycrystal, and a single crystal.
Item 8. The substrate for a thin film as described in Item 6 or 7, wherein the thin film comprising as a main component at least one selected from gallium nitride, indium nitride and aluminum nitride and formed on a ceramic-based sintered compact is constituted with at least two layers, and the thin film layer formed on the ceramic-based sintered compact has at least one of the crystallization states selected from an amorphous state, a polycrystal, an orientated polycrystal, and a single crystal.
Item 9. The substrate for a thin film as described in any one of Items 6-8, wherein the thin film comprising as a main component at least one selected from gallium nitride, indium nitride and aluminum nitride and formed on a ceramic-based sintered compact is constituted with at least two layers, and the thin film layer formed on the ceramic-based sintered compact has at least one of the crystallization states selected from an amorphous state, a polycrystal, and an orientated polycrystal.
Item 10. The substrate for a thin film as described in any one of Items 6-9, wherein the thin film comprising as a main component at least one selected from gallium nitride, indium nitride and aluminum nitride and formed on a ceramic-based sintered compact is constituted with at least two layers, and the thin film layer formed directly on the ceramic-based sintered compact is an orientated polycrystal.
Item 11. The substrate for a thin film as described in any one of Items 6-10, wherein the thin film comprising as a main component at least one selected from gallium nitride, indium nitride and aluminum nitride and formed on a ceramic-based sintered compact is constituted with at least two layers, and at least one layer is a single crystal.
Item 12. The substrate for a thin film as described in any one of Items 6-11, wherein the thin film comprising as a main component at least one selected from gallium nitride, indium nitride and aluminum nitride and formed on a ceramic-based sintered compact is constituted with at least two layers, and the thin film of the top layer is a single crystal.
Item 13. The substrate for a thin film as described in any one of Items 2-12, wherein the thin film comprising as a main component at least one selected from gallium nitride, indium nitride and aluminum nitride and formed on a ceramic-based sintered compact has a single-crystal thin film layer at least, and the thickness of the single-crystal thin film layer is less than 300 µm.
Item 14. The substrate for a thin film as described in any one of Items 2-13, wherein the thin film formed on a ceramic-based sintered compact has the thickness at least not less than 0.1 nm.
Item 15. The substrate for a thin film as described in any one of Items 2-14, wherein the thin film formed on a ceramic-based sintered compact has the thin film containing gallium nitride at least or comprising gallium nitride as a main component.
Item 16. The substrate for a thin film as described in any one of Items 2-15, wherein the half width of the rocking curve of the X ray diffraction from the lattice plane of the Miller Index (002) of the single-crystal thin film formed on a ceramic-based sintered compact is not more than 3600 seconds.
Item 17. The substrate for a thin film as described in Item 16, wherein the half width of the rocking curve of the X ray diffraction from the lattice plane of the Miller Index (002) of the single-crystal thin film formed on a ceramic-based sintered compact is not more than 300 seconds.
Item 18. The substrate for a thin film as described in any one of Items 1-17, wherein the substrate comprises a ceramic-based sintered compact having the average surface roughness Ra not more than 2000 nm.
Item 19. The substrate for a thin film as described in Item 18, wherein the average surface roughness Ra of the ceramic-based sintered compact is not more than 1000 nm. Item 20. The substrate for a thin film as described in Item 18 or 19, wherein the average surface roughness Ra of the ceramic-based sintered compact is not more than 100 nm.
Item 21. The substrate for a thin film as described in any one of Items 18-20, wherein the average surface roughness Ra of the ceramic-based sintered compact is not more than 20 nm.
Item 22. The substrate for a thin film as described in any one of Items 18-21, wherein the average surface roughness Ra of the ceramic-based sintered compact is not more than 5 nm.
Item 23. The substrate for a thin film as described in any one of Items 1-20, wherein the substrate comprises a ceramic-based sintered compact having large surface roughness.
Item 24. The substrate for a thin film as described in any one of Items 1-20 and 23, wherein the substrate comprises a ceramic-based sintered compact having the average surface roughness Ra not less than 70 nm.
Item 25. The substrate for a thin film as described in Item 24, wherein the average surface roughness Ra of the ceramic-based sintered compact is more than 1000 nm.
Item 26. The substrate for a thin film as described in Item 24 or 25, wherein the average surface roughness Ra of the ceramic-based sintered compact is more than 2000 nm.
Item 27. The substrate for a thin film as described in any one of Items 1-26, wherein the surface of the ceramic-based sintered compact is at least one of the states selected from an as-fired state, a state in which lap polish was carried out, a state in which blast polish was carried out, a state in which specular surface polish was carried out, a state in which chemistry corrosion was carried out, and a state corroded by plasma gas.
Item 28. A substrate for a thin film in which the thin film comprises as a main component at least one selected from gallium nitride, indium nitride and aluminum nitride, and the substrate comprises a ceramic-based sintered compact having optical permeability.
Item 29. The substrate for a thin film as described in Item 28, wherein the thin film comprising as a main component at least one selected from gallium nitride, indium nitride and aluminum nitride and formed on the substrate for a thin film comprising a ceramic-based sintered compact having optical permeability has at least one of the crystallization states selected from an amorphous state, a polycrystal, an orientated polycrystal, and a single crystal.
Item 30. The substrate for a thin film as described in Item 28 or 29, wherein a part of the thin film comprising as a main component at least one selected from gallium nitride, indium nitride and aluminum nitride and formed on the substrate for a thin film comprising a ceramic-based sintered compact having optical permeability is a single crystal at least.
Item 31. The substrate for a thin film as described in any one of Items 28-30, wherein the thin film comprises at least one selected from gallium nitride, indium nitride and aluminum nitride as a main component, and the substrate comprises a ceramic-based sintered compact having optical permeability and forming a thin film comprising as a main component at least one selected from gallium nitride, indium nitride and aluminum nitride.
Item 32. The substrate for a thin film as described in Item 31, wherein the thin film comprising as a main component at least one selected from gallium nitride, indium nitride and aluminum nitride and formed on a ceramic-based sintered compact having optical permeability has at least one of the crystallization states selected from an amorphous state, a polycrystal, an orientated polycrystal, and a single crystal.
Item 33. The substrate for a thin film as described in Item 31 or 32, wherein a part of the thin film comprising as a main component at least one selected from gallium nitride, indium nitride and aluminum nitride and formed on a ceramic-based sintered compact having optical permeability is a single crystal at least.
Item 34. The substrate for a thin film as described in any one of Items 31-33, wherein the thin film comprising as a main component at least one selected from gallium nitride, indium nitride and aluminum nitride and formed on a ceramic-based sintered compact having optical permeability is constituted with one layer.
Item 35. The substrate for a thin film as described in any one of Items 31-33, wherein the thin film comprising as a main component at least one selected from gallium nitride, indium nitride and aluminum nitride and formed on a ceramic-based sintered compact having optical permeability is constituted with at least two layers.
Item 36. The substrate for a thin film as described in Item 35, wherein the thin film comprising as a main component at least one selected from gallium nitride, indium nitride and aluminum nitride and formed on a ceramic-based sintered compact having optical permeability is constituted with at least two layers, and each layer has at least one of the crystallization states selected from an amorphous state, a polycrystal, an orientated polycrystal, and a single crystal.
Item 37. The substrate for a thin film as described in Item 35 or 36, wherein the thin film comprising as a main component at least one selected from gallium nitride, indium nitride and aluminum nitride and formed on a ceramic-based sintered compact having optical permeability is constituted with at least two layers, and the thin film layer formed on the ceramic-based sintered compact having optical permeability has at least one of the crystallization states selected from an amorphous state, a polycrystal, an orientated polycrystal, and a single crystal.
Item 38. The substrate for a thin film as described in any one of Items 35-37, wherein the thin film comprising as a main component at least one selected from gallium nitride, indium nitride and aluminum nitride and formed on a ceramic-based sintered compact having optical permeability is constituted with at least two layers, and the thin film layer formed on the ceramic-based sintered compact having optical permeability has at least one of the crystallization states selected from an amorphous state, a polycrystal, and an orientated polycrystal.
Item 39. The substrate for a thin film as described in any one of Items 35-38, wherein the thin film comprising as a main component at least one selected from gallium nitride, indium nitride and aluminum nitride and formed on a ceramic-based sintered compact having optical permeability is constituted with at least two layers, and the thin film layer formed on the ceramic-based sintered compact having optical permeability is an orientated polycrystal.
Item 40. The substrate for a thin film as described in any one of Items 35-39, wherein the thin film comprising as a main component at least one selected from gallium nitride, indium nitride and aluminum nitride and formed on a ceramic-based sintered compact having optical permeability is constituted with at least two layers, and at least one layer is a single crystal.
Item 41. The substrate for a thin film as described in any one of Items 35-40, wherein the thin film comprising as a main component at least one selected from gallium nitride, indium nitride and aluminum nitride and formed on a ceramic-based sintered compact having optical permeability is constituted with at least two layers, and the thin film of the top layer is a single crystal.
Item 42. The substrate for a thin film as described in any one of Items 31-41, wherein the thin film comprising as a main component at least one selected from gallium nitride, indium nitride and aluminum nitride and formed on a ceramic-based sintered compact having optical permeability has a single-crystal thin film layer at least, and the thickness of the single-crystal thin film layer is less than 300 µm.
Item 43. The substrate for a thin film as described in any one of Items 31-42, wherein the thin film formed on a ceramic-based sintered compact having optical permeability has the thickness at least not less than 0.1 nm.
Item 44. The substrate for a thin film as described in any one of Items 31-43, wherein the thin film formed on a ceramic-based sintered compact having optical permeability has the thin film containing gallium nitride at least or comprising gallium nitride as a main component.
Item 45. The substrate for a thin film as described in any one of Items 31-44, wherein the half width of the rocking curve of the X ray diffraction from the lattice plane of the Miller Index (002) of the single-crystal thin film formed on a ceramic-based sintered compact having optical permeability is not more than 3600 seconds.
Item 46. The substrate for a thin film as described in Item 45, wherein the half width of the rocking curve of the X ray diffraction from the lattice plane of the Miller Index (002) of the single-crystal thin film formed on a ceramic-based sintered compact having optical permeability is not more than 300 seconds.
Item 47. The substrate for a thin film as described in any one of Items 28-46, wherein the substrate comprises a ceramic-based sintered compact having optical permeability and having the average surface roughness Ra not more than 2000 nm.
Item 48. The substrate for a thin film as described in Item 47, wherein the average surface roughness Ra of the ceramic-based sintered compact having optical permeability is not more than 1000 nm.
Item 49. The substrate for a thin film as described in Item 47 or 48, wherein the average surface roughness Ra of the ceramic-based sintered compact having optical permeability is not more than 100 nm.
Item 50. The substrate for a thin film as described in any one of Items 47-49, wherein the average surface roughness Ra of the ceramic-based sintered compact having optical permeability is not more than 20 nm.

Item 51. The substrate for a thin film as described in any one of Items 47-50, wherein the average surface roughness Ra of the ceramic-based sintered compact having optical permeability is not more than 5 nm.
Item 52. The substrate for a thin film as described in any one of Items 28-49, wherein the substrate comprises a ceramic-based sintered compact having optical permeability and having large surface roughness.
Item 53. The substrate for a thin film as described in any one of Items 28-49 and 52, wherein the substrate comprises a ceramic-based sintered compact having optical permeability and having the average surface roughness Ra not less than 70 nm.
Item 54. The substrate for a thin film as described in Item 53, wherein the average surface roughness Ra of the ceramic-based sintered compact having optical permeability is more than 1000 nm.
Item 55. The substrate for a thin film as described in Item 53 or 54, wherein the average surface roughness Ra of the ceramic-based sintered compact having optical permeability is more than 2000 nm.
Item 56. The substrate for a thin film as described in any one of Items 28-55, wherein the surface of the ceramic-based sintered compact having optical permeability is at least one of the states selected from an as-fired state, a state in which lap polish was carried out, a state in which blast polish was carried out, a state in which specular surface polish was carried out, a state in which chemistry corrosion was carried out, and a state corroded by plasma gas.
Item 57. The substrate for a thin film as described in any one of Items 1-56, wherein the ceramic-based sintered compact or the ceramic-based sintered compact having optical permeability has the optical transmissivity not less than 1 %.
Item 58. The substrate for a thin film as described in Item 57, wherein the ceramic-based sintered compact or the ceramic-based sintered compact having optical permeability has the optical transmissivity not less than 10 %.
Item 59. The substrate for a thin film as described in Item 57 or 58, wherein the ceramic-based sintered compact or the ceramic-based sintered compact having optical permeability has the optical transmissivity not less than 20 %.
Item 60. The substrate for a thin film as described in any one of Items 57-59, wherein the ceramic-based sintered compact or the ceramic-based sintered compact having optical permeability has the optical transmissivity not less than 30 %.
Item 61. The substrate for a thin film as described in any one of Items 57-60, wherein the ceramic-based sintered compact or the ceramic-based sintered compact having optical permeability has the optical transmissivity not less than 40 %.
Item 62. The substrate for a thin film as described in any one of Items 57-61, wherein the ceramic-based sintered compact or the ceramic-based sintered compact having optical permeability has the optical transmissivity not less than 50 %.
Item 63. The substrate for a thin film as described in any one of Items 57-62, wherein the ceramic-based sintered compact or the ceramic-based sintered compact having optical permeability has the optical transmissivity not less than 60 %.
Item 64. The substrate for a thin film as described in any one of Items 57-63, wherein the ceramic-based sintered compact or the ceramic-based sintered compact having optical permeability has the optical transmissivity not less than 80 %.
Item 65. The substrate for a thin film as described in any one of Items 1-56, wherein the ceramic-based sintered compact or the ceramic-based sintered compact having optical permeability has the optical transmissivity less than 1 %.
Item 66. The substrate for a thin film as described in Item 65, wherein the optical transmissivity of the ceramic-based sintered compact is 0 %.
Item 67. The substrate for a thin film as described in any one of Items 28-66, wherein the optical permeability or optical transmissivity is that to the light of the range of 200-800 nm wavelength at least.
Item 68. The substrate for a thin film as described in any one of Items 1-67, wherein the ceramic-based sintered compact, and the ceramic-based sintered compact having optical permeability, are respectively at least one of the things selected from an aluminum nitride-based sintered compact, a sintered compact comprising as a main component a ceramic material having at least one of the crystal structures selected from a hexagonal system or a trigonal system, and a sintered compact which comprises as a main component at least one selected from zirconium oxide, magnesium oxide, magnesium aluminate, titanium oxide, barium titanate, lead titanate zirconate, a rare earth oxide, thorium oxide, various ferrites, mullite, forsterite, steatite, and glass.
Item 69. The substrate for a thin film as described in Item 68, wherein the sintered compact comprising as a main component a ceramic material having at least one of the crystal structures selected from a hexagonal system or a trigonal system is a sintered compact which comprises as a main component at least one selected from zinc oxide, beryllium oxide, aluminum oxide, silicon carbide, silicon nitride, and gallium nitride.
Item 70. The substrate for a thin film as described in Item 68 or 69, wherein the ceramic-based sintered compact, and the ceramic-based sintered compact having optical permeability, are respectively a sintered compact which comprises as a main component at least one selected from aluminum nitride, zinc oxide, beryllium oxide, aluminum oxide, silicon carbide, silicon nitride, gallium nitride, zirconium oxide, magnesium oxide, magnesium aluminate, and yttrium oxide.
Item 71. The substrate for a thin film as described in any one of Items 1-70, wherein the ceramic-based sintered compact, and the ceramic-based sintered compact having optical permeability, are respectively an aluminum nitride-based sintered compact. Item 72. The substrate for a thin film as described in Item 71, wherein the aluminum nitride-based sintered compact has optical permeability.
Item 73. The substrate for a thin film as described in Item 71 or 72, wherein the optical transmissivity of the aluminum nitride-based sintered compact is not less than 1 %. Item 74. The substrate for a thin film as described in any one of Items 71-73, wherein the optical transmissivity of the aluminum nitride-based sintered compact is not less than 5 %.
Item 75. The substrate for a thin film as described in any one of Items 71-74, wherein the optical transmissivity of the aluminum nitride-based sintered compact is not less than 10 %.
Item 76. The substrate for a thin film as described in any one of Items 71-75, wherein the optical transmissivity of the aluminum nitride-based sintered compact is not less than 20 %.
Item 77. The substrate for a thin film as described in any one of Items 71-76, wherein the optical transmissivity of the aluminum nitride-based sintered compact is not less than 30 %.
Item 78. The substrate for a thin film as described in any one of Items 71-77, wherein the optical transmissivity of the aluminum nitride-based sintered compact is not less than 40 %.
Item 79. The substrate for a thin film as described in any one of Items 71-78, wherein the optical transmissivity of the aluminum nitride-based sintered compact is not less than 50 %.
Item 80. The substrate for a thin film as described in any one of Items 71-79, wherein the optical transmissivity of the aluminum nitride-based sintered compact is not less than 60 %.
Item 81. The substrate for a thin film as described in any one of Items 71-80, wherein the optical transmissivity of the aluminum nitride-based sintered compact is not less than 80 %.
Item 82. The substrate for a thin film as described in any one of Items 71-81, wherein the optical transmissivity of the aluminum nitride-based sintered compact is not less than 85 %.
Item 83. The substrate for a thin film as described in Item 71 or 72, wherein the optical transmissivity of the aluminum nitride-based sintered compact is less than 1 %.
Item 84. The substrate for a thin film as described in Item 83, wherein the optical transmissivity of the aluminum nitride-based sintered compact is 0 %.
Item 85. The substrate for a thin film as described in any one of Items 72-84, wherein the optical permeability or optical transmissivity is that to the light of the range of 200-800 nm wavelength at least.
Item 86. The substrate for a thin film as described in any one of Items 71-85, wherein the thin film comprises at least one selected from gallium nitride, indium nitride and aluminum nitride as a main component, and the substrate comprises an aluminum nitride-based sintered compact on which a thin film comprising as a main component at least one selected from gallium nitride, indium nitride and aluminum nitride is formed. Item 87. The substrate for a thin film as described in Item 86, wherein the thin film comprising as a main component at least one selected from gallium nitride, indium nitride and aluminum nitride and formed on the aluminum nitride-based sintered compact has at least one of the crystallization states selected from a single crystal, an amorphous state, a polycrystal, and an orientated polycrystal.
Item 88. The substrate for a thin film as described in any one of Items 71-87, wherein the aluminum nitride-based sintered compact contains aluminum nitride not less than 20 volume %.
Item 89. The substrate for a thin film as described in Item 88, wherein the aluminum nitride-based sintered compact contains aluminum nitride not less than 50 volume %.
Item 90. The substrate for a thin film as described in any one of Items 71-89, wherein the aluminum nitride-based sintered compact contains at least one selected from a rare earth element or an alkaline-earth metal not more than 80 volume % on an oxide basis.
Item 91. The substrate for a thin film as described in Item 90, wherein the aluminum nitride-based sintered compact contains at least one selected from a rare earth element or an alkaline-earth metal not more than 50 volume % on an oxide basis.
Item 92. The substrate for a thin film as described in Item 90 or 91, wherein the aluminum nitride-based sintered compact contains at least one selected from a rare earth element or an alkaline-earth metal not more than 25 volume % on an oxide basis.
Item 93. The substrate for a thin film as described in any one of Items 90-92, wherein the aluminum nitride-based sintered compact contains simultaneously at least one selected from a rare earth element and at least one selected from an alkaline-earth metal.
Item 94. The substrate for a thin film as described in any one of Items 71-93, wherein the aluminum nitride-based sintered compact contains at least one selected from an alkaline metal or silicon not more than 50 volume % on an oxide basis.
Item 95. The substrate for a thin film as described in Item 94, wherein the aluminum nitride-based sintered compact contains at least one selected from an alkaline metal or silicon not more than 30 volume % on an oxide basis.
Item 96. The substrate for a thin film as described in Item 94 or 95, wherein the aluminum nitride-based sintered compact contains at least one selected from an alkaline metal or silicon not more than 20 volume % on an oxide basis.
Item 97. The substrate for a thin film as described in any one of Items 94-96, wherein the aluminum nitride-based sintered compact contains at least one selected from an alkaline metal or silicon not more than 10 volume % on an oxide basis.
Item 98. The substrate for a thin film as described in any one of Items 90-97, wherein the aluminum nitride-based sintered compact contains at least one selected from an alkaline metal or silicon and contains simultaneously at least one selected from a rare earth element or an alkaline-earth metal.
Item 99. The substrate for a thin film as described in any one of Items 71-98, wherein the aluminum nitride-based sintered compact contains at least one selected from Mo, W, V (vanadium), Nb, Ta, Ti, and carbon not more than 80 volume % on an element basis.

Item 100. The substrate for a thin film as described in Item 99, wherein the aluminum nitride-based sintered compact contains at least one selected from Mo, W, V (vanadium), Nb, Ta, Ti, and carbon not more than 50 volume % on an element basis.
Item 101. The substrate for a thin film as described in Item 99 or 100, wherein the aluminum nitride-based sintered compact contains at least one selected from Mo, W, V, Nb, Ta, Ti, and carbon not more than 25 volume % on an element basis.
Item 102. The substrate for a thin film as described in any one of Items 90-93 and 99-101, wherein the aluminum nitride-based sintered compact contains at least one selected from Mo, W, V, Nb, Ta, Ti, and carbon and contains simultaneously at least one selected from a rare earth element or an alkaline-earth metal.
Item 103. The substrate for a thin film as described in any one of Items 71-102, wherein the aluminum nitride-based sintered compact contains a transition-metals-component except a rare earth element and Mo, W, V (vanadium), Nb, Ta, and Ti in not more than 80 volume % on an element basis.
Item 104. The substrate for a thin film as described in Item 103, wherein the aluminum nitride-based sintered compact contains a transition-metals-component except a rare earth element and Mo, W, V (vanadium), Nb, Ta, and Ti in not more than 50 volume % on an element basis.
Item 105. The substrate for a thin film as described in Item 103 or 104, wherein the aluminum nitride-based sintered compact contains a transition-metals-component except a rare earth element and Mo, W, V, Nb, Ta, and Ti in not more than 30 volume % on an element basis.
Item 106. The substrate for a thin film as described in any one of Items 90-93 and 103-105, wherein the aluminum nitride-based sintered compact contains a transition-metals-component except a rare earth element and Mo, W, V, Nb, Ta, and Ti and contains simultaneously at least one selected from a rare earth element or an alkaline-earth metal.
Item 107. The substrate for a thin film as described in any one of Items 103-106, wherein the transition-metals-component except a rare earth element and Mo, W, V, Nb, Ta, and Ti is at least one selected from iron, nickel, chromium, manganese, zirconium, hafnium, cobalt, copper, and zinc.
Item 108. The substrate for a thin film as described in any one of Items 71-107, wherein the aluminum nitride-based sintered compact contains oxygen not more than 30 % by weight.
Item 109. The substrate for a thin film as described in Item 108, wherein the aluminum nitride-based sintered compact contains oxygen not more than 20 % by weight.
Item 110. The substrate for a thin film as described in Item 108 or 109, wherein the aluminum nitride-based sintered compact contains oxygen not more than 10 % by weight.
Item 111. The substrate for a thin film as described in any one of Items 90-93 and 108-110, wherein the aluminum nitride-based sintered compact contains oxygen and contains simultaneously at least one selected from a rare earth element or an alkaline-earth metal.
Item 112. The substrate for a thin film as described in any one of Items 71-111, wherein the aluminum nitride-based sintered compact contains ALON not more than 80%.
Item 113. The substrate for a thin film as described in Item 112, wherein the aluminum nitride-based sintered compact contains ALON not more than 50 %.
Item 114. The substrate for a thin film as described in Item 112 or 113, wherein the aluminum nitride-based sintered compact contains ALON not more than 20 %.
Item 115. The substrate for a thin film as described in any one of Items 90-93 and 112-114, wherein the aluminum nitride-based sintered compact contains ALON and contains simultaneously at least one selected from a rare earth element or an alkaline-earth metal.
Item 116. The substrate for a thin film as described in any one of Items 71-115, wherein the thermal conductivity of the aluminum nitride-based sintered compact is not less than 50 W/mK at room temperature.
Item 117. The substrate for a thin film as described in Item 116, wherein the thermal conductivity of the aluminum nitride-based sintered compact is not less than 100 W/mK at room temperature.
Item 118. The substrate for a thin film as described in Item 116 or 117, wherein the thermal conductivity of the aluminum nitride-based sintered compact is not less than 150 W/mK at room temperature.
Item 119. The substrate for a thin film as described in any one of Items 116-118, wherein the thermal conductivity of the aluminum nitride-based sintered compact is not less than 170 W/mK at room temperature.
Item 120. The substrate for a thin film as described in any one of Items 71-119, wherein the aluminum nitride-based sintered compact contains aluminum nitride not less than 95 volume %.
Item 121. The substrate for a thin film as described in any one of Items 71-120, wherein the aluminum nitride-based sintered compact contains at least one selected from a rare earth element and an alkaline-earth metal a total of not more than 0.5 % by weight on an element basis and contains oxygen not more than 0.9 % by weight.
Item 122. The substrate for a thin film as described in Item 121, wherein the aluminum nitride-based sintered compact contains at least one selected from a rare earth element and an alkaline-earth metal a total of not more than 0.2 % by weight on an element basis and contains oxygen not more than 0.5 % by weight.
Item 123. The substrate for a thin film as described in Item 121 or 122, wherein the aluminum nitride-based sintered compact contains at least one selected from a rare earth element and an alkaline-earth metal a total of not more than 0.05 % by weight on an element basis and contains oxygen not more than 0.2 % by weight.
Item 124. The substrate for a thin film as described in any one of Items 121-123, wherein the aluminum nitride-based sintered compact contains at least one selected from a rare earth element and an alkaline-earth metal a total of not more than 0.02 % by weight on an element basis and contains oxygen not more than 0.1 % by weight.
Item 125. The substrate for a thin film as described in any one of Items 121-124, wherein the aluminum nitride-based sintered compact contains at least one selected from a rare earth element and an alkaline-earth metal a total of not more than 0.005 % by weight on an element basis and contains oxygen not more than 0.05 % by weight.
Item 126. The substrate for a thin film as described in any one of Items 71-125, wherein the aluminum nitride-based sintered compact contains at least one selected from an alkaline metal or silicon a total of not more than 0.2 % by weight on an element basis and contains oxygen not more than 0.9 % by weight.
Item 127. The substrate for a thin film as described in any one of Items 71-126, wherein the aluminum nitride-based sintered compact contains at least one selected from Mo, W, V (vanadium), Nb, Ta, Ti, and carbon a total of not more than 0.2 % by weight on an element basis and contains oxygen not more than 0.9 % by weight.
Item 128. The substrate for a thin film as described in any one of Items 71-127, wherein the aluminum nitride-based sintered compact contains at least one selected from Fe, Ni, Co, Mn, Cr, Zr, Hf, Cu, and Zn a total of not more than 0.2 % by weight on an element basis and contains oxygen not more than 0.9 % by weight.
Item 129. The substrate for a thin film as described in any one of Items 71-128, wherein the aluminum nitride-based sintered compact contains AlN not less than 95 % as a crystal phase.
Item 130. The substrate for a thin film as described in Item 129, wherein the aluminum nitride-based sintered compact contains AlN not less than 98 % as a crystal phase.
Item 131. The substrate for a thin film as described in any one of Items 71-130, wherein the aluminum nitride-based sintered compact comprises a single phase of AlN substantially.
Item 132. The substrate for a thin film as described in any one of Items 71-131, wherein the thermal conductivity of the aluminum nitride-based sintered compact is not less than 200 W/mK at room temperature.
Item 133. The substrate for a thin film as described in Item 132, wherein the thermal conductivity of the aluminum nitride-based sintered compact is not less than 220 W/mK at room temperature.
Item 134. The substrate for a thin film as described in any one of Items 71-133, wherein the relative density of the aluminum nitride-based sintered compact is not less than 95 %.
Item 135. The substrate for a thin film as described in Item 134, wherein the relative density of the aluminum nitride-based sintered compact is not less than 98 %.
Item 136. The substrate for a thin film as described in any one of Items 71-135, wherein the average size of the pore of the aluminum nitride-based sintered compact is not more than 1 µm.
Item 137. The substrate for a thin film as described in any one of Items 71-136, wherein the average size of aluminum nitride particles of the aluminum nitride-based sintered compact is not less than 1 µm.
Item 138. The substrate for a thin film as described in Item 137, wherein the average size of aluminum nitride particles of the aluminum nitride-based sintered compact is not less than 5 µm.
Item 139. The substrate for a thin film as described in Item 137 or 138, wherein the average size of aluminum nitride particles of the aluminum nitride-based sintered compact is not less than 8 µm.
Item 140. The substrate for a thin film as described in any one of Items 137-139, wherein the average size of aluminum nitride particles of the aluminum nitride-based sintered compact is not less than 15 µm.
Item 141. The substrate for a thin film as described in any one of Items 137-140, wherein the average size of aluminum nitride particles of the aluminum nitride-based sintered compact is not less than 25 µm.
Item 142. The substrate for a thin film as described in any one of Items 71-141, wherein the average size of aluminum nitride particles of the aluminum nitride-based sintered compact is not more than 100 µm.
Item 143. The substrate for a thin film as described in any one of Items 71-142, wherein the substrate comprises an aluminum nitride-based sintered compact having the average surface roughness Ra not more than 2000 nm.
Item 144. The substrate for a thin film as described in Item 143, wherein the average surface roughness Ra of the aluminum nitride-based sintered compact is not more than 1000 nm.
Item 145. The substrate for a thin film as described in Item 143 or 144, wherein the average surface roughness Ra of the aluminum nitride-based sintered compact is not more than 100 nm.
Item 146. The substrate for a thin film as described in any one of Items 143-145, wherein the average surface roughness Ra of the aluminum nitride-based sintered compact is not more than 20 nm.
Item 147. The substrate for a thin film as described in any one of Items 71-145, wherein the aluminum nitride-based sintered compact has large surface roughness.
Item 148. The substrate for a thin film as described in any one of Items 71-145 and 147, wherein the substrate comprises an aluminum nitride-based sintered compact having the average surface roughness Ra not less than 70 nm.
Item 149. The substrate for a thin film as described in Item 148, wherein the average surface roughness Ra of the aluminum nitride-based sintered compact is more than 1000 nm.

Item 150. The substrate for a thin film as described in Item 148 or 149, wherein the average surface roughness Ra of the aluminum nitride-based sintered compact is more than 2000 nm.
Item 151. The substrate for a thin film as described in any one of Items 71-150, wherein the surface of the aluminum nitride-based sintered compact is at least one of the states selected from an as-fired state, a state in which lap polish was carried out, a state in which blast polish was carried out, a state in which specular surface polish was carried out, a state in which chemistry corrosion was carried out, and a state corroded by plasma gas.
Item 152. The substrate for a thin film as described in Item 151, wherein the surface of the aluminum nitride-based sintered compact is the state in which specular surface polish was carried out.
Item 153. The substrate for a thin film as described in any one of Items 71-152, wherein the thickness of the aluminum nitride-based sintered compact is not more than 8.0 mm.
Item 154. The substrate for a thin film as described in Item 153, wherein the thickness of the aluminum nitride-based sintered compact is not more than 2.5 mm.
Item 155. The substrate for a thin film as described in Item 153 or 154, wherein the thickness of the aluminum nitride-based sintered compact is not more than 1.0 mm.
Item 156. The substrate for a thin film as described in any one of Items 71-155, wherein the thickness of the aluminum nitride-based sintered compact is not less than 0.01 mm.
Item 157. The substrate for a thin film as described in Item 156, wherein the thickness of the aluminum nitride-based sintered compact is not less than 0.05 mm.
Item 158. The substrate for a thin film as described in any one of Items 153-157, wherein the aluminum nitride-based sintered compact has the thickness not more than 8.0 mm and has the optical transmissivity not less than 1 %.
Item 159. The substrate for a thin film as described in any one of Items 153-158, wherein the aluminum nitride-based sintered compact has the thickness not less than 0.01 mm and has the optical transmissivity not less than 40 %.
Item 160. The substrate for a thin film as described in any one of Items 71-159, wherein the thin film comprises at least one selected from gallium nitride, indium nitride and aluminum nitride as a main component, and the substrate comprises an aluminum nitride-based sintered compact having a conduction via.
Item 161. The substrate for a thin film as described in Item 160, wherein the thin film comprises at least one selected from gallium nitride, indium nitride and aluminum nitride as a main component, and the substrate comprises an aluminum nitride-based sintered compact having a conduction via which connects the up-and-down surface of the substrate electrically.
Item 162. The substrate for a thin film as described in Item 160 or 161, wherein the conduction via comprises at least one selected from gold, silver, copper, aluminum, iron, cobalt, nickel, ruthenium, rhodium, palladium, osmium, iridium, platinum, molybdenum, tungsten, chromium, titanium, titanium nitride, and zirconium nitride.
Item 163. The substrate for a thin film as described in any one of Items 160-162, wherein the conduction via comprises as a main component at least one selected from gold, silver, copper, aluminum, iron, cobalt, nickel, ruthenium, rhodium, palladium, osmium, iridium, platinum, molybdenum, tungsten, chromium, titanium, titanium nitride, and zirconium nitride and further contains at least one selected from aluminum nitride, silicon carbide, silicon nitride, gallium nitride, zinc oxide, beryllium oxide, aluminum oxide, rare-earth compound, and alkaline-earth-metal compound.
Item 164. The substrate for a thin film as described in any one of Items 160-163, wherein the conduction via comprises as a main component at least one selected from molybdenum, tungsten, copper, titanium nitride, and zirconium nitride.
Item 165. The substrate for a thin film as described in any one of Items 160-164, wherein the conduction via comprises as a main component at least one selected from molybdenum, tungsten, copper, titanium nitride, and zirconium nitride and further contains at least one selected from aluminum nitride, aluminum oxide, rare-earth compound, and alkaline-earth-metal compound.
Item 166. The substrate for a thin film as described in any one of Items 160-165, wherein the conduction via comprises the conductive material in which the electric resistivity is not more than 1x10⁻³ Ω·cm at room temperature.
Item 167. The substrate for a thin film as described in Item 166, wherein the conduction via comprises the conductive material in which the electric resistivity is not more than 1x10⁻⁴ Ω·cm at room temperature.
Item 168. The substrate for a thin film as described in Item 166 or 167, wherein the conduction via comprises the conductive material in which the electric resistivity is not more than 1x10⁻⁵ Ω·cm at room temperature.
Item 169. The substrate for a thin film as described in any one of Items 160-168, wherein the size of the conduction via is not more than 500 µm.
Item 170. The substrate for a thin film as described in Item 169, wherein the size of the conduction via is not more than 250 µm.
Item 171. The substrate for a thin film as described in Item 169 or 170, wherein the size of the conduction via is not more than 100 µm.
Item 172. The substrate for a thin film as described in any one of Items 169-171, wherein the size of the conduction via is not more than 50 µm.
Item 173. The substrate for a thin film as described in any one of Items 169-172, wherein the size of the conduction via is not more than 25 µm.
Item 174. The substrate for a thin film as described in any one of Items 160-173, wherein the size of the conduction via is not less than 1 µm.
Item 175. The substrate for a thin film as described in any one of Items 160-174, wherein the thin film comprising as a main component at least one selected from gallium nitride, indium nitride and aluminum nitride may also be formed on the surface of a conduction via.
Item 176. The substrate for a thin film as described in any one of Items 71-175, wherein the thin film-conductive material was formed on the aluminum nitride-based sintered compact.
Item 177. The substrate for a thin film as described in Item 176, wherein the thin film-conductive material comprises at least one selected from metal, alloy, and metal nitride.
Item 178. The substrate for a thin film as described in Item 176 or 177, wherein the thin film-conductive material comprises as a main component at least one selected from gold, silver, copper, aluminum, iron, cobalt, nickel, ruthenium, rhodium, palladium, osmium, iridium, platinum, tantalum, molybdenum, tungsten, chromium, titanium, nickel chromium alloy, titanium nitride, zirconium nitride, and tantalum nitride.
Item 179. The substrate for a thin film as described in any one of Items 176-178, wherein the thin film-conductive material is constituted with at least two layers.
Item 180. The substrate for a thin film as described in any one of Items 176-179, wherein the thickness of the thin film-conductive material is not more than 20 µm.
Item 181. The substrate for a thin film as described in any one of Items 176-180, wherein the junction strength between the thin film-conductive materials and the thin film comprising as a main component at least one selected from gallium nitride, indium nitride and aluminum nitride is not less than 2 Kg/mm² by the method by the perpendicular tensile strength.
Item 182. The substrate for a thin film as described in any one of Items 71-181, wherein the aluminum nitride-based sintered compact comprises that obtained by firing the powder compact or sintered compact which comprise aluminum nitride as a main component at the temperature not less than 1500°C for not less than 10 minutes in non-oxidizing atmosphere.
Item 183. The substrate for a thin film as described in Item 182, wherein the aluminum nitride-based sintered compact comprises that obtained by firing the powder compact or sintered compact which comprise aluminum nitride as a main component at the temperature not less than 1750°C for not less than 3 hours in non-oxidizing atmosphere.
Item 184. The substrate for a thin film as described in any one of Items 71-183, wherein the aluminum nitride-based sintered compact comprises that obtained by vaporizing, removing, and reducing a rare-earth compound, an alkaline-earth-metal compound, and oxygen at least among the components contained, by firing the powder compact or sintered compact which comprise aluminum nitride as a main component and contain at least one compound selected from a rare-earth compound and an alkaline-earth-metal compound at the temperature not less than 1750°C for not less than 3 hours in non-oxidizing atmosphere.
Item 185. The substrate for a thin film as described in any one of Items 1-70, wherein the ceramic-based sintered compact, and the ceramic-based sintered compact having optical permeability, are respectively a sintered compact comprising as a main component a ceramic material having at least one of the crystal structures selected from a hexagonal system or a trigonal system.
Item 186. The substrate for a thin film as described in Item 185, wherein the sintered compact comprising as a main component a ceramic material having at least one of the crystal structures selected from a hexagonal system or a trigonal system comprises a sintered compact which comprises as a main component at least one selected from zinc oxide, beryllium oxide, aluminum oxide, silicon carbide, silicon nitride, and gallium nitride.
Item 187. The substrate for a thin film as described in Item 185 or 186, wherein the ceramic-based sintered compact is a zinc oxide-based sintered compact.
Item 188. The substrate for a thin film as described in Item 186 or 187, wherein the zinc oxide-based sintered compact has optical permeability.
Item 189. The substrate for a thin film as described in any one of Items 186-188, wherein the optical transmissivity of the zinc oxide-based sintered compact is not less than 1%.
Item 190. The substrate for a thin film as described in Item 189, wherein the optical transmissivity of the zinc oxide-based sintered compact is not less than 10 %.
Item 191. The substrate for a thin film as described in Item 189 or 190, wherein the optical transmissivity of the zinc oxide-based sintered compact is not less than 20 %.
Item 192. The substrate for a thin film as described in any one of Items 189-191, wherein the optical transmissivity of the zinc oxide-based sintered compact is not less than 30%.
Item 193. The substrate for a thin film as described in any one of Items 189-192, wherein the optical transmissivity of the zinc oxide-based sintered compact is not less than 40%.
Item 194. The substrate for a thin film as described in any one of Items 189-193, wherein the optical transmissivity of the zinc oxide-based sintered compact is not less than 50%.
Item 195. The substrate for a thin film as described in any one of Items 189-194, wherein the optical transmissivity of the zinc oxide-based sintered compact is not less than 60%.
Item 196. The substrate for a thin film as described in any one of Items 189-195, wherein the optical transmissivity of the zinc oxide-based sintered compact is not less than 80%.
Item 197. The substrate for a thin film as described in any one of Items 186-188, wherein the optical transmissivity of the zinc oxide-based sintered compact is less than 1%.
Item 198. The substrate for a thin film as described in Item 197, wherein the optical transmissivity of the zinc oxide-based sintered compact is 0 %.
Item 199. The substrate for a thin film as described in any one of Items 186-198, wherein the zinc oxide-based sintered compact has conductivity.

Item 200. The substrate for a thin film as described in any one of Items 186-199, wherein the electric resistivity of the zinc oxide-based sintered compact is not more than 1x10² Ω·cm at room temperature.
Item 201. The substrate for a thin film as described in Item 200, wherein the electric resistivity of the zinc oxide-based sintered compact is not more than 1x10⁰ Ω·cm at room temperature.
Item 202. The substrate for a thin film as described in Item 200 or 201, wherein the electric resistivity of the zinc oxide-based sintered compact is not more than 1x10⁻¹ Ω·cm at room temperature.
Item 203. The substrate for a thin film as described in any one of Items 200-202, wherein the electric resistivity of the zinc oxide-based sintered compact is not more than 1x10⁻² Ω·cm at room temperature.
Item 204. The substrate for a thin film as described in any one of Items 186-203, wherein the zinc oxide-based sintered compact has optical permeability and has conductivity.
Item 205. The substrate for a thin film as described in any one of Items 186-204, wherein the zinc oxide-based sintered compact contains an aluminum component.
Item 206. The substrate for a thin film as described in any one of Items 186-205, wherein the zinc oxide-based sintered compact contains a zinc oxide component not less than 55.0 mol % on the basis of ZnO.
Item 207. The substrate for a thin film as described in any one of Items 186-206, wherein the zinc oxide-based sintered compact contains an aluminum component not more than 45.0 mol % on the basis of Al₂O₃.
Item 208. The substrate for a thin film as described in Item 207, wherein the zinc oxide-based sintered compact contains an aluminum component in the range of 0.001-45.0 mol % on the basis of Al₂O₃.
Item 209. The substrate for a thin film as described in Item 207 or 208, wherein the zinc oxide-based sintered compact contains an aluminum component in the range of 0.005-45.0 mol % on the basis of Al₂O₃.
Item 210. The substrate for a thin film as described in any one of Items 207-209, wherein the zinc oxide-based sintered compact contains an aluminum component in the range of 0.02-45.0 mol % on the basis of Al₂O₃.
Item 211. The substrate for a thin film as described in any one of Items 207-210, wherein the zinc oxide-based sintered compact contains an aluminum component in the range of 0.08-35.0 mol % on the basis of Al₂O₃.
Item 212. The substrate for a thin film as described in any one of Items 186-211, wherein the zinc oxide-based sintered compact contains at least one selected from an alkaline-earth-metal component, a rare-earth component, a transition-metals component, and a silicon component.
Item 213. The substrate for a thin film as described in Item 212, wherein the zinc oxide-based sintered compact contains at least one selected from a rare-earth component and a transition-metals component.
Item 214. The substrate for a thin film as described in Item 212 or 213, wherein the zinc oxide-based sintered compact contains at least one selected from a rare-earth component.
Item 215. The substrate for a thin film as described in Item 214, wherein the zinc oxide-based sintered compact contains at least one selected from a rare-earth component and has optical permeability.
Item 216. The substrate for a thin film as described in Item 214 or 215, wherein the zinc oxide-based sintered compact contains at least one selected from a rare-earth component and has the optical transmissivity not less than 30 %.
Item 217. The substrate for a thin film as described in any one of Items 188-197, 204, 215, and 216, wherein the optical permeability or optical transmissivity is that to the light of the range of 200-800 nm wavelength at least.
Item 218. The substrate for a thin film as described in Item 212 or 213, wherein the zinc oxide-based sintered compact contains at least one selected from a transition-metals component.
Item 219. The substrate for a thin film as described in any one of Items 212-216 and 218, wherein the zinc oxide-based sintered compact contains at least one selected from a rare-earth component and a transition-metals component not more than 10.0 mol % on an oxide basis.
Item 220. The substrate for a thin film as described in any one of Items 186-219, wherein the zinc oxide-based sintered compact contains an aluminum component and contains simultaneously at least one selected from a rare-earth component and a transition-metals component.
Item 221. The substrate for a thin film as described in Item 220, wherein the zinc oxide-based sintered compact contains an aluminum component and contains simultaneously at least one selected from a rare-earth component.
Item 222. The substrate for a thin film as described in Item 220, wherein the zinc oxide-based sintered compact contains an aluminum component and contains simultaneously at least one selected from a transition-metals component.
Item 223. The substrate for a thin film as described in any one of Items 220-222, wherein the zinc oxide-based sintered compact contains at least one selected from a rare-earth component and a transition-metals component not more than 10.0 mol % on an oxide basis.
Item 224. The substrate for a thin film as described in Item 223, wherein the zinc oxide-based sintered compact contains at least one selected from a rare-earth component not more than 10.0 mol % on an oxide basis.
Item 225. The substrate for a thin film as described in Item 223 or 224, wherein the zinc oxide-based sintered compact contains at least one selected from a transition-metals component not more than 10.0 mol % on an oxide basis.
Item 226. The substrate for a thin film as described in any one of Items 212, 213, 218-220, 222, 223, and 225, wherein the transition-metals component is at least one selected from iron and chromium.
Item 227. The substrate for a thin film as described in any one of Items 220-226, wherein the zinc oxide-based sintered compact contains an aluminum component not more than 45.0 mol % on the basis of Al₂O₃ and contains simultaneously at least one selected from a rare-earth component not more than 10.0 mol % on an oxide basis.
Item 228. The substrate for a thin film as described in Item 227, wherein the zinc oxide-based sintered compact contains an aluminum component not more than 45.0 mol % on the basis of Al₂O₃ and contains simultaneously at least one selected from a rare-earth component in the range of 0.0002-10.0 mol % on an oxide basis.
Item 229. The substrate for a thin film as described in Item 227 or 228, wherein the zinc oxide-based sintered compact contains an aluminum component not more than 45.0 mol % on the basis of Al₂O₃ and contains simultaneously at least one selected from a rare-earth component in the range of 0.0006-6.0 mol % on an oxide basis.
Item 230. The substrate for a thin film as described in any one of Items 227-229, wherein the zinc oxide-based sintered compact contains an aluminum component not more than 45.0 mol % on the basis of Al₂O₃ and contains simultaneously at least one selected from a rare-earth component in the range of 0.001-6.0 mol % on an oxide basis.
Item 231. The substrate for a thin film as described in any one of Items 227-230, wherein the zinc oxide-based sintered compact contains an aluminum component not more than 45.0 mol % on the basis of Al₂O₃ and contains simultaneously at least one selected from a rare-earth component in the range of 0.002-3.0 mol % on an oxide basis.
tem 232. The substrate for a thin film as described in any one of Items 220-231, wherein the zinc oxide-based sintered compact contains an aluminum component in the range of 0.001-45.0 mol % on the basis of Al₂O₃ and contains simultaneously at least one selected from a rare-earth component.
Item 233. The substrate for a thin film as described in Item 185 or 186, wherein the ceramic-based sintered compact is a beryllium oxide-based sintered compact.
Item 234. The substrate for a thin film as described in Item 233, wherein the beryllium oxide-based sintered compact has optical permeability.
Item 235. The substrate for a thin film as described in any one of Items 186, 233, and 234, wherein the optical transmissivity of the beryllium oxide-based sintered compact is not less than 1 %.
Item 236. The substrate for a thin film as described in Item 235, wherein the optical transmissivity of the beryllium oxide-based sintered compact is not less than 10 %.
Item 237. The substrate for a thin film as described in Item 235 or 236, wherein the optical transmissivity of the beryllium oxide-based sintered compact is not less than 20 %. Item 238. The substrate for a thin film as described in any one of Items 235-237,
wherein the optical transmissivity of the beryllium oxide-based sintered compact is not less than 30 %.
Item 239. The substrate for a thin film as described in any one of Items 235-238, wherein the optical transmissivity of the beryllium oxide-based sintered compact is not less than 40 %.
Item 240. The substrate for a thin film as described in any one of Items 235-239, wherein the optical transmissivity of the beryllium oxide-based sintered compact is not less than 50 %.
Item 241. The substrate for a thin film as described in any one of Items 235-240, wherein the optical transmissivity of the beryllium oxide-based sintered compact is not less than 60 %.
Item 242. The substrate for a thin film as described in any one of Items 235-241, wherein the optical transmissivity of the beryllium oxide-based sintered compact is not less than 80 %.
Item 243. The substrate for a thin film as described in any one of Items 185, 186, 233, and 234, wherein the optical transmissivity of the beryllium oxide-based sintered compact is less than 1 %. Item 244. The substrate for a thin film as described in Item 243, wherein the optical transmissivity of the beryllium oxide-based sintered compact is 0 %.
Item 245. The substrate for a thin film as described in any one of Items 234-244, wherein the optical permeability or optical transmissivity is that to the light of the range of 200-800 nm wavelength at least.
Item 246. The substrate for a thin film as described in any one of Items 186 and 233-245, wherein the beryllium oxide-based sintered compact contains at least one selected from a magnesium component, a calcium component, and a silicon component.
Item 247. The substrate for a thin film as described in any one of Items 186 and 233-246, wherein the beryllium oxide-based sintered compact contains a beryllium oxide component not less than 65.0 mol % on the basis of BeO.
Item 248. The substrate for a thin film as described in any one of Items 186 and 233-247, wherein the beryllium oxide-based sintered compact contains at least one selected from a magnesium component, a calcium component, and a silicon component a total of not more than 35.0 mol % on an oxide basis.
Item 249. The substrate for a thin film as described in Item 248, wherein the beryllium oxide-based sintered compact contains at least one selected from a magnesium component, a calcium component, and a silicon component a total of the range of 0.0002-35.0 mol % on an oxide basis.

Item 250. The substrate for a thin film as described in Item 248 or 249, wherein the beryllium oxide-based sintered compact contains at least one selected from a magnesium component, a calcium component, and a silicon component a total of the range of 0.001-35.0 mol % on an oxide basis.
Item 251. The substrate for a thin film as described in any one of Items 248-250, wherein the beryllium oxide-based sintered compact contains at least one selected from a magnesium component, a calcium component, and a silicon component a total of the range of 0.004-35.0 mol % on an oxide basis.
Item 252. The substrate for a thin film as described in any one of Items 246-251, wherein the beryllium oxide-based sintered compact contains at least one selected from a magnesium component, a calcium component, and a silicon component a total of the range of 0.015-25.0 mol % on an oxide basis.
Item 253. The substrate for a thin film as described in any one of Items 186 and 233-252, wherein the beryllium oxide-based sintered compact contains at least one selected from a magnesium component, a calcium component, and a silicon component and contains simultaneously at least one selected from a rare-earth component.
Item 254. The substrate for a thin film as described in Item 253, wherein the beryllium oxide-based sintered compact contains at least one selected from a magnesium component, a calcium component, and a silicon component and contains simultaneously at least one selected from a rare-earth component not more than 5.0 mol % on an oxide basis. Item 255. The substrate for a thin film as described in Item 253 or 254, wherein the beryllium oxide-based sintered compact contains at least one selected from a magnesium component, a calcium component, and a silicon component a total of not more than 35.0 mol % on an oxide basis and contains simultaneously at least one selected from a rare-earth component not more than 5.0 mol % on an oxide basis.
Item 256. The substrate for a thin film as described in any one of Items 253-255, wherein the beryllium oxide-based sintered compact contains at least one selected from a magnesium component, a calcium component, and a silicon component a total of not more than 35.0 mol % on an oxide basis and contains simultaneously at least one selected from a rare-earth component in the range of 0.00005-5.0 mol % on an oxide basis.
Item 257. The substrate for a thin film as described in any one of Items 253-256, wherein the beryllium oxide-based sintered compact contains at least one selected from a magnesium component, a calcium component, and a silicon component a total of not more than 35.0 mol % on an oxide basis and contains simultaneously at least one selected from a rare-earth component in the range of 0.0005-3.0 mol % on an oxide basis.
Item 258. The substrate for a thin film as described in any one of Items 253-257, wherein the beryllium oxide-based sintered compact contains at least one selected from a magnesium component, a calcium component, and a silicon component a total of not more than 35.0 mol % on an oxide basis and contains simultaneously at least one selected from a rare-earth component in the range of 0.002-3.0 mol % on an oxide basis.
Item 259. The substrate for a thin film as described in any one of Items 253-258, wherein the beryllium oxide-based sintered compact contains at least one selected from a magnesium component, a calcium component, and a silicon component a total of not more than 35.0 mol % on an oxide basis and contains simultaneously at least one selected from a rare-earth component in the range of 0.005-3.0 mol % on an oxide basis.
Item 260. The substrate for a thin film as described in any one of Items 253-258, wherein the beryllium oxide-based sintered compact contains at least one selected from a magnesium component, a calcium component, and a silicon component a total of the range of 0.0002-35.0 mol % on an oxide basis and contains simultaneously at least one selected from a rare-earth component.
Item 261. The substrate for a thin film as described in Item 185 or 186, wherein the ceramic-based sintered compact is an aluminum oxide-based sintered compact.
Item 262. The substrate for a thin film as described in Item 186 or 261, wherein the aluminum oxide-based sintered compact has optical permeability.
Item 263. The substrate for a thin film as described in any one of Items 186, 261, and 262, wherein the optical transmissivity of the aluminum oxide-based sintered compact is not less than 1 %.
Item 264. The substrate for a thin film as described in Item 263, wherein the optical transmissivity of the aluminum oxide-based sintered compact is not less than 10 %.
Item 265. The substrate for a thin film as described in Item 263 or 264, wherein the optical transmissivity of the aluminum oxide-based sintered compact is not less than 20 %.
Item 266. The substrate for a thin film as described in any one of Items 263-265, wherein the optical transmissivity of the aluminum oxide-based sintered compact is not less than 30 %.
Item 267. The substrate for a thin film as described in any one of Items 263-266, wherein the optical transmissivity of the aluminum oxide-based sintered compact is not less than 40 %.
Item 268. The substrate for a thin film as described in any one of Items 263-267, wherein the optical transmissivity of the aluminum oxide-based sintered compact is not less than 50 %.
Item 269. The substrate for a thin film as described in any one of Items 263-268, wherein the optical transmissivity of the aluminum oxide-based sintered compact is not less than 60 %.
Item 270. The substrate for a thin film as described in any one of Items 263-269, wherein the optical transmissivity of the aluminum oxide-based sintered compact is not less than 80 %.
Item 271. The substrate for a thin film as described in any one of Items 185, 186, 261, and 262, wherein the optical transmissivity of the aluminum oxide-based sintered compact is less than 1 %.
Item 272. The substrate for a thin film as described in Item 271, wherein the optical transmissivity of the aluminum oxide-based sintered compact is 0 %.
Item 273. The substrate for a thin film as described in any one of Items 262-272, wherein the optical permeability or optical transmissivity is that to the light of the range of 200-800 nm wavelength at least.
Item 274. The substrate for a thin film as described in any one of Items 261-273, wherein the aluminum oxide-based sintered compact contains at least one selected from a magnesium component, a calcium component, and a silicon component.
Item 275. The substrate for a thin film as described in any one of Items 186 and 261-274, wherein the aluminum oxide-based sintered compact contains an aluminum oxide component not less than 55.0 mol % on the basis of Al₂O₃.
Item 276. The substrate for a thin film as described in any one of Items 186 and 261-275, wherein the aluminum oxide-based sintered compact contains at least one selected from a magnesium component, a calcium component, and a silicon component a total of not more than 45.0 mol % on an oxide basis.
Item 277. The substrate for a thin film as described in Item 276, wherein the aluminum oxide-based sintered compact contains at least one selected from a magnesium component, a calcium component, and a silicon component a total of the range of 0.001-45.0 mol % on an oxide basis.
Item 278. The substrate for a thin film as described in Item 276 or 277, wherein the aluminum oxide-based sintered compact contains at least one selected from a magnesium component, a calcium component, and a silicon component a total of the range of 0.005-45.0 mol % on an oxide basis.
Item 279. The substrate for a thin film as described in any one of Items 276-278, wherein the aluminum oxide-based sintered compact contains at least one selected from a magnesium component, a calcium component, and a silicon component a total of the range of 0.02-45.0 mol % on an oxide basis.
Item 280. The substrate for a thin film as described in any one of Items 276-279, wherein the aluminum oxide-based sintered compact which contains at least one selected from a magnesium component, a calcium component, and a silicon component a total of the range of 0.08-35.0 mol % on an oxide basis.
Item 281. The substrate for a thin film as described in any one of Items 186 and 261-280, wherein the aluminum oxide-based sintered compact comprises aluminum oxide as a main component and contains at least one selected from a magnesium component, a calcium component and a silicon component and simultaneously at least one selected from a rare-earth component other than these.
Item 282. The substrate for a thin film as described in Item 281, wherein the aluminum oxide-based sintered compact contains at least one selected from a magnesium component, a calcium component, and a silicon component and contains simultaneously at least one selected from a rare-earth component not more than 10.0 mol % on an oxide basis.
Item 283. The substrate for a thin film as described in Item 281 or 282, wherein the aluminum oxide-based sintered compact contains at least one selected from a magnesium component, a calcium component, and a silicon component a total of not more than 45.0 mol % on an oxide basis and contains simultaneously at least one selected from a rare-earth component not more than 10.0 mol % on an oxide basis.
Item 284. The substrate for a thin film as described in any one of Items 281-283, wherein the aluminum oxide-based sintered compact contains at least one selected from a magnesium component, a calcium component, and a silicon component a total of not more than 45.0 mol % on an oxide basis and contains simultaneously at least one selected from a rare-earth component in the range of 0.0002-10.0 mol % on an oxide basis.
Item 285. The substrate for a thin film as described in any one of Items 281-284, wherein the aluminum oxide-based sintered compact contains at least one selected from a magnesium component, a calcium component, and a silicon component a total of not more than 45.0 mol % on an oxide basis and contains simultaneously at least one selected from a rare-earth component in the range of 0.001-6.0 mol % on an oxide basis.
Item 286. The substrate for a thin film as described in any one of Items 281-285, wherein the aluminum oxide-based sintered compact contains at least one selected from a magnesium component, a calcium component, and a silicon component a total of not more than 45.0 mol % on an oxide basis and contains simultaneously at least one selected from a rare-earth component in the range of 0.005-6.0 mol % on an oxide basis.
Item 287. The substrate for a thin film as described in any one of Items 281-286, wherein the aluminum oxide-based sintered compact contains at least one selected from a magnesium component, a calcium component, and a silicon component a total of not more than 45.0 mol % on an oxide basis and contains simultaneously at least one selected from a rare-earth component in the range of 0.01-6.0 mol % on an oxide basis.
Item 288. The substrate for a thin film as described in any one of Items 281-287, wherein the aluminum oxide-based sintered compact contains at least one selected from a magnesium component, a calcium component, and a silicon component a total of the range of 0.001-45.0 mol % on an oxide basis and contains simultaneously at least one selected from a rare-earth component.
Item 289. The substrate for a thin film as described in any one of Items 186 and 261-288, wherein the aluminum oxide-based sintered compact contains at least two selected from a magnesium component, a calcium component, and a silicon component.
Item 290. The substrate for a thin film as described in Item 185 or 186, wherein the ceramic-based sintered compact is a gallium nitride-based sintered compact.
Item 291. The substrate for a thin film as described in Item 290, wherein the gallium nitride-based sintered compact has optical permeability.
Item 292. The substrate for a thin film as described in Item 290 or 291, wherein the optical transmissivity of the gallium nitride-based sintered compact is not less than 1 %. Item 293. The substrate for a thin film as described in any one of Items 290-292, wherein the gallium nitride-based sintered compact has conductivity.
Item 294. The substrate for a thin film as described in any one of Items 290-293, wherein the electric resistivity of the gallium nitride-based sintered compact is not more than 1x10⁴ Ω·cm at room temperature.
Item 295. The substrate for a thin film as described in any one of Items 290-294, wherein the gallium nitride-based sintered compact contains at least one selected from an alkaline-earth metal and a rare earth element.
Item 296. The substrate for a thin film as described in any one of Items 290-295, wherein the gallium nitride-based sintered compact contains at least one selected from zinc, cadmium, carbon, silicon, germanium, selenium, and tellurium.
Item 297. The substrate for a thin film as described in any one of Items 290-296, wherein the gallium nitride-based sintered compact contains at least one selected from aluminum, indium, and oxygen.
Item 298. The substrate for a thin film as described in any one of Items 290-297, wherein the gallium nitride-based sintered compact contains at least one selected from a transition metal.
Item 299. The substrate for a thin film as described in any one of Items 290-298, wherein the gallium nitride-based sintered compact is made from the gallium nitride-based raw material powder produced by direct nitriding of metal gallium.

Item 300. The substrate for a thin film as described in any one of Items 290-298, wherein the gallium nitride-based sintered compact is made from the gallium nitride-based raw material powder produced by reducing and nitriding of a gallium oxide.
Item 301. The substrate for a thin film as described in any one of Items 290-298, wherein the gallium nitride-based sintered compact is made from the gallium nitride-based raw material powder produced by nitriding of a gas state gallium compound.
Item 302. The substrate for a thin film as described in any one of Items 185-301, wherein the substrate comprises a sintered compact hvings the average surface roughness Ra not more than 2000 nm and comprising as a main component a ceramic material having at least one of the crystal structures selected from a hexagonal system or a trigonal system.
Item 303. The substrate for a thin film as described in Item 302, wherein the average surface roughness Ra of the sintered compact comprising as a main component a ceramic material having east one of the crystal structures selected from a hexagonal system or a trigonal system is not more than 1000 nm.
Item 304. The substrate for a thin film as described in Item 302 or 303, wherein the average surface roughness Ra of the sintered compact comprising as a main component a ceramic material having east one of the crystal structures selected from a hexagonal system or a trigonal system is not more than 100 nm.
Item 305. The substrate for a thin film as described in any one of Items 302-304, wherein the average surface roughness Ra of the sintered compact comprising as a main component a ceramic material having east one of the crystal structures selected from a hexagonal system or a trigonal system is not more than 10 nm.
Item 306. The substrate for a thin film as described in any one of Items 302-305, wherein the average surface roughness Ra of the sintered compact comprising as a main component a ceramic material having east one of the crystal structures selected from a hexagonal system or a trigonal system is not more than 5 nm.
Item 307. The substrate for a thin film as described in any one of Items 185-304, wherein the substrate comprises a sintered compact having large surface roughness and comprising as a main component a ceramic material having at least one of the crystal structures selected from a hexagonal system or a trigonal system.
Item 308. The substrate for a thin film as described in any one of Items 185-304 and 307, wherein the substrate comprises a sintered compact having the average surface roughness Ra not less than 70 nm and comprising as a main component a ceramic material having at least one of the crystal structures selected from a hexagonal system or a trigonal system.
Item 309. The substrate for a thin film as described in Item 308, wherein the average surface roughness Ra of the sintered compact comprising as a main component a ceramic material having at least one of the crystal structures selected from a hexagonal system or a trigonal system is more than 1000 nm.
Item 310. The substrate for a thin film as described in Item 308 or 309, wherein the average surface roughness Ra of the sintered compact comprising as a main component a ceramic material having at least one of the crystal structures selected from a hexagonal system or a trigonal system is more than 2000 nm.
Item 311. The substrate for a thin film as described in any one of Items 302-310, wherein the surface of the sintered compact comprising as a main component a ceramic material having at least one of the crystal structures selected from a hexagonal system or a trigonal system is at least one of the states selected from an as-fired state, a state in which lap polish was carried out, a state in which blast polish was carried out, a state in which specular surface polish was carried out, a state in which chemistry corrosion was carried out, and a state corroded by plasma gas.
Item 312. The substrate for a thin film as described in Item 311, wherein the surface of the sintered compact comprising as a main component a ceramic material having at least one of the crystal structures selected from a hexagonal system or a trigonal system is the state in which specular surface polish was carried out.
Item 313. The substrate for a thin film as described in any one of Items 302-312, wherein the sintered compact comprising as a main component a ceramic material having at least one of the crystal structures selected from a hexagonal system or a trigonal system comprises a sintered compact which comprises as a main component at least one selected from zinc oxide, beryllium oxide, aluminum oxide, silicon carbide, silicon nitride, and gallium nitride.
Item 314. The substrate for a thin film as described in any one of Items 1-70, wherein the ceramic-based sintered compact, and the ceramic-based sintered compact having optical permeability, are respectively a sintered compact comprising as a main component at least one selected from zirconium oxide, magnesium oxide, magnesium aluminate, titanium oxide, barium titanate, lead titanate zirconate, a rare earth oxide, thorium oxide, various ferrites, mullite, forsterite, steatite, and glass.
Item 315. The substrate for a thin film as described in Item 314, wherein the ceramic-based sintered compact is a sintered compact comprising as a main component at least one selected from zirconium oxide, magnesium oxide, magnesium aluminate, and yttrium oxide
Item 316. The substrate for a thin film as described in Item 314 or 315, wherein the substrate comprises the sintered compact having the average surface roughness Ra not more than 2000 nm and comprising as a main component at least one selected from zirconium oxide, magnesium oxide, magnesium aluminate, titanium oxide, barium titanate, lead titanate zirconate, a rare earth oxide, thorium oxide, various ferrites, mullite, forsterite, steatite, and glass.
Item 317. The substrate for a thin film as described in Item 316, wherein the substrate comprises the sintered compact having the average surface roughness Ra not more than 1000 nm and comprising as a main component at least one selected from zirconium oxide, magnesium oxide, magnesium aluminate, titanium oxide, barium titanate, lead titanate zirconate, a rare earth oxide, thorium oxide, various ferrites, mullite, forsterite, steatite, and glass.
Item 318. The substrate for a thin film as described in Item 316 or 317, wherein the substrate comprises the sintered compact having the average surface roughness Ra not more than 100 nm and comprising as a main component at least one selected from zirconium oxide, magnesium oxide, magnesium aluminate, titanium oxide, barium titanate, lead titanate zirconate, a rare earth oxide, thorium oxide, various ferrites, mullite, forsterite, steatite, and glass.
Item 319. The substrate for a thin film as described in any one of Items 316-318, wherein the substrate comprises the sintered compact having the average surface roughness Ra not more than 10 nm and comprising as a main component at least one selected from zirconium oxide, magnesium oxide, magnesium aluminate, titanium oxide, barium titanate, lead titanate zirconate, a rare earth oxide, thorium oxide, various ferrites, mullite, forsterite, steatite, and glass.
Item 320. The substrate for a thin film as described in any one of Items 316-319, wherein the substrate comprises the sintered compact having the average surface roughness Ra not more than 5 nm and comprising as a main component at least one selected from zirconium oxide, magnesium oxide, magnesium aluminate, titanium oxide, barium titanate, lead titanate zirconate, a rare earth oxide, thorium oxide, various ferrites, mullite, forsterite, steatite, and glass.
Item 321. The substrate for a thin film as described in any one of Items 314-318, wherein the substrate comprises the sintered compact having large surface roughness and comprising as a main component at least one selected from zirconium oxide, magnesium oxide, magnesium aluminate, titanium oxide, barium titanate, lead titanate zirconate, a rare earth oxide, thorium oxide, various ferrites, mullite, forsterite, steatite, and glass.
Item 322. The substrate for a thin film as described in any one of Items 314-318 and 320, wherein the substrate comprises the sintered compact having the average surface roughness Ra not less than 70 nm and comprising as a main component at least one selected from zirconium oxide, magnesium oxide, magnesium aluminate, titanium oxide, barium titanate, lead titanate zirconate, a rare earth oxide, thorium oxide, various ferrites, mullite, forsterite, steatite, and glass.
Item 323. The substrate for a thin film as described in Item 322, wherein the substrate comprises the sintered compact having the average surface roughness Ra more than 1000 nm and comprising as a main component at least one selected from zirconium oxide, magnesium oxide, magnesium aluminate, titanium oxide, barium titanate, lead titanate zirconate, a rare earth oxide, thorium oxide, various ferrites, mullite, forsterite, steatite, and glass.
Item 324. The substrate for a thin film as described in Item 322 or 323, wherein the substrate comprises the sintered compact having the average surface roughness Ra more than 2000 nm and comprising as a main component at least one selected from zirconium oxide, magnesium oxide, magnesium aluminate, titanium oxide, barium titanate, lead titanate zirconate, a rare earth oxide, thorium oxide, various ferrites, mullite, forsterite, steatite, and glass.
Item 325. The substrate for a thin film as described in any one of Items 314-324, wherein it is at least one of the states selected from an as-fired state, a state in which lap polish was carried out, a state in which blast polish was carried out, a state in which specular surface polish was carried out, a state in which chemistry corrosion was carried out, and a state corroded by plasma gas, as the surface of the sintered compact comprising as a main component at least one selected from zirconium oxide, magnesium oxide, magnesium aluminate, titanium oxide, barium titanate, lead titanate zirconate, a rare earth oxide, thorium oxide, various ferrites, mullite, forsterite, steatite, and glass.
Item 326. The substrate for a thin film as described in Item 325, wherein it is a state in which specular surface polish was carried out, as the surface of the sintered compact comprising as a main component at least one selected from zirconium oxide, magnesium oxide, magnesium aluminate, titanium oxide, barium titanate, lead titanate zirconate, a rare earth oxide, thorium oxide, various ferrites, mullite, forsterite, steatite, and glass.
Item 327. The substrate for a thin film as described in any one of Items 1-326, wherein the thin film comprises at least one selected from gallium nitride, indium nitride and aluminum nitride as a main component, and the thin film formed on the substrate and comprising as a main component at least one selected from gallium nitride, indium nitride and aluminum nitride has at least one of the states selected from a single crystal, an amorphous state, a polycrystal, and an orientated polycrystal.
Item 328. The substrate for a thin film as described in Item 327, wherein a part of the thin film formed on the substrate and comprising as a main component at least one selected from gallium nitride, indium nitride and aluminum nitride is a single crystal at least.
Item 329. The substrate for a thin film as described in Item 327 or 328, wherein a part of the thin film formed on the substrate and comprising as a main component at least one selected from gallium nitride, indium nitride and aluminum nitride is a single crystal at least and further comprises at least one of the crystallization states selected from an amorphous state, a polycrystal, and an orientated polycrystal.
Item 330. The substrate for a thin film as described in Item 328, wherein the thin film formed on the substrate and comprising as a main component at least one selected from gallium nitride, indium nitride and aluminum nitride is a single crystal altogether. Item 331. The substrate for a thin film as described in any one of Items 327-329, wherein a part of the thin film formed on the substrate and comprising as a main component at least one selected from gallium nitride, indium nitride and aluminum nitride is amorphous at least.
Item 332. The substrate for a thin film as described in Item 331, wherein a part of the thin film formed on the substrate and comprising as a main component at least one selected from gallium nitride, indium nitride and aluminum nitride is amorphous at least and further comprises at least one of the crystallization states selected from a single crystal, a polycrystal, and an orientated polycrystal.
Item 333. The substrate for a thin film as described in Item 332, wherein the thin film formed on the substrate and comprising as a main component at least one selected from gallium nitride, indium nitride and aluminum nitride is amorphous altogether.
Item 334. The substrate for a thin film as described in any one of Items 327-329, 331 and 332, wherein a part of the thin film formed on the substrate and comprising as a main component at least one selected from gallium nitride, indium nitride and aluminum nitride is a polycrystal at least.
Item 335. The substrate for a thin film as described in Item 334, wherein a part of the thin film formed on the substrate and comprising as a main component at least one selected from gallium nitride, indium nitride and aluminum nitride is a polycrystal at least and further comprises at least one of the crystallization states selected from a single crystal, an amorphous state, and an orientated polycrystal.
Item 336. The substrate for a thin film as described in Item 334, wherein the thin film formed on the substrate and comprising as a main component at least one selected from gallium nitride, indium nitride and aluminum nitride is a polycrystal altogether.
Item 337. The substrate for a thin film as described in any one of Items 327-329, 331, 332, 334, and 335, wherein a part of the thin film formed on the substrate and comprising as a main component at least one selected from gallium nitride, indium nitride and aluminum nitride is an orientated polycrystal at least.
Item 338. The substrate for a thin film as described in Item 334, wherein a part of the thin film formed on the substrate and comprising as a main component at least one selected from gallium nitride, indium nitride and aluminum nitride is an orientated polycrystal at least and further comprises at least one of the crystallization states selected from a single crystal, an amorphous state, and a polycrystal.
Item 339. The substrate for a thin film as described in Item 337, wherein the thin film formed on the substrate and comprising as a main component at least one selected from gallium nitride, indium nitride and aluminum nitride is an orientated polycrystal altogether.
Item 340. The substrate for a thin film as described in any one of Items 327-332, 334, 335, 337, and 338, wherein a part of the thin film formed on the substrate and comprising as a main component at least one selected from gallium nitride, indium nitride and aluminum nitride is a single crystal at least, and the single crystal portion of the thin film is formed directly on the substrate comprising an aluminum nitride-based sintered compact.
Item 341. The substrate for a thin film as described in any one of Items 327-332, 334, 335, 337, and 338, wherein a part of the thin film formed on the substrate and comprising as a main component at least one selected from gallium nitride, indium nitride and aluminum nitride is a single crystal at least, and the single crystal portion of the thin film is formed directly on the substrate comprising a sintered compact comprising as a main component a ceramic material having at least one of the crystal structures selected from a hexagonal system or a trigonal system.
Item 342. The substrate for a thin film as described in any one of Items 327-329, 331, and 332-339, wherein a part of the thin film formed on the substrate and comprising as a main component at least one selected from gallium nitride, indium nitride and aluminum nitride is at least one of the crystallization states selected from an amorphous state, a polycrystal, and an orientated polycrystal, and the portion of the thin film of at least one of the crystallization states selected from an amorphous state, a polycrystal, and an orientated polycrystal is formed directly on the substrate comprising an aluminum nitride-based sintered compact.
Item 343. The substrate for a thin film as described in any one of Items 327-329, 331-339, wherein a part of the thin film formed on the substrate and comprising as a main component at least one selected from gallium nitride, indium nitride and aluminum nitride is at least one of the crystallization states selected from an amorphous state, a polycrystal, and an orientated polycrystal, and the portion of the thin film of at least one of the crystallization states selected from an amorphous state, a polycrystal, and an orientated polycrystal is formed directly on the substrate comprising a sintered compact comprising as a main component a ceramic material having at least one of the crystal structures selected from a hexagonal system or a trigonal system.
Item 344. The substrate for a thin film as described in any one of Items 327-329, 331-339, wherein a part of the thin film formed on the substrate and comprising as a main component at least one selected from gallium nitride, indium nitride and aluminum nitride is at least one of the crystallization states selected from an amorphous state, a polycrystal, and an orientated polycrystal, and the portion of the thin film of at least one of the crystallization states selected from an amorphous state, a polycrystal, and an orientated polycrystal is formed directly on the substrate comprising a ceramic-based sintered compact having optical permeability.
Item 345. The substrate for a thin film as described in any one of Items 327-344, wherein the thin film formed on the substrate and comprising as a main component at least one selected from gallium nitride, indium nitride and aluminum nitride is constituted with two layers at least.
Item 346. The substrate for a thin film as described in Item 345, wherein each layer of the thin film constituted with two or more layers has at least one of the crystallization states selected from a single crystal, an amorphous state, a polycrystal, and an orientated polycrystal.
Item 347. The substrate for a thin film as described in Item 345 or 346, wherein the thin film formed directly on the substrate has at least one of the crystallization states selected from a single crystal, an amorphous state, a polycrystal, and an orientated polycrystal, in the thin film constituted with two or more layers.
Item 348. The substrate for a thin film as described in any one of Items 345-347, wherein the thin film directly formed on the substrate has at least one of the crystallization states selected from an amorphous state, a polycrystal, and an orientated polycrystal, in the thin film constituted with two or more layers.
Item 349. The substrate for a thin film as described in any one of Items 345-348, wherein the thin film formed directly on the substrate has at least one of the crystallization states selected from an amorphous state, a polycrystal, and an orientated polycrystal and the thin film formed on it is a single crystal, in the thin film constituted with two or more layers.

Item 350. The substrate for a thin film as described in Item 349, wherein the thin film formed directly on the substrate is an amorphous state and the thin film formed on it is a single crystal, in the thin film constituted with two or more layers.
Item 351. The substrate for a thin film as described in Item 349, wherein the thin film formed directly on the substrate is a polycrystal and the thin film formed on it is a single crystal, in the thin film constituted with two or more layers.
Item 352. The substrate for a thin film as described in Item 349, wherein the thin film formed directly on the substrate is an orientated polycrystal and the thin film formed on it is a single crystal, in the thin film constituted with two or more layers.
Item 353. The substrate for a thin film as described in any one of Items 345-352, wherein the thin film formed directly on the substrate has at least one of the crystallization states selected from an amorphous state, a polycrystal, and an orientated polycrystal and the thin film formed on it is a single crystal which comprises two or more layers, in the thin film constituted with two or more layers.
Item 354. The substrate for a thin film as described in any one of Items 345-353, wherein at least two layers comprise a single crystal, in the thin film constituted with two or more layers.
Item 355. The substrate for a thin film as described in any one of Items 345-347 and 354, wherein the thin film formed directly on the substrate comprises a single crystal, in the thin film constituted with two or more layers.
Item 356. The substrate for a thin film as described in any one of Items 345-347, 354, and 355, wherein all layers comprise a single crystal, in the thin film constituted with two or more layers.
Item 357. The substrate for a thin film as described in any one of Items 345-356, wherein at least two layers comprise different composition, in the thin film constituted with two or more layers.
Item 358. The substrate for a thin film as described in any one of Items 327-335, 337, 338, and 340-357, wherein a part of the thin film formed on the substrate comprises at least a single crystal in which the crystal C axis of the single-crystal thin film is formed in the perpendicular direction to the substrate surface.
Item 359. The substrate for a thin film as described in Item 358, wherein all the thin films formed on the substrate comprise a single crystal in which the crystal C axis of the single-crystal thin film is formed in the perpendicular direction to the substrate surface. Item 360. The substrate for a thin film as described in any one of Items 327-332, 334, 335, 337, 338, and 340-357, wherein a part of the thin film formed on the substrate comprises at least a single crystal in which the crystal C axis of the single-crystal thin film is formed in the parallel direction to the substrate surface.
Item 361. The substrate for a thin film as described in Item 360, wherein all the thin films formed on the substrate comprise a single crystal in which the crystal C axis of the single-crystal thin film is formed in the parallel direction to the substrate surface.
Item 362. The substrate for a thin film as described in any one of Items 1-361, wherein the thin film comprises at least one selected from gallium nitride, indium nitride and aluminum nitride as a main component, and the thin film formed on the substrate has conductivity.
Item 363. The substrate for a thin film as described in Item 362, wherein the thin film has conductivity by being semiconductorized.
Item 364. The substrate for a thin film as described in Item 362 or 363, wherein the thin film is semiconductorized by doping at least one or more components selected from magnesium, beryllium, calcium, zinc, cadmium, carbon, silicon, germanium, selenium, tellurium, and oxygen and has conductivity.
Item 365. The substrate for a thin film as described in any one of Items 362-364, wherein the thin film is semiconductorized into P type by doping at least one or more components selected from magnesium, alcium, zinc, cadmium, and carbon and has conductivity.
Item 366. The substrate for a thin film as described in any one of Items 362-364, wherein the thin film is semiconductorized into N type by doping at least one or more components selected from silicon, germanium, selenium, tellurium, and oxygen and has conductivity.
Item 367. The substrate for a thin film as described in any one of Items 362-366, wherein the thin film contains a doping component in the range of 0.00001-10 mol % to the main component on an element basis.
Item 368. The substrate for a thin film as described in any one of Items 327-367, wherein the thin film is constituted with at least two layers and at least one layer in the thin film has conductivity.
Item 369. The substrate for a thin film as described in any one of Items 362-368, wherein the electric resistivity of the thin film having conductivity is not more than 1x10⁴ Ω·cm at room temperature.
Item 370. The substrate for a thin film as described in Item 369, wherein the electric resistivity of the thin film having conductivity is not more than 1x10² Ω·cm at room temperature.
Item 371. The substrate for a thin film as described in Item 3 69 or 3 70, wherein the electric resistivity of the thin film having conductivity is not more than 1x10¹ Ω·cm at room temperature.
Item 372. The substrate for a thin film as described in any one of Items 369-371, wherein the electric resistivity of the thin film having conductivity is not more than 1x10° Ω·cm at room temperature.
Item 373. The substrate for a thin film as described in any one of Items 1-372, wherein the thin film comprises at least one selected from gallium nitride, indium nitride and aluminum nitride as a main component, and the thin film formed on the substrate comprises as a main component the composite expressed with the chemical formula of AlₓGa₁₋ₓN (0≤x≤1.0).
Item 374. The substrate for a thin film as described in Item 373, wherein the thin film comprises as a main component the composite expressed with the chemical formula of AlₓGa₁₋ₓN (0≤x≤1.0), and contains further at least one selected from Mg (magnesium), Be (beryllium), and Zn (zinc) in the range of 0.00001-10 mol % to the composite on an element basis.
Item 375. The substrate for a thin film as described in Item 373 or 374, wherein the thin film comprises as a main component the composite expressed with the chemical formula of AlₓGa₁₋ₓN (0≤x≤1.0), and contains further Si (silicon) in the range of 0.00001-10 mol % to the composite on an element basis.
Item 376. The substrate for a thin film as described in any one of Items 373-375, wherein the thin film comprises as a main component the composite expressed with the chemical formula of AlₓGa₁₋ₓN (0≤x≤1.0), and contains further at least one selected from Mg, Be and Zn, and simultaneously Si a total of the range of 0.00001-10 mol % to the composite on an element basis.
Item 377. The substrate for a thin film as described in any one of Items 373-376, wherein the thin film comprises as a main component the composite expressed with the chemical formula of AlₓGa₁₋ₓN (0≤x≤0.6).
Item 378. The substrate for a thin film as described in Item 377, wherein the thin film comprises as a main component the composite expressed with the chemical formula of AlₓGa₁₋ₓN (0≤x≤0.6), and contains further at least one selected from Mg, Be, and Zn in the range of 0.00001-10 mol % to the composite on an element basis.
Item 379. The substrate for a thin film as described in Item 377 or 378, wherein the thin film comprises as a main component the composite expressed with the chemical formula of AlₓGa₁₋ₓN (0≤x≤0.6), and contains further Si in the range of 0.00001-10 mol % to the composite on an element basis.
Item 380. The substrate for a thin film as described in any one of Items 377-379, wherein the thin film comprises as a main component the composite expressed with the chemical formula of AlₓGa₁₋ₓN (0≤x≤0.6), and contains further at least one selected from Mg, Be, and Zn, and simultaneously Si a total of the range of 0.00001-10 mol % to the composite on an element basis.
Item 381. The substrate for a thin film as described in any one of Items 373-376, wherein the thin film comprises as a main component the composite expressed with the chemical formula of AlₓGa₁₋ₓN (0≤x≤0.6).
Item 382. The substrate for a thin film as described in Item 381, wherein the thin film comprises as a main component the composite expressed with the chemical formula of AlₓGa₁₋ₓN (0≤x≤0.6), and contains further at least one selected from Mg, Be, and Zn in the range of 0.00001-0.5 mol % to the composite on an element basis.
Item 383. The substrate for a thin film as described in Item 381 or 382, wherein the thin film comprises as a main component the composite expressed with the chemical formula of AlₓGa₁₋ₓN (0≤x≤0.6), and contains further Si in the range of 0.00001-0.5 mol % to the composite on an element basis.
Item 384. The substrate for a thin film as described in any one of Items 381-383, wherein the thin film comprises as a main component the composite expressed with the chemical formula of AlₓGa₁₋ₓN (0≤x≤0.6), and contains further at least one selected from Mg, Be, and Zn, and simultaneously Si a total of the range of 0.00001-10 mol % to the composite on an element basis.
Item 385. The substrate for a thin film as described in any one of Items 1-384, wherein a thin film comprises at least one selected from gallium nitride, indium nitride and aluminum nitride as a main component, and the thickness of the thin film formed on the substrate is 0.5 nm or more.
Item 386. The substrate for a thin film as described in Item 385, wherein the thickness of the thin film formed is not less than 0.3 µm.
Item 387. The substrate for a thin film as described in Item 385 or 386, wherein the thickness of the thin film formed is not less than 3.5 µm.
Item 388. The substrate for a thin film as described in any one of Items 385-387, wherein the thickness of the thin film formed is not less than 10 µm.
Item 389. The substrate for a thin film as described in any one of Items 385-388, wherein the thickness of the thin film formed is not less than 50 µm.
Item 390. The substrate for a thin film as described in any one of Items 1-389, wherein a thin film comprises at least one selected from gallium nitride, indium nitride and aluminum nitride as a main component, and the thickness of the thin film formed on the substrate is not more than 1000 µm.
Item 391. The substrate for a thin film as described in Item 390, wherein the thin film comprises the thin film layers in which each thickness is not more than 1000 µm. Item 392. The substrate for a thin film as described in Item 390 or 391, wherein the thickness of all the thin film layers is not more than 1000 µm.
Item 393. The substrate for a thin film as described in any one of Items 390-392, wherein the thickness of the thin film is not more than 500 µm.
Item 394. The substrate for a thin film as described in Item 393, wherein the thin film comprises the thin film layers in which each thickness is not more than 500 µm.
Item 395. The substrate for a thin film as described in Item 393 or 394, wherein the thickness of all the thin film layers is not more than 500 µm.
Item 396. The substrate for a thin film as described in any one of Items 390-395, wherein the thickness of the thin film is less than 300 µm.
Item 397. The substrate for a thin film as described in Item 396, wherein the thin film comprises the thin film layers in which each thickness is less than 300 µm.
Item 398. The substrate for a thin film as described in Item 396 or 397, wherein the thickness of all the thin film layers is less than 300 µm.
Item 399. The substrate for a thin film as described in any one of Items 1-398, wherein a thin film comprises at least one selected from gallium nitride, indium nitride and aluminum nitride as a main component, and the thin film formed on the substrate has at least the single-crystal thin film in which the half width of the rocking curve of the X ray diffraction from the lattice plane of the Miller Index (002) is not more than 3600 seconds.

Item 400. The substrate for a thin film as described in Item 399, wherein the half width of the rocking curve of the X ray diffraction from the lattice plane of the Miller Index (002) of the single-crystal thin film is not more than 300 seconds.
Item 401. The substrate for a thin film as described in Item 399 or 400, wherein the half width of the rocking curve of the X ray diffraction from the lattice plane of the Miller Index (002) of the single-crystal thin film is not more than 240 seconds.
Item 402. The substrate for a thin film as described in any one of Items 399-401, wherein the half width of the rocking curve of the X ray diffraction from the lattice plane of the Miller Index (002) of the single-crystal thin film is not more than 200 seconds.
Item 403. The substrate for a thin film as described in any one of Items 399-402, wherein the half width of the rocking curve of the X ray diffraction from the lattice plane of the Miller Index (002) of the single-crystal thin film is not more than 150 seconds.
Item 404. The substrate for a thin film as described in any one of Items 399-403, wherein the half width of the rocking curve of the X ray diffraction from the lattice plane of the Miller Index (002) of the single-crystal thin film is not more than 130 seconds.
Item 405. The substrate for a thin film as described in any one of Items 399-404, wherein the half width of the rocking curve of the X ray diffraction from the lattice plane of the Miller Index (002) of the single-crystal thin film is not more than 100 seconds.
Item 406. The substrate for a thin film as described in any one of Items 1-405, wherein a thin film comprises at least one selected from gallium nitride, indium nitride and aluminum nitride as a main component, and the thin film formed on the substrate is formed using an organic compound containing at least one selected from gallium, indium, and aluminum as the main raw material and using at least one selected from ammonia, nitrogen, and hydrogen as the reactive gas.
Item 407. The substrate for a thin film as described in Item 406, wherein the organic compound containing at least one selected from gallium, indium, and aluminum is at least one selected from trimethyl gallium, trimethyl indium, and trimethyl aluminum.
Item 408. The substrate for a thin film as described in any one of Items 1-405, wherein a thin film comprises at least one selected from gallium nitride, indium nitride and aluminum nitride as a main component, and the thin film is formed using a halogenated compound containing at least one selected from gallium, indium, and aluminum as the main raw material and using at least one selected from ammonia, nitrogen, and hydrogen as the reactive gas.
Item 409. The substrate for a thin film as described in Item 408, wherein the halogenated compound containing is at least one selected from gallium chloride, indium chloride, and aluminium chloride.
Item 410. A manufacture method of the substrate for a thin film in which a thin film comprises at least one selected from gallium nitride, indium nitride and aluminum nitride as a main component, and the substrate comprises an aluminum nitride-based sintered compact produced respectively using independently either of the raw materials selected from that produced by the method of the reduction of aluminum oxide and that produced by the direct nitriding method of metal aluminum, or using the mixture of the raw materials of that produced by the method of the reduction of aluminum oxide and that produced by the direct nitriding method of metal aluminum.
Item 411. A manufacture method of the substrate for a thin film in which a thin film comprises at least one selected from gallium nitride, indium nitride and aluminum nitride as a main component, and the substrate comprises an aluminum nitride-based sintered compact obtained by firing the powder compact or sintered compact which comprise aluminum nitride as a main component at the temperature not less than 1500°C for not less than 10 minutes in non-oxidizing atmosphere.
Item 412. The manufacture method of the substrate for a thin film as described in Item 410 or 411, wherein the thin film comprises at least one selected from gallium nitride, indium nitride and aluminum nitride as a main component, and the substrate comprises an aluminum nitride-based sintered compact obtained by firing the powder compact or sintered compact which comprise aluminum nitride as a main component and are produced respectively using independently either of the raw materials selected from that produced by the method of the reduction of aluminum oxide and that produced by the direct nitriding method of metal aluminum, or using the mixture of the raw materials of that produced by the method of the reduction of aluminum oxide and that produced by the direct nitriding method of metal aluminum, at the temperature not less than 1500°C for not less than 10 minutes in non-oxidizing atmosphere.
Item 413. The manufacture method of the substrate for a thin film as described in any one of Items 410-412, wherein the aluminum nitride-based sintered compact has optical permeability.
Item 414. The manufacture method of the substrate for a thin film as described in any one of Items 410-413, wherein the optical transmissivity of the aluminum nitride-based sintered compact is not less than 1 %.
Item 415. The manufacture method of the substrate for a thin film as described in Item 414, wherein the optical transmissivity of the aluminum nitride-based sintered compact is not less than 5 %.
Item 416. The manufacture method of the substrate for a thin film as described in Item 414 or 415, wherein the optical transmissivity of the aluminum nitride-based sintered compact is not less than 10 %.
Item 417. The manufacture method of the substrate for a thin film as described in any one of Items 414-416, wherein the optical transmissivity of the aluminum nitride-based sintered compact is not less than 20 %.
Item 418. The manufacture method of the substrate for a thin film as described in any one of Items 414-417, wherein the optical transmissivity of the aluminum nitride-based sintered compact is not less than 30 %.
Item 419. The manufacture method of the substrate for a thin film as described in any one of Items 414-418, wherein the optical transmissivity of the aluminum nitride-based sintered compact is not less than 40 %.
Item 420. The manufacture method of the substrate for a thin film as described in any one of Items 414-419, wherein the optical transmissivity of the aluminum nitride-based sintered compact is not less than 50 %.
Item 421. The manufacture method of the substrate for a thin film as described in any one of Items 414-420, wherein the optical transmissivity of the aluminum nitride-based sintered compact is not less than 60 %.
Item 422. The manufacture method of the substrate for a thin film as described in any one of Items 414-421, wherein the optical transmissivity of the aluminum nitride-based sintered compact is not less than 80 %.
Item 423. The manufacture method of the substrate for a thin film as described in any one of Items 414-422, wherein the optical transmissivity of the aluminum nitride-based sintered compact is not less than 85 %.
Item 424. The manufacture method of the substrate for a thin film as described in any one of Items 410-423, wherein the substrate comprises an aluminum nitride-based sintered compact obtained by firing the powder compact or sintered compact which comprise aluminum nitride as a main component at the temperature not less than 1500°C for not less than 10 minutes in non-oxidizing atmosphere containing an aluminum nitride component.
Item 425. The manufacture method of the substrate for a thin film as described in Item 424, wherein the substrate comprises an aluminum nitride-based sintered compact obtained by firing at the temperature not less than 1500°C for not less than 10 minutes in non-oxidizing atmosphere by supplying the aluminum nitride component to the non-oxidizing atmosphere which is a firing atmosphere from the powder compact or sintered compact which comprise aluminum nitride as a main component and are the fired thing.
Item 426. The manufacture method of the substrate for a thin film as described in Item 424, wherein the substrate comprises an aluminum nitride-based sintered compact obtained by firing at the temperature not less than 1500°C for not less than 10 minutes in non-oxidizing atmosphere by supplying the aluminum nitride component to the non-oxidizing atmosphere which is a firing atmosphere from that other than the powder compact or sintered compact which comprise aluminum nitride as a main component and are the fired thing.
Item 427. The manufacture method of the substrate for a thin film as described in Item 424 or 426, wherein the powder compact or sintered compact which comprise as a main component aluminum nitride are fired using the firing container or firing implement which comprise a material comprising aluminum nitride as a main component.
Item 428. The manufacture method of the substrate for a thin film as described in Item 426 or 427, wherein the powder compact or sintered compact which comprise aluminum nitride as a main component and are the fired thing are put into the firing container or the firing implement, and are fired simultaneously with that which is a thing other than the fired thing and was selected from the aluminum nitride-based powder, the aluminum nitride-based powder compact, and the aluminum nitride-based sintered compact.
Item 429. The manufacture method of the substrate for a thin film as described in any one of Items 424-428, wherein the powder compact or sintered compact which comprise as a main component aluminum nitride are fired using the firing container or firing implement which comprise as a main component a material selected from aluminum nitride, tungsten, molybdenum, boron nitride, and carbon coated with boron nitride.
Item 430. The manufacture method of the substrate for a thin film as described in any one of Items 410-429, wherein the aluminum nitride-based powder compact is once fired, and is made into the aluminum nitride-based sintered compact, and pressurization sintering of the sintered compact is carried out by the hot press method or the hot isostatic press (HIP) method.
Item 431. The manufacture method of the substrate for a thin film was described in any one of Items 410-430, wherein the thin film comprises at least one selected from gallium nitride, indium nitride and aluminum nitride as a main component, and the substrate that in which the powder compact or sintered compact which comprise as a main component aluminum nitride were fired at the temperature not less than 1750°C for not less than 3 hours in non-oxidizing atmosphere.
Item 432. The manufacture method of the substrate for a thin film as described in any one of Items 410-431, wherein the thin film comprises at least one selected from gallium nitride, indium nitride and aluminum nitride as a main component, and the substrate comprises the aluminum nitride-based sintered compact and is obtained by vaporizing, removing and decreasing at least one selected from a rare earth element compound, an alkaline-earth-metal compound, and oxygen among the components contained, by firing the powder compact or sintered compact which comprise as a main component aluminum nitride and contain at least one selected from a rare earth element compound and an alkaline-earth-metal compound at the temperature not less than 1750°C for not less than 3 hours in non-oxidizing atmosphere.
Item 433. The manufacture method of the substrate for a thin film as described in Item 431 or 432, wherein the firing temperature is not less than 1900°C.
Item 434. The manufacture method of the substrate for a thin film as described in any one of Items 431-433, wherein the firing temperature is not less than 2050°C.
Item 435. The manufacture method of the substrate for a thin film as described in any one of Items 431-434, wherein the firing temperature is not less than 2100°C.
Item 436. The manufacture method of the substrate for a thin film as described in any one of Items 410-435, wherein the thin film comprises at least one selected from gallium nitride, indium nitride and aluminum nitride as a main component, and the substrate comprises the aluminum nitride-based sintered compact obtained by vaporizing, removing and decreasing at least one selected from a rare earth element compound, an alkaline-earth-metal compound, and oxygen among the components contained, by firing the powder compact or sintered compact which comprise as a main component aluminum nitride and contain simultaneously at least one selected from a rare earth element compound and at least one selected from an alkaline-earth-metal compound at the temperature not less than 1750°C for not less than 3 hours in non-oxidizing atmosphere.
Item 437. The manufacture method of the substrate for a thin film as described in any one of Items 410-436, wherein the thin film comprises at least one selected from gallium nitride, indium nitride and aluminum nitride as a main component, and the substrate for a thin film comprises an aluminum nitride-based sintered compact obtained by firing the powder compact which comprises aluminum nitride as a main component, and the powder compact comprises a green sheet which comprises aluminum nitride raw material powder as a main component.
Item 438. The manufacture method of the substrate for a thin film as described in any one of Items 410-437, wherein the thin film comprises at least one selected from gallium nitride, indium nitride and aluminum nitride as a main component, and the substrate for a thin film comprises an aluminum nitride-based sintered compact and is obtained by firing furthermore the aluminum nitride-based sintered compact and is obtained by firing the aluminum nitride-based powder compact, and the powder compact comprises a green sheet which comprises aluminum nitride raw material powder as a main component.
Item 439. The manufacture method of the substrate for a thin film as described in any one of Items 410-438, wherein the substrate is fired at the temperature not less than 1750°C for not less than 10 hours.
Item 440. The manufacture method of the substrate for a thin film as described in any one of Items 410-439, wherein the substrate is fired at the temperature not less than 1900°C for not less than 6 hours.
Item 441. The manufacture method of the substrate for a thin film as described in any one of Items 410-440, wherein the substrate is fired at the temperature not less than 2050°C for not less than 4 hours.
Item 442. The manufacture method of the substrate for a thin film as described in any one of Items 410-441, wherein the substrate is fired at the temperature not less than 2100°C for not less than 3 hours.
Item 443. The manufacture method of the substrate for a thin film as described in any one of Items 410-442, wherein the firing atmosphere contains at least one selected from nitrogen, helium, neon, and argon.
Item 444. The manufacture method of the substrate for a thin film as described in any one of Items 410-443, wherein the firing atmosphere is the reduced atmosphere.
Item 445. The manufacture method of the substrate for a thin film as described in any one of Items 410-444, wherein the firing atmosphere contains at least one selected from hydrogen, carbon, carbon monoxide, and hydrocarbon.
Item 446. The manufacture method of the substrate for a thin film as described in any one of Items 443-445, wherein the firing atmosphere contains at least one selected from hydrogen, carbon, carbon monoxide, and hydrocarbon not less than 0.1 ppm.
Item 447. The manufacture method of the substrate for a thin film as described in any one of Items 410-446, wherein the minimum size of the powder compact or sintered compact which comprise aluminum nitride as a main component and are fired is not more than 8 mm.
Item 448. The manufacture method of the substrate for a thin film as described in any one of Items 410-447, wherein the powder compact or sintered compact which comprise aluminum nitride as a main component and are fired is board-like, and the thickness is not more than 8 mm.
Item 449. An aluminum nitride-based sintered compact, wherein the content of at least one selected from a rare earth element and an alkaline-earth metal is a total of not more than 0.5 % by weight on an element basis, the content of oxygen is not more than 0.9 % by weight on an element basis, AlN is not less than 95 % as a crystal phase, the average size of aluminum nitride particles is not less than 5 µm, and having optical permeability.

Item 450. The aluminum nitride-based sintered compact as described in Item 449, wherein the content of at least one selected from a rare earth element and an alkaline-earth metal is a total of not more than 0.2 % by weight on an element basis, and the content of oxygen is not more than 0.5 % by weight.
Item 451. The aluminum nitride-based sintered compact as described in Item 449 or 450, wherein the content of at least one selected from a rare earth element and an alkaline-earth metal is a total of not more than 0.05 % by weight on an element basis, and the content of oxygen is not more than 0.2 % by weight.
Item 452. The aluminum nitride-based sintered compact as described in any one of Items 449-451, wherein the content of at least one selected from a rare earth element and an alkaline-earth metal is a total of not more than 0.02 % by weight on an element basis, and the content of oxygen is not more than 0.1 % by weight.
Item 453. The aluminum nitride-based sintered compact as described in any one of Items 449-452, wherein the content of at least one selected from a rare earth element and an alkaline-earth metal is a total of not more than 0.005 % by weight on an element basis, and the content of oxygen is not more than 0.05 % by weight.
Item 454. The aluminum nitride-based sintered compact as described in any one of Items 449-453, wherein the optical transmissivity is not less than 1 %.
Item 455. The aluminum nitride-based sintered compact as described in Item 454, wherein the optical transmissivity is not less than 5 %.
Item 456. The aluminum nitride-based sintered compact as described in Item 454 or 455, wherein the optical transmissivity is not less than 10 %.
Item 457. The aluminum nitride-based sintered compact as described in any one of Items 454-456, wherein the optical transmissivity is not less than 20 %.
Item 458. The aluminum nitride-based sintered compact as described in any one of Items 454-457, wherein the optical transmissivity is not less than 30 %.
Item 459. The aluminum nitride-based sintered compact as described in any one of Items 454-458, wherein the optical transmissivity is not less than 40 %.
Item 460. The aluminum nitride-based sintered compact as described in any one of Items 454-459, wherein the optical transmissivity is not less than 50 %.
Item 461. The aluminum nitride-based sintered compact as described in any one of Items 454-460, wherein the optical transmissivity is not less than 60 %.
Item 462. The aluminum nitride-based sintered compact as described in any one of Items 454-461, wherein the optical transmissivity is not less than 80 %.
Item 463. The aluminum nitride-based sintered compact as described in any one of Items 454-462, wherein the optical transmissivity is not less than 85 %.
Item 464. The aluminum nitride-based sintered compact as described in any one of Items 449 and 454-463, wherein the optical permeability or optical transmissivity is that to the light of the range of 200-800 nm wavelength at least.
Item 465. The aluminum nitride-based sintered compact as described in any one of Items 454-464, wherein AlN is contained not less than 98 % as a crystal phase.
Item 466. The aluminum nitride-based sintered compact as described in Item 465, wherein the crystal phase is an AlN single phase substantially.
Item 467. The aluminum nitride-based sintered compact as described in any one of Items 449-466, wherein the size of aluminum nitride particles is not less than 8 µm.
Item 468. The aluminum nitride-based sintered compact as described in Item 467, wherein the size of aluminum nitride particles is not less than 15 µm.
Item 469. The aluminum nitride-based sintered compact as described in Item 467 or 468, wherein the size of aluminum nitride particles is not less than 25 µm.
Item 470. The aluminum nitride-based sintered compact as described in any one of Items 449-469, wherein the size of aluminum nitride particles is not more than 100 µm. Item 471. The aluminum nitride-based sintered compact as described in any one of Items 449-470, wherein the thermal conductivity at room temperature is not less than 200 W/mK.
Item 472. The aluminum nitride-based sintered compact as described in Item 471, wherein the thermal conductivity at room temperature is not less than 220 W/mK.
Item 473. The aluminum nitride-based sintered compact as described in any one of Items 449-472, wherein the average surface roughness Ra is not more than 2000 nm.
Item 474. The aluminum nitride-based sintered compact as described in Item 473, wherein the average surface roughness Ra is not more than 1000 nm.
Item 475. The aluminum nitride-based sintered compact as described in Item 473 or 474, wherein the average surface roughness Ra is not more than 100 nm.
Item 476. The aluminum nitride-based sintered compact as described in any one of Items 473-475, wherein the average surface roughness Ra is not more than 20 nm.
Item 477. The aluminum nitride-based sintered compact as described in any one of Items 449-475, wherein the surface roughness is large.
Item 478. The aluminum nitride-based sintered compact as described in any one of Items 449-475 and 477, wherein the average surface roughness Ra is not less than 70 nm.
Item 479. The aluminum nitride-based sintered compact as described in Item 478, wherein the average surface roughness Ra is more than 1000 nm.
Item 480. The aluminum nitride-based sintered compact as described in Item 478 or 479, wherein the average surface roughness Ra is more than 2000 nm.
Item 481. The aluminum nitride-based sintered compact as described in any one of Items 449-480, wherein the surface is at least one of the states selected from an as-fired state, a state in which lap polish was carried out, a state in which blast polish was carried out, a state in which specular surface polish was carried out, a state in which chemistry corrosion was carried out, and a state corroded by plasma gas.
Item 482. The aluminum nitride-based sintered compact as described in Item 481, wherein a part of the surface is at least in the state where specular surface polish was carried out.
Item 483. The aluminum nitride-based sintered compact as described in any one of Items 449-482, wherein a part of the surface has at least the larger smoothness degree than 2000 nm as the average surface roughness Ra.
Item 484. The aluminum nitride-based sintered compact as described in any one of Items 449-483, wherein the sintered compact is obtained by vaporizing, removing and decreasing at least one selected from a rare earth element compound, an alkaline-earth-metal compound, and oxygen among the components contained, by firing the powder compact or sintered compact which comprise as a main component aluminum nitride and contain at least one selected from a rare earth element compound and an alkaline-earth-metal compound at the temperature not less than 1750°C for not less than 3 hours in non-oxidizing atmosphere.
Item 485. The aluminum nitride-based sintered compact as described in Item 484, wherein the powder compact or sintered compact which comprise as a main component aluminum nitride and contain simultaneously at least one selected from a rare earth element compound and at least one selected from an alkaline-earth-metal compound are fired at the temperature not less than 1750°C for not less than 3 hours in non-oxidizing atmosphere.
Item 486. The aluminum nitride-based sintered compact as described in Item 484 or 485, wherein the raw material of the powder compact or sintered compact which are fired at the temperature not less than 1750°C for not less than 3 hours is one of either selected from that produced by the method of the reduction of aluminum oxide and that produced by the direct nitriding method of metal aluminum, or the mixture of both that produced by the method of the reduction of aluminum oxide and that produced by the direct nitriding method of metal aluminum.
Item 487. The aluminum nitride-based sintered compact as described in any one of Items 484-486, wherein the firing is carried out at the temperature not less than 1750°C for not less than 10 hours.
Item 488. The aluminum nitride-based sintered compact as described in any one of Items 484-487, wherein the firing is carried out at the temperature not less than 1900°C for not less than 6 hours.
Item 489. The aluminum nitride-based sintered compact as described in any one of Items 484-488, wherein the firing is carried out at the temperature not less than 2050°C for not less than 4 hours.
Item 490. The aluminum nitride-based sintered compact as described in any one of Items 484-489, wherein the firing is carried out at the temperature not less than 2100°C for not less than 3 hours.
Item 491. The aluminum nitride-based sintered compact as described in any one of Items 484-490, wherein the firing atmosphere contains at least one selected from nitrogen, helium, neon, an argon.
Item 492. The aluminum nitride-based sintered compact as described in any one of Items 484-491, wherein the firing atmosphere is the reduced atmosphere.
Item 493. The aluminum nitride-based sintered compact as described in any one of Items 484-492, wherein the firing atmosphere contains at least one selected from hydrogen, carbon, carbon monoxide, and hydrocarbon.
Item 494. The aluminum nitride-based sintered compact as described in any one of Items 491-493, wherein the firing atmosphere contains at least one selected from hydrogen, carbon, carbon monoxide, and hydrocarbon not less than 0.1 ppm.
Item 495. The aluminum nitride-based sintered compact as described in any one of Items 484-494, wherein the minimum size of the powder compact or sintered compact which comprise aluminum nitride as a main component and are fired at the temperature not less than 1750°C for not less than 3 hours is not more than 8 mm.
Item 496. The aluminum nitride-based sintered compact as described in any one of Items 484-495, wherein the powder compact or sintered compact which comprise aluminum nitride as a main component and are fired at the temperature not less than 1750°C for not less than 3 hours is board-like, and the thickness is not more than 8 mm.
Item 497. A zinc oxide-based sintered compact contains an aluminum component at least and has optical permeability.
Item 498. The zinc oxide-based sintered compact as described in Item 497, wherein the zinc oxide is contained not less than 55.0 mol % on the basis of ZnO.
Item 499. The zinc oxide-based sintered compact as described in Item 497 or 498, wherein the aluminum component is contained not more than 45.0 mol % on the basis of Al₂O₃.

Item 500. The zinc oxide-based sintered compact as described in Item 499, wherein the aluminum component is contained in the range of 0.001-45.0 mol % on the basis of Al₂O₃.
Item 501. The zinc oxide-based sintered compact as described in Item 499 or 500, wherein the aluminum component is contained in the range of 0.005-45.0 mol % on the basis of Al₂O₃.
Item 502. The zinc oxide-based sintered compact as described in any one of Items 499-501, wherein the aluminum component is contained in the range of 0.02-45.0 mol % on the basis of Al₂O₃.
Item 503. The zinc oxide-based sintered compact as described in any one of Items 499-502, wherein the aluminum component is contained in the range of 0.08-35.0 mol % on the basis of Al₂O₃.
Item 504. The zinc oxide-based sintered compact as described in any one of Items 499-503, wherein the aluminum component is contained and at least one selected from a rare earth element component and a transition metal component is simultaneously contained.
Item 505. The zinc oxide-based sintered compact as described in Item 504, wherein the aluminum component is contained and at least one selected from a rare earth element component is simultaneously contained.
Item 506. The zinc oxide-based sintered compact as described in Item 504 or 505, wherein the rare earth element component is at least one selected from yttrium, dysprosium, holmium, erbium, and ytterbium.
Item 507. The zinc oxide-based sintered compact as described in Item 504, wherein the aluminum component is contained and at least one selected from a transition metal component is simultaneously contained.
Item 508. The zinc oxide-based sintered compact as described in any one of Items 504-507, wherein at least one selected from a rare earth element component and a transition metal component is contained not more than 10.0 mol % on an oxide basis.
Item 509. The zinc oxide-based sintered compact as described in Item 508, wherein at least one selected from a rare earth element component is contained not more than 10.0 mol % on an oxide basis.
Item 510. The zinc oxide-based sintered compact as described in Item 508 or 509, wherein at least one selected from a transition metal component is contained not more than 10.0 mol % on an oxide basis.
Item 511. The zinc oxide-based sintered compact as described in any one of Items 504, 507, 508, and 510, wherein the transition metal component is at least one selected from iron and chromium.
Item 512. The zinc oxide-based sintered compact as described in any one of Items 504-511, wherein the aluminum component is contained not more than 45.0 mol % on the basis of Al₂O₃ and at least one selected from a rare earth element component is simultaneously contained not more than 10.0 mol % on an oxide basis.
Item 513. The zinc oxide-based sintered compact as described in Item 512, wherein at least one selected from a rare earth element component is contained in the range of 0.0002-10.0 mol % on an oxide basis.
Item 514. The zinc oxide-based sintered compact as described in Item 512 or 513, wherein at least one selected from a rare earth element component is contained in the range of 0.0006-6.0 mol % on an oxide basis.
Item 515. The zinc oxide-based sintered compact as described in any one of Items 512-514, wherein at least one selected from a rare earth element component is contained in the range of 0.001-6.0 mol % on an oxide basis.
Item 516. The zinc oxide-based sintered compact as described in any one of Items 512-515, wherein at least one selected from a rare earth element component is contained in the range of 0.002-3.0 mol % on an oxide basis.
Item 517. The zinc oxide-based sintered compact as described in any one of Items 504-516, wherein the aluminum component is contained in the range of 0.001-45.0 mol % on the basis of Al₂O₃ and at least one selected from a rare earth element component is simultaneously contained.
Item 518. The zinc oxide-based sintered compact as described in any one of Items 497-517, wherein the optical transmissivity is not less than 1 %.
Item 519. The zinc oxide-based sintered compact as described in Item 518, wherein the optical transmissivity is not less than 10 %.
Item 520. The zinc oxide-based sintered compact as described in Item 518 or 519, wherein the optical transmissivity is not less than 20 %.
Item 521. The zinc oxide-based sintered compact as described in any one of Items 518-520, wherein the optical transmissivity is not less than 30 %.
Item 522. The zinc oxide-based sintered compact as described in any one of Items 518-521, wherein the optical transmissivity is not less than 40 %.
Item 523. The zinc oxide-based sintered compact as described in any one of Items 518-522, wherein the optical transmissivity is not less than 50 %.
Item 524. The zinc oxide-based sintered compact as described in any one of Items 518-523, wherein the optical transmissivity is not less than 60 %.
Item 525. The zinc oxide-based sintered compact as described in any one of Items 518-524, wherein the optical transmissivity is not less than 80 %.
Item 526. The zinc oxide-based sintered compact as described in any one of Items 497 and 518-525, wherein the optical permeability or optical transmissivity is that to the light of the range of 200-800 nm wavelength at least.
Item 527. The zinc oxide-based sintered compact as described in any one of Items 497-526, wherein the sintered compact has conductivity.
Item 528. The zinc oxide-based sintered compact as described in any one of Items 497-527, wherein the electric resistivity at room temperature is not more than 1x10² Ω·cm.
Item 529. The zinc oxide-based sintered compact as described in Item 528, wherein the electric resistivity at room temperature is not more than 1x10⁰ Ω·cm.
Item 530. The zinc oxide-based sintered compact as described in Item 528 or 529, wherein the electric resistivity at room temperature is not more than 1x10⁻² Ω·cm.
Item 531. The zinc oxide-based sintered compact as described in any one of Items 497-530, wherein the sintered compact has optical permeability and has conductivity.
Item 532. A gallium nitride-based sintered compact having optical permeability. Item 533. The gallium nitride-based sintered compact as described in Item 532, wherein the optical transmissivity is not less than 1 %.
Item 534. The gallium nitride-based sintered compact as described in Item 533, wherein the optical transmissivity is not less than 5 %.
Item 535. The gallium nitride-based sintered compact as described in Item 533 or 534, wherein the optical transmissivity is not less than 10 %.
Item 536. The gallium nitride-based sintered compact as described in any one of Items 533-535, wherein the optical transmissivity is not less than 20 %.
Item 537. The gallium nitride-based sintered compact as described in any one of Items 533-536, wherein the optical transmissivity is not less than 30 %.
Item 538. The gallium nitride-based sintered compact as described in any one of Items 533-537, wherein the optical transmissivity is not less than 40 %.
Item 539. The gallium nitride-based sintered compact as described in any one of Items 533-538, wherein the optical transmissivity is not less than 50 %.
Item 540. The gallium nitride-based sintered compact as described in any one of Items 533-539, wherein the optical transmissivity is not less than 60 %.
Item 541. The gallium nitride-based sintered compact as described in any one of Items 533-540, wherein the optical transmissivity is not less than 80 %.
Item 542. The gallium nitride-based sintered compact as described in any one of Items 533-541, wherein the optical transmissivity is not less than 85 %.
Item 543. A gallium nitride-based sintered compact has the optical transmissivity less than 1 %.
Item 544. The gallium nitride-based sintered compact as described in Item 543, wherein the optical transmissivity is 0 %.
Item 545. The gallium nitride-based sintered compact as described in any one of Items 532-544, wherein the optical permeability or optical transmissivity is that to the light of the range of 200-800 nm wavelength at least.
Item 546. A gallium nitride-based sintered compact has conductivity.
Item 547. The gallium nitride-based sintered compact as described in any one of Items 532-546, wherein the electric resistivity at room temperature is not more than 1x10⁴ Ω·cm.
Item 548. The gallium nitride-based sintered compact as described in Item 546 or 547, wherein the electric resistivity at room temperature is not more than 1x10¹ Ω·cm. Item 549. The gallium nitride-based sintered compact as described in any one of Items 546-548, wherein the electric resistivity at room temperature is not more than 1x10⁰ Ω·cm.

Item 550. The gallium nitride-based sintered compact as described in any one of Items 546-549, wherein the electric resistivity at room temperature is not more than 1x10⁻² Ω·cm.
Item 551. The gallium nitride-based sintered compact as described in any one of Items 532-550, wherein the sintered compact has optical permeability and has conductivity.
Item 552. A gallium nitride-based sintered compact contains a gallium component not less than 55.0 mol %.
Item 553. A gallium nitride-based sintered compact contains at least one selected from an alkaline-earth metal and a rare earth element.
Item 554. The gallium nitride-based sintered compact as described in any one of Items 532-553, wherein at least one selected from an alkaline-earth metal and a rare earth element is contained not more than 30 mol % on an oxide basis.
Item 555. The gallium nitride-based sintered compact as described in Item 553 or 554, wherein at least one selected from an alkaline-earth metal and a rare earth element is contained not more than 30 mol % on an oxide basis.
Item 556. The gallium nitride-based sintered compact as described in any one of Items 553-555, wherein at least one selected from an alkaline-earth metal and a rare earth element is contained not more than 10 mol % on an oxide basis.
Item 557. A gallium nitride-based sintered compact contains at least one selected from zinc, cadmium, carbon, silicon, germanium, selenium, and tellurium.
Item 558. The gallium nitride-based sintered compact as described in any one of Items 532-557, wherein at least one selected from zinc, cadmium, carbon, silicon, germanium, selenium, and tellurium is contained not more than 10 mol % on an element basis.
Item 559. The gallium nitride-based sintered compact as described in Item 557 or 558, wherein at least one selected from zinc, cadmium, carbon, silicon, germanium, selenium, and tellurium is contained in the range of 0.00001-7 mol % on an element basis. Item 560. The gallium nitride-based sintered compact as described in any one of Items 557-559, wherein at least one selected from zinc, cadmium, carbon, silicon, germanium, selenium, and tellurium is contained in the range of 0.00001-5 mol % on an element basis.
Item 561. The gallium nitride-based sintered compact as described in any one of Items 557-560, wherein at least one selected from zinc, cadmium, carbon, silicon, germanium, selenium, and tellurium is contained in the range of 0.00001-3 mol % on an element basis.
Item 562. A gallium nitride-based sintered compact contains at least one selected from aluminum, indium, and oxygen.
Item 563. The gallium nitride-based sintered compact as described in any one of Items 532-562, wherein at least one selected from aluminum, indium, and oxygen is contained not more than 40 mol % on an element basis.
Item 564. A gallium nitride-based sintered compact contains at least one selected from transition metal.
Item 565. The gallium nitride-based sintered compact as described in any one of Items 532-564, wherein at least one selected from transition metal is contained not more than 10 mol % on an element basis.
Item 566. The gallium nitride-based sintered compact as described in Item 564 or 565, wherein the transition metal is at least one selected from manganese, cobalt, nickel, iron, chromium, titanium, molybdenum, tungsten, niobium, tantalum, and vanadium.
Item 567. A gallium nitride-based sintered compact is produced using a powder which comprises gallium nitride as a main component and was made by direct nitriding of metal gallium, as a raw material.
Item 568. A gallium nitride-based sintered compact is produced using a powder which comprises gallium nitride as a main component and was made by reducing and nitriding of a gallium oxide, as a raw material.
Item 569. A gallium nitride-based sintered compact is produced using a powder which comprises gallium nitride as a main component and was made by nitriding of a gas state gallium compound, as a raw material.
Item 570. A gallium nitride-based sintered compact is produced using a powder which comprises gallium nitride as a main component and contains oxygen not more than 10 % by weight, as a raw material.
Item 571. A gallium nitride-based sintered compact is produced using a powder which comprises gallium nitride as a main component and has the average particle size not more than 10 µm, as a raw material.
Item 572. A powder which comprises gallium nitride as a main component and contains oxygen not more than 10 % by weight.
Item 573. A powder which comprises gallium nitride as a main component and has the average particle size not more than 10 µm.
Item 574. A manufacture method of the powder which comprises gallium nitride as a main component and is produced by nitriding reaction between metal gallium and a nitrogen content substance.
Item 575. A manufacture method of the powder which comprises gallium nitride as a main component and is produced by making a nitriding reaction of a gallium oxide using a reducing agent and a nitrogen content substance.
Item 576. A manufacture method of the powder which comprises gallium nitride as a main component and is produced by nitriding reaction between a gas state gallium compound and a nitrogen content substance.
Item 577. A thin-film substrate in which a single-crystal thin film comprising as a main component at least one selected from gallium nitride, indium nitride and aluminum nitride is formed on a ceramic-based sintered compact.
Item 578. The thin-film substrate as described in Item 577, wherein a single-crystal thin film comprising as a main component at least one selected from gallium nitride, indium nitride and aluminum nitride is formed on a ceramic-based sintered compact on which a thin film comprising as a main component at least one selected from gallium nitride, indium nitride and aluminum nitride is formed.
Item 579. The thin-film substrate as described in Item 578, wherein the thin film comprising as a main component at least one selected from gallium nitride, indium nitride and aluminum nitride and formed on a ceramic-based sintered compact has at least one of the crystallization states selected from an amorphous state, a polycrystal, an orientated polycrystal, and a single crystal.
Item 580. The thin-film substrate as described in Item 578 or 579, wherein the thin film comprising as a main component at least one selected from gallium nitride, indium nitride and aluminum nitride and formed on a ceramic-based sintered compact has a single-crystal thin film at least.
Item 581. The thin-film substrate as described in any one of Items 578-580, wherein the thin film comprising as a main component at least one selected from gallium nitride, indium nitride and aluminum nitride and formed on a ceramic-based sintered compact is constituted with one layer.
Item 582. The thin-film substrate as described in Item 581, wherein the thin film comprising as a main component at least one selected from gallium nitride, indium nitride and aluminum nitride and formed on a ceramic-based sintered compact is amorphous at least.
Item 583. The thin-film substrate as described in Item 581, wherein the thin film comprising as a main component at least one selected from gallium nitride, indium nitride and aluminum nitride and formed on a ceramic-based sintered compact is a polycrystal. Item 584. The thin-film substrate as described in Item 581, wherein the thin film comprising as a main component at least one selected from gallium nitride, indium nitride and aluminum nitride and formed on a ceramic-based sintered compact is an orientated polycrystal.
Item 585. The thin-film substrate as described in Item 581, wherein the thin film comprising as a main component at least one selected from gallium nitride, indium nitride and aluminum nitride and formed on a ceramic-based sintered compact is a single crystal. Item 586. The thin-film substrate as described in any one of Items 578-580, wherein the thin film comprising as a main component at least one selected from gallium nitride, indium nitride and aluminum nitride and formed on a ceramic-based sintered compact is constituted with at least two layers.
Item 587. The thin-film substrate as described in Item 586, wherein the thin film comprising as a main component at least one selected from gallium nitride, indium nitride and aluminum nitride and formed on a ceramic-based sintered compact is constituted with at least two layers, and each layer has respectively at least one of the crystallization states selected from an amorphous state, a polycrystal, an orientated polycrystal, and a single crystal.
Item 588. The thin-film substrate as described in Item 586 or 587, wherein the thin film comprising as a main component at least one selected from gallium nitride, indium nitride and aluminum nitride and formed on a ceramic-based sintered compact is constituted with at least two layers, and the thin film layer formed directly on the ceramic-based sintered compact has at least one of the crystallization states selected from an amorphous state, a polycrystal, an orientated polycrystal, and a single crystal.
Item 589. The thin-film substrate as described in any one of Items 586-588, wherein the thin film comprising as a main component at least one selected from gallium nitride, indium nitride and aluminum nitride and formed on a ceramic-based sintered compact is constituted with at least two layers, and the thin film layer formed directly on the ceramic-based sintered compact has at least one of the crystallization states selected from an amorphous state, a polycrystal, and an orientated polycrystal.
Item 590. The thin-film substrate as described in any one of Items 586-589, wherein the thin film comprising as a main component at least one selected from gallium nitride, indium nitride and aluminum nitride and formed on a ceramic-based sintered compact is constituted with at least two layers, and the thin film layer formed directly on the ceramic-based sintered compact is an orientated polycrystal.
Item 591. The thin-film substrate as described in any one of Items 586-590, wherein the thin film comprising as a main component at least one selected from gallium nitride, indium nitride and aluminum nitride and formed on a ceramic-based sintered compact is constituted with at least two layers, and at least one layer is a single crystal.
Item 592. The thin-film substrate as described in any one of Items 586-591, wherein the thin film comprising as a main component at least one selected from gallium nitride, indium nitride and aluminum nitride and formed on a ceramic-based sintered compact is constituted with at least two layers, and the thin film of the top layer is a single crystal.
Item 593. The thin-film substrate as described in any one of Items 578-592, wherein the thin film comprising as a main component at least one selected from gallium nitride, indium nitride and aluminum nitride and formed on a ceramic-based sintered compact has a single-crystal thin film layer at least, and the thickness of the single-crystal thin film layer is less than 300 µm.
Item 594. The thin-film substrate as described in Item 593, wherein the thin film comprising as a main component at least one selected from gallium nitride, indium nitride and aluminum nitride and formed on a ceramic-based sintered compact has a single-crystal thin film layer at least, and the thickness of the single-crystal thin film layer is not more than 200 µm.
Item 595. The thin-film substrate as described in any one of Items 578-594, wherein the thin film formed on a ceramic-based sintered compact has the thickness not less than 0.1 nm.
Item 596. The thin-film substrate as described in Item 595, wherein the thin film formed on a ceramic-based sintered compact has the thickness not less than 0.5 nm.
Item 597. The thin-film substrate as described in Item 595 or 596, wherein the thin film formed on a ceramic-based sintered compact has the thickness not less than 0.3 µm. Item 598. The thin-film substrate as described in any one of Items 595-597, wherein the thin film formed on a ceramic-based sintered compact has the thickness not less than 3.5 µm.
Item 599. The thin-film substrate as described in any one of Items 595-598, wherein the thin film formed on a ceramic-based sintered compact has the thickness not less than 10 µm.

Item 600. The thin-film substrate as described in any one of Items 595-599, wherein the thin film formed on a ceramic-based sintered compact has the thickness not less than 50 µm.
Item 601. The thin-film substrate as described in any one of Items 578-600, wherein the thin film formed on a ceramic-based sintered compact contains gallium nitride at least.
Item 602. The thin-film substrate as described in any one of Items 578-601, wherein the thin film formed on a ceramic-based sintered compact has the thin film containing gallium nitride at least or comprising gallium nitride as a main component. Item 603. The thin-film substrate as described in Item 601 or 602, wherein the thin film formed on a ceramic-based sintered compact comprises gallium nitride as a main component.
Item 604. The thin-film substrate as described in any one of Items 578-603, wherein the half width of the rocking curve of the X ray diffraction from the lattice plane of the Miller Index (002) of the single-crystal thin film formed on a ceramic-based sintered compact is not more than 3600 seconds.
Item 605. The thin-film substrate as described in Item 604, wherein the half width of the rocking curve of the X ray diffraction from the lattice plane of the Miller Index (002) of the single-crystal thin film formed on a ceramic-based sintered compact is not more than 300 seconds.
Item 606. The thin-film substrate as described in Item 604 or 605, wherein the half width of the rocking curve of the X ray diffraction from the lattice plane of the Miller Index (002) of the single-crystal thin film formed on a ceramic-based sintered compact is not more than 240 seconds.
Item 607. The thin-film substrate as described in any one of Items 604-606, wherein the half width of the rocking curve of the X ray diffraction from the lattice plane of the Miller Index (002) of the single-crystal thin film formed on a ceramic-based sintered compact is not more than 200 seconds.
Item 608. The thin-film substrate as described in any one of Items 604-607, wherein the half width of the rocking curve of the X ray diffraction from the lattice plane of the Miller Index (002) of the single-crystal thin film formed on a ceramic-based sintered compact is not more than 150 seconds.
Item 609. The thin-film substrate as described in any one of Items 604-608, wherein the half width of the rocking curve of the X ray diffraction from the lattice plane of the Miller Index (002) of the single-crystal thin film formed on a ceramic-based sintered compact is not more than 130 seconds.
Item 610. The thin-film substrate as described in any one of Items 604-609, wherein the half width of the rocking curve of the X ray diffraction from the lattice plane of the Miller Index (002) of the single-crystal thin film formed on a ceramic-based sintered compact is not more than 100 seconds.
Item 611. The thin-film substrate as described in any one of Items 577-610, wherein the average surface roughness Ra of a ceramic-based sintered compact is not more than 2000 nm.
Item 612. The thin-film substrate as described in Item 611, wherein the average surface roughness Ra of a ceramic-based sintered compact is not more than 1000 nm. Item 613. The thin-film substrate as described in Item 611 or 612, wherein the average surface roughness Ra of a ceramic-based sintered compact is not more than 100 nm.
Item 614. The thin-film substrate as described in any one of Items 611-613, wherein the average surface roughness Ra of a ceramic-based sintered compact is not more than 20 nm.
Item 615. The thin-film substrate as described in any one of Items 611-614, wherein the average surface roughness Ra of a ceramic-based sintered compact is not more than 10 nm.
Item 616. The thin-film substrate as described in any one of Items 611-615, wherein the average surface roughness Ra of a ceramic-based sintered compact is not more than 5 nm.
Item 617. The thin-film substrate as described in any one of Items 577-613, wherein the ceramic-based sintered compact has large surface roughness.
Item 618. The thin-film substrate as described in Item 577-613 and 617, wherein the average surface roughness Ra of a ceramic-based sintered compact is not less than 70 nm.
Item 619. The thin-film substrate as described in Item 618, wherein the average surface roughness Ra of a ceramic-based sintered compact is more than 1000 nm.
Item 620. The thin-film substrate as described in Item 618 or 619, wherein the average surface roughness Ra of a ceramic-based sintered compact is more than 2000 nm. Item 621. The thin-film substrate as described in any one of Items 577-620, wherein the surface of the ceramic-based sintered compact is at least one of the states selected from an as-fired state, a state in which lap polish was carried out, a state in which blast polish was carried out, a state in which specular surface polish was carried out, a state in which chemistry corrosion was carried out, and a state corroded by plasma gas. Item 622. The thin-film substrate as described in Item 621, wherein the surface of a ceramic-based sintered compact is the state in which specular surface polish was carried out.
Item 623. A thin-film substrate in which a thin film comprising as a main component at least one selected from gallium nitride, indium nitride and aluminum nitride is formed on a ceramic-based sintered compact having optical permeability.
Item 624. The thin-film substrate as described in Item 623, wherein the thin film comprising as a main component at least one selected from gallium nitride, indium nitride and aluminum nitride has at least one of the crystallization states selected from an amorphous state, a polycrystal, an orientated polycrystal, and a single crystal.
Item 625. The thin-film substrate as described in Item 623 or 624, wherein the thin film comprising as a main component at least one selected from gallium nitride, indium nitride and aluminum nitride is a single crystal.
Item 626. The thin-film substrate as described in any one of Items 623-625, wherein the thin film comprising as a main component at least one selected from gallium nitride, indium nitride and aluminum nitride is formed on the ceramic-based sintered compact having optical permeability and forming a thin film comprising as a main component at least one selected from gallium nitride, indium nitride and aluminum nitride.
Item 627. The thin-film substrate as described in Item 626, wherein the thin film comprising as a main component at least one selected from gallium nitride, indium nitride and aluminum nitride and formed on a ceramic-based sintered compact having optical permeability has at least one of the crystallization states selected from an amorphous state, a polycrystal, an orientated polycrystal, and a single crystal.
Item 628. The thin-film substrate as described in Item 626 or 627, wherein a part of the thin film comprising as a main component at least one selected from gallium nitride, indium nitride and aluminum nitride and formed on a ceramic-based sintered compact having optical permeability is a single crystal at least.
Item 629. The thin-film substrate as described in any one of Items 626-628, wherein the thin film comprising as a main component at least one selected from gallium nitride, indium nitride and aluminum nitride and formed on a ceramic-based sintered compact having optical permeability is constituted with one layer.
Item 630. The thin-film substrate as described in Item 629, wherein the thin film comprising as a main component at least one selected from gallium nitride, indium nitride and aluminum nitride and formed on a ceramic-based sintered compact having optical permeability is amorphous at least.
Item 631. The thin-film substrate as described in Item 629, wherein the thin film comprising as a main component at least one selected from gallium nitride, indium nitride and aluminum nitride and formed on a ceramic-based sintered compact having optical permeability is a polycrystal.
Item 632. The thin-film substrate as described in Item 629, wherein the thin film comprising as a main component at least one selected from gallium nitride, indium nitride and aluminum nitride and formed on a ceramic-based sintered compact having optical permeability is an orientated polycrystal.
Item 633. The thin-film substrate as described in Item 629, wherein the thin film comprising as a main component at least one selected from gallium nitride, indium nitride and aluminum nitride and formed on a ceramic-based sintered compact having optical permeability is a single crystal.
Item 634. The thin-film substrate as described in any one of Items 626-628, wherein the thin film comprising as a main component at least one selected from gallium nitride, indium nitride and aluminum nitride and formed on a ceramic-based sintered compact having optical permeability is constituted with at least two layers.
Item 635. The thin-film substrate as described in Item 634, wherein the thin film comprising as a main component at least one selected from gallium nitride, indium nitride and aluminum nitride and formed on a ceramic-based sintered compact having optical permeability is constituted with at least two layers, and each layer has at least one of the crystallization states selected from an amorphous state, a polycrystal, an orientated polycrystal, and a single crystal.
Item 636. The thin-film substrate as described in Item 634 or 635, wherein the thin film comprising as a main component at least one selected from gallium nitride, indium nitride and aluminum nitride and formed on a ceramic-based sintered compact having optical permeability is constituted with at least two layers, and the thin film layer formed on the ceramic-based sintered compact having optical permeability has at least one of the crystallization states selected from an amorphous state, a polycrystal, an orientated polycrystal, and a single crystal.
Item 637. The thin-film substrate as described in any one of Items 634-636, wherein the thin film comprising as a main component at least one selected from gallium nitride, indium nitride and aluminum nitride and formed on a ceramic-based sintered compact having optical permeability is constituted with at least two layers, and the thin film layer formed on the ceramic-based sintered compact having optical permeability has at least one of the crystallization states selected from an amorphous state, a polycrystal, and an orientated polycrystal.
Item 638. The thin-film substrate as described in any one of Items 634-637, wherein the thin film comprising as a main component at least one selected from gallium nitride, indium nitride and aluminum nitride and formed on a ceramic-based sintered compact having optical permeability is constituted with at least two layers, and the thin film layer formed on the ceramic-based sintered compact having optical permeability is an orientated polycrystal.
Item 639. The thin-film substrate as described in any one of Items 634-638, wherein the thin film comprising as a main component at least one selected from gallium nitride, indium nitride and aluminum nitride and formed on a ceramic-based sintered compact having optical permeability is constituted with at least two layers, and at least one layer is a single crystal.
Item 640. The thin-film substrate as described in any one of Items 634-639, wherein the thin film comprising as a main component at least one selected from gallium nitride, indium nitride and aluminum nitride and formed on a ceramic-based sintered compact having optical permeability is constituted with at least two layers, and the thin film of the top layer is a single crystal.
Item 641. The thin-film substrate as described in any one of Items 626-640, wherein the thin film comprising as a main component at least one selected from gallium nitride, indium nitride and aluminum nitride and formed on a ceramic-based sintered compact having optical permeability has a single-crystal thin film layer at least, and the thickness of the single-crystal thin film layer is less than 300 µm.
Item 642. The thin-film substrate as described in Item 641, wherein the thin film comprising as a main component at least one selected from gallium nitride, indium nitride and aluminum nitride and formed on a ceramic-based sintered compact having optical permeability has a single-crystal thin film layer at least, and the thickness of the single-crystal thin film layer is not more than 200 µm.
Item 643. The thin-film substrate as described in any one of Items 626-642, wherein the thin film formed on a ceramic-based sintered compact having optical permeability has the thickness at least not less than 0.1 nm.
Item 644. The thin-film substrate as described in Item 643, wherein the thin film formed on a ceramic-based sintered compact having optical permeability has the thickness at least not less than 0.5 nm.
Item 645. The thin-film substrate as described in Item 643 or 644, wherein the thin film formed on a ceramic-based sintered compact having optical permeability has the thickness not less than 0.3 µm.
Item 646. The thin-film substrate as described in any one of Items 643-645, wherein the thin film formed on a ceramic-based sintered compact having optical permeability has the thickness not less than 3.5 µm.
Item 647. The thin-film substrate as described in any one of Items 643-646, wherein the thin film formed on a ceramic-based sintered compact having optical permeability has the thickness not less than 10 µm.
Item 648. The thin-film substrate as described in any one of Items 643-647, wherein the thin film formed on a ceramic-based sintered compact having optical permeability has the thickness not less than 50 µm.
Item 649. The thin-film substrate as described in any one of Items 626-648, wherein the thin film formed on a ceramic-based sintered compact having optical permeability contains gallium nitride at least.

Item 650. The thin-film substrate as described in any one of Items 626-649, wherein the thin film formed on a ceramic-based sintered compact having optical permeability has the thin film containing gallium nitride at least or comprising gallium nitride as a main component.
Item 651. The thin-film substrate as described in Item 649 or 650, wherein the thin film formed on a ceramic-based sintered compact having optical permeability comprises gallium nitride as a main component.
Item 652. The thin-film substrate as described in any one of Items 626-651, wherein the half width of the rocking curve of the X ray diffraction from the lattice plane of the Miller Index (002) of the single-crystal thin film formed on a ceramic-based sintered compact having optical permeability is not more than 3600 seconds.
Item 653. The thin-film substrate as described in Item 652, wherein the half width of the rocking curve of the X ray diffraction from the lattice plane of the Miller Index (002) of the single-crystal thin film formed on a ceramic-based sintered compact having optical permeability is not more than 300 seconds.
Item 654. The thin-film substrate as described in Item 652 or 653, wherein the half width of the rocking curve of the X ray diffraction from the lattice plane of the Miller Index (002) of the single-crystal thin film formed on a ceramic-based sintered compact having optical permeability is not more than 240 seconds.
Item 655. The thin-film substrate as described in any one of Items 652-654, wherein the half width of the rocking curve of the X ray diffraction from the lattice plane of the Miller Index (002) of the single-crystal thin film formed on a ceramic-based sintered compact having optical permeability is not more than 200 seconds.
Item 656. The thin-film substrate as described in any one of Items 652-655, wherein the half width of the rocking curve of the X ray diffraction from the lattice plane of the Miller Index (002) of the single-crystal thin film formed on a ceramic-based sintered compact having optical permeability is not more than 150 seconds.
Item 657. The thin-film substrate as described in any one of Items 652-656, wherein the half width of the rocking curve of the X ray diffraction from the lattice plane of the Miller Index (002) of the single-crystal thin film formed on a ceramic-based sintered compact having optical permeability is not more than 130 seconds.
Item 658. The thin-film substrate as described in any one of Items 652-657, wherein the half width of the rocking curve of the X ray diffraction from the lattice plane of the Miller Index (002) of the single-crystal thin film formed on a ceramic-based sintered compact having optical permeability is not more than 100 seconds.
Item 659. The thin-film substrate as described in any one of Items 623-658, wherein the average surface roughness Ra of a ceramic-based sintered compact having optical permeability is not more than 2000 nm.
Item 660. The thin-film substrate as described in Item 659, wherein the average surface roughness Ra of a ceramic-based sintered compact having optical permeability is not more than 1000 nm.
Item 661. The thin-film substrate as described in Item 659 or 660, wherein the average surface roughness Ra of a ceramic-based sintered compact having optical permeability is not more than 100 nm.
Item 662. The thin-film substrate as described in any one of Items 659-661, wherein the average surface roughness Ra of a ceramic-based sintered compact having optical permeability is not more than 20 nm.
Item 663. The thin-film substrate as described in any one of Items 659-662, wherein the average surface roughness Ra of a ceramic-based sintered compact having optical permeability is not more than 10 nm.
Item 664. The thin-film substrate as described in any one of Items 659-663, wherein the average surface roughness Ra of a ceramic-based sintered compact having optical permeability is not more than 5 nm.
Item 665. The thin-film substrate as described in any one of Items 623-661, wherein the ceramic-based sintered compact having optical permeability has large surface roughness.
Item 666. The thin-film substrate as described in any one of Items 623-661 and 665, wherein the average surface roughness Ra of a ceramic-based sintered compact having optical permeability is not less than 70 nm.
Item 667. The thin-film substrate as described in Item 666, wherein the average surface roughness Ra of a ceramic-based sintered compact having optical permeability is more than 1000 nm.
Item 668. The thin-film substrate as described in Item 666 or 667, wherein the average surface roughness Ra of a ceramic-based sintered compact having optical permeability is more than 2000 nm.
Item 669. The thin-film substrate as described in any one of Items 626-668, wherein the surface of the ceramic-based sintered compact having optical permeability is at least one of the states selected from an as-fired state, a state in which lap polish was carried out, a state in which blast polish was carried out, a state in which specular surface polish was carried out, a state in which chemistry corrosion was carried out, and a state corroded by plasma gas.
Item 670. The thin-film substrate as described in Item 669, wherein the surface of a ceramic-based sintered compact having optical permeability is the state in which specular surface polish was carried out.
Item 671. The thin-film substrate as described in any one of Items 577-670, wherein the ceramic-based sintered compact or the ceramic-based sintered compact having optical permeability has the optical transmissivity not less than 1 %.
Item 672. The thin-film substrate as described in Item 671, wherein the ceramic-based sintered compact or the ceramic-based sintered compact having optical permeability has the optical transmissivity not less than 10 %.
Item 673. The thin-film substrate as described in Item 671 or 672, wherein the ceramic-based sintered compact or the ceramic-based sintered compact having optical permeability has the optical transmissivity not less than 20 %.
Item 674. The thin-film substrate as described in any one of Items 671-673, wherein the ceramic-based sintered compact or the ceramic-based sintered compact having optical permeability has the optical transmissivity not less than 30 %.
Item 675. The thin-film substrate as described in any one of Items 671-674, wherein the ceramic-based sintered compact or the ceramic-based sintered compact having optical permeability has the optical transmissivity not less than 40 %.
Item 676. The thin-film substrate as described in any one of Items 671-675, wherein the ceramic-based sintered compact or the ceramic-based sintered compact having optical permeability has the optical transmissivity not less than 50 %.
Item 677. The thin-film substrate as described in any one of Items 671-676, wherein the ceramic-based sintered compact or the ceramic-based sintered compact having optical permeability has the optical transmissivity not less than 60 %.
Item 678. The thin-film substrate as described in any one of Items 671-677, wherein the ceramic-based sintered compact or the ceramic-based sintered compact having optical permeability has the optical transmissivity not less than 80 %.
Item 679. The thin-film substrate as described in any one of Items 577-670, wherein the ceramic-based sintered compact or the ceramic-based sintered compact having optical permeability has the optical transmissivity less than 1 %.
Item 680. The thin-film substrate as described in Item 679, wherein the optical transmissivity of the ceramic-based sintered compact is 0 %.
Item 681. The thin-film substrate as described in any one of Items 623-680, wherein the optical permeability or optical transmissivity is that to the light of the range of 200-800 nm wavelength at least.
Item 682. The thin-film substrate as described in any one of Items 577-681, wherein the ceramic-based sintered compact and the ceramic-based sintered compact having optical permeability, are respectively at least one of those selected from an aluminum nitride-based sintered compact, a sintered compact comprising as a main component a ceramic maerial having at least one of the crystal structures selected from a hexagonal system or a trigonal system, and a sintered compact comprising as a main component at least one selected from zirconium oxide, magnesium oxide, magnesium aluminate, titanium oxide, barium titanate, lead titanate zirconate, a rare earth oxide, thorium oxide, various ferrites, mullite, forsterite, steatite, and glass.
Item 683. The thin-film substrate as described in Item 682, wherein the sintered compact comprising as a main component a ceramic maerial having at least one of the crystal structures selected from a hexagonal system or a trigonal system is a sintered compact comprising as a main component at least one selected from zinc oxide, beryllium oxide, aluminum oxide, silicon carbide, silicon nitride, and gallium nitride.
Item 684. The thin-film substrate as described in Item 682 or 683, wherein the ceramic-based sintered compact and the ceramic-based sintered compact having optical permeability, are respectively a sintered compact comprising as a main component at least one selected from aluminum nitride, zinc oxide, beryllium oxide, aluminum oxide, silicon carbide, silicon nitride, gallium nitride, zirconium oxide, magnesium oxide, magnesium aluminate, and yttrium oxide.
Item 685. The thin-film substrate as described in Item 682 or 684, wherein a thin film comprises as a main component at least one selected from gallium nitride, indium nitride and aluminum nitride and is formed on an aluminum nitride-based sintered compact.
Item 686. The thin-film substrate as described in Item 685, wherein the aluminum nitride-based sintered compact is substrate-like.
Item 687. The thin-film substrate as described in Item 685 or 686, wherein the thin film comprising as a main component at least one selected from gallium nitride, indium nitride and aluminum nitride has at least one of the crystallization states selected from a single crystal, an amorphous state, a polycrystal, and an orientated polycrystal.
Item 688. The thin-film substrate as described in Item 687, wherein a part of the thin film comprising as a main component at least one selected from gallium nitride, indium nitride and aluminum nitride is a single crystal at least.
Item 689. The thin-film substrate as described in any one of Items 682 and 684-688, wherein the aluminum nitride-based sintered compact has optical permeability.
Item 690. The thin-film substrate as described in any one of Items 685-689, wherein the optical transmissivity of the aluminum nitride-based sintered compact is not less than 1 %.
Item 691. The thin-film substrate as described in Item 690, wherein the optical transmissivity of the aluminum nitride-based sintered compact is not less than 5 %.
Item 692. The thin-film substrate as described in Item 690 or 691, wherein the optical transmissivity of the aluminum nitride-based sintered compact is not less than 10 %.
Item 693. The thin-film substrate as described in any one of Items 690-692, wherein the optical transmissivity of the aluminum nitride-based sintered compact is not less than 20 %.
Item 694. The thin-film substrate as described in any one of Items 690-693, wherein the optical transmissivity of the aluminum nitride-based sintered compact is not less than 30 %.
Item 695. The thin-film substrate as described in any one of Items 690-694, wherein the optical transmissivity of the aluminum nitride-based sintered compact is not less than 40 %.
Item 696. The thin-film substrate as described in any one of Items 690-695, wherein the optical transmissivity of the aluminum nitride-based sintered compact is not less than 50%.
Item 697. The thin-film substrate as described in any one of Items 690-696, wherein the optical transmissivity of the aluminum nitride-based sintered compact is not less than 60 %.
Item 698. The thin-film substrate as described in any one of Items 690-697, wherein the optical transmissivity of the aluminum nitride-based sintered compact is not less than 80 %.
Item 699. The thin-film substrate as described in any one of Items 690-698, wherein the optical transmissivity of the aluminum nitride-based sintered compact is not less than 85 %.
Item 700. The thin-film substrate as described in any one of Items 685-689, wherein a thin film comprising as a main component at least one selected from gallium nitride, indium nitride and aluminum nitride is formed on an aluminum nitride-based sintered compact, and the optical transmissivity of the aluminum nitride-based sintered compact is less than 1 %.

Item 701. The thin-film substrate as described in Item 700, wherein the optical transmissivity of the aluminum nitride-based sintered compact is 0 %.
Item 702. The thin-film substrate as described in any one of Items 689-701, wherein the optical permeability or optical transmissivity is that to the light of the range of 200-800 nm wavelength at least.
Item 703. The thin-film substrate as described in any one of Items 685-702, wherein a thin film comprising as a main component at least one selected from gallium nitride, indium nitride and aluminum nitride is formed on an aluminum nitride-based sintered compact, and the aluminum nitride-based sintered compact contains aluminum nitride not less than 20 volume %.
Item 704. The thin-film substrate as described in Item 703, wherein the aluminum nitride-based sintered compact contains aluminum nitride not less than 50 volume %.
Item 705. The thin-film substrate as described in Item 703 or 704, wherein the aluminum nitride-based sintered compact contains at least one selected from a rare earth element or an alkaline-earth metal not more than 80 volume % on an oxide basis.
Item 706. The thin-film substrate as described in Item 705, wherein the aluminum nitride-based sintered compact contains at least one selected from a rare earth element or an alkaline-earth metal not more than 50 volume % on an oxide basis.
Item 707. The thin-film substrate as described in Item 705 or 706, wherein the aluminum nitride-based sintered compact contains at least one selected from a rare earth element or an alkaline-earth metal not more than 25 volume % on an oxide basis.
Item 708. The thin-film substrate as described in any one of Items 705-707, wherein the aluminum nitride-based sintered compact contains simultaneously at least one selected from a rare earth element and at least one selected from an alkaline-earth metal.
Item 709. The thin-film substrate as described in any one of Items 703-708, wherein the aluminum nitride-based sintered compact contains at least one selected from an alkaline metal or silicon not more than 50 volume % on an oxide basis.
Item 710. The thin-film substrate as described in Item 709, wherein the aluminum nitride-based sintered compact contains at least one selected from an alkaline metal or silicon not more than 30 volume % on an oxide basis.
Item 711. The thin-film substrate as described in Item 709 or 710, wherein the aluminum nitride-based sintered compact contains at least one selected from an alkaline metal or silicon not more than 20 volume % on an oxide basis.
Item 712. The thin-film substrate as described in any one of Items 709-711, wherein the aluminum nitride-based sintered compact contains at least one selected from an alkaline metal or silicon not more than 10 volume % on an oxide basis.
Item 713. The thin-film substrate as described in any one of Items 705-712, wherein the aluminum nitride-based sintered compact contains at least one selected from an alkaline metal or silicon and contains simultaneously at least one selected from a rare earth element or an alkaline-earth metal.
Item 714. The thin-film substrate as described in any one of Items 703-713, wherein the aluminum nitride-based sintered compact contains at least one selected from Mo, W, V (vanadium), Nb, Ta, Ti, and carbon not more than 80 volume % on an element basis.
Item 715. The thin-film substrate as described in Item 714, wherein the aluminum nitride-based sintered compact contains at least one selected from Mo, W, V (vanadium), Nb, Ta, Ti, and carbon not more than 50 volume % on an element basis.
Item 716. The thin-film substrate as described in Item 714 or 715, wherein the aluminum nitride-based sintered compact contains at least one selected from Mo, W, V (vanadium), Nb, Ta, Ti, and carbon not more than 25 volume % on an element basis.
Item 717. The thin-film substrate as described in any one of Items 705-708 and 714-716, wherein the aluminum nitride-based sintered compact contains at least one selected from Mo, W, V, Nb, Ta, Ti, and carbon and contains simultaneously at least one selected from a rare earth element or an alkaline-earth metal.
Item 718. The thin-film substrate as described in any one of Items 703-717, wherein the aluminum nitride-based sintered compact contains a transition-metals-component except a rare earth element and Mo, W, V (vanadium), Nb, Ta, and Ti not more than 80 volume % on an element basis.
Item 719. The thin-film substrate as described in Item 718, wherein the aluminum nitride-based sintered compact contains a transition-metals-component except a rare earth element and Mo, W, V (vanadium), Nb, Ta, and Ti not more than 50 volume % on an element basis.
Item 720. The thin-film substrate as described in Item 718 or 719, wherein the aluminum nitride-based sintered compact contains a transition-metals-component except a rare earth element and Mo, W, V, Nb, Ta, and Ti not more than 30 volume % on an element basis.
Item 721. The thin-film substrate as described in any one of Items 705-708 and 718-720, wherein the aluminum nitride-based sintered compact contains a transition-metals-component except a rare earth element and Mo, W, V, Nb, Ta, and Ti and contains simultaneously at least one selected from a rare earth element or an alkaline earth metal.
Item 722. The thin-film substrate as described in any one of Items 718-721, wherein the transition-metals-component except a rare earth element and Mo, W, V, Nb, Ta, and Ti is at least one selected from iron, nickel, chromium, manganese, zirconium, hafnium, cobalt, copper, and zinc.
Item 723. The thin-film substrate as described in any one of Items 703-722, wherein the aluminum nitride-based sintered compact contains oxygen not more than 30 % by weight.
Item 724. The thin-film substrate as described in Item 723, wherein the aluminum nitride-based sintered compact contains oxygen not more than 25 % by weight.
Item 725. The thin-film substrate as described in Item 723 or 724, wherein the aluminum nitride-based sintered compact contains oxygen not more than 10 % by weight.
Item 726. The thin-film substrate as described in any one of Items 705-708 and 723-725, wherein the aluminum nitride-based sintered compact contains oxygen and contains simultaneously at least one selected from a rare earth element or an alkaline earth metal.
Item 727. The thin-film substrate as described in any one of Items 703-726, wherein the aluminum nitride-based sintered compact contains ALON not more than 80%.
Item 728. The thin-film substrate as described in Item 727, wherein the aluminum nitride-based sintered compact contains ALON not more than 50 %.
Item 729. The thin-film substrate as described in Item 727 or 728, wherein the aluminum nitride-based sintered compact contains ALON not more than 20 %.
Item 730. The thin-film substrate as described in any one of Items 705-708 and 727-729, wherein the aluminum nitride-based sintered compact contains ALON and contains simultaneously at least one selected from a rare earth element or an alkaline earth metal.
Item 731. The thin-film substrate as described in any one of Items 685-730, wherein a thin film comprising as a main component at least one selected from gallium nitride, indium nitride and aluminum nitride is formed on an aluminum nitride-based sintered compact, and the thermal conductivity at room temperature of the aluminum nitride-based sintered compact is not less than 50 W/mK.
Item 732. The thin-film substrate as described in Item 731, wherein the thermal conductivity at room temperature of the aluminum nitride-based sintered compact is not less than 100 W/mK.
Item 733. The thin-film substrate as described in Item 731 or 732, wherein the thermal conductivity at room temperature of the aluminum nitride-based sintered compact is not less than 150 W/mK.
Item 734. The thin-film substrate as described in any one of Items 731-733, wherein the thermal conductivity at room temperature of the aluminum nitride-based sintered compact is not less than 170 W/mK.
Item 735. The thin-film substrate as described in any one of Items 685-734, wherein the aluminum nitride-based sintered compact contains at least one selected from a rare earth element and an alkaline-earth metal a total of not more than 0.5 % by weight on an element basis and contains oxygen not more than 0.9 % by weight.
Item 736. The thin-film substrate as described in Item 735, wherein the aluminum nitride-based sintered compact contains at least one selected from a rare earth element and an alkaline-earth metal a total of not more than 0.2 % by weight on an element basis and contains oxygen not more than 0.5 % by weight.
Item 737. The thin-film substrate as described in Item 735 or 736, wherein the aluminum nitride-based sintered compact contains at least one selected from a rare earth element and an alkaline-earth metal a total of not more than 0.05 % by weight on an element basis and contains oxygen not more than 0.2 % by weight.
Item 738. The thin-film substrate as described in any one of Items 735-737, wherein the aluminum nitride-based sintered compact contains at least one selected from a rare earth element and an alkaline-earth metal a total of not more than 0.02 % by weight on an element basis and contains oxygen not more than 0.1 % by weight.
Item 739. The thin-film substrate as described in any one of Items 735-738, wherein the aluminum nitride-based sintered compact contains at least one selected from a rare earth element and an alkaline-earth metal a total of not more than 0.005 % by weight on an element basis and contains oxygen not more than 0.05 % by weight.
Item 740. The thin-film substrate as described in any one of Items 685-739, wherein the aluminum nitride-based sintered compact contains at least one selected from an alkaline metal or silicon a total of not more than 0.2 % by weight on an element basis and contains oxygen not more than 0.9 % by weight.
Item 741. The thin-film substrate as described in any one of Items 685-740, wherein the aluminum nitride-based sintered compact contains at least one selected from Mo, W, V (vanadium), Nb, Ta, Ti, and carbon a total of not more than 0.2 % by weight on an element basis and contains oxygen not more than 0.9 % by weight.
Item 742. The thin-film substrate as described in any one of Items 685-741, wherein the aluminum nitride-based sintered compact contains at least one selected from Fe, Ni, Co, and Mn a total of not more than 0.2 % by weight on an element basis and contains oxygen not more than 0.9 % by weight.
Item 743. The thin-film substrate as described in any one of Items 685-742, wherein the aluminum nitride-based sintered compact contains AlN not less than 95 % as a crystal phase.
Item 744. The thin-film substrate as described in Item 743, wherein the aluminum nitride-based sintered compact contains AlN not less than 98 % as a crystal phase.
Item 745. The thin-film substrate as described in any one of Items 685-744, wherein the crystal phase of the aluminum nitride-based sintered compact comprises an AlN single phase substantially.
Item 746. The thin-film substrate as described in any one of Items 685-745, wherein the thermal conductivity at room temperature of the aluminum nitride-based sintered compact is not less than 200 W/mK.
Item 747. The thin-film substrate as described in Item 746, wherein the thermal conductivity at room temperature of the aluminum nitride-based sintered compact is not less than 220 W/mK.
Item 748. The thin-film substrate as described in any one of Items 685-747, wherein the relative density of the aluminum nitride-based sintered compact is not less than 95 %.
Item 749. The thin-film substrate as described in Item 748, wherein the relative density of the aluminum nitride-based sintered compact is not less than 98 %.

Item 750. The thin-film substrate as described in any one of Items 685-749, wherein the pore size of the aluminum nitride-based sintered compact is not more than 1 µm.
Item 751. The thin-film substrate as described in any one of Items 685-750, wherein the size of aluminum nitride particles in the aluminum nitride-based sintered compact is an average of not less than 1 µm.
Item 752. The thin-film substrate as described in Item 751, wherein the size of aluminum nitride particles in the aluminum nitride-based sintered compact is an average of not less than 5 µm.
Item 753. The thin-film substrate as described in Item 751 or 752, wherein the size of aluminum nitride particles in the aluminum nitride-based sintered compact is an average of not less than 8 µm.
Item 754. The thin-film substrate as described in any one of Items 751-753, wherein the size of aluminum nitride particles in the aluminum nitride-based sintered compact is an average of not less than 15 µm.
Item 755. The thin-film substrate as described in any one of Items 751-754, wherein the size of aluminum nitride particles in the aluminum nitride-based sintered compact is an average of not less than 25 µm.
Item 756. The thin-film substrate as described in any one of Items 685-755, wherein the size of aluminum nitride particles in the aluminum nitride-based sintered compact is an average of not more than 100 µm.
Item 757. The thin-film substrate as described in any one of Items 685-756, wherein the average surface roughness Ra of the aluminum nitride-based sintered compact is not more than 2000 nm.
Item 758. The thin-film substrate as described in Item 757, wherein the average surface roughness Ra of the aluminum nitride-based sintered compact is not more than 1000 nm.
Item 759. The thin-film substrate as described in Item 757 or 758, wherein the average surface roughness Ra of the aluminum nitride-based sintered compact is not more than 100 nm.
Item 760. The thin-film substrate as described in any one of Items 757-759, wherein the average surface roughness Ra of the aluminum nitride-based sintered compact is not more than 50 nm.
Item 761. The thin-film substrate as described in any one of Items 757-760, wherein the average surface roughness Ra of the aluminum nitride-based sintered compact is not more than 20 nm.
Item 762. The thin-film substrate as described in any one of Items 685-759, wherein the aluminum nitride-based sintered compact has large surface roughness.
Item 763. The thin-film substrate as described in any one of Items 685-762, wherein the average surface roughness Ra of the aluminum nitride-based sintered compact is not less than 70 nm.
Item 764. The thin-film substrate as described in Item 763, wherein the average surface roughness Ra of the aluminum nitride-based sintered compact is more than 1000 nm.
Item 765. The thin-film substrate as described in Item 763 or 764, wherein the average surface roughness Ra of the aluminum nitride-based sintered compact is more than 2000 nm.
Item 766. The thin-film substrate as described in any one of Items 685-765, wherein the surface of the aluminum nitride-based sintered compact is at least one of the states selected from an as-fired state, a state in which lap polish was carried out, a state in which blast polish was carried out, a state in which specular surface polish was carried out, a state in which chemistry corrosion was carried out, and a state corroded by plasma gas. Item 767. The thin-film substrate as described in Item 766, wherein the surface of the aluminum nitride-based sintered compact is the state in which specular surface polish was carried out.
Item 768. The thin-film substrate as described in any one of Items 685-765, wherein a thin film comprising as a main component at least one selected from gallium nitride, indium nitride and aluminum nitride is formed on an aluminum nitride-based sintered compact, and the thickness of the aluminum nitride-based sintered compact is not more than 8.0 mm.
Item 769. The thin-film substrate as described in Item 768, wherein the thickness of the aluminum nitride-based sintered compact is not more than 5.0 mm.
Item 770. The thin-film substrate as described in Item 768 or 769, wherein the thickness of the aluminum nitride-based sintered compact is not more than 2.5 mm.
Item 771. The thin-film substrate as described in any one of Items 768-770, wherein the thickness of the aluminum nitride-based sintered compact is not more than 1.0 mm.
Item 772. The thin-film substrate as described in any one of Items 685-771, wherein a thin film comprising as a main component at least one selected from gallium nitride, indium nitride and aluminum nitride is formed on an aluminum nitride-based sintered compact, and the thickness of the aluminum nitride-based sintered compact is not less than 0.01 mm.
Item 773. The thin-film substrate as described in Item 772, wherein the thickness of the aluminum nitride-based sintered compact is not less than 0.02 mm.
Item 774. The thin-film substrate as described in Item 772 or 773, wherein the thickness of the aluminum nitride-based sintered compact is not less than 0.05 mm.
Item 775. The thin-film substrate as described in any one of Items 768-774, wherein the thickness of the aluminum nitride-based sintered compact is not more than 8.0 mm, and the optical transmissivity of the sintered compact is not less than 1 %.
Item 776. The thin-film substrate as described in any one of Items 768-775, wherein the thickness of the aluminum nitride-based sintered compact is not less than 0.01 mm, and the optical transmissivity of the sintered compact is not less than 40 %.
Item 777. The thin-film substrate as described in any one of Items 685-776, wherein a thin film comprising as a main component at least one selected from gallium nitride, indium nitride and aluminum nitride is formed on an aluminum nitride-based sintered compact, and the aluminum nitride-based sintered compact has a conduction via. Item 778. The thin-film substrate as described in Item 777, wherein a thin film comprising as a main component at least one selected from gallium nitride, indium nitride and aluminum nitride is formed on an aluminum nitride-based sintered compact, and the aluminum nitride-based sintered compact is substrate-like and has a conduction via.
Item 779. The thin-film substrate as described in Item 777 or 778, wherein the conduction via is formed in the aluminum nitride-based sintered compact so that the up-and-down surface of the substrate may be connected electrically.
Item 780. The thin-film substrate as described in any one of Items 777-779, wherein the conduction via comprises at least one selected from gold, silver, copper, aluminum, iron, cobalt, nickel, ruthenium, rhodium, palladium, osmium, iridium, platinum, molybdenum, tungsten, chromium, titanium, titanium nitride, and zirconium nitride.
Item 781. The thin-film substrate as described in Item 780, wherein the conduction via comprises at least one selected from gold, silver, copper, aluminum, iron, cobalt, nickel, ruthenium, rhodium, palladium, osmium, iridium, platinum, molybdenum, tungsten, chromium, titanium, titanium nitride, and zirconium nitride, and contains further at least one selected from aluminum nitride, silicon carbide, silicon nitride, gallium nitride, zinc oxide, beryllium oxide, aluminum oxide, rare-earth compound, and alkaline-earth-metal compound.
Item 782. The thin-film substrate as described in Item 780 or 781, wherein the conduction via comprises as a main component at least one selected from molybdenum, tungsten, copper, titanium nitride, and zirconium nitride.
Item 783. The thin-film substrate as described in any one of Items 780-782, wherein the conduction via comprises as a main component at least one selected from molybdenum, tungsten, copper, titanium nitride, and zirconium nitride, and contains further at least one selected from aluminum nitride, aluminum oxide, rare-earth compound, and alkaline-earth-metal compound.
Item 784. The thin-film substrate as described in any one of Items 777-783, wherein the conduction via comprises a conductive material in which the electric resistivity at room temperature is not more than 1x10⁻³ Ω·cm.
Item 785. The thin-film substrate as described in Item 784, wherein the conduction via comprises a conductive material in which the electric resistivity at room temperature is not more than 1x10⁻⁴ Ω·cm.
Item 786. The thin-film substrate as described in Item 784 or 785, wherein the conduction via comprises a conductive material in which the electric resistivity at room temperature is not more than 1x10⁻⁵ Ω·cm.
Item 787. The thin-film substrate as described in any one of Items 777-786, wherein the size of the conduction via is not more than 500 µm.
Item 788. The thin-film substrate as described in Item 787, wherein the size of the conduction via is not more than 250 µm.
Item 789. The thin-film substrate as described in Item 787 or 788, wherein the size of the conduction via is not more than 100 µm.
Item 790. The thin-film substrate as described in any one of Items 787-789, wherein the size of the conduction via is not more than 50 µm.
Item 791. The thin-film substrate as described in any one of Items 787-790, wherein the size of the conduction via is not more than 25 µm.
Item 792. The thin-film substrate as described in any one of Items 777-791, wherein the size of the conduction via is not less than 1 µm.
Item 793. The thin-film substrate as described in any one of Items 777-792, wherein a thin film is formed on the surface of the conduction via.
Item 794. The thin-film substrate as described in any one of Items 685-793, wherein a thin film comprising as a main component at least one selected from gallium nitride, indium nitride and aluminum nitride is formed on an aluminum nitride-based sintered compact, and a thin film-conductive material is formed on the aluminum nitride-based sintered compact.
Item 795. The thin-film substrate as described in Item 794, wherein the thin film-conductive material is formed on at least the surface of the aluminum nitride-based sintered compact.
Item 796. The thin-film substrate as described in any one of Items 685-795, wherein a thin film comprising as a main component at least one selected from gallium nitride, indium nitride and aluminum nitride is formed on an aluminum nitride-based sintered compact, and the thin film-conductive material is formed on the surface and/or in the inside of the thin film.
Item 797. The thin-film substrate as described in any one of Items 794-796, wherein a thin film comprising as a main component at least one selected from gallium nitride, indium nitride and aluminum nitride was formed on an aluminum nitride-based sintered compact, the thin film-conductive material is formed on the aluminum nitride-based sintered compact, and the thin film-conductive material is formed further on the surface and/or in the inside of a thin film comprising as a main component at least one selected from gallium nitride, indium nitride and aluminum nitride
Item 798. The thin-film substrate as described in any one of Items 794-797, wherein the thin film-conductive material comprises at least one selected from metal, alloy, and metal nitride.
Item 799. The thin-film substrate as described in any one of Items 794-798, wherein the thin film-conductive material comprises as a main component at least one selected from gold, silver, copper, aluminum, iron, cobalt, nickel, ruthenium, rhodium, palladium, osmium, iridium, platinum, tantalum, molybdenum, tungsten, chromium, titanium, nickel chromium alloy, titanium nitride, zirconium nitride, and tantalum nitride.

Item 800. The thin-film substrate as described in any one of Items 794-799, wherein the thin film-conductive material is constituted with at least two layers.
Item 801. The thin-film substrate as described in any one of Items 794-800, wherein the thickness of the thin film-conductive material is not more than 20 µm.
Item 802. The thin-film substrate as described in Item 794-801, wherein the junction strength between the thin film-conductive material and the thin film comprising as a main component at least one selected from gallium nitride, indium nitride and aluminum nitride is not less than 2 Kg/mm².
Item 803. The thin-film substrate as described in any one of Items 682-684, wherein the thin film comprising as a main component at least one selected from gallium nitride, indium nitride and aluminum nitride is formed on a sintered compact comprising as a main component a ceramic material having at least one of the crystal structures selected from a hexagonal system or a trigonal system.
Item 804. The thin-film substrate as described in Item 803, wherein the sintered compact comprising as a main component a ceramic material having at least one of the crystal structures selected from a hexagonal system or a trigonal system is substrate-like.
Item 805. The thin-film substrate as described in Item 803 or 804, wherein the thin film comprising as a main component at least one selected from gallium nitride, indium nitride and aluminum nitride has at least one of the crystallization states selected from a single crystal, an amorphous state, a polycrystal, and an orientated polycrystal.
Item 806. The thin-film substrate as described in Item 805, wherein a part of the thin film comprising as a main component at least one selected from gallium nitride, indium nitride and aluminum nitride is a single crystal at least.
Item 807. The thin-film substrate as described in any one of Items 682-684 and 803-806, wherein the sintered compact comprising as a main component a ceramic material having at least one of the crystal structures selected from a hexagonal system or a trigonal system has optical permeability.
Item 808. The thin-film substrate as described in any one of Items 803-807, wherein the optical transmissivity of the sintered compact comprising as a main component a ceramic material having at least one of the crystal structures selected from a hexagonal system or a trigonal system is not less than 1 %.
Item 809. The thin-film substrate as described in Item 808, wherein the optical transmissivity of the sintered compact comprising as a main component a ceramic material having at least one of the crystal structures selected from a hexagonal system or a trigonal system is not less than 5 %.
Item 810. The thin-film substrate as described in Item 808 or 809, wherein the optical transmissivity of the sintered compact comprising as a main component a ceramic material having at least one of the crystal structures selected from a hexagonal system or a trigonal system is not less than 10 %.
Item 811. The thin-film substrate as described in any one of Items 808-810, wherein the optical transmissivity of sintered compact comprising as a main component a ceramic material having at least one of the crystal structures selected from a hexagonal system or a trigonal system is not less than 20 %.
Item 812. The thin-film substrate as described in any one of Items 808-811, wherein the optical transmissivity of the sintered compact comprising as a main component a ceramic material having at least one of the crystal structures selected from a hexagonal system or a trigonal system is not less than 30 %.
Item 813. The thin-film substrate as described in any one of Items 808-812, wherein the optical transmissivity of the sintered compact comprising as a main component a ceramic material having at least one of the crystal structures selected from a hexagonal system or a trigonal system is not less than 40 %.
Item 814. The thin-film substrate as described in any one of Items 808-813, wherein the optical transmissivity of the sintered compact comprising as a main component a ceramic material having at least one of the crystal structures selected from a hexagonal system or a trigonal system is not less than 50 %.
Item 815. The thin-film substrate as described in any one of Items 808-814, wherein the optical transmissivity of the sintered compact comprising as a main component a ceramic material having at least one of the crystal structures selected from a hexagonal system or a trigonal system is not less than 60 %.
Item 816. The thin-film substrate as described in any one of Items 808-815, wherein the optical transmissivity of the sintered compact comprising as a main component a ceramic material having at least one of the crystal structures selected from a hexagonal system or a trigonal system is not less than 80 %.
Item 817. The thin-film substrate as described in any one of Items 808-816, wherein the optical transmissivity of the sintered compact comprising as a main component a ceramic material having at least one of the crystal structures selected from a hexagonal system or a trigonal system is not less than 85 %.
Item 818. The thin-film substrate as described in any one of Items 803-807, wherein a thin film comprising as a main component at least one selected from gallium nitride, indium nitride and aluminum nitride is formed on a sintered compact comprising a ceramic material having at least one of the crystal structures selected from a hexagonal system or a trigonal system as a main component, and the optical transmissivity of the sintered compact comprising as a main component a ceramic material having at least one of the crystal structures selected from a hexagonal system or a trigonal system is less than 1%.
Item 819. The thin-film substrate as described in Item 818, wherein the optical transmissivity of the sintered compact comprising as a main component a ceramic material having at least one of the crystal structures selected from a hexagonal system or a trigonal system is 0 %.
Item 820. The thin-film substrate as described in any one of Items 807-819, wherein the optical permeability or optical transmissivity is that to the light of the range of 200-800 nm wavelength at least.
Item 821. The thin-film substrate as described in any one of Items 803-820, wherein the average surface roughness Ra of the sintered compact comprising as a main component a ceramic material having at least one of the crystal structures selected from a hexagonal system or a trigonal system is not more than 1000 nm.
Item 822. The thin-film substrate as described in Item 821, wherein the average surface roughness Ra of the sintered compact comprising as a main component a ceramic material having at least one of the crystal structures selected from a hexagonal system or a trigonal system is not more than 100 nm.
Item 823. The thin-film substrate as described in Item 821 or 822, wherein the average surface roughness Ra of the sintered compact comprising as a main component a ceramic material having at least one of the crystal structures selected from a hexagonal system or a trigonal system is not more than 30 nm.
Item 824. The thin-film substrate as described in any one of Items 821-823, wherein the average surface roughness Ra of the sintered compact comprising as a main component a ceramic material having at least one of the crystal structures selected from a hexagonal system or a trigonal system is not more than 10 nm.
Item 825. The thin-film substrate as described in any one of Items 821-824, wherein the average surface roughness Ra of the sintered compact comprising as a main component a ceramic material having at least one of the crystal structures selected from a hexagonal system or a trigonal system is not more than 5 nm.
Item 826. The thin-film substrate as described in any one of Items 803-825, wherein the sintered compact comprising as a main component a ceramic material having at least one of the crystal structures selected from a hexagonal system or a trigonal system has large surface roughness.
Item 827. The thin-film substrate as described in any one of Items 803-826, wherein the average surface roughness Ra of the sintered compact comprising as a main component a ceramic material having at least one of the crystal structures selected from a hexagonal system or a trigonal system is not less than 70 nm.
Item 828. The thin-film substrate as described in Item 827, wherein the average surface roughness Ra of the sintered compact comprising as a main component a ceramic material having at least one of the crystal structures selected from a hexagonal system or a trigonal system is more than 1000 nm.
Item 829. The thin-film substrate as described in Item 827 or 828, wherein the average surface roughness Ra of the sintered compact comprising as a main component a ceramic material having at least one of the crystal structures selected from a hexagonal system or a trigonal system is more than 2000 nm.
Item 830. The thin-film substrate as described in any one of Items 803-829, wherein the surface of the sintered compact comprising as a main component a ceramic material having at least one of the crystal structures selected from a hexagonal system or a trigonal system is at least one of the states selected from an as-fired state, a state in which lap polish was carried out, a state in which blast polish was carried out, a state in which specular surface polish was carried out, a state in which chemistry corrosion was carried out, and a state corroded by plasma gas.
Item 831. The thin-film substrate as described in Item 830, wherein the surface of the sintered compact comprising as a main component a ceramic material having at least one of the crystal structures selected from a hexagonal system or a trigonal system is the state in which specular surface polish was carried out.
Item 832. The thin-film substrate as described in any one of Items 803-831, wherein the sintered compact comprising as a main component a ceramic material having at least one of the crystal structures selected from a hexagonal system or a trigonal system comprises a sintered compact which comprises as a main component at least one selected from zinc oxide, beryllium oxide, aluminum oxide, silicon carbide, silicon nitride, and gallium nitride.
Item 833. The thin-film substrate as described in any one of Items 803, 804, and 832, wherein the sintered compact comprising as a main component a ceramic material having at least one of the crystal structures selected from a hexagonal system or a trigonal system is a zinc oxide-based sintered compact.
Item 834. The thin-film substrate as described in any one of Items 803, 804, 832, and 833, wherein the zinc oxide-based sintered compact has optical permeability.
Item 835. The thin-film substrate as described in any one of Items 832-834, wherein the optical transmissivity of the zinc oxide-based sintered compact is not less than 1 %.
Item 836. The thin-film substrate as described in Item 835, wherein the optical transmissivity of the zinc oxide-based sintered compact is not less than 10 %.
Item 837. The thin-film substrate as described in Item 835 or 836, wherein the optical transmissivity of the zinc oxide-based sintered compact is not less than 20 %.
Item 838. The thin-film substrate as described in any one of Items 835-837, wherein the optical transmissivity of the zinc oxide-based sintered compact is not less than 30%.
Item 839. The thin-film substrate as described in any one of Items 835-838, wherein the optical transmissivity of the zinc oxide-based sintered compact is not less than 40%.
Item 840. The thin-film substrate as described in any one of Items 835-839, wherein the optical transmissivity of the zinc oxide-based sintered compact is not less than 50%.
Item 841. The thin-film substrate as described in any one of Items 835-840, wherein the optical transmissivity of the zinc oxide-based sintered compact is not less than 60%.
Item 842. The thin-film substrate as described in any one of Items 835-841, wherein the optical transmissivity of the zinc oxide-based sintered compact is not less than 80%.
Item 843. The thin-film substrate as described in any one of Items 832-834, wherein the optical transmissivity of the zinc oxide-based sintered compact is less than 1%.
Item 844. The thin-film substrate as described in Item 843, wherein the optical transmissivity of the zinc oxide-based sintered compact is 0 %.
Item 845. The thin-film substrate as described in any one of Items 832-844, wherein the zinc oxide-based sintered compact has conductivity.
Item 846. The thin-film substrate as described in any one of Items 832-845, wherein the electric resistivity of the zinc oxide-based sintered compact is not more than 1x10² Ω·cm at room temperature.
Item 847. The thin-film substrate as described in any one of Items 832-846, wherein the zinc oxide-based sintered compact has optical permeability and has conductivity.
Item 848. The thin-film substrate as described in any one of Items 832-847, wherein the zinc oxide-based sintered compact contains an aluminum component at least.
Item 849. The thin-film substrate as described in any one of Items 832-848, wherein the zinc oxide-based sintered compact contains a zinc oxide component not less than 55.0 mol % on the basis of ZnO.

Item 850. The thin-film substrate as described in Item 848 or 849, wherein the zinc oxide-based sintered compact contains an aluminum component not more than 45.0 mol % on the basis of Al₂O₃.
Item 851. The thin-film substrate as described in Item 850, wherein the zinc oxide-based sintered compact contains an aluminum component in the range of 0.001-45.0 mol % on the basis of Al₂O₃.
Item 852. The thin-film substrate as described in Item 850 or 851, wherein the zinc oxide-based sintered compact contains an aluminum component in the range of 0.005-45.0 mol % on the basis of Al₂O₃.
Item 853. The thin-film substrate as described in any one of Items 850-852, wherein the zinc oxide-based sintered compact contains an aluminum component in the range of 0.02-45.0 mol % on the basis of Al₂O₃.
Item 854. The thin-film substrate as described in any one of Items 850-853, wherein the zinc oxide-based sintered compact contains an aluminum component in the range of 0.08-35.0 mol % on the basis of Al₂O₃.
Item 855. The thin-film substrate as described in any one of Items 832-854, wherein the zinc oxide-based sintered compact contains at least one selected from an alkaline-earth-metal component, a rare-earth component, a transition-metals component, and a silicon component.
Item 856. The thin-film substrate as described in Item 855, wherein the zinc oxide-based sintered compact contains at least one selected from a rare-earth component and a transition-metals component.
Item 857. The thin-film substrate as described in Item 855 or 856, wherein the zinc oxide-based sintered compact contains at least one selected from a rare-earth component. Item 858. The thin-film substrate as described in Item 857, wherein the zinc oxide-based sintered compact contains at least one selected from a rare-earth component, and has optical permeability.
Item 859. The thin-film substrate as described in Item 857 or 858, wherein the zinc oxide-based sintered compact contains at least one selected from a rare-earth component, and has the optical transmissivity not less than 30 %.
Item 860. The thin-film substrate as described in any one of Items 834-844, 858, and 859, wherein the optical permeability or optical transmissivity is that to the light of the range of 200-800 nm wavelength at least.
Item 861. The thin-film substrate as described in Item 855 or 856, wherein the zinc oxide-based sintered compact contains at least one selected from a transition-metals-component.
Item 862. The thin-film substrate as described in any one of Items 855-861, wherein the zinc oxide-based sintered compact contains at least one selected from a rare-earth component and a transition-metals component not more than 10.0 mol % on an oxide basis.
Item 863. The thin-film substrate as described in any one of Items 848-862, wherein the zinc oxide-based sintered compact contains an aluminum component and contains simultaneously at least one selected from a rare-earth component and a transition-metals component.
Item 864. The thin-film substrate as described in Item 863, wherein the zinc oxide-based sintered compact contains an aluminum component and contains simultaneously at least one selected from a rare-earth component.
Item 865. The thin-film substrate as described in Item 863, wherein the zinc oxide-based sintered compact contains an aluminum component and contains simultaneously at least one selected from a transition-metals component.
Item 866. The thin-film substrate as described in any one of Items 863-865, wherein the zinc oxide-based sintered compact contains at least one selected from a rare-earth component and a transition-metals component not more than 10.0 mol % on an oxide basis.
Item 867. The thin-film substrate as described in Item 866, wherein the zinc oxide-based sintered compact contains at least one selected from a rare-earth component not more than 10.0 mol % on an oxide basis.
Item 868. The thin-film substrate as described in any one of Items 863-865, wherein the zinc oxide-based sintered compact contains at least one selected from a transition-metals component not more than 10.0 mol % on an oxide basis.
Item 869. The thin-film substrate as described in any one of Items 855, 856, 861-863, 865, 866, and 868, wherein the transition-metals component is at least one selected from iron and chromium.
Item 870. The thin-film substrate as described in any one of Items 863-866, wherein the zinc oxide-based sintered compact contains an aluminum component not more than 45.0 mol % on the basis of Al₂O₃ and contains simultaneously at least one selected from a rare-earth component not more than 10.0 mol % on an oxide basis.
Item 871. The thin-film substrate as described in Item 870, wherein the zinc oxide-based sintered compact contains an aluminum component not more than 45.0 mol % on the basis of Al₂O₃ and contains simultaneously at least one selected from a rare-earth component in the range of 0.0002-10.0 mol % on an oxide basis.
Item 872. The thin-film substrate as described in Item 870 or 871, wherein the zinc oxide-based sintered compact contains an aluminum component not more than 45.0 mol % on the basis of Al₂O₃ and contains simultaneously at least one selected from a rare-earth component in the range of 0.0006-6.0 mol % on an oxide basis.
Item 873. The thin-film substrate as described in any one of Items 870-872, wherein the zinc oxide-based sintered compact contains an aluminum component not more than 45.0 mol % on the basis of Al₂O₃ and contains simultaneously at least one selected from a rare-earth component in the range of 0.001-6.0 mol % on an oxide basis.
Item 874. The thin-film substrate as described in any one of Items 870-873, wherein the zinc oxide-based sintered compact contains an aluminum component not more than 45.0 mol % on the basis of Al₂O₃ and contains simultaneously at least one selected from a rare-earth component in the range of 0.002-3.0 mol % on an oxide basis.
Item 875. The thin-film substrate as described in any one of Items 863-874, wherein the zinc oxide-based sintered compact contains an aluminum component in the range of 0.001-45.0 mol % on the basis of Al₂O₃ and contains simultaneously at least one selected from a rare-earth component.
Item 876. The thin-film substrate as described in any one of Items 803, 804, and 832, wherein the sintered compact comprising as a main component a ceramic material having at least one of the crystal structures selected from a hexagonal system or a trigonal system is a beryllium oxide-based sintered compact.
Item 877. The thin-film substrate as described in any one of Items 803, 804, 832, and 876, wherein the beryllium oxide-based sintered compact has optical permeability.
Item 878. The thin-film substrate as described in any one of Items 832, 876, and 877, wherein the optical transmissivity of the beryllium oxide-based sintered compact is not less than 1 %.
Item 879. The thin-film substrate as described in Item 878, wherein the optical transmissivity of the beryllium oxide-based sintered compact is not less than 10 %.
Item 880. The thin-film substrate as described in Item 878 or 879, wherein the optical transmissivity of the beryllium oxide-based sintered compact is not less than 20 %.
Item 881. The thin-film substrate as described in any one of Items 878-880, wherein the optical transmissivity of the beryllium oxide-based sintered compact is not less than 30 %.
Item 882. The thin-film substrate as described in any one of Items 878-881, wherein the optical transmissivity of the beryllium oxide-based sintered compact is not less than 40 %.
Item 883. The thin-film substrate as described in any one of Items 878-882, wherein the optical transmissivity of the beryllium oxide-based sintered compact is not less than 50 %.
tem 884. The thin-film substrate as described in any one of Items 878-883, wherein the optical transmissivity of the beryllium oxide-based sintered compact is not less than 60 %.
Item 885. The thin-film substrate as described in any one of Items 878-884, wherein the optical transmissivity of the beryllium oxide-based sintered compact is not less than 80 %.
Item 886. The thin-film substrate as described in any one of Items 832, 876, and 877, wherein a thin film comprising as a main component at least one selected from gallium nitride, indium nitride and aluminum nitride is formed on a beryllium oxide-based sintered compact, and the optical transmissivity of the beryllium oxide-based sintered compact is less than 1 %.
Item 887. The thin-film substrate as described in Item 886, wherein the optical transmissivity of the beryllium oxide-based sintered compact is 0 %.
Item 888. The thin-film substrate as described in any one of Items 877-887, wherein the optical permeability or optical transmissivity is that to the light of the range of 200-800 nm wavelength at least.
Item 889. The thin-film substrate as described in any one of Items 832 and 876-888, wherein the beryllium oxide-based sintered compact contains at least one selected from a magnesium component, a calcium component, and a silicon component.
Item 890. The thin-film substrate as described in any one of Items 832 and 876-889, wherein the beryllium oxide-based sintered compact contains a beryllium oxide component not less than 65.0 mol % on the basis of BeO.
Item 891. The thin-film substrate as described in any one of Items 832 and 876-890, wherein the beryllium oxide-based sintered compact contains at least one selected from a magnesium component, a calcium component, and a silicon component a total of not more than 35.0 mol % on an oxide basis.
Item 892. The thin-film substrate as described in Item 891, wherein the beryllium oxide-based sintered compact contains at least one selected from a magnesium component, a calcium component, and a silicon component a total of the range of 0.0002-35.0 mol % on an oxide basis.
Item 893. The thin-film substrate as described in Item 891 or 892, wherein the beryllium oxide-based sintered compact contains at least one selected from a magnesium component, a calcium component, and a silicon component a total of the range of 0.001-35.0 mol % on an oxide basis.
Item 894. The thin-film substrate as described in any one of Items 891-893, wherein the beryllium oxide-based sintered compact contains at least one selected from a magnesium component, a calcium component, and a silicon component a total of the range of 0.004-35.0 mol % on an oxide basis.
Item 895. The thin-film substrate as described in any one of Items 891-894, wherein the beryllium oxide-based sintered compact contains at least one selected from a magnesium component, a calcium component, and a silicon component a total of the range of 0.015-25.0 mol % on an oxide basis.
Item 896. The thin-film substrate as described in any one of Items 832 and 876-895, wherein the beryllium oxide-based sintered compact contains at least one selected from a magnesium component, a calcium component, and a silicon component and contains simultaneously at least one selected from a rare-earth component.
Item 897. The thin-film substrate as described in Item 896, wherein the beryllium oxide-based sintered compact contains at least one selected from a magnesium component, a calcium component, and a silicon component and contains simultaneously at least one selected from a rare-earth component not more than 5.0 mol % on an oxide basis.
Item 898. The thin-film substrate as described in Item 896 or 897, wherein the beryllium oxide-based sintered compact contains at least one selected from a magnesium component, a calcium component, and a silicon component a total of not more than 35.0 mol % on an oxide basis and contains simultaneously at least one selected from a rare-earth component not more than 5.0 mol % on an oxide basis.
Item 899. The thin-film substrate as described in any one of Items 896-898, wherein the beryllium oxide-based sintered compact contains at least one selected from a magnesium component, a calcium component, and a silicon component a total of not more than 35.0 mol % on an oxide basis and contains simultaneously at least one selected from a rare-earth component in the range of 0.00005-5.0 mol % on an oxide basis.

Item 900. The thin-film substrate as described in any one of Items 896-899, wherein the beryllium oxide-based sintered compact contains at least one selected from a magnesium component, a calcium component, and a silicon component a total of not more than 35.0 mol % on an oxide basis and contains simultaneously at least one selected from a rare-earth component in the range of 0.0005-3.0 mol % on an oxide basis.
Item 901. The thin-film substrate as described in any one of Items 896-900, wherein the beryllium oxide-based sintered compact contains at least one selected from a magnesium component, a calcium component, and a silicon component a total of not more than 35.0 mol % on an oxide basis and contains simultaneously at least one selected from a rare-earth component in the range of 0.002-3.0 mol % on an oxide basis.
Item 902. The thin-film substrate as described in any one of Items 896-901, wherein the beryllium oxide-based sintered compact contains at least one selected from a magnesium component, a calcium component, and a silicon component a total of not more than 35.0 mol % on an oxide basis and contains simultaneously at least one selected from a rare-earth component in the range of 0.005-3.0 mol % on an oxide basis.
Item 903. The thin-film substrate as described in any one of Items 896-902, wherein the beryllium oxide-based sintered compact contains at least one selected from a magnesium component, a calcium component, and a silicon component in the range of 0.0002-35.0 mol % on an oxide basis and contains simultaneously at least one selected from a rare-earth component on an oxide basis.
Item 904. The thin-film substrate as described in any one of Items 803, 804, and 832, wherein the sintered compact comprising as a main component a ceramic material having at least one of the crystal structures selected from a hexagonal system or a trigonal system is an aluminum oxide-based sintered compact.
Item 905. The thin-film substrate as described in any one of Items 803, 804, 832, and 904, wherein the aluminum oxide-based sintered compact has optical permeability.
Item 906. The thin-film substrate as described in any one of Items 832, 904, and 905, wherein the optical transmissivity of the aluminum oxide-based sintered compact is not less than 1 %.
Item 907. The thin-film substrate as described in Item 906, wherein the optical transmissivity of the aluminum oxide-based sintered compact is not less than 10 %.
Item 908. The thin-film substrate as described in Item 906 or 907, wherein the optical transmissivity of the aluminum oxide-based sintered compact is not less than 20 %.
Item 909. The thin-film substrate as described in any one of Items 906-908, wherein the optical transmissivity of the aluminum oxide-based sintered compact is not less than 30 %.
Item 910. The thin-film substrate as described in any one of Items 906-909, wherein the optical transmissivity of the aluminum oxide-based sintered compact is not less than 40 %.
Item 911. The thin-film substrate as described in any one of Items 906-910, wherein the optical transmissivity of the aluminum oxide-based sintered compact is not less than 50 %.
Item 912. The thin-film substrate as described in any one of Items 906-911, wherein the optical transmissivity of the aluminum oxide-based sintered compact is not less than 60 %.
Item 913. The thin-film substrate as described in any one of Items 906-912, wherein the optical transmissivity of the aluminum oxide-based sintered compact is not less than 80 %.
Item 914. The thin-film substrate as described in any one of Items 832, 904, and 905, wherein a thin film comprising as a main component at least one selected from gallium nitride, indium nitride and aluminum nitride is formed on an aluminum oxide-based sintered compact, and the optical transmissivity of the aluminum oxide-based sintered compact is less than 1 %.
Item 915. The thin-film substrate as described in Item 914, wherein the optical transmissivity of the aluminum oxide-based sintered compact is 0 %.
Item 916. The thin-film substrate as described in any one of Items 905-915, wherein the optical permeability or optical transmissivity is that to the light of the range of 200-800 nm wavelength at least.
Item 917. The thin-film substrate as described in any one of Items 832 and 904-916, wherein the aluminum oxide-based sintered compact contains at least one selected from a magnesium component, a calcium component, and a silicon component.
Item 918. The thin-film substrate as described in any one of Items 832 and 904-917, wherein the aluminum oxide-based sintered compact contains an aluminum oxide component not less than 55.0 mol % on the basis of Al₂O₃.
Item 919. The thin-film substrate as described in any one of Items 832 and 904-918, wherein the aluminum oxide-based sintered compact contains at least one selected from a magnesium component, a calcium component, and a silicon component a total of not more than 45.0 mol % on an oxide basis.
Item 920. The thin-film substrate as described in Item 919, wherein the aluminum oxide-based sintered compact contains at least one selected from a magnesium component, a calcium component, and a silicon component a total of the range of 0.001-45.0 mol % on an oxide basis.
Item 921. The thin-film substrate as described in Item 919 or 920, wherein the aluminum oxide-based sintered compact contains at least one selected from a magnesium component, a calcium component, and a silicon component a total of the range of 0.005-45.0 mol % on an oxide basis.
Item 922. The thin-film substrate as described in any one of Items 919-921, wherein the aluminum oxide-based sintered compact contains at least one selected from a magnesium component, a calcium component, and a silicon component a total of the range of 0.02-45.0 mol % on an oxide basis.
Item 923. The thin-film substrate as described in any one of Items 919-922, wherein the aluminum oxide-based sintered compact contains at least one selected from a magnesium component, a calcium component, and a silicon component a total of the range of 0.08-35.0 mol % on an oxide basis.
Item 924. The thin-film substrate as described in any one of Items 832 and 904-923, wherein the aluminum oxide-based sintered compact contains at least one selected from a magnesium component, a calcium component, and a silicon component and contains simultaneously at least one selected from a rare-earth component.
Item 925. The thin-film substrate as described in Item 924, wherein the aluminum oxide-based sintered compact contains at least one selected from a magnesium component, a calcium component, and a silicon component and contains simultaneously at least one selected from a rare-earth component not more than 10.0 mol % on an oxide basis.
Item 926. The thin-film substrate as described in Item 924 or 925, wherein the aluminum oxide-based sintered compact contains at least one selected from a magnesium component, a calcium component, and a silicon component not more than 45.0 mol % on an oxide basis and contains simultaneously at least one selected from a rare-earth component not more than 10.0 mol % on an oxide basis.
Item 927. The thin-film substrate as described in any one of Items 924-926, wherein the aluminum oxide-based sintered compact contains at least one selected from a magnesium component, a calcium component, and a silicon component not more than 45.0 mol % on an oxide basis and contains simultaneously at least one selected from a rare-earth component in the range of 0.0002-10.0 mol % on an oxide basis.
Item 928. The thin-film substrate as described in any one of Items 924-927, wherein the aluminum oxide-based sintered compact contains at least one selected from a magnesium component, a calcium component, and a silicon component not more than 45.0 mol % on an oxide basis and contains simultaneously at least one selected from a rare-earth component in the range of 0.001-6.0 mol % on an oxide basis.
Item 929. The thin-film substrate as described in any one of Items 924-928, wherein the aluminum oxide-based sintered compact contains at least one selected from a magnesium component, a calcium component, and a silicon component not more than 45.0 mol % on an oxide basis and contains simultaneously at least one selected from a rare-earth component in the range of 0.005-6.0 mol % on an oxide basis.
Item 930. The thin-film substrate as described in any one of Items 924-929, wherein the aluminum oxide-based sintered compact contains at least one selected from a magnesium component, a calcium component, and a silicon component not more than 45.0 mol % on an oxide basis and contains simultaneously at least one selected from a rare-earth component in the range of 0.01-6.0 mol % on an oxide basis.
Item 931. The thin-film substrate as described in any one of Items 924-929, wherein the aluminum oxide-based sintered compact contains at least one selected from a magnesium component, a calcium component, and a silicon component a total of the range of 0.001-45.0 mol % on an oxide basis and contains simultaneously at least one selected from a rare-earth component.
Item 932. The thin-film substrate as described in any one of Items 832 and 904-931, wherein the aluminum oxide-based sintered compact contains at least two selected from a magnesium component, a calcium component, and a silicon component.
Item 933. The thin-film substrate as described in any one of Items 803, 804, and 832, wherein the sintered compact comprising as a main component a ceramic material having at least one of the crystal structures selected from a hexagonal system or a trigonal system is a gallium nitride-based sintered compact.
Item 934. The thin-film substrate as described in any one of Items 803, 804, 832, and 933, wherein the gallium nitride-based sintered compact has optical permeability.
Item 935. The thin-film substrate as described in any one of Items 832, 933, and 934, wherein the optical transmissivity is not less than 1 %.
Item 936. The thin-film substrate as described in Item 935, wherein the optical transmissivity of the gallium nitride-based sintered compact is not less than 5 %.
Item 937. The thin-film substrate as described in Item 935 or 936, wherein the optical transmissivity of the gallium nitride-based sintered compact is not less than 10 %. Item 938. The thin-film substrate as described in any one of Items 935-937, wherein the optical transmissivity of the gallium nitride-based sintered compact is not less than 20 %.
Item 939. The thin-film substrate as described in any one of Items 935-938, wherein the optical transmissivity of the gallium nitride-based sintered compact is not less than 30 %.
Item 940. The thin-film substrate as described in any one of Items 935-939, wherein the optical transmissivity of the gallium nitride-based sintered compact is not less than 40 %.
Item 941. The thin-film substrate as described in any one of Items 935-940, wherein the optical transmissivity of the gallium nitride-based sintered compact is not less than 50 %.
Item 942. The thin-film substrate as described in any one of Items 935-941, wherein the optical transmissivity of the gallium nitride-based sintered compact is not less than 60 %.
Item 943. The thin-film substrate as described in any one of Items 935-942, wherein the optical transmissivity of the gallium nitride-based sintered compact is not less than 80 %.
Item 944. The thin-film substrate as described in any one of Items 935-943, wherein the optical transmissivity of the gallium nitride-based sintered compact is not less than 85 %.
Item 945. The thin-film substrate as described in any one of Items 832, 933, and 934, wherein the optical transmissivity of the gallium nitride-based sintered compact is less than 1 %.
Item 946. The thin-film substrate as described in Item 945, wherein the optical transmissivity of the gallium nitride-based sintered compact is 0 %.
Item 947. The thin-film substrate as described in any one of Items 934-946, wherein the optical permeability or optical transmissivity of the gallium nitride-based sintered compact is that to the light of the range of 200-800 nm wavelength at least.
Item 948. The thin-film substrate as described in any one of Items 832 and 933-947, wherein the gallium nitride-based sintered compact has conductivity.
Item 949. The thin-film substrate as described in any one of Items 832 and 933-948, wherein the electric resistivity of the gallium nitride-based sintered compact is not more than 1x10⁴ Ω·cm at room temperature.

Item 950. The thin-film substrate as described in Item 948 or 949, wherein the electric resistivity of the gallium nitride-based sintered compact is not more than 1x10¹ Ω·cm at room temperature.
Item 951. The thin-film substrate as described in any one of Items 948-950, wherein the electric resistivity of the gallium nitride-based sintered compact is not more than 1x10⁰ Ω·cm at room temperature.
Item 952. The thin-film substrate as described in any one of Items 948-951, wherein the electric resistivity of the gallium nitride-based sintered compact is not more than 1x10⁻² Ω·cm at room temperature.
Item 953. The thin-film substrate as described in any one of Items 832 and 933-952, wherein the gallium nitride-based sintered compact has optical permeability and has conductivity.
Item 954. The thin-film substrate as described in any one of Items 832 and 933-953, wherein the gallium nitride-based sintered compact contains a gallium component not less than 55.0 mol % on the basis of GaN.
Item 955. The thin-film substrate as described in any one of Items 832 and 933-954, wherein the gallium nitride-based sintered compact contains at least one selected from an alkaline-earth metal and a rare earth element.
Item 956. The thin-film substrate as described in Item 955, wherein the gallium nitride-based sintered compact contains at least one selected from an alkaline-earth metal and a rare earth element not more than 30 mol % on an oxide basis.
Item 957. The thin-film substrate as described in Item 955 or 956, wherein the gallium nitride-based sintered compact contains at least one selected from an alkaline-earth metal and a rare earth element not more than 20 mol % on an oxide basis.
Item 958. The thin-film substrate as described in any one of Items 955-957, wherein the gallium nitride-based sintered compact contains at least one selected from an alkaline-earth metal and a rare earth element not more than 10 mol % on an oxide basis.
Item 959. The thin-film substrate as described in any one of Items 832 and 933-958, wherein the gallium nitride-based sintered compact contains at least one selected from zinc, cadmium, carbon, silicon, germanium, selenium, and tellurium.
Item 960. The thin-film substrate as described in Item 959, wherein the gallium nitride-based sintered compact contains at least one selected from zinc, cadmium, carbon, silicon, germanium, selenium, and tellurium not more than 10 mol % on an element basis. Item 961. The thin-film substrate as described in Item 959 or 960, wherein the gallium nitride-based sintered compact contains at least one selected from zinc, cadmium, carbon, silicon, germanium, selenium, and tellurium in the range of 0.00001-7 mol % on an element basis.
Item 962. The thin-film substrate as described in any one of Items 959-961, wherein the gallium nitride-based sintered compact contains at least one selected from zinc, cadmium, carbon, silicon, germanium, selenium, and tellurium in the range of 0.00001-5 mol % on an element basis.
Item 963. The thin-film substrate as described in any one of Items 959-961, wherein the gallium nitride-based sintered compact contains at least one selected from zinc, cadmium, carbon, silicon, germanium, selenium, and tellurium in the range of 0.00001-3 mol % on an element basis.
Item 964. The thin-film substrate as described in any one of Items 832 and 933-963, wherein the gallium nitride-based sintered compact contains at least one selected from aluminum, indium, and oxygen.
Item 965. The thin-film substrate as described in Item 964, wherein the gallium nitride-based sintered compact contains at least one selected from aluminum, indium, and oxygen not more than 40 mol % on an element basis.
Item 966. The thin-film substrate as described in Item 964 or 965, wherein the gallium nitride-based sintered compact contains at least one selected from aluminum, indium, and oxygen not more than 30 mol % on an element basis.
Item 967. The thin-film substrate as described in any one of Items 832 and 933-966, wherein the gallium nitride-based sintered compact contains at least one selected from a transition metal.
Item 968. The thin-film substrate as described in Item 967, wherein the gallium nitride-based sintered compact contains at least one selected from a transition metal not more than 10 mol % on an element basis.
Item 969. The thin-film substrate as described in Item 967 or 968, wherein the transition metal contained in the gallium nitride-based sintered compact is at least one selected from manganese, cobalt, nickel, iron, chromium, titanium, molybdenum, tungsten, niobium, tantalum, and vanadium.
Item 970. The thin-film substrate as described in any one of Items 803, 804, 832, and 933-969, wherein the gallium nitride-based sintered compact is made from the raw material powder which comprises gallium nitride as a main component and is produced by direct nitriding of metal gallium.
Item 971. The thin-film substrate as described in any one of Items 803, 804, 832, and 933-969, wherein the gallium nitride-based sintered compact is made from the raw material powder which comprises gallium nitride as a main component and is produced by reducing and nitriding of a gallium oxide.
Item 972. The thin-film substrate as described in any one of Items 803, 804, 832, and 933-969, wherein the gallium nitride-based sintered compact is made from the raw material powder which comprises gallium nitride as a main component and is produced by nitriding of a gas state gallium compound.
Item 973. The thin-film substrate as described in any one of Items 970-972, wherein the gallium nitride-based sintered compact is made from the raw material powder which comprises gallium nitride as a main component and has the oxygen content not more than 10 % by weight.
Item 974. The thin-film substrate as described in Item 973, wherein the gallium nitride-based sintered compact is made from the raw material powder which comprises gallium nitride as a main component and has the oxygen content not more than 1 % by weight.
Item 975. The thin-film substrate as described in any one of Items 970-974, wherein the gallium nitride-based sintered compact is made from the raw material powder which comprises gallium nitride as a main component and has the average particle diameter not more than 10 µm.
Item 976. The thin-film substrate as described in Item 975, wherein the gallium nitride-based sintered compact is made from the raw material powder which comprises gallium nitride as a main component and has the average particle diameter not more than 5.0 µm.
Item 977. The thin-film substrate as described in Item 975 or 976, wherein the gallium nitride-based sintered compact is made from the raw material powder which comprises gallium nitride as a main component and has the average particle diameter not more than 2.0 µm.
Item 978. The thin-film substrate as described in any one of Items 975-977, wherein the gallium nitride-based sintered compact is made from the raw material powder which comprises gallium nitride as a main component and has the average particle diameter not more than 1.0 µm.
Item 979. The thin-film substrate as described in Item 682 or 684, wherein a thin film comprises as a main component at least one selected from gallium nitride, indium nitride and aluminum nitride is formed on a sintered compact which comprises as a main component at least one selected from zirconium oxide, magnesium oxide, magnesium aluminate, titanium oxide, barium titanate, lead titanate zirconate, a rare earth oxide, thorium oxide, various ferrites, mullite, forsterite, steatite, and glass.
Item 980. The thin-film substrate as described in Item 979, wherein the sintered compact is substrate-like and comprises as amain component at least one selected from zirconium oxide, magnesium oxide, magnesium aluminate, titanium oxide, barium titanate, lead titanate zirconate, a rare earth oxide, thorium oxide, various ferrites, mullite, forsterite, steatite, and glass.
Item 981. The thin-film substrate as described in Item 979 or 980, wherein the thin film comprising as a main component at least one selected from gallium nitride, indium nitride and aluminum nitride has at least one of the crystallization states selected from a single crystal, an amorphous state, a polycrystal, and an orientated polycrystal.
Item 982. The thin-film substrate as described in Item 981, wherein a part of the thin film comprising as a main component at least one selected from gallium nitride, indium nitride and aluminum nitride is a single crystal at least.
Item 983. The thin-film substrate as described in any one of Items 979-982, wherein the sintered compact has optical permeability and comprises as a main component at least one selected from zirconium oxide, magnesium oxide, magnesium aluminate, titanium oxide, barium titanate, lead titanate zirconate, a rare earth oxide, thorium oxide, various ferrites, mullite, forsterite, steatite, and glass.
Item 984. The thin-film substrate as described in any one of Items 979-983, wherein the sintered compact comprises as a main component at least one selected from zirconium oxide, magnesium oxide, magnesium aluminate, titanium oxide, barium titanate, lead titanate zirconate, a rare earth oxide, thorium oxide, various ferrites, mullite, forsterite, steatite, and glass, and the optical transmissivity of the sintered compact is not less than 1%.
Item 985. The thin-film substrate as described in Item 984, wherein the sintered compact comprises as a main component at least one selected from zirconium oxide, magnesium oxide, magnesium aluminate, titanium oxide, barium titanate, lead titanate zirconate, a rare earth oxide, thorium oxide, various ferrites, mullite, forsterite, steatite, and glass, and the optical transmissivity of the sintered compact is not less than 5 %.
Item 986. The thin-film substrate as described in Item 984 or 985, wherein the sintered compact comprises as a main component at least one selected from zirconium oxide, magnesium oxide, magnesium aluminate, titanium oxide, barium titanate, lead titanate zirconate, a rare earth oxide, thorium oxide, various ferrites, mullite, forsterite, steatite, and glass, and the optical transmissivity of the sintered compact is not less than 10 %.
Item 987. The thin-film substrate as described in any one of Items 984-986, wherein the sintered compact comprises as a main component at least one selected from zirconium oxide, magnesium oxide, magnesium aluminate, titanium oxide, barium titanate, lead titanate zirconate, a rare earth oxide, thorium oxide, various ferrites, mullite, forsterite, steatite, and glass, and the optical transmissivity of the sintered compact is not less than 20%.
Item 988. The thin-film substrate as described in any one of Items 984-987, wherein the sintered compact comprises as a main component at least one selected from zirconium oxide, magnesium oxide, magnesium aluminate, titanium oxide, barium titanate, lead titanate zirconate, a rare earth oxide, thorium oxide, various ferrites, mullite, forsterite, steatite, and glass, and the optical transmissivity of the sintered compact is not less than 30%.
Item 989. The thin-film substrate as described in any one of Items 984-988, wherein the sintered compact comprises as a main component at least one selected from zirconium oxide, magnesium oxide, magnesium aluminate, titanium oxide, barium titanate, lead titanate zirconate, a rare earth oxide, thorium oxide, various ferrites, mullite, forsterite, steatite, and glass, and the optical transmissivity of the sintered compact is not less than 40%.
Item 990. The thin-film substrate as described in any one of Items 984-989, wherein the sintered compact comprises as a main component at least one selected from zirconium oxide, magnesium oxide, magnesium aluminate, titanium oxide, barium titanate, lead titanate zirconate, a rare earth oxide, thorium oxide, various ferrites, mullite, forsterite, steatite, and glass, and the optical transmissivity of the sintered compact is not less than 50 %.
Item 991. The thin-film substrate as described in any one of Items 984-990, wherein the sintered compact comprises as a main component at least one selected from zirconium oxide, magnesium oxide, magnesium aluminate, titanium oxide, barium titanate, lead titanate zirconate, a rare earth oxide, thorium oxide, various ferrites, mullite, forsterite, steatite, and glass, and the optical transmissivity of the sintered compact is not less than 60%.
Item 992. The thin-film substrate as described in any one of Items 984-991, wherein the sintered compact comprises as a main component at least one selected from zirconium oxide, magnesium oxide, magnesium aluminate, titanium oxide, barium titanate, lead titanate zirconate, a rare earth oxide, thorium oxide, various ferrites, mullite, forsterite, steatite, and glass, and the optical transmissivity of the sintered compact is not less than 80%.
Item 993. The thin-film substrate as described in any one of Items 984-992, wherein the sintered compact comprises as a main component at least one selected from zirconium oxide, magnesium oxide, magnesium aluminate, titanium oxide, barium titanate, lead titanate zirconate, a rare earth oxide, thorium oxide, various ferrites, mullite, forsterite, steatite, and glass, and the optical transmissivity of the sintered compact is not less than 85 %.
Item 994. The thin-film substrate as described in any one of Items 979-983, wherein a thin film comprising as a main component at least one selected from gallium nitride, indium nitride and aluminum nitride is formed on a sintered compact which comprises as a main component at least one selected from zirconium oxide, magnesium oxide, magnesium aluminate, titanium oxide, barium titanate, lead titanate zirconate, a rare earth oxide, thorium oxide, various ferrites, mullite, forsterite, steatite, and glass, and the optical transmissivity of the sintered compact is less than 1 %.
Item 995. The thin-film substrate as described in Item 994, wherein the sintered compact comprises as a main component at least one selected from zirconium oxide, magnesium oxide, magnesium aluminate, titanium oxide, barium titanate, lead titanate zirconate, a rare earth oxide, thorium oxide, various ferrites, mullite, forsterite, steatite, and glass, and the optical transmissivity of the sintered compact is 0 %.
Item 996. The thin-film substrate as described in any one of Items 984-995, wherein the optical permeability or optical transmissivity is that to the light of the range of 200-800 nm wavelength at least.
Item 997. The thin-film substrate as described in any one of Items 979-996, wherein the sintered compact comprises as a main component at least one selected from zirconium oxide, magnesium oxide, magnesium aluminate, titanium oxide, barium titanate, lead titanate zirconate, a rare earth oxide, thorium oxide, various ferrites, mullite, forsterite, steatite, and glass, and the average surface roughness Ra of the sintered compact is not more than 1000 nm.
Item 998. The thin-film substrate as described in Item 997, wherein the sintered compact comprises as a main component at least one selected from zirconium oxide, magnesium oxide, magnesium aluminate, titanium oxide, barium titanate, lead titanate zirconate, a rare earth oxide, thorium oxide, various ferrites, mullite, forsterite, steatite, and glass, and the average surface roughness Ra of the sintered compact is not more than 100 nm.
Item 999. The thin-film substrate as described in Item 997 or 998, wherein the sintered compact comprises as a main component at least one selected from zirconium oxide, magnesium oxide, magnesium aluminate, titanium oxide, barium titanate, lead titanate zirconate, a rare earth oxide, thorium oxide, various ferrites, mullite, forsterite, steatite, and glass, and the average surface roughness Ra of the sintered compact is not more than 30 nm.

Item 1000. The thin-film substrate as described in any one of Items 997-999, wherein the sintered compact comprises as a main component at least one selected from zirconium oxide, magnesium oxide, magnesium aluminate, titanium oxide, barium titanate, lead titanate zirconate, a rare earth oxide, thorium oxide, various ferrites, mullite, forsterite, steatite, and glass, and the average surface roughness Ra of the sintered compact is not more than 10 nm.
Item 1001. The thin-film substrate as described in any one of Items 997-1000, wherein the sintered compact comprises as a main component at least one selected from zirconium oxide, magnesium oxide, magnesium aluminate, titanium oxide, barium titanate, lead titanate zirconate, a rare earth oxide, thorium oxide, various ferrites, mullite, forsterite, steatite, and glass, and the average surface roughness Ra of the sintered compact is not more than 5 nm.
Item 1002. The thin-film substrate as described in any one of Items 979-998, wherein the sintered compact has large surface roughness and comprises as a main component at least one selected from zirconium oxide, magnesium oxide, magnesium aluminate, titanium oxide, barium titanate, lead titanate zirconate, a rare earth oxide, thorium oxide, various ferrites, mullite, forsterite, steatite, and glass.
Item 1003. The thin-film substrate as described in any one of Items 979-998, wherein the sintered compact comprises as a main component at least one selected from zirconium oxide, magnesium oxide, magnesium aluminate, titanium oxide, barium titanate, lead titanate zirconate, a rare earth oxide, thorium oxide, various ferrites, mullite, forsterite, steatite, and glass, and the average surface roughness Ra of the sintered compact is not less than 70 nm.
Item 1004. The thin-film substrate as described in Item 1003, wherein the sintered compact comprises as a main component at least one selected from zirconium oxide, magnesium oxide, magnesium aluminate, titanium oxide, barium titanate, lead titanate zirconate, a rare earth oxide, thorium oxide, various ferrites, mullite, forsterite, steatite, and glass, and the average surface roughness Ra of the sintered compact is more than 1000 nm.
Item 1005. The thin-film substrate as described in Item 1003 or 1004, wherein the sintered compact comprises as a main component at least one selected from zirconium oxide, magnesium oxide, magnesium aluminate, titanium oxide, barium titanate, lead titanate zirconate, a rare earth oxide, thorium oxide, various ferrites, mullite, forsterite, steatite, and glass, and the average surface roughness Ra of the sintered compact is more than 2000 nm.
Item 1006. The thin-film substrate as described in any one of Items 979-1005, wherein the sintered compact comprises as a main component at least one selected from zirconium oxide, magnesium oxide, magnesium aluminate, titanium oxide, barium titanate, lead titanate zirconate, a rare earth oxide, thorium oxide, various ferrites, mullite, forsterite, steatite, and glass, and the surface of the sintered compact is at least one of the states selected from an as-fired state, a state in which lap polish was carried out, a state in which blast polish was carried out, a state in which specular surface polish was carried out, a state in which chemistry corrosion was carried out, and a state corroded by plasma gas. Item 1007. The thin-film substrate as described in Item 1006, wherein the sintered compact comprises as a main component at least one selected from zirconium oxide, magnesium oxide, magnesium aluminate, titanium oxide, barium titanate, lead titanate zirconate, a rare earth oxide, thorium oxide, various ferrites, mullite, forsterite, steatite, and glass, and the surface of the sintered compact is the state in which specular surface polish was carried out.
Item 1008. The thin-film substrate as described in any one of Items 577-1007, wherein a thin film comprising as a main component at least one selected from gallium nitride, indium nitride and aluminum nitride is formed on the sintered compact selected from a ceramic-based sintered compact and a ceramic-based sintered compact having optical permeability, and the thin film comprising as a main component at least one selected from gallium nitride, indium nitride and aluminum nitride has at least one of the crystallization states selected from a single crystal, an amorphous state, a polycrystal, and an orientated polycrystal.
Item 1009. The thin-film substrate as described in Item 1008, wherein a part of the thin film comprising as a main component at least one selected from gallium nitride, indium nitride and aluminum nitride is a single crystal at least.
Item 1010. The thin-film substrate as described in Item 1008 or 1009, wherein a part of the thin film comprising as a main component at least one selected from gallium nitride, indium nitride and aluminum nitride is a single crystal at least, and has at least one of the crystallization states selected from an amorphous state, a polycrystal, and an orientated polycrystal.
Item 1011. The thin-film substrate as described in any one of Items 1008-1010, wherein the thin film comprising as a main component at least one selected from gallium nitride, indium nitride and aluminum nitride is a single crystal altogether.
Item 1012. The thin-film substrate as described in any one of Items 1008-1010, wherein a part of the thin film comprising as a main component at least one selected from gallium nitride, indium nitride and aluminum nitride is amorphous at least.
Item 1013. The thin-film substrate as described in Item 1012, wherein a part of the thin film comprising as a main component at least one selected from gallium nitride, indium nitride and aluminum nitride is amorphous at least, and has at least one of the crystallization states selected from a single crystal, a polycrystal, and an orientated polycrystal.
Item 1014. The thin-film substrate as described in Item 1012, wherein the thin film is amorphous altogether.
Item 1015. The thin-film substrate as described in any one of Items 1008-1013, wherein a part of the thin film comprising as a main component at least one selected from gallium nitride, indium nitride and aluminum nitride is a polycrystal at least.
Item 1016. The thin-film substrate as described in Item 1015, wherein a part of the thin film comprising as a main component at least one selected from gallium nitride, indium nitride and aluminum nitride is a polycrystal at least, and has at least one of the crystallization states selected from a single crystal, an amorphous state, and an orientated polycrystal.
Item 1017. The thin-film substrate as described in Item 1015, wherein the thin film comprising as a main component at least one selected from gallium nitride, indium nitride and aluminum nitride is a polycrystal altogether.
Item 1018. The thin-film substrate as described in any one of Items 1008-1013, 1015, and 1016, wherein a part of the thin film comprising as a main component at least one selected from gallium nitride, indium nitride and aluminum nitride is an orientated polycrystal at least.
Item 1019. The thin-film substrate as described in Item 1018, wherein a part of the thin film comprising as a main component at least one selected from gallium nitride, indium nitride and aluminum nitride is an orientated polycrystal at least, and has at least one of the crystallization states selected from a single crystal, an amorphous state, and a polycrystal.
Item 1020. The thin-film substrate as described in Item 1018, wherein the thin film comprising as a main component at least one selected from gallium nitride, indium nitride and aluminum nitride is an orientated polycrystal altogether.
Item 1021. The thin-film substrate as described in any one of Items 1008-1013, 1015, 1016, 1018, and 1019, wherein a part of the thin film comprising as a main component at least one selected from gallium nitride, indium nitride and aluminum nitride is a single crystal at least, and the single crystal portion of the thin film is formed directly on the aluminum nitride-based sintered compact.
Item 1022. The thin-film substrate as described in any one of Items 1008-1013, 1015, 1016, 1018, and 1019, wherein a part of the thin film comprising as a main component at least one selected from gallium nitride, indium nitride and aluminum nitride is a single crystal at least, and the single crystal portion of the thin film is formed directly on the sintered compact comprising as a main component a ceramic material having at least one of the crystal structures selected from a hexagonal system or a trigonal system. Item 1023. The thin-film substrate as described in any one of Items 1008-1010 and 1012-1021, wherein a part of the thin film comprising as a main component at least one selected from gallium nitride, indium nitride and aluminum nitride is at least one of the crystallization states selected from an amorphous state, a polycrystal, and an orientated polycrystal, and the thin film of at least one of the crystallization states selected from an amorphous state, a polycrystal, and an orientated polycrystal is formed directly on the aluminum nitride-based sintered compact.
Item 1024. The thin-film substrate as described in any one of Items 1008-1010, 1012-1020, and 1022, wherein a part of the thin film comprising as a main component at least one selected from gallium nitride, indium nitride and aluminum nitride is at least one of the crystallization states selected from an amorphous state, a polycrystal, and an orientated polycrystal, and the thin film of at least one of the crystallization states selected from an amorphous state, a polycrystal, and an orientated polycrystal is formed directly on the sintered compact comprising as a main component a ceramic material having at least one of the crystal structures selected from a hexagonal system or a trigonal system.
Item 1025. The thin-film substrate as described in any one of Items 1008-1010 and 1012-1020, wherein a part of the thin film comprising as a main component at least one selected from gallium nitride, indium nitride and aluminum nitride is at least one of the crystallization states selected from an amorphous state, a polycrystal, and an orientated polycrystal, and the thin film of at least one of the crystallization states selected from an amorphous state, a polycrystal, and an orientated polycrystal is formed directly on the ceramic-based sintered compact having optical permeability
Item 1026. The thin-film substrate as described in any one of Items 577-1025, wherein the formed thin film comprising as a main component at least one selected from gallium nitride, indium nitride and aluminum nitride is constituted with one layer.
Item 1027. The thin-film substrate as described in any one of Items 577-1025, wherein the formed thin film comprising as a main component at least one selected from gallium nitride, indium nitride and aluminum nitride is constituted with at least two layers. Item 1028. The thin-film substrate as described in Item 1027, wherein at least two layers are either at least that having the different composition respectively or that having the different crystallization state respectively, in the thin film constituted with at least two layers.
Item 1029. The thin-film substrate as described in Item 1027 or 1028, wherein at least two layers are the different composition respectively, in the thin film constituted with at least two layers.
Item 1030. The thin-film substrate as described in Item 1027 or 1028, wherein at least two layers are the different composition respectively and are the same crystallization state, in the thin film constituted with at least two layers.
Item 1031. The thin-film substrate as described in any one of Items 1027-1029, wherein at least two layers are the different composition respectively and are the different crystallization state, in the thin film constituted with at least two layers.
Item 1032. The thin-film substrate as described in Item 1027 or 1028, wherein at least two layers are the same composition, in the thin film constituted with at least two layers.
Item 1033. The thin-film substrate as described in any one of Items 1027, 1028, and 1032, wherein at least two layers are the same composition and are the different crystallization state respectively, in the thin film constituted with at least two layers.
Item 1034. The thin-film substrate as described in Item 1027, wherein at least two layers are the same composition respectively and are the same crystallization state, in the thin film constituted with at least two layers.
Item 1035. The thin-film substrate as described in any one of Items 1027-1034, wherein each layer of the thin films constituted with at least two layers has at least one of the crystallization states selected from a single crystal, an orientated polycrystal, a polycrystal, and an amorphous state.
Item 1036. The thin-film substrate as described in any one of Items 1027-1035, wherein the thin film layer formed directly on the ceramic-based sintered compact and on the ceramic-based sintered compact having optical permeability has at least one of the crystallization states selected from a single crystal, an orientated polycrystal, a polycrystal, and an amorphous state, in the thin film constituted with at least two layers.
Item 1037. The thin-film substrate as described in Item 1036, wherein the thin film layer directly formed on the ceramic-based sintered compact and on the ceramic-based sintered compact having optical permeability has at least one of the crystallization states selected from an orientated polycrystal, a polycrystal, and an amorphous state, in the thin film constituted with at least two layers.
Item 1038. The thin-film substrate as described in Item 1036 or 1037, wherein the thin film layer directly formed on the ceramic-based sintered compact and on the ceramic-based sintered compact having optical permeability is an orientated polycrystal, in the thin film constituted with at least two layers.
Item 1039. The thin-film substrate as described in any one of Items 1027-1038, wherein at least one layer of the thin films comprising as a main component at least one selected from gallium nitride, indium nitride and aluminum nitride and having at least one of the crystallization states selected from a single crystal, an orientated polycrystal, a polycrystal, and an amorphous state is formed on the ceramic-based sintered compact and on the ceramic-based sintered compact having optical permeability, and at least one layer of the single-crystal thin film comprising as a main component at least one selected from gallium nitride, indium nitride and aluminum nitride is formed further on it, in the thin film constituted with at least two layers.
Item 1040. The thin-film substrate as described in Item 1039, wherein at least one layer of the thin films comprising as a main component at least one selected from gallium nitride, indium nitride and aluminum nitride and having at least one of the crystallization states selected from an orientated polycrystal, a polycrystal, and an amorphous state is formed on the ceramic-based sintered compact and on the ceramic-based sintered compact having optical permeability, and at least one layer of the single-crystal thin film comprising as a main component at least one selected from gallium nitride, indium nitride and aluminum nitride is formed further on it, in the thin film constituted with at least two layers.
Item 1041. The thin-film substrate as described in Item 1039 or 1040, wherein at least one layer of the amorphous thin film comprising as a main component at least one selected from gallium nitride, indium nitride and aluminum nitride is formed on the ceramic-based sintered compact or on the ceramic-based sintered compact having optical permeability, and at least one layer of the single-crystal thin film comprising as a main component at least one selected from gallium nitride, indium nitride and aluminum nitride is formed further on it, in the thin film constituted with at least two layers.
Item 1042. The thin-film substrate as described in Item 1039 or 1040, wherein at least one layer of the polycrystal thin film comprising as a main component at least one selected from gallium nitride, indium nitride and aluminum nitride is formed on the ceramic-based sintered compact and on the ceramic-based sintered compact having optical permeability, and at least one layer of single-crystal thin films which comprise as a main component at least one selected from gallium nitride, indium nitride and aluminum nitride is formed further on it, in the thin film constituted with at least two layers.
Item 1043. The thin-film substrate as described in Item 1039 or 1040, wherein at least one layer of the orientated polycrystal thin film comprising as a main component at least one selected from gallium nitride, indium nitride and aluminum nitride is formed on the ceramic-based sintered compact and on the ceramic-based sintered compact having optical permeability, and at least one layer of the single-crystal thin film comprising as a main component at least one selected from gallium nitride, indium nitride and aluminum nitride is formed further on it, in the thin film constituted with at least two layers.
Item 1044. The thin-film substrate as described in any one of Items 1027-1043, wherein the single-crystal thin film layer comprises at least two layers, in the thin film having at least one layer of the single-crystal thin film and formed on the ceramic-based sintered compact and on the ceramic-based sintered compact having optical permeability, in the thin film constituted with at least two layers.
Item 1045. The thin-film substrate as described in any one of Items 1027-1044, wherein at least one layer of the thin films comprising as a main component at least one selected from gallium nitride, indium nitride and aluminum nitride and having at least one of the crystallization states selected from a single crystal, an orientated polycrystal, a polycrystal, and an amorphous state is formed on the ceramic-based sintered compact and on the ceramic-based sintered compact having optical permeability, and at least one layer of thin films comprising as a main component at least one selected from gallium nitride, indium nitride and aluminum nitride and having at least one of the crystallization states selected from a single crystal, an orientated polycrystal, a polycrystal, and an amorphous state is formed further on it, in the thin film constituted with at least two layers.
Item 1046. The thin-film substrate as described in any one of Items 1027-1045, wherein at least one layer of thin films comprising as a main component at least one selected from gallium nitride, indium nitride and aluminum nitride and having at least one of the crystallization states selected from a single crystal, an orientated polycrystal, a polycrystal, and an amorphous state is formed on the ceramic-based sintered compact and on the ceramic-based sintered compact having optical permeability, and at least one layer of thin films comprising as a main component at least one selected from gallium nitride, indium nitride and aluminum nitride and having at least one of the crystallization states selected from a single crystal, an orientated polycrystal, a polycrystal, and an amorphous state is formed further on it, and at least one layer of single-crystal thin film comprising as a main component at least one selected from gallium nitride, indium nitride and aluminum nitride is formed further on it, in the thin film constituted with at least two layers.
Item 1047. The thin-film substrate as described in any one of Items 1027-1030, 1032, 1034-1036, 1039, and 1044, wherein all layers are constituted with only a single crystal, in the thin film constituted with at least two layers.
Item 1048. The thin-film substrate as described in any one of Items 577-1047, wherein a single-crystal thin film comprising as a main component at least one selected from gallium nitride, indium nitride and aluminum nitride is formed on the surface of the substrate.
Item 1049. The thin-film substrate as described in any one of Items 577-1048, wherein C axis of the single-crystal thin film comprising as a main component at least one selected from gallium nitride, indium nitride and aluminum nitride is formed in the perpendicular direction to the substrate surface.

Item 1050. The thin-film substrate as described in any one of Items 577-1048, wherein C axis of the single-crystal thin film comprising as a main component at least one selected from gallium nitride, indium nitride and aluminum nitride is formed in the parallel direction to the substrate surface.
Item 1051. The thin-film substrate as described in any one of Items 577-1048, wherein C axis of the orientated polycrystal thin film comprising as a main component at least one selected from gallium nitride, indium nitride and aluminum nitride is formed in the perpendicular direction to the substrate surface.
Item 1052. The thin-film substrate as described in any one of Items 577-1048, wherein C axis of the orientated polycrystal thin film comprising as a main component at least one selected from gallium nitride, indium nitride and aluminum nitride is formed in the parallel direction to the substrate surface.
Item 1053. The thin-film substrate as described in any one of Items 577-1052, wherein the thin film formed and comprising as a main component at least one selected from gallium nitride, indium nitride and aluminum nitride has conductivity.
Item 1054. The thin-film substrate as described in Item 1053, wherein the thin film comprising as a main component at least one selected from gallium nitride, indium nitride and aluminum nitride has conductivity by being semiconductorized.
Item 1055. The thin-film substrate as described in Item 1053 or 1054, wherein the thin film comprising as a main component at least one selected from gallium nitride, indium nitride and aluminum nitride has conductivity by at least one or more doping agents selected from magnesium, beryllium, calcium, zinc, cadmium, carbon, silicon, germanium, selenium, tellurium, and oxygen.
Item 1056. The thin-film substrate as described in any one of Items 1053-1055, wherein the thin film comprising as a main component at least one selected from gallium nitride, indium nitride and aluminum nitride has conductivity by being semiconductorized into P type or N type.
Item 1057. The thin-film substrate as described in any one of Items 1027-1056, wherein at least one layer has conductivity, in the thin film constituted with at least two layers and comprising as a main component at least one selected from gallium nitride, indium nitride and aluminum nitride.
Item 1058. The thin-film substrate as described in any one of Items 1053-1057, wherein the electric resistivity of the thin film having conductivity and comprising as a main component at least one selected from gallium nitride, indium nitride and aluminum nitride is not more than 1x10⁴ Ω·cm at room temperature.
Item 1059. The thin-film substrate as described in Item 1058, wherein the electric resistivity of the thin film having conductivity and comprising as a main component at least one selected from gallium nitride, indium nitride and aluminum nitride is not more than 1x10² Ω·cm at room temperature.
Item 1060. The thin-film substrate as described in Item 1058 or 1059, wherein the electric resistivity of the thin film having conductivity and comprising as a main component at least one selected from gallium nitride, indium nitride and aluminum nitride is not more than 1x10¹Ω·cm at room temperature.
Item 1061. The thin-film substrate as described in any one of Items 1058-1060, wherein the electric resistivity of the thin film having conductivity and comprising as a main component at least one selected from gallium nitride, indium nitride and aluminum nitride is not more than 1x10⁰Ω·cm at room temperature.
Item 1062. The thin-film substrate as described in any one of Items 577-1061, wherein the thin film currently formed comprises as a main component the composite expressed with the chemical formula of AlₓGa₁₋ₓN (0≤x≤1.0).
Item 1063. The thin-film substrate as described in Item 1062, wherein the thin film currently formed comprises as a main component the composite expressed with the chemical formula of AlₓGa₁₋ₓN (0≤x≤1.0), and contains a doping component in the range of 0.00001-10 mol % on an element basis to the composite.
Item 1064. The thin-film substrate as described in Item 1062 or 1063, wherein the thin film currently formed comprises as a main component the composite expressed with the chemical formula of AlₓGa₁₋ₓN (0≤x≤0.6).
Item 1065. The thin-film substrate as described in Item 1064, wherein the thin film currently formed comprises as a main component the composite expressed with the chemical formula of AlₓGa₁₋ₓN (0≤x≤0.6), and contains a doping component in the range of 0.00001-10 mol % on an element basis to the composite.
Item 1066. The thin-film substrate as described in Item 1062 or 1063, wherein the thin film currently formed comprises as a main component the composite expressed with the chemical formula of AlₓGa₁₋ₓN (0≤x≤0.6).
Item 1067. The thin-film substrate as described in Item 1066, wherein the thin film currently formed comprises as a main component the composite expressed with the chemical formula of AlₓGa₁₋ₓN (0≤x≤0.6), and contains a doping component in the range of 0.00001-10 mol % on an element basis to the composite.
Item 1068. The thin-film substrate as described in any one of Items 1062-1067, wherein at least two doping components are contained simultaneously.
Item 1069. The thin-film substrate as described in any one of Items 1063, 1065, 1067, and 1068, wherein the doping component is at least one selected from Mg, Be, Ca, Zn, Cd, C, Si, Ge, Se, Te, and O.
Item 1070. The thin-film substrate as described in Item 1069, wherein the doping component is at least one selected from Mg, Be, Zn, and Si.
Item 1071. The thin-film substrate as described in any one of Items 1062-1065 and 1068-1070, wherein the thin film currently formed comprises as a main component the composite expressed with the chemical formula of AlₓGa₁₋ₓN (0≤x≤0.6), and contains at least one selected from Mg, Zn, and Si in the range of 0.00001-10 mol % to the composite.
Item 1072. The thin-film substrate as described in Item 1071, wherein the thin film currently formed comprises as a main component the composite expressed with the chemical formula of AlₓGa₁₋ₓN (0≤x≤0.6), and contains simultaneously at least two selected from Mg, Zn, and Si a total ofthe range of 0.00001-10 mol % to the composite.
tem 1073. The thin-film substrate as described in any one of Items 1062 and 1066-1070, wherein the thin film currently formed comprises as a main component the composite expressed with the chemical formula of AlₓGa₁₋ₓN (0≤x≤0.6), and contains at least one selected from Mg, Zn, and Si in the range of 0.00001-10 mol % on an element basis to the composite.
Item 1074. The thin-film substrate as described in Item 1073, wherein the thin film currently formed comprises as a main component the composite expressed with the chemical formula of AlₓGa₁₋ₓN (0≤x≤0.6), and contains simultaneously at least two selected from Mg, Zn, and Si a total of the range of 0.00001-10 mol % on an element basis to the composite.
Item 1075. The thin-film substrate as described in Item 1073 or 1074, wherein the thin film currently formed comprises as a main component the composite expressed with the chemical formula of AlₓGa₁₋ₓN (0≤x≤0.6), and contains Si in the range of 0.00001-0.5 mol % on an element basis to the composite.
Item 1076. The thin-film substrate as described in any one of Items 577-1075, wherein the thin film of the surface has the average surface roughness Ra not more than 20 nm.
Item 1077. The thin-film substrate as described in Item 1076, wherein the thin film of the surface has the average surface roughness Ra not more than 10 nm.
Item 1078. The thin-film substrate as described in Item 1076 or 1077, wherein the thin film of the surface has the average surface roughness Ra not more than 5 nm.
Item 1079. The thin-film substrate as described in any one of Items 1076-1078, wherein the thin film of the surface has the average surface roughness Ra not more than 3 nm.
Item 1080. The thin-film substrate as described in any one of Items 1076-1079, wherein the thin film of the surface has the average surface roughness Ra not more than 2 nm.
Item 1081. The thin-film substrate as described in any one of Items 1076-1080, wherein the thin film of the surface has the average surface roughness Ra not more than 1 nm.
Item 1082. The thin-film substrate as described in any one of Items 577-1081, wherein the thickness of the thin film currently formed is not less than 0.5 nm.
Item 1083. The thin-film substrate as described in Item 1082, wherein the thickness of the thin film currently formed is not less than 0.3 µm.
Item 1084. The thin-film substrate as described in Item 1082 or 1083, wherein the thickness of the thin film currently formed is not less than 3.5 µm.
Item 1085. The thin-film substrate as described in any one of Items 1082-1084, wherein the thickness of the thin film currently formed is not less than 10 µm.
Item 1086. The thin-film substrate as described in any one of Items 1082-1085, wherein the thickness of the thin film currently formed is not less than 50 µm.
Item 1087. The thin-film substrate as described in any one of Items 577-1081, wherein the thickness of the thin film currently formed is not more than 1000 µm.
Item 1088. The thin-film substrate as described in Item 1087, wherein the thin film comprises a thin film layer in which each thickness is not more than 1000 µm.
Item 1089. The thin-film substrate as described in Item 1087 or 1088, wherein the thickness of all thin film layers is not more than 1000 µm.
Item 1090. The thin-film substrate as described in any one of Items 1087-1089, wherein the thickness of the thin film is not more than 500 µm.
Item 1091. The thin-film substrate as described in Item 1090, wherein the thin film comprises a thin film layer in which each thickness is not more than 500 µm.
Item 1092. The thin-film substrate as described in Item 1090 or 1091, wherein the thickness of all thin film layers is not more than 500 µm.
Item 1093. The thin-film substrate as described in any one of Items 1087-1092, wherein the thickness of the thin film is less than 300 µm.
Item 1094. The thin-film substrate as described in Item 1093, wherein the thin film comprises a thin film layer in which each thickness is less than 300 µm.
Item 1095. The thin-film substrate as described in Item 1093 or 1094, wherein the thickness of all thin film layers is less than 300 µm.
Item 1096. The thin-film substrate as described in any one of Items 1087-1095, wherein the thickness of the thin film is not more than 200 µm.
Item 1097. The thin-film substrate as described in Item 1096, wherein the thin film comprises a thin film layer in which each thickness is not more than 200 µm.
Item 1098. The thin-film substrate as described in Item 1096 or 1097, wherein the thickness of all thin film layers is not more than 200 µm.
Item 1099. The thin-film substrate as described in any one of Items 577-1098, wherein the half width of the rocking curve of the X ray diffraction from the lattice plane of the Miller Index (002) of the formed single-crystal thin film comprising as a main component at least one selected from gallium nitride, indium nitride and aluminum nitride is not more than 3600 seconds.

Item 1100. The thin-film substrate as described in Item 1099, wherein the half width of the rocking curve of the X ray diffraction from the lattice plane of the Miller Index (002) of the formed single-crystal thin film comprising as amain component at least one selected from gallium nitride, indium nitride and aluminum nitride is not more than 300 seconds.
Item 1101. The thin-film substrate as described in Item 1099 or 1100, wherein the half width of the rocking curve of the X ray diffraction from the lattice plane of the Miller Index (002) of the formed single-crystal thin film comprising as a main component at least one selected from gallium nitride, indium nitride and aluminum nitride is not more than 240 seconds.
Item 1102. The thin-film substrate as described in any one of Items 1099-1101, wherein the half width of the rocking curve of the X ray diffraction from the lattice plane of the Miller Index (002) of the formed single-crystal thin film comprising as a main component at least one selected from gallium nitride, indium nitride and aluminum nitride is not more than 200 seconds.
Item 1103. The thin-film substrate as described in any one of Items 1099-1102, wherein the half width of the rocking curve of the X ray diffraction from the lattice plane of the Miller Index (002) of the formed single-crystal thin film comprising as a main component at least one selected from gallium nitride, indium nitride and aluminum nitride is not more than 150 seconds.
Item 1104. The thin-film substrate as described in any one of Items 1099-1103, wherein the half width of the rocking curve of the X ray diffraction from the lattice plane of the Miller Index (002) of the formed single-crystal thin film comprising as a main component at least one selected from gallium nitride, indium nitride and aluminum nitride is not more than 130 seconds.
Item 1105. The thin-film substrate as described in any one of Items 1099-1104, wherein the half width of the rocking curve of the X ray diffraction from the lattice plane of the Miller Index (002) of the formed single-crystal thin film comprising as a main component at least one selected from gallium nitride, indium nitride and aluminum nitride is not more than 100 seconds.
Item 1106. The thin-film substrate as described in any one of Items 577-1105, wherein a thin film comprising as a main component at least one selected from gallium nitride, indium nitride and aluminum nitride is formed on the sintered compact selected from a ceramic-based sintered compact and a ceramic-based sintered compact having optical permeability, and the thin-film substrate is used in order to form a thin film comprising as a main component at least one selected from gallium nitride, indium nitride and aluminum nitride.
Item 1107. The thin-film substrate which is used in order to form a thin film comprising as a main component at least one selected from gallium nitride, indium nitride and aluminum nitride as described in Item 1106, wherein the thin film comprising as a main component at least one selected from gallium nitride, indium nitride and aluminum nitride is formed on the sintered compact selected from a ceramic-based sintered compact and a ceramic-based sintered compact having optical permeability, and the thin film has at least one of the crystallization states selected from a single crystal, an orientated polycrystal, a polycrystal, and an amorphous state.
Item 1108. The thin-film substrate which is used in order to form a thin film comprising as a main component at least one selected from gallium nitride, indium nitride and aluminum nitride as described in Item 1106 or 1107, wherein the thin film comprising as a main component at least one selected from gallium nitride, indium nitride and aluminum nitride is formed on the sintered compact selected from a ceramic-based sintered compact and a ceramic-based sintered compact having optical permeability, and the thin film formed on the surface of the thin-film substrate is a single crystal.
Item 1109. The thin-film substrate which is used in order to form a thin film comprising as a main component at least one selected from gallium nitride, indium nitride and aluminum nitride as described in Item 1106 or 1107, wherein the thin film comprising as a main component at least one selected from gallium nitride, indium nitride and aluminum nitride is formed on the sintered compact selected from a ceramic-based sintered compact and a ceramic-based sintered compact having optical permeability, and the thin film formed on the surface of the thin-film substrate is an orientated polycrystal.
Item 1110. The thin-film substrate which is used in order to form a thin film comprising as a main component at least one selected from gallium nitride, indium nitride and aluminum nitride as described in Item 1106 or 1107, wherein the thin film comprising as a main component at least one selected from gallium nitride, indium nitride and aluminum nitride is formed on the sintered compact selected from a ceramic-based sintered compact and a ceramic-based sintered compact having optical permeability, and the thin film formed on the surface of the thin-film substrate is a polycrystal.
Item 1111. The thin-film substrate which is used in order to form a thin film comprising as a main component at least one selected from gallium nitride, indium nitride and aluminum nitride as described in Item 1106 or 1107, wherein the thin film comprising as a main component at least one selected from gallium nitride, indium nitride and aluminum nitride is formed on the sintered compact selected from a ceramic-based sintered compact and a ceramic-based sintered compact having optical permeability, and the thin film formed on the surface of the thin-film substrate is an amorphous state.
Item 1112. The thin-film substrate as described in any one of Items 577-1111, wherein a thin film comprising as a main component at least one selected from gallium nitride, indium nitride and aluminum nitride is formed on the sintered compact selected from a ceramic-based sintered compact and a ceramic-based sintered compact having optical permeability, and the thin film formed contains gallium nitride at least or comprises gallium nitride as a main component.
Item 1113. The thin-film substrate as described in Item 1112, wherein the thin film has the composition expressed with AlₓGa_{y}In_{1-x-y}N (0<y≤1).
Item 1114. The thin-film substrate as described in Item 1112 or 1113, wherein the thin film contains gallium nitride not less than 50 mol %.
Item 1115. The thin-film substrate as described in any one of Items 1112-1114, wherein the thin film containing gallium nitride at least or comprising gallium nitride as a main component has at least one of the crystallization states selected from an amorphous state, a polycrystal, an orientated polycrystal, and a single crystal.
Item 1116. The thin-film substrate as described in Item 1115, wherein the thin film containing gallium nitride at least or comprising gallium nitride as a main component is a single crystal.
Item 1117. The thin-film substrate as described in any one of Items 1112-1116, wherein the thin film of the top layer is that containing gallium nitride at least or comprising gallium nitride as a main component.
Item 1118. The thin-film substrate as described in Item 1117, wherein the thin film of the top layer is a single crystal containing gallium nitride at least or comprising gallium nitride as a main component.
Item 1119. The thin-film substrate as described in any one of Items 577-1118, wherein a thin film comprising as a main component at least one selected from gallium nitride, indium nitride and aluminum nitride is formed on the sintered compact selected from a ceramic-based sintered compact and a ceramic-based sintered compact having optical permeability, and the thin film comprises a state in which at least two crystallization states selected from a single crystal, an amorphous state, a polycrystal, and an orientated polycrystal are intermingled simultaneously.
Item 1120. The thin-film substrate as described in Item 1119, wherein the thin film comprising as a main component at least one selected from gallium nitride, indium nitride and aluminum nitride is formed in a single layer or at least two layers on the sintered compact selected from a ceramic-based sintered compact and a ceramic-based sintered compact having optical permeability, and at least one layer comprises a state in which at least two crystallization states selected from a single crystal, an amorphous state, a polycrystal, and an orientated polycrystal are intermingled simultaneously.
Item 1121. The thin-film substrate as described in any one of Items 577-1120, wherein a thin film comprising as a main component at least one selected from gallium nitride, indium nitride and aluminum nitride is formed on the sintered compact selected from a ceramic-based sintered compact and a ceramic-based sintered compact having optical permeability, and the sintered compact is a substrate-like.
Item 1122. The thin-film substrate as described in any one of Items 577-1121, wherein the ceramic material comprises the composite of at least one selected from a metal element and a semimetal element and at least one selected from a nonmetallic element, or the composite of at least one selected from a metal element and at least one selected from a semimetal element, or the composite of at least two selected from a semimetal element.
Item 1123. The thin-film substrate as described in Item 1122, wherein the semimetal element is at least one selected from boron, carbon, silicon, germanium, arsenic, antimony, bismuth, selenium, tellurium, and polonium.
Item 1124. The thin-film substrate as described in Item 1122 or 1123, wherein the semimetal element is at least one selected from carbon and silicon.
Item 1125. The thin-film substrate as described in any one of Items 1121, 1122, and 1124, wherein the nonmetallic element is at least one selected from nitrogen, phosphorus, oxygen, sulfur, fluorine, chlorine, bromine, iodine, and astatine.
Item 1126. The thin-film substrate as described in Item 1125, wherein the nonmetallic element is at least one selected from nitrogen and oxygen.
Item 1127. The thin-film substrate as described in any one of Items 1122-1126, wherein the ceramic material is at least one selected from nitride, carbide, oxide, boride, and silicide.
Item 1128. The thin-film substrate as described in any one of Items 577-1127, wherein a thin film comprising as a main component at least one selected from gallium nitride, indium nitride and aluminum nitride is formed on the sintered compact selected from a ceramic-based sintered compact and a ceramic-based sintered compact having optical permeability, and the sintered compact has conductivity.
Item 1129. The thin-film substrate as described in Item 1128, wherein the ceramic-based sintered compact or the ceramic-based sintered compact having optical permeability has the electric resistivity not more than 1x10⁴Ω·cm at room temperature.
Item 1130. The thin-film substrate as described in Item 1128 or 1129, wherein the ceramic-based sintered compact or the ceramic-based sintered compact having optical permeability has the electric resistivity not more than 1x10² Ω·cm at room temperature.
Item 1131. The thin-film substrate as described in any one of Items 1128-1130, wherein the ceramic-based sintered compact or the ceramic-based sintered compact having optical permeability has the electric resistivity not more than 1x10¹ Ω·cm at room temperature.
Item 1132. The thin-film substrate as described in any one of Items 1128-1131, wherein the ceramic-based sintered compact or the ceramic-based sintered compact having optical permeability has the electric resistivity not more than 1x10⁰ Ω·cm at room temperature.
Item 1133. The thin-film substrate as described in any one of Items 1128-1132, wherein the ceramic-based sintered compact or the ceramic-based sintered compact having optical permeability has the electric resistivity not more than 1x10⁻² Ω·cm at room temperature.
Item 1134. The thin-film substrate as described in any one of Items 1128-1133, wherein the ceramic-based sintered compact or the ceramic-based sintered compact having optical permeability has conductivity and has optical permeability.
Item 1135. A thin-film substrate in which an optical waveguide is formed on the aluminum nitride-based sintered compact by a thin film comprising as a main component at least one selected from gallium nitride, indium nitride and aluminum nitride.
Item 1136. The thin-film substrate as described in Item 1135, wherein the optical waveguide comprises a thin film comprising as a main component at least one selected from gallium nitride, indium nitride and aluminum nitride and having at least one of the crystallization states selected from a single crystal, an amorphous state, a polycrystal, and an orientated polycrystal.
Item 1137. The thin-film substrate as described in Item 1135 or 1136, wherein the optical waveguide comprises a single-crystal thin film comprising as a main component at least one selected from gallium nitride, indium nitride and aluminum nitride.
Item 1138. The thin-film substrate as described in Item 1137, wherein an optical waveguide is formed on the aluminum nitride-based sintered compact by a single-crystal thin film comprising as a main component at least one selected from gallium nitride, indium nitride and aluminum nitride, and the optical waveguide comprises a single-crystal thin film formed in the direction where C axis is perpendicular to the substrate surface. Item 1139. The thin-film substrate as described in Item 1137, wherein an optical waveguide is formed on the aluminum nitride-based sintered compact by a single-crystal thin film comprising as a main component at least one selected from gallium nitride, indium nitride and aluminum nitride, and the optical waveguide comprises a single-crystal thin film formed in the direction where C axis is parallel to the substrate surface.
Item 1140. The thin-film substrate as described in any one of Items 1135-1139, wherein the optical waveguide comprises as a main component at least one selected from gallium nitride and aluminum nitride.
Item 1141. The thin-film substrate as described in any one of Items 1135-1140, wherein the optical waveguide comprises as a main component the composite expressed with the chemical formula of AlₓGa₁₋ₓN (0.0≤x≤1.0).
Item 1142. The thin-film substrate as described in Item 1141, wherein the optical waveguide comprises as a main component the composite expressed with the chemical formula ofAlₓGa₁₋ₓN (0.5≤x≤1.0).
Item 1143. The thin-film substrate as described in Item 1141 or 1142, wherein the optical waveguide comprises as a main component the composite expressed with the chemical formula of AlₓGa₁₋ₓN (0.8≤x≤1.0).
Item 1144. The thin-film substrate as described in any one of Items 1141-1143, wherein the optical waveguide comprises as a main component the composite expressed with the chemical formula of AlₓGa₁₋ₓN (0.9≤x≤1.0).
Item 1145. The thin-film substrate as described in any one of Items 1135-1144, wherein the optical waveguide comprises as a main component aluminum nitride.
Item 1146. The thin-film substrate as described in any one of Items 1135-1145, wherein the optical waveguide comprises a thin film comprising as a main component at least one selected from gallium nitride, indium nitride and aluminum nitride, and contains further at least one selected from gallium, indium, niobium, and tantalum.
Item 1147. The thin-film substrate as described in Item 1146, wherein the optical waveguide comprises a thin film comprising as a main component at least one selected from gallium nitride, indium nitride and aluminum nitride, and contains further at least one selected from gallium, indium, niobium, and tantalum by thermal diffusion or ion implantation.
Item 1148. The thin-film substrate as described in Item 1146 or 1147, wherein the optical waveguide comprises a thin film comprising as a main component at least one selected from gallium nitride, indium nitride and aluminum nitride, and contains further at least one selected from gallium, indium, niobium, and tantalum not more than 20 mol % on a nitride basis to the main component.
Item 1149. The thin-film substrate as described in any one of Items 1135-1148, wherein the optical waveguide comprises a thin film comprising as a main component at least one selected from gallium nitride, indium nitride and aluminum nitride, and contains further at least one selected from gallium and niobium.

Item 1150. The thin-film substrate as described in Item 1149, wherein the content of at least one selected from gallium and niobium is not more than 20 mlo % on a nitride basis to the main component.
Item 1151. The thin-film substrate as described in any one of Items 1146-1150, wherein the optical waveguide comprises a thin film comprising as a main component at least one selected from gallium nitride and aluminum nitride, and contains further at least one selected from gallium, indium, niobium, and tantalum.
Item 1152. The thin-film substrate as described in Item 1151, wherein the optical waveguide comprises a thin film comprising as a main component at least one selected from gallium nitride and aluminum nitride, and contains further at least one selected from gallium, indium, niobium, and tantalum not more than 20 mol % on a nitride basis.
Item 1153. The thin-film substrate as described in any one of Items 1146-1152, wherein the optical waveguide comprises a thin film comprising as a main component aluminum nitride, and contains further at least one selected from gallium, indium, niobium, and tantalum.
Item 1154. The thin-film substrate as described in Item 1153, wherein the optical waveguide comprises a thin film comprising as a main component aluminum nitride, and contains further at least one selected from gallium, indium, niobium, and tantalum not more than 20 mol % on a nitride basis.
Item 1155. The thin-film substrate as described in any one of Items 1135-1154, wherein an optical waveguide is formed on the aluminum nitride-based sintered compact by a thin film comprising as a main component at least one selected from gallium nitride, indium nitride and aluminum nitride, and the thin-film substrate comprises an optical waveguide and the cladding layer where the refractive index is smaller than the optical waveguide.
Item 1156. The thin-film substrate as described in Item 1155, wherein the cladding layer comprises a thin film comprising as amain component at least one selected from gallium nitride, indium nitride and aluminum nitride.
Item 1157. The thin-film substrate as described in Item 1156, wherein the optical waveguide comprises a thin film comprising as a main component at least one selected from gallium nitride, indium nitride and aluminum nitride, and the optical waveguide contains at least one selected from gallium, indium, niobium, and tantalum more than the cladding layer.
Item 1158. The thin-film substrate as described in Item 1156 or 1157, wherein the optical waveguide comprises a thin film comprising as a main component at least one selected from gallium nitride, indium nitride and aluminum nitride, and the optical waveguide contains at least one selected from gallium, indium, niobium, and tantalum more than the cladding layer in the range of not more than 20 mol % on a nitride basis. Item 1159. The thin-film substrate as described in any one of Items 1155-1158, wherein the cladding layer comprises a thin film comprising aluminum nitride as a main component.
Item 1160. The thin-film substrate as described in any one of Items 1155-1159, wherein the cladding layer comprises a thin film comprising aluminum nitride as a main component, and the optical waveguide comprises a thin film comprising aluminum nitride as a main component and has larger refractive index than the cladding layer.
Item 1161. The thin-film substrate as described in any one of Items 1155-1160, wherein the cladding layer comprises a thin film comprising aluminum nitride as a main component, and the optical waveguide comprises a thin film comprising aluminum nitride as a main component and contains at least one selected from gallium, indium, niobium, and tantalum more than the cladding layer.
Item 1162. The thin-film substrate as described in any one of Items 1155-1161, wherein the cladding layer comprises a thin film comprising aluminum nitride as a main component, and the optical waveguide comprises a single-crystal thin film comprising aluminum nitride as a main component.
Item 1163. The thin-film substrate as described in any one of Items 1155-1161, wherein the electrode is formed on the optical waveguide.
Item 1164. The thin-film substrate as described in any one of Items 1155-1162, wherein the electrode is formed on the cladding layer.
Item 1165. The thin-film substrate as described in Item 1163 or 1164, wherein the electrode is formed on the optical waveguide and the cladding layer.
Item 1166. The thin-film substrate as described in any one of Items 1163-1165, wherein the electrode is formed via the buffer layer.
Item 1167. The thin-film substrate as described in Item 1166, wherein the buffer layer comprises at least one selected from SiO₂ and Al₂O₃.
Item 1168. The thin-film substrate as described in any one of Items 1135-1167, wherein the dielectric whose refractive index is smaller than the thin film is formed on the thin film comprising as a main component at least one selected from gallium nitride, indium nitride and aluminum nitride, and the thin film of a portion in which the dielectric is formed is used as an optical waveguide.
Item 1169. The thin-film substrate as described in any one of Items 1135-1167, wherein a metal is formed in two or more places of the thin film comprising as a main component at least one selected from gallium nitride, indium nitride and aluminum nitride, and the thin film of a portion in which the metal is not formed is used as an optical waveguide.
Item 1170. The thin-film substrate as described in any one of Items 1135-1167, wherein an electrode is formed on two or more places of the thin film comprising as a main component at least one selected from gallium nitride, indium nitride and aluminum nitride, and the thin film of a portion in which the electrode is formed is used as an optical waveguide.
Item 1171. A manufacture method of the thin-film substrate in which a thin film comprising as a main component at least one selected from gallium nitride, indium nitride and aluminum nitride is formed on the sintered compact selected from a ceramic-based sintered compact and a ceramic-based sintered compact having optical permeability, and the thin film is produced using an organic compound containing at least one selected from gallium, indium and aluminum as a main raw material and using at least one selected from ammonia, nitrogen, and hydrogen as a reactive gas.
Item 1172. The manufacture method of the thin-film substrate as described in Item 1171, wherein the organic compound of the main raw material is an alkyl compound of at least one selected from gallium, indium and aluminum.
Item 1173. The manufacture method of the thin-film substrate as described in Item 1171 or 1172, wherein the organic compound of the main raw material is that comprising as a main component at least one selected from trimethyl gallium, trimethyl indium, and trimethyl aluminum.
Item 1174. A manufacture method of the thin-film substrate in which a thin film comprising as a main component at least one selected from gallium nitride, indium nitride and aluminum nitride is formed on the sintered compact selected from a ceramic-based sintered compact and a ceramic-based sintered compact having optical permeability, and the thin film is produced using a halogenated compound containing at least one selected from gallium, indium and aluminum as a main raw material and using at least one selected from ammonia, nitrogen, and hydrogen as a reactive gas.
Item 1175. The manufacture method of the thin-film substrate as described in Item 1174, wherein the halogenated compound of the main raw material comprises at least one selected from fluoride, chloride and bromide.
Item 1176. The manufacture method of the thin-film substrate as described in Item 1174 or 1175, wherein the halogenated compound of the main raw material comprises as a main component at least one selected from gallium chloride, gallium bromide, indium chloride, indium bromide, aluminium chloride, and aluminum bromide.
Item 1177. The manufacture method of the thin-film substrate as described in any one of Items 1171-1176, wherein the main raw material comprises an organic compound containing a halogen element.
Item 1178. A manufacture method of the thin-film substrate in which an optical waveguide was formed on the aluminum nitride-based sintered compact by the thin film comprising as a main component gallium nitride, indium nitride and aluminum nitride, and the optical waveguide comprises a thin film containing at least one selected from gallium, indium, niobium, and tantalum by at least one of the methods selected from the thermal diffusion or ion implantation
Item 1179. An optical waveguide which comprises as a main component at least one selected from gallium nitride, indium nitride and aluminum nitride and contains further at least one selected from niobium and tantalum.
Item 1180. The optical waveguide as described in Item 1179, wherein the main component comprises at least one selected from gallium nitride and aluminum nitride and at least one selected from niobium and tantalum is contained further.
Item 1181. The optical waveguide as described in Item 1179 or 1180, wherein the main component comprises aluminum nitride and at least one selected from niobium and tantalum is contained further.
Item 1182. The optical waveguide as described in any one of Items 1179-1181, wherein the content of at least one selected from niobium and tantalum is not more than 20 mol % to the main component.
Item 1183. The optical waveguide as described in any one of Items 1179-1182, wherein the optical waveguide comprises as a main component at least one selected from gallium nitride, indium nitride and aluminum nitride and contains further at least one selected from niobium and tantalum, and the optical waveguide has at least one of the crystallization states selected from a single crystal, an amorphous state, a polycrystal, and an orientated polycrystal.
Item 1184. The optical waveguide as described in Item 1183, wherein the crystallization state is a single crystal.
Item 1185. The optical waveguide as described in Item 1183 or 1184, wherein the optical waveguide comprises a single crystal comprising aluminum nitride as a main component and contains further at least one selected from gallium nitride and indium nitride.
Item 1186. The optical waveguide as described in any one of Items 1183-1185, wherein the optical waveguide comprises a single crystal comprising aluminum nitride as a main component and contains further at least one selected from gallium nitride and indium nitride not more than 20 mol % to the main component
Item 1187. The optical waveguide as described in any one of Items 1179-1186, wherein the optical waveguide comprises a thin film comprising as a main component at least one selected from gallium nitride, indium nitride and aluminum nitride and containing further at least one selected from niobium and tantalum.
Item 1188. A light-emitting device constituted with the laminate which comprises a thin film comprising at least one selected from gallium nitride, indium nitride and aluminum nitride as a main component and contains at least N type semiconductor layer, luminescence layer, and P type semiconductor layer, and the laminate of N type semiconductor layer, luminescence layer, and P type semiconductor layer is formed on the ceramic-based sintered compact.
Item 1189. The light-emitting device as described in Item 1188, wherein the ceramic-based sintered compact is substrates-like.
Item 1190. The light-emitting device as described in Item 1188 or 1189, wherein the ceramic-based sintered compact has optical permeability.
Item 1191. The light-emitting device as described in any one of Items 1188-1190, wherein the optical transmissivity of the ceramic-based sintered compact is not less than 1 %.
Item 1192. The light-emitting device as described in Item 1191, wherein the optical transmissivity of the ceramic-based sintered compact is not less than 10 %.
Item 1193. The light-emitting device as described in Item 1191 or 1192, wherein the optical transmissivity of the ceramic-based sintered compact is not less than 20 %.
Item 1194. The light-emitting device as described in any one of Items 1191-1193, wherein the optical transmissivity of the ceramic-based sintered compact is not less than 30%.
Item 1195. The light-emitting device as described in any one of Items 1191-1194, wherein the optical transmissivity of the ceramic-based sintered compact is not less than 40%.
Item 1196. The light-emitting device as described in any one of Items 1191-1195, wherein the optical transmissivity of the ceramic-based sintered compact is not less than 50%.
Item 1197. The light-emitting device as described in any one of Items 1191-1196, wherein the optical transmissivity of the ceramic-based sintered compact is not less than 60%.
Item 1198. The light-emitting device as described in any one of Items 1191-1197, wherein the optical transmissivity of the ceramic-based sintered compact is not less than 80%.
Item 1199. The light-emitting device as described in any one of Items 1191-1198, wherein the optical transmissivity of the ceramic-based sintered compact is not less than 85%.

Item 1200. The light-emitting device as described in any one of Items 1188-1199, wherein the optical transmissivity of the ceramic-based sintered compact is less than 1 %.
Item 1201. The light-emitting device as described in Item 1120, wherein the optical transmissivity of the ceramic-based sintered compact is 0 %.
Item 1202. The light-emitting device as described in any one of Items 1190-1201, wherein the optical permeability or optical transmissivity of the gallium nitride-based sintered compact is that to the light of the range of 200-800 nm wavelength at least.
Item 1203. The light-emitting device as described in any one of Items 1188-1202, wherein the average surface roughness Ra of the ceramic-based sintered compact is not more than 2000 nm.
Item 1204. The light-emitting device as described in Item 1203, wherein the average surface roughness Ra of the ceramic-based sintered compact is not more than 1000 nm.
Item 1205. The light-emitting device as described in Item 1203 or 1204, wherein the average surface roughness Ra of the ceramic-based sintered compact is not more than 100 nm.
Item 1206. The light-emitting device as described in any one of Items 1203-1205, wherein the average surface roughness Ra of the ceramic-based sintered compact is not more than 20 nm.
Item 1207. The light-emitting device as described in any one of Items 1203-1206, wherein the average surface roughness Ra of the ceramic-based sintered compact is not more than 10 nm.
Item 1208. The light-emitting device as described in any one of Items 1203-1207, wherein the average surface roughness Ra of the ceramic-based sintered compact is not more than 5 nm.
Item 1209. The light-emitting device as described in any one of Items 1188-1205, wherein the ceramic-based sintered compact has large surface roughness.
Item 1210. The light-emitting device as described in any one of Items 1188-1205 and 1209, wherein the average surface roughness Ra of the ceramic-based sintered compact is not less than 70 nm.
Item 1211. The light-emitting device as described in Item 1210, wherein the average surface roughness Ra of the ceramic-based sintered compact is more than 1000 nm.
Item 1212. The light-emitting device as described in Item 1210 or 1211, wherein the average surface roughness Ra of the ceramic-based sintered compact is more than 2000 nm.
Item 1213. The light-emitting device as described in any one of Items 1188-1212, wherein the surface of the ceramic-based sintered compact is at least one of the states selected from an as-fired state, a state in which lap polish was carried out, a state in which blast polish was carried out, a state in which specular surface polish was carried out, a state in which chemistry corrosion was carried out, and a state corroded by plasma gas.
Item 1214. The light-emitting device as described in Item 1213, wherein the surface of a ceramic-based sintered compact is the state in which specular surface polish was carried out.
Item 1215. The light-emitting device as described in any one of Items 1188-1214, wherein the ceramic-based sintered compact has optical permeability and has large surface roughness.
Item 1216. The light-emitting device as described in any one of Items 1188-1215, wherein the ceramic-based sintered compact has conductivity.
Item 1217. The light-emitting device as described in any one of Items 1188-1216, wherein the ceramic-based sintered compact has the electric resistivity not more than 1x10⁴ Ω·cm at room temperature.
Item 1218. The light-emitting device as described in Item 1217, wherein the ceramic-based sintered compact has the electric resistivity not more than 1x10² Ω·cm at room temperature.
Item 1219. The light-emitting device as described in any one of Items 1216-1218, wherein the ceramic-based sintered compact has the electric resistivity not more than 1x10⁰ Ω·cm at room temperature.
Item 1220. The light-emitting device as described in any one of Items 1216-1219, wherein the ceramic-based sintered compact has the electric resistivity not more than 1x10⁻¹ Ω·cm at room temperature.
Item 1221. The light-emitting device as described in any one of Items 1216-1220, wherein the ceramic-based sintered compact has the electric resistivity not more than 1x10⁻² Ω·cm at room temperature.
Item 1222. The light-emitting device as described in any one of Items 1188-1221, wherein the ceramic-based sintered compact has optical permeability and has conductivity.
Item 1223. The light-emitting device as described in any one of Items 1188-1222, wherein the ceramic-based sintered compact is that forming a thin film comprising as a main component at least one selected from gallium nitride, indium nitride and aluminum nitride.
Item 1224. The light-emitting device as described in Item 1223, wherein the thin film comprising as a main component at least one selected from gallium nitride, indium nitride and aluminum nitride and formed on the ceramic-based sintered compact has at least one of the crystallization states selected from a single crystal, an amorphous state, a polycrystal, and an orientated polycrystal.
Item 1225. The light-emitting device as described in Item 1223 or 1224, wherein a part of the thin film comprising as a main component at least one selected from gallium nitride, indium nitride and aluminum nitride and formed on the ceramic-based sintered compact comprises a single crystal at least.
Item 1226. The light-emitting device as described in Item 1225, wherein the thin film comprising as a main component at least one selected from gallium nitride, indium nitride and aluminum nitride and formed on the ceramic-based sintered compact comprises only a single crystal.
Item 1227. The light-emitting device as described in any one of Items 1223-1226, wherein the thin film comprising as a main component at least one selected from gallium nitride, indium nitride and aluminum nitride and formed on the ceramic-based sintered compact is a single layer.
Item 1228. The light-emitting device as described in any one of Items 1223-1226, wherein the thin film comprising as a main component at least one selected from gallium nitride, indium nitride and aluminum nitride and formed on the ceramic-based sintered compact is constituted with at least two layers.
Item 1229. The light-emitting device as described in Item 1228, wherein the thin film constituted with at least two layers has respectively at least one of the crystallization states selected from a single crystal, an orientated polycrystal, a polycrystal, and an amorphous state.
Item 1230. The light-emitting device as described in Item 1228 or 1229, wherein the thin film comprising as a main component at least one selected from gallium nitride, indium nitride and aluminum nitride and formed directly on the ceramic-based sintered compact has at least one of the crystallization states selected from an amorphous state, a polycrystal, an orientated polycrystal, and a single crystal, in the thin film constituted with at least two layers.
Item 1231. The light-emitting device as described in any one of Items 1224-1230, wherein the thin film comprising as a main component at least one selected from gallium nitride, indium nitride and aluminum nitride and formed directly on the ceramic-based sintered compact is amorphous.
Item 1232. The light-emitting device as described in any one of Items 1224-1230, wherein the thin film comprising as a main component at least one selected from gallium nitride, indium nitride and aluminum nitride and formed directly on the ceramic-based sintered compact is a polycrystal.
Item 1233. The light-emitting device as described in any one of Items 1224-1230, wherein the thin film comprising as a main component at least one selected from gallium nitride, indium nitride and aluminum nitride and formed directly on the ceramic-based sintered compact is an orientated polycrystal.
Item 1234. The light-emitting device as described in any one of Items 1224-1230, wherein the thin film comprising as a main component at least one selected from gallium nitride, indium nitride and aluminum nitride and formed directly on the ceramic-based sintered compact is a single crystal.
Item 1235. The light-emitting device as described in any one of Items 1228-1234, wherein at least one layer of thin films which comprise as a main component at least one selected from gallium nitride, indium nitride and aluminum nitride and have at least one of the crystallization states selected from a single crystal, an orientated polycrystal, a polycrystal, and an amorphous state is formed on the ceramic-based sintered compact, and at least one layer of thin films which comprise as a main component at least one selected from gallium nitride, indium nitride and aluminum nitride and have at least one of the crystallization states selected from a single crystal, an orientated polycrystal, a polycrystal, and an amorphous state is formed further on it, in the thin film constituted with at least two layers.
Item 1236. The light-emitting device as described in Item 1235, wherein at least one layer of thin films which comprise as a main component at least one selected from gallium nitride, indium nitride and aluminum nitride and have at least one of the crystallization states selected from a single crystal, an orientated polycrystal, a polycrystal, and an amorphous state is formed on the ceramic-based sintered compact, and at least one layer of single-crystal thin films which comprise as a main component at least one selected from gallium nitride, indium nitride and aluminum nitride is formed further on it, in the thin film constituted with at least two layers.
Item 1237. The light-emitting device as described in Item 1236, wherein at least one layer of thin films which comprise as a main component at least one selected from gallium nitride, indium nitride and aluminum nitride and have at least one of the crystallization states selected from an orientated polycrystal, a polycrystal, and an amorphous state is formed on the ceramic-based sintered compact, and at least one layer of single-crystal thin films which comprise as a main component at least one selected from gallium nitride, indium nitride and aluminum nitride is formed further on it, in the thin film constituted with at least two layers.
Item 1238. The light-emitting device as described in Item 1236 or 1237, wherein at least one layer of amorphous thin films which comprise as a main component at least one selected from gallium nitride, indium nitride and aluminum nitride is formed on the ceramic-based sintered compact, and at least one layer of single-crystal thin films which comprise as a main component at least one selected from gallium nitride, indium nitride and aluminum nitride is formed further on it, in the thin film constituted with at least two layers.
Item 1239. The light-emitting device as described in Item 1236 or 1237, wherein at least one layer of polycrystal thin films which comprise as a main component at least one selected from gallium nitride, indium nitride and aluminum nitride is formed on the ceramic-based sintered compact, and at least one layer of single-crystal thin films which comprise as a main component at least one selected from gallium nitride, indium nitride and aluminum nitride is formed further on it, in the thin film constituted with at least two layers.
Item 1240. The light-emitting device as described in Item 1236 or 1237, wherein at least one layer of orientated polycrystal thin films which comprise as a main component at least one selected from gallium nitride, indium nitride and aluminum nitride is formed on the ceramic-based sintered compact, and at least one layer of single-crystal thin films which comprise as a main component at least one selected from gallium nitride, indium nitride and aluminum nitride is formed further on it, in the thin film constituted with at least two layers.
Item 1241. The light-emitting device as described in any one of Items 1228-1240, wherein in the thin film constituted with at least two layers, all layers comprise only a single crystal.
Item 1242. The light-emitting device as described in any one of Items 1224-1241, wherein the top layer of the thin film comprising as a main component at least one selected from gallium nitride, indium nitride and aluminum nitride and formed on the ceramic-based sintered compact is a single-crystal thin film.
Item 1243. The light-emitting device as described in any one of Items 1224-1242, wherein C axis of the single-crystal thin film comprising as a main component at least one selected from gallium nitride, indium nitride and aluminum nitride and formed on the ceramic-based sintered compact is formed in the perpendicular direction to the surface of the ceramic-based sintered compact.
Item 1244. The light-emitting device as described in any one of Items 1224-1242, wherein C axis of the single-crystal thin film comprising as a main component at least one selected from gallium nitride, indium nitride and aluminum nitride and formed on the ceramic-based sintered compact is formed in the parallel direction to the surface of the ceramic-based sintered compact.
Item 1245. The light-emitting device as described in any one of Items 1224-1242, wherein C axis of the orientated polycrystal thin film comprising as a main component at least one selected from gallium nitride, indium nitride and aluminum nitride and formed on the ceramic-based sintered compact is formed in the perpendicular direction to the surface of the ceramic-based sintered compact.
Item 1246. The light-emitting device as described in any one of Items 1224-1242, wherein C axis of the orientated polycrystal thin film comprising as a main component at least one selected from gallium nitride, indium nitride and aluminum nitride and formed on the ceramic-based sintered compact is formed in the parallel direction to the surface of the ceramic-based sintered compact.
Item 1247. The light-emitting device as described in any one of Items 1223-1246, wherein the thin film comprising as a main component at least one selected from gallium nitride, indium nitride and aluminum nitride and formed on the ceramic-based sintered compact has conductivity.
Item 1248. The light-emitting device as described in any one of Items 1223-1247, wherein the electric resistivity of the thin film comprising as a main component at least one selected from gallium nitride, indium nitride and aluminum nitride and formed on the ceramic-based sintered compact is not more than 1x10⁴ Ω·cm at room temperature.
Item 1249. The light-emitting device as described in Item 1247 or 1248, wherein the electric resistivity of the thin film comprising as a main component at least one selected from gallium nitride, indium nitride and aluminum nitride and formed on the ceramic-based sintered compact is not more than 1x10² Ω·cm at room temperature.

Item 1250. The light-emitting device as described in any one of Items 1247-1249, wherein the electric resistivity of the thin film comprising as a main component at least one selected from gallium nitride, indium nitride and aluminum nitride and formed on the ceramic-based sintered compact is not more than 1x10¹ Ω·cm at room temperature.
Item 1251. The light-emitting device as described in any one of Items 1247-1250, wherein the electric resistivity of the thin film comprising as a main component at least one selected from gallium nitride, indium nitride and aluminum nitride and formed on the ceramic-based sintered compact is not more than 1x10⁰ Ω·cm at room temperature.
Item 1252. The light-emitting device as described in any one of Items 1223-1251, wherein the thin film formed on the ceramic-based sintered compact contains gallium nitride at least.
Item 1253. The light-emitting device as described in any one of Items 1223-1251, wherein the thin film formed on the ceramic-based sintered compact contains gallium nitride at least or has a thin film comprising gallium nitride as a main component.
Item 1254. The light-emitting device as described in Item 1252 or 1253, wherein the thin film formed on the ceramic-based sintered compact comprises gallium nitride as a main component.
Item 1255. The light-emitting device as described in any one of Items 1252-1254, wherein the thin film formed on the ceramic-based sintered compact has the composition expressed with AlₓGa_{y}In_{1-x-y}N (0<y≤1).
Item 1256. The light-emitting device as described in any one of Items 1252-1255, wherein the thin film formed on the ceramic-based sintered compact contains gallium nitride not less than 50 mol %.
Item 1257. The light-emitting device as described in any one of Items 1252-1256, wherein the thin film which is formed on the ceramic-based sintered compact and contains gallium nitride at least or comprises gallium nitride as a main component, has at least one of the crystallization states selected from an amorphous state, a polycrystal, an orientated polycrystal, and a single crystal.
Item 1258. The light-emitting device as described in Item 1257, wherein the thin film which is formed on the ceramic-based sintered compact and contains gallium nitride at least or comprises gallium nitride as a main component, is a single crystal.
Item 1259. The light-emitting device as described in any one of Items 1252-1258, wherein the top layer of the thin film formed on the ceramic-based sintered compact is that containing gallium nitride at least or comprising gallium nitride as a main component.
Item 1260. The light-emitting device as described in Item 1259, wherein the top layer of the thin film formed on the ceramic-based sintered compact is a single crystal containing gallium nitride at least or comprising a thin film comprising gallium nitride as a main component.
Item 1261. The light-emitting device as described in any one of Items 1223-1260, wherein the thin film formed on the ceramic-based sintered compact is that which comprises as a main component the composite expressed with the chemical formula of AlₓGa₁₋ₓN (0≤x≤1.0).
Item 1262. The light-emitting device as described in any one of Items 1223-1261, wherein the thin film comprising as a main component at least one selected from gallium nitride, indium nitride and aluminum nitride and formed on the ceramic-based sintered compact has a single-crystal thin film layer at least, and the thickness of the single-crystal thin film layer is less than 300 µm.
Item 1263. The light-emitting device as described in Item 1262, wherein the thin film comprising as a main component at least one selected from gallium nitride, indium nitride and aluminum nitride and formed on the ceramic-based sintered compact has a single-crystal thin film layer at least, and the thickness of the single-crystal thin film layer is not more than 200 µm.
Item 1264. The light-emitting device as described in any one of Items 1223-1263, wherein the thin film formed on the ceramic-based sintered compact has the thickness at least not less than 0.1 nm.
Item 1265. The light-emitting device as described in Item 1264, wherein the thin film formed on the ceramic-based sintered compact has the thickness at least not less than 0.5 nm.
Item 1266. The light-emitting device as described in Item 1264 or 1265, wherein the thin film formed on the ceramic-based sintered compact has the thickness at least not less than 0.3 µm.
Item 1267. The light-emitting device as described in any one of Items 1264-1266, wherein the thin film formed on the ceramic-based sintered compact has the thickness at least not less than 3.5 µm.
Item 1268. The light-emitting device as described in any one of Items 1264-1267, wherein the thin film formed on the ceramic-based sintered compact has the thickness at least not less than 10 µm.
Item 1269. The light-emitting device as described in any one of Items 1264-1268, wherein the thin film formed on the ceramic-based sintered compact has the thickness at least not less than 50 µm.
Item 1270. The light-emitting device as described in any one of Items 1223-1269, wherein the thickness of the thin film comprising as a main component at least one selected from gallium nitride, indium nitride and aluminum nitride and formed on the ceramic-based sintered compact is not more than 1000 µm.
Item 1271. The light-emitting device as described in Item 1270, wherein the thickness of the thin film formed on the ceramic-based sintered compact is not more than 500 µm.
Item 1272. The light-emitting device as described in any one of Items 1223-1271, wherein the thin film formed on the ceramic-based sintered compact comprises that in which at least two crystallization states selected from a single crystal, an amorphous state, a polycrystal, and an orientated polycrystal are intermingled simultaneously.
Item 1273. The light-emitting device as described in any one of Items 1223-1272, wherein the thin film formed on the ceramic-based sintered compact comprises a single layer or at least two layers, and at least one layer of the thin films comprises that in which at least two crystallization states selected from a single crystal, an amorphous state, a polycrystal, and an orientated polycrystal are intermingled simultaneously.
Item 1274. The light-emitting device as described in any one of Items 1223-1273, wherein the half width of the rocking curve of the X ray diffraction from the lattice plane of the Miller Index (002) of the single-crystal thin film formed on the ceramic-based sintered compact and comprising as a main component at least one selected from gallium nitride, indium nitride and aluminum nitride is not more than 3600 seconds.
Item 1275. The light-emitting device as described in Item 1274, wherein the half width of the rocking curve of the X ray diffraction from the lattice plane of the Miller Index (002) of the single-crystal thin film formed on the ceramic-based sintered compact and comprising as a main component at least one selected from gallium nitride, indium nitride and aluminum nitride is not more than 300 seconds.
Item 1276. The light-emitting device as described in Item 1274 or 1275, wherein the half width of the rocking curve of the X ray diffraction from the lattice plane of the Miller Index (002) of the single-crystal thin film formed on the ceramic-based sintered compact and comprising as a main component at least one selected from gallium nitride, indium nitride and aluminum nitride is not more than 240 seconds.
Item 1277. The light-emitting device as described in any one of Items 1274-1276, wherein the half width of the rocking curve of the X ray diffraction from the lattice plane of the Miller Index (002) of the single-crystal thin film formed on the ceramic-based sintered compact and comprising as a main component at least one selected from gallium nitride, indium nitride and aluminum nitride is not more than 200 seconds.
Item 1278. The light-emitting device as described in any one of Items 1274-1277, wherein the half width of the rocking curve of the X ray diffraction from the lattice plane of the Miller Index (002) of the single-crystal thin film formed on the ceramic-based sintered compact and comprising as a main component at least one selected from gallium nitride, indium nitride and aluminum nitride is not more than 150 seconds.
Item 1279. The light-emitting device as described in any one of Items 1274-1278, wherein the half width of the rocking curve of the X ray diffraction from the lattice plane of the Miller Index (002) of the single-crystal thin film formed on the ceramic-based sintered compact and comprising as a main component at least one selected from gallium nitride, indium nitride and aluminum nitride is not more than 130 seconds.
Item 1280. The light-emitting device as described in any one of Items 1274-1279, wherein the half width of the rocking curve of the X ray diffraction from the lattice plane of the Miller Index (002) of the single-crystal thin film formed on the ceramic-based sintered compact and comprising as a main component at least one selected from gallium nitride, indium nitride and aluminum nitride is not more than 100 seconds.
Item 1281. The light-emitting device as described in any one of Items 1223-1280, wherein the ceramic-based sintered compact is that on which a single-crystal thin film comprising as a main component at least one selected from gallium nitride, indium nitride and aluminum nitride is formed.
Item 1282. The light-emitting device as described in any one of Items 1188-1281, wherein the ceramic material which is the main components of the sintered compact comprises the composite of at least one selected from a metal element and a semimetal element and at least one selected from a nonmetallic element, or the composite of at least one selected from a metal element and at least one selected from a semimetal element, or the composite of at least two selected from a semimetal element.
Item 1283. The light-emitting device as described in Item 1282, wherein the semimetal element is at least one selected from boron, carbon, silicon, germanium, arsenic, antimony, bismuth, selenium, tellurium, and polonium.
Item 1284. The light-emitting device as described in Item 1283, wherein the semimetal element is at least one selected from carbon and silicon.
Item 1285. The light-emitting device as described in any one of Items 1219, 1220, 1283, and 1284, wherein the nonmetallic element is at least one selected from nitrogen, phosphorus, oxygen, sulfur, fluorine, chlorine, bromine, iodine, and astatine.
Item 1286. The light-emitting device as described in Item 1285, wherein the nonmetallic element is at least one selected from nitrogen and oxygen.
Item 1287. The light-emitting device as described in any one of Items 1188-1286, wherein the ceramic material is at least one selected from nitride, carbide, oxide, boride, and silicide.
Item 1288. The light-emitting device as described in Item 1287, wherein the ceramic material is at least one selected from nitride, carbide, and oxide.
Item 1289. The light-emitting device as described in any one of Items 1188-1288, wherein the ceramic-based sintered compact is an aluminum nitride-based sintered compact.
Item 1290. The light-emitting device as described in any one of Items 1188-1289, wherein the ceramic-based sintered compact is a sintered compact which comprises as a main component a material having at least one of crystal structures selected from a hexagonal system or a trigonal system.
Item 1291. The light-emitting device as described in Item 1290, wherein the sintered compact which comprises as a main component a material having at least one of crystal structures selected from a hexagonal system or a trigonal system is a sintered compact which comprises as a main component at least one selected from zinc oxide, beryllium oxide, aluminum oxide, silicon carbide, silicon nitride, and gallium nitride.
Item 1292. The light-emitting device as described in any one of Items 1188-1288, wherein the ceramic-based sintered compact is a sintered compact which comprises as a main component at least one selected from zinc oxide, beryllium oxide, aluminum oxide, silicon carbide, silicon nitride, gallium nitride, zirconium oxide, magnesium oxide, magnesium aluminate, titanium oxide, barium titanate, lead titanate zirconate, a rare earth oxide, thorium oxide, various ferrites, mullite, forsterite, steatite, and glass.
Item 1293. The light-emitting device as described in any one of Items 1289-1292, wherein the ceramic-based sintered compact is a sintered compact which comprises as a main component at least one selected from aluminum nitride, zinc oxide, beryllium oxide, aluminum oxide, silicon carbide, silicon nitride, gallium nitride, zirconium oxide, magnesium oxide, magnesium aluminate, and yttrium oxide.
Item 1294. The light-emitting device as described in any one of Items 1188-1293, wherein the ceramic-based sintered compact has optical permeability.
Item 1295. The light-emitting device as described in any one of Items 1188-1294, wherein the ceramic-based sintered compact has large surface roughness.
Item 1296. The light-emitting device as described in any one of Items 1188-1295, wherein the ceramic-based sintered compact is that on which a thin film comprising as a main component at least one selected from gallium nitride, indium nitride and aluminum nitride is formed.
Item 1297. The light-emitting device as described in any one of Items 1188-1296, wherein the ceramic-based sintered compact is that on which a single-crystal thin film comprising as a main component at least one selected from gallium nitride, indium nitride and aluminum nitride is formed.
Item 1298. The light-emitting device as described in any one of Items 1289 and 1293-1297, wherein the ceramic-based sintered compact is an aluminum nitride-based sintered compact.
Item 1299. The light-emitting device as described in Item 1298, wherein the aluminum nitride-based sintered compact has optical permeability.

Item 1300. The light-emitting device as described in Item 1298 or 1299, wherein the aluminum nitride-based sintered compact has large surface roughness.
Item 1301. The light-emitting device as described in any one of Items 1298-1300, wherein the aluminum nitride-based sintered compact is that on which a thin film comprising as a main component at least one selected from gallium nitride, indium nitride and aluminum nitride is formed.
Item 1302. The light-emitting device as described in any one of Items 1298-1301, wherein the aluminum nitride-based sintered compact is that on which a single-crystal thin film comprising as a main component at least one selected from gallium nitride, indium nitride and aluminum nitride is formed.
Item 1303. The light-emitting device as described in any one of Items 1298-1302, wherein the aluminum nitride-based sintered compact contains aluminum nitride not less than 20 volume %.
Item 1304. The light-emitting device as described in Item 1303, wherein the aluminum nitride-based sintered compact contains aluminum nitride not less than 50 volume %.
Item 1305. The light-emitting device as described in any one of Items 1298-1304, wherein the aluminum nitride-based sintered compact has a conduction via.
Item 1306. The light-emitting device as described in any one of Items 1298-1305, wherein the aluminum nitride-based sintered compact has a thin film-conductive material.
Item 1307. The light-emitting device as described in Item 1306, wherein the thin film-conductive material comprises at least one selected from metal, alloy, and metal nitride.
Item 1308. The light-emitting device as described in Item 1306 or 1307, wherein the thin film-conductive material comprises at least one selected from gold, silver, copper, aluminum, iron, cobalt, nickel, ruthenium, rhodium, palladium, osmium, iridium, platinum, tantalum, molybdenum, tungsten, chromium, titanium, nickel chromium alloy, titanium nitride, zirconium nitride, and tantalum nitride.
Item 1309. The light-emitting device as described in any one of Items 1290-1297, wherein the ceramic-based sintered compact is a sintered compact which comprises as a main component a material having at least one of crystal structures selected from a hexagonal system or a trigonal system.
Item 1310. The light-emitting device as described in Item 1309, wherein the sintered compact which comprises as a main component a material having at least one of crystal structures selected from a hexagonal system or a trigonal system has optical permeability.
Item 1311. The light-emitting device as described in Item 1309 or 1310, wherein the sintered compact which comprises as a main component a material having at least one of crystal structures selected from a hexagonal system or a trigonal system has large surface roughness.
Item 1312. The light-emitting device as described in any one of Items 1309-1311, wherein the sintered compact which comprises as a main component a material having at least one of crystal structures selected from a hexagonal system or a trigonal system is that on which a thin film comprising as a main component at least one selected from gallium nitride, indium nitride and aluminum nitride is formed.
Item 1313. The light-emitting device as described in any one of Items 1309-1312, wherein the sintered compact which comprises as a main component a material having at least one of crystal structures selected from a hexagonal system or a trigonal system is that on which a single-crystal thin film comprising as a main component at least one selected from gallium nitride, indium nitride and aluminum nitride is formed.
Item 1314. The light-emitting device as described in any one of Items 1309-1313, wherein the sintered compact which comprises as a main component a material having at least one of crystal structures selected from a hexagonal system or a trigonal system is a sintered compact comprising as a main component at least one selected from zinc oxide, beryllium oxide, aluminum oxide, silicon carbide, silicon nitride, and gallium nitride.
Item 1315. The light-emitting device as described in Item 1314, wherein the sintered compact which comprises as a main component a material having at least one of crystal structures selected from a hexagonal system or a trigonal system is a zinc oxide-based sintered compact.
Item 1316. The light-emitting device as described in Item 1315, wherein the zinc oxide-based sintered compact has optical permeability.
Item 1317. The light-emitting device as described in Item 1315 or 1316, wherein the zinc oxide-based sintered compact has large surface roughness.
Item 1318. The light-emitting device as described in any one of Items 1315-1317, wherein the zinc oxide-based sintered compact is that on which a thin film comprising as a main component at least one selected from gallium nitride, indium nitride and aluminum nitride is formed.
Item 1319. The light-emitting device as described in any one of Items 1315-1318, wherein the zinc oxide-based sintered compact is that on which a single-crystal thin film comprising as a main component at least one selected from gallium nitride, indium nitride and aluminum nitride is formed.
Item 1320. The light-emitting device as described in any one of Items 1315-1319, wherein the zinc oxide-based sintered compact has conductivity.
Item 1321. The light-emitting device as described in any one of Items 1315-1320, wherein the zinc oxide-based sintered compact has the electric resistivity not more than 1x10² Ω·cm at room temperature.
Item 1322. The light-emitting device as described in any one of Items 1315-1321, wherein the zinc oxide-based sintered compact has optical permeability and has conductivity.
Item 1323. The light-emitting device as described in any one of Items 1315-1322, wherein the zinc oxide-based sintered compact contains a zinc oxide component not less than 55.0 mol % on the basis of ZnO.
Item 1324. The light-emitting device as described in Item 1314, wherein the sintered compact which comprises as a main component a material having at least one of crystal structures selected from a hexagonal system or a trigonal system is a beryllium oxide-based sintered compact.
Item 1325. The light-emitting device as described in Item 1324, wherein the beryllium oxide-based sintered compact has optical permeability.
Item 1326. The light-emitting device as described in Item 1324 or 1325, wherein the beryllium oxide-based sintered compact has large surface roughness.
Item 1327. The light-emitting device as described in any one of Items 1324-1326, wherein the beryllium oxide-based sintered compact is that on which a thin film comprising as a main component at least one selected from gallium nitride, indium nitride and aluminum nitride is formed.
Item 1328. The light-emitting device as described in any one of Items 1324-1327, wherein the beryllium oxide-based sintered compact is that on which a single-crystal thin film comprising as a main component at least one selected from gallium nitride, indium nitride and aluminum nitride is formed.
Item 1329. The light-emitting device as described in any one of Items 1324-1328, wherein the beryllium oxide-based sintered compact contains a beryllium oxide component not less than 65.0 mol % on the basis of BeO.
Item 1330. The light-emitting device as described in Item 1314, wherein the sintered compact which comprises as a main component a material having at least one of crystal structures selected from a hexagonal system or a trigonal system is an aluminum oxide-based sintered compact.
Item 1331. The light-emitting device as described in Item 1330, wherein the aluminum oxide-based sintered compact has optical permeability.
Item 1332. The light-emitting device as described in Item 1330 or 1331, wherein the aluminum oxide-based sintered compact has large surface roughness.
Item 1333. The light-emitting device as described in any one of Items 1330-1332, wherein the aluminum oxide-based sintered compact is that on which a thin film comprising as a main component at least one selected from gallium nitride, indium nitride and aluminum nitride is formed.
Item 1334. The light-emitting device as described in any one of Items 1330-1333, wherein the aluminum oxide-based sintered compact is that on which a single-crystal thin film comprising as a main component at least one selected from gallium nitride, indium nitride and aluminum nitride is formed.
Item 1335. The light-emitting device as described in any one of Items 1330-1334, wherein the aluminum oxide-based sintered compact contains an aluminum oxide component not less than 55.0 mol % on the basis of Al₂O₃.
Item 1336. The light-emitting device as described in Item 1314, wherein the sintered compact which comprises as a main component a material having at least one of crystal structures selected from a hexagonal system or a trigonal system is a silicon carbide-based sintered compact.
Item 1337. The light-emitting device as described in Item 1336, wherein the silicon carbide-based sintered compact has optical permeability.
Item 1338. The light-emitting device as described in Item 1336 or 1337, wherein the silicon carbide-based sintered compact has large surface roughness.
Item 1339. The light-emitting device as described in any one of Items 1336-1338, wherein the silicon carbide-based sintered compact is that on which a thin film comprising as a main component at least one selected from gallium nitride, indium nitride and aluminum nitride is formed.
Item 1340. The light-emitting device as described in any one of Items 1336-1339, wherein the silicon carbide-based sintered compact is that on which a single-crystal thin film comprising as a main component at least one selected from gallium nitride, indium nitride and aluminum nitride is formed.
Item 1341. The light-emitting device as described in Item 1314, wherein the sintered compact which comprises as a main component a material having at least one of crystal structures selected from a hexagonal system or a trigonal system is a silicon nitride-based sintered compact.
Item 1342. The light-emitting device as described in Item 1341, wherein the silicon nitride-based sintered compact has optical permeability.
Item 1343. The light-emitting device as described in Item 1341 or 1342, wherein the silicon nitride-based sintered compact has large surface roughness.
Item 1344. The light-emitting device as described in any one of Items 1341-1343, wherein the silicon nitride-based sintered compact is that on which a thin film comprising as a main component at least one selected from gallium nitride, indium nitride and aluminum nitride is formed.
Item 1345. The light-emitting device as described in any one of Items 1341-1344, wherein the silicon nitride-based sintered compact is that on which a single-crystal thin film comprising as a main component at least one selected from gallium nitride, indium nitride and aluminum nitride is formed.
Item 1346. The light-emitting device as described in Item 1314, wherein the sintered compact which comprises as a main component a material having at least one of crystal structures selected from a hexagonal system or a trigonal system is a gallium nitride-based sintered compact.
Item 1347. The light-emitting device as described in Item 1346, wherein the gallium nitride-based sintered compact has optical permeability.
Item 1348. The light-emitting device as described in Item 1346 or 1347, wherein the gallium nitride-based sintered compact has large surface roughness.
Item 1349. The light-emitting device as described in any one of Items 1346-1348, wherein the gallium nitride-based sintered compact that on which a thin film comprising as a main component at least one selected from gallium nitride, indium nitride and aluminum nitride is formed.

Item 1350. The light-emitting device as described in any one of Items 1346-1349, wherein the gallium nitride-based sintered compact is that on which a single-crystal thin film comprising as a main component at least one selected from gallium nitride, indium nitride and aluminum nitride is formed.
Item 1351. The light-emitting device as described in any one of Items 1346-1350, wherein the gallium nitride-based sintered compact has conductivity.
Item 1352. The light-emitting device as described in any one of Items 1346-1351, wherein the gallium nitride-based sintered compact has the electric resistivity not more than 1x10² Ω·cm at room temperature.
Item 1353. The light-emitting device as described in any one of Items 1346-1352, wherein the gallium nitride-based sintered compact has optical permeability and has conductivity.
Item 1354. The light-emitting device as described in any one of Items 1346-1353, wherein the gallium nitride-based sintered compact contains a gallium nitride component not less than 55.0 mol % on the basis of GaN.
Item 1355. The light-emitting device as described in any one of Items 1292-1297, wherein the ceramic-based sintered compact is a sintered compact which comprises zirconium oxide as a main component.
Item 1356. The light-emitting device as described in Item 1355, wherein the zirconium oxide-based sintered compact has optical permeability.
Item 1357. The light-emitting device as described in Item 1355 or 1356, wherein the zirconium oxide-based sintered compact has large surface roughness.
Item 1358. The light-emitting device as described in any one of Items 1355-1357, wherein the zirconium oxide-based sintered compact is that on which a thin film comprising as a main component at least one selected from gallium nitride, indium nitride and aluminum nitride is formed.
Item 1359. The light-emitting device as described in any one of Items 1355-1358, wherein the zirconium oxide-based sintered compact is that on which a single-crystal thin film comprising as a main component at least one selected from gallium nitride, indium nitride and aluminum nitride is formed.
Item 1360. The light-emitting device as described in any one of Items 1292-1297, wherein the ceramic-based sintered compact is a sintered compact which comprises magnesium oxide as a main component.
Item 1361. The light-emitting device as described in Item 1360, wherein the magnesium oxide-based sintered compact has optical permeability.
Item 1362. The light-emitting device as described in Item 1360 or 1361, wherein the magnesium oxide-based sintered compact has large surface roughness.
Item 1363. The light-emitting device as described in any one of Items 1360-1362, wherein the magnesium oxide-based sintered compact is that on which a thin film comprising as a main component at least one selected from gallium nitride, indium nitride and aluminum nitride is formed.
Item 1364. The light-emitting device as described in any one of Items 1360-1363, wherein the magnesium oxide-based sintered compact is that on which a single-crystal thin film comprising as a main component at least one selected from gallium nitride, indium nitride and aluminum nitride is formed.
Item 1365. The light-emitting device as described in any one of Items 1292-1297, wherein the ceramic-based sintered compact is a sintered compact which comprises magnesium aluminate as a main component.
Item 1366. The light-emitting device as described in Item 1365, wherein the magnesium aluminate-based sintered compact has optical permeability.
Item 1367. The light-emitting device as described in Item 1365 or 1366, wherein the magnesium aluminate-based sintered compact has large surface roughness.
Item 1368. The light-emitting device as described in any one of Items 1365-1367, wherein the magnesium aluminate-based sintered compact is that on which a thin film comprising as a main component at least one selected from gallium nitride, indium nitride and aluminum nitride is formed.
Item 1369. The light-emitting device as described in any one of Items 1365-1368, wherein the magnesium aluminate-based sintered compact is that on which a single-crystal thin film comprising as a main component at least one selected from gallium nitride, indium nitride and aluminum nitride is formed.
Item 1370. The light-emitting device as described in any one of Items 1292-1297, wherein the ceramic-based sintered compact is a sintered compact which comprises yttrium oxide as a main component.
Item 1371. The light-emitting device as described in Item 1370, wherein the yttrium oxide-based sintered compact has optical permeability.
Item 1372. The light-emitting device as described in Item 1370 or 1371, wherein the yttrium oxide-based sintered compact has large surface roughness.
Item 1373. The light-emitting device as described in any one of Items 1370-1372, wherein the yttrium oxide-based sintered compact is that on which a thin film comprising as a main component at least one selected from gallium nitride, indium nitride and aluminum nitride is formed.
Item 1374. The light-emitting device as described in any one of Items 1370-1373, wherein the yttrium oxide-based sintered compact is that on which a single-crystal thin film comprising as a main component at least one selected from gallium nitride, indium nitride and aluminum nitride is formed.
Item 1375. A light-emitting device constituted with the laminate which comprises a thin film comprising as a main component at least one selected from gallium nitride, indium nitride and aluminum nitride and contains at least N type semiconductor layer, luminescence layer, and P type semiconductor layer, and the laminate of N type semiconductor layer, luminescence layer, and P type semiconductor layer is formed on the ceramic-based sintered compact having optical permeability.
Item 1376. The light-emitting device as described in Item 1375, wherein the ceramic-based sintered compact having optical permeability is substrate-like.
Item 1377. The light-emitting device as described in Item 1375 or 1376, wherein the ceramic-based sintered compact having optical permeability has the optical transmissivity not less than 1 %.
Item 1378. The light-emitting device as described in Item 1377, wherein the ceramic-based sintered compact having optical permeability has the optical transmissivity not less than 10 %.
Item 1379. The light-emitting device as described in Item 1377 or 1378, wherein the ceramic-based sintered compact having optical permeability has the optical transmissivity not less than 20 %.
Item 1380. The light-emitting device as described in any one of Items 1377-1379, wherein the ceramic-based sintered compact having optical permeability has the optical transmissivity not less than 30 %.
Item 1381. The light-emitting device as described in any one of Items 1377-1380, wherein the ceramic-based sintered compact having optical permeability has the optical transmissivity not less than 40 %.
Item 1382. The light-emitting device as described in any one of Items 1377-1381, wherein the ceramic-based sintered compact having optical permeability has the optical transmissivity not less than 50 %.
Item 1383. The light-emitting device as described in any one of Items 1377-1382, wherein the ceramic-based sintered compact having optical permeability has the optical transmissivity not less than 60 %.
Item 1384. The light-emitting device as described in any one of Items 1377-1383, wherein the ceramic-based sintered compact having optical permeability has the optical transmissivity not less than 80 %.
Item 1385. The light-emitting device as described in any one of Items 1375-1384, wherein the ceramic-based sintered compact having optical permeability has the optical transmissivity less than 1 %.
Item 1386. The light-emitting device as described in any one of Items 1375-1385, wherein the optical permeability or optical transmissivity of the gallium nitride-based sintered compact is that to the light of the range of 200-800 nm wavelength at least.
Item 1387. The light-emitting device as described in any one of Items 1375-1386, wherein the light-emitting device is constituted with the laminate which comprises a thin film comprising as a main component at least one selected from gallium nitride, indium nitride and aluminum nitride and contains at least N type semiconductor layer, luminescence layer, and P type semiconductor layer, and the laminat of N type semiconductor layer, luminescence layer, and P type semiconductor layer is formed on the ceramic-based sintered compact having optical permeability and having large surface roughness.
Item 1388. The light-emitting device as described in any one of Items 1375-1387, wherein the average surface roughness Ra of the ceramic-based sintered compact having optical permeability is not more than 2000 nm.
Item 1389. The light-emitting device as described in Item 1388, wherein the average surface roughness Ra of the ceramic-based sintered compact having optical permeability is not more than 1000 nm.

Item 1390. The light-emitting device as described in Item 1388 or 1389, wherein the average surface roughness Ra of the ceramic-based sintered compact having optical permeability is not more than 100 nm.
Item 1391. The light-emitting device as described in any one of Items 1388-1390, wherein the average surface roughness Ra of the ceramic-based sintered compact having optical permeability is not more than 20 nm.
Item 1392. The light-emitting device as described in any one of Items 1388-1391, wherein the average surface roughness Ra of the ceramic-based sintered compact having optical permeability is not more than 10 nm.
Item 1393. The light-emitting device as described in any one of Items 1388-1392, wherein the average surface roughness Ra of the ceramic-based sintered compact having optical permeability is not more than 5 nm.
Item 1394. The light-emitting device as described in any one of Items 1375-1390, wherein the ceramic-based sintered compact having optical permeability has large surface roughness.
Item 1395. The light-emitting device as described in any one of Items 1375-1390 and 1394, wherein the average surface roughness Ra of the ceramic-based sintered compact having optical permeability is not less than 70 nm.
Item 1396. The light-emitting device as described in Item 1395, wherein the average surface roughness Ra of the ceramic-based sintered compact having optical permeability is more than 1000 nm.
Item 1397. The light-emitting device as described in Item 1395 or 1396, wherein the average surface roughness Ra of the ceramic-based sintered compact having optical permeability is more than 2000 nm.
Item 1398. The light-emitting device as described in any one of Items 1375-1397, wherein the surface of the ceramic-based sintered compact having optical permeability is at least one of the states selected from an as-fired state, a state in which lap polish was carried out, a state in which blast polish was carried out, a state in which specular surface polish was carried out, a state in which chemistry corrosion was carried out, and a state corroded by plasma gas.
Item 1399. The light-emitting device as described in Item 1398, wherein the surface of the ceramic-based sintered compact having optical permeability is the state in which specular surface polish was carried out.

Item 1400. The light-emitting device as described in any one of Items 1375-1399, wherein the light-emitting device is constituted with the laminate which comprises a thin film comprising as a main component at least one selected from gallium nitride, indium nitride and aluminum nitride and contains at least N type semiconductor layer, luminescence layer, and P type semiconductor layer, and the laminate of N type semiconductor layer, luminescence layer, and P type semiconductor layer is formed on the ceramic-based sintered compact having optical permeability and forming a thin film comprising as a main component at least one selected from gallium nitride, indium nitride and aluminum nitride.
Item 1401. The light-emitting device as described in Item 1400, wherein the thin film comprising as a main component at least one selected from gallium nitride, indium nitride and aluminum nitride and formed on the ceramic-based sintered compact having optical permeability has at least one of the crystallization states selected from an amorphous state, a polycrystal, an orientated polycrystal, and a single crystal.
Item 1402. The light-emitting device as described in Item 1400 or 1401, wherein a part of the thin film comprising as a main component at least one selected from gallium nitride, indium nitride and aluminum nitride and formed on the ceramic-based sintered compact having optical permeability is a single crystal at least.
Item 1403. The light-emitting device as described in any one of Items 1400-1402, wherein the thin film comprising as a main component at least one selected from gallium nitride, indium nitride and aluminum nitride and formed on the ceramic-based sintered compact having optical permeability is constituted with one layer.
Item 1404. The light-emitting device as described in Item 1403, wherein the thin film comprising as a main component at least one selected from gallium nitride, indium nitride and aluminum nitride and formed on the ceramic-based sintered compact having optical permeability is amorphous.
Item 1405. The light-emitting device as described in Item 1403, wherein the thin film comprising as a main component at least one selected from gallium nitride, indium nitride and aluminum nitride and formed on the ceramic-based sintered compact having optical permeability is a polycrystal.
Item 1406. The light-emitting device as described in Item 1403, wherein the thin film comprising as a main component at least one selected from gallium nitride, indium nitride and aluminum nitride and formed on the ceramic-based sintered compact having optical permeability is an orientated polycrystal.
Item 1407. The light-emitting device as described in Item 1403, wherein the thin film comprising as a main component at least one selected from gallium nitride, indium nitride and aluminum nitride and formed on the ceramic-based sintered compact having optical permeability is a single crystal.
Item 1408. The light-emitting device as described in any one of Items 1400-1402, wherein the thin film comprising as a main component at least one selected from gallium nitride, indium nitride and aluminum nitride and formed on the ceramic-based sintered compact having optical permeability is constituted with at least two layers.
Item 1409. The light-emitting device as described in Item 1408, wherein the thin film comprising as a main component at least one selected from gallium nitride, indium nitride and aluminum nitride and formed on the ceramic-based sintered compact having optical permeability is constituted with at least two layers, and each layer has at least one of the crystallization states selected from an amorphous state, a polycrystal, an orientated polycrystal, and a single crystal.
Item 1410. The light-emitting device as described in Item 1408 or 1409, wherein the thin film comprising as a main component at least one selected from gallium nitride, indium nitride and aluminum nitride and formed on the ceramic-based sintered compact having optical permeability is constituted with at least two layers, and the thin film layer formed directly on the ceramic-based sintered compact having optical permeability has at least one of the crystallization states selected from an amorphous state, a polycrystal, an orientated polycrystal, and a single crystal.
Item 1411. The light-emitting device as described in any one of Items 1408-1410, wherein the thin film comprising as a main component at least one selected from gallium nitride, indium nitride and aluminum nitride and formed on the ceramic-based sintered compact having optical permeability is constituted with at least two layers, and the thin film layer formed directly on the ceramic-based sintered compact having optical permeability has at least one of the crystallization states selected from an amorphous state, a polycrystal, and an orientated polycrystal.
Item 1412. The light-emitting device as described in any one of Items 1408-1411, wherein the thin film comprising as a main component at least one selected from gallium nitride, indium nitride and aluminum nitride and formed on the ceramic-based sintered compact having optical permeability is constituted with at least two layers, and the thin film layer formed directly on the ceramic-based sintered compact having optical permeability is an orientated polycrystal.
Item 1413. The light-emitting device as described in any one of Items 1408-1412, wherein the thin film comprising as a main component at least one selected from gallium nitride, indium nitride and aluminum nitride and formed on the ceramic-based sintered compact having optical permeability is constituted with at least two layers, and one layer is a single crystal at least.
Item 1414. The light-emitting device as described in any one of Items 1408-1413, wherein the thin film comprising as a main component at least one selected from gallium nitride, indium nitride and aluminum nitride and formed on the ceramic-based sintered compact having optical permeability is constituted with at least two layers, and the thin film of the top layer is a single crystal.
Item 1415. The light-emitting device as described in any one of Items 1400-1414, wherein the thin film comprising as a main component at least one selected from gallium nitride, indium nitride and aluminum nitride and formed on the ceramic-based sintered compact having optical permeability has a single-crystal thin film layer at least, and the thickness of the single-crystal thin film layer is less than 300 µm.
Item 1416. The light-emitting device as described in Item 1415, wherein the thin film comprising as a main component at least one selected from gallium nitride, indium nitride and aluminum nitride and formed on the ceramic-based sintered compact having optical permeability has a single-crystal thin film layer at least, and the thickness of the single-crystal thin film layer is not more than 200 µm.
Item 1417. The light-emitting device as described in any one of Items 1400-1416, wherein the thin film formed on the ceramic-based sintered compact having optical permeability has the thickness not less than 0.1 nm at least.
Item 1418. The light-emitting device as described in Item 1417, wherein the thin film formed on the ceramic-based sintered compact having optical permeability has the thickness not less than 0.5 nm at least.
Item 1419. The light-emitting device as described in Item 1417 or 1418, wherein the thin film formed on the ceramic-based sintered compact having optical permeability has the thickness not less than 0.3 µm at least.
Item 1420. The light-emitting device as described in any one of Items 1417-1419, wherein the thin film formed on the ceramic-based sintered compact having optical permeability has the thickness not less than 3.5 µm at least.
Item 1421. The light-emitting device as described in any one of Items 1417-1420, wherein the thin film formed on the ceramic-based sintered compact having optical permeability has the thickness not less than 10 µm at least.
Item 1422. The light-emitting device as described in any one of Items 1417-1421, wherein the thin film formed on the ceramic-based sintered compact having optical permeability has the thickness not less than 50 µm at least.
Item 1423. The light-emitting device as described in any one of Items 1400-1422, wherein the thin film formed on the ceramic-based sintered compact having optical permeability contains gallium nitride at least.
Item 1424. The light-emitting device as described in any one of Items 1400-1423, wherein the thin film formed on the ceramic-based sintered compact having optical permeability contains gallium nitride at least or has a thin film comprising gallium nitride as a main component.
Item 1425. The light-emitting device as described in Item 1423 or 1424, wherein the thin film formed on the ceramic-based sintered compact having optical permeability comprises gallium nitride as a main component.
Item 1426. The light-emitting device as described in any one of Items 1423-1425, wherein the thin film formed on the ceramic-based sintered compact having optical permeability has the composition expressed with AlₓGa_{y}In_{1-x-y}N (0≤y≤1).
Item 1427. The light-emitting device as described in any one of Items 1423-1426, wherein the thin film formed on the ceramic-based sintered compact having optical permeability contains gallium nitride not less than 50 mol %.
Item 1428. The light-emitting device as described in any one of Items 1423-1427, wherein the thin film which is formed on the ceramic-based sintered compact having optical permeability and contains gallium nitride at least or comprises gallium nitride as a main component, has at least one of the crystallization states selected from an amorphous state, a polycrystal, an orientated polycrystal, and a single crystal.
Item 1429. The light-emitting device as described in Item 1428, wherein the thin film which is formed on the ceramic-based sintered compact having optical permeability and contains gallium nitride at least or comprises gallium nitride as a main component, is a single crystal.
Item 1430. The light-emitting device as described in any one of Items 1423-1429, wherein the thin film of the top layer formed on the ceramic-based sintered compact having optical permeability is that containing gallium nitride at least or comprising gallium nitride as a main component.
Item 1431. The light-emitting device as described in Item 1430, wherein the thin film of the top layer formed on the ceramic-based sintered compact having optical permeability is a single crystal containing gallium nitride at least or comprising gallium nitride as a main component.
Item 1432. The light-emitting device as described in any one of Items 1400-1431, wherein the thin film formed on the ceramic-based sintered compact having optical permeability comprises that in which at least two crystallization states selected from a single crystal, an amorphous state, a polycrystal, and an orientated polycrystal are intermingled simultaneously.
Item 1433. The light-emitting device as described in any one of Items 1400-1432, wherein the thin film formed on the ceramic-based sintered compact having optical permeability comprises a single layer or at least two layers, and at least one layer of the thin films comprises that in which at least two crystallization states selected from a single crystal, an amorphous state, a polycrystal, and an orientated polycrystal are intermingled simultaneously.
Item 1434. The light-emitting device as described in any one of Items 1400-1433, wherein the half width of the rocking curve of the X ray diffraction from the lattice plane of the Miller Index (002) of the single-crystal thin film formed on a ceramic-based sintered compact having optical permeability is not more than 3600 seconds.
Item 1435. The light-emitting device as described in Item 1434, wherein the half width of the rocking curve of the X ray diffraction from the lattice plane of the Miller Index (002) of the single-crystal thin film formed on a ceramic-based sintered compact having optical permeability is not more than 300 seconds.
Item 1436. The light-emitting device as described in Item 1434 or 1435, wherein the half width of the rocking curve of the X ray diffraction from the lattice plane of the Miller Index (002) of the single-crystal thin film formed on a ceramic-based sintered compact having optical permeability is not more than 240 seconds.
Item 1437. The light-emitting device as described in any one of Items 1434-1436, wherein the half width of the rocking curve of the X ray diffraction from the lattice plane of the Miller Index (002) of the single-crystal thin film formed on a ceramic-based sintered compact having optical permeability is not more than 200 seconds.
Item 1438. The light-emitting device as described in any one of Items 1434-1437, wherein the half width of the rocking curve of the X ray diffraction from the lattice plane of the Miller Index (002) of the single-crystal thin film formed on a ceramic-based sintered compact having optical permeability is not more than 150 seconds.
Item 1439. The light-emitting device as described in any one of Items 1434-1438, wherein the half width of the rocking curve of the X ray diffraction from the lattice plane of the Miller Index (002) of the single-crystal thin film formed on a ceramic-based sintered compact having optical permeability is not more than 130 seconds.
Item 1440. The light-emitting device as described in any one of Items 1434-1439, wherein the half width of the rocking curve of the X ray diffraction from the lattice plane of the Miller Index (002) of the single-crystal thin film formed on a ceramic-based sintered compact having optical permeability is not more than 100 seconds.
Item 1441. The light-emitting device as described in any one of Items 1375-1440, wherein the ceramic-based sintered compact having optical permeability is an aluminum nitride-based sintered compact.
Item 1442. The light-emitting device as described in any one of Items 1375-1440, wherein the ceramic-based sintered compact having optical permeability is a sintered compact which comprises as a main component a ceramic material having at least one of the crystal structures selected from a hexagonal system or a trigonal system.
Item 1443. The light-emitting device as described in Item 1442, wherein the sintered compact having optical permeability and comprising as a main component a ceramic material having at least one of the crystal structures selected from a hexagonal system or a trigonal system is a sintered compact which comprises as a main component at least one selected from zinc oxide, beryllium oxide, aluminum oxide, silicon carbide, silicon nitride, and gallium nitride.
Item 1444. The light-emitting device as described in any one of Items 1375-1440, wherein the ceramic-based sintered compact having optical permeability is a sintered compact which comprises as a main component at least one selected from zinc oxide, beryllium oxide, aluminum oxide, silicon carbide, silicon nitride, gallium nitride, zirconium oxide, magnesium oxide, magnesium aluminate, titanium oxide, barium titanate, lead titanate zirconate, a rare earth oxide, thorium oxide, various ferrites, mullite, forsterite, steatite, and glass.
Item 1445. The light-emitting device as described in any one of Items 1441-1444, wherein the ceramic-based sintered compact having optical permeability is a sintered compact which comprises as a main component at least one selected from aluminum nitride, zinc oxide, beryllium oxide, aluminum oxide, silicon carbide, silicon nitride, gallium nitride, zirconium oxide, magnesium oxide, magnesium aluminate, and yttrium oxide.
Item 1446. A light-emitting device constituted with the laminate which comprises a thin film comprising as a main component at least one selected from gallium nitride, indium nitride and aluminum nitride and contains at least N type semiconductor layer, luminescence layer, and P type semiconductor layer, and the laminate of N type semiconductor layer, luminescence layer, and P type semiconductor layer is formed on the ceramic-based sintered compact having large surface roughness.
Item 1447. The light-emitting device as described in Item 1446, wherein the ceramic-based sintered compact having large surface roughness is substrate-like.
Item 1448. The light-emitting device as described in Item 1446 or 1447, wherein the average surface roughness Ra of the ceramic-based sintered compact is not more than 2000 nm.
Item 1449. The light-emitting device as described in Item 1448, wherein the average surface roughness Ra of the ceramic-based sintered compact is not more than 1000 nm.

Item 1450. The light-emitting device as described in Item 1448 or 1449, wherein the average surface roughness Ra of the ceramic-based sintered compact is not more than 100 nm.
Item 1451. The light-emitting device as described in any one of Items 1446-1450, wherein the average surface roughness Ra of the ceramic-based sintered compact is not less than 70 nm.
Item 1452. The light-emitting device as described in Item 1451, wherein the average surface roughness Ra of the ceramic-based sintered compact is more than 1000 nm.
Item 1453. The light-emitting device as described in Item 1451 or 1452, wherein the average surface roughness Ra of the ceramic-based sintered compact is more than 2000 nm.
Item 1454. The light-emitting device as described in any one of Items 1446-1453, wherein the surface of the ceramic-based sintered compact is at least one of the states selected from an as-fired state, a state in which lap polish was carried out, a state in which blast polish was carried out, a state in which specular surface polish was carried out, a state in which chemistry corrosion was carried out, and a state corroded by plasma gas.
Item 1455. The light-emitting device as described in any one of Items 1446-1454, wherein the optical transmissivity of the ceramic-based sintered compact having large surface roughness is 0 %.
Item 1456. The light-emitting device as described in any one of Items 1446-1455, wherein the light-emitting device is constituted with the laminate which comprises a thin film comprising as a main component at least one selected from gallium nitride, indium nitride and aluminum nitride and contains at least N type semiconductor layer, luminescence layer, and P type semiconductor layer, and the laminate of N type semiconductor layer, luminescence layer, and P type semiconductor layer is formed on the ceramic-based sintered compact having large surface roughness and forming a thin film comprising as a main component at least one selected from gallium nitride, indium nitride and aluminum nitride.
Item 1457. The light-emitting device as described in Item 1456, wherein the thin film comprising as a main component at least one selected from gallium nitride, indium nitride and aluminum nitride and formed on the ceramic-based sintered compact having large surface roughness has at least one of the crystallization states selected from an amorphous state, a polycrystal, an orientated polycrystal, and a single crystal.
Item 1458. The light-emitting device as described in Item 1456 or 1457, wherein a part of the thin film comprising as a main component at least one selected from gallium nitride, indium nitride and aluminum nitride and formed on the ceramic-based sintered compact having large surface roughness is a single crystal at least.
Item 1459. The light-emitting device as described in any one of Items 1456-1458, wherein the thin film comprising as a main component at least one selected from gallium nitride, indium nitride and aluminum nitride and formed on the ceramic-based sintered compact having large surface roughness is constituted with one layer.
Item 1460. The light-emitting device as described in Item 1459, wherein the thin film comprising as a main component at least one selected from gallium nitride, indium nitride and aluminum nitride and formed on the ceramic-based sintered compact having large surface roughness is amorphous.
Item 1461. The light-emitting device as described in Item 1459, wherein the thin film comprising as a main component at least one selected from gallium nitride, indium nitride and aluminum nitride and formed on the ceramic-based sintered compact having large surface roughness is a polycrystal.
Item 1462. The light-emitting device as described in Item 1459, wherein the thin film comprising as a main component at least one selected from gallium nitride, indium nitride and aluminum nitride and formed on the ceramic-based sintered compact having large surface roughness is an orientated polycrystal.
Item 1463. The light-emitting device as described in Item 1459, wherein the thin film comprising as a main component at least one selected from gallium nitride, indium nitride and aluminum nitride and formed on the ceramic-based sintered compact having large surface roughness is a single crystal.
Item 1464. The light-emitting device as described in any one of Items 1456-1458, wherein the thin film comprising as a main component at least one selected from gallium nitride, indium nitride and aluminum nitride and formed on the ceramic-based sintered compact having large surface roughness is constituted with at least two layers.
Item 1465. The light-emitting device as described in Item 1464, wherein the thin film comprising as a main component at least one selected from gallium nitride, indium nitride and aluminum nitride and formed on the ceramic-based sintered compact having large surface roughness is constituted with at least two layers, and each layer has at least one of the crystallization states selected from an amorphous state, a polycrystal, an orientated polycrystal, and a single crystal.
Item 1466. The light-emitting device as described in Item 1464 or 1465, wherein the thin film comprising as a main component at least one selected from gallium nitride, indium nitride and aluminum nitride and formed on the ceramic-based sintered compact having large surface roughness is constituted with at least two layers, and the thin film layer formed directly on the ceramic-based sintered compact having large surface roughness has at least one of the crystallization states selected from an amorphous state, a polycrystal, an orientated polycrystal, and a single crystal.
Item 1467. The light-emitting device as described in any one of Items 1464-1466, wherein the thin film comprising as a main component at least one selected from gallium nitride, indium nitride and aluminum nitride and formed on the ceramic-based sintered compact having large surface roughness is constituted with at least two layers, and the thin film layer formed directly on the ceramic-based sintered compact having large surface roughness has at least one of the crystallization states selected from an amorphous state, a polycrystal, and an orientated polycrystal.
Item 1468. The light-emitting device as described in any one of Items 1464-1467, wherein the thin film comprising as a main component at least one selected from gallium nitride, indium nitride and aluminum nitride and formed on the ceramic-based sintered compact having large surface roughness is constituted with at least two layers, and the thin film layer formed directly on the ceramic-based sintered compact having large surface roughness is an orientated polycrystal.
Item 1469. The light-emitting device as described in any one of Items 1464-1468, wherein the thin film comprising as a main component at least one selected from gallium nitride, indium nitride and aluminum nitride and formed on the ceramic-based sintered compact having large surface roughness is constituted with at least two layers, and at least one layer is a single crystal.
Item 1470. The light-emitting device as described in any one of Items 1464-1469, wherein the thin film comprising as a main component at least one selected from gallium nitride, indium nitride and aluminum nitride and formed on the ceramic-based sintered compact having large surface roughness is constituted with at least two layers, and the thin film of the top layer is a single crystal.
Item 1471. The light-emitting device as described in any one of Items 1456-1470, wherein the thin film comprising as a main component at least one selected from gallium nitride, indium nitride and aluminum nitride and formed on the ceramic-based sintered compact having large surface roughness has a single-crystal thin film layer at least, and the thickness of the single-crystal thin film layer is less than 300 µm.
Item 1472. The light-emitting device as described in Item 1471, wherein the thin film comprising as a main component at least one selected from gallium nitride, indium nitride and aluminum nitride and formed on the ceramic-based sintered compact having large surface roughness has a single-crystal thin film layer at least, and the thickness of the single-crystal thin film layer is not more than 200 µm.
Item 1473. The light-emitting device as described in any one of Items 1456-1472, wherein the thin film formed on the ceramic-based sintered compact having large surface roughness has the thickness at least not less than 0.1 nm.
Item 1474. The light-emitting device as described in Item 1473, wherein the thin film formed on the ceramic-based sintered compact having large surface roughness has the thickness at least not less than 0.5 nm.
Item 1475. The light-emitting device as described in Item 1473 or 1474, wherein the thin film formed on the ceramic-based sintered compact having large surface roughness has the thickness at least not less than 0.3 µm.
Item 1476. The light-emitting device as described in any one of Items 1473-1475, wherein the thin film formed on the ceramic-based sintered compact having large surface roughness has the thickness at least not less than 3.5 µm.
Item 1477. The light-emitting device as described in any one of Items 1473-1476, wherein the thin film formed on the ceramic-based sintered compact having large surface roughness has the thickness at least not less than 10 µm.
Item 1478. The light-emitting device as described in any one of Items 1473-1477, wherein the thin film formed on the ceramic-based sintered compact having large surface roughness has the thickness at least not less than 50 µm.
Item 1479. The light-emitting device as described in any one of Items 1456-1478, wherein the thin film formed on the ceramic-based sintered compact having large surface roughness contains gallium nitride at least.
Item 1480. The light-emitting device as described in any one of Items 1456-1479, wherein the thin film formed on the ceramic-based sintered compact having large surface roughness contains gallium nitride at least or has a thin film comprising gallium nitride as a main component.
Item 1481. The light-emitting device as described in Item 1479 or 1480, wherein the thin film formed on the ceramic-based sintered compact having large surface roughness comprises gallium nitride as a main component.
Item 1482. The light-emitting device as described in any one of Items 1479-1481, wherein the thin film formed on the ceramic-based sintered compact having large surface roughness has the composition expressed with AlₓGa_{y}In_{1-x-y}N (0<y≤1).
Item 1483. The light-emitting device as described in any one of Items 1479-1482, wherein the thin film formed on the ceramic-based sintered compact having large surface roughness contains gallium nitride not less than 50 mol %.
Item 1484. The light-emitting device as described in any one of Items 1479-1483, wherein the thin film which is formed on the ceramic-based sintered compact having large surface roughness and contains gallium nitride at least or comprises gallium nitride as a main component, has at least one of the crystallization states selected from an amorphous state, a polycrystal, an orientated polycrystal, and a single crystal.
Item 1485. The light-emitting device as described in Item 1484, wherein the thin film which is formed on the ceramic-based sintered compact having large surface roughness and contains gallium nitride at least or comprises gallium nitride as a main component, is a single crystal.
Item 1486. The light-emitting device as described in any one of Items 1479-1485, wherein the thin film of the top layer formed on the ceramic-based sintered compact having large surface roughness contains gallium nitride at least or comprises gallium nitride as a main component.
Item 1487. The light-emitting device as described in Item 1486, wherein the thin film of the top layer formed on the ceramic-based sintered compact having large surface roughness is a single crystal which contains gallium nitride at least or comprises gallium nitride as a main component.
Item 1488. The light-emitting device as described in any one of Items 1456-1487, wherein the thin film formed on the ceramic-based sintered compact having large surface roughness comprises that in which at least two crystallization states selected from a single crystal, an amorphous state, a polycrystal, and an orientated polycrystal are intermingled simultaneously.
Item 1489. The light-emitting device as described in any one of Items 1456-1488, wherein the thin film formed on the ceramic-based sintered compact having large surface roughness comprises a single layer or at least two layers, and at least one layer of the thin films comprises that in which at least two crystallization states selected from a single crystal, an amorphous state, a polycrystal, and an orientated polycrystal are intermingled simultaneously.
Item 1490. The light-emitting device as described in any one of Items 1456-1489, wherein the half width of the rocking curve of the X ray diffraction from the lattice plane of the Miller Index (002) of the single-crystal thin film formed on a ceramic-based sintered compact having large surface roughness is not more than 3600 seconds.
Item 1491. The light-emitting device as described in Item 1490, wherein the half width of the rocking curve of the X ray diffraction from the lattice plane of the Miller Index (002) of the single-crystal thin film formed on a ceramic-based sintered compact having large surface roughness is not more than 300 seconds.
Item 1492. The light-emitting device as described in Item 1490 or 1491, wherein the half width of the rocking curve of the X ray diffraction from the lattice plane of the Miller Index (002) of the single-crystal thin film formed on a ceramic-based sintered compact having large surface roughness is not more than 240 seconds.
Item 1493. The light-emitting device as described in any one of Items 1490-1492, wherein the half width of the rocking curve of the X ray diffraction from the lattice plane of the Miller Index (002) of the single-crystal thin film formed on a ceramic-based sintered compact having large surface roughness is not more than 200 seconds.
Item 1494. The light-emitting device as described in any one of Items 1490-1493, wherein the half width of the rocking curve of the X ray diffraction from the lattice plane of the Miller Index (002) of the single-crystal thin film formed on a ceramic-based sintered compact having large surface roughness is not more than 150 seconds.
Item 1495. The light-emitting device as described in any one of Items 1490-1494, wherein the half width of the rocking curve of the X ray diffraction from the lattice plane of the Miller Index (002) of the single-crystal thin film formed on a ceramic-based sintered compact having large surface roughness is not more than 130 seconds.
Item 1496. The light-emitting device as described in any one of Items 1490-1495, wherein the half width of the rocking curve of the X ray diffraction from the lattice plane of the Miller Index (002) of the single-crystal thin film formed on a ceramic-based sintered compact having large surface roughness is not more than 100 seconds.
Item 1497. The light-emitting device as described in any one of Items 1446-1496, wherein the ceramic-based sintered compact having large surface roughness is an aluminum nitride-based sintered compact.
Item 1498. The light-emitting device as described in any one of Items 1446-1496, wherein the ceramic-based sintered compact having large surface roughness is a ceramic-based sintered compact having at least one of the crystal structures selected from a hexagonal system or a trigonal system.
Item 1499. The light-emitting device as described in Item 1498, wherein the sintered compact which has large surface roughness and comprises as a main component a ceramic material having at least one of the crystal structures selected from a hexagonal system or a trigonal system is a sintered compact which comprises as a main component at least one selected from zinc oxide, beryllium oxide, aluminum oxide, silicon carbide, silicon nitride, and gallium nitride.

Item 1500. The light-emitting device as described in any one of Items 1446-1496, wherein the ceramic-based sintered compact having large surface roughness is a sintered compact which comprises as a main component at least one selected from zinc oxide, beryllium oxide, aluminum oxide, silicon carbide, silicon nitride, gallium nitride, zirconium oxide, magnesium oxide, magnesium aluminate, titanium oxide, barium titanate, lead titanate zirconate, a rare earth oxide, thorium oxide, various ferrites, mullite, forsterite, steatite, and glass.
Item 1501. The light-emitting device as described in any one of Items 1497-1500, wherein the ceramic-based sintered compact having large surface roughness is a sintered compact which comprises as a main component at least one selected from aluminum nitride, zinc oxide, beryllium oxide, aluminum oxide, silicon carbide, silicon nitride, gallium nitride, zirconium oxide, magnesium oxide, magnesium aluminate, and yttrium oxide.
Item 1502. The light-emitting device as described in any one of Items 1446-1501, wherein the ceramic-based sintered compact having large surface roughness has optical permeability.
Item 1503. A light-emitting device constituted with the laminate which comprises a thin film comprising as a main component at least one selected from gallium nitride, indium nitride and aluminum nitride and contains at least N type semiconductor layer, luminescence layer, and P type semiconductor layer, and the laminate of N type semiconductor layer, luminescence layer, and P type semiconductor layer is formed on the ceramic-based sintered compact on which a thin film comprising as a main component at least one selected from gallium nitride, indium nitride and aluminum nitride is formed.
Item 1504. The light-emitting device as described in Item 1503, wherein the thin film comprising as a main component at least one selected from gallium nitride, indium nitride and aluminum nitride and formed on the ceramic-based sintered compact has at least one of the crystallization states selected from an amorphous state, a polycrystal, an orientated polycrystal, and a single crystal.
Item 1505. The light-emitting device as described in Item 1503 or 1504, wherein a part of the thin film comprising as a main component at least one selected from gallium nitride, indium nitride and aluminum nitride and formed on the ceramic-based sintered compact is a single crystal at least.
Item 1506. The light-emitting device as described in any one of Items 1503-1505, wherein the thin film comprising as a main component at least one selected from gallium nitride, indium nitride and aluminum nitride and formed on the ceramic-based sintered compact is constituted with one layer.
Item 1507. The thin-film substrate as described in Item 1506, wherein the thin film comprising as a main component at least one selected from gallium nitride, indium nitride and aluminum nitride and formed on the ceramic-based sintered compact is amorphous at least.
Item 1508. The thin-film substrate as described in Item 1506, wherein the thin film comprising as a main component at least one selected from gallium nitride, indium nitride and aluminum nitride and formed on the ceramic-based sintered compact is a polycrystal.
Item 1509. The thin-film substrate as described in Item 1506, wherein the thin film comprising as a main component at least one selected from gallium nitride, indium nitride and aluminum nitride and formed on the ceramic-based sintered compact is an orientated polycrystal.
Item 1510. The thin-film substrate as described in Item 1506, wherein the thin film comprising as a main component at least one selected from gallium nitride, indium nitride and aluminum nitride and formed on the ceramic-based sintered compact is a single crystal.
Item 1511. The light-emitting device as described in any one of Items 1503-1505, wherein the thin film comprising as a main component at least one selected from gallium nitride, indium nitride and aluminum nitride and formed on the ceramic-based sintered compact is constituted with at least two layers.
Item 1512. The light-emitting device as described in Item 1511, wherein the thin film comprising as a main component at least one selected from gallium nitride, indium nitride and aluminum nitride and formed on the ceramic-based sintered compact is constituted with at least two layers, and each layer has at least one of the crystallization states selected from an amorphous state, a polycrystal, an orientated polycrystal, and a single crystal.
Item 1513. The light-emitting device as described in Item 1511 or 1512, wherein the thin film comprising as a main component at least one selected from gallium nitride, indium nitride and aluminum nitride and formed on the ceramic-based sintered compact is constituted with at least two layers, and the thin film layer formed directly on the ceramic-based sintered compact has at least one of the crystallization states selected from an amorphous state, a polycrystal, an orientated polycrystal, and a single crystal.
Item 1514. The light-emitting device as described in any one of Items 1511-1513, wherein the thin film comprising as a main component at least one selected from gallium nitride, indium nitride and aluminum nitride and formed on the ceramic-based sintered compact is constituted with at least two layers, and the thin film layer formed directly on the ceramic-based sintered compact has at least one of the crystallization states selected from an amorphous state, a polycrystal, and an orientated polycrystal.
Item 1515. The light-emitting device as described in any one of Items 1511-1514, wherein the thin film comprising as a main component at least one selected from gallium nitride, indium nitride and aluminum nitride and formed on the ceramic-based sintered compact is constituted with at least two layers, and the thin film layer formed directly on the ceramic-based sintered compact is an orientated polycrystal.
Item 1516. The light-emitting device as described in any one of Items 1511-1515, wherein the thin film comprising as a main component at least one selected from gallium nitride, indium nitride and aluminum nitride and formed on the ceramic-based sintered compact is constituted with at least two layers, and at least one layer is a single crystal.
Item 1517. The light-emitting device as described in any one of Items 1511-1516, wherein the thin film comprising as a main component at least one selected from gallium nitride, indium nitride and aluminum nitride and formed on the ceramic-based sintered compact is constituted with at least two layers, and the thin film of the top layer is a single crystal.
Item 1518. The light-emitting device as described in any one of Items 1503-1517, wherein the thin film comprising as a main component at least one selected from gallium nitride, indium nitride and aluminum nitride and formed on the ceramic-based sintered compact has a single-crystal thin film layer at least, and the thickness of the single-crystal thin film layer is less than 300 µm.
Item 1519. The light-emitting device as described in Item 1518, wherein the thin film comprising as a main component at least one selected from gallium nitride, indium nitride and aluminum nitride and formed on the ceramic-based sintered compact has a single-crystal thin film layer at least, and the thickness of the single-crystal thin film layer is not more than 200 µm.
Item 1520. The light-emitting device as described in any one of Items 1503-1519, wherein the thin film formed on the ceramic-based sintered compact has the thickness at least not less than 0.1 nm.
Item 1521. The light-emitting device as described in Item 1520, wherein the thin film formed on the ceramic-based sintered compact has the thickness at least not less than 0.5 nm.
Item 1522. The light-emitting device as described in Item 1520 or 1521, wherein the thin film formed on the ceramic-based sintered compact has the thickness at least not less than 0.3 µm.
Item 1523. The light-emitting device as described in any one of Items 1520-1522, wherein the thin film formed on the ceramic-based sintered compact has the thickness at least not less than 3.5 µm.
Item 1524. The light-emitting device as described in any one of Items 1520-1523, wherein the thin film formed on the ceramic-based sintered compact has the thickness at least not less than 10 µm.
Item 1525. The light-emitting device as described in any one of Items 1520-1524, wherein the thin film formed on the ceramic-based sintered compact has the thickness at least not less than 50 µm.
Item 1526. The light-emitting device as described in any one of Items 1503-1525, wherein the thin film formed on the ceramic-based sintered compact contains gallium nitride at least.
Item 1527. The light-emitting device as described in any one of Items 1503-1526, wherein the thin film formed on the ceramic-based sintered compact contains gallium nitride at least or has a thin film comprising gallium nitride as a main component.
Item 1528. The light-emitting device as described in Item 1526 or 1527, wherein the thin film formed on the ceramic-based sintered compact comprises gallium nitride as a main component.
Item 1529. The light-emitting device as described in any one of Items 1526-1528, wherein the thin film formed on the ceramic-based sintered compact has the composition expressed with AlₓGa_{y}In_{1-x-y}N (0<y≤1).
Item 1530. The light-emitting device as described in any one of Items 1526-1529, wherein the thin film formed on the ceramic-based sintered compact contains gallium nitride not less than 50 mol %.
Item 1531. The light-emitting device as described in any one of Items 1526-1530, wherein the thin film which is formed on the ceramic-based sintered compact and contains gallium nitride at least or comprises as a main component gallium nitride, has at least one of the crystallization states selected from an amorphous state, a polycrystal, an orientated polycrystal, and a single crystal.
Item 1532. The light-emitting device as described in Item 1531, wherein the thin film which is formed on the ceramic-based sintered compact and contains gallium nitride at least or comprises gallium nitride as a main component, is a single crystal.
Item 1533. The light-emitting device as described in any one of Items 1526-1532, wherein the top layer of the thin film formed on the ceramic-based sintered compact is that which contains gallium nitride at least or comprises gallium nitride as a main component.
Item 1534. The light-emitting device as described in Item 1533, wherein the top layer of the thin film formed on the ceramic-based sintered compact is a single crystal which contains gallium nitride at least or comprises a thin film comprising gallium nitride as a main component.
Item 1535. The light-emitting device as described in any one of Items 1503-1534, wherein the thin film formed on the ceramic-based sintered compact comprises that in which at least two crystallization states selected from a single crystal, an amorphous state, a polycrystal, and an orientated polycrystal are intermingled simultaneously.
Item 1536. The light-emitting device as described in any one of Items 1503-1535, wherein the thin film formed on the ceramic-based sintered compact comprises a single layer or at least two layers, and at least one layer of the thin films comprises that in which at least two crystallization states selected from a single crystal, an amorphous state, a polycrystal, and an orientated polycrystal are intermingled simultaneously.
Item 1537. The light-emitting device as described in any one of Items 1503-1536, wherein the half width of the rocking curve of the X ray diffraction from the lattice plane of the Miller Index (002) of the single-crystal thin film formed on the ceramic-based sintered compact is not more than 3600 seconds.
Item 1538. The light-emitting device as described in Item 1537, wherein the half width of the rocking curve of the X ray diffraction from the lattice plane of the Miller Index (002) of the single-crystal thin film formed on the ceramic-based sintered compact is not more than 300 seconds.
Item 1539. The light-emitting device as described in Item 1537 or 1538, wherein the half width of the rocking curve of the X ray diffraction from the lattice plane of the Miller Index (002) of the single-crystal thin film formed on the ceramic-based sintered compact is not more than 240 seconds.
Item 1540. The light-emitting device as described in any one of Items 1537-1539, wherein the half width of the rocking curve of the X ray diffraction from the lattice plane of the Miller Index (002) of the single-crystal thin film formed on the ceramic-based sintered compact is not more than 200 seconds.
Item 1541. The light-emitting device as described in any one of Items 1537-1540, wherein the half width of the rocking curve of the X ray diffraction from the lattice plane of the Miller Index (002) of the single-crystal thin film formed on the ceramic-based sintered compact is not more than 150 seconds.
Item 1542. The light-emitting device as described in any one of Items 1537-1541, wherein the half width of the rocking curve of the X ray diffraction from the lattice plane of the Miller Index (002) of the single-crystal thin film formed on the ceramic-based sintered compact is not more than 130 seconds.
Item 1543. The light-emitting device as described in any one of Items 1537-1542, wherein the half width of the rocking curve of the X ray diffraction from the lattice plane of the Miller Index (002) of the single-crystal thin film formed on the ceramic-based sintered compact is not more than 100 seconds.
Item 1544. The light-emitting device as described in any one of Items 1503-1543, wherein the ceramic-based sintered compact is an aluminum nitride-based sintered compact.
Item 1545. The light-emitting device as described in any one of Items 1503-1543, wherein the ceramic-based sintered compact is a sintered compact which comprises as a main component a ceramic material having at least one of the crystal structures selected from a hexagonal system or a trigonal system.
Item 1546. The light-emitting device as described in Item 1545, wherein the sintered compact which comprises as a main component a ceramic material having at least one of the crystal structures selected from a hexagonal system or a trigonal system is a sintered compact which comprises as a main component at least one selected from zinc oxide, beryllium oxide, aluminum oxide, silicon carbide, silicon nitride, and gallium nitride.
Item 1547. The light-emitting device as described in any one of Items 1503-1543, wherein the ceramic-based sintered compact is a sintered compact which comprises as a main component at least one selected from zinc oxide, beryllium oxide, aluminum oxide, silicon carbide, silicon nitride, gallium nitride, zirconium oxide, magnesium oxide, magnesium aluminate, titanium oxide, barium titanate, lead titanate zirconate, a rare earth oxide, thorium oxide, various ferrites, mullite, forsterite, steatite, and glass.
Item 1548. The light-emitting device as described in any one of Items 1544-1547, wherein the ceramic-based sintered compact is a sintered compact which comprises as a main component at least one selected from aluminum nitride, zinc oxide, beryllium oxide, aluminum oxide, silicon carbide, silicon nitride, gallium nitride, zirconium oxide, magnesium oxide, magnesium aluminate, and yttrium oxide.
Item 1549. The light-emitting device as described in any one of Items 1503-1548, wherein the ceramic-based sintered compact has optical permeability.

Item 1550. The light-emitting device as described in any one of Items 1503-1549, wherein the ceramic-based sintered compact has large surface roughness.
Item 1551. The light-emitting device as described in any one of Items 1503-1550, wherein the ceramic-based sintered compact has optical permeability and has large surface roughness.
Item 1552. A light-emitting device constituted with the laminate which comprises a thin film comprising as a main component at least one selected from gallium nitride, indium nitride and aluminum nitride and contains at least N type semiconductor layer, luminescence layer, and P type semiconductor layer, and the laminate ofN type semiconductor layer, luminescence layer, and P type semiconductor layer is formed on the ceramic-based sintered compact on which a single-crystal thin film comprising as a main component at least one selected from gallium nitride, indium nitride and aluminum nitride is formed.
Item 1553. The light-emitting device as described in Item 1552, wherein the single-crystal thin film comprising as a main component at least one selected from gallium nitride, indium nitride and aluminum nitride and formed on the ceramic-based sintered compact is constituted with one layer.
Item 1554. The light-emitting device as described in Item 1552, wherein the single-crystal thin film comprising as a main component at least one selected from gallium nitride, indium nitride and aluminum nitride and formed on the ceramic-based sintered compact is constituted with at least two layers.
Item 1555. The light-emitting device as described in Item 1554, wherein the single-crystal thin film comprising as a main component at least one selected from gallium nitride, indium nitride and aluminum nitride and formed on the ceramic-based sintered compact is constituted with at least two layers, and at least one layer is a single crystal. Item 1556. The light-emitting device as described in Item 1554 or 1555, wherein the single-crystal thin film comprising as a main component at least one selected from gallium nitride, indium nitride and aluminum nitride and formed on the ceramic-based sintered compact is constituted with at least two layers, and at least one layer is a single crystal, and others comprise a layer having at least one of the crystallization states selected from an amorphous state, a polycrystal, an orientated polycrystal, and a single crystal.
Item 1557. The light-emitting device as described in any one of Items 1554-1556, wherein the single-crystal thin film comprising as a main component at least one selected from gallium nitride, indium nitride and aluminum nitride and formed on the ceramic-based sintered compact is constituted with at least two layers, and the thin film layer formed directly on the ceramic-based sintered compact has at least one of the crystallization states selected from an amorphous state, a polycrystal, an orientated polycrystal, and a single crystal.
Item 1558. The light-emitting device as described in any one of Items 1554-1557, wherein the single-crystal thin film comprising as a main component at least one selected from gallium nitride, indium nitride and aluminum nitride and formed on the ceramic-based sintered compact is constituted with at least two layers, and the thin film layer formed directly on the ceramic-based sintered compact has at least one of the crystallization states selected from an amorphous state, a polycrystal, and an orientated polycrystal.
Item 1559. The light-emitting device as described in any one of Items 1554-1558, wherein the single-crystal thin film comprising as a main component at least one selected from gallium nitride, indium nitride and aluminum nitride and formed on the ceramic-based sintered compact is constituted with at least two layers, and the thin film layer formed directly on the ceramic-based sintered compact is an orientated polycrystal.
Item 1560. The light-emitting device as described in any one of Items 1554-1557, wherein the single-crystal thin film comprising as a main component at least one selected from gallium nitride, indium nitride and aluminum nitride and formed on the ceramic-based sintered compact is constituted with at least two layers, and all layers are a single crystal.
Item 1561. The light-emitting device as described in any one of Items 1554-1560, wherein the single-crystal thin film comprising as a main component at least one selected from gallium nitride, indium nitride and aluminum nitride and formed on the ceramic-based sintered compact is constituted with at least two layers, and the thin film of the top layer is a single crystal.
Item 1562. The light-emitting device as described in any one of Items 1552-1561, wherein the thickness of the single-crystal thin film comprising as a main component at least one selected from gallium nitride, indium nitride and aluminum nitride and formed on the ceramic-based sintered compact is less than 300 µm.
Item 1563. The light-emitting device as described in Item 1562, wherein the thickness of the single-crystal thin film comprising a main component at least one selected from gallium nitride, indium nitride and aluminum nitride as and is formed on the ceramic-based sintered compact is not more than 200 µm.
Item 1564. The light-emitting device as described in any one of Items 1552-1563, wherein the single-crystal thin film formed on the ceramic-based sintered compact has the thickness at least not less than 0.1 nm.
Item 1565. The light-emitting device as described in Item 1564, wherein the single-crystal thin film formed on the ceramic-based sintered compact has the thickness at least not less than 0.5 nm.
Item 1566. The light-emitting device as described in Item 1564 or 1565, wherein the single-crystal thin film formed on the ceramic-based sintered compact has the thickness at least not less than 0.3 µm.
Item 1567. The light-emitting device as described in any one of Items 1564-1566, wherein the single-crystal thin film formed on the ceramic-based sintered compact has the thickness at least not less than 3.5 µm.
Item 1568. The light-emitting device as described in any one of Items 1564-1567, wherein the single-crystal thin film formed on the ceramic-based sintered compact has the thickness at least not less than 10 µm.
Item 1569. The light-emitting device as described in any one of Items 1564-1568, wherein the single-crystal thin film formed on the ceramic-based sintered compact has the thickness at least not less than 50 µm.
Item 1570. The light-emitting device as described in any one of Items 1552-1569, wherein the single-crystal thin film formed on the ceramic-based sintered compact contains gallium nitride at least.
Item 1571. The light-emitting device as described in any one of Items 1552-1570, wherein the single-crystal thin film formed on the ceramic-based sintered compact contains gallium nitride at least or has a single-crystal thin film comprising gallium nitride as a main component.
Item 1572. The light-emitting device as described in Item 1570 or 1571, wherein the single-crystal thin film formed on the ceramic-based sintered compact comprises gallium nitride as a main component.
Item 1573. The light-emitting device as described in any one of Items 1570-1572, wherein the single-crystal thin film formed on the ceramic-based sintered compact has the composition expressed with AlₓGa_{y}In_{1-x-y}N (0<y≤1).
Item 1574. The light-emitting device as described in any one of Items 1570-1573, wherein the single-crystal thin film formed on the ceramic-based sintered compact contains gallium nitride not less than 50 mol %.
Item 1575. The light-emitting device as described in any one of Items 1552-1574, wherein the single-crystal thin film of the top layer formed on the ceramic-based sintered compact contains gallium nitride at least or comprises gallium nitride as a main component.
Item 1576. The light-emitting device as described in any one of Items 1552-1575, wherein the single-crystal thin film formed on the ceramic-based sintered compact is that in which that having a single-crystal state and that having at least one crystallization state selected from an amorphous state, a polycrystal, and an orientated polycrystal are intermingled.
Item 1577. The light-emitting device as described in any one of Items 1552-1576, wherein the single-crystal thin film formed on the ceramic-based sintered compact comprises a single layer or at least two layers, and at least one layer of the single-crystal thin films comprises that in which that having a single-crystal state and that having at least one crystallization state selected from an amorphous state, a polycrystal, and an orientated polycrystal are intermingled.
Item 1578. The light-emitting device as described in any one of Items 1552-1577, wherein the half width of the rocking curve of the X ray diffraction from the lattice plane of the Miller Index (002) of the single-crystal thin film formed on the ceramic-based sintered compact is not more than 3600 seconds.
Item 1579. The light-emitting device as described in Item 1578, wherein the half width of the rocking curve of the X ray diffraction from the lattice plane of the Miller Index (002) of the single-crystal thin film formed on the ceramic-based sintered compact is not more than 300 seconds.
Item 1580. The light-emitting device as described in Item 1578 or 1579, wherein the half width of the rocking curve of the X ray diffraction from the lattice plane of the Miller Index (002) of the single-crystal thin film formed on the ceramic-based sintered compact is not more than 240 seconds.
Item 1581. The light-emitting device as described in any one of Items 1578-1580, wherein the half width of the rocking curve of the X ray diffraction from the lattice plane of the Miller Index (002) of the single-crystal thin film formed on the ceramic-based sintered compact is not more than 200 seconds.
Item 1582. The light-emitting device as described in any one of Items 1578-1581, wherein the half width of the rocking curve of the X ray diffraction from the lattice plane of the Miller Index (002) of the single-crystal thin film formed on the ceramic-based sintered compact is not more than 150 seconds.
Item 1583. The light-emitting device as described in any one of Items 1578-1582, wherein the half width of the rocking curve of the X ray diffraction from the lattice plane of the Miller Index (002) of the single-crystal thin film formed on the ceramic-based sintered compact is not more than 130 seconds.
Item 1584. The light-emitting device as described in any one of Items 1578-1583, wherein the half width of the rocking curve of the X ray diffraction from the lattice plane of the Miller Index (002) of the single-crystal thin film formed on the ceramic-based sintered compact is not more than 100 seconds.
Item 1585. The light-emitting device as described in any one of Items 1552-1584, wherein the ceramic-based sintered compact is an aluminum nitride-based sintered compact.
Item 1586. The light-emitting device as described in any one of Items 1552-1584, wherein the ceramic-based sintered compact is a sintered compact which comprises as a main component a ceramic material having at least one of the crystal structures selected from a hexagonal system and/or a trigonal.
Item 1587. The light-emitting device as described in Item 1586, wherein the sintered compact which comprises as a main component a ceramic material having at least one of the crystal structures selected from a hexagonal system and/or a trigonal system is a sintered compact which comprises as a main component at least one selected from zinc oxide, beryllium oxide, aluminum oxide, silicon carbide, silicon nitride, and gallium nitride.
Item 1587. The light-emitting device as described in any one of Items 1552-1584, wherein the ceramic-based sintered compact is a sintered compact which comprises as a main component at least one selected from zinc oxide, beryllium oxide, aluminum oxide, silicon carbide, silicon nitride, gallium nitride, zirconium oxide, magnesium oxide, magnesium aluminate, titanium oxide, barium titanate, lead titanate zirconate, a rare earth oxide, thorium oxide, various ferrites, mullite, forsterite, steatite, and glass.
Item 1589. The light-emitting device as described in any one of Items 1585-1588, wherein the ceramic-based sintered compact is a sintered compact which comprises as a main component at least one selected from aluminum nitride, zinc oxide, beryllium oxide, aluminum oxide, silicon carbide, silicon nitride, gallium nitride, zirconium oxide, magnesium oxide, magnesium aluminate, and yttrium oxide.
Item 1590. The light-emitting device as described in any one of Items 1552-1589, wherein the ceramic-based sintered compact has optical permeability.
Item 1591. The light-emitting device as described in any one of Items 1552-1590, wherein the ceramic-based sintered compact has large surface coarseness.
Item 1592. The light-emitting device as described in any one of Items 1552-1591, wherein the ceramic-based sintered compact has optical permeability and has large surface coarseness.
Item 1593. The light-emitting device as described in any one of Items 1188-1592, wherein at least N type semiconductor layer, luminescence layer, and P type semiconductor layer which comprise a thin film comprising as a main component at least one selected from gallium nitride, indium nitride and aluminum nitride is laminated on the ceramic-based sintered compact, and at least one of the layers selected from N type semiconductor layer, luminescence layer, and P type semiconductor layer is a single layer.
Item 1594. The light-emitting device as described in any one of Items 1188-1593, wherein at least N type semiconductor layer, luminescence layer, and P type semiconductor layer which comprise a thin film comprising as a main component at least one selected from gallium nitride, indium nitride and aluminum nitride is laminated on the ceramic-based sintered compact, and at least one of the layers selected from N type semiconductor layer, luminescence layer, and P type semiconductor layer comprises at least two layers.
Item 1595. The light-emitting device as described in Item 1593 or 1594, wherein at least one of the layers selected from N type semiconductor layer, luminescence layer, and P type semiconductor layer comprises an epitaxially grown single-crystal thin film comprising as a main component at least one selected from gallium nitride, indium nitride and aluminum nitride.
Item 1596. The light-emitting device as described in any one of Items 1188-1595, wherein at least N type semiconductor layer, luminescence layer, and P type semiconductor layer which comprise a thin film comprising as a main component at least one selected from gallium nitride, indium nitride and aluminum nitride is laminated on the ceramic-based sintered compact, and a buffer layer is formed by the thin film comprising as a main component at least one selected from gallium nitride, indium nitride and aluminum nitride, between the laminate ofN type semiconductor layer, luminescence layer, and P type semiconductor layer and the ceramic-based sintered compact.
Item 1597. The light-emitting device as described in Item 1596, wherein the buffer layer comprises a thin film having at least one of the crystallization states selected from a single crystal, an orientated polycrystal, a polycrystal, and an amorphous state.
Item 1598. The light-emitting device as described in Item 1596 or 1597, wherein the buffer layer comprises a thin film having at least one of the crystallization states selected from an orientated polycrystal, a polycrystal, and an amorphous state.
Item 1599. The light-emitting device as described in any one of Items 1596-1598, wherein the buffer layer comprises an amorphous thin film.
Item 1600. A field emission material comprises a single-crystal thin film comprising as a main component at least one selected from gallium nitride, indium nitride and aluminum nitride and formed on the aluminum nitride-based sintered compact.
Item 1601. The field emission material as described in Item 1600, wherein the single-crystal thin film comprising as a main component at least one selected from gallium nitride, indium nitride and aluminum nitride and formed on the aluminum nitride-based sintered compact is semiconductorized into N type.
Item 1602. The field emission material as described in Item 1600 or 1601, wherein the single-crystal thin film comprising as a main component at least one selected from gallium nitride, indium nitride and aluminum nitride contains furthermore silicon.

This invention has been originally made by finding out that a single-crystal thin film comprising as a main component at least one selected from gallium nitride, indium nitride and aluminum nitride can form on the ceramic-based sintered compact.

A thin film which has at least one of the crystallization states selected from an amorphous state, a polycrystal, and an orientated polycrystal can form in such a ceramic-based sintered compact, other than the single-crystal thin film which comprises as a main component at least one selected from gallium nitride, indium nitride and aluminum nitride.

In this invention, the substrate for forming a thin film of various crystallization states other than a single crystal can also be provided.

They are explained below.
Item 1603. A substrate for a thin film in which a thin film comprises as a main component at least one selected from gallium nitride, indium nitride and aluminum nitride, and the substrate comprises a ceramic-based sintered compact.
Item 1604. The substrate for a thin film as described in Item 1603, wherein the thin film comprising as a main component at least one selected from gallium nitride, indium nitride and aluminum nitride and formed on the substrate for a thin film comprising a ceramic-based sintered compact has at least one of the crystallization states selected from an amorphous state, a polycrystal, an orientated polycrystal, and a single crystal.
Item 1605. The substrate for a thin film as described in Item 1603 or 1604, wherein a part of the thin film comprising as a main component at least one selected from gallium nitride, indium nitride and aluminum nitride and formed on the substrate for a thin film comprising a ceramic-based sintered compact is a single crystal at least.
Item 1606. The substrate for a thin film as described in any one of Items 1603-1605, wherein the thin film comprising as a main component at least one selected from gallium nitride, indium nitride and aluminum nitride and formed on the substrate for a thin film comprising a ceramic-based sintered compact is a single crystal altogether.
Item 1607. The substrate for a thin film as described in any one of Items 1603-1606, wherein the ceramic-based sintered compact is substrate-like.
Item 1608. The substrate for a thin film as described in any one of Items 1603-1607, wherein the ceramic material comprises the composite of at least one selected from a metal element and a semimetal element and at least one selected from a nonmetallic element, or the composite of at least one selected from a metal element and at least one selected from a semimetal element, or the composite of at least two selected from a semimetal element.
Item 1609. The substrate for a thin film as described in any one of Items 1608, wherein the semimetal element is at least one selected from boron, carbon, silicon, germanium, arsenic, antimony, bismuth, selenium, tellurium, and polonium.
Item 1610. The substrate for a thin film as described in Item 1609, wherein the semimetal element is at least one selected from carbon and silicon.
Item 1611. The substrate for a thin film as described in any one of Items 1608-1610, wherein the nonmetallic element is at least one selected from nitrogen, phosphorus, oxygen, sulfur, fluorine, chlorine, bromine, iodine, and astatine.
Item 1612. The substrate for a thin film as described in Item 1611, wherein the nonmetallic element is at least one selected from nitrogen and oxygen.
Item 1613. The substrate for a thin film as described in any one of Items 1603-1612, wherein the ceramic material is at least one selected from nitride, carbide, oxide, boride, and silicide.
Item 1614. The substrate for a thin film as described in Item 1613, wherein the ceramic material is at least one selected from nitride, carbide, and oxide.
Item 1615. The substrate for a thin film as described in any one of Items 1603-1614, wherein the ceramic material is at least one selected from aluminum nitride and a material having at least one of crystal structures selected from a hexagonal system or a trigonal system, and at least one selected from zirconium oxide, magnesium oxide, magnesium aluminate, titanium oxide, barium titanate; lead titanate zirconate, a rare earth oxide, thorium oxide, various ferrites, mullite, forsterite, steatite, and glass.
Item 1616. The substrate for a thin film as described in Item 1615, wherein the material having at least one of crystal structures selected from a hexagonal system or a trigonal system is at least one selected from zinc oxide, beryllium oxide, aluminum oxide, silicon carbide, silicon nitride, and gallium nitride.
Item 1617. The substrate for a thin film as described in any one of Items 1603-1616, wherein the ceramic material is at least one selected from aluminum nitride, zinc oxide, beryllium oxide, aluminum oxide, silicon carbide, silicon nitride, gallium nitride, zirconium oxide, magnesium oxide, magnesium aluminate, and yttrium oxide.
Item 1618. The substrate for a thin film as described in any one of Items 1603-1617, wherein the ceramic-based sintered compact is an aluminum nitride-based sintered compact.
Item 1619. The substrate for a thin film as described in any one of Items 1603-1617, wherein the ceramic-based sintered compact is a sintered compact which comprises as a main component a material having at least one of crystal structures selected from a hexagonal system or a trigonal system.
Item 1620. The substrate for a thin film as described in Item 1619, wherein the sintered compact which comprises as a main component a material having at least one of crystal structures selected from a hexagonal system or a trigonal system is a sintered compact which comprises as a main component at least one selected from zinc oxide, beryllium oxide, aluminum oxide, silicon carbide, silicon nitride, and gallium nitride.
Item 1621. The substrate for a thin film as described in any one of Items 1603-1617, wherein the ceramic-based sintered compact is a sintered compact which comprises as a main component at least one selected from zirconium oxide, magnesium oxide, magnesium aluminate, titanium oxide, barium titanate, lead titanate zirconate, a rare earth oxide, thorium oxide, various ferrites, mullite, forsterite, steatite, and glass.
Item 1622. The substrate for a thin film as described in any one of Items 1603-1621, wherein the ceramic-based sintered compact is a sintered compact which comprises as a main component at least one selected from aluminum nitride, zinc oxide, beryllium oxide, aluminum oxide, silicon carbide, silicon nitride, gallium nitride, zirconium oxide, magnesium oxide, magnesium aluminate, titanium oxide, barium titanate, lead titanate zirconate, a rare earth oxide, thorium oxide, various ferrites, mullite, forsterite, steatite, and glass.
Item 1623. The substrate for a thin film as described in any one of Items 1603-1622, wherein the ceramic-based sintered compact has optical permeability.
Item 1624. The substrate for a thin film as described in any one of Items 1603-1623, wherein the optical transmissivity of the ceramic-based sintered compact is not less than 1%.
Item 1625. The substrate for a thin film as described in Item 1624, wherein the optical transmissivity of the ceramic-based sintered compact is not less than 5 %.
Item 1626. The substrate for a thin film as described in Item 1624 or 1625, wherein the optical transmissivity of the ceramic-based sintered compact is not less than 10 %. Item 1627. The substrate for a thin film as described in any one of Items 1624-1626, wherein the optical transmissivity of the ceramic-based sintered compact is not less than 20%.
Item 1628. The substrate for a thin film as described in any one of Items 1624-1627, wherein the optical transmissivity of the ceramic-based sintered compact is not less than 30%.
Item 1629. The substrate for a thin film as described in any one of Items 1624-1628, wherein the optical transmissivity of the ceramic-based sintered compact is not less than 40%.
Item 1630. The substrate for a thin film as described in any one of Items 1624-1629, wherein the optical transmissivity of the ceramic-based sintered compact is not less than 50%.
Item 1631. The substrate for a thin film as described in any one of Items 1624-1630, wherein the optical transmissivity of the ceramic-based sintered compact is not less than 60%.
Item 1632. The substrate for a thin film as described in any one of Items 1624-1631, wherein the optical transmissivity of the ceramic-based sintered compact is not less than 80%.
Item 1633. The substrate for a thin film as described in any one of Items 1624-1632, wherein the optical transmissivity of the ceramic-based sintered compact is not less than 85%.
Item 1634. The substrate for a thin film as described in any one of Items 1603-1623, wherein the optical transmissivity of the ceramic-based sintered compact is less than 1 %. Item 1635. The substrate for a thin film as described in Item 1634, wherein the optical transmissivity of the ceramic-based sintered compact is 0 %.
Item 1636. The substrate for a thin film as described in any one of Items 1623-1635, wherein the optical permeability or optical transmissivity of the gallium nitride-based sintered compact is that to the light of the range of 200-800 nm wavelength at least.
Item 1637. The substrate for a thin film as described in any one of Items 1603-1636, wherein the average surface roughness Ra of the ceramic-based sintered compact is not more than 2000 nm.
Item 1638. The substrate for a thin film as described in Item 1637, wherein the average surface roughness Ra of the ceramic-based sintered compact is not more than 1000 nm.
Item 1639. The substrate for a thin film as described in Item 1637 or 1638, wherein the average surface roughness Ra of the ceramic-based sintered compact is not more than 100 nm.
Item 1640. The substrate for a thin film as described in any one of Items 1637-1639, wherein the average surface roughness Ra of the ceramic-based sintered compact is not more than 20 nm.
Item 1641. The substrate for a thin film as described in any one of Items 1637-1640, wherein the average surface roughness Ra of the ceramic-based sintered compact is not more than 10 nm.
Item 1642. The substrate for a thin film as described in any one of Items 1637-1641, wherein the average surface roughness Ra of the ceramic-based sintered compact is not more than 5 nm.
Item 1643. The substrate for a thin film as described in any one of Items 1603-1639, wherein the ceramic-based sintered compact has large surface roughness.
Item 1644. The substrate for a thin film as described in any one of Items 1603-1643, wherein the average surface roughness Ra of the ceramic-based sintered compact is not less than 70 nm.
Item 1645. The substrate for a thin film as described in Item 1644, wherein the average surface roughness Ra of the ceramic-based sintered compact is more than 1000 nm.
Item 1646. The substrate for a thin film as described in Item 1644 or 1645, wherein the average surface roughness Ra of the ceramic-based sintered compact is more than 2000 nm.
Item 1647. The substrate for a thin film as described in any one of Items 1603-1646, wherein the surface of the ceramic-based sintered compact is at least one of the states selected from an as-fired state, a state in which lap polish was carried out, a state in which blast polish was carried out, a state in which specular surface polish was carried out, a state in which chemistry corrosion was carried out, and a state corroded by plasma gas. Item 1648. The substrate for a thin film as described in Item 1647, wherein the surface of the ceramic-based sintered compact is the state in which specular surface polish was carried out.
Item 1649. The substrate for a thin film as described in any one of Items 1603-1639 and 1643-1646, wherein the ceramic-based sintered compact has optical permeability and has large surface coarseness.

Item 1650. The substrate for a thin film as described in any one of Items 1603-1649, wherein the ceramic-based sintered compact has conductivity.
Item 1651. The substrate for a thin film as described in any one of Items 1603-1650, wherein the ceramic-based sintered compact has the electric resistivity not more than 1x10⁴ Ω·cm at room temperature.
Item 1652. The substrate for a thin film as described in Item 1651, wherein the ceramic-based sintered compact has the electric resistivity not more than 1x10² Ω·cm at room temperature.
Item 1653. The substrate for a thin film as described in Item 1651 or 1652, wherein the ceramic-based sintered compact has the electric resistivity not more than 1x10¹ Ω·cm at room temperature.
Item 1654. The substrate for a thin film as described in any one of Items 1651-1653, wherein the ceramic-based sintered compact has the electric resistivity not more than 1x10⁰ Ω·cm at room temperature.
Item 1655. The substrate for a thin film as described in any one of Items 1651-1654, wherein the ceramic-based sintered compact has the electric resistivity not more than 1x10⁻¹ Ω·cm at room temperature.
Item 1656. The substrate for a thin film as described in any one of Items 1651-1655, wherein the ceramic-based sintered compact has the electric resistivity not more than 1x10⁻² Ω·cm at room temperature.
Item 1657. The substrate for a thin film as described in any one of Items 1603-1656, wherein the ceramic-based sintered compact has optical permeability and has conductivity.
Item 1658. The substrate for a thin film as described in any one of Items 1603-1657, wherein the ceramic-based sintered compact has optical permeability and conductivity, and has further large surface roughness.
Item 1659. The substrate for a thin film as described in any one of Items 1603-1658, wherein the ceramic-based sintered compact is that on which a thin film comprising as a main component at least one selected from gallium nitride, indium nitride and aluminum nitride is formed.
Item 1660. The substrate for a thin film as described in Item 1659, wherein the thin film comprising as a main component at least one selected from gallium nitride, indium nitride and aluminum nitride and formed on the ceramic-based sintered compact has at least one of the crystallization states selected from a single crystal, an amorphous state, a polycrystal, and an orientated polycrystal.
Item 1661. The substrate for a thin film as described in Item 1659 or 1660, wherein a part of the thin film comprising as a main component at least one selected from gallium nitride, indium nitride and aluminum nitride and formed on the ceramic-based sintered compact comprises a single crystal at least.
Item 1662. The substrate for a thin film as described in any one of Items 1659-1661, wherein the thin film comprising as a main component at least one selected from gallium nitride, indium nitride and aluminum nitride and formed on the ceramic-based sintered compact comprises only a single crystal.
Item 1663. The substrate for a thin film as described in any one of Items 1659-1662, wherein the thin film comprising as a main component at least one selected from gallium nitride, indium nitride and aluminum nitride and formed on the ceramic-based sintered compact is constituted with a single layer.
Item 1664. The substrate for a thin film as described in any one of Items 1659-1662, wherein the thin film comprising as a main component at least one selected from gallium nitride, indium nitride and aluminum nitride and formed on the ceramic-based sintered compact is constituted with at least two layers.
Item 1665. The substrate for a thin film as described in Item 1664, wherein each layer of the thin films constituted with at least two layers has respectively at least one of the crystallization states selected from a single crystal, an orientated polycrystal, a polycrystal, and an amorphous state.
Item 1666. The substrate for a thin film as described in Item 1664 or 1665, wherein the thin film comprising as a main component at least one selected from gallium nitride, indium nitride and aluminum nitride and formed directly on the ceramic-based sintered compact has at least one of the crystallization states selected from an amorphous state, a polycrystal, an orientated polycrystal, and a single crystal, in the thin film constituted with at least two layers.
Item 1667. The substrate for a thin film as described in any one of Items 1660-1666, wherein the thin film comprising as a main component at least one selected from gallium nitride, indium nitride and aluminum nitride and formed directly on the ceramic-based sintered compact is amorphous.
Item 1668. The substrate for a thin film as described in any one of Items 1660-1666, wherein the thin film comprising as a main component at least one selected from gallium nitride, indium nitride and aluminum nitride and formed directly on the ceramic-based sintered compact is a polycrystal.
Item 1669. The substrate for a thin film as described in any one of Items 1660-1666, wherein the thin film comprising as a main component at least one selected from gallium nitride, indium nitride and aluminum nitride and formed directly on the ceramic-based sintered compact is an orientated polycrystal.
Item 1670. The substrate for a thin film as described in any one of Items 1660-1666, wherein the thin film comprising as a main component at least one selected from gallium nitride, indium nitride and aluminum nitride and formed directly on the ceramic-based sintered compact is a single crystal.
Item 1671. The substrate for a thin film as described in any one of Items 1664-1670, wherein at least one layer of thin films which comprise as a main component at least one selected from gallium nitride, indium nitride and aluminum nitride and have at least one of the crystallization states selected from a single crystal, an orientated polycrystal, a polycrystal, and an amorphous state is formed on the ceramic-based sintered compact, and at least one layer of thin films which comprise as a main component at least one selected from gallium nitride, indium nitride and aluminum nitride and have at least one of the crystallization states selected from a single crystal, an orientated polycrystal, a polycrystal, and an amorphous state is formed further on it, in the thin film constituted with at least two layers.
Item 1672. The substrate for a thin film as described in Item 1671, wherein at least one layer of thin films which comprise as a main component at least one selected from gallium nitride, indium nitride and aluminum nitride and have at least one of the crystallization states selected from a single crystal, an orientated polycrystal, a polycrystal, and an amorphous state is formed on the ceramic-based sintered compact, and at least one layer of single-crystal thin films which comprise as a main component at least one selected from gallium nitride, indium nitride and aluminum nitride is formed further on it, in the thin film constituted with at least two layers.
Item 1673. The substrate for a thin film as described in Item 1672, wherein at least one layer of thin films which comprise as a main component at least one selected from gallium nitride, indium nitride and aluminum nitride and have at least one of the crystallization states selected from an orientated polycrystal, a polycrystal, and an amorphous state is formed on the ceramic-based sintered compact, and at least one layer of single-crystal thin films which comprise as a main component at least one selected from gallium nitride, indium nitride and aluminum nitride is formed further on it, in the thin film constituted with at least two layers.
Item 1674. The substrate for a thin film as described in Item 1672 or 1673, wherein at least one layer of amorphous thin films which comprise as a main component at least one selected from gallium nitride, indium nitride and aluminum nitride is formed on the ceramic-based sintered compact, and at least one layer of single-crystal thin films which comprise as a main component at least one selected from gallium nitride, indium nitride and aluminum nitride is formed further on it, in the thin film constituted with at least two layers.
Item 1675. The substrate for a thin film as described in Item 1672 or 1673, wherein at least one layer of polycrystal thin films which comprise as a main component at least one selected from gallium nitride, indium nitride and aluminum nitride is formed on the ceramic-based sintered compact, and at least one layer of single-crystal thin films which comprise as a main component at least one selected from gallium nitride, indium nitride and aluminum nitride is formed further on it, in the thin film constituted with at least two layers.
Item 1676. The substrate for a thin film as described in Item 1672 or 1673, wherein at least one layer of orientated polycrystal thin films which comprise as a main component at least one selected from gallium nitride, indium nitride and aluminum nitride is formed on the ceramic-based sintered compact, and at least one layer of single-crystal thin films which comprise as a main component at least one selected from gallium nitride, indium nitride and aluminum nitride is formed further on it, in the thin film constituted with at least two layers.
Item 1677. The substrate for a thin film as described in any one of Items 1664-1676, wherein in the thin film constituted with at least two layers, all layers comprise only a single crystal.
Item 1678. The substrate for a thin film as described in any one of Items 1660-1677, wherein the top layer of the thin film comprising as a main component at least one selected from gallium nitride, indium nitride and aluminum nitride and formed on the ceramic-based sintered compact is a single-crystal thin film.
Item 1679. The substrate for a thin film as described in any one of Items 1660-1678, wherein C axis of the single-crystal thin film comprising as a main component at least one selected from gallium nitride, indium nitride and aluminum nitride and formed on the ceramic-based sintered compact is formed in the perpendicular direction to the surface of the ceramic-based sintered compact.
Item 1680. The substrate for a thin film as described in any one of Items 1660-1678, wherein C axis of the single-crystal thin film comprising as a main component at least one selected from gallium nitride, indium nitride and aluminum nitride and formed on the ceramic-based sintered compact is formed in the parallel direction to the surface of the ceramic-based sintered compact.
Item 1681. The substrate for a thin film as described in any one of Items 1660-1678, wherein C axis of the orientated polycrystal thin film comprising as a main component at least one selected from gallium nitride, indium nitride and aluminum nitride and formed on the ceramic-based sintered compact is formed in the perpendicular direction to the surface of the ceramic-based sintered compact.
Item 1682. The substrate for a thin film as described in any one of Items 1660-1678, wherein C axis of the orientated polycrystal thin film comprising as a main component at least one selected from gallium nitride, indium nitride and aluminum nitride and formed on the ceramic-based sintered compact is formed in the parallel direction to the surface of the ceramic-based sintered compact.
Item 1683. The substrate for a thin film as described in any one of Items 1659-1682, wherein the thin film comprising as a main component at least one selected from gallium nitride, indium nitride and aluminum nitride and formed on the ceramic-based sintered compact has conductivity.
Item 1684. The substrate for a thin film as described in any one of Items 1659-1683, wherein the electric resistivity of the thin film comprising as a main component at least one selected from gallium nitride, indium nitride and aluminum nitride and formed on the ceramic-based sintered compact is not more than 1x10⁴ Ω·cm at room temperature.
Item 1685. The substrate for a thin film as described in Item 1683 or 1684, wherein the electric resistivity of the thin film comprising as amain component at least one selected from gallium nitride, indium nitride and aluminum nitride and formed on the ceramic-based sintered compact is not more than 1x10² Ω·cm at room temperature.
Item 1686. The substrate for a thin film as described in any one of Items 1683-1685, wherein the electric resistivity of the thin film comprising as a main component at least one selected from gallium nitride, indium nitride and aluminum nitride and formed on the ceramic-based sintered compact is not more than 1x10¹ Ω·cm at room temperature.
Item 1687. The substrate for a thin film as described in any one of Items 1683-1686, wherein the electric resistivity of the thin film comprising as a main component at least one selected from gallium nitride, indium nitride and aluminum nitride and formed on the ceramic-based sintered compact is not more than 1x10⁰ Ω·cm at room temperature.
Item 1688. The substrate for a thin film as described in any one of Items 1659-1687, wherein the thin film formed on the ceramic-based sintered compact contains gallium nitride at least.
Item 1689. The substrate for a thin film as described in any one of Items 1659-1688, wherein the thin film formed on the ceramic-based sintered compact contains gallium nitride at least or has a thin film comprising gallium nitride as a main component. Item 1690. The substrate for a thin film as described in Item 1688 or 1689, wherein the thin film formed on the ceramic-based sintered compact comprises gallium nitride as a main component.
Item 1691. The substrate for a thin film as described in any one of Items 1688-1690, wherein the thin film formed on the ceramic-based sintered compact has the composition expressed with AlₓGa_{y}In_{1-x-y}N (0<y≤1).
Item 1692. The substrate for a thin film as described in any one of Items 1688-1691, wherein the thin film formed on the ceramic-based sintered compact contains gallium nitride not less than 50 mol %.
Item 1693. The substrate for a thin film as described in any one of Items 1688-1692, wherein the thin film which is formed on the ceramic-based sintered compact and contains gallium nitride at least or comprises gallium nitride as a main component, has at least one of the crystallization states selected from an amorphous state, a polycrystal, an orientated polycrystal, and a single crystal.
Item 1694. The substrate for a thin film as described in Item 1693, wherein the thin film which is formed on the ceramic-based sintered compact and contains gallium nitride at least or comprises gallium nitride as a main component, is a single crystal.
Item 1695. The substrate for a thin film as described in any one of Items 1688-1694, wherein the top layer of the thin film formed on the ceramic-based sintered compact is that containing gallium nitride at least or comprising gallium nitride as a main component. Item 1696. The substrate for a thin film as described in Item 1695, wherein the top layer of the thin film formed on the ceramic-based sintered compact is a single crystal containing gallium nitride at least or comprising a thin film comprising gallium nitride as a main component.
Item 1697. The substrate for a thin film as described in any one of Items 1659-1696, wherein the thin film formed on the ceramic-based sintered compact is that which comprises as a main component the composite expressed with the chemical formula of AlₓGa₁₋ₓN (0≤x≤1.0).
Item 1698. The substrate for a thin film as described in any one of Items 1659-1697, wherein the thin film comprising as a main component at least one selected from gallium nitride, indium nitride and aluminum nitride and formed on the ceramic-based sintered compact has a single-crystal thin film layer at least, and the thickness of the single-crystal thin film layer is less than 300 µm.
Item 1699. The substrate for a thin film as described in Item 1698, wherein the thin film comprising as a main component at least one selected from gallium nitride, indium nitride and aluminum nitride and formed on the ceramic-based sintered compact has a single-crystal thin film layer at least, and the thickness of the single-crystal thin film layer is not more than 200 µm.

Item 1700. The substrate for a thin film as described in any one of Items 1659-1699, wherein the thin film formed on the ceramic-based sintered compact has the thickness at least not less than 0.1 nm.
Item 1701. The substrate for a thin film as described in Item 1700, wherein the thin film formed on the ceramic-based sintered compact has the thickness at least not less than 0.5 nm.
Item 1702. The substrate for a thin film as described in Item 1700 or 1701, wherein the thin film formed on the ceramic-based sintered compact has the thickness at least not less than 0.3 µm.
Item 1703. The substrate for a thin film as described in any one of Items 1700-1702, wherein the thin film formed on the ceramic-based sintered compact has the thickness at least not less than 3.5 µm.
Item 1704. The substrate for a thin film as described in any one of Items 1700-1703, wherein the thin film formed on the ceramic-based sintered compact has the thickness at least not less than 10 µm.
Item 1705. The substrate for a thin film as described in any one of Items 1700-1704, wherein the thin film formed on the ceramic-based sintered compact has the thickness at least not less than 50 µm.
Item 1706. The substrate for a thin film as described in any one of Items 1659-1705, wherein the thickness of the thin film comprising as a main component at least one selected from gallium nitride, indium nitride and aluminum nitride and formed on the ceramic-based sintered compact is not more than 1000 µm.
Item 1707. The substrate for a thin film as described in Item 1706, wherein the thickness of the thin film formed on the ceramic-based sintered compact is not more than 500 µm.
Item 1708. The substrate for a thin film as described in any one of Items 1659-1707, wherein the thin film formed on the ceramic-based sintered compact comprises that in which at least two crystallization states selected from a single crystal, an amorphous state, a polycrystal, and an orientated polycrystal are intermingled simultaneously.
Item 1709. The substrate for a thin film as described in any one of Items 1659-1708, wherein the thin film formed on the ceramic-based sintered compact comprises a single layer or at least two layers, and at least one layer of the thin film comprises that in which at least two crystallization states selected from a single crystal, an amorphous state, a polycrystal, and an orientated polycrystal are intermingled simultaneously.
Item 1710. The substrate for a thin film as described in any one of Items 1659-1709, wherein the half width of the rocking curve of the X ray diffraction from the lattice plane of the Miller Index (002) of the single-crystal thin film which is formed on the ceramic-based sintered compact and comprises as a main component at least one selected from gallium nitride, indium nitride and aluminum nitride is not more than 3600 seconds.
Item 1711. The substrate for a thin film as described in Item 1710, wherein the half width of the rocking curve of the X ray diffraction from the lattice plane of the Miller Index (002) of the single-crystal thin film which is formed on the ceramic-based sintered compact and comprises as a main component at least one selected from gallium nitride, indium nitride and aluminum nitride is not more than 300 seconds.
Item 1712. The substrate for a thin film as described in Item 1710 or 1711, wherein the half width of the rocking curve of the X ray diffraction from the lattice plane of the Miller Index (002) of the single-crystal thin film which is formed on the ceramic-based sintered compact and comprises as a main component at least one selected from gallium nitride, indium nitride and aluminum nitride is not more than 240 seconds.
Item 1713. The substrate for a thin film as described in any one of Items 1710-1712, wherein the half width of the rocking curve of the X ray diffraction from the lattice plane of the Miller Index (002) of the single-crystal thin film which is formed on the ceramic-based sintered compact and comprises as a main component at least one selected from gallium nitride, indium nitride and aluminum nitride is not more than 200 seconds. Item 1714. The substrate for a thin film as described in any one of Items 1710-1713, wherein the half width of the rocking curve of the X ray diffraction from the lattice plane of the Miller Index (002) of the single-crystal thin film which is formed on the ceramic-based sintered compact and comprises as a main component at least one selected from gallium nitride, indium nitride and aluminum nitride is not more than 150 seconds.
Item 1715. The substrate for a thin film as described in any one of Items 1710-1714, wherein the half width of the rocking curve of the X ray diffraction from the lattice plane of the Miller Index (002) of the single-crystal thin film which is formed on the ceramic-based sintered compact and comprises as a main component at least one selected from gallium nitride, indium nitride and aluminum nitride is not more than 130 seconds.
Item 1716. The substrate for a thin film as described in any one of Items 1710-1715, wherein the half width of the rocking curve of the X ray diffraction from the lattice plane of the Miller Index (002) of the single-crystal thin film which is formed on the ceramic-based sintered compact and comprises as a main component at least one selected from gallium nitride, indium nitride and aluminum nitride is not more than 100 seconds.
Item 1717. The substrate for a thin film as described in any one of Items 1659-1716, wherein the ceramic-based sintered compact is that on which a single-crystal thin film comprising as a main component at least one selected from gallium nitride, indium nitride and aluminum nitride is formed.

Details are explained further about the ceramic-based sintered compact and the ceramic-based sintered compact having optical permeability which are indicated in the above Item 1-70 and are used for the substrate for a thin film of this invention
Item 1718. The substrate for a thin film as described in any one of Items 1-27, 57-68, and 70, wherein the ceramic-based sintered compact is an aluminum nitride-based sintered compact.
Item 1719. The substrate for a thin film as described in any one of Items 1-27 and 57-70, wherein the ceramic-based sintered compact is a sintered compact which comprises as a main component a ceramic material having at least one of the crystal structures selected from a hexagonal system or a trigonal system.
Item 1720. The substrate for a thin film as described in Item 1719, wherein the sintered compact which comprises as a main component a ceramic material having at least one of the crystal structures selected from a hexagonal system or a trigonal system is a sintered compact which comprises as a main component at least one selected from zinc oxide, beryllium oxide, aluminum oxide, silicon carbide, silicon nitride, and gallium nitride.
Item 1721. The substrate for a thin film as described in any one of Items 1-27, 57-68, and 70, wherein the ceramic-based sintered compact is a sintered compact which comprises as a main component at least one selected from zinc oxide, beryllium oxide, aluminum oxide, silicon carbide, silicon nitride, gallium nitride, zirconium oxide, magnesium oxide, magnesium aluminate, titanium oxide, barium titanate, lead titanate zirconate, a rare earth oxide, thorium oxide, various ferrites, mullite, forsterite, steatite, and glass.
Item 1722. The substrate for a thin film as described in any one of Items 1718-1721, wherein the ceramic-based sintered compact is a sintered compact which comprises as a main component at least one selected from aluminum nitride, zinc oxide, beryllium oxide, aluminum oxide, silicon carbide, silicon nitride, gallium nitride, zirconium oxide, magnesium oxide, magnesium aluminate, and yttrium oxide.
Item 1723. The substrate for a thin film as described in any one of Items 28-68 and 70, wherein the ceramic-based sintered compact having optical permeability is an aluminum nitride-based sintered compact.
Item 1724. The substrate for a thin film as described in any one of Items 28-68 and 70, wherein the ceramic-based sintered compact having optical permeability is a sintered compact which comprises as a main component a ceramic material having at least one of the crystal structures selected from a hexagonal system or a trigonal system.
Item 1725. The substrate for a thin film as described in Item 1724, wherein the sintered compact which comprises as a main component a ceramic material having at least one of the crystal structures selected from a hexagonal system or a trigonal system is a sintered compact which comprises as a main component at least one selected from zinc oxide, beryllium oxide, aluminum oxide, silicon carbide, silicon nitride, and gallium nitride.
Item 1726. The substrate for a thin film as described in any one of Items 28-68 and 70, wherein the ceramic-based sintered compact having optical permeability is a sintered compact which comprises as a main component at least one selected from zinc oxide, beryllium oxide, aluminum oxide, silicon carbide, silicon nitride, gallium nitride, zirconium oxide, magnesium oxide, magnesium aluminate, titanium oxide, barium titanate, lead titanate zirconate, a rare earth oxide, thorium oxide, various ferrites, mullite, forsterite, steatite, and glass.
Item 1727. The substrate for a thin film as described in any one of Items 1723-1726, wherein the ceramic-based sintered compact having optical permeability is a sintered compact which comprises as a main component at least one selected from aluminum nitride, zinc oxide, beryllium oxide, aluminum oxide, silicon carbide, silicon nitride, gallium nitride, zirconium oxide, magnesium oxide, magnesium aluminate, and yttrium oxide.

This invention can provide "A substrate for a thin film in which a thin film comprises at least one selected from gallium nitride, indium nitride and aluminum nitride as a main component, and the substrate comprises a ceramic-based sintered compact on which a thin film comprising as a main component at least one selected from gallium nitride, indium nitride and aluminum nitride is formed", as the substrate for a thin film of this invention which was described in the above Item 1-409 and Item 1603-1717.

And, this invention can provide that which has at least one of crystallization states selected from an amorphous state, a polycrystal, an orientated polycrystal, and a single crystal, as the thin film comprising as a main component at least one selected from gallium nitride, indium nitride and aluminum nitride and is formed in above the ceramic-based sintered compact.

And, the above substrate for a thin film of this invention includes "A substrate for a thin film in which a thin film comprises at least one selected from gallium nitride, indium nitride and aluminum nitride as a main component, and the substrate comprises a ceramic-based sintered compact having optical permeability and forming a thin film comprising as a main component at least one selected from gallium nitride, indium nitride and aluminum nitride".

And, this invention can provide that which has at least one of crystallization states selected from an amorphous state, a polycrystal, an orientated polycrystal, and a single crystal, as the thin film comprising as a main component at least one selected from gallium nitride, indium nitride and aluminum nitride and formed on the above ceramic-based sintered compact having optical permeability.

And, the above substrate for a thin film of this invention includes "A substrate for a thin film in which a thin film comprises at least one selected from gallium nitride, indium nitride and aluminum nitride as a main component, and the substrate comprises a ceramic-based sintered compact having large surface roughness".

And, the above substrate for a thin film of this invention includes "A substrate for a thin film in which a thin film comprises at least one selected from gallium nitride, indium nitride and aluminum nitride as a main component, and the substrate comprises a ceramic-based sintered compact having large surface roughness and forming a thin film comprising as a main component at least one selected from gallium nitride, indium nitride and aluminum nitride".

And, this invention can provide that which has at least one of crystallization states selected from an amorphous state, a polycrystal, an orientated polycrystal, and a single crystal, as the thin film comprising as a main component at least one selected from gallium nitride, indium nitride and aluminum nitride and is formed on the above ceramic-based sintered compact having large surface roughness.

And, the above substrate for a thin film ofthis invention includes "A substrate for a thin film in which a thin film comprises at least one selected from gallium nitride, indium nitride and aluminum nitride as a main component, and the substrate comprises a ceramic-based sintered compact having optical permeability and having large surface roughness".

And, the above substrate for a thin film of this invention includes "A substrate for a thin film in which a thin film comprises at least one selected from gallium nitride, indium nitride and aluminum nitride as a main component, and the substrate comprises a ceramic-based sintered compact having optical permeability and large surface roughness and forming a thin film comprising as a main component at least one selected from gallium nitride, indium nitride and aluminum nitride".

And, this invention can provide that which has at least one of crystallization states selected from an amorphous state, a polycrystal, an orientated polycrystal, and a single crystal, as the thin film comprising as a main component at least one selected from gallium nitride, indium nitride and aluminum nitride and formed on the above ceramic-based sintered compact having optical permeability and having large surface roughness.

And, the above substrate for a thin film of this invention includes "A sintered compact which comprises as a main component aluminum nitride and a material which has at least one of crystal structures selected from a hexagonal system or a trigonal system, and a sintered compact which comprises as a main component at least one selected from zirconium oxide, magnesium oxide, magnesium aluminate, titanium oxide, barium titanate, lead titanate zirconate, a rare earth oxide, thorium oxide, various ferrites, mullite, forsterite, steatite, and glass", as the ceramic-based sintered compact, ceramic-based sintered compact having optical permeability, and ceramic-based sintered compact having large surface roughness which are used for the above substrate for a thin film of this invention.

At least it can use a sintered compact which comprises as a main component at least one selected from zinc oxide, beryllium oxide, aluminum oxide, silicon carbide, silicon nitride, and gallium nitride, as the above sintered compact which comprises as a main component a material which has at least one of crystal structures selected from a hexagonal system or a trigonal system.

A sintered compact which comprises yttrium oxide as a main component may be used at least, as the sintered compact which comprises a rare earth oxide as a main component.

Moreover, this invention can provide "A thin-film substrate in which a thin film comprising as a main component at least one selected from gallium nitride, indium nitride and aluminum nitride is formed on the ceramic-based sintered compact".

And, this invention can provide that which has at least one of crystallization states selected from an amorphous state, a polycrystal, an orientated polycrystal, and a single crystal, as the thin film comprising as a main component at least one selected from gallium nitride, indium nitride and aluminum nitride and formed on the above ceramic-based sintered compact.

### INDUSTRIAL APPLICATION

According to this invention, the single-crystal thin film or various crystallized thin film comprising as a main component at least one selected from gallium nitride, indium nitride and aluminum nitride can be formed on the aluminum nitride-based sintered compact substrate, or on the substrate comprising various ceramic-based sintered compacts.

This single-crystal thin film has high crystallinity of the grade which can be used for a part of the light-emitting device or for an optical waveguide.

In such a aluminum nitride-based sintered compact substrate, a substrate comprising various ceramic-based sintered compacts, and a thin-film substrate having a single-crystal thin film or a thin film of various crystallization states onto these substrates, a light-emitting device comprising a nitride semiconductor that comprises as a main component at least one selected from gallium nitride, indium nitride and aluminum nitride became producible, even if any substrate is used.

As for the luminous efficiency of this light-emitting device, compared with the light-emitting device produced using conventional bulk-like single crystal substrates, such as sapphire, it was equivalent at least, or has been improved greatly into a maximum of 4-5 or more times.

Therefore, the way in which a light-emitting device is used for the general lighting, such as the lighting for home, which was conventionally difficult, was opened substantially.

An optical waveguide which can transmit ultraviolet light at low loss became producible using the aluminum nitride-based thin film formed on the aluminum nitride-based sintered compact substrate.

Thus, according to this invention, as for the substrate comprising a sintered compact comprising as a main component various ceramicss including aluminum nitride, and the thin-film substrate in which a single-crystal thin film or a various crystallized thin film comprising as a main component at least one selected from gallium nitride, indium nitride and aluminum nitride are formed on the substrate, since they can be applied for extensive uses, such as a display in which the thin film is used for a field emission material, a surface acoustic emission device, or a circuit substrate, other than the above light-emitting device or optical waveguide, the effect which gives to industry is large.

And, it is as follows as summarizing the effect in the case of manufacturing a light-emitting device using the substrates of this invention.
1) The luminous efficiency of a light-emitting device increases because the crystallinity of a single-crystal thin film comprising as amain component at least one selected from gallium nitride, indium nitride and aluminum nitride and formed on the substrate is high.
2) The crystal direction of a single-crystal thin film comprising as a main component at least one selected from gallium nitride, indium nitride and aluminum nitride and formed on the substrate is controllable.
3) The light from a light-emitting device can be emitted to the outside of a device efficiently without being absorbed too much by the substrate because the substrate with high optical transmissivity can be used, and the luminous efficiency of a light-emitting device improves.
4) High electric power can be impressed to the light-emitting device because the thermal conductivity of the substrate is high, and the luminescence output of the light-emitting device can be heightened.
5) Generating of the dislocation and crack, etc., by the difference of thermal expansion coefficient decreases in the single-crystal thin film because the coefficient of thermal expansion of the substrate is as near as a single-crystal thin film comprising as a main component at least one selected from gallium nitride, indium nitride and aluminum nitride, and the luminous efficiency of the light-emitting device increases.
6) P and N electrode of the light-emitting device can be arranged to not only one side of the device but also the up-and-down side of the device because a conduction via for connecting an up-and-down side electrically can be provided in the substrate, and because a conductive zinc oxide-based sintered compact can be used as a substrate. Therefore, it is not necessary to etch a part of the device in order to form an electrode, the device is producible as it is only by cutting a substrate, a manufacturing process is simplified, and opportunity of the damage of the device which is easy to be produced during etching decreases.
7) As for the luminous efficiency of the light-emitting device which comprises a nitride semiconductor which comprises as a main component at least one selected from gallium nitride, indium nitride and aluminum nitride, it is at least equivalent to that which used conventional single-crystal substrates, such as sapphire, or improved to a maximum of 4-5 or more times, and it can manufacture in cheaper cost than that which used conventional single-crystal substrates, such as sapphire, because the substrate is a ceramic-based sintered compact basis.

## Claims

1. A substrate for a thin film for forming a single-crystal thin film comprising as a main component at least one selected from gallium nitride, indium nitride and aluminum nitride, and the substrate comprises a ceramic-based sintered compact.

2. A substrate for a thin film for forming a thin film comprising as a main component at least one selected from gallium nitride, indium nitride and aluminum nitride, and the substrate comprises a ceramic-based sintered compact having optical permeability.

3. The substrate for a thin film as described in Claim 1 or 2, wherein the ceramic-based sintered compact is an aluminum nitride-based sintered compact.

4. The substrate for a thin film as described in Claim 1 or 2, wherein the ceramic-based sintered compact is a sintered compact comprising as a main component a ceramic material having at least one of the crystal structure selected from a hexagonal system or a trigonal system.

5. The substrate for a thin film as described in Claim 4, wherein the ceramic-based sintered compact is a sintered compact comprising as a main component at least one selected from zinc oxide, beryllium oxide, aluminum oxide, silicon carbide, silicon nitride, and gallium nitride.

6. The substrate for a thin film as described in Claim 1 or 2, wherein the ceramic-based sintered compact is a sintered compact comprising as a main component at least one selected from zirconium oxide, magnesium oxide, magnesium aluminate, titanium oxide, barium titanate, lead titanate zirconate, a rare earth oxide, thorium oxide, various ferrites, mullite, forsterite, steatite and glass.

7. A manufacture method of the substrate for forming a thin film comprising as a main component at least one selected from gallium nitride, indium nitride and aluminum nitride, and the substrate comprises an aluminum nitride-based sintered compact manufactured using as a raw material at least respectively one of either which is selected from the reduction of aluminum oxide and the direct nitriding of metal aluminum, or that of the mixture made by reduction of aluminum oxide and by direct nitriding of metal aluminum.

8. A manufacture method for producing the substrate for forming a thin film comprising as a main component at least one selected from gallium nitride, indium nitride and aluminum nitride, and the substrate comprises an aluminum nitride-based sintered compact obtained by firing the powder compact or aluminum nitride-based sintered compact for not less than 10 minutes at the temperature not less than 1500°C in non-oxidizing atmosphere.

9. An aluminum nitride-based sintered compact having optical permeability, wherein at least one selected from a rare earth element and an alkaline-earth metal is a total of not more than 0.5 % by weight on an element basis, oxygen is not more than 0.9 % by weight on an element basis, AlN is not less than 95 % as a crystal phase, the average size of aluminum nitride particles is not less than 5 µm.

10. A zinc oxide-based sintered compact containing an aluminum component at least and having optical permeability.

11. A gallium nitride-based sintered compact having optical permeability.

12. A gallium nitride-based sintered compact having electrical conductivity.

13. A gallium nitride-based sintered compact containing at least one selected from an alkaline-earth metal and a rare earth element.

14. A gallium nitride-based sintered compact containing at least one selected from zinc, cadmium, beryllium, magnesium, carbon, silicon, germanium, selenium and tellurium.

15. A gallium nitride-based sintered compact containing at least one selected from aluminum, indium, and oxygen.

16. A gallium nitride-based sintered compact containing at least one selected from a transition metal.

17. A powder comprising gallium nitride as a main component and being the oxygen content not more than 10 % by weight.

18. A powder comprising gallium nitride as a main component and being the average particle diameter not more than 10 µm.

19. A manufacture method of the powder comprising gallium nitride as a main component and being made by carrying out the nitriding reaction of metal gallium and a nitrogen-containing compound.

20. A manufacture method of the powder comprising gallium nitride as a main component and being made by carrying out the nitriding reaction of gallium oxide using a reducing agent and a nitrogen-containing compound.

21. A manufacture method of the powder comprising gallium nitride as a main component and being made by carrying out the nitriding reaction of a gas-like gallium compound and a nitrogen-containing compound.

22. A thin-film substrate in which a single-crystal thin film comprising as a main component at least one selected from gallium nitride, indium nitride and aluminum nitride is formed on the ceramic-based sintered compact.

23. A thin-film substrate in which a thin film comprising as a main component at least one selected from gallium nitride, indium nitride and aluminum nitride is formed on the ceramic-based sintered compact having optical permeability.

24. The thin-film substrate as described in Claim 22 or 23, wherein the ceramic-based sintered compact is an aluminum nitride-based sintered compact.

25. The thin-film substrate as described in Claim 22 or 23, wherein the ceramic-based sintered compact is a sintered compact comprising as a main component a ceramic material having at least one of the crystal structure selected from a hexagonal system or a trigonal system.

26. The thin-film substrate as described in Claim 25, wherein the ceramic-based sintered compact is a sintered compact comprising as a main component at least one selected from zinc oxide, beryllium oxide, aluminum oxide, silicon carbide, silicon nitride, and gallium nitride.

27. The thin-film substrate as described in Claim 22 or 23, wherein the ceramic-based sintered compact is a sintered compact comprising as a main component at least one selected from zirconium oxide, magnesium oxide, magnesium aluminate, titanium oxide, barium titanate, lead titanate zirconate, a rare earth oxide, thorium oxide, various ferrites, mullite, forsterite, steatite and glass.

28. A thin-film substrate in which an optical waveguide is formed on the aluminum nitride-based sintered compact by the thin film comprising as a main component at least one selected from gallium nitride, indium nitride and aluminum nitride.

29. A manufacture method of the thin-film substrate in which a single-crystal thin film comprising as a main component at least one selected from gallium nitride, indium nitride and aluminum nitride is formed on the ceramic-based sintered compact, and the thin film is formed using an organic compound containing at least one selected from gallium, indium and aluminum as the main raw material and using at least one selected from ammonia, nitrogen, and hydrogen as the reactive gas.

30. A manufacture method of the thin-film substrate in which a single-crystal thin film comprising as a main component at least one selected from gallium nitride, indium nitride and aluminum nitride is formed on the ceramic-based sintered compact, and the thin film is formed using a halogenated compound containing at least one selected from gallium, indium and aluminum as the main raw material and using at least one selected from ammonia, nitrogen, and hydrogen as the reactive gas.

31. A manufacture method of the thin-film substrate in which a thin film comprising as a main component at least one selected from gallium nitride, indium nitride and aluminum nitride is formed on the ceramic-based sintered compact having optical permeability, and the thin film is formed using an organic compound containing at least one selected from gallium, indium and aluminum as the main raw material and using at least one selected from ammonia, nitrogen, and hydrogen as the reactive gas.

32. A manufacture method of the thin-film substrate in which a thin film comprising as a main component at least one selected from gallium nitride, indium nitride and aluminum nitride is formed on the ceramic-based sintered compact having optical permeability, and the thin film is formed using a halogenated compound containing at least one selected from gallium, indium and aluminum as the main raw material and using at least one selected from ammonia, nitrogen, and hydrogen as the reactive gas.

33. An optical waveguide comprising as a main component at least one selected from gallium nitride, indium nitride and aluminum nitride and contains at least one selected from niobium and tantalum.

34. A light-emitting device constituted with the laminate which comprises a thin film comprising at least one selected from gallium nitride, indium nitride and aluminum nitride as a main component and contains at least N-type semiconductor layer, luminescence layer, and P-type semiconductor layer, and the laminate of N-type semiconductor layer, luminescence layer, and P-type semiconductor layer is formed on the ceramic-based sintered compact.

35. A light-emitting device constituted with the laminate which comprises a thin film comprising at least one selected from gallium nitride, indium nitride and aluminum nitride as a main component and contains at least N-type semiconductor layer, luminescence layer, and P-type semiconductor layer, and the laminate of N-type semiconductor layer, luminescence layer, and P-type semiconductor layer is formed on the ceramic-based sintered compact having optical permeability.

36. A light-emitting device constituted with the laminate which comprises a thin film comprising at least one selected from gallium nitride, indium nitride and aluminum nitride as a main component and contains at least N-type semiconductor layer, luminescence layer, and P-type semiconductor layer, and the laminate of N-type semiconductor layer, luminescence layer, and P-type semiconductor layer is formed on the ceramic-based sintered compact having large surface roughness.

37. A light-emitting device constituted with the laminate which comprises a thin film comprising at least one selected from gallium nitride, indium nitride and aluminum nitride as a main component and contains at least N-type semiconductor layer, luminescence layer, and P-type semiconductor layer, and the laminate of N-type semiconductor layer, luminescence layer, and P-type semiconductor layer is formed on the ceramic-based sintered compact forming the thin film comprising at least one selected from gallium nitride, indium nitride and aluminum nitride as a main component.

38. A light-emitting device constituted with the laminate which comprises a thin film comprising at least one selected from gallium nitride, indium nitride and aluminum nitride as a main component and contains at least N-type semiconductor layer, luminescence layer, and P-type semiconductor layer, and the laminate of N-type semiconductor layer, luminescence layer, and P-type semiconductor layer is formed on the ceramic-based sintered compact forming the single-crystal thin film comprising at least one selected from gallium nitride, indium nitride and aluminum nitride as a main component.

39. The light-emitting device as described in Claim 34, 35, 36, 37, or 38, wherein the ceramic-based sintered compact is an aluminum nitride-based sintered compact.

40. The light-emitting device as described in Claim 34, 35, 36, 37, or 38, wherein the ceramic-based sintered compact is a sintered compact comprising as a main component a material having at least one of the crystal structure selected from a hexagonal system or a trigonal system.

41. The light-emitting device as described in Claim 40, wherein the sintered compact comprising as a main component a material having at least one of the crystal structure selected from a hexagonal system or a trigonal system is a sintered compact comprising as a main component at least one selected from zinc oxide, beryllium oxide, aluminum oxide, silicon carbide, silicon nitride, and gallium nitride.

42. The light-emitting device as described in Claim 34, 35, 36, 37, or 38, wherein the ceramic-based sintered compact comprising as a main component at least one selected from zirconium oxide, magnesium oxide, magnesium aluminate, titanium oxide, barium titanate, lead titanate zirconate, a rare earth oxide, thorium oxide, various ferrites, mullite, forsterite, steatite and glass.
